# EUROPEAN PATENT SPECIFICATION

(11) **EP 3 605 902 B1**
(45) Date of publication and mention of the grant of the patent: **21.06.2023**
(21) Application number: 18842142.4
(22) Date of filing: 31.07.2018
(51) Int. Cl.: H04L 1/00, H03M 13/13

(54) **POLAR CODE ENCODING METHOD AND DEVICE**
CODIERUNGSVERFAHREN UND CODIERER FÜR POLARCODES
PROCÉDÉ ET DISPOSITIF DE CODAGE À CODE POLAIRE

(30) Priority: 04.08.2017 CN 201710662548
(43) Date of publication of application: 05.02.2020
(73) Proprietor: Huawei Technologies Co., Ltd., Longgang District Shenzhen, Guangdong 518129 (CN)
(72) Inventor: XU, Chen, Shenzhen Guangdong 518129 (CN); ZHANG, Gongzheng, Shenzhen Guangdong 518129 (CN); WANG, Jun, Shenzhen Guangdong 518129 (CN); WANG, Guijie, Shenzhen Guangdong 518129 (CN); QIAO, Yunfei, Shenzhen Guangdong 518129 (CN); DU, Yinggang, Shenzhen Guangdong 518129 (CN)
(74) Representative: Pfenning, Meinig & Partner mbB
(86) International application number: PCT/CN2018/097774
(87) International publication number: WO 2019/024843

(56) References cited:
- EP-A1- 3 457 606
- EP-A1- 3 579 468
- CN-A- 102 694 625
- CN-A- 103 281 166
- CN-A- 107 592 181
- US-A1- 2016 164 629
- SAMSUNG: "Design of a Nested Sequence for Polar Codes", 3GPP DRAFT; R1-1705425_DESIGN OF A NESTED SEQUENCE FOR POLAR CODES_FINAL, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX , vol. RAN WG1, no. Spokane, Washington, USA; 20170403 - 20170407 2 April 2017 (2017-04-02), XP051243555, Retrieved from the Internet: URL:http://www.3gpp.org/ftp/Meetings_3GPP_ SYNC/RAN1/Docs/ [retrieved on 2017-04-02]
- NTT DOCOMO: "Sequence design of Polar codes", 3GPP DRAFT; R1-1708489, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE , vol. RAN WG1, no. Hangzhou, China; 20170515 - 20170519 14 May 2017 (2017-05-14), XP051273681, Retrieved from the Internet: URL:http://www.3gpp.org/ftp/Meetings_3GPP_ SYNC/RAN1/Docs/ [retrieved on 2017-05-14]
- QUALCOMM INCORPORATED: "Sequence construction of Polar codes for control channel", 3GPP DRAFT; R1-1711218 SEQUENCE CONSTRUCTION OF POLAR CODES FOR CONTROL CHANNEL, 3RD GENERATION PARTNERSHIP PROJECT (3GPP), MOBILE COMPETENCE CENTRE ; 650, ROUTE DES LUCIOLES ; F-06921 SOPHIA-ANTIPOLI , vol. RAN WG1, no. Qingdao; 20170627 - 20170630 20 June 2017 (2017-06-20), XP051305804, Retrieved from the Internet: URL:http://www.3gpp.org/ftp/tsg_ran/WG1_RL 1/TSGR1_AH/NR_AH_1706/Docs/ [retrieved on 2017-06-20]

## Description

### TECHNICAL FIELD

Embodiments of this application relate to a polar code encoding method, polar polar code encoding apparatuses, a wireless device, a communications system, a computer storage medium, and a computer program product.

### BACKGROUND

As a most fundamental radio access technology, channel coding plays a critical role in ensuring reliable data transmission. In an existing wireless communications system, a turbo code, a low-density parity-check (low density parity check, LDPC) code, and a polar (Polar) code are usually used to perform channel coding. The turbo code cannot support information transmission at an excessively low or high code rate. Due to encoding/decoding characteristics of the turbo code and the LDPC code, for medium and short packet transmission, it is difficult for the turbo code and the LDPC code to achieve ideal performance in a case of a limited code length. In terms of implementation, the turbo code and the LDPC code have relatively high calculation complexity in an encoding/decoding implementation process. Theoretically, it is proved that the polar code is a good code that can achieve a Shannon capacity and that has relatively low encoding/decoding complexity. Therefore, polar codes are increasingly widely applied.

However, with rapid evolution of the wireless communications system, some new characteristics are emerging in a future communications system such as a 5th generation (5th generation, 5G) communications system. For example, three most typical communication scenarios include enhanced mobile broadband (enhance mobile broadband, eMBB), massive machine type communication (massive machine type communication, mMTC), and ultra-reliable low latency communication (ultra reliable low latency communication, URLLC). These communication scenarios impose a higher requirement on encoding/decoding performance of the polar code.

Document SAMSUNG, "Design of a Nested Sequence for Polar Codes", vol. RAN WG1, no. Spokane, Washington, USA; 20170403 - 20170407, (20170402), 3GPP DRAFT; R1-1705425 DESIGN OF A NESTED SEQUENCE FOR POLAR CODES FINAL, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX, URL: http://www.3gpp.org/ftp/Meetings_3GPP_SYNC/RAN1/Docs/, (20170402), XP051243555 describes a nested polar code sequence to support polar codes with N₀ up to 1024.

Document NTT DOCOMO, "Sequence design of Polar codes", vol. RAN WG1, no. Hangzhou, China; 20170515 - 20170519, (20170514), 3GPP DRAFT; R1-1708489, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE, URL: http://www.3gpp.org/ftp/Meetings_3GPP_SYNC/RAN1/Docs/, (20170514), XP051273681 describes a sequence design of polar codes.

Document QUALCOMM INCORPORATED, "Sequence construction of Polar codes for control channel", vol. RAN WG1, no. Qingdao; 20170627 - 20170630, (20170620), 3GPP DRAFT; R1-1711218 SEQUENCE CONSTRUCTION OF POLAR CODES FOR CONTROL CHANNEL, 3RD GENERATION PARTNERSHIP PROJECT (3GPP), MOBILE COMPETENCE CENTRE ; 650, ROUTE DES LUCIOLES ; F-06921 SOPHIA-ANTIPOLI, URL: http://www.3gpp.org/ftp/tsg_ran/WG1_RL1/TSGR1_AH/NR_AH_1706/Docs/, (20170620), XP051305804 describes a sequence design for polar code.

Document EP 3 457 606 A1 describes a polar code encoding method and apparatus, to improve accuracy of reliability calculation and ordering for polarized channels.

Doucment EP 3 579 468 A1 describes an encoding method and apparatus, a decoding method and apparatus, and a device.

Polarized channel reliability sorting plays an important role in the encoding/decoding performance of the polar code. However, in a current phase, polarized channel reliability sorting accuracy is not ideal. Consequently, further improvement of the encoding/decoding performance of the polar code in an application process is affected.

### SUMMARY

The invention is set out in the appended set of claims.

### BRIEF DESCRIPTION OF DRAWINGS

FIG. 1 is a schematic architectural diagram of a communications system applied to an embodiment of this application;
FIG. 2 is a schematic flowchart of a polar code encoding method according to an embodiment of this application;
FIG. 3 is a first schematic structural diagram of a polar code encoding apparatus according to an embodiment of this application;
FIG. 4 is a second schematic structural diagram of a polar code encoding apparatus according to an embodiment of this application;
FIG. 5 is a third schematic structural diagram of a polar code encoding apparatus according to an embodiment of this application; and
FIG. 6 is a fourth schematic structural diagram of a polar code encoding apparatus according to an embodiment of this application.

### DESCRIPTION OF EMBODIMENTS

The following describes in detail the embodiments of this application with reference to accompanying drawings.

Embodiments of this application provide a polar code encoding method and apparatus, to obtain a reliability ranking based on reliability of a polarized channel, select, based on the reliability ranking, a sequence number of a polarized channel used to send an information bit, and perform polar code encoding based on a selected sequence number of the information bit. In the embodiments of this application, reliability of each polar code subchannel can be calculated more accurately. With reference to the accompanying drawings, the following describes in detail the encoding method and apparatus provided in the embodiments of the present invention.

For ease of understanding the embodiments of this application, the following briefly describes a polar code.

In an encoding policy of the polar code, a noiseless channel is used to transmit useful information of a user, and a pure noisy channel is used to transmit agreed information or transmit no information. The polar code is a linear block code. An encoding matrix of the polar code is *G_{N}*, and an encoding process is ${x}_{1}^{N} = {u}_{1}^{N} {G}_{N}$, where ${u}_{1}^{N} = \left({u}_{1},{u}_{2},…,{u}_{N}\right)$ is a binary row vector whose length is *N* (a code length), *G_{N}* is an *N*×*N* matrix, ${G}_{N} = {F}_{2}^{⊗ \left({log}_{2}\left(N\right)\right)} , {F}_{2}^{⊗ \left({log}_{2}\left(N\right)\right)}$ is defined as a Kronecker (Kronecker) product of log₂ *N* matrices *F₂*, and the foregoing matrix is ${F}_{2} = \left[\begin{matrix}1 & 0 \\ 1 & 1\end{matrix}\right]$.

In the polar code encoding process, some of bits in ${u}_{1}^{N}$ are used to carry information, and are referred to as an information bit set, where an index set of the bits is denoted as A ; and the other bits are set to fixed values pre-agreed between a receive end and a transmit end, and are referred to as a set of constant bits or a set of frozen bits (frozen bits), where an index set of the bits is indicated by a complementary set A*^{c}* of A. The polar code encoding process is equivalent to ${x}_{1}^{N} = {u}_{A} {G}_{N .} \left(A\right) ⊕ {u}_{{A}^{C}} {G}_{N .} \left({A}^{C}\right)$, where G_{N}(A) is a submatrix, in G_{N}, obtained from rows corresponding to indexes in the set A, and G_{N}(A^{C}) is a submatrix, in G_{N}, obtained from rows corresponding to indexes in the set A*^{c}*. *u*_{A} is a set of information bits in ${u}_{1}^{N}$, and there are K information bits. Usually, the information bit set includes but is not limited to various check bits such as a cyclic redundancy check (Cyclic Redundancy Check, CRC for short) bit and a parity check (Parity Check, PC for short) bit. u_{A^{C}} is a set of constant bits in ${u}_{1}^{N}$, there are (N-K) constant bits, and the constant bits are known bits. The constant bits are usually set to 0. However, the constant bits may be set randomly provided that the receive end and the transmit end reach a pre-agreement. Therefore, an output obtained after polar code encoding may be simplified as ${x}_{1}^{N} = {u}_{A} {G}_{N} \left(A\right)$, where *u*_{A} is a set of information bits in ${u}_{1}^{N}$, and *u*_{A} is a row vector of a length *K*, in other words, |A|=*K*, where |·| indicates a quantity of elements in a set, *K* is a size of an information block, *G_{N}*(A) is a submatrix, in the matrix *G_{N}*, obtained from the rows corresponding to the indexes in the set A , and *G_{N}*(A) is a *K* × *N* matrix.

A polar code construction process, namely, a process of selecting the set A, determines performance of the polar code. The polar code construction process is usually determining, based on a mother code length N, that there are N polarized channels in total, where the N polarized channels respectively correspond to N rows of the encoding matrix; calculating reliability of the polarized channels; and using indexes of first K polarized channels with relatively high reliability as elements of the set A , and using indexes corresponding to remaining (N-K) polarized channels as elements of the index set A*^{c}* of the constant bits. The set A determines locations of the information bits, and the set A*^{c}* determines locations of the constant bits. The sequence numbers of the polarized channels are location indexes of the information bits or the constant bits, namely, location indexes in ${u}_{1}^{N}$.

The solutions provided in the embodiments of this application relate to how to determine polarized channel reliability. A basic invention idea of the embodiments of this application is as follows: Polarized channel reliability may be represented by reliability, and from the angle of signal spectrum analysis, an approximation of the polarized channel reliability by using existing reliability may be understood as a domain transformation of a signal. Similar to Fourier transform using a kernel *e^{jw}* to implement a transformation of a signal between time domain and frequency domain, this method uses a kernel *β* to implement a transformation of a signal from a channel sequence number domain to a reliability weight domain. In a signal time-frequency analysis field, Fourier transform and wavelet transform are the most common. Because the Fourier transform is limited by a form of trigonometric function kernel *e^{jw}*, in a signal time-frequency analysis process of the Fourier transform, there is an awkward situation in which not both a time domain identification capability and a frequency domain identification capability can be achieved. For the wavelet transform, a wavelet transform kernel and a variety of functions are used, and therefore, when a domain transformation is performed, an instantaneous change of a signal in time domain can be captured, so that both the time domain identification capability and the frequency domain identification capability can be achieved. In the embodiments of this application, a changeable transformation kernel is used to estimate the polarized channel reliability, thereby improving accuracy of sequence reliability estimation.

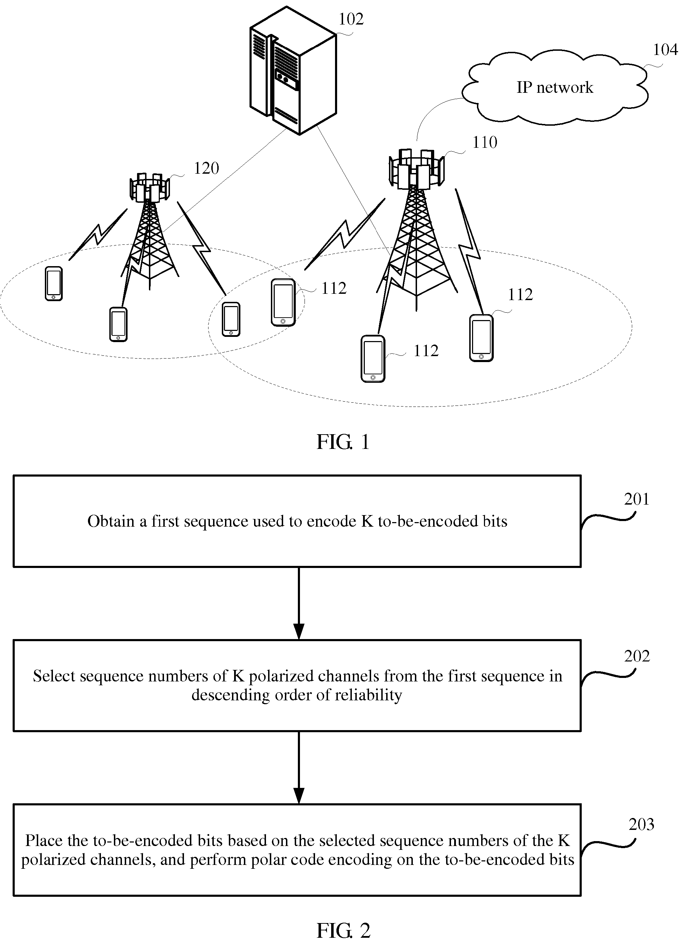

FIG. 1 is a schematic structural diagram of a wireless communications network according to an embodiment of the present invention. FIG. 1 is merely an example, and another wireless network that can use the encoding method and apparatus in the embodiments of the present invention also falls within the protection scope of the present invention.

As shown in FIG. 1, the wireless communications network 100 includes a network device 110 and a terminal 112. When the wireless communications network 100 includes a core network 102, the network device 110 may be further connected to the core network 102. The network device 110 may further communicate with an IP network 104, for example, the Internet (internet), a private IP network, or another data network. The network device serves a terminal within coverage. For example, as shown in FIG. 1, the network device 110 provides wireless access for one or more terminals 112 within coverage of the network device 110. In addition, coverage of network devices such as the network devices 110 and 120 may have an overlapping area. Network devices may further communicate with each other. For example, the network device 110 may communicate with the network device 120.

The network device may be a device configured to communicate with a terminal device. For example, the network device may be a base transceiver station (Base Transceiver Station, BTS) in a GSM system or a CDMA system, or may be a NodeB (NodeB, NB) in a WCDMA system, or may be an evolved NodeB (Evolved NodeB, eNB or eNodeB) in an LTE system, or a network-side device in a future 5G network. Alternatively, the network device may be a relay station, an access point, an in-vehicle device, or the like. In a terminal-to-terminal (Device to Device, D2D) communications system, the network device may be a terminal that has a function of a base station.

The terminal may be user equipment (User Equipment, UE), an access terminal, a subscriber unit, a mobile station, a remote station, a remote terminal, a mobile device, a user terminal, a wireless communications device, a user agent, or a user apparatus. The access terminal may be a cellular phone, a cordless phone, a session initiation protocol (Session Initiation Protocol, SIP) phone, a wireless local loop (Wireless Local Loop, WLL) station, a personal digital assistant (Personal Digital Assistant, PDA), a handheld device having a wireless communication function, a computing device, another processing device connected to a wireless modem, an in-vehicle device, a wearable device, a terminal device in a future 5G network, or the like. Based on the communications system architecture shown in FIG. 1, in the embodiments of this application, the polar code encoding method may be performed by the foregoing network device or terminal. When the network device or the terminal is used as a transmit end to send data or information, the polar code encoding method may be used. Correspondingly, when the network device or the terminal is used as a receive end to receive data or information, a subchannel sequence needs to be first confirmed in the method described in the present invention. The polar code encoding method provided in the embodiments of this application is described below in detail.

Based on the communications system architecture shown in FIG. 1, as shown in FIG. 2, a specific procedure of a polar code encoding method provided in an embodiment of this application is as follows:
Step 201: Obtain a first sequence used to encode K to-be-encoded bits.

The first sequence includes sequence numbers of N polarized channels, the sequence numbers of the N polarized channels are arranged in the first sequence based on reliability of the N polarized channels, K is a positive integer, N is a mother code length of a polar code, and N is a positive integer power of 2.

Step 202: Select sequence numbers of K polarized channels from the first sequence in descending order of reliability.

Step 203: Place the to-be-encoded bits based on the selected sequence numbers of the K polarized channels, and perform polar code encoding on the to-be-encoded bits.

The K to-be-encoded bits are mapped to the K polarized channels in the N polarized channels, where reliability of the K polarized channels is higher than reliability of remaining (N-K) polarized channels.

The first sequence is all or a subset of a second sequence, the second sequence includes sequence numbers of Nₘₐₓ polarized channels, and the sequence numbers of the polarized channels are arranged in the second sequence based on reliability of the polarized channels. In other words, sorting of the sequence numbers of the polarized channels in the first sequence is consistent with sorting of sequence numbers of polarized channels that are less than N in the second sequence. Nₘₐₓ is a positive integer that may be a positive integer power of 2 or may not be a positive integer power of 2, and Nₘₐₓ > N. A method for calculating the reliability of the Nₘₐₓ polarized channels is similar to a method for calculating the reliability of the N polarized channels. The arrangement based on reliability described herein may be arrangement performed in ascending order of reliability, or may be arrangement performed in descending order of reliability. Alternatively, polarized channels may be grouped into two or more groups, and for each group, arrangement may be performed in ascending or descending order of reliability. Specifically, grouping may be performed based on values of sequence numbers of the polarized channels or based on sequence numbers with a same remainder (for example, the sequence numbers are grouped into three groups, and sequence numbers that have a same remainder after being divided by 3 are grouped into one group). No specific limitation is imposed herein.

Optionally, rate matching is performed, based on a target code length, on a sequence obtained after polar code encoding.

According to the encoding method provided in this embodiment, after an input information bit is received, a quantity K of to-be-encoded bits is determined based on a target code length N of a polar code. Regardless of whether a second sequence is known through calculation and storage that are performed in advance or through online calculation, a first sequence may be obtained from the second sequence. When Nₘₐₓ = N, the second sequence is the first sequence. The second sequence includes reliability sorting of polarized channels whose quantity is the maximum code length Nₘₐₓ supported by a communications system. Optionally, the first sequence may be obtained from a prestored second sequence, then an information bit is determined based on the first sequence, and finally polar coding is performed on the K to-be-encoded bits to obtain a bit sequence after polar coding. In this way, in a semi-online calculation and semi-offline storage manner, reliability of a polar code polarized channel is obtained to determine locations of an information bit and a constant bit.

The following specifically describes a sequence of polarized channel sequence numbers arranged based on reliability of an i^{th} polarized channel in N (or Nₘₐₓ) polarized channels. Sequence numbers of the N polarized channel may be 0 to (N-1), or may be 1 to N. In the embodiments of this application, when the reliability of the i^{th} polarized channel in the N polarized channels is determined, a value of i may be 1, 2, ..., or N, or may be 0, 1, ..., or N-1.

It may be understood that the formula in the embodiments of this application is merely an example, and a solution obtained by persons skilled in the art by making a simple transformation to the formula without affecting performance of the formula falls within the protection scope of the embodiments of this application.

For a specific sequence example, refer to the following six groups of sequences found based on different criteria. A second sequence is a part or all of any sequence shown in a sequence Q1 to a sequence Q3. These sequences may also be expressed by corresponding tables Q1 to Q3, where "reliability or reliability sequence number" is a natural sequence of reliability in ascending order, and the polarized channel sequence number is a polarized channel sequence number in a corresponding sequence. There are three different meanings of "a part" herein:
(1) is not a positive integer power of 2, and code lengths in the given examples are all positive integer power of 2. Therefore, the part can only be a part of any sequence shown in the sequence Q1 to the sequence Q3.
(2) If N_{max_encoding device} supported by an encoding device is less than N_{max_protocol} specified in a protocol, only N_{max_encoding device} sequence numbers in any sequence shown in the sequence Q1 to the sequence Q3 need to be obtained.
(3) A part of an actually used sequence of a length Nₘₐₓ is fully consistent with a part of any sequence shown in the sequence Q1 to the sequence Q3.

It is easy to learn that a value in a Q sequence refers to a sequence number of a polarized channel, and indexes of the sequences are reliability sequence numbers in ascending order starting from 0.

Reliability rankings may also be expressed by using a Z sequence, to be specific, reliability rankings of all polarized channels corresponding to naturally sorted polarized channel sequence numbers are used as a Z sequence. In other words, a second sequence may be a part or all of any sequence shown in a sequence Z1 to a sequence Z3. Likewise, the Z sequence may also be expressed by corresponding tables Z1 to Z3, where polarized channel sequence numbers are arranged in ascending order, and "reliability or reliability sequence number" is a reliability sequence number of a polarized channel corresponding to the polarized channel sequence number. In other words, a value in the Z sequence refers to a reliability sequence number, and indexes of the sequences are polarized channel sequence numbers in ascending order starting from 0.

For example, an x^{th} Q sequence is a sequence Qx and a table Qx, where the sequence Qx is equivalent to the table Qx, a corresponding Z sequence is a sequence Zx and a table Zx, and the sequence Zx is equivalent to the table Zx, where x = 1, 2, or 3. Herein, "corresponding" means that reliability or a reliability sequence number and a polarized channel sequence number in a table Q fully correspond to a polarized channel sequence number and reliability or a reliability sequence number in a table Z. For example, in a total of N polarized channels, if reliability of an i^{th} polarized channel has a j^{th} ranking, a location of the i^{th} polarized channel in the table Qx is (j,i), and a location of the i^{th} polarized channel in the table Zx is (i, j).

First group of sequences (a sequence of a length 1024 is generated by comprehensively considering performance obtained when list (list) sizes are 1, 2, 4, 8, and 16 and preferentially considering polar code performance of a mother code length 256, and the sequence is expanded to a sequence of a length 8192 based on a channel capacity):
Sequence Q1, with a sequence length of 8192:
[0,1,2,4,8,16,32,3,5,64,1024,2048,4096,9,6,17,10,18,128,12,33,65,20,256,34,24,36,7,129,66,512,11,40,68,130,19,13,48,14,72,257,1025,21,132,35,258,26,2049,513,80,37,25,22,4097,136,260,264,38,514,96,67,41,144,28,69,42,516,49,1026,74,272,160,520,288,528,192,544,70,44,131,81,2050,50,73,15,320,133,52,1028,23,134,384,76,4098,137,82,56,27,97,39,259,84,138,145,261,1032,29,43,2052,98,515,88,140,30,146,71,262,265,161,576,45,1040,100,640,51,148,46,75,4100,266,273,517,2056,104,162,53,193,1056,152,77,164,768,268,274,518,54,83,57,521,1027,112,135,2064,78,289,194,85,276,4104,522,58,168,1029,139,99,86,60,280,89,290,529,2080,524,196,1088,141,101,147,176,142,530,321,31,200,1033,4112,90,545,292,2051,322,532,263,149,102,105,1030,304,296,163,92,47,267,385,546,2053,324,1041,208,386,4128,150,153,165,106,55,1034,328,536,577,548,2112,113,154,79,269,1042,108,578,224,166,519,552,195,4099,1152,270,3072,641,523,275,580,291,59,1036,169,560,114,277,156,2057,87,197,1057,116,170,4101,61,531,525,642,281,1089,278,526,2054,177,293,388,91,1044,584,769,198,172,120,4160,201,2065,336,1280,62,282,143,103,178,294,1058,93,644,2058,202,592,323,1048,392,5120,297,770,107,180,151,1060,2066,209,284,648,94,204,298,1031,400,608,352,2176,6144,325,533,1153,155,210,305,547,300,1090,109,2060,184,534,537,115,167,1536,4105,225,326,306,772,2081,157,1035,656,329,110,117,212,1064,171,2113,776,4102,330,226,549,1092,538,387,308,216,2068,1154,416,271,279,158,337,1043,4113,550,672,2304,118,332,579,1037,540,389,173,121,1072,2082,553,199,784,4106,179,1038,228,338,312,2072,704,390,1096,174,554,581,393,1281,4114,283,2084,122,448,353,1045,561,203,63,340,2055,1156,394,527,582,4224,556,181,1059,2177,295,285,232,124,1282,205,182,643,2114,4108,562,1050,286,585,299,1537,354,211,2560,401,185,1104,396,344,4129,586,645,2059,1061,593,535,240,206,1049,95,2088,327,564,4161,1046,800,402,356,307,2116,1160,301,417,213,568,1284,832,4116,2178,588,186,1288,646,404,227,896,2067,1062,594,418,4352,302,1538,649,771,2061,360,539,1120,111,331,214,1091,2096,4130,309,188,449,1065,217,408,2062,609,596,1168,551,650,4120,229,1052,2120,159,420,310,1093,541,773,2305,610,4132,1066,657,333,119,1540,3073,600,339,218,1073,368,652,4103,230,2069,1098,391,3 13,450,1296,542,2180,334,233,4225,1184,555,774,175,2083,1544,123,658,612,1312,2306,4162,341,777,220,1552,314,424,2074,395,1216,673,583,4608,355,1568,2561,287,183,234,1094,125,557,2128,4107,660,1068,616,342,316,2085,1155,241,778,1105,563,4136,345,2073,452,1074,397,403,207,2070,1097,674,4164,558,1039,785,432,2184,357,1344,187,236,664,4226,2308,1157,624,587,1076,780,2312,705,126,1047,4115,242,565,1158,2086,398,346,456,1408,358,2562,4109,405,1100,303,569,244,2144,1161,595,189,4144,1106,566,2115,676,361,1080,706,589,2089,1051,4110,215,786,647,1121,2192,348,419,1063,406,4168,464,2076,680,1283,801,362,1108,2117,590,4353,409,1162,570,2090,788,597,1169,572,219,5121,2564,1285,311,708,1053,598,2097,601,1067,4117,651,421,3074,792,1122,802,611,1539,2122,4228,602,410,1112,231,688,2320,1164,653,248,4131,1054,2208,369,190,364,1170,654,2568,4354,659,1095,335,480,2336,1286,315,221,1289,4122,2576,370,613,1185,422,425,2240,1600,6145,451,614,1069,2592,543,235,1124,412,4609,2118,343,372,1664,775,317,2092,1075,222,4176,426,1172,2179,453,237,1070,559,2129,4133,833,1099,804,712,2098,1290,834,661,4121,1297,2121,808,779,1541,617,1128,2063,4118,604,433,1186,720,2368,816,1077,4232,836,347,2181,1217,897,243,1176,2100,4356,662,454,1101,318,3076,675,1188,618,4360,898,2071,1792,781,376,2182,1292,4134,428,1298,665,2432,736,1542,567,840,4610,2124,1078,625,238,1107,2185,359,4192,457,1081,399,2130,787,1545,591,1136,4163,2104,678,434,1159,2075,677,349,4137,1102,245,2145,458,1313,666,1218,4240,2087,620,363,1109,2307,127,191,4124,1300,782,2132,1546,407,436,1082,4165,2186,626,571,1192,2193,465,1163,681,4138,246,2309,1123,707,350,3080,4612,1110,599,1084,668,2077,790,1304,4145,460,2091,249,1113,682,1314,2146,5122,573,411,1553,2563,803,789, 1548,4170,709,2136, 1220,365,440,2188, 1165,4368,628, 1125,689,2078,374,1171,4256,423,2194,466,1200,793,2119,1166,4616,250,371,1554,2310,481,1345,574,4384,2313,413,1055,603,2209,1224,4624,366,468,1114,2624,655,1569,900,4288,2093,805,1316,615,3088,1346,4640,684,710,2148,1556,429,1287,4166,2688,794,252,1173,373,2099,1126,4140,605,848,2196,1129,690,1328,4227,2094,713,1320,632,2123,482,4177,1187,806,2314,1116,427,904,6146,2321,1071,414,1291,2565,223,663,4146,1409,2152,692,1570,835,2210,4169,1348,619,472,2101,1232,455,4111,1410,2241,796,809,1174,3104,4416,714,1177,721,2200,1189,837,4229,716,2125,1130,864,1079,2212,4148,810,1352,606,2816,912,5124,1560,722,2316,1601,696,1572,4119,2322,377,435,1137,2566,817,4230,1178,319,2102,1103,621,1293,4480,2131,812,484,1132,2105,430,4172,1602,838,2569,1248,667,4233,3075,488,1190,239,2160,1543,4178,378,1576,2183,459,1219,622,4152,2126,627,1294,437,2337,4123,1665, 380,2242,1547,818,1299,4193,2133,461,496,1604,2324,4135,669,1315,2570,679,10 83,724,4355,2106,1193,841,629,2216,4180,1584,351,1138,3077,467,1301,4234,2187, 438,1180,737,2147,4241,1111,251,1221,2134,462,4357,442,2108,1140,441,1194,232 8,5128,469,1085,2137,247,1555,4125,683,2338,1549,842,1666,4139,2577,738,899,2 572,1305,6148,670,1302,2244,783,1550,3136,4194,849,1201,820,2189,1317,4611,72 8,2149,1412,928,1115,4184,2195,791,367,2224,1608,4236,901,1793,2190,630,1222, 4126,2578,685,1196,844,2369,4242,1144,633,2079,1225,711,4167,1360,2248,253,10 86,3081,4358,691,1306,824,2138,1167,4361,902,2593,1127,686,740,4257,2340,1202, 850,2370,1318,4672,375,2580,1117,444,1668,4141,2311,470,1226,2197,483,5136,1 616,415,2150,1347,485,4196,2153,1416,905,3078,1321,4736,795,1794,2352,473,414 7,1131,2344,634,1204,2211,4244,744,1175,852,2140,1233,4142,960,2095,1308,865, 2315,4171,1672,693,2433,1118,4362,797,1228,2594,906,1322,4369,2372,715,1424,3 089,807,4613,1632,474,2256,1376,6152,636,2434,1349,694,2198,4200,1557,254,220 1,1179,717,4258,2213,1234,575,1329,4149,2154,913,1571,2103,798,4289,1324,3082, 811,1133,5152,2376,379,1208,2584,697,4248,1558,431,2625,607,4173,489,2596,15 61,866,2161,4260,1139,723,2202,1191,4864,486,2127,1249,908,2317,4364,1350,718, 1330,3090,4370,813,1796,2156,476,4614,1181,2626,856,1680,2272,4150,839,1353, 2214,725,4179,1134,2567,698,1141,2600,4153,914,1236,2243,752,4617,1195,3200,8 68,1800,5123,2318,819,1354,2689,4208,814,1250,439,2571,1573,4231,929,2323,156 2,490,6160,2628,1411,623,2339,4174,1332,671,2107,1240,4385,739,3084,1440,916, 2217,4290,1295,463,2608,1303,4181,843,2162,1182,381,4372,2325,1361,497,2204,4 618,1574,930,2135,1696,4154,821,2245,1142,726,4264,3105,1356,1603,2164,5125,9 61,2218,1564,872,2109,4235,1413,492,2579,1197,4195,631,2573,1145,729,4182,269 0,1577,700,2329,4156,1223,443,3137,1808,4376,741,2326,1203,845,4185,2574,1252, 920,2225,4386,1362,382,2341,1336,4625,822,2436,1728,2139,6176,1414,851,3092, 1198,4620,730,2632,1578,498,4292,2817,1605,880,5184,2246,1417,742,2220,4237,1 307,445,2168,1146,4197,2249,471,1472,2384,4243,1377,635,3328,1585,4272,932,21 10,1227,687,4238,2330, 1087,903,2191,4626, 1364,2151,825,4417, 1418,2226,500, 155 1,4127,2342,1606,846,3106,4296,1580,745,2141,1205,5129,2692,826,1319,2250,418 6,732,1309,2640,4641,446,1256,2371,1148,4388,3096,962,1229,2440,6147,936,1206, 2345,4418,475,1667,2818,853,4628,2155,1586,867,2228,4359,1310,1609,2199,637, 4245,1323,3108,907,4198,2257,1378,487,2332,4201,1235,695,2696,5126,1425,2142, 1209,746,4400,2252,1420,828,2346,4392,1368,3079,753,4259,1610,2448,854,1669,4 188,2656,1617,2400,857,4143,1559,2373,504,4363,1264,2581,799,3201,4481,1230,1 119,2203,4642,255, 1351,2258,964,6149,2353, 1588,909,4420,2595, 1824,719,2348,51 37,1426,3138,1380,4304,477,2157,1331,915,4482,2232,1325,2582,4246,638,1441,25 85,1237,4249,2163,748,1592,4261,2215,944,1856,3584,4202,869,2273,1612,4151,12 10,2374,491,5130,2354,1670,699,2820,4424,1428,1251,2205,4632,754,3083,1920,85 8,4673,2704,1618,2377,4644,478,1442,2158,6208,1326,968,2165,1673,4209,2260,38 3,1795,4250,3112,910,2219,4175,1384,1563,2824,815,4365,2378,1135,976,5138,227 4,1355,2597,4204,1238,870,3140,1333,4674,2586,917,1212,4320,2435,1473,2356,42 62,727,1241,2264,493,4615,3202,1432,873,4648,2464,1633,2319,4291,1620,701,232 7,5248,1575,2206,931,4366,1674,2385,1253,3091,7168,756,1183,2598,4737,860,272 0,1444,4619,1334,2166,499,4371,2380,1565,731,2627,4676,1797,3085,1634,4387,82 3,2588,1681,4155,2437,922,1357,5132,2221,1143,2169,4265,874,1624,3120,4656,91 8,2601,1363,4210,2247,1242,502,2832,4373,1392,2227,933,4252,1676,3086,1254,61 53,2276,743,1415,4183,2386,1337,2360,4293,760,2752,1474,5153,881,2438,1566,42 12,3144,1358,494,4266,2222,1257,2602,4157,702,2629,1579,4627,1798,2441,921,46 21,3329,1199,501,4738,2331, 1147,2170,4377, 1682,2496,876,5185, 1636,2401, 1365,4 374,3093,847,1801,2609,4622,992,2251,6150,1244,2111,1338,4273,447,2388,1448,4 389,3204,1419,2442,4484,733,1697,2575,4187,827,2630,1607,5140,2604,1379,934,4 680,2229,1311,3107,4865,1207,2343,882,4294,1258,2333,937,4268,2280,1149,2172, 4216,1581,963,3330,4297,1684,2253,1640,6161,2230,747,1366,4432,2691,505,2610, 5376,1340,3098,1265,4158,855,2334,4378,1802,2633,1587,4239,2347,924,3585,419 9,1369,734,2402,4274,1476,2259,1421,4390,2449,829,1427,5154,2233,1231,3152,41 89,965,2444,4740,1698,2392,1582,6154,938,2634,1809,4298,2693,1456,3109,4688,8 84,1381,2641,4419,506,2583,5144,1211,2288,1260,4488,2254,749,1688,4393,3097,1 648,2143,4866,945,2375,1611,4203,2612,1804,4276,966,3094,1729,4247,2848,1150, 2450,5156,755,2404,1266,6162,859,2355,4305,1589,3208,1422,4380,2349,940,2465, 4744,1370,2261,4190,1480,830,2616,4300,1382,3332,1429,4394,2880,911,2636,512 7,1327,1593,4496,2234,871,3336,4704,1268,2694,1619,4448,2452,639,6272,2275,12 13,1590,4421,2944,888,3110,4629,1700,2642,5249,1385,2466,479,4251,2350,1730,3 586,4306,1613,946,4401,2697,1239,2819,4643,750,2408,4396,1810,2587,1671,5186, 3168,969,2159,4205,1372,1443,6156,2379,508,2262,4280,1430,3139,4630,1488,235 7,861,4633,2236,1704,2497,4211,1825,757,4263,3113,1386,2265,5632,1614,2456,43 21,970,2657,1433,4422,2644,1594,3216,4402,919,2599,4868,1812,1621,2698,6177,1 596,2277,4253,875,3100,1243,5131,2207,1335,4752,2468,862,2358,4425,1732,3141, 4206,1622,2589,758,4213,1625,2821,4308,1675,2658,948,5160,3114,1445,4267,270 5,1816,2381,6209,977,2167,4872,1826,3588,1635,4426,2648,923,4322,2387,1626,22 66,4645,1434,972,5188,3121,1255,2416,4634,1712,2700,4483,761,2278,1677,4404,3 146,1272,4312,2439,877,6164,2361,1393,2498,5250,1214,3344,4512,1388,2590,952, 4367,2382,1678,4375,2281,1683,495,4254,3232,1359,4433,2603,1504,5139,2822,70 3,2223,4646,1339,3592,4768,1245,2171,935,6400,2706,1394,4214,2660,1637,4428,3 360,978,2389,4675,1446,2825,5133,1449,2268,1475,4636,3600,883,4485,2362,1638, 4269,2472,1567,2443,4217,762,3264,5168,1259,2721,6178,1436,2631,503,4649,240 3,1367,4295,3616,1396,4880,2335,925,2231,4275,1799,2282,5134,1341,3142,4324,1 246,2173,878,4434,2605,1450,4408,2708,1477,6168,3116,735,2664,4800,1261,2390, 4486,1583,2364,5192,1857,3203,4270,993,2289,1828,4650,2826,1736,4677,3153,88 5,4489,2611,1858,2393,5377,1685,2500,4379,939,3122,6180,1832,2445,4218,1803,2 451,1641,4544,2255,994,4449,3145,1628,5141,2722,1457,4657,2606,980,3087,4299, 1744,2833,4159,1840,2480,4436,1860,2405,6151,926,3392,5252,1371,2235,1921,44 90,2284,764,4623,2712,1267,4678,3205,1686,4652,2672,1478,2635,4277,941,3124,5 155,1342,2828,6273,1699,2753,4391,967,2174,4381,1642,3095,4328,1922,2290,180 5,4220,2613,886,5378,1400,1452,4301,3206,831,4278,2446,1689,4739,2394,1760,62 10,2504,1591,3456,4658,947,2406,5146,1864,2453,4382,1649,3148,4681,507,2351,4 395,1262,2617,5633,1383,2292,4450,1481,3209,889,4307,2643,1423,6656,2237,181 1,4497,3154,1615,4281,2614,984,5200,2724,1702,4492,2409,1458,4440,3128,751,46 82,2754,1701,4741,2637,1373,3099,6155,1269,2263,5157,942,2834,4689,1482,2695, 4631,1690,3169,4336,1644,2396,4302,996,2467,5145,1387,3111,4191,1151,2454,61 84,1215,2512,4423,971,2728,4660,1806,3331,5142,1431,2849,4896,890,2410,1460,4 498,3156,1650,4452,2638,1595,4403,2457,509,6212,3210,1489,5256,2618,1705,439 7,2836,1270,4513,2645,949,4309,3217,1731,4664,2620,1374,5380,2267,1623,4928,3 333,973,6274,2359,1692,4684,2756,1814,4282,3101,1484,5384,2646,1000,4742,264 9,1273,4500,3115,1706,4323,2699,1597,4992,2469,892,6163,2840,1435,5158,3170,1 827,4690,2850,1813,4514,2659,950,4398,3587,1733,5634,2650,1389,4745,2458,146 4,4867,3160,863,6157,2279,2736,4456,1652,4635,3212,1713,5216,2701,1398,4207,2 296,759,4427,3102,1447,4310,2417,1490,5187,2238,1817,6192,2412,1008,4405,321 8,1274,4284,2702,1395,4545,2707,1505,5161,3143,510,4313,2383,1598,4504,2528,3 334,6158,1437,2363,4705,1627,4692,2269,979,5264,3337,1390,4647,2418,1492,474 6,2661,1679,4325,3233,953,5148,2470,1924,6216,2473,1829,4255,3648,1639,4516,2 499,4406,2662,763,5189,3117,1708,4637,2591,1734,4869,2283,1453,6401,3172,974, 4706,2460,1818,5162,2391,1276,4753,2420,4429,1397,3712,4215,2823,1629,5636,2 365,954,7169,3123,1872,4696,2270,1714,4435,2474,4314,1737,3220,5169,879,2501, 4464,1656,2285,4748,3118,1506,4326,2607,1830,6165,2881,5194,981,3147,4487,14 51,2852,4409,1928,2760,4546,1438,3338,5392,2882,982,4638,2709,6276,1247,3345, 4430,1687,2856,4329,1716,2827,5280,1859,3589,4651,927,4870,2665,3176,4271,16 43,2652,6179,1496,2481,5640,1479,3234,4219,995,4754,2768,1820,4708,2864,1833, 5408,3125,2884,6402,1738,4437,2395,1745,4873,3265,765,4316,2945,1861,5648,22 91,4410,3224,1740,4520,2710,1888,6170,2502,956,4491,3149,5312,1834,2366,4769, 1630,2723,4679,3236,1936,4451,2666,5664,1746,2946,6657,887,3840,4383,1720,28 29,4279,1401,4330,2424,3340,5190,1459,2476,4221,1841,3346,4653,985,6224,2713, 1343,4756,2784,3590,5164,1645,4712,2615,1836,4438,2888,997,4412,3126,1508,61 81,2673,5251,2286,1454,4337,3155,1862,4874,2407,5201,1691,2505,4659,986,3129, 4441,2447,6169,1512,2835,4548,1263,3593,5170,1402,4493,2639,3184,4499,1483,2 726,4303,943,6166,2482,1646,5193,3207,1651,4770,2725,2397,4654,1461,5135,315 0,1404,4881,2293,4528,891,2506,6280,3361,1842,4453,2714,5440,1485,3266,4283,1 520,2668,4332,1693,4760,2411,3157,6404,998,2175,5253,1703,4720,2239,1748,468 3,3348,2830,5172,1865,4876,3594,766,6408,2455,1653,4801,2484,4222,3130,1375,5 143,2674,4338,1491,2619,4661,1462,3240,5254,2513,6182,511,3211,4494,1761,444 2,2729,1275,4552,2294,3171,5504,1486,4454,2755,1466,6658,2398,4501,1465,3158, 5196,2647,988,4399,3132,4665,1493,2716,4340,1271,6240,2838,3352,5257,1707,25 08,4691,1866,4285,2297,3161,5202,1001,4662,2730,1762,6211,3362,1923,4772,262 1,4457,2459,1694,5176,3601,4802,1807,2851,4685,951,6185,2837,3596,5147,1873,2 757,4311,1844,4882,3268,2413,4743,1752,5217,2488,1952,6288,3213,4444,1002,26 76,4515,3173,5159,1815,2737,4502,1391,4560,2422,3219,6172,1925,2471,4776,165 4,5379,2514,1709,4897,3248,4458,2841,893,5204,3214,6213,1868,2298,4686,2419,4 505,1657,3602,5258,1735,4666,2529,3393,6186,1277,4884,2622,975,4693,2461,526 5,1715,3103,4668,2651,4315,1848,3272,6660,1926,5381,2414,2516,4407,1710,4804, 3162,894,5149,2703,4694,3617,1764,6193,2948,4697,1874,2853,5163,3364,4747,13 99,2663,4517,1468,7170,3394,2732,4888,1494,5218,2758,1009,4898,3604,4707,247 7,1507,5635,3335,6218,1439,2842,4698,2300,4506,1509,3221,5208,1929,4327,2421, 3174,4784,1819,6416,2653,955,5260,2896,4749,3177,4344,1497,2738,5150,1658,63 04,3376,2761,4465,1768,4286,3368,1876,4460,2680,5266,2530,1984,4750,3235,666 4,1004,4755,2854,3164,5191,1889,4431,2475,1717,4576,2952,6432,3119,1821,5382, 2462,4411,1930,3339,4317,2271,5385,1010,6672,2711,1739,4466,3457,4709,2740,1 831,5281,3618,4518,2883,4521,1498,3396,6336,1660,5696,2667,2520,4547,1718,47 10,3280,957,5165,2503,6688,3458,4639,1278,2844,4331,1741,5220,2857,3222,4508, 1599,6214,2762,4439,3225,1937,4468,2769,5760,1822,3237,4871,2885,4413,983,61 88,2764,1835,5171,3178,4318,2912,4522,1403,3127,5268,2858,6275,1721,3400,454 9,1455,4333,2654,5166,2960,1631,4655,3608,6225,1513,2770,4929,3649,5195,958,4 900,2744,3620,4808,1890,6194,2425,5386,1747,2483,4930,3185,4757,1510,5393,28 65,3226,6217,1932,4904,2367,4875,1742,3151,5637,2669,4713,987,3341,5224,2860, 6159,1837,4700,2532,1500,4529,3180,5282,2478,4816,1880,3650,6464,2886,4912,1 863,5173,3296,1749,4932,2715,4443,2536,6277,1012,3238,5313,2287,4993,1722,43 39,3591,1938,5272,2426,6196,3624,4758,1776,2507,4550,3267,5197,1892,4414,267 0,7172,1843,2675,4771,3342,5284,1838,4714,2485,3713,4994,999,6167,2428,5888,1 463,3595,4877,2866,4472,1953,6278,3347,2509,5388,1514,4524,2544,5394,3652,47 61,1647,2717,6528,1695,4832,3363,5638,2727,1763,4663,3131,4936,2772,6220,101 6,3241,5174,2889,4721,1940,4334,2677,5203,1487,3632,6281,2399,4455,1867,4553, 3186,5177,2515,1405,4495,3349,6226,2486,4883,1521,3228,5641,2785,4687,767,52 32,3159,6200,1954,2299,4774,3269,4530,1845,5255,2510,6171,2490,1750,4773,318 8,4445,2489,5198,1985,4341,3242,1896,6241,2517,4554,3133,5409,1516,4762,2295, 3603,5314,1655,6183,2731,4716,3597,4459,989,2890,5205,3714,6403,1753,4223,27 86,4287,2947,1724,5396,3353,4878,1467,6228,2718,5642,3350,1765,4503,2831,453 2,3598,5178,1869,6282,2897,4722,3249,1944,4667,2868,5288,3365,6289,1003,4561, 2776,3460,5259,1406,4777,2976,4342,3163,6405,1846,5219,2839,1875,4803,2415,4 446,3656,7176,1754,5206,2949,3841,4695,1522,5180,2678,4764,3270,6173,1904,48 86,2733,3244,5400,990,4556,2892,6187,3192,4345,1766,5209,2681,3273,4778,1469, 5410,2759,6242,3408,4669,1495,4507,2301,5649,3134,1659,6659,2739,4899,3354,4 885,1956,5644,2872,4805,3215,1711,6232,2950,5316,3175,4461,1927,4536,2734,62 84,1005,5261,2788,3250,4724,1849,5221,2898,4785,3366,6174,1524,4470,2423,526 7,3165,1870,4519,2492,6290,3716,4562,1769,5296,2518,4889,3274,6215,1850,2531, 5262,3664,4346,1756,4467,2463,5650,3395,6406,1470,4577,2533,3464,5441,959,46 70,2953,6409,3369,4509,1986,5151,2843,4699,3842,6305,1960,2521,5320,3179,446 2,1499,4564,2682,5210,3252,6720,1877,4751,2792,5665,3223,1891,4996,2900,6189, 3281,4901,3008,5412,1661,4711,3356,7184,2913,5442,1931,4780,3720,2741,4806,1 011,6244,3166,5652,2845,4525,1511,5383,3276,6784,2954,4890,1719,4348,3370,52 69,2763,1770,4469,3472,6195,2855,5222,1852,4701,3680,4944,2522,6292,1777,522 5,3424,4786,2684,5424,1878,3397,6190,2742,4809,1881,5416,3605,4728,2302,6219, 1013,4578,3227,5283,2765,4902,1528,6410,3282,5212,2623,3377,4523,1823,5000,2 961,6417,3619,5167,1279,4510,2846,5387,3372,6661,1988,4319,2859,4759,3181,55 05,1933,6248,2427,4788,3256,1743,5666,2745,4931,3606,6306,1501,5444,2479,471 5,2655,4568,2537,6197,1939,5328,3609,4551,2914,5506,895,6337,3187,4892,2771,4 905,1662,3239,5270,2534,7200,1772,4810,3297,5273,2956,4817,1968,6296,3398,52 85,2766,4933,3378,4812,1893,6221,2861,5226,3844,4960,1515,5175,2524,6308,322 9,4906,1723,5448,2904,4702,3728,6912,1778,5008,2887,3401,5656,1882,4818,2773, 6412,3182,5697,2746,4792,1006,5668,3189,6418,2962,4473,1502,4531,3284,5233,2 800,6662,1992,4913,3243,5274,2916,4415,3848,6198,1407,5199,2867,4717,3402,53 89,1934,6227,2862,4908,3298,4580,1839,5228,2487,6201,3621,4526,2000,5698,297 7,4934,3610,6665,2538,5344,1894,4763,3459,7171,2671,4584,1941,5286,3380,4335, 2719,6256,1014,5639,3288,4474,2787,5672,3488,6279,1751,4555,2964,5315,3343,4 718,1517,6222,2511,4723,3351,5390,2891,1897,4533,6433,3230,5761,2429,4476,17 25,6338,3409,5643,2545,4914,1955,5395,3622,6229,2978,4557,3744,4592,1780,570 0,2869,6420,3190,4765,1884,5411,2774,6666,3404,4775,1523,5179,3651,4820,3009, 6202,3612,5289,1755,4937,2920,4725,3461,6312,1017,5680,2540,4447,3245,5234,2 679,7173,1847,4563,3193,5397,2777,6283,1946,4534,3625,5276,2748,4833,3271,62 43,1898,5207,2491,4347,3856,5317,1942,6230,2789,4558,3251,4538,2893,6204,152 6,5236,3300,4537,2968,5290,1957,6424,4565,3410,5181,2430,6233,3384,4343,1767, 5651,2870,4779,3776,6434,1784,5645,3462,4938,2899,5762,3246,6673,1905,4834,2 778,4995,3626,6668,1018,5401,2546,4766,3653,5398,2928,6340,1518,4879,3465,27 90,1726,5646,3355,7232,2493,4945,3194,5297,1945,4916,2519,6285,3520,5413,152 5,4824,3425,6245,2683,5508,3633,5024,1900,5211,2980,6291,3275,4887,2735,4463, 1871,6320,3135,5704,2951,4997,2016,3412,5889,2873,6286,3466,4726,1471,5318,2 548,6674,3599,4781,1757,5292,3654,4940,2894,6465,3628,5240,1851,4729,2793,61 75,3253,5321,2874,4807,991,5456,3367,6344,2780,4349,1958,5182,3357,7177,2494, 4787,3304,5402,1906,4920,3196,6234,3010,5263,3277,4998,1961,6689,2984,5223,3 254,4782,2523,4836,1987,6436,3715,5298,2901,4946,1771,6466,3634,5414,2915,44 71,3358,6676,1529,5213,3657,4540,2685,5764,3371,6407,1879,4566,2955,5322,342 6,6293,2535,4579,1948,5712,3283,4511,2743,6246,1758,5443,3473,4581,3257,6249, 2794,5512,1853,5001,3468,7174,2876,5417,3416,4891,1020,5890,2801,6448,3658,4 569,2902,5227,1989,6440,3717,4730,3665,5300,1962,6307,2905,4840,3607,5271,25 52,4948,1908,6236,3312,5329,2847,5056,3278,6191,1530,5404,3167,4961,2303,641 1,3399,5768,1773,4789,3012,6529,3636,5214,2957,4893,1969,5324,3872,6690,2767, 5002,3474,5418,1990,6468,3428,4811,2525,5520,3379,7185,1779,4903,2963,5728,3 373,4570,2686,6352,5472,1883,4732,3489,6530,3285,5445,2796,4790,1964,6294,36 40,5653,2992,4350,3904,6297,1854,5275,2917,4813,3660,6309,3258,5330,1935,467 1,2539,5425,3718,6250,2747,5009,1007,5667,3476,6199,4894,3299,5420,2802,7178, 1895,4907,3968,5229,2906,6472,3666,4475,1663,5304,2526,6680,3490,4793,3374,5 654,1912,4527,3016,6721,3721,4703,2431,4585,6692,1503,5657,3843,4962,2958,62 57,3432,5235,1970,4819,3611,6298,2863,5287,3183,4582,1774,6223,3024,5345,340 3,5004,3286,6413,5446,1993,4814,2918,5426,3381,7186,2965,4909,1532,5892,3260, 6252,3521,4572,2775,5277,1885,6722,3289,4952,5776,2541,6368,3480,4935,1781,5 449,2921,6310,3681,4821,3668,5230,1994,6663,2749,4794,3623,5237,6696,2979,50 10,3722,5332,1943,6339,3301,4848,2804,5291,3231,7296,1015,4964,2908,5896,349 2,6414,4915,3382,5450,1899,6785,2547,4910,3613,5346,2779,4535,1886,6667,3845, 5669,5025,3682,6419,2871,5658,3729,4586,1782,6724,2970,5507,3405,4719,3191,6 435,1972,5428,4767,2922,6203,3672,5336,2966,4835,2001,7180,3411,5536,3290,50 12,2550,6313,5391,1947,4559,3440,6704,2981,5399,3724,4939,3302,6258,1996,527 8,4477,2791,6421,3463,5457,3385,4593,1785,6300,2808,5670,3522,5026,6231,2929, 5792,1901,4917,3614,6341,3406,5238,2542,4822,3305,7201,5452,1976,5699,2750,6 260,3627,5057,3846,6314,1519,5660,2969,4968,6205,3247,5509,2549,4588,3195,66 75,1727,5293,3730,4727,6669,2924,5241,3684,4825,1959,6786,3413,5673,2895,479 6,3849,6425,5319,3040,4539,2002,7233,3292,5904,3386,4837,2495,6422,5299,1019, 4941,3496,6670,3467,5348,2781,5016,6321,3745,5458,1907,4478,2875,6437,3655,5 432,3427,4918,6532,1786,5824,2982,6235,3359,5510,3255,4947,2930,7188,5294,15 27,4826,3306,6728,2985,5674,3197,4594,6913,1949,5701,3629,4976,3011,6342,373 2,5513,3688,4838,6316,1902,5403,2795,4541,3414,6264,2553,5242,6345,3388,4567, 1759,5568,3313,6480,2903,5473,4731,3850,7424,2017,5681,3635,5028,2972,6206,5 323,3417,4783,2782,6426,1909,5183,3524,4999,6287,3469,5460,2877,6247,3475,49 21,1963,5514,6322,3279,4596,3013,5647,3746,6438,2018,5702,4942,3630,7202,298 6,5676,3857,4841,3504,6237,5301,2004,6788,2932,4922,3429,5415,6346,2554,4828, 3259,5405,1950,6736,3308,4542,5352,2797,6467,3736,5244,3696,7192,5058,1788,5 325,2993,6536,3659,5032,3852,5302,6441,3014,4571,1965,5763,3777,6914,4949,31 98,6251,2803,5682,3314,4963,1991,6324,5406,2907,5705,3637,6295,3470,4733,541 9,2988,7204,1021,5003,3418,6353,5474,3528,4583,2878,6428,1910,5331,4791,3430, 6792,3477,5521,2959,6238,3375,5305,4842,1855,6348,3641,5516,2919,4924,6442,3 316,5464,3667,7175,1971,4849,5706,2687,6544,3261,4950,3638,5765,6752,2936,57 13,1531,6496,3748,4953,5655,3433,6469,2527,4600,3778,5360,6677,1913,4895,366 1,7297,2994,5326,5215,3287,6299,2798,4351,5447,3858,6354,2008,5060,3719,6449, 5684,3017,5005,3420,6691,3491,5920,4815,1775,6444,2556,5522,3478,7234,5476,3 536,4573,2909,6253,5427,1966,5011,3752,6328,3873,5421,6678,2805,4734,3434,55 37,2020,6681,5333,3662,6259,3018,4844,5688,3481,6311,3642,5040,1995,5952,768 0,2967,4965,3860,6369,3669,5708,5306,3644,6470,2923,4587,6450,1914,5766,3291, 4795,3383,6916,5524,2910,5347,3780,6301,4850,1533,7179,3670,6016,2806,4954,6 800,3673,5714,3723,6473,4574,1973,5538,2996,6254,5422,3493,5064,3864,6261,30 25,5769,6356,3874,4479,1997,5891,7208,3683,5006,2971,6315,3674,5480,5659,348 2,6920,2024,4911,6474,3020,5231,3303,5072,6370,3760,5451,2809,6693,5334,1916, 4966,3725,7236,3320,5429,6682,2925,5013,3441,5308,6531,3262,5569,1974,6452,4 823,3436,5337,3000,6360,4589,3726,7298,3731,5528,4969,1887,6560,2543,5729,34 07,6415,5716,3552,4797,2751,6423,5671,3387,6302,1783,5027,5770,3293,6481,298 3,5349,7187,3442,4852,3685,5279,6694,3026,4956,1022,6816,5540,3494,5430,3497, 6262,4595,3523,6476,2931,5661,4827,2032,6723,3686,5893,7181,3615,5730,2810,4 919,6684,3307,5777,3484,6533,5018,1534,5453,2551,6317,5239,3415,6265,3444,49 70,5720,2973,7216,3847,5014,6697,2003,5459,3389,6343,5338,3294,4598,2926,692 8,5488,3498,6323,3525,5029,5772,1977,7182,2783,5350,6372,3309,4839,3631,5511, 6482,3905,5433,1787,6456,4856,3041,6848,5570,3876,4977,3784,6534,5662,2933,7 240,3906,5454,4590,1998,6318,3733,5353,6698,2987,4798,3880,6725,5675,3851,58 94,6537,3689,5017,1978,7425,5295,3042,4597,3676,6427,5243,3505,6266,3028,577 8,6592,3792,4972,1903,5732,6497,3888,5461,7189,3908,4943,2974,5897,6705,3419, 5088,3969,6347,5340,2005,6207,5434,2812,4543,3315,6484,5544,3734,7300,3526,5 515,6538,2989,4829,5793,2006,6671,3390,4923,6726,3747,5703,3015,6700,5475,36 90,5030,6325,3970,5407,1951,7203,5303,3853,6439,2934,4978,5354,3448,6429,503 3,3500,6376,2879,5245,6268,3737,5677,2019,5059,7426,3808,5780,6349,3639,5736, 2995,6326,4843,3912,5462,6787,3697,4601,1789,6706,5436,2555,7194,5361,3310,4 951,3431,6430,5898,3529,6729,5683,2937,6443,1980,5020,7681,3471,5465,4830,38 59,6498,3663,5572,6355,3032,5517,6545,3750,4925,3506,5523,6329,1911,5327,724 8,2799,5061,3749,6540,5794,3421,6488,5678,3317,5034,2990,6730,5905,2009,6789, 5552,3530,7205,3738,4980,5477,3692,6737,4602,3044,6679,3435,5307,6384,3199,5 356,6350,2021,4845,3263,5784,7193,3019,5744,6239,3854,5041,6471,3479,5707,29 38,6708,5900,2010,5062,7190,3508,5825,3698,6944,5246,3643,6546,4851,2557,650 0,5362,3537,4955,3753,6451,5685,1967,7304,5518,3318,6445,5036,2997,6561,3779, 5466,6357,3422,5576,4926,3671,6712,5478,3021,7428,1915,5525,6976,3740,5007,6 732,3862,5423,5689,3532,6330,3048,4967,7432,3321,5364,6790,3754,5715,6548,20 22,4735,3645,6371,5309,2940,5686,7040,3483,4984,7206,3875,5796,6738,3861,548 1,1790,6562,4575,2998,6446,5826,3781,7682,5709,3437,5042,3512,6793,5335,2911, 6915,4846,3700,6504,5906,1535,6683,5767,3761,7264,3446,5065,6255,2807,5468,5 539,3495,6475,4604,3538,6358,5526,3865,7235,5584,3056,6453,1023,4957,6332,33 22,5800,6593,3443,5921,4853,3553,7209,5482,2558,6361,5710,3646,6552,3485,506 6,6753,2012,5529,6740,3675,5690,7312,3027,5015,6695,3438,5908,5717,3540,6794, 3727,5692,6373,3001,4971,7196,2025,5339,6303,3972,5431,6564,3877,4958,6454,3 687,5828,7237,2811,5718,6685,3756,4854,3782,5721,6917,1975,5771,6754,3501,50 44,7210,3022,5541,6801,3866,5912,6477,3324,5073,6263,3445,5922,7684,3677,573 1,6744,3002,5019,6483,2026,5722,3920,6362,5530,3762,5068,7217,3785,5351,6512, 2927,5808,6796,3704,4857,6374,3554,5773,7242,1917,5368,6535,3878,4973,6457,3 029,5489,6594,3499,5310,7440,3976,5484,6686,3486,5048,6478,3030,5774,6377,32 95,5779,1999,4591,7328,3735,5455,6699,3764,5600,6918,3907,4799,6319,2975,543 5,7688,3691,5341,6267,3544,5031,6802,3527,5490,6756,1918,5733,7456,3043,5074, 6485,3868,5542,6921,3881,5545,6364,3786,5571,7696,3793,4979,6458,2813,5734,6 568,3909,5663,6539,2033,4858,7360,3788,5355,6817,3936,5532,6727,3004,4599,64 99,3882,5463,7712,3678,5492,6431,3984,5021,6327,3794,5895,6378,1979,5437,723 8,2935,5342,6269,3768,4974,6701,3449,5546,6804,5573,3507,7212,4831,3889,6760, 5357,3033,6486,5679,3391,6460,5953,2028,7299,5089,3693,6385,5924,3884,6922,5 832,3045,7249,4981,3556,6707,5954,3502,6489,5781,3910,6596,5035,3739,7218,59 28,2034,6541,5899,3034,6547,5737,6351,3560,5090,7241,3311,5724,6818,3450,555 3,6702,3531,5076,7183,2991,5840,6929,3694,5936,6576,1981,5956,6501,3699,5022, 7488,3509,5467,6331,6017,3452,6380,4860,2939,6808,5363,3890,7301,5782,3533,6 768,5574,3568,6731,5037,3741,7220,5438,2007,6924,5795,6849,3046,5063,6270,37 51,5738,7191,3796,6018,6386,3913,5901,6709,2814,4982,5496,3701,5548,7302,492 7,3423,6542,5785,3539,6490,5856,1982,6600,5687,3510,7552,5043,2559,6502,5960, 6549,3809,5745,7244,3323,4603,6447,3534,5358,6713,3514,5479,6388,3513,5577,7 305,4985,2011,6739,5519,3036,6333,5907,3541,7250,5711,3319,6710,5080,3755,68 20,5798,6505,3914,5554,7224,3049,4847,6850,3810,5797,6733,3971,5469,7195,536 5,3742,6359,5038,2036,6930,5578,3855,6791,5786,2999,7265,5740,6492,3921,5092, 6563,3892,5483,7207,3800,5247,6550,5311,4000,6608,5067,3050,6824,5902,3863,7 427,5527,2023,6945,4986,6506,3439,5556,7252,3973,5746,6734,3702,5691,6553,46 05,3757,7306,5585,2941,6714,5801,3916,6932,5366,6741,3705,5045,7313,3783,582 7,6716,2040,5470,6363,5719,3325,7429,5069,3023,6455,5788,3763,6852,5910,7197, 3896,5580,6742,3974,5096,6745,5369,3758,7211,5802,2942,6795,5693,3812,6565,4 988,6936,3922,5531,7266,1791,5923,6946,3447,5909,6755,5046,3516,7683,5829,35 42,6746,5485,6554,3057,5560,7256,3555,4959,6375,3487,6832,5748,7308,3557,580 9,6797,3977,5494,6392,4855,3867,7198,5543,2013,6513,5586,6334,3003,5913,6508, 3545,5104,7314,3706,5370,6798,5491,3816,6803,5601,3924,7239,4606,6479,4032,5 694,6624,3052,7430,5533,6459,3937,5723,6365,3765,5075,7433,5486,2027,6514,55 88,3869,6757,5775,7329,3978,5049,6566,3058,6020,6569,5925,3787,7744,5735,387 9,6595,6758,4859,3546,7213,5804,3708,6687,5830,6379,3766,5549,7268,3005,5070, 6556,5914,2014,6487,5372,3326,6516,5493,7808,3789,6919,5725,6461,3647,5050,7 219,3985,5968,6366,5810,3870,6570,5833,3031,7316,4975,6597,3883,5752,6381,34 51,7214,5602,6703,3769,5926,6977,5077,3503,7243,5547,2029,6948,6024,6856,367 9,5534,7434,3561,6978,5078,6805,3006,5343,7441,5783,3938,6952,5812,3795,6923, 5955,7685,3558,5023,6761,3980,7272,5739,6748,3790,5592,6577,5575,3035,7330,5 091,3885,6864,5916,6960,1983,5929,7221,6980,3548,5834,6491,3928,5841,7361,48 61,3911,7041,5957,6387,3797,7320,5836,3060,6806,5984,6598,3770,5052,7245,593 0,3986,6462,5726,6819,3824,7332,6032,3940,6762,5842,7042,3891,4983,7936,5816, 2035,6925,5497,3886,6520,7436,5555,3047,6572,5937,7442,3511,5081,6809,5439,4 001,6880,7686,5741,3562,6711,5932,3695,6984,5093,7222,3743,5604,6769,6382,38 11,5550,7251,5958,3064,6503,5787,3988,6601,5082,7225,3535,6543,5608,6931,203 7,5359,7689,5498,3915,6735,7280,5579,3453,6822,5039,3569,6578,5742,7303,2815, 5747,6821,6493,4002,5557,7246,5500,3893,6389,4987,6602,3798,7457,5938,6810,4 033,5581,7362,5616,3944,6764,5789,3564,6507,7253,5094,3703,6271,5799,6335,19 19,5844,7444,6926,3037,5961,7690,4862,3801,6551,5749,6580,3772,7226,5471,677 0,3515,5587,6715,5558,3813,7336,6609,4607,3917,7307,5857,6825,3992,5371,6390, 7267,3051,5582,6851,5562,3454,6494,5561,7254,3894,6743,5084,7228,3923,5589,6 812,5367,3802,6934,7448,5803,2030,6604,5962,6393,3570,7257,5097,6826,3952,58 58,7458,6019,3038,6717,6555,5790,3814,7697,5903,6947,3517,5047,6933,7692,354 3,5969,6853,5940,3707,7364,6509,5848,4004,6584,6048,7309,3759,5098,6772,7269, 3975,5911,6833,5487,3053,6518,7315,6021,3897,6567,5750,6610,2038,5805,7344,6 937,3572,4989,7310,5964,3918,6394,6515,5753,3817,7698,5831,6625,7489,3898,53 73,6718,5071,3804,6557,5811,7199,3518,6747,5944,7368,3007,6022,6510,6612,403 4,5806,7258,4990,4008,6799,7713,5860,3547,7044,5970,6949,7460,3925,5495,6759, 5564,3939,7490,6828,5590,2041,6854,5105,7700,3709,6573,5603,7431,5535,3979,6 938,6396,5605,3059,7317,6025,6517,3559,7270,5915,6749,3767,5051,6992,7273,55 93,3818,6834,5754,7472,3900,6857,5864,7464,3825,5972,6776,6626,3926,6080,733 1,5100,6950,3929,7260,5985,6571,3061,5813,7048,7215,3576,5917,6558,6026,7435, 3871,6367,5106,6807,3327,5835,7553,6836,2042,5927,7714,6979,5594,4036,7492,5 756,6763,3981,6616,5814,7376,3791,5053,6599,7554,5374,3549,6940,5837,6953,39 87,7318,5695,6858,7321,2943,6033,6865,5918,3710,7333,6981,5079,3820,6860,593 1,7274,7008,4016,5499,7223,6954,3941,5817,7496,5551,6750,3563,7056,5727,7704, 3771,5609,6866,7745,5054,3826,6840,7716,5986,3930,6521,5843,6579,7281,2015,5 606,6961,7322,3054,6028,6463,5838,7247,3550,6765,5083,7437,4040,6956,5933,66 28,5596,3455,7276,6574,5976,7746,3982,6982,5959,7392,3887,5845,6811,6632,510 8,4048,7334,6383,5818,3942,7687,6034,6522,7720,3989,5872,6603,7363,5988,3062, 6766,5939,6771,3799,7438,5934,6581,7809,3565,5095,6524,5559,3945,7691,6962,6 049,7443,3773,6605,5610,6640,7748,4003,5743,6813,5791,7459,2044,6823,5859,72 27,3828,6868,5112,7337,6985,3932,6036,6773,5583,7728,3571,6495,5963,7282,380 3,6611,5501,7445,6582,3065,5617,7324,6881,4863,3895,7255,6050,6395,7365,3994, 5941,6606,6586,5846,3946,7284,6585,6081,3990,7338,5992,6613,7229,3574,5612,6 391,7699,5751,4005,6827,7693,5085,6986,3815,7810,5849,6882,7043,3832,5820,74 49,5563,6814,3953,7446,5861,6927,7694,3066,5965,6993,7345,6040,3566,6964,746 1,5099,2031,6872,7556,5502,7072,3774,7259,5942,6935,5971,3993,6511,7752,5850, 7045,3573,7937,5618,6774,7366,3948,6000,6829,7340,5086,3919,6988,7288,5862,6 777,4064,7369,5565,6855,7504,3519,5591,6397,7230,5755,3805,6835,7450,6052,69 68,3899,7311,5807,7046,7271,6023,3039,6830,5101,6884,7346,4006,5945,6994,746 2,5620,3954,6519,7261,5966,6588,4009,7812,5865,6614,7370,4035,5946,6627,7760, 5852,3819,6559,7491,5566,6629,3577,7560,5055,7049,7465,6082,3927,6939,7938,6 056,6617,2039,7275,5595,6778,7348,3996,5973,6888,7319,5987,3806,6996,7377,71 04,5757,7452,3901,7009,6027,7816,6837,3068,5107,7262,6941,5607,4037,7372,705 0,5815,7466,6859,4010,5866,7568,6951,5948,3956,7776,6618,5873,7520,3578,6780, 5974,7493,6838,5977,3821,7701,6398,5109,7323,4017,6861,5624,7378,6719,4038,7 473,5919,7057,7715,5375,3827,6942,7468,6084,6955,3931,7277,6029,6523,7352,58 39,4012,6841,7702,5597,6575,3902,6751,6633,6035,7705,7010,3983,4991,7283,686 7,5758,3055,7335,6630,5868,7393,7052,3943,6064,7494,6862,7474,3711,5989,6957, 7940,5611,6620,3960,7325,5819,7000,7824,5874,2043,6983,7497,5978,6869,3551,7 278,6842,5102,7285,7058,4018,5598,7380,6896,6088,7339,3822,7012,7944,5503,69 63,4041,7498,6030,6958,7394,5935,3580,6583,7717,6096,7073,7706,3933,6634,599 0,7555,6767,6037,3829,7476,6815,5110,7384,6883,4042,7584,5847,7060,7439,3991, 5613,6607,7447,6987,5993,3063,7326,6525,5821,7505,6641,3947,6051,7718,7074,7 840,5876,3934,6965,7286,5980,6870,7500,3830,5619,7747,7105,7708,5851,4020,70 16,7557,5113,6636,7341,4049,6775,5943,7289,6873,6042,3995,7721,6844,7367,599 4,6587,4044,7952,6038,6885,7347,6989,3833,5622,7396,7064,6053,7506,3949,6526, 7480,5863,6966,7872,4024,5880,7558,6995,7342,6001,3567,6874,7722,5114,6642,7 749,2045,7024,5614,7561,6886,5822,7451,3775,6589,7290,6041,6615,7616,4007,56 21,7521,6779,7729,5996,4050,7076,7371,6831,5967,7231,3067,7047,6112,7508,696 9,7562,5567,3955,6644,7695,5853,7750,6990,3834,7724,5947,6889,7349,6970,5087, 3575,7463,6876,6054,7453,6590,3997,7400,6002,7292,7106,7373,3950,6057,7080,7 350,6619,6083,7811,3807,6997,5867,7730,7011,7454,4065,5625,7753,6781,7467,59 75,7051,3957,7522,6631,6044,7379,6839,4011,5854,7569,7353,6890,5949,7564,406 6,6972,7512,5116,6897,7754,6998,4052,6085,7813,7761,6058,7001,3998,7703,6648, 6004,7408,6943,7374,3836,5626,7263,6399,7495,5869,7108,4013,7732,7053,6065,7 968,6863,7570,4039,6086,7524,6621,7475,5875,7059,3069,7469,6782,5979,7585,73 81,3958,6892,6060,7736,7088,8000,5950,3903,7013,7756,7354,6031,6635,7814,401 9,6843,5103,7572,7395,6898,5991,3579,8064,7002,7762,5759,6622,7586,3961,7470, 6008,7112,7817,6527,5599,7939,2046,7054,7528,6066,7707,6959,7279,4056,5870,7 120,7499,7382,6089,7014,3823,7477,7061,5628,7356,7617,6871,4014,5981,7385,66 37,7576,5877,7017,4068,7777,7764,6090,6845,7719,7075,7818,4043,6039,7397,690 0,7327,5111,7004,3962,7588,7478,5995,6643,7709,6875,3581,5982,7941,7778,6967, 7825,5878,7066,4021,7501,7287,6068,7018,7768,7062,4045,6097,7507,7386,6646,6 043,7536,7077,4072,7820,7398,6092,6887,7559,7481,5881,3964,6904,7618,7025,59 97,7710,7502,4022,6638,7401,6072,6846,7723,7942,5615,3935,7065,7343,6645,729 1,5823,7826,7020,3831,7780,6055,7509,6991,7945,7136,6098,3070,7388,7482,6591, 5115,7592,7563,6877,4080,7841,6003,6971,7751,7523,5882,7078,3582,7455,7351,7 026,5623,7402,7081,7293,4051,6045,7725,7107,7828,7784,5998,6891,4025,7510,66 49,7484,5855,7409,6999,7946,3835,6113,7731,7068,7513,6878,6005,7620,4046,756 5,6973,7571,6059,7375,7109,7842,4026,6114,7726,7082,7953,7600,6100,7028,7525, 3951,6650,7355,6046,7404,6893,7832,7792,4053,5884,7089,7755,7948,7110,6061,7 873,7294,4054,6899,7410,6087,7003,7733,7566,7084,3999,5117,7514,7624,6974,60 06,7526,7573,7055,4067,7471,5951,7737,7015,7412,7763,6067,6783,3837,7357,773 4,7032,5627,7844,7529,6623,4028,7874,6009,7757,7090,7383,6894,7954,6104,3959, 7815,7113,7516,7587,5871,6652,7574,7632,4057,7005,6062,7848,7969,6901,7530,6 116,7758,7114,4069,7577,7738,6091,7063,7956,7765,7740,7019,2047,6010,7387,74 79,7006,7876,5629,7766,6902,4058,7769,7819,6069,7092,7589,7960,7121,7970,401 5,6093,7779,7067,7770,7578,6120,7116,7399,7856,3963,6905,6012,7821,7416,7021, 7537,7358,6070,4070,7532,7096,7822,7827,5983,6639,7503,7648,6847,3838,7483,5 879,7389,7079,7538,7781,7122,5118,7590,3583,7593,7619,7027,6128,7782,7711,69 06,7403,7580,3071,5630,6647,7511,7540,7069,7943,6099,7485,7390,4060,7022,759 4,7621,6073,6879,7405,7727,8001,5883,4073,7137,7972,7880,7029,8002,6094,7829, 7083,7976,4023,7947,7785,6074,7138,7772,7601,7124,7888,5999,7984,4074,8004,7 070,7515,8065,6101,6908,7411,7830,7622,7085,3965,6102,7486,7843,7111,7786,80 66,6047,7949,7030,4047,7544,7596,6975,7833,6115,7904,7735,7091,8008,7793,396 6,5885,6651,7406,7527,7625,7033,6076,7567,7955,7759,4081,7128,7846,7602,6007, 6895,7845,7517,7413,7086,6105,4027,7626,7834,7788,7140,7531,7295,6117,7359,7 115,7950,7575,4076,7034,6106,7604,7794,7739,6653,7633,7849,6063,7414,4082,70 93,7875,7518,7767,7117,6011,7836,7958,7628,7144,7417,4029,7850,6118,7741,703 6,7579,7971,7957,5886,7094,7877,7533,4055,7608,7007,7796,5631,7857,7542,6903, 7591,7634,7961,7152,4030,5119,7418,7539,7649,6654,7742,7581,6108,7771,7123,7 534,7636,4059,7823,7097,6121,8068,7973,7783,6907,7852,7878,6071,7597,7118,40 84,7962,7420,7541,7773,7098,6122,8016,7858,7881,7023,7800,4071,7650,6013,797 4,7125,7595,8072,7582,7126,7391,6095,7831,7860,8003,4088,7071,7787,7640,7623, 6014,7139,7964,7977,7882,7889,6909,8005,3839,6129,7884,8032,7100,7978,7774,8 080,7890,6075,7031,7864,7545,7603,4061,7985,7129,7487,6124,7789,7980,7141,76 52,7598,8006,7835,6130,7130,4075,7656,7407,7546,7627,7087,7790,6077,7795,760 5,7548,7035,7986,7629,7664,4062,7837,6103,7142,7847,7892,8009,6910,7797,7519, 7635,6078,7606,6655,4077,7905,7419,7630,7610,7609,6107,7132,7637,7415,7851,8 010,7145,7906,8067,7838,4031,6132,7951,7095,8017, 7988, 7896,8096, 7146, 7959,61 19,7535,8069,7798,7853,7037,4083,8012,7801,7879,6136,7421,7119,7859,7992,807 0,7854,7038,7908,8018,5887,7543,4085,7612,7638,7153,7651,7583,7653,8073,7963, 6109,7099,7641,7802,7912,8020,8128,7148,3967,8033,7861,6123,7965,8074,7154,7 883,7975,7642,7804,7862,7101,6110,7422,7885,7743,4078,8081,7966,7127,7979,75 47,7865,7599,6125,7775,7657,7102,8034,7891,7654,8076,7886,7131,4086,7981,607 9,7644,8024,8007,7893,7156,7866,8082,7920,8036,7987,6131,7982,7143,7607,8097, 7658,4089,7791,7839,7907,7160,8084,7631,6133,8011,7549,7665,6911,8098,7989,7 894,8129,8040,7660,7799,6015,4090,7133,7897,7868,7611,7909,8013,8088,7147,75 50,7990,8019,7898,6126,7666,8048,7134,7910,7613,7639,7803,4063,8100,7855,807 1,7149,7993,6134,7668,8014,7913,7994,7900,7614,7103,8130,8104,7643,8021,8035, 6137,7805,4092,8075,7155,7655,7863,7914,7996,7921,8022,8025,7157,7672,7967,7 423,6138,8132,8077,7887,7645,8083,7039,7806,7916,8112,4079,8037,7659,7867,79 22,8026,6111,7150,7646,8136,7551,8078,7983,8144,8038,8085,7158,7895,7661,804 1,7869,8099,6140,7924,8028,4087,7667,7899,7161,7991,8090,8042,8086,7670,8101, 7911,7928,8049,7162,7662,6127,7870,8089,7669,8044,8015,8160,7615,7901,7995,7 135,8102,4091,8050,8105,8131,7915,7673,8023,6135,8092,7902,7997,7164,8133,81 06,8052,7674,7917,8113,8134,7923,8027,8108,7998,8079,7151,8039,7807,8056,613 9,7647,8114,4093,7918,8137,7676,8029,7925,8138,8087,7159,8043,8030,7926,8116, 8145,8091,8140,7929,8045,8120,7663,6141,7871,8103,8146,7163,8051,7930,7671,8 093,8046,7903,8161,8053,8107,4094,8162,8148,8094,7932,8109,8135,7165,8054,79 99,8115,7675,8057,6142,8152,7919,8110,8164,8139,8058,7677,8117,8141,8168,806 0,8118,8031,7927,7166,8176,7678,8147,8121,7931,8142,8122,8047,8149,8150,8095, 4095,8163,7933,8124,8055,8153,8165,6143,8154,8111,8059,8166,7934,7679,7167,8 156,8169,8119,8170,8061,8143,8062,8177,8123,8172,8178,8125,8151,8126,8155,81 80,8167,8184,7935,8157,8171,8158,8173,8127,8179,8181,8063,8174,8182,8185,818 6,8159,8188,8175,8183,8187,8189,8190,8191]; 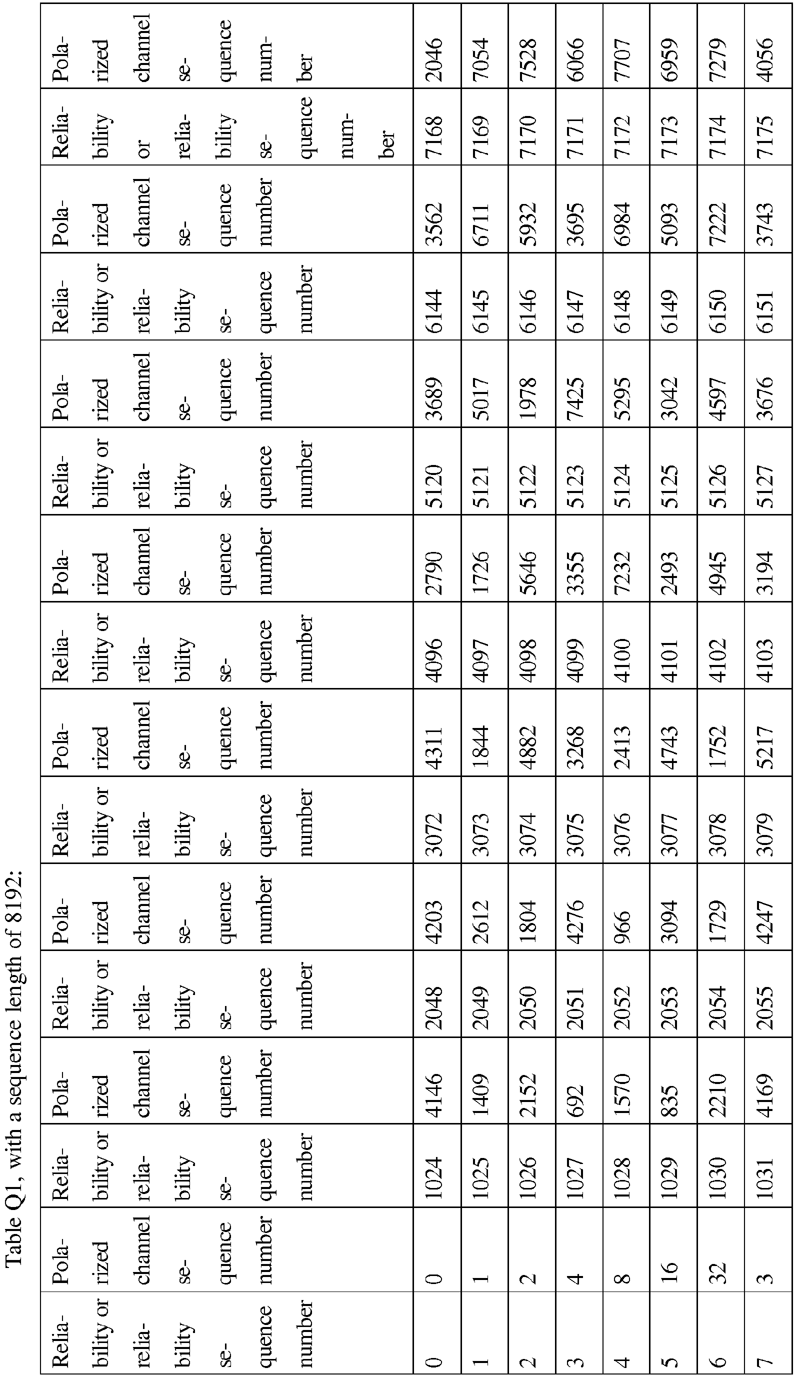 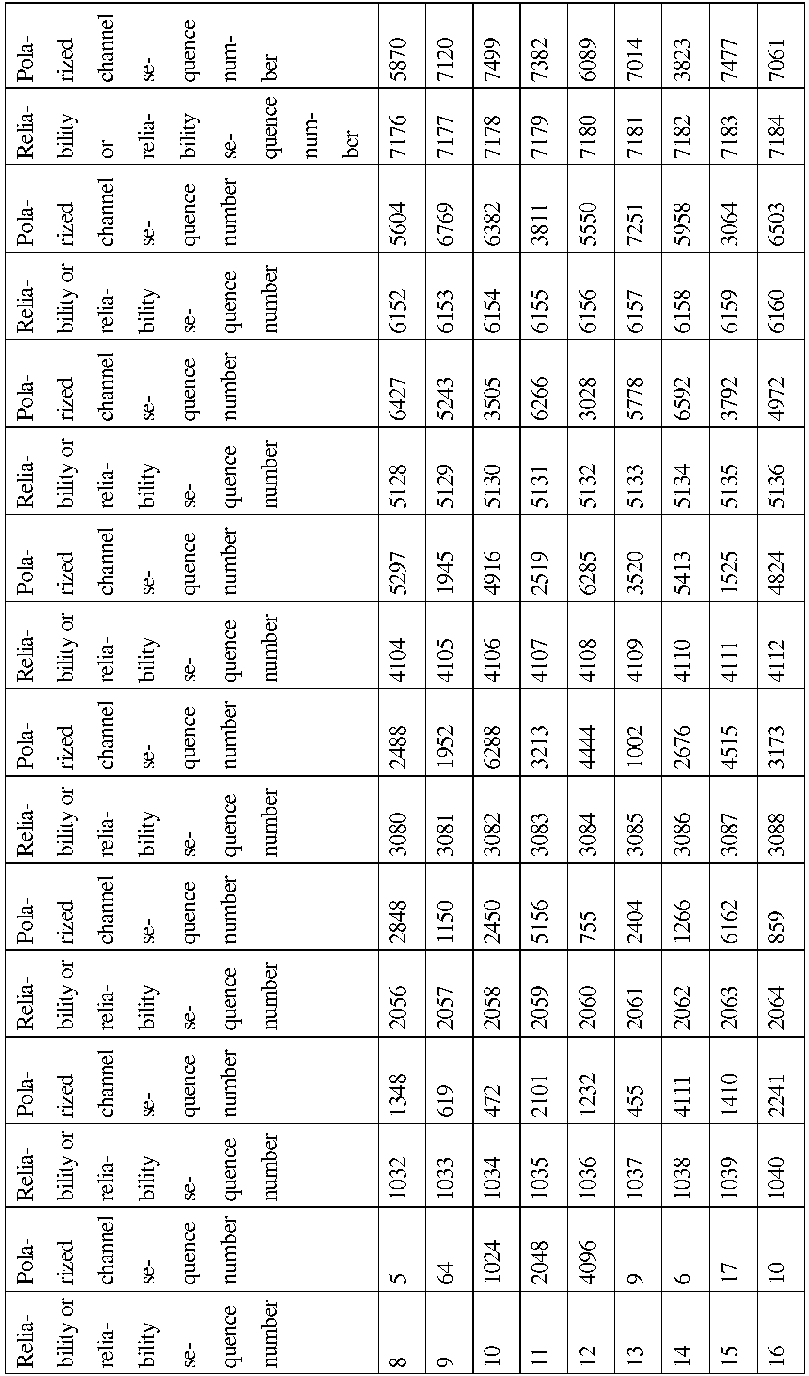 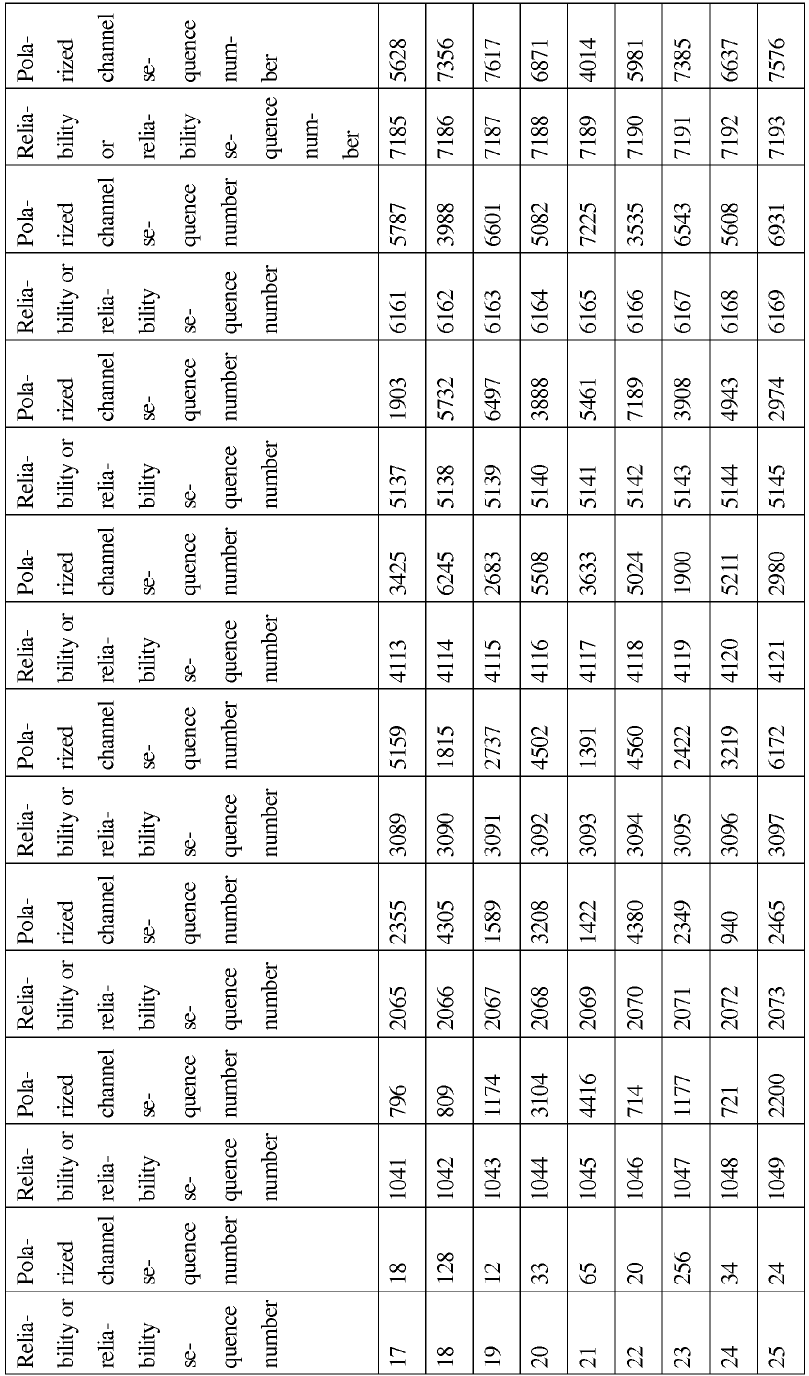 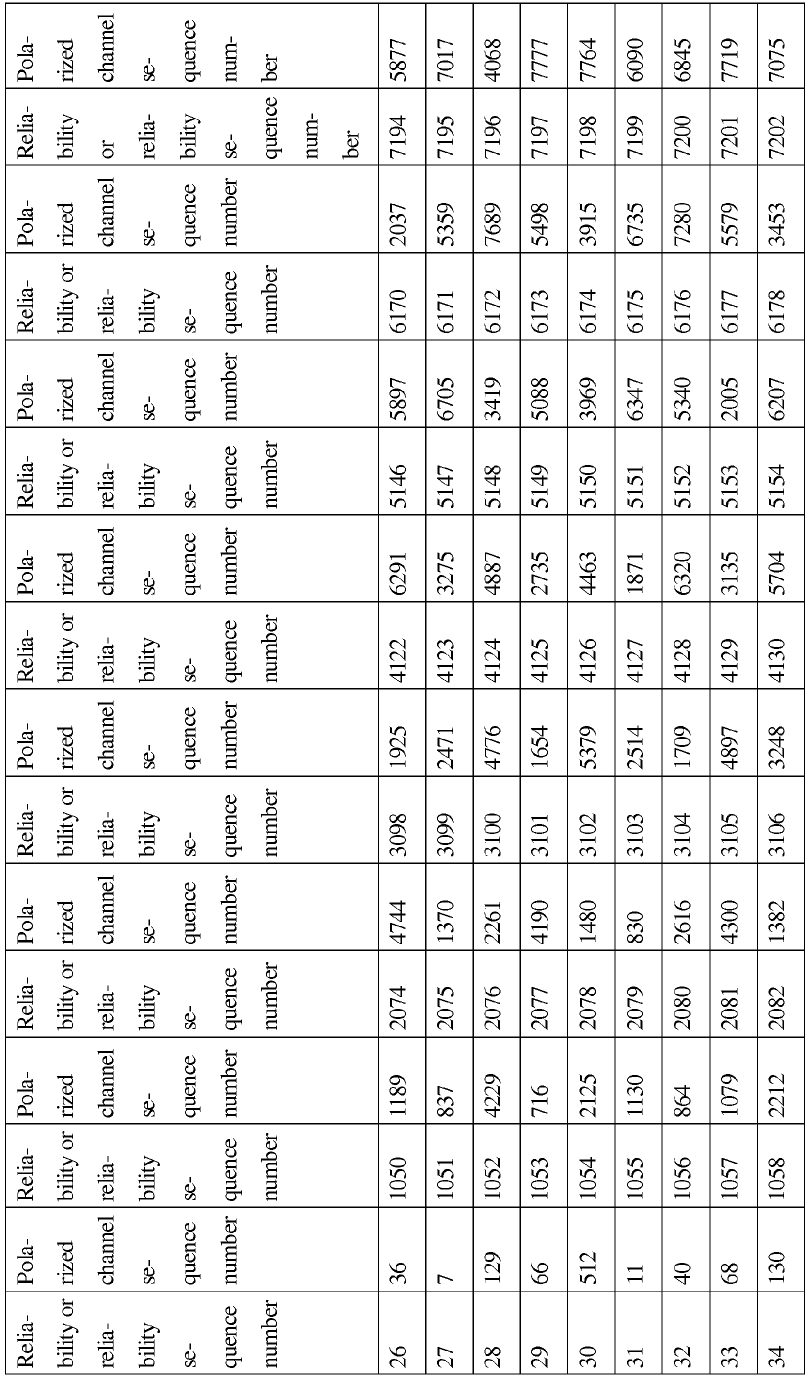 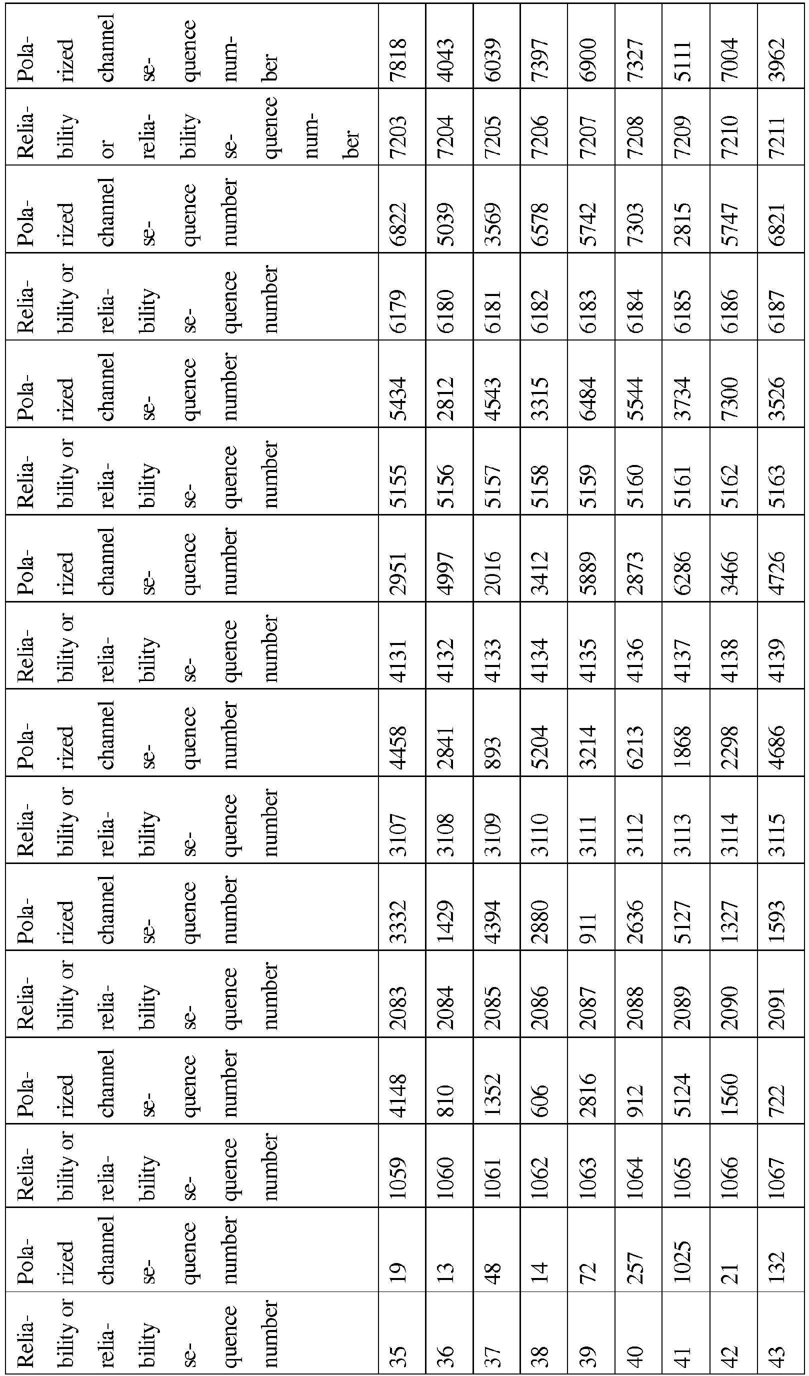 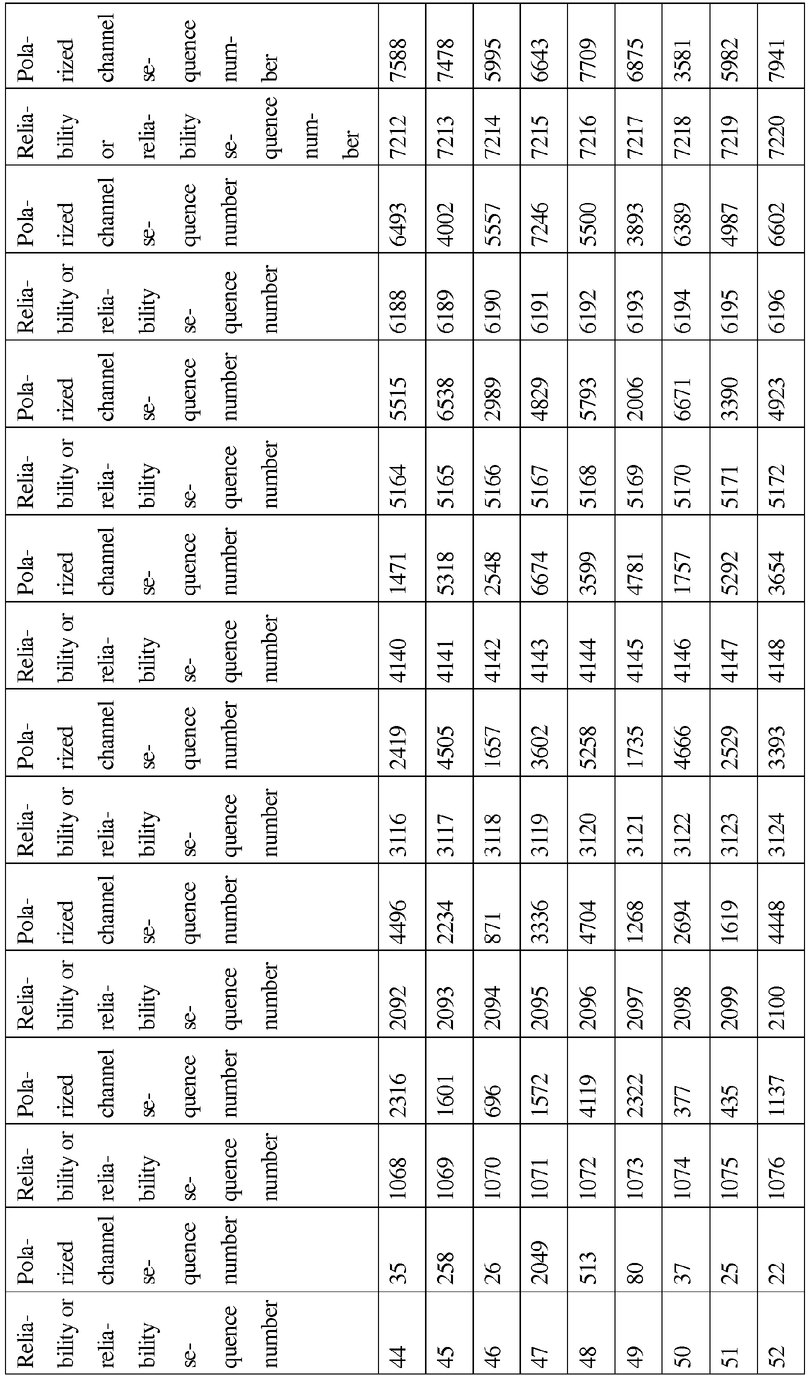 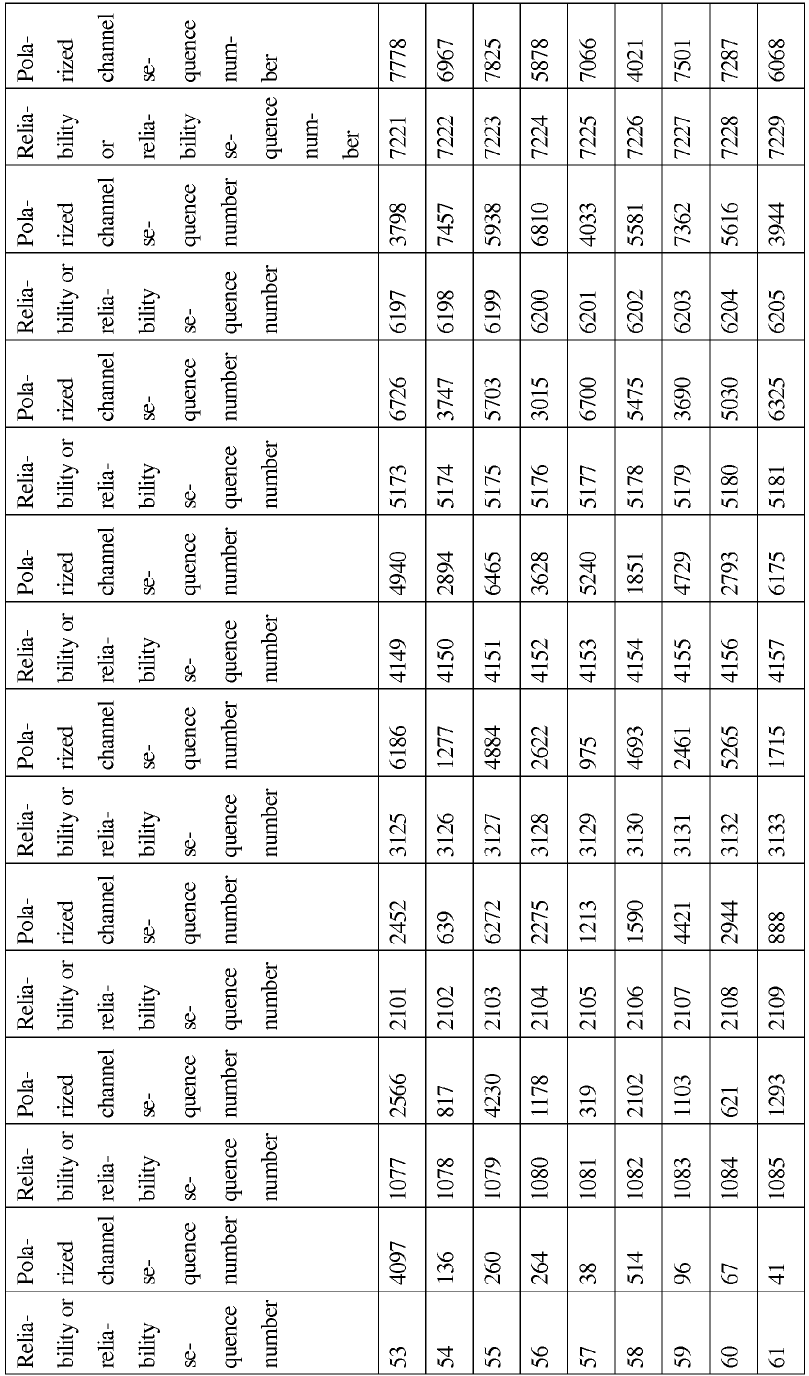 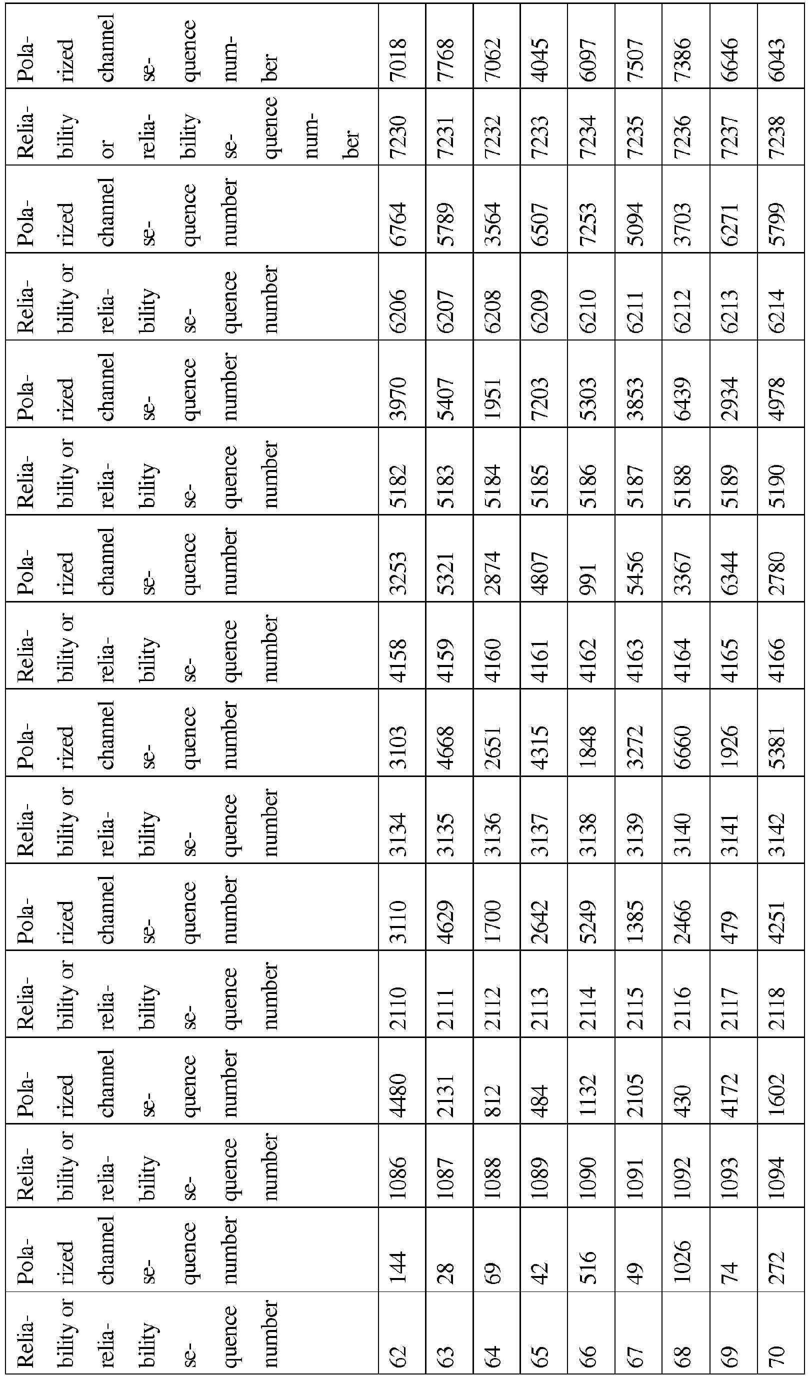 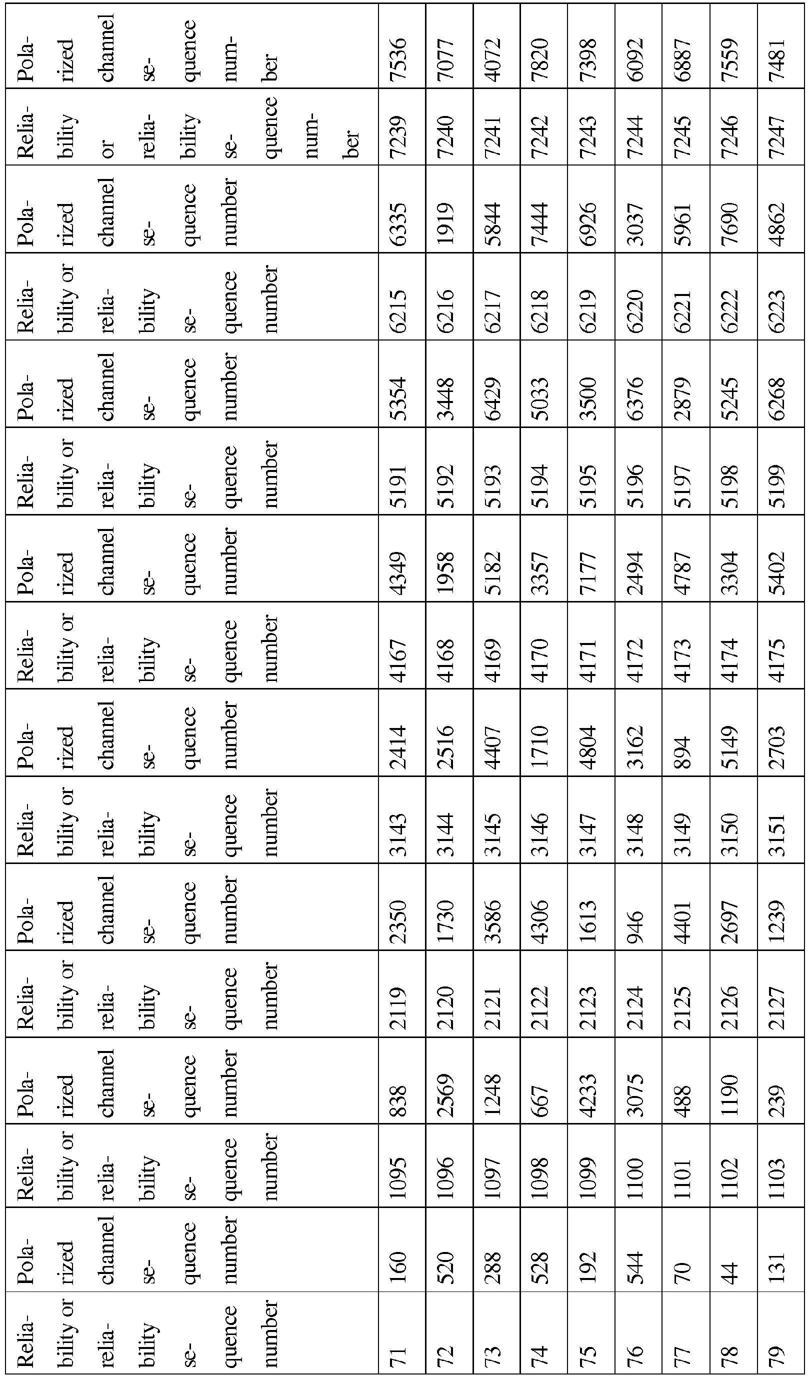 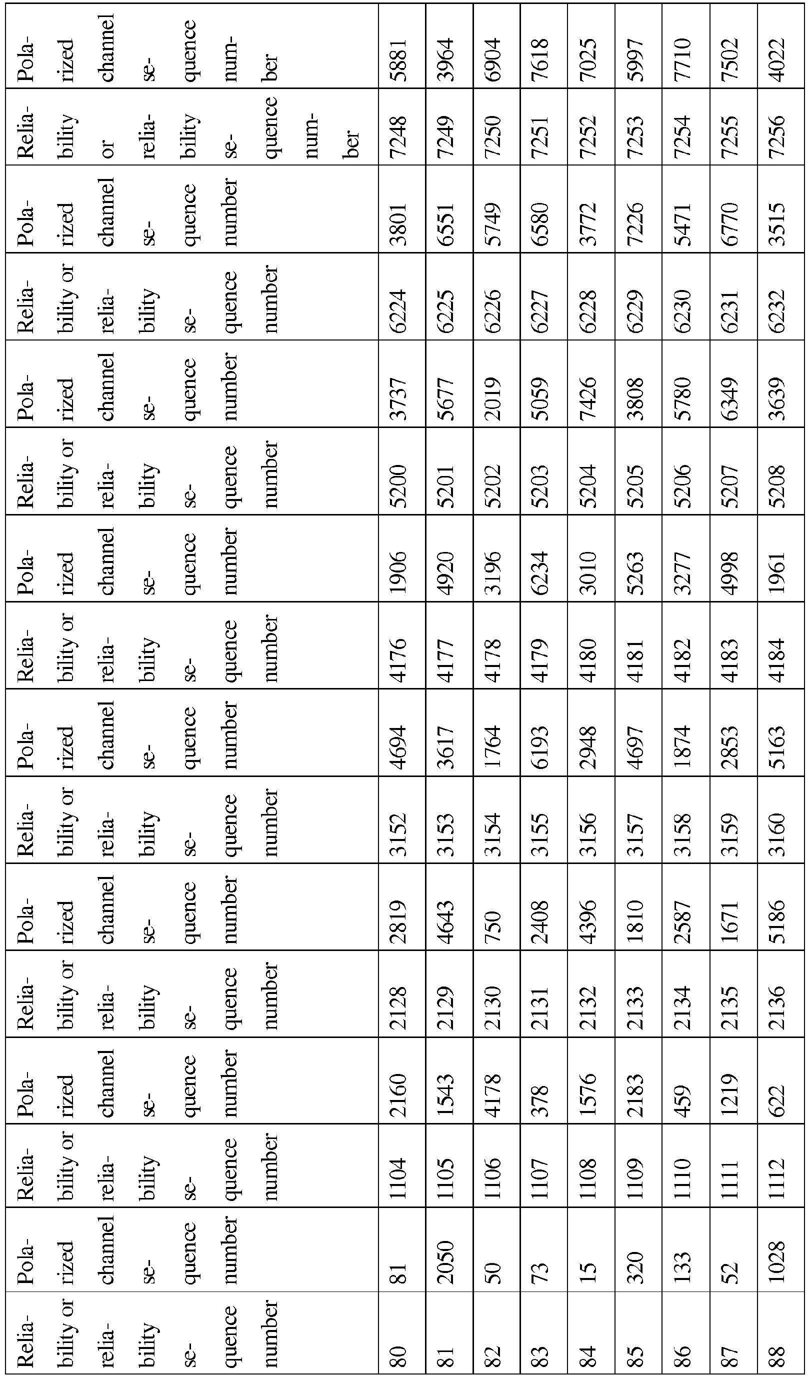 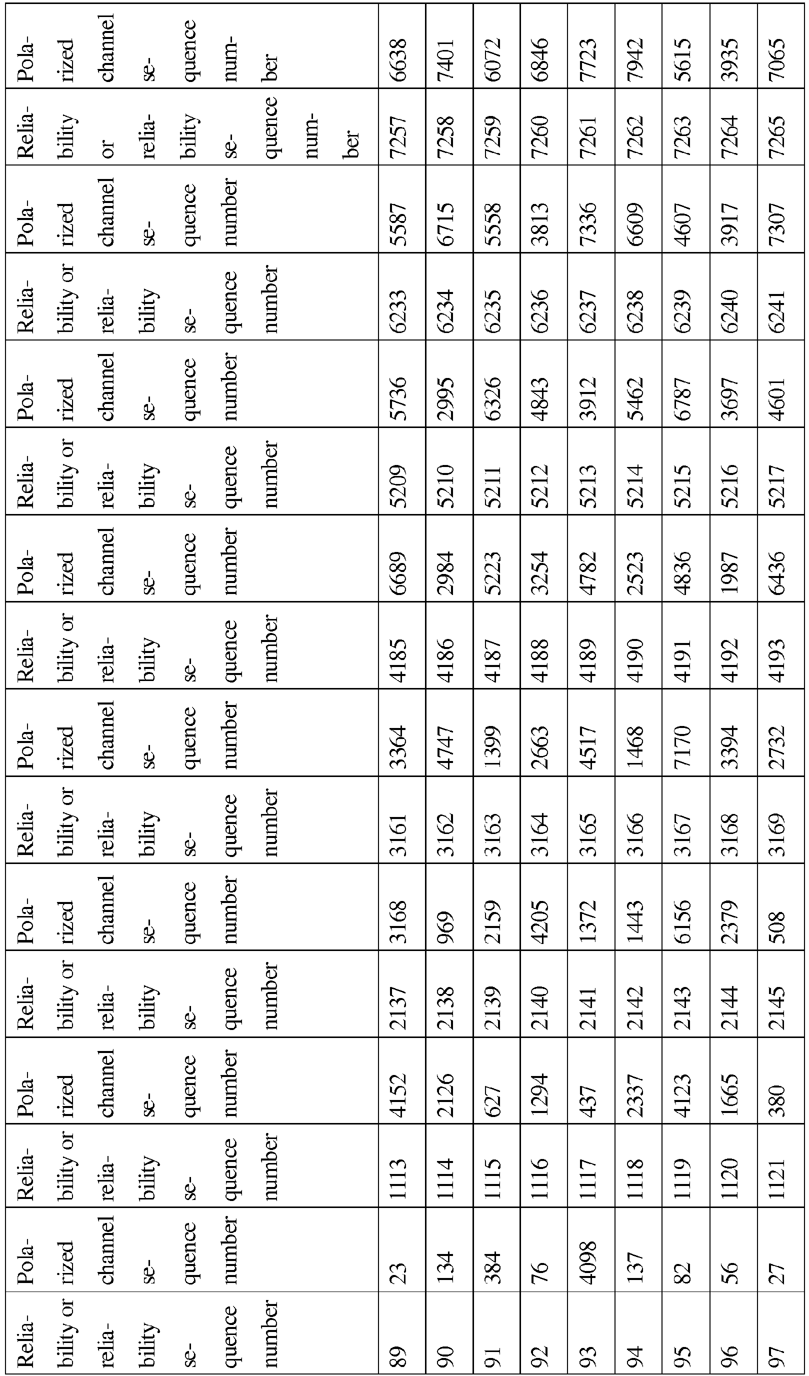 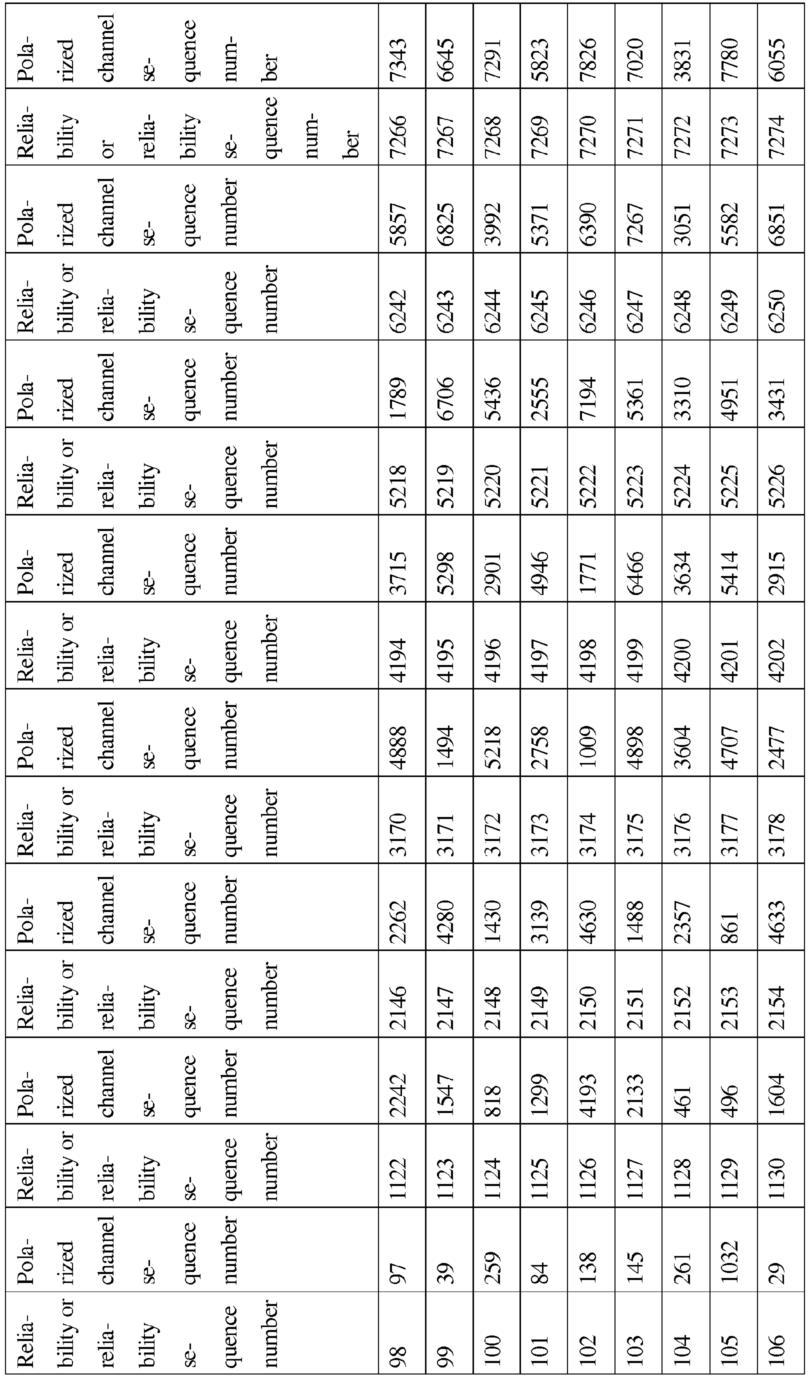 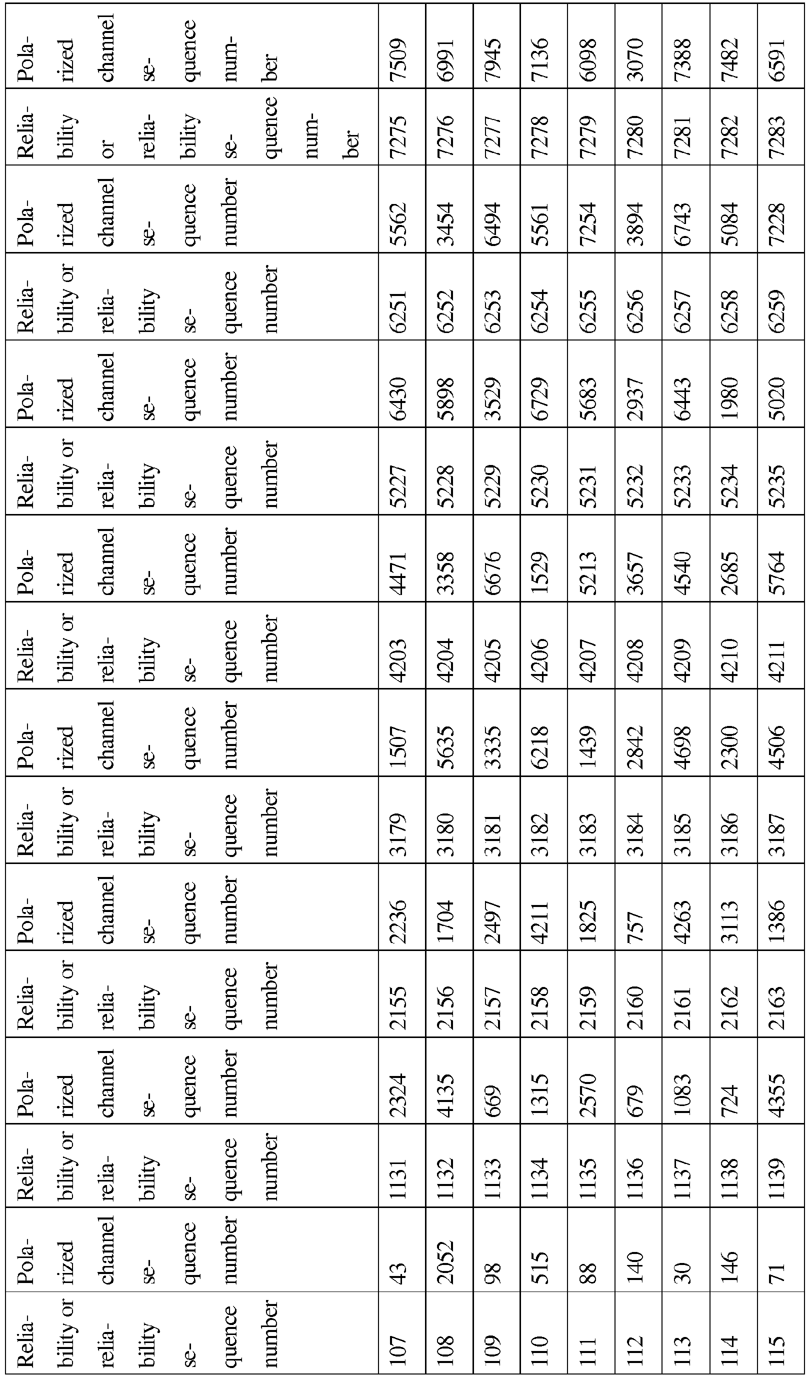 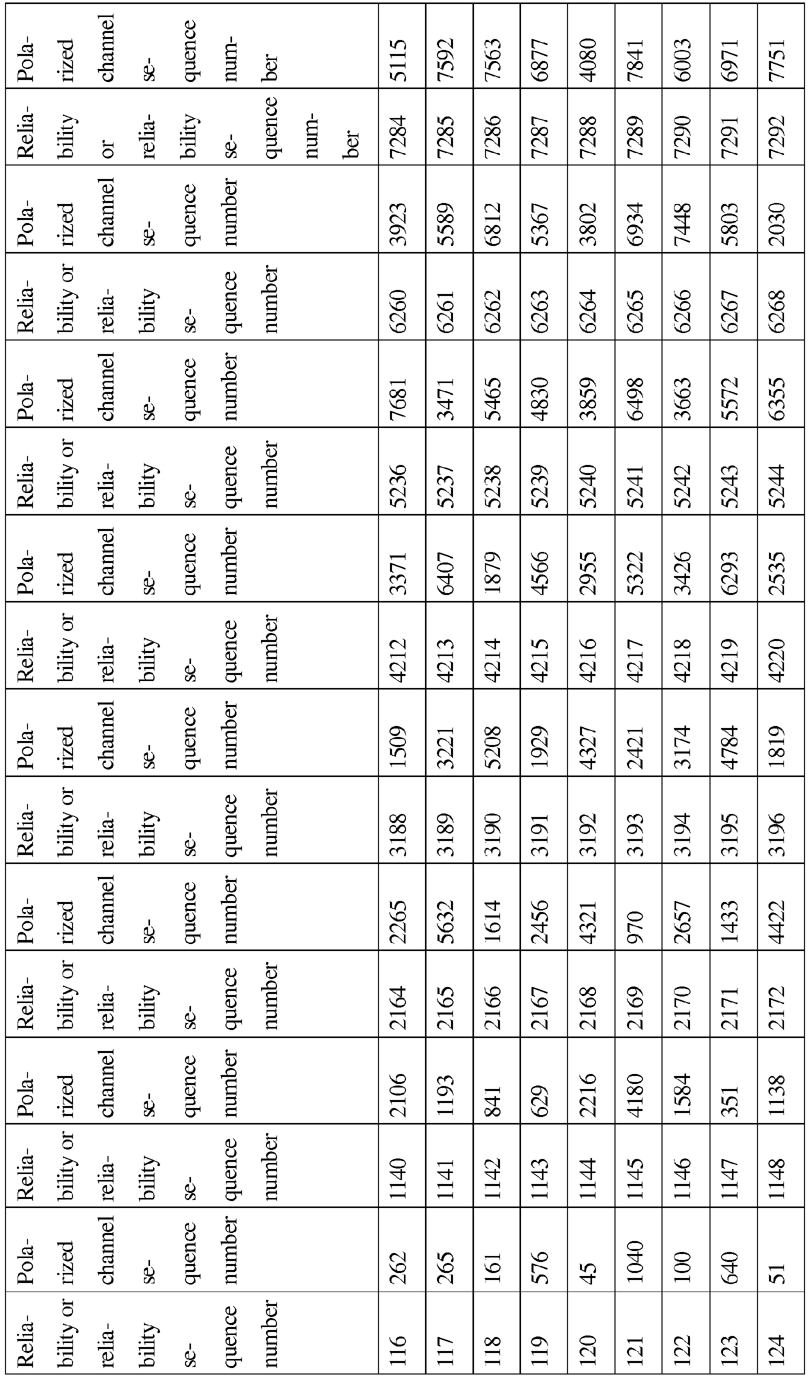 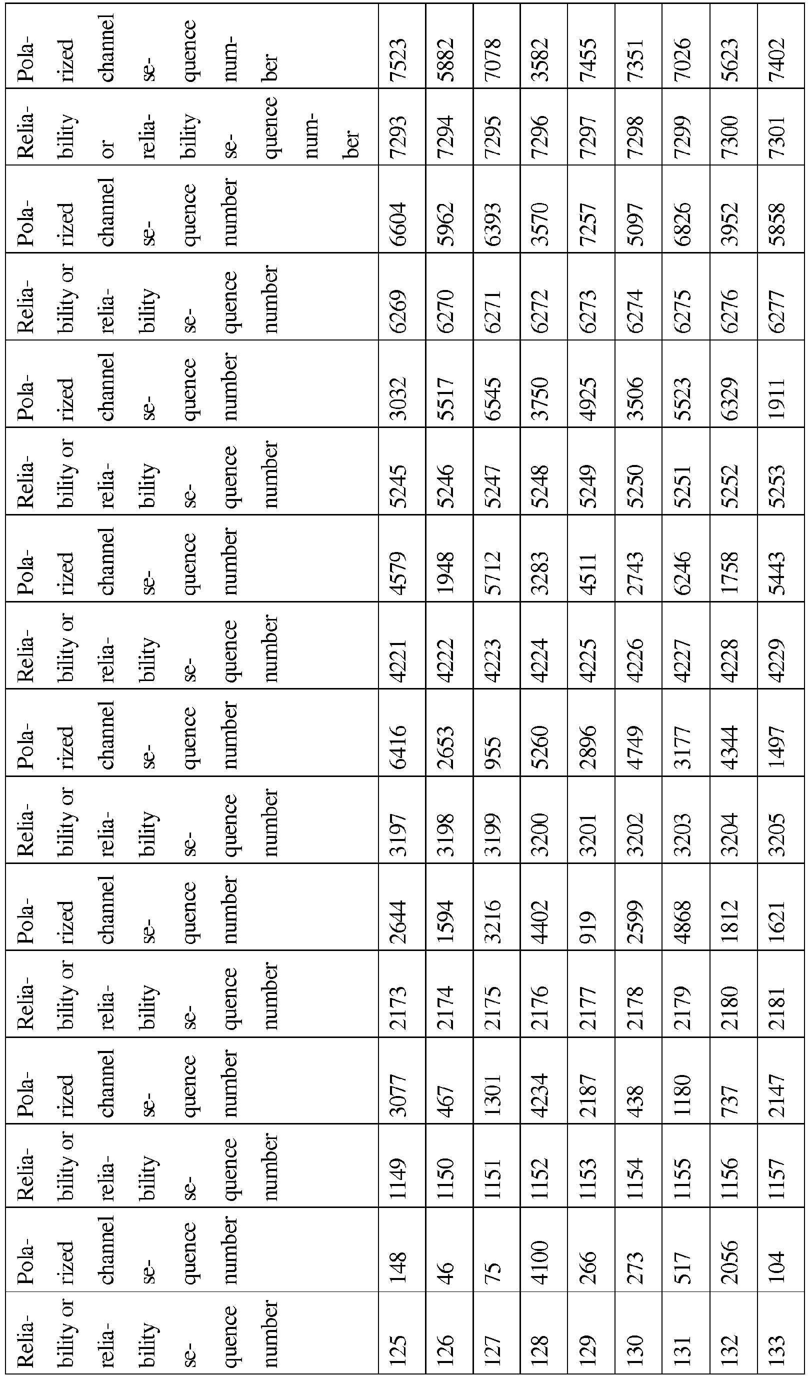 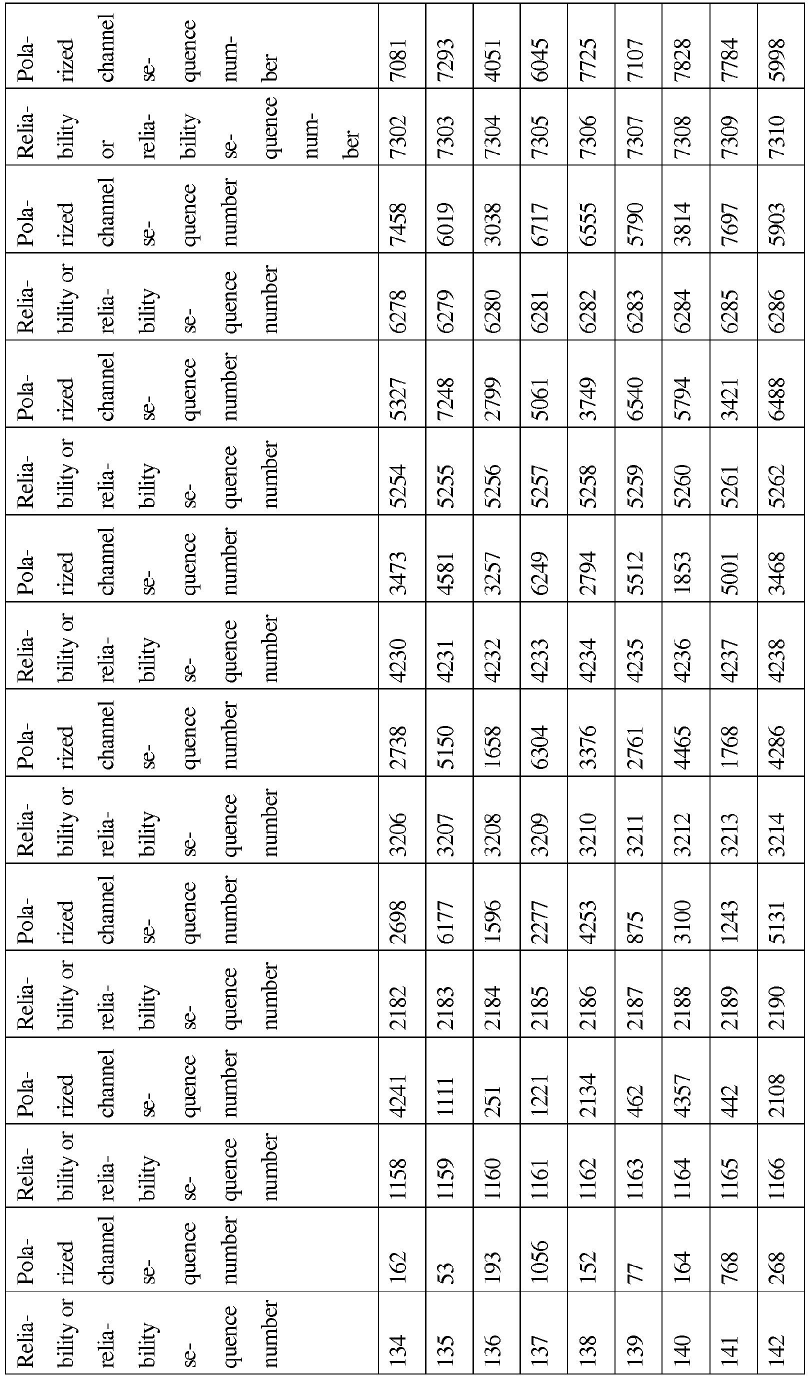 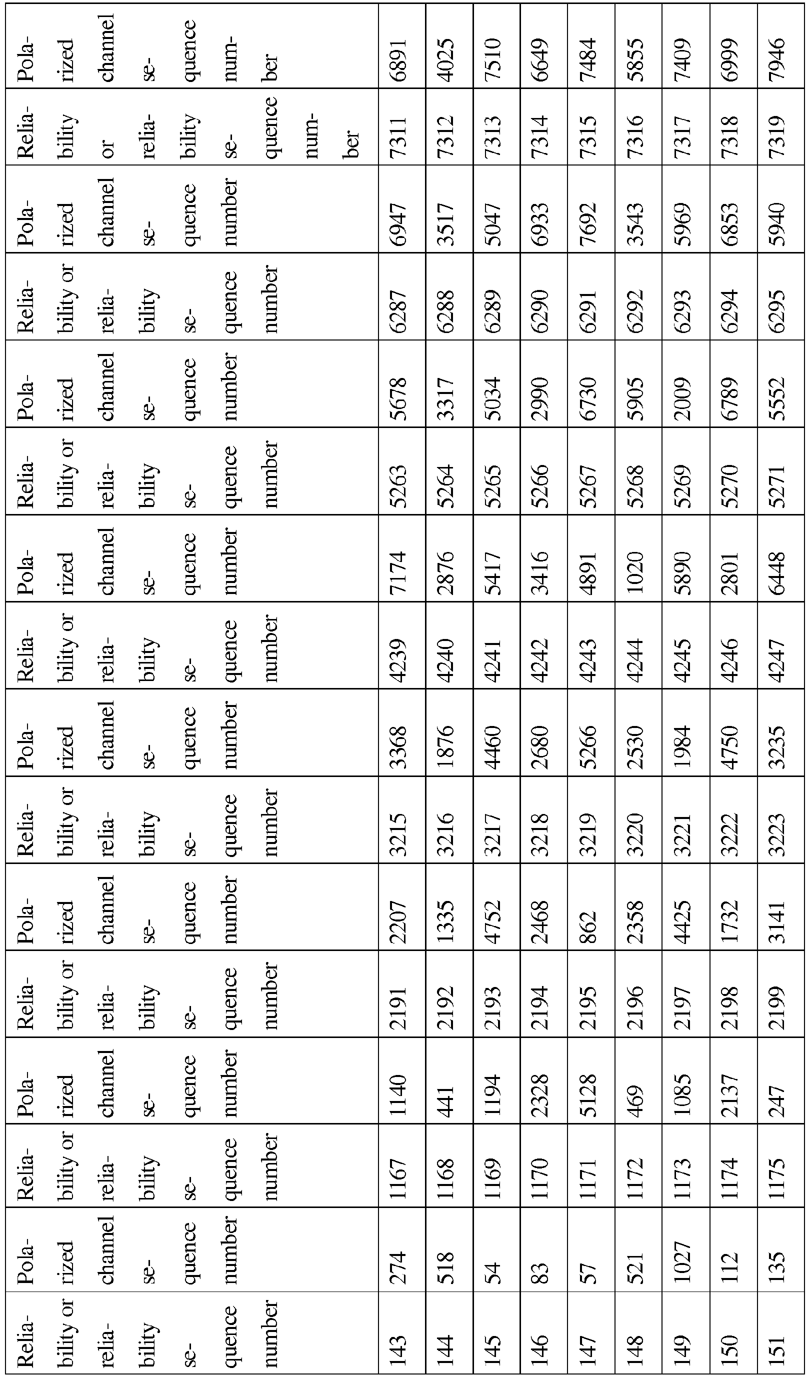 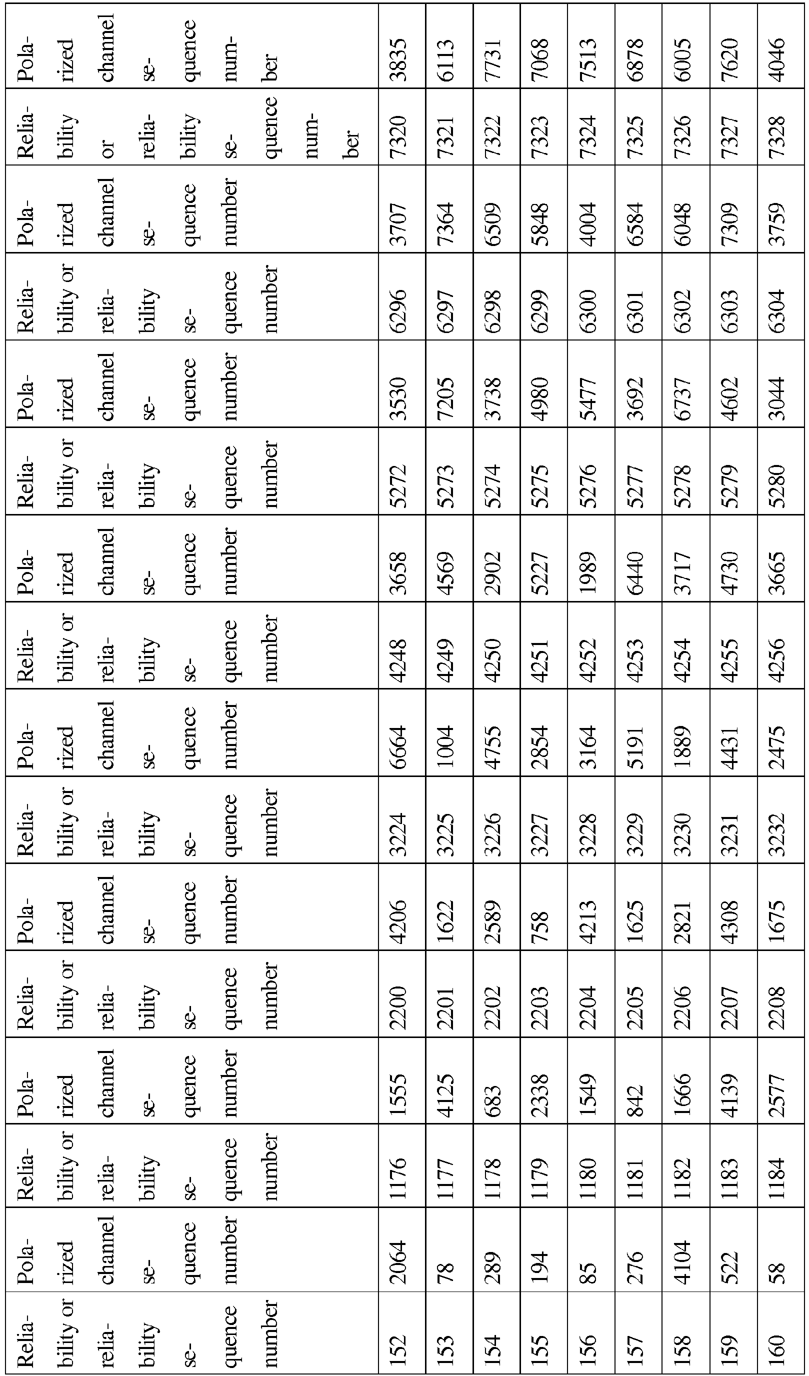 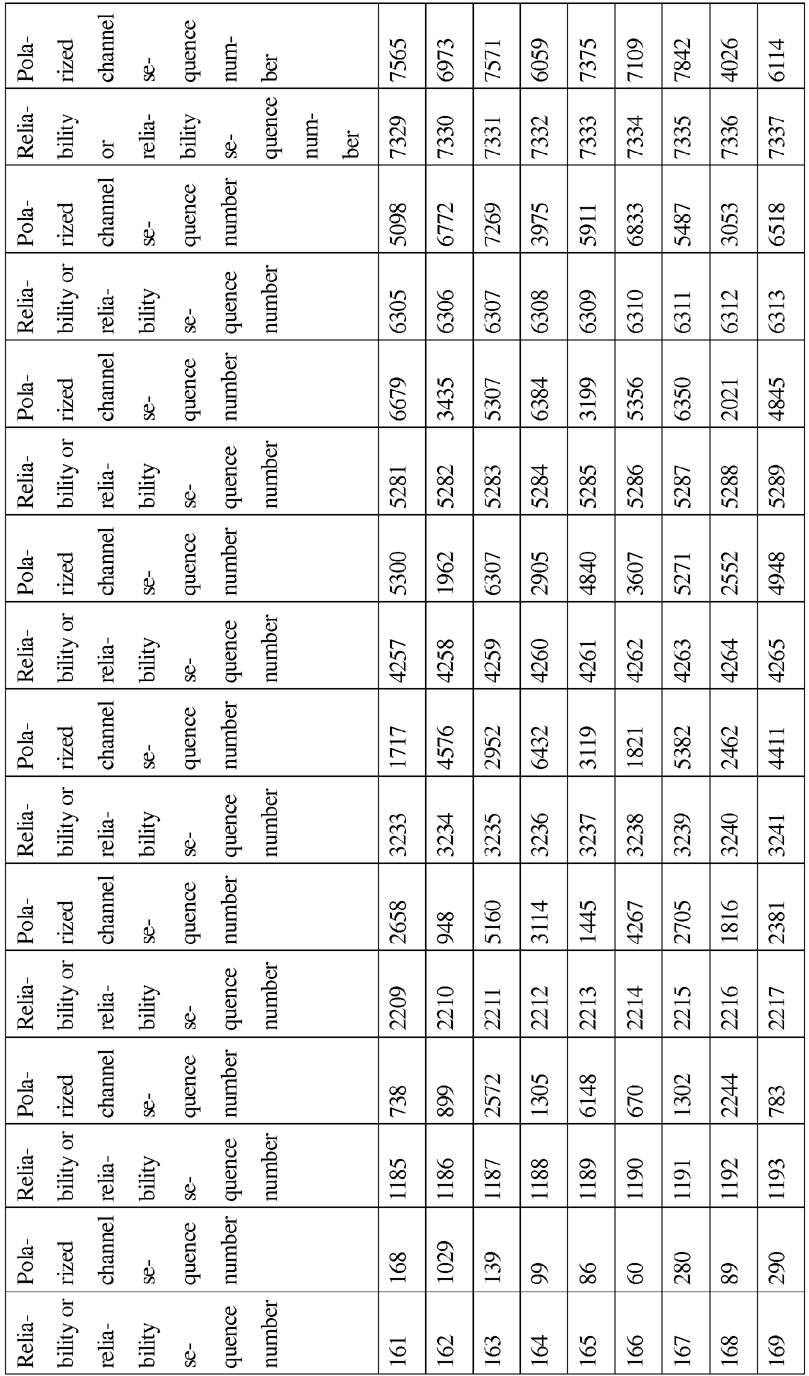 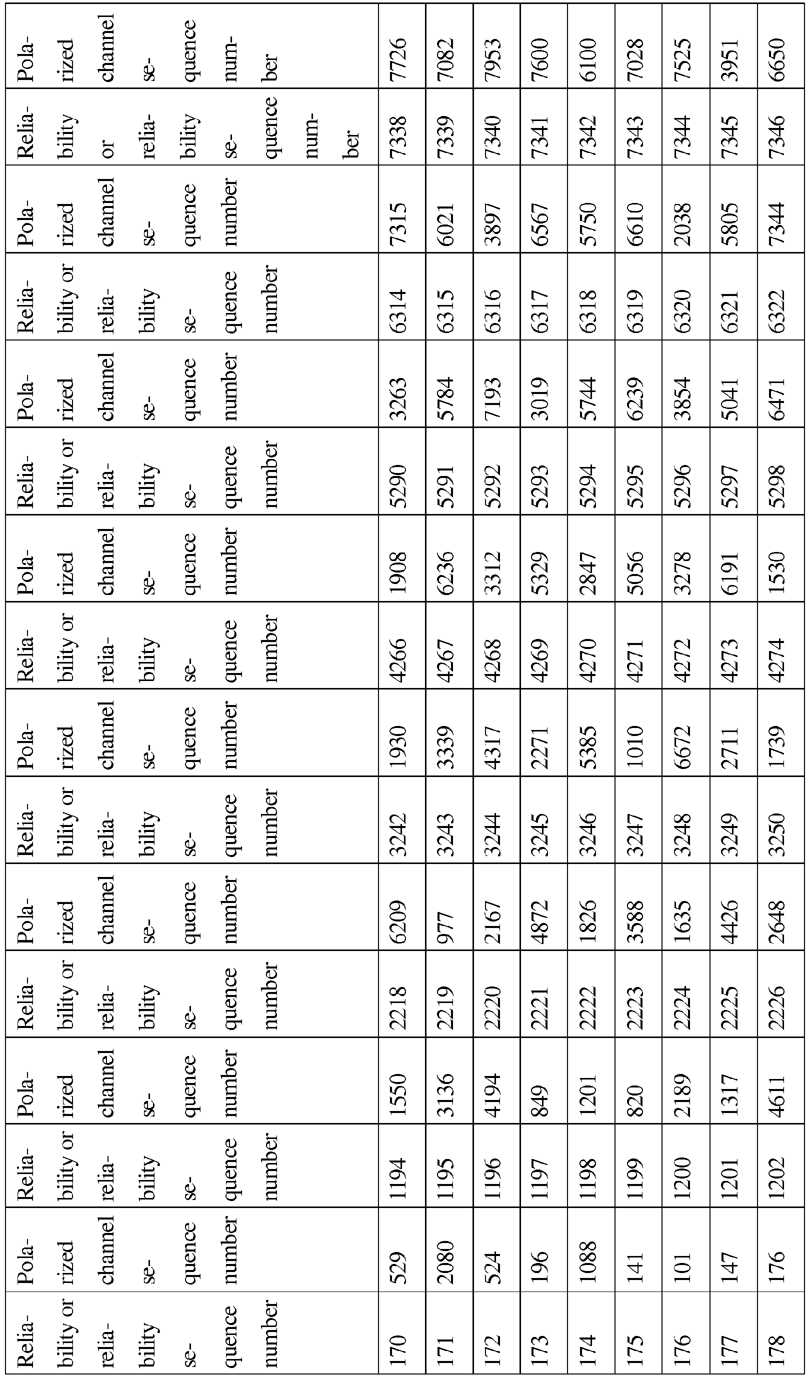 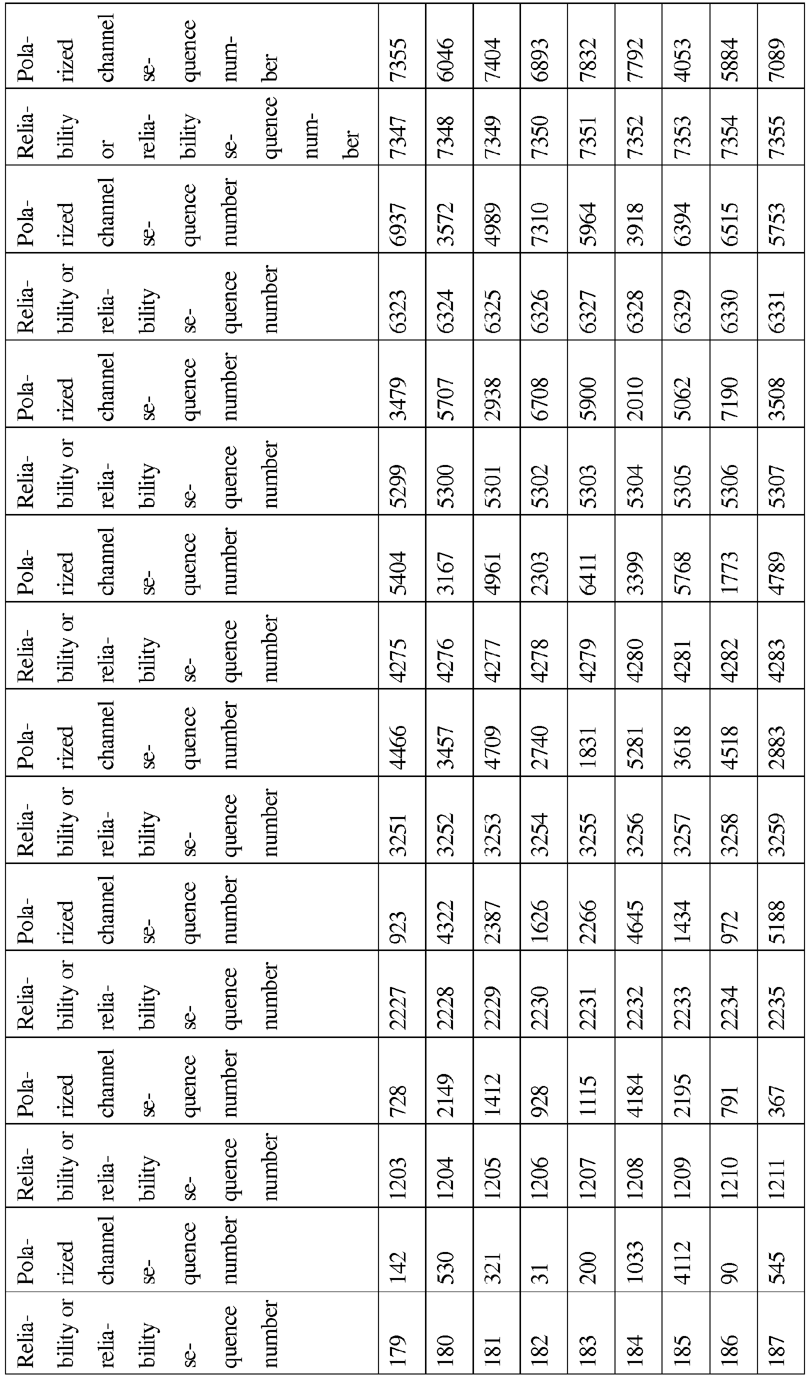 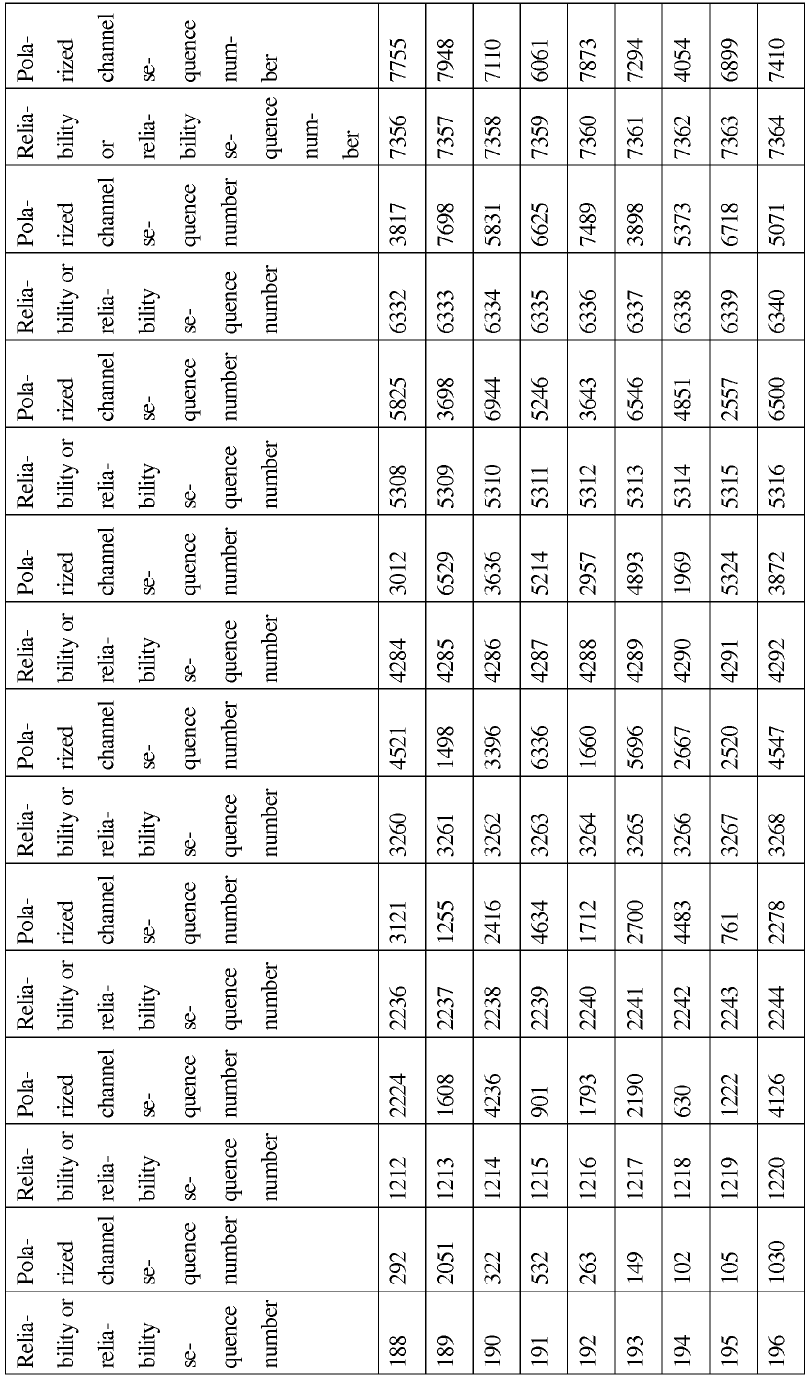 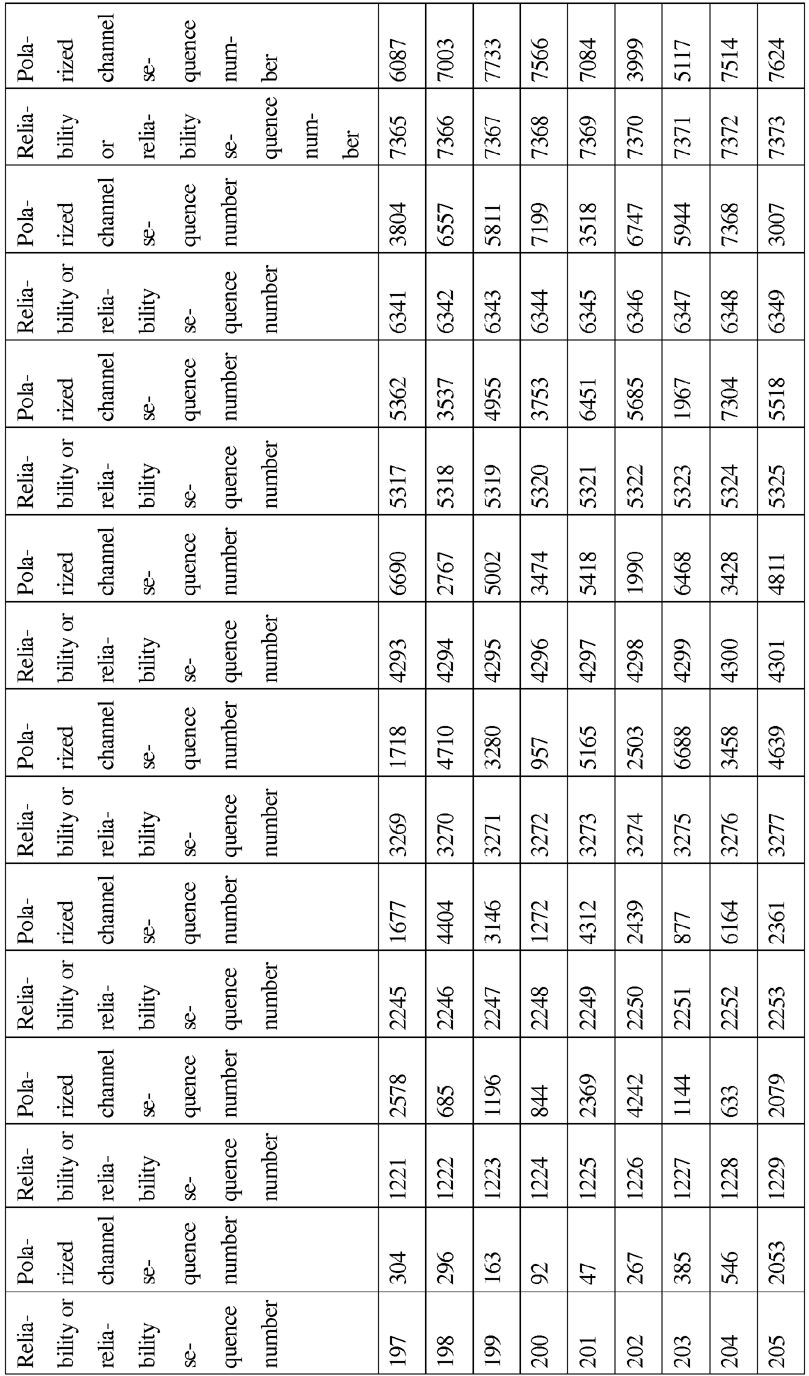 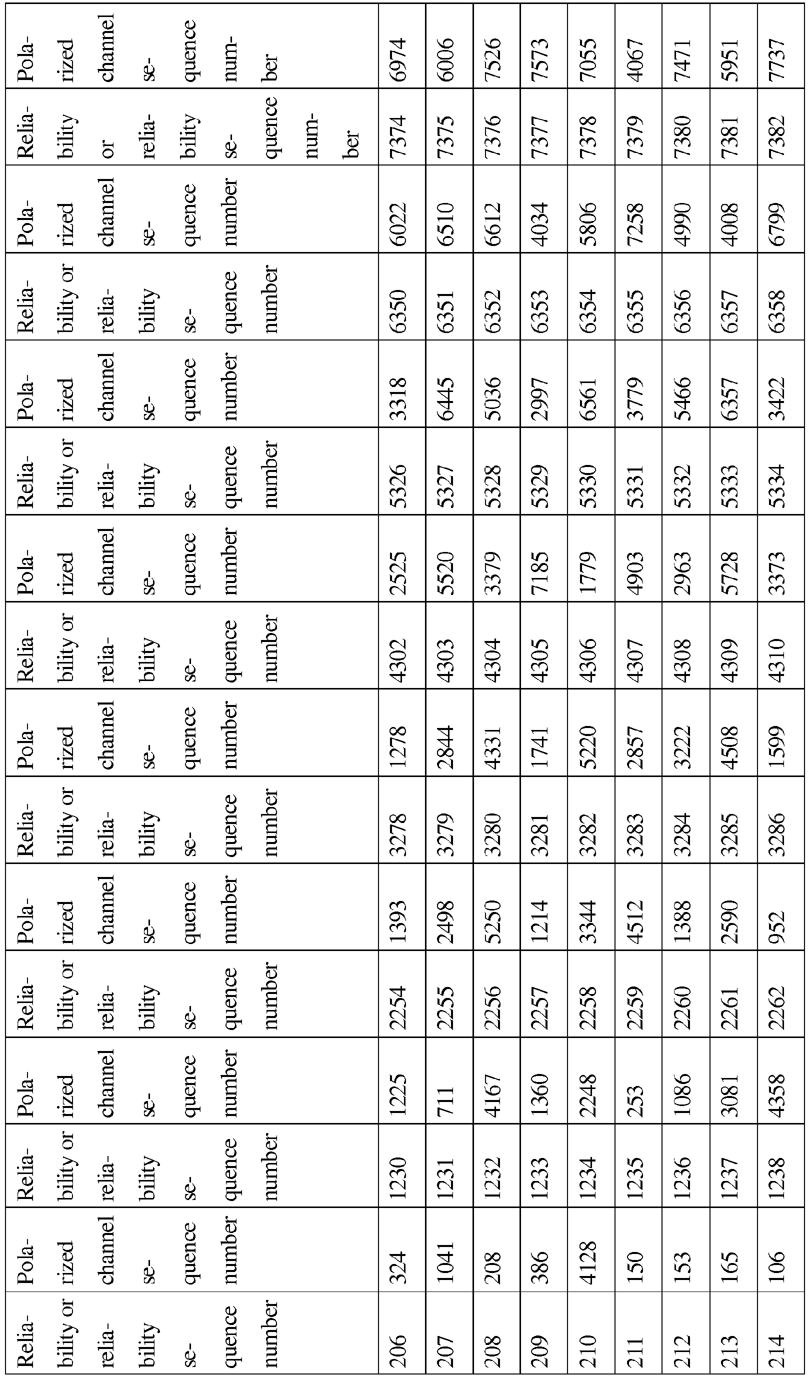 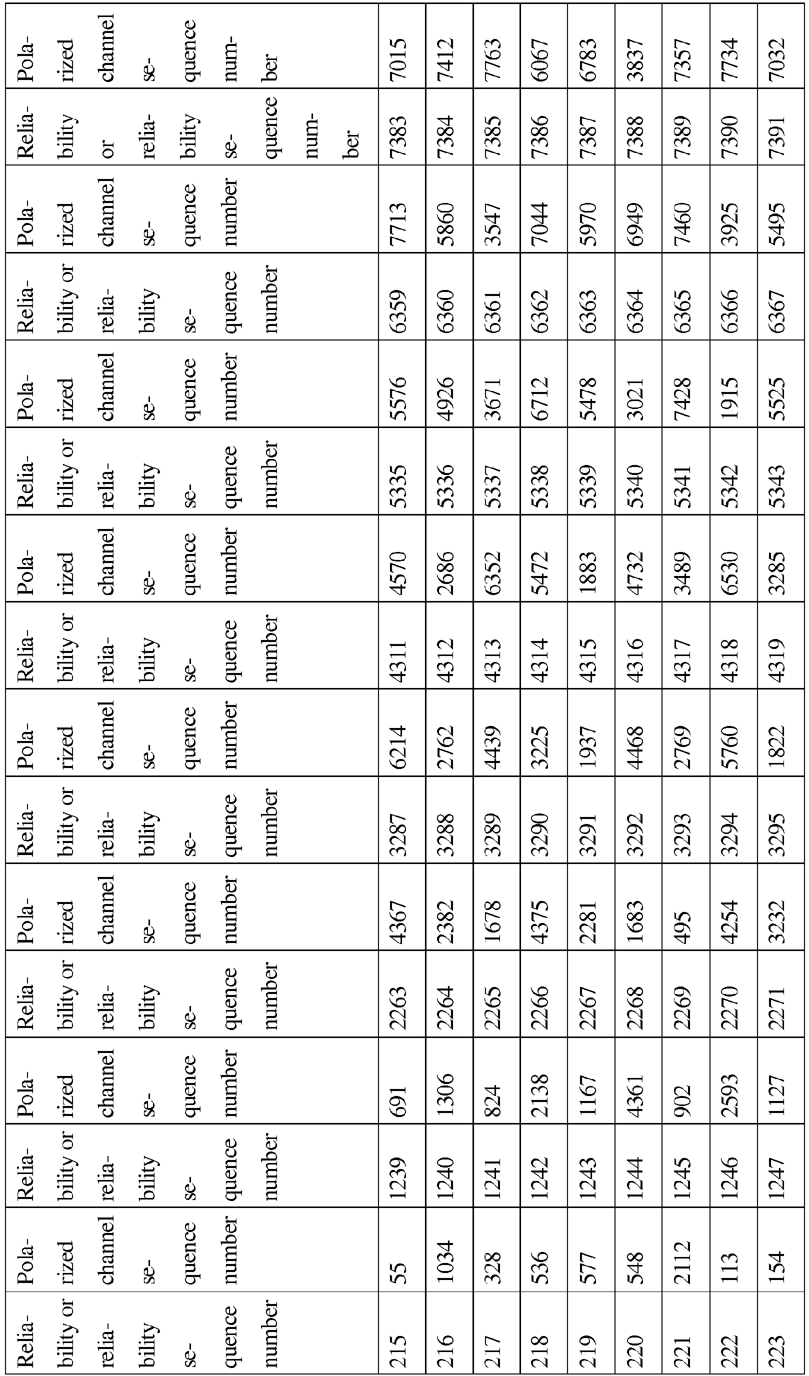 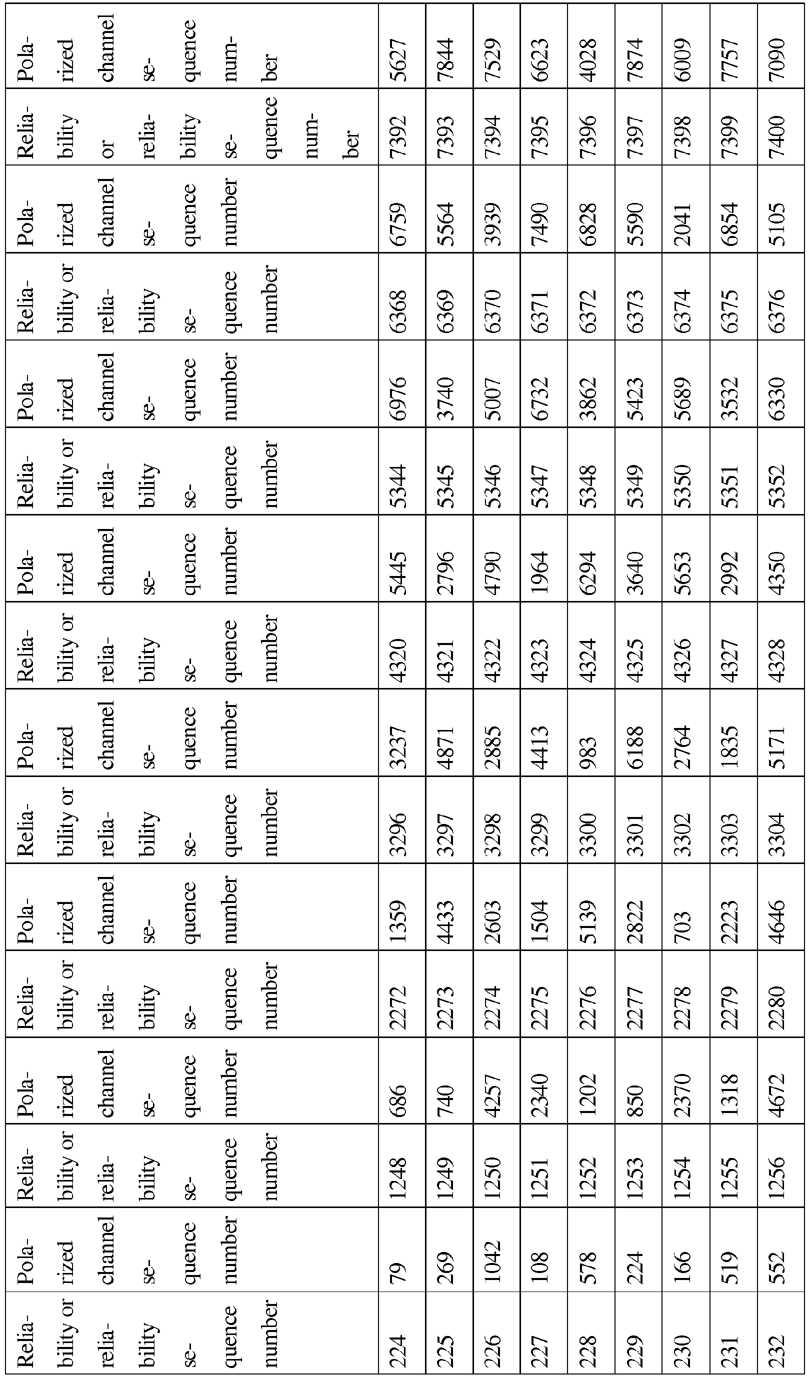 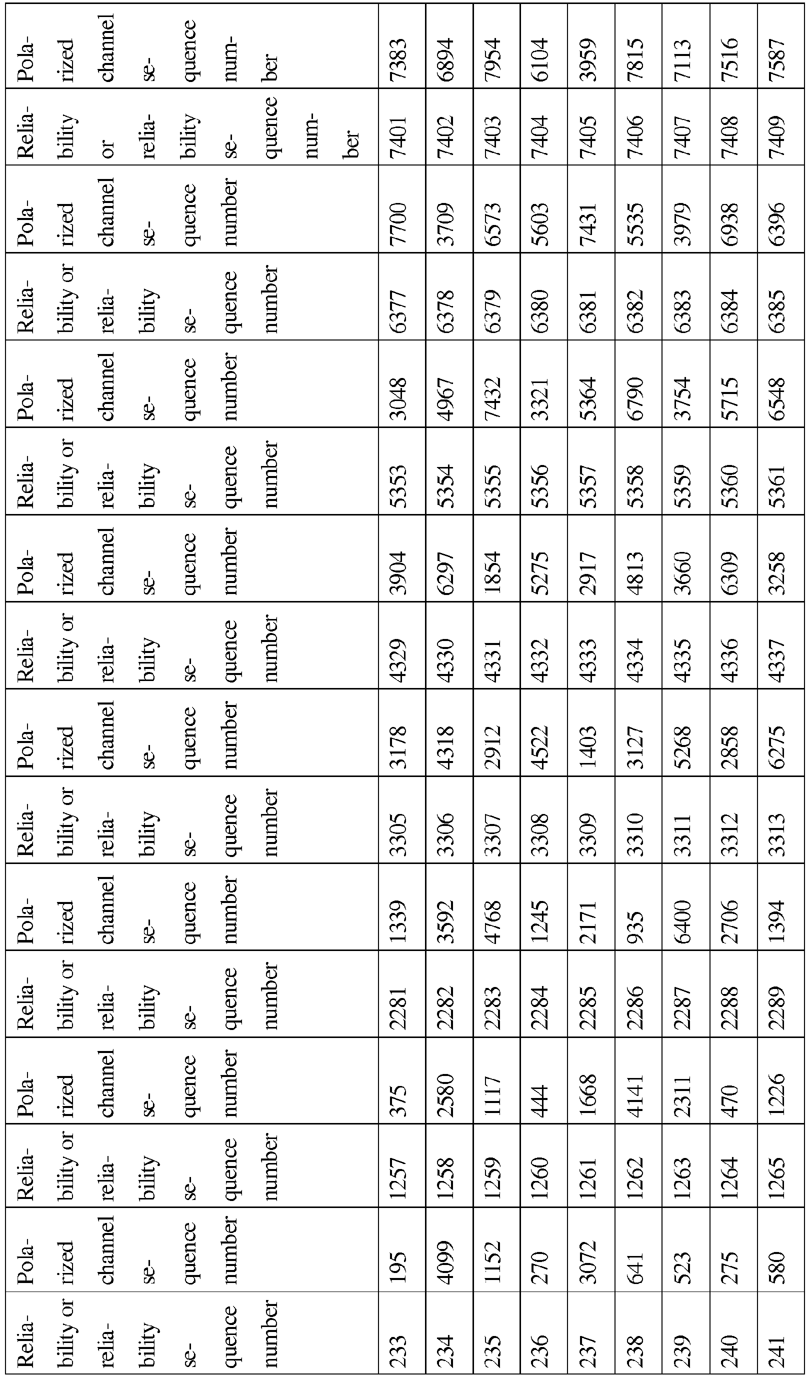 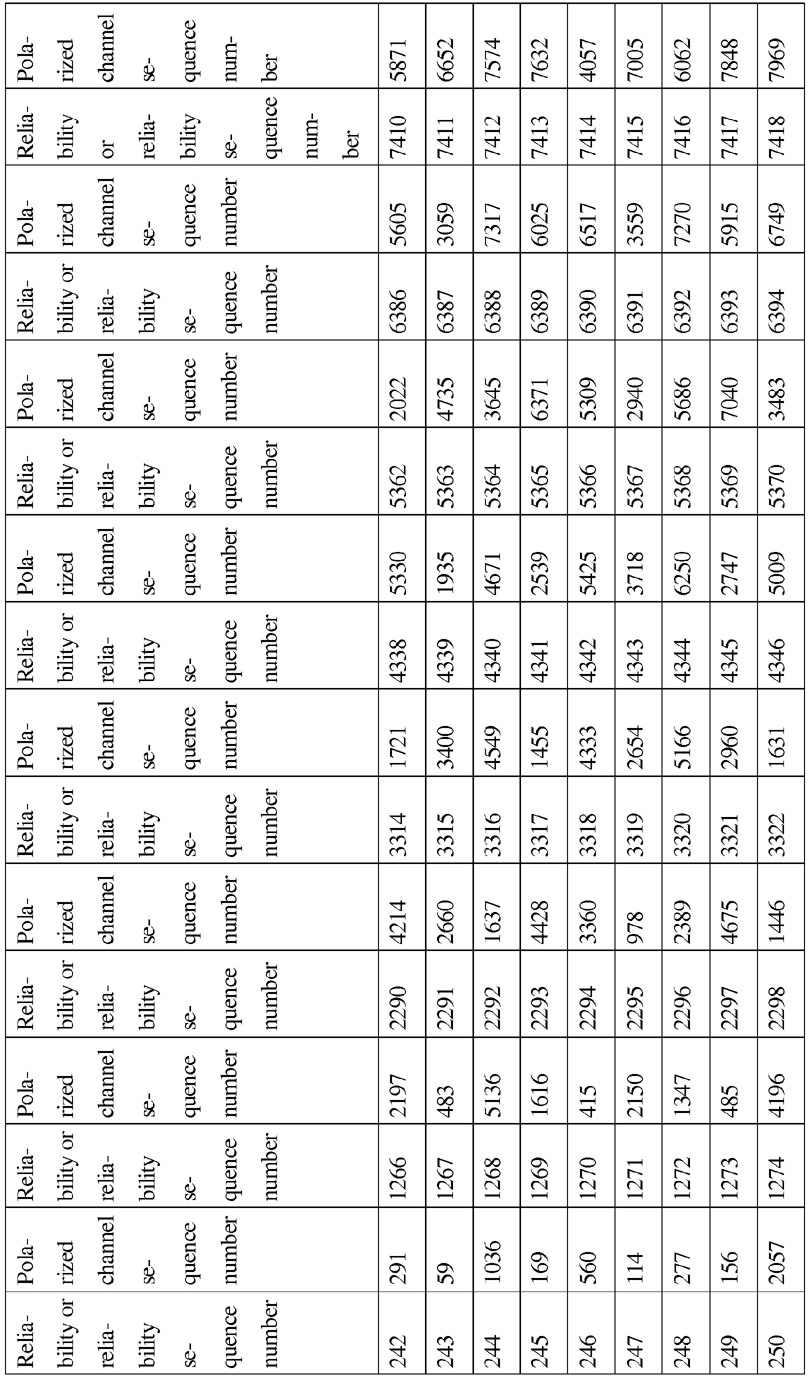 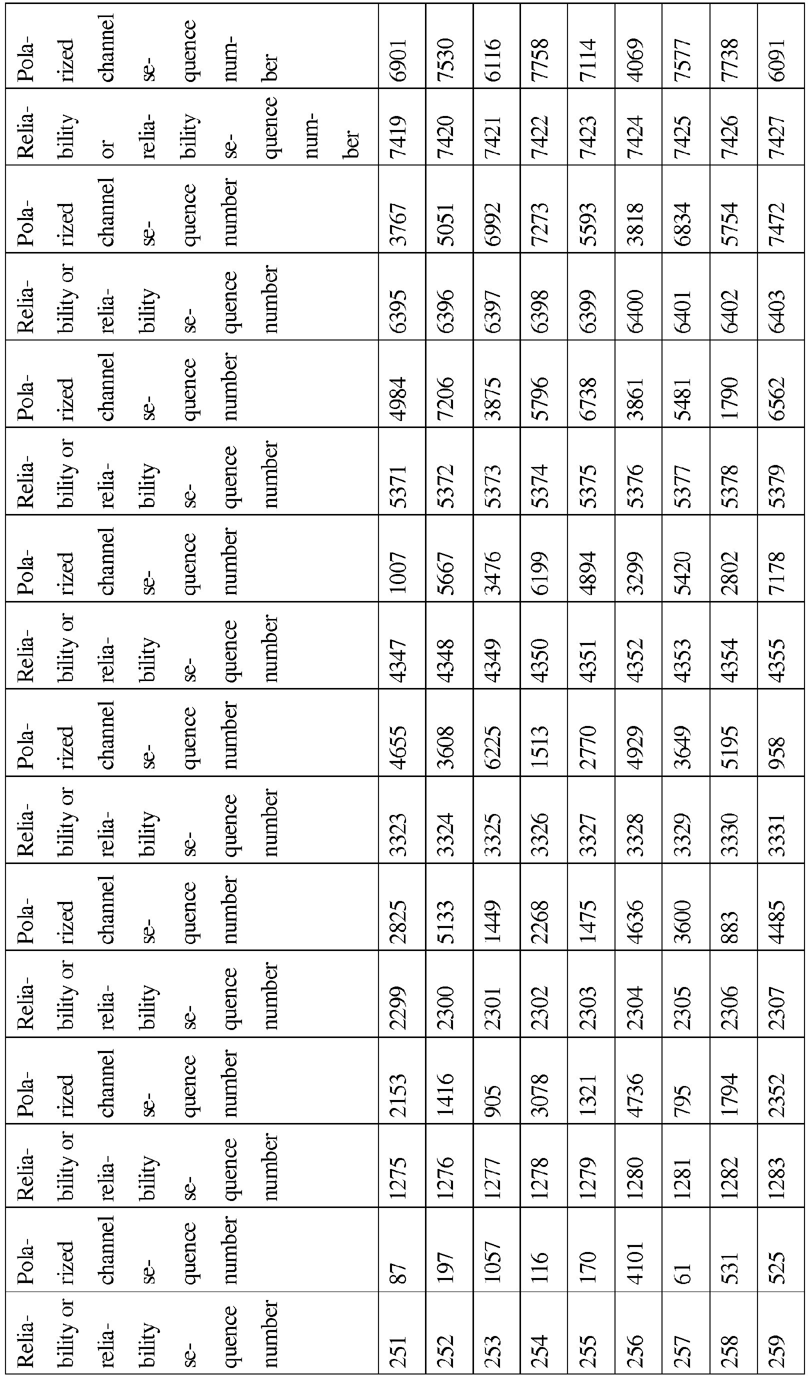 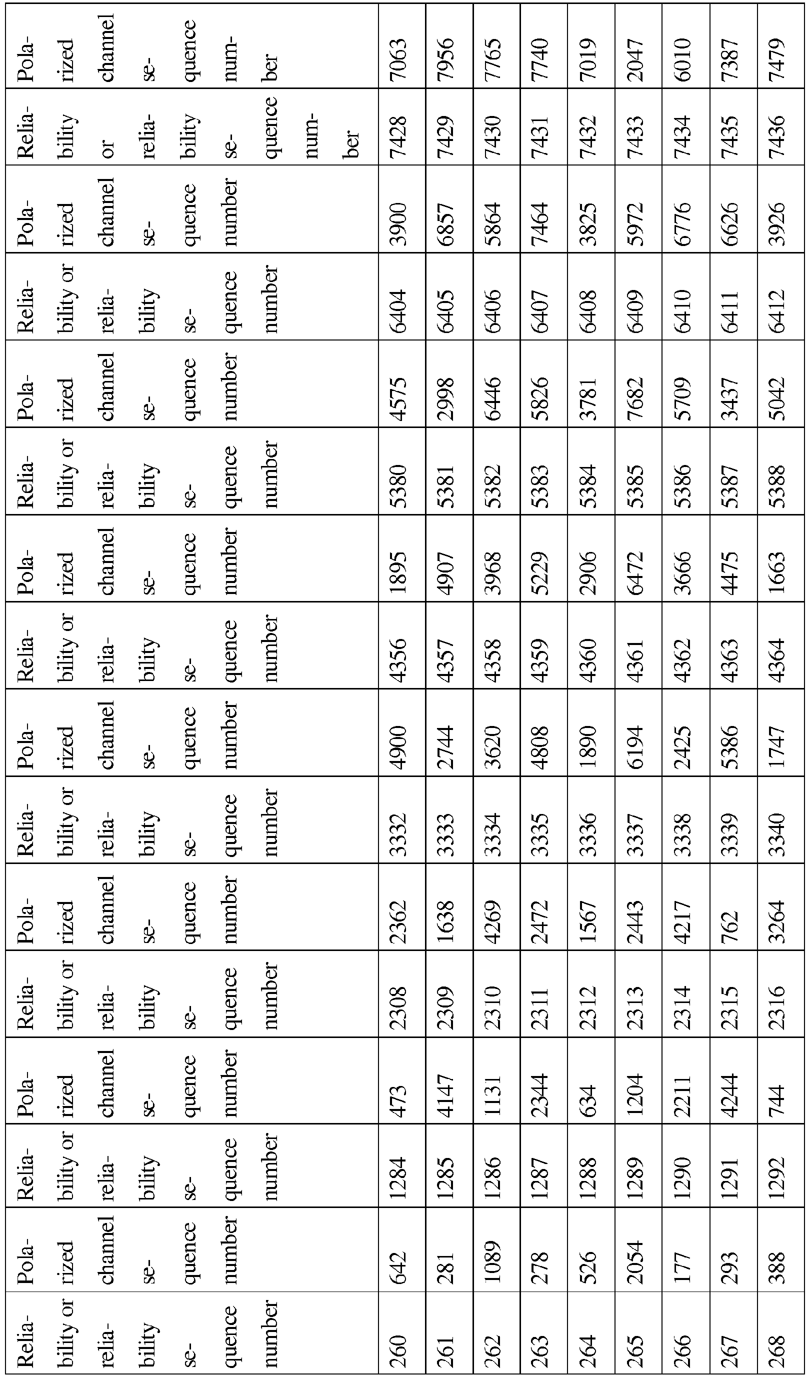 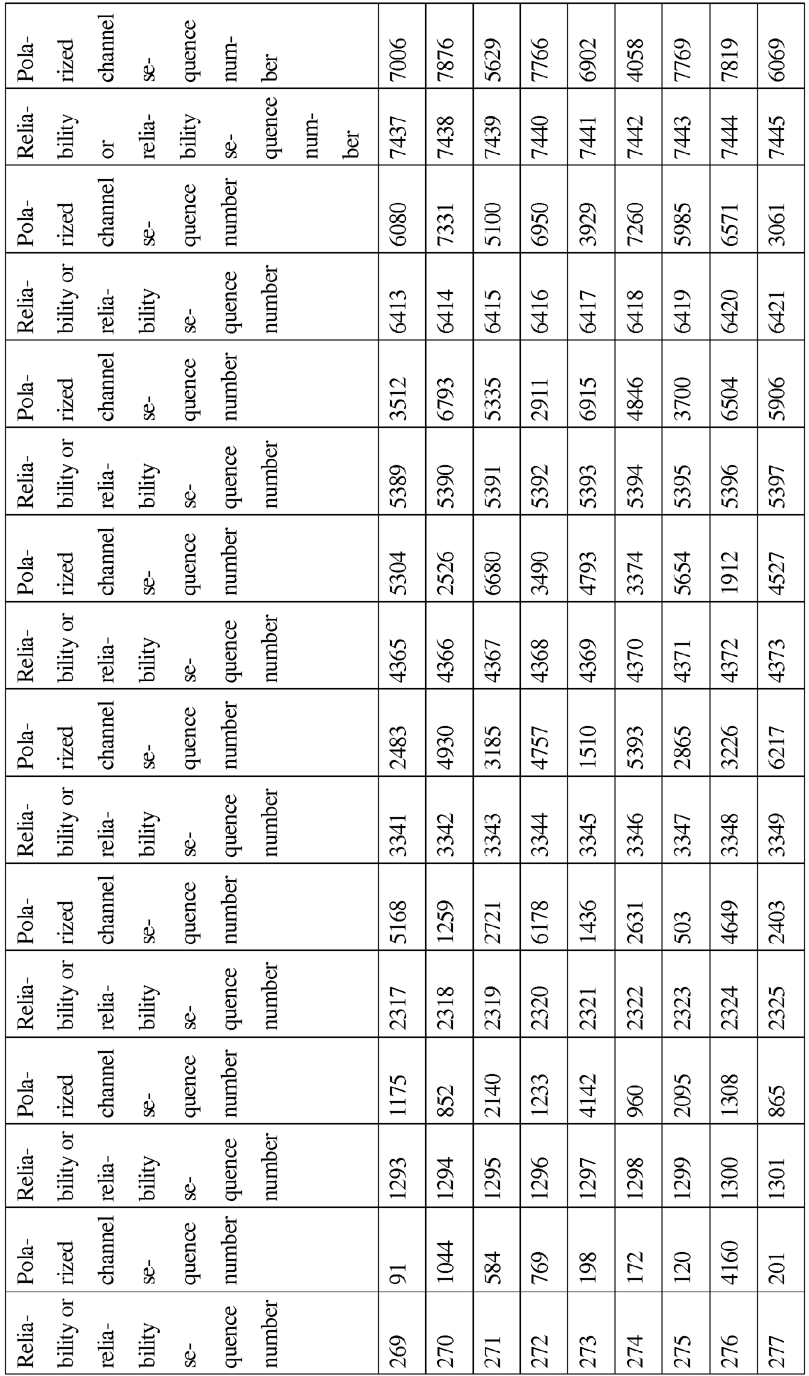 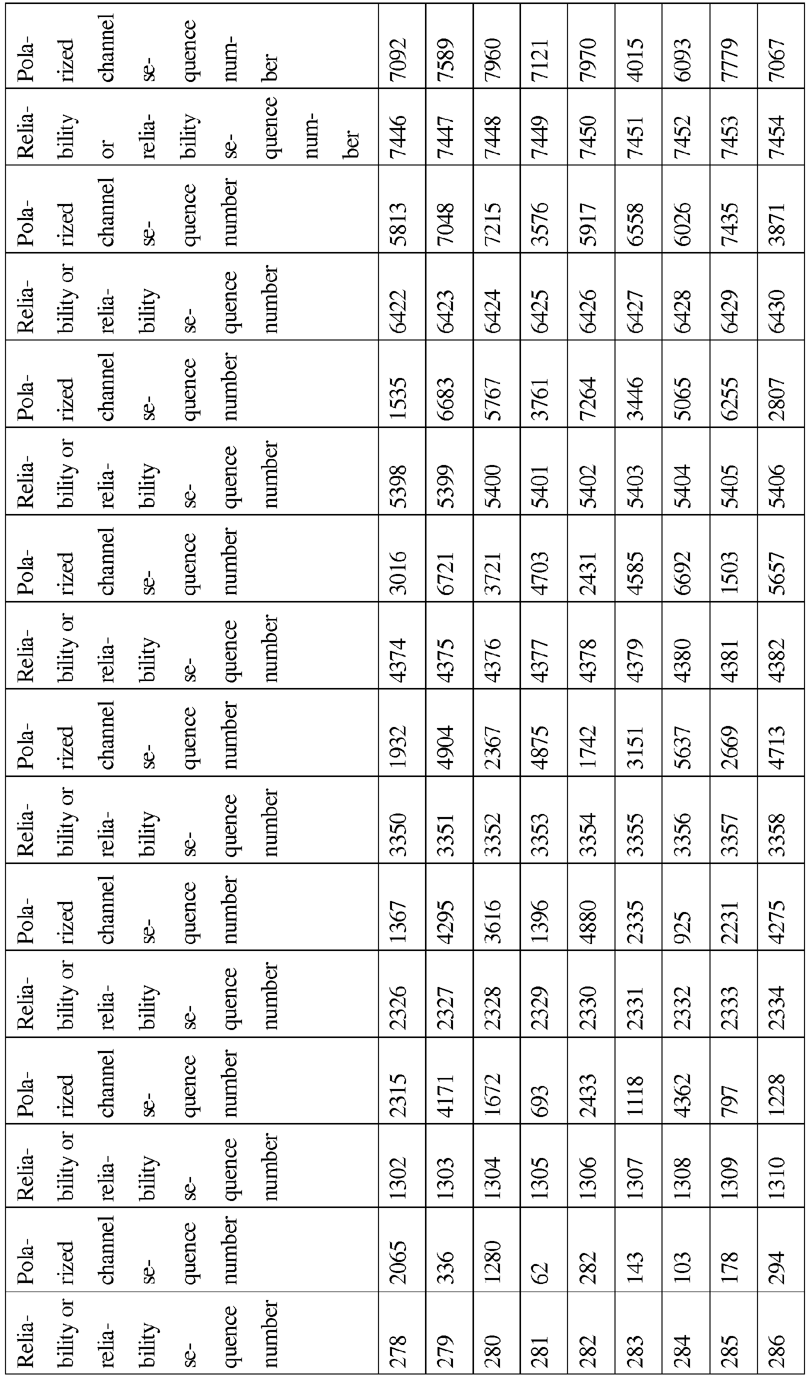 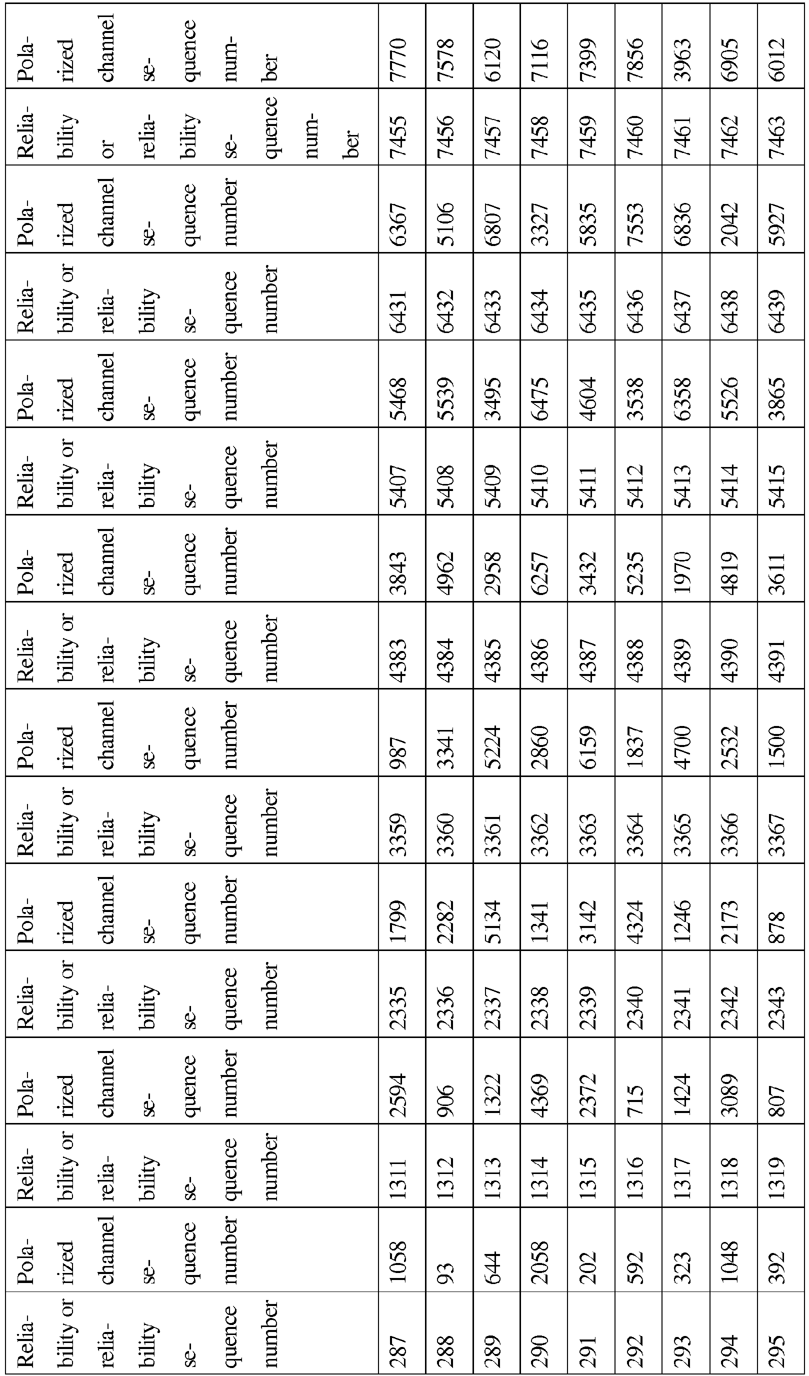 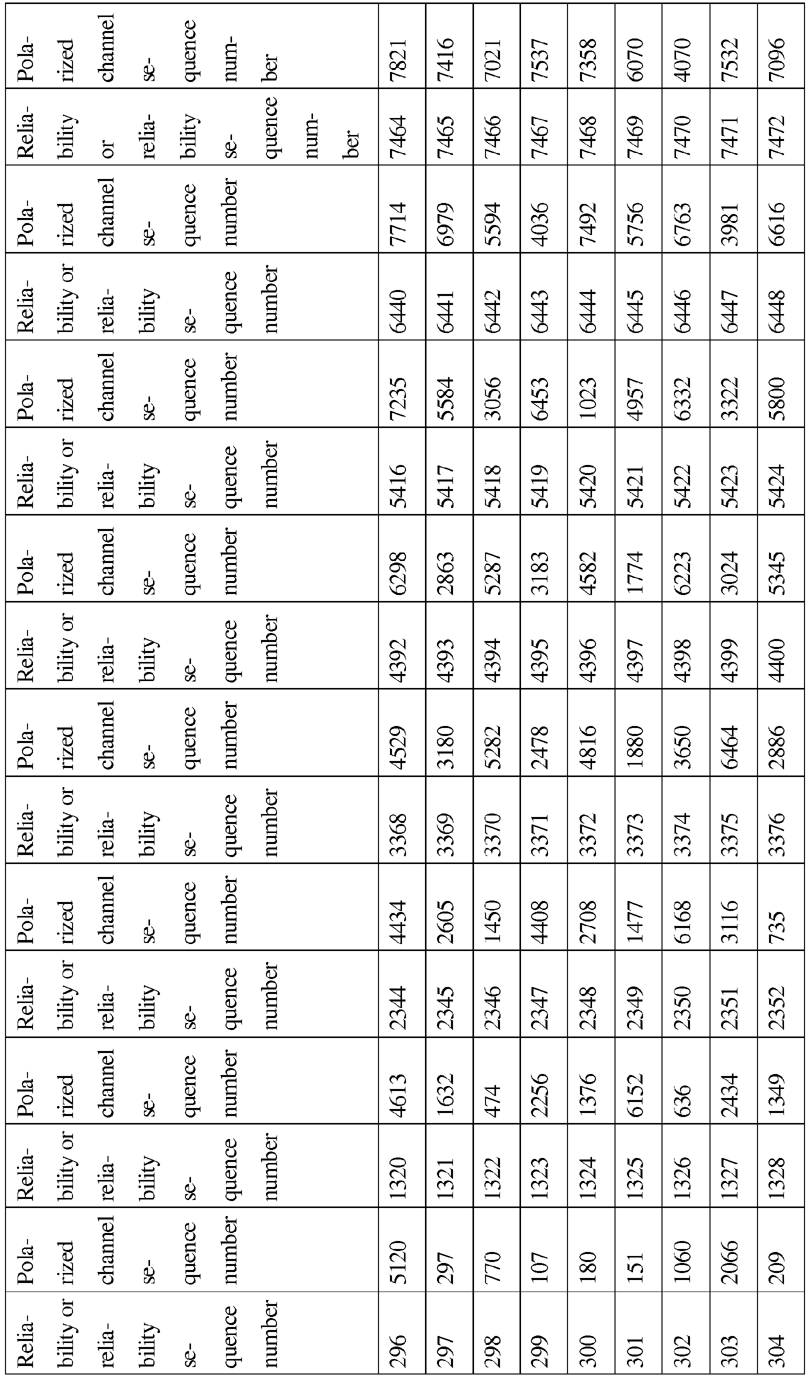 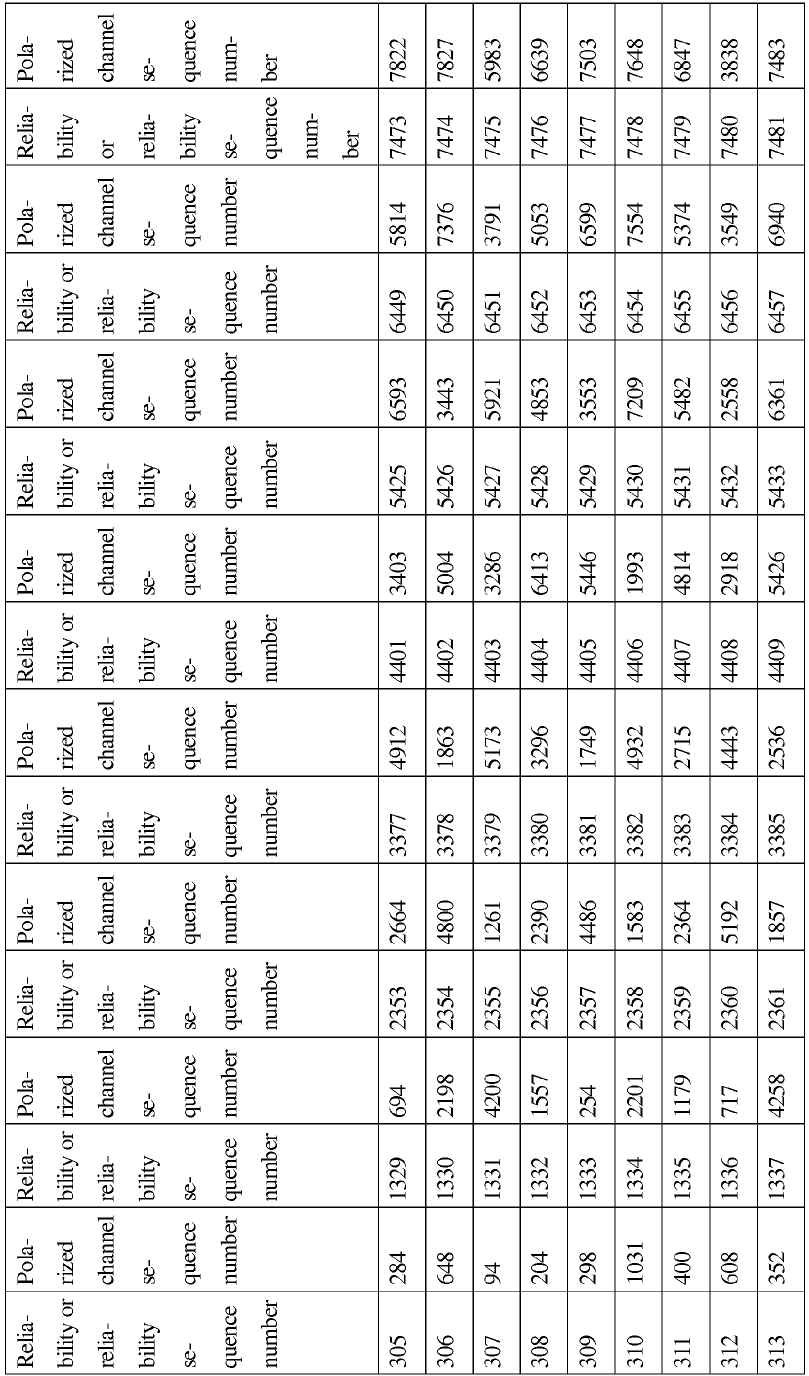 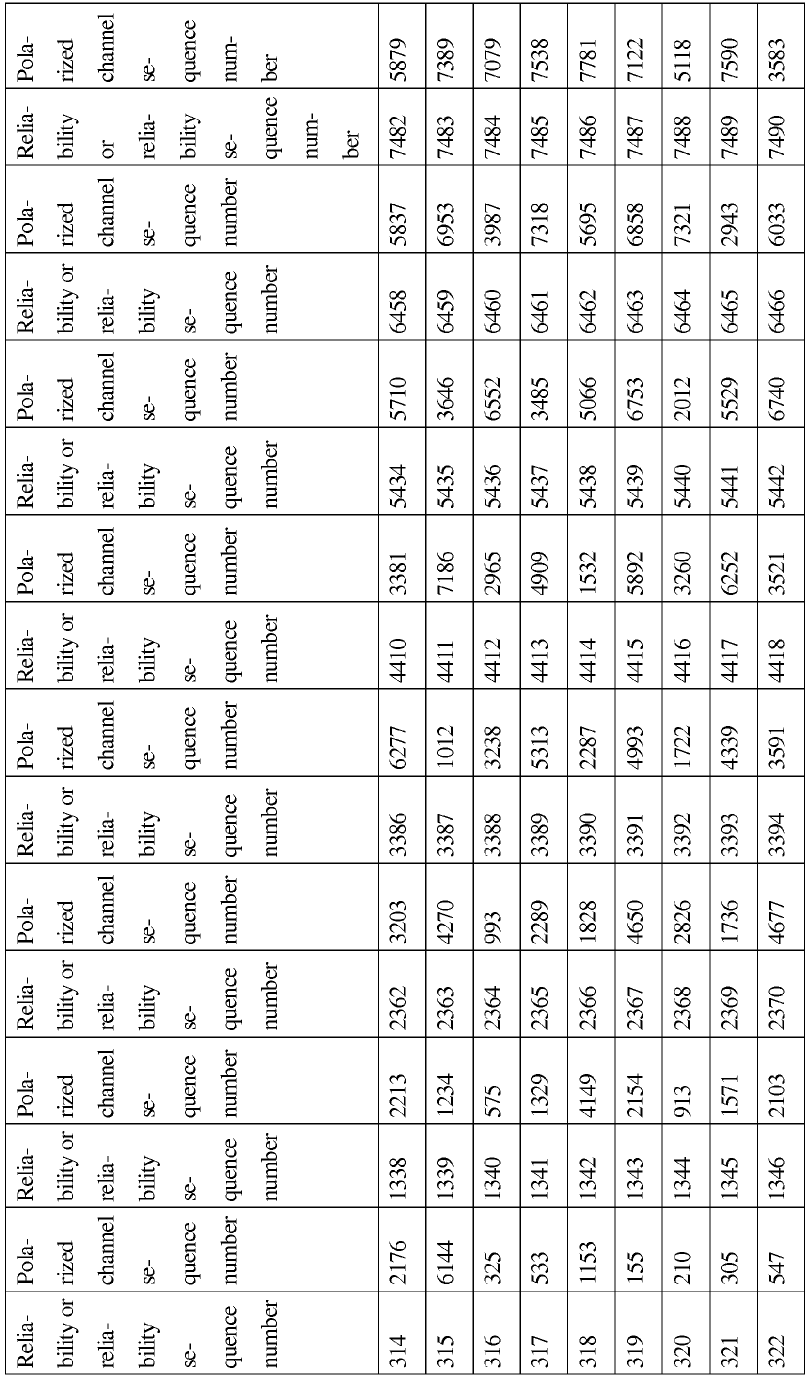 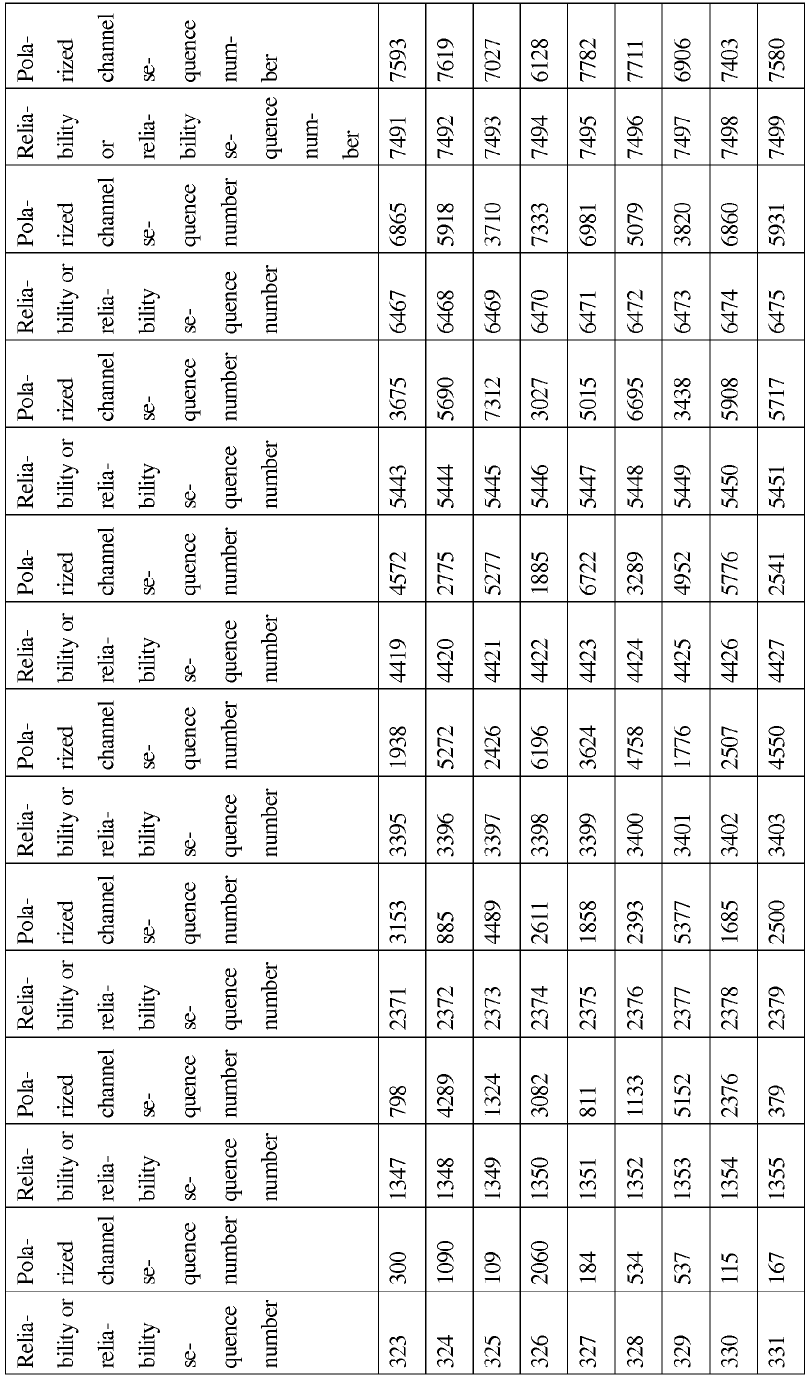 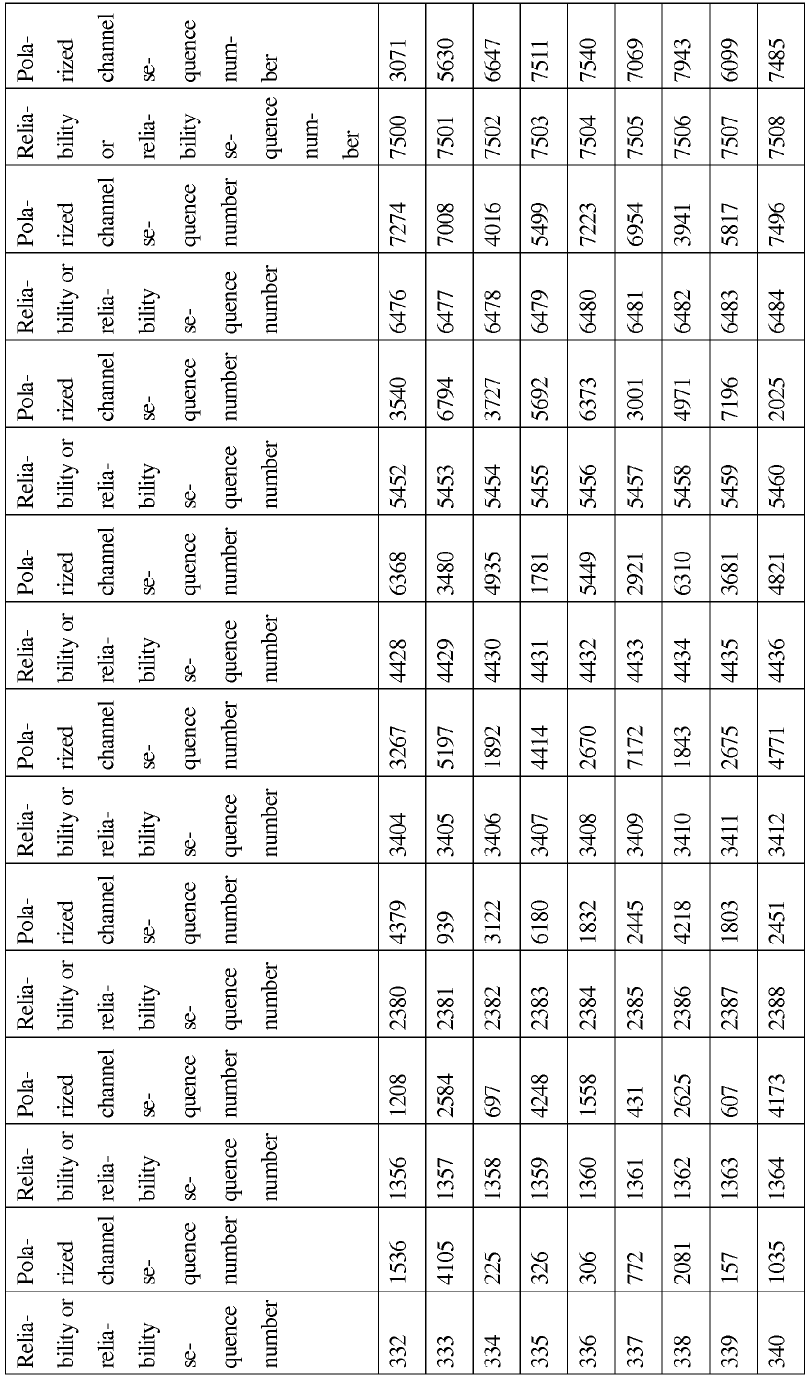 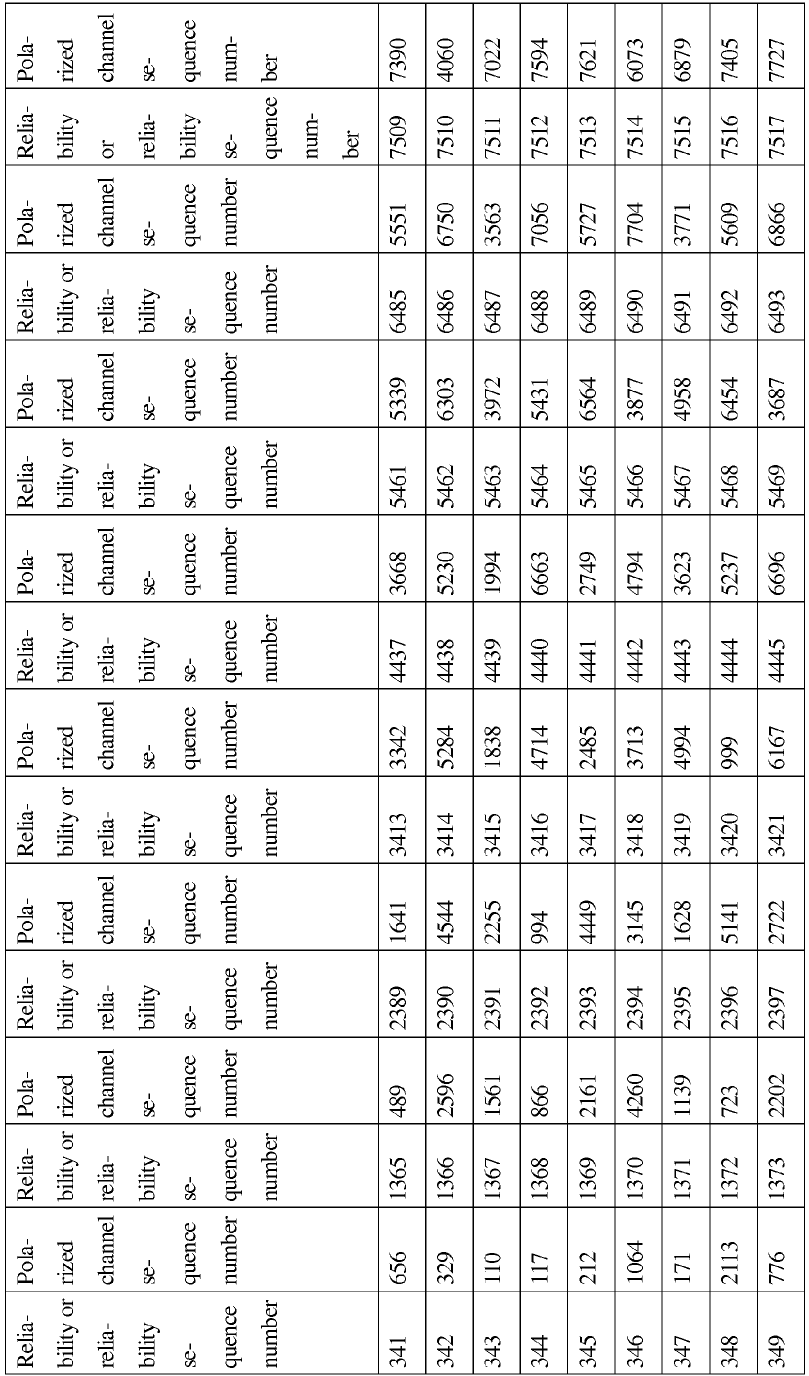 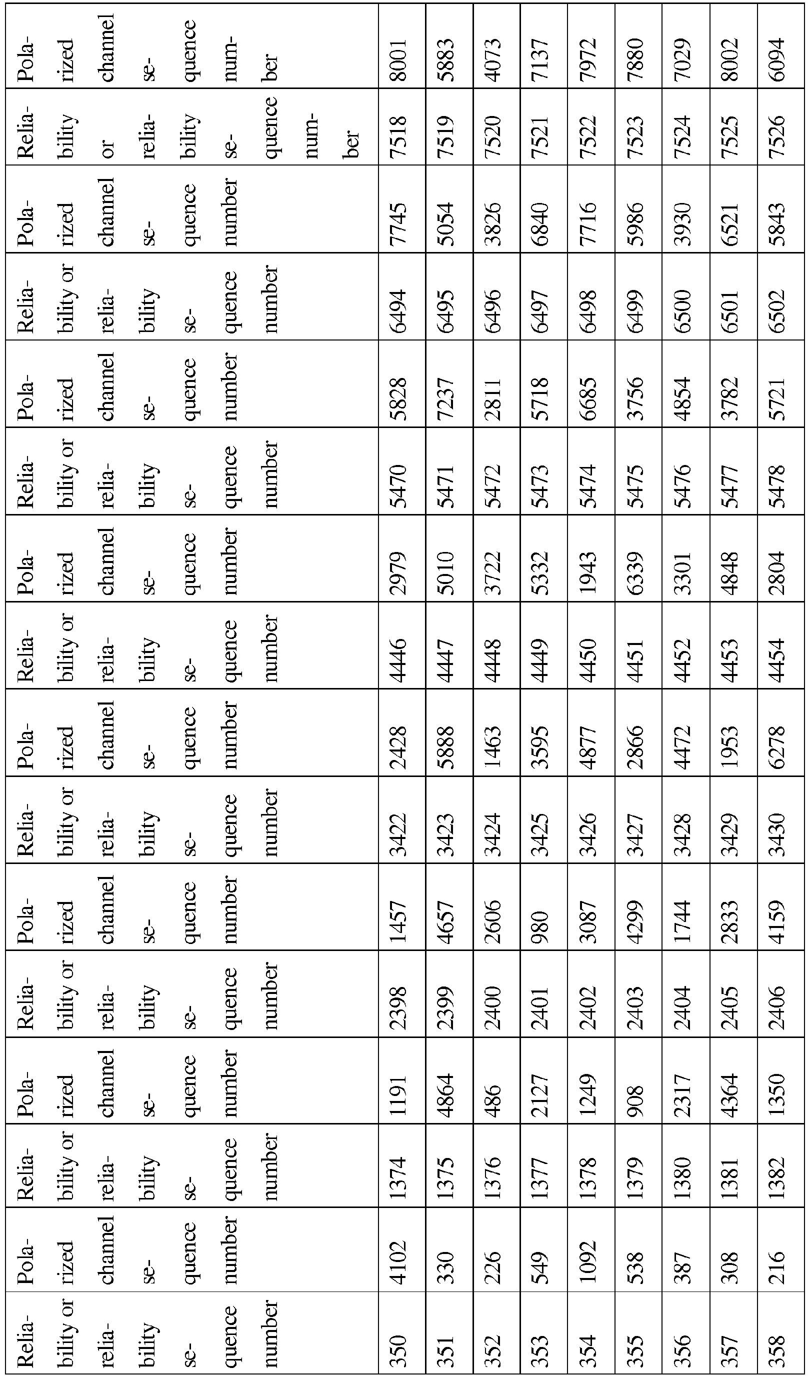 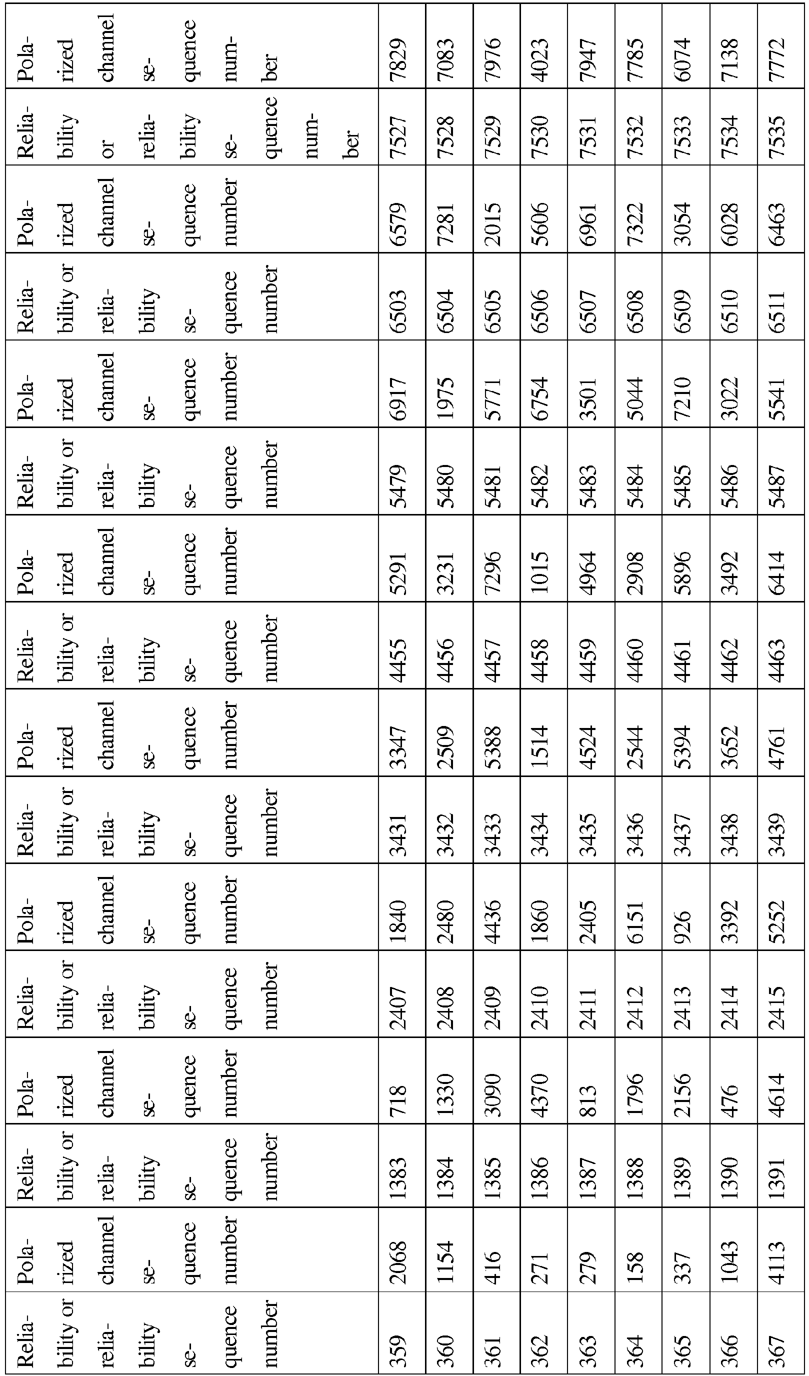 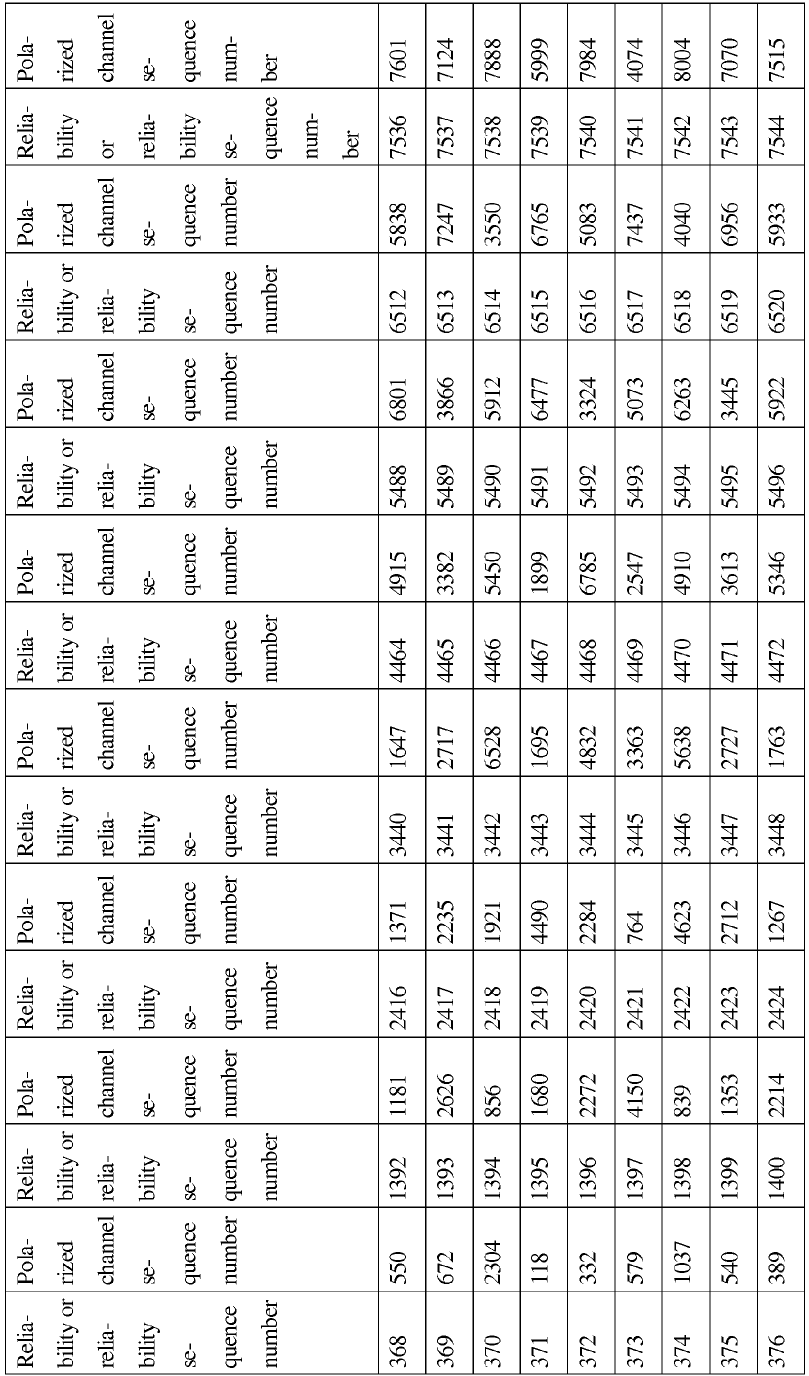 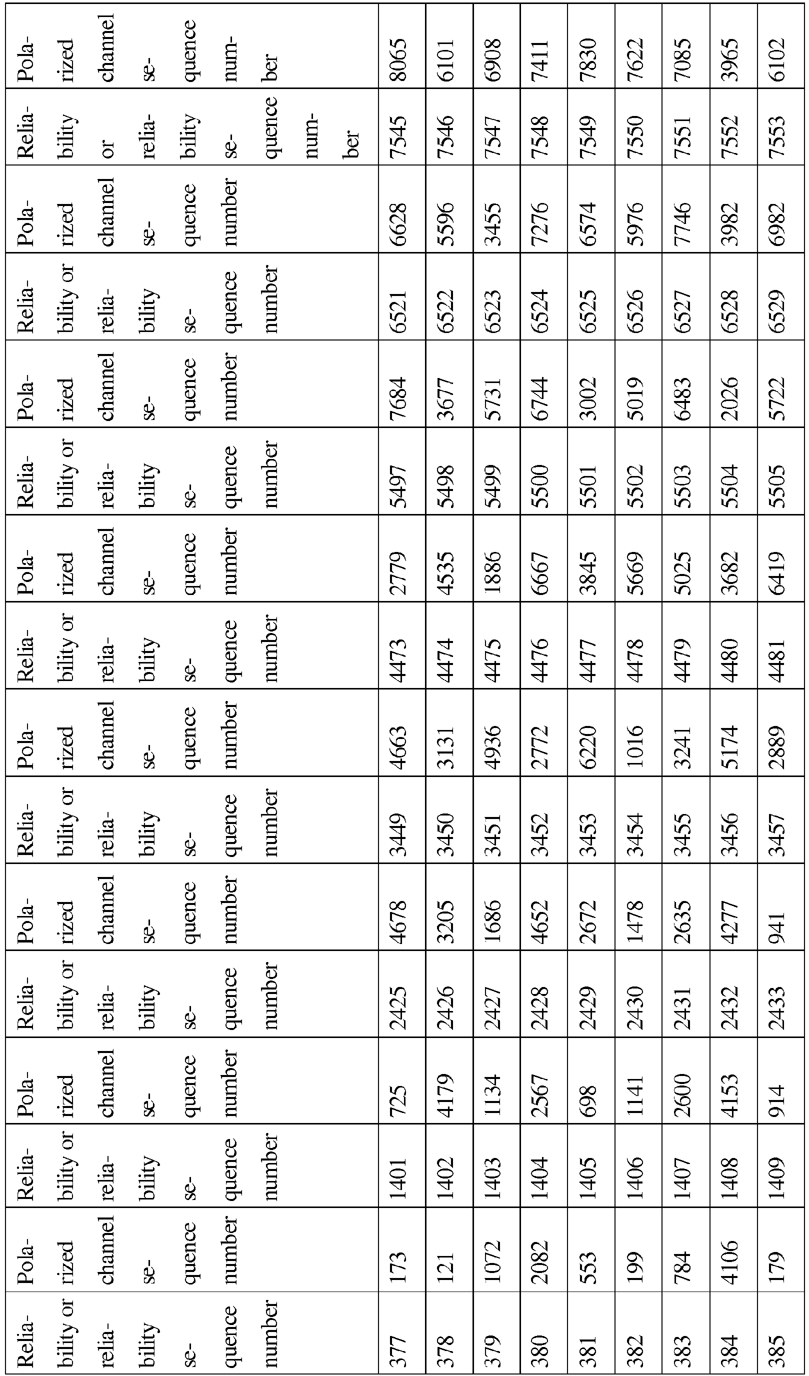 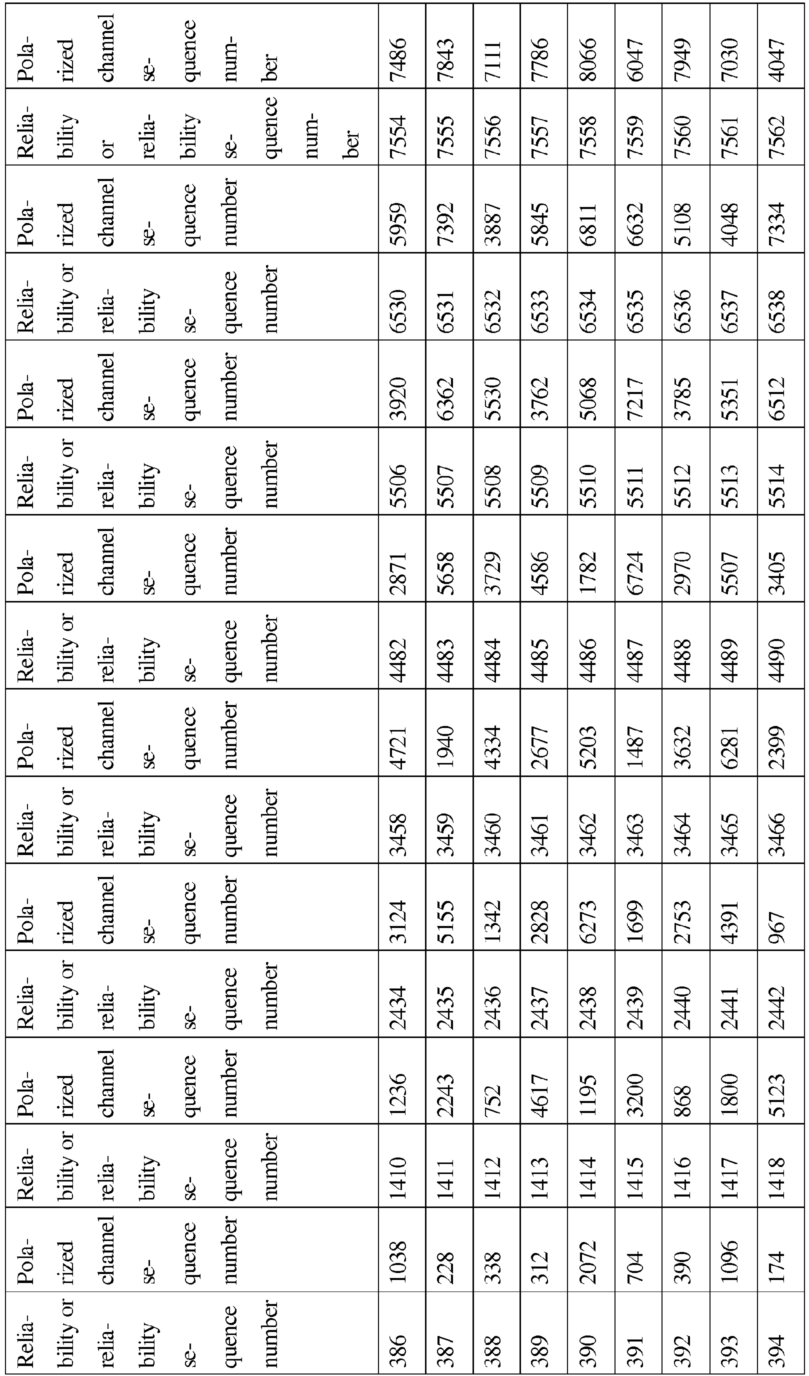 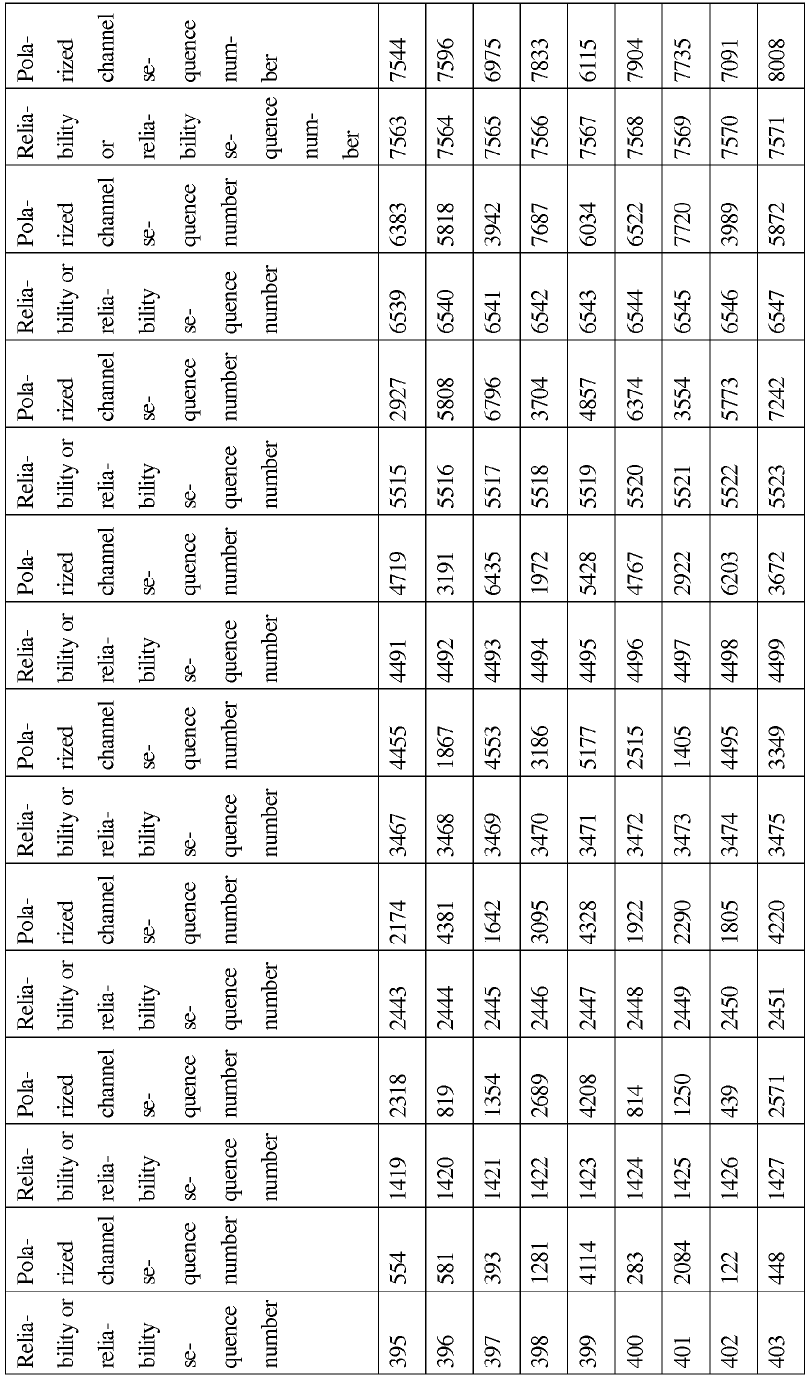 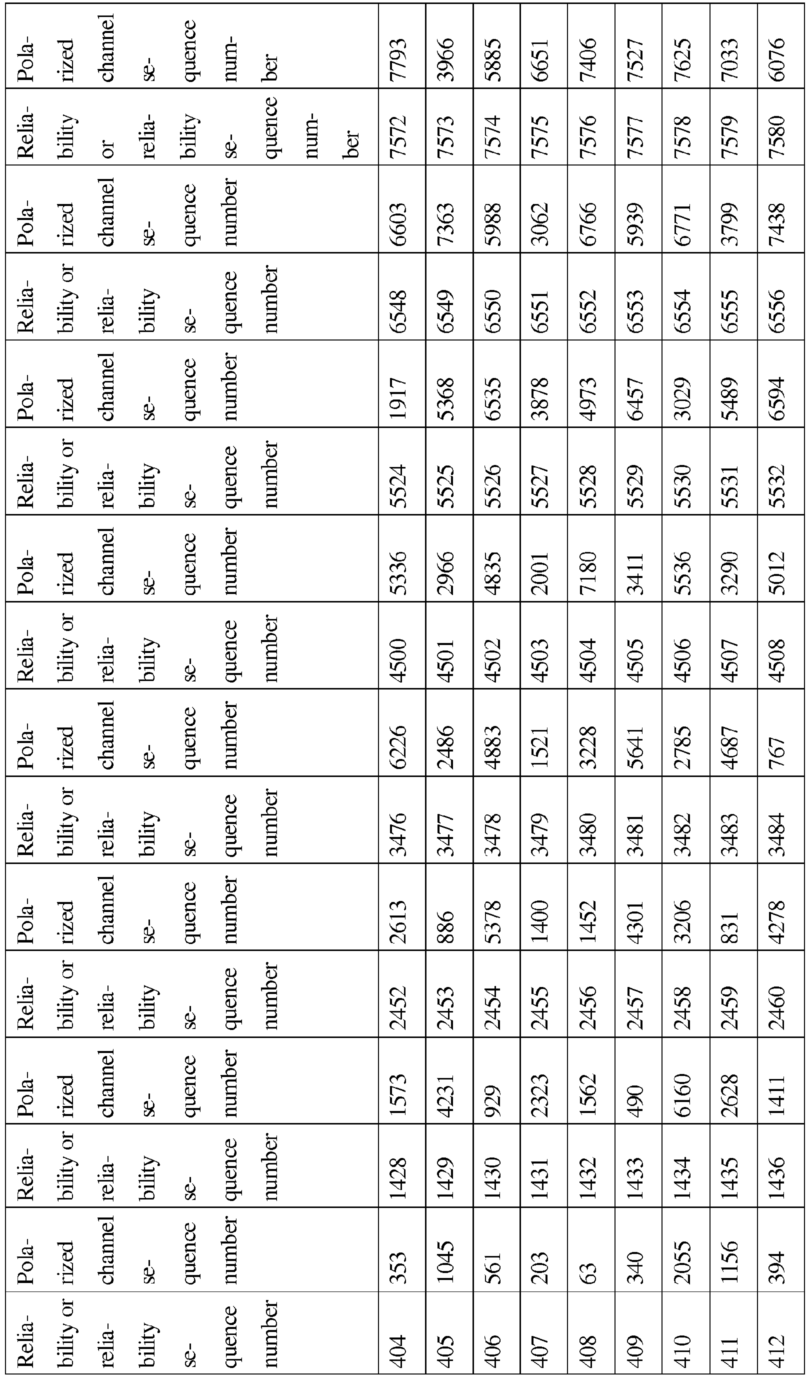 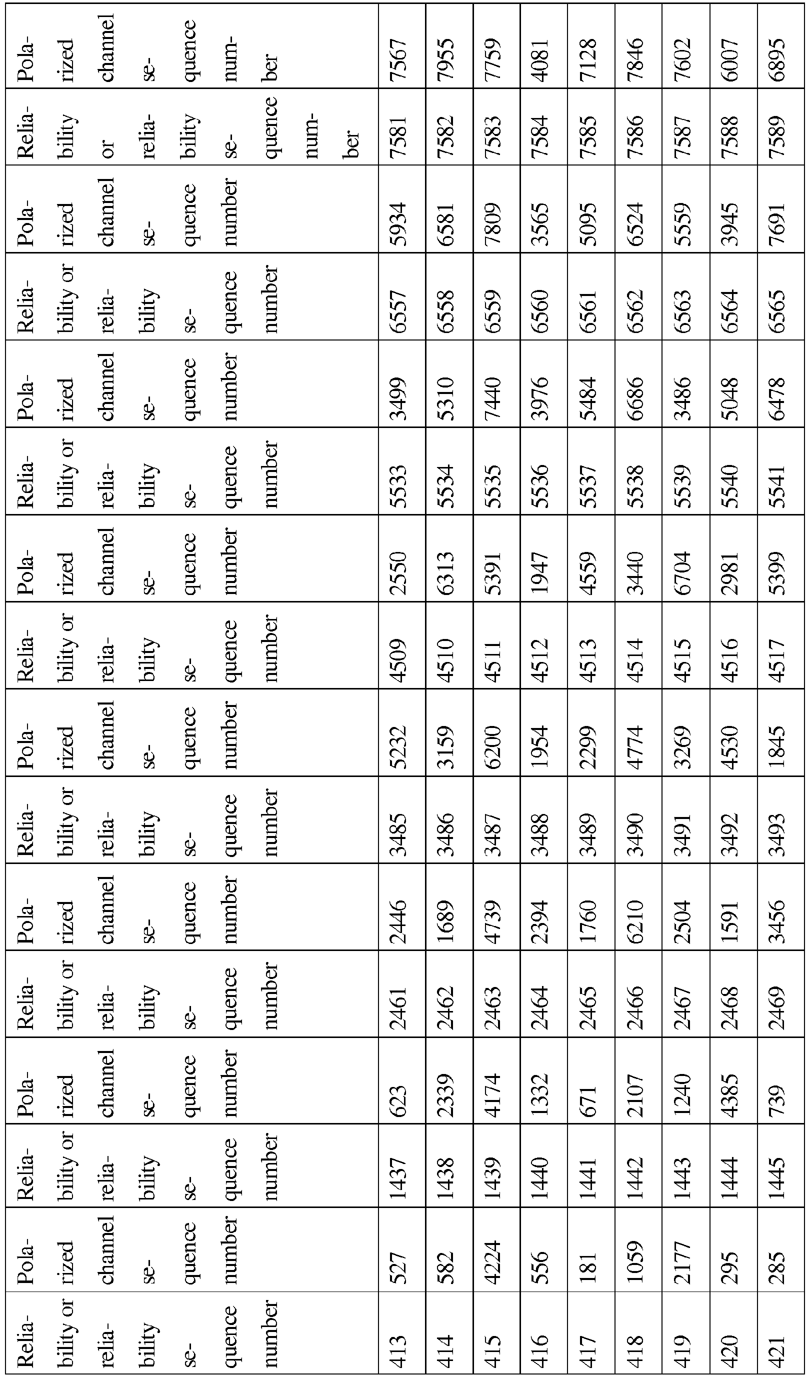 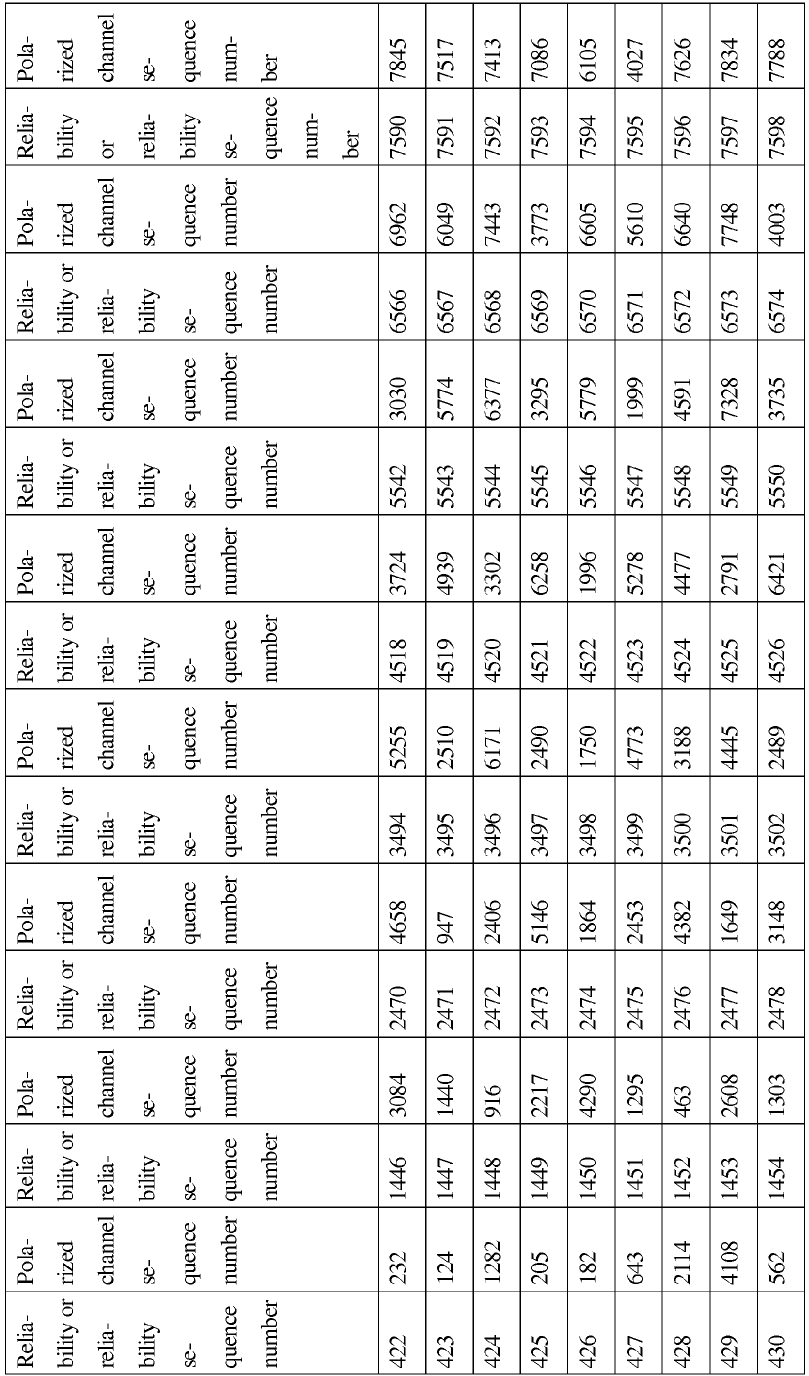 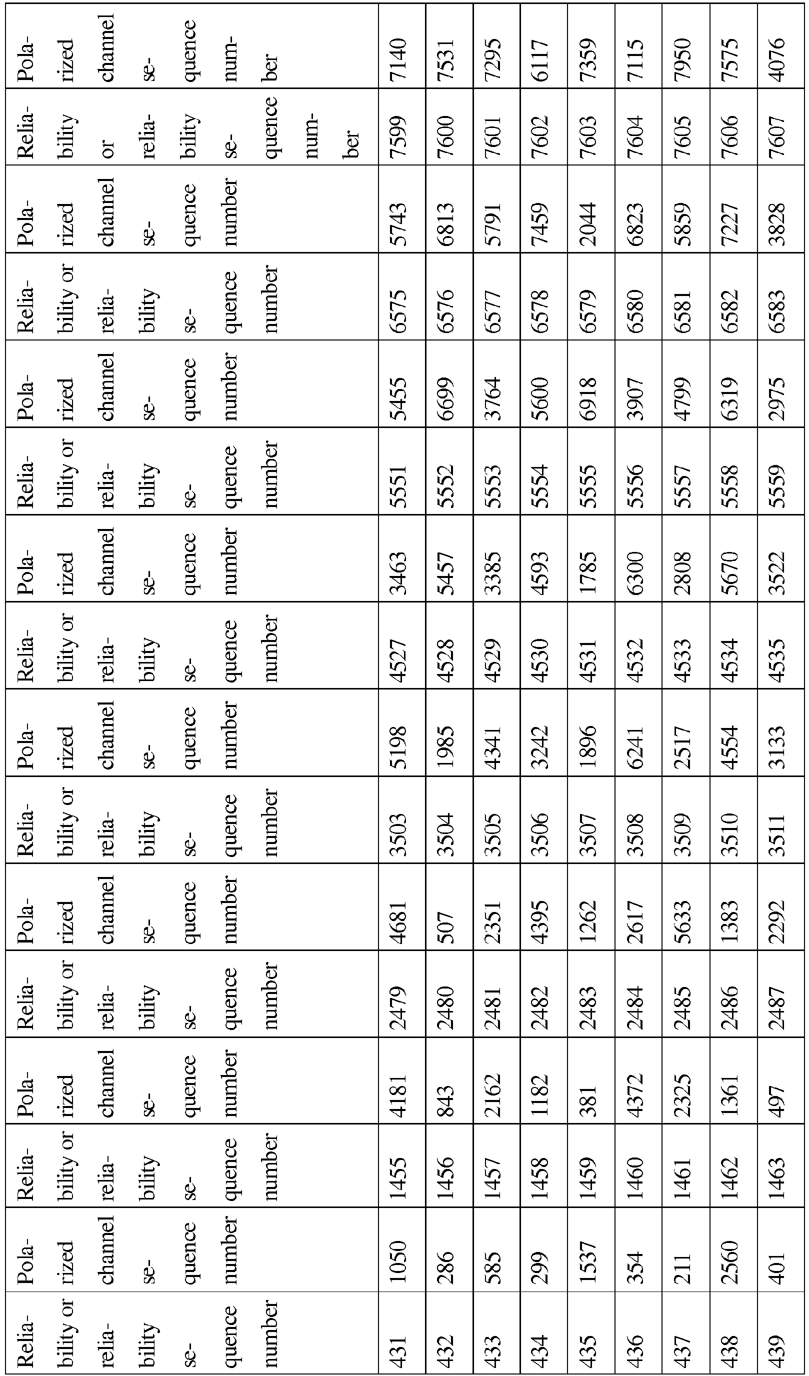 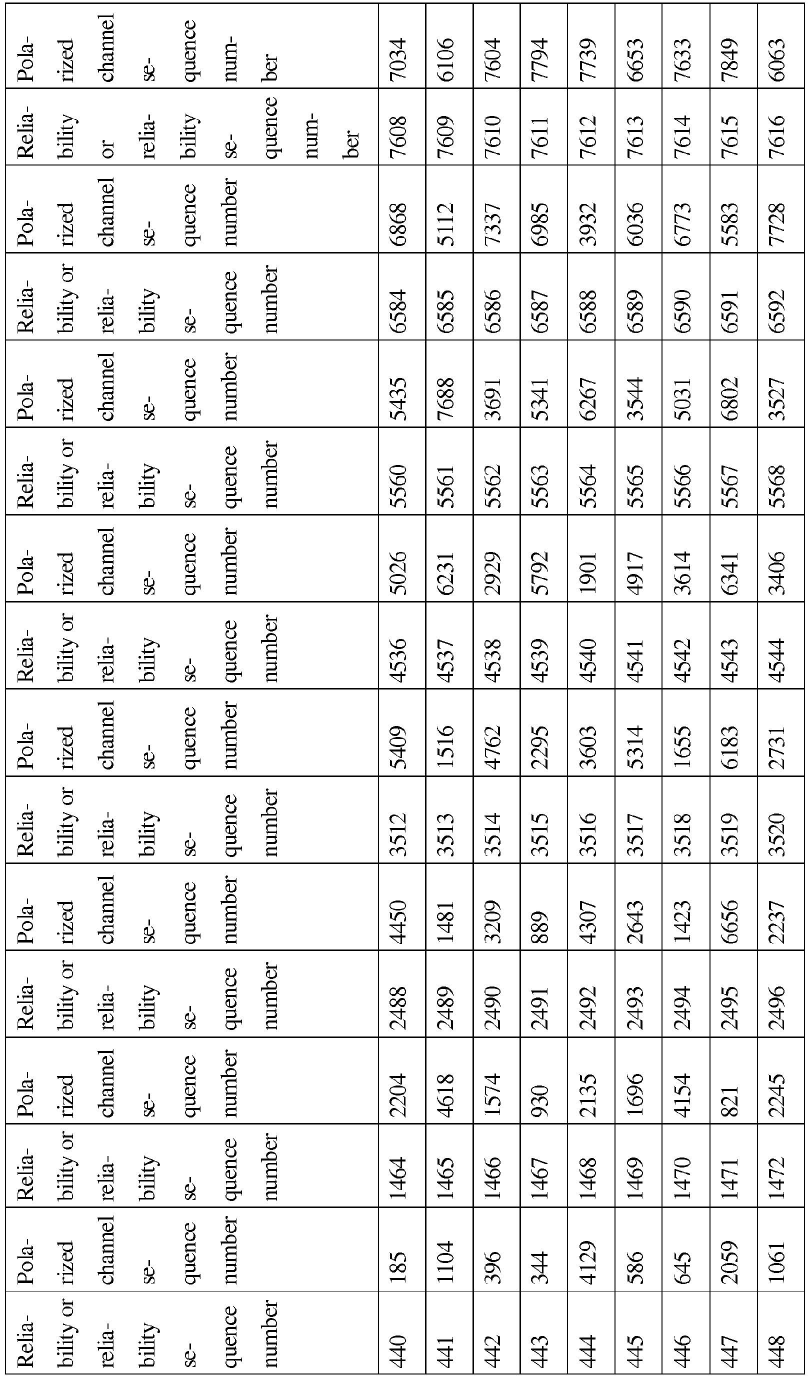 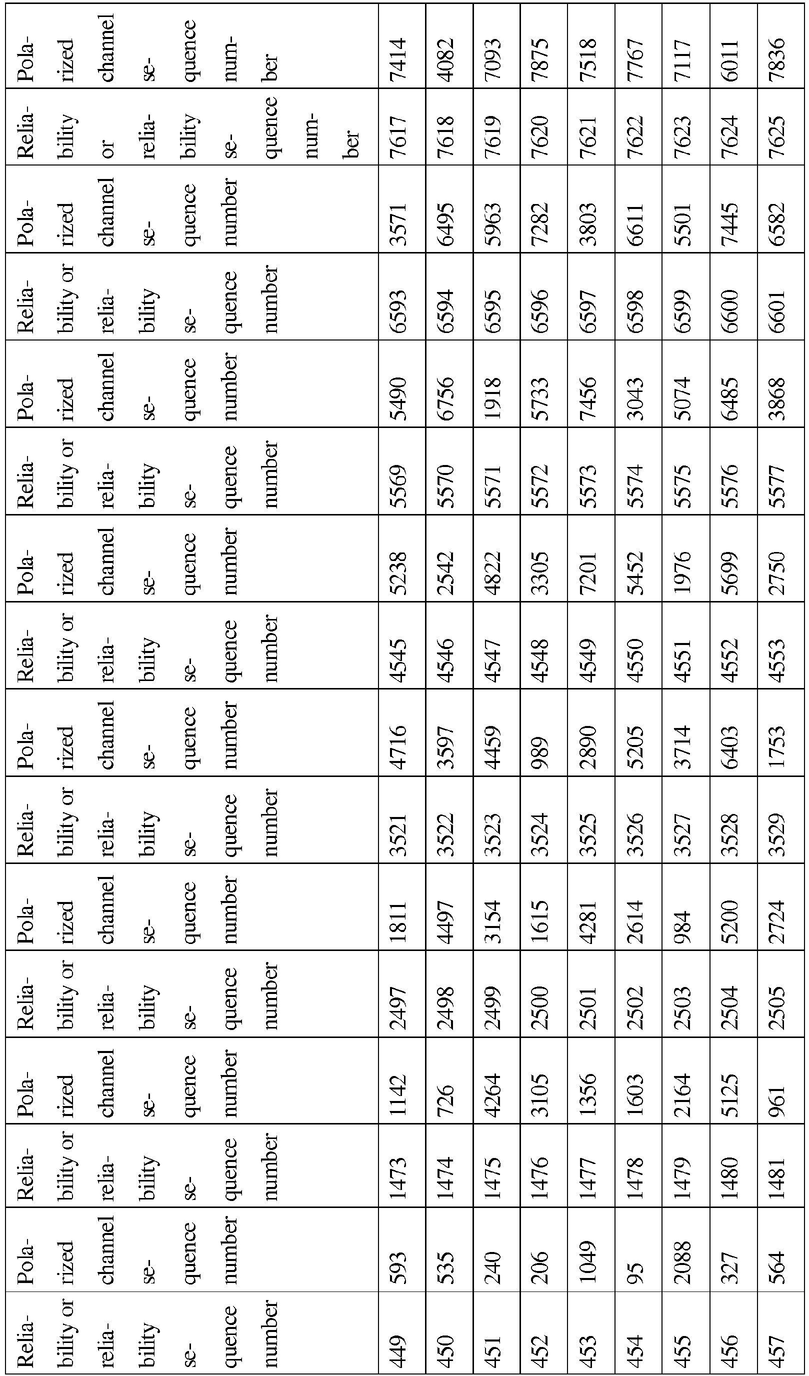 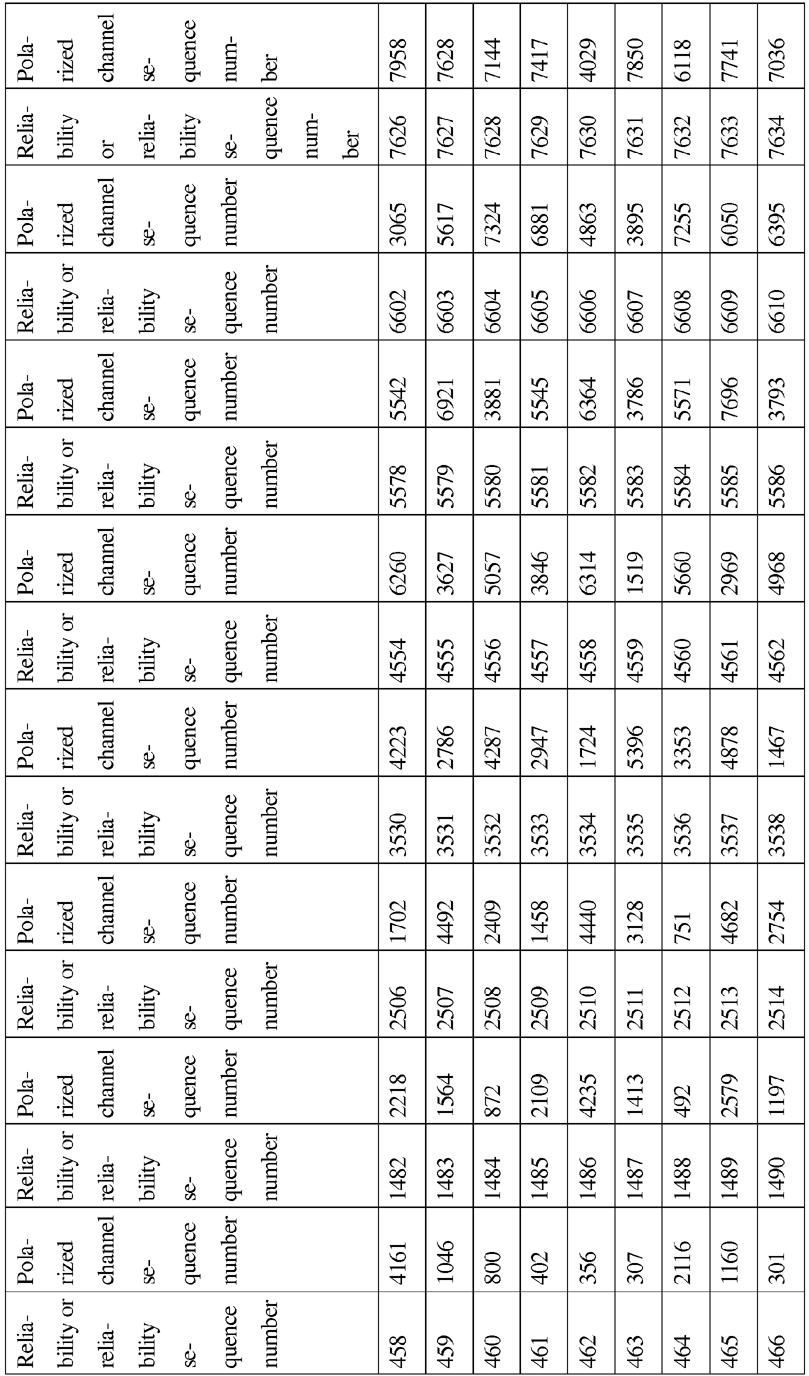 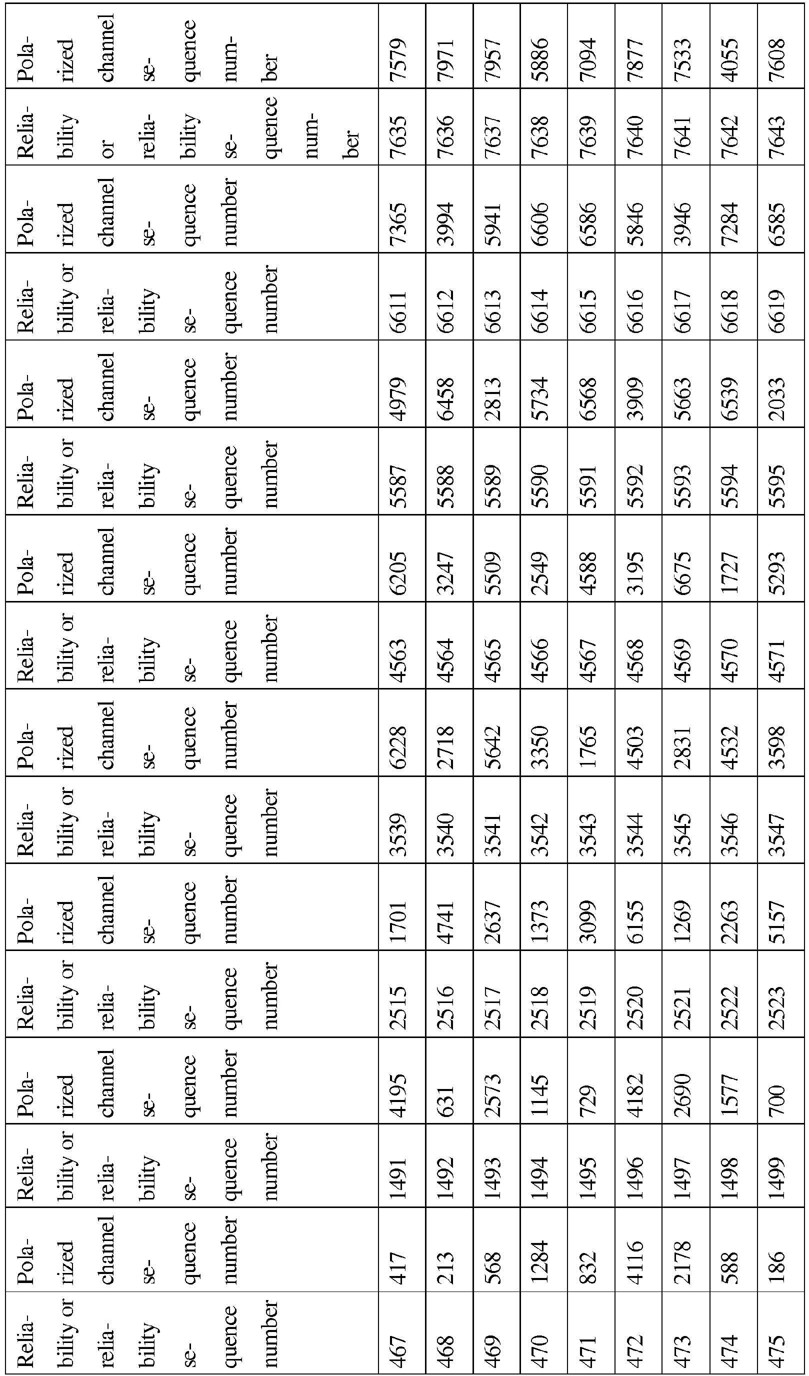 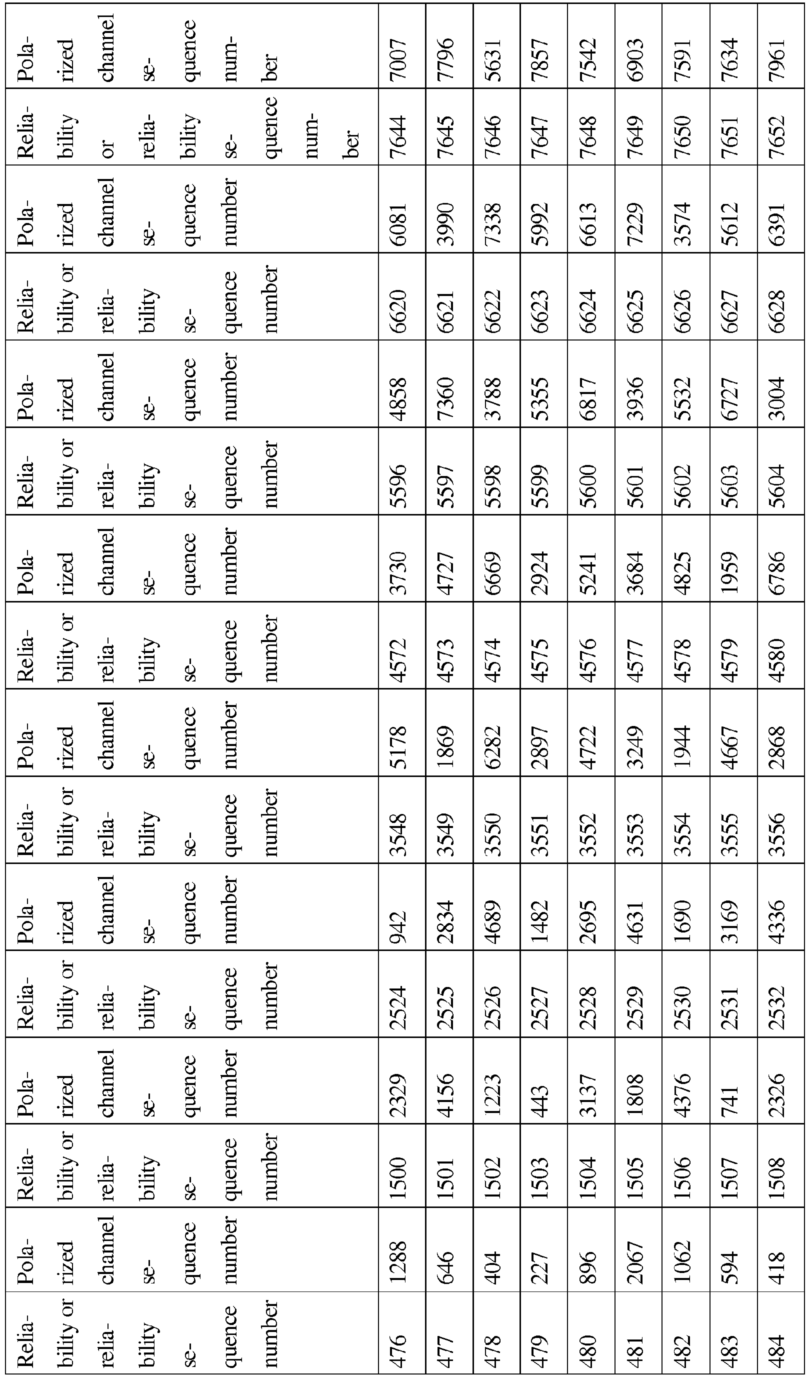 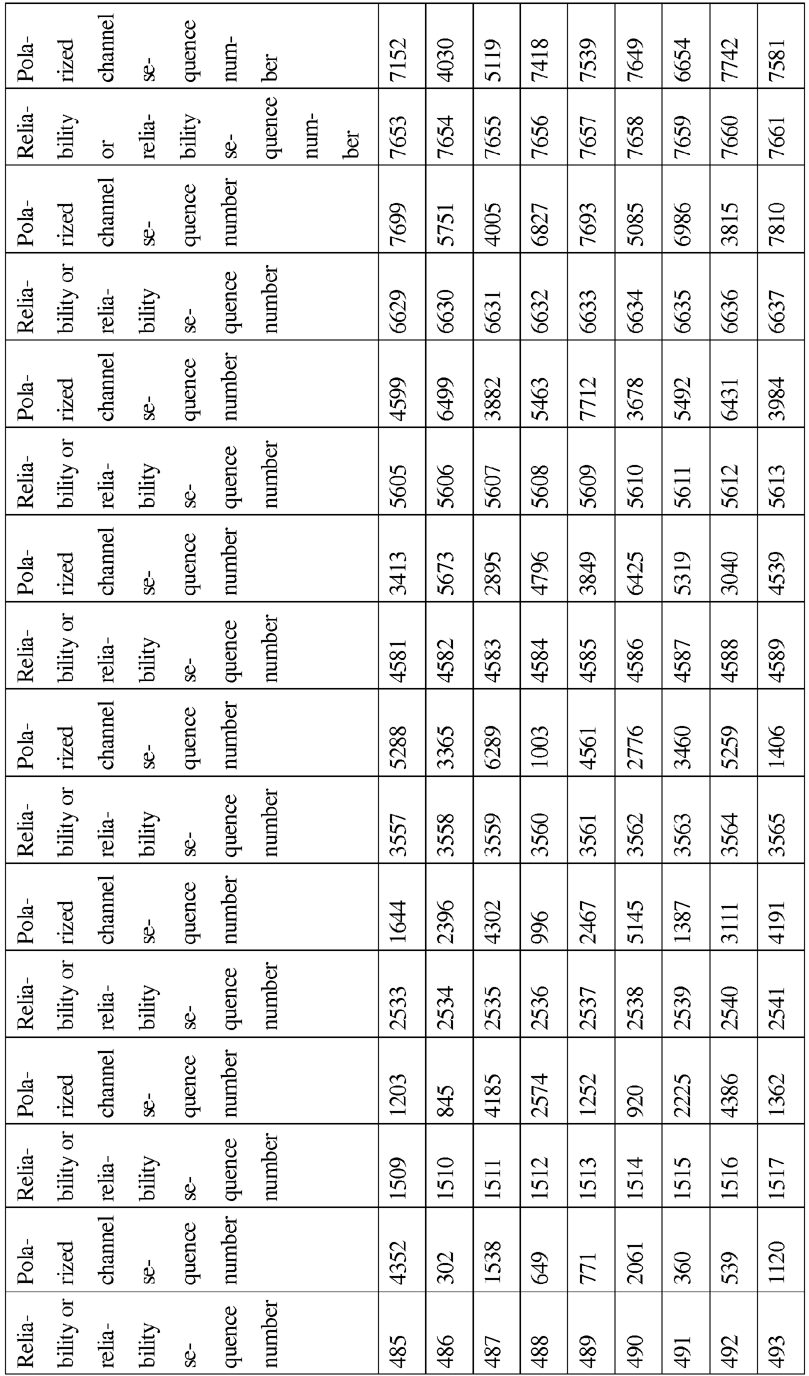 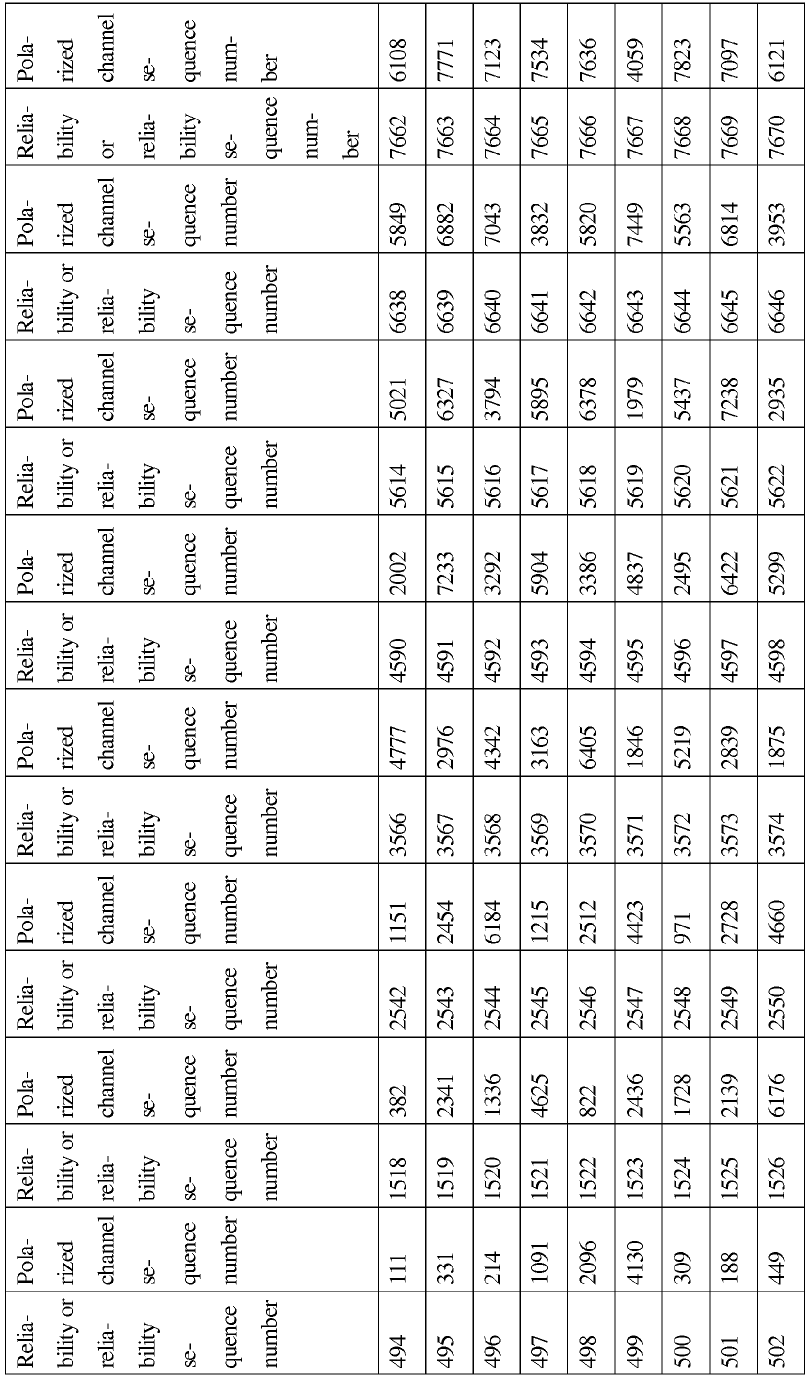 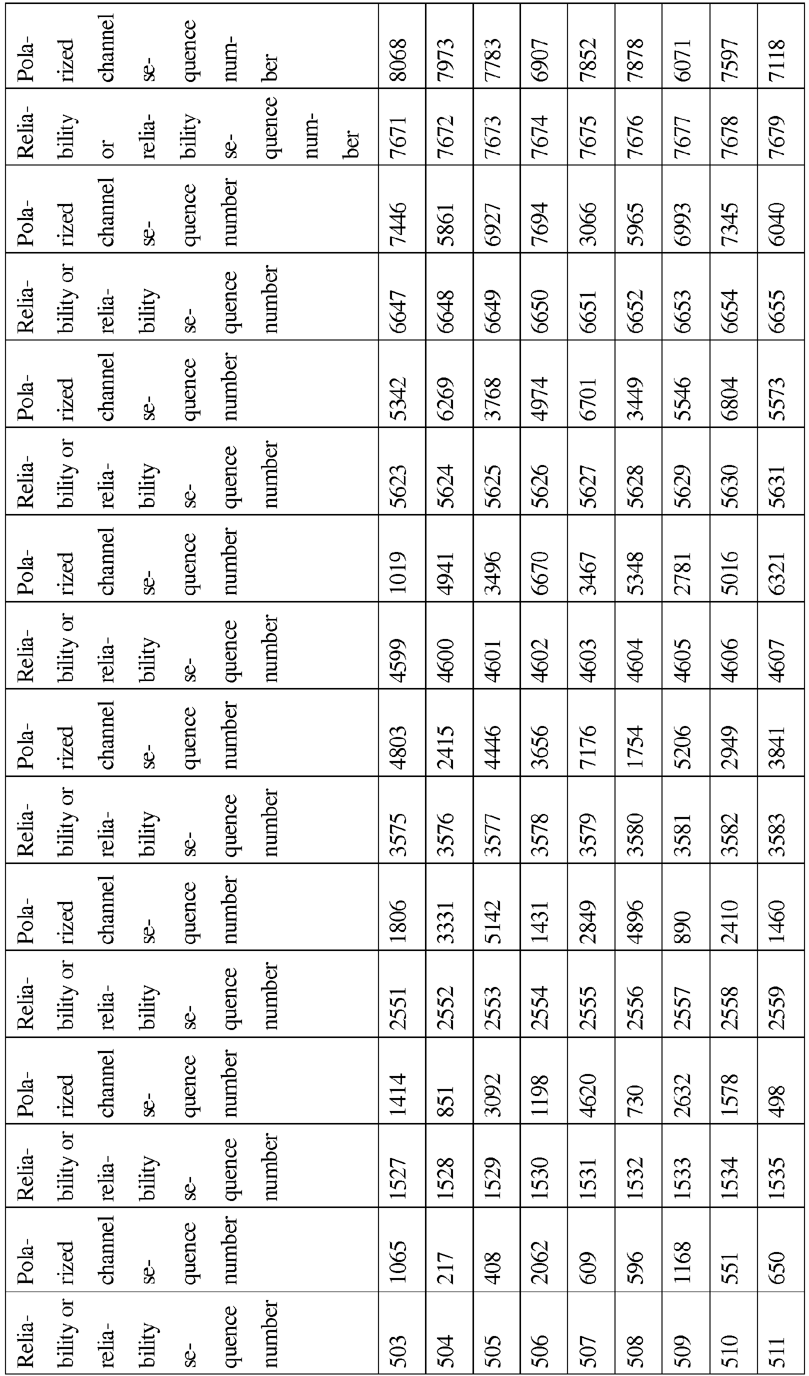 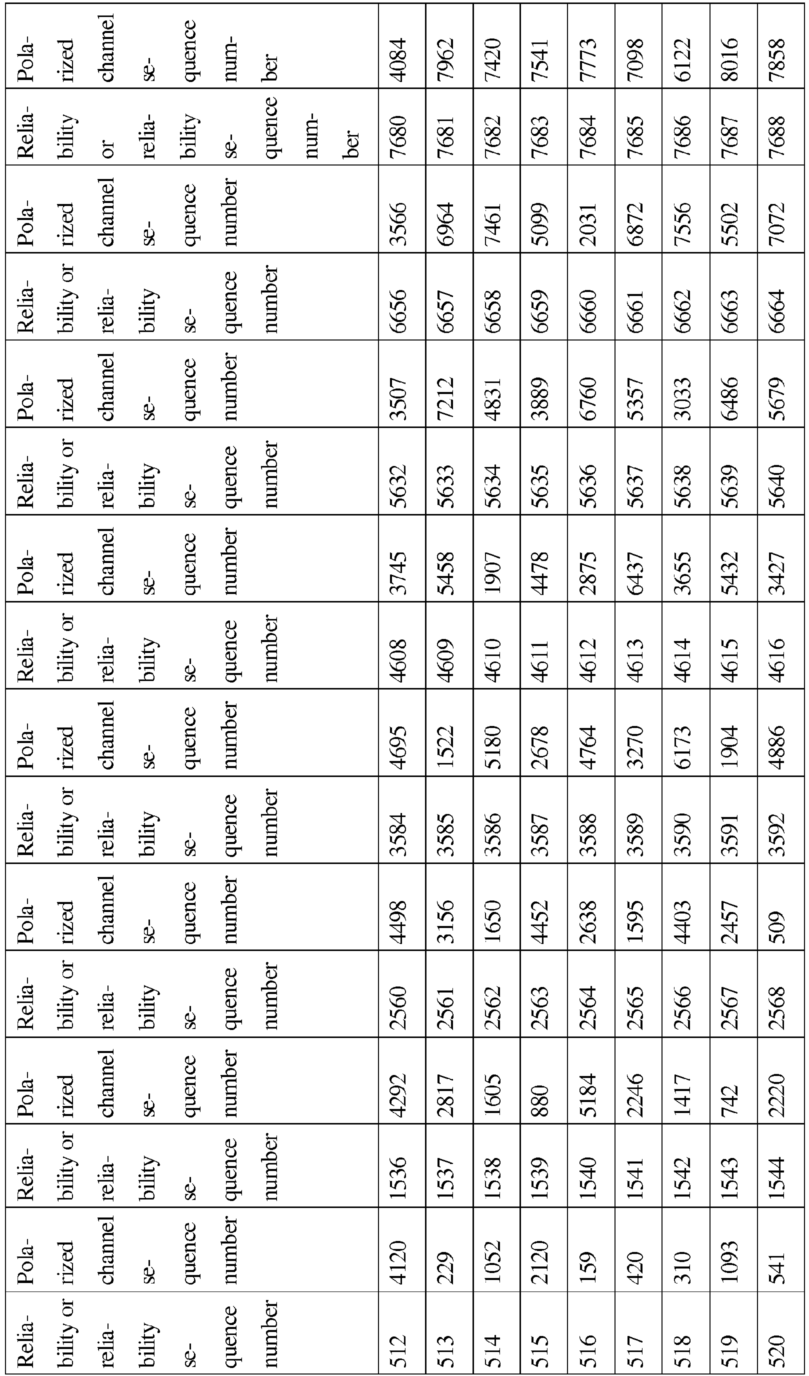 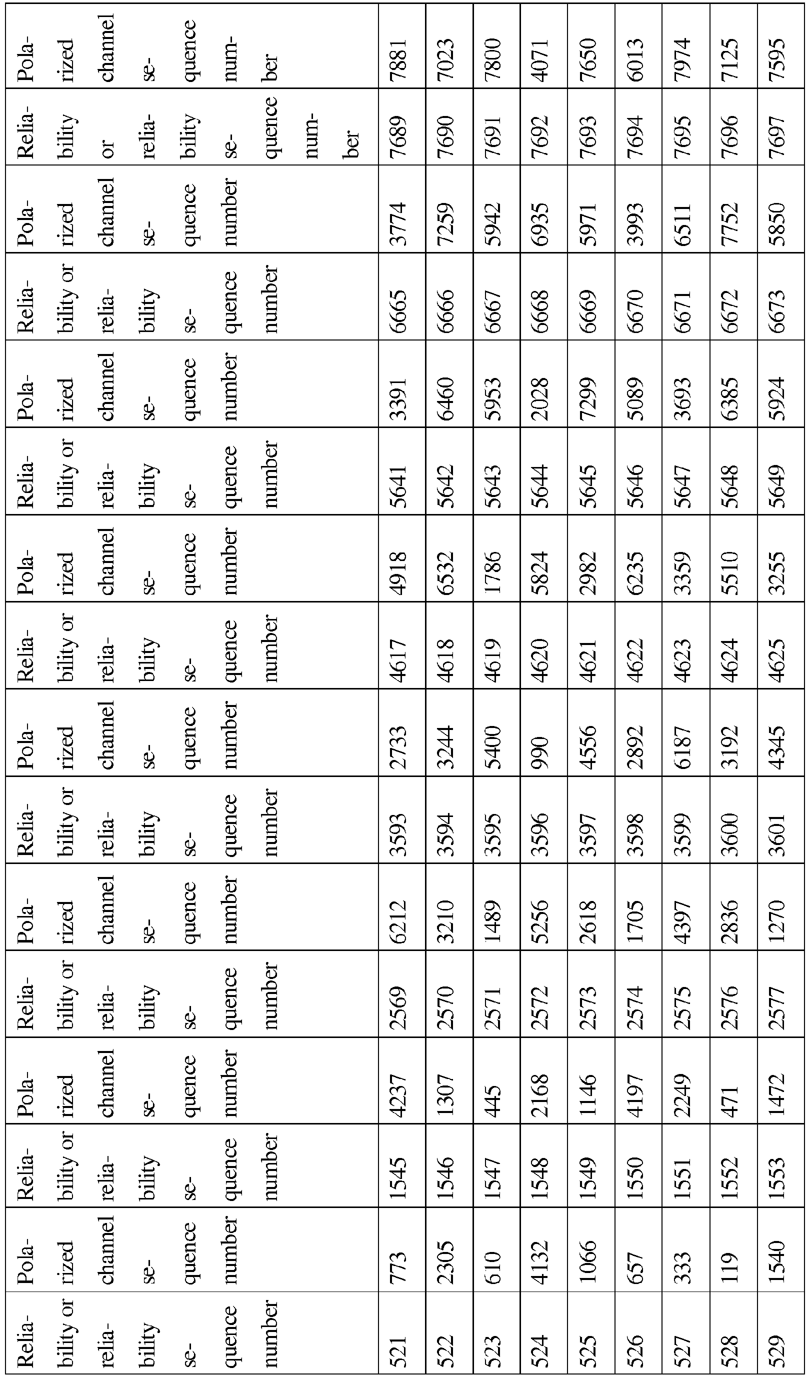 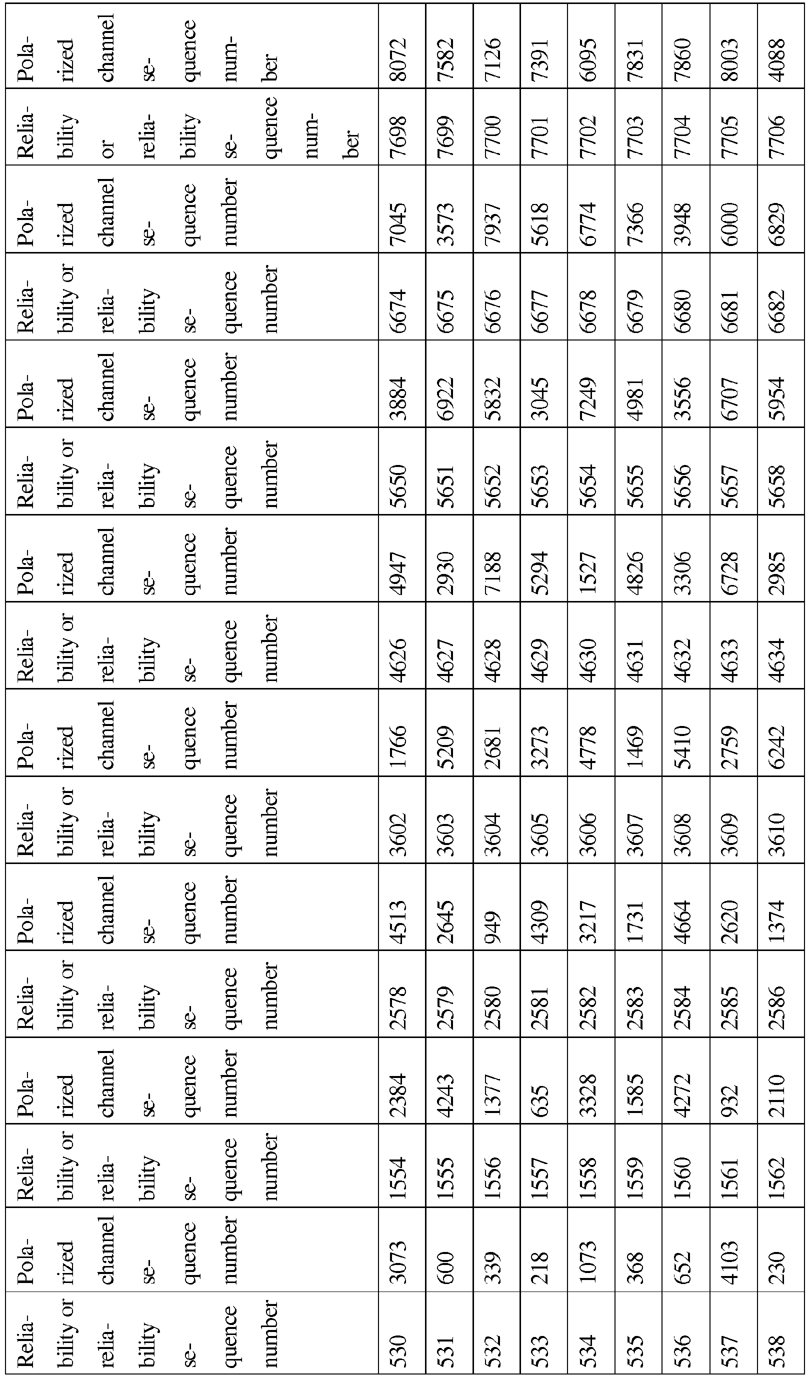 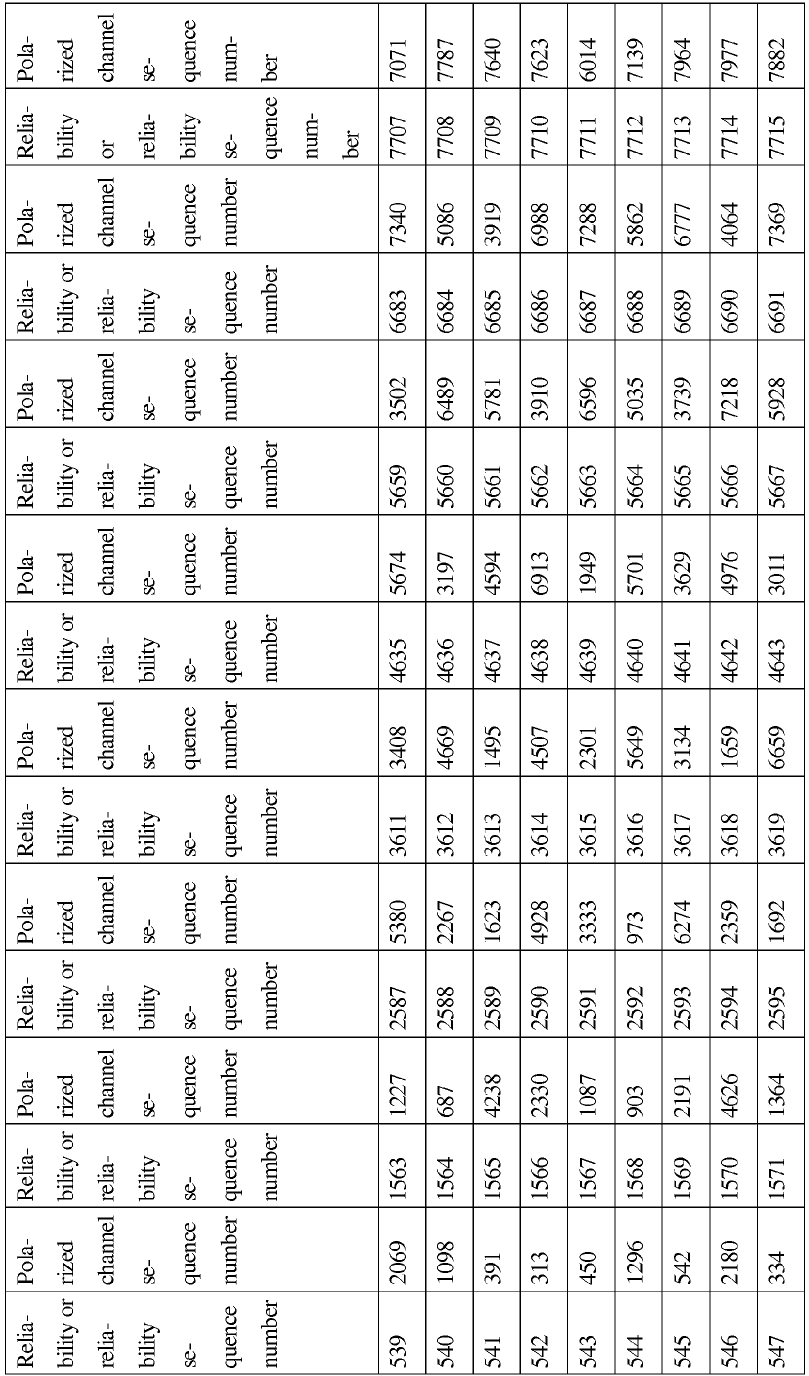 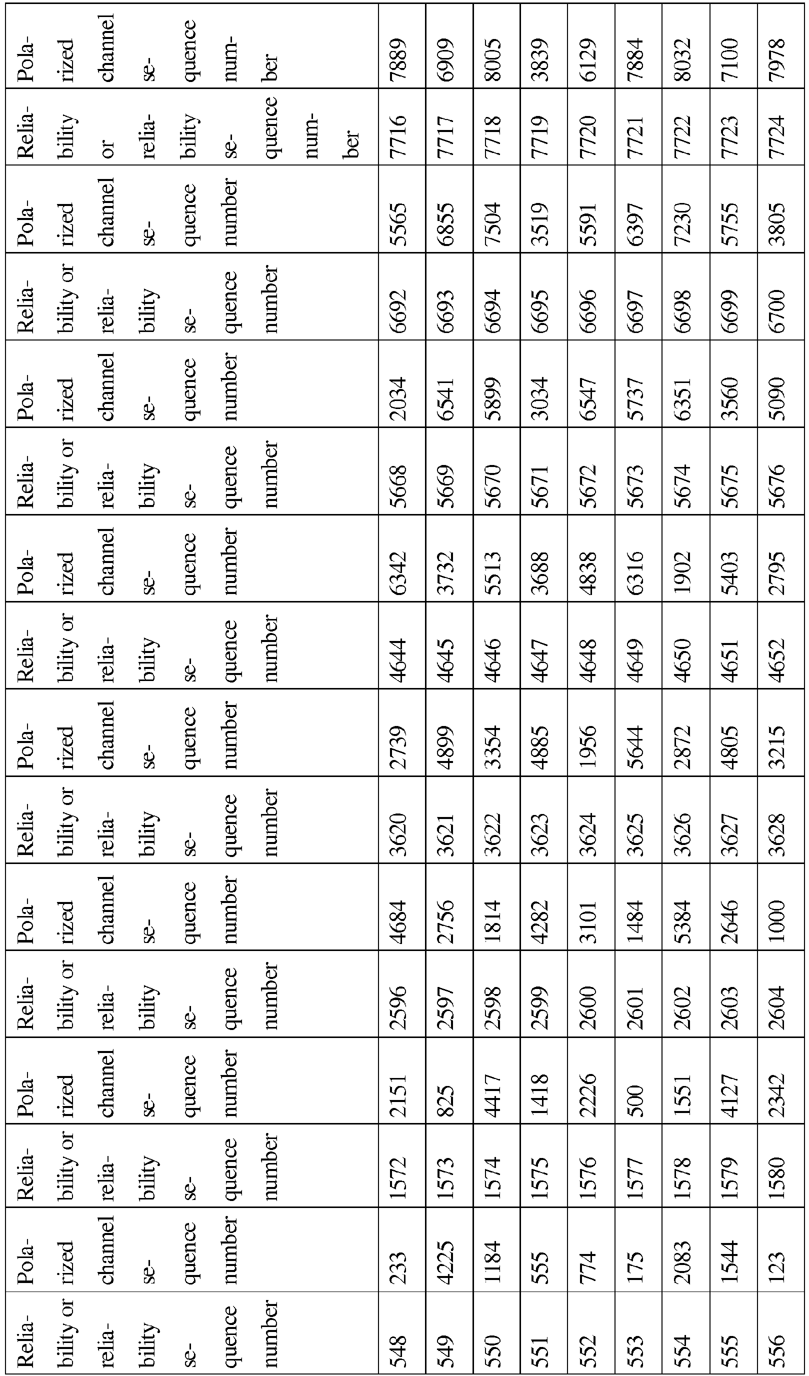 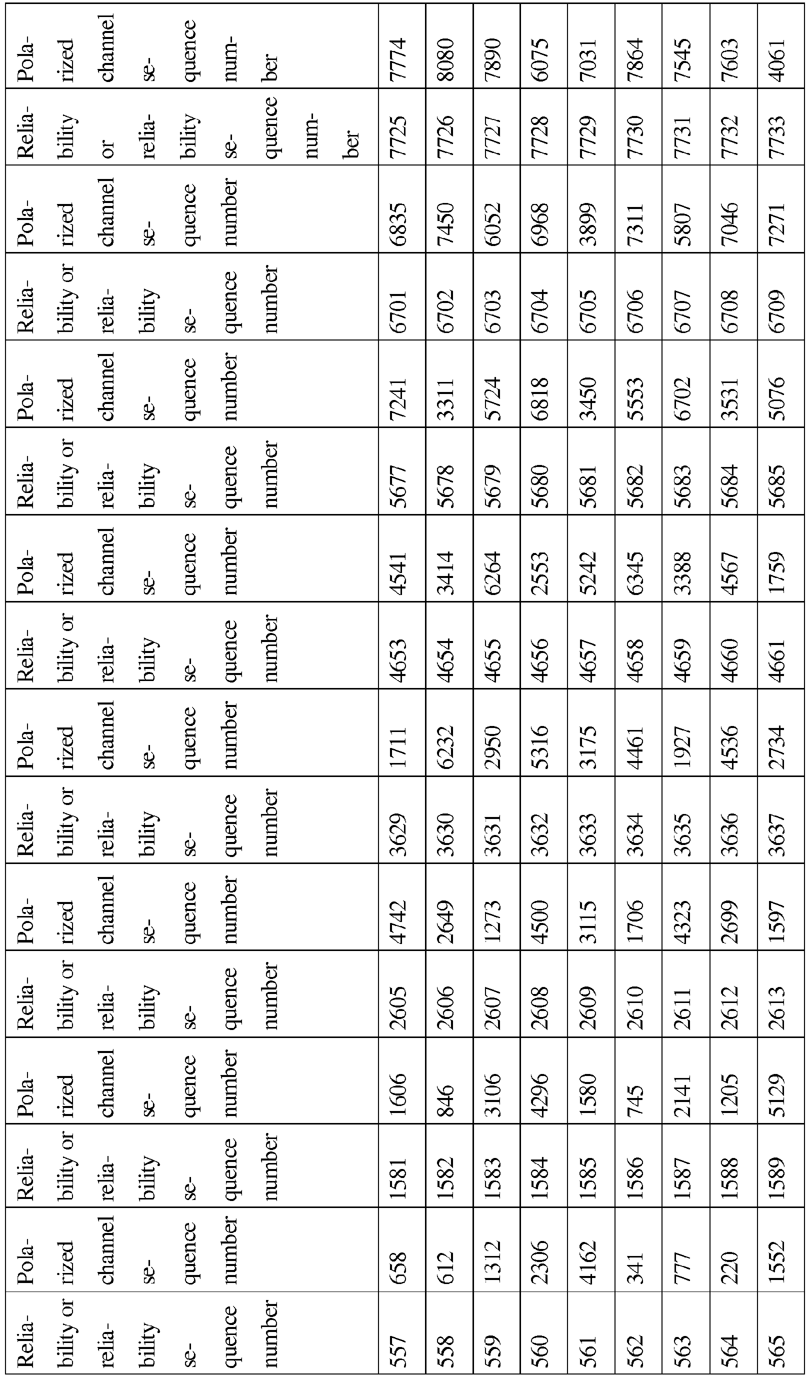 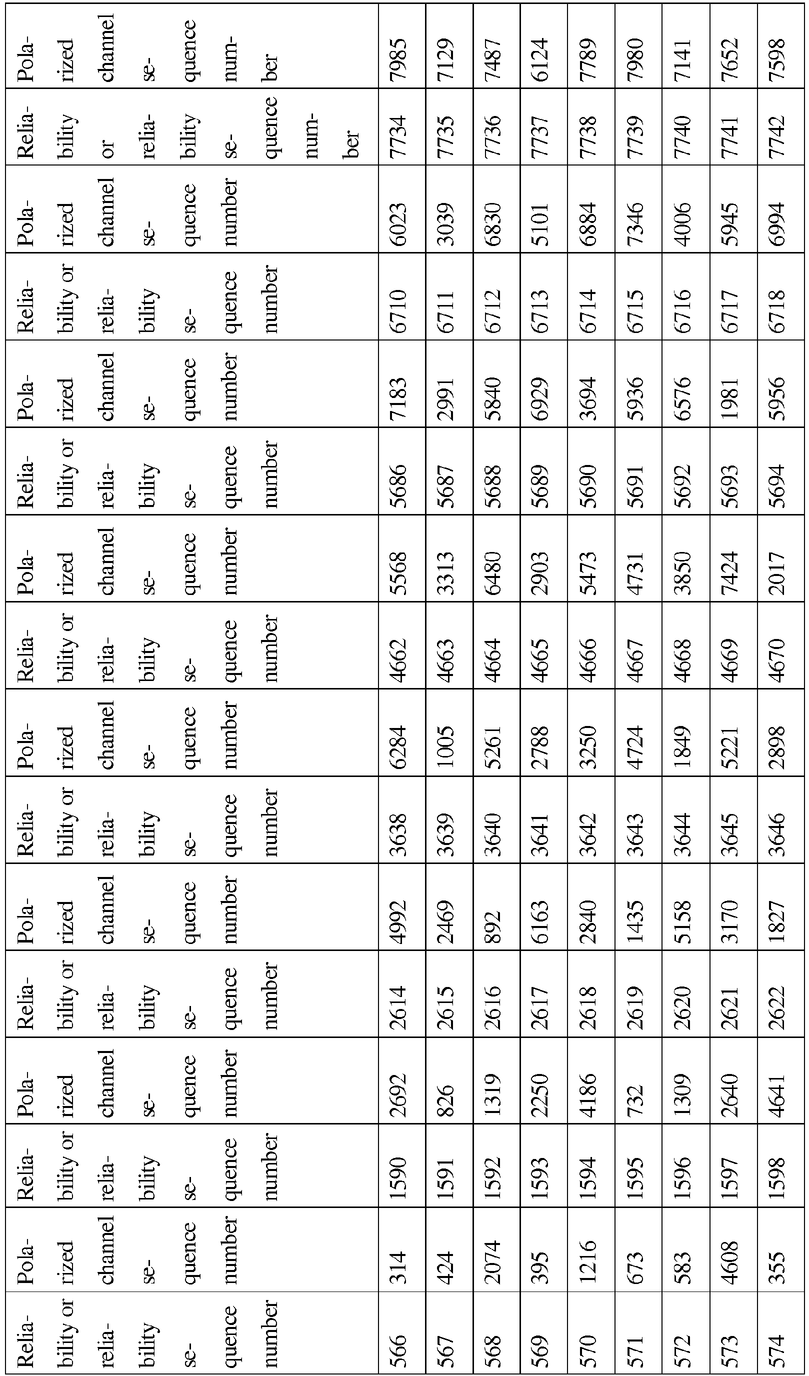 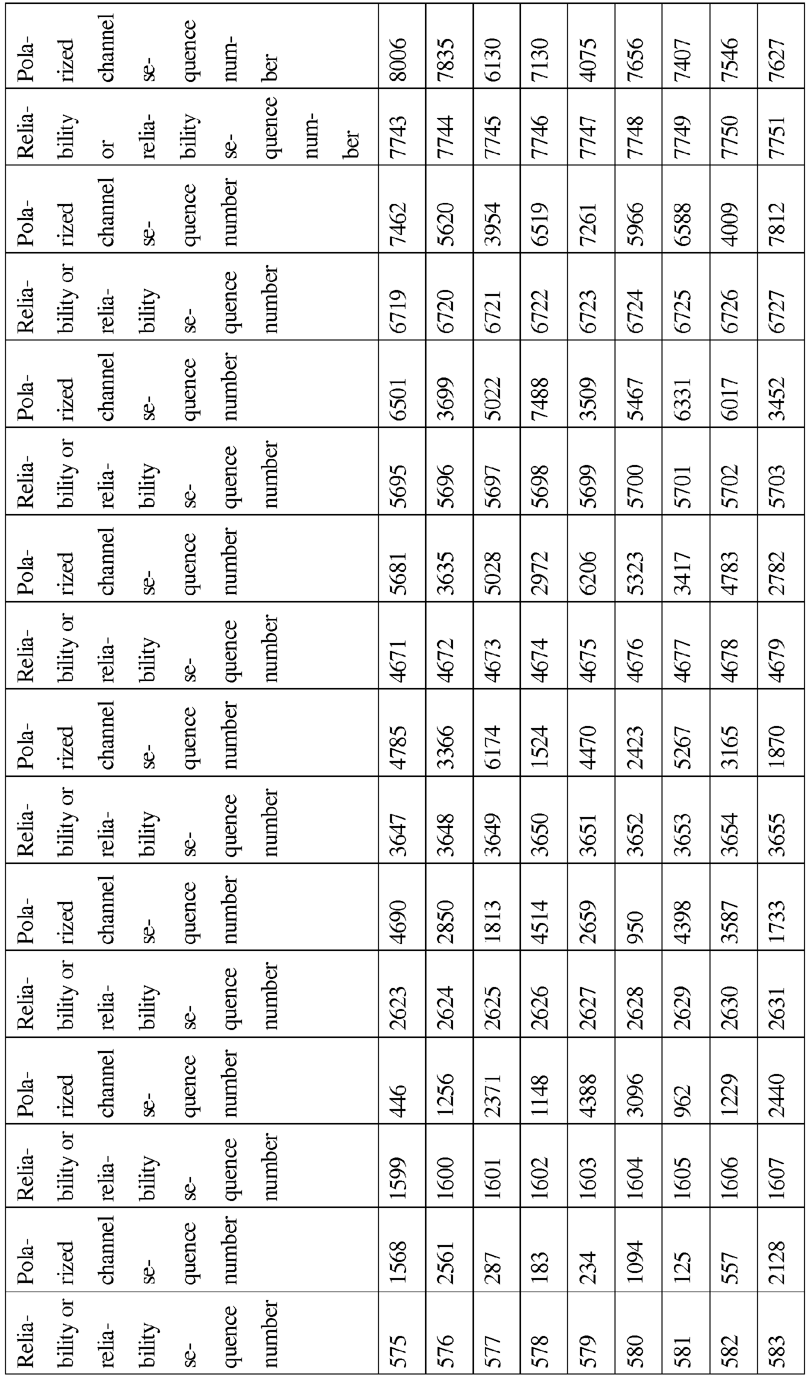 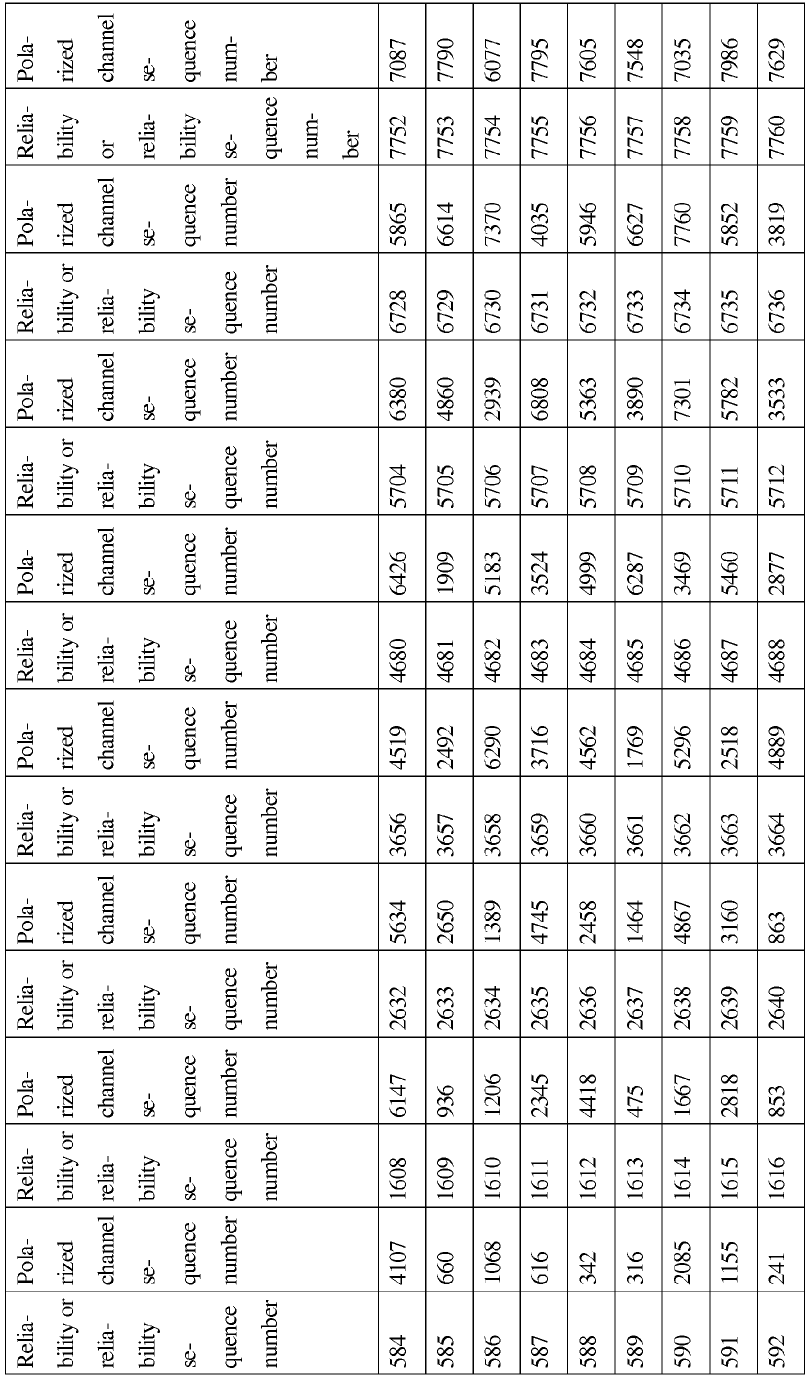 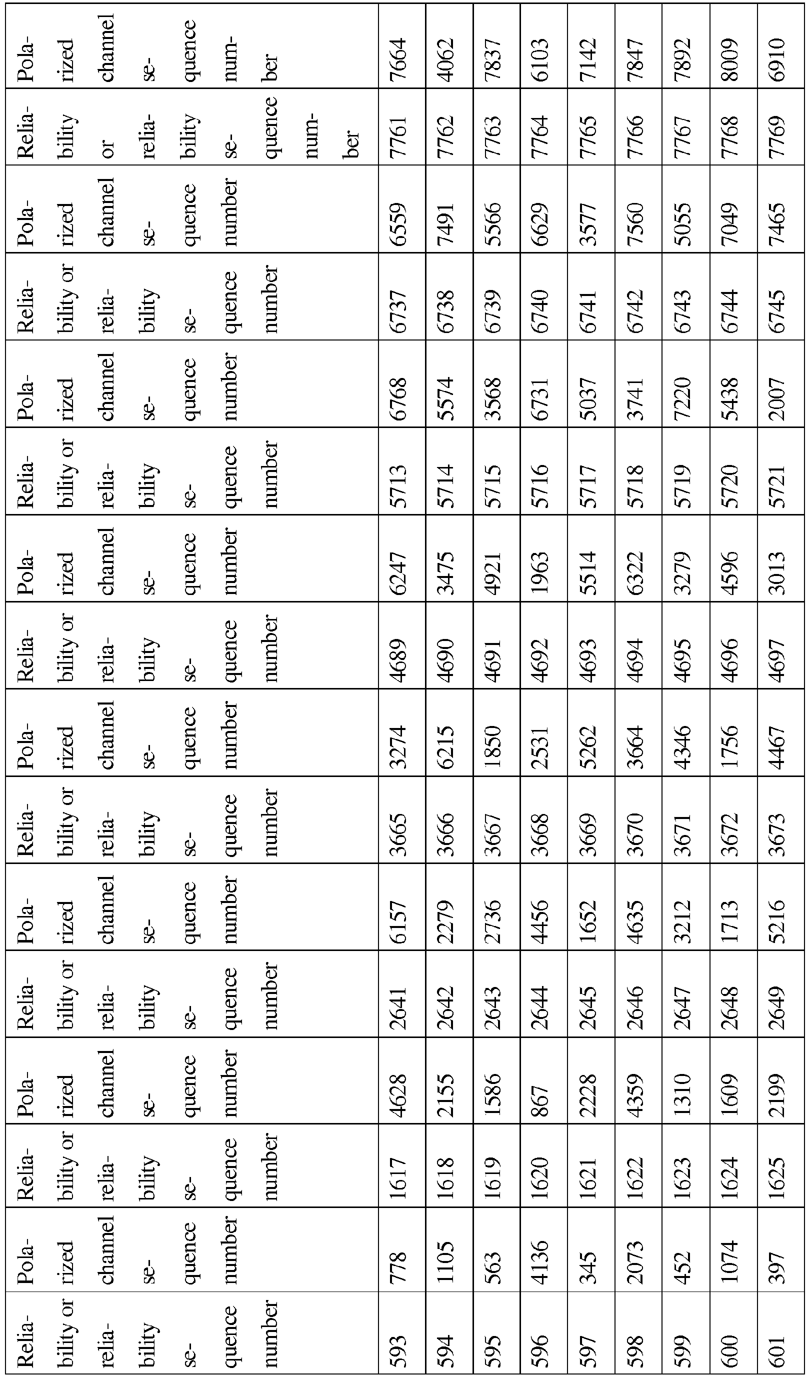 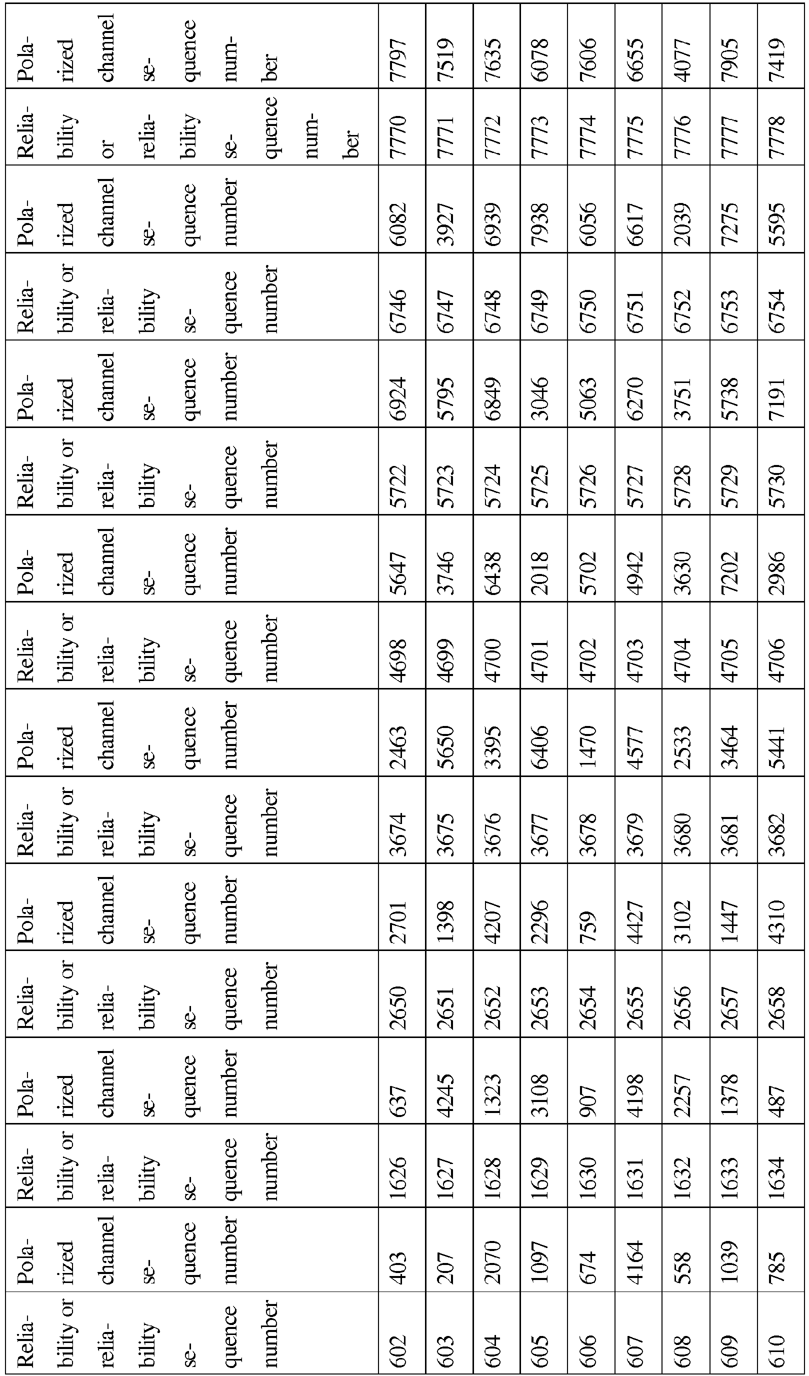 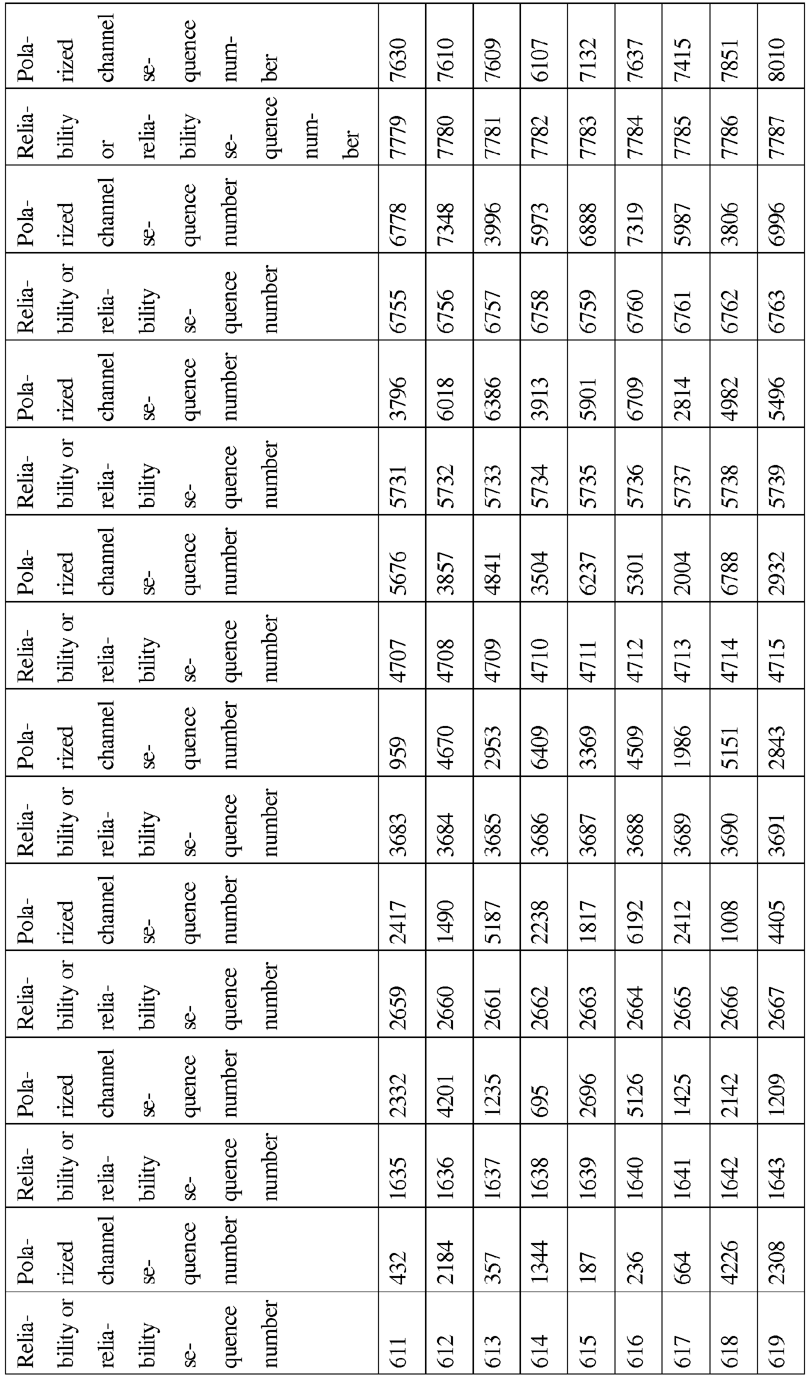 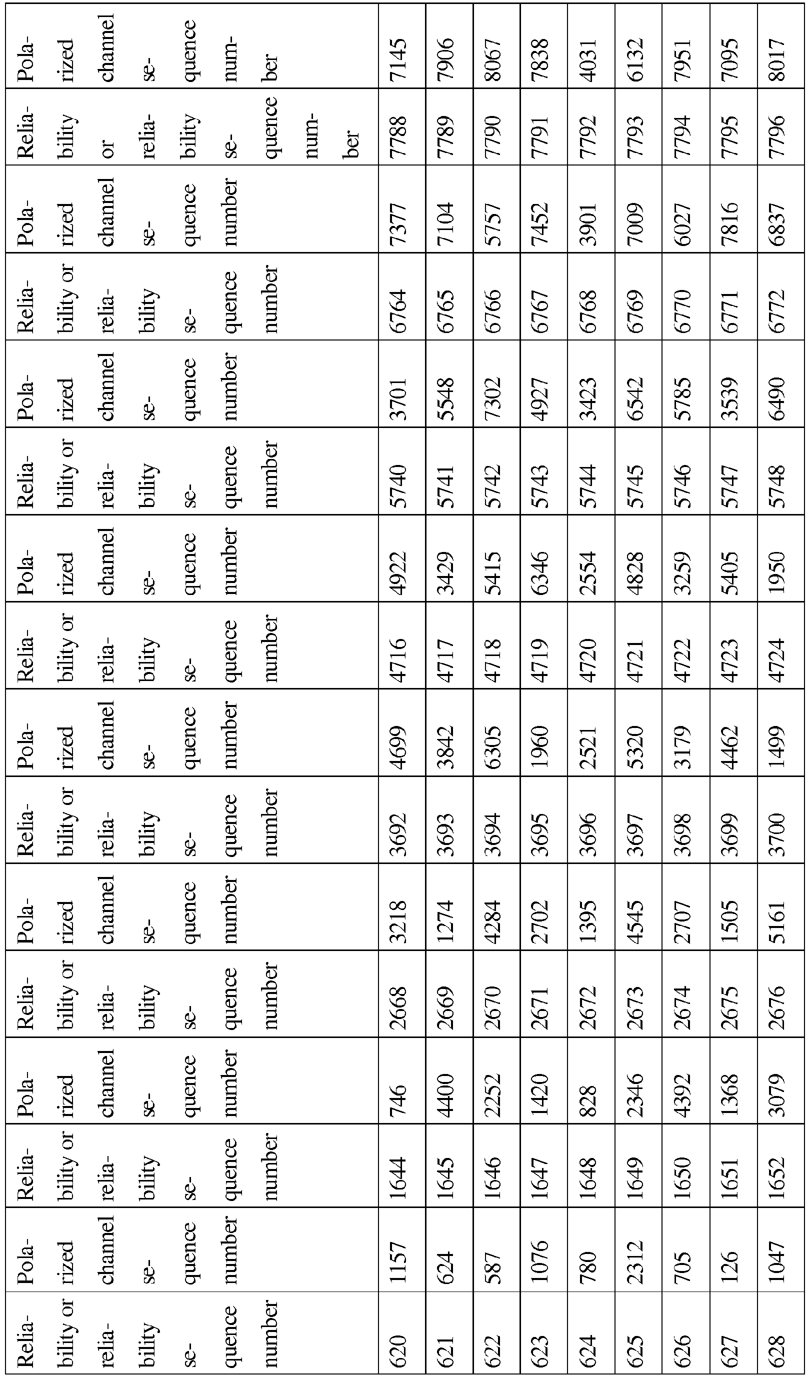 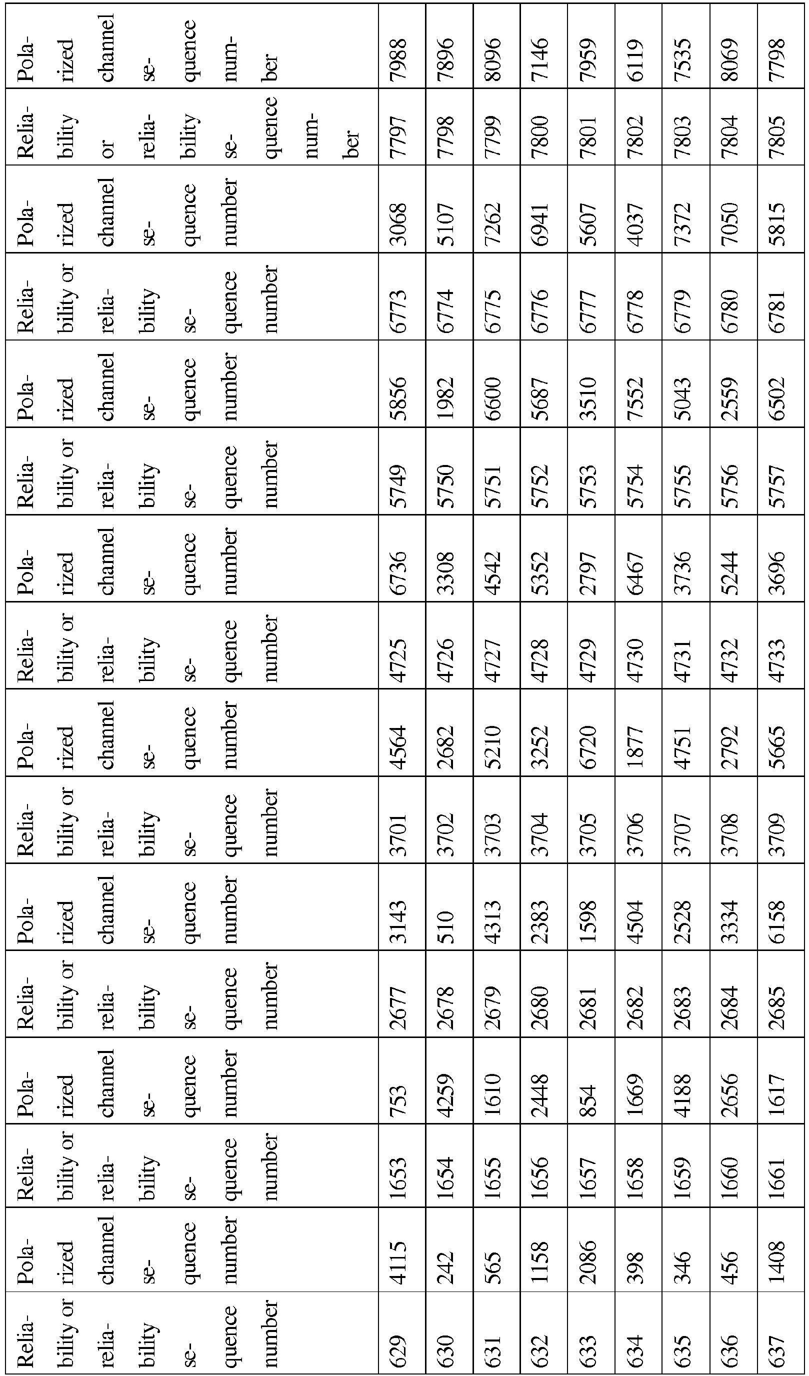 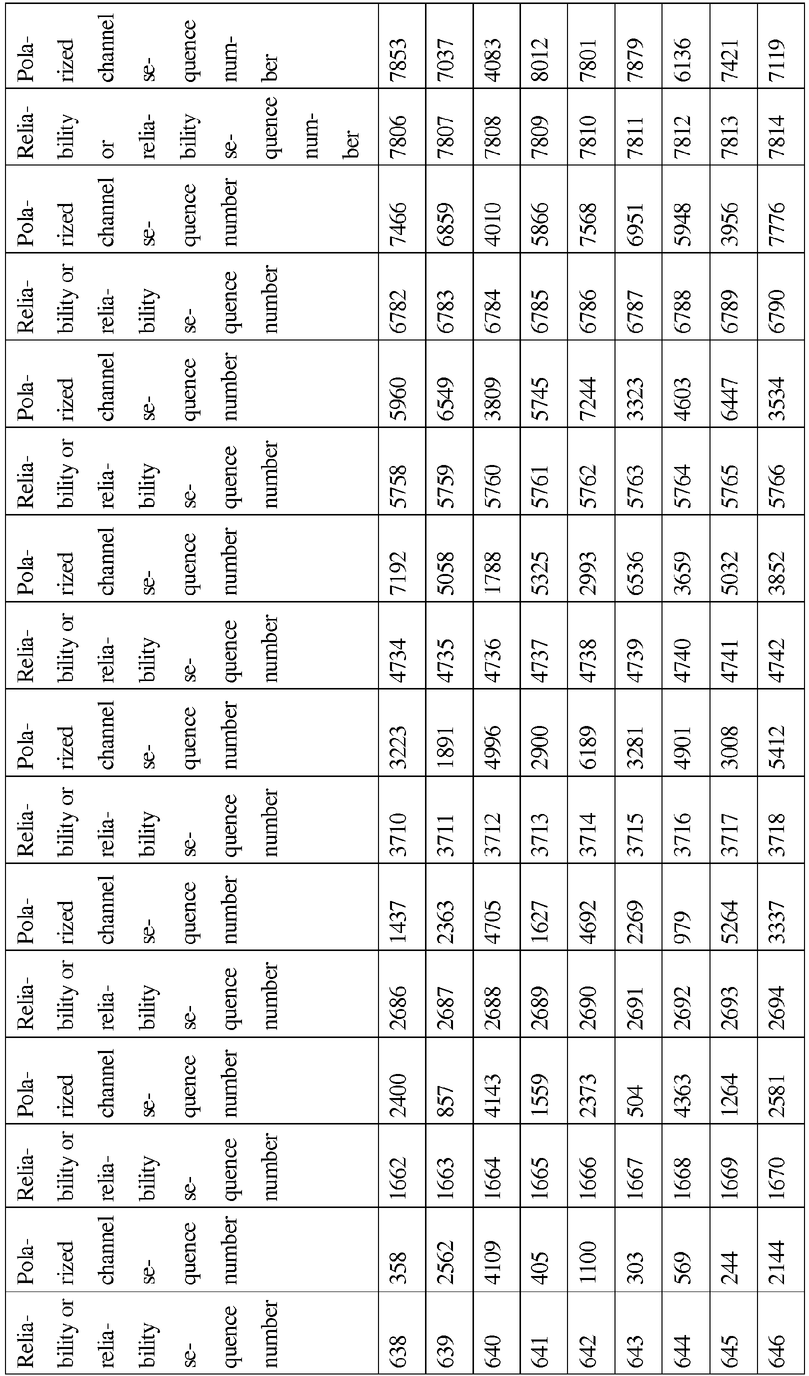 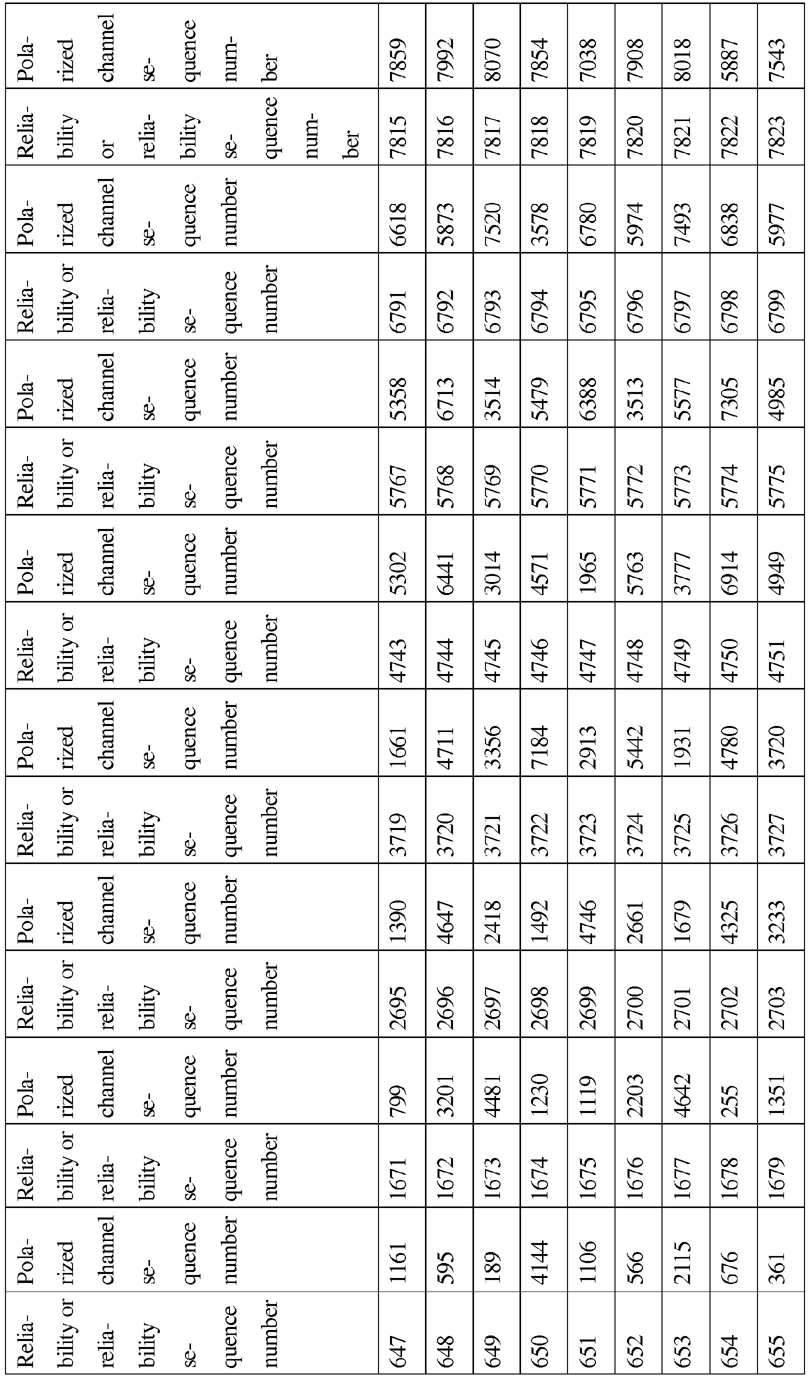 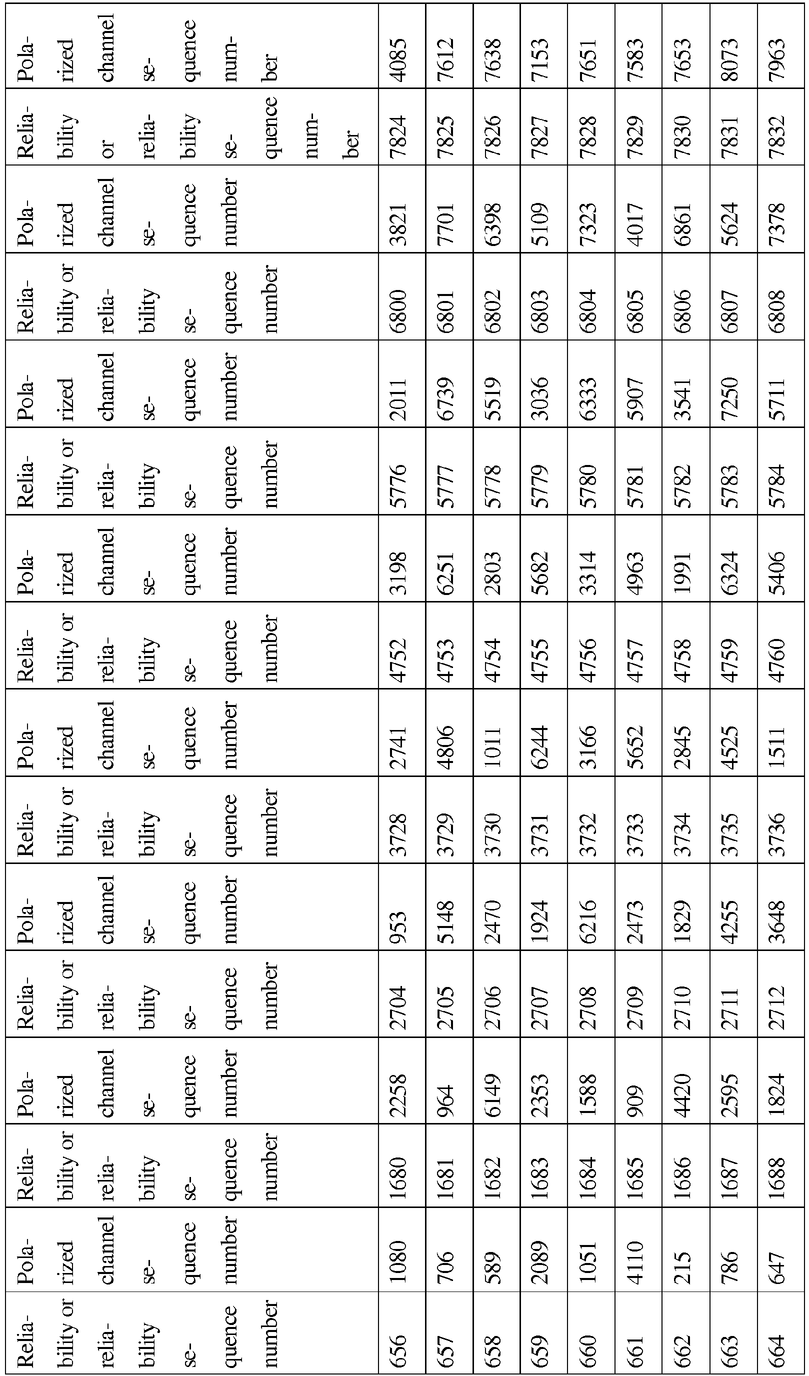 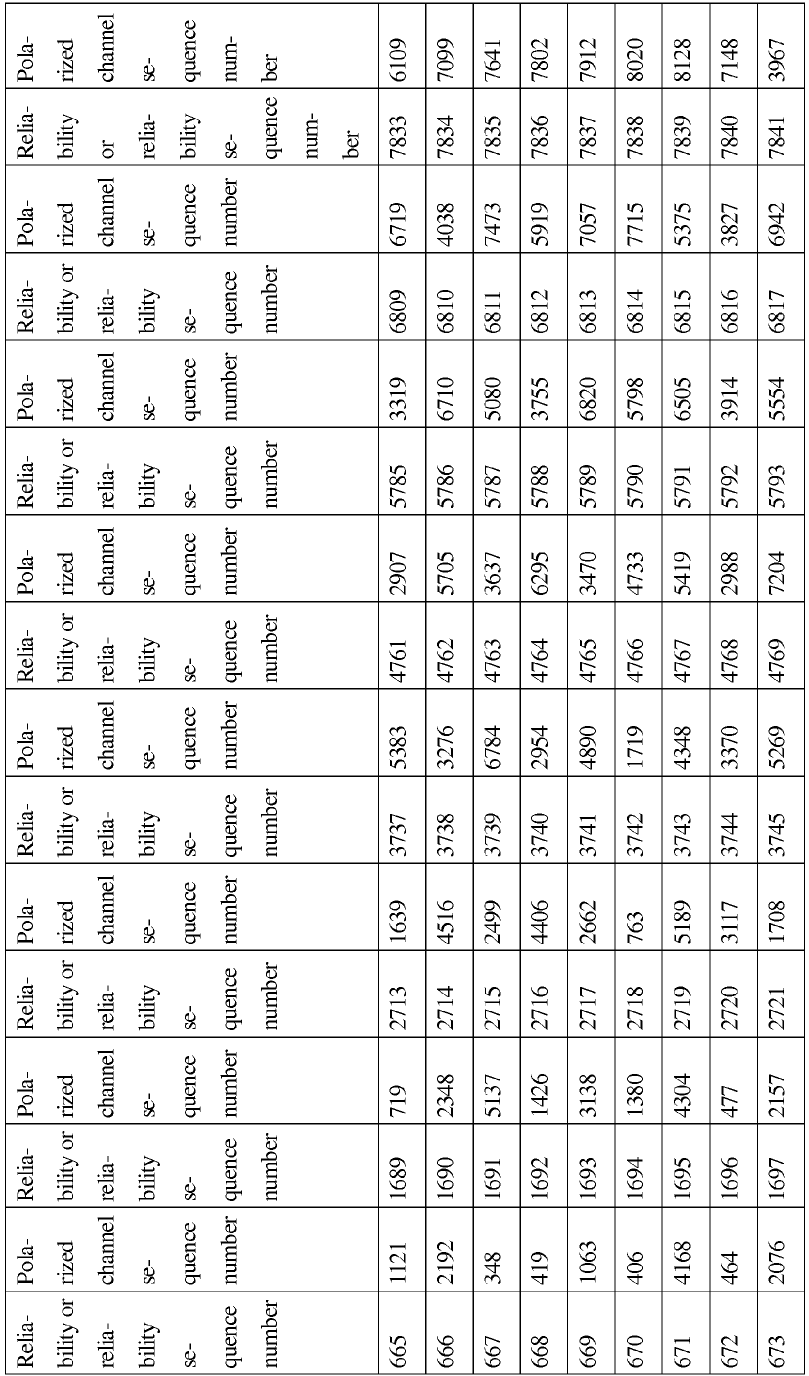 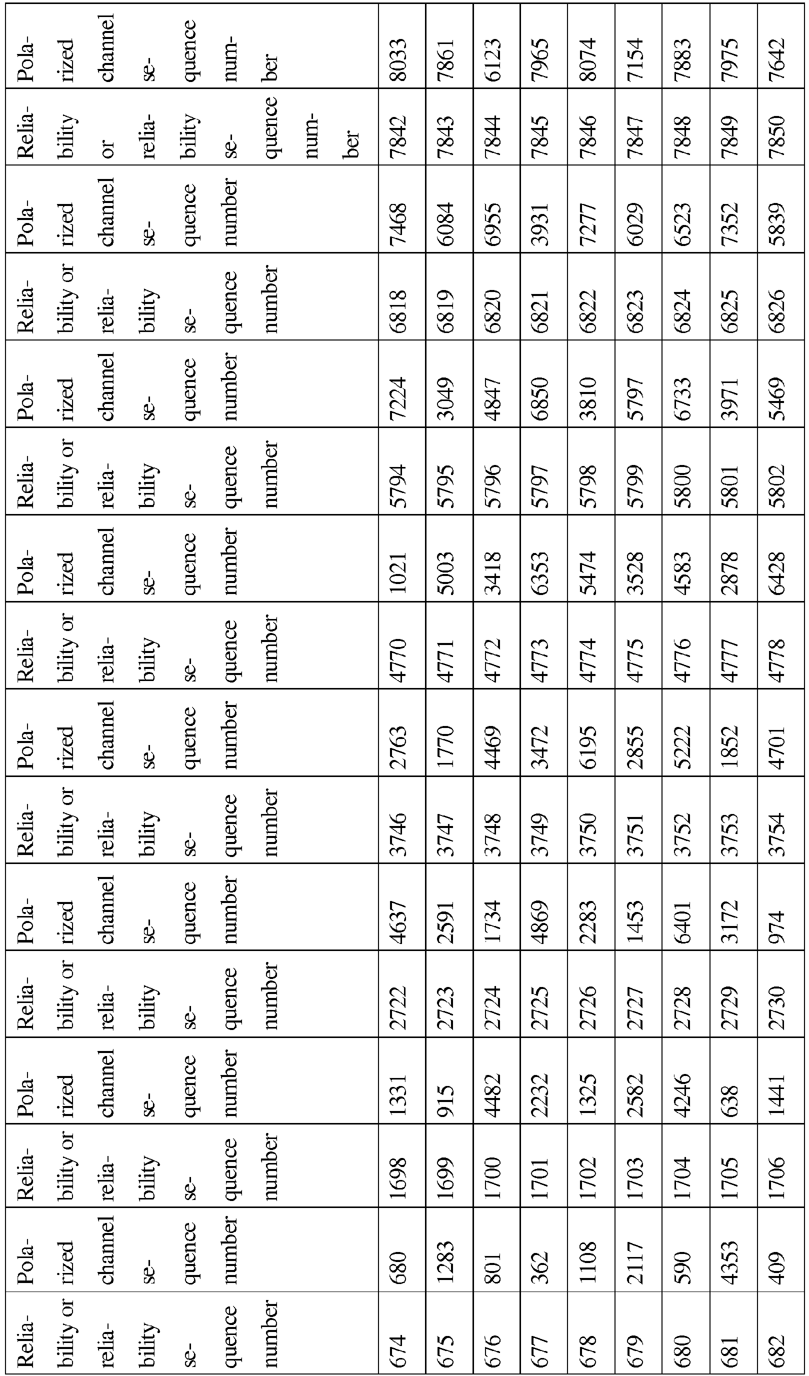 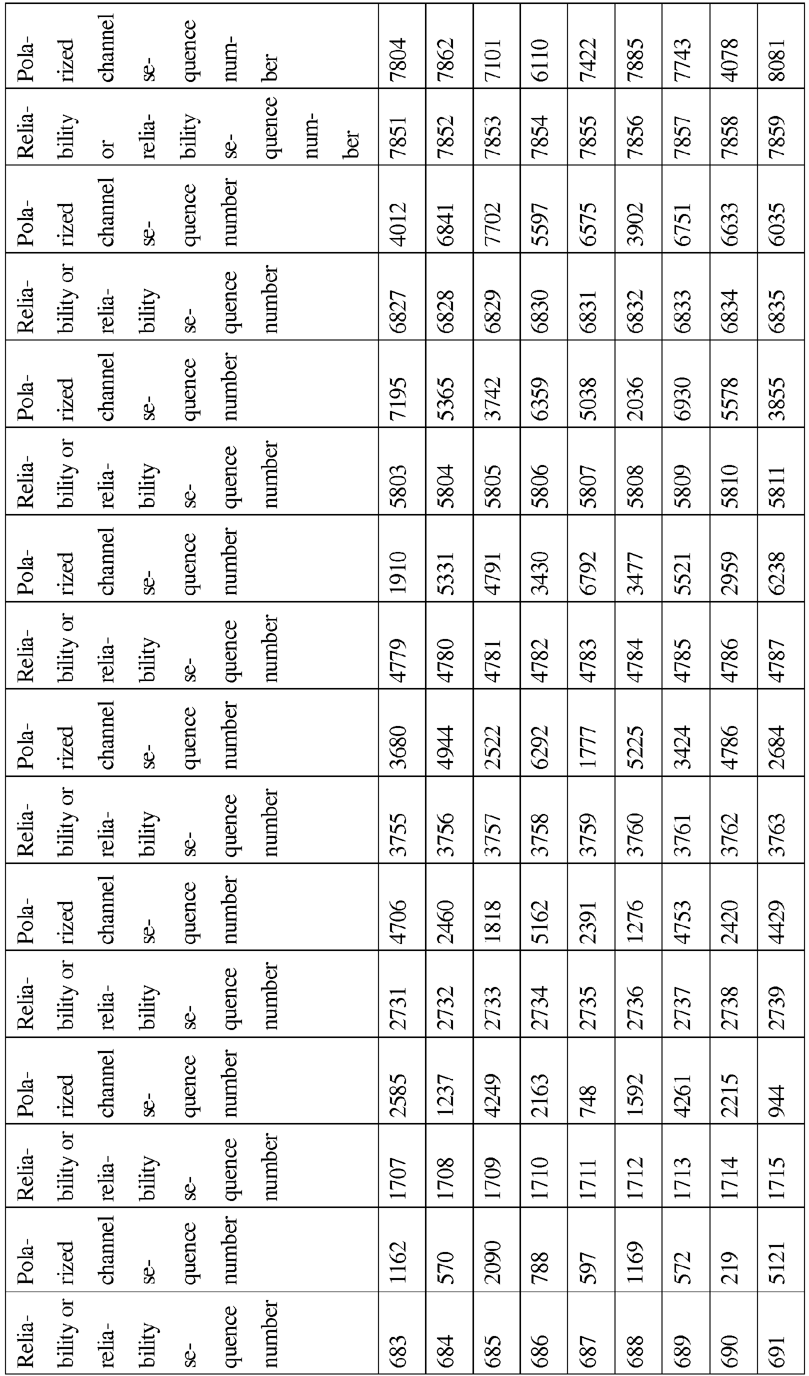 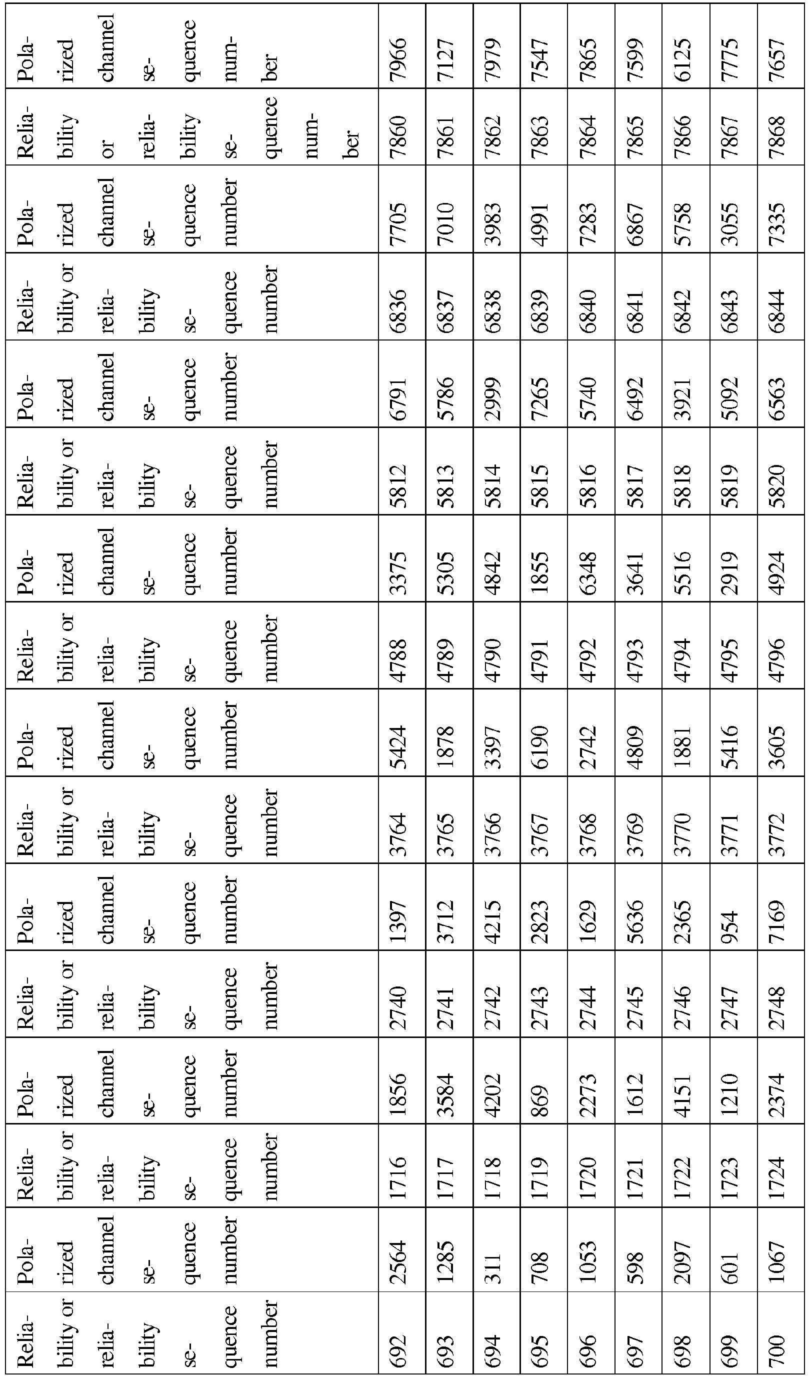 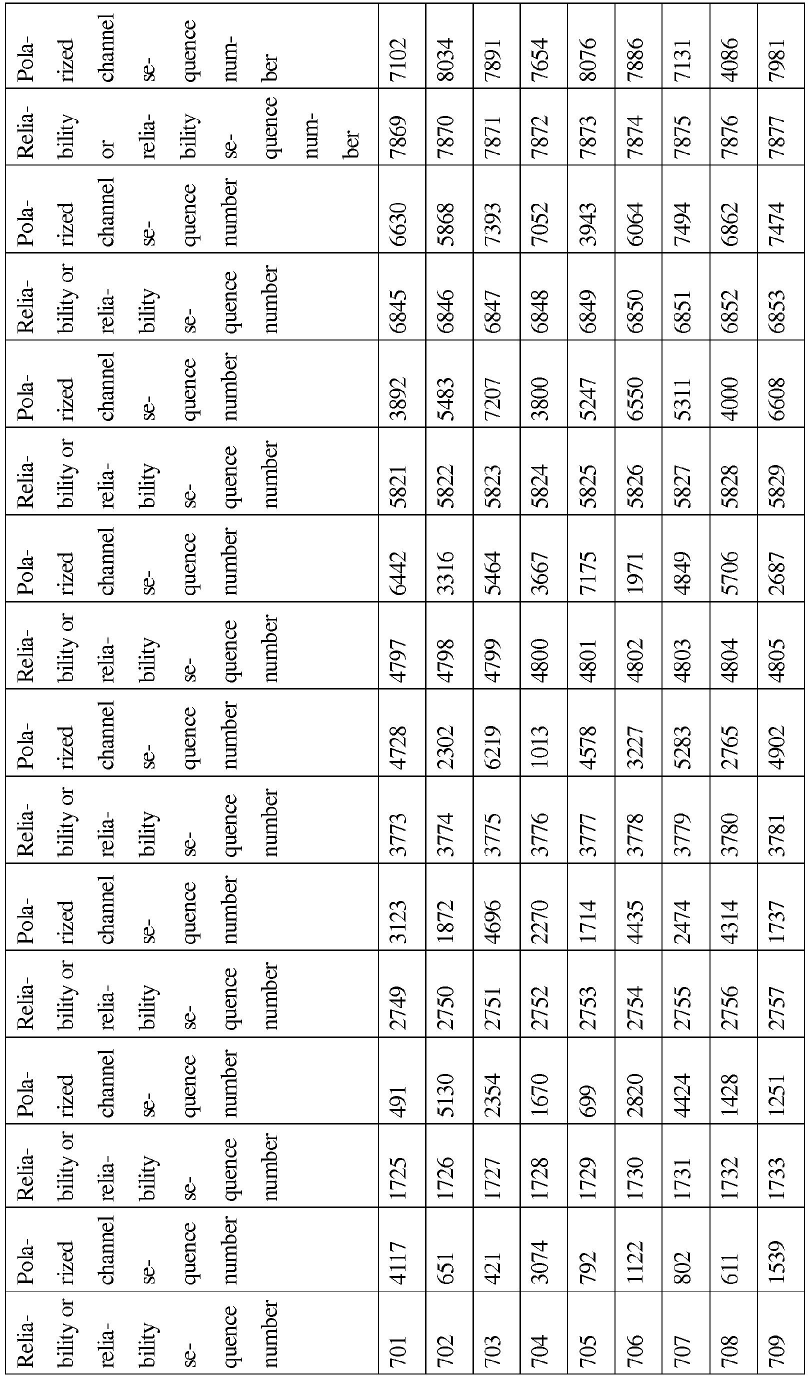 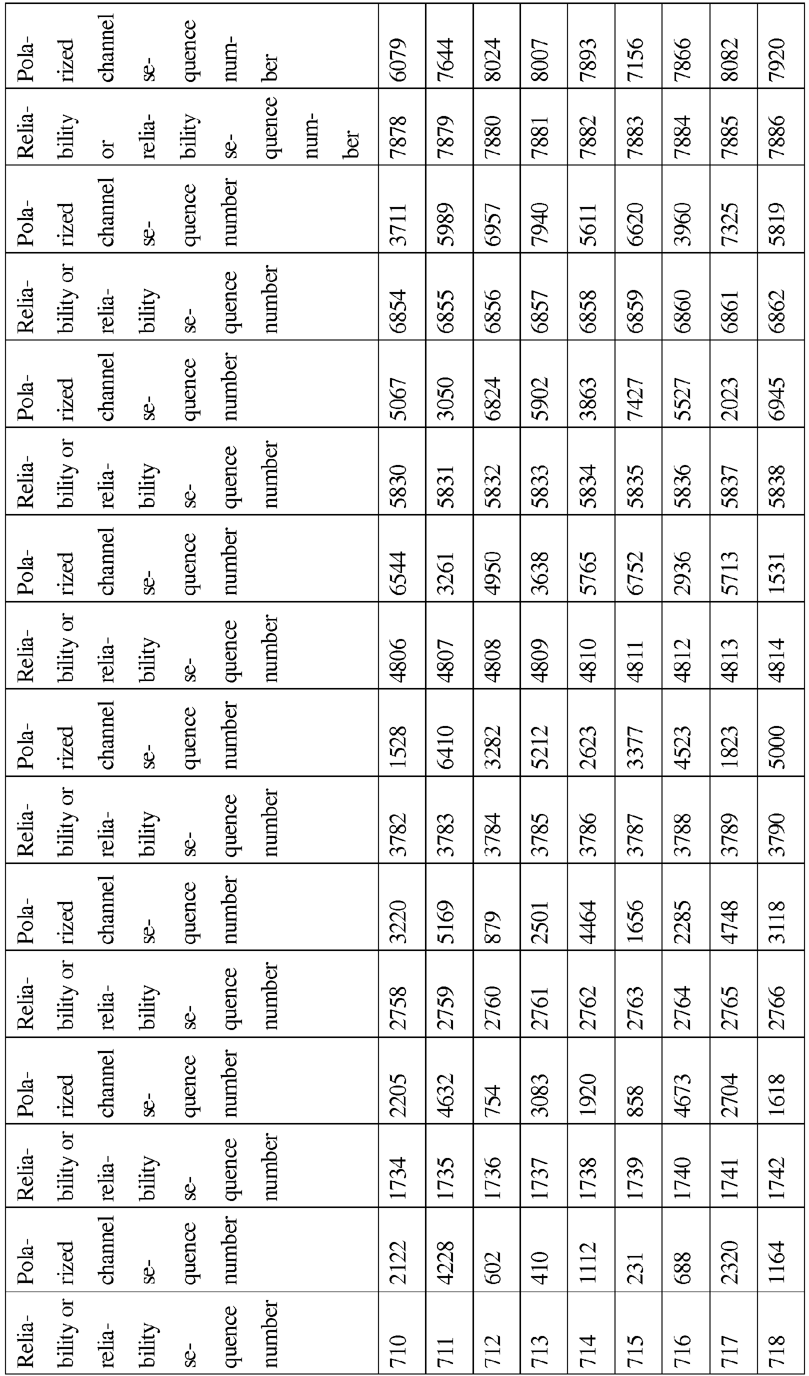 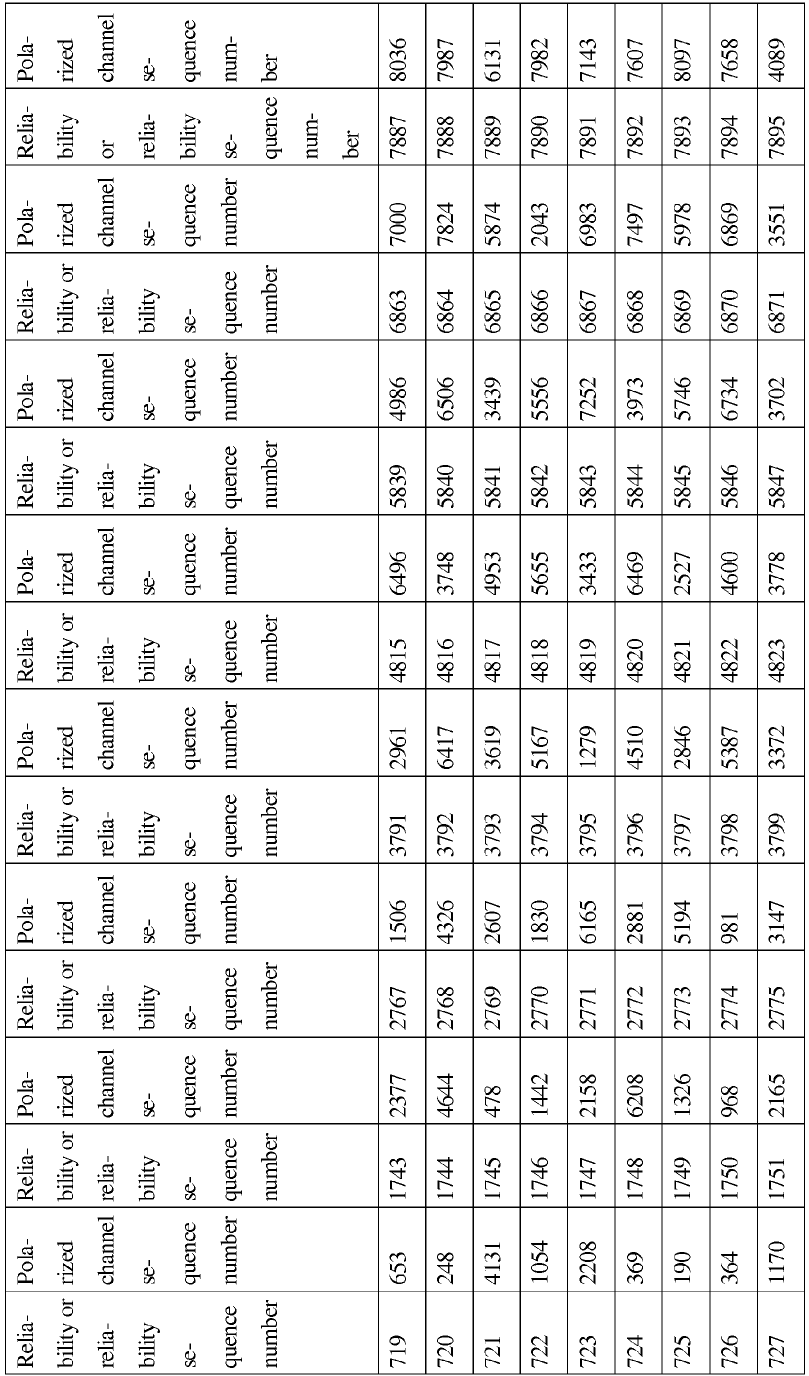 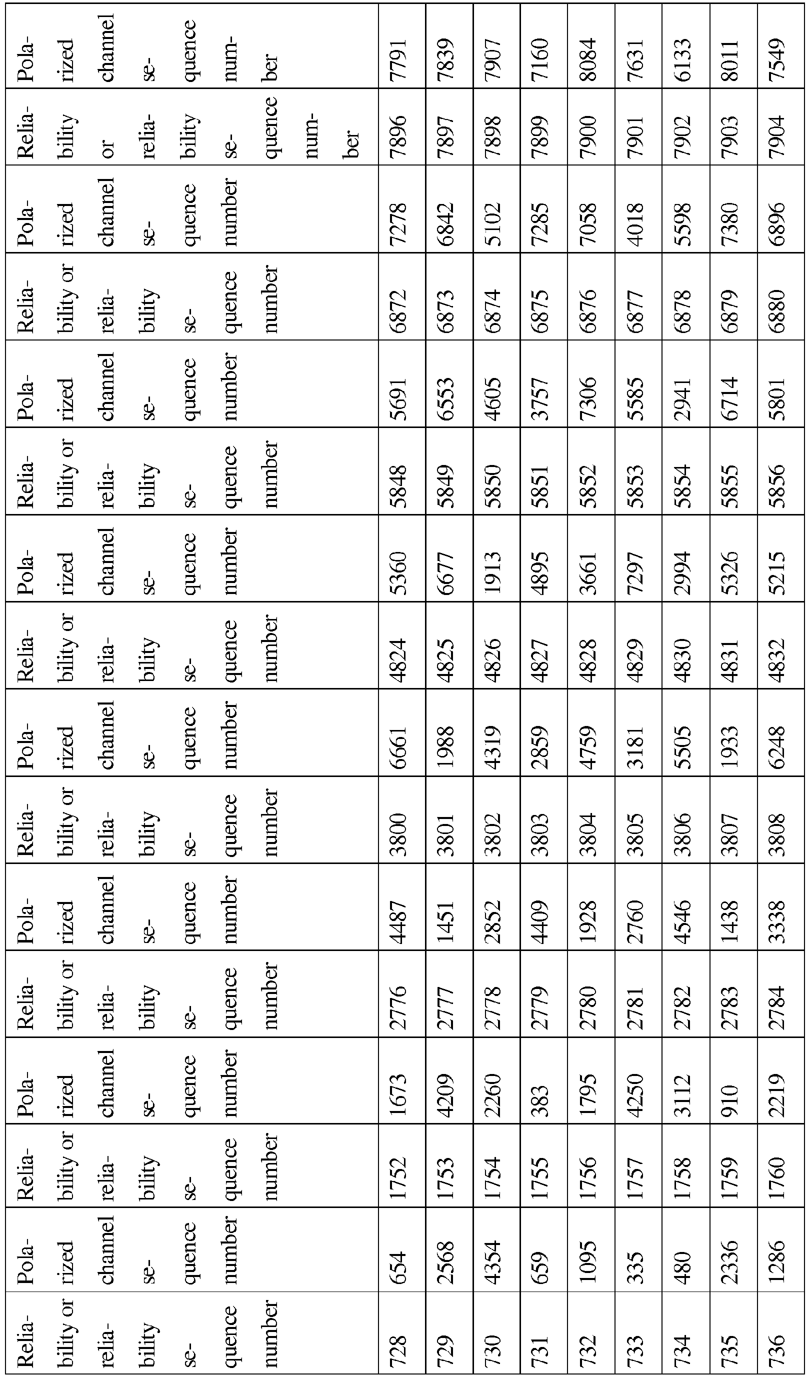 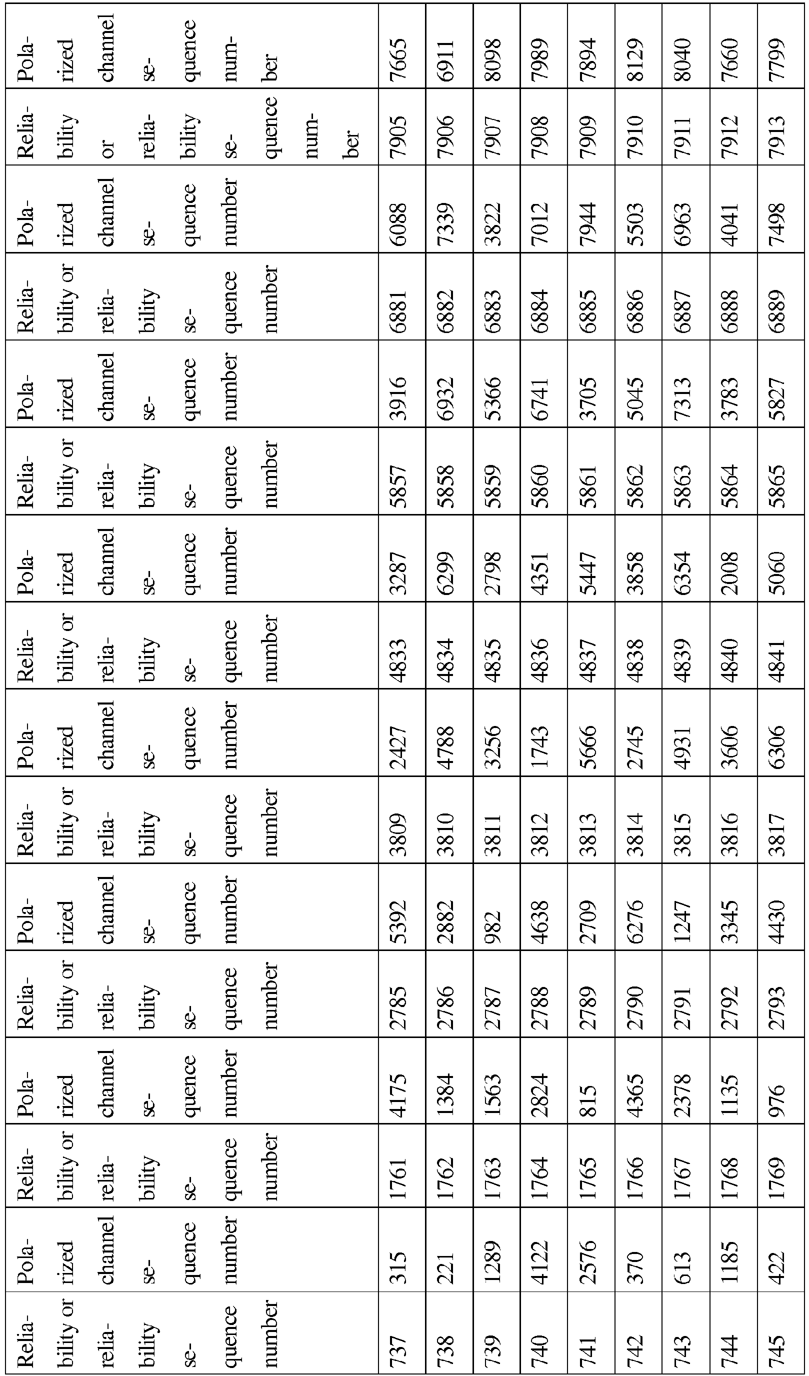 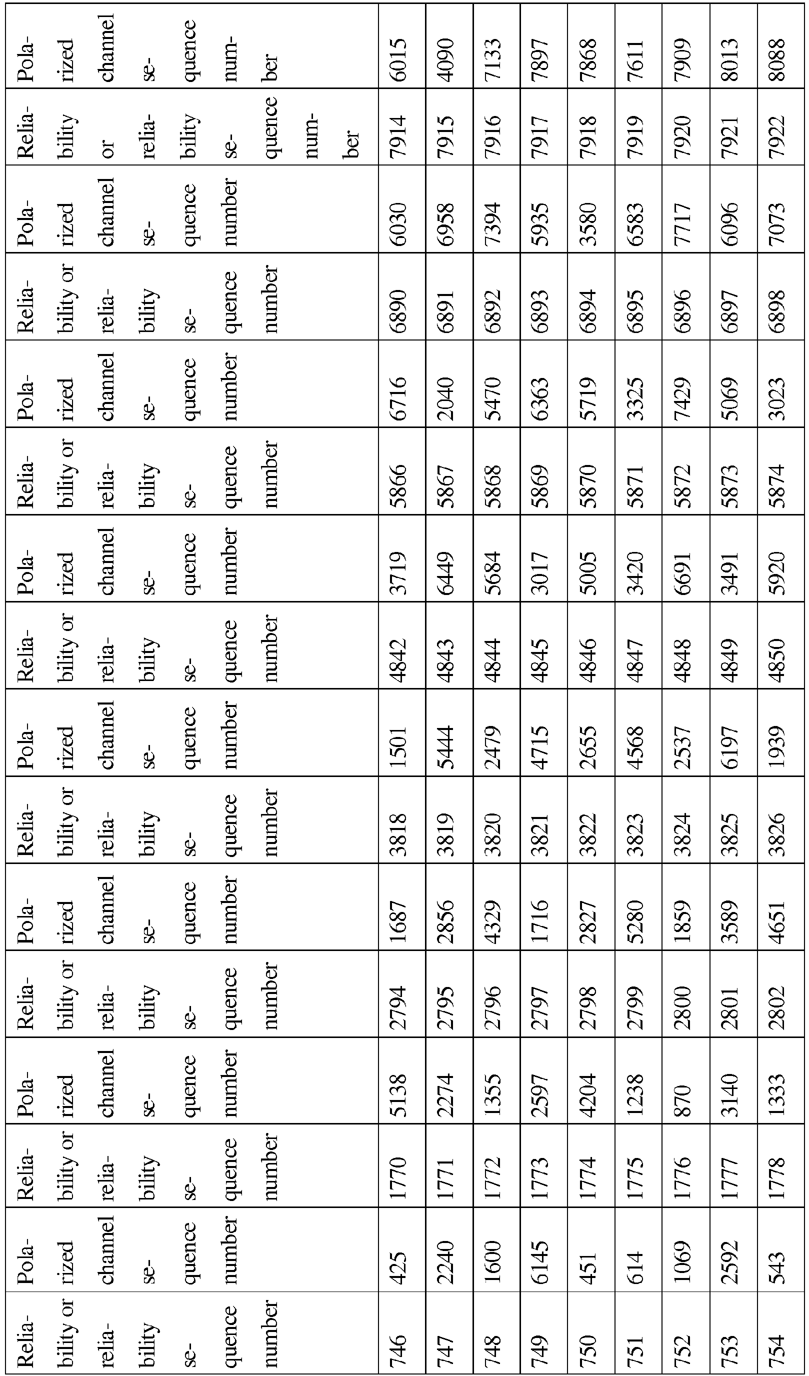 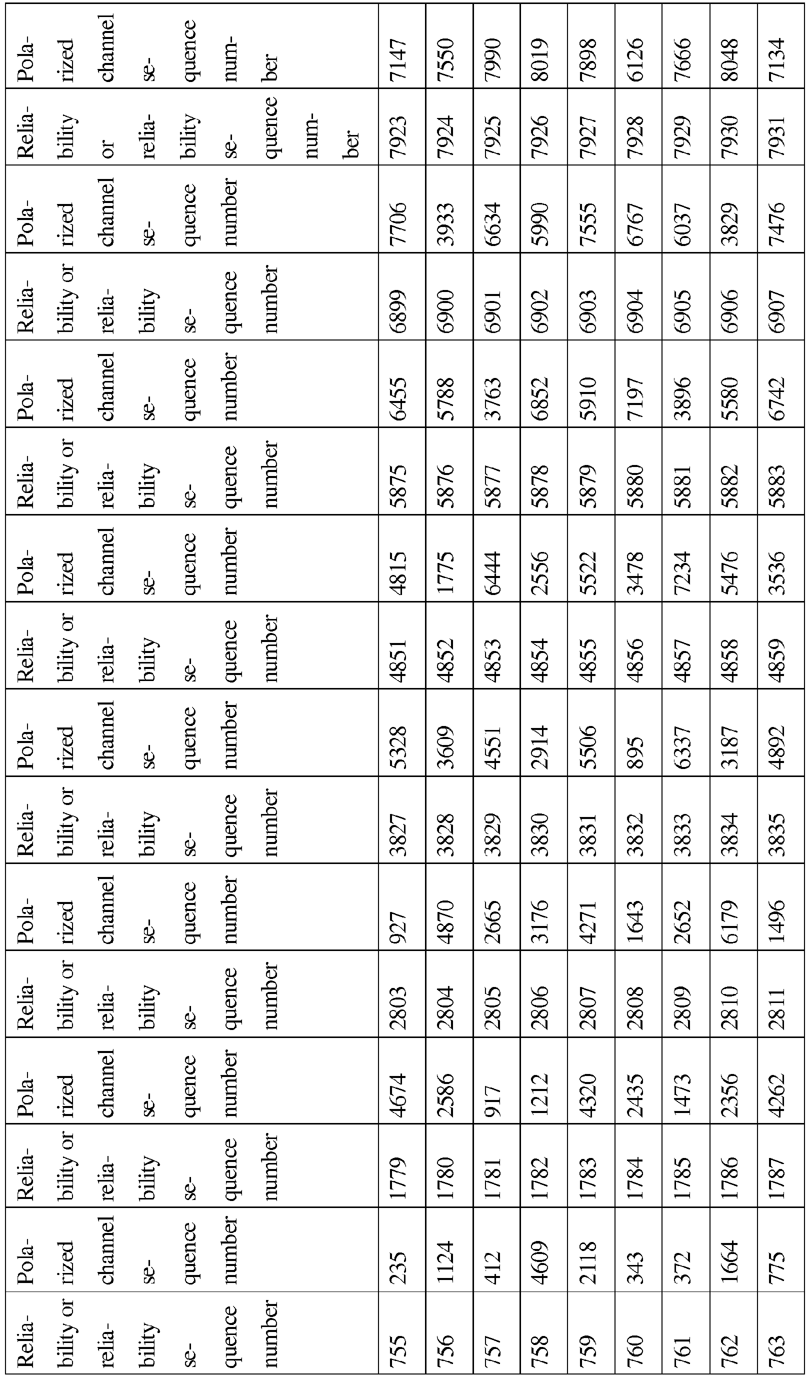 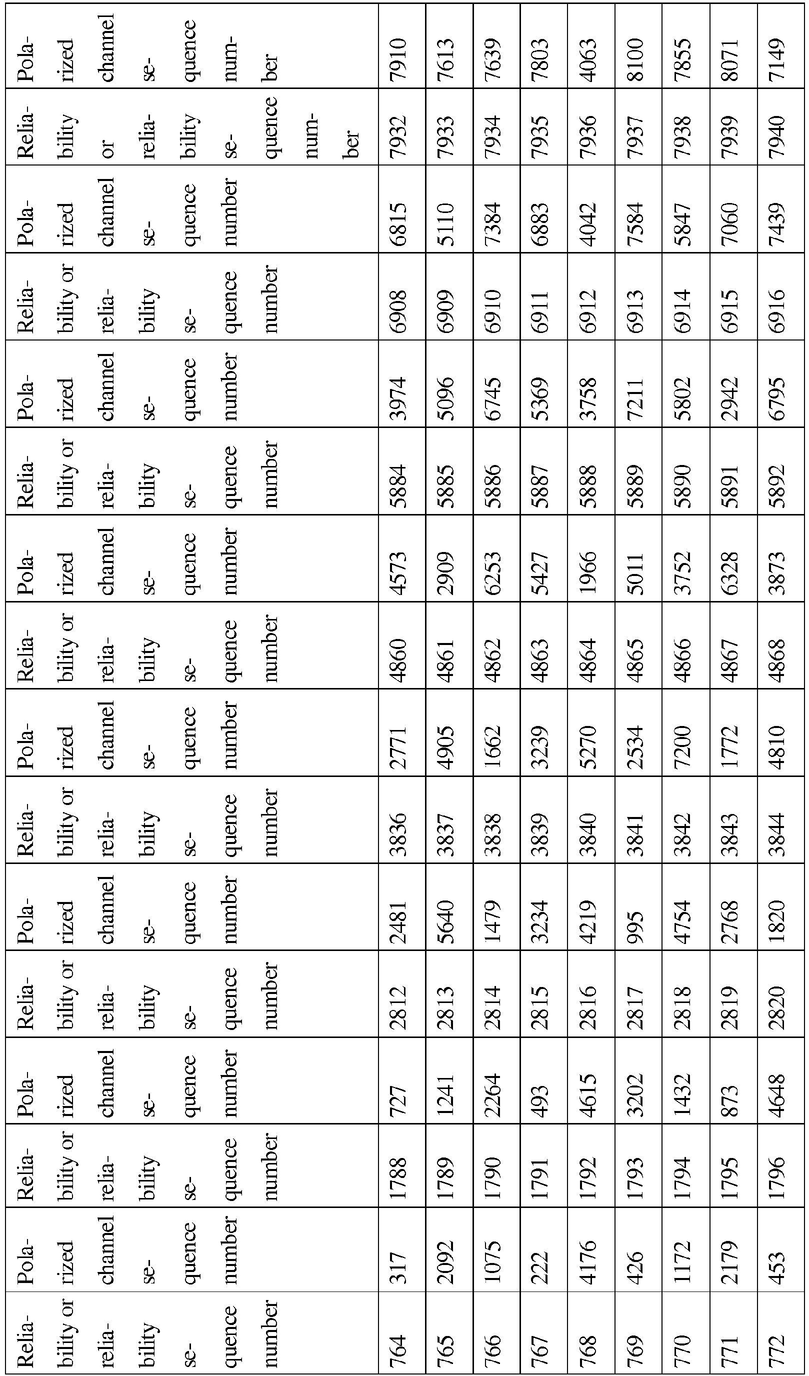 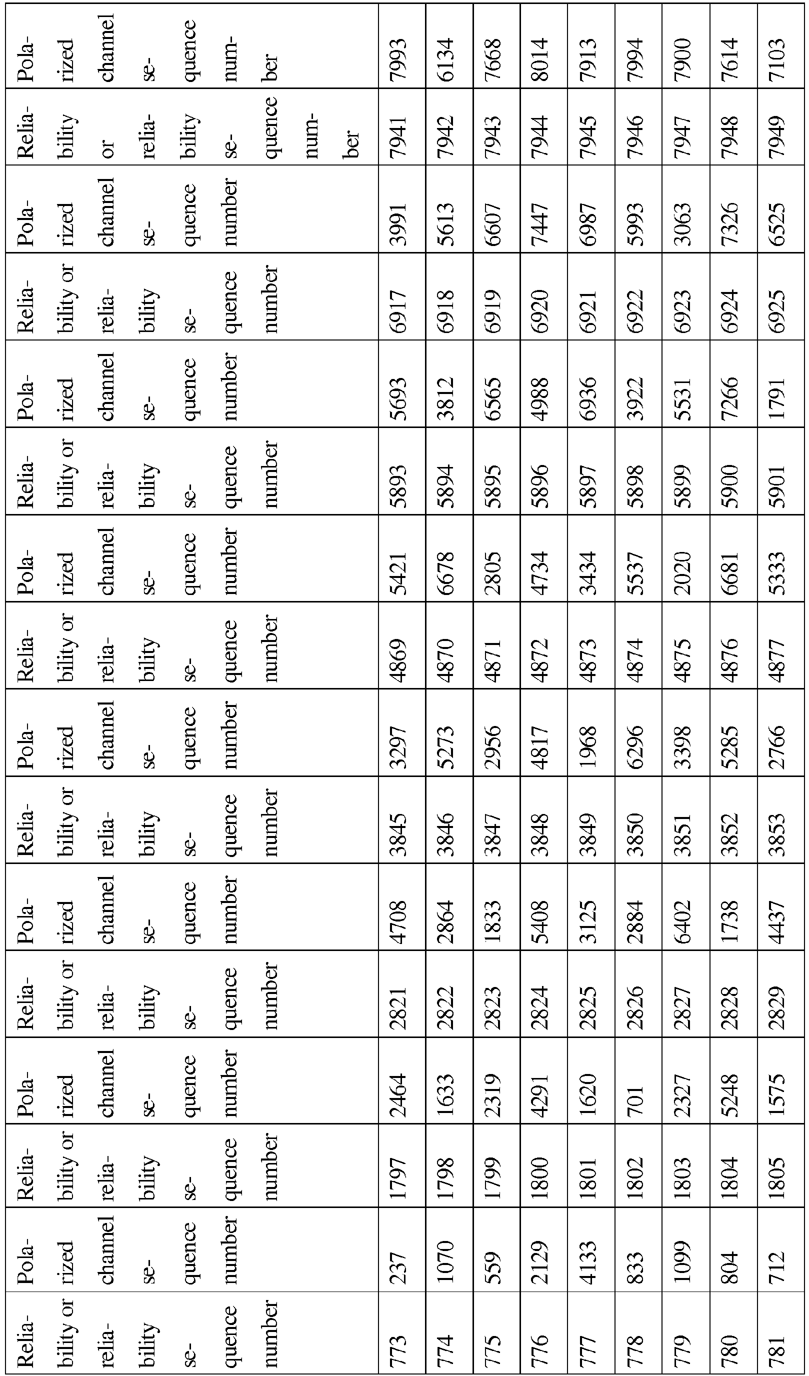 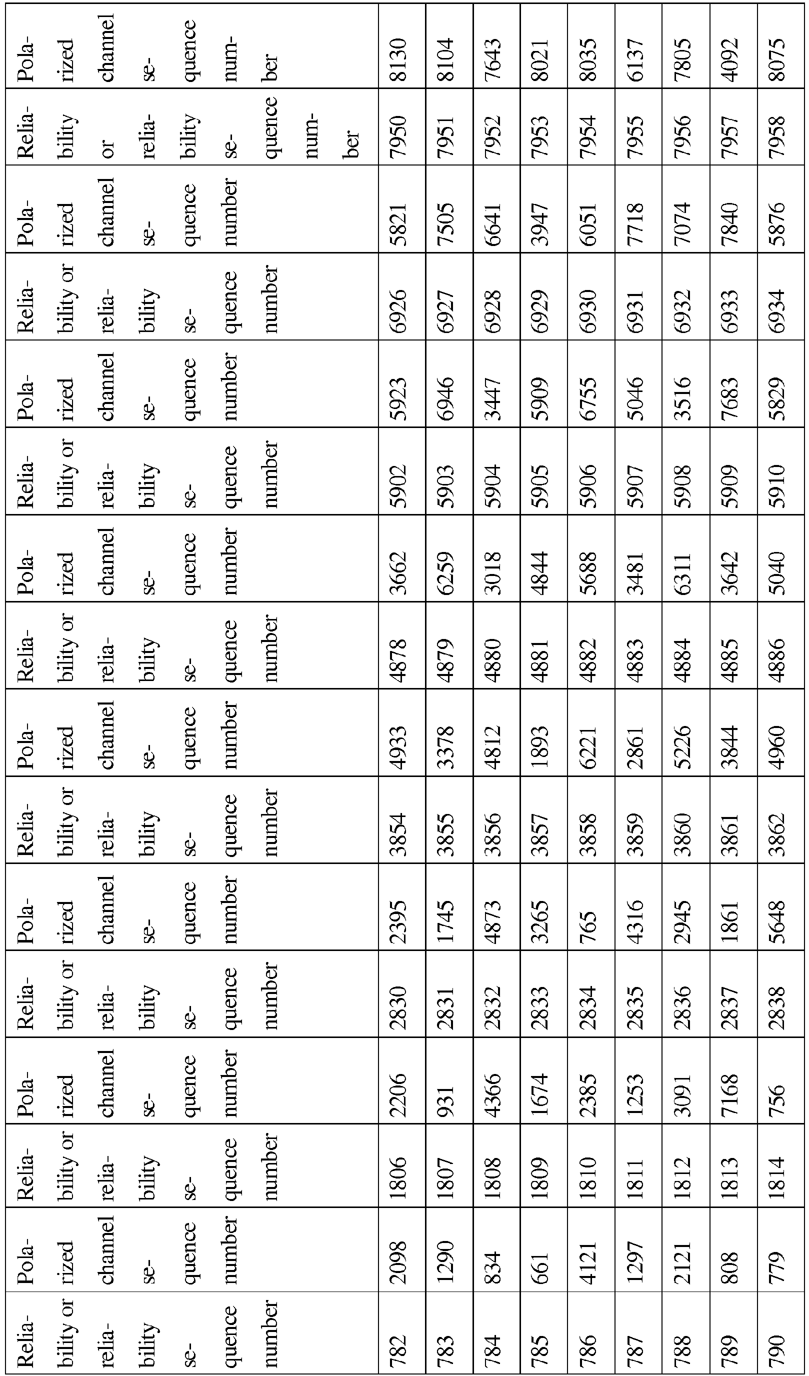 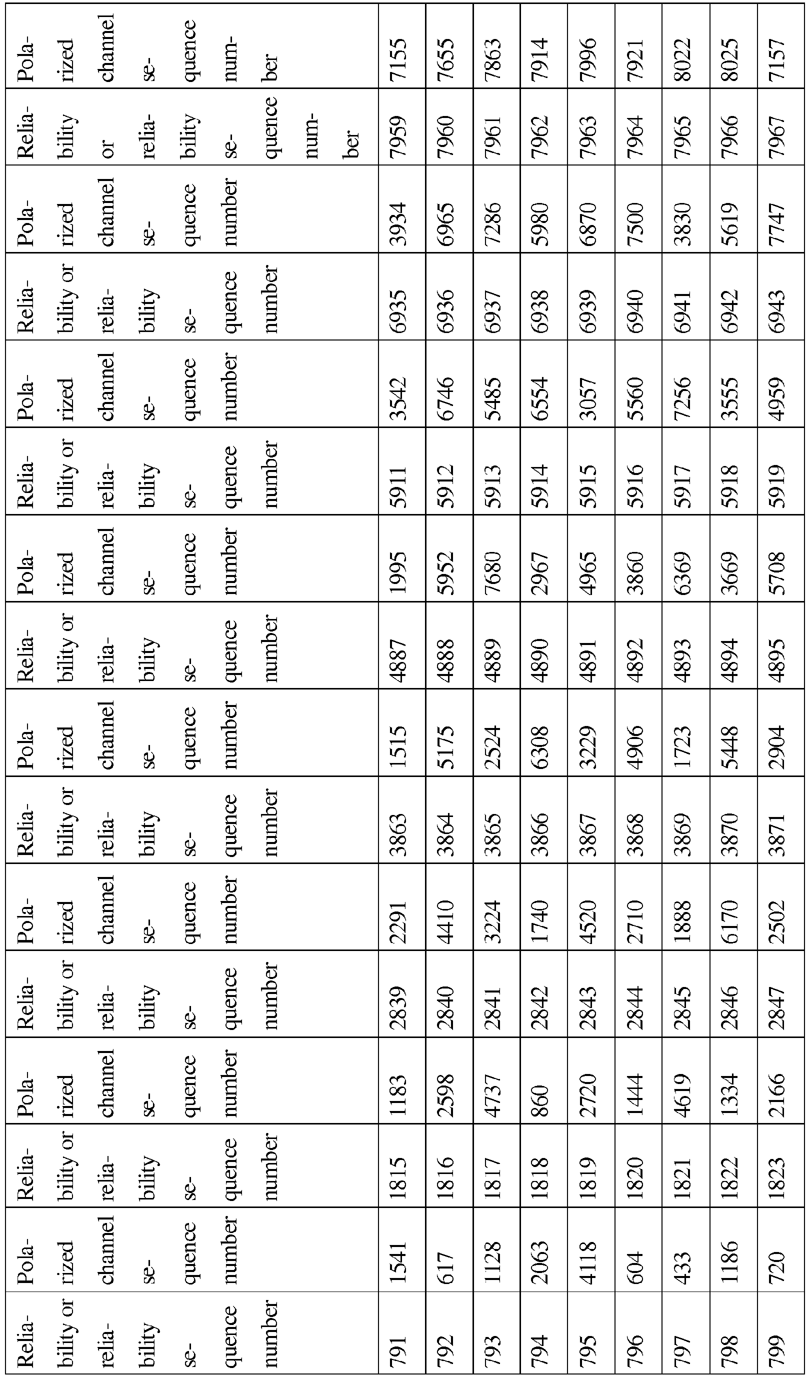 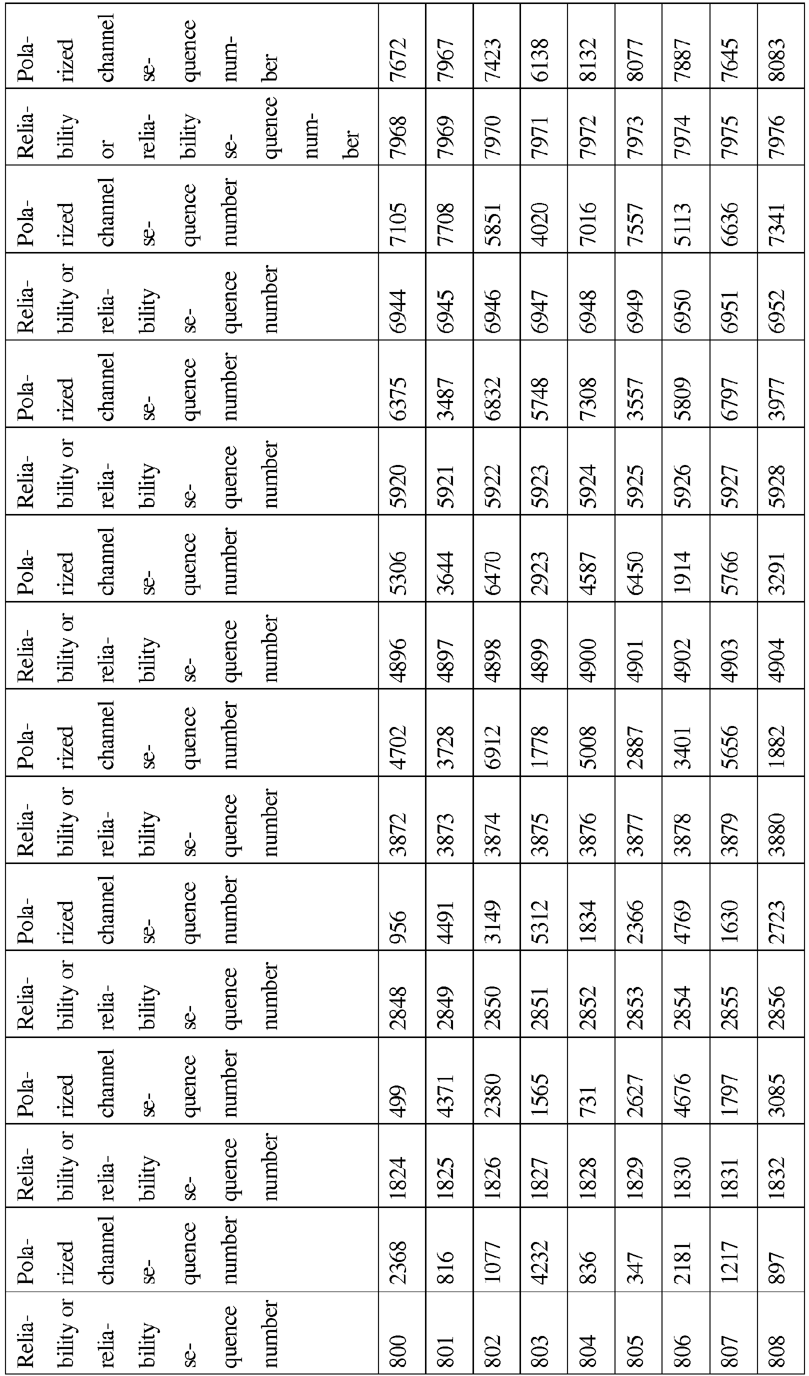 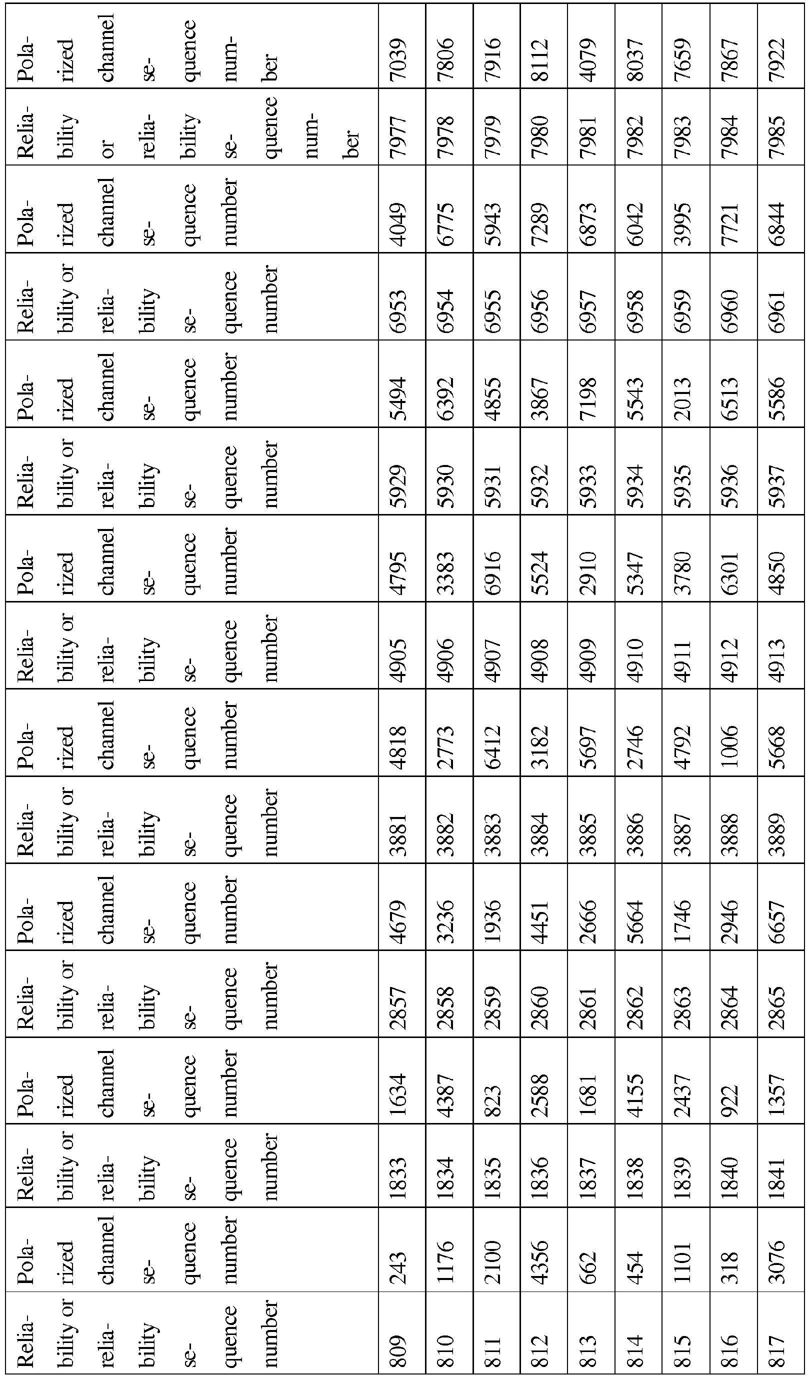 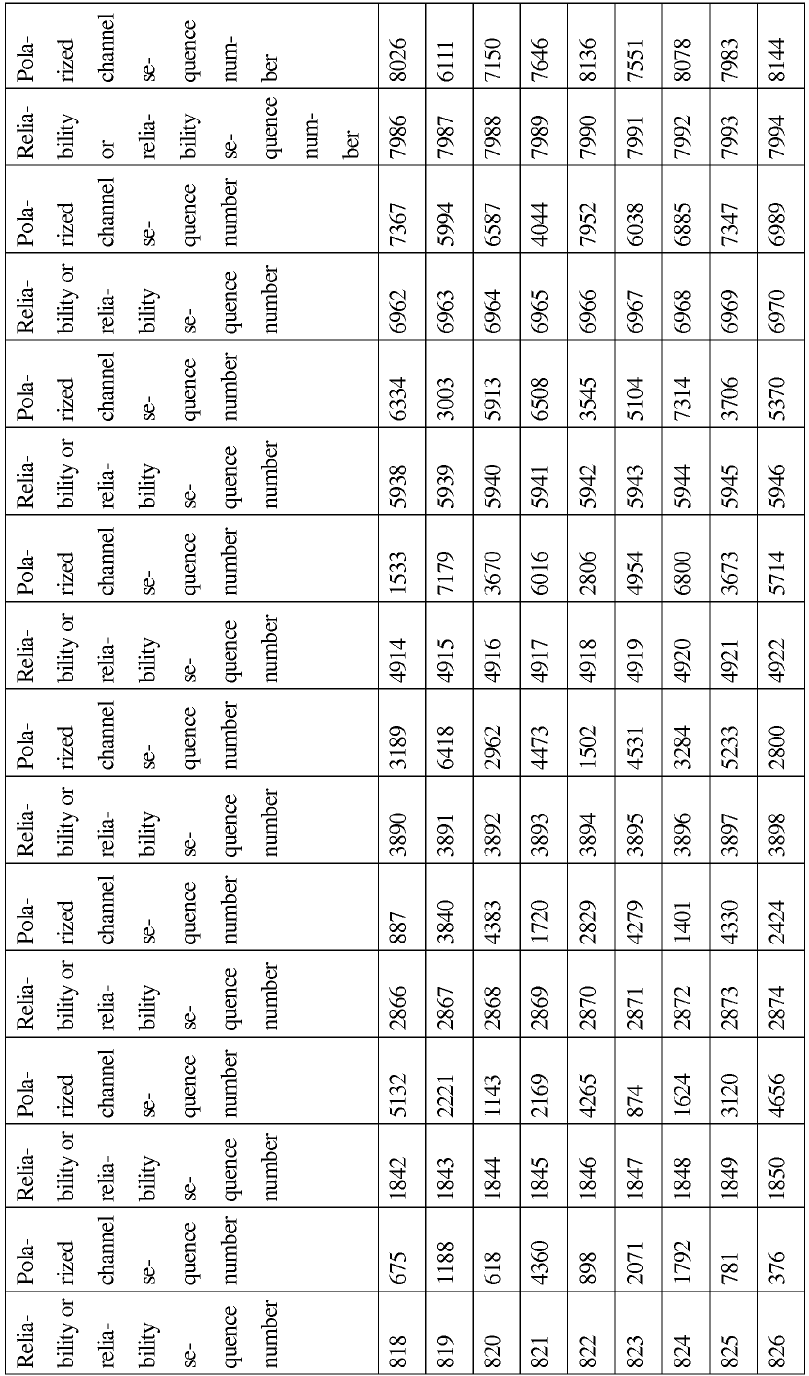 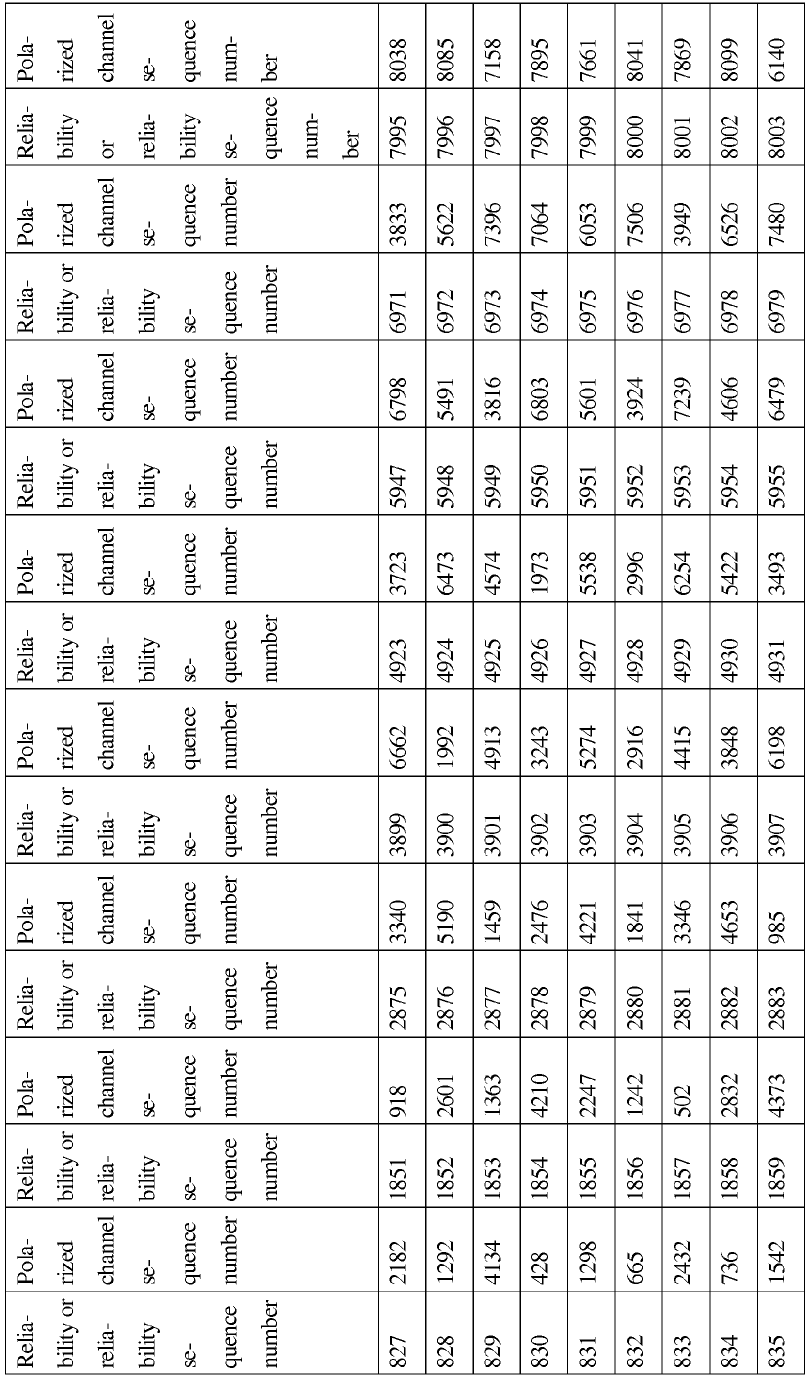 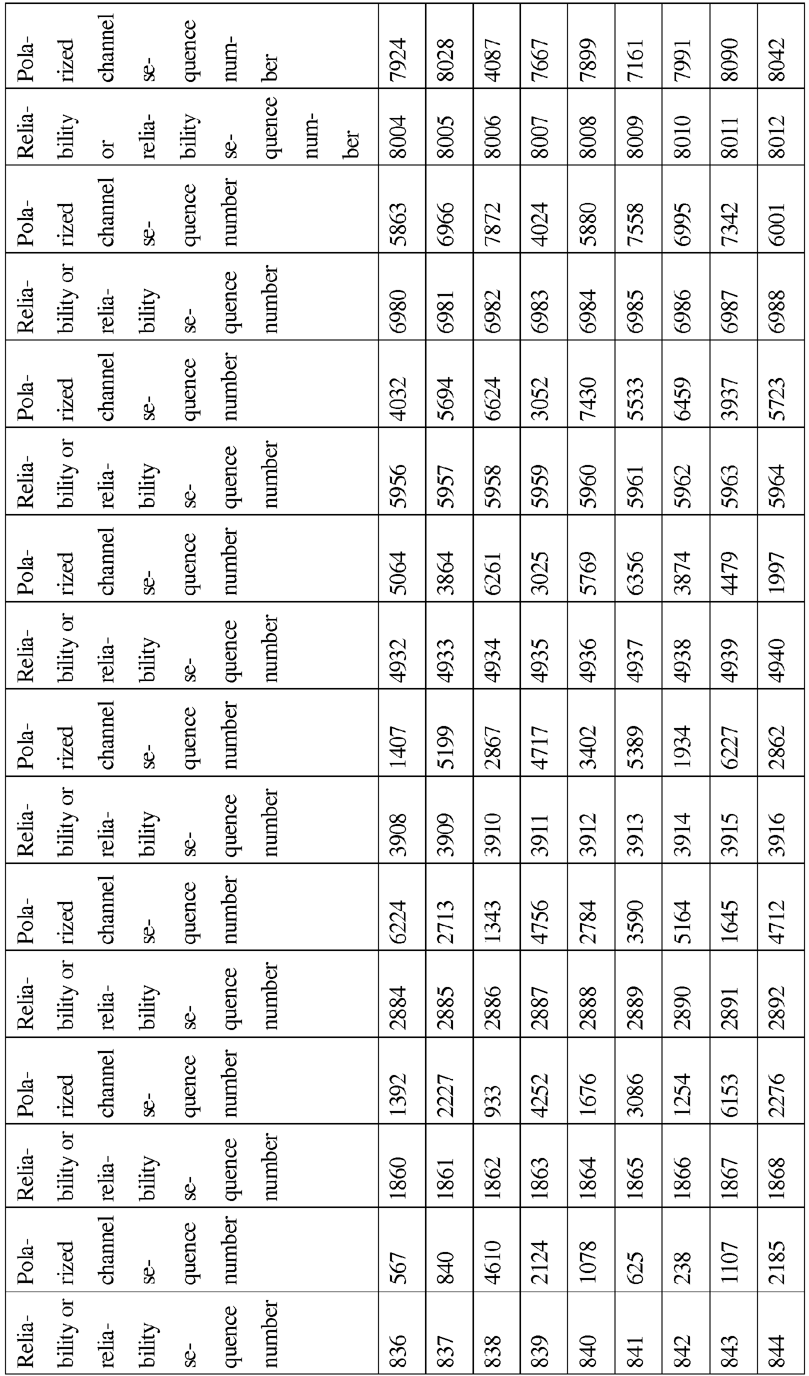 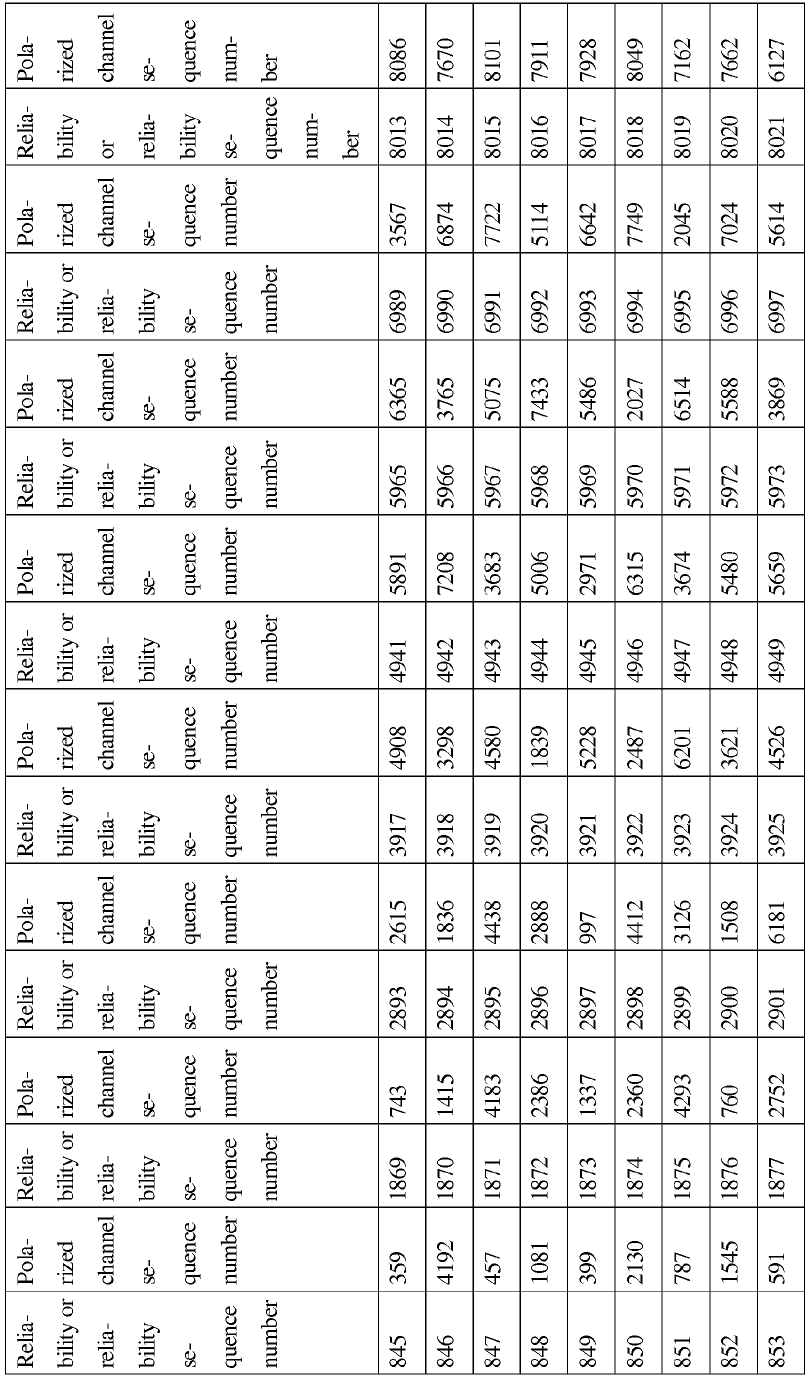 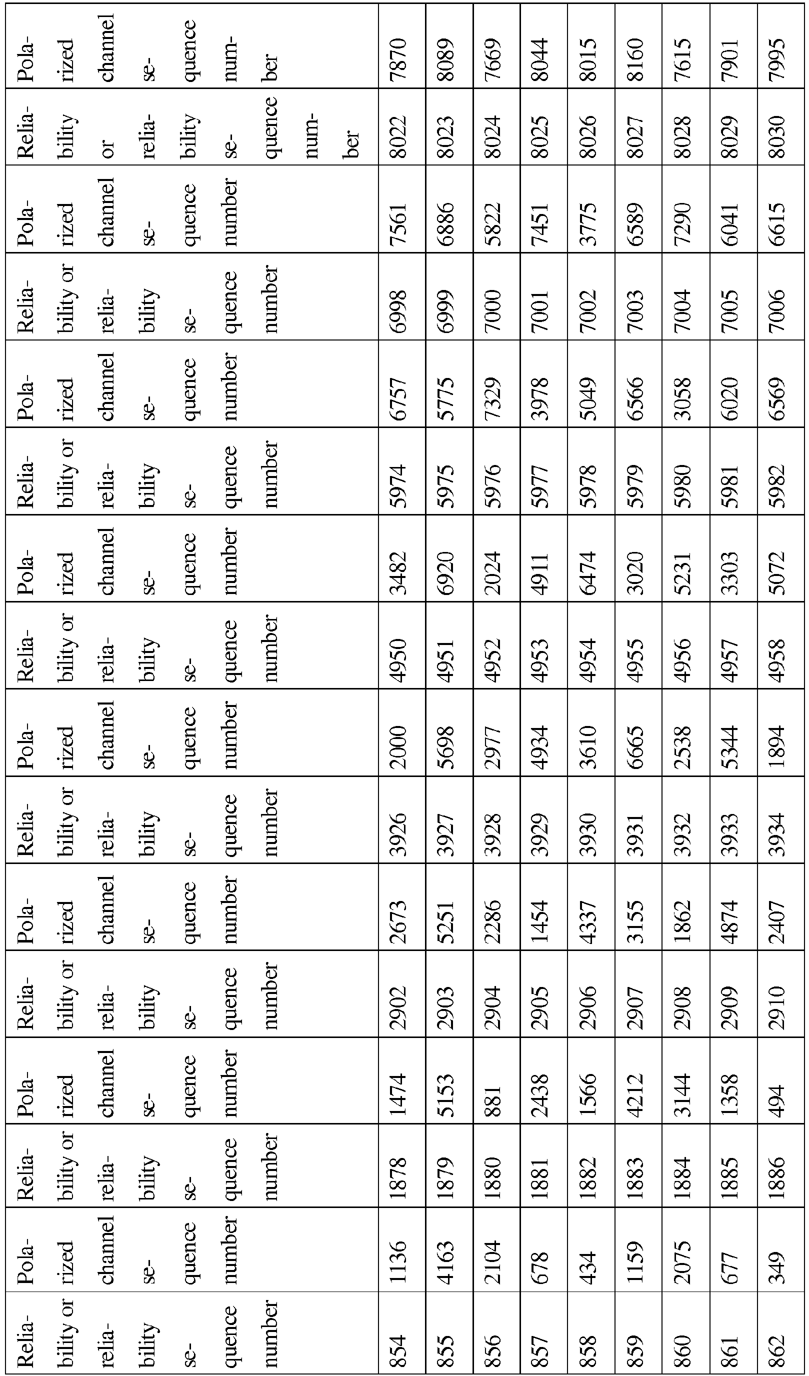 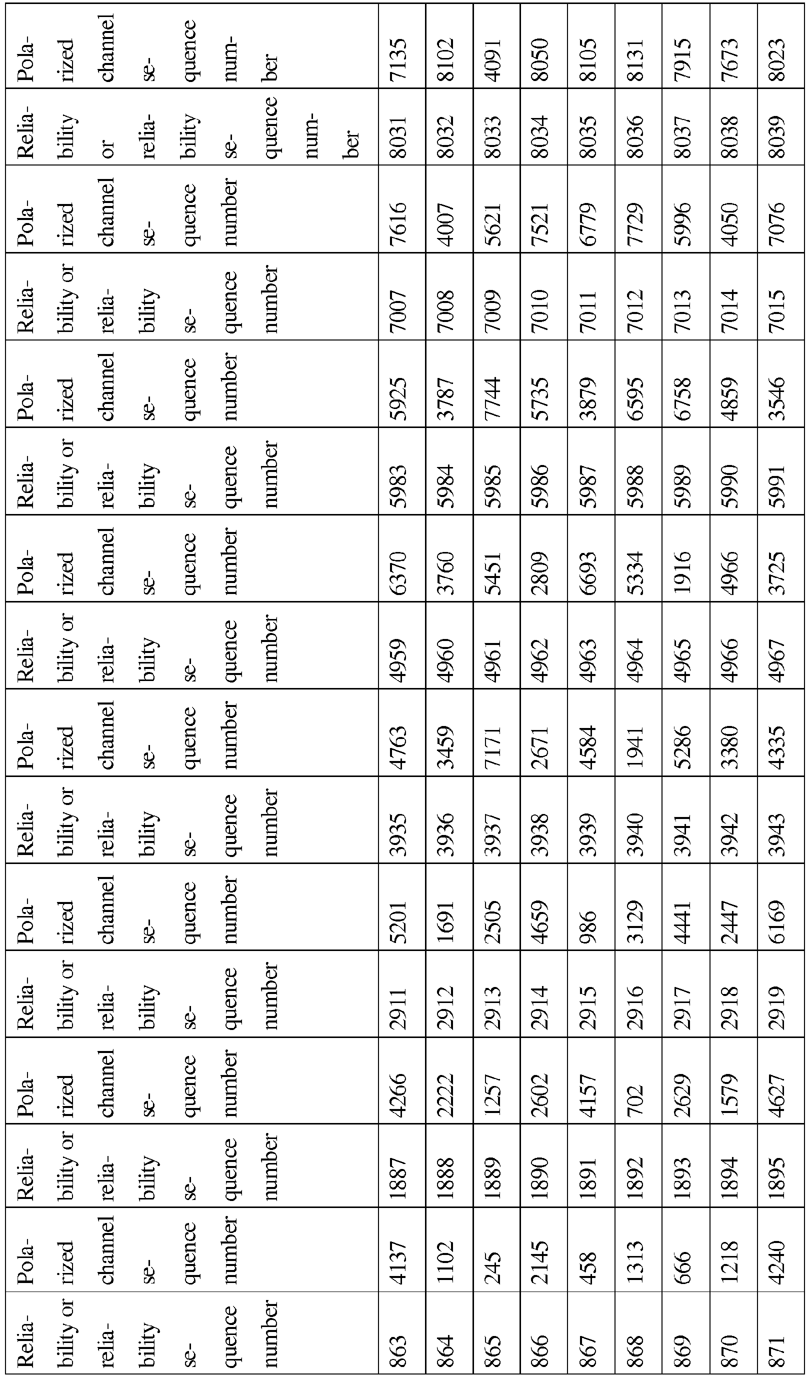 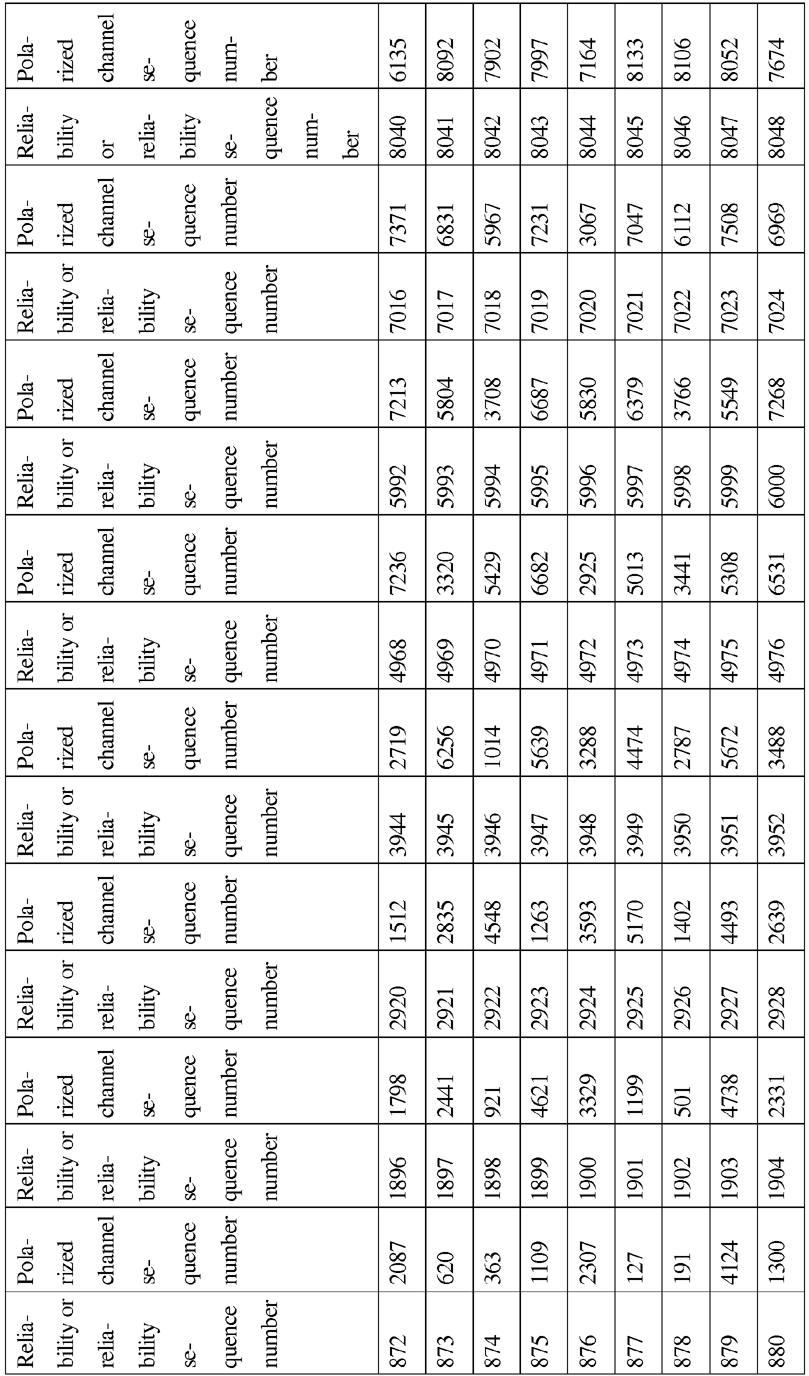 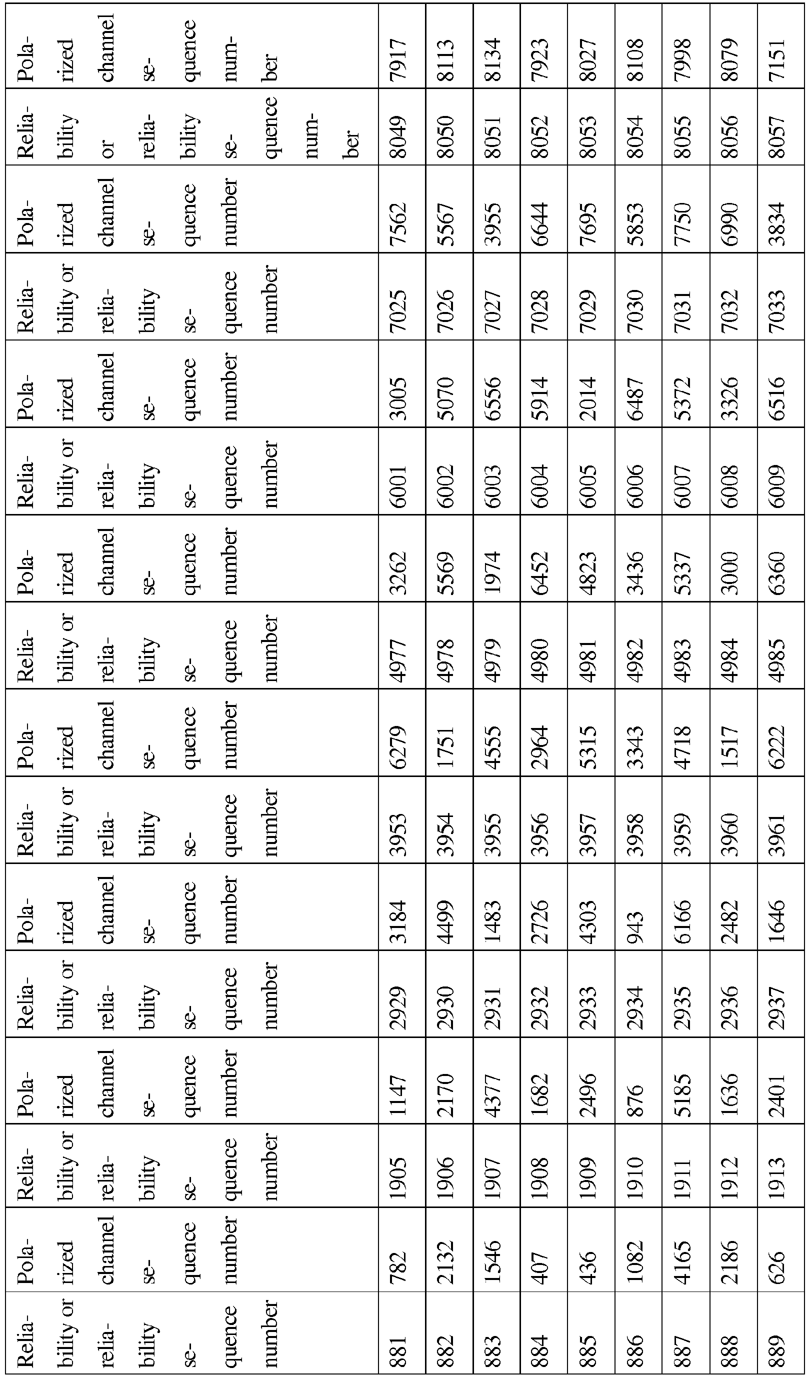 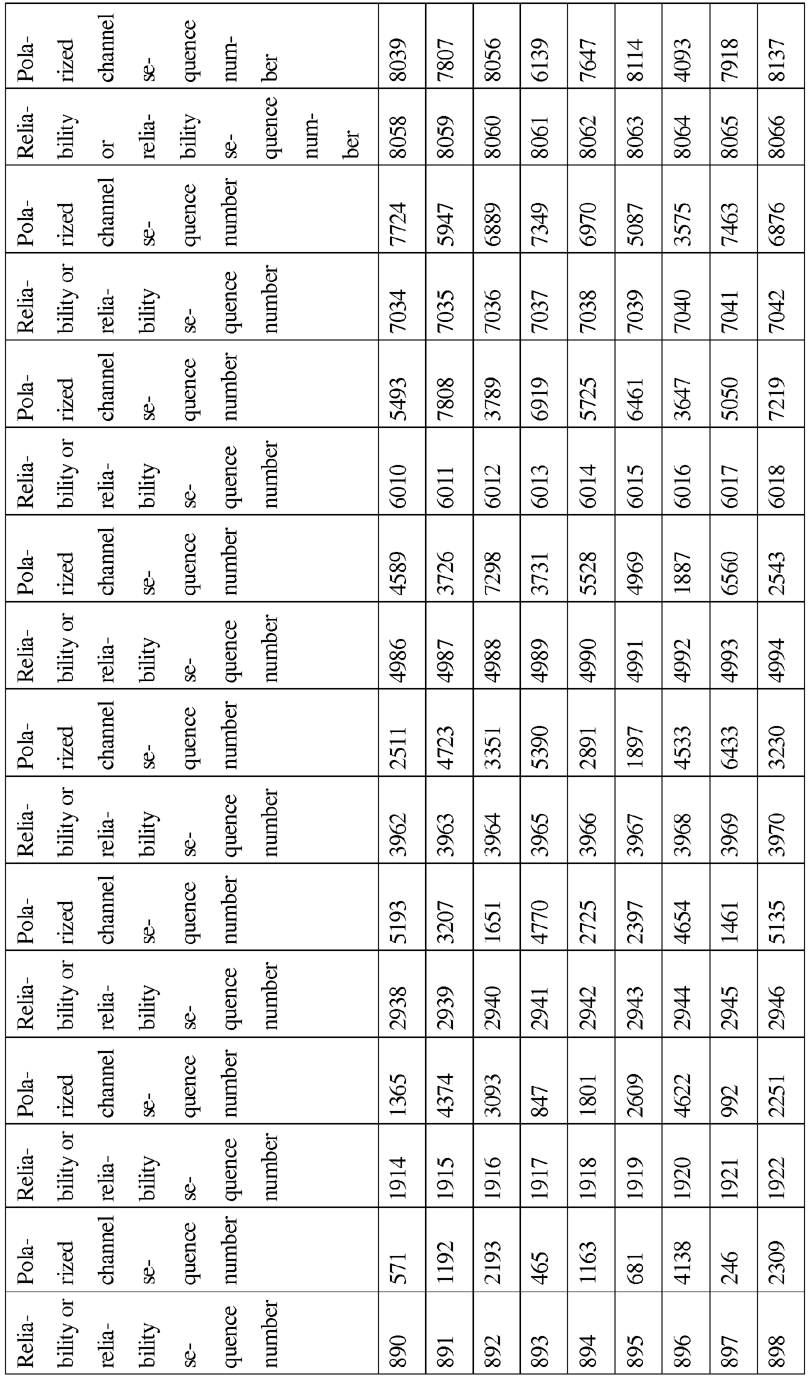 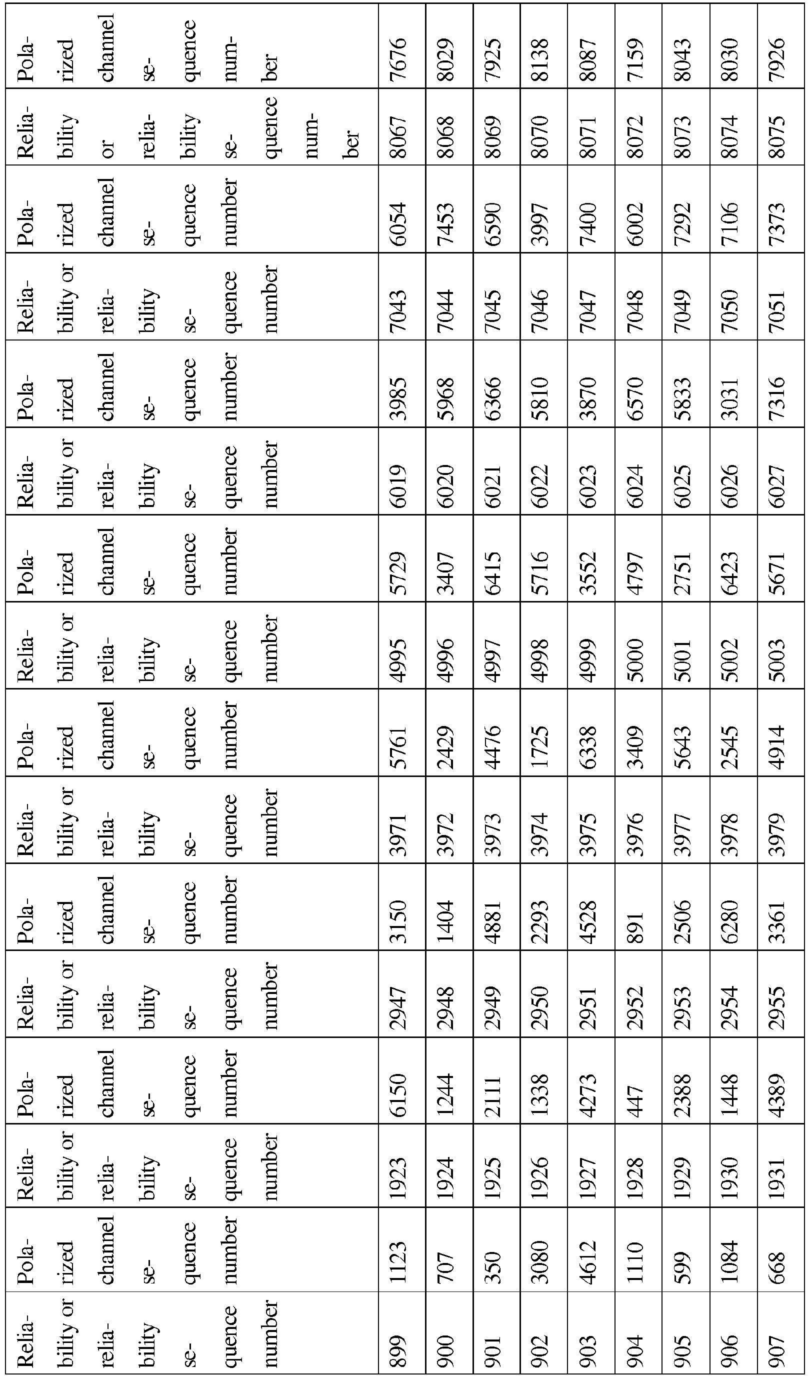 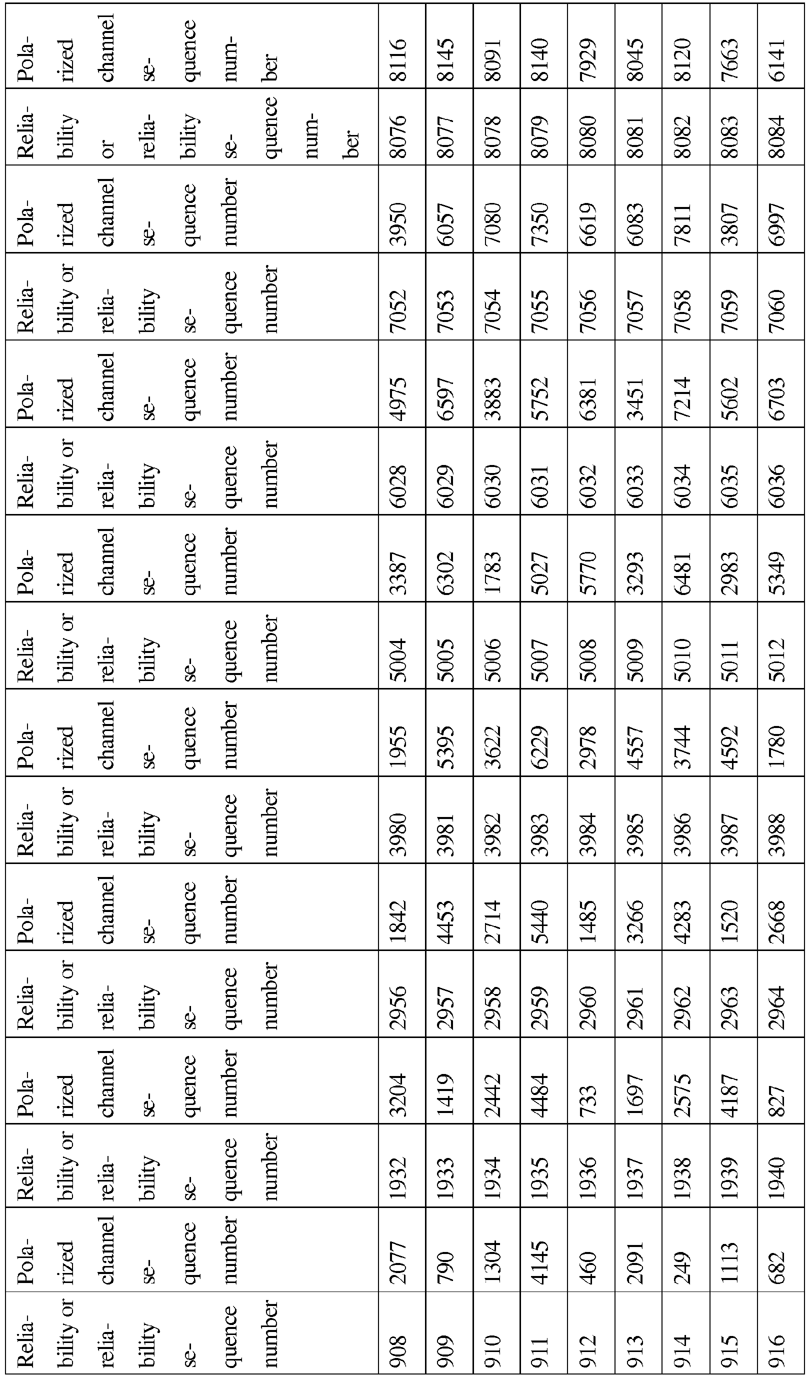 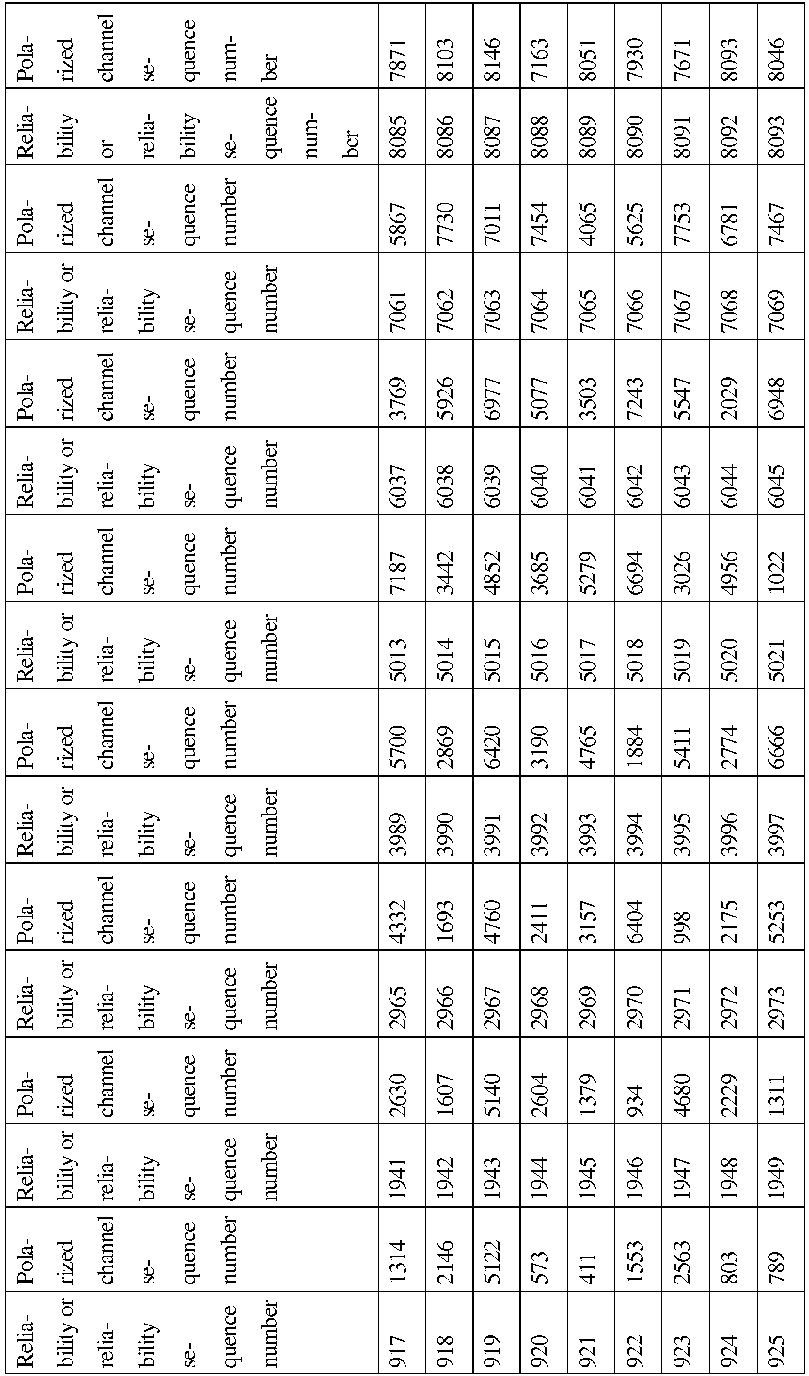 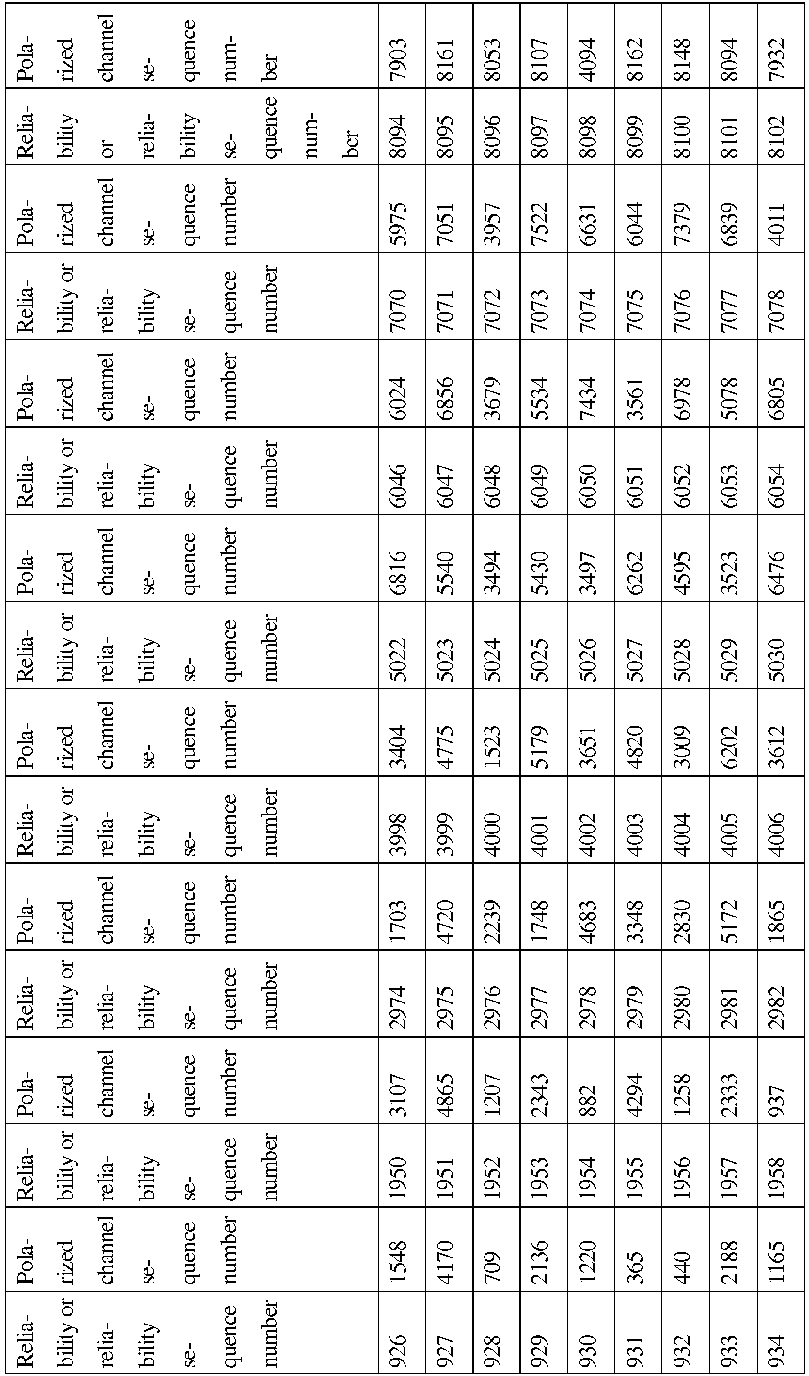 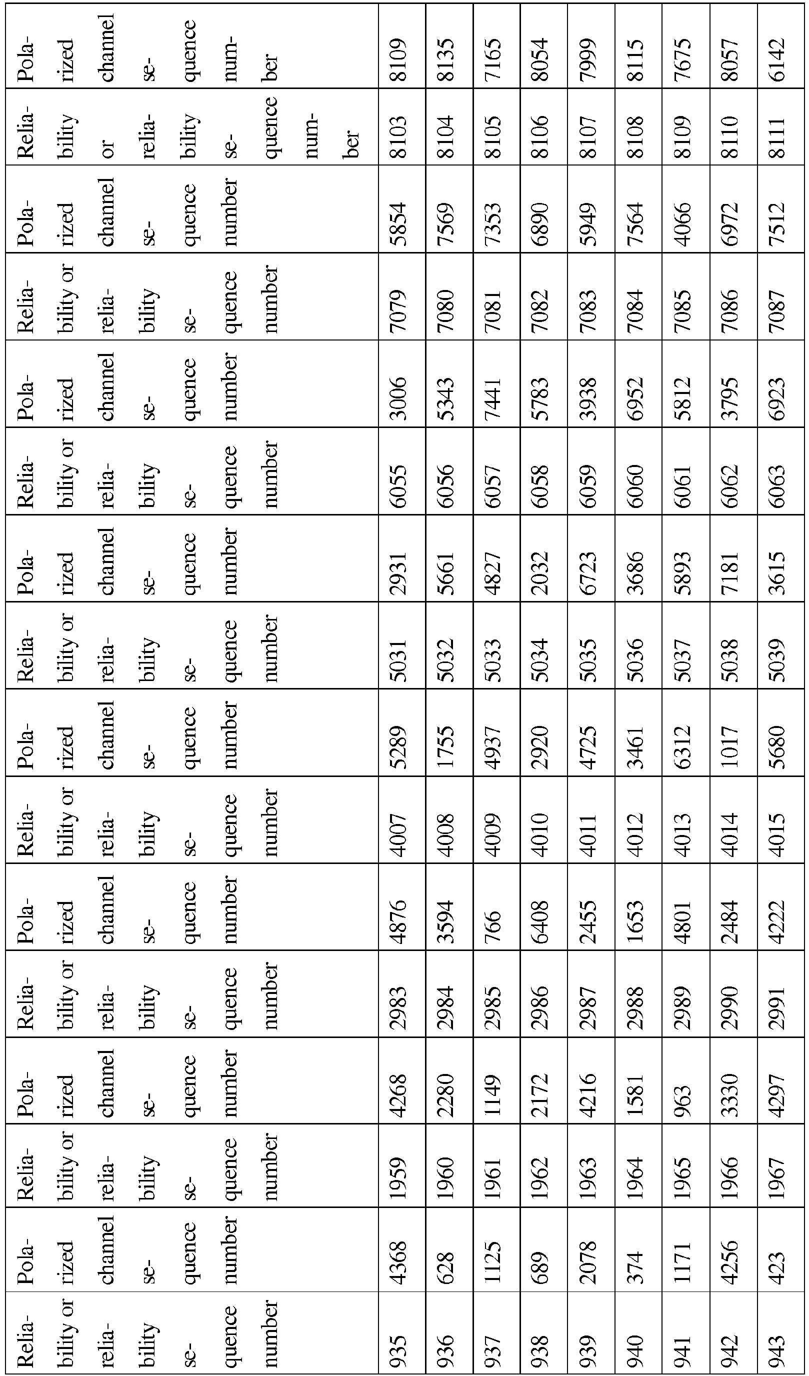 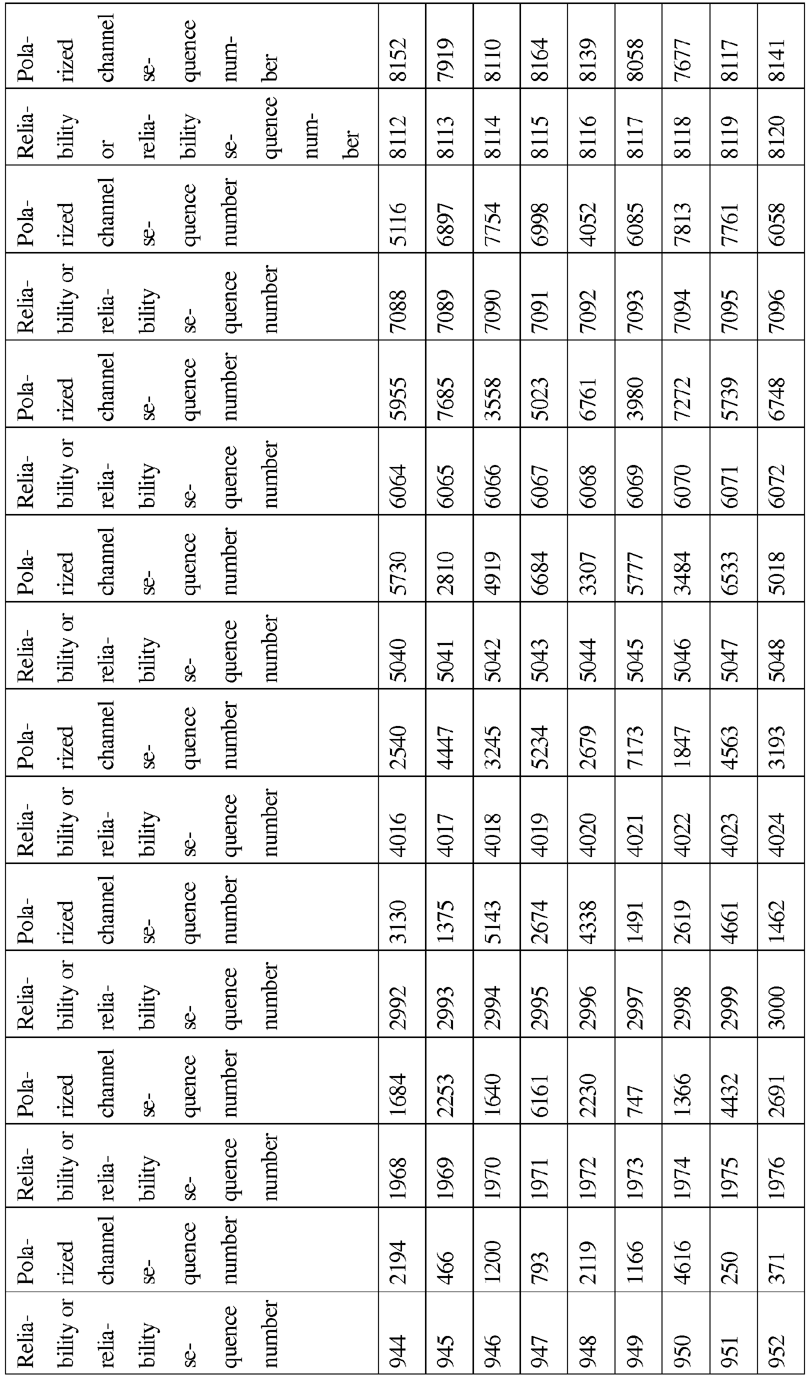 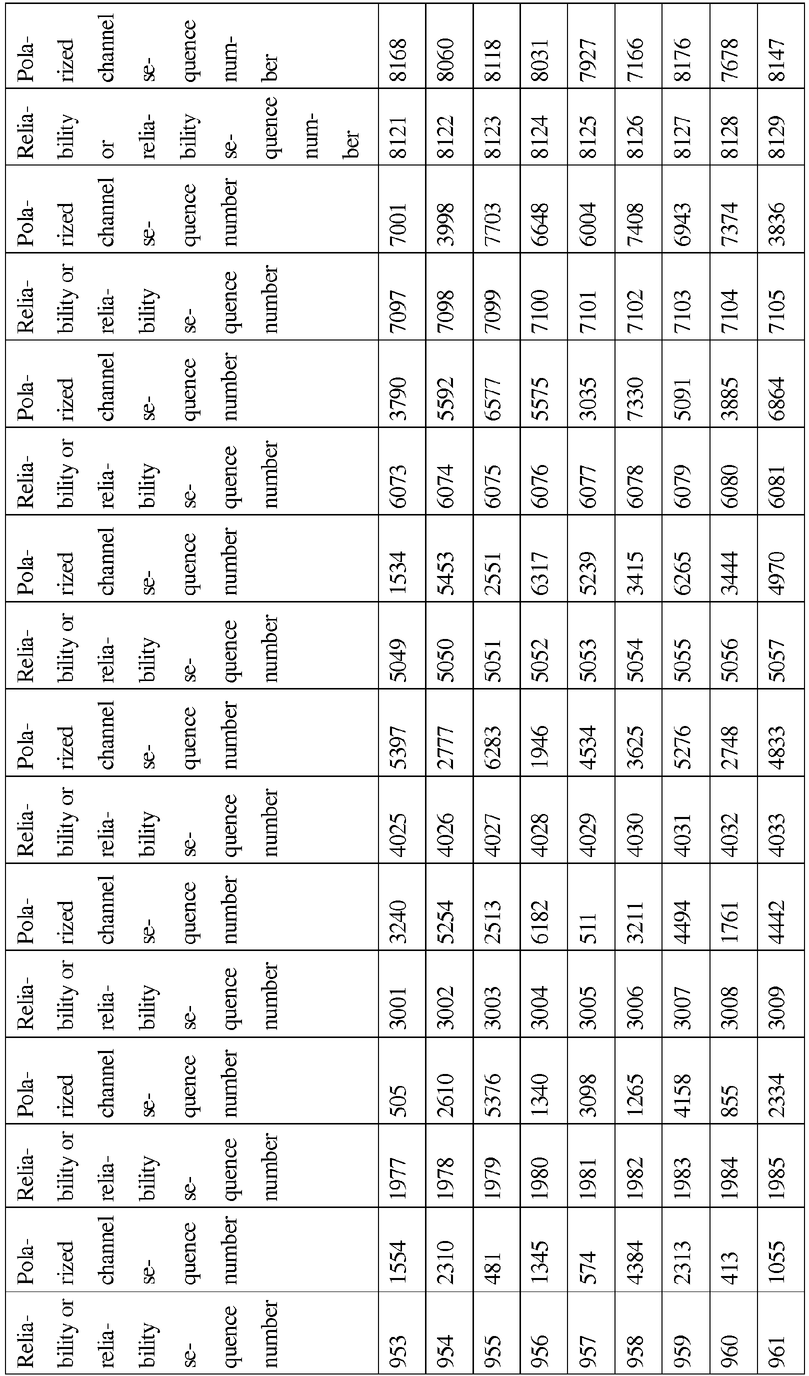 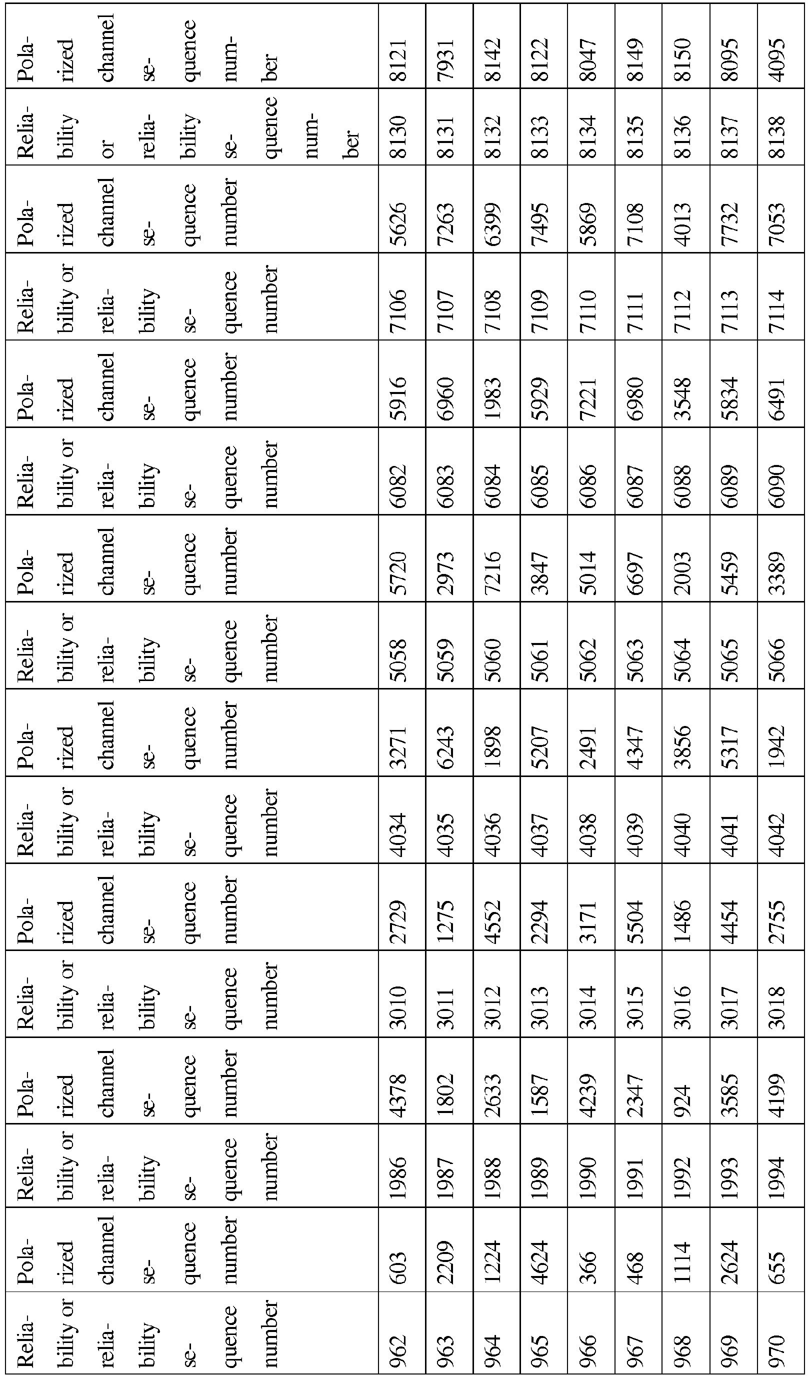 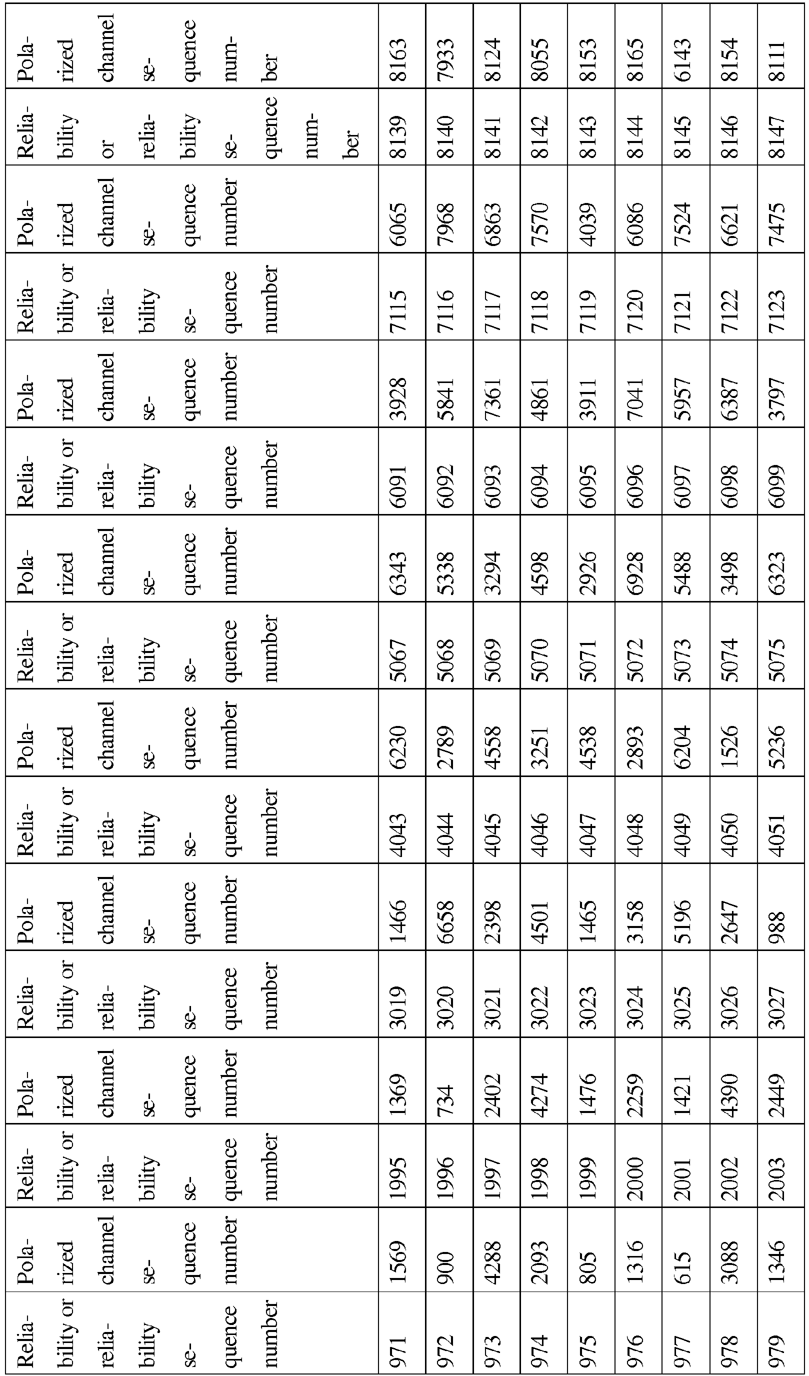 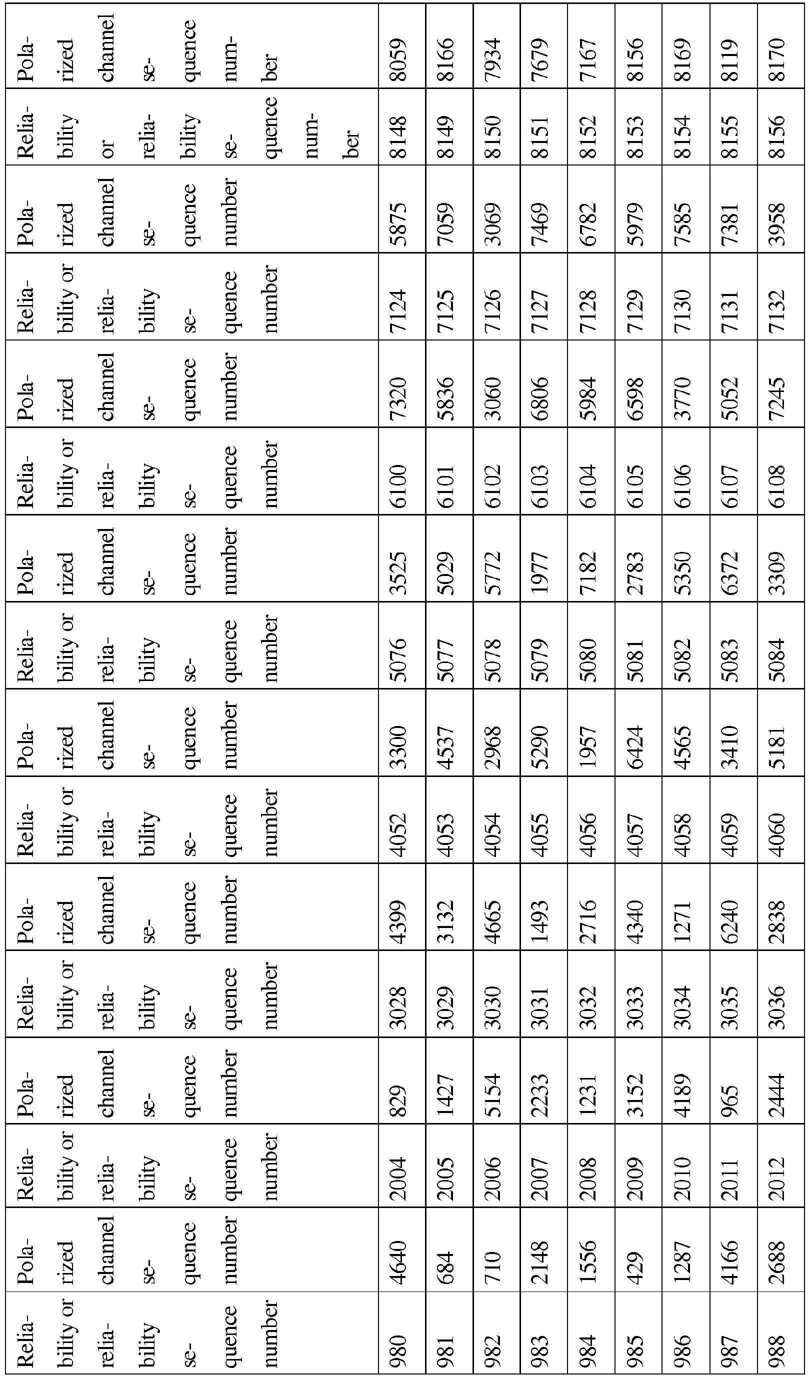 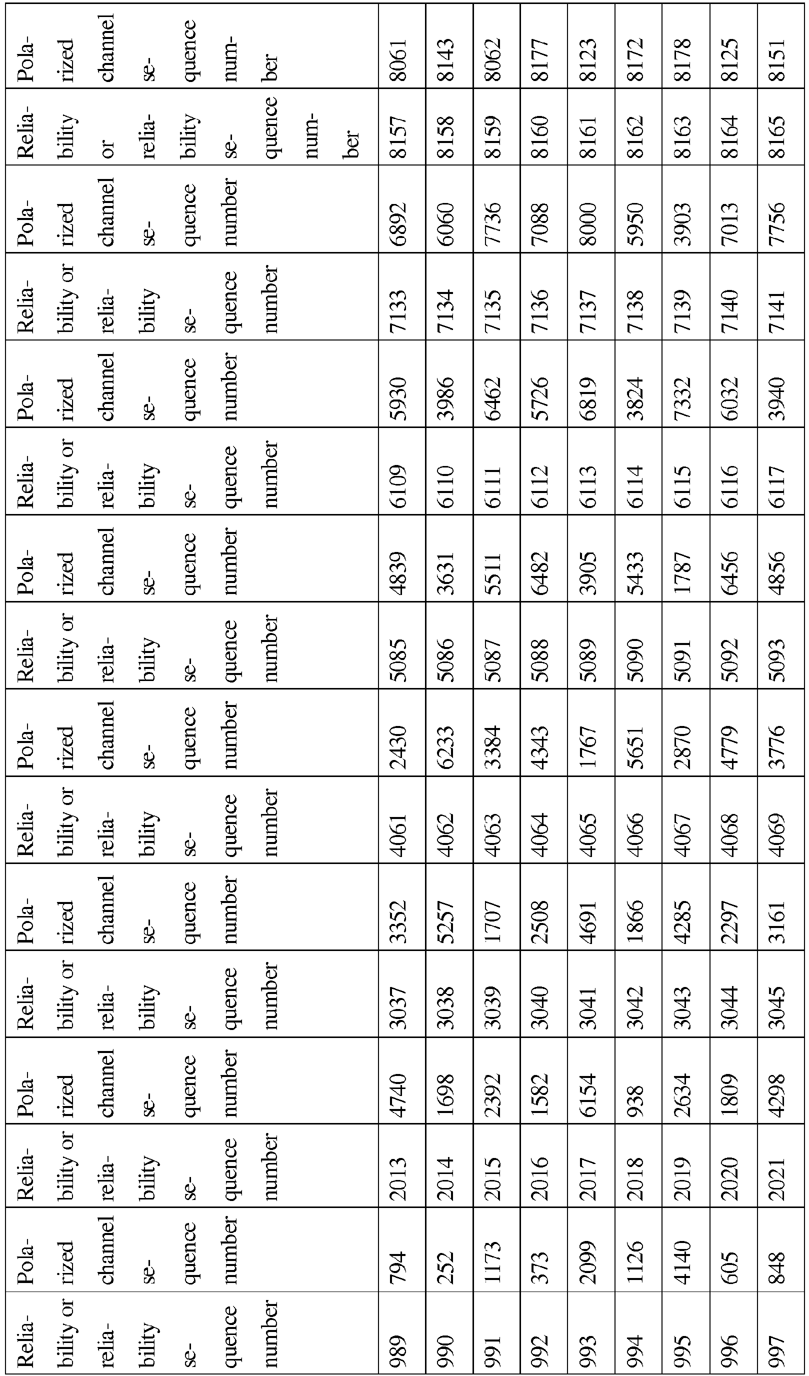 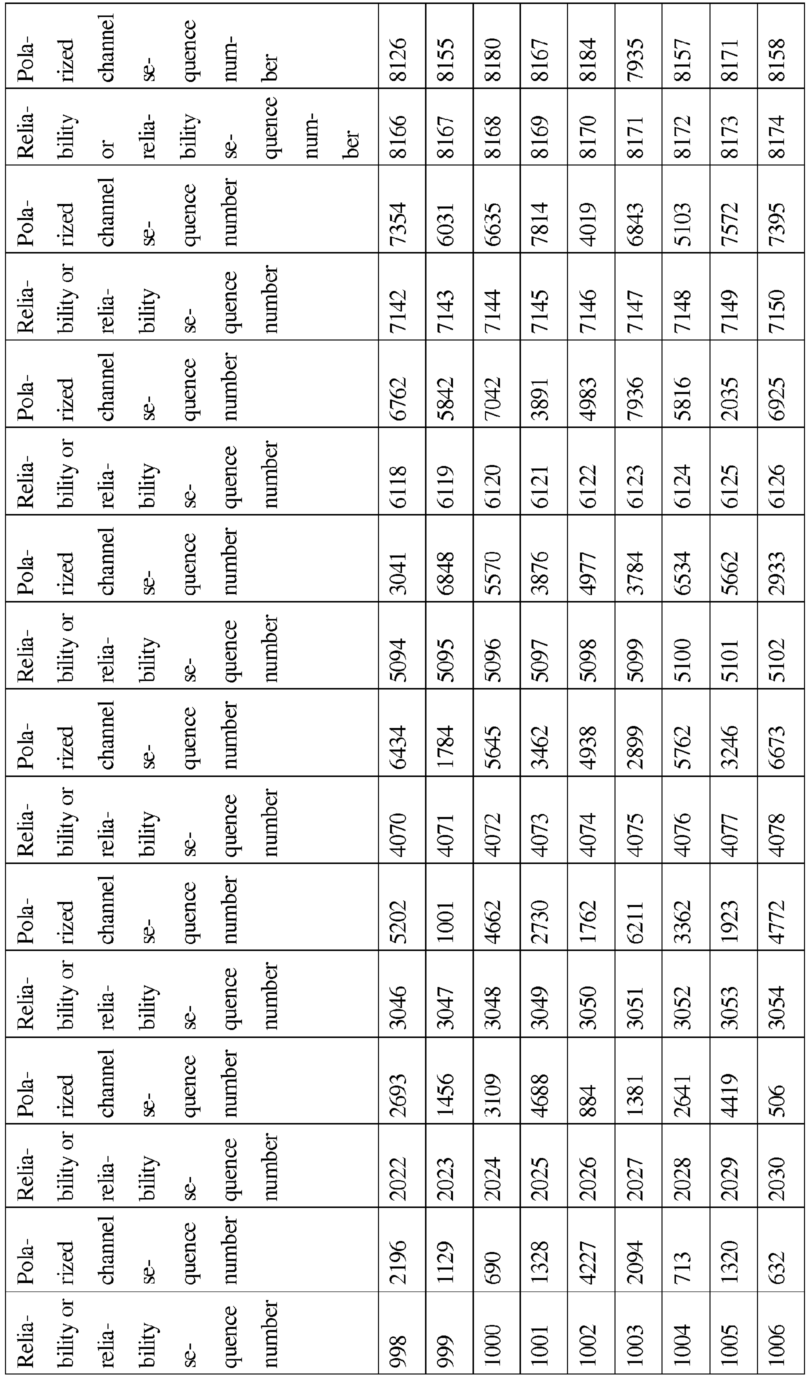 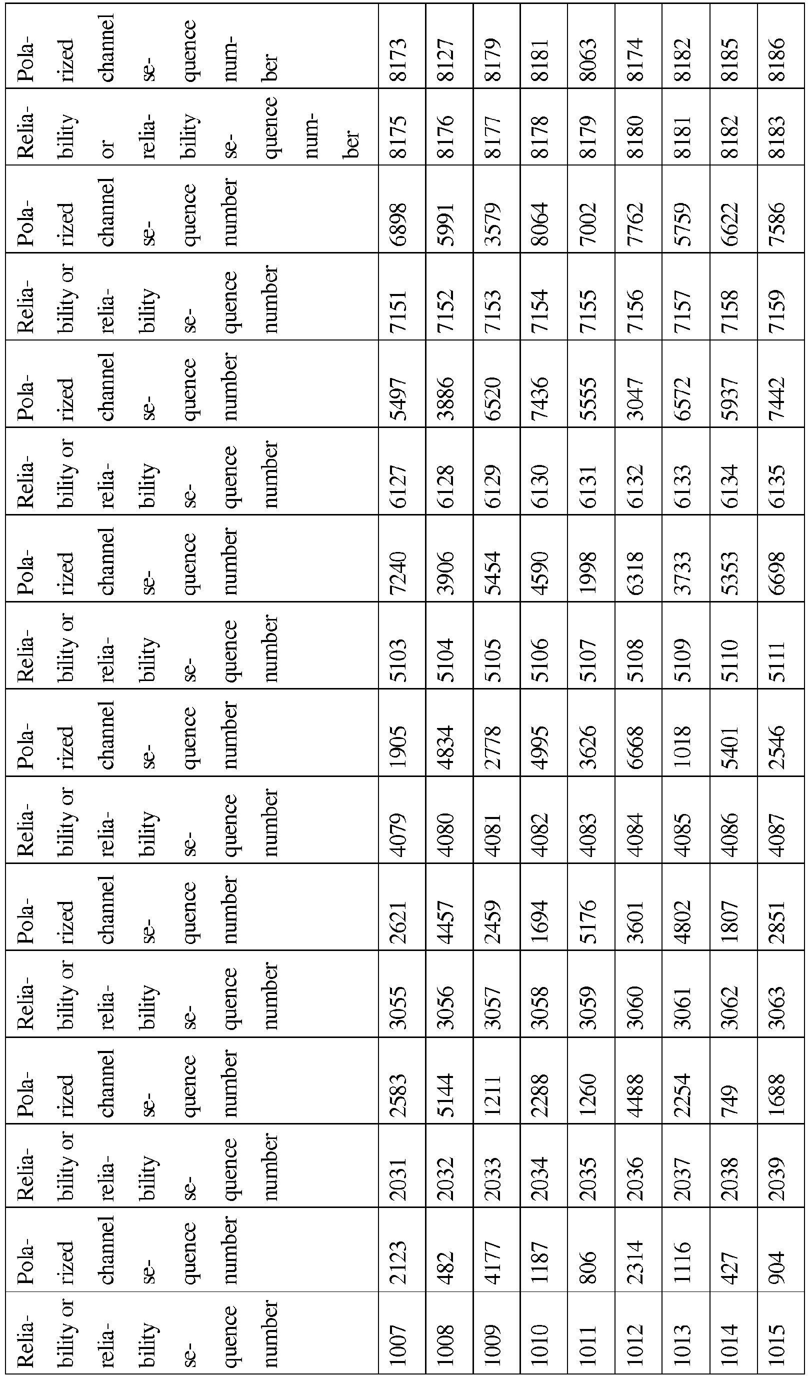 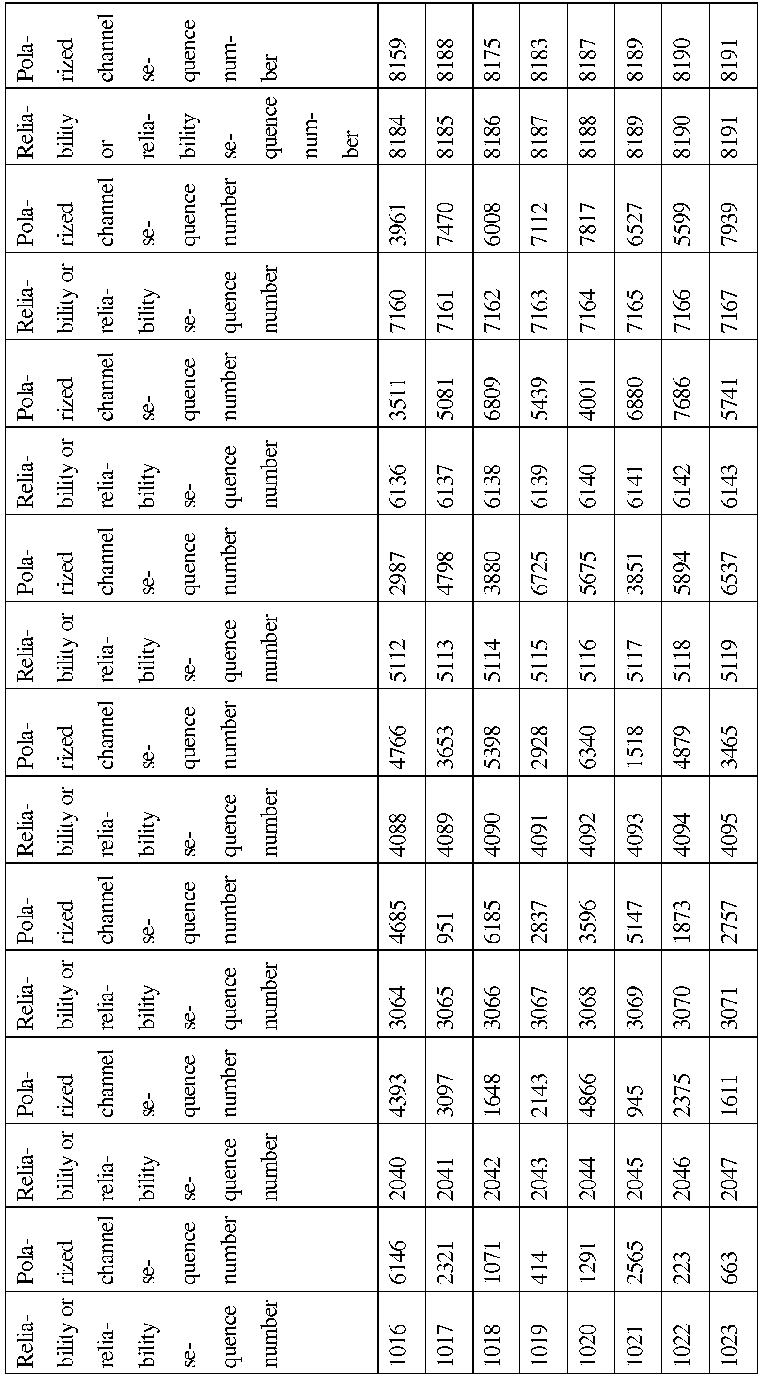
Sequence Q2, with a sequence length of 4096:
[0,1,2,4,8,16,32,3,5,64,1024,2048,9,6,17,10,18,128,12,33,65,20,256,34,24, 36,7,129,66,512,11,40,68,130,19,13,48,14,72,257,1025,21,132,35,258,26,2049,513,8 0,37,25,22,136,260,264,38,514,96,67,41,144,28,69,42,516,49,1026,74,272,160,520,2 88,528,192,544,70,44,131,81,2050,50,73,15,320,133,52,1028,23,134,384,76,137,82,5 6,27,97,39,259,84,138,145,261,1032,29,43,2052,98,515,88,140,30,146,71,262,265,16 1,576,45,1040,100,640,51,148,46,75,266,273,517,2056,104,162,53,193,1056,152,77, 164,768,268,274,518,54,83,57,521,1027,112,135,2064,78,289,194,85,276,522,58,168, 1029,139,99,86,60,280,89,290,529,2080,524,196,1088,141,101,147,176,142,530,321, 31,200,1033,90,545,292,2051,322,532,263,149,102,105,1030,304,296,163,92,47,267, 385,546,2053,324,1041,208,386,150,153,165,106,55,1034,328,536,577,548,2112,11 3,154,79,269,1042,108,578,224,166,519,552,195,1152,270,3072,641,523,275,580,29 1,59,1036,169,560,114,277,156,2057,87,197,1057,116,170,61,531,525,642,281,1089, 278,526,2054,177,293,388,91,1044,584,769,198,172,120,201,2065,336,1280,62,282, 143,103,178,294,1058,93,644,2058,202,592,323,1048,392,297,770,107,180,151,1060, 2066,209,284,648,94,204,298,1031,400,608,352,2176,325,533,1153,155,210,305,54 7,300,1090,109,2060,184,534,537,115,167,1536,225,326,306,772,2081,157,1035,656 ,329,110,117,212,1064,171,2113,776,330,226,549,1092,538,387,308,216,2068,1154,4 16,271,279,158,337,1043,550,672,2304,118,332,579,1037,540,389,173,121,1072,208 2,553,199,784,179,1038,228,338,312,2072,704,390,1096,174,554,581,393,1281,283, 2084,122,448,353,1045,561,203,63,340,2055,1156,394,527,582,556,181,1059,2177,2 95,285,232,124,1282,205,182,643,2114,562,1050,286,585,299,1537,354,211,2560,40 1,185,1104,396,344,586,645,2059,1061,593,535,240,206,1049,95,2088,327,564,1046, 800,402,356,307,2116,1160,301,417,213,568,1284,832,2178,588,186,1288,646,404, 227,896,2067,1062,594,418,302,1538,649,771,2061,360,539,1120,111,331,214,1091, 2096,309,188,449,1065,217,408,2062,609,596,1168,551,650,229,1052,2120,159,420, 310,1093,541,773,2305,610,1066,657,333,119,1540,3073,600,339,218,1073,368,652, 230,2069,1098,391,313,450,1296,542,2180,334,233,1184,555,774,175,2083,1544,12 3,658,612,1312,2306,341,777,220,1552,314,424,2074,395,1216,673,583,355,1568,25 61,287,183,234,1094,125,557,2128,660,1068,616,342,316,2085,1155,241,778,1105,5 63,345,2073,452,1074,397,403,207,2070,1097,674,558,1039,785,432,2184,357,1344, 187,236,664,2308,1157,624,587,1076,780,2312,705,126,1047,242,565,1158,2086,39 8,346,456,1408,358,2562,405,1100,303,569,244,2144,1161,595,189,1106,566,2115,6 76,361,1080,706,589,2089,1051,215,786,647,1121,2192,348,419,1063,406,464,2076, 680,1283,801,362,1108,2117,590,409,1162,570,2090,788,597,1169,572,219,2564,128 5,311,708,1053,598,2097,601,1067,651,421,3074,792,1122,802,611,1539,2122,602,4 10,1112,231,688,2320,1164,653,248,1054,2208,369,190,364,1170,654,2568,659,1095, 335,480,2336,1286,315,221,1289,2576,370,613,1185,422,425,2240,1600,451,614,10 69,2592,543,235,1124,412,2118,343,372,1664,775,317,2092,1075,222,426,1172,217 9,453,237,1070,559,2129,833,1099,804,712,2098,1290,834,661,1297,2121,808,779,1 541,617,1128,2063,604,433, 1186,720,2368,816, 1077,836,347,2181, 1217,897,243,11 76,2100,662,454,1101,318,3076,675,1188,618,898,2071,1792,781,376,2182,1292,42 8,1298,665,2432,736,1542,567,840,2124,1078,625,238,1107,2185,359,457,1081,399, 2130,787,1545,591,1136,2104,678,434,1159,2075,677,349,1102,245,2145,458,1313, 666,1218,2087,620,363,1109,2307,127,191,1300,782,2132,1546,407,436,1082,2186, 626,571,1192,2193,465,1163,681,246,2309,1123,707,350,3080,1110,599,1084,668,20 77,790,1304,460,2091,249,1113,682,1314,2146,573,411,1553,2563,803,789,1548,70 9,2136,1220,365,440,2188,1165,628,1125,689,2078,374,1171,423,2194,466,1200,79 3,2119,1166,250,371,1554,2310,481,1345,574,2313,413,1055,603,2209,1224,366,46 8,1114,2624,655,1569,900,2093,805,1316,615,3088,1346,684,710,2148,1556,429,12 87,2688,794,252,1173,373,2099,1126,605,848,2196,1129,690,1328,2094,713,1320,6 32,2123,482,1187,806,2314,1116,427,904,2321,1071,414,1291,2565,223,663,1409,2 152,692,1570,835,2210,1348,619,472,2101,1232,455,1410,2241,796,809,1174,3104, 714,1177,721,2200,1189,837,716,2125,1130,864,1079,2212,810,1352,606,2816,912, 1560,722,2316,1601,696,1572,2322,377,435,1137,2566,817,1178,319,2102,1103,621, 1293,2131,812,484,1132,2105,430,1602,838,2569,1248,667,3075,488,1190,239,216 0,1543,378,1576,2183,459,1219,622,2126,627,1294,437,2337,1665,380,2242,1547,8 18,1299,2133,461,496,1604,2324,669,1315,2570,679,1083,724,2106,1193,841,629,2 216,1584,351,1138,3077,467,1301,2187,438,1180,737,2147,1111,251,1221,2134,462, 442,2108,1140,441,1194,2328,469,1085,2137,247,1555,683,2338,1549,842,1666,257 7,738,899,2572,1305,670,1302,2244,783,1550,3136,849,1201,820,2189,1317,728,21 49,1412,928,1115,2195,791,367,2224,1608,901,1793,2190,630,1222,2578,685,1196, 844,2369,1144,633,2079,1225,711,1360,2248,253,1086,3081,691,1306,824,2138,116 7,902,2593,1127,686,740,2340,1202,850,2370,1318,375,2580,1117,444,1668,2311,47 0,1226,2197,483,1616,415,2150,1347,485,2153,1416,905,3078,1321,795,1794,2352, 473,1131,2344,634,1204,2211,744,1175,852,2140,1233,960,2095,1308,865,2315,167 2,693,2433,1118,797,1228,2594,906,1322,2372,715,1424,3089,807,1632,474,2256,1 376,636,2434,1349,694,2198,1557,254,2201,1179,717,2213,1234,575,1329,2154,913, 1571,2103,798,1324,3082,811,1133,2376,379,1208,2584,697,1558,431,2625,607,48 9,2596,1561,866,2161,1139,723,2202,1191,486,2127,1249,908,2317,1350,718,1330, 3090,813,1796,2156,476,1181,2626,856,1680,2272,839,1353,2214,725,1134,2567,69 8,1141,2600,914,1236,2243,752,1195,3200,868,1800,2318,819,1354,2689,814,1250, 439,2571,1573,929,2323,1562,490,2628,1411,623,2339,1332,671,2107,1240,739,308 4,1440,916,2217,1295,463,2608,1303,843,2162,1182,381,2325,1361,497,2204,1574, 930,2135,1696,821,2245,1142,726,3105,1356,1603,2164,961,2218,1564,872,2109,14 13,492,2579,1197,631,2573,1145,729,2690,1577,700,2329,1223,443,3137,1808,741, 2326,1203,845,2574,1252,920,2225,1362,382,2341,1336,822,2436,1728,2139,1414,8 51,3092,1198,730,2632,1578,498,2817,1605,880,2246,1417,742,2220,1307,445,2168, 1146,2249,471,1472,2384,1377,635,3328,1585,932,2110,1227,687,2330,1087,903,2 191,1364,2151,825,1418,2226,500,1551,2342,1606,846,3106,1580,745,2141,1205,26 92,826,1319,2250,732,1309,2640,446,1256,2371,1148,3096,962,1229,2440,936,1206, 2345,475,1667,2818,853,2155,1586,867,2228,1310,1609,2199,637,1323,3108,907,2 257,1378,487,2332,1235,695,2696,1425,2142,1209,746,2252,1420,828,2346,1368,30 79,753,1610,2448,854,1669,2656,1617,2400,857,1559,2373,504,1264,2581,799,3201, 1230,1119,2203,255,1351,2258,964,2353,1588,909,2595,1824,719,2348,1426,3138, 1380,477,2157,1331,915,2232,1325,2582,638,1441,2585,1237,2163,748,1592,2215,9 44,1856,3584,869,2273,1612,1210,2374,491,2354,1670,699,2820,1428,1251,2205,75 4,3083,1920,858,2704,1618,2377,478,1442,2158,1326,968,2165,1673,2260,383,1795, 3112,910,2219,1384,1563,2824,815,2378,1135,976,2274,1355,2597,1238,870,3140, 1333,2586,917,1212,2435,1473,2356,727,1241,2264,493,3202,1432,873,2464,1633,2 319,1620,701,2327,1575,2206,931,1674,2385,1253,3091,756,1183,2598,860,2720,14 44,1334,2166,499,2380,1565,731,2627,1797,3085,1634,823,2588,1681,2437,922,135 7,2221,1143,2169,874,1624,3120,918,2601,1363,2247,1242,502,2832,1392,2227,933, 1676,3086,1254,2276,743,1415,2386,1337,2360,760,2752,1474,881,2438,1566,3144, 1358,494,2222,1257,2602,702,2629,1579,1798,2441,921,3329,1199,501,2331,1147, 2170,1682,2496,876,1636,2401,1365,3093,847,1801,2609,992,2251,1244,2111,1338, 447,2388,1448,3204,1419,2442,733,1697,2575,827,2630,1607,2604,1379,934,2229,1 311,3107,1207,2343,882,1258,2333,937,2280,1149,2172,1581,963,3330,1684,2253,1 640,2230,747,1366,2691,505,2610,1340,3098,1265,855,2334,1802,2633,1587,2347,9 24,3585,1369,734,2402,1476,2259,1421,2449,829,1427,2233,1231,3152,965,2444,16 98,2392,1582,938,2634,1809,2693,1456,3109,884,1381,2641,506,2583,1211,2288,12 60,2254,749,1688,3097,1648,2143,945,2375, 1611,2612, 1804,966,3094, 1729,2848, 11 50,2450,755,2404,1266,859,2355,1589,3208,1422,2349,940,2465,1370,2261,1480,83 0,2616,1382,3332,1429,2880,911,2636,1327,1593,2234,871,3336,1268,2694,1619,24 52,639,2275,1213,1590,2944,888,3110,1700,2642,1385,2466,479,2350,1730,3586,16 13,946,2697,1239,2819,750,2408,1810,2587,1671,3168,969,2159,1372,1443,2379,50 8,2262,1430,3139,1488,2357,861,2236,1704,2497,1825,757,3113,1386,2265,1614,24 56,970,2657,1433,2644,1594,3216,919,2599,1812,1621,2698,1596,2277,875,3100,12 43,2207,1335,2468,862,2358,1732,3141,1622,2589,758,1625,2821,1675,2658,948,31 14,1445,2705,1816,2381,977,2167,1826,3588,1635,2648,923,2387,1626,2266,1434,9 72,3121,1255,2416,1712,2700,761,2278,1677,3146,1272,2439,877,2361,1393,2498,1 214,3344,1388,2590,952,2382,1678,2281,1683,495,3232,1359,2603,1504,2822,703,2 223,1339,3592,1245,2171,935,2706,1394,2660,1637,3360,978,2389,1446,2825,1449, 2268,1475,3600,883,2362,1638,2472,1567,2443,762,3264,1259,2721,1436,2631,503, 2403,1367,3616,1396,2335,925,2231,1799,2282,1341,3142,1246,2173,878,2605,145 0,2708,1477,3116,735,2664,1261,2390,1583,2364,1857,3203,993,2289,1828,2826,17 36,3153,885,2611,1858,2393,1685,2500,939,3122,1832,2445,1803,2451,1641,2255,9 94,3145,1628,2722,1457,2606,980,3087,1744,2833,1840,2480,1860,2405,926,3392,1 371,2235,1921,2284,764,2712,1267,3205,1686,2672,1478,2635,941,3124,1342,2828, 1699,2753,967,2174,1642,3095,1922,2290,1805,2613,886,1400,1452,3206,831,2446, 1689,2394,1760,2504,1591,3456,947,2406,1864,2453,1649,3148,507,2351,1262,261 7,1383,2292,1481,3209,889,2643,1423,2237,1811,3154,1615,2614,984,2724,1702,24 09,1458,3128,751,2754,1701,2637,1373,3099,1269,2263,942,2834,1482,2695,1690,3 169,1644,2396,996,2467,1387,3111,1151,2454,1215,2512,971,2728,1806,3331,1431, 2849,890,2410,1460,3156,1650,2638,1595,2457,509,3210,1489,2618,1705,2836,127 0,2645,949,3217,1731,2620,1374,2267,1623,3333,973,2359,1692,2756,1814,3101,14 84,2646,1000,2649,1273,3115,1706,2699,1597,2469,892,2840,1435,3170,1827,2850, 1813,2659,950,3587,1733,2650,1389,2458,1464,3160,863,2279,2736,1652,3212,171 3,2701,1398,2296,759,3102,1447,2417,1490,2238,1817,2412,1008,3218,1274,2702,1 395,2707,1505,3143,510,2383,1598,2528,3334,1437,2363,1627,2269,979,3337,1390, 2418,1492,2661,1679,3233,953,2470,1924,2473,1829,3648,1639,2499,2662,763,311 7,1708,2591,1734,2283,1453,3172,974,2460,1818,2391,1276,2420,1397,3712,2823,1 629,2365,954,3123,1872,2270,1714,2474,1737,3220,879,2501,1656,2285,3118,1506, 2607,1830,2881,981,3147,1451,2852,1928,2760,1438,3338,2882,982,2709,1247,334 5,1687,2856,1716,2827,1859,3589,927,2665,3176,1643,2652,1496,2481,1479,3234,9 95,2768,1820,2864,1833,3125,2884,1738,2395,1745,3265,765,2945,1861,2291,3224, 1740,2710,1888,2502,956,3149,1834,2366,1630,2723,3236,1936,2666,1746,2946,88 7,3840,1720,2829,1401,2424,3340,1459,2476,1841,3346,985,2713,1343,2784,3590,1 645,2615,1836,2888,997,3126,1508,2673,2286,1454,3155,1862,2407,1691,2505,986, 3129,2447,1512,2835,1263,3593,1402,2639,3184,1483,2726,943,2482,1646,3207,16 51,2725,2397,1461,3150,1404,2293,891,2506,3361,1842,2714,1485,3266,1520,2668, 1693,2411,3157,998,2175,1703,2239,1748,3348,2830,1865,3594,766,2455,1653,248 4,3130,1375,2674,1491,2619, 1462,3240,2513,511,3211, 1761,2729, 1275,2294,3171,1 486,2755,1466,2398,1465,3158,2647,988,3132,1493,2716,1271,2838,3352,1707,250 8,1866,2297,3161,1001,2730,1762,3362,1923,2621,2459,1694,3601,1807,2851,951,2 837,3596,1873,2757,1844,3268,2413,1752,2488,1952,3213,1002,2676,3173,1815,27 37,1391,2422,3219,1925,2471,1654,2514,1709,3248,2841,893,3214,1868,2298,2419, 1657,3602,1735,2529,3393,1277,2622,975,2461,1715,3103,2651,1848,3272,1926,24 14,2516,1710,3162,894,2703,3617,1764,2948,1874,2853,3364,1399,2663,1468,3394, 2732,1494,2758,1009,3604,2477,1507,3335,1439,2842,2300,1509,3221,1929,2421,3 174,1819,2653,955,2896,3177,1497,2738,1658,3376,2761,1768,3368,1876,2680,253 0,1984,3235,1004,2854,3164,1889,2475,1717,2952,3119,1821,2462,1930,3339,2271, 1010,2711,1739,3457,2740,1831,3618,2883,1498,3396,1660,2667,2520,1718,3280,9 57,2503,3458,1278,2844,1741,2857,3222,1599,2762,3225,1937,2769,1822,3237,288 5,983,2764,1835,3178,2912,1403,3127,2858,1721,3400,1455,2654,2960,1631,3608,1 513,2770,3649,958,2744,3620,1890,2425,1747,2483,3185,1510,2865,3226,1932,236 7,1742,3151,2669,987,3341,2860,1837,2532,1500,3180,2478,1880,3650,2886,1863,3 296,1749,2715,2536,1012,3238,2287,1722,3591,1938,2426,3624,1776,2507,3267,18 92,2670,1843,2675,3342,1838,2485,3713,999,2428,1463,3595,2866,1953,3347,2509, 1514,2544,3652,1647,2717,1695,3363,2727,1763,3131,2772,1016,3241,2889,1940,2 677,1487,3632,2399,1867,3186,2515,1405,3349,2486,1521,3228,2785,767,3159,195 4,2299,3269,1845,2510,2490,1750,3188,2489,1985,3242,1896,2517,3133,1516,2295, 3603,1655,2731,3597,989,2890,3714,1753,2786,2947,1724,3353,1467,2718,3350,17 65,2831,3598,1869,2897,3249,1944,2868,3365,1003,2776,3460,1406,2976,3163,184 6,2839,1875,2415,3656,1754,2949,3841,1522,2678,3270,1904,2733,3244,990,2892,3 192,1766,2681,3273,1469,2759,3408,1495,2301,3134,1659,2739,3354,1956,2872,32 15,1711,2950,3175,1927,2734,1005,2788,3250,1849,2898,3366,1524,2423,3165,187 0,2492,3716,1769,2518,3274,1850,2531,3664,1756,2463,3395,1470,2533,3464,959,2 953,3369,1986,2843,3842,1960,2521,3179,1499,2682,3252,1877,2792,3223,1891,29 00,3281,3008,1661,3356,2913,1931,3720,2741,1011,3166,2845,1511,3276,2954,171 9,3370,2763,1770,3472,2855, 1852,3680,2522, 1777,3424,2684, 1878,3397,2742,1881, 3605,2302,1013,3227,2765,1528,3282,2623,3377,1823,2961,3619,1279,2846,3372,1 988,2859,3181,1933,2427,3256,1743,2745,3606,1501,2479,2655,2537,1939,3609,29 14,895,3187,2771,1662,3239,2534,1772,3297,2956,1968,3398,2766,3378,1893,2861, 3844,1515,2524,3229,1723,2904,3728,1778,2887,3401,1882,2773,3182,2746,1006,3 189,2962,1502,3284,2800,1992,3243,2916,3848,1407,2867,3402,1934,2862,3298,18 39,2487,3621,2000,2977,3610,2538,1894,3459,2671,1941,3380,2719,1014,3288,278 7,3488,1751,2964,3343,1517,2511,3351,2891,1897,3230,2429,1725,3409,2545,1955, 3622,2978,3744,1780,2869,3190,1884,2774,3404,1523,3651,3009,3612,1755,2920,3 461,1017,2540,3245,2679,1847,3193,2777,1946,3625,2748,3271,1898,2491,3856,19 42,2789,3251,2893,1526,3300,2968,1957,3410,2430,3384,1767,2870,3776,1784,346 2,2899,3246,1905,2778,3626,1018,2546,3653,2928,1518,3465,2790,1726,3355,2493, 3194,1945,2519,3520,1525,3425,2683,3633,1900,2980,3275,2735,1871,3135,2951,2 016,3412,2873,3466,1471,2548,3599,1757,3654,2894,3628,1851,2793,3253,2874,99 1,3367,2780,1958,3357,2494,3304,1906,3196,3010,3277,1961,2984,3254,2523,1987, 3715,2901,1771,3634,2915,3358,1529,3657,2685,3371,1879,2955,3426,2535,1948,3 283,2743,1758,3473,3257,2794,1853,3468,2876,3416,1020,2801,3658,2902,1989,37 17,3665,1962,2905,3607,2552,1908,3312,2847,3278,1530,3167,2303,3399,1773,301 2,3636,2957,1969,3872,2767,3474,1990,3428,2525,3379,1779,2963,3373,2686,1883, 3489,3285,2796,1964,3640,2992,3904,1854,2917,3660,3258,1935,2539,3718,2747,1 007,3476,3299,2802,1895,3968,2906,3666,1663,2526,3490,3374,1912,3016,3721,24 31,1503,3843,2958,3432,1970,3611,2863,3183,1774,3024,3403,3286,1993,2918,338 1,2965,1532,3260,3521,2775,1885,3289,2541,3480,1781,2921,3681,3668,1994,2749, 3623,2979,3722,1943,3301,2804,3231,1015,2908,3492,3382,1899,2547,3613,2779,1 886,3845,3682,2871,3729,1782,2970,3405,3191,1972,2922,3672,2966,2001,3411,32 90,2550,1947,3440,2981,3724,3302,1996,2791,3463,3385,1785,2808,3522,2929,190 1,3614,3406,2542,3305,1976,2750,3627,3846,1519,2969,3247,2549,3195,1727,3730, 2924,3684,1959,3413,2895,3849,3040,2002,3292,3386,2495,1019,3496,3467,2781,3 745,1907,2875,3655,3427,1786,2982,3359,3255,2930,1527,3306,2985,3197,1949,36 29,3011,3732,3688,1902,2795,3414,2553,3388,1759,3313,2903,3850,2017,3635,297 2,3417,2782,1909,3524,3469,2877,3475,1963,3279,3013,3746,2018,3630,2986,3857, 3504,2004,2932,3429,2554,3259,1950,3308,2797,3736,3696,1788,2993,3659,3852,3 014,1965,3777,3198,2803,3314,1991,2907,3637,3470,2988,1021,3418,3528,2878,19 10,3430,3477,2959,3375,1855,3641,2919,3316,3667,1971,2687,3261,3638,2936,153 1,3748,3433,2527,3778,1913,3661,2994,3287,2798,3858,2008,3719,3017,3420,3491, 1775,2556,3478,3536,2909,1966,3752,3873,2805,3434,2020,3662,3018,3481,3642,1 995,2967,3860,3669,3644,2923,1914,3291,3383,2910,3780,1533,3670,2806,3673,37 23,1973,2996,3493,3864,3025,3874,1997,3683,2971,3674,3482,2024,3020,3303,376 0,2809,1916,3725,3320,2925,3441,3262,1974,3436,3000,3726,3731,1887,2543,3407, 3552,2751,3387,1783,3293,2983,3442,3685,3026,1022,3494,3497,3523,2931,2032,3 686,3615,2810,3307,3484,1534,2551,3415,3444,2973,3847,2003,3389,3294,2926,34 98,3525,1977,2783,3309,3631,3905,1787,3041,3876,3784,2933,3906,1998,3733,298 7,3880,3851,3689,1978,3042,3676,3505,3028,3792,1903,3888,3908,2974,3419,3969, 2005,2812,3315,3734,3526,2989,2006,3390,3747,3015,3690,3970,1951,3853,2934,3 448,3500,2879,3737,2019,3808,3639,2995,3912,3697,1789,2555,3310,3431,3529,29 37,1980,3471,3859,3663,3032,3750,3506,1911,2799,3749,3421,3317,2990,2009,353 0,3738,3692,3044,3435,3199,2021,3263,3019,3854,3479,2938,2010,3508,3698,3643, 2557,3537,3753,1967,3318,2997,3779,3422,3671,3021,1915,3740,3862,3532,3048,3 321,3754,2022,3645,2940,3483,3875,3861,1790,2998,3781,3437,3512,2911,3700,15 35,3761,3446,2807,3495,3538,3865,3056,1023,3322,3443,3553,2558,3646,3485,201 2,3675,3027,3438,3540,3727,3001,2025,3972,3877,3687,2811,3756,3782,1975,3501, 3022,3866,3324,3445,3677,3002,2026,3920,3762,3785,2927,3704,3554,1917,3878,3 029,3499,3976,3486,3030,3295,1999,3735,3764,3907,2975,3691,3544,3527,1918,30 43,3868,3881,3786,3793,2813,3909,2033,3788,3936,3004,3882,3678,3984,3794,197 9,2935,3768,3449,3507,3889,3033,3391,2028,3693,3884,3045,3556,3502,3910,3739, 2034,3034,3560,3311,3450,3531,2991,3694,1981,3699,3509,3452,2939,3890,3533,3 568,3741,2007,3046,3751,3796,3913,2814,3701,3423,3539,1982,3510,2559,3809,33 23,3534,3514,3513,2011,3036,3541,3319,3755,3914,3049,3810,3971,3742,2036,385 5,2999,3921,3892,3800,4000,3050,3863,2023,3439,3973,3702,3757,2941,3916,3705, 3783,2040,3325,3023,3763,3896,3974,3758,2942,3812,3922,1791,3447,3516,3542,3 057,3555,3487,3557,3977,3867,2013,3003,3545,3706,3816,3924,4032,3052,3937,37 65,2027,3869,3978,3058,3787,3879,3546,3708,3766,3005,2014,3326,3789,3647,398 5,3870,3031,3883,3451,3769,3503,2029,3679,3561,3006,3938,3795,3558,3980,3790, 3035,3885,1983,3548,3928,3911,3797,3060,3770,3986,3824,3940,3891,2035,3886,3 047,3511,4001,3562,3695,3743,3811,3064,3988,3535,2037,3915,3453,3569,2815,40 02,3893,3798,4033,3944,3564,3703,1919,3037,3801,3772,3515,3813,3917,3992,305 1,3454,3894,3923,3802,2030,3570,3952,3038,3814,3517,3543,3707,4004,3759,3975, 3053,3897,2038,3572,3918,3817,3898,3804,3518,3007,4034,4008,3547,3925,3939,2 041,3709,3979,3059,3559,3767,3818,3900,3825,3926,3929,3061,3576,3871,3327,20 42,4036,3981,3791,3549,3987,2943,3710,3820,4016,3941,3563,3771,3826,3930,201 5,3054,3550,4040,3455,3982,3887,4048,3942,3989,3062,3799,3565,3945,3773,4003, 2044,3828,3932,3571,3803,3065,3895,3994,3946,3990,3574,4005,3815,3832,3953,3 066,3566,2031,3774,3993,3573,3948,3919,4064,3519,3805,3899,3039,4006,3954,40 09,4035,3819,3577,3927,2039,3996,3806,3901,3068,4037,4010,3956,3578,3821,401 7,4038,3827,3931,4012,3902,3983,3055,3943,3711,3960,2043,3551,4018,3822,4041, 3580,3933,3829,4042,3991,3063,3947,3934,3830,4020,4049,3995,4044,3833,3949,4 024,3567,2045,3775,4007,4050,3067,3955,3834,3575,3997,3950,3807,4065,3957,40 11,4066,4052,3998,3836,4013,4039,3069,3958,3903,4019,3579,3961,2046,4056,382 3,4014,4068,4043,3962,3581,4021,4045,4072,3964,4022,3935,3831,3070,4080,3582, 4051,4025,3835,4046,4026,3951,4053,4054,3999,4067,3837,4028,3959,4057,4069,2 047,4058,4015,3963,4070,3838,3583,3071,4060,4073,4023,4074,3965,4047,3966,40 81,4027,4076,4082,4029,4055,4030,4059,4084,4071,4088,3839,4061,4075,4062,407 7,4031,4083,4085,3967,4078,4086,4089,4090,4063,4092,4079,4087,4091,4093,4094, 4095];

**Table Q2, with a sequence length of 4096:**

| Reliability or reliability sequence number | Polarized channel sequence number | Reliability or reliability sequence number | Polarized channel sequence number | Reliability or reliability sequence number | Polarized channel sequence number | Reliability or reliability sequence number | Polarized channel sequence number | Reliability or reliability sequence number | Polarized channel sequence number | Reliability or reliability sequence number | Polarized channel sequence number | Reliability or reliability sequence number | Polarized channel sequence number | Reliability or reliability sequence number | Polarized channel sequence number |
|---|---|---|---|---|---|---|---|---|---|---|---|---|---|---|---|
| 0 | 0 | 512 | 2069 | 1024 | 2337 | 1536 | 2165 | 2048 | 1400 | 2560 | 1498 | 3072 | 1948 | 3584 | 1023 |
| 1 | 1 | 513 | 1098 | 1025 | 1665 | 1537 | 1673 | 2049 | 1452 | 2561 | 3396 | 3073 | 3283 | 3585 | 3322 |
| 2 | 2 | 514 | 391 | 1026 | 380 | 1538 | 2260 | 2050 | 3206 | 2562 | 1660 | 3074 | 2743 | 3586 | 3443 |
| 3 | 4 | 515 | 313 | 1027 | 2242 | 1539 | 383 | 2051 | 831 | 2563 | 2667 | 3075 | 1758 | 3587 | 3553 |
| 4 | 8 | 516 | 450 | 1028 | 1547 | 1540 | 1795 | 2052 | 2446 | 2564 | 2520 | 3076 | 3473 | 3588 | 2558 |
| 5 | 16 | 517 | 1296 | 1029 | 818 | 1541 | 3112 | 2053 | 1689 | 2565 | 1718 | 3077 | 3257 | 3589 | 3646 |
| 6 | 32 | 518 | 542 | 1030 | 1299 | 1542 | 910 | 2054 | 2394 | 2566 | 3280 | 3078 | 2794 | 3590 | 3485 |
| 7 | 3 | 519 | 2180 | 1031 | 2133 | 1543 | 2219 | 2055 | 1760 | 2567 | 957 | 3079 | 1853 | 3591 | 2012 |
| 8 | 5 | 520 | 334 | 1032 | 461 | 1544 | 1384 | 2056 | 2504 | 2568 | 2503 | 3080 | 3468 | 3592 | 3675 |
| 9 | 64 | 521 | 233 | 1033 | 496 | 1545 | 1563 | 2057 | 1591 | 2569 | 3458 | 3081 | 2876 | 3593 | 3027 |
| 10 | 1024 | 522 | 1184 | 1034 | 1604 | 1546 | 2824 | 2058 | 3456 | 2570 | 1278 | 3082 | 3416 | 3594 | 3438 |
| 11 | 2048 | 523 | 555 | 1035 | 2324 | 1547 | 815 | 2059 | 947 | 2571 | 2844 | 3083 | 1020 | 3595 | 3540 |
| 12 | 9 | 524 | 774 | 1036 | 669 | 1548 | 2378 | 2060 | 2406 | 2572 | 1741 | 3084 | 2801 | 3596 | 3727 |
| 13 | 6 | 525 | 175 | 1037 | 1315 | 1549 | 1135 | 2061 | 1864 | 2573 | 2857 | 3085 | 3658 | 3597 | 3001 |
| 14 | 17 | 526 | 2083 | 1038 | 2570 | 1550 | 976 | 2062 | 2453 | 2574 | 3222 | 3086 | 2902 | 3598 | 2025 |
| 15 | 10 | 527 | 1544 | 1039 | 679 | 1551 | 2274 | 2063 | 1649 | 2575 | 1599 | 3087 | 1989 | 3599 | 3972 |
| 16 | 18 | 528 | 123 | 1040 | 1083 | 1552 | 1355 | 2064 | 3148 | 2576 | 2762 | 3088 | 3717 | 3600 | 3877 |
| 17 | 128 | 529 | 658 | 1041 | 724 | 1553 | 2597 | 2065 | 507 | 2577 | 3225 | 3089 | 3665 | 3601 | 3687 |
| 18 | 12 | 530 | 612 | 1042 | 2106 | 1554 | 1238 | 2066 | 2351 | 2578 | 1937 | 3090 | 1962 | 3602 | 2811 |
| 19 | 33 | 531 | 1312 | 1043 | 1193 | 1555 | 870 | 2067 | 1262 | 2579 | 2769 | 3091 | 2905 | 3603 | 3756 |
| 20 | 65 | 532 | 2306 | 1044 | 841 | 1556 | 3140 | 2068 | 2617 | 2580 | 1822 | 3092 | 3607 | 3604 | 3782 |
| 21 | 20 | 533 | 341 | 1045 | 629 | 1557 | 1333 | 2069 | 1383 | 2581 | 3237 | 3093 | 2552 | 3605 | 1975 |
| 22 | 256 | 534 | 777 | 1046 | 2216 | 1558 | 2586 | 2070 | 2292 | 2582 | 2885 | 3094 | 1908 | 3606 | 3501 |
| 23 | 34 | 535 | 220 | 1047 | 1584 | 1559 | 917 | 2071 | 1481 | 2583 | 983 | 3095 | 3312 | 3607 | 3022 |
| 24 | 24 | 536 | 1552 | 1048 | 351 | 1560 | 1212 | 2072 | 3209 | 2584 | 2764 | 3096 | 2847 | 3608 | 3866 |
| 25 | 36 | 537 | 314 | 1049 | 1138 | 1561 | 2435 | 2073 | 889 | 2585 | 1835 | 3097 | 3278 | 3609 | 3324 |
| 26 | 7 | 538 | 424 | 1050 | 3077 | 1562 | 1473 | 2074 | 2643 | 2586 | 3178 | 3098 | 1530 | 3610 | 3445 |
| 27 | 129 | 539 | 2074 | 1051 | 467 | 1563 | 2356 | 2075 | 1423 | 2587 | 2912 | 3099 | 3167 | 3611 | 3677 |
| 28 | 66 | 540 | 395 | 1052 | 1301 | 1564 | 727 | 2076 | 2237 | 2588 | 1403 | 3100 | 2303 | 3612 | 3002 |
| 29 | 512 | 541 | 1216 | 1053 | 2187 | 1565 | 1241 | 2077 | 1811 | 2589 | 3127 | 3101 | 3399 | 3613 | 2026 |
| 30 | 11 | 542 | 673 | 1054 | 438 | 1566 | 2264 | 2078 | 3154 | 2590 | 2858 | 3102 | 1773 | 3614 | 3920 |
| 31 | 40 | 543 | 583 | 1055 | 1180 | 1567 | 493 | 2079 | 1615 | 2591 | 1721 | 3103 | 3012 | 3615 | 3762 |
| 32 | 68 | 544 | 355 | 1056 | 737 | 1568 | 3202 | 2080 | 2614 | 2592 | 3400 | 3104 | 3636 | 3616 | 3785 |
| 33 | 130 | 545 | 1568 | 1057 | 2147 | 1569 | 1432 | 2081 | 984 | 2593 | 1455 | 3105 | 2957 | 3617 | 2927 |
| 34 | 19 | 546 | 2561 | 1058 | 1111 | 1570 | 873 | 2082 | 2724 | 2594 | 2654 | 3106 | 1969 | 3618 | 3704 |
| 35 | 13 | 547 | 287 | 1059 | 251 | 1571 | 2464 | 2083 | 1702 | 2595 | 2960 | 3107 | 3872 | 3619 | 3554 |
| 36 | 48 | 548 | 183 | 1060 | 1221 | 1572 | 1633 | 2084 | 2409 | 2596 | 1631 | 3108 | 2767 | 3620 | 1917 |
| 37 | 14 | 549 | 234 | 1061 | 2134 | 1573 | 2319 | 2085 | 1458 | 2597 | 3608 | 3109 | 3474 | 3621 | 3878 |
| 38 | 72 | 550 | 1094 | 1062 | 462 | 1574 | 1620 | 2086 | 3128 | 2598 | 1513 | 3110 | 1990 | 3622 | 3029 |
| 39 | 257 | 551 | 125 | 1063 | 442 | 1575 | 701 | 2087 | 751 | 2599 | 2770 | 3111 | 3428 | 3623 | 3499 |
| 40 | 1025 | 552 | 557 | 1064 | 2108 | 1576 | 2327 | 2088 | 2754 | 2600 | 3649 | 3112 | 2525 | 3624 | 3976 |
| 41 | 21 | 553 | 2128 | 1065 | 1140 | 1577 | 1575 | 2089 | 1701 | 2601 | 958 | 3113 | 3379 | 3625 | 3486 |
| 42 | 132 | 554 | 660 | 1066 | 441 | 1578 | 2206 | 2090 | 2637 | 2602 | 2744 | 3114 | 1779 | 3626 | 3030 |
| 43 | 35 | 555 | 1068 | 1067 | 1194 | 1579 | 931 | 2091 | 1373 | 2603 | 3620 | 3115 | 2963 | 3627 | 3295 |
| 44 | 258 | 556 | 616 | 1068 | 2328 | 1580 | 1674 | 2092 | 3099 | 2604 | 1890 | 3116 | 3373 | 3628 | 1999 |
| 45 | 26 | 557 | 342 | 1069 | 469 | 1581 | 2385 | 2093 | 1269 | 2605 | 2425 | 3117 | 2686 | 3629 | 3735 |
| 46 | 2049 | 558 | 316 | 1070 | 1085 | 1582 | 1253 | 2094 | 2263 | 2606 | 1747 | 3118 | 1883 | 3630 | 3764 |
| 47 | 513 | 559 | 2085 | 1071 | 2137 | 1583 | 3091 | 2095 | 942 | 2607 | 2483 | 3119 | 3489 | 3631 | 3907 |
| 48 | 80 | 560 | 1155 | 1072 | 247 | 1584 | 756 | 2096 | 2834 | 2608 | 3185 | 3120 | 3285 | 3632 | 2975 |
| 49 | 37 | 561 | 241 | 1073 | 1555 | 1585 | 1183 | 2097 | 1482 | 2609 | 1510 | 3121 | 2796 | 3633 | 3691 |
| 50 | 25 | 562 | 778 | 1074 | 683 | 1586 | 2598 | 2098 | 2695 | 2610 | 2865 | 3122 | 1964 | 3634 | 3544 |
| 51 | 22 | 563 | 1105 | 1075 | 2338 | 1587 | 860 | 2099 | 1690 | 2611 | 3226 | 3123 | 3640 | 3635 | 3527 |
| 52 | 136 | 564 | 563 | 1076 | 1549 | 1588 | 2720 | 2100 | 3169 | 2612 | 1932 | 3124 | 2992 | 3636 | 1918 |
| 53 | 260 | 565 | 345 | 1077 | 842 | 1589 | 1444 | 2101 | 1644 | 2613 | 2367 | 3125 | 3904 | 3637 | 3043 |
| 54 | 264 | 566 | 2073 | 1078 | 1666 | 1590 | 1334 | 2102 | 2396 | 2614 | 1742 | 3126 | 1854 | 3638 | 3868 |
| 55 | 38 | 567 | 452 | 1079 | 2577 | 1591 | 2166 | 2103 | 996 | 2615 | 3151 | 3127 | 2917 | 3639 | 3881 |
| 56 | 514 | 568 | 1074 | 1080 | 738 | 1592 | 499 | 2104 | 2467 | 2616 | 2669 | 3128 | 3660 | 3640 | 3786 |
| 57 | 96 | 569 | 397 | 1081 | 899 | 1593 | 2380 | 2105 | 1387 | 2617 | 987 | 3129 | 3258 | 3641 | 3793 |
| 58 | 67 | 570 | 403 | 1082 | 2572 | 1594 | 1565 | 2106 | 3111 | 2618 | 3341 | 3130 | 1935 | 3642 | 2813 |
| 59 | 41 | 571 | 207 | 1083 | 1305 | 1595 | 731 | 2107 | 1151 | 2619 | 2860 | 3131 | 2539 | 3643 | 3909 |
| 60 | 144 | 572 | 2070 | 1084 | 670 | 1596 | 2627 | 2108 | 2454 | 2620 | 1837 | 3132 | 3718 | 3644 | 2033 |
| 61 | 28 | 573 | 1097 | 1085 | 1302 | 1597 | 1797 | 2109 | 1215 | 2621 | 2532 | 3133 | 2747 | 3645 | 3788 |
| 62 | 69 | 574 | 674 | 1086 | 2244 | 1598 | 3085 | 2110 | 2512 | 2622 | 1500 | 3134 | 1007 | 3646 | 3936 |
| 63 | 42 | 575 | 558 | 1087 | 783 | 1599 | 1634 | 2111 | 971 | 2623 | 3180 | 3135 | 3476 | 3647 | 3004 |
| 64 | 516 | 576 | 1039 | 1088 | 1550 | 1600 | 823 | 2112 | 2728 | 2624 | 2478 | 3136 | 3299 | 3648 | 3882 |
| 65 | 49 | 577 | 785 | 1089 | 3136 | 1601 | 2588 | 2113 | 1806 | 2625 | 1880 | 3137 | 2802 | 3649 | 3678 |
| 66 | 1026 | 578 | 432 | 1090 | 849 | 1602 | 1681 | 2114 | 3331 | 2626 | 3650 | 3138 | 1895 | 3650 | 3984 |
| 67 | 74 | 579 | 2184 | 1091 | 1201 | 1603 | 2437 | 2115 | 1431 | 2627 | 2886 | 3139 | 3968 | 3651 | 3794 |
| 68 | 272 | 580 | 357 | 1092 | 820 | 1604 | 922 | 2116 | 2849 | 2628 | 1863 | 3140 | 2906 | 3652 | 1979 |
| 69 | 160 | 581 | 1344 | 1093 | 2189 | 1605 | 1357 | 2117 | 890 | 2629 | 3296 | 3141 | 3666 | 3653 | 2935 |
| 70 | 520 | 582 | 187 | 1094 | 1317 | 1606 | 2221 | 2118 | 2410 | 2630 | 1749 | 3142 | 1663 | 3654 | 3768 |
| 71 | 288 | 583 | 236 | 1095 | 728 | 1607 | 1143 | 2119 | 1460 | 2631 | 2715 | 3143 | 2526 | 3655 | 3449 |
| 72 | 528 | 584 | 664 | 1096 | 2149 | 1608 | 2169 | 2120 | 3156 | 2632 | 2536 | 3144 | 3490 | 3656 | 3507 |
| 73 | 192 | 585 | 2308 | 1097 | 1412 | 1609 | 874 | 2121 | 1650 | 2633 | 1012 | 3145 | 3374 | 3657 | 3889 |
| 74 | 544 | 586 | 1157 | 1098 | 928 | 1610 | 1624 | 2122 | 2638 | 2634 | 3238 | 3146 | 1912 | 3658 | 3033 |
| 75 | 70 | 587 | 624 | 1099 | 1115 | 1611 | 3120 | 2123 | 1595 | 2635 | 2287 | 3147 | 3016 | 3659 | 3391 |
| 76 | 44 | 588 | 587 | 1100 | 2195 | 1612 | 918 | 2124 | 2457 | 2636 | 1722 | 3148 | 3721 | 3660 | 2028 |
| 77 | 131 | 589 | 1076 | 1101 | 791 | 1613 | 2601 | 2125 | 509 | 2637 | 3591 | 3149 | 2431 | 3661 | 3693 |
| 78 | 81 | 590 | 780 | 1102 | 367 | 1614 | 1363 | 2126 | 3210 | 2638 | 1938 | 3150 | 1503 | 3662 | 3884 |
| 79 | 2050 | 591 | 2312 | 1103 | 2224 | 1615 | 2247 | 2127 | 1489 | 2639 | 2426 | 3151 | 3843 | 3663 | 3045 |
| 80 | 50 | 592 | 705 | 1104 | 1608 | 1616 | 1242 | 2128 | 2618 | 2640 | 3624 | 3152 | 2958 | 3664 | 3556 |
| 81 | 73 | 593 | 126 | 1105 | 901 | 1617 | 502 | 2129 | 1705 | 2641 | 1776 | 3153 | 3432 | 3665 | 3502 |
| 82 | 15 | 594 | 1047 | 1106 | 1793 | 1618 | 2832 | 2130 | 2836 | 2642 | 2507 | 3154 | 1970 | 3666 | 3910 |
| 83 | 320 | 595 | 242 | 1107 | 2190 | 1619 | 1392 | 2131 | 1270 | 2643 | 3267 | 3155 | 3611 | 3667 | 3739 |
| 84 | 133 | 596 | 565 | 1108 | 630 | 1620 | 2227 | 2132 | 2645 | 2644 | 1892 | 3156 | 2863 | 3668 | 2034 |
| 85 | 52 | 597 | 1158 | 1109 | 1222 | 1621 | 933 | 2133 | 949 | 2645 | 2670 | 3157 | 3183 | 3669 | 3034 |
| 86 | 1028 | 598 | 2086 | 1110 | 2578 | 1622 | 1676 | 2134 | 3217 | 2646 | 1843 | 3158 | 1774 | 3670 | 3560 |
| 87 | 23 | 599 | 398 | 1111 | 685 | 1623 | 3086 | 2135 | 1731 | 2647 | 2675 | 3159 | 3024 | 3671 | 3311 |
| 88 | 134 | 600 | 346 | 1112 | 1196 | 1624 | 1254 | 2136 | 2620 | 2648 | 3342 | 3160 | 3403 | 3672 | 3450 |
| 89 | 384 | 601 | 456 | 1113 | 844 | 1625 | 2276 | 2137 | 1374 | 2649 | 1838 | 3161 | 3286 | 3673 | 3531 |
| 90 | 76 | 602 | 1408 | 1114 | 2369 | 1626 | 743 | 2138 | 2267 | 2650 | 2485 | 3162 | 1993 | 3674 | 2991 |
| 91 | 137 | 603 | 358 | 1115 | 1144 | 1627 | 1415 | 2139 | 1623 | 2651 | 3713 | 3163 | 2918 | 3675 | 3694 |
| 92 | 82 | 604 | 2562 | 1116 | 633 | 1628 | 2386 | 2140 | 3333 | 2652 | 999 | 3164 | 3381 | 3676 | 1981 |
| 93 | 56 | 605 | 405 | 1117 | 2079 | 1629 | 1337 | 2141 | 973 | 2653 | 2428 | 3165 | 2965 | 3677 | 3699 |
| 94 | 27 | 606 | 1100 | 1118 | 1225 | 1630 | 2360 | 2142 | 2359 | 2654 | 1463 | 3166 | 1532 | 3678 | 3509 |
| 95 | 97 | 607 | 303 | 1119 | 711 | 1631 | 760 | 2143 | 1692 | 2655 | 3595 | 3167 | 3260 | 3679 | 3452 |
| 96 | 39 | 608 | 569 | 1120 | 1360 | 1632 | 2752 | 2144 | 2756 | 2656 | 2866 | 3168 | 3521 | 3680 | 2939 |
| 97 | 259 | 609 | 244 | 1121 | 2248 | 1633 | 1474 | 2145 | 1814 | 2657 | 1953 | 3169 | 2775 | 3681 | 3890 |
| 98 | 84 | 610 | 2144 | 1122 | 253 | 1634 | 881 | 2146 | 3101 | 2658 | 3347 | 3170 | 1885 | 3682 | 3533 |
| 99 | 138 | 611 | 1161 | 1123 | 1086 | 1635 | 2438 | 2147 | 1484 | 2659 | 2509 | 3171 | 3289 | 3683 | 3568 |
| 100 | 145 | 612 | 595 | 1124 | 3081 | 1636 | 1566 | 2148 | 2646 | 2660 | 1514 | 3172 | 2541 | 3684 | 3741 |
| 101 | 261 | 613 | 189 | 1125 | 691 | 1637 | 3144 | 2149 | 1000 | 2661 | 2544 | 3173 | 3480 | 3685 | 2007 |
| 102 | 1032 | 614 | 1106 | 1126 | 1306 | 1638 | 1358 | 2150 | 2649 | 2662 | 3652 | 3174 | 1781 | 3686 | 3046 |
| 103 | 29 | 615 | 566 | 1127 | 824 | 1639 | 494 | 2151 | 1273 | 2663 | 1647 | 3175 | 2921 | 3687 | 3751 |
| 104 | 43 | 616 | 2115 | 1128 | 2138 | 1640 | 2222 | 2152 | 3115 | 2664 | 2717 | 3176 | 3681 | 3688 | 3796 |
| 105 | 2052 | 617 | 676 | 1129 | 1167 | 1641 | 1257 | 2153 | 1706 | 2665 | 1695 | 3177 | 3668 | 3689 | 3913 |
| 106 | 98 | 618 | 361 | 1130 | 902 | 1642 | 2602 | 2154 | 2699 | 2666 | 3363 | 3178 | 1994 | 3690 | 2814 |
| 107 | 515 | 619 | 1080 | 1131 | 2593 | 1643 | 702 | 2155 | 1597 | 2667 | 2727 | 3179 | 2749 | 3691 | 3701 |
| 108 | 88 | 620 | 706 | 1132 | 1127 | 1644 | 2629 | 2156 | 2469 | 2668 | 1763 | 3180 | 3623 | 3692 | 3423 |
| 109 | 140 | 621 | 589 | 1133 | 686 | 1645 | 1579 | 2157 | 892 | 2669 | 3131 | 3181 | 2979 | 3693 | 3539 |
| 110 | 30 | 622 | 2089 | 1134 | 740 | 1646 | 1798 | 2158 | 2840 | 2670 | 2772 | 3182 | 3722 | 3694 | 1982 |
| 111 | 146 | 623 | 1051 | 1135 | 2340 | 1647 | 2441 | 2159 | 1435 | 2671 | 1016 | 3183 | 1943 | 3695 | 3510 |
| 112 | 71 | 624 | 215 | 1136 | 1202 | 1648 | 921 | 2160 | 3170 | 2672 | 3241 | 3184 | 3301 | 3696 | 2559 |
| 113 | 262 | 625 | 786 | 1137 | 850 | 1649 | 3329 | 2161 | 1827 | 2673 | 2889 | 3185 | 2804 | 3697 | 3809 |
| 114 | 265 | 626 | 647 | 1138 | 2370 | 1650 | 1199 | 2162 | 2850 | 2674 | 1940 | 3186 | 3231 | 3698 | 3323 |
| 115 | 161 | 627 | 1121 | 1139 | 1318 | 1651 | 501 | 2163 | 1813 | 2675 | 2677 | 3187 | 1015 | 3699 | 3534 |
| 116 | 576 | 628 | 2192 | 1140 | 375 | 1652 | 2331 | 2164 | 2659 | 2676 | 1487 | 3188 | 2908 | 3700 | 3514 |
| 117 | 45 | 629 | 348 | 1141 | 2580 | 1653 | 1147 | 2165 | 950 | 2677 | 3632 | 3189 | 3492 | 3701 | 3513 |
| 118 | 1040 | 630 | 419 | 1142 | 1117 | 1654 | 2170 | 2166 | 3587 | 2678 | 2399 | 3190 | 3382 | 3702 | 2011 |
| 119 | 100 | 631 | 1063 | 1143 | 444 | 1655 | 1682 | 2167 | 1733 | 2679 | 1867 | 3191 | 1899 | 3703 | 3036 |
| 120 | 640 | 632 | 406 | 1144 | 1668 | 1656 | 2496 | 2168 | 2650 | 2680 | 3186 | 3192 | 2547 | 3704 | 3541 |
| 121 | 51 | 633 | 464 | 1145 | 2311 | 1657 | 876 | 2169 | 1389 | 2681 | 2515 | 3193 | 3613 | 3705 | 3319 |
| 122 | 148 | 634 | 2076 | 1146 | 470 | 1658 | 1636 | 2170 | 2458 | 2682 | 1405 | 3194 | 2779 | 3706 | 3755 |
| 123 | 46 | 635 | 680 | 1147 | 1226 | 1659 | 2401 | 2171 | 1464 | 2683 | 3349 | 3195 | 1886 | 3707 | 3914 |
| 124 | 75 | 636 | 1283 | 1148 | 2197 | 1660 | 1365 | 2172 | 3160 | 2684 | 2486 | 3196 | 3845 | 3708 | 3049 |
| 125 | 266 | 637 | 801 | 1149 | 483 | 1661 | 3093 | 2173 | 863 | 2685 | 1521 | 3197 | 3682 | 3709 | 3810 |
| 126 | 273 | 638 | 362 | 1150 | 1616 | 1662 | 847 | 2174 | 2279 | 2686 | 3228 | 3198 | 2871 | 3710 | 3971 |
| 127 | 517 | 639 | 1108 | 1151 | 415 | 1663 | 1801 | 2175 | 2736 | 2687 | 2785 | 3199 | 3729 | 3711 | 3742 |
| 128 | 2056 | 640 | 2117 | 1152 | 2150 | 1664 | 2609 | 2176 | 1652 | 2688 | 767 | 3200 | 1782 | 3712 | 2036 |
| 129 | 104 | 641 | 590 | 1153 | 1347 | 1665 | 992 | 2177 | 3212 | 2689 | 3159 | 3201 | 2970 | 3713 | 3855 |
| 130 | 162 | 642 | 409 | 1154 | 485 | 1666 | 2251 | 2178 | 1713 | 2690 | 1954 | 3202 | 3405 | 3714 | 2999 |
| 131 | 53 | 643 | 1162 | 1155 | 2153 | 1667 | 1244 | 2179 | 2701 | 2691 | 2299 | 3203 | 3191 | 3715 | 3921 |
| 132 | 193 | 644 | 570 | 1156 | 1416 | 1668 | 2111 | 2180 | 1398 | 2692 | 3269 | 3204 | 1972 | 3716 | 3892 |
| 133 | 1056 | 645 | 2090 | 1157 | 905 | 1669 | 1338 | 2181 | 2296 | 2693 | 1845 | 3205 | 2922 | 3717 | 3800 |
| 134 | 152 | 646 | 788 | 1158 | 3078 | 1670 | 447 | 2182 | 759 | 2694 | 2510 | 3206 | 3672 | 3718 | 4000 |
| 135 | 77 | 647 | 597 | 1159 | 1321 | 1671 | 2388 | 2183 | 3102 | 2695 | 2490 | 3207 | 2966 | 3719 | 3050 |
| 136 | 164 | 648 | 1169 | 1160 | 795 | 1672 | 1448 | 2184 | 1447 | 2696 | 1750 | 3208 | 2001 | 3720 | 3863 |
| 137 | 768 | 649 | 572 | 1161 | 1794 | 1673 | 3204 | 2185 | 2417 | 2697 | 3188 | 3209 | 3411 | 3721 | 2023 |
| 138 | 268 | 650 | 219 | 1162 | 2352 | 1674 | 1419 | 2186 | 1490 | 2698 | 2489 | 3210 | 3290 | 3722 | 3439 |
| 139 | 274 | 651 | 2564 | 1163 | 473 | 1675 | 2442 | 2187 | 2238 | 2699 | 1985 | 3211 | 2550 | 3723 | 3973 |
| 140 | 518 | 652 | 1285 | 1164 | 1131 | 1676 | 733 | 2188 | 1817 | 2700 | 3242 | 3212 | 1947 | 3724 | 3702 |
| 141 | 54 | 653 | 311 | 1165 | 2344 | 1677 | 1697 | 2189 | 2412 | 2701 | 1896 | 3213 | 3440 | 3725 | 3757 |
| 142 | 83 | 654 | 708 | 1166 | 634 | 1678 | 2575 | 2190 | 1008 | 2702 | 2517 | 3214 | 2981 | 3726 | 2941 |
| 143 | 57 | 655 | 1053 | 1167 | 1204 | 1679 | 827 | 2191 | 3218 | 2703 | 3133 | 3215 | 3724 | 3727 | 3916 |
| 144 | 521 | 656 | 598 | 1168 | 2211 | 1680 | 2630 | 2192 | 1274 | 2704 | 1516 | 3216 | 3302 | 3728 | 3705 |
| 145 | 1027 | 657 | 2097 | 1169 | 744 | 1681 | 1607 | 2193 | 2702 | 2705 | 2295 | 3217 | 1996 | 3729 | 3783 |
| 146 | 112 | 658 | 601 | 1170 | 1175 | 1682 | 2604 | 2194 | 1395 | 2706 | 3603 | 3218 | 2791 | 3730 | 2040 |
| 147 | 135 | 659 | 1067 | 1171 | 852 | 1683 | 1379 | 2195 | 2707 | 2707 | 1655 | 3219 | 3463 | 3731 | 3325 |
| 148 | 2064 | 660 | 651 | 1172 | 2140 | 1684 | 934 | 2196 | 1505 | 2708 | 2731 | 3220 | 3385 | 3732 | 3023 |
| 149 | 78 | 661 | 421 | 1173 | 1233 | 1685 | 2229 | 2197 | 3143 | 2709 | 3597 | 3221 | 1785 | 3733 | 3763 |
| 150 | 289 | 662 | 3074 | 1174 | 960 | 1686 | 1311 | 2198 | 510 | 2710 | 989 | 3222 | 2808 | 3734 | 3896 |
| 151 | 194 | 663 | 792 | 1175 | 2095 | 1687 | 3107 | 2199 | 2383 | 2711 | 2890 | 3223 | 3522 | 3735 | 3974 |
| 152 | 85 | 664 | 1122 | 1176 | 1308 | 1688 | 1207 | 2200 | 1598 | 2712 | 3714 | 3224 | 2929 | 3736 | 3758 |
| 153 | 276 | 665 | 802 | 1177 | 865 | 1689 | 2343 | 2201 | 2528 | 2713 | 1753 | 3225 | 1901 | 3737 | 2942 |
| 154 | 522 | 666 | 611 | 1178 | 2315 | 1690 | 882 | 2202 | 3334 | 2714 | 2786 | 3226 | 3614 | 3738 | 3812 |
| 155 | 58 | 667 | 1539 | 1179 | 1672 | 1691 | 1258 | 2203 | 1437 | 2715 | 2947 | 3227 | 3406 | 3739 | 3922 |
| 156 | 168 | 668 | 2122 | 1180 | 693 | 1692 | 2333 | 2204 | 2363 | 2716 | 1724 | 3228 | 2542 | 3740 | 1791 |
| 157 | 1029 | 669 | 602 | 1181 | 2433 | 1693 | 937 | 2205 | 1627 | 2717 | 3353 | 3229 | 3305 | 3741 | 3447 |
| 158 | 139 | 670 | 410 | 1182 | 1118 | 1694 | 2280 | 2206 | 2269 | 2718 | 1467 | 3230 | 1976 | 3742 | 3516 |
| 159 | 99 | 671 | 1112 | 1183 | 797 | 1695 | 1149 | 2207 | 979 | 2719 | 2718 | 3231 | 2750 | 3743 | 3542 |
| 160 | 86 | 672 | 231 | 1184 | 1228 | 1696 | 2172 | 2208 | 3337 | 2720 | 3350 | 3232 | 3627 | 3744 | 3057 |
| 161 | 60 | 673 | 688 | 1185 | 2594 | 1697 | 1581 | 2209 | 1390 | 2721 | 1765 | 3233 | 3846 | 3745 | 3555 |
| 162 | 280 | 674 | 2320 | 1186 | 906 | 1698 | 963 | 2210 | 2418 | 2722 | 2831 | 3234 | 1519 | 3746 | 3487 |
| 163 | 89 | 675 | 1164 | 1187 | 1322 | 1699 | 3330 | 2211 | 1492 | 2723 | 3598 | 3235 | 2969 | 3747 | 3557 |
| 164 | 290 | 676 | 653 | 1188 | 2372 | 1700 | 1684 | 2212 | 2661 | 2724 | 1869 | 3236 | 3247 | 3748 | 3977 |
| 165 | 529 | 677 | 248 | 1189 | 715 | 1701 | 2253 | 2213 | 1679 | 2725 | 2897 | 3237 | 2549 | 3749 | 3867 |
| 166 | 2080 | 678 | 1054 | 1190 | 1424 | 1702 | 1640 | 2214 | 3233 | 2726 | 3249 | 3238 | 3195 | 3750 | 2013 |
| 167 | 524 | 679 | 2208 | 1191 | 3089 | 1703 | 2230 | 2215 | 953 | 2727 | 1944 | 3239 | 1727 | 3751 | 3003 |
| 168 | 196 | 680 | 369 | 1192 | 807 | 1704 | 747 | 2216 | 2470 | 2728 | 2868 | 3240 | 3730 | 3752 | 3545 |
| 169 | 1088 | 681 | 190 | 1193 | 1632 | 1705 | 1366 | 2217 | 1924 | 2729 | 3365 | 3241 | 2924 | 3753 | 3706 |
| 170 | 141 | 682 | 364 | 1194 | 474 | 1706 | 2691 | 2218 | 2473 | 2730 | 1003 | 3242 | 3684 | 3754 | 3816 |
| 171 | 101 | 683 | 1170 | 1195 | 2256 | 1707 | 505 | 2219 | 1829 | 2731 | 2776 | 3243 | 1959 | 3755 | 3924 |
| 172 | 147 | 684 | 654 | 1196 | 1376 | 1708 | 2610 | 2220 | 3648 | 2732 | 3460 | 3244 | 3413 | 3756 | 4032 |
| 173 | 176 | 685 | 2568 | 1197 | 636 | 1709 | 1340 | 2221 | 1639 | 2733 | 1406 | 3245 | 2895 | 3757 | 3052 |
| 174 | 142 | 686 | 659 | 1198 | 2434 | 1710 | 3098 | 2222 | 2499 | 2734 | 2976 | 3246 | 3849 | 3758 | 3937 |
| 175 | 530 | 687 | 1095 | 1199 | 1349 | 1711 | 1265 | 2223 | 2662 | 2735 | 3163 | 3247 | 3040 | 3759 | 3765 |
| 176 | 321 | 688 | 335 | 1200 | 694 | 1712 | 855 | 2224 | 763 | 2736 | 1846 | 3248 | 2002 | 3760 | 2027 |
| 177 | 31 | 689 | 480 | 1201 | 2198 | 1713 | 2334 | 2225 | 3117 | 2737 | 2839 | 3249 | 3292 | 3761 | 3869 |
| 178 | 200 | 690 | 2336 | 1202 | 1557 | 1714 | 1802 | 2226 | 1708 | 2738 | 1875 | 3250 | 3386 | 3762 | 3978 |
| 179 | 1033 | 691 | 1286 | 1203 | 254 | 1715 | 2633 | 2227 | 2591 | 2739 | 2415 | 3251 | 2495 | 3763 | 3058 |
| 180 | 90 | 692 | 315 | 1204 | 2201 | 1716 | 1587 | 2228 | 1734 | 2740 | 3656 | 3252 | 1019 | 3764 | 3787 |
| 181 | 545 | 693 | 221 | 1205 | 1179 | 1717 | 2347 | 2229 | 2283 | 2741 | 1754 | 3253 | 3496 | 3765 | 3879 |
| 182 | 292 | 694 | 1289 | 1206 | 717 | 1718 | 924 | 2230 | 1453 | 2742 | 2949 | 3254 | 3467 | 3766 | 3546 |
| 183 | 2051 | 695 | 2576 | 1207 | 2213 | 1719 | 3585 | 2231 | 3172 | 2743 | 3841 | 3255 | 2781 | 3767 | 3708 |
| 184 | 322 | 696 | 370 | 1208 | 1234 | 1720 | 1369 | 2232 | 974 | 2744 | 1522 | 3256 | 3745 | 3768 | 3766 |
| 185 | 532 | 697 | 613 | 1209 | 575 | 1721 | 734 | 2233 | 2460 | 2745 | 2678 | 3257 | 1907 | 3769 | 3005 |
| 186 | 263 | 698 | 1185 | 1210 | 1329 | 1722 | 2402 | 2234 | 1818 | 2746 | 3270 | 3258 | 2875 | 3770 | 2014 |
| 187 | 149 | 699 | 422 | 1211 | 2154 | 1723 | 1476 | 2235 | 2391 | 2747 | 1904 | 3259 | 3655 | 3771 | 3326 |
| 188 | 102 | 700 | 425 | 1212 | 913 | 1724 | 2259 | 2236 | 1276 | 2748 | 2733 | 3260 | 3427 | 3772 | 3789 |
| 189 | 105 | 701 | 2240 | 1213 | 1571 | 1725 | 1421 | 2237 | 2420 | 2749 | 3244 | 3261 | 1786 | 3773 | 3647 |
| 190 | 1030 | 702 | 1600 | 1214 | 2103 | 1726 | 2449 | 2238 | 1397 | 2750 | 990 | 3262 | 2982 | 3774 | 3985 |
| 191 | 304 | 703 | 451 | 1215 | 798 | 1727 | 829 | 2239 | 3712 | 2751 | 2892 | 3263 | 3359 | 3775 | 3870 |
| 192 | 296 | 704 | 614 | 1216 | 1324 | 1728 | 1427 | 2240 | 2823 | 2752 | 3192 | 3264 | 3255 | 3776 | 3031 |
| 193 | 163 | 705 | 1069 | 1217 | 3082 | 1729 | 2233 | 2241 | 1629 | 2753 | 1766 | 3265 | 2930 | 3777 | 3883 |
| 194 | 92 | 706 | 2592 | 1218 | 811 | 1730 | 1231 | 2242 | 2365 | 2754 | 2681 | 3266 | 1527 | 3778 | 3451 |
| 195 | 47 | 707 | 543 | 1219 | 1133 | 1731 | 3152 | 2243 | 954 | 2755 | 3273 | 3267 | 3306 | 3779 | 3769 |
| 196 | 267 | 708 | 235 | 1220 | 2376 | 1732 | 965 | 2244 | 3123 | 2756 | 1469 | 3268 | 2985 | 3780 | 3503 |
| 197 | 385 | 709 | 1124 | 1221 | 379 | 1733 | 2444 | 2245 | 1872 | 2757 | 2759 | 3269 | 3197 | 3781 | 2029 |
| 198 | 546 | 710 | 412 | 1222 | 1208 | 1734 | 1698 | 2246 | 2270 | 2758 | 3408 | 3270 | 1949 | 3782 | 3679 |
| 199 | 2053 | 711 | 2118 | 1223 | 2584 | 1735 | 2392 | 2247 | 1714 | 2759 | 1495 | 3271 | 3629 | 3783 | 3561 |
| 200 | 324 | 712 | 343 | 1224 | 697 | 1736 | 1582 | 2248 | 2474 | 2760 | 2301 | 3272 | 3011 | 3784 | 3006 |
| 201 | 1041 | 713 | 372 | 1225 | 1558 | 1737 | 938 | 2249 | 1737 | 2761 | 3134 | 3273 | 3732 | 3785 | 3938 |
| 202 | 208 | 714 | 1664 | 1226 | 431 | 1738 | 2634 | 2250 | 3220 | 2762 | 1659 | 3274 | 3688 | 3786 | 3795 |
| 203 | 386 | 715 | 775 | 1227 | 2625 | 1739 | 1809 | 2251 | 879 | 2763 | 2739 | 3275 | 1902 | 3787 | 3558 |
| 204 | 150 | 716 | 317 | 1228 | 607 | 1740 | 2693 | 2252 | 2501 | 2764 | 3354 | 3276 | 2795 | 3788 | 3980 |
| 205 | 153 | 717 | 2092 | 1229 | 489 | 1741 | 1456 | 2253 | 1656 | 2765 | 1956 | 3277 | 3414 | 3789 | 3790 |
| 206 | 165 | 718 | 1075 | 1230 | 2596 | 1742 | 3109 | 2254 | 2285 | 2766 | 2872 | 3278 | 2553 | 3790 | 3035 |
| 207 | 106 | 719 | 222 | 1231 | 1561 | 1743 | 884 | 2255 | 3118 | 2767 | 3215 | 3279 | 3388 | 3791 | 3885 |
| 208 | 55 | 720 | 426 | 1232 | 866 | 1744 | 1381 | 2256 | 1506 | 2768 | 1711 | 3280 | 1759 | 3792 | 1983 |
| 209 | 1034 | 721 | 1172 | 1233 | 2161 | 1745 | 2641 | 2257 | 2607 | 2769 | 2950 | 3281 | 3313 | 3793 | 3548 |
| 210 | 328 | 722 | 2179 | 1234 | 1139 | 1746 | 506 | 2258 | 1830 | 2770 | 3175 | 3282 | 2903 | 3794 | 3928 |
| 211 | 536 | 723 | 453 | 1235 | 723 | 1747 | 2583 | 2259 | 2881 | 2771 | 1927 | 3283 | 3850 | 3795 | 3911 |
| 212 | 577 | 724 | 237 | 1236 | 2202 | 1748 | 1211 | 2260 | 981 | 2772 | 2734 | 3284 | 2017 | 3796 | 3797 |
| 213 | 548 | 725 | 1070 | 1237 | 1191 | 1749 | 2288 | 2261 | 3147 | 2773 | 1005 | 3285 | 3635 | 3797 | 3060 |
| 214 | 2112 | 726 | 559 | 1238 | 486 | 1750 | 1260 | 2262 | 1451 | 2774 | 2788 | 3286 | 2972 | 3798 | 3770 |
| 215 | 113 | 727 | 2129 | 1239 | 2127 | 1751 | 2254 | 2263 | 2852 | 2775 | 3250 | 3287 | 3417 | 3799 | 3986 |
| 216 | 154 | 728 | 833 | 1240 | 1249 | 1752 | 749 | 2264 | 1928 | 2776 | 1849 | 3288 | 2782 | 3800 | 3824 |
| 217 | 79 | 729 | 1099 | 1241 | 908 | 1753 | 1688 | 2265 | 2760 | 2777 | 2898 | 3289 | 1909 | 3801 | 3940 |
| 218 | 269 | 730 | 804 | 1242 | 2317 | 1754 | 3097 | 2266 | 1438 | 2778 | 3366 | 3290 | 3524 | 3802 | 3891 |
| 219 | 1042 | 731 | 712 | 1243 | 1350 | 1755 | 1648 | 2267 | 3338 | 2779 | 1524 | 3291 | 3469 | 3803 | 2035 |
| 220 | 108 | 732 | 2098 | 1244 | 718 | 1756 | 2143 | 2268 | 2882 | 2780 | 2423 | 3292 | 2877 | 3804 | 3886 |
| 221 | 578 | 733 | 1290 | 1245 | 1330 | 1757 | 945 | 2269 | 982 | 2781 | 3165 | 3293 | 3475 | 3805 | 3047 |
| 222 | 224 | 734 | 834 | 1246 | 3090 | 1758 | 2375 | 2270 | 2709 | 2782 | 1870 | 3294 | 1963 | 3806 | 3511 |
| 223 | 166 | 735 | 661 | 1247 | 813 | 1759 | 1611 | 2271 | 1247 | 2783 | 2492 | 3295 | 3279 | 3807 | 4001 |
| 224 | 519 | 736 | 1297 | 1248 | 1796 | 1760 | 2612 | 2272 | 3345 | 2784 | 3716 | 3296 | 3013 | 3808 | 3562 |
| 225 | 552 | 737 | 2121 | 1249 | 2156 | 1761 | 1804 | 2273 | 1687 | 2785 | 1769 | 3297 | 3746 | 3809 | 3695 |
| 226 | 195 | 738 | 808 | 1250 | 476 | 1762 | 966 | 2274 | 2856 | 2786 | 2518 | 3298 | 2018 | 3810 | 3743 |
| 227 | 1152 | 739 | 779 | 1251 | 1181 | 1763 | 3094 | 2275 | 1716 | 2787 | 3274 | 3299 | 3630 | 3811 | 3811 |
| 228 | 270 | 740 | 1541 | 1252 | 2626 | 1764 | 1729 | 2276 | 2827 | 2788 | 1850 | 3300 | 2986 | 3812 | 3064 |
| 229 | 3072 | 741 | 617 | 1253 | 856 | 1765 | 2848 | 2277 | 1859 | 2789 | 2531 | 3301 | 3857 | 3813 | 3988 |
| 230 | 641 | 742 | 1128 | 1254 | 1680 | 1766 | 1150 | 2278 | 3589 | 2790 | 3664 | 3302 | 3504 | 3814 | 3535 |
| 231 | 523 | 743 | 2063 | 1255 | 2272 | 1767 | 2450 | 2279 | 927 | 2791 | 1756 | 3303 | 2004 | 3815 | 2037 |
| 232 | 275 | 744 | 604 | 1256 | 839 | 1768 | 755 | 2280 | 2665 | 2792 | 2463 | 3304 | 2932 | 3816 | 3915 |
| 233 | 580 | 745 | 433 | 1257 | 1353 | 1769 | 2404 | 2281 | 3176 | 2793 | 3395 | 3305 | 3429 | 3817 | 3453 |
| 234 | 291 | 746 | 1186 | 1258 | 2214 | 1770 | 1266 | 2282 | 1643 | 2794 | 1470 | 3306 | 2554 | 3818 | 3569 |
| 235 | 59 | 747 | 720 | 1259 | 725 | 1771 | 859 | 2283 | 2652 | 2795 | 2533 | 3307 | 3259 | 3819 | 2815 |
| 236 | 1036 | 748 | 2368 | 1260 | 1134 | 1772 | 2355 | 2284 | 1496 | 2796 | 3464 | 3308 | 1950 | 3820 | 4002 |
| 237 | 169 | 749 | 816 | 1261 | 2567 | 1773 | 1589 | 2285 | 2481 | 2797 | 959 | 3309 | 3308 | 3821 | 3893 |
| 238 | 560 | 750 | 1077 | 1262 | 698 | 1774 | 3208 | 2286 | 1479 | 2798 | 2953 | 3310 | 2797 | 3822 | 3798 |
| 239 | 114 | 751 | 836 | 1263 | 1141 | 1775 | 1422 | 2287 | 3234 | 2799 | 3369 | 3311 | 3736 | 3823 | 4033 |
| 240 | 277 | 752 | 347 | 1264 | 2600 | 1776 | 2349 | 2288 | 995 | 2800 | 1986 | 3312 | 3696 | 3824 | 3944 |
| 241 | 156 | 753 | 2181 | 1265 | 914 | 1777 | 940 | 2289 | 2768 | 2801 | 2843 | 3313 | 1788 | 3825 | 3564 |
| 242 | 2057 | 754 | 1217 | 1266 | 1236 | 1778 | 2465 | 2290 | 1820 | 2802 | 3842 | 3314 | 2993 | 3826 | 3703 |
| 243 | 87 | 755 | 897 | 1267 | 2243 | 1779 | 1370 | 2291 | 2864 | 2803 | 1960 | 3315 | 3659 | 3827 | 1919 |
| 244 | 197 | 756 | 243 | 1268 | 752 | 1780 | 2261 | 2292 | 1833 | 2804 | 2521 | 3316 | 3852 | 3828 | 3037 |
| 245 | 1057 | 757 | 1176 | 1269 | 1195 | 1781 | 1480 | 2293 | 3125 | 2805 | 3179 | 3317 | 3014 | 3829 | 3801 |
| 246 | 116 | 758 | 2100 | 1270 | 3200 | 1782 | 830 | 2294 | 2884 | 2806 | 1499 | 3318 | 1965 | 3830 | 3772 |
| 247 | 170 | 759 | 662 | 1271 | 868 | 1783 | 2616 | 2295 | 1738 | 2807 | 2682 | 3319 | 3777 | 3831 | 3515 |
| 248 | 61 | 760 | 454 | 1272 | 1800 | 1784 | 1382 | 2296 | 2395 | 2808 | 3252 | 3320 | 3198 | 3832 | 3813 |
| 249 | 531 | 761 | 1101 | 1273 | 2318 | 1785 | 3332 | 2297 | 1745 | 2809 | 1877 | 3321 | 2803 | 3833 | 3917 |
| 250 | 525 | 762 | 318 | 1274 | 819 | 1786 | 1429 | 2298 | 3265 | 2810 | 2792 | 3322 | 3314 | 3834 | 3992 |
| 251 | 642 | 763 | 3076 | 1275 | 1354 | 1787 | 2880 | 2299 | 765 | 2811 | 3223 | 3323 | 1991 | 3835 | 3051 |
| 252 | 281 | 764 | 675 | 1276 | 2689 | 1788 | 911 | 2300 | 2945 | 2812 | 1891 | 3324 | 2907 | 3836 | 3454 |
| 253 | 1089 | 765 | 1188 | 1277 | 814 | 1789 | 2636 | 2301 | 1861 | 2813 | 2900 | 3325 | 3637 | 3837 | 3894 |
| 254 | 278 | 766 | 618 | 1278 | 1250 | 1790 | 1327 | 2302 | 2291 | 2814 | 3281 | 3326 | 3470 | 3838 | 3923 |
| 255 | 526 | 767 | 898 | 1279 | 439 | 1791 | 1593 | 2303 | 3224 | 2815 | 3008 | 3327 | 2988 | 3839 | 3802 |
| 256 | 2054 | 768 | 2071 | 1280 | 2571 | 1792 | 2234 | 2304 | 1740 | 2816 | 1661 | 3328 | 1021 | 3840 | 2030 |
| 257 | 177 | 769 | 1792 | 1281 | 1573 | 1793 | 871 | 2305 | 2710 | 2817 | 3356 | 3329 | 3418 | 3841 | 3570 |
| 258 | 293 | 770 | 781 | 1282 | 929 | 1794 | 3336 | 2306 | 1888 | 2818 | 2913 | 3330 | 3528 | 3842 | 3952 |
| 259 | 388 | 771 | 376 | 1283 | 2323 | 1795 | 1268 | 2307 | 2502 | 2819 | 1931 | 3331 | 2878 | 3843 | 3038 |
| 260 | 91 | 772 | 2182 | 1284 | 1562 | 1796 | 2694 | 2308 | 956 | 2820 | 3720 | 3332 | 1910 | 3844 | 3814 |
| 261 | 1044 | 773 | 1292 | 1285 | 490 | 1797 | 1619 | 2309 | 3149 | 2821 | 2741 | 3333 | 3430 | 3845 | 3517 |
| 262 | 584 | 774 | 428 | 1286 | 2628 | 1798 | 2452 | 2310 | 1834 | 2822 | 1011 | 3334 | 3477 | 3846 | 3543 |
| 263 | 769 | 775 | 1298 | 1287 | 1411 | 1799 | 639 | 2311 | 2366 | 2823 | 3166 | 3335 | 2959 | 3847 | 3707 |
| 264 | 198 | 776 | 665 | 1288 | 623 | 1800 | 2275 | 2312 | 1630 | 2824 | 2845 | 3336 | 3375 | 3848 | 4004 |
| 265 | 172 | 777 | 2432 | 1289 | 2339 | 1801 | 1213 | 2313 | 2723 | 2825 | 1511 | 3337 | 1855 | 3849 | 3759 |
| 266 | 120 | 778 | 736 | 1290 | 1332 | 1802 | 1590 | 2314 | 3236 | 2826 | 3276 | 3338 | 3641 | 3850 | 3975 |
| 267 | 201 | 779 | 1542 | 1291 | 671 | 1803 | 2944 | 2315 | 1936 | 2827 | 2954 | 3339 | 2919 | 3851 | 3053 |
| 268 | 2065 | 780 | 567 | 1292 | 2107 | 1804 | 888 | 2316 | 2666 | 2828 | 1719 | 3340 | 3316 | 3852 | 3897 |
| 269 | 336 | 781 | 840 | 1293 | 1240 | 1805 | 3110 | 2317 | 1746 | 2829 | 3370 | 3341 | 3667 | 3853 | 2038 |
| 270 | 1280 | 782 | 2124 | 1294 | 739 | 1806 | 1700 | 2318 | 2946 | 2830 | 2763 | 3342 | 1971 | 3854 | 3572 |
| 271 | 62 | 783 | 1078 | 1295 | 3084 | 1807 | 2642 | 2319 | 887 | 2831 | 1770 | 3343 | 2687 | 3855 | 3918 |
| 272 | 282 | 784 | 625 | 1296 | 1440 | 1808 | 1385 | 2320 | 3840 | 2832 | 3472 | 3344 | 3261 | 3856 | 3817 |
| 273 | 143 | 785 | 238 | 1297 | 916 | 1809 | 2466 | 2321 | 1720 | 2833 | 2855 | 3345 | 3638 | 3857 | 3898 |
| 274 | 103 | 786 | 1107 | 1298 | 2217 | 1810 | 479 | 2322 | 2829 | 2834 | 1852 | 3346 | 2936 | 3858 | 3804 |
| 275 | 178 | 787 | 2185 | 1299 | 1295 | 1811 | 2350 | 2323 | 1401 | 2835 | 3680 | 3347 | 1531 | 3859 | 3518 |
| 276 | 294 | 788 | 359 | 1300 | 463 | 1812 | 1730 | 2324 | 2424 | 2836 | 2522 | 3348 | 3748 | 3860 | 3007 |
| 277 | 1058 | 789 | 457 | 1301 | 2608 | 1813 | 3586 | 2325 | 3340 | 2837 | 1777 | 3349 | 3433 | 3861 | 4034 |
| 278 | 93 | 790 | 1081 | 1302 | 1303 | 1814 | 1613 | 2326 | 1459 | 2838 | 3424 | 3350 | 2527 | 3862 | 4008 |
| 279 | 644 | 791 | 399 | 1303 | 843 | 1815 | 946 | 2327 | 2476 | 2839 | 2684 | 3351 | 3778 | 3863 | 3547 |
| 280 | 2058 | 792 | 2130 | 1304 | 2162 | 1816 | 2697 | 2328 | 1841 | 2840 | 1878 | 3352 | 1913 | 3864 | 3925 |
| 281 | 202 | 793 | 787 | 1305 | 1182 | 1817 | 1239 | 2329 | 3346 | 2841 | 3397 | 3353 | 3661 | 3865 | 3939 |
| 282 | 592 | 794 | 1545 | 1306 | 381 | 1818 | 2819 | 2330 | 985 | 2842 | 2742 | 3354 | 2994 | 3866 | 2041 |
| 283 | 323 | 795 | 591 | 1307 | 2325 | 1819 | 750 | 2331 | 2713 | 2843 | 1881 | 3355 | 3287 | 3867 | 3709 |
| 284 | 1048 | 796 | 1136 | 1308 | 1361 | 1820 | 2408 | 2332 | 1343 | 2844 | 3605 | 3356 | 2798 | 3868 | 3979 |
| 285 | 392 | 797 | 2104 | 1309 | 497 | 1821 | 1810 | 2333 | 2784 | 2845 | 2302 | 3357 | 3858 | 3869 | 3059 |
| 286 | 297 | 798 | 678 | 1310 | 2204 | 1822 | 2587 | 2334 | 3590 | 2846 | 1013 | 3358 | 2008 | 3870 | 3559 |
| 287 | 770 | 799 | 434 | 1311 | 1574 | 1823 | 1671 | 2335 | 1645 | 2847 | 3227 | 3359 | 3719 | 3871 | 3767 |
| 288 | 107 | 800 | 1159 | 1312 | 930 | 1824 | 3168 | 2336 | 2615 | 2848 | 2765 | 3360 | 3017 | 3872 | 3818 |
| 289 | 180 | 801 | 2075 | 1313 | 2135 | 1825 | 969 | 2337 | 1836 | 2849 | 1528 | 3361 | 3420 | 3873 | 3900 |
| 290 | 151 | 802 | 677 | 1314 | 1696 | 1826 | 2159 | 2338 | 2888 | 2850 | 3282 | 3362 | 3491 | 3874 | 3825 |
| 291 | 1060 | 803 | 349 | 1315 | 821 | 1827 | 1372 | 2339 | 997 | 2851 | 2623 | 3363 | 1775 | 3875 | 3926 |
| 292 | 2066 | 804 | 1102 | 1316 | 2245 | 1828 | 1443 | 2340 | 3126 | 2852 | 3377 | 3364 | 2556 | 3876 | 3929 |
| 293 | 209 | 805 | 245 | 1317 | 1142 | 1829 | 2379 | 2341 | 1508 | 2853 | 1823 | 3365 | 3478 | 3877 | 3061 |
| 294 | 284 | 806 | 2145 | 1318 | 726 | 1830 | 508 | 2342 | 2673 | 2854 | 2961 | 3366 | 3536 | 3878 | 3576 |
| 295 | 648 | 807 | 458 | 1319 | 3105 | 1831 | 2262 | 2343 | 2286 | 2855 | 3619 | 3367 | 2909 | 3879 | 3871 |
| 296 | 94 | 808 | 1313 | 1320 | 1356 | 1832 | 1430 | 2344 | 1454 | 2856 | 1279 | 3368 | 1966 | 3880 | 3327 |
| 297 | 204 | 809 | 666 | 1321 | 1603 | 1833 | 3139 | 2345 | 3155 | 2857 | 2846 | 3369 | 3752 | 3881 | 2042 |
| 298 | 298 | 810 | 1218 | 1322 | 2164 | 1834 | 1488 | 2346 | 1862 | 2858 | 3372 | 3370 | 3873 | 3882 | 4036 |
| 299 | 1031 | 811 | 2087 | 1323 | 961 | 1835 | 2357 | 2347 | 2407 | 2859 | 1988 | 3371 | 2805 | 3883 | 3981 |
| 300 | 400 | 812 | 620 | 1324 | 2218 | 1836 | 861 | 2348 | 1691 | 2860 | 2859 | 3372 | 3434 | 3884 | 3791 |
| 301 | 608 | 813 | 363 | 1325 | 1564 | 1837 | 2236 | 2349 | 2505 | 2861 | 3181 | 3373 | 2020 | 3885 | 3549 |
| 302 | 352 | 814 | 1109 | 1326 | 872 | 1838 | 1704 | 2350 | 986 | 2862 | 1933 | 3374 | 3662 | 3886 | 3987 |
| 303 | 2176 | 815 | 2307 | 1327 | 2109 | 1839 | 2497 | 2351 | 3129 | 2863 | 2427 | 3375 | 3018 | 3887 | 2943 |
| 304 | 325 | 816 | 127 | 1328 | 1413 | 1840 | 1825 | 2352 | 2447 | 2864 | 3256 | 3376 | 3481 | 3888 | 3710 |
| 305 | 533 | 817 | 191 | 1329 | 492 | 1841 | 757 | 2353 | 1512 | 2865 | 1743 | 3377 | 3642 | 3889 | 3820 |
| 306 | 1153 | 818 | 1300 | 1330 | 2579 | 1842 | 3113 | 2354 | 2835 | 2866 | 2745 | 3378 | 1995 | 3890 | 4016 |
| 307 | 155 | 819 | 782 | 1331 | 1197 | 1843 | 1386 | 2355 | 1263 | 2867 | 3606 | 3379 | 2967 | 3891 | 3941 |
| 308 | 210 | 820 | 2132 | 1332 | 631 | 1844 | 2265 | 2356 | 3593 | 2868 | 1501 | 3380 | 3860 | 3892 | 3563 |
| 309 | 305 | 821 | 1546 | 1333 | 2573 | 1845 | 1614 | 2357 | 1402 | 2869 | 2479 | 3381 | 3669 | 3893 | 3771 |
| 310 | 547 | 822 | 407 | 1334 | 1145 | 1846 | 2456 | 2358 | 2639 | 2870 | 2655 | 3382 | 3644 | 3894 | 3826 |
| 311 | 300 | 823 | 436 | 1335 | 729 | 1847 | 970 | 2359 | 3184 | 2871 | 2537 | 3383 | 2923 | 3895 | 3930 |
| 312 | 1090 | 824 | 1082 | 1336 | 2690 | 1848 | 2657 | 2360 | 1483 | 2872 | 1939 | 3384 | 1914 | 3896 | 2015 |
| 313 | 109 | 825 | 2186 | 1337 | 1577 | 1849 | 1433 | 2361 | 2726 | 2873 | 3609 | 3385 | 3291 | 3897 | 3054 |
| 314 | 2060 | 826 | 626 | 1338 | 700 | 1850 | 2644 | 2362 | 943 | 2874 | 2914 | 3386 | 3383 | 3898 | 3550 |
| 315 | 184 | 827 | 571 | 1339 | 2329 | 1851 | 1594 | 2363 | 2482 | 2875 | 895 | 3387 | 2910 | 3899 | 4040 |
| 316 | 534 | 828 | 1192 | 1340 | 1223 | 1852 | 3216 | 2364 | 1646 | 2876 | 3187 | 3388 | 3780 | 3900 | 3455 |
| 317 | 537 | 829 | 2193 | 1341 | 443 | 1853 | 919 | 2365 | 3207 | 2877 | 2771 | 3389 | 1533 | 3901 | 3982 |
| 318 | 115 | 830 | 465 | 1342 | 3137 | 1854 | 2599 | 2366 | 1651 | 2878 | 1662 | 3390 | 3670 | 3902 | 3887 |
| 319 | 167 | 831 | 1163 | 1343 | 1808 | 1855 | 1812 | 2367 | 2725 | 2879 | 3239 | 3391 | 2806 | 3903 | 4048 |
| 320 | 1536 | 832 | 681 | 1344 | 741 | 1856 | 1621 | 2368 | 2397 | 2880 | 2534 | 3392 | 3673 | 3904 | 3942 |
| 321 | 225 | 833 | 246 | 1345 | 2326 | 1857 | 2698 | 2369 | 1461 | 2881 | 1772 | 3393 | 3723 | 3905 | 3989 |
| 322 | 326 | 834 | 2309 | 1346 | 1203 | 1858 | 1596 | 2370 | 3150 | 2882 | 3297 | 3394 | 1973 | 3906 | 3062 |
| 323 | 306 | 835 | 1123 | 1347 | 845 | 1859 | 2277 | 2371 | 1404 | 2883 | 2956 | 3395 | 2996 | 3907 | 3799 |
| 324 | 772 | 836 | 707 | 1348 | 2574 | 1860 | 875 | 2372 | 2293 | 2884 | 1968 | 3396 | 3493 | 3908 | 3565 |
| 325 | 2081 | 837 | 350 | 1349 | 1252 | 1861 | 3100 | 2373 | 891 | 2885 | 3398 | 3397 | 3864 | 3909 | 3945 |
| 326 | 157 | 838 | 3080 | 1350 | 920 | 1862 | 1243 | 2374 | 2506 | 2886 | 2766 | 3398 | 3025 | 3910 | 3773 |
| 327 | 1035 | 839 | 1110 | 1351 | 2225 | 1863 | 2207 | 2375 | 3361 | 2887 | 3378 | 3399 | 3874 | 3911 | 4003 |
| 328 | 656 | 840 | 599 | 1352 | 1362 | 1864 | 1335 | 2376 | 1842 | 2888 | 1893 | 3400 | 1997 | 3912 | 2044 |
| 329 | 329 | 841 | 1084 | 1353 | 382 | 1865 | 2468 | 2377 | 2714 | 2889 | 2861 | 3401 | 3683 | 3913 | 3828 |
| 330 | 110 | 842 | 668 | 1354 | 2341 | 1866 | 862 | 2378 | 1485 | 2890 | 3844 | 3402 | 2971 | 3914 | 3932 |
| 331 | 117 | 843 | 2077 | 1355 | 1336 | 1867 | 2358 | 2379 | 3266 | 2891 | 1515 | 3403 | 3674 | 3915 | 3571 |
| 332 | 212 | 844 | 790 | 1356 | 822 | 1868 | 1732 | 2380 | 1520 | 2892 | 2524 | 3404 | 3482 | 3916 | 3803 |
| 333 | 1064 | 845 | 1304 | 1357 | 2436 | 1869 | 3141 | 2381 | 2668 | 2893 | 3229 | 3405 | 2024 | 3917 | 3065 |
| 334 | 171 | 846 | 460 | 1358 | 1728 | 1870 | 1622 | 2382 | 1693 | 2894 | 1723 | 3406 | 3020 | 3918 | 3895 |
| 335 | 2113 | 847 | 2091 | 1359 | 2139 | 1871 | 2589 | 2383 | 2411 | 2895 | 2904 | 3407 | 3303 | 3919 | 3994 |
| 336 | 776 | 848 | 249 | 1360 | 1414 | 1872 | 758 | 2384 | 3157 | 2896 | 3728 | 3408 | 3760 | 3920 | 3946 |
| 337 | 330 | 849 | 1113 | 1361 | 851 | 1873 | 1625 | 2385 | 998 | 2897 | 1778 | 3409 | 2809 | 3921 | 3990 |
| 338 | 226 | 850 | 682 | 1362 | 3092 | 1874 | 2821 | 2386 | 2175 | 2898 | 2887 | 3410 | 1916 | 3922 | 3574 |
| 339 | 549 | 851 | 1314 | 1363 | 1198 | 1875 | 1675 | 2387 | 1703 | 2899 | 3401 | 3411 | 3725 | 3923 | 4005 |
| 340 | 1092 | 852 | 2146 | 1364 | 730 | 1876 | 2658 | 2388 | 2239 | 2900 | 1882 | 3412 | 3320 | 3924 | 3815 |
| 341 | 538 | 853 | 573 | 1365 | 2632 | 1877 | 948 | 2389 | 1748 | 2901 | 2773 | 3413 | 2925 | 3925 | 3832 |
| 342 | 387 | 854 | 411 | 1366 | 1578 | 1878 | 3114 | 2390 | 3348 | 2902 | 3182 | 3414 | 3441 | 3926 | 3953 |
| 343 | 308 | 855 | 1553 | 1367 | 498 | 1879 | 1445 | 2391 | 2830 | 2903 | 2746 | 3415 | 3262 | 3927 | 3066 |
| 344 | 216 | 856 | 2563 | 1368 | 2817 | 1880 | 2705 | 2392 | 1865 | 2904 | 1006 | 3416 | 1974 | 3928 | 3566 |
| 345 | 2068 | 857 | 803 | 1369 | 1605 | 1881 | 1816 | 2393 | 3594 | 2905 | 3189 | 3417 | 3436 | 3929 | 2031 |
| 346 | 1154 | 858 | 789 | 1370 | 880 | 1882 | 2381 | 2394 | 766 | 2906 | 2962 | 3418 | 3000 | 3930 | 3774 |
| 347 | 416 | 859 | 1548 | 1371 | 2246 | 1883 | 977 | 2395 | 2455 | 2907 | 1502 | 3419 | 3726 | 3931 | 3993 |
| 348 | 271 | 860 | 709 | 1372 | 1417 | 1884 | 2167 | 2396 | 1653 | 2908 | 3284 | 3420 | 3731 | 3932 | 3573 |
| 349 | 279 | 861 | 2136 | 1373 | 742 | 1885 | 1826 | 2397 | 2484 | 2909 | 2800 | 3421 | 1887 | 3933 | 3948 |
| 350 | 158 | 862 | 1220 | 1374 | 2220 | 1886 | 3588 | 2398 | 3130 | 2910 | 1992 | 3422 | 2543 | 3934 | 3919 |
| 351 | 337 | 863 | 365 | 1375 | 1307 | 1887 | 1635 | 2399 | 1375 | 2911 | 3243 | 3423 | 3407 | 3935 | 4064 |
| 352 | 1043 | 864 | 440 | 1376 | 445 | 1888 | 2648 | 2400 | 2674 | 2912 | 2916 | 3424 | 3552 | 3936 | 3519 |
| 353 | 550 | 865 | 2188 | 1377 | 2168 | 1889 | 923 | 2401 | 1491 | 2913 | 3848 | 3425 | 2751 | 3937 | 3805 |
| 354 | 672 | 866 | 1165 | 1378 | 1146 | 1890 | 2387 | 2402 | 2619 | 2914 | 1407 | 3426 | 3387 | 3938 | 3899 |
| 355 | 2304 | 867 | 628 | 1379 | 2249 | 1891 | 1626 | 2403 | 1462 | 2915 | 2867 | 3427 | 1783 | 3939 | 3039 |
| 356 | 118 | 868 | 1125 | 1380 | 471 | 1892 | 2266 | 2404 | 3240 | 2916 | 3402 | 3428 | 3293 | 3940 | 4006 |
| 357 | 332 | 869 | 689 | 1381 | 1472 | 1893 | 1434 | 2405 | 2513 | 2917 | 1934 | 3429 | 2983 | 3941 | 3954 |
| 358 | 579 | 870 | 2078 | 1382 | 2384 | 1894 | 972 | 2406 | 511 | 2918 | 2862 | 3430 | 3442 | 3942 | 4009 |
| 359 | 1037 | 871 | 374 | 1383 | 1377 | 1895 | 3121 | 2407 | 3211 | 2919 | 3298 | 3431 | 3685 | 3943 | 4035 |
| 360 | 540 | 872 | 1171 | 1384 | 635 | 1896 | 1255 | 2408 | 1761 | 2920 | 1839 | 3432 | 3026 | 3944 | 3819 |
| 361 | 389 | 873 | 423 | 1385 | 3328 | 1897 | 2416 | 2409 | 2729 | 2921 | 2487 | 3433 | 1022 | 3945 | 3577 |
| 362 | 173 | 874 | 2194 | 1386 | 1585 | 1898 | 1712 | 2410 | 1275 | 2922 | 3621 | 3434 | 3494 | 3946 | 3927 |
| 363 | 121 | 875 | 466 | 1387 | 932 | 1899 | 2700 | 2411 | 2294 | 2923 | 2000 | 3435 | 3497 | 3947 | 2039 |
| 364 | 1072 | 876 | 1200 | 1388 | 2110 | 1900 | 761 | 2412 | 3171 | 2924 | 2977 | 3436 | 3523 | 3948 | 3996 |
| 365 | 2082 | 877 | 793 | 1389 | 1227 | 1901 | 2278 | 2413 | 1486 | 2925 | 3610 | 3437 | 2931 | 3949 | 3806 |
| 366 | 553 | 878 | 2119 | 1390 | 687 | 1902 | 1677 | 2414 | 2755 | 2926 | 2538 | 3438 | 2032 | 3950 | 3901 |
| 367 | 199 | 879 | 1166 | 1391 | 2330 | 1903 | 3146 | 2415 | 1466 | 2927 | 1894 | 3439 | 3686 | 3951 | 3068 |
| 368 | 784 | 880 | 250 | 1392 | 1087 | 1904 | 1272 | 2416 | 2398 | 2928 | 3459 | 3440 | 3615 | 3952 | 4037 |
| 369 | 179 | 881 | 371 | 1393 | 903 | 1905 | 2439 | 2417 | 1465 | 2929 | 2671 | 3441 | 2810 | 3953 | 4010 |
| 370 | 1038 | 882 | 1554 | 1394 | 2191 | 1906 | 877 | 2418 | 3158 | 2930 | 1941 | 3442 | 3307 | 3954 | 3956 |
| 371 | 228 | 883 | 2310 | 1395 | 1364 | 1907 | 2361 | 2419 | 2647 | 2931 | 3380 | 3443 | 3484 | 3955 | 3578 |
| 372 | 338 | 884 | 481 | 1396 | 2151 | 1908 | 1393 | 2420 | 988 | 2932 | 2719 | 3444 | 1534 | 3956 | 3821 |
| 373 | 312 | 885 | 1345 | 1397 | 825 | 1909 | 2498 | 2421 | 3132 | 2933 | 1014 | 3445 | 2551 | 3957 | 4017 |
| 374 | 2072 | 886 | 574 | 1398 | 1418 | 1910 | 1214 | 2422 | 1493 | 2934 | 3288 | 3446 | 3415 | 3958 | 4038 |
| 375 | 704 | 887 | 2313 | 1399 | 2226 | 1911 | 3344 | 2423 | 2716 | 2935 | 2787 | 3447 | 3444 | 3959 | 3827 |
| 376 | 390 | 888 | 413 | 1400 | 500 | 1912 | 1388 | 2424 | 1271 | 2936 | 3488 | 3448 | 2973 | 3960 | 3931 |
| 377 | 1096 | 889 | 1055 | 1401 | 1551 | 1913 | 2590 | 2425 | 2838 | 2937 | 1751 | 3449 | 3847 | 3961 | 4012 |
| 378 | 174 | 890 | 603 | 1402 | 2342 | 1914 | 952 | 2426 | 3352 | 2938 | 2964 | 3450 | 2003 | 3962 | 3902 |
| 379 | 554 | 891 | 2209 | 1403 | 1606 | 1915 | 2382 | 2427 | 1707 | 2939 | 3343 | 3451 | 3389 | 3963 | 3983 |
| 380 | 581 | 892 | 1224 | 1404 | 846 | 1916 | 1678 | 2428 | 2508 | 2940 | 1517 | 3452 | 3294 | 3964 | 3055 |
| 381 | 393 | 893 | 366 | 1405 | 3106 | 1917 | 2281 | 2429 | 1866 | 2941 | 2511 | 3453 | 2926 | 3965 | 3943 |
| 382 | 1281 | 894 | 468 | 1406 | 1580 | 1918 | 1683 | 2430 | 2297 | 2942 | 3351 | 3454 | 3498 | 3966 | 3711 |
| 383 | 283 | 895 | 1114 | 1407 | 745 | 1919 | 495 | 2431 | 3161 | 2943 | 2891 | 3455 | 3525 | 3967 | 3960 |
| 384 | 2084 | 896 | 2624 | 1408 | 2141 | 1920 | 3232 | 2432 | 1001 | 2944 | 1897 | 3456 | 1977 | 3968 | 2043 |
| 385 | 122 | 897 | 655 | 1409 | 1205 | 1921 | 1359 | 2433 | 2730 | 2945 | 3230 | 3457 | 2783 | 3969 | 3551 |
| 386 | 448 | 898 | 1569 | 1410 | 2692 | 1922 | 2603 | 2434 | 1762 | 2946 | 2429 | 3458 | 3309 | 3970 | 4018 |
| 387 | 353 | 899 | 900 | 1411 | 826 | 1923 | 1504 | 2435 | 3362 | 2947 | 1725 | 3459 | 3631 | 3971 | 3822 |
| 388 | 1045 | 900 | 2093 | 1412 | 1319 | 1924 | 2822 | 2436 | 1923 | 2948 | 3409 | 3460 | 3905 | 3972 | 4041 |
| 389 | 561 | 901 | 805 | 1413 | 2250 | 1925 | 703 | 2437 | 2621 | 2949 | 2545 | 3461 | 1787 | 3973 | 3580 |
| 390 | 203 | 902 | 1316 | 1414 | 732 | 1926 | 2223 | 2438 | 2459 | 2950 | 1955 | 3462 | 3041 | 3974 | 3933 |
| 391 | 63 | 903 | 615 | 1415 | 1309 | 1927 | 1339 | 2439 | 1694 | 2951 | 3622 | 3463 | 3876 | 3975 | 3829 |
| 392 | 340 | 904 | 3088 | 1416 | 2640 | 1928 | 3592 | 2440 | 3601 | 2952 | 2978 | 3464 | 3784 | 3976 | 4042 |
| 393 | 2055 | 905 | 1346 | 1417 | 446 | 1929 | 1245 | 2441 | 1807 | 2953 | 3744 | 3465 | 2933 | 3977 | 3991 |
| 394 | 1156 | 906 | 684 | 1418 | 1256 | 1930 | 2171 | 2442 | 2851 | 2954 | 1780 | 3466 | 3906 | 3978 | 3063 |
| 395 | 394 | 907 | 710 | 1419 | 2371 | 1931 | 935 | 2443 | 951 | 2955 | 2869 | 3467 | 1998 | 3979 | 3947 |
| 396 | 527 | 908 | 2148 | 1420 | 1148 | 1932 | 2706 | 2444 | 2837 | 2956 | 3190 | 3468 | 3733 | 3980 | 3934 |
| 397 | 582 | 909 | 1556 | 1421 | 3096 | 1933 | 1394 | 2445 | 3596 | 2957 | 1884 | 3469 | 2987 | 3981 | 3830 |
| 398 | 556 | 910 | 429 | 1422 | 962 | 1934 | 2660 | 2446 | 1873 | 2958 | 2774 | 3470 | 3880 | 3982 | 4020 |
| 399 | 181 | 911 | 1287 | 1423 | 1229 | 1935 | 1637 | 2447 | 2757 | 2959 | 3404 | 3471 | 3851 | 3983 | 4049 |
| 400 | 1059 | 912 | 2688 | 1424 | 2440 | 1936 | 3360 | 2448 | 1844 | 2960 | 1523 | 3472 | 3689 | 3984 | 3995 |
| 401 | 2177 | 913 | 794 | 1425 | 936 | 1937 | 978 | 2449 | 3268 | 2961 | 3651 | 3473 | 1978 | 3985 | 4044 |
| 402 | 295 | 914 | 252 | 1426 | 1206 | 1938 | 2389 | 2450 | 2413 | 2962 | 3009 | 3474 | 3042 | 3986 | 3833 |
| 403 | 285 | 915 | 1173 | 1427 | 2345 | 1939 | 1446 | 2451 | 1752 | 2963 | 3612 | 3475 | 3676 | 3987 | 3949 |
| 404 | 232 | 916 | 373 | 1428 | 475 | 1940 | 2825 | 2452 | 2488 | 2964 | 1755 | 3476 | 3505 | 3988 | 4024 |
| 405 | 124 | 917 | 2099 | 1429 | 1667 | 1941 | 1449 | 2453 | 1952 | 2965 | 2920 | 3477 | 3028 | 3989 | 3567 |
| 406 | 1282 | 918 | 1126 | 1430 | 2818 | 1942 | 2268 | 2454 | 3213 | 2966 | 3461 | 3478 | 3792 | 3990 | 2045 |
| 407 | 205 | 919 | 605 | 1431 | 853 | 1943 | 1475 | 2455 | 1002 | 2967 | 1017 | 3479 | 1903 | 3991 | 3775 |
| 408 | 182 | 920 | 848 | 1432 | 2155 | 1944 | 3600 | 2456 | 2676 | 2968 | 2540 | 3480 | 3888 | 3992 | 4007 |
| 409 | 643 | 921 | 2196 | 1433 | 1586 | 1945 | 883 | 2457 | 3173 | 2969 | 3245 | 3481 | 3908 | 3993 | 4050 |
| 410 | 2114 | 922 | 1129 | 1434 | 867 | 1946 | 2362 | 2458 | 1815 | 2970 | 2679 | 3482 | 2974 | 3994 | 3067 |
| 411 | 562 | 923 | 690 | 1435 | 2228 | 1947 | 1638 | 2459 | 2737 | 2971 | 1847 | 3483 | 3419 | 3995 | 3955 |
| 412 | 1050 | 924 | 1328 | 1436 | 1310 | 1948 | 2472 | 2460 | 1391 | 2972 | 3193 | 3484 | 3969 | 3996 | 3834 |
| 413 | 286 | 925 | 2094 | 1437 | 1609 | 1949 | 1567 | 2461 | 2422 | 2973 | 2777 | 3485 | 2005 | 3997 | 3575 |
| 414 | 585 | 926 | 713 | 1438 | 2199 | 1950 | 2443 | 2462 | 3219 | 2974 | 1946 | 3486 | 2812 | 3998 | 3997 |
| 415 | 299 | 927 | 1320 | 1439 | 637 | 1951 | 762 | 2463 | 1925 | 2975 | 3625 | 3487 | 3315 | 3999 | 3950 |
| 416 | 1537 | 928 | 632 | 1440 | 1323 | 1952 | 3264 | 2464 | 2471 | 2976 | 2748 | 3488 | 3734 | 4000 | 3807 |
| 417 | 354 | 929 | 2123 | 1441 | 3108 | 1953 | 1259 | 2465 | 1654 | 2977 | 3271 | 3489 | 3526 | 4001 | 4065 |
| 418 | 211 | 930 | 482 | 1442 | 907 | 1954 | 2721 | 2466 | 2514 | 2978 | 1898 | 3490 | 2989 | 4002 | 3957 |
| 419 | 2560 | 931 | 1187 | 1443 | 2257 | 1955 | 1436 | 2467 | 1709 | 2979 | 2491 | 3491 | 2006 | 4003 | 4011 |
| 420 | 401 | 932 | 806 | 1444 | 1378 | 1956 | 2631 | 2468 | 3248 | 2980 | 3856 | 3492 | 3390 | 4004 | 4066 |
| 421 | 185 | 933 | 2314 | 1445 | 487 | 1957 | 503 | 2469 | 2841 | 2981 | 1942 | 3493 | 3747 | 4005 | 4052 |
| 422 | 1104 | 934 | 1116 | 1446 | 2332 | 1958 | 2403 | 2470 | 893 | 2982 | 2789 | 3494 | 3015 | 4006 | 3998 |
| 423 | 396 | 935 | 427 | 1447 | 1235 | 1959 | 1367 | 2471 | 3214 | 2983 | 3251 | 3495 | 3690 | 4007 | 3836 |
| 424 | 344 | 936 | 904 | 1448 | 695 | 1960 | 3616 | 2472 | 1868 | 2984 | 2893 | 3496 | 3970 | 4008 | 4013 |
| 425 | 586 | 937 | 2321 | 1449 | 2696 | 1961 | 1396 | 2473 | 2298 | 2985 | 1526 | 3497 | 1951 | 4009 | 4039 |
| 426 | 645 | 938 | 1071 | 1450 | 1425 | 1962 | 2335 | 2474 | 2419 | 2986 | 3300 | 3498 | 3853 | 4010 | 3069 |
| 427 | 2059 | 939 | 414 | 1451 | 2142 | 1963 | 925 | 2475 | 1657 | 2987 | 2968 | 3499 | 2934 | 4011 | 3958 |
| 428 | 1061 | 940 | 1291 | 1452 | 1209 | 1964 | 2231 | 2476 | 3602 | 2988 | 1957 | 3500 | 3448 | 4012 | 3903 |
| 429 | 593 | 941 | 2565 | 1453 | 746 | 1965 | 1799 | 2477 | 1735 | 2989 | 3410 | 3501 | 3500 | 4013 | 4019 |
| 430 | 535 | 942 | 223 | 1454 | 2252 | 1966 | 2282 | 2478 | 2529 | 2990 | 2430 | 3502 | 2879 | 4014 | 3579 |
| 431 | 240 | 943 | 663 | 1455 | 1420 | 1967 | 1341 | 2479 | 3393 | 2991 | 3384 | 3503 | 3737 | 4015 | 3961 |
| 432 | 206 | 944 | 1409 | 1456 | 828 | 1968 | 3142 | 2480 | 1277 | 2992 | 1767 | 3504 | 2019 | 4016 | 2046 |
| 433 | 1049 | 945 | 2152 | 1457 | 2346 | 1969 | 1246 | 2481 | 2622 | 2993 | 2870 | 3505 | 3808 | 4017 | 4056 |
| 434 | 95 | 946 | 692 | 1458 | 1368 | 1970 | 2173 | 2482 | 975 | 2994 | 3776 | 3506 | 3639 | 4018 | 3823 |
| 435 | 2088 | 947 | 1570 | 1459 | 3079 | 1971 | 878 | 2483 | 2461 | 2995 | 1784 | 3507 | 2995 | 4019 | 4014 |
| 436 | 327 | 948 | 835 | 1460 | 753 | 1972 | 2605 | 2484 | 1715 | 2996 | 3462 | 3508 | 3912 | 4020 | 4068 |
| 437 | 564 | 949 | 2210 | 1461 | 1610 | 1973 | 1450 | 2485 | 3103 | 2997 | 2899 | 3509 | 3697 | 4021 | 4043 |
| 438 | 1046 | 950 | 1348 | 1462 | 2448 | 1974 | 2708 | 2486 | 2651 | 2998 | 3246 | 3510 | 1789 | 4022 | 3962 |
| 439 | 800 | 951 | 619 | 1463 | 854 | 1975 | 1477 | 2487 | 1848 | 2999 | 1905 | 3511 | 2555 | 4023 | 3581 |
| 440 | 402 | 952 | 472 | 1464 | 1669 | 1976 | 3116 | 2488 | 3272 | 3000 | 2778 | 3512 | 3310 | 4024 | 4021 |
| 441 | 356 | 953 | 2101 | 1465 | 2656 | 1977 | 735 | 2489 | 1926 | 3001 | 3626 | 3513 | 3431 | 4025 | 4045 |
| 442 | 307 | 954 | 1232 | 1466 | 1617 | 1978 | 2664 | 2490 | 2414 | 3002 | 1018 | 3514 | 3529 | 4026 | 4072 |
| 443 | 2116 | 955 | 455 | 1467 | 2400 | 1979 | 1261 | 2491 | 2516 | 3003 | 2546 | 3515 | 2937 | 4027 | 3964 |
| 444 | 1160 | 956 | 1410 | 1468 | 857 | 1980 | 2390 | 2492 | 1710 | 3004 | 3653 | 3516 | 1980 | 4028 | 4022 |
| 445 | 301 | 957 | 2241 | 1469 | 1559 | 1981 | 1583 | 2493 | 3162 | 3005 | 2928 | 3517 | 3471 | 4029 | 3935 |
| 446 | 417 | 958 | 796 | 1470 | 2373 | 1982 | 2364 | 2494 | 894 | 3006 | 1518 | 3518 | 3859 | 4030 | 3831 |
| 447 | 213 | 959 | 809 | 1471 | 504 | 1983 | 1857 | 2495 | 2703 | 3007 | 3465 | 3519 | 3663 | 4031 | 3070 |
| 448 | 568 | 960 | 1174 | 1472 | 1264 | 1984 | 3203 | 2496 | 3617 | 3008 | 2790 | 3520 | 3032 | 4032 | 4080 |
| 449 | 1284 | 961 | 3104 | 1473 | 2581 | 1985 | 993 | 2497 | 1764 | 3009 | 1726 | 3521 | 3750 | 4033 | 3582 |
| 450 | 832 | 962 | 714 | 1474 | 799 | 1986 | 2289 | 2498 | 2948 | 3010 | 3355 | 3522 | 3506 | 4034 | 4051 |
| 451 | 2178 | 963 | 1177 | 1475 | 3201 | 1987 | 1828 | 2499 | 1874 | 3011 | 2493 | 3523 | 1911 | 4035 | 4025 |
| 452 | 588 | 964 | 721 | 1476 | 1230 | 1988 | 2826 | 2500 | 2853 | 3012 | 3194 | 3524 | 2799 | 4036 | 3835 |
| 453 | 186 | 965 | 2200 | 1477 | 1119 | 1989 | 1736 | 2501 | 3364 | 3013 | 1945 | 3525 | 3749 | 4037 | 4046 |
| 454 | 1288 | 966 | 1189 | 1478 | 2203 | 1990 | 3153 | 2502 | 1399 | 3014 | 2519 | 3526 | 3421 | 4038 | 4026 |
| 455 | 646 | 967 | 837 | 1479 | 255 | 1991 | 885 | 2503 | 2663 | 3015 | 3520 | 3527 | 3317 | 4039 | 3951 |
| 456 | 404 | 968 | 716 | 1480 | 1351 | 1992 | 2611 | 2504 | 1468 | 3016 | 1525 | 3528 | 2990 | 4040 | 4053 |
| 457 | 227 | 969 | 2125 | 1481 | 2258 | 1993 | 1858 | 2505 | 3394 | 3017 | 3425 | 3529 | 2009 | 4041 | 4054 |
| 458 | 896 | 970 | 1130 | 1482 | 964 | 1994 | 2393 | 2506 | 2732 | 3018 | 2683 | 3530 | 3530 | 4042 | 3999 |
| 459 | 2067 | 971 | 864 | 1483 | 2353 | 1995 | 1685 | 2507 | 1494 | 3019 | 3633 | 3531 | 3738 | 4043 | 4067 |
| 460 | 1062 | 972 | 1079 | 1484 | 1588 | 1996 | 2500 | 2508 | 2758 | 3020 | 1900 | 3532 | 3692 | 4044 | 3837 |
| 461 | 594 | 973 | 2212 | 1485 | 909 | 1997 | 939 | 2509 | 1009 | 3021 | 2980 | 3533 | 3044 | 4045 | 4028 |
| 462 | 418 | 974 | 810 | 1486 | 2595 | 1998 | 3122 | 2510 | 3604 | 3022 | 3275 | 3534 | 3435 | 4046 | 3959 |
| 463 | 302 | 975 | 1352 | 1487 | 1824 | 1999 | 1832 | 2511 | 2477 | 3023 | 2735 | 3535 | 3199 | 4047 | 4057 |
| 464 | 1538 | 976 | 606 | 1488 | 719 | 2000 | 2445 | 2512 | 1507 | 3024 | 1871 | 3536 | 2021 | 4048 | 4069 |
| 465 | 649 | 977 | 2816 | 1489 | 2348 | 2001 | 1803 | 2513 | 3335 | 3025 | 3135 | 3537 | 3263 | 4049 | 2047 |
| 466 | 771 | 978 | 912 | 1490 | 1426 | 2002 | 2451 | 2514 | 1439 | 3026 | 2951 | 3538 | 3019 | 4050 | 4058 |
| 467 | 2061 | 979 | 1560 | 1491 | 3138 | 2003 | 1641 | 2515 | 2842 | 3027 | 2016 | 3539 | 3854 | 4051 | 4015 |
| 468 | 360 | 980 | 722 | 1492 | 1380 | 2004 | 2255 | 2516 | 2300 | 3028 | 3412 | 3540 | 3479 | 4052 | 3963 |
| 469 | 539 | 981 | 2316 | 1493 | 477 | 2005 | 994 | 2517 | 1509 | 3029 | 2873 | 3541 | 2938 | 4053 | 4070 |
| 470 | 1120 | 982 | 1601 | 1494 | 2157 | 2006 | 3145 | 2518 | 3221 | 3030 | 3466 | 3542 | 2010 | 4054 | 3838 |
| 471 | 111 | 983 | 696 | 1495 | 1331 | 2007 | 1628 | 2519 | 1929 | 3031 | 1471 | 3543 | 3508 | 4055 | 3583 |
| 472 | 331 | 984 | 1572 | 1496 | 915 | 2008 | 2722 | 2520 | 2421 | 3032 | 2548 | 3544 | 3698 | 4056 | 3071 |
| 473 | 214 | 985 | 2322 | 1497 | 2232 | 2009 | 1457 | 2521 | 3174 | 3033 | 3599 | 3545 | 3643 | 4057 | 4060 |
| 474 | 1091 | 986 | 377 | 1498 | 1325 | 2010 | 2606 | 2522 | 1819 | 3034 | 1757 | 3546 | 2557 | 4058 | 4073 |
| 475 | 2096 | 987 | 435 | 1499 | 2582 | 2011 | 980 | 2523 | 2653 | 3035 | 3654 | 3547 | 3537 | 4059 | 4023 |
| 476 | 309 | 988 | 1137 | 1500 | 638 | 2012 | 3087 | 2524 | 955 | 3036 | 2894 | 3548 | 3753 | 4060 | 4074 |
| 477 | 188 | 989 | 2566 | 1501 | 1441 | 2013 | 1744 | 2525 | 2896 | 3037 | 3628 | 3549 | 1967 | 4061 | 3965 |
| 478 | 449 | 990 | 817 | 1502 | 2585 | 2014 | 2833 | 2526 | 3177 | 3038 | 1851 | 3550 | 3318 | 4062 | 4047 |
| 479 | 1065 | 991 | 1178 | 1503 | 1237 | 2015 | 1840 | 2527 | 1497 | 3039 | 2793 | 3551 | 2997 | 4063 | 3966 |
| 480 | 217 | 992 | 319 | 1504 | 2163 | 2016 | 2480 | 2528 | 2738 | 3040 | 3253 | 3552 | 3779 | 4064 | 4081 |
| 481 | 408 | 993 | 2102 | 1505 | 748 | 2017 | 1860 | 2529 | 1658 | 3041 | 2874 | 3553 | 3422 | 4065 | 4027 |
| 482 | 2062 | 994 | 1103 | 1506 | 1592 | 2018 | 2405 | 2530 | 3376 | 3042 | 991 | 3554 | 3671 | 4066 | 4076 |
| 483 | 609 | 995 | 621 | 1507 | 2215 | 2019 | 926 | 2531 | 2761 | 3043 | 3367 | 3555 | 3021 | 4067 | 4082 |
| 484 | 596 | 996 | 1293 | 1508 | 944 | 2020 | 3392 | 2532 | 1768 | 3044 | 2780 | 3556 | 1915 | 4068 | 4029 |
| 485 | 1168 | 997 | 2131 | 1509 | 1856 | 2021 | 1371 | 2533 | 3368 | 3045 | 1958 | 3557 | 3740 | 4069 | 4055 |
| 486 | 551 | 998 | 812 | 1510 | 3584 | 2022 | 2235 | 2534 | 1876 | 3046 | 3357 | 3558 | 3862 | 4070 | 4030 |
| 487 | 650 | 999 | 484 | 1511 | 869 | 2023 | 1921 | 2535 | 2680 | 3047 | 2494 | 3559 | 3532 | 4071 | 4059 |
| 488 | 229 | 1000 | 1132 | 1512 | 2273 | 2024 | 2284 | 2536 | 2530 | 3048 | 3304 | 3560 | 3048 | 4072 | 4084 |
| 489 | 1052 | 1001 | 2105 | 1513 | 1612 | 2025 | 764 | 2537 | 1984 | 3049 | 1906 | 3561 | 3321 | 4073 | 4071 |
| 490 | 2120 | 1002 | 430 | 1514 | 1210 | 2026 | 2712 | 2538 | 3235 | 3050 | 3196 | 3562 | 3754 | 4074 | 4088 |
| 491 | 159 | 1003 | 1602 | 1515 | 2374 | 2027 | 1267 | 2539 | 1004 | 3051 | 3010 | 3563 | 2022 | 4075 | 3839 |
| 492 | 420 | 1004 | 838 | 1516 | 491 | 2028 | 3205 | 2540 | 2854 | 3052 | 3277 | 3564 | 3645 | 4076 | 4061 |
| 493 | 310 | 1005 | 2569 | 1517 | 2354 | 2029 | 1686 | 2541 | 3164 | 3053 | 1961 | 3565 | 2940 | 4077 | 4075 |
| 494 | 1093 | 1006 | 1248 | 1518 | 1670 | 2030 | 2672 | 2542 | 1889 | 3054 | 2984 | 3566 | 3483 | 4078 | 4062 |
| 495 | 541 | 1007 | 667 | 1519 | 699 | 2031 | 1478 | 2543 | 2475 | 3055 | 3254 | 3567 | 3875 | 4079 | 4077 |
| 496 | 773 | 1008 | 3075 | 1520 | 2820 | 2032 | 2635 | 2544 | 1717 | 3056 | 2523 | 3568 | 3861 | 4080 | 4031 |
| 497 | 2305 | 1009 | 488 | 1521 | 1428 | 2033 | 941 | 2545 | 2952 | 3057 | 1987 | 3569 | 1790 | 4081 | 4083 |
| 498 | 610 | 1010 | 1190 | 1522 | 1251 | 2034 | 3124 | 2546 | 3119 | 3058 | 3715 | 3570 | 2998 | 4082 | 4085 |
| 499 | 1066 | 1011 | 239 | 1523 | 2205 | 2035 | 1342 | 2547 | 1821 | 3059 | 2901 | 3571 | 3781 | 4083 | 3967 |
| 500 | 657 | 1012 | 2160 | 1524 | 754 | 2036 | 2828 | 2548 | 2462 | 3060 | 1771 | 3572 | 3437 | 4084 | 4078 |
| 501 | 333 | 1013 | 1543 | 1525 | 3083 | 2037 | 1699 | 2549 | 1930 | 3061 | 3634 | 3573 | 3512 | 4085 | 4086 |
| 502 | 119 | 1014 | 378 | 1526 | 1920 | 2038 | 2753 | 2550 | 3339 | 3062 | 2915 | 3574 | 2911 | 4086 | 4089 |
| 503 | 1540 | 1015 | 1576 | 1527 | 858 | 2039 | 967 | 2551 | 2271 | 3063 | 3358 | 3575 | 3700 | 4087 | 4090 |
| 504 | 3073 | 1016 | 2183 | 1528 | 2704 | 2040 | 2174 | 2552 | 1010 | 3064 | 1529 | 3576 | 1535 | 4088 | 4063 |
| 505 | 600 | 1017 | 459 | 1529 | 1618 | 2041 | 1642 | 2553 | 2711 | 3065 | 3657 | 3577 | 3761 | 4089 | 4092 |
| 506 | 339 | 1018 | 1219 | 1530 | 2377 | 2042 | 3095 | 2554 | 1739 | 3066 | 2685 | 3578 | 3446 | 4090 | 4079 |
| 507 | 218 | 1019 | 622 | 1531 | 478 | 2043 | 1922 | 2555 | 3457 | 3067 | 3371 | 3579 | 2807 | 4091 | 4087 |
| 508 | 1073 | 1020 | 2126 | 1532 | 1442 | 2044 | 2290 | 2556 | 2740 | 3068 | 1879 | 3580 | 3495 | 4092 | 4091 |
| 509 | 368 | 1021 | 627 | 1533 | 2158 | 2045 | 1805 | 2557 | 1831 | 3069 | 2955 | 3581 | 3538 | 4093 | 4093 |
| 510 | 652 | 1022 | 1294 | 1534 | 1326 | 2046 | 2613 | 2558 | 3618 | 3070 | 3426 | 3582 | 3865 | 4094 | 4094 |
| 511 | 230 | 1023 | 437 | 1535 | 968 | 2047 | 886 | 2559 | 2883 | 3071 | 2535 | 3583 | 3056 | 4095 | 4095 |

Sequence Q3, with a sequence length of 2048:
[0,1,2,4,8,16,32,3,5,64,1024,9,6,17,10,18,128,12,33,65,20,256,34,24,36,7, 129,66,512,11,40,68,130,19,13,48,14,72,257,1025,21,132,35,258,26,5 13,80,37,25,22, 136,260,264,38,514,96,67,41,144,28,69,42,516,49,1026,74,272,160,520,288,528,192, 544,70,44,131,81,50,73,15,320,133,52,1028,23,134,384, 76,137,82,56,27,97,39,259,8 4,138,145,261,1032,29,43,98,515,88,140,30,146,71,262,265,161,576,45,1040,100,64 0,51,148,46,75,266,273,517,104,162,53,193,1056,152,77, 164,768,268,274,518,54,83, 57,521,1027,112,135,78,289,194,85,276,522,58,168, 1029, 139,99,86,60,280,89,290,5 29,524,196,1088,141,101,147,176,142,530,321,31,200,1033,90,545,292,322,532,263, 149,102,105,1030, 304,296,163,92,47,267,385,546,324,1041,208,386,150,153,165,10 6,55,1034,328,536,577,548,113,154,79,269,1042,108,578,224,166,519,552,195,1152, 270,641,523,275,580,291,59,1036,169,560,114,277, 156,87,197,1057,116,170,61,531, 525,642,281,1089,278,526,177,293,388,91,1044,584,769,198,172,120,201,336,1280, 62,282,143,103,178,294,1058,93,644,202,592,323,1048,392,297,770,107,180,151,10 60,209,284,648,94,204,298,1031,400,608,352,325,533,1153,155,210,305,547,300,10 90,109,184,534,537,115,167,1536,225,326,306,772,157,1035,656,329,110,117,212,1 064,171,776,330,226,549,1092,538,387,308,216,1154,416,271,279,158,337,1043,550, 672,118,332,579,1037,540,389,173,121,1072,553,199,784,179,1038,228,338,312,70 4,390,1096,174,554,581,393,1281,283,122,448,353,1045,561,203,63,340,1156,394,5 27,582,556,181,1059,295,285,232,124,1282,205,182,643,562,1050,286,585,299,1537, 354,211,401,185,1104,396,344,586,645,1061,593,535,240,206,1049,95,327,564,104 6,800,402,356,307,1160,301,417,213,568,1284,832,588,186,1288,646,404,227,896,1 062,594,418,302,1538,649,771,360,539,1120,111,331,214,1091,309,188,449,1065,21 7,408,609,596,1168,551,650,229,1052,159,420,310,1093,541,773,610,1066,657,333, 119,1540,600,339,218,1073,368,652,230,1098,391,313,450,1296,542,334,233,1184,5 55,774,175,1544,123,658,612,1312,341,777,220,1552,314,424,395,1216,673,583,355, 1568,287,183,234,1094,125,557,660,1068,616,342,316,1155,241,778,1105,563,345, 452,1074,397,403,207,1097,674,558,1039,785,432,357,1344,187,236,664,1157,624,5 87,1076,780,705,126,1047,242,565,1158,398,346,456,1408,358,405,1100,303,569,24 4,1161,595,189,1106,566,676,361,1080,706,589,1051,215,786,647,1121,348,419,106 3,406,464,680,1283,801,362,1108,590,409,1162,570,788,597,1169,572,219,1285,311, 708,1053,598,601,1067,651,421,792,1122,802,611,1539,602,410,1112,231,688,1164, 653,248,1054,369,190,364,1170,654,659,1095,335,480,1286,315,221,1289,370,613,1 185,422,425,1600,451,614,1069,543,235,1124,412,343,372,1664,775,317,1075,222,4 26,1172,453,237,1070,559,833,1099,804,712,1290,834,661,1297,808,779,1541,617,1 128,604,433,1186,720,816,1077,836,347,1217,897,243,1176,662,454,1101,318,675,1 188,618,898,1792,781,376,1292,428,1298,665,736,1542,567,840,1078,625,238,1107, 359,457,1081,399,787,1545,591,1136,678,434,1159,677,349,1102,245,458,1313,666, 1218,620,363,1109,127,191,1300,782,1546,407,436,1082,626,571,1192,465,1163,68 1,246,1123,707,350,1110,599,1084,668,790,1304,460,249,1113,682,1314,573,411,15 53,803,789,1548,709,1220,365,440,1165,628,1125,689,374,1171,423,466,1200,793,1 166,250,371,1554,481,1345,574,413,1055,603,1224,366,468,1114,655,1569,900,805, 1316,615,1346,684,710,1556,429,1287,794,252,1173,373,1126,605,848,1129,690,13 28,713,1320,632,482,1187,806,1116,427,904,1071,414,1291,223,663,1409,692,1570, 835,1348,619,472,1232,455,1410,796,809,1174,714,1177,721,1189,837,716,1130,864, 1079,810,1352,606,912,1560,722,1601,696,1572,377,435,1137,817,1178,319,1103,6 21,1293,812,484,1132,430,1602,838,1248,667,488,1190,239,1543,378,1576,459,121 9,622,627,1294,437,1665,380,1547,818,1299,461,496,1604,669,1315,679,1083,724,1 193,841,629,1584,351,1138,467,1301,438,1180,737,1111,251,1221,462,442,1140,441, 1194,469,1085,247,1555,683,1549,842,1666,738,899,1305,670,1302,783,1550,849,1 201,820,1317,728,1412,928,1115,791,367,1608,901,1793,630,1222,685,1196,844,114 4,633,1225,711,1360,253,1086,691,1306,824,1167,902,1127,686,740,1202,850,1318, 375,1117,444,1668,470,1226,483,1616,415,1347,485,1416,905,1321,795,1794,473,1 131,634,1204,744,1175,852,1233,960,1308,865,1672,693,1118,797,1228,906,1322,7 15,1424,807,1632,474,1376,636,1349,694,1557,254,1179,717,1234,575,1329,913,15 71,798,1324,811,1133,379,1208,697,1558,431,607,489,1561,866,1139,723,1191,486, 1249,908,1350,718,1330,813,1796,476,1181,856,1680,839,1353,725,1134,698,1141, 914,1236,752,1195,868,1800,819,1354,814,1250,439,1573,929,1562,490,1411,623,1 332,671,1240,739,1440,916,1295,463,1303,843,1182,381,1361,497,1574,930,1696,8 21,1142,726,1356,1603,961,1564,872,1413,492,1197,631,1145,729,1577,700,1223,4 43,1808,741,1203,845,1252,920,1362,382,1336,822,1728,1414,851,1198,730,1578,4 98,1605,880,1417,742,1307,445,1146,471,1472,1377,635,1585,932,1227,687,1087,9 03,1364,825,1418,500,1551,1606,846,1580,745,1205,826,1319,732,1309,446,1256,1 148,962,1229,936,1206,475,1667,853,1586,867,1310,1609,637,1323,907,1378,487,1 235,695,1425,1209,746,1420,828,1368,753,1610,854,1669,1617,857,1559,504,1264, 799,1230,1119,255,1351,964,1588,909,1824,719,1426,1380,477,1331,915,1325,638, 1441,1237,748,1592,944,1856,869,1612,1210,491,1670,699,1428,1251,754,1920,858, 1618,478,1442,1326,968,1673,383,1795,910,1384,1563,815,1135,976,1355,1238,87 0,1333,917,1212,1473,727,1241,493,1432,873,1633,1620,701,1575,931,1674,1253,7 56,1183,860,1444,1334,499,1565,731,1797,1634,823,1681,922,1357,1143,874,1624, 918,1363,1242,502,1392,933,1676,1254,743,1415,1337,760,1474,881,1566,1358,494, 1257,702,1579,1798,921,1199,501,1147,1682,876,1636,1365,847,1801,992,1244,13 38,447,1448,1419,733,1697,827,1607,1379,934,1311,1207,882,1258,937,1149,1581, 963,1684,1640,747,1366,505,1340,1265,855,1802,1587,924,1369,734,1476,1421,829, 1427,1231,965,1698,1582,938,1809,1456,884,1381,506,1211,1260,749,1688,1648,9 45,1611,1804,966,1729,1150,755,1266,859,1589,1422,940,1370,1480,830,1382,1429, 911,1327,1593,871,1268,1619,639,1213,1590,888,1700,1385,479,1730,1613,946,12 39,750,1810,1671,969,1372,1443,508,1430,1488,861,1704,1825,757,1386,1614,970, 1433,1594,919,1812,1621,1596,875,1243,1335,862,1732,1622,758,1625,1675,948,14 45,1816,977,1826,1635,923,1626,1434,972,1255,1712,761,1677,1272,877,1393,1214, 1388,952,1678,1683,495,1359,1504,703,1339,1245,935,1394,1637,978,1446,1449,1 475,883,1638,1567,762,1259,1436,503,1367,1396,925,1799,1341,1246,878,1450,147 7,735,1261,1583,1857,993,1828,1736,885,1858,1685,939,1832,1803,1641,994,1628, 1457,980,1744,1840,1860,926,1371,1921,764,1267,1686,1478,941,1342,1699,967,16 42,1922,1805,886,1400,1452,831,1689,1760,1591,947,1864,1649,507,1262,1383,148 1,889,1423,1811,1615,984,1702,1458,751,1701,1373,1269,942,1482,1690,1644,996, 1387,1151,1215,971,1806,1431,890,1460,1650,1595,509,1489,1705,1270,949,1731,1 374,1623,973,1692,1814,1484,1000,1273,1706,1597,892,1435,1827,1813,950,1733,1 389,1464,863,1652,1713,1398,759,1447,1490,1817,1008,1274,1395,1505,510,1598,1 437,1627,979,1390,1492,1679,953,1924,1829,1639,763,1708,1734,1453,974,1818,12 76,1397,1629,954,1872,1714,1737,879,1656,1506,1830,981,1451,1928,1438,982,124 7,1687,1716,1859,927,1643,1496,1479,995,1820,1833,1738,1745,765,1861,1740,188 8,956,1834,1630,1936,1746,887,1720,1401,1459,1841,985,1343,1645,1836,997,1508, 1454,1862,1691,986,1512,1263,1402,1483,943,1646,1651,1461,1404,891,1842,1485, 1520,1693,998,1703,1748,1865,766,1653,1375,1491,1462,511,1761,1275,1486,1466, 1465,988,1493,1271,1707,1866,1001,1762,1923,1694,1807,951,1873,1844,1752,195 2,1002,1815,1391,1925,1654,1709,893,1868,1657,1735,1277,975,1715,1848,1926,17 10,894,1764,1874,1399,1468,1494,1009,1507,1439,1509,1929,1819,955,1497,1658,1 768,1876,1984,1004,1889,1717,1821,1930,1010,1739,1831,1498,1660,1718,957,127 8,1741,1599,1937,1822,983,1835,1403,1721,1455,1631,1513,958,1890,1747,1510,19 32,1742,987,1837,1500,1880,1863,1749,1012,1722,1938,1776,1892,1843,1838,999,1 463,1953,1514,1647,1695,1763,1016,1940,1487,1867,1405,1521,767,1954,1845,175 0,1985,1896,1516,1655,989,1753,1724,1467,1765,1869,1944,1003,1406,1846,1875,1 754,1522,1904,990,1766,1469,1495,1659,1956,1711,1927,1005,1849,1524,1870,176 9,1850,1756,1470,959,1986,1960,1499,1877,1891,1661,1931,1011,1511,1719,1770,1 852,1777,1878,1881,1013,1528,1823,1279,1988,1933,1743,1501,1939,895,1662,177 2,1968,1893,1515,1723,1778,1882,1006,1502,1992,1407,1934,1839,2000,1894,1941, 1014,1751,1517,1897,1725,1955,1780,1884,1523,1755,1017,1847,1946,1898,1942,1 526,1957,1767,1784,1905,1018,1518,1726,1945,1525,1900,1871,2016,1471,1757,18 51,991,1958,1906,1961,1987,1771,1529,1879,1948,1758,1853,1020,1989,1962,1908, 1530,1773,1969,1990,1779,1883,1964,1854,1935,1007,1895,1663,1912,1503,1970,1 774,1993,1532,1885,1781,1994,1943,1015,1899,1886,1782,1972,2001,1947,1996,17 85,1901,1976,1519,1727,1959,2002,1019,1907,1786,1527,1949,1902,1759,2017,190 9,1963,2018,2004,1950,1788,1965,1991,1021,1910,1855,1971,1531,1913,2008,1775, 1966,2020,1995,1914,1533,1973,1997,2024,1916,1974,1887,1783,1022,2032,1534,2 003,1977,1787,1998,1978,1903,2005,2006,1951,2019,1789,1980,1911,2009,2021,20 10,1967,1915,2022,1790,1535,1023,2012,2025,1975,2026,1917,1999,1918,2033,197 9,2028,2034,1981,2007,1982,2011,2036,2023,2040,1791,2013,2027,2014,2029,1983, 2035,2037,1919,2030,2038,2041,2042,2015,2044,2031,2039,2043,2045,2046,2047]

**Table Q3, with a sequence length of 2048:**

| Reliability or reliability sequence number | Polarized channel sequence number | Reliability or reliability sequence number | Polarized channel sequence number | Reliability or reliability sequence number | Polarized channel sequence number | Reliability or reliability sequence number | Polarized channel sequence number | Reliability or reliability sequence number | Polarized channel sequence number | Reliability or reliability sequence number | Polarized channel sequence number | Reliability or reliability sequence number | Polarized channel sequence number | Reliability or reliability sequence number | Polarized channel sequence number |
|---|---|---|---|---|---|---|---|---|---|---|---|---|---|---|---|
| 0 | 0 | 256 | 1280 | 512 | 1155 | 768 | 1200 | 1024 | 607 | 1280 | 760 | 1536 | 971 | 1792 | 989 |
| 1 | 1 | 257 | 62 | 513 | 241 | 769 | 793 | 1025 | 489 | 1281 | 1474 | 1537 | 1806 | 1793 | 1753 |
| 2 | 2 | 258 | 282 | 514 | 778 | 770 | 1166 | 1026 | 1561 | 1282 | 881 | 1538 | 1431 | 1794 | 1724 |
| 3 | 4 | 259 | 143 | 515 | 1105 | 771 | 250 | 1027 | 866 | 1283 | 1566 | 1539 | 890 | 1795 | 1467 |
| 4 | 8 | 260 | 103 | 516 | 563 | 772 | 371 | 1028 | 1139 | 1284 | 1358 | 1540 | 1460 | 1796 | 1765 |
| 5 | 16 | 261 | 178 | 517 | 345 | 773 | 1554 | 1029 | 723 | 1285 | 494 | 1541 | 1650 | 1797 | 1869 |
| 6 | 32 | 262 | 294 | 518 | 452 | 774 | 481 | 1030 | 1191 | 1286 | 1257 | 1542 | 1595 | 1798 | 1944 |
| 7 | 3 | 263 | 1058 | 519 | 1074 | 775 | 1345 | 1031 | 486 | 1287 | 702 | 1543 | 509 | 1799 | 1003 |
| 8 | 5 | 264 | 93 | 520 | 397 | 776 | 574 | 1032 | 1249 | 1288 | 1579 | 1544 | 1489 | 1800 | 1406 |
| 9 | 64 | 265 | 644 | 521 | 403 | 777 | 413 | 1033 | 908 | 1289 | 1798 | 1545 | 1705 | 1801 | 1846 |
| 10 | 1024 | 266 | 202 | 522 | 207 | 778 | 1055 | 1034 | 1350 | 1290 | 921 | 1546 | 1270 | 1802 | 1875 |
| 11 | 9 | 267 | 592 | 523 | 1097 | 779 | 603 | 1035 | 718 | 1291 | 1199 | 1547 | 949 | 1803 | 1754 |
| 12 | 6 | 268 | 323 | 524 | 674 | 780 | 1224 | 1036 | 1330 | 1292 | 501 | 1548 | 1731 | 1804 | 1522 |
| 13 | 17 | 269 | 1048 | 525 | 558 | 781 | 366 | 1037 | 813 | 1293 | 1147 | 1549 | 1374 | 1805 | 1904 |
| 14 | 10 | 270 | 392 | 526 | 1039 | 782 | 468 | 1038 | 1796 | 1294 | 1682 | 1550 | 1623 | 1806 | 990 |
| 15 | 18 | 271 | 297 | 527 | 785 | 783 | 1114 | 1039 | 476 | 1295 | 876 | 1551 | 973 | 1807 | 1766 |
| 16 | 128 | 272 | 770 | 528 | 432 | 784 | 655 | 1040 | 1181 | 1296 | 1636 | 1552 | 1692 | 1808 | 1469 |
| 17 | 12 | 273 | 107 | 529 | 357 | 785 | 1569 | 1041 | 856 | 1297 | 1365 | 1553 | 1814 | 1809 | 1495 |
| 18 | 33 | 274 | 180 | 530 | 1344 | 786 | 900 | 1042 | 1680 | 1298 | 847 | 1554 | 1484 | 1810 | 1659 |
| 19 | 65 | 275 | 151 | 531 | 187 | 787 | 805 | 1043 | 839 | 1299 | 1801 | 1555 | 1000 | 1811 | 1956 |
| 20 | 20 | 276 | 1060 | 532 | 236 | 788 | 1316 | 1044 | 1353 | 1300 | 992 | 1556 | 1273 | 1812 | 1711 |
| 21 | 256 | 277 | 209 | 533 | 664 | 789 | 615 | 1045 | 725 | 1301 | 1244 | 1557 | 1706 | 1813 | 1927 |
| 22 | 34 | 278 | 284 | 534 | 1157 | 790 | 1346 | 1046 | 1134 | 1302 | 1338 | 1558 | 1597 | 1814 | 1005 |
| 23 | 24 | 279 | 648 | 535 | 624 | 791 | 684 | 1047 | 698 | 1303 | 447 | 1559 | 892 | 1815 | 1849 |
| 24 | 36 | 280 | 94 | 536 | 587 | 792 | 710 | 1048 | 1141 | 1304 | 1448 | 1560 | 1435 | 1816 | 1524 |
| 25 | 7 | 281 | 204 | 537 | 1076 | 793 | 1556 | 1049 | 914 | 1305 | 1419 | 1561 | 1827 | 1817 | 1870 |
| 26 | 129 | 282 | 298 | 538 | 780 | 794 | 429 | 1050 | 1236 | 1306 | 733 | 1562 | 1813 | 1818 | 1769 |
| 27 | 66 | 283 | 1031 | 539 | 705 | 795 | 1287 | 1051 | 752 | 1307 | 1697 | 1563 | 950 | 1819 | 1850 |
| 28 | 512 | 284 | 400 | 540 | 126 | 796 | 794 | 1052 | 1195 | 1308 | 827 | 1564 | 1733 | 1820 | 1756 |
| 29 | 11 | 285 | 608 | 541 | 1047 | 797 | 252 | 1053 | 868 | 1309 | 1607 | 1565 | 1389 | 1821 | 1470 |
| 30 | 40 | 286 | 352 | 542 | 242 | 798 | 1173 | 1054 | 1800 | 1310 | 1379 | 1566 | 1464 | 1822 | 959 |
| 31 | 68 | 287 | 325 | 543 | 565 | 799 | 373 | 1055 | 819 | 1311 | 934 | 1567 | 863 | 1823 | 1986 |
| 32 | 130 | 288 | 533 | 544 | 1158 | 800 | 1126 | 1056 | 1354 | 1312 | 1311 | 1568 | 1652 | 1824 | 1960 |
| 33 | 19 | 289 | 1153 | 545 | 398 | 801 | 605 | 1057 | 814 | 1313 | 1207 | 1569 | 1713 | 1825 | 1499 |
| 34 | 13 | 290 | 155 | 546 | 346 | 802 | 848 | 1058 | 1250 | 1314 | 882 | 1570 | 1398 | 1826 | 1877 |
| 35 | 48 | 291 | 210 | 547 | 456 | 803 | 1129 | 1059 | 439 | 1315 | 1258 | 1571 | 759 | 1827 | 1891 |
| 36 | 14 | 292 | 305 | 548 | 1408 | 804 | 690 | 1060 | 1573 | 1316 | 937 | 1572 | 1447 | 1828 | 1661 |
| 37 | 72 | 293 | 547 | 549 | 358 | 805 | 1328 | 1061 | 929 | 1317 | 1149 | 1573 | 1490 | 1829 | 1931 |
| 38 | 257 | 294 | 300 | 550 | 405 | 806 | 713 | 1062 | 1562 | 1318 | 1581 | 1574 | 1817 | 1830 | 1011 |
| 39 | 1025 | 295 | 1090 | 551 | 1100 | 807 | 1320 | 1063 | 490 | 1319 | 963 | 1575 | 1008 | 1831 | 1511 |
| 40 | 21 | 296 | 109 | 552 | 303 | 808 | 632 | 1064 | 1411 | 1320 | 1684 | 1576 | 1274 | 1832 | 1719 |
| 41 | 132 | 297 | 184 | 553 | 569 | 809 | 482 | 1065 | 623 | 1321 | 1640 | 1577 | 1395 | 1833 | 1770 |
| 42 | 35 | 298 | 534 | 554 | 244 | 810 | 1187 | 1066 | 1332 | 1322 | 747 | 1578 | 1505 | 1834 | 1852 |
| 43 | 258 | 299 | 537 | 555 | 1161 | 811 | 806 | 1067 | 671 | 1323 | 1366 | 1579 | 510 | 1835 | 1777 |
| 44 | 26 | 300 | 115 | 556 | 595 | 812 | 1116 | 1068 | 1240 | 1324 | 505 | 1580 | 1598 | 1836 | 1878 |
| 45 | 513 | 301 | 167 | 557 | 189 | 813 | 427 | 1069 | 739 | 1325 | 1340 | 1581 | 1437 | 1837 | 1881 |
| 46 | 80 | 302 | 1536 | 558 | 1106 | 814 | 904 | 1070 | 1440 | 1326 | 1265 | 1582 | 1627 | 1838 | 1013 |
| 47 | 37 | 303 | 225 | 559 | 566 | 815 | 1071 | 1071 | 916 | 1327 | 855 | 1583 | 979 | 1839 | 1528 |
| 48 | 25 | 304 | 326 | 560 | 676 | 816 | 414 | 1072 | 1295 | 1328 | 1802 | 1584 | 1390 | 1840 | 1823 |
| 49 | 22 | 305 | 306 | 561 | 361 | 817 | 1291 | 1073 | 463 | 1329 | 1587 | 1585 | 1492 | 1841 | 1279 |
| 50 | 136 | 306 | 772 | 562 | 1080 | 818 | 223 | 1074 | 1303 | 1330 | 924 | 1586 | 1679 | 1842 | 1988 |
| 51 | 260 | 307 | 157 | 563 | 706 | 819 | 663 | 1075 | 843 | 1331 | 1369 | 1587 | 953 | 1843 | 1933 |
| 52 | 264 | 308 | 1035 | 564 | 589 | 820 | 1409 | 1076 | 1182 | 1332 | 734 | 1588 | 1924 | 1844 | 1743 |
| 53 | 38 | 309 | 656 | 565 | 1051 | 821 | 692 | 1077 | 381 | 1333 | 1476 | 1589 | 1829 | 1845 | 1501 |
| 54 | 514 | 310 | 329 | 566 | 215 | 822 | 1570 | 1078 | 1361 | 1334 | 1421 | 1590 | 1639 | 1846 | 1939 |
| 55 | 96 | 311 | 110 | 567 | 786 | 823 | 835 | 1079 | 497 | 1335 | 829 | 1591 | 763 | 1847 | 895 |
| 56 | 67 | 312 | 117 | 568 | 647 | 824 | 1348 | 1080 | 1574 | 1336 | 1427 | 1592 | 1708 | 1848 | 1662 |
| 57 | 41 | 313 | 212 | 569 | 1121 | 825 | 619 | 1081 | 930 | 1337 | 1231 | 1593 | 1734 | 1849 | 1772 |
| 58 | 144 | 314 | 1064 | 570 | 348 | 826 | 472 | 1082 | 1696 | 1338 | 965 | 1594 | 1453 | 1850 | 1968 |
| 59 | 28 | 315 | 171 | 571 | 419 | 827 | 1232 | 1083 | 821 | 1339 | 1698 | 1595 | 974 | 1851 | 1893 |
| 60 | 69 | 316 | 776 | 572 | 1063 | 828 | 455 | 1084 | 1142 | 1340 | 1582 | 1596 | 1818 | 1852 | 1515 |
| 61 | 42 | 317 | 330 | 573 | 406 | 829 | 1410 | 1085 | 726 | 1341 | 938 | 1597 | 1276 | 1853 | 1723 |
| 62 | 516 | 318 | 226 | 574 | 464 | 830 | 796 | 1086 | 1356 | 1342 | 1809 | 1598 | 1397 | 1854 | 1778 |
| 63 | 49 | 319 | 549 | 575 | 680 | 831 | 809 | 1087 | 1603 | 1343 | 1456 | 1599 | 1629 | 1855 | 1882 |
| 64 | 1026 | 320 | 1092 | 576 | 1283 | 832 | 1174 | 1088 | 961 | 1344 | 884 | 1600 | 954 | 1856 | 1006 |
| 65 | 74 | 321 | 538 | 577 | 801 | 833 | 714 | 1089 | 1564 | 1345 | 1381 | 1601 | 1872 | 1857 | 1502 |
| 66 | 272 | 322 | 387 | 578 | 362 | 834 | 1177 | 1090 | 872 | 1346 | 506 | 1602 | 1714 | 1858 | 1992 |
| 67 | 160 | 323 | 308 | 579 | 1108 | 835 | 721 | 1091 | 1413 | 1347 | 1211 | 1603 | 1737 | 1859 | 1407 |
| 68 | 520 | 324 | 216 | 580 | 590 | 836 | 1189 | 1092 | 492 | 1348 | 1260 | 1604 | 879 | 1860 | 1934 |
| 69 | 288 | 325 | 1154 | 581 | 409 | 837 | 837 | 1093 | 1197 | 1349 | 749 | 1605 | 1656 | 1861 | 1839 |
| 70 | 528 | 326 | 416 | 582 | 1162 | 838 | 716 | 1094 | 631 | 1350 | 1688 | 1606 | 1506 | 1862 | 2000 |
| 71 | 192 | 327 | 271 | 583 | 570 | 839 | 1130 | 1095 | 1145 | 1351 | 1648 | 1607 | 1830 | 1863 | 1894 |
| 72 | 544 | 328 | 279 | 584 | 788 | 840 | 864 | 1096 | 729 | 1352 | 945 | 1608 | 981 | 1864 | 1941 |
| 73 | 70 | 329 | 158 | 585 | 597 | 841 | 1079 | 1097 | 1577 | 1353 | 1611 | 1609 | 1451 | 1865 | 1014 |
| 74 | 44 | 330 | 337 | 586 | 1169 | 842 | 810 | 1098 | 700 | 1354 | 1804 | 1610 | 1928 | 1866 | 1751 |
| 75 | 131 | 331 | 1043 | 587 | 572 | 843 | 1352 | 1099 | 1223 | 1355 | 966 | 1611 | 1438 | 1867 | 1517 |
| 76 | 81 | 332 | 550 | 588 | 219 | 844 | 606 | 1100 | 443 | 1356 | 1729 | 1612 | 982 | 1868 | 1897 |
| 77 | 50 | 333 | 672 | 589 | 1285 | 845 | 912 | 1101 | 1808 | 1357 | 1150 | 1613 | 1247 | 1869 | 1725 |
| 78 | 73 | 334 | 118 | 590 | 311 | 846 | 1560 | 1102 | 741 | 1358 | 755 | 1614 | 1687 | 1870 | 1955 |
| 79 | 15 | 335 | 332 | 591 | 708 | 847 | 722 | 1103 | 1203 | 1359 | 1266 | 1615 | 1716 | 1871 | 1780 |
| 80 | 320 | 336 | 579 | 592 | 1053 | 848 | 1601 | 1104 | 845 | 1360 | 859 | 1616 | 1859 | 1872 | 1884 |
| 81 | 133 | 337 | 1037 | 593 | 598 | 849 | 696 | 1105 | 1252 | 1361 | 1589 | 1617 | 927 | 1873 | 1523 |
| 82 | 52 | 338 | 540 | 594 | 601 | 850 | 1572 | 1106 | 920 | 1362 | 1422 | 1618 | 1643 | 1874 | 1755 |
| 83 | 1028 | 339 | 389 | 595 | 1067 | 851 | 377 | 1107 | 1362 | 1363 | 940 | 1619 | 1496 | 1875 | 1017 |
| 84 | 23 | 340 | 173 | 596 | 651 | 852 | 435 | 1108 | 382 | 1364 | 1370 | 1620 | 1479 | 1876 | 1847 |
| 85 | 134 | 341 | 121 | 597 | 421 | 853 | 1137 | 1109 | 1336 | 1365 | 1480 | 1621 | 995 | 1877 | 1946 |
| 86 | 384 | 342 | 1072 | 598 | 792 | 854 | 817 | 1110 | 822 | 1366 | 830 | 1622 | 1820 | 1878 | 1898 |
| 87 | 76 | 343 | 553 | 599 | 1122 | 855 | 1178 | 1111 | 1728 | 1367 | 1382 | 1623 | 1833 | 1879 | 1942 |
| 88 | 137 | 344 | 199 | 600 | 802 | 856 | 319 | 1112 | 1414 | 1368 | 1429 | 1624 | 1738 | 1880 | 1526 |
| 89 | 82 | 345 | 784 | 601 | 611 | 857 | 1103 | 1113 | 851 | 1369 | 911 | 1625 | 1745 | 1881 | 1957 |
| 90 | 56 | 346 | 179 | 602 | 1539 | 858 | 621 | 1114 | 1198 | 1370 | 1327 | 1626 | 765 | 1882 | 1767 |
| 91 | 27 | 347 | 1038 | 603 | 602 | 859 | 1293 | 1115 | 730 | 1371 | 1593 | 1627 | 1861 | 1883 | 1784 |
| 92 | 97 | 348 | 228 | 604 | 410 | 860 | 812 | 1116 | 1578 | 1372 | 871 | 1628 | 1740 | 1884 | 1905 |
| 93 | 39 | 349 | 338 | 605 | 1112 | 861 | 484 | 1117 | 498 | 1373 | 1268 | 1629 | 1888 | 1885 | 1018 |
| 94 | 259 | 350 | 312 | 606 | 231 | 862 | 1132 | 1118 | 1605 | 1374 | 1619 | 1630 | 956 | 1886 | 1518 |
| 95 | 84 | 351 | 704 | 607 | 688 | 863 | 430 | 1119 | 880 | 1375 | 639 | 1631 | 1834 | 1887 | 1726 |
| 96 | 138 | 352 | 390 | 608 | 1164 | 864 | 1602 | 1120 | 1417 | 1376 | 1213 | 1632 | 1630 | 1888 | 1945 |
| 97 | 145 | 353 | 1096 | 609 | 653 | 865 | 838 | 1121 | 742 | 1377 | 1590 | 1633 | 1936 | 1889 | 1525 |
| 98 | 261 | 354 | 174 | 610 | 248 | 866 | 1248 | 1122 | 1307 | 1378 | 888 | 1634 | 1746 | 1890 | 1900 |
| 99 | 1032 | 355 | 554 | 611 | 1054 | 867 | 667 | 1123 | 445 | 1379 | 1700 | 1635 | 887 | 1891 | 1871 |
| 100 | 29 | 356 | 581 | 612 | 369 | 868 | 488 | 1124 | 1146 | 1380 | 1385 | 1636 | 1720 | 1892 | 2016 |
| 101 | 43 | 357 | 393 | 613 | 190 | 869 | 1190 | 1125 | 471 | 1381 | 479 | 1637 | 1401 | 1893 | 1471 |
| 102 | 98 | 358 | 1281 | 614 | 364 | 870 | 239 | 1126 | 1472 | 1382 | 1730 | 1638 | 1459 | 1894 | 1757 |
| 103 | 515 | 359 | 283 | 615 | 1170 | 871 | 1543 | 1127 | 1377 | 1383 | 1613 | 1639 | 1841 | 1895 | 1851 |
| 104 | 88 | 360 | 122 | 616 | 654 | 872 | 378 | 1128 | 635 | 1384 | 946 | 1640 | 985 | 1896 | 991 |
| 105 | 140 | 361 | 448 | 617 | 659 | 873 | 1576 | 1129 | 1585 | 1385 | 1239 | 1641 | 1343 | 1897 | 1958 |
| 106 | 30 | 362 | 353 | 618 | 1095 | 874 | 459 | 1130 | 932 | 1386 | 750 | 1642 | 1645 | 1898 | 1906 |
| 107 | 146 | 363 | 1045 | 619 | 335 | 875 | 1219 | 1131 | 1227 | 1387 | 1810 | 1643 | 1836 | 1899 | 1961 |
| 108 | 71 | 364 | 561 | 620 | 480 | 876 | 622 | 1132 | 687 | 1388 | 1671 | 1644 | 997 | 1900 | 1987 |
| 109 | 262 | 365 | 203 | 621 | 1286 | 877 | 627 | 1133 | 1087 | 1389 | 969 | 1645 | 1508 | 1901 | 1771 |
| 110 | 265 | 366 | 63 | 622 | 315 | 878 | 1294 | 1134 | 903 | 1390 | 1372 | 1646 | 1454 | 1902 | 1529 |
| 111 | 161 | 367 | 340 | 623 | 221 | 879 | 437 | 1135 | 1364 | 1391 | 1443 | 1647 | 1862 | 1903 | 1879 |
| 112 | 576 | 368 | 1156 | 624 | 1289 | 880 | 1665 | 1136 | 825 | 1392 | 508 | 1648 | 1691 | 1904 | 1948 |
| 113 | 45 | 369 | 394 | 625 | 370 | 881 | 380 | 1137 | 1418 | 1393 | 1430 | 1649 | 986 | 1905 | 1758 |
| 114 | 1040 | 370 | 527 | 626 | 613 | 882 | 1547 | 1138 | 500 | 1394 | 1488 | 1650 | 1512 | 1906 | 1853 |
| 115 | 100 | 371 | 582 | 627 | 1185 | 883 | 818 | 1139 | 1551 | 1395 | 861 | 1651 | 1263 | 1907 | 1020 |
| 116 | 640 | 372 | 556 | 628 | 422 | 884 | 1299 | 1140 | 1606 | 1396 | 1704 | 1652 | 1402 | 1908 | 1989 |
| 117 | 51 | 373 | 181 | 629 | 425 | 885 | 461 | 1141 | 846 | 1397 | 1825 | 1653 | 1483 | 1909 | 1962 |
| 118 | 148 | 374 | 1059 | 630 | 1600 | 886 | 496 | 1142 | 1580 | 1398 | 757 | 1654 | 943 | 1910 | 1908 |
| 119 | 46 | 375 | 295 | 631 | 451 | 887 | 1604 | 1143 | 745 | 1399 | 1386 | 1655 | 1646 | 1911 | 1530 |
| 120 | 75 | 376 | 285 | 632 | 614 | 888 | 669 | 1144 | 1205 | 1400 | 1614 | 1656 | 1651 | 1912 | 1773 |
| 121 | 266 | 377 | 232 | 633 | 1069 | 889 | 1315 | 1145 | 826 | 1401 | 970 | 1657 | 1461 | 1913 | 1969 |
| 122 | 273 | 378 | 124 | 634 | 543 | 890 | 679 | 1146 | 1319 | 1402 | 1433 | 1658 | 1404 | 1914 | 1990 |
| 123 | 517 | 379 | 1282 | 635 | 235 | 891 | 1083 | 1147 | 732 | 1403 | 1594 | 1659 | 891 | 1915 | 1779 |
| 124 | 104 | 380 | 205 | 636 | 1124 | 892 | 724 | 1148 | 1309 | 1404 | 919 | 1660 | 1842 | 1916 | 1883 |
| 125 | 162 | 381 | 182 | 637 | 412 | 893 | 1193 | 1149 | 446 | 1405 | 1812 | 1661 | 1485 | 1917 | 1964 |
| 126 | 53 | 382 | 643 | 638 | 343 | 894 | 841 | 1150 | 1256 | 1406 | 1621 | 1662 | 1520 | 1918 | 1854 |
| 127 | 193 | 383 | 562 | 639 | 372 | 895 | 629 | 1151 | 1148 | 1407 | 1596 | 1663 | 1693 | 1919 | 1935 |
| 128 | 1056 | 384 | 1050 | 640 | 1664 | 896 | 1584 | 1152 | 962 | 1408 | 875 | 1664 | 998 | 1920 | 1007 |
| 129 | 152 | 385 | 286 | 641 | 775 | 897 | 351 | 1153 | 1229 | 1409 | 1243 | 1665 | 1703 | 1921 | 1895 |
| 130 | 77 | 386 | 585 | 642 | 317 | 898 | 1138 | 1154 | 936 | 1410 | 1335 | 1666 | 1748 | 1922 | 1663 |
| 131 | 164 | 387 | 299 | 643 | 1075 | 899 | 467 | 1155 | 1206 | 1411 | 862 | 1667 | 1865 | 1923 | 1912 |
| 132 | 768 | 388 | 1537 | 644 | 222 | 900 | 1301 | 1156 | 475 | 1412 | 1732 | 1668 | 766 | 1924 | 1503 |
| 133 | 268 | 389 | 354 | 645 | 426 | 901 | 438 | 1157 | 1667 | 1413 | 1622 | 1669 | 1653 | 1925 | 1970 |
| 134 | 274 | 390 | 211 | 646 | 1172 | 902 | 1180 | 1158 | 853 | 1414 | 758 | 1670 | 1375 | 1926 | 1774 |
| 135 | 518 | 391 | 401 | 647 | 453 | 903 | 737 | 1159 | 1586 | 1415 | 1625 | 1671 | 1491 | 1927 | 1993 |
| 136 | 54 | 392 | 185 | 648 | 237 | 904 | 1111 | 1160 | 867 | 1416 | 1675 | 1672 | 1462 | 1928 | 1532 |
| 137 | 83 | 393 | 1104 | 649 | 1070 | 905 | 251 | 1161 | 1310 | 1417 | 948 | 1673 | 511 | 1929 | 1885 |
| 138 | 57 | 394 | 396 | 650 | 559 | 906 | 1221 | 1162 | 1609 | 1418 | 1445 | 1674 | 1761 | 1930 | 1781 |
| 139 | 521 | 395 | 344 | 651 | 833 | 907 | 462 | 1163 | 637 | 1419 | 1816 | 1675 | 1275 | 1931 | 1994 |
| 140 | 1027 | 396 | 586 | 652 | 1099 | 908 | 442 | 1164 | 1323 | 1420 | 977 | 1676 | 1486 | 1932 | 1943 |
| 141 | 112 | 397 | 645 | 653 | 804 | 909 | 1140 | 1165 | 907 | 1421 | 1826 | 1677 | 1466 | 1933 | 1015 |
| 142 | 135 | 398 | 1061 | 654 | 712 | 910 | 441 | 1166 | 1378 | 1422 | 1635 | 1678 | 1465 | 1934 | 1899 |
| 143 | 78 | 399 | 593 | 655 | 1290 | 911 | 1194 | 1167 | 487 | 1423 | 923 | 1679 | 988 | 1935 | 1886 |
| 144 | 289 | 400 | 535 | 656 | 834 | 912 | 469 | 1168 | 1235 | 1424 | 1626 | 1680 | 1493 | 1936 | 1782 |
| 145 | 194 | 401 | 240 | 657 | 661 | 913 | 1085 | 1169 | 695 | 1425 | 1434 | 1681 | 1271 | 1937 | 1972 |
| 146 | 85 | 402 | 206 | 658 | 1297 | 914 | 247 | 1170 | 1425 | 1426 | 972 | 1682 | 1707 | 1938 | 2001 |
| 147 | 276 | 403 | 1049 | 659 | 808 | 915 | 1555 | 1171 | 1209 | 1427 | 1255 | 1683 | 1866 | 1939 | 1947 |
| 148 | 522 | 404 | 95 | 660 | 779 | 916 | 683 | 1172 | 746 | 1428 | 1712 | 1684 | 1001 | 1940 | 1996 |
| 149 | 58 | 405 | 327 | 661 | 1541 | 917 | 1549 | 1173 | 1420 | 1429 | 761 | 1685 | 1762 | 1941 | 1785 |
| 150 | 168 | 406 | 564 | 662 | 617 | 918 | 842 | 1174 | 828 | 1430 | 1677 | 1686 | 1923 | 1942 | 1901 |
| 151 | 1029 | 407 | 1046 | 663 | 1128 | 919 | 1666 | 1175 | 1368 | 1431 | 1272 | 1687 | 1694 | 1943 | 1976 |
| 152 | 139 | 408 | 800 | 664 | 604 | 920 | 738 | 1176 | 753 | 1432 | 877 | 1688 | 1807 | 1944 | 1519 |
| 153 | 99 | 409 | 402 | 665 | 433 | 921 | 899 | 1177 | 1610 | 1433 | 1393 | 1689 | 951 | 1945 | 1727 |
| 154 | 86 | 410 | 356 | 666 | 1186 | 922 | 1305 | 1178 | 854 | 1434 | 1214 | 1690 | 1873 | 1946 | 1959 |
| 155 | 60 | 411 | 307 | 667 | 720 | 923 | 670 | 1179 | 1669 | 1435 | 1388 | 1691 | 1844 | 1947 | 2002 |
| 156 | 280 | 412 | 1160 | 668 | 816 | 924 | 1302 | 1180 | 1617 | 1436 | 952 | 1692 | 1752 | 1948 | 1019 |
| 157 | 89 | 413 | 301 | 669 | 1077 | 925 | 783 | 1181 | 857 | 1437 | 1678 | 1693 | 1952 | 1949 | 1907 |
| 158 | 290 | 414 | 417 | 670 | 836 | 926 | 1550 | 1182 | 1559 | 1438 | 1683 | 1694 | 1002 | 1950 | 1786 |
| 159 | 529 | 415 | 213 | 671 | 347 | 927 | 849 | 1183 | 504 | 1439 | 495 | 1695 | 1815 | 1951 | 1527 |
| 160 | 524 | 416 | 568 | 672 | 1217 | 928 | 1201 | 1184 | 1264 | 1440 | 1359 | 1696 | 1391 | 1952 | 1949 |
| 161 | 196 | 417 | 1284 | 673 | 897 | 929 | 820 | 1185 | 799 | 1441 | 1504 | 1697 | 1925 | 1953 | 1902 |
| 162 | 1088 | 418 | 832 | 674 | 243 | 930 | 1317 | 1186 | 1230 | 1442 | 703 | 1698 | 1654 | 1954 | 1759 |
| 163 | 141 | 419 | 588 | 675 | 1176 | 931 | 728 | 1187 | 1119 | 1443 | 1339 | 1699 | 1709 | 1955 | 2017 |
| 164 | 101 | 420 | 186 | 676 | 662 | 932 | 1412 | 1188 | 255 | 1444 | 1245 | 1700 | 893 | 1956 | 1909 |
| 165 | 147 | 421 | 1288 | 677 | 454 | 933 | 928 | 1189 | 1351 | 1445 | 935 | 1701 | 1868 | 1957 | 1963 |
| 166 | 176 | 422 | 646 | 678 | 1101 | 934 | 1115 | 1190 | 964 | 1446 | 1394 | 1702 | 1657 | 1958 | 2018 |
| 167 | 142 | 423 | 404 | 679 | 318 | 935 | 791 | 1191 | 1588 | 1447 | 1637 | 1703 | 1735 | 1959 | 2004 |
| 168 | 530 | 424 | 227 | 680 | 675 | 936 | 367 | 1192 | 909 | 1448 | 978 | 1704 | 1277 | 1960 | 1950 |
| 169 | 321 | 425 | 896 | 681 | 1188 | 937 | 1608 | 1193 | 1824 | 1449 | 1446 | 1705 | 975 | 1961 | 1788 |
| 170 | 31 | 426 | 1062 | 682 | 618 | 938 | 901 | 1194 | 719 | 1450 | 1449 | 1706 | 1715 | 1962 | 1965 |
| 171 | 200 | 427 | 594 | 683 | 898 | 939 | 1793 | 1195 | 1426 | 1451 | 1475 | 1707 | 1848 | 1963 | 1991 |
| 172 | 1033 | 428 | 418 | 684 | 1792 | 940 | 630 | 1196 | 1380 | 1452 | 883 | 1708 | 1926 | 1964 | 1021 |
| 173 | 90 | 429 | 302 | 685 | 781 | 941 | 1222 | 1197 | 477 | 1453 | 1638 | 1709 | 1710 | 1965 | 1910 |
| 174 | 545 | 430 | 1538 | 686 | 376 | 942 | 685 | 1198 | 1331 | 1454 | 1567 | 1710 | 894 | 1966 | 1855 |
| 175 | 292 | 431 | 649 | 687 | 1292 | 943 | 1196 | 1199 | 915 | 1455 | 762 | 1711 | 1764 | 1967 | 1971 |
| 176 | 322 | 432 | 771 | 688 | 428 | 944 | 844 | 1200 | 1325 | 1456 | 1259 | 1712 | 1874 | 1968 | 1531 |
| 177 | 532 | 433 | 360 | 689 | 1298 | 945 | 1144 | 1201 | 638 | 1457 | 1436 | 1713 | 1399 | 1969 | 1913 |
| 178 | 263 | 434 | 539 | 690 | 665 | 946 | 633 | 1202 | 1441 | 1458 | 503 | 1714 | 1468 | 1970 | 2008 |
| 179 | 149 | 435 | 1120 | 691 | 736 | 947 | 1225 | 1203 | 1237 | 1459 | 1367 | 1715 | 1494 | 1971 | 1775 |
| 180 | 102 | 436 | 111 | 692 | 1542 | 948 | 711 | 1204 | 748 | 1460 | 1396 | 1716 | 1009 | 1972 | 1966 |
| 181 | 105 | 437 | 331 | 693 | 567 | 949 | 1360 | 1205 | 1592 | 1461 | 925 | 1717 | 1507 | 1973 | 2020 |
| 182 | 1030 | 438 | 214 | 694 | 840 | 950 | 253 | 1206 | 944 | 1462 | 1799 | 1718 | 1439 | 1974 | 1995 |
| 183 | 304 | 439 | 1091 | 695 | 1078 | 951 | 1086 | 1207 | 1856 | 1463 | 1341 | 1719 | 1509 | 1975 | 1914 |
| 184 | 296 | 440 | 309 | 696 | 625 | 952 | 691 | 1208 | 869 | 1464 | 1246 | 1720 | 1929 | 1976 | 1533 |
| 185 | 163 | 441 | 188 | 697 | 238 | 953 | 1306 | 1209 | 1612 | 1465 | 878 | 1721 | 1819 | 1977 | 1973 |
| 186 | 92 | 442 | 449 | 698 | 1107 | 954 | 824 | 1210 | 1210 | 1466 | 1450 | 1722 | 955 | 1978 | 1997 |
| 187 | 47 | 443 | 1065 | 699 | 359 | 955 | 1167 | 1211 | 491 | 1467 | 1477 | 1723 | 1497 | 1979 | 2024 |
| 188 | 267 | 444 | 217 | 700 | 457 | 956 | 902 | 1212 | 1670 | 1468 | 735 | 1724 | 1658 | 1980 | 1916 |
| 189 | 385 | 445 | 408 | 701 | 1081 | 957 | 1127 | 1213 | 699 | 1469 | 1261 | 1725 | 1768 | 1981 | 1974 |
| 190 | 546 | 446 | 609 | 702 | 399 | 958 | 686 | 1214 | 1428 | 1470 | 1583 | 1726 | 1876 | 1982 | 1887 |
| 191 | 324 | 447 | 596 | 703 | 787 | 959 | 740 | 1215 | 1251 | 1471 | 1857 | 1727 | 1984 | 1983 | 1783 |
| 192 | 1041 | 448 | 1168 | 704 | 1545 | 960 | 1202 | 1216 | 754 | 1472 | 993 | 1728 | 1004 | 1984 | 1022 |
| 193 | 208 | 449 | 551 | 705 | 591 | 961 | 850 | 1217 | 1920 | 1473 | 1828 | 1729 | 1889 | 1985 | 2032 |
| 194 | 386 | 450 | 650 | 706 | 1136 | 962 | 1318 | 1218 | 858 | 1474 | 1736 | 1730 | 1717 | 1986 | 1534 |
| 195 | 150 | 451 | 229 | 707 | 678 | 963 | 375 | 1219 | 1618 | 1475 | 885 | 1731 | 1821 | 1987 | 2003 |
| 196 | 153 | 452 | 1052 | 708 | 434 | 964 | 1117 | 1220 | 478 | 1476 | 1858 | 1732 | 1930 | 1988 | 1977 |
| 197 | 165 | 453 | 159 | 709 | 1159 | 965 | 444 | 1221 | 1442 | 1477 | 1685 | 1733 | 1010 | 1989 | 1787 |
| 198 | 106 | 454 | 420 | 710 | 677 | 966 | 1668 | 1222 | 1326 | 1478 | 939 | 1734 | 1739 | 1990 | 1998 |
| 199 | 55 | 455 | 310 | 711 | 349 | 967 | 470 | 1223 | 968 | 1479 | 1832 | 1735 | 1831 | 1991 | 1978 |
| 200 | 1034 | 456 | 1093 | 712 | 1102 | 968 | 1226 | 1224 | 1673 | 1480 | 1803 | 1736 | 1498 | 1992 | 1903 |
| 201 | 328 | 457 | 541 | 713 | 245 | 969 | 483 | 1225 | 383 | 1481 | 1641 | 1737 | 1660 | 1993 | 2005 |
| 202 | 536 | 458 | 773 | 714 | 458 | 970 | 1616 | 1226 | 1795 | 1482 | 994 | 1738 | 1718 | 1994 | 2006 |
| 203 | 577 | 459 | 610 | 715 | 1313 | 971 | 415 | 1227 | 910 | 1483 | 1628 | 1739 | 957 | 1995 | 1951 |
| 204 | 548 | 460 | 1066 | 716 | 666 | 972 | 1347 | 1228 | 1384 | 1484 | 1457 | 1740 | 1278 | 1996 | 2019 |
| 205 | 113 | 461 | 657 | 717 | 1218 | 973 | 485 | 1229 | 1563 | 1485 | 980 | 1741 | 1741 | 1997 | 1789 |
| 206 | 154 | 462 | 333 | 718 | 620 | 974 | 1416 | 1230 | 815 | 1486 | 1744 | 1742 | 1599 | 1998 | 1980 |
| 207 | 79 | 463 | 119 | 719 | 363 | 975 | 905 | 1231 | 1135 | 1487 | 1840 | 1743 | 1937 | 1999 | 1911 |
| 208 | 269 | 464 | 1540 | 720 | 1109 | 976 | 1321 | 1232 | 976 | 1488 | 1860 | 1744 | 1822 | 2000 | 2009 |
| 209 | 1042 | 465 | 600 | 721 | 127 | 977 | 795 | 1233 | 1355 | 1489 | 926 | 1745 | 983 | 2001 | 2021 |
| 210 | 108 | 466 | 339 | 722 | 191 | 978 | 1794 | 1234 | 1238 | 1490 | 1371 | 1746 | 1835 | 2002 | 2010 |
| 211 | 578 | 467 | 218 | 723 | 1300 | 979 | 473 | 1235 | 870 | 1491 | 1921 | 1747 | 1403 | 2003 | 1967 |
| 212 | 224 | 468 | 1073 | 724 | 782 | 980 | 1131 | 1236 | 1333 | 1492 | 764 | 1748 | 1721 | 2004 | 1915 |
| 213 | 166 | 469 | 368 | 725 | 1546 | 981 | 634 | 1237 | 917 | 1493 | 1267 | 1749 | 1455 | 2005 | 2022 |
| 214 | 519 | 470 | 652 | 726 | 407 | 982 | 1204 | 1238 | 1212 | 1494 | 1686 | 1750 | 1631 | 2006 | 1790 |
| 215 | 552 | 471 | 230 | 727 | 436 | 983 | 744 | 1239 | 1473 | 1495 | 1478 | 1751 | 1513 | 2007 | 1535 |
| 216 | 195 | 472 | 1098 | 728 | 1082 | 984 | 1175 | 1240 | 727 | 1496 | 941 | 1752 | 958 | 2008 | 1023 |
| 217 | 1152 | 473 | 391 | 729 | 626 | 985 | 852 | 1241 | 1241 | 1497 | 1342 | 1753 | 1890 | 2009 | 2012 |
| 218 | 270 | 474 | 313 | 730 | 571 | 986 | 1233 | 1242 | 493 | 1498 | 1699 | 1754 | 1747 | 2010 | 2025 |
| 219 | 641 | 475 | 450 | 731 | 1192 | 987 | 960 | 1243 | 1432 | 1499 | 967 | 1755 | 1510 | 2011 | 1975 |
| 220 | 523 | 476 | 1296 | 732 | 465 | 988 | 1308 | 1244 | 873 | 1500 | 1642 | 1756 | 1932 | 2012 | 2026 |
| 221 | 275 | 477 | 542 | 733 | 1163 | 989 | 865 | 1245 | 1633 | 1501 | 1922 | 1757 | 1742 | 2013 | 1917 |
| 222 | 580 | 478 | 334 | 734 | 681 | 990 | 1672 | 1246 | 1620 | 1502 | 1805 | 1758 | 987 | 2014 | 1999 |
| 223 | 291 | 479 | 233 | 735 | 246 | 991 | 693 | 1247 | 701 | 1503 | 886 | 1759 | 1837 | 2015 | 1918 |
| 224 | 59 | 480 | 1184 | 736 | 1123 | 992 | 1118 | 1248 | 1575 | 1504 | 1400 | 1760 | 1500 | 2016 | 2033 |
| 225 | 1036 | 481 | 555 | 737 | 707 | 993 | 797 | 1249 | 931 | 1505 | 1452 | 1761 | 1880 | 2017 | 1979 |
| 226 | 169 | 482 | 774 | 738 | 350 | 994 | 1228 | 1250 | 1674 | 1506 | 831 | 1762 | 1863 | 2018 | 2028 |
| 227 | 560 | 483 | 175 | 739 | 1110 | 995 | 906 | 1251 | 1253 | 1507 | 1689 | 1763 | 1749 | 2019 | 2034 |
| 228 | 114 | 484 | 1544 | 740 | 599 | 996 | 1322 | 1252 | 756 | 1508 | 1760 | 1764 | 1012 | 2020 | 1981 |
| 229 | 277 | 485 | 123 | 741 | 1084 | 997 | 715 | 1253 | 1183 | 1509 | 1591 | 1765 | 1722 | 2021 | 2007 |
| 230 | 156 | 486 | 658 | 742 | 668 | 998 | 1424 | 1254 | 860 | 1510 | 947 | 1766 | 1938 | 2022 | 1982 |
| 231 | 87 | 487 | 612 | 743 | 790 | 999 | 807 | 1255 | 1444 | 1511 | 1864 | 1767 | 1776 | 2023 | 2011 |
| 232 | 197 | 488 | 1312 | 744 | 1304 | 1000 | 1632 | 1256 | 1334 | 1512 | 1649 | 1768 | 1892 | 2024 | 2036 |
| 233 | 1057 | 489 | 341 | 745 | 460 | 1001 | 474 | 1257 | 499 | 1513 | 507 | 1769 | 1843 | 2025 | 2023 |
| 234 | 116 | 490 | 777 | 746 | 249 | 1002 | 1376 | 1258 | 1565 | 1514 | 1262 | 1770 | 1838 | 2026 | 2040 |
| 235 | 170 | 491 | 220 | 747 | 1113 | 1003 | 636 | 1259 | 731 | 1515 | 1383 | 1771 | 999 | 2027 | 1791 |
| 236 | 61 | 492 | 1552 | 748 | 682 | 1004 | 1349 | 1260 | 1797 | 1516 | 1481 | 1772 | 1463 | 2028 | 2013 |
| 237 | 531 | 493 | 314 | 749 | 1314 | 1005 | 694 | 1261 | 1634 | 1517 | 889 | 1773 | 1953 | 2029 | 2027 |
| 238 | 525 | 494 | 424 | 750 | 573 | 1006 | 1557 | 1262 | 823 | 1518 | 1423 | 1774 | 1514 | 2030 | 2014 |
| 239 | 642 | 495 | 395 | 751 | 411 | 1007 | 254 | 1263 | 1681 | 1519 | 1811 | 1775 | 1647 | 2031 | 2029 |
| 240 | 281 | 496 | 1216 | 752 | 1553 | 1008 | 1179 | 1264 | 922 | 1520 | 1615 | 1776 | 1695 | 2032 | 1983 |
| 241 | 1089 | 497 | 673 | 753 | 803 | 1009 | 717 | 1265 | 1357 | 1521 | 984 | 1777 | 1763 | 2033 | 2035 |
| 242 | 278 | 498 | 583 | 754 | 789 | 1010 | 1234 | 1266 | 1143 | 1522 | 1702 | 1778 | 1016 | 2034 | 2037 |
| 243 | 526 | 499 | 355 | 755 | 1548 | 1011 | 575 | 1267 | 874 | 1523 | 1458 | 1779 | 1940 | 2035 | 1919 |
| 244 | 177 | 500 | 1568 | 756 | 709 | 1012 | 1329 | 1268 | 1624 | 1524 | 751 | 1780 | 1487 | 2036 | 2030 |
| 245 | 293 | 501 | 287 | 757 | 1220 | 1013 | 913 | 1269 | 918 | 1525 | 1701 | 1781 | 1867 | 2037 | 2038 |
| 246 | 388 | 502 | 183 | 758 | 365 | 1014 | 1571 | 1270 | 1363 | 1526 | 1373 | 1782 | 1405 | 2038 | 2041 |
| 247 | 91 | 503 | 234 | 759 | 440 | 1015 | 798 | 1271 | 1242 | 1527 | 1269 | 1783 | 1521 | 2039 | 2042 |
| 248 | 1044 | 504 | 1094 | 760 | 1165 | 1016 | 1324 | 1272 | 502 | 1528 | 942 | 1784 | 767 | 2040 | 2015 |
| 249 | 584 | 505 | 125 | 761 | 628 | 1017 | 811 | 1273 | 1392 | 1529 | 1482 | 1785 | 1954 | 2041 | 2044 |
| 250 | 769 | 506 | 557 | 762 | 1125 | 1018 | 1133 | 1274 | 933 | 1530 | 1690 | 1786 | 1845 | 2042 | 2031 |
| 251 | 198 | 507 | 660 | 763 | 689 | 1019 | 379 | 1275 | 1676 | 1531 | 1644 | 1787 | 1750 | 2043 | 2039 |
| 252 | 172 | 508 | 1068 | 764 | 374 | 1020 | 1208 | 1276 | 1254 | 1532 | 996 | 1788 | 1985 | 2044 | 2043 |
| 253 | 120 | 509 | 616 | 765 | 1171 | 1021 | 697 | 1277 | 743 | 1533 | 1387 | 1789 | 1896 | 2045 | 2045 |
| 254 | 201 | 510 | 342 | 766 | 423 | 1022 | 1558 | 1278 | 1415 | 1534 | 1151 | 1790 | 1516 | 2046 | 2046 |
| 255 | 336 | 511 | 316 | 767 | 466 | 1023 | 431 | 1279 | 1337 | 1535 | 1215 | 1791 | 1655 | 2047 | 2047 |

Sequence Z1, with a sequence length of 8192:
[0,1,2,7,3,8,14,27,4,13,16,31,19,36,38,84,5, 15, 17,35,22,42,52,89,25,51,46, 97,63,106,113,182,6,20,24,44,26,50,57,99,32,61,65,107,78,120,126,201,37,67,82,124, 87,135,145,215,96,147,160,243,166,257,281,408,9,21,29,60,33,64,77,115,39,83,69,1 27,92,139,153,224,49,80,95,146,101,156,165,251,111,168,186,269,200,288,307,454, 59,98,109,164,122,176,194,284,133,195,214,299,227,325,343,494,150,222,247,330,2 54,344,371,528,275,378,402,556,423,581,627,877,18,28,34,79,43,86,90,151,54,94,10 2,163,112,175,179,283,62,103,114,177,125,193,211,301,138,212,223,319,249,339,36 4,516,71,118,134,199,140,213,230,331,161,245,255,347,274,377,394,553,178,266,28 5,385,300,417,426,578,327,440,475,615,501,649,725,878,75,136,155,233,173,252,27 3,382,183,277,291,407,308,425,452,603,208,304,320,437,345,468,496,662,358,504,5 33,690,564,738,767,1022,229,334,352,479,387,513,538,715,422,548,579,755,616,77 3,842,1103,451,592,630,809,645,865,897,1175,720,914,951,1160,990,1235,1333,167 8,23,40,45,100,55,104,116,192,56,117,129,202,142,225,236,362,70,130,143,240,157, 248,263,363,167,261,282,400,305,421,432,577,73,154,169,242,188,267,286,420,198, 297,309,434,323,466,486,643,197,321,336,463,357,500,518,694,389,542,566,737,58 9,764,816,1081,85,181,190,293,206,316,335,456,217,342,351,495,372,527,547,733,2 79,365,388,532,409,562,588,760,443,597,635,805,667,862,901,1147,313,404,436,57 4,462,613,638,845,491,655,677,874,726,931,966,1211,535,724,742,952,761,992,940, 1257,826,1074,1107,1355,1121,1459,1518,1755,91,203,209,356,268,376,392,541,29 5,397,412,569,442,601,634,849,311,439,461,602,478,641,670,884,505,682,713,921,7 57,960,1019,1270,361,467,484,668,517,703,745,943,567,746,769,1014,830,985,1092, 1361,611,797,858,1075,885,1117,1154,1426,932,1168,1165,1503,1260,1547,1599,19 28,403,502,543,750,599,772,814,1037,636,847,867,1110,912,1128,1163,1452,672,89 3,945,1150,967,1172,1264,1552,1034,1284,1322,1613,1390,1696,1745,2117,734,955, 1008,1267,1089,1273,1376,1634,1101,1365,1433,1725,1488,1791,1886,2269,1129,1 463,1535,1824,1577,1902,1857,2323,1667,1977,2030,2480,2145,2568,2678,3005,30, 48,58,110,66,131,144,231,72,148,159,239,172,259,264,413,74,170,180,258,191,317, 328,450,218,329,355,492,375,520,545,754,76,187,204,322,220,353,368,510,232,381, 395,551,416,582,608,775,246,406,430,595,457,631,652,836,469,644,684,890,689,92 0,957,1340,119,219,228,373,241,396,414,572,271,433,445,622,474,658,680,853,292, 449,483,648,508,687,697,905,531,699,712,962,796,996,1062,1363,312,507,523,708, 558,743,751,977,587,792,820,1033,873,1084,1112,1437,621,841,889,1115,936,1143, 1218,1492,1006,1228,1288,1557,1326,1626,1705,2102,123,238,260,427,289,446,477, 664,306,488,511,702,536,719,728,970,341,526,557,731,585,785,813,1023,617,832,8 69,1098,907,1133,1190,1441,369,571,606,818,654,861,857,1136,674,895,916,1178,9 81,1222,1248,1564,716,938,1000,1239,1027,1305,1329,1638,1070,1358,1405,1729,1 499,1802,1892,2278,391,626,657,900,695,928,982,1231,781,1004,1046,1316,1053,1 336,1383,1689,799,1048,1067,1372,1138,1401,1474,1788,1203,1495,1532,1828,159 5,1936,1996,2352,834,1156,1185,1445,1249,1507,1543,1869,1292,1586,1644,1973,1 711,2038,2130,2512,1412,1653,1736,2060,1814,2160,2203,2654,1876,2243,2315,27 18,2421,2834,2985,3484,141,272,298,489,337,521,552,763,349,563,593,790,624,825, 881,1193,383,610,663,851,686,925,909,1210,705,947,989,1281,1041,1309,1347,167 1,460,676,707,924,780,975,1011,1319,789,1042,1060,1351,1088,1387,1424,1765,80 1,1078,1124,1420,1199,1471,1522,1835,1241,1573,1591,1940,1648,2004,2079,2459, 471,778,784,1029,804,1051,1095,1398,837,1142,1181,1456,1224,1510,1582,1917,99 7,1197,1253,1528,1294,1616,1657,1984,1394,1663,1739,2064,1818,2153,2195,2640, 1056,1301,1368,1620,1416,1719,1776,2094,1484,1795,1847,2187,1910,2251,2343,2 760,1539,1880,1954,2306,2026,2372,2453,2866,2109,2491,2557,2952,2616,3109,31 49,3832,480,808,822,1186,972,1215,1245,1568,1015,1277,1312,1630,1379,1685,175 9,2087,1064,1344,1409,1699,1448,1781,1851,2177,1514,1898,1840,2227,1992,2332, 2413,2803,1206,1430,1467,1807,1561,1862,1946,2286,1609,1958,2018,2381,2072,2 433,2524,2934,1715,2045,2124,2471,2210,2580,2628,3065,2262,2704,2747,3199,28 48,3272,3331,3683,1298,1481,1605,1965,1681,2011,2052,2442,1750,2138,2169,254 8,2234,2592,2730,3129,1769,2219,2295,2692,2401,2774,2787,3300,2503,2883,2915, 3359,3027,3524,3596,4162,1921,2364,2392,2817,2536,2897,2971,3420,2604,3047,3 085,3560,3225,3639,3888,4347,2666,3174,3247,3730,3387,3776,3946,4458,3454,40 14,4085,4599,4244,4770,5021,5420,10,41,68,149,88,162,196,310,105,184,216,340,2 44,374,386,609,121,207,226,366,270,405,459,628,294,453,431,660,514,696,722,961, 137,253,287,418,302,448,482,669,346,503,525,700,586,752,774,1018,379,534,600,7 66,623,802,840,1057,656,848,886,1137,906,1173,1236,1567,174,262,324,497,354,51 9,580,732,393,605,540,779,642,815,864,1083,441,594,651,843,678,875,904,1159,71 4,915,968,1207,1013,1259,1307,1675,493,665,706,899,756,937,994,1247,793,999,10 55,1286,1090,1352,1403,1768,854,1076,1148,1371,1167,1406,1473,1844,1227,1494, 1549,1905,1602,1961,2057,2542,235,318,360,591,411,620,632,859,465,647,683,894, 718,934,949,1243,509,688,727,941,770,991,1043,1293,810,1047,1080,1335,1155,13 92,1458,1815,550,744,798,1010,819,1050,1102,1374,891,1141,1169,1414,1223,1490, 1530,1901,946,1198,1252,1509,1289,1588,1610,1952,1356,1643,1723,2033,1782,21 05,2257,2545,570,807,870,1111,930,1161,1219,1502,964,1230,1265,1563,1310,1606, 1674,2008,1036,1296,1339,1637,1410,1708,1775,2127,1443,1789,1856,2189,1924,2 284,2341,2791,1097,1378,1425,1733,1513,1811,1866,2237,1600,1889,1956,2318,20 35,2355,2483,2923,1669,1982,2062,2424,2097,2521,2577,3034,2248,2607,2669,301 1,2736,3126,3278,3795,280,398,424,675,470,693,736,986,476,739,783,1020,828,108 5,1116,1451,544,787,831,1125,880,1151,1191,1454,910,1188,1240,1546,1300,1596,1 623,1949,559,868,917,1134,976,1201,1255,1592,1005,1279,1313,1628,1349,1702,17 49,2090,1001,1341,1384,1698,1440,1778,1822,2192,1520,1873,1926,2281,1980,233 8,2436,2886,614,956,979,1272,1032,1328,1382,1679,1061,1399,1421,1772,1477,184 1,1885,2272,1233,1462,1517,1853,1571,1914,1974,2326,1651,1995,2075,2416,2141, 2518,2586,2993,1324,1556,1633,1945,1694,2027,2082,2486,1762,2115,2163,2539,2 260,2634,2695,3093,1860,2254,2289,2672,2329,2740,2651,3163,2455,2872,2926,33 09,2948,3473,3565,3908,637,1025,1039,1436,1205,1487,1527,1870,1276,1542,1575, 1933,1647,2001,2069,2494,1317,1641,1692,2005,1732,2084,2148,2554,1794,2171,2 233,2619,2321,2686,2783,3183,1447,1706,1746,2142,1820,2213,2298,2657,1930,23 01,2346,2777,2456,2727,2905,3317,2023,2398,2509,2877,2559,2945,3000,3424,263 7,3023,3019,3538,3166,3607,3678,4140,1553,1785,1878,2303,1999,2349,2430,2814, 2078,2489,2527,2931,2601,2960,3016,3463,2151,2571,2660,2997,2698,3031,3171,3 613,2811,3205,3261,3700,3367,3818,3894,4381,2275,2675,2767,3179,2900,3188,33 45,3736,2920,3326,3434,3863,3513,3960,4093,4559,2963,3479,3585,4000,3650,411 1,4050,4630,3782,4206,4274,4814,4414,4914,5049,5398,332,435,487,709,529,791,8 35,1105,555,852,883,1123,926,1180,1194,1578,565,922,953,1176,984,1332,1360,166 5,1066,1367,1432,1763,1483,1827,1882,2312,575,971,1028,1345,1071,1428,1466,18 05,1108,1498,1534,1894,1585,1964,2016,2358,1146,1559,1619,1989,1684,2067,210 6,2468,1712,2091,2174,2565,2184,2613,2681,3286,748,1069,1094,1478,1130,1538,1 581,1942,1213,1624,1655,2047,1721,2123,2166,2500,1269,1661,1742,2099,1801,21 81,2201,2589,1848,2205,2230,2689,2395,2744,2855,3322,1321,1798,1833,2224,191 2,2292,2309,2713,1970,2389,2445,2808,2533,2891,2937,3440,2042,2477,2562,2940, 2645,2988,3101,3518,2763,3118,3208,3618,3264,3719,3838,4364,762,1120,1182,16 14,1261,1658,1728,2135,1304,1752,1809,2208,1864,2245,2265,2701,1395,1837,190 8,2268,1968,2378,2427,2794,2039,2462,2530,2912,2595,2966,3058,3443,1469,1937, 2014,2439,2112,2515,2506,2974,2156,2574,2610,3039,2721,3104,3146,3629,2240,2 648,2753,3133,2797,3233,3269,3742,2869,3314,3392,3869,3534,3974,4097,4570,15 24,2054,2120,2583,2198,2631,2724,3121,2369,2757,2828,3250,2842,3281,3354,381 2,2404,2831,2863,3340,2977,3381,3498,3954,3078,3529,3580,4008,3672,4146,4228, 4661,2465,3008,3050,3448,3154,3543,3602,4065,3213,3661,3747,4198,3843,4282,4 397,4852,3401,3759,3875,4306,3988,4431,4486,5006,4071,4531,4619,5091,4736,52 18,5378,5901,824,1216,1282,1756,1388,1831,1896,2335,1417,1918,1987,2387,2050, 2450,2551,3062,1505,2020,2133,2497,2180,2625,2598,3090,2216,2663,2733,3196,2 820,3238,3295,3789,1688,2159,2222,2622,2366,2710,2770,3255,2384,2823,2852,33 03,2894,3364,3415,3920,2407,2880,2956,3410,3073,3493,3571,4022,3138,3644,366 7,4154,3753,4236,4331,4791,1716,2361,2375,2800,2410,2837,2908,3378,2474,2982, 3042,3468,3113,3549,3655,4127,2750,3070,3158,3574,3216,3706,3765,4214,3373,3 770,3880,4315,3994,4422,4475,4992,2845,3230,3336,3711,3406,3857,3934,4356,35 07,3967,4036,4467,4119,4540,4650,5137,3591,4079,4176,4610,4266,4681,4779,525 3,4372,4826,4902,5342,4965,5524,5571,6216,1738,2418,2448,3053,2707,3098,3141, 3635,2780,3191,3242,3725,3350,3807,3914,4339,2859,3291,3395,3826,3459,3940,4 042,4450,3554,4105,4028,4512,4222,4639,4724,5184,3081,3429,3488,3980,3624,40 56,4168,4579,3695,4184,4258,4692,4323,4747,4864,5323,3849,4290,4389,4802,449 4,4926,4979,5480,4551,5079,5122,5619,5234,5693,5750,6084,3221,3504,3689,4192, 3801,4252,4298,4758,3900,4406,4439,4887,4522,4940,5107,5547,3926,4503,4590,5 064,4713,5153,5169,5721,4840,5269,5304,5776,5440,5935,6005,6505,4133,4670,47 01,5202,4875,5288,5362,5837,4952,5460,5504,5970,5644,6044,6268,6660,5034,559 5,5668,6125,5808,6170,6320,6752,5867,6374,6438,6866,6579,6995,7168,7433,11,47, 81,189,108,205,265,410,132,250,290,447,326,490,506,794,152,278,303,481,359,539, 604,823,390,598,568,860,673,908,939,1229,171,338,380,554,401,590,633,872,455,6 59,685,913,765,974,1003,1299,498,698,782,993,811,1035,1082,1346,856,1091,1140, 1442,1166,1485,1562,1925,221,348,428,653,464,679,759,948,515,788,710,1007,839, 1054,1114,1377,583,776,850,1087,882,1127,1162,1468,929,1174,1242,1525,1295,15 87,1642,2043,646,866,918,1157,983,1204,1271,1572,1026,1275,1343,1618,1389,169 7,1747,2139,1104,1369,1457,1710,1479,1751,1823,2220,1548,1845,1906,2285,1962, 2342,2443,2972,314,419,473,771,546,806,827,1109,612,844,888,1153,933,1200,121 7,1569,666,892,944,1209,998,1266,1330,1625,1049,1334,1373,1676,1464,1734,1806, 2191,723,963,1030,1290,1058,1338,1400,1714,1144,1449,1482,1760,1544,1843,188 8,2279,1212,1515,1576,1861,1621,1948,1972,2333,1701,2007,2093,2417,2155,2496, 2662,2976,747,1040,1122,1411,1192,1472,1541,1855,1234,1551,1593,1922,1646,19 69,2037,2391,1323,1632,1680,2000,1754,2076,2146,2522,1790,2164,2231,2588,230 2,2691,2752,3245,1396,1720,1771,2104,1868,2185,2244,2642,1960,2267,2336,2726, 2420,2764,2904,3390,2034,2365,2449,2839,2487,2950,3013,3515,2653,3044,3114,3 489,3186,3615,377 4,4278,370,522,560,876,619,898,954,1263,625,959,10 12, 1302, 10 68,1380,1419,1799,717,1017,1073,1431,1131,1461,1508,1803,1170,1500,1566,1904, 1635,1957,1985,2331,735,1118,1179,1438,1251,1519,1580,1953,1287,1611,1649,199 1,1690,2071,2119,2481,1283,1683,1727,2065,1786,2152,2196,2594,1874,2253,2308, 2687,2359,2746,2853,3352,800,1225,1254,1601,1315,1666,1724,2046,1354,1743,17 67,2144,1826,2217,2264,2680,1554,1810,1872,2229,1929,2296,2356,2735,2015,237 6,2464,2830,2534,2943,3021,3466,1662,1913,1997,2325,2061,2411,2472,2910,2131, 2508,2558,2968,2665,3076,3143,3576,2238,2659,2697,3116,2738,3193,3095,3652,2 874,3338,3397,3809,3422,3972,4061,4378,833,1306,1327,1784,1523,1839,1881,225 0,1607,1897,1934,2313,2012,2385,2461,2918,1656,2003,2058,2388,2101,2475,2543, 2987,2167,2567,2636,3057,2732,3131,3240,3674,1797,2073,2116,2537,2194,2615,2 706,3099,2311,2709,2755,3232,2878,3178,3371,3820,2408,2812,2936,3341,2990,34 17,3477,3922,3080,3502,3497,4038,3657,4101,4172,4596,1909,2157,2255,2715,237 9,2761,2847,3274,2467,2913,2953,3402,3040,3432,3495,3962,2546,3003,3103,3472, 3144,3509,3663,4107,3267,3696,3757,4190,3865,4302,4366,4821,2683,3123,3220,3 668,3366,3680,3841,4220,3385,3824,3932,4341,4016,4427,4546,4994,3436,3978,40 87,4469,4142,4566,4509,5051,4264,4656,4720,5221,4854,5315,5432,5756,438,576,6 39,923,692,1021,1077,1404,729,1096,1135,1427,1187,1493,1512,1938,741,1184,122 1,1489,1258,1670,1703,2031,1357,1707,1780,2134,1836,2202,2261,2723,753,1246,1 311,1687,1366,1773,1816,2178,1407,1852,1890,2274,1944,2345,2400,2769,1453,19 19,1978,2374,2049,2452,2502,2893,2080,2484,2573,2998,2585,3055,3128,3786,969, 1362,1393,1829,1435,1893,1941,2322,1533,1988,2019,2431,2088,2517,2564,2928,1 597,2028,2113,2493,2173,2579,2603,3026,2226,2606,2633,3136,2809,3198,3319,38 22,1660,2170,2209,2627,2291,2700,2717,3164,2353,2805,2861,3266,2964,3357,340 8,3938,2429,2902,2995,3411,3086,3461,3587,4020,3218,3604,3702,4115,3763,4210, 4312,4805,988,1422,1497,1976,1590,2022,2098,2528,1639,2126,2182,2612,2241,26 50,2671,3151,1741,2215,2288,2674,2348,2789,2844,3249,2423,2885,2958,3383,303 2,3441,3540,3944,1819,2319,2397,2856,2505,2942,2932,3447,2549,3010,3049,3520, 3169,3593,3637,4125,2643,3091,3206,3620,3254,3728,3768,4226,3333,3814,3886,4 345,4032,4441,4553,5001,1877,2440,2514,3018,2597,3071,3173,3609,2781,3211,32 88,3746,3302,3780,3853,4294,2819,3293,3327,3836,3452,3882,3996,4420,3562,402 6,4081,4473,4166,4605,4679,5081,2888,3482,3531,3950,3641,4044,4096,4525,3708, 4156,4234,4652,4321,4729,4835,5256,3898,4246,4354,4754,4454,4871,4918,5406,4 533,4962,5041,5472,5156,5589,5737,6185,1063,1537,1615,2128,1730,2206,2277,27 43,1764,2299,2368,2798,2437,2870,2980,3545,1858,2405,2525,2921,2576,3067,303 6,3573,2618,3108,3184,3691,3279,3734,3797,4270,2056,2555,2624,3063,2778,3159, 3227,3751,2795,3283,3312,3803,3362,3859,3916,4393,2822,3347,3427,3910,3556,3 990,4067,4482,3626,4136,4160,4612,4240,4688,4777,5197,2086,2772,2786,3259,28 26,3298,3376,3877,2896,3457,3525,3966,3598,4048,4150,4583,3201,3551,3646,407 5,3713,4196,4250,4665,3871,4260,4360,4761,4460,4861,4909,5392,3307,3723,3830, 4202,3904,4333,4408,4795,4010,4433,4497,4899,4575,4972,5071,5515,4091,4538,4 627,5031,4715,5102,5189,5622,4812,5232,5301,5706,5367,5854,5891,6465,2108,28 36,2864,3533,3156,3582,3631,4131,3235,3685,3740,4216,3847,4288,4385,4786,332 1,3791,3892,4308,3956,4412,4501,4890,4054,4561,4488,4945,4674,5059,5145,5559, 3567,3928,3984,4446,4121,4516,4621,5011,4186,4634,4706,5112,4768,5166,5266,5 687,4327,4738,4830,5210,4928,5329,5381,5814,4984,5457,5501,5939,5604,6001,60 55,6349,3717,4004,4180,4643,4284,4697,4745,5176,4374,4845,4880,5293,4955,534 0,5486,5874,4399,4935,5019,5446,5132,5530,5542,6026,5245,5638,5671,6077,5779, 6220,6280,6711,4588,5094,5125,5574,5280,5653,5725,6132,5353,5795,5831,6248,5 959,6312,6509,6843,5418,5915,5980,6387,6102,6421,6551,6923,6159,6602,6651,70 20,6773,7126,7280,7500,237,530,704,1100,817,1149,1278,1652,902,1237,1350,1737, 1446,1832,1865,2402,978,1318,1385,1812,1529,1916,2053,2446,1604,2041,1981,25 19,2188,2600,2656,3134,1044,1476,1583,1950,1629,2024,2110,2540,1758,2162,221 2,2609,2351,2720,2766,3237,1849,2236,2382,2749,2434,2825,2899,3310,2511,2916, 2992,3450,3029,3511,3617,4129,1195,1504,1693,2149,1777,2199,2339,2677,1884,2 394,2247,2775,2478,2850,2947,3355,2009,2371,2499,2907,2561,2969,3024,3486,26 39,3045,3148,3569,3228,3654,3732,4276,2137,2531,2621,3014,2729,3088,3194,363 3,2806,3203,3305,3698,3369,3805,3884,4395,2929,3343,3470,3834,3500,3890,3992, 4492,3600,4024,4103,4568,4178,4636,4752,5285,1415,1672,1793,2362,1932,2426,2 458,2939,2068,2490,2570,3006,2647,3083,3111,3628,2175,2582,2668,3096,2758,31 89,3284,3710,2841,3290,3348,3778,3480,3867,3970,4456,2271,2703,2815,3223,285 8,3296,3388,3839,3001,3455,3506,3902,3594,4018,4077,4564,3106,3553,3642,4046, 3704,4158,4188,4625,3811,4232,4337,4722,4416,4807,4977,5290,2316,2833,2961,3 404,3075,3491,3589,4034,3139,3605,3665,4123,3738,4182,4272,4695,3271,3715,37 84,4224,3896,4319,4403,4833,3948,4424,4507,4904,4592,5009,5069,5545,3380,384 5,3918,4352,4052,4452,4520,4957,4174,4548,4632,5044,4726,5084,5224,5678,4268, 4663,4756,5158,4798,5264,5326,5785,4969,5356,5423,5763,5492,5871,6008,6434,1 558,1900,1966,2552,2083,2591,2684,3181,2095,2694,2784,3243,2875,3360,3413,39 58,2258,2792,2881,3431,2979,3475,3542,3964,3037,3536,3622,4099,3721,4170,420 4,4623,2294,2955,3052,3445,3161,3558,3648,4164,3215,3687,3744,4212,3799,4310, 4370,4788,3210,3787,3855,4304,3942,4410,4465,4906,4063,4529,4594,5004,4659,5 066,5171,5641,2414,3124,3168,3676,3262,3766,3851,4280,3315,3878,3912,4401,39 98,4490,4544,4996,3611,3976,4059,4505,4134,4581,4654,5054,4242,4677,4772,514 8,4847,5261,5334,5744,3761,4113,4218,4616,4300,4717,4782,5226,4387,4819,4873, 5282,4982,5387,5449,5841,4514,4974,5014,5426,5056,5495,5403,5904,5192,5628,5 681,6033,5703,6178,6252,6523,2469,3252,3276,3936,3563,4012,4073,4527,3681,40 95,4138,4603,4238,4686,4765,5237,3749,4230,4296,4690,4349,4784,4856,5299,442 9,4883,4950,5370,5046,5437,5539,5921,3952,4317,4368,4849,4462,4931,5024,5409, 4601,5026,5074,5533,5195,5483,5659,6041,4710,5130,5250,5632,5307,5699,5753,6 136,5389,5772,5769,6232,5908,6288,6345,6695,4109,4418,4535,5029,4683,5076,51 63,5568,4775,5229,5272,5684,5351,5712,5766,6166,4859,5318,5412,5747,5452,578 2,5911,6292,5565,5942,5991,6361,6088,6456,6514,6871,4999,5429,5521,5918,5656, 5925,6066,6391,5675,6051,6144,6487,6208,6560,6656,6989,5715,6181,6272,6593,6 324,6675,6626,7040,6425,6741,6794,7153,6894,7218,7296,7490,1717,1993,2121,26 30,2223,2801,2889,3394,2282,2924,2984,3425,3068,3522,3547,4144,2305,3060,311 9,3516,3176,3772,3816,4262,3324,3828,3930,4391,4006,4471,4542,5039,2328,3153, 3257,3793,3334,3924,3982,4443,3399,4030,4083,4555,4152,4641,4704,5086,3464,4 117,4200,4672,4286,4763,4809,5208,4325,4793,4885,5312,4897,5364,5435,6016,27 12,3329,3374,4002,3438,4089,4148,4614,3578,4208,4248,4740,4335,4828,4878,524 2,3670,4256,4362,4800,4437,4894,4916,5337,4499,4921,4947,5443,5127,5498,5610, 6048,3755,4435,4480,4943,4577,5016,5036,5469,4647,5120,5179,5562,5277,5647,5 690,6147,4733,5216,5309,5696,5395,5740,5847,6212,5518,5861,5945,6296,5994,63 78,6469,6854,2741,3418,3527,4194,3659,4254,4343,4842,3727,4376,4448,4923,451 8,4967,4987,5454,3873,4484,4572,4989,4645,5109,5161,5550,4731,5200,5274,5665, 5345,5718,5805,6151,3986,4608,4699,5174,4816,5258,5248,5728,4866,5320,5359,5 788,5475,5851,5888,6304,4960,5401,5509,5877,5553,5966,5998,6395,5625,6037,61 06,6491,6228,6569,6665,7002,4069,4749,4823,5331,4911,5384,5477,5864,5099,551 2,5583,5984,5598,6012,6073,6451,5135,5586,5616,6062,5731,6099,6197,6555,5824, 6224,6264,6597,6341,6700,6762,7059,5205,5760,5798,6155,5894,6236,6284,6636,5 949,6332,6400,6736,6473,6800,6883,7182,6114,6408,6496,6816,6583,6906,6941,72 72,6641,6971,7033,7320,7105,7388,7480,7719,2867,3583,3693,4383,3861,4477,455 7,5061,3906,4585,4668,5117,4742,5187,5296,5811,4040,4708,4838,5240,4892,5376, 5348,5834,4933,5415,5489,5932,5577,5973,6023,6430,4292,4868,4938,5373,5097,5 466,5527,5987,5114,5580,5607,6030,5650,6080,6128,6532,5140,5635,5709,6121,58 21,6193,6256,6607,5881,6316,6337,6705,6404,6768,6832,7139,4329,5089,5104,555 6,5143,5592,5662,6095,5213,5734,5792,6174,5857,6240,6328,6685,5506,5818,5898, 6260,5952,6366,6412,6747,6091,6417,6500,6821,6588,6900,6935,7264,5601,5963,6 059,6370,6117,6482,6541,6849,6205,6564,6617,6929,6680,6977,7052,7345,6276,66 46,6721,7027,6789,7072,7132,7405,6860,7160,7211,7461,7249,7552,7573,7841,435 8,5150,5182,5801,5463,5844,5884,6308,5536,5928,5977,6383,6069,6447,6528,6838, 5613,6019,6110,6460,6162,6546,6621,6917,6244,6670,6612,6959,6757,7046,7098,7 370,5828,6140,6189,6574,6300,6631,6716,7008,6357,6726,6784,7078,6827,7112,71 89,7451,6478,6805,6877,7146,6947,7226,7256,7530,6983,7312,7336,7595,7396,763 0,7654,7792,5956,6201,6353,6731,6443,6778,6810,7119,6518,6888,6912,7204,6965, 7233,7328,7562,6537,6953,7014,7304,7092,7353,7362,7642,7175,7414,7442,7667,7 510,7733,7762,7936,6690,7065,7085,7379,7196,7424,7470,7692,7241,7520,7541,77 47,7607,7776,7858,7981,7288,7584,7618,7808,7680,7824,7876,8006,7706,7895,791 5,8033,7957,8064,8098,8138,12,53,93,234,128,256,350,537,158,333,384,584,429,64 0,661,1038,185,367,399,629,472,701,795,1072,512,786,740,1119,879,1177,1220,157 9,210,444,499,721,524,777,829,1132,596,863,896,1183,995,1262,1297,1664,650,911, 1024,1285,1059,1342,1397,1722,1113,1408,1470,1838,1501,1891,1983,2406,276,45 8,561,855,607,887,987,1232,671,1031,927,1303,1093,1364,1439,1761,768,1009,110 6,1402,1145,1455,1496,1871,1208,1511,1594,1939,1659,2010,2077,2541,846,1126,1 196,1491,1274,1550,1631,1994,1331,1636,1718,2048,1774,2140,2200,2652,1423,17 53,1854,2158,1883,2204,2290,2742,1963,2314,2386,2816,2451,2879,2991,3530,415, 549,618,1002,711,1052,1079,1429,803,1099,1152, 1486, 1214, 1545, 1565, 1990,871, 11 58,1226,1555,1291,1627,1704,2055,1359,1709,1757,2118,1863,2186,2270,2711,942, 1250,1337,1654,1370,1713,1787,2161,1475,1846,1887,2214,1959,2310,2363,2807,1 560,1927,1998,2334,2051,2432,2460,2871,2147,2501,2599,2962,2670,3043,3214,35 32,973,1348,1450,1800,1536,1875,1955,2327,1584,1967,2021,2403,2081,2457,2535, 2933,1695,2066,2122,2492,2207,2581,2658,3072,2249,2679,2756,3137,2835,3244,3 306,3802,1783,2168,2228,2611,2340,2702,2768,3192,2447,2796,2873,3280,2965,33 18,3460,3943,2532,2906,2996,3393,3033,3505,3568,4064,3204,3601,3671,4039,374 3,4167,4328,4836,485,681,730,1139,812,1164,1238, 1622,821, 1244, 1308, 1668, 1381, 1766,1808,2263,935,1314,1386,1825,1460,1859,1915,2266,1506,1907,1986,2380,20 70,2444,2476,2868,958,1444,1516,1834,1603,1931,2002,2441,1650,2040,2085,2482, 2132,2575,2629,3028,1645,2125,2176,2566,2246,2667,2716,3145,2347,2779,2840,3 241,2898,3299,3407,3905,1045,1574,1612,2029,1686,2107,2172,2547,1731,2197,22 25,2655,2293,2739,2793,3231,1975,2273,2344,2754,2409,2829,2895,3289,2510,291 7,3009,3384,3084,3501,3577,4017,2100,2393,2488,2860,2563,2957,3017,3467,2644, 3056,3107,3523,3217,3634,3699,4126,2762,3212,3251,3673,3292,3748,3651,4203,3 428,3893,3949,4363,3973,4524,4611,4939,1086,1673,1700,2242,1935,2307,2357,27 76,2036,2373,2419,2849,2507,2927,3007,3474,2092,2498,2560,2930,2608,3022,309 2,3544,2682,3117,3187,3614,3285,3688,3796,4225,2259,2578,2626,3087,2714,3165, 3258,3656,2843,3260,3308,3788,3435,3735,3925,4373,2951,3368,3492,3895,3546,3 968,4029,4474,3636,4053,4047,4589,4209,4653,4727,5157,2390,2673,2782,3268,29 22,3316,3403,3829,3012,3469,3510,3955,3597,3985,4045,4513,3094,3561,3660,402 3,3701,4058,4215,4660,3823,4249,4311,4746,4419,4860,4925,5380,3234,3679,3777, 4221,3919,4231,4396,4776,3939,4379,4485,4900,4567,4986,5106,5548,3987,4530,4 637,5028,4696,5126,5070,5605,4822,5217,5279,5764,5411,5850,5954,6239,573,758, 838,1202,903,1320,1391,1792,950,1413,1465,1821, 1531, 1899, 1920,2422,965, 1521,1 570,1895,1617,2111,2150,2529,1735,2154,2239,2646,2304,2722,2788,3277,980,159 8,1677,2129,1744,2232,2280,2696,1796,2324,2367,2802,2428,2882,2944,3323,1850, 2399,2470,2914,2550,2999,3048,3449,2584,3030,3122,3555,3135,3612,3684,4340,1 256,1740,1779,2297,1830,2370,2425,2857,1947,2479,2513,2978,2596,3064,3115,34 83,2025,2526,2623,3041,2690,3130,3152,3584,2751,3157,3185,3692,3365,3754,387 2,4377,2096,2688,2731,3177,2821,3253,3270,3720,2892,3358,3416,3821,3521,3911, 3959,4491,2975,3458,3552,3963,3643,4011,4139,4573,3773,4155,4255,4667,4316,4 766,4872,5363,1280,1817,1903,2463,2013,2516,2605,3077,2074,2635,2699,3162,27 65,3202,3222,3707,2193,2737,2818,3226,2887,3344,3400,3804,2967,3439,3514,393 5,3588,3993,4088,4496,2283,2854,2941,3412,3054,3499,3490,3999,3100,3566,3606, 4068,3726,4145,4189,4678,3195,3647,3762,4173,3810,4283,4322,4781,3887,4369,4 442,4905,4584,5000,5113,5557,2354,2989,3061,3575,3147,3627,3729,4161,3335,37 69,3844,4301,3856,4334,4407,4851,3372,3848,3881,4390,4003,4436,4547,4981,411 2,4578,4631,5033,4721,5167,5239,5634,3444,4033,4080,4502,4191,4595,4648,5085, 4261,4709,4790,5212,4881,5289,5394,5796,4453,4803,4913,5314,5015,5428,5476,5 931,5093,5519,5596,5990,5705,6094,6223,6606,1375,1951,2044,2638,2179,2725,28 04,3297,2221,2832,2909,3353,2983,3426,3537,4094,2330,2949,3074,3478,3127,362 3,3592,4124,3170,3664,3741,4243,3835,4289,4351,4827,2556,3105,3175,3621,3332, 3716,3781,4307,3351,3837,3868,4357,3917,4413,4470,4953,3377,3901,3979,4464,4 106,4541,4617,5042,4177,4691,4716,5172,4796,5249,5336,5743,2590,3328,3342,38 15,3382,3854,3929,4430,3451,4009,4074,4519,4149,4600,4703,5144,3756,4102,419 7,4626,4265,4751,4808,5225,4425,4817,4919,5319,5020,5421,5467,5919,3862,4277, 4384,4757,4459,4891,4966,5354,4562,4991,5057,5458,5136,5528,5626,6028,4642,5 098,5190,5587,5275,5655,5738,6122,5371,5775,5839,6195,5896,6325,6356,6839,26 14,3391,3419,4082,3712,4132,4183,4684,3790,4237,4295,4771,4402,4846,4944,534 6,3876,4346,4447,4865,4508,4973,5062,5447,4606,5121,5048,5502,5235,5614,5697, 6067,4118,4479,4536,5007,4673,5077,5180,5566,4741,5194,5265,5664,5328,5717,5 807,6180,4886,5297,5388,5755,5484,5862,5907,6289,5540,5978,6017,6396,6107,64 52,6495,6743,4271,4556,4735,5203,4841,5257,5305,5726,4932,5404,5438,5830,551 0,5873,6002,6340,4958,5493,5575,5967,5685,6040,6053,6472,5787,6137,6164,6516, 6258,6634,6684,7039,5149,5646,5676,6079,5819,6149,6211,6561,5885,6274,6305,6 659,6415,6713,6874,7148,5943,6376,6432,6774,6536,6803,6909,7209,6585,6950,69 92,7284,7088,7371,7488,7655,296,691,919,1418,1065,1480,1640,2089,1171,1589,17 26,2190,1842,2300,2337,2946,1268,1691,1770,2276,1943,2396,2553,2994,2032,253 8,2473,3069,2705,3150,3207,3690,1353,1879,2006,2435,2059,2523,2620,3089,2211, 2676,2734,3160,2890,3273,3320,3794,2317,2759,2925,3304,2981,3379,3456,3864,3 059,3471,3548,4001,3586,4060,4169,4682,1540,1911,2136,2661,2235,2719,2876,32 29,2360,2938,2773,3330,3025,3405,3503,3909,2504,2911,3046,3462,3110,3526,358 1,4037,3190,3603,3703,4120,3785,4207,4287,4832,2649,3079,3172,3572,3282,3645, 3752,4187,3361,3760,3860,4251,3921,4359,4438,4956,3485,3897,4019,4388,4051,4 444,4545,5053,4153,4576,4657,5129,4732,5198,5311,5825,1804,2114,2256,2903,24 15,2973,3002,3494,2572,3038,3120,3564,3200,3640,3669,4181,2693,3132,3219,365 3,3311,3745,3840,4263,3396,3846,3903,4332,4031,4421,4523,5017,2799,3256,3370, 3779,3414,3852,3941,4394,3557,4007,4055,4455,4147,4571,4629,5124,3662,4104,4 195,4598,4257,4712,4743,5186,4365,4789,4896,5283,4975,5366,5534,5827,2851,33 89,3517,3957,3632,4041,4141,4587,3697,4159,4217,4676,4291,4737,4831,5254,382 7,4269,4338,4780,4449,4877,4964,5391,4500,4983,5068,5461,5152,5563,5623,6056, 3933,4400,4472,4910,4604,5012,5082,5513,4728,5110,5191,5599,5286,5637,5767,6 171,4824,5223,5317,5708,5357,5804,5859,6263,5525,5887,5946,6245,6007,6338,64 55,6815,1979,2377,2454,3102,2587,3142,3239,3737,2602,3246,3339,3798,3433,391 3,3965,4511,2785,3346,3437,3981,3535,4025,4090,4517,3595,4086,4175,4651,4275, 4723,4760,5183,2824,3512,3608,3995,3718,4110,4201,4718,3771,4241,4297,4767,4 353,4869,4930,5349,3764,4342,4409,4863,4495,4970,5025,5464,4615,5090,5155,55 60,5220,5620,5720,6139,2959,3682,3724,4229,3819,4320,4405,4837,3870,4432,446 6,4961,4550,5050,5105,5551,4163,4528,4609,5065,4687,5141,5214,5608,4799,5238, 5332,5700,5407,5802,5868,6230,4314,4666,4774,5178,4858,5276,5339,5770,4948,5 377,5431,5822,5537,5913,5969,6311,5073,5531,5569,5948,5611,6010,5929,6367,57 39,6127,6173,6479,6192,6599,6663,6886,3015,3806,3831,4489,4116,4565,4624,508 7,4235,4646,4693,5164,4794,5246,5325,5778,4303,4785,4855,5251,4908,5343,5414, 5836,4990,5441,5508,5899,5602,5961,6049,6382,4506,4874,4927,5408,5023,5487,5 578,5934,5160,5581,5629,6043,5741,5999,6156,6485,5271,5682,5793,6131,5842,61 90,6235,6563,5916,6254,6251,6644,6369,6692,6739,7026,4662,4978,5096,5584,524 3,5631,5714,6076,5335,5773,5810,6177,5882,6202,6249,6591,5417,5853,5937,6233, 5972,6261,6373,6696,6074,6399,6442,6754,6522,6830,6878,7166,5554,5951,6035,6 380,6152,6386,6506,6777,6168,6492,6571,6858,6627,6918,6997,7263,6204,6603,66 77,6942,6720,7009,6972,7300,6807,7066,7106,7392,7185,7439,7501,7646,2165,248 5,2632,3180,2745,3356,3446,3947,2813,3481,3541,3977,3625,4072,4098,4698,2838, 3616,3675,4066,3733,4326,4371,4818,3879,4382,4483,4949,4560,5032,5101,5593,2 862,3709,3813,4348,3889,4478,4534,5003,3951,4582,4635,5116,4707,5201,5263,56 40,4015,4671,4755,5231,4844,5322,5368,5752,4882,5350,5444,5848,5455,5893,595 7,6462,3265,3885,3927,4552,3989,4640,4702,5175,4130,4762,4804,5300,4895,5386, 5434,5784,4223,4813,4922,5360,4998,5451,5473,5870,5058,5478,5505,5964,5679,6 014,6112,6489,4309,4995,5040,5499,5138,5572,5590,5986,5209,5673,5729,6071,58 16,6143,6183,6575,5294,5761,5845,6186,5923,6226,6318,6630,6031,6331,6402,669 9,6445,6766,6842,7157,3294,3971,4076,4748,4211,4810,4903,5400,4281,4936,5008, 5481,5078,5522,5543,5975,4426,5045,5133,5546,5206,5661,5711,6058,5291,5746,5 813,6161,5876,6207,6283,6577,4539,5168,5260,5723,5374,5799,5790,6214,5424,58 56,5890,6267,5993,6321,6354,6707,5516,5926,6022,6343,6061,6422,6449,6781,612 4,6483,6540,6862,6642,6926,7000,7269,4620,5308,5383,5865,5470,5910,5996,6334, 5652,6025,6089,6435,6101,6458,6512,6826,5688,6092,6119,6502,6217,6533,6616,6 914,6299,6638,6673,6946,6735,7030,7079,7316,5749,6242,6277,6581,6360,6648,66 88,6980,6406,6728,6785,7061,6846,7110,7176,7410,6547,6792,6865,7124,6934,719 4,7224,7482,6984,7248,7294,7519,7354,7574,7638,7822,3423,4135,4245,4941,4415, 5037,5118,5617,4461,5146,5228,5670,5303,5735,5833,6286,4593,5268,5397,5781,5 450,5905,5879,6309,5490,5940,6004,6393,6082,6426,6468,6812,4850,5427,5496,59 02,5649,5983,6038,6439,5667,6085,6109,6475,6146,6520,6557,6893,5691,6134,619 9,6553,6295,6613,6667,6955,6347,6717,6732,7035,6788,7083,7138,7381,4888,5643, 5658,6064,5694,6097,6158,6530,5758,6221,6270,6595,6327,6652,6724,7018,6020,6 293,6363,6669,6409,6758,6796,7070,6526,6799,6869,7129,6938,7190,7219,7475,61 04,6419,6499,6761,6550,6855,6902,7152,6623,6922,6963,7214,7013,7253,7310,753 9,6681,6988,7048,7290,7101,7326,7375,7588,7162,7398,7434,7624,7463,7694,7711, 7914,4917,5702,5732,6279,5981,6315,6350,6710,6046,6389,6428,6770,6510,6823,6 890,7143,6116,6466,6543,6835,6589,6905,6967,7205,6655,7005,6958,7238,7075,73 05,7348,7559,6302,6567,6609,6930,6703,6975,7043,7274,6750,7053,7096,7332,713 4,7359,7416,7616,6850,7115,7171,7386,7229,7445,7469,7677,7259,7514,7533,7728, 7580,7754,7773,7878,6413,6620,6746,7057,6819,7093,7120,7365,6881,7180,7199,7 427,7244,7452,7526,7702,6897,7234,7279,7507,7342,7546,7553,7764,7404,7594,76 09,7782,7662,7833,7854,7987,7022,7321,7337,7567,7421,7602,7632,7802,7457,767 0,7686,7844,7737,7866,7928,8021,7494,7720,7745,7889,7793,7902,7942,8040,7812, 7955,7971,8061,8003,8084,8111,8145,315,749,1016,1608,1189,1682,1923,2412,132 5,1867,2017,2520,2143,2641,2685,3363,1434,1971,2063,2617,2252,2771,2935,3421, 2350,2919,2846,3496,3097,3590,3649,4157,1526,2183,2320,2810,2383,2901,3004,3 519,2544,3066,3125,3599,3301,3714,3767,4273,2664,3155,3337,3750,3398,3825,39 07,4350,3487,3923,4005,4498,4049,4563,4675,5154,1748,2218,2466,3051,2569,311 2,3287,3666,2708,3349,3182,3775,3453,3858,3961,4398,2884,3325,3476,3915,3539, 3983,4043,4537,3630,4062,4179,4622,4267,4711,4787,5295,3035,3508,3610,4035,3 731,4114,4227,4689,3808,4233,4344,4753,4417,4862,4929,5405,3945,4386,4521,48 79,4554,4934,5027,5494,4655,5055,5131,5564,5199,5624,5727,6213,2103,2438,259 3,3313,2790,3386,3430,3953,2954,3465,3550,4027,3638,4108,4137,4685,3082,3559, 3658,4122,3758,4219,4324,4764,3850,4330,4392,4834,4532,4912,5005,5462,3209,3 694,3817,4259,3866,4336,4434,4884,4013,4510,4558,4946,4649,5052,5108,5558,41 28,4607,4694,5075,4759,5181,5211,5615,4867,5252,5352,5701,5422,5780,5938,621 5,3263,3833,3975,4451,4092,4543,4644,5067,4165,4658,4719,5151,4792,5207,5287, 5674,4313,4773,4839,5244,4937,5333,5413,5806,4985,5433,5507,5869,5582,5965,6 021,6431,4428,4893,4959,5365,5083,5456,5520,5920,5196,5544,5618,5997,5704,60 32,6154,6539,5284,5648,5733,6098,5771,6194,6246,6628,5930,6271,6329,6610,638 5,6697,6802,7108,2287,2728,2827,3528,2970,3570,3677,4213,2986,3686,3783,4279, 3883,4404,4463,4997,3197,3792,3891,4481,3991,4526,4597,5002,4057,4586,4680,5 128,4778,5193,5227,5612,3236,3969,4070,4493,4193,4613,4700,5188,4253,4744,47 97,5233,4853,5327,5382,5765,4247,4843,4901,5321,4980,5419,5468,5875,5092,552 9,5588,5962,5642,6015,6111,6511,3375,4151,4199,4730,4299,4820,4898,5298,4361, 4924,4954,5410,5030,5491,5541,5955,4664,5010,5088,5503,5159,5576,5639,6006,5 262,5660,5748,6090,5817,6188,6253,6594,4815,5139,5241,5606,5316,5695,5757,61 60,5396,5791,5840,6209,5941,6298,6351,6671,5514,5936,5971,6330,6009,6390,631 3,6722,6129,6501,6544,6824,6562,6925,6978,7165,3442,4285,4318,4976,4618,5047, 5100,5526,4739,5119,5165,5594,5259,5669,5745,6167,4806,5247,5313,5672,5361,5 759,5826,6225,5436,5849,5914,6282,6003,6342,6427,6737,4993,5330,5379,5820,54 65,5895,5979,6317,5591,5982,6024,6420,6133,6379,6525,6831,5692,6075,6182,650 3,6227,6558,6601,6895,6301,6619,6615,6964,6725,7003,7045,7283,5134,5425,5532, 5988,5663,6029,6105,6453,5751,6163,6196,6548,6269,6570,6614,6919,5829,6238,6 319,6598,6352,6624,6729,7006,6448,6751,6791,7056,6859,7122,7158,7395,5958,63 35,6411,6733,6521,6740,6845,7074,6535,6834,6901,7144,6951,7192,7257,7476,657 2,6928,6993,7215,7028,7267,7237,7502,7100,7314,7346,7575,7411,7613,7659,7775, 2495,2865,3020,3619,3140,3800,3899,4440,3224,3931,3997,4476,4084,4574,4602,5 170,3248,4078,4143,4569,4205,4825,4870,5281,4367,4876,4971,5399,5043,5474,55 38,5995,3275,4185,4293,4848,4380,4963,5018,5448,4445,5063,5111,5552,5177,562 7,5683,6036,4515,5147,5219,5657,5302,5736,5786,6145,5338,5768,5855,6234,5866, 6281,6339,6809,3705,4375,4423,5035,4487,5115,5173,5603,4633,5230,5267,5716,5 347,5800,5846,6175,4725,5278,5375,5777,5442,5860,5883,6257,5500,5886,5912,63 46,6072,6394,6486,6833,4811,5439,5482,5906,5570,5974,5989,6368,5636,6068,611 8,6446,6206,6515,6552,6904,5713,6153,6231,6554,6306,6590,6678,6954,6410,6689, 6755,7011,6795,7068,7128,7387,3739,4468,4580,5215,4714,5270,5358,5812,4783,5 390,5453,5892,5517,5927,5947,6358,4920,5488,5567,5950,5630,6054,6103,6433,57 07,6138,6200,6534,6262,6576,6645,6908,5022,5600,5680,6113,5789,6187,6179,658 0,5832,6243,6275,6632,6372,6682,6712,7017,5922,6310,6401,6701,6437,6772,6798, 7077,6497,6828,6873,7147,6961,7200,7260,7479,5095,5724,5797,6250,5878,6294,6 375,6693,6047,6405,6463,6783,6474,6806,6852,7117,6081,6467,6493,6841,6584,68 70,6939,7188,6661,6957,6990,7217,7042,7287,7325,7515,6141,6605,6639,6911,671 4,6968,6999,7245,6759,7036,7082,7311,7133,7350,7402,7589,6880,7089,7151,7363, 7207,7419,7441,7649,7250,7462,7497,7674,7547,7717,7769,7906,3874,4638,4750,5 393,4907,5479,5555,6013,4951,5579,5651,6063,5722,6126,6219,6649,5072,5689,58 09,6169,5858,6290,6265,6668,5897,6323,6384,6748,6457,6776,6817,7103,5310,583 8,5903,6287,6045,6364,6416,6787,6060,6459,6481,6820,6519,6856,6891,7173,6083, 6507,6566,6887,6657,6936,6981,7222,6704,7024,7038,7291,7086,7330,7374,7565,5 344,6039,6052,6441,6087,6471,6529,6867,6148,6587,6635,6921,6686,6970,7032,72 76,6397,6653,6718,6986,6763,7060,7091,7318,6863,7097,7155,7366,7210,7415,743 7,7644,6477,6769,6837,7063,6884,7140,7181,7383,6948,7195,7230,7432,7271,7466, 7511,7690,6996,7252,7299,7493,7343,7524,7561,7729,7391,7579,7608,7758,7634,7 807,7819,7977,5369,6096,6120,6640,6362,6674,6708,7021,6423,6744,6780,7071,68 48,7114,7169,7378,6488,6813,6876,7125,6915,7184,7232,7428,6974,7265,7225,745 4,7323,7505,7543,7707,6664,6898,6932,7202,7015,7240,7295,7484,7054,7302,7339, 7528,7369,7551,7593,7752,7136,7355,7400,7570,7446,7619,7639,7795,7472,7669,7 685,7834,7723,7853,7869,7949,6765,6944,7050,7307,7111,7334,7358,7556,7163,74 07,7423,7604,7458,7623,7679,7814,7177,7449,7487,7664,7537,7696,7700,7861,758 5,7735,7746,7875,7783,7916,7931,8031,7278,7521,7534,7712,7599,7740,7765,7891, 7628,7788,7800,7923,7840,7940,7988,8057,7653,7827,7847,7959,7883,7967,7997,8 072,7899,8009,8019,8088,8044,8105,8126,8152,1813,2748,3167,3937,3409,4021,42 39,4801,3579,4171,4355,4915,4504,5038,5080,5686,3722,4305,4411,5013,4628,514 2,5306,5730,4734,5292,5222,5803,5459,5880,5933,6344,3842,4549,4705,5185,4769, 5273,5372,5823,4942,5430,5485,5889,5633,5992,6034,6424,5060,5511,5666,6018,5 719,6086,6150,6480,5794,6165,6229,6582,6259,6625,6698,7019,4100,4591,4857,54 16,4968,5471,5621,5953,5103,5677,5523,6042,5762,6108,6191,6513,5255,5654,578 3,6157,5843,6210,6255,6608,5917,6273,6355,6666,6418,6723,6775,7107,5402,5815, 5900,6247,6000,6307,6392,6709,6070,6398,6476,6753,6524,6822,6872,7174,6176,6 504,6596,6840,6618,6875,6937,7228,6687,6956,7004,7268,7049,7303,7361,7601,44 57,4829,4988,5645,5162,5710,5742,6184,5324,5774,5852,6241,5924,6303,6326,670 6,5445,5863,5944,6314,6027,6388,6461,6760,6100,6464,6508,6804,6604,6861,6924, 7208,5549,5976,6078,6414,6115,6470,6538,6844,6237,6586,6622,6882,6683,6952,6 987,7266,6322,6654,6715,6969,6756,7037,7055,7298,6825,7081,7142,7347,7186,73 89,7468,7603,5597,6093,6203,6549,6297,6611,6679,6962,6348,6691,6730,7016,677 9,7051,7104,7333,6450,6764,6808,7076,6879,7131,7179,7401,6910,7191,7236,7435, 7281,7483,7509,7701,6531,6847,6892,7150,6973,7206,7243,7459,7047,7258,7301,7 498,7349,7516,7576,7749,7102,7317,7364,7548,7384,7592,7617,7785,7465,7629,76 56,7778,7682,7813,7855,7970,4669,5123,5204,5835,5341,5872,5960,6381,5355,596 8,6050,6429,6130,6517,6556,6916,5535,6057,6135,6568,6218,6600,6647,6920,6266, 6643,6702,7001,6767,7044,7064,7297,5573,6198,6278,6578,6365,6658,6719,7041,6 407,6745,6782,7069,6818,7127,7161,7380,6403,6811,6853,7123,6907,7183,7213,74 36,6979,7247,7282,7481,7315,7508,7554,7736,5698,6336,6371,6738,6444,6797,685 1,7109,6484,6868,6889,7178,6940,7227,7255,7477,6694,6927,6976,7235,7023,7275, 7313,7503,7087,7324,7372,7544,7408,7591,7621,7771,6793,7010,7073,7293,7121,7 344,7376,7577,7170,7394,7420,7600,7471,7641,7665,7803,7239,7467,7485,7657,75 04,7683,7648,7823,7563,7731,7750,7863,7757,7904,7924,7991,5754,6436,6454,690 3,6662,6949,6985,7246,6742,6998,7025,7286,7084,7329,7368,7581,6786,7080,7118, 7331,7149,7377,7412,7606,7193,7425,7456,7635,7499,7661,7699,7829,6913,7130,7 159,7409,7212,7447,7489,7650,7285,7491,7512,7697,7564,7678,7742,7865,7341,75 36,7587,7732,7610,7756,7774,7892,7643,7781,7780,7919,7825,7933,7948,8028,700 7,7187,7251,7492,7327,7513,7550,7710,7373,7578,7596,7751,7627,7760,7779,7901, 7413,7614,7651,7772,7666,7784,7826,7934,7709,7835,7850,7952,7879,7975,7989,8 062,7478,7658,7693,7828,7741,7830,7872,7960,7748,7868,7894,7983,7912,7999,80 20,8083,7761,7905,7929,8007,7943,8024,8014,8091,7968,8038,8048,8109,8067,811 8,8128,8151,4889,5236,5385,5909,5497,6065,6142,6542,5561,6172,6222,6565,6291, 6633,6650,7029,5585,6285,6333,6629,6377,6801,6829,7099,6490,6836,6899,7172,6 945,7216,7254,7496,5609,6359,6440,6814,6498,6896,6931,7201,6545,6960,6991,72 61,7034,7306,7338,7517,6592,7012,7062,7322,7113,7367,7390,7569,7135,7382,742 6,7612,7431,7633,7660,7857,5985,6494,6527,6943,6573,6994,7031,7292,6672,7067, 7090,7356,7141,7399,7422,7583,6734,7095,7156,7385,7198,7430,7440,7622,7231,7 443,7455,7663,7535,7684,7725,7867,6790,7197,7221,7453,7273,7486,7495,7673,73 09,7532,7557,7708,7598,7738,7753,7896,7352,7572,7611,7755,7645,7770,7805,791 3,7691,7810,7836,7935,7851,7956,7978,8059,6011,6559,6637,7058,6727,7094,7145, 7406,6771,7164,7203,7444,7242,7464,7473,7668,6864,7223,7270,7474,7308,7527,7 549,7703,7351,7566,7597,7744,7625,7763,7791,7897,6933,7289,7335,7555,7393,75 90,7586,7766,7417,7615,7631,7786,7675,7806,7818,7938,7460,7647,7688,7815,770 4,7843,7852,7961,7730,7864,7884,7984,7918,8001,8022,8085,6982,7360,7397,7620, 7438,7640,7676,7811,7523,7689,7715,7848,7721,7856,7874,7974,7538,7716,7727,7 871,7767,7882,7909,7998,7798,7917,7927,8008,7947,8029,8042,8094,7568,7777,77 89,7898,7820,7920,7932,8016,7837,7945,7962,8037,7979,8049,8065,8113,7886,796 4,7985,8052,8004,8069,8075,8125,8017,8080,8090,8131,8102,8140,8150,8171,6123, 6676,6749,7167,6857,7220,7262,7506,6885,7277,7319,7531,7357,7560,7605,7794,6 966,7340,7403,7582,7429,7637,7626,7801,7448,7652,7681,7832,7713,7845,7860,79 69,7116,7418,7450,7636,7522,7672,7695,7849,7529,7714,7724,7862,7739,7877,789 0,7993,7540,7734,7759,7888,7797,7908,7925,8010,7816,7941,7946,8030,7963,8043, 8055,8107,7137,7518,7525,7705,7542,7718,7743,7881,7571,7768,7787,7903,7809,7 921,7944,8026,7687,7796,7821,7926,7838,7953,7965,8039,7880,7966,7986,8053,80 05,8068,8074,8124,7722,7842,7870,7954,7887,7982,7995,8058,7911,8000,8012,807 3,8025,8081,8093,8134,7930,8018,8034,8089,8047,8096,8106,8142,8060,8110,8117, 8148,8122,8157,8159,8179,7154,7545,7558,7790,7671,7804,7817,7939,7698,7831,7 846,7958,7873,7973,7992,8056,7726,7859,7885,7976,7900,7996,8013,8071,7922,80 23,8011,8078,8041,8092,8101,8137,7799,7893,7907,8002,7937,8015,8032,8086,795 1,8035,8046,8097,8054,8103,8114,8147,7980,8050,8063,8108,8076,8119,8123,8155, 8082,8130,8133,8161,8141,8164,8166,8176,7839,7910,7950,8036,7972,8045,8051,8 104,7990,8066,8070,8116,8079,8120,8132,8158,7994,8077,8087,8129,8100,8135,81 36,8165,8112,8143,8146,8167,8153,8172,8174,8184,8027,8095,8099,8139,8115,814 4,8149,8169,8121,8154,8156,8173,8162,8175,8180,8186,8127,8160,8163,8177,8168, 8178,8181,8187,8170,8182,8183,8188,8185,8189,8190,8191];

**Table Z1, with a sequence length of 8192:**

| Polarized channel sequence number | Reliability or reliability sequence number | Polarized channel sequence number | Reliability or reliability sequence number | Polarized channel sequence number | Reliability or reliability sequence number | Polarized channel sequence number | Reliability or reliability sequence number | Polarized channel sequence number | Reliability or reliability sequence number | Polarized channel sequence number | Reliability or reliability sequence number | Polarized channel sequence number | Reliability or reliability sequence number | Polarized channel sequence number | Reliability or reliability sequence number |
|---|---|---|---|---|---|---|---|---|---|---|---|---|---|---|---|
| 0 | 0 | 1024 | 10 | 2048 | 11 | 3072 | 237 | 4096 | 12 | 5120 | 296 | 6144 | 315 | 7168 | 1813 |
| 1 | 1 | 1025 | 41 | 2049 | 47 | 3073 | 530 | 4097 | 53 | 5121 | 691 | 6145 | 749 | 7169 | 2748 |
| 2 | 2 | 1026 | 68 | 2050 | 81 | 3074 | 704 | 4098 | 93 | 5122 | 919 | 6146 | 1016 | 7170 | 3167 |
| 3 | 7 | 1027 | 149 | 2051 | 189 | 3075 | 1100 | 4099 | 234 | 5123 | 1418 | 6147 | 1608 | 7171 | 3937 |
| 4 | 3 | 1028 | 88 | 2052 | 108 | 3076 | 817 | 4100 | 128 | 5124 | 1065 | 6148 | 1189 | 7172 | 3409 |
| 5 | 8 | 1029 | 162 | 2053 | 205 | 3077 | 1149 | 4101 | 256 | 5125 | 1480 | 6149 | 1682 | 7173 | 4021 |
| 6 | 14 | 1030 | 196 | 2054 | 265 | 3078 | 1278 | 4102 | 350 | 5126 | 1640 | 6150 | 1923 | 7174 | 4239 |
| 7 | 27 | 1031 | 310 | 2055 | 410 | 3079 | 1652 | 4103 | 537 | 5127 | 2089 | 6151 | 2412 | 7175 | 4801 |
| 8 | 4 | 1032 | 105 | 2056 | 132 | 3080 | 902 | 4104 | 158 | 5128 | 1171 | 6152 | 1325 | 7176 | 3579 |
| 9 | 13 | 1033 | 184 | 2057 | 250 | 3081 | 1237 | 4105 | 333 | 5129 | 1589 | 6153 | 1867 | 7177 | 4171 |
| 10 | 16 | 1034 | 216 | 2058 | 290 | 3082 | 1350 | 4106 | 384 | 5130 | 1726 | 6154 | 2017 | 7178 | 4355 |
| 11 | 31 | 1035 | 340 | 2059 | 447 | 3083 | 1737 | 4107 | 584 | 5131 | 2190 | 6155 | 2520 | 7179 | 4915 |
| 12 | 19 | 1036 | 244 | 2060 | 326 | 3084 | 1446 | 4108 | 429 | 5132 | 1842 | 6156 | 2143 | 7180 | 4504 |
| 13 | 36 | 1037 | 374 | 2061 | 490 | 3085 | 1832 | 4109 | 640 | 5133 | 2300 | 6157 | 2641 | 7181 | 5038 |
| 14 | 38 | 1038 | 386 | 2062 | 506 | 3086 | 1865 | 4110 | 661 | 5134 | 2337 | 6158 | 2685 | 7182 | 5080 |
| 15 | 84 | 1039 | 609 | 2063 | 794 | 3087 | 2402 | 4111 | 1038 | 5135 | 2946 | 6159 | 3363 | 7183 | 5686 |
| 16 | 5 | 1040 | 121 | 2064 | 152 | 3088 | 978 | 4112 | 185 | 5136 | 1268 | 6160 | 1434 | 7184 | 3722 |
| 17 | 15 | 1041 | 207 | 2065 | 278 | 3089 | 1318 | 4113 | 367 | 5137 | 1691 | 6161 | 1971 | 7185 | 4305 |
| 18 | 17 | 1042 | 226 | 2066 | 303 | 3090 | 1385 | 4114 | 399 | 5138 | 1770 | 6162 | 2063 | 7186 | 4411 |
| 19 | 35 | 1043 | 366 | 2067 | 481 | 3091 | 1812 | 4115 | 629 | 5139 | 2276 | 6163 | 2617 | 7187 | 5013 |
| 20 | 22 | 1044 | 270 | 2068 | 359 | 3092 | 1529 | 4116 | 472 | 5140 | 1943 | 6164 | 2252 | 7188 | 4628 |
| 21 | 42 | 1045 | 405 | 2069 | 539 | 3093 | 1916 | 4117 | 701 | 5141 | 2396 | 6165 | 2771 | 7189 | 5142 |
| 22 | 52 | 1046 | 459 | 2070 | 604 | 3094 | 2053 | 4118 | 795 | 5142 | 2553 | 6166 | 2935 | 7190 | 5306 |
| 23 | 89 | 1047 | 628 | 2071 | 823 | 3095 | 2446 | 4119 | 1072 | 5143 | 2994 | 6167 | 3421 | 7191 | 5730 |
| 24 | 25 | 1048 | 294 | 2072 | 390 | 3096 | 1604 | 4120 | 512 | 5144 | 2032 | 6168 | 2350 | 7192 | 4734 |
| 25 | 51 | 1049 | 453 | 2073 | 598 | 3097 | 2041 | 4121 | 786 | 5145 | 2538 | 6169 | 2919 | 7193 | 5292 |
| 26 | 46 | 1050 | 431 | 2074 | 568 | 3098 | 1981 | 4122 | 740 | 5146 | 2473 | 6170 | 2846 | 7194 | 5222 |
| 27 | 97 | 1051 | 660 | 2075 | 860 | 3099 | 2519 | 4123 | 1119 | 5147 | 3069 | 6171 | 3496 | 7195 | 5803 |
| 28 | 63 | 1052 | 514 | 2076 | 673 | 3100 | 2188 | 4124 | 879 | 5148 | 2705 | 6172 | 3097 | 7196 | 5459 |
| 29 | 106 | 1053 | 696 | 2077 | 908 | 3101 | 2600 | 4125 | 1177 | 5149 | 3150 | 6173 | 3590 | 7197 | 5880 |
| 30 | 113 | 1054 | 722 | 2078 | 939 | 3102 | 2656 | 4126 | 1220 | 5150 | 3207 | 6174 | 3649 | 7198 | 5933 |
| 31 | 182 | 1055 | 961 | 2079 | 1229 | 3103 | 3134 | 4127 | 1579 | 5151 | 3690 | 6175 | 4157 | 7199 | 6344 |
| 32 | 6 | 1056 | 137 | 2080 | 171 | 3104 | 1044 | 4128 | 210 | 5152 | 1353 | 6176 | 1526 | 7200 | 3842 |
| 33 | 20 | 1057 | 253 | 2081 | 338 | 3105 | 1476 | 4129 | 444 | 5153 | 1879 | 6177 | 2183 | 7201 | 4549 |
| 34 | 24 | 1058 | 287 | 2082 | 380 | 3106 | 1583 | 4130 | 499 | 5154 | 2006 | 6178 | 2320 | 7202 | 4705 |
| 35 | 44 | 1059 | 418 | 2083 | 554 | 3107 | 1950 | 4131 | 721 | 5155 | 2435 | 6179 | 2810 | 7203 | 5185 |
| 36 | 26 | 1060 | 302 | 2084 | 401 | 3108 | 1629 | 4132 | 524 | 5156 | 2059 | 6180 | 2383 | 7204 | 4769 |
| 37 | 50 | 1061 | 448 | 2085 | 590 | 3109 | 2024 | 4133 | 777 | 5157 | 2523 | 6181 | 2901 | 7205 | 5273 |
| 38 | 57 | 1062 | 482 | 2086 | 633 | 3110 | 2110 | 4134 | 829 | 5158 | 2620 | 6182 | 3004 | 7206 | 5372 |
| 39 | 99 | 1063 | 669 | 2087 | 872 | 3111 | 2540 | 4135 | 1132 | 5159 | 3089 | 6183 | 3519 | 7207 | 5823 |
| 40 | 32 | 1064 | 346 | 2088 | 455 | 3112 | 1758 | 4136 | 596 | 5160 | 2211 | 6184 | 2544 | 7208 | 4942 |
| 41 | 61 | 1065 | 503 | 2089 | 659 | 3113 | 2162 | 4137 | 863 | 5161 | 2676 | 6185 | 3066 | 7209 | 5430 |
| 42 | 65 | 1066 | 525 | 2090 | 685 | 3114 | 2212 | 4138 | 896 | 5162 | 2734 | 6186 | 3125 | 7210 | 5485 |
| 43 | 107 | 1067 | 700 | 2091 | 913 | 3115 | 2609 | 4139 | 1183 | 5163 | 3160 | 6187 | 3599 | 7211 | 5889 |
| 44 | 78 | 1068 | 586 | 2092 | 765 | 3116 | 2351 | 4140 | 995 | 5164 | 2890 | 6188 | 3301 | 7212 | 5633 |
| 45 | 120 | 1069 | 752 | 2093 | 974 | 3117 | 2720 | 4141 | 1262 | 5165 | 3273 | 6189 | 3714 | 7213 | 5992 |
| 46 | 126 | 1070 | 774 | 2094 | 1003 | 3118 | 2766 | 4142 | 1297 | 5166 | 3320 | 6190 | 3767 | 7214 | 6034 |
| 47 | 201 | 1071 | 1018 | 2095 | 1299 | 3119 | 3237 | 4143 | 1664 | 5167 | 3794 | 6191 | 4273 | 7215 | 6424 |
| 48 | 37 | 1072 | 379 | 2096 | 498 | 3120 | 1849 | 4144 | 650 | 5168 | 2317 | 6192 | 2664 | 7216 | 5060 |
| 49 | 67 | 1073 | 534 | 2097 | 698 | 3121 | 2236 | 4145 | 911 | 5169 | 2759 | 6193 | 3155 | 7217 | 5511 |
| 50 | 82 | 1074 | 600 | 2098 | 782 | 3122 | 2382 | 4146 | 1024 | 5170 | 2925 | 6194 | 3337 | 7218 | 5666 |
| 51 | 124 | 1075 | 766 | 2099 | 993 | 3123 | 2749 | 4147 | 1285 | 5171 | 3304 | 6195 | 3750 | 7219 | 6018 |
| 52 | 87 | 1076 | 623 | 2100 | 811 | 3124 | 2434 | 4148 | 1059 | 5172 | 2981 | 6196 | 3398 | 7220 | 5719 |
| 53 | 135 | 1077 | 802 | 2101 | 1035 | 3125 | 2825 | 4149 | 1342 | 5173 | 3379 | 6197 | 3825 | 7221 | 6086 |
| 54 | 145 | 1078 | 840 | 2102 | 1082 | 3126 | 2899 | 4150 | 1397 | 5174 | 3456 | 6198 | 3907 | 7222 | 6150 |
| 55 | 215 | 1079 | 1057 | 2103 | 1346 | 3127 | 3310 | 4151 | 1722 | 5175 | 3864 | 6199 | 4350 | 7223 | 6480 |
| 56 | 96 | 1080 | 656 | 2104 | 856 | 3128 | 2511 | 4152 | 1113 | 5176 | 3059 | 6200 | 3487 | 7224 | 5794 |
| 57 | 147 | 1081 | 848 | 2105 | 1091 | 3129 | 2916 | 4153 | 1408 | 5177 | 3471 | 6201 | 3923 | 7225 | 6165 |
| 58 | 160 | 1082 | 886 | 2106 | 1140 | 3130 | 2992 | 4154 | 1470 | 5178 | 3548 | 6202 | 4005 | 7226 | 6229 |
| 59 | 243 | 1083 | 1137 | 2107 | 1442 | 3131 | 3450 | 4155 | 1838 | 5179 | 4001 | 6203 | 4498 | 7227 | 6582 |
| 60 | 166 | 1084 | 906 | 2108 | 1166 | 3132 | 3029 | 4156 | 1501 | 5180 | 3586 | 6204 | 4049 | 7228 | 6259 |
| 61 | 257 | 1085 | 1173 | 2109 | 1485 | 3133 | 3511 | 4157 | 1891 | 5181 | 4060 | 6205 | 4563 | 7229 | 6625 |
| 62 | 281 | 1086 | 1236 | 2110 | 1562 | 3134 | 3617 | 4158 | 1983 | 5182 | 4169 | 6206 | 4675 | 7230 | 6698 |
| 63 | 408 | 1087 | 1567 | 2111 | 1925 | 3135 | 4129 | 4159 | 2406 | 5183 | 4682 | 6207 | 5154 | 7231 | 7019 |
| 64 | 9 | 1088 | 174 | 2112 | 221 | 3136 | 1195 | 4160 | 276 | 5184 | 1540 | 6208 | 1748 | 7232 | 4100 |
| 65 | 21 | 1089 | 262 | 2113 | 348 | 3137 | 1504 | 4161 | 458 | 5185 | 1911 | 6209 | 2218 | 7233 | 4591 |
| 66 | 29 | 1090 | 324 | 2114 | 428 | 3138 | 1693 | 4162 | 561 | 5186 | 2136 | 6210 | 2466 | 7234 | 4857 |
| 67 | 60 | 1091 | 497 | 2115 | 653 | 3139 | 2149 | 4163 | 855 | 5187 | 2661 | 6211 | 3051 | 7235 | 5416 |
| 68 | 33 | 1092 | 354 | 2116 | 464 | 3140 | 1777 | 4164 | 607 | 5188 | 2235 | 6212 | 2569 | 7236 | 4968 |
| 69 | 64 | 1093 | 519 | 2117 | 679 | 3141 | 2199 | 4165 | 887 | 5189 | 2719 | 6213 | 3112 | 7237 | 5471 |
| 70 | 77 | 1094 | 580 | 2118 | 759 | 3142 | 2339 | 4166 | 987 | 5190 | 2876 | 6214 | 3287 | 7238 | 5621 |
| 71 | 115 | 1095 | 732 | 2119 | 948 | 3143 | 2677 | 4167 | 1232 | 5191 | 3229 | 6215 | 3666 | 7239 | 5953 |
| 72 | 39 | 1096 | 393 | 2120 | 515 | 3144 | 1884 | 4168 | 671 | 5192 | 2360 | 6216 | 2708 | 7240 | 5103 |
| 73 | 83 | 1097 | 605 | 2121 | 788 | 3145 | 2394 | 4169 | 1031 | 5193 | 2938 | 6217 | 3349 | 7241 | 5677 |
| 74 | 69 | 1098 | 540 | 2122 | 710 | 3146 | 2247 | 4170 | 927 | 5194 | 2773 | 6218 | 3182 | 7242 | 5523 |
| 75 | 127 | 1099 | 779 | 2123 | 1007 | 3147 | 2775 | 4171 | 1303 | 5195 | 3330 | 6219 | 3775 | 7243 | 6042 |
| 76 | 92 | 1100 | 642 | 2124 | 839 | 3148 | 2478 | 4172 | 1093 | 5196 | 3025 | 6220 | 3453 | 7244 | 5762 |
| 77 | 139 | 1101 | 815 | 2125 | 1054 | 3149 | 2850 | 4173 | 1364 | 5197 | 3405 | 6221 | 3858 | 7245 | 6108 |
| 78 | 153 | 1102 | 864 | 2126 | 1114 | 3150 | 2947 | 4174 | 1439 | 5198 | 3503 | 6222 | 3961 | 7246 | 6191 |
| 79 | 224 | 1103 | 1083 | 2127 | 1377 | 3151 | 3355 | 4175 | 1761 | 5199 | 3909 | 6223 | 4398 | 7247 | 6513 |
| 80 | 49 | 1104 | 441 | 2128 | 583 | 3152 | 2009 | 4176 | 768 | 5200 | 2504 | 6224 | 2884 | 7248 | 5255 |
| 81 | 80 | 1105 | 594 | 2129 | 776 | 3153 | 2371 | 4177 | 1009 | 5201 | 2911 | 6225 | 3325 | 7249 | 5654 |
| 82 | 95 | 1106 | 651 | 2130 | 850 | 3154 | 2499 | 4178 | 1106 | 5202 | 3046 | 6226 | 3476 | 7250 | 5783 |
| 83 | 146 | 1107 | 843 | 2131 | 1087 | 3155 | 2907 | 4179 | 1402 | 5203 | 3462 | 6227 | 3915 | 7251 | 6157 |
| 84 | 101 | 1108 | 678 | 2132 | 882 | 3156 | 2561 | 4180 | 1145 | 5204 | 3110 | 6228 | 3539 | 7252 | 5843 |
| 85 | 156 | 1109 | 875 | 2133 | 1127 | 3157 | 2969 | 4181 | 1455 | 5205 | 3526 | 6229 | 3983 | 7253 | 6210 |
| 86 | 165 | 1110 | 904 | 2134 | 1162 | 3158 | 3024 | 4182 | 1496 | 5206 | 3581 | 6230 | 4043 | 7254 | 6255 |
| 87 | 251 | 1111 | 1159 | 2135 | 1468 | 3159 | 3486 | 4183 | 1871 | 5207 | 4037 | 6231 | 4537 | 7255 | 6608 |
| 88 | 111 | 1112 | 714 | 2136 | 929 | 3160 | 2639 | 4184 | 1208 | 5208 | 3190 | 6232 | 3630 | 7256 | 5917 |
| 89 | 168 | 1113 | 915 | 2137 | 1174 | 3161 | 3045 | 4185 | 1511 | 5209 | 3603 | 6233 | 4062 | 7257 | 6273 |
| 90 | 186 | 1114 | 968 | 2138 | 1242 | 3162 | 3148 | 4186 | 1594 | 5210 | 3703 | 6234 | 4179 | 7258 | 6355 |
| 91 | 269 | 1115 | 1207 | 2139 | 1525 | 3163 | 3569 | 4187 | 1939 | 5211 | 4120 | 6235 | 4622 | 7259 | 6666 |
| 92 | 200 | 1116 | 1013 | 2140 | 1295 | 3164 | 3228 | 4188 | 1659 | 5212 | 3785 | 6236 | 4267 | 7260 | 6418 |
| 93 | 288 | 1117 | 1259 | 2141 | 1587 | 3165 | 3654 | 4189 | 2010 | 5213 | 4207 | 6237 | 4711 | 7261 | 6723 |
| 94 | 307 | 1118 | 1307 | 2142 | 1642 | 3166 | 3732 | 4190 | 2077 | 5214 | 4287 | 6238 | 4787 | 7262 | 6775 |
| 95 | 454 | 1119 | 1675 | 2143 | 2043 | 3167 | 4276 | 4191 | 2541 | 5215 | 4832 | 6239 | 5295 | 7263 | 7107 |
| 96 | 59 | 1120 | 493 | 2144 | 646 | 3168 | 2137 | 4192 | 846 | 5216 | 2649 | 6240 | 3035 | 7264 | 5402 |
| 97 | 98 | 1121 | 665 | 2145 | 866 | 3169 | 2531 | 4193 | 1126 | 5217 | 3079 | 6241 | 3508 | 7265 | 5815 |
| 98 | 109 | 1122 | 706 | 2146 | 918 | 3170 | 2621 | 4194 | 1196 | 5218 | 3172 | 6242 | 3610 | 7266 | 5900 |
| 99 | 164 | 1123 | 899 | 2147 | 1157 | 3171 | 3014 | 4195 | 1491 | 5219 | 3572 | 6243 | 4035 | 7267 | 6247 |
| 100 | 122 | 1124 | 756 | 2148 | 983 | 3172 | 2729 | 4196 | 1274 | 5220 | 3282 | 6244 | 3731 | 7268 | 6000 |
| 101 | 176 | 1125 | 937 | 2149 | 1204 | 3173 | 3088 | 4197 | 1550 | 5221 | 3645 | 6245 | 4114 | 7269 | 6307 |
| 102 | 194 | 1126 | 994 | 2150 | 1271 | 3174 | 3194 | 4198 | 1631 | 5222 | 3752 | 6246 | 4227 | 7270 | 6392 |
| 103 | 284 | 1127 | 1247 | 2151 | 1572 | 3175 | 3633 | 4199 | 1994 | 5223 | 4187 | 6247 | 4689 | 7271 | 6709 |
| 104 | 133 | 1128 | 793 | 2152 | 1026 | 3176 | 2806 | 4200 | 1331 | 5224 | 3361 | 6248 | 3808 | 7272 | 6070 |
| 105 | 195 | 1129 | 999 | 2153 | 1275 | 3177 | 3203 | 4201 | 1636 | 5225 | 3760 | 6249 | 4233 | 7273 | 6398 |
| 106 | 214 | 1130 | 1055 | 2154 | 1343 | 3178 | 3305 | 4202 | 1718 | 5226 | 3860 | 6250 | 4344 | 7274 | 6476 |
| 107 | 299 | 1131 | 1286 | 2155 | 1618 | 3179 | 3698 | 4203 | 2048 | 5227 | 4251 | 6251 | 4753 | 7275 | 6753 |
| 108 | 227 | 1132 | 1090 | 2156 | 1389 | 3180 | 3369 | 4204 | 1774 | 5228 | 3921 | 6252 | 4417 | 7276 | 6524 |
| 109 | 325 | 1133 | 1352 | 2157 | 1697 | 3181 | 3805 | 4205 | 2140 | 5229 | 4359 | 6253 | 4862 | 7277 | 6822 |
| 110 | 343 | 1134 | 1403 | 2158 | 1747 | 3182 | 3884 | 4206 | 2200 | 5230 | 4438 | 6254 | 4929 | 7278 | 6872 |
| 111 | 494 | 1135 | 1768 | 2159 | 2139 | 3183 | 4395 | 4207 | 2652 | 5231 | 4956 | 6255 | 5405 | 7279 | 7174 |
| 112 | 150 | 1136 | 854 | 2160 | 1104 | 3184 | 2929 | 4208 | 1423 | 5232 | 3485 | 6256 | 3945 | 7280 | 6176 |
| 113 | 222 | 1137 | 1076 | 2161 | 1369 | 3185 | 3343 | 4209 | 1753 | 5233 | 3897 | 6257 | 4386 | 7281 | 6504 |
| 114 | 247 | 1138 | 1148 | 2162 | 1457 | 3186 | 3470 | 4210 | 1854 | 5234 | 4019 | 6258 | 4521 | 7282 | 6596 |
| 115 | 330 | 1139 | 1371 | 2163 | 1710 | 3187 | 3834 | 4211 | 2158 | 5235 | 4388 | 6259 | 4879 | 7283 | 6840 |
| 116 | 254 | 1140 | 1167 | 2164 | 1479 | 3188 | 3500 | 4212 | 1883 | 5236 | 4051 | 6260 | 4554 | 7284 | 6618 |
| 117 | 344 | 1141 | 1406 | 2165 | 1751 | 3189 | 3890 | 4213 | 2204 | 5237 | 4444 | 6261 | 4934 | 7285 | 6875 |
| 118 | 371 | 1142 | 1473 | 2166 | 1823 | 3190 | 3992 | 4214 | 2290 | 5238 | 4545 | 6262 | 5027 | 7286 | 6937 |
| 119 | 528 | 1143 | 1844 | 2167 | 2220 | 3191 | 4492 | 4215 | 2742 | 5239 | 5053 | 6263 | 5494 | 7287 | 7228 |
| 120 | 275 | 1144 | 1227 | 2168 | 1548 | 3192 | 3600 | 4216 | 1963 | 5240 | 4153 | 6264 | 4655 | 7288 | 6687 |
| 121 | 378 | 1145 | 1494 | 2169 | 1845 | 3193 | 4024 | 4217 | 2314 | 5241 | 4576 | 6265 | 5055 | 7289 | 6956 |
| 122 | 402 | 1146 | 1549 | 2170 | 1906 | 3194 | 4103 | 4218 | 2386 | 5242 | 4657 | 6266 | 5131 | 7290 | 7004 |
| 123 | 556 | 1147 | 1905 | 2171 | 2285 | 3195 | 4568 | 4219 | 2816 | 5243 | 5129 | 6267 | 5564 | 7291 | 7268 |
| 124 | 423 | 1148 | 1602 | 2172 | 1962 | 3196 | 4178 | 4220 | 2451 | 5244 | 4732 | 6268 | 5199 | 7292 | 7049 |
| 125 | 581 | 1149 | 1961 | 2173 | 2342 | 3197 | 4636 | 4221 | 2879 | 5245 | 5198 | 6269 | 5624 | 7293 | 7303 |
| 126 | 627 | 1150 | 2057 | 2174 | 2443 | 3198 | 4752 | 4222 | 2991 | 5246 | 5311 | 6270 | 5727 | 7294 | 7361 |
| 127 | 877 | 1151 | 2542 | 2175 | 2972 | 3199 | 5285 | 4223 | 3530 | 5247 | 5825 | 6271 | 6213 | 7295 | 7601 |
| 128 | 18 | 1152 | 235 | 2176 | 314 | 3200 | 1415 | 4224 | 415 | 5248 | 1804 | 6272 | 2103 | 7296 | 4457 |
| 129 | 28 | 1153 | 318 | 2177 | 419 | 3201 | 1672 | 4225 | 549 | 5249 | 2114 | 6273 | 2438 | 7297 | 4829 |
| 130 | 34 | 1154 | 360 | 2178 | 473 | 3202 | 1793 | 4226 | 618 | 5250 | 2256 | 6274 | 2593 | 7298 | 4988 |
| 131 | 79 | 1155 | 591 | 2179 | 771 | 3203 | 2362 | 4227 | 1002 | 5251 | 2903 | 6275 | 3313 | 7299 | 5645 |
| 132 | 43 | 1156 | 411 | 2180 | 546 | 3204 | 1932 | 4228 | 711 | 5252 | 2415 | 6276 | 2790 | 7300 | 5162 |
| 133 | 86 | 1157 | 620 | 2181 | 806 | 3205 | 2426 | 4229 | 1052 | 5253 | 2973 | 6277 | 3386 | 7301 | 5710 |
| 134 | 90 | 1158 | 632 | 2182 | 827 | 3206 | 2458 | 4230 | 1079 | 5254 | 3002 | 6278 | 3430 | 7302 | 5742 |
| 135 | 151 | 1159 | 859 | 2183 | 1109 | 3207 | 2939 | 4231 | 1429 | 5255 | 3494 | 6279 | 3953 | 7303 | 6184 |
| 136 | 54 | 1160 | 465 | 2184 | 612 | 3208 | 2068 | 4232 | 803 | 5256 | 2572 | 6280 | 2954 | 7304 | 5324 |
| 137 | 94 | 1161 | 647 | 2185 | 844 | 3209 | 2490 | 4233 | 1099 | 5257 | 3038 | 6281 | 3465 | 7305 | 5774 |
| 138 | 102 | 1162 | 683 | 2186 | 888 | 3210 | 2570 | 4234 | 1152 | 5258 | 3120 | 6282 | 3550 | 7306 | 5852 |
| 139 | 163 | 1163 | 894 | 2187 | 1153 | 3211 | 3006 | 4235 | 1486 | 5259 | 3564 | 6283 | 4027 | 7307 | 6241 |
| 140 | 112 | 1164 | 718 | 2188 | 933 | 3212 | 2647 | 4236 | 1214 | 5260 | 3200 | 6284 | 3638 | 7308 | 5924 |
| 141 | 175 | 1165 | 934 | 2189 | 1200 | 3213 | 3083 | 4237 | 1545 | 5261 | 3640 | 6285 | 4108 | 7309 | 6303 |
| 142 | 179 | 1166 | 949 | 2190 | 1217 | 3214 | 3111 | 4238 | 1565 | 5262 | 3669 | 6286 | 4137 | 7310 | 6326 |
| 143 | 283 | 1167 | 1243 | 2191 | 1569 | 3215 | 3628 | 4239 | 1990 | 5263 | 4181 | 6287 | 4685 | 7311 | 6706 |
| 144 | 62 | 1168 | 509 | 2192 | 666 | 3216 | 2175 | 4240 | 871 | 5264 | 2693 | 6288 | 3082 | 7312 | 5445 |
| 145 | 103 | 1169 | 688 | 2193 | 892 | 3217 | 2582 | 4241 | 1158 | 5265 | 3132 | 6289 | 3559 | 7313 | 5863 |
| 146 | 114 | 1170 | 727 | 2194 | 944 | 3218 | 2668 | 4242 | 1226 | 5266 | 3219 | 6290 | 3658 | 7314 | 5944 |
| 147 | 177 | 1171 | 941 | 2195 | 1209 | 3219 | 3096 | 4243 | 1555 | 5267 | 3653 | 6291 | 4122 | 7315 | 6314 |
| 148 | 125 | 1172 | 770 | 2196 | 998 | 3220 | 2758 | 4244 | 1291 | 5268 | 3311 | 6292 | 3758 | 7316 | 6027 |
| 149 | 193 | 1173 | 991 | 2197 | 1266 | 3221 | 3189 | 4245 | 1627 | 5269 | 3745 | 6293 | 4219 | 7317 | 6388 |
| 150 | 211 | 1174 | 1043 | 2198 | 1330 | 3222 | 3284 | 4246 | 1704 | 5270 | 3840 | 6294 | 4324 | 7318 | 6461 |
| 151 | 301 | 1175 | 1293 | 2199 | 1625 | 3223 | 3710 | 4247 | 2055 | 5271 | 4263 | 6295 | 4764 | 7319 | 6760 |
| 152 | 138 | 1176 | 810 | 2200 | 1049 | 3224 | 2841 | 4248 | 1359 | 5272 | 3396 | 6296 | 3850 | 7320 | 6100 |
| 153 | 212 | 1177 | 1047 | 2201 | 1334 | 3225 | 3290 | 4249 | 1709 | 5273 | 3846 | 6297 | 4330 | 7321 | 6464 |
| 154 | 223 | 1178 | 1080 | 2202 | 1373 | 3226 | 3348 | 4250 | 1757 | 5274 | 3903 | 6298 | 4392 | 7322 | 6508 |
| 155 | 319 | 1179 | 1335 | 2203 | 1676 | 3227 | 3778 | 4251 | 2118 | 5275 | 4332 | 6299 | 4834 | 7323 | 6804 |
| 156 | 249 | 1180 | 1155 | 2204 | 1464 | 3228 | 3480 | 4252 | 1863 | 5276 | 4031 | 6300 | 4532 | 7324 | 6604 |
| 157 | 339 | 1181 | 1392 | 2205 | 1734 | 3229 | 3867 | 4253 | 2186 | 5277 | 4421 | 6301 | 4912 | 7325 | 6861 |
| 158 | 364 | 1182 | 1458 | 2206 | 1806 | 3230 | 3970 | 4254 | 2270 | 5278 | 4523 | 6302 | 5005 | 7326 | 6924 |
| 159 | 516 | 1183 | 1815 | 2207 | 2191 | 3231 | 4456 | 4255 | 2711 | 5279 | 5017 | 6303 | 5462 | 7327 | 7208 |
| 160 | 71 | 1184 | 550 | 2208 | 723 | 3232 | 2271 | 4256 | 942 | 5280 | 2799 | 6304 | 3209 | 7328 | 5549 |
| 161 | 118 | 1185 | 744 | 2209 | 963 | 3233 | 2703 | 4257 | 1250 | 5281 | 3256 | 6305 | 3694 | 7329 | 5976 |
| 162 | 134 | 1186 | 798 | 2210 | 1030 | 3234 | 2815 | 4258 | 1337 | 5282 | 3370 | 6306 | 3817 | 7330 | 6078 |
| 163 | 199 | 1187 | 1010 | 2211 | 1290 | 3235 | 3223 | 4259 | 1654 | 5283 | 3779 | 6307 | 4259 | 7331 | 6414 |
| 164 | 140 | 1188 | 819 | 2212 | 1058 | 3236 | 2858 | 4260 | 1370 | 5284 | 3414 | 6308 | 3866 | 7332 | 6115 |
| 165 | 213 | 1189 | 1050 | 2213 | 1338 | 3237 | 3296 | 4261 | 1713 | 5285 | 3852 | 6309 | 4336 | 7333 | 6470 |
| 166 | 230 | 1190 | 1102 | 2214 | 1400 | 3238 | 3388 | 4262 | 1787 | 5286 | 3941 | 6310 | 4434 | 7334 | 6538 |
| 167 | 331 | 1191 | 1374 | 2215 | 1714 | 3239 | 3839 | 4263 | 2161 | 5287 | 4394 | 6311 | 4884 | 7335 | 6844 |
| 168 | 161 | 1192 | 891 | 2216 | 1144 | 3240 | 3001 | 4264 | 1475 | 5288 | 3557 | 6312 | 4013 | 7336 | 6237 |
| 169 | 245 | 1193 | 1141 | 2217 | 1449 | 3241 | 3455 | 4265 | 1846 | 5289 | 4007 | 6313 | 4510 | 7337 | 6586 |
| 170 | 255 | 1194 | 1169 | 2218 | 1482 | 3242 | 3506 | 4266 | 1887 | 5290 | 4055 | 6314 | 4558 | 7338 | 6622 |
| 171 | 347 | 1195 | 1414 | 2219 | 1760 | 3243 | 3902 | 4267 | 2214 | 5291 | 4455 | 6315 | 4946 | 7339 | 6882 |
| 172 | 274 | 1196 | 1223 | 2220 | 1544 | 3244 | 3594 | 4268 | 1959 | 5292 | 4147 | 6316 | 4649 | 7340 | 6683 |
| 173 | 377 | 1197 | 1490 | 2221 | 1843 | 3245 | 4018 | 4269 | 2310 | 5293 | 4571 | 6317 | 5052 | 7341 | 6952 |
| 174 | 394 | 1198 | 1530 | 2222 | 1888 | 3246 | 4077 | 4270 | 2363 | 5294 | 4629 | 6318 | 5108 | 7342 | 6987 |
| 175 | 553 | 1199 | 1901 | 2223 | 2279 | 3247 | 4564 | 4271 | 2807 | 5295 | 5124 | 6319 | 5558 | 7343 | 7266 |
| 176 | 178 | 1200 | 946 | 2224 | 1212 | 3248 | 3106 | 4272 | 1560 | 5296 | 3662 | 6320 | 4128 | 7344 | 6322 |
| 177 | 266 | 1201 | 1198 | 2225 | 1515 | 3249 | 3553 | 4273 | 1927 | 5297 | 4104 | 6321 | 4607 | 7345 | 6654 |
| 178 | 285 | 1202 | 1252 | 2226 | 1576 | 3250 | 3642 | 4274 | 1998 | 5298 | 4195 | 6322 | 4694 | 7346 | 6715 |
| 179 | 385 | 1203 | 1509 | 2227 | 1861 | 3251 | 4046 | 4275 | 2334 | 5299 | 4598 | 6323 | 5075 | 7347 | 6969 |
| 180 | 300 | 1204 | 1289 | 2228 | 1621 | 3252 | 3704 | 4276 | 2051 | 5300 | 4257 | 6324 | 4759 | 7348 | 6756 |
| 181 | 417 | 1205 | 1588 | 2229 | 1948 | 3253 | 4158 | 4277 | 2432 | 5301 | 4712 | 6325 | 5181 | 7349 | 7037 |
| 182 | 426 | 1206 | 1610 | 2230 | 1972 | 3254 | 4188 | 4278 | 2460 | 5302 | 4743 | 6326 | 5211 | 7350 | 7055 |
| 183 | 578 | 1207 | 1952 | 2231 | 2333 | 3255 | 4625 | 4279 | 2871 | 5303 | 5186 | 6327 | 5615 | 7351 | 7298 |
| 184 | 327 | 1208 | 1356 | 2232 | 1701 | 3256 | 3811 | 4280 | 2147 | 5304 | 4365 | 6328 | 4867 | 7352 | 6825 |
| 185 | 440 | 1209 | 1643 | 2233 | 2007 | 3257 | 4232 | 4281 | 2501 | 5305 | 4789 | 6329 | 5252 | 7353 | 7081 |
| 186 | 475 | 1210 | 1723 | 2234 | 2093 | 3258 | 4337 | 4282 | 2599 | 5306 | 4896 | 6330 | 5352 | 7354 | 7142 |
| 187 | 615 | 1211 | 2033 | 2235 | 2417 | 3259 | 4722 | 4283 | 2962 | 5307 | 5283 | 6331 | 5701 | 7355 | 7347 |
| 188 | 501 | 1212 | 1782 | 2236 | 2155 | 3260 | 4416 | 4284 | 2670 | 5308 | 4975 | 6332 | 5422 | 7356 | 7186 |
| 189 | 649 | 1213 | 2105 | 2237 | 2496 | 3261 | 4807 | 4285 | 3043 | 5309 | 5366 | 6333 | 5780 | 7357 | 7389 |
| 190 | 725 | 1214 | 2257 | 2238 | 2662 | 3262 | 4977 | 4286 | 3214 | 5310 | 5534 | 6334 | 5938 | 7358 | 7468 |
| 191 | 878 | 1215 | 2545 | 2239 | 2976 | 3263 | 5290 | 4287 | 3532 | 5311 | 5827 | 6335 | 6215 | 7359 | 7603 |
| 192 | 75 | 1216 | 570 | 2240 | 747 | 3264 | 2316 | 4288 | 973 | 5312 | 2851 | 6336 | 3263 | 7360 | 5597 |
| 193 | 136 | 1217 | 807 | 2241 | 1040 | 3265 | 2833 | 4289 | 1348 | 5313 | 3389 | 6337 | 3833 | 7361 | 6093 |
| 194 | 155 | 1218 | 870 | 2242 | 1122 | 3266 | 2961 | 4290 | 1450 | 5314 | 3517 | 6338 | 3975 | 7362 | 6203 |
| 195 | 233 | 1219 | 1111 | 2243 | 1411 | 3267 | 3404 | 4291 | 1800 | 5315 | 3957 | 6339 | 4451 | 7363 | 6549 |
| 196 | 173 | 1220 | 930 | 2244 | 1192 | 3268 | 3075 | 4292 | 1536 | 5316 | 3632 | 6340 | 4092 | 7364 | 6297 |
| 197 | 252 | 1221 | 1161 | 2245 | 1472 | 3269 | 3491 | 4293 | 1875 | 5317 | 4041 | 6341 | 4543 | 7365 | 6611 |
| 198 | 273 | 1222 | 1219 | 2246 | 1541 | 3270 | 3589 | 4294 | 1955 | 5318 | 4141 | 6342 | 4644 | 7366 | 6679 |
| 199 | 382 | 1223 | 1502 | 2247 | 1855 | 3271 | 4034 | 4295 | 2327 | 5319 | 4587 | 6343 | 5067 | 7367 | 6962 |
| 200 | 183 | 1224 | 964 | 2248 | 1234 | 3272 | 3139 | 4296 | 1584 | 5320 | 3697 | 6344 | 4165 | 7368 | 6348 |
| 201 | 277 | 1225 | 1230 | 2249 | 1551 | 3273 | 3605 | 4297 | 1967 | 5321 | 4159 | 6345 | 4658 | 7369 | 6691 |
| 202 | 291 | 1226 | 1265 | 2250 | 1593 | 3274 | 3665 | 4298 | 2021 | 5322 | 4217 | 6346 | 4719 | 7370 | 6730 |
| 203 | 407 | 1227 | 1563 | 2251 | 1922 | 3275 | 4123 | 4299 | 2403 | 5323 | 4676 | 6347 | 5151 | 7371 | 7016 |
| 204 | 308 | 1228 | 1310 | 2252 | 1646 | 3276 | 3738 | 4300 | 2081 | 5324 | 4291 | 6348 | 4792 | 7372 | 6779 |
| 205 | 425 | 1229 | 1606 | 2253 | 1969 | 3277 | 4182 | 4301 | 2457 | 5325 | 4737 | 6349 | 5207 | 7373 | 7051 |
| 206 | 452 | 1230 | 1674 | 2254 | 2037 | 3278 | 4272 | 4302 | 2535 | 5326 | 4831 | 6350 | 5287 | 7374 | 7104 |
| 207 | 603 | 1231 | 2008 | 2255 | 2391 | 3279 | 4695 | 4303 | 2933 | 5327 | 5254 | 6351 | 5674 | 7375 | 7333 |
| 208 | 208 | 1232 | 1036 | 2256 | 1323 | 3280 | 3271 | 4304 | 1695 | 5328 | 3827 | 6352 | 4313 | 7376 | 6450 |
| 209 | 304 | 1233 | 1296 | 2257 | 1632 | 3281 | 3715 | 4305 | 2066 | 5329 | 4269 | 6353 | 4773 | 7377 | 6764 |
| 210 | 320 | 1234 | 1339 | 2258 | 1680 | 3282 | 3784 | 4306 | 2122 | 5330 | 4338 | 6354 | 4839 | 7378 | 6808 |
| 211 | 437 | 1235 | 1637 | 2259 | 2000 | 3283 | 4224 | 4307 | 2492 | 5331 | 4780 | 6355 | 5244 | 7379 | 7076 |
| 212 | 345 | 1236 | 1410 | 2260 | 1754 | 3284 | 3896 | 4308 | 2207 | 5332 | 4449 | 6356 | 4937 | 7380 | 6879 |
| 213 | 468 | 1237 | 1708 | 2261 | 2076 | 3285 | 4319 | 4309 | 2581 | 5333 | 4877 | 6357 | 5333 | 7381 | 7131 |
| 214 | 496 | 1238 | 1775 | 2262 | 2146 | 3286 | 4403 | 4310 | 2658 | 5334 | 4964 | 6358 | 5413 | 7382 | 7179 |
| 215 | 662 | 1239 | 2127 | 2263 | 2522 | 3287 | 4833 | 4311 | 3072 | 5335 | 5391 | 6359 | 5806 | 7383 | 7401 |
| 216 | 358 | 1240 | 1443 | 2264 | 1790 | 3288 | 3948 | 4312 | 2249 | 5336 | 4500 | 6360 | 4985 | 7384 | 6910 |
| 217 | 504 | 1241 | 1789 | 2265 | 2164 | 3289 | 4424 | 4313 | 2679 | 5337 | 4983 | 6361 | 5433 | 7385 | 7191 |
| 218 | 533 | 1242 | 1856 | 2266 | 2231 | 3290 | 4507 | 4314 | 2756 | 5338 | 5068 | 6362 | 5507 | 7386 | 7236 |
| 219 | 690 | 1243 | 2189 | 2267 | 2588 | 3291 | 4904 | 4315 | 3137 | 5339 | 5461 | 6363 | 5869 | 7387 | 7435 |
| 220 | 564 | 1244 | 1924 | 2268 | 2302 | 3292 | 4592 | 4316 | 2835 | 5340 | 5152 | 6364 | 5582 | 7388 | 7281 |
| 221 | 738 | 1245 | 2284 | 2269 | 2691 | 3293 | 5009 | 4317 | 3244 | 5341 | 5563 | 6365 | 5965 | 7389 | 7483 |
| 222 | 767 | 1246 | 2341 | 2270 | 2752 | 3294 | 5069 | 4318 | 3306 | 5342 | 5623 | 6366 | 6021 | 7390 | 7509 |
| 223 | 1022 | 1247 | 2791 | 2271 | 3245 | 3295 | 5545 | 4319 | 3802 | 5343 | 6056 | 6367 | 6431 | 7391 | 7701 |
| 224 | 229 | 1248 | 1097 | 2272 | 1396 | 3296 | 3380 | 4320 | 1783 | 5344 | 3933 | 6368 | 4428 | 7392 | 6531 |
| 225 | 334 | 1249 | 1378 | 2273 | 1720 | 3297 | 3845 | 4321 | 2168 | 5345 | 4400 | 6369 | 4893 | 7393 | 6847 |
| 226 | 352 | 1250 | 1425 | 2274 | 1771 | 3298 | 3918 | 4322 | 2228 | 5346 | 4472 | 6370 | 4959 | 7394 | 6892 |
| 227 | 479 | 1251 | 1733 | 2275 | 2104 | 3299 | 4352 | 4323 | 2611 | 5347 | 4910 | 6371 | 5365 | 7395 | 7150 |
| 228 | 387 | 1252 | 1513 | 2276 | 1868 | 3300 | 4052 | 4324 | 2340 | 5348 | 4604 | 6372 | 5083 | 7396 | 6973 |
| 229 | 513 | 1253 | 1811 | 2277 | 2185 | 3301 | 4452 | 4325 | 2702 | 5349 | 5012 | 6373 | 5456 | 7397 | 7206 |
| 230 | 538 | 1254 | 1866 | 2278 | 2244 | 3302 | 4520 | 4326 | 2768 | 5350 | 5082 | 6374 | 5520 | 7398 | 7243 |
| 231 | 715 | 1255 | 2237 | 2279 | 2642 | 3303 | 4957 | 4327 | 3192 | 5351 | 5513 | 6375 | 5920 | 7399 | 7459 |
| 232 | 422 | 1256 | 1600 | 2280 | 1960 | 3304 | 4174 | 4328 | 2447 | 5352 | 4728 | 6376 | 5196 | 7400 | 7047 |
| 233 | 548 | 1257 | 1889 | 2281 | 2267 | 3305 | 4548 | 4329 | 2796 | 5353 | 5110 | 6377 | 5544 | 7401 | 7258 |
| 234 | 579 | 1258 | 1956 | 2282 | 2336 | 3306 | 4632 | 4330 | 2873 | 5354 | 5191 | 6378 | 5618 | 7402 | 7301 |
| 235 | 755 | 1259 | 2318 | 2283 | 2726 | 3307 | 5044 | 4331 | 3280 | 5355 | 5599 | 6379 | 5997 | 7403 | 7498 |
| 236 | 616 | 1260 | 2035 | 2284 | 2420 | 3308 | 4726 | 4332 | 2965 | 5356 | 5286 | 6380 | 5704 | 7404 | 7349 |
| 237 | 773 | 1261 | 2355 | 2285 | 2764 | 3309 | 5084 | 4333 | 3318 | 5357 | 5637 | 6381 | 6032 | 7405 | 7516 |
| 238 | 842 | 1262 | 2483 | 2286 | 2904 | 3310 | 5224 | 4334 | 3460 | 5358 | 5767 | 6382 | 6154 | 7406 | 7576 |
| 239 | 1103 | 1263 | 2923 | 2287 | 3390 | 3311 | 5678 | 4335 | 3943 | 5359 | 6171 | 6383 | 6539 | 7407 | 7749 |
| 240 | 451 | 1264 | 1669 | 2288 | 2034 | 3312 | 4268 | 4336 | 2532 | 5360 | 4824 | 6384 | 5284 | 7408 | 7102 |
| 241 | 592 | 1265 | 1982 | 2289 | 2365 | 3313 | 4663 | 4337 | 2906 | 5361 | 5223 | 6385 | 5648 | 7409 | 7317 |
| 242 | 630 | 1266 | 2062 | 2290 | 2449 | 3314 | 4756 | 4338 | 2996 | 5362 | 5317 | 6386 | 5733 | 7410 | 7364 |
| 243 | 809 | 1267 | 2424 | 2291 | 2839 | 3315 | 5158 | 4339 | 3393 | 5363 | 5708 | 6387 | 6098 | 7411 | 7548 |
| 244 | 645 | 1268 | 2097 | 2292 | 2487 | 3316 | 4798 | 4340 | 3033 | 5364 | 5357 | 6388 | 5771 | 7412 | 7384 |
| 245 | 865 | 1269 | 2521 | 2293 | 2950 | 3317 | 5264 | 4341 | 3505 | 5365 | 5804 | 6389 | 6194 | 7413 | 7592 |
| 246 | 897 | 1270 | 2577 | 2294 | 3013 | 3318 | 5326 | 4342 | 3568 | 5366 | 5859 | 6390 | 6246 | 7414 | 7617 |
| 247 | 1175 | 1271 | 3034 | 2295 | 3515 | 3319 | 5785 | 4343 | 4064 | 5367 | 6263 | 6391 | 6628 | 7415 | 7785 |
| 248 | 720 | 1272 | 2248 | 2296 | 2653 | 3320 | 4969 | 4344 | 3204 | 5368 | 5525 | 6392 | 5930 | 7416 | 7465 |
| 249 | 914 | 1273 | 2607 | 2297 | 3044 | 3321 | 5356 | 4345 | 3601 | 5369 | 5887 | 6393 | 6271 | 7417 | 7629 |
| 250 | 951 | 1274 | 2669 | 2298 | 3114 | 3322 | 5423 | 4346 | 3671 | 5370 | 5946 | 6394 | 6329 | 7418 | 7656 |
| 251 | 1160 | 1275 | 3011 | 2299 | 3489 | 3323 | 5763 | 4347 | 4039 | 5371 | 6245 | 6395 | 6610 | 7419 | 7778 |
| 252 | 990 | 1276 | 2736 | 2300 | 3186 | 3324 | 5492 | 4348 | 3743 | 5372 | 6007 | 6396 | 6385 | 7420 | 7682 |
| 253 | 1235 | 1277 | 3126 | 2301 | 3615 | 3325 | 5871 | 4349 | 4167 | 5373 | 6338 | 6397 | 6697 | 7421 | 7813 |
| 254 | 1333 | 1278 | 3278 | 2302 | 3774 | 3326 | 6008 | 4350 | 4328 | 5374 | 6455 | 6398 | 6802 | 7422 | 7855 |
| 255 | 1678 | 1279 | 3795 | 2303 | 4278 | 3327 | 6434 | 4351 | 4836 | 5375 | 6815 | 6399 | 7108 | 7423 | 7970 |
| 256 | 23 | 1280 | 280 | 2304 | 370 | 3328 | 1558 | 4352 | 485 | 5376 | 1979 | 6400 | 2287 | 7424 | 4669 |
| 257 | 40 | 1281 | 398 | 2305 | 522 | 3329 | 1900 | 4353 | 681 | 5377 | 2377 | 6401 | 2728 | 7425 | 5123 |
| 258 | 45 | 1282 | 424 | 2306 | 560 | 3330 | 1966 | 4354 | 730 | 5378 | 2454 | 6402 | 2827 | 7426 | 5204 |
| 259 | 100 | 1283 | 675 | 2307 | 876 | 3331 | 2552 | 4355 | 1139 | 5379 | 3102 | 6403 | 3528 | 7427 | 5835 |
| 260 | 55 | 1284 | 470 | 2308 | 619 | 3332 | 2083 | 4356 | 812 | 5380 | 2587 | 6404 | 2970 | 7428 | 5341 |
| 261 | 104 | 1285 | 693 | 2309 | 898 | 3333 | 2591 | 4357 | 1164 | 5381 | 3142 | 6405 | 3570 | 7429 | 5872 |
| 262 | 116 | 1286 | 736 | 2310 | 954 | 3334 | 2684 | 4358 | 1238 | 5382 | 3239 | 6406 | 3677 | 7430 | 5960 |
| 263 | 192 | 1287 | 986 | 2311 | 1263 | 3335 | 3181 | 4359 | 1622 | 5383 | 3737 | 6407 | 4213 | 7431 | 6381 |
| 264 | 56 | 1288 | 476 | 2312 | 625 | 3336 | 2095 | 4360 | 821 | 5384 | 2602 | 6408 | 2986 | 7432 | 5355 |
| 265 | 117 | 1289 | 739 | 2313 | 959 | 3337 | 2694 | 4361 | 1244 | 5385 | 3246 | 6409 | 3686 | 7433 | 5968 |
| 266 | 129 | 1290 | 783 | 2314 | 1012 | 3338 | 2784 | 4362 | 1308 | 5386 | 3339 | 6410 | 3783 | 7434 | 6050 |
| 267 | 202 | 1291 | 1020 | 2315 | 1302 | 3339 | 3243 | 4363 | 1668 | 5387 | 3798 | 6411 | 4279 | 7435 | 6429 |
| 268 | 142 | 1292 | 828 | 2316 | 1068 | 3340 | 2875 | 4364 | 1381 | 5388 | 3433 | 6412 | 3883 | 7436 | 6130 |
| 269 | 225 | 1293 | 1085 | 2317 | 1380 | 3341 | 3360 | 4365 | 1766 | 5389 | 3913 | 6413 | 4404 | 7437 | 6517 |
| 270 | 236 | 1294 | 1116 | 2318 | 1419 | 3342 | 3413 | 4366 | 1808 | 5390 | 3965 | 6414 | 4463 | 7438 | 6556 |
| 271 | 362 | 1295 | 1451 | 2319 | 1799 | 3343 | 3958 | 4367 | 2263 | 5391 | 4511 | 6415 | 4997 | 7439 | 6916 |
| 272 | 70 | 1296 | 544 | 2320 | 717 | 3344 | 2258 | 4368 | 935 | 5392 | 2785 | 6416 | 3197 | 7440 | 5535 |
| 273 | 130 | 1297 | 787 | 2321 | 1017 | 3345 | 2792 | 4369 | 1314 | 5393 | 3346 | 6417 | 3792 | 7441 | 6057 |
| 274 | 143 | 1298 | 831 | 2322 | 1073 | 3346 | 2881 | 4370 | 1386 | 5394 | 3437 | 6418 | 3891 | 7442 | 6135 |
| 275 | 240 | 1299 | 1125 | 2323 | 1431 | 3347 | 3431 | 4371 | 1825 | 5395 | 3981 | 6419 | 4481 | 7443 | 6568 |
| 276 | 157 | 1300 | 880 | 2324 | 1131 | 3348 | 2979 | 4372 | 1460 | 5396 | 3535 | 6420 | 3991 | 7444 | 6218 |
| 277 | 248 | 1301 | 1151 | 2325 | 1461 | 3349 | 3475 | 4373 | 1859 | 5397 | 4025 | 6421 | 4526 | 7445 | 6600 |
| 278 | 263 | 1302 | 1191 | 2326 | 1508 | 3350 | 3542 | 4374 | 1915 | 5398 | 4090 | 6422 | 4597 | 7446 | 6647 |
| 279 | 363 | 1303 | 1454 | 2327 | 1803 | 3351 | 3964 | 4375 | 2266 | 5399 | 4517 | 6423 | 5002 | 7447 | 6920 |
| 280 | 167 | 1304 | 910 | 2328 | 1170 | 3352 | 3037 | 4376 | 1506 | 5400 | 3595 | 6424 | 4057 | 7448 | 6266 |
| 281 | 261 | 1305 | 1188 | 2329 | 1500 | 3353 | 3536 | 4377 | 1907 | 5401 | 4086 | 6425 | 4586 | 7449 | 6643 |
| 282 | 282 | 1306 | 1240 | 2330 | 1566 | 3354 | 3622 | 4378 | 1986 | 5402 | 4175 | 6426 | 4680 | 7450 | 6702 |
| 283 | 400 | 1307 | 1546 | 2331 | 1904 | 3355 | 4099 | 4379 | 2380 | 5403 | 4651 | 6427 | 5128 | 7451 | 7001 |
| 284 | 305 | 1308 | 1300 | 2332 | 1635 | 3356 | 3721 | 4380 | 2070 | 5404 | 4275 | 6428 | 4778 | 7452 | 6767 |
| 285 | 421 | 1309 | 1596 | 2333 | 1957 | 3357 | 4170 | 4381 | 2444 | 5405 | 4723 | 6429 | 5193 | 7453 | 7044 |
| 286 | 432 | 1310 | 1623 | 2334 | 1985 | 3358 | 4204 | 4382 | 2476 | 5406 | 4760 | 6430 | 5227 | 7454 | 7064 |
| 287 | 577 | 1311 | 1949 | 2335 | 2331 | 3359 | 4623 | 4383 | 2868 | 5407 | 5183 | 6431 | 5612 | 7455 | 7297 |
| 288 | 73 | 1312 | 559 | 2336 | 735 | 3360 | 2294 | 4384 | 958 | 5408 | 2824 | 6432 | 3236 | 7456 | 5573 |
| 289 | 154 | 1313 | 868 | 2337 | 1118 | 3361 | 2955 | 4385 | 1444 | 5409 | 3512 | 6433 | 3969 | 7457 | 6198 |
| 290 | 169 | 1314 | 917 | 2338 | 1179 | 3362 | 3052 | 4386 | 1516 | 5410 | 3608 | 6434 | 4070 | 7458 | 6278 |
| 291 | 242 | 1315 | 1134 | 2339 | 1438 | 3363 | 3445 | 4387 | 1834 | 5411 | 3995 | 6435 | 4493 | 7459 | 6578 |
| 292 | 188 | 1316 | 976 | 2340 | 1251 | 3364 | 3161 | 4388 | 1603 | 5412 | 3718 | 6436 | 4193 | 7460 | 6365 |
| 293 | 267 | 1317 | 1201 | 2341 | 1519 | 3365 | 3558 | 4389 | 1931 | 5413 | 4110 | 6437 | 4613 | 7461 | 6658 |
| 294 | 286 | 1318 | 1255 | 2342 | 1580 | 3366 | 3648 | 4390 | 2002 | 5414 | 4201 | 6438 | 4700 | 7462 | 6719 |
| 295 | 420 | 1319 | 1592 | 2343 | 1953 | 3367 | 4164 | 4391 | 2441 | 5415 | 4718 | 6439 | 5188 | 7463 | 7041 |
| 296 | 198 | 1320 | 1005 | 2344 | 1287 | 3368 | 3215 | 4392 | 1650 | 5416 | 3771 | 6440 | 4253 | 7464 | 6407 |
| 297 | 297 | 1321 | 1279 | 2345 | 1611 | 3369 | 3687 | 4393 | 2040 | 5417 | 4241 | 6441 | 4744 | 7465 | 6745 |
| 298 | 309 | 1322 | 1313 | 2346 | 1649 | 3370 | 3744 | 4394 | 2085 | 5418 | 4297 | 6442 | 4797 | 7466 | 6782 |
| 299 | 434 | 1323 | 1628 | 2347 | 1991 | 3371 | 4212 | 4395 | 2482 | 5419 | 4767 | 6443 | 5233 | 7467 | 7069 |
| 300 | 323 | 1324 | 1349 | 2348 | 1690 | 3372 | 3799 | 4396 | 2132 | 5420 | 4353 | 6444 | 4853 | 7468 | 6818 |
| 301 | 466 | 1325 | 1702 | 2349 | 2071 | 3373 | 4310 | 4397 | 2575 | 5421 | 4869 | 6445 | 5327 | 7469 | 7127 |
| 302 | 486 | 1326 | 1749 | 2350 | 2119 | 3374 | 4370 | 4398 | 2629 | 5422 | 4930 | 6446 | 5382 | 7470 | 7161 |
| 303 | 643 | 1327 | 2090 | 2351 | 2481 | 3375 | 4788 | 4399 | 3028 | 5423 | 5349 | 6447 | 5765 | 7471 | 7380 |
| 304 | 197 | 1328 | 1001 | 2352 | 1283 | 3376 | 3210 | 4400 | 1645 | 5424 | 3764 | 6448 | 4247 | 7472 | 6403 |
| 305 | 321 | 1329 | 1341 | 2353 | 1683 | 3377 | 3787 | 4401 | 2125 | 5425 | 4342 | 6449 | 4843 | 7473 | 6811 |
| 306 | 336 | 1330 | 1384 | 2354 | 1727 | 3378 | 3855 | 4402 | 2176 | 5426 | 4409 | 6450 | 4901 | 7474 | 6853 |
| 307 | 463 | 1331 | 1698 | 2355 | 2065 | 3379 | 4304 | 4403 | 2566 | 5427 | 4863 | 6451 | 5321 | 7475 | 7123 |
| 308 | 357 | 1332 | 1440 | 2356 | 1786 | 3380 | 3942 | 4404 | 2246 | 5428 | 4495 | 6452 | 4980 | 7476 | 6907 |
| 309 | 500 | 1333 | 1778 | 2357 | 2152 | 3381 | 4410 | 4405 | 2667 | 5429 | 4970 | 6453 | 5419 | 7477 | 7183 |
| 310 | 518 | 1334 | 1822 | 2358 | 2196 | 3382 | 4465 | 4406 | 2716 | 5430 | 5025 | 6454 | 5468 | 7478 | 7213 |
| 311 | 694 | 1335 | 2192 | 2359 | 2594 | 3383 | 4906 | 4407 | 3145 | 5431 | 5464 | 6455 | 5875 | 7479 | 7436 |
| 312 | 389 | 1336 | 1520 | 2360 | 1874 | 3384 | 4063 | 4408 | 2347 | 5432 | 4615 | 6456 | 5092 | 7480 | 6979 |
| 313 | 542 | 1337 | 1873 | 2361 | 2253 | 3385 | 4529 | 4409 | 2779 | 5433 | 5090 | 6457 | 5529 | 7481 | 7247 |
| 314 | 566 | 1338 | 1926 | 2362 | 2308 | 3386 | 4594 | 4410 | 2840 | 5434 | 5155 | 6458 | 5588 | 7482 | 7282 |
| 315 | 737 | 1339 | 2281 | 2363 | 2687 | 3387 | 5004 | 4411 | 3241 | 5435 | 5560 | 6459 | 5962 | 7483 | 7481 |
| 316 | 589 | 1340 | 1980 | 2364 | 2359 | 3388 | 4659 | 4412 | 2898 | 5436 | 5220 | 6460 | 5642 | 7484 | 7315 |
| 317 | 764 | 1341 | 2338 | 2365 | 2746 | 3389 | 5066 | 4413 | 3299 | 5437 | 5620 | 6461 | 6015 | 7485 | 7508 |
| 318 | 816 | 1342 | 2436 | 2366 | 2853 | 3390 | 5171 | 4414 | 3407 | 5438 | 5720 | 6462 | 6111 | 7486 | 7554 |
| 319 | 1081 | 1343 | 2886 | 2367 | 3352 | 3391 | 5641 | 4415 | 3905 | 5439 | 6139 | 6463 | 6511 | 7487 | 7736 |
| 320 | 85 | 1344 | 614 | 2368 | 800 | 3392 | 2414 | 4416 | 1045 | 5440 | 2959 | 6464 | 3375 | 7488 | 5698 |
| 321 | 181 | 1345 | 956 | 2369 | 1225 | 3393 | 3124 | 4417 | 1574 | 5441 | 3682 | 6465 | 4151 | 7489 | 6336 |
| 322 | 190 | 1346 | 979 | 2370 | 1254 | 3394 | 3168 | 4418 | 1612 | 5442 | 3724 | 6466 | 4199 | 7490 | 6371 |
| 323 | 293 | 1347 | 1272 | 2371 | 1601 | 3395 | 3676 | 4419 | 2029 | 5443 | 4229 | 6467 | 4730 | 7491 | 6738 |
| 324 | 206 | 1348 | 1032 | 2372 | 1315 | 3396 | 3262 | 4420 | 1686 | 5444 | 3819 | 6468 | 4299 | 7492 | 6444 |
| 325 | 316 | 1349 | 1328 | 2373 | 1666 | 3397 | 3766 | 4421 | 2107 | 5445 | 4320 | 6469 | 4820 | 7493 | 6797 |
| 326 | 335 | 1350 | 1382 | 2374 | 1724 | 3398 | 3851 | 4422 | 2172 | 5446 | 4405 | 6470 | 4898 | 7494 | 6851 |
| 327 | 456 | 1351 | 1679 | 2375 | 2046 | 3399 | 4280 | 4423 | 2547 | 5447 | 4837 | 6471 | 5298 | 7495 | 7109 |
| 328 | 217 | 1352 | 1061 | 2376 | 1354 | 3400 | 3315 | 4424 | 1731 | 5448 | 3870 | 6472 | 4361 | 7496 | 6484 |
| 329 | 342 | 1353 | 1399 | 2377 | 1743 | 3401 | 3878 | 4425 | 2197 | 5449 | 4432 | 6473 | 4924 | 7497 | 6868 |
| 330 | 351 | 1354 | 1421 | 2378 | 1767 | 3402 | 3912 | 4426 | 2225 | 5450 | 4466 | 6474 | 4954 | 7498 | 6889 |
| 331 | 495 | 1355 | 1772 | 2379 | 2144 | 3403 | 4401 | 4427 | 2655 | 5451 | 4961 | 6475 | 5410 | 7499 | 7178 |
| 332 | 372 | 1356 | 1477 | 2380 | 1826 | 3404 | 3998 | 4428 | 2293 | 5452 | 4550 | 6476 | 5030 | 7500 | 6940 |
| 333 | 527 | 1357 | 1841 | 2381 | 2217 | 3405 | 4490 | 4429 | 2739 | 5453 | 5050 | 6477 | 5491 | 7501 | 7227 |
| 334 | 547 | 1358 | 1885 | 2382 | 2264 | 3406 | 4544 | 4430 | 2793 | 5454 | 5105 | 6478 | 5541 | 7502 | 7255 |
| 335 | 733 | 1359 | 2272 | 2383 | 2680 | 3407 | 4996 | 4431 | 3231 | 5455 | 5551 | 6479 | 5955 | 7503 | 7477 |
| 336 | 279 | 1360 | 1233 | 2384 | 1554 | 3408 | 3611 | 4432 | 1975 | 5456 | 4163 | 6480 | 4664 | 7504 | 6694 |
| 337 | 365 | 1361 | 1462 | 2385 | 1810 | 3409 | 3976 | 4433 | 2273 | 5457 | 4528 | 6481 | 5010 | 7505 | 6927 |
| 338 | 388 | 1362 | 1517 | 2386 | 1872 | 3410 | 4059 | 4434 | 2344 | 5458 | 4609 | 6482 | 5088 | 7506 | 6976 |
| 339 | 532 | 1363 | 1853 | 2387 | 2229 | 3411 | 4505 | 4435 | 2754 | 5459 | 5065 | 6483 | 5503 | 7507 | 7235 |
| 340 | 409 | 1364 | 1571 | 2388 | 1929 | 3412 | 4134 | 4436 | 2409 | 5460 | 4687 | 6484 | 5159 | 7508 | 7023 |
| 341 | 562 | 1365 | 1914 | 2389 | 2296 | 3413 | 4581 | 4437 | 2829 | 5461 | 5141 | 6485 | 5576 | 7509 | 7275 |
| 342 | 588 | 1366 | 1974 | 2390 | 2356 | 3414 | 4654 | 4438 | 2895 | 5462 | 5214 | 6486 | 5639 | 7510 | 7313 |
| 343 | 760 | 1367 | 2326 | 2391 | 2735 | 3415 | 5054 | 4439 | 3289 | 5463 | 5608 | 6487 | 6006 | 7511 | 7503 |
| 344 | 443 | 1368 | 1651 | 2392 | 2015 | 3416 | 4242 | 4440 | 2510 | 5464 | 4799 | 6488 | 5262 | 7512 | 7087 |
| 345 | 597 | 1369 | 1995 | 2393 | 2376 | 3417 | 4677 | 4441 | 2917 | 5465 | 5238 | 6489 | 5660 | 7513 | 7324 |
| 346 | 635 | 1370 | 2075 | 2394 | 2464 | 3418 | 4772 | 4442 | 3009 | 5466 | 5332 | 6490 | 5748 | 7514 | 7372 |
| 347 | 805 | 1371 | 2416 | 2395 | 2830 | 3419 | 5148 | 4443 | 3384 | 5467 | 5700 | 6491 | 6090 | 7515 | 7544 |
| 348 | 667 | 1372 | 2141 | 2396 | 2534 | 3420 | 4847 | 4444 | 3084 | 5468 | 5407 | 6492 | 5817 | 7516 | 7408 |
| 349 | 862 | 1373 | 2518 | 2397 | 2943 | 3421 | 5261 | 4445 | 3501 | 5469 | 5802 | 6493 | 6188 | 7517 | 7591 |
| 350 | 901 | 1374 | 2586 | 2398 | 3021 | 3422 | 5334 | 4446 | 3577 | 5470 | 5868 | 6494 | 6253 | 7518 | 7621 |
| 351 | 1147 | 1375 | 2993 | 2399 | 3466 | 3423 | 5744 | 4447 | 4017 | 5471 | 6230 | 6495 | 6594 | 7519 | 7771 |
| 352 | 313 | 1376 | 1324 | 2400 | 1662 | 3424 | 3761 | 4448 | 2100 | 5472 | 4314 | 6496 | 4815 | 7520 | 6793 |
| 353 | 404 | 1377 | 1556 | 2401 | 1913 | 3425 | 4113 | 4449 | 2393 | 5473 | 4666 | 6497 | 5139 | 7521 | 7010 |
| 354 | 436 | 1378 | 1633 | 2402 | 1997 | 3426 | 4218 | 4450 | 2488 | 5474 | 4774 | 6498 | 5241 | 7522 | 7073 |
| 355 | 574 | 1379 | 1945 | 2403 | 2325 | 3427 | 4616 | 4451 | 2860 | 5475 | 5178 | 6499 | 5606 | 7523 | 7293 |
| 356 | 462 | 1380 | 1694 | 2404 | 2061 | 3428 | 4300 | 4452 | 2563 | 5476 | 4858 | 6500 | 5316 | 7524 | 7121 |
| 357 | 613 | 1381 | 2027 | 2405 | 2411 | 3429 | 4717 | 4453 | 2957 | 5477 | 5276 | 6501 | 5695 | 7525 | 7344 |
| 358 | 638 | 1382 | 2082 | 2406 | 2472 | 3430 | 4782 | 4454 | 3017 | 5478 | 5339 | 6502 | 5757 | 7526 | 7376 |
| 359 | 845 | 1383 | 2486 | 2407 | 2910 | 3431 | 5226 | 4455 | 3467 | 5479 | 5770 | 6503 | 6160 | 7527 | 7577 |
| 360 | 491 | 1384 | 1762 | 2408 | 2131 | 3432 | 4387 | 4456 | 2644 | 5480 | 4948 | 6504 | 5396 | 7528 | 7170 |
| 361 | 655 | 1385 | 2115 | 2409 | 2508 | 3433 | 4819 | 4457 | 3056 | 5481 | 5377 | 6505 | 5791 | 7529 | 7394 |
| 362 | 677 | 1386 | 2163 | 2410 | 2558 | 3434 | 4873 | 4458 | 3107 | 5482 | 5431 | 6506 | 5840 | 7530 | 7420 |
| 363 | 874 | 1387 | 2539 | 2411 | 2968 | 3435 | 5282 | 4459 | 3523 | 5483 | 5822 | 6507 | 6209 | 7531 | 7600 |
| 364 | 726 | 1388 | 2260 | 2412 | 2665 | 3436 | 4982 | 4460 | 3217 | 5484 | 5537 | 6508 | 5941 | 7532 | 7471 |
| 365 | 931 | 1389 | 2634 | 2413 | 3076 | 3437 | 5387 | 4461 | 3634 | 5485 | 5913 | 6509 | 6298 | 7533 | 7641 |
| 366 | 966 | 1390 | 2695 | 2414 | 3143 | 3438 | 5449 | 4462 | 3699 | 5486 | 5969 | 6510 | 6351 | 7534 | 7665 |
| 367 | 1211 | 1391 | 3093 | 2415 | 3576 | 3439 | 5841 | 4463 | 4126 | 5487 | 6311 | 6511 | 6671 | 7535 | 7803 |
| 368 | 535 | 1392 | 1860 | 2416 | 2238 | 3440 | 4514 | 4464 | 2762 | 5488 | 5073 | 6512 | 5514 | 7536 | 7239 |
| 369 | 724 | 1393 | 2254 | 2417 | 2659 | 3441 | 4974 | 4465 | 3212 | 5489 | 5531 | 6513 | 5936 | 7537 | 7467 |
| 370 | 742 | 1394 | 2289 | 2418 | 2697 | 3442 | 5014 | 4466 | 3251 | 5490 | 5569 | 6514 | 5971 | 7538 | 7485 |
| 371 | 952 | 1395 | 2672 | 2419 | 3116 | 3443 | 5426 | 4467 | 3673 | 5491 | 5948 | 6515 | 6330 | 7539 | 7657 |
| 372 | 761 | 1396 | 2329 | 2420 | 2738 | 3444 | 5056 | 4468 | 3292 | 5492 | 5611 | 6516 | 6009 | 7540 | 7504 |
| 373 | 992 | 1397 | 2740 | 2421 | 3193 | 3445 | 5495 | 4469 | 3748 | 5493 | 6010 | 6517 | 6390 | 7541 | 7683 |
| 374 | 940 | 1398 | 2651 | 2422 | 3095 | 3446 | 5403 | 4470 | 3651 | 5494 | 5929 | 6518 | 6313 | 7542 | 7648 |
| 375 | 1257 | 1399 | 3163 | 2423 | 3652 | 3447 | 5904 | 4471 | 4203 | 5495 | 6367 | 6519 | 6722 | 7543 | 7823 |
| 376 | 826 | 1400 | 2455 | 2424 | 2874 | 3448 | 5192 | 4472 | 3428 | 5496 | 5739 | 6520 | 6129 | 7544 | 7563 |
| 377 | 1074 | 1401 | 2872 | 2425 | 3338 | 3449 | 5628 | 4473 | 3893 | 5497 | 6127 | 6521 | 6501 | 7545 | 7731 |
| 378 | 1107 | 1402 | 2926 | 2426 | 3397 | 3450 | 5681 | 4474 | 3949 | 5498 | 6173 | 6522 | 6544 | 7546 | 7750 |
| 379 | 1355 | 1403 | 3309 | 2427 | 3809 | 3451 | 6033 | 4475 | 4363 | 5499 | 6479 | 6523 | 6824 | 7547 | 7863 |
| 380 | 1121 | 1404 | 2948 | 2428 | 3422 | 3452 | 5703 | 4476 | 3973 | 5500 | 6192 | 6524 | 6562 | 7548 | 7757 |
| 381 | 1459 | 1405 | 3473 | 2429 | 3972 | 3453 | 6178 | 4477 | 4524 | 5501 | 6599 | 6525 | 6925 | 7549 | 7904 |
| 382 | 1518 | 1406 | 3565 | 2430 | 4061 | 3454 | 6252 | 4478 | 4611 | 5502 | 6663 | 6526 | 6978 | 7550 | 7924 |
| 383 | 1755 | 1407 | 3908 | 2431 | 4378 | 3455 | 6523 | 4479 | 4939 | 5503 | 6886 | 6527 | 7165 | 7551 | 7991 |
| 384 | 91 | 1408 | 637 | 2432 | 833 | 3456 | 2469 | 4480 | 1086 | 5504 | 3015 | 6528 | 3442 | 7552 | 5754 |
| 385 | 203 | 1409 | 1025 | 2433 | 1306 | 3457 | 3252 | 4481 | 1673 | 5505 | 3806 | 6529 | 4285 | 7553 | 6436 |
| 386 | 209 | 1410 | 1039 | 2434 | 1327 | 3458 | 3276 | 4482 | 1700 | 5506 | 3831 | 6530 | 4318 | 7554 | 6454 |
| 387 | 356 | 1411 | 1436 | 2435 | 1784 | 3459 | 3936 | 4483 | 2242 | 5507 | 4489 | 6531 | 4976 | 7555 | 6903 |
| 388 | 268 | 1412 | 1205 | 2436 | 1523 | 3460 | 3563 | 4484 | 1935 | 5508 | 4116 | 6532 | 4618 | 7556 | 6662 |
| 389 | 376 | 1413 | 1487 | 2437 | 1839 | 3461 | 4012 | 4485 | 2307 | 5509 | 4565 | 6533 | 5047 | 7557 | 6949 |
| 390 | 392 | 1414 | 1527 | 2438 | 1881 | 3462 | 4073 | 4486 | 2357 | 5510 | 4624 | 6534 | 5100 | 7558 | 6985 |
| 391 | 541 | 1415 | 1870 | 2439 | 2250 | 3463 | 4527 | 4487 | 2776 | 5511 | 5087 | 6535 | 5526 | 7559 | 7246 |
| 392 | 295 | 1416 | 1276 | 2440 | 1607 | 3464 | 3681 | 4488 | 2036 | 5512 | 4235 | 6536 | 4739 | 7560 | 6742 |
| 393 | 397 | 1417 | 1542 | 2441 | 1897 | 3465 | 4095 | 4489 | 2373 | 5513 | 4646 | 6537 | 5119 | 7561 | 6998 |
| 394 | 412 | 1418 | 1575 | 2442 | 1934 | 3466 | 4138 | 4490 | 2419 | 5514 | 4693 | 6538 | 5165 | 7562 | 7025 |
| 395 | 569 | 1419 | 1933 | 2443 | 2313 | 3467 | 4603 | 4491 | 2849 | 5515 | 5164 | 6539 | 5594 | 7563 | 7286 |
| 396 | 442 | 1420 | 1647 | 2444 | 2012 | 3468 | 4238 | 4492 | 2507 | 5516 | 4794 | 6540 | 5259 | 7564 | 7084 |
| 397 | 601 | 1421 | 2001 | 2445 | 2385 | 3469 | 4686 | 4493 | 2927 | 5517 | 5246 | 6541 | 5669 | 7565 | 7329 |
| 398 | 634 | 1422 | 2069 | 2446 | 2461 | 3470 | 4765 | 4494 | 3007 | 5518 | 5325 | 6542 | 5745 | 7566 | 7368 |
| 399 | 849 | 1423 | 2494 | 2447 | 2918 | 3471 | 5237 | 4495 | 3474 | 5519 | 5778 | 6543 | 6167 | 7567 | 7581 |
| 400 | 311 | 1424 | 1317 | 2448 | 1656 | 3472 | 3749 | 4496 | 2092 | 5520 | 4303 | 6544 | 4806 | 7568 | 6786 |
| 401 | 439 | 1425 | 1641 | 2449 | 2003 | 3473 | 4230 | 4497 | 2498 | 5521 | 4785 | 6545 | 5247 | 7569 | 7080 |
| 402 | 461 | 1426 | 1692 | 2450 | 2058 | 3474 | 4296 | 4498 | 2560 | 5522 | 4855 | 6546 | 5313 | 7570 | 7118 |
| 403 | 602 | 1427 | 2005 | 2451 | 2388 | 3475 | 4690 | 4499 | 2930 | 5523 | 5251 | 6547 | 5672 | 7571 | 7331 |
| 404 | 478 | 1428 | 1732 | 2452 | 2101 | 3476 | 4349 | 4500 | 2608 | 5524 | 4908 | 6548 | 5361 | 7572 | 7149 |
| 405 | 641 | 1429 | 2084 | 2453 | 2475 | 3477 | 4784 | 4501 | 3022 | 5525 | 5343 | 6549 | 5759 | 7573 | 7377 |
| 406 | 670 | 1430 | 2148 | 2454 | 2543 | 3478 | 4856 | 4502 | 3092 | 5526 | 5414 | 6550 | 5826 | 7574 | 7412 |
| 407 | 884 | 1431 | 2554 | 2455 | 2987 | 3479 | 5299 | 4503 | 3544 | 5527 | 5836 | 6551 | 6225 | 7575 | 7606 |
| 408 | 505 | 1432 | 1794 | 2456 | 2167 | 3480 | 4429 | 4504 | 2682 | 5528 | 4990 | 6552 | 5436 | 7576 | 7193 |
| 409 | 682 | 1433 | 2171 | 2457 | 2567 | 3481 | 4883 | 4505 | 3117 | 5529 | 5441 | 6553 | 5849 | 7577 | 7425 |
| 410 | 713 | 1434 | 2233 | 2458 | 2636 | 3482 | 4950 | 4506 | 3187 | 5530 | 5508 | 6554 | 5914 | 7578 | 7456 |
| 411 | 921 | 1435 | 2619 | 2459 | 3057 | 3483 | 5370 | 4507 | 3614 | 5531 | 5899 | 6555 | 6282 | 7579 | 7635 |
| 412 | 757 | 1436 | 2321 | 2460 | 2732 | 3484 | 5046 | 4508 | 3285 | 5532 | 5602 | 6556 | 6003 | 7580 | 7499 |
| 413 | 960 | 1437 | 2686 | 2461 | 3131 | 3485 | 5437 | 4509 | 3688 | 5533 | 5961 | 6557 | 6342 | 7581 | 7661 |
| 414 | 1019 | 1438 | 2783 | 2462 | 3240 | 3486 | 5539 | 4510 | 3796 | 5534 | 6049 | 6558 | 6427 | 7582 | 7699 |
| 415 | 1270 | 1439 | 3183 | 2463 | 3674 | 3487 | 5921 | 4511 | 4225 | 5535 | 6382 | 6559 | 6737 | 7583 | 7829 |
| 416 | 361 | 1440 | 1447 | 2464 | 1797 | 3488 | 3952 | 4512 | 2259 | 5536 | 4506 | 6560 | 4993 | 7584 | 6913 |
| 417 | 467 | 1441 | 1706 | 2465 | 2073 | 3489 | 4317 | 4513 | 2578 | 5537 | 4874 | 6561 | 5330 | 7585 | 7130 |
| 418 | 484 | 1442 | 1746 | 2466 | 2116 | 3490 | 4368 | 4514 | 2626 | 5538 | 4927 | 6562 | 5379 | 7586 | 7159 |
| 419 | 668 | 1443 | 2142 | 2467 | 2537 | 3491 | 4849 | 4515 | 3087 | 5539 | 5408 | 6563 | 5820 | 7587 | 7409 |
| 420 | 517 | 1444 | 1820 | 2468 | 2194 | 3492 | 4462 | 4516 | 2714 | 5540 | 5023 | 6564 | 5465 | 7588 | 7212 |
| 421 | 703 | 1445 | 2213 | 2469 | 2615 | 3493 | 4931 | 4517 | 3165 | 5541 | 5487 | 6565 | 5895 | 7589 | 7447 |
| 422 | 745 | 1446 | 2298 | 2470 | 2706 | 3494 | 5024 | 4518 | 3258 | 5542 | 5578 | 6566 | 5979 | 7590 | 7489 |
| 423 | 943 | 1447 | 2657 | 2471 | 3099 | 3495 | 5409 | 4519 | 3656 | 5543 | 5934 | 6567 | 6317 | 7591 | 7650 |
| 424 | 567 | 1448 | 1930 | 2472 | 2311 | 3496 | 4601 | 4520 | 2843 | 5544 | 5160 | 6568 | 5591 | 7592 | 7285 |
| 425 | 746 | 1449 | 2301 | 2473 | 2709 | 3497 | 5026 | 4521 | 3260 | 5545 | 5581 | 6569 | 5982 | 7593 | 7491 |
| 426 | 769 | 1450 | 2346 | 2474 | 2755 | 3498 | 5074 | 4522 | 3308 | 5546 | 5629 | 6570 | 6024 | 7594 | 7512 |
| 427 | 1014 | 1451 | 2777 | 2475 | 3232 | 3499 | 5533 | 4523 | 3788 | 5547 | 6043 | 6571 | 6420 | 7595 | 7697 |
| 428 | 830 | 1452 | 2456 | 2476 | 2878 | 3500 | 5195 | 4524 | 3435 | 5548 | 5741 | 6572 | 6133 | 7596 | 7564 |
| 429 | 985 | 1453 | 2727 | 2477 | 3178 | 3501 | 5483 | 4525 | 3735 | 5549 | 5999 | 6573 | 6379 | 7597 | 7678 |
| 430 | 1092 | 1454 | 2905 | 2478 | 3371 | 3502 | 5659 | 4526 | 3925 | 5550 | 6156 | 6574 | 6525 | 7598 | 7742 |
| 431 | 1361 | 1455 | 3317 | 2479 | 3820 | 3503 | 6041 | 4527 | 4373 | 5551 | 6485 | 6575 | 6831 | 7599 | 7865 |
| 432 | 611 | 1456 | 2023 | 2480 | 2408 | 3504 | 4710 | 4528 | 2951 | 5552 | 5271 | 6576 | 5692 | 7600 | 7341 |
| 433 | 797 | 1457 | 2398 | 2481 | 2812 | 3505 | 5130 | 4529 | 3368 | 5553 | 5682 | 6577 | 6075 | 7601 | 7536 |
| 434 | 858 | 1458 | 2509 | 2482 | 2936 | 3506 | 5250 | 4530 | 3492 | 5554 | 5793 | 6578 | 6182 | 7602 | 7587 |
| 435 | 1075 | 1459 | 2877 | 2483 | 3341 | 3507 | 5632 | 4531 | 3895 | 5555 | 6131 | 6579 | 6503 | 7603 | 7732 |
| 436 | 885 | 1460 | 2559 | 2484 | 2990 | 3508 | 5307 | 4532 | 3546 | 5556 | 5842 | 6580 | 6227 | 7604 | 7610 |
| 437 | 1117 | 1461 | 2945 | 2485 | 3417 | 3509 | 5699 | 4533 | 3968 | 5557 | 6190 | 6581 | 6558 | 7605 | 7756 |
| 438 | 1154 | 1462 | 3000 | 2486 | 3477 | 3510 | 5753 | 4534 | 4029 | 5558 | 6235 | 6582 | 6601 | 7606 | 7774 |
| 439 | 1426 | 1463 | 3424 | 2487 | 3922 | 3511 | 6136 | 4535 | 4474 | 5559 | 6563 | 6583 | 6895 | 7607 | 7892 |
| 440 | 932 | 1464 | 2637 | 2488 | 3080 | 3512 | 5389 | 4536 | 3636 | 5560 | 5916 | 6584 | 6301 | 7608 | 7643 |
| 441 | 1168 | 1465 | 3023 | 2489 | 3502 | 3513 | 5772 | 4537 | 4053 | 5561 | 6254 | 6585 | 6619 | 7609 | 7781 |
| 442 | 1165 | 1466 | 3019 | 2490 | 3497 | 3514 | 5769 | 4538 | 4047 | 5562 | 6251 | 6586 | 6615 | 7610 | 7780 |
| 443 | 1503 | 1467 | 3538 | 2491 | 4038 | 3515 | 6232 | 4539 | 4589 | 5563 | 6644 | 6587 | 6964 | 7611 | 7919 |
| 444 | 1260 | 1468 | 3166 | 2492 | 3657 | 3516 | 5908 | 4540 | 4209 | 5564 | 6369 | 6588 | 6725 | 7612 | 7825 |
| 445 | 1547 | 1469 | 3607 | 2493 | 4101 | 3517 | 6288 | 4541 | 4653 | 5565 | 6692 | 6589 | 7003 | 7613 | 7933 |
| 446 | 1599 | 1470 | 3678 | 2494 | 4172 | 3518 | 6345 | 4542 | 4727 | 5566 | 6739 | 6590 | 7045 | 7614 | 7948 |
| 447 | 1928 | 1471 | 4140 | 2495 | 4596 | 3519 | 6695 | 4543 | 5157 | 5567 | 7026 | 6591 | 7283 | 7615 | 8028 |
| 448 | 403 | 1472 | 1553 | 2496 | 1909 | 3520 | 4109 | 4544 | 2390 | 5568 | 4662 | 6592 | 5134 | 7616 | 7007 |
| 449 | 502 | 1473 | 1785 | 2497 | 2157 | 3521 | 4418 | 4545 | 2673 | 5569 | 4978 | 6593 | 5425 | 7617 | 7187 |
| 450 | 543 | 1474 | 1878 | 2498 | 2255 | 3522 | 4535 | 4546 | 2782 | 5570 | 5096 | 6594 | 5532 | 7618 | 7251 |
| 451 | 750 | 1475 | 2303 | 2499 | 2715 | 3523 | 5029 | 4547 | 3268 | 5571 | 5584 | 6595 | 5988 | 7619 | 7492 |
| 452 | 599 | 1476 | 1999 | 2500 | 2379 | 3524 | 4683 | 4548 | 2922 | 5572 | 5243 | 6596 | 5663 | 7620 | 7327 |
| 453 | 772 | 1477 | 2349 | 2501 | 2761 | 3525 | 5076 | 4549 | 3316 | 5573 | 5631 | 6597 | 6029 | 7621 | 7513 |
| 454 | 814 | 1478 | 2430 | 2502 | 2847 | 3526 | 5163 | 4550 | 3403 | 5574 | 5714 | 6598 | 6105 | 7622 | 7550 |
| 455 | 1037 | 1479 | 2814 | 2503 | 3274 | 3527 | 5568 | 4551 | 3829 | 5575 | 6076 | 6599 | 6453 | 7623 | 7710 |
| 456 | 636 | 1480 | 2078 | 2504 | 2467 | 3528 | 4775 | 4552 | 3012 | 5576 | 5335 | 6600 | 5751 | 7624 | 7373 |
| 457 | 847 | 1481 | 2489 | 2505 | 2913 | 3529 | 5229 | 4553 | 3469 | 5577 | 5773 | 6601 | 6163 | 7625 | 7578 |
| 458 | 867 | 1482 | 2527 | 2506 | 2953 | 3530 | 5272 | 4554 | 3510 | 5578 | 5810 | 6602 | 6196 | 7626 | 7596 |
| 459 | 1110 | 1483 | 2931 | 2507 | 3402 | 3531 | 5684 | 4555 | 3955 | 5579 | 6177 | 6603 | 6548 | 7627 | 7751 |
| 460 | 912 | 1484 | 2601 | 2508 | 3040 | 3532 | 5351 | 4556 | 3597 | 5580 | 5882 | 6604 | 6269 | 7628 | 7627 |
| 461 | 1128 | 1485 | 2960 | 2509 | 3432 | 3533 | 5712 | 4557 | 3985 | 5581 | 6202 | 6605 | 6570 | 7629 | 7760 |
| 462 | 1163 | 1486 | 3016 | 2510 | 3495 | 3534 | 5766 | 4558 | 4045 | 5582 | 6249 | 6606 | 6614 | 7630 | 7779 |
| 463 | 1452 | 1487 | 3463 | 2511 | 3962 | 3535 | 6166 | 4559 | 4513 | 5583 | 6591 | 6607 | 6919 | 7631 | 7901 |
| 464 | 672 | 1488 | 2151 | 2512 | 2546 | 3536 | 4859 | 4560 | 3094 | 5584 | 5417 | 6608 | 5829 | 7632 | 7413 |
| 465 | 893 | 1489 | 2571 | 2513 | 3003 | 3537 | 5318 | 4561 | 3561 | 5585 | 5853 | 6609 | 6238 | 7633 | 7614 |
| 466 | 945 | 1490 | 2660 | 2514 | 3103 | 3538 | 5412 | 4562 | 3660 | 5586 | 5937 | 6610 | 6319 | 7634 | 7651 |
| 467 | 1150 | 1491 | 2997 | 2515 | 3472 | 3539 | 5747 | 4563 | 4023 | 5587 | 6233 | 6611 | 6598 | 7635 | 7772 |
| 468 | 967 | 1492 | 2698 | 2516 | 3144 | 3540 | 5452 | 4564 | 3701 | 5588 | 5972 | 6612 | 6352 | 7636 | 7666 |
| 469 | 1172 | 1493 | 3031 | 2517 | 3509 | 3541 | 5782 | 4565 | 4058 | 5589 | 6261 | 6613 | 6624 | 7637 | 7784 |
| 470 | 1264 | 1494 | 3171 | 2518 | 3663 | 3542 | 5911 | 4566 | 4215 | 5590 | 6373 | 6614 | 6729 | 7638 | 7826 |
| 471 | 1552 | 1495 | 3613 | 2519 | 4107 | 3543 | 6292 | 4567 | 4660 | 5591 | 6696 | 6615 | 7006 | 7639 | 7934 |
| 472 | 1034 | 1496 | 2811 | 2520 | 3267 | 3544 | 5565 | 4568 | 3823 | 5592 | 6074 | 6616 | 6448 | 7640 | 7709 |
| 473 | 1284 | 1497 | 3205 | 2521 | 3696 | 3545 | 5942 | 4569 | 4249 | 5593 | 6399 | 6617 | 6751 | 7641 | 7835 |
| 474 | 1322 | 1498 | 3261 | 2522 | 3757 | 3546 | 5991 | 4570 | 4311 | 5594 | 6442 | 6618 | 6791 | 7642 | 7850 |
| 475 | 1613 | 1499 | 3700 | 2523 | 4190 | 3547 | 6361 | 4571 | 4746 | 5595 | 6754 | 6619 | 7056 | 7643 | 7952 |
| 476 | 1390 | 1500 | 3367 | 2524 | 3865 | 3548 | 6088 | 4572 | 4419 | 5596 | 6522 | 6620 | 6859 | 7644 | 7879 |
| 477 | 1696 | 1501 | 3818 | 2525 | 4302 | 3549 | 6456 | 4573 | 4860 | 5597 | 6830 | 6621 | 7122 | 7645 | 7975 |
| 478 | 1745 | 1502 | 3894 | 2526 | 4366 | 3550 | 6514 | 4574 | 4925 | 5598 | 6878 | 6622 | 7158 | 7646 | 7989 |
| 479 | 2117 | 1503 | 4381 | 2527 | 4821 | 3551 | 6871 | 4575 | 5380 | 5599 | 7166 | 6623 | 7395 | 7647 | 8062 |
| 480 | 734 | 1504 | 2275 | 2528 | 2683 | 3552 | 4999 | 4576 | 3234 | 5600 | 5554 | 6624 | 5958 | 7648 | 7478 |
| 481 | 955 | 1505 | 2675 | 2529 | 3123 | 3553 | 5429 | 4577 | 3679 | 5601 | 5951 | 6625 | 6335 | 7649 | 7658 |
| 482 | 1008 | 1506 | 2767 | 2530 | 3220 | 3554 | 5521 | 4578 | 3777 | 5602 | 6035 | 6626 | 6411 | 7650 | 7693 |
| 483 | 1267 | 1507 | 3179 | 2531 | 3668 | 3555 | 5918 | 4579 | 4221 | 5603 | 6380 | 6627 | 6733 | 7651 | 7828 |
| 484 | 1089 | 1508 | 2900 | 2532 | 3366 | 3556 | 5656 | 4580 | 3919 | 5604 | 6152 | 6628 | 6521 | 7652 | 7741 |
| 485 | 1273 | 1509 | 3188 | 2533 | 3680 | 3557 | 5925 | 4581 | 4231 | 5605 | 6386 | 6629 | 6740 | 7653 | 7830 |
| 486 | 1376 | 1510 | 3345 | 2534 | 3841 | 3558 | 6066 | 4582 | 4396 | 5606 | 6506 | 6630 | 6845 | 7654 | 7872 |
| 487 | 1634 | 1511 | 3736 | 2535 | 4220 | 3559 | 6391 | 4583 | 4776 | 5607 | 6777 | 6631 | 7074 | 7655 | 7960 |
| 488 | 1101 | 1512 | 2920 | 2536 | 3385 | 3560 | 5675 | 4584 | 3939 | 5608 | 6168 | 6632 | 6535 | 7656 | 7748 |
| 489 | 1365 | 1513 | 3326 | 2537 | 3824 | 3561 | 6051 | 4585 | 4379 | 5609 | 6492 | 6633 | 6834 | 7657 | 7868 |
| 490 | 1433 | 1514 | 3434 | 2538 | 3932 | 3562 | 6144 | 4586 | 4485 | 5610 | 6571 | 6634 | 6901 | 7658 | 7894 |
| 491 | 1725 | 1515 | 3863 | 2539 | 4341 | 3563 | 6487 | 4587 | 4900 | 5611 | 6858 | 6635 | 7144 | 7659 | 7983 |
| 492 | 1488 | 1516 | 3513 | 2540 | 4016 | 3564 | 6208 | 4588 | 4567 | 5612 | 6627 | 6636 | 6951 | 7660 | 7912 |
| 493 | 1791 | 1517 | 3960 | 2541 | 4427 | 3565 | 6560 | 4589 | 4986 | 5613 | 6918 | 6637 | 7192 | 7661 | 7999 |
| 494 | 1886 | 1518 | 4093 | 2542 | 4546 | 3566 | 6656 | 4590 | 5106 | 5614 | 6997 | 6638 | 7257 | 7662 | 8020 |
| 495 | 2269 | 1519 | 4559 | 2543 | 4994 | 3567 | 6989 | 4591 | 5548 | 5615 | 7263 | 6639 | 7476 | 7663 | 8083 |
| 496 | 1129 | 1520 | 2963 | 2544 | 3436 | 3568 | 5715 | 4592 | 3987 | 5616 | 6204 | 6640 | 6572 | 7664 | 7761 |
| 497 | 1463 | 1521 | 3479 | 2545 | 3978 | 3569 | 6181 | 4593 | 4530 | 5617 | 6603 | 6641 | 6928 | 7665 | 7905 |
| 498 | 1535 | 1522 | 3585 | 2546 | 4087 | 3570 | 6272 | 4594 | 4637 | 5618 | 6677 | 6642 | 6993 | 7666 | 7929 |
| 499 | 1824 | 1523 | 4000 | 2547 | 4469 | 3571 | 6593 | 4595 | 5028 | 5619 | 6942 | 6643 | 7215 | 7667 | 8007 |
| 500 | 1577 | 1524 | 3650 | 2548 | 4142 | 3572 | 6324 | 4596 | 4696 | 5620 | 6720 | 6644 | 7028 | 7668 | 7943 |
| 501 | 1902 | 1525 | 4111 | 2549 | 4566 | 3573 | 6675 | 4597 | 5126 | 5621 | 7009 | 6645 | 7267 | 7669 | 8024 |
| 502 | 1857 | 1526 | 4050 | 2550 | 4509 | 3574 | 6626 | 4598 | 5070 | 5622 | 6972 | 6646 | 7237 | 7670 | 8014 |
| 503 | 2323 | 1527 | 4630 | 2551 | 5051 | 3575 | 7040 | 4599 | 5605 | 5623 | 7300 | 6647 | 7502 | 7671 | 8091 |
| 504 | 1667 | 1528 | 3782 | 2552 | 4264 | 3576 | 6425 | 4600 | 4822 | 5624 | 6807 | 6648 | 7100 | 7672 | 7968 |
| 505 | 1977 | 1529 | 4206 | 2553 | 4656 | 3577 | 6741 | 4601 | 5217 | 5625 | 7066 | 6649 | 7314 | 7673 | 8038 |
| 506 | 2030 | 1530 | 4274 | 2554 | 4720 | 3578 | 6794 | 4602 | 5279 | 5626 | 7106 | 6650 | 7346 | 7674 | 8048 |
| 507 | 2480 | 1531 | 4814 | 2555 | 5221 | 3579 | 7153 | 4603 | 5764 | 5627 | 7392 | 6651 | 7575 | 7675 | 8109 |
| 508 | 2145 | 1532 | 4414 | 2556 | 4854 | 3580 | 6894 | 4604 | 5411 | 5628 | 7185 | 6652 | 7411 | 7676 | 8067 |
| 509 | 2568 | 1533 | 4914 | 2557 | 5315 | 3581 | 7218 | 4605 | 5850 | 5629 | 7439 | 6653 | 7613 | 7677 | 8118 |
| 510 | 2678 | 1534 | 5049 | 2558 | 5432 | 3582 | 7296 | 4606 | 5954 | 5630 | 7501 | 6654 | 7659 | 7678 | 8128 |
| 511 | 3005 | 1535 | 5398 | 2559 | 5756 | 3583 | 7490 | 4607 | 6239 | 5631 | 7646 | 6655 | 7775 | 7679 | 8151 |
| 512 | 30 | 1536 | 332 | 2560 | 438 | 3584 | 1717 | 4608 | 573 | 5632 | 2165 | 6656 | 2495 | 7680 | 4889 |
| 513 | 48 | 1537 | 435 | 2561 | 576 | 3585 | 1993 | 4609 | 758 | 5633 | 2485 | 6657 | 2865 | 7681 | 5236 |
| 514 | 58 | 1538 | 487 | 2562 | 639 | 3586 | 2121 | 4610 | 838 | 5634 | 2632 | 6658 | 3020 | 7682 | 5385 |
| 515 | 110 | 1539 | 709 | 2563 | 923 | 3587 | 2630 | 4611 | 1202 | 5635 | 3180 | 6659 | 3619 | 7683 | 5909 |
| 516 | 66 | 1540 | 529 | 2564 | 692 | 3588 | 2223 | 4612 | 903 | 5636 | 2745 | 6660 | 3140 | 7684 | 5497 |
| 517 | 131 | 1541 | 791 | 2565 | 1021 | 3589 | 2801 | 4613 | 1320 | 5637 | 3356 | 6661 | 3800 | 7685 | 6065 |
| 518 | 144 | 1542 | 835 | 2566 | 1077 | 3590 | 2889 | 4614 | 1391 | 5638 | 3446 | 6662 | 3899 | 7686 | 6142 |
| 519 | 231 | 1543 | 1105 | 2567 | 1404 | 3591 | 3394 | 4615 | 1792 | 5639 | 3947 | 6663 | 4440 | 7687 | 6542 |
| 520 | 72 | 1544 | 555 | 2568 | 729 | 3592 | 2282 | 4616 | 950 | 5640 | 2813 | 6664 | 3224 | 7688 | 5561 |
| 521 | 148 | 1545 | 852 | 2569 | 1096 | 3593 | 2924 | 4617 | 1413 | 5641 | 3481 | 6665 | 3931 | 7689 | 6172 |
| 522 | 159 | 1546 | 883 | 2570 | 1135 | 3594 | 2984 | 4618 | 1465 | 5642 | 3541 | 6666 | 3997 | 7690 | 6222 |
| 523 | 239 | 1547 | 1123 | 2571 | 1427 | 3595 | 3425 | 4619 | 1821 | 5643 | 3977 | 6667 | 4476 | 7691 | 6565 |
| 524 | 172 | 1548 | 926 | 2572 | 1187 | 3596 | 3068 | 4620 | 1531 | 5644 | 3625 | 6668 | 4084 | 7692 | 6291 |
| 525 | 259 | 1549 | 1180 | 2573 | 1493 | 3597 | 3522 | 4621 | 1899 | 5645 | 4072 | 6669 | 4574 | 7693 | 6633 |
| 526 | 264 | 1550 | 1194 | 2574 | 1512 | 3598 | 3547 | 4622 | 1920 | 5646 | 4098 | 6670 | 4602 | 7694 | 6650 |
| 527 | 413 | 1551 | 1578 | 2575 | 1938 | 3599 | 4144 | 4623 | 2422 | 5647 | 4698 | 6671 | 5170 | 7695 | 7029 |
| 528 | 74 | 1552 | 565 | 2576 | 741 | 3600 | 2305 | 4624 | 965 | 5648 | 2838 | 6672 | 3248 | 7696 | 5585 |
| 529 | 170 | 1553 | 922 | 2577 | 1184 | 3601 | 3060 | 4625 | 1521 | 5649 | 3616 | 6673 | 4078 | 7697 | 6285 |
| 530 | 180 | 1554 | 953 | 2578 | 1221 | 3602 | 3119 | 4626 | 1570 | 5650 | 3675 | 6674 | 4143 | 7698 | 6333 |
| 531 | 258 | 1555 | 1176 | 2579 | 1489 | 3603 | 3516 | 4627 | 1895 | 5651 | 4066 | 6675 | 4569 | 7699 | 6629 |
| 532 | 191 | 1556 | 984 | 2580 | 1258 | 3604 | 3176 | 4628 | 1617 | 5652 | 3733 | 6676 | 4205 | 7700 | 6377 |
| 533 | 317 | 1557 | 1332 | 2581 | 1670 | 3605 | 3772 | 4629 | 2111 | 5653 | 4326 | 6677 | 4825 | 7701 | 6801 |
| 534 | 328 | 1558 | 1360 | 2582 | 1703 | 3606 | 3816 | 4630 | 2150 | 5654 | 4371 | 6678 | 4870 | 7702 | 6829 |
| 535 | 450 | 1559 | 1665 | 2583 | 2031 | 3607 | 4262 | 4631 | 2529 | 5655 | 4818 | 6679 | 5281 | 7703 | 7099 |
| 536 | 218 | 1560 | 1066 | 2584 | 1357 | 3608 | 3324 | 4632 | 1735 | 5656 | 3879 | 6680 | 4367 | 7704 | 6490 |
| 537 | 329 | 1561 | 1367 | 2585 | 1707 | 3609 | 3828 | 4633 | 2154 | 5657 | 4382 | 6681 | 4876 | 7705 | 6836 |
| 538 | 355 | 1562 | 1432 | 2586 | 1780 | 3610 | 3930 | 4634 | 2239 | 5658 | 4483 | 6682 | 4971 | 7706 | 6899 |
| 539 | 492 | 1563 | 1763 | 2587 | 2134 | 3611 | 4391 | 4635 | 2646 | 5659 | 4949 | 6683 | 5399 | 7707 | 7172 |
| 540 | 375 | 1564 | 1483 | 2588 | 1836 | 3612 | 4006 | 4636 | 2304 | 5660 | 4560 | 6684 | 5043 | 7708 | 6945 |
| 541 | 520 | 1565 | 1827 | 2589 | 2202 | 3613 | 4471 | 4637 | 2722 | 5661 | 5032 | 6685 | 5474 | 7709 | 7216 |
| 542 | 545 | 1566 | 1882 | 2590 | 2261 | 3614 | 4542 | 4638 | 2788 | 5662 | 5101 | 6686 | 5538 | 7710 | 7254 |
| 543 | 754 | 1567 | 2312 | 2591 | 2723 | 3615 | 5039 | 4639 | 3277 | 5663 | 5593 | 6687 | 5995 | 7711 | 7496 |
| 544 | 76 | 1568 | 575 | 2592 | 753 | 3616 | 2328 | 4640 | 980 | 5664 | 2862 | 6688 | 3275 | 7712 | 5609 |
| 545 | 187 | 1569 | 971 | 2593 | 1246 | 3617 | 3153 | 4641 | 1598 | 5665 | 3709 | 6689 | 4185 | 7713 | 6359 |
| 546 | 204 | 1570 | 1028 | 2594 | 1311 | 3618 | 3257 | 4642 | 1677 | 5666 | 3813 | 6690 | 4293 | 7714 | 6440 |
| 547 | 322 | 1571 | 1345 | 2595 | 1687 | 3619 | 3793 | 4643 | 2129 | 5667 | 4348 | 6691 | 4848 | 7715 | 6814 |
| 548 | 220 | 1572 | 1071 | 2596 | 1366 | 3620 | 3334 | 4644 | 1744 | 5668 | 3889 | 6692 | 4380 | 7716 | 6498 |
| 549 | 353 | 1573 | 1428 | 2597 | 1773 | 3621 | 3924 | 4645 | 2232 | 5669 | 4478 | 6693 | 4963 | 7717 | 6896 |
| 550 | 368 | 1574 | 1466 | 2598 | 1816 | 3622 | 3982 | 4646 | 2280 | 5670 | 4534 | 6694 | 5018 | 7718 | 6931 |
| 551 | 510 | 1575 | 1805 | 2599 | 2178 | 3623 | 4443 | 4647 | 2696 | 5671 | 5003 | 6695 | 5448 | 7719 | 7201 |
| 552 | 232 | 1576 | 1108 | 2600 | 1407 | 3624 | 3399 | 4648 | 1796 | 5672 | 3951 | 6696 | 4445 | 7720 | 6545 |
| 553 | 381 | 1577 | 1498 | 2601 | 1852 | 3625 | 4030 | 4649 | 2324 | 5673 | 4582 | 6697 | 5063 | 7721 | 6960 |
| 554 | 395 | 1578 | 1534 | 2602 | 1890 | 3626 | 4083 | 4650 | 2367 | 5674 | 4635 | 6698 | 5111 | 7722 | 6991 |
| 555 | 551 | 1579 | 1894 | 2603 | 2274 | 3627 | 4555 | 4651 | 2802 | 5675 | 5116 | 6699 | 5552 | 7723 | 7261 |
| 556 | 416 | 1580 | 1585 | 2604 | 1944 | 3628 | 4152 | 4652 | 2428 | 5676 | 4707 | 6700 | 5177 | 7724 | 7034 |
| 557 | 582 | 1581 | 1964 | 2605 | 2345 | 3629 | 4641 | 4653 | 2882 | 5677 | 5201 | 6701 | 5627 | 7725 | 7306 |
| 558 | 608 | 1582 | 2016 | 2606 | 2400 | 3630 | 4704 | 4654 | 2944 | 5678 | 5263 | 6702 | 5683 | 7726 | 7338 |
| 559 | 775 | 1583 | 2358 | 2607 | 2769 | 3631 | 5086 | 4655 | 3323 | 5679 | 5640 | 6703 | 6036 | 7727 | 7517 |
| 560 | 246 | 1584 | 1146 | 2608 | 1453 | 3632 | 3464 | 4656 | 1850 | 5680 | 4015 | 6704 | 4515 | 7728 | 6592 |
| 561 | 406 | 1585 | 1559 | 2609 | 1919 | 3633 | 4117 | 4657 | 2399 | 5681 | 4671 | 6705 | 5147 | 7729 | 7012 |
| 562 | 430 | 1586 | 1619 | 2610 | 1978 | 3634 | 4200 | 4658 | 2470 | 5682 | 4755 | 6706 | 5219 | 7730 | 7062 |
| 563 | 595 | 1587 | 1989 | 2611 | 2374 | 3635 | 4672 | 4659 | 2914 | 5683 | 5231 | 6707 | 5657 | 7731 | 7322 |
| 564 | 457 | 1588 | 1684 | 2612 | 2049 | 3636 | 4286 | 4660 | 2550 | 5684 | 4844 | 6708 | 5302 | 7732 | 7113 |
| 565 | 631 | 1589 | 2067 | 2613 | 2452 | 3637 | 4763 | 4661 | 2999 | 5685 | 5322 | 6709 | 5736 | 7733 | 7367 |
| 566 | 652 | 1590 | 2106 | 2614 | 2502 | 3638 | 4809 | 4662 | 3048 | 5686 | 5368 | 6710 | 5786 | 7734 | 7390 |
| 567 | 836 | 1591 | 2468 | 2615 | 2893 | 3639 | 5208 | 4663 | 3449 | 5687 | 5752 | 6711 | 6145 | 7735 | 7569 |
| 568 | 469 | 1592 | 1712 | 2616 | 2080 | 3640 | 4325 | 4664 | 2584 | 5688 | 4882 | 6712 | 5338 | 7736 | 7135 |
| 569 | 644 | 1593 | 2091 | 2617 | 2484 | 3641 | 4793 | 4665 | 3030 | 5689 | 5350 | 6713 | 5768 | 7737 | 7382 |
| 570 | 684 | 1594 | 2174 | 2618 | 2573 | 3642 | 4885 | 4666 | 3122 | 5690 | 5444 | 6714 | 5855 | 7738 | 7426 |
| 571 | 890 | 1595 | 2565 | 2619 | 2998 | 3643 | 5312 | 4667 | 3555 | 5691 | 5848 | 6715 | 6234 | 7739 | 7612 |
| 572 | 689 | 1596 | 2184 | 2620 | 2585 | 3644 | 4897 | 4668 | 3135 | 5692 | 5455 | 6716 | 5866 | 7740 | 7431 |
| 573 | 920 | 1597 | 2613 | 2621 | 3055 | 3645 | 5364 | 4669 | 3612 | 5693 | 5893 | 6717 | 6281 | 7741 | 7633 |
| 574 | 957 | 1598 | 2681 | 2622 | 3128 | 3646 | 5435 | 4670 | 3684 | 5694 | 5957 | 6718 | 6339 | 7742 | 7660 |
| 575 | 1340 | 1599 | 3286 | 2623 | 3786 | 3647 | 6016 | 4671 | 4340 | 5695 | 6462 | 6719 | 6809 | 7743 | 7857 |
| 576 | 119 | 1600 | 748 | 2624 | 969 | 3648 | 2712 | 4672 | 1256 | 5696 | 3265 | 6720 | 3705 | 7744 | 5985 |
| 577 | 219 | 1601 | 1069 | 2625 | 1362 | 3649 | 3329 | 4673 | 1740 | 5697 | 3885 | 6721 | 4375 | 7745 | 6494 |
| 578 | 228 | 1602 | 1094 | 2626 | 1393 | 3650 | 3374 | 4674 | 1779 | 5698 | 3927 | 6722 | 4423 | 7746 | 6527 |
| 579 | 373 | 1603 | 1478 | 2627 | 1829 | 3651 | 4002 | 4675 | 2297 | 5699 | 4552 | 6723 | 5035 | 7747 | 6943 |
| 580 | 241 | 1604 | 1130 | 2628 | 1435 | 3652 | 3438 | 4676 | 1830 | 5700 | 3989 | 6724 | 4487 | 7748 | 6573 |
| 581 | 396 | 1605 | 1538 | 2629 | 1893 | 3653 | 4089 | 4677 | 2370 | 5701 | 4640 | 6725 | 5115 | 7749 | 6994 |
| 582 | 414 | 1606 | 1581 | 2630 | 1941 | 3654 | 4148 | 4678 | 2425 | 5702 | 4702 | 6726 | 5173 | 7750 | 7031 |
| 583 | 572 | 1607 | 1942 | 2631 | 2322 | 3655 | 4614 | 4679 | 2857 | 5703 | 5175 | 6727 | 5603 | 7751 | 7292 |
| 584 | 271 | 1608 | 1213 | 2632 | 1533 | 3656 | 3578 | 4680 | 1947 | 5704 | 4130 | 6728 | 4633 | 7752 | 6672 |
| 585 | 433 | 1609 | 1624 | 2633 | 1988 | 3657 | 4208 | 4681 | 2479 | 5705 | 4762 | 6729 | 5230 | 7753 | 7067 |
| 586 | 445 | 1610 | 1655 | 2634 | 2019 | 3658 | 4248 | 4682 | 2513 | 5706 | 4804 | 6730 | 5267 | 7754 | 7090 |
| 587 | 622 | 1611 | 2047 | 2635 | 2431 | 3659 | 4740 | 4683 | 2978 | 5707 | 5300 | 6731 | 5716 | 7755 | 7356 |
| 588 | 474 | 1612 | 1721 | 2636 | 2088 | 3660 | 4335 | 4684 | 2596 | 5708 | 4895 | 6732 | 5347 | 7756 | 7141 |
| 589 | 658 | 1613 | 2123 | 2637 | 2517 | 3661 | 4828 | 4685 | 3064 | 5709 | 5386 | 6733 | 5800 | 7757 | 7399 |
| 590 | 680 | 1614 | 2166 | 2638 | 2564 | 3662 | 4878 | 4686 | 3115 | 5710 | 5434 | 6734 | 5846 | 7758 | 7422 |
| 591 | 853 | 1615 | 2500 | 2639 | 2928 | 3663 | 5242 | 4687 | 3483 | 5711 | 5784 | 6735 | 6175 | 7759 | 7583 |
| 592 | 292 | 1616 | 1269 | 2640 | 1597 | 3664 | 3670 | 4688 | 2025 | 5712 | 4223 | 6736 | 4725 | 7760 | 6734 |
| 593 | 449 | 1617 | 1661 | 2641 | 2028 | 3665 | 4256 | 4689 | 2526 | 5713 | 4813 | 6737 | 5278 | 7761 | 7095 |
| 594 | 483 | 1618 | 1742 | 2642 | 2113 | 3666 | 4362 | 4690 | 2623 | 5714 | 4922 | 6738 | 5375 | 7762 | 7156 |
| 595 | 648 | 1619 | 2099 | 2643 | 2493 | 3667 | 4800 | 4691 | 3041 | 5715 | 5360 | 6739 | 5777 | 7763 | 7385 |
| 596 | 508 | 1620 | 1801 | 2644 | 2173 | 3668 | 4437 | 4692 | 2690 | 5716 | 4998 | 6740 | 5442 | 7764 | 7198 |
| 597 | 687 | 1621 | 2181 | 2645 | 2579 | 3669 | 4894 | 4693 | 3130 | 5717 | 5451 | 6741 | 5860 | 7765 | 7430 |
| 598 | 697 | 1622 | 2201 | 2646 | 2603 | 3670 | 4916 | 4694 | 3152 | 5718 | 5473 | 6742 | 5883 | 7766 | 7440 |
| 599 | 905 | 1623 | 2589 | 2647 | 3026 | 3671 | 5337 | 4695 | 3584 | 5719 | 5870 | 6743 | 6257 | 7767 | 7622 |
| 600 | 531 | 1624 | 1848 | 2648 | 2226 | 3672 | 4499 | 4696 | 2751 | 5720 | 5058 | 6744 | 5500 | 7768 | 7231 |
| 601 | 699 | 1625 | 2205 | 2649 | 2606 | 3673 | 4921 | 4697 | 3157 | 5721 | 5478 | 6745 | 5886 | 7769 | 7443 |
| 602 | 712 | 1626 | 2230 | 2650 | 2633 | 3674 | 4947 | 4698 | 3185 | 5722 | 5505 | 6746 | 5912 | 7770 | 7455 |
| 603 | 962 | 1627 | 2689 | 2651 | 3136 | 3675 | 5443 | 4699 | 3692 | 5723 | 5964 | 6747 | 6346 | 7771 | 7663 |
| 604 | 796 | 1628 | 2395 | 2652 | 2809 | 3676 | 5127 | 4700 | 3365 | 5724 | 5679 | 6748 | 6072 | 7772 | 7535 |
| 605 | 996 | 1629 | 2744 | 2653 | 3198 | 3677 | 5498 | 4701 | 3754 | 5725 | 6014 | 6749 | 6394 | 7773 | 7684 |
| 606 | 1062 | 1630 | 2855 | 2654 | 3319 | 3678 | 5610 | 4702 | 3872 | 5726 | 6112 | 6750 | 6486 | 7774 | 7725 |
| 607 | 1363 | 1631 | 3322 | 2655 | 3822 | 3679 | 6048 | 4703 | 4377 | 5727 | 6489 | 6751 | 6833 | 7775 | 7867 |
| 608 | 312 | 1632 | 1321 | 2656 | 1660 | 3680 | 3755 | 4704 | 2096 | 5728 | 4309 | 6752 | 4811 | 7776 | 6790 |
| 609 | 507 | 1633 | 1798 | 2657 | 2170 | 3681 | 4435 | 4705 | 2688 | 5729 | 4995 | 6753 | 5439 | 7777 | 7197 |
| 610 | 523 | 1634 | 1833 | 2658 | 2209 | 3682 | 4480 | 4706 | 2731 | 5730 | 5040 | 6754 | 5482 | 7778 | 7221 |
| 611 | 708 | 1635 | 2224 | 2659 | 2627 | 3683 | 4943 | 4707 | 3177 | 5731 | 5499 | 6755 | 5906 | 7779 | 7453 |
| 612 | 558 | 1636 | 1912 | 2660 | 2291 | 3684 | 4577 | 4708 | 2821 | 5732 | 5138 | 6756 | 5570 | 7780 | 7273 |
| 613 | 743 | 1637 | 2292 | 2661 | 2700 | 3685 | 5016 | 4709 | 3253 | 5733 | 5572 | 6757 | 5974 | 7781 | 7486 |
| 614 | 751 | 1638 | 2309 | 2662 | 2717 | 3686 | 5036 | 4710 | 3270 | 5734 | 5590 | 6758 | 5989 | 7782 | 7495 |
| 615 | 977 | 1639 | 2713 | 2663 | 3164 | 3687 | 5469 | 4711 | 3720 | 5735 | 5986 | 6759 | 6368 | 7783 | 7673 |
| 616 | 587 | 1640 | 1970 | 2664 | 2353 | 3688 | 4647 | 4712 | 2892 | 5736 | 5209 | 6760 | 5636 | 7784 | 7309 |
| 617 | 792 | 1641 | 2389 | 2665 | 2805 | 3689 | 5120 | 4713 | 3358 | 5737 | 5673 | 6761 | 6068 | 7785 | 7532 |
| 618 | 820 | 1642 | 2445 | 2666 | 2861 | 3690 | 5179 | 4714 | 3416 | 5738 | 5729 | 6762 | 6118 | 7786 | 7557 |
| 619 | 1033 | 1643 | 2808 | 2667 | 3266 | 3691 | 5562 | 4715 | 3821 | 5739 | 6071 | 6763 | 6446 | 7787 | 7708 |
| 620 | 873 | 1644 | 2533 | 2668 | 2964 | 3692 | 5277 | 4716 | 3521 | 5740 | 5816 | 6764 | 6206 | 7788 | 7598 |
| 621 | 1084 | 1645 | 2891 | 2669 | 3357 | 3693 | 5647 | 4717 | 3911 | 5741 | 6143 | 6765 | 6515 | 7789 | 7738 |
| 622 | 1112 | 1646 | 2937 | 2670 | 3408 | 3694 | 5690 | 4718 | 3959 | 5742 | 6183 | 6766 | 6552 | 7790 | 7753 |
| 623 | 1437 | 1647 | 3440 | 2671 | 3938 | 3695 | 6147 | 4719 | 4491 | 5743 | 6575 | 6767 | 6904 | 7791 | 7896 |
| 624 | 621 | 1648 | 2042 | 2672 | 2429 | 3696 | 4733 | 4720 | 2975 | 5744 | 5294 | 6768 | 5713 | 7792 | 7352 |
| 625 | 841 | 1649 | 2477 | 2673 | 2902 | 3697 | 5216 | 4721 | 3458 | 5745 | 5761 | 6769 | 6153 | 7793 | 7572 |
| 626 | 889 | 1650 | 2562 | 2674 | 2995 | 3698 | 5309 | 4722 | 3552 | 5746 | 5845 | 6770 | 6231 | 7794 | 7611 |
| 627 | 1115 | 1651 | 2940 | 2675 | 3411 | 3699 | 5696 | 4723 | 3963 | 5747 | 6186 | 6771 | 6554 | 7795 | 7755 |
| 628 | 936 | 1652 | 2645 | 2676 | 3086 | 3700 | 5395 | 4724 | 3643 | 5748 | 5923 | 6772 | 6306 | 7796 | 7645 |
| 629 | 1143 | 1653 | 2988 | 2677 | 3461 | 3701 | 5740 | 4725 | 4011 | 5749 | 6226 | 6773 | 6590 | 7797 | 7770 |
| 630 | 1218 | 1654 | 3101 | 2678 | 3587 | 3702 | 5847 | 4726 | 4139 | 5750 | 6318 | 6774 | 6678 | 7798 | 7805 |
| 631 | 1492 | 1655 | 3518 | 2679 | 4020 | 3703 | 6212 | 4727 | 4573 | 5751 | 6630 | 6775 | 6954 | 7799 | 7913 |
| 632 | 1006 | 1656 | 2763 | 2680 | 3218 | 3704 | 5518 | 4728 | 3773 | 5752 | 6031 | 6776 | 6410 | 7800 | 7691 |
| 633 | 1228 | 1657 | 3118 | 2681 | 3604 | 3705 | 5861 | 4729 | 4155 | 5753 | 6331 | 6777 | 6689 | 7801 | 7810 |
| 634 | 1288 | 1658 | 3208 | 2682 | 3702 | 3706 | 5945 | 4730 | 4255 | 5754 | 6402 | 6778 | 6755 | 7802 | 7836 |
| 635 | 1557 | 1659 | 3618 | 2683 | 4115 | 3707 | 6296 | 4731 | 4667 | 5755 | 6699 | 6779 | 7011 | 7803 | 7935 |
| 636 | 1326 | 1660 | 3264 | 2684 | 3763 | 3708 | 5994 | 4732 | 4316 | 5756 | 6445 | 6780 | 6795 | 7804 | 7851 |
| 637 | 1626 | 1661 | 3719 | 2685 | 4210 | 3709 | 6378 | 4733 | 4766 | 5757 | 6766 | 6781 | 7068 | 7805 | 7956 |
| 638 | 1705 | 1662 | 3838 | 2686 | 4312 | 3710 | 6469 | 4734 | 4872 | 5758 | 6842 | 6782 | 7128 | 7806 | 7978 |
| 639 | 2102 | 1663 | 4364 | 2687 | 4805 | 3711 | 6854 | 4735 | 5363 | 5759 | 7157 | 6783 | 7387 | 7807 | 8059 |
| 640 | 123 | 1664 | 762 | 2688 | 988 | 3712 | 2741 | 4736 | 1280 | 5760 | 3294 | 6784 | 3739 | 7808 | 6011 |
| 641 | 238 | 1665 | 1120 | 2689 | 1422 | 3713 | 3418 | 4737 | 1817 | 5761 | 3971 | 6785 | 4468 | 7809 | 6559 |
| 642 | 260 | 1666 | 1182 | 2690 | 1497 | 3714 | 3527 | 4738 | 1903 | 5762 | 4076 | 6786 | 4580 | 7810 | 6637 |
| 643 | 427 | 1667 | 1614 | 2691 | 1976 | 3715 | 4194 | 4739 | 2463 | 5763 | 4748 | 6787 | 5215 | 7811 | 7058 |
| 644 | 289 | 1668 | 1261 | 2692 | 1590 | 3716 | 3659 | 4740 | 2013 | 5764 | 4211 | 6788 | 4714 | 7812 | 6727 |
| 645 | 446 | 1669 | 1658 | 2693 | 2022 | 3717 | 4254 | 4741 | 2516 | 5765 | 4810 | 6789 | 5270 | 7813 | 7094 |
| 646 | 477 | 1670 | 1728 | 2694 | 2098 | 3718 | 4343 | 4742 | 2605 | 5766 | 4903 | 6790 | 5358 | 7814 | 7145 |
| 647 | 664 | 1671 | 2135 | 2695 | 2528 | 3719 | 4842 | 4743 | 3077 | 5767 | 5400 | 6791 | 5812 | 7815 | 7406 |
| 648 | 306 | 1672 | 1304 | 2696 | 1639 | 3720 | 3727 | 4744 | 2074 | 5768 | 4281 | 6792 | 4783 | 7816 | 6771 |
| 649 | 488 | 1673 | 1752 | 2697 | 2126 | 3721 | 4376 | 4745 | 2635 | 5769 | 4936 | 6793 | 5390 | 7817 | 7164 |
| 650 | 511 | 1674 | 1809 | 2698 | 2182 | 3722 | 4448 | 4746 | 2699 | 5770 | 5008 | 6794 | 5453 | 7818 | 7203 |
| 651 | 702 | 1675 | 2208 | 2699 | 2612 | 3723 | 4923 | 4747 | 3162 | 5771 | 5481 | 6795 | 5892 | 7819 | 7444 |
| 652 | 536 | 1676 | 1864 | 2700 | 2241 | 3724 | 4518 | 4748 | 2765 | 5772 | 5078 | 6796 | 5517 | 7820 | 7242 |
| 653 | 719 | 1677 | 2245 | 2701 | 2650 | 3725 | 4967 | 4749 | 3202 | 5773 | 5522 | 6797 | 5927 | 7821 | 7464 |
| 654 | 728 | 1678 | 2265 | 2702 | 2671 | 3726 | 4987 | 4750 | 3222 | 5774 | 5543 | 6798 | 5947 | 7822 | 7473 |
| 655 | 970 | 1679 | 2701 | 2703 | 3151 | 3727 | 5454 | 4751 | 3707 | 5775 | 5975 | 6799 | 6358 | 7823 | 7668 |
| 656 | 341 | 1680 | 1395 | 2704 | 1741 | 3728 | 3873 | 4752 | 2193 | 5776 | 4426 | 6800 | 4920 | 7824 | 6864 |
| 657 | 526 | 1681 | 1837 | 2705 | 2215 | 3729 | 4484 | 4753 | 2737 | 5777 | 5045 | 6801 | 5488 | 7825 | 7223 |
| 658 | 557 | 1682 | 1908 | 2706 | 2288 | 3730 | 4572 | 4754 | 2818 | 5778 | 5133 | 6802 | 5567 | 7826 | 7270 |
| 659 | 731 | 1683 | 2268 | 2707 | 2674 | 3731 | 4989 | 4755 | 3226 | 5779 | 5546 | 6803 | 5950 | 7827 | 7474 |
| 660 | 585 | 1684 | 1968 | 2708 | 2348 | 3732 | 4645 | 4756 | 2887 | 5780 | 5206 | 6804 | 5630 | 7828 | 7308 |
| 661 | 785 | 1685 | 2378 | 2709 | 2789 | 3733 | 5109 | 4757 | 3344 | 5781 | 5661 | 6805 | 6054 | 7829 | 7527 |
| 662 | 813 | 1686 | 2427 | 2710 | 2844 | 3734 | 5161 | 4758 | 3400 | 5782 | 5711 | 6806 | 6103 | 7830 | 7549 |
| 663 | 1023 | 1687 | 2794 | 2711 | 3249 | 3735 | 5550 | 4759 | 3804 | 5783 | 6058 | 6807 | 6433 | 7831 | 7703 |
| 664 | 617 | 1688 | 2039 | 2712 | 2423 | 3736 | 4731 | 4760 | 2967 | 5784 | 5291 | 6808 | 5707 | 7832 | 7351 |
| 665 | 832 | 1689 | 2462 | 2713 | 2885 | 3737 | 5200 | 4761 | 3439 | 5785 | 5746 | 6809 | 6138 | 7833 | 7566 |
| 666 | 869 | 1690 | 2530 | 2714 | 2958 | 3738 | 5274 | 4762 | 3514 | 5786 | 5813 | 6810 | 6200 | 7834 | 7597 |
| 667 | 1098 | 1691 | 2912 | 2715 | 3383 | 3739 | 5665 | 4763 | 3935 | 5787 | 6161 | 6811 | 6534 | 7835 | 7744 |
| 668 | 907 | 1692 | 2595 | 2716 | 3032 | 3740 | 5345 | 4764 | 3588 | 5788 | 5876 | 6812 | 6262 | 7836 | 7625 |
| 669 | 1133 | 1693 | 2966 | 2717 | 3441 | 3741 | 5718 | 4765 | 3993 | 5789 | 6207 | 6813 | 6576 | 7837 | 7763 |
| 670 | 1190 | 1694 | 3058 | 2718 | 3540 | 3742 | 5805 | 4766 | 4088 | 5790 | 6283 | 6814 | 6645 | 7838 | 7791 |
| 671 | 1441 | 1695 | 3443 | 2719 | 3944 | 3743 | 6151 | 4767 | 4496 | 5791 | 6577 | 6815 | 6908 | 7839 | 7897 |
| 672 | 369 | 1696 | 1469 | 2720 | 1819 | 3744 | 3986 | 4768 | 2283 | 5792 | 4539 | 6816 | 5022 | 7840 | 6933 |
| 673 | 571 | 1697 | 1937 | 2721 | 2319 | 3745 | 4608 | 4769 | 2854 | 5793 | 5168 | 6817 | 5600 | 7841 | 7289 |
| 674 | 606 | 1698 | 2014 | 2722 | 2397 | 3746 | 4699 | 4770 | 2941 | 5794 | 5260 | 6818 | 5680 | 7842 | 7335 |
| 675 | 818 | 1699 | 2439 | 2723 | 2856 | 3747 | 5174 | 4771 | 3412 | 5795 | 5723 | 6819 | 6113 | 7843 | 7555 |
| 676 | 654 | 1700 | 2112 | 2724 | 2505 | 3748 | 4816 | 4772 | 3054 | 5796 | 5374 | 6820 | 5789 | 7844 | 7393 |
| 677 | 861 | 1701 | 2515 | 2725 | 2942 | 3749 | 5258 | 4773 | 3499 | 5797 | 5799 | 6821 | 6187 | 7845 | 7590 |
| 678 | 857 | 1702 | 2506 | 2726 | 2932 | 3750 | 5248 | 4774 | 3490 | 5798 | 5790 | 6822 | 6179 | 7846 | 7586 |
| 679 | 1136 | 1703 | 2974 | 2727 | 3447 | 3751 | 5728 | 4775 | 3999 | 5799 | 6214 | 6823 | 6580 | 7847 | 7766 |
| 680 | 674 | 1704 | 2156 | 2728 | 2549 | 3752 | 4866 | 4776 | 3100 | 5800 | 5424 | 6824 | 5832 | 7848 | 7417 |
| 681 | 895 | 1705 | 2574 | 2729 | 3010 | 3753 | 5320 | 4777 | 3566 | 5801 | 5856 | 6825 | 6243 | 7849 | 7615 |
| 682 | 916 | 1706 | 2610 | 2730 | 3049 | 3754 | 5359 | 4778 | 3606 | 5802 | 5890 | 6826 | 6275 | 7850 | 7631 |
| 683 | 1178 | 1707 | 3039 | 2731 | 3520 | 3755 | 5788 | 4779 | 4068 | 5803 | 6267 | 6827 | 6632 | 7851 | 7786 |
| 684 | 981 | 1708 | 2721 | 2732 | 3169 | 3756 | 5475 | 4780 | 3726 | 5804 | 5993 | 6828 | 6372 | 7852 | 7675 |
| 685 | 1222 | 1709 | 3104 | 2733 | 3593 | 3757 | 5851 | 4781 | 4145 | 5805 | 6321 | 6829 | 6682 | 7853 | 7806 |
| 686 | 1248 | 1710 | 3146 | 2734 | 3637 | 3758 | 5888 | 4782 | 4189 | 5806 | 6354 | 6830 | 6712 | 7854 | 7818 |
| 687 | 1564 | 1711 | 3629 | 2735 | 4125 | 3759 | 6304 | 4783 | 4678 | 5807 | 6707 | 6831 | 7017 | 7855 | 7938 |
| 688 | 716 | 1712 | 2240 | 2736 | 2643 | 3760 | 4960 | 4784 | 3195 | 5808 | 5516 | 6832 | 5922 | 7856 | 7460 |
| 689 | 938 | 1713 | 2648 | 2737 | 3091 | 3761 | 5401 | 4785 | 3647 | 5809 | 5926 | 6833 | 6310 | 7857 | 7647 |
| 690 | 1000 | 1714 | 2753 | 2738 | 3206 | 3762 | 5509 | 4786 | 3762 | 5810 | 6022 | 6834 | 6401 | 7858 | 7688 |
| 691 | 1239 | 1715 | 3133 | 2739 | 3620 | 3763 | 5877 | 4787 | 4173 | 5811 | 6343 | 6835 | 6701 | 7859 | 7815 |
| 692 | 1027 | 1716 | 2797 | 2740 | 3254 | 3764 | 5553 | 4788 | 3810 | 5812 | 6061 | 6836 | 6437 | 7860 | 7704 |
| 693 | 1305 | 1717 | 3233 | 2741 | 3728 | 3765 | 5966 | 4789 | 4283 | 5813 | 6422 | 6837 | 6772 | 7861 | 7843 |
| 694 | 1329 | 1718 | 3269 | 2742 | 3768 | 3766 | 5998 | 4790 | 4322 | 5814 | 6449 | 6838 | 6798 | 7862 | 7852 |
| 695 | 1638 | 1719 | 3742 | 2743 | 4226 | 3767 | 6395 | 4791 | 4781 | 5815 | 6781 | 6839 | 7077 | 7863 | 7961 |
| 696 | 1070 | 1720 | 2869 | 2744 | 3333 | 3768 | 5625 | 4792 | 3887 | 5816 | 6124 | 6840 | 6497 | 7864 | 7730 |
| 697 | 1358 | 1721 | 3314 | 2745 | 3814 | 3769 | 6037 | 4793 | 4369 | 5817 | 6483 | 6841 | 6828 | 7865 | 7864 |
| 698 | 1405 | 1722 | 3392 | 2746 | 3886 | 3770 | 6106 | 4794 | 4442 | 5818 | 6540 | 6842 | 6873 | 7866 | 7884 |
| 699 | 1729 | 1723 | 3869 | 2747 | 4345 | 3771 | 6491 | 4795 | 4905 | 5819 | 6862 | 6843 | 7147 | 7867 | 7984 |
| 700 | 1499 | 1724 | 3534 | 2748 | 4032 | 3772 | 6228 | 4796 | 4584 | 5820 | 6642 | 6844 | 6961 | 7868 | 7918 |
| 701 | 1802 | 1725 | 3974 | 2749 | 4441 | 3773 | 6569 | 4797 | 5000 | 5821 | 6926 | 6845 | 7200 | 7869 | 8001 |
| 702 | 1892 | 1726 | 4097 | 2750 | 4553 | 3774 | 6665 | 4798 | 5113 | 5822 | 7000 | 6846 | 7260 | 7870 | 8022 |
| 703 | 2278 | 1727 | 4570 | 2751 | 5001 | 3775 | 7002 | 4799 | 5557 | 5823 | 7269 | 6847 | 7479 | 7871 | 8085 |
| 704 | 391 | 1728 | 1524 | 2752 | 1877 | 3776 | 4069 | 4800 | 2354 | 5824 | 4620 | 6848 | 5095 | 7872 | 6982 |
| 705 | 626 | 1729 | 2054 | 2753 | 2440 | 3777 | 4749 | 4801 | 2989 | 5825 | 5308 | 6849 | 5724 | 7873 | 7360 |
| 706 | 657 | 1730 | 2120 | 2754 | 2514 | 3778 | 4823 | 4802 | 3061 | 5826 | 5383 | 6850 | 5797 | 7874 | 7397 |
| 707 | 900 | 1731 | 2583 | 2755 | 3018 | 3779 | 5331 | 4803 | 3575 | 5827 | 5865 | 6851 | 6250 | 7875 | 7620 |
| 708 | 695 | 1732 | 2198 | 2756 | 2597 | 3780 | 4911 | 4804 | 3147 | 5828 | 5470 | 6852 | 5878 | 7876 | 7438 |
| 709 | 928 | 1733 | 2631 | 2757 | 3071 | 3781 | 5384 | 4805 | 3627 | 5829 | 5910 | 6853 | 6294 | 7877 | 7640 |
| 710 | 982 | 1734 | 2724 | 2758 | 3173 | 3782 | 5477 | 4806 | 3729 | 5830 | 5996 | 6854 | 6375 | 7878 | 7676 |
| 711 | 1231 | 1735 | 3121 | 2759 | 3609 | 3783 | 5864 | 4807 | 4161 | 5831 | 6334 | 6855 | 6693 | 7879 | 7811 |
| 712 | 781 | 1736 | 2369 | 2760 | 2781 | 3784 | 5099 | 4808 | 3335 | 5832 | 5652 | 6856 | 6047 | 7880 | 7523 |
| 713 | 1004 | 1737 | 2757 | 2761 | 3211 | 3785 | 5512 | 4809 | 3769 | 5833 | 6025 | 6857 | 6405 | 7881 | 7689 |
| 714 | 1046 | 1738 | 2828 | 2762 | 3288 | 3786 | 5583 | 4810 | 3844 | 5834 | 6089 | 6858 | 6463 | 7882 | 7715 |
| 715 | 1316 | 1739 | 3250 | 2763 | 3746 | 3787 | 5984 | 4811 | 4301 | 5835 | 6435 | 6859 | 6783 | 7883 | 7848 |
| 716 | 1053 | 1740 | 2842 | 2764 | 3302 | 3788 | 5598 | 4812 | 3856 | 5836 | 6101 | 6860 | 6474 | 7884 | 7721 |
| 717 | 1336 | 1741 | 3281 | 2765 | 3780 | 3789 | 6012 | 4813 | 4334 | 5837 | 6458 | 6861 | 6806 | 7885 | 7856 |
| 718 | 1383 | 1742 | 3354 | 2766 | 3853 | 3790 | 6073 | 4814 | 4407 | 5838 | 6512 | 6862 | 6852 | 7886 | 7874 |
| 719 | 1689 | 1743 | 3812 | 2767 | 4294 | 3791 | 6451 | 4815 | 4851 | 5839 | 6826 | 6863 | 7117 | 7887 | 7974 |
| 720 | 799 | 1744 | 2404 | 2768 | 2819 | 3792 | 5135 | 4816 | 3372 | 5840 | 5688 | 6864 | 6081 | 7888 | 7538 |
| 721 | 1048 | 1745 | 2831 | 2769 | 3293 | 3793 | 5586 | 4817 | 3848 | 5841 | 6092 | 6865 | 6467 | 7889 | 7716 |
| 722 | 1067 | 1746 | 2863 | 2770 | 3327 | 3794 | 5616 | 4818 | 3881 | 5842 | 6119 | 6866 | 6493 | 7890 | 7727 |
| 723 | 1372 | 1747 | 3340 | 2771 | 3836 | 3795 | 6062 | 4819 | 4390 | 5843 | 6502 | 6867 | 6841 | 7891 | 7871 |
| 724 | 1138 | 1748 | 2977 | 2772 | 3452 | 3796 | 5731 | 4820 | 4003 | 5844 | 6217 | 6868 | 6584 | 7892 | 7767 |
| 725 | 1401 | 1749 | 3381 | 2773 | 3882 | 3797 | 6099 | 4821 | 4436 | 5845 | 6533 | 6869 | 6870 | 7893 | 7882 |
| 726 | 1474 | 1750 | 3498 | 2774 | 3996 | 3798 | 6197 | 4822 | 4547 | 5846 | 6616 | 6870 | 6939 | 7894 | 7909 |
| 727 | 1788 | 1751 | 3954 | 2775 | 4420 | 3799 | 6555 | 4823 | 4981 | 5847 | 6914 | 6871 | 7188 | 7895 | 7998 |
| 728 | 1203 | 1752 | 3078 | 2776 | 3562 | 3800 | 5824 | 4824 | 4112 | 5848 | 6299 | 6872 | 6661 | 7896 | 7798 |
| 729 | 1495 | 1753 | 3529 | 2777 | 4026 | 3801 | 6224 | 4825 | 4578 | 5849 | 6638 | 6873 | 6957 | 7897 | 7917 |
| 730 | 1532 | 1754 | 3580 | 2778 | 4081 | 3802 | 6264 | 4826 | 4631 | 5850 | 6673 | 6874 | 6990 | 7898 | 7927 |
| 731 | 1828 | 1755 | 4008 | 2779 | 4473 | 3803 | 6597 | 4827 | 5033 | 5851 | 6946 | 6875 | 7217 | 7899 | 8008 |
| 732 | 1595 | 1756 | 3672 | 2780 | 4166 | 3804 | 6341 | 4828 | 4721 | 5852 | 6735 | 6876 | 7042 | 7900 | 7947 |
| 733 | 1936 | 1757 | 4146 | 2781 | 4605 | 3805 | 6700 | 4829 | 5167 | 5853 | 7030 | 6877 | 7287 | 7901 | 8029 |
| 734 | 1996 | 1758 | 4228 | 2782 | 4679 | 3806 | 6762 | 4830 | 5239 | 5854 | 7079 | 6878 | 7325 | 7902 | 8042 |
| 735 | 2352 | 1759 | 4661 | 2783 | 5081 | 3807 | 7059 | 4831 | 5634 | 5855 | 7316 | 6879 | 7515 | 7903 | 8094 |
| 736 | 834 | 1760 | 2465 | 2784 | 2888 | 3808 | 5205 | 4832 | 3444 | 5856 | 5749 | 6880 | 6141 | 7904 | 7568 |
| 737 | 1156 | 1761 | 3008 | 2785 | 3482 | 3809 | 5760 | 4833 | 4033 | 5857 | 6242 | 6881 | 6605 | 7905 | 7777 |
| 738 | 1185 | 1762 | 3050 | 2786 | 3531 | 3810 | 5798 | 4834 | 4080 | 5858 | 6277 | 6882 | 6639 | 7906 | 7789 |
| 739 | 1445 | 1763 | 3448 | 2787 | 3950 | 3811 | 6155 | 4835 | 4502 | 5859 | 6581 | 6883 | 6911 | 7907 | 7898 |
| 740 | 1249 | 1764 | 3154 | 2788 | 3641 | 3812 | 5894 | 4836 | 4191 | 5860 | 6360 | 6884 | 6714 | 7908 | 7820 |
| 741 | 1507 | 1765 | 3543 | 2789 | 4044 | 3813 | 6236 | 4837 | 4595 | 5861 | 6648 | 6885 | 6968 | 7909 | 7920 |
| 742 | 1543 | 1766 | 3602 | 2790 | 4096 | 3814 | 6284 | 4838 | 4648 | 5862 | 6688 | 6886 | 6999 | 7910 | 7932 |
| 743 | 1869 | 1767 | 4065 | 2791 | 4525 | 3815 | 6636 | 4839 | 5085 | 5863 | 6980 | 6887 | 7245 | 7911 | 8016 |
| 744 | 1292 | 1768 | 3213 | 2792 | 3708 | 3816 | 5949 | 4840 | 4261 | 5864 | 6406 | 6888 | 6759 | 7912 | 7837 |
| 745 | 1586 | 1769 | 3661 | 2793 | 4156 | 3817 | 6332 | 4841 | 4709 | 5865 | 6728 | 6889 | 7036 | 7913 | 7945 |
| 746 | 1644 | 1770 | 3747 | 2794 | 4234 | 3818 | 6400 | 4842 | 4790 | 5866 | 6785 | 6890 | 7082 | 7914 | 7962 |
| 747 | 1973 | 1771 | 4198 | 2795 | 4652 | 3819 | 6736 | 4843 | 5212 | 5867 | 7061 | 6891 | 7311 | 7915 | 8037 |
| 748 | 1711 | 1772 | 3843 | 2796 | 4321 | 3820 | 6473 | 4844 | 4881 | 5868 | 6846 | 6892 | 7133 | 7916 | 7979 |
| 749 | 2038 | 1773 | 4282 | 2797 | 4729 | 3821 | 6800 | 4845 | 5289 | 5869 | 7110 | 6893 | 7350 | 7917 | 8049 |
| 750 | 2130 | 1774 | 4397 | 2798 | 4835 | 3822 | 6883 | 4846 | 5394 | 5870 | 7176 | 6894 | 7402 | 7918 | 8065 |
| 751 | 2512 | 1775 | 4852 | 2799 | 5256 | 3823 | 7182 | 4847 | 5796 | 5871 | 7410 | 6895 | 7589 | 7919 | 8113 |
| 752 | 1412 | 1776 | 3401 | 2800 | 3898 | 3824 | 6114 | 4848 | 4453 | 5872 | 6547 | 6896 | 6880 | 7920 | 7886 |
| 753 | 1653 | 1777 | 3759 | 2801 | 4246 | 3825 | 6408 | 4849 | 4803 | 5873 | 6792 | 6897 | 7089 | 7921 | 7964 |
| 754 | 1736 | 1778 | 3875 | 2802 | 4354 | 3826 | 6496 | 4850 | 4913 | 5874 | 6865 | 6898 | 7151 | 7922 | 7985 |
| 755 | 2060 | 1779 | 4306 | 2803 | 4754 | 3827 | 6816 | 4851 | 5314 | 5875 | 7124 | 6899 | 7363 | 7923 | 8052 |
| 756 | 1814 | 1780 | 3988 | 2804 | 4454 | 3828 | 6583 | 4852 | 5015 | 5876 | 6934 | 6900 | 7207 | 7924 | 8004 |
| 757 | 2160 | 1781 | 4431 | 2805 | 4871 | 3829 | 6906 | 4853 | 5428 | 5877 | 7194 | 6901 | 7419 | 7925 | 8069 |
| 758 | 2203 | 1782 | 4486 | 2806 | 4918 | 3830 | 6941 | 4854 | 5476 | 5878 | 7224 | 6902 | 7441 | 7926 | 8075 |
| 759 | 2654 | 1783 | 5006 | 2807 | 5406 | 3831 | 7272 | 4855 | 5931 | 5879 | 7482 | 6903 | 7649 | 7927 | 8125 |
| 760 | 1876 | 1784 | 4071 | 2808 | 4533 | 3832 | 6641 | 4856 | 5093 | 5880 | 6984 | 6904 | 7250 | 7928 | 8017 |
| 761 | 2243 | 1785 | 4531 | 2809 | 4962 | 3833 | 6971 | 4857 | 5519 | 5881 | 7248 | 6905 | 7462 | 7929 | 8080 |
| 762 | 2315 | 1786 | 4619 | 2810 | 5041 | 3834 | 7033 | 4858 | 5596 | 5882 | 7294 | 6906 | 7497 | 7930 | 8090 |
| 763 | 2718 | 1787 | 5091 | 2811 | 5472 | 3835 | 7320 | 4859 | 5990 | 5883 | 7519 | 6907 | 7674 | 7931 | 8131 |
| 764 | 2421 | 1788 | 4736 | 2812 | 5156 | 3836 | 7105 | 4860 | 5705 | 5884 | 7354 | 6908 | 7547 | 7932 | 8102 |
| 765 | 2834 | 1789 | 5218 | 2813 | 5589 | 3837 | 7388 | 4861 | 6094 | 5885 | 7574 | 6909 | 7717 | 7933 | 8140 |
| 766 | 2985 | 1790 | 5378 | 2814 | 5737 | 3838 | 7480 | 4862 | 6223 | 5886 | 7638 | 6910 | 7769 | 7934 | 8150 |
| 767 | 3484 | 1791 | 5901 | 2815 | 6185 | 3839 | 7719 | 4863 | 6606 | 5887 | 7822 | 6911 | 7906 | 7935 | 8171 |
| 768 | 141 | 1792 | 824 | 2816 | 1063 | 3840 | 2867 | 4864 | 1375 | 5888 | 3423 | 6912 | 3874 | 7936 | 6123 |
| 769 | 272 | 1793 | 1216 | 2817 | 1537 | 3841 | 3583 | 4865 | 1951 | 5889 | 4135 | 6913 | 4638 | 7937 | 6676 |
| 770 | 298 | 1794 | 1282 | 2818 | 1615 | 3842 | 3693 | 4866 | 2044 | 5890 | 4245 | 6914 | 4750 | 7938 | 6749 |
| 771 | 489 | 1795 | 1756 | 2819 | 2128 | 3843 | 4383 | 4867 | 2638 | 5891 | 4941 | 6915 | 5393 | 7939 | 7167 |
| 772 | 337 | 1796 | 1388 | 2820 | 1730 | 3844 | 3861 | 4868 | 2179 | 5892 | 4415 | 6916 | 4907 | 7940 | 6857 |
| 773 | 521 | 1797 | 1831 | 2821 | 2206 | 3845 | 4477 | 4869 | 2725 | 5893 | 5037 | 6917 | 5479 | 7941 | 7220 |
| 774 | 552 | 1798 | 1896 | 2822 | 2277 | 3846 | 4557 | 4870 | 2804 | 5894 | 5118 | 6918 | 5555 | 7942 | 7262 |
| 775 | 763 | 1799 | 2335 | 2823 | 2743 | 3847 | 5061 | 4871 | 3297 | 5895 | 5617 | 6919 | 6013 | 7943 | 7506 |
| 776 | 349 | 1800 | 1417 | 2824 | 1764 | 3848 | 3906 | 4872 | 2221 | 5896 | 4461 | 6920 | 4951 | 7944 | 6885 |
| 777 | 563 | 1801 | 1918 | 2825 | 2299 | 3849 | 4585 | 4873 | 2832 | 5897 | 5146 | 6921 | 5579 | 7945 | 7277 |
| 778 | 593 | 1802 | 1987 | 2826 | 2368 | 3850 | 4668 | 4874 | 2909 | 5898 | 5228 | 6922 | 5651 | 7946 | 7319 |
| 779 | 790 | 1803 | 2387 | 2827 | 2798 | 3851 | 5117 | 4875 | 3353 | 5899 | 5670 | 6923 | 6063 | 7947 | 7531 |
| 780 | 624 | 1804 | 2050 | 2828 | 2437 | 3852 | 4742 | 4876 | 2983 | 5900 | 5303 | 6924 | 5722 | 7948 | 7357 |
| 781 | 825 | 1805 | 2450 | 2829 | 2870 | 3853 | 5187 | 4877 | 3426 | 5901 | 5735 | 6925 | 6126 | 7949 | 7560 |
| 782 | 881 | 1806 | 2551 | 2830 | 2980 | 3854 | 5296 | 4878 | 3537 | 5902 | 5833 | 6926 | 6219 | 7950 | 7605 |
| 783 | 1193 | 1807 | 3062 | 2831 | 3545 | 3855 | 5811 | 4879 | 4094 | 5903 | 6286 | 6927 | 6649 | 7951 | 7794 |
| 784 | 383 | 1808 | 1505 | 2832 | 1858 | 3856 | 4040 | 4880 | 2330 | 5904 | 4593 | 6928 | 5072 | 7952 | 6966 |
| 785 | 610 | 1809 | 2020 | 2833 | 2405 | 3857 | 4708 | 4881 | 2949 | 5905 | 5268 | 6929 | 5689 | 7953 | 7340 |
| 786 | 663 | 1810 | 2133 | 2834 | 2525 | 3858 | 4838 | 4882 | 3074 | 5906 | 5397 | 6930 | 5809 | 7954 | 7403 |
| 787 | 851 | 1811 | 2497 | 2835 | 2921 | 3859 | 5240 | 4883 | 3478 | 5907 | 5781 | 6931 | 6169 | 7955 | 7582 |
| 788 | 686 | 1812 | 2180 | 2836 | 2576 | 3860 | 4892 | 4884 | 3127 | 5908 | 5450 | 6932 | 5858 | 7956 | 7429 |
| 789 | 925 | 1813 | 2625 | 2837 | 3067 | 3861 | 5376 | 4885 | 3623 | 5909 | 5905 | 6933 | 6290 | 7957 | 7637 |
| 790 | 909 | 1814 | 2598 | 2838 | 3036 | 3862 | 5348 | 4886 | 3592 | 5910 | 5879 | 6934 | 6265 | 7958 | 7626 |
| 791 | 1210 | 1815 | 3090 | 2839 | 3573 | 3863 | 5834 | 4887 | 4124 | 5911 | 6309 | 6935 | 6668 | 7959 | 7801 |
| 792 | 705 | 1816 | 2216 | 2840 | 2618 | 3864 | 4933 | 4888 | 3170 | 5912 | 5490 | 6936 | 5897 | 7960 | 7448 |
| 793 | 947 | 1817 | 2663 | 2841 | 3108 | 3865 | 5415 | 4889 | 3664 | 5913 | 5940 | 6937 | 6323 | 7961 | 7652 |
| 794 | 989 | 1818 | 2733 | 2842 | 3184 | 3866 | 5489 | 4890 | 3741 | 5914 | 6004 | 6938 | 6384 | 7962 | 7681 |
| 795 | 1281 | 1819 | 3196 | 2843 | 3691 | 3867 | 5932 | 4891 | 4243 | 5915 | 6393 | 6939 | 6748 | 7963 | 7832 |
| 796 | 1041 | 1820 | 2820 | 2844 | 3279 | 3868 | 5577 | 4892 | 3835 | 5916 | 6082 | 6940 | 6457 | 7964 | 7713 |
| 797 | 1309 | 1821 | 3238 | 2845 | 3734 | 3869 | 5973 | 4893 | 4289 | 5917 | 6426 | 6941 | 6776 | 7965 | 7845 |
| 798 | 1347 | 1822 | 3295 | 2846 | 3797 | 3870 | 6023 | 4894 | 4351 | 5918 | 6468 | 6942 | 6817 | 7966 | 7860 |
| 799 | 1671 | 1823 | 3789 | 2847 | 4270 | 3871 | 6430 | 4895 | 4827 | 5919 | 6812 | 6943 | 7103 | 7967 | 7969 |
| 800 | 460 | 1824 | 1688 | 2848 | 2056 | 3872 | 4292 | 4896 | 2556 | 5920 | 4850 | 6944 | 5310 | 7968 | 7116 |
| 801 | 676 | 1825 | 2159 | 2849 | 2555 | 3873 | 4868 | 4897 | 3105 | 5921 | 5427 | 6945 | 5838 | 7969 | 7418 |
| 802 | 707 | 1826 | 2222 | 2850 | 2624 | 3874 | 4938 | 4898 | 3175 | 5922 | 5496 | 6946 | 5903 | 7970 | 7450 |
| 803 | 924 | 1827 | 2622 | 2851 | 3063 | 3875 | 5373 | 4899 | 3621 | 5923 | 5902 | 6947 | 6287 | 7971 | 7636 |
| 804 | 780 | 1828 | 2366 | 2852 | 2778 | 3876 | 5097 | 4900 | 3332 | 5924 | 5649 | 6948 | 6045 | 7972 | 7522 |
| 805 | 975 | 1829 | 2710 | 2853 | 3159 | 3877 | 5466 | 4901 | 3716 | 5925 | 5983 | 6949 | 6364 | 7973 | 7672 |
| 806 | 1011 | 1830 | 2770 | 2854 | 3227 | 3878 | 5527 | 4902 | 3781 | 5926 | 6038 | 6950 | 6416 | 7974 | 7695 |
| 807 | 1319 | 1831 | 3255 | 2855 | 3751 | 3879 | 5987 | 4903 | 4307 | 5927 | 6439 | 6951 | 6787 | 7975 | 7849 |
| 808 | 789 | 1832 | 2384 | 2856 | 2795 | 3880 | 5114 | 4904 | 3351 | 5928 | 5667 | 6952 | 6060 | 7976 | 7529 |
| 809 | 1042 | 1833 | 2823 | 2857 | 3283 | 3881 | 5580 | 4905 | 3837 | 5929 | 6085 | 6953 | 6459 | 7977 | 7714 |
| 810 | 1060 | 1834 | 2852 | 2858 | 3312 | 3882 | 5607 | 4906 | 3868 | 5930 | 6109 | 6954 | 6481 | 7978 | 7724 |
| 811 | 1351 | 1835 | 3303 | 2859 | 3803 | 3883 | 6030 | 4907 | 4357 | 5931 | 6475 | 6955 | 6820 | 7979 | 7862 |
| 812 | 1088 | 1836 | 2894 | 2860 | 3362 | 3884 | 5650 | 4908 | 3917 | 5932 | 6146 | 6956 | 6519 | 7980 | 7739 |
| 813 | 1387 | 1837 | 3364 | 2861 | 3859 | 3885 | 6080 | 4909 | 4413 | 5933 | 6520 | 6957 | 6856 | 7981 | 7877 |
| 814 | 1424 | 1838 | 3415 | 2862 | 3916 | 3886 | 6128 | 4910 | 4470 | 5934 | 6557 | 6958 | 6891 | 7982 | 7890 |
| 815 | 1765 | 1839 | 3920 | 2863 | 4393 | 3887 | 6532 | 4911 | 4953 | 5935 | 6893 | 6959 | 7173 | 7983 | 7993 |
| 816 | 801 | 1840 | 2407 | 2864 | 2822 | 3888 | 5140 | 4912 | 3377 | 5936 | 5691 | 6960 | 6083 | 7984 | 7540 |
| 817 | 1078 | 1841 | 2880 | 2865 | 3347 | 3889 | 5635 | 4913 | 3901 | 5937 | 6134 | 6961 | 6507 | 7985 | 7734 |
| 818 | 1124 | 1842 | 2956 | 2866 | 3427 | 3890 | 5709 | 4914 | 3979 | 5938 | 6199 | 6962 | 6566 | 7986 | 7759 |
| 819 | 1420 | 1843 | 3410 | 2867 | 3910 | 3891 | 6121 | 4915 | 4464 | 5939 | 6553 | 6963 | 6887 | 7987 | 7888 |
| 820 | 1199 | 1844 | 3073 | 2868 | 3556 | 3892 | 5821 | 4916 | 4106 | 5940 | 6295 | 6964 | 6657 | 7988 | 7797 |
| 821 | 1471 | 1845 | 3493 | 2869 | 3990 | 3893 | 6193 | 4917 | 4541 | 5941 | 6613 | 6965 | 6936 | 7989 | 7908 |
| 822 | 1522 | 1846 | 3571 | 2870 | 4067 | 3894 | 6256 | 4918 | 4617 | 5942 | 6667 | 6966 | 6981 | 7990 | 7925 |
| 823 | 1835 | 1847 | 4022 | 2871 | 4482 | 3895 | 6607 | 4919 | 5042 | 5943 | 6955 | 6967 | 7222 | 7991 | 8010 |
| 824 | 1241 | 1848 | 3138 | 2872 | 3626 | 3896 | 5881 | 4920 | 4177 | 5944 | 6347 | 6968 | 6704 | 7992 | 7816 |
| 825 | 1573 | 1849 | 3644 | 2873 | 4136 | 3897 | 6316 | 4921 | 4691 | 5945 | 6717 | 6969 | 7024 | 7993 | 7941 |
| 826 | 1591 | 1850 | 3667 | 2874 | 4160 | 3898 | 6337 | 4922 | 4716 | 5946 | 6732 | 6970 | 7038 | 7994 | 7946 |
| 827 | 1940 | 1851 | 4154 | 2875 | 4612 | 3899 | 6705 | 4923 | 5172 | 5947 | 7035 | 6971 | 7291 | 7995 | 8030 |
| 828 | 1648 | 1852 | 3753 | 2876 | 4240 | 3900 | 6404 | 4924 | 4796 | 5948 | 6788 | 6972 | 7086 | 7996 | 7963 |
| 829 | 2004 | 1853 | 4236 | 2877 | 4688 | 3901 | 6768 | 4925 | 5249 | 5949 | 7083 | 6973 | 7330 | 7997 | 8043 |
| 830 | 2079 | 1854 | 4331 | 2878 | 4777 | 3902 | 6832 | 4926 | 5336 | 5950 | 7138 | 6974 | 7374 | 7998 | 8055 |
| 831 | 2459 | 1855 | 4791 | 2879 | 5197 | 3903 | 7139 | 4927 | 5743 | 5951 | 7381 | 6975 | 7565 | 7999 | 8107 |
| 832 | 471 | 1856 | 1716 | 2880 | 2086 | 3904 | 4329 | 4928 | 2590 | 5952 | 4888 | 6976 | 5344 | 8000 | 7137 |
| 833 | 778 | 1857 | 2361 | 2881 | 2772 | 3905 | 5089 | 4929 | 3328 | 5953 | 5643 | 6977 | 6039 | 8001 | 7518 |
| 834 | 784 | 1858 | 2375 | 2882 | 2786 | 3906 | 5104 | 4930 | 3342 | 5954 | 5658 | 6978 | 6052 | 8002 | 7525 |
| 835 | 1029 | 1859 | 2800 | 2883 | 3259 | 3907 | 5556 | 4931 | 3815 | 5955 | 6064 | 6979 | 6441 | 8003 | 7705 |
| 836 | 804 | 1860 | 2410 | 2884 | 2826 | 3908 | 5143 | 4932 | 3382 | 5956 | 5694 | 6980 | 6087 | 8004 | 7542 |
| 837 | 1051 | 1861 | 2837 | 2885 | 3298 | 3909 | 5592 | 4933 | 3854 | 5957 | 6097 | 6981 | 6471 | 8005 | 7718 |
| 838 | 1095 | 1862 | 2908 | 2886 | 3376 | 3910 | 5662 | 4934 | 3929 | 5958 | 6158 | 6982 | 6529 | 8006 | 7743 |
| 839 | 1398 | 1863 | 3378 | 2887 | 3877 | 3911 | 6095 | 4935 | 4430 | 5959 | 6530 | 6983 | 6867 | 8007 | 7881 |
| 840 | 837 | 1864 | 2474 | 2888 | 2896 | 3912 | 5213 | 4936 | 3451 | 5960 | 5758 | 6984 | 6148 | 8008 | 7571 |
| 841 | 1142 | 1865 | 2982 | 2889 | 3457 | 3913 | 5734 | 4937 | 4009 | 5961 | 6221 | 6985 | 6587 | 8009 | 7768 |
| 842 | 1181 | 1866 | 3042 | 2890 | 3525 | 3914 | 5792 | 4938 | 4074 | 5962 | 6270 | 6986 | 6635 | 8010 | 7787 |
| 843 | 1456 | 1867 | 3468 | 2891 | 3966 | 3915 | 6174 | 4939 | 4519 | 5963 | 6595 | 6987 | 6921 | 8011 | 7903 |
| 844 | 1224 | 1868 | 3113 | 2892 | 3598 | 3916 | 5857 | 4940 | 4149 | 5964 | 6327 | 6988 | 6686 | 8012 | 7809 |
| 845 | 1510 | 1869 | 3549 | 2893 | 4048 | 3917 | 6240 | 4941 | 4600 | 5965 | 6652 | 6989 | 6970 | 8013 | 7921 |
| 846 | 1582 | 1870 | 3655 | 2894 | 4150 | 3918 | 6328 | 4942 | 4703 | 5966 | 6724 | 6990 | 7032 | 8014 | 7944 |
| 847 | 1917 | 1871 | 4127 | 2895 | 4583 | 3919 | 6685 | 4943 | 5144 | 5967 | 7018 | 6991 | 7276 | 8015 | 8026 |
| 848 | 997 | 1872 | 2750 | 2896 | 3201 | 3920 | 5506 | 4944 | 3756 | 5968 | 6020 | 6992 | 6397 | 8016 | 7687 |
| 849 | 1197 | 1873 | 3070 | 2897 | 3551 | 3921 | 5818 | 4945 | 4102 | 5969 | 6293 | 6993 | 6653 | 8017 | 7796 |
| 850 | 1253 | 1874 | 3158 | 2898 | 3646 | 3922 | 5898 | 4946 | 4197 | 5970 | 6363 | 6994 | 6718 | 8018 | 7821 |
| 851 | 1528 | 1875 | 3574 | 2899 | 4075 | 3923 | 6260 | 4947 | 4626 | 5971 | 6669 | 6995 | 6986 | 8019 | 7926 |
| 852 | 1294 | 1876 | 3216 | 2900 | 3713 | 3924 | 5952 | 4948 | 4265 | 5972 | 6409 | 6996 | 6763 | 8020 | 7838 |
| 853 | 1616 | 1877 | 3706 | 2901 | 4196 | 3925 | 6366 | 4949 | 4751 | 5973 | 6758 | 6997 | 7060 | 8021 | 7953 |
| 854 | 1657 | 1878 | 3765 | 2902 | 4250 | 3926 | 6412 | 4950 | 4808 | 5974 | 6796 | 6998 | 7091 | 8022 | 7965 |
| 855 | 1984 | 1879 | 4214 | 2903 | 4665 | 3927 | 6747 | 4951 | 5225 | 5975 | 7070 | 6999 | 7318 | 8023 | 8039 |
| 856 | 1394 | 1880 | 3373 | 2904 | 3871 | 3928 | 6091 | 4952 | 4425 | 5976 | 6526 | 7000 | 6863 | 8024 | 7880 |
| 857 | 1663 | 1881 | 3770 | 2905 | 4260 | 3929 | 6417 | 4953 | 4817 | 5977 | 6799 | 7001 | 7097 | 8025 | 7966 |
| 858 | 1739 | 1882 | 3880 | 2906 | 4360 | 3930 | 6500 | 4954 | 4919 | 5978 | 6869 | 7002 | 7155 | 8026 | 7986 |
| 859 | 2064 | 1883 | 4315 | 2907 | 4761 | 3931 | 6821 | 4955 | 5319 | 5979 | 7129 | 7003 | 7366 | 8027 | 8053 |
| 860 | 1818 | 1884 | 3994 | 2908 | 4460 | 3932 | 6588 | 4956 | 5020 | 5980 | 6938 | 7004 | 7210 | 8028 | 8005 |
| 861 | 2153 | 1885 | 4422 | 2909 | 4861 | 3933 | 6900 | 4957 | 5421 | 5981 | 7190 | 7005 | 7415 | 8029 | 8068 |
| 862 | 2195 | 1886 | 4475 | 2910 | 4909 | 3934 | 6935 | 4958 | 5467 | 5982 | 7219 | 7006 | 7437 | 8030 | 8074 |
| 863 | 2640 | 1887 | 4992 | 2911 | 5392 | 3935 | 7264 | 4959 | 5919 | 5983 | 7475 | 7007 | 7644 | 8031 | 8124 |
| 864 | 1056 | 1888 | 2845 | 2912 | 3307 | 3936 | 5601 | 4960 | 3862 | 5984 | 6104 | 7008 | 6477 | 8032 | 7722 |
| 865 | 1301 | 1889 | 3230 | 2913 | 3723 | 3937 | 5963 | 4961 | 4277 | 5985 | 6419 | 7009 | 6769 | 8033 | 7842 |
| 866 | 1368 | 1890 | 3336 | 2914 | 3830 | 3938 | 6059 | 4962 | 4384 | 5986 | 6499 | 7010 | 6837 | 8034 | 7870 |
| 867 | 1620 | 1891 | 3711 | 2915 | 4202 | 3939 | 6370 | 4963 | 4757 | 5987 | 6761 | 7011 | 7063 | 8035 | 7954 |
| 868 | 1416 | 1892 | 3406 | 2916 | 3904 | 3940 | 6117 | 4964 | 4459 | 5988 | 6550 | 7012 | 6884 | 8036 | 7887 |
| 869 | 1719 | 1893 | 3857 | 2917 | 4333 | 3941 | 6482 | 4965 | 4891 | 5989 | 6855 | 7013 | 7140 | 8037 | 7982 |
| 870 | 1776 | 1894 | 3934 | 2918 | 4408 | 3942 | 6541 | 4966 | 4966 | 5990 | 6902 | 7014 | 7181 | 8038 | 7995 |
| 871 | 2094 | 1895 | 4356 | 2919 | 4795 | 3943 | 6849 | 4967 | 5354 | 5991 | 7152 | 7015 | 7383 | 8039 | 8058 |
| 872 | 1484 | 1896 | 3507 | 2920 | 4010 | 3944 | 6205 | 4968 | 4562 | 5992 | 6623 | 7016 | 6948 | 8040 | 7911 |
| 873 | 1795 | 1897 | 3967 | 2921 | 4433 | 3945 | 6564 | 4969 | 4991 | 5993 | 6922 | 7017 | 7195 | 8041 | 8000 |
| 874 | 1847 | 1898 | 4036 | 2922 | 4497 | 3946 | 6617 | 4970 | 5057 | 5994 | 6963 | 7018 | 7230 | 8042 | 8012 |
| 875 | 2187 | 1899 | 4467 | 2923 | 4899 | 3947 | 6929 | 4971 | 5458 | 5995 | 7214 | 7019 | 7432 | 8043 | 8073 |
| 876 | 1910 | 1900 | 4119 | 2924 | 4575 | 3948 | 6680 | 4972 | 5136 | 5996 | 7013 | 7020 | 7271 | 8044 | 8025 |
| 877 | 2251 | 1901 | 4540 | 2925 | 4972 | 3949 | 6977 | 4973 | 5528 | 5997 | 7253 | 7021 | 7466 | 8045 | 8081 |
| 878 | 2343 | 1902 | 4650 | 2926 | 5071 | 3950 | 7052 | 4974 | 5626 | 5998 | 7310 | 7022 | 7511 | 8046 | 8093 |
| 879 | 2760 | 1903 | 5137 | 2927 | 5515 | 3951 | 7345 | 4975 | 6028 | 5999 | 7539 | 7023 | 7690 | 8047 | 8134 |
| 880 | 1539 | 1904 | 3591 | 2928 | 4091 | 3952 | 6276 | 4976 | 4642 | 6000 | 6681 | 7024 | 6996 | 8048 | 7930 |
| 881 | 1880 | 1905 | 4079 | 2929 | 4538 | 3953 | 6646 | 4977 | 5098 | 6001 | 6988 | 7025 | 7252 | 8049 | 8018 |
| 882 | 1954 | 1906 | 4176 | 2930 | 4627 | 3954 | 6721 | 4978 | 5190 | 6002 | 7048 | 7026 | 7299 | 8050 | 8034 |
| 883 | 2306 | 1907 | 4610 | 2931 | 5031 | 3955 | 7027 | 4979 | 5587 | 6003 | 7290 | 7027 | 7493 | 8051 | 8089 |
| 884 | 2026 | 1908 | 4266 | 2932 | 4715 | 3956 | 6789 | 4980 | 5275 | 6004 | 7101 | 7028 | 7343 | 8052 | 8047 |
| 885 | 2372 | 1909 | 4681 | 2933 | 5102 | 3957 | 7072 | 4981 | 5655 | 6005 | 7326 | 7029 | 7524 | 8053 | 8096 |
| 886 | 2453 | 1910 | 4779 | 2934 | 5189 | 3958 | 7132 | 4982 | 5738 | 6006 | 7375 | 7030 | 7561 | 8054 | 8106 |
| 887 | 2866 | 1911 | 5253 | 2935 | 5622 | 3959 | 7405 | 4983 | 6122 | 6007 | 7588 | 7031 | 7729 | 8055 | 8142 |
| 888 | 2109 | 1912 | 4372 | 2936 | 4812 | 3960 | 6860 | 4984 | 5371 | 6008 | 7162 | 7032 | 7391 | 8056 | 8060 |
| 889 | 2491 | 1913 | 4826 | 2937 | 5232 | 3961 | 7160 | 4985 | 5775 | 6009 | 7398 | 7033 | 7579 | 8057 | 8110 |
| 890 | 2557 | 1914 | 4902 | 2938 | 5301 | 3962 | 7211 | 4986 | 5839 | 6010 | 7434 | 7034 | 7608 | 8058 | 8117 |
| 891 | 2952 | 1915 | 5342 | 2939 | 5706 | 3963 | 7461 | 4987 | 6195 | 6011 | 7624 | 7035 | 7758 | 8059 | 8148 |
| 892 | 2616 | 1916 | 4965 | 2940 | 5367 | 3964 | 7249 | 4988 | 5896 | 6012 | 7463 | 7036 | 7634 | 8060 | 8122 |
| 893 | 3109 | 1917 | 5524 | 2941 | 5854 | 3965 | 7552 | 4989 | 6325 | 6013 | 7694 | 7037 | 7807 | 8061 | 8157 |
| 894 | 3149 | 1918 | 5571 | 2942 | 5891 | 3966 | 7573 | 4990 | 6356 | 6014 | 7711 | 7038 | 7819 | 8062 | 8159 |
| 895 | 3832 | 1919 | 6216 | 2943 | 6465 | 3967 | 7841 | 4991 | 6839 | 6015 | 7914 | 7039 | 7977 | 8063 | 8179 |
| 896 | 480 | 1920 | 1738 | 2944 | 2108 | 3968 | 4358 | 4992 | 2614 | 6016 | 4917 | 7040 | 5369 | 8064 | 7154 |
| 897 | 808 | 1921 | 2418 | 2945 | 2836 | 3969 | 5150 | 4993 | 3391 | 6017 | 5702 | 7041 | 6096 | 8065 | 7545 |
| 898 | 822 | 1922 | 2448 | 2946 | 2864 | 3970 | 5182 | 4994 | 3419 | 6018 | 5732 | 7042 | 6120 | 8066 | 7558 |
| 899 | 1186 | 1923 | 3053 | 2947 | 3533 | 3971 | 5801 | 4995 | 4082 | 6019 | 6279 | 7043 | 6640 | 8067 | 7790 |
| 900 | 972 | 1924 | 2707 | 2948 | 3156 | 3972 | 5463 | 4996 | 3712 | 6020 | 5981 | 7044 | 6362 | 8068 | 7671 |
| 901 | 1215 | 1925 | 3098 | 2949 | 3582 | 3973 | 5844 | 4997 | 4132 | 6021 | 6315 | 7045 | 6674 | 8069 | 7804 |
| 902 | 1245 | 1926 | 3141 | 2950 | 3631 | 3974 | 5884 | 4998 | 4183 | 6022 | 6350 | 7046 | 6708 | 8070 | 7817 |
| 903 | 1568 | 1927 | 3635 | 2951 | 4131 | 3975 | 6308 | 4999 | 4684 | 6023 | 6710 | 7047 | 7021 | 8071 | 7939 |
| 904 | 1015 | 1928 | 2780 | 2952 | 3235 | 3976 | 5536 | 5000 | 3790 | 6024 | 6046 | 7048 | 6423 | 8072 | 7698 |
| 905 | 1277 | 1929 | 3191 | 2953 | 3685 | 3977 | 5928 | 5001 | 4237 | 6025 | 6389 | 7049 | 6744 | 8073 | 7831 |
| 906 | 1312 | 1930 | 3242 | 2954 | 3740 | 3978 | 5977 | 5002 | 4295 | 6026 | 6428 | 7050 | 6780 | 8074 | 7846 |
| 907 | 1630 | 1931 | 3725 | 2955 | 4216 | 3979 | 6383 | 5003 | 4771 | 6027 | 6770 | 7051 | 7071 | 8075 | 7958 |
| 908 | 1379 | 1932 | 3350 | 2956 | 3847 | 3980 | 6069 | 5004 | 4402 | 6028 | 6510 | 7052 | 6848 | 8076 | 7873 |
| 909 | 1685 | 1933 | 3807 | 2957 | 4288 | 3981 | 6447 | 5005 | 4846 | 6029 | 6823 | 7053 | 7114 | 8077 | 7973 |
| 910 | 1759 | 1934 | 3914 | 2958 | 4385 | 3982 | 6528 | 5006 | 4944 | 6030 | 6890 | 7054 | 7169 | 8078 | 7992 |
| 911 | 2087 | 1935 | 4339 | 2959 | 4786 | 3983 | 6838 | 5007 | 5346 | 6031 | 7143 | 7055 | 7378 | 8079 | 8056 |
| 912 | 1064 | 1936 | 2859 | 2960 | 3321 | 3984 | 5613 | 5008 | 3876 | 6032 | 6116 | 7056 | 6488 | 8080 | 7726 |
| 913 | 1344 | 1937 | 3291 | 2961 | 3791 | 3985 | 6019 | 5009 | 4346 | 6033 | 6466 | 7057 | 6813 | 8081 | 7859 |
| 914 | 1409 | 1938 | 3395 | 2962 | 3892 | 3986 | 6110 | 5010 | 4447 | 6034 | 6543 | 7058 | 6876 | 8082 | 7885 |
| 915 | 1699 | 1939 | 3826 | 2963 | 4308 | 3987 | 6460 | 5011 | 4865 | 6035 | 6835 | 7059 | 7125 | 8083 | 7976 |
| 916 | 1448 | 1940 | 3459 | 2964 | 3956 | 3988 | 6162 | 5012 | 4508 | 6036 | 6589 | 7060 | 6915 | 8084 | 7900 |
| 917 | 1781 | 1941 | 3940 | 2965 | 4412 | 3989 | 6546 | 5013 | 4973 | 6037 | 6905 | 7061 | 7184 | 8085 | 7996 |
| 918 | 1851 | 1942 | 4042 | 2966 | 4501 | 3990 | 6621 | 5014 | 5062 | 6038 | 6967 | 7062 | 7232 | 8086 | 8013 |
| 919 | 2177 | 1943 | 4450 | 2967 | 4890 | 3991 | 6917 | 5015 | 5447 | 6039 | 7205 | 7063 | 7428 | 8087 | 8071 |
| 920 | 1514 | 1944 | 3554 | 2968 | 4054 | 3992 | 6244 | 5016 | 4606 | 6040 | 6655 | 7064 | 6974 | 8088 | 7922 |
| 921 | 1898 | 1945 | 4105 | 2969 | 4561 | 3993 | 6670 | 5017 | 5121 | 6041 | 7005 | 7065 | 7265 | 8089 | 8023 |
| 922 | 1840 | 1946 | 4028 | 2970 | 4488 | 3994 | 6612 | 5018 | 5048 | 6042 | 6958 | 7066 | 7225 | 8090 | 8011 |
| 923 | 2227 | 1947 | 4512 | 2971 | 4945 | 3995 | 6959 | 5019 | 5502 | 6043 | 7238 | 7067 | 7454 | 8091 | 8078 |
| 924 | 1992 | 1948 | 4222 | 2972 | 4674 | 3996 | 6757 | 5020 | 5235 | 6044 | 7075 | 7068 | 7323 | 8092 | 8041 |
| 925 | 2332 | 1949 | 4639 | 2973 | 5059 | 3997 | 7046 | 5021 | 5614 | 6045 | 7305 | 7069 | 7505 | 8093 | 8092 |
| 926 | 2413 | 1950 | 4724 | 2974 | 5145 | 3998 | 7098 | 5022 | 5697 | 6046 | 7348 | 7070 | 7543 | 8094 | 8101 |
| 927 | 2803 | 1951 | 5184 | 2975 | 5559 | 3999 | 7370 | 5023 | 6067 | 6047 | 7559 | 7071 | 7707 | 8095 | 8137 |
| 928 | 1206 | 1952 | 3081 | 2976 | 3567 | 4000 | 5828 | 5024 | 4118 | 6048 | 6302 | 7072 | 6664 | 8096 | 7799 |
| 929 | 1430 | 1953 | 3429 | 2977 | 3928 | 4001 | 6140 | 5025 | 4479 | 6049 | 6567 | 7073 | 6898 | 8097 | 7893 |
| 930 | 1467 | 1954 | 3488 | 2978 | 3984 | 4002 | 6189 | 5026 | 4536 | 6050 | 6609 | 7074 | 6932 | 8098 | 7907 |
| 931 | 1807 | 1955 | 3980 | 2979 | 4446 | 4003 | 6574 | 5027 | 5007 | 6051 | 6930 | 7075 | 7202 | 8099 | 8002 |
| 932 | 1561 | 1956 | 3624 | 2980 | 4121 | 4004 | 6300 | 5028 | 4673 | 6052 | 6703 | 7076 | 7015 | 8100 | 7937 |
| 933 | 1862 | 1957 | 4056 | 2981 | 4516 | 4005 | 6631 | 5029 | 5077 | 6053 | 6975 | 7077 | 7240 | 8101 | 8015 |
| 934 | 1946 | 1958 | 4168 | 2982 | 4621 | 4006 | 6716 | 5030 | 5180 | 6054 | 7043 | 7078 | 7295 | 8102 | 8032 |
| 935 | 2286 | 1959 | 4579 | 2983 | 5011 | 4007 | 7008 | 5031 | 5566 | 6055 | 7274 | 7079 | 7484 | 8103 | 8086 |
| 936 | 1609 | 1960 | 3695 | 2984 | 4186 | 4008 | 6357 | 5032 | 4741 | 6056 | 6750 | 7080 | 7054 | 8104 | 7951 |
| 937 | 1958 | 1961 | 4184 | 2985 | 4634 | 4009 | 6726 | 5033 | 5194 | 6057 | 7053 | 7081 | 7302 | 8105 | 8035 |
| 938 | 2018 | 1962 | 4258 | 2986 | 4706 | 4010 | 6784 | 5034 | 5265 | 6058 | 7096 | 7082 | 7339 | 8106 | 8046 |
| 939 | 2381 | 1963 | 4692 | 2987 | 5112 | 4011 | 7078 | 5035 | 5664 | 6059 | 7332 | 7083 | 7528 | 8107 | 8097 |
| 940 | 2072 | 1964 | 4323 | 2988 | 4768 | 4012 | 6827 | 5036 | 5328 | 6060 | 7134 | 7084 | 7369 | 8108 | 8054 |
| 941 | 2433 | 1965 | 4747 | 2989 | 5166 | 4013 | 7112 | 5037 | 5717 | 6061 | 7359 | 7085 | 7551 | 8109 | 8103 |
| 942 | 2524 | 1966 | 4864 | 2990 | 5266 | 4014 | 7189 | 5038 | 5807 | 6062 | 7416 | 7086 | 7593 | 8110 | 8114 |
| 943 | 2934 | 1967 | 5323 | 2991 | 5687 | 4015 | 7451 | 5039 | 6180 | 6063 | 7616 | 7087 | 7752 | 8111 | 8147 |
| 944 | 1715 | 1968 | 3849 | 2992 | 4327 | 4016 | 6478 | 5040 | 4886 | 6064 | 6850 | 7088 | 7136 | 8112 | 7980 |
| 945 | 2045 | 1969 | 4290 | 2993 | 4738 | 4017 | 6805 | 5041 | 5297 | 6065 | 7115 | 7089 | 7355 | 8113 | 8050 |
| 946 | 2124 | 1970 | 4389 | 2994 | 4830 | 4018 | 6877 | 5042 | 5388 | 6066 | 7171 | 7090 | 7400 | 8114 | 8063 |
| 947 | 2471 | 1971 | 4802 | 2995 | 5210 | 4019 | 7146 | 5043 | 5755 | 6067 | 7386 | 7091 | 7570 | 8115 | 8108 |
| 948 | 2210 | 1972 | 4494 | 2996 | 4928 | 4020 | 6947 | 5044 | 5484 | 6068 | 7229 | 7092 | 7446 | 8116 | 8076 |
| 949 | 2580 | 1973 | 4926 | 2997 | 5329 | 4021 | 7226 | 5045 | 5862 | 6069 | 7445 | 7093 | 7619 | 8117 | 8119 |
| 950 | 2628 | 1974 | 4979 | 2998 | 5381 | 4022 | 7256 | 5046 | 5907 | 6070 | 7469 | 7094 | 7639 | 8118 | 8123 |
| 951 | 3065 | 1975 | 5480 | 2999 | 5814 | 4023 | 7530 | 5047 | 6289 | 6071 | 7677 | 7095 | 7795 | 8119 | 8155 |
| 952 | 2262 | 1976 | 4551 | 3000 | 4984 | 4024 | 6983 | 5048 | 5540 | 6072 | 7259 | 7096 | 7472 | 8120 | 8082 |
| 953 | 2704 | 1977 | 5079 | 3001 | 5457 | 4025 | 7312 | 5049 | 5978 | 6073 | 7514 | 7097 | 7669 | 8121 | 8130 |
| 954 | 2747 | 1978 | 5122 | 3002 | 5501 | 4026 | 7336 | 5050 | 6017 | 6074 | 7533 | 7098 | 7685 | 8122 | 8133 |
| 955 | 3199 | 1979 | 5619 | 3003 | 5939 | 4027 | 7595 | 5051 | 6396 | 6075 | 7728 | 7099 | 7834 | 8123 | 8161 |
| 956 | 2848 | 1980 | 5234 | 3004 | 5604 | 4028 | 7396 | 5052 | 6107 | 6076 | 7580 | 7100 | 7723 | 8124 | 8141 |
| 957 | 3272 | 1981 | 5693 | 3005 | 6001 | 4029 | 7630 | 5053 | 6452 | 6077 | 7754 | 7101 | 7853 | 8125 | 8164 |
| 958 | 3331 | 1982 | 5750 | 3006 | 6055 | 4030 | 7654 | 5054 | 6495 | 6078 | 7773 | 7102 | 7869 | 8126 | 8166 |
| 959 | 3683 | 1983 | 6084 | 3007 | 6349 | 4031 | 7792 | 5055 | 6743 | 6079 | 7878 | 7103 | 7949 | 8127 | 8176 |
| 960 | 1298 | 1984 | 3221 | 3008 | 3717 | 4032 | 5956 | 5056 | 4271 | 6080 | 6413 | 7104 | 6765 | 8128 | 7839 |
| 961 | 1481 | 1985 | 3504 | 3009 | 4004 | 4033 | 6201 | 5057 | 4556 | 6081 | 6620 | 7105 | 6944 | 8129 | 7910 |
| 962 | 1605 | 1986 | 3689 | 3010 | 4180 | 4034 | 6353 | 5058 | 4735 | 6082 | 6746 | 7106 | 7050 | 8130 | 7950 |
| 963 | 1965 | 1987 | 4192 | 3011 | 4643 | 4035 | 6731 | 5059 | 5203 | 6083 | 7057 | 7107 | 7307 | 8131 | 8036 |
| 964 | 1681 | 1988 | 3801 | 3012 | 4284 | 4036 | 6443 | 5060 | 4841 | 6084 | 6819 | 7108 | 7111 | 8132 | 7972 |
| 965 | 2011 | 1989 | 4252 | 3013 | 4697 | 4037 | 6778 | 5061 | 5257 | 6085 | 7093 | 7109 | 7334 | 8133 | 8045 |
| 966 | 2052 | 1990 | 4298 | 3014 | 4745 | 4038 | 6810 | 5062 | 5305 | 6086 | 7120 | 7110 | 7358 | 8134 | 8051 |
| 967 | 2442 | 1991 | 4758 | 3015 | 5176 | 4039 | 7119 | 5063 | 5726 | 6087 | 7365 | 7111 | 7556 | 8135 | 8104 |
| 968 | 1750 | 1992 | 3900 | 3016 | 4374 | 4040 | 6518 | 5064 | 4932 | 6088 | 6881 | 7112 | 7163 | 8136 | 7990 |
| 969 | 2138 | 1993 | 4406 | 3017 | 4845 | 4041 | 6888 | 5065 | 5404 | 6089 | 7180 | 7113 | 7407 | 8137 | 8066 |
| 970 | 2169 | 1994 | 4439 | 3018 | 4880 | 4042 | 6912 | 5066 | 5438 | 6090 | 7199 | 7114 | 7423 | 8138 | 8070 |
| 971 | 2548 | 1995 | 4887 | 3019 | 5293 | 4043 | 7204 | 5067 | 5830 | 6091 | 7427 | 7115 | 7604 | 8139 | 8116 |
| 972 | 2234 | 1996 | 4522 | 3020 | 4955 | 4044 | 6965 | 5068 | 5510 | 6092 | 7244 | 7116 | 7458 | 8140 | 8079 |
| 973 | 2592 | 1997 | 4940 | 3021 | 5340 | 4045 | 7233 | 5069 | 5873 | 6093 | 7452 | 7117 | 7623 | 8141 | 8120 |
| 974 | 2730 | 1998 | 5107 | 3022 | 5486 | 4046 | 7328 | 5070 | 6002 | 6094 | 7526 | 7118 | 7679 | 8142 | 8132 |
| 975 | 3129 | 1999 | 5547 | 3023 | 5874 | 4047 | 7562 | 5071 | 6340 | 6095 | 7702 | 7119 | 7814 | 8143 | 8158 |
| 976 | 1769 | 2000 | 3926 | 3024 | 4399 | 4048 | 6537 | 5072 | 4958 | 6096 | 6897 | 7120 | 7177 | 8144 | 7994 |
| 977 | 2219 | 2001 | 4503 | 3025 | 4935 | 4049 | 6953 | 5073 | 5493 | 6097 | 7234 | 7121 | 7449 | 8145 | 8077 |
| 978 | 2295 | 2002 | 4590 | 3026 | 5019 | 4050 | 7014 | 5074 | 5575 | 6098 | 7279 | 7122 | 7487 | 8146 | 8087 |
| 979 | 2692 | 2003 | 5064 | 3027 | 5446 | 4051 | 7304 | 5075 | 5967 | 6099 | 7507 | 7123 | 7664 | 8147 | 8129 |
| 980 | 2401 | 2004 | 4713 | 3028 | 5132 | 4052 | 7092 | 5076 | 5685 | 6100 | 7342 | 7124 | 7537 | 8148 | 8100 |
| 981 | 2774 | 2005 | 5153 | 3029 | 5530 | 4053 | 7353 | 5077 | 6040 | 6101 | 7546 | 7125 | 7696 | 8149 | 8135 |
| 982 | 2787 | 2006 | 5169 | 3030 | 5542 | 4054 | 7362 | 5078 | 6053 | 6102 | 7553 | 7126 | 7700 | 8150 | 8136 |
| 983 | 3300 | 2007 | 5721 | 3031 | 6026 | 4055 | 7642 | 5079 | 6472 | 6103 | 7764 | 7127 | 7861 | 8151 | 8165 |
| 984 | 2503 | 2008 | 4840 | 3032 | 5245 | 4056 | 7175 | 5080 | 5787 | 6104 | 7404 | 7128 | 7585 | 8152 | 8112 |
| 985 | 2883 | 2009 | 5269 | 3033 | 5638 | 4057 | 7414 | 5081 | 6137 | 6105 | 7594 | 7129 | 7735 | 8153 | 8143 |
| 986 | 2915 | 2010 | 5304 | 3034 | 5671 | 4058 | 7442 | 5082 | 6164 | 6106 | 7609 | 7130 | 7746 | 8154 | 8146 |
| 987 | 3359 | 2011 | 5776 | 3035 | 6077 | 4059 | 7667 | 5083 | 6516 | 6107 | 7782 | 7131 | 7875 | 8155 | 8167 |
| 988 | 3027 | 2012 | 5440 | 3036 | 5779 | 4060 | 7510 | 5084 | 6258 | 6108 | 7662 | 7132 | 7783 | 8156 | 8153 |
| 989 | 3524 | 2013 | 5935 | 3037 | 6220 | 4061 | 7733 | 5085 | 6634 | 6109 | 7833 | 7133 | 7916 | 8157 | 8172 |
| 990 | 3596 | 2014 | 6005 | 3038 | 6280 | 4062 | 7762 | 5086 | 6684 | 6110 | 7854 | 7134 | 7931 | 8158 | 8174 |
| 991 | 4162 | 2015 | 6505 | 3039 | 6711 | 4063 | 7936 | 5087 | 7039 | 6111 | 7987 | 7135 | 8031 | 8159 | 8184 |
| 992 | 1921 | 2016 | 4133 | 3040 | 4588 | 4064 | 6690 | 5088 | 5149 | 6112 | 7022 | 7136 | 7278 | 8160 | 8027 |
| 993 | 2364 | 2017 | 4670 | 3041 | 5094 | 4065 | 7065 | 5089 | 5646 | 6113 | 7321 | 7137 | 7521 | 8161 | 8095 |
| 994 | 2392 | 2018 | 4701 | 3042 | 5125 | 4066 | 7085 | 5090 | 5676 | 6114 | 7337 | 7138 | 7534 | 8162 | 8099 |
| 995 | 2817 | 2019 | 5202 | 3043 | 5574 | 4067 | 7379 | 5091 | 6079 | 6115 | 7567 | 7139 | 7712 | 8163 | 8139 |
| 996 | 2536 | 2020 | 4875 | 3044 | 5280 | 4068 | 7196 | 5092 | 5819 | 6116 | 7421 | 7140 | 7599 | 8164 | 8115 |
| 997 | 2897 | 2021 | 5288 | 3045 | 5653 | 4069 | 7424 | 5093 | 6149 | 6117 | 7602 | 7141 | 7740 | 8165 | 8144 |
| 998 | 2971 | 2022 | 5362 | 3046 | 5725 | 4070 | 7470 | 5094 | 6211 | 6118 | 7632 | 7142 | 7765 | 8166 | 8149 |
| 999 | 3420 | 2023 | 5837 | 3047 | 6132 | 4071 | 7692 | 5095 | 6561 | 6119 | 7802 | 7143 | 7891 | 8167 | 8169 |
| 1000 | 2604 | 2024 | 4952 | 3048 | 5353 | 4072 | 7241 | 5096 | 5885 | 6120 | 7457 | 7144 | 7628 | 8168 | 8121 |
| 1001 | 3047 | 2025 | 5460 | 3049 | 5795 | 4073 | 7520 | 5097 | 6274 | 6121 | 7670 | 7145 | 7788 | 8169 | 8154 |
| 1002 | 3085 | 2026 | 5504 | 3050 | 5831 | 4074 | 7541 | 5098 | 6305 | 6122 | 7686 | 7146 | 7800 | 8170 | 8156 |
| 1003 | 3560 | 2027 | 5970 | 3051 | 6248 | 4075 | 7747 | 5099 | 6659 | 6123 | 7844 | 7147 | 7923 | 8171 | 8173 |
| 1004 | 3225 | 2028 | 5644 | 3052 | 5959 | 4076 | 7607 | 5100 | 6415 | 6124 | 7737 | 7148 | 7840 | 8172 | 8162 |
| 1005 | 3639 | 2029 | 6044 | 3053 | 6312 | 4077 | 7776 | 5101 | 6713 | 6125 | 7866 | 7149 | 7940 | 8173 | 8175 |
| 1006 | 3888 | 2030 | 6268 | 3054 | 6509 | 4078 | 7858 | 5102 | 6874 | 6126 | 7928 | 7150 | 7988 | 8174 | 8180 |
| 1007 | 4347 | 2031 | 6660 | 3055 | 6843 | 4079 | 7981 | 5103 | 7148 | 6127 | 8021 | 7151 | 8057 | 8175 | 8186 |
| 1008 | 2666 | 2032 | 5034 | 3056 | 5418 | 4080 | 7288 | 5104 | 5943 | 6128 | 7494 | 7152 | 7653 | 8176 | 8127 |
| 1009 | 3174 | 2033 | 5595 | 3057 | 5915 | 4081 | 7584 | 5105 | 6376 | 6129 | 7720 | 7153 | 7827 | 8177 | 8160 |
| 1010 | 3247 | 2034 | 5668 | 3058 | 5980 | 4082 | 7618 | 5106 | 6432 | 6130 | 7745 | 7154 | 7847 | 8178 | 8163 |
| 1011 | 3730 | 2035 | 6125 | 3059 | 6387 | 4083 | 7808 | 5107 | 6774 | 6131 | 7889 | 7155 | 7959 | 8179 | 8177 |
| 1012 | 3387 | 2036 | 5808 | 3060 | 6102 | 4084 | 7680 | 5108 | 6536 | 6132 | 7793 | 7156 | 7883 | 8180 | 8168 |
| 1013 | 3776 | 2037 | 6170 | 3061 | 6421 | 4085 | 7824 | 5109 | 6803 | 6133 | 7902 | 7157 | 7967 | 8181 | 8178 |
| 1014 | 3946 | 2038 | 6320 | 3062 | 6551 | 4086 | 7876 | 5110 | 6909 | 6134 | 7942 | 7158 | 7997 | 8182 | 8181 |
| 1015 | 4458 | 2039 | 6752 | 3063 | 6923 | 4087 | 8006 | 5111 | 7209 | 6135 | 8040 | 7159 | 8072 | 8183 | 8187 |
| 1016 | 3454 | 2040 | 5867 | 3064 | 6159 | 4088 | 7706 | 5112 | 6585 | 6136 | 7812 | 7160 | 7899 | 8184 | 8170 |
| 1017 | 4014 | 2041 | 6374 | 3065 | 6602 | 4089 | 7895 | 5113 | 6950 | 6137 | 7955 | 7161 | 8009 | 8185 | 8182 |
| 1018 | 4085 | 2042 | 6438 | 3066 | 6651 | 4090 | 7915 | 5114 | 6992 | 6138 | 7971 | 7162 | 8019 | 8186 | 8183 |
| 1019 | 4599 | 2043 | 6866 | 3067 | 7020 | 4091 | 8033 | 5115 | 7284 | 6139 | 8061 | 7163 | 8088 | 8187 | 8188 |
| 1020 | 4244 | 2044 | 6579 | 3068 | 6773 | 4092 | 7957 | 5116 | 7088 | 6140 | 8003 | 7164 | 8044 | 8188 | 8185 |
| 1021 | 4770 | 2045 | 6995 | 3069 | 7126 | 4093 | 8064 | 5117 | 7371 | 6141 | 8084 | 7165 | 8105 | 8189 | 8189 |
| 1022 | 5021 | 2046 | 7168 | 3070 | 7280 | 4094 | 8098 | 5118 | 7488 | 6142 | 8111 | 7166 | 8126 | 8190 | 8190 |
| 1023 | 5420 | 2047 | 7433 | 3071 | 7500 | 4095 | 8138 | 5119 | 7655 | 6143 | 8145 | 7167 | 8152 | 8191 | 8191 |

Sequence Z2, with a sequence length of 4096:
[0,1,2,7,3,8,13,26,4,12,15,30,18,35,37,82,5,14,16,34,21,41,51,87,24,50,45, 94,61,103,110,177,6,19,23,43,25,49,55,96,31,59,63,104,76,117,123,195,36,65,80,121 ,85,131,141,208,93,143,155,235, 161,248,271,391 ,9,20,28,58,32,62,75,112,38,81,67,1 24,90,135,149,217,48,78,92,142,98,152,160,243,108,163,180,260,194,278,296,434,5 7,95,106,159,119,171,188,274,129,189,207,288,220,313,330,471,146,215,239,318,24 6,331,356,502,266,363,385,528,405,551,593,816, 17,27,33,77,42,84,88,147,52,91,99, 158,109,170,174,273,60,100,111,172,122,187,204,290,134,205,216,307,241,326,350, 491,69,115,130,193,136,206,223,319,156,237,247,334,265,362,378,525,173,257,275, 369,289,399,408,548,315,421,453,582,477,613,681,817,73,132,151,226,168,244,264, 367,178,267,281,390,297,407,432,571,202,293,308,418,332,447,473,624,344,480,50 7,650,535,693,719,942,222,321,338,457,371,488,511,672,404,521,549,708,583,724,7 85,1011,431,561,595,756,609,805,833,1072,677,848,880,1059,914,1122,1203,1479,2 2,39,44,97,53,101,113,186,54,114,125,196,138,218,228,348,68,126,139,232,153,240, 254,349,162,252,272,383,294,403,413,547,71,150,164,234,182,258,276,402,192,286, 298,415,311,445,463,607, 191,309,323,442,343,476,493,653,373,515,537,692,558,71 6,762,992,83,176,184,283,200,304,322,436,210,329,337,472,357,501,520,688,269,35 1,372,506,392,533,557,712,424,565,600,752,629,803,837,1048,302,387,417,544,441, 580,603,788,468,618,638,813,682,863,893,1102,509,680,696,881,713,916,871,1140, 771,986,1014,1221,1026,1306,1353,1539,89,197,203,342,259,361,376,514,285,381,3 95,540,423,569,599,791,300,420,440,570,456,605,632,822,481,642,670,854,710,888, 939,1151,347,446,462,630,492,661,699,873,538,700,720,935,774,910,1002,1226,578 ,745,799,987,823,1023,1054,1279,864,1066,1063,1341,1143,1376,1417,1670,386,47 8,516,703,567,723,760,955,601,789,807,1017,846,1032,1062,1300,633,830,875,1051 ,894,1069,1146,1380,952,1163,1194,1428,1250,1493,1531,1810,689,884,930,1149,99 9,1154,1238,1445,1009,1229,1285,1516,1329,1567,1639,1919,1033,1309,1367,1592, 1400,1651,1617,1957,1471,1707,1746,2065,1830,2125,2198,2406,29,47,56,107,64,1 27,140,224,70,144,154,231,167,250,255,396,72,165,175,249,185,305,316,430,211,31 7,341,469,360,495,518,707,74,181,198,310,213,339,353,486,225,366,379,523,398,55 2,575,726,238,389,411,564,437,596,615,780,448,608,644,827,649,853,886,1209,116, 212,221,358,233,380,397,543,262,414,425,588,452,621,641,795,282,429,461,612,48 4,647,656,840,505,658,669,890,744,919,976,1228,301,483,498,666,530,697,704,903, 556,741,766,951,812,995,1019,1288,587,784,826,1021,867,1045,1108,1332,928,111 6,1166,1384,1197,1439,1500,1799,120,230,251,409,279,426,455,626,295,465,487,66 0,510,676,684,897,328,500,529,686,554,735,759,943,584,776,809,1007,842,1036,10 84,1291,354,542,574,764,617,802,798,1039,635,832,850,1074,906,1111,1133,1390,6 73,869,923,1125,946,1180,1200,1448,983,1224,1262,1519,1338,1575,1643,1925,375 ,592,620,836,654,860,907,1119,731,926,962,1189,968,1206,1244,1488,747,964,980, 1235,1041,1259,1318,1564,1095,1335,1364,1595,1414, 1676, 1721, 1977,778,1056,10 80,1294,1134,1344,1373,1626,1169,1407,1453,1704,1505,1752,1819,2087,1268,146 0,1524,1768,1584,1841,1872,2182,1631,1900,1951,2224,2025,2299,2394,2688,137,2 63,287,466,324,496,524,715,336,534,562,739,590,770,819,1087,368,577,625,793,64 6,858,844,1101,663,877,913,1160,958,1183,1215,1474,439,637,665,857,730,901,932 ,1192,738,959,974,1218,998,1247,1277,1547,749,990,1029,1274,1092,1315,1356,16 00,1127,1397,1411,1679,1456,1727,1782,2051,450,728,734,948,751,967,1004,1256, 781,1044,1077,1303,1113,1347,1404,1662,920,1090,1137,1361,1171,1431,1463,1712 ,1253,1468,1527,1771,1587,1836,1866,2173,971,1177,1232,1434,1271,1511,1555,17 93,1326,1570,1609,1860,1657,1906,1971,2251,1370,1634,1690,1945,1743,1991,204 7,2319,1804,2073,2117,2373,2157,2470,2494,2875,458,755,767,1081,899,1105,1130 ,1393,936,1157,1186,1442,1241,1485,1542,1788,978,1212,1265,1496,1297,1559,161 2,1853,1350,1648,1604,1889,1718,1963,2019,2279,1098,1282,1312,1579,1387,1621, 1684,1931,1425,1693,1737,1997,1777,2033,2095,2362,1508,1757,1815,2059,1877,2 133,2165,2443,1914,2215,2243,2524,2308,2567,2601,2797,1174,1323,1422,1698,14 82,1732,1762,2039,1535,1825,1847,2111,1894,2141,2232,2482,1550,1883,1937,220 7,2011,2260,2269,2583,2081,2330,2350,2617,2420,2710,2750,3042,1665,1985,2005, 2288,2103,2339,2385,2652,2149,2432,2455,2730,2539,2773,2904,3134,2190,2509,2 552,2822,2633,2846,2933,3187,2671,2967,3002,3252,3083,3328,3433,3584,10,40,66 ,145,86,157,190,299,102,179,209,327,236,359,370,576,118,201,219,352,261,388,438 ,594,284,433,412,623,489,655,678,889,133,245,277,400,291,428,460,631,333,479,49 9,659,555,705,725,938,364,508,568,718,589,750,783,972,619,790,824,1040,841,107 0,1123,1392,169,253,312,474,340,494,550,687,377,573,513,729,606,761,804,994,42 2,563,614,786,639,814,839,1058,671,849,895,1099,934,1142,1182,1477,470,627,664 ,835,709,868,918,1132,742,922,970,1164,1000,1219,1260,1549,796,988,1049,1234,1 065,1263,1317,1607,1115,1334,1378,1653,1420,1695,1766,2107,227,306,346,560,39 4,586,597,800,444,611,643,831,675,866,879,1129,485,648,683,872,721,915,960,117 0,757,963,991,1205,1055,1251,1305,1585,522,698,746,931,765,966,1010,1237,828,1 043,1067,1269,1112,1331,1363,1650,876,1091,1136,1346,1167,1409,1426,1688,1222 ,1452,1514,1748,1560,1801,1910,2109,541,754,810,1018,862,1060,1109,1340,892,1 118,1147,1389,1184,1423,1476,1730,954,1173,1208,1447,1266,1503,1554,1817,1293 ,1565,1616,1862,1667,1929,1969,2271,1006,1240,1278,1522,1349,1582,1624,1896,1 418,1641,1691,1953,1750,1979,2067,2355,1472,1711,1770,2027,1795,2093,2131,24 24,1904,2151,2192,2410,2236,2480,2570,2856,270,382,406,636,449,652,691,911,45 4,694,733,940,773,996,1022,1299,517,736,775,1030,818,1052,1085,1302,845,1083,1 126,1375,1176,1415,1436,1686,531,808,851,1037,902,1094,1139,1412,927,1159,118 7,1440,1216,1498,1534,1790,924,1210,1245,1495,1290,1557,1590,1864,1355,1629,1 669,1927,1709,1967,2035,2332,581,885,905,1153,950,1199,1243,1480,975,1257,127 5,1552,1320,1605,1638,1921,1120,1308,1352,1614,1395,1660,1705,1959,1458,1720, 1779,2021,1827,2091,2137,2399,1196,1383,1444,1683,1492,1744,1784,2069,1544,1 808,1843,2105,1912,2169,2209,2460,1619,1908,1933,2194,1961,2238,2180,2502,20 48,2323,2357,2588,2371,2682,2733,2914,602,944,956,1287,1097,1328,1360,1627,11 56,1372,1398,1674,1455,1725,1775,2075,1190,1450,1490,1728,1521,1786,1832,211 5,1569,1849,1893,2159,1955,2203,2266,2514,1296,1501,1532,1828,1589,1879,1939, 2184,1672,1941,1973,2262,2049,2230,2344,2593,1741,2009,2085,2326,2119,2369,2 403,2654,2171,2417,2415,2718,2504,2756,2794,3031,1381,1562,1633,1943,1723,19 75,2031,2286,1781,2071,2097,2360,2147,2378,2413,2676,1834,2127,2186,2401,221 1,2422,2507,2759,2284,2527,2560,2806,2622,2868,2907,3150,1923,2196,2256,2512, 2341,2517,2609,2825,2353,2598,2660,2891,2704,2940,3006,3234,2380,2685,2744,2 960,2779,3016,2985,3266,2849,3064,3098,3347,3166,3389,3444,3576,320,416,464,6 67,503,740,779,1013,527,794,821,1028,859,1076,1088,1401,536,855,882,1073,909,1 202,1225,1469,979,1231,1284,1545,1325,1594,1636,1949,545,898,947,1213,984,128 1,1311,1577,1015,1337,1366,1645,1406,1697,1736,1981,1047,1386,1433,1716,1484, 1773,1802,2057,1506,1791,1851,2123,1858,2155,2200,2575,702,982,1003,1321,103 4,1369,1403,1681,1104,1437,1461,1759,1513,1814,1845,2079,1150,1466,1529,1797, 1574,1856,1870,2139,1610,1873,1891,2205,2007,2241,2312,2596,1193,1572,1599,1 887,1658,1935,1947,2221,1702,2003,2041,2282,2101,2335,2364,2663,1755,2063,21 21,2366,2176,2396,2465,2707,2253,2475,2529,2762,2562,2816,2878,3142,714,1025, 1078,1429,1144,1464,1518,1823,1179,1537,1580,1875,1622,1902,1916,2213,1254,1 602,1655,1918,1700,1995,2029,2273,1753,2053,2099,2348,2143,2382,2439,2665,13 14,1677,1734,2037,1806,2089,2083,2387,1838,2129,2153,2427,2226,2467,2492,276 8,1898,2178,2247,2484,2275,2544,2565,2828,2321,2591,2636,2894,2716,2947,3009, 3239,1358,1764,1812,2135,1868,2167,2228,2477,1989,2249,2295,2554,2304,2572,2 614,2865,2013,2297,2317,2606,2389,2630,2696,2937,2451,2713,2741,2964,2791,30 34,3075,3280,2055,2408,2434,2668,2497,2721,2753,2992,2532,2785,2831,3060,288 1,3102,3158,3363,2641,2837,2897,3114,2954,3174,3200,3427,2995,3221,3261,3461, 3313,3510,3569,3740,769,1106,1161,1540,1248,1597,1646,1965,1272,1663,1714,20 01,1761,2045,2113,2441,1343,1739,1821,2077,1855,2163,2145,2458,1881,2188,223 4,2522,2290,2547,2580,2853,1487,1840,1885,2161,1987,2219,2258,2557,1999,2292, 2310,2585,2337,2620,2649,2920,2015,2328,2376,2646,2448,2693,2736,2971,2487,2 776,2788,3038,2834,3079,3126,3337,1509,1983,1993,2277,2017,2301,2346,2628,20 61,2392,2429,2679,2472,2724,2782,3024,2245,2446,2499,2738,2534,2809,2840,306 8,2625,2843,2900,3118,2957,3170,3195,3421,2306,2542,2604,2812,2644,2888,2927, 3138,2701,2944,2978,3191,3020,3225,3275,3479,2747,2999,3049,3257,3094,3289,3 332,3523,3146,3352,3384,3556,3410,3620,3636,3827,1526,2023,2043,2436,2217,24 63,2489,2771,2264,2519,2549,2819,2612,2862,2917,3130,2315,2578,2638,2872,267 4,2930,2981,3183,2727,3013,2974,3212,3072,3270,3308,3497,2453,2657,2690,2950, 2765,2988,3045,3243,2803,3053,3090,3294,3122,3318,3368,3549,2884,3106,3154,3 342,3204,3394,3416,3605,3230,3456,3473,3652,3516,3676,3694,3792,2537,2699,28 00,3057,2859,3087,3110,3323,2910,3162,3178,3378,3217,3400,3467,3628,2923,320 8,3248,3450,3303,3485,3491,3685,3358,3529,3542,3702,3591,3750,3770,3896,3027, 3284,3298,3504,3373,3536,3563,3721,3405,3598,3613,3760,3660,3781,3840,3929,3 438,3644,3668,3803,3712,3815,3853,3947,3730,3866,3881,3968,3912,3990,4016,40 49,11,46,79,183,105,199,256,393,128,242,280,427,314,467,482,743,148,268,292,459 ,345,512,572,768,374,566,539,801,634,843,870,1117,166,325,365,526,384,559,598,8 11,435,622,645,847,717,900,925,1175,475,657,732,917,758,953,993,1214,797,1001, 1042,1292,1064,1327,1388,1668,214,335,410,616,443,640,711,878,490,737,668,929, 782,969,1020,1239,553,727,792,997,820,1031,1061,1313,861,1071,1128,1359,1172, 1408,1451,1756,610,806,852,1057,908,1096,1152,1396,945,1155,1211,1432,1249,14 94,1533,1826,1012,1233,1304,1504,1322,1536,1591,1884,1377,1608,1654,1930,169 6,1970,2040,2386,303,401,451,722,519,753,772,1016,579,787,825,1053,865,1093,11 07,1394,628,829,874,1100,921,1148,1201,1438,965,1204,1236,1478,1310,1523,1578 ,1863,679,891,949,1168,973,1207,1258,1507,1046,1298,1324,1543,1374,1606,1640, 1926,1103,1351,1399,1620,1435,1685,1703,1964,1497,1729,1792,2022,1837,2076,2 187,2388,701,957,1027,1267,1086,1316,1371,1615,1121,1379,1413,1666,1454,1701, 1751,2004,1195,1443,1481,1724,1538,1780,1831,2094,1566,1844,1892,2138,1942,2 206,2246,2551,1255,1512,1551,1800,1625,1859,1901,2174,1694,1917,1966,2229,20 24,2254,2343,2635,1749,1986,2044,2302,2070,2372,2411,2705,2181,2430,2473,269 1,2516,2760,2845,3100,355,497,532,815,585,834,883,1145,591,887,933,1178,981,12 42,1273,1573,674,937,985,1283,1035,1307,1345,1576,1068,1339,1391,1652,1446,16 92,1713,1962,690,1024,1075,1289,1135,1354,1402,1689,1165,1427,1457,1717,1489, 1776,1811,2066,1162,1483,1517,1772,1563,1835,1867,2142,1630,1907,1946,2204,1 982,2242,2311,2613,748,1114,1138,1419,1188,1470,1515,1758,1220,1530,1548,1829 ,1593,1882,1915,2199,1382,1581,1628,1890,1671,1938,1980,2235,1735,1994,2054,2 296,2102,2368,2416,2678,1467,1659,1722,1958,1769,2018,2060,2347,1820,2084,21 18,2383,2189,2450,2490,2739,1897,2185,2210,2474,2237,2520,2461,2780,2324,260 5,2639,2863,2653,2946,2990,3149,777,1181,1198,1561,1357,1603,1635,1905,1424,1 647,1675,1950,1733,2000,2052,2352,1462,1726,1767,2002,1798,2062,2108,2395,18 46,2124,2170,2438,2233,2483,2548,2792,1571,1778,1809,2104,1865,2156,2216,246 4,1948,2218,2248,2543,2327,2511,2624,2869,2016,2285,2363,2607,2397,2650,2684, 2921,2452,2698,2695,2979,2783,3011,3047,3251,1656,1839,1909,2222,1996,2252,2 307,2568,2056,2349,2374,2642,2428,2659,2694,2941,2110,2405,2466,2681,2491,27 02,2786,3014,2564,2804,2836,3056,2892,3112,3143,3350,2201,2478,2536,2789,262 1,2795,2880,3071,2632,2871,2926,3131,2968,3172,3228,3422,2661,2949,3003,3192, 3032,3237,3211,3445,3093,3278,3306,3511,3364,3546,3588,3696,419,546,604,856,6 51,941,989,1261,685,1005,1038,1280,1082,1333,1348,1678,695,1079,1110,1330,114 1,1473,1499,1747,1223,1502,1558,1822,1601,1871,1913,2227,706,1131,1185,1486,1 230,1553,1586,1854,1264,1613,1642,1922,1682,1972,2010,2257,1301,1664,1708,19 92,1760,2046,2080,2336,1783,2068,2128,2402,2136,2437,2481,2851,896,1227,1252, 1596,1286,1644,1680,1956,1365,1715,1738,2032,1789,2090,2122,2358,1416,1745,1 807,2074,1850,2132,2148,2419,1888,2150,2168,2486,2283,2523,2594,2870,1465,18 48,1876,2164,1934,2212,2223,2503,1978,2280,2316,2563,2381,2616,2645,2929,203 0,2342,2400,2647,2456,2675,2745,2970,2535,2754,2807,3018,2839,3066,3117,3343, 912,1276,1336,1706,1410,1740,1796,2098,1449,1816,1857,2154,1899,2179,2193,24 95,1528,1880,1932,2195,1974,2270,2305,2553,2026,2331,2377,2631,2423,2664,271 9,2932,1588,1954,2008,2313,2082,2367,2361,2667,2112,2409,2433,2708,2506,2748, 2772,3023,2175,2459,2528,2763,2556,2821,2842,3074,2602,2866,2903,3133,2976,3 179,3231,3425,1632,2038,2088,2414,2144,2447,2508,2757,2265,2531,2576,2830,25 84,2848,2886,3108,2289,2579,2599,2877,2670,2901,2958,3169,2731,2973,3000,319 4,3044,3255,3288,3457,2333,2687,2714,2935,2774,2982,3008,3218,2810,3039,3078, 3276,3121,3310,3356,3524,2909,3084,3137,3321,3185,3371,3391,3579,3222,3409,3 441,3602,3486,3642,3690,3819,977,1368,1430,1818,1520,1874,1924,2240,1546,194 0,1988,2276,2036,2322,2391,2722,1618,2014,2096,2354,2130,2444,2425,2737,2158, 2469,2515,2801,2571,2824,2857,3096,1765,2116,2162,2442,2263,2500,2540,2833,2 274,2573,2590,2860,2619,2889,2918,3156,2291,2610,2656,2915,2728,2955,2993,31 98,2766,3029,3041,3258,3081,3292,3331,3502,1787,2259,2268,2559,2294,2582,262 7,2898,2338,2673,2711,2943,2751,2984,3036,3245,2525,2725,2777,2997,2813,3059, 3086,3282,2895,3091,3140,3324,3188,3367,3387,3574,2587,2818,2874,3062,2912,3 127,3163,3339,2965,3175,3205,3383,3241,3413,3453,3617,3005,3224,3265,3437,33 04,3465,3499,3653,3346,3515,3541,3680,3565,3726,3737,3887,1803,2300,2318,271 5,2498,2742,2769,3026,2545,2798,2827,3069,2883,3105,3152,3335,2595,2854,2906, 3115,2938,3165,3207,3379,2987,3235,3201,3402,3286,3448,3482,3632,2734,2924,2 952,3181,3021,3214,3262,3429,3054,3268,3300,3469,3327,3490,3528,3674,3124,33 14,3354,3507,3395,3551,3570,3714,3418,3597,3612,3751,3647,3769,3784,3860,281 5,2962,3051,3272,3103,3296,3317,3494,3147,3360,3375,3538,3406,3555,3607,3732, 3159,3398,3432,3593,3477,3622,3626,3776,3520,3658,3669,3790,3703,3828,3843,3 939,3247,3462,3474,3637,3533,3663,3686,3805,3560,3708,3719,3835,3757,3851,38 97,3964,3583,3744,3763,3869,3797,3877,3906,3978,3812,3917,3927,3994,3951,401 0,4031,4056,229,504,662,1008,763,1050,1158,1459,838,1124,1217,1525,1295,1598, 1623,2012,904,1191,1246,1583,1362,1661,1763,2042,1421,1754,1710,2092,1861,21 46,2183,2485,961,1319,1405,1687,1441,1742,1805,2106,1541,1842,1878,2152,1976, 2225,2255,2546,1611,1895,1998,2244,2034,2293,2340,2589,2086,2351,2398,2669,2 421,2703,2761,3025,1089,1342,1491,1833,1556,1869,1968,2197,1637,2006,1903,22 61,2064,2309,2370,2615,1731,1990,2078,2345,2120,2384,2418,2689,2172,2431,249 3,2735,2541,2781,2823,3099,1824,2100,2160,2412,2231,2457,2521,2770,2281,2526, 2586,2805,2623,2861,2902,3157,2359,2608,2680,2876,2697,2905,2956,3203,2752,2 972,3012,3238,3050,3269,3320,3535,1270,1475,1568,1984,1673,2028,2050,2365,17 74,2072,2126,2407,2177,2454,2471,2767,1852,2134,2191,2462,2250,2518,2574,281 1,2303,2577,2611,2847,2686,2893,2945,3186,1920,2214,2287,2538,2314,2581,2634, 2879,2404,2672,2700,2911,2749,2969,2998,3236,2468,2726,2775,2983,2808,3040,3 055,3264,2864,3077,3129,3307,3167,3344,3415,3537,1952,2298,2379,2643,2449,26 92,2746,2977,2488,2755,2787,3022,2826,3052,3097,3295,2566,2814,2850,3073,290 8,3120,3161,3355,2934,3171,3210,3385,3249,3428,3452,3627,2629,2882,2919,3136, 2986,3184,3216,3407,3048,3229,3267,3442,3309,3458,3512,3671,3095,3281,3322,3 487,3340,3527,3550,3705,3412,3561,3585,3698,3609,3731,3771,3880,1385,1649,16 99,2114,1785,2140,2202,2513,1794,2208,2267,2550,2325,2618,2648,2939,1911,227 2,2329,2658,2390,2683,2720,2942,2426,2717,2764,3010,2817,3046,3063,3263,1936, 2375,2435,2666,2501,2729,2778,3043,2533,2799,2829,3067,2858,3116,3145,3336,2 530,2852,2887,3113,2931,3164,3190,3386,2991,3220,3250,3426,3279,3451,3492,36 59,2020,2479,2505,2793,2561,2841,2885,3101,2592,2899,2916,3160,2959,3202,322 7,3423,2758,2948,2989,3209,3028,3244,3277,3446,3082,3287,3329,3483,3361,3526, 3553,3692,2838,3017,3070,3260,3111,3305,3333,3513,3153,3349,3372,3534,3417,3 572,3594,3722,3213,3414,3430,3586,3447,3610,3578,3741,3500,3655,3672,3778,36 79,3817,3836,3900,2058,2555,2569,2928,2732,2966,2996,3219,2796,3007,3030,325 4,3080,3291,3326,3517,2832,3076,3109,3293,3135,3334,3365,3540,3173,3376,3404, 3566,3443,3590,3625,3746,2936,3119,3144,3362,3189,3396,3434,3580,3253,3435,3 454,3623,3501,3606,3665,3780,3302,3476,3522,3656,3543,3678,3695,3806,3573,37 01,3700,3831,3742,3845,3859,3936,3015,3168,3223,3436,3290,3455,3489,3635,333 0,3514,3530,3673,3559,3682,3699,3814,3366,3547,3581,3693,3595,3704,3743,3846, 3634,3752,3766,3863,3793,3885,3898,3969,3424,3587,3619,3745,3664,3747,3787,3 870,3670,3783,3808,3892,3825,3908,3928,3989,3683,3818,3841,3915,3854,3932,39 22,3997,3878,3945,3955,4014,3973,4023,4033,4055,1510,1719,1813,2166,1886,227 8,2334,2637,1928,2356,2393,2655,2445,2709,2723,3033,1944,2440,2476,2706,2510, 2844,2867,3092,2597,2873,2925,3155,2963,3193,3226,3440,1960,2496,2558,2855,2 603,2922,2951,3180,2640,2975,3001,3232,3037,3271,3299,3459,2677,3019,3061,32 85,3104,3325,3345,3506,3123,3338,3377,3545,3382,3564,3589,3773,2220,2600,262 6,2961,2662,3004,3035,3259,2740,3065,3085,3315,3128,3353,3374,3519,2790,3089, 3141,3341,3177,3381,3390,3554,3206,3392,3403,3592,3475,3611,3649,3782,2835,3 176,3197,3401,3242,3431,3439,3601,3274,3472,3495,3633,3532,3661,3675,3809,33 12,3509,3544,3677,3575,3691,3724,3826,3618,3728,3753,3847,3767,3867,3888,396 6,2239,2651,2712,3058,2784,3088,3132,3359,2820,3148,3182,3393,3215,3411,3419, 3596,2896,3199,3240,3420,3273,3468,3488,3629,3311,3503,3531,3667,3557,3684,3 711,3810,2953,3256,3297,3493,3348,3525,3521,3687,3369,3548,3562,3706,3603,37 25,3736,3849,3408,3577,3615,3733,3630,3759,3768,3871,3654,3779,3798,3893,383 0,3910,3930,3991,2994,3319,3351,3552,3388,3571,3604,3729,3464,3616,3640,3764, 3645,3772,3789,3884,3478,3641,3651,3786,3688,3796,3822,3907,3717,3829,3839,3 916,3858,3937,3949,4000,3505,3697,3709,3811,3738,3832,3844,3924,3754,3856,38 72,3944,3889,3956,3971,4018,3800,3874,3894,3959,3913,3975,3981,4030,3925,398 6,3996,4036,4007,4044,4054,4075,2320,2743,2802,3151,2890,3196,3233,3449,2913, 3246,3283,3471,3316,3498,3539,3713,2980,3301,3357,3518,3380,3568,3558,3720,3 397,3582,3608,3749,3638,3761,3775,3879,3107,3370,3399,3567,3463,3600,3621,37 65,3470,3639,3648,3777,3662,3791,3804,3902,3480,3657,3681,3802,3716,3821,383 7,3918,3734,3852,3857,3938,3873,3950,3962,4012,3125,3460,3466,3631,3481,3643, 3666,3795,3508,3689,3707,3816,3727,3833,3855,3934,3614,3715,3739,3838,3755,3 864,3875,3946,3794,3876,3895,3960,3914,3974,3980,4029,3646,3758,3785,3865,38 01,3891,3904,3965,3824,3909,3920,3979,3933,3987,3999,4039,3842,3926,3941,399 5,3954,4002,4011,4046,3967,4015,4022,4052,4027,4061,4063,4083,3139,3484,3496, 3710,3599,3723,3735,3850,3624,3748,3762,3868,3788,3883,3901,3963,3650,3774,3 799,3886,3813,3905,3921,3977,3834,3931,3919,3984,3948,3998,4006,4042,3718,38 07,3820,3911,3848,3923,3940,3992,3862,3942,3953,4003,3961,4008,4019,4051,389 0,3957,3970,4013,3982,4024,4028,4059,3988,4035,4038,4065,4045,4068,4070,4080, 3756,3823,3861,3943,3882,3952,3958,4009,3899,3972,3976,4021,3985,4025,4037,4 062,3903,3983,3993,4034,4005,4040,4041,4069,4017,4047,4050,4071,4057,4076,40 78,4088,3935,4001,4004,4043,4020,4048,4053,4073,4026,4058,4060,4077,4066,407 9,4084,4090,4032,4064,4067,4081,4072,4082,4085,4091,4074,4086,4087,4092,4089, 4093,4094,4095];

**Table Z2, with a sequence length of 4096:**

| Polarized channel sequence number | Reliability or reliability sequence number | Polarized channel sequence number | Reliability or reliability sequence number | Polarized channel sequence number | Reliability or reliability sequence number | Polarized channel sequence number | Reliability or reliability sequence number | Polarized channel sequence number | Reliability or reliability sequence number | Polarized channel sequence number | Reliability or reliability sequence number | Polarized channel sequence number | Reliability or reliability sequence number | Polarized channel sequence number | Reliability or reliability sequence number |
|---|---|---|---|---|---|---|---|---|---|---|---|---|---|---|---|
| 0 | 0 | 512 | 29 | 1024 | 10 | 1536 | 320 | 2048 | 11 | 2560 | 419 | 3072 | 229 | 3584 | 1510 |
| 1 | 1 | 513 | 47 | 1025 | 40 | 1537 | 416 | 2049 | 46 | 2561 | 546 | 3073 | 504 | 3585 | 1719 |
| 2 | 2 | 514 | 56 | 1026 | 66 | 1538 | 464 | 2050 | 79 | 2562 | 604 | 3074 | 662 | 3586 | 1813 |
| 3 | 7 | 515 | 107 | 1027 | 145 | 1539 | 667 | 2051 | 183 | 2563 | 856 | 3075 | 1008 | 3587 | 2166 |
| 4 | 3 | 516 | 64 | 1028 | 86 | 1540 | 503 | 2052 | 105 | 2564 | 651 | 3076 | 763 | 3588 | 1886 |
| 5 | 8 | 517 | 127 | 1029 | 157 | 1541 | 740 | 2053 | 199 | 2565 | 941 | 3077 | 1050 | 3589 | 2278 |
| 6 | 13 | 518 | 140 | 1030 | 190 | 1542 | 779 | 2054 | 256 | 2566 | 989 | 3078 | 1158 | 3590 | 2334 |
| 7 | 26 | 519 | 224 | 1031 | 299 | 1543 | 1013 | 2055 | 393 | 2567 | 1261 | 3079 | 1459 | 3591 | 2637 |
| 8 | 4 | 520 | 70 | 1032 | 102 | 1544 | 527 | 2056 | 128 | 2568 | 685 | 3080 | 838 | 3592 | 1928 |
| 9 | 12 | 521 | 144 | 1033 | 179 | 1545 | 794 | 2057 | 242 | 2569 | 1005 | 3081 | 1124 | 3593 | 2356 |
| 10 | 15 | 522 | 154 | 1034 | 209 | 1546 | 821 | 2058 | 280 | 2570 | 1038 | 3082 | 1217 | 3594 | 2393 |
| 11 | 30 | 523 | 231 | 1035 | 327 | 1547 | 1028 | 2059 | 427 | 2571 | 1280 | 3083 | 1525 | 3595 | 2655 |
| 12 | 18 | 524 | 167 | 1036 | 236 | 1548 | 859 | 2060 | 314 | 2572 | 1082 | 3084 | 1295 | 3596 | 2445 |
| 13 | 35 | 525 | 250 | 1037 | 359 | 1549 | 1076 | 2061 | 467 | 2573 | 1333 | 3085 | 1598 | 3597 | 2709 |
| 14 | 37 | 526 | 255 | 1038 | 370 | 1550 | 1088 | 2062 | 482 | 2574 | 1348 | 3086 | 1623 | 3598 | 2723 |
| 15 | 82 | 527 | 396 | 1039 | 576 | 1551 | 1401 | 2063 | 743 | 2575 | 1678 | 3087 | 2012 | 3599 | 3033 |
| 16 | 5 | 528 | 72 | 1040 | 118 | 1552 | 536 | 2064 | 148 | 2576 | 695 | 3088 | 904 | 3600 | 1944 |
| 17 | 14 | 529 | 165 | 1041 | 201 | 1553 | 855 | 2065 | 268 | 2577 | 1079 | 3089 | 1191 | 3601 | 2440 |
| 18 | 16 | 530 | 175 | 1042 | 219 | 1554 | 882 | 2066 | 292 | 2578 | 1110 | 3090 | 1246 | 3602 | 2476 |
| 19 | 34 | 531 | 249 | 1043 | 352 | 1555 | 1073 | 2067 | 459 | 2579 | 1330 | 3091 | 1583 | 3603 | 2706 |
| 20 | 21 | 532 | 185 | 1044 | 261 | 1556 | 909 | 2068 | 345 | 2580 | 1141 | 3092 | 1362 | 3604 | 2510 |
| 21 | 41 | 533 | 305 | 1045 | 388 | 1557 | 1202 | 2069 | 512 | 2581 | 1473 | 3093 | 1661 | 3605 | 2844 |
| 22 | 51 | 534 | 316 | 1046 | 438 | 1558 | 1225 | 2070 | 572 | 2582 | 1499 | 3094 | 1763 | 3606 | 2867 |
| 23 | 87 | 535 | 430 | 1047 | 594 | 1559 | 1469 | 2071 | 768 | 2583 | 1747 | 3095 | 2042 | 3607 | 3092 |
| 24 | 24 | 536 | 211 | 1048 | 284 | 1560 | 979 | 2072 | 374 | 2584 | 1223 | 3096 | 1421 | 3608 | 2597 |
| 25 | 50 | 537 | 317 | 1049 | 433 | 1561 | 1231 | 2073 | 566 | 2585 | 1502 | 3097 | 1754 | 3609 | 2873 |
| 26 | 45 | 538 | 341 | 1050 | 412 | 1562 | 1284 | 2074 | 539 | 2586 | 1558 | 3098 | 1710 | 3610 | 2925 |
| 27 | 94 | 539 | 469 | 1051 | 623 | 1563 | 1545 | 2075 | 801 | 2587 | 1822 | 3099 | 2092 | 3611 | 3155 |
| 28 | 61 | 540 | 360 | 1052 | 489 | 1564 | 1325 | 2076 | 634 | 2588 | 1601 | 3100 | 1861 | 3612 | 2963 |
| 29 | 103 | 541 | 495 | 1053 | 655 | 1565 | 1594 | 2077 | 843 | 2589 | 1871 | 3101 | 2146 | 3613 | 3193 |
| 30 | 110 | 542 | 518 | 1054 | 678 | 1566 | 1636 | 2078 | 870 | 2590 | 1913 | 3102 | 2183 | 3614 | 3226 |
| 31 | 177 | 543 | 707 | 1055 | 889 | 1567 | 1949 | 2079 | 1117 | 2591 | 2227 | 3103 | 2485 | 3615 | 3440 |
| 32 | 6 | 544 | 74 | 1056 | 133 | 1568 | 545 | 2080 | 166 | 2592 | 706 | 3104 | 961 | 3616 | 1960 |
| 33 | 19 | 545 | 181 | 1057 | 245 | 1569 | 898 | 2081 | 325 | 2593 | 1131 | 3105 | 1319 | 3617 | 2496 |
| 34 | 23 | 546 | 198 | 1058 | 277 | 1570 | 947 | 2082 | 365 | 2594 | 1185 | 3106 | 1405 | 3618 | 2558 |
| 35 | 43 | 547 | 310 | 1059 | 400 | 1571 | 1213 | 2083 | 526 | 2595 | 1486 | 3107 | 1687 | 3619 | 2855 |
| 36 | 25 | 548 | 213 | 1060 | 291 | 1572 | 984 | 2084 | 384 | 2596 | 1230 | 3108 | 1441 | 3620 | 2603 |
| 37 | 49 | 549 | 339 | 1061 | 428 | 1573 | 1281 | 2085 | 559 | 2597 | 1553 | 3109 | 1742 | 3621 | 2922 |
| 38 | 55 | 550 | 353 | 1062 | 460 | 1574 | 1311 | 2086 | 598 | 2598 | 1586 | 3110 | 1805 | 3622 | 2951 |
| 39 | 96 | 551 | 486 | 1063 | 631 | 1575 | 1577 | 2087 | 811 | 2599 | 1854 | 3111 | 2106 | 3623 | 3180 |
| 40 | 31 | 552 | 225 | 1064 | 333 | 1576 | 1015 | 2088 | 435 | 2600 | 1264 | 3112 | 1541 | 3624 | 2640 |
| 41 | 59 | 553 | 366 | 1065 | 479 | 1577 | 1337 | 2089 | 622 | 2601 | 1613 | 3113 | 1842 | 3625 | 2975 |
| 42 | 63 | 554 | 379 | 1066 | 499 | 1578 | 1366 | 2090 | 645 | 2602 | 1642 | 3114 | 1878 | 3626 | 3001 |
| 43 | 104 | 555 | 523 | 1067 | 659 | 1579 | 1645 | 2091 | 847 | 2603 | 1922 | 3115 | 2152 | 3627 | 3232 |
| 44 | 76 | 556 | 398 | 1068 | 555 | 1580 | 1406 | 2092 | 717 | 2604 | 1682 | 3116 | 1976 | 3628 | 3037 |
| 45 | 117 | 557 | 552 | 1069 | 705 | 1581 | 1697 | 2093 | 900 | 2605 | 1972 | 3117 | 2225 | 3629 | 3271 |
| 46 | 123 | 558 | 575 | 1070 | 725 | 1582 | 1736 | 2094 | 925 | 2606 | 2010 | 3118 | 2255 | 3630 | 3299 |
| 47 | 195 | 559 | 726 | 1071 | 938 | 1583 | 1981 | 2095 | 1175 | 2607 | 2257 | 3119 | 2546 | 3631 | 3459 |
| 48 | 36 | 560 | 238 | 1072 | 364 | 1584 | 1047 | 2096 | 475 | 2608 | 1301 | 3120 | 1611 | 3632 | 2677 |
| 49 | 65 | 561 | 389 | 1073 | 508 | 1585 | 1386 | 2097 | 657 | 2609 | 1664 | 3121 | 1895 | 3633 | 3019 |
| 50 | 80 | 562 | 411 | 1074 | 568 | 1586 | 1433 | 2098 | 732 | 2610 | 1708 | 3122 | 1998 | 3634 | 3061 |
| 51 | 121 | 563 | 564 | 1075 | 718 | 1587 | 1716 | 2099 | 917 | 2611 | 1992 | 3123 | 2244 | 3635 | 3285 |
| 52 | 85 | 564 | 437 | 1076 | 589 | 1588 | 1484 | 2100 | 758 | 2612 | 1760 | 3124 | 2034 | 3636 | 3104 |
| 53 | 131 | 565 | 596 | 1077 | 750 | 1589 | 1773 | 2101 | 953 | 2613 | 2046 | 3125 | 2293 | 3637 | 3325 |
| 54 | 141 | 566 | 615 | 1078 | 783 | 1590 | 1802 | 2102 | 993 | 2614 | 2080 | 3126 | 2340 | 3638 | 3345 |
| 55 | 208 | 567 | 780 | 1079 | 972 | 1591 | 2057 | 2103 | 1214 | 2615 | 2336 | 3127 | 2589 | 3639 | 3506 |
| 56 | 93 | 568 | 448 | 1080 | 619 | 1592 | 1506 | 2104 | 797 | 2616 | 1783 | 3128 | 2086 | 3640 | 3123 |
| 57 | 143 | 569 | 608 | 1081 | 790 | 1593 | 1791 | 2105 | 1001 | 2617 | 2068 | 3129 | 2351 | 3641 | 3338 |
| 58 | 155 | 570 | 644 | 1082 | 824 | 1594 | 1851 | 2106 | 1042 | 2618 | 2128 | 3130 | 2398 | 3642 | 3377 |
| 59 | 235 | 571 | 827 | 1083 | 1040 | 1595 | 2123 | 2107 | 1292 | 2619 | 2402 | 3131 | 2669 | 3643 | 3545 |
| 60 | 161 | 572 | 649 | 1084 | 841 | 1596 | 1858 | 2108 | 1064 | 2620 | 2136 | 3132 | 2421 | 3644 | 3382 |
| 61 | 248 | 573 | 853 | 1085 | 1070 | 1597 | 2155 | 2109 | 1327 | 2621 | 2437 | 3133 | 2703 | 3645 | 3564 |
| 62 | 271 | 574 | 886 | 1086 | 1123 | 1598 | 2200 | 2110 | 1388 | 2622 | 2481 | 3134 | 2761 | 3646 | 3589 |
| 63 | 391 | 575 | 1209 | 1087 | 1392 | 1599 | 2575 | 2111 | 1668 | 2623 | 2851 | 3135 | 3025 | 3647 | 3773 |
| 64 | 9 | 576 | 116 | 1088 | 169 | 1600 | 702 | 2112 | 214 | 2624 | 896 | 3136 | 1089 | 3648 | 2220 |
| 65 | 20 | 577 | 212 | 1089 | 253 | 1601 | 982 | 2113 | 335 | 2625 | 1227 | 3137 | 1342 | 3649 | 2600 |
| 66 | 28 | 578 | 221 | 1090 | 312 | 1602 | 1003 | 2114 | 410 | 2626 | 1252 | 3138 | 1491 | 3650 | 2626 |
| 67 | 58 | 579 | 358 | 1091 | 474 | 1603 | 1321 | 2115 | 616 | 2627 | 1596 | 3139 | 1833 | 3651 | 2961 |
| 68 | 32 | 580 | 233 | 1092 | 340 | 1604 | 1034 | 2116 | 443 | 2628 | 1286 | 3140 | 1556 | 3652 | 2662 |
| 69 | 62 | 581 | 380 | 1093 | 494 | 1605 | 1369 | 2117 | 640 | 2629 | 1644 | 3141 | 1869 | 3653 | 3004 |
| 70 | 75 | 582 | 397 | 1094 | 550 | 1606 | 1403 | 2118 | 711 | 2630 | 1680 | 3142 | 1968 | 3654 | 3035 |
| 71 | 112 | 583 | 543 | 1095 | 687 | 1607 | 1681 | 2119 | 878 | 2631 | 1956 | 3143 | 2197 | 3655 | 3259 |
| 72 | 38 | 584 | 262 | 1096 | 377 | 1608 | 1104 | 2120 | 490 | 2632 | 1365 | 3144 | 1637 | 3656 | 2740 |
| 73 | 81 | 585 | 414 | 1097 | 573 | 1609 | 1437 | 2121 | 737 | 2633 | 1715 | 3145 | 2006 | 3657 | 3065 |
| 74 | 67 | 586 | 425 | 1098 | 513 | 1610 | 1461 | 2122 | 668 | 2634 | 1738 | 3146 | 1903 | 3658 | 3085 |
| 75 | 124 | 587 | 588 | 1099 | 729 | 1611 | 1759 | 2123 | 929 | 2635 | 2032 | 3147 | 2261 | 3659 | 3315 |
| 76 | 90 | 588 | 452 | 1100 | 606 | 1612 | 1513 | 2124 | 782 | 2636 | 1789 | 3148 | 2064 | 3660 | 3128 |
| 77 | 135 | 589 | 621 | 1101 | 761 | 1613 | 1814 | 2125 | 969 | 2637 | 2090 | 3149 | 2309 | 3661 | 3353 |
| 78 | 149 | 590 | 641 | 1102 | 804 | 1614 | 1845 | 2126 | 1020 | 2638 | 2122 | 3150 | 2370 | 3662 | 3374 |
| 79 | 217 | 591 | 795 | 1103 | 994 | 1615 | 2079 | 2127 | 1239 | 2639 | 2358 | 3151 | 2615 | 3663 | 3519 |
| 80 | 48 | 592 | 282 | 1104 | 422 | 1616 | 1150 | 2128 | 553 | 2640 | 1416 | 3152 | 1731 | 3664 | 2790 |
| 81 | 78 | 593 | 429 | 1105 | 563 | 1617 | 1466 | 2129 | 727 | 2641 | 1745 | 3153 | 1990 | 3665 | 3089 |
| 82 | 92 | 594 | 461 | 1106 | 614 | 1618 | 1529 | 2130 | 792 | 2642 | 1807 | 3154 | 2078 | 3666 | 3141 |
| 83 | 142 | 595 | 612 | 1107 | 786 | 1619 | 1797 | 2131 | 997 | 2643 | 2074 | 3155 | 2345 | 3667 | 3341 |
| 84 | 98 | 596 | 484 | 1108 | 639 | 1620 | 1574 | 2132 | 820 | 2644 | 1850 | 3156 | 2120 | 3668 | 3177 |
| 85 | 152 | 597 | 647 | 1109 | 814 | 1621 | 1856 | 2133 | 1031 | 2645 | 2132 | 3157 | 2384 | 3669 | 3381 |
| 86 | 160 | 598 | 656 | 1110 | 839 | 1622 | 1870 | 2134 | 1061 | 2646 | 2148 | 3158 | 2418 | 3670 | 3390 |
| 87 | 243 | 599 | 840 | 1111 | 1058 | 1623 | 2139 | 2135 | 1313 | 2647 | 2419 | 3159 | 2689 | 3671 | 3554 |
| 88 | 108 | 600 | 505 | 1112 | 671 | 1624 | 1610 | 2136 | 861 | 2648 | 1888 | 3160 | 2172 | 3672 | 3206 |
| 89 | 163 | 601 | 658 | 1113 | 849 | 1625 | 1873 | 2137 | 1071 | 2649 | 2150 | 3161 | 2431 | 3673 | 3392 |
| 90 | 180 | 602 | 669 | 1114 | 895 | 1626 | 1891 | 2138 | 1128 | 2650 | 2168 | 3162 | 2493 | 3674 | 3403 |
| 91 | 260 | 603 | 890 | 1115 | 1099 | 1627 | 2205 | 2139 | 1359 | 2651 | 2486 | 3163 | 2735 | 3675 | 3592 |
| 92 | 194 | 604 | 744 | 1116 | 934 | 1628 | 2007 | 2140 | 1172 | 2652 | 2283 | 3164 | 2541 | 3676 | 3475 |
| 93 | 278 | 605 | 919 | 1117 | 1142 | 1629 | 2241 | 2141 | 1408 | 2653 | 2523 | 3165 | 2781 | 3677 | 3611 |
| 94 | 296 | 606 | 976 | 1118 | 1182 | 1630 | 2312 | 2142 | 1451 | 2654 | 2594 | 3166 | 2823 | 3678 | 3649 |
| 95 | 434 | 607 | 1228 | 1119 | 1477 | 1631 | 2596 | 2143 | 1756 | 2655 | 2870 | 3167 | 3099 | 3679 | 3782 |
| 96 | 57 | 608 | 301 | 1120 | 470 | 1632 | 1193 | 2144 | 610 | 2656 | 1465 | 3168 | 1824 | 3680 | 2835 |
| 97 | 95 | 609 | 483 | 1121 | 627 | 1633 | 1572 | 2145 | 806 | 2657 | 1848 | 3169 | 2100 | 3681 | 3176 |
| 98 | 106 | 610 | 498 | 1122 | 664 | 1634 | 1599 | 2146 | 852 | 2658 | 1876 | 3170 | 2160 | 3682 | 3197 |
| 99 | 159 | 611 | 666 | 1123 | 835 | 1635 | 1887 | 2147 | 1057 | 2659 | 2164 | 3171 | 2412 | 3683 | 3401 |
| 100 | 119 | 612 | 530 | 1124 | 709 | 1636 | 1658 | 2148 | 908 | 2660 | 1934 | 3172 | 2231 | 3684 | 3242 |
| 101 | 171 | 613 | 697 | 1125 | 868 | 1637 | 1935 | 2149 | 1096 | 2661 | 2212 | 3173 | 2457 | 3685 | 3431 |
| 102 | 188 | 614 | 704 | 1126 | 918 | 1638 | 1947 | 2150 | 1152 | 2662 | 2223 | 3174 | 2521 | 3686 | 3439 |
| 103 | 274 | 615 | 903 | 1127 | 1132 | 1639 | 2221 | 2151 | 1396 | 2663 | 2503 | 3175 | 2770 | 3687 | 3601 |
| 104 | 129 | 616 | 556 | 1128 | 742 | 1640 | 1702 | 2152 | 945 | 2664 | 1978 | 3176 | 2281 | 3688 | 3274 |
| 105 | 189 | 617 | 741 | 1129 | 922 | 1641 | 2003 | 2153 | 1155 | 2665 | 2280 | 3177 | 2526 | 3689 | 3472 |
| 106 | 207 | 618 | 766 | 1130 | 970 | 1642 | 2041 | 2154 | 1211 | 2666 | 2316 | 3178 | 2586 | 3690 | 3495 |
| 107 | 288 | 619 | 951 | 1131 | 1164 | 1643 | 2282 | 2155 | 1432 | 2667 | 2563 | 3179 | 2805 | 3691 | 3633 |
| 108 | 220 | 620 | 812 | 1132 | 1000 | 1644 | 2101 | 2156 | 1249 | 2668 | 2381 | 3180 | 2623 | 3692 | 3532 |
| 109 | 313 | 621 | 995 | 1133 | 1219 | 1645 | 2335 | 2157 | 1494 | 2669 | 2616 | 3181 | 2861 | 3693 | 3661 |
| 110 | 330 | 622 | 1019 | 1134 | 1260 | 1646 | 2364 | 2158 | 1533 | 2670 | 2645 | 3182 | 2902 | 3694 | 3675 |
| 111 | 471 | 623 | 1288 | 1135 | 1549 | 1647 | 2663 | 2159 | 1826 | 2671 | 2929 | 3183 | 3157 | 3695 | 3809 |
| 112 | 146 | 624 | 587 | 1136 | 796 | 1648 | 1755 | 2160 | 1012 | 2672 | 2030 | 3184 | 2359 | 3696 | 3312 |
| 113 | 215 | 625 | 784 | 1137 | 988 | 1649 | 2063 | 2161 | 1233 | 2673 | 2342 | 3185 | 2608 | 3697 | 3509 |
| 114 | 239 | 626 | 826 | 1138 | 1049 | 1650 | 2121 | 2162 | 1304 | 2674 | 2400 | 3186 | 2680 | 3698 | 3544 |
| 115 | 318 | 627 | 1021 | 1139 | 1234 | 1651 | 2366 | 2163 | 1504 | 2675 | 2647 | 3187 | 2876 | 3699 | 3677 |
| 116 | 246 | 628 | 867 | 1140 | 1065 | 1652 | 2176 | 2164 | 1322 | 2676 | 2456 | 3188 | 2697 | 3700 | 3575 |
| 117 | 331 | 629 | 1045 | 1141 | 1263 | 1653 | 2396 | 2165 | 1536 | 2677 | 2675 | 3189 | 2905 | 3701 | 3691 |
| 118 | 356 | 630 | 1108 | 1142 | 1317 | 1654 | 2465 | 2166 | 1591 | 2678 | 2745 | 3190 | 2956 | 3702 | 3724 |
| 119 | 502 | 631 | 1332 | 1143 | 1607 | 1655 | 2707 | 2167 | 1884 | 2679 | 2970 | 3191 | 3203 | 3703 | 3826 |
| 120 | 266 | 632 | 928 | 1144 | 1115 | 1656 | 2253 | 2168 | 1377 | 2680 | 2535 | 3192 | 2752 | 3704 | 3618 |
| 121 | 363 | 633 | 1116 | 1145 | 1334 | 1657 | 2475 | 2169 | 1608 | 2681 | 2754 | 3193 | 2972 | 3705 | 3728 |
| 122 | 385 | 634 | 1166 | 1146 | 1378 | 1658 | 2529 | 2170 | 1654 | 2682 | 2807 | 3194 | 3012 | 3706 | 3753 |
| 123 | 528 | 635 | 1384 | 1147 | 1653 | 1659 | 2762 | 2171 | 1930 | 2683 | 3018 | 3195 | 3238 | 3707 | 3847 |
| 124 | 405 | 636 | 1197 | 1148 | 1420 | 1660 | 2562 | 2172 | 1696 | 2684 | 2839 | 3196 | 3050 | 3708 | 3767 |
| 125 | 551 | 637 | 1439 | 1149 | 1695 | 1661 | 2816 | 2173 | 1970 | 2685 | 3066 | 3197 | 3269 | 3709 | 3867 |
| 126 | 593 | 638 | 1500 | 1150 | 1766 | 1662 | 2878 | 2174 | 2040 | 2686 | 3117 | 3198 | 3320 | 3710 | 3888 |
| 127 | 816 | 639 | 1799 | 1151 | 2107 | 1663 | 3142 | 2175 | 2386 | 2687 | 3343 | 3199 | 3535 | 3711 | 3966 |
| 128 | 17 | 640 | 120 | 1152 | 227 | 1664 | 714 | 2176 | 303 | 2688 | 912 | 3200 | 1270 | 3712 | 2239 |
| 129 | 27 | 641 | 230 | 1153 | 306 | 1665 | 1025 | 2177 | 401 | 2689 | 1276 | 3201 | 1475 | 3713 | 2651 |
| 130 | 33 | 642 | 251 | 1154 | 346 | 1666 | 1078 | 2178 | 451 | 2690 | 1336 | 3202 | 1568 | 3714 | 2712 |
| 131 | 77 | 643 | 409 | 1155 | 560 | 1667 | 1429 | 2179 | 722 | 2691 | 1706 | 3203 | 1984 | 3715 | 3058 |
| 132 | 42 | 644 | 279 | 1156 | 394 | 1668 | 1144 | 2180 | 519 | 2692 | 1410 | 3204 | 1673 | 3716 | 2784 |
| 133 | 84 | 645 | 426 | 1157 | 586 | 1669 | 1464 | 2181 | 753 | 2693 | 1740 | 3205 | 2028 | 3717 | 3088 |
| 134 | 88 | 646 | 455 | 1158 | 597 | 1670 | 1518 | 2182 | 772 | 2694 | 1796 | 3206 | 2050 | 3718 | 3132 |
| 135 | 147 | 647 | 626 | 1159 | 800 | 1671 | 1823 | 2183 | 1016 | 2695 | 2098 | 3207 | 2365 | 3719 | 3359 |
| 136 | 52 | 648 | 295 | 1160 | 444 | 1672 | 1179 | 2184 | 579 | 2696 | 1449 | 3208 | 1774 | 3720 | 2820 |
| 137 | 91 | 649 | 465 | 1161 | 611 | 1673 | 1537 | 2185 | 787 | 2697 | 1816 | 3209 | 2072 | 3721 | 3148 |
| 138 | 99 | 650 | 487 | 1162 | 643 | 1674 | 1580 | 2186 | 825 | 2698 | 1857 | 3210 | 2126 | 3722 | 3182 |
| 139 | 158 | 651 | 660 | 1163 | 831 | 1675 | 1875 | 2187 | 1053 | 2699 | 2154 | 3211 | 2407 | 3723 | 3393 |
| 140 | 109 | 652 | 510 | 1164 | 675 | 1676 | 1622 | 2188 | 865 | 2700 | 1899 | 3212 | 2177 | 3724 | 3215 |
| 141 | 170 | 653 | 676 | 1165 | 866 | 1677 | 1902 | 2189 | 1093 | 2701 | 2179 | 3213 | 2454 | 3725 | 3411 |
| 142 | 174 | 654 | 684 | 1166 | 879 | 1678 | 1916 | 2190 | 1107 | 2702 | 2193 | 3214 | 2471 | 3726 | 3419 |
| 143 | 273 | 655 | 897 | 1167 | 1129 | 1679 | 2213 | 2191 | 1394 | 2703 | 2495 | 3215 | 2767 | 3727 | 3596 |
| 144 | 60 | 656 | 328 | 1168 | 485 | 1680 | 1254 | 2192 | 628 | 2704 | 1528 | 3216 | 1852 | 3728 | 2896 |
| 145 | 100 | 657 | 500 | 1169 | 648 | 1681 | 1602 | 2193 | 829 | 2705 | 1880 | 3217 | 2134 | 3729 | 3199 |
| 146 | 111 | 658 | 529 | 1170 | 683 | 1682 | 1655 | 2194 | 874 | 2706 | 1932 | 3218 | 2191 | 3730 | 3240 |
| 147 | 172 | 659 | 686 | 1171 | 872 | 1683 | 1918 | 2195 | 1100 | 2707 | 2195 | 3219 | 2462 | 3731 | 3420 |
| 148 | 122 | 660 | 554 | 1172 | 721 | 1684 | 1700 | 2196 | 921 | 2708 | 1974 | 3220 | 2250 | 3732 | 3273 |
| 149 | 187 | 661 | 735 | 1173 | 915 | 1685 | 1995 | 2197 | 1148 | 2709 | 2270 | 3221 | 2518 | 3733 | 3468 |
| 150 | 204 | 662 | 759 | 1174 | 960 | 1686 | 2029 | 2198 | 1201 | 2710 | 2305 | 3222 | 2574 | 3734 | 3488 |
| 151 | 290 | 663 | 943 | 1175 | 1170 | 1687 | 2273 | 2199 | 1438 | 2711 | 2553 | 3223 | 2811 | 3735 | 3629 |
| 152 | 134 | 664 | 584 | 1176 | 757 | 1688 | 1753 | 2200 | 965 | 2712 | 2026 | 3224 | 2303 | 3736 | 3311 |
| 153 | 205 | 665 | 776 | 1177 | 963 | 1689 | 2053 | 2201 | 1204 | 2713 | 2331 | 3225 | 2577 | 3737 | 3503 |
| 154 | 216 | 666 | 809 | 1178 | 991 | 1690 | 2099 | 2202 | 1236 | 2714 | 2377 | 3226 | 2611 | 3738 | 3531 |
| 155 | 307 | 667 | 1007 | 1179 | 1205 | 1691 | 2348 | 2203 | 1478 | 2715 | 2631 | 3227 | 2847 | 3739 | 3667 |
| 156 | 241 | 668 | 842 | 1180 | 1055 | 1692 | 2143 | 2204 | 1310 | 2716 | 2423 | 3228 | 2686 | 3740 | 3557 |
| 157 | 326 | 669 | 1036 | 1181 | 1251 | 1693 | 2382 | 2205 | 1523 | 2717 | 2664 | 3229 | 2893 | 3741 | 3684 |
| 158 | 350 | 670 | 1084 | 1182 | 1305 | 1694 | 2439 | 2206 | 1578 | 2718 | 2719 | 3230 | 2945 | 3742 | 3711 |
| 159 | 491 | 671 | 1291 | 1183 | 1585 | 1695 | 2665 | 2207 | 1863 | 2719 | 2932 | 3231 | 3186 | 3743 | 3810 |
| 160 | 69 | 672 | 354 | 1184 | 522 | 1696 | 1314 | 2208 | 679 | 2720 | 1588 | 3232 | 1920 | 3744 | 2953 |
| 161 | 115 | 673 | 542 | 1185 | 698 | 1697 | 1677 | 2209 | 891 | 2721 | 1954 | 3233 | 2214 | 3745 | 3256 |
| 162 | 130 | 674 | 574 | 1186 | 746 | 1698 | 1734 | 2210 | 949 | 2722 | 2008 | 3234 | 2287 | 3746 | 3297 |
| 163 | 193 | 675 | 764 | 1187 | 931 | 1699 | 2037 | 2211 | 1168 | 2723 | 2313 | 3235 | 2538 | 3747 | 3493 |
| 164 | 136 | 676 | 617 | 1188 | 765 | 1700 | 1806 | 2212 | 973 | 2724 | 2082 | 3236 | 2314 | 3748 | 3348 |
| 165 | 206 | 677 | 802 | 1189 | 966 | 1701 | 2089 | 2213 | 1207 | 2725 | 2367 | 3237 | 2581 | 3749 | 3525 |
| 166 | 223 | 678 | 798 | 1190 | 1010 | 1702 | 2083 | 2214 | 1258 | 2726 | 2361 | 3238 | 2634 | 3750 | 3521 |
| 167 | 319 | 679 | 1039 | 1191 | 1237 | 1703 | 2387 | 2215 | 1507 | 2727 | 2667 | 3239 | 2879 | 3751 | 3687 |
| 168 | 156 | 680 | 635 | 1192 | 828 | 1704 | 1838 | 2216 | 1046 | 2728 | 2112 | 3240 | 2404 | 3752 | 3369 |
| 169 | 237 | 681 | 832 | 1193 | 1043 | 1705 | 2129 | 2217 | 1298 | 2729 | 2409 | 3241 | 2672 | 3753 | 3548 |
| 170 | 247 | 682 | 850 | 1194 | 1067 | 1706 | 2153 | 2218 | 1324 | 2730 | 2433 | 3242 | 2700 | 3754 | 3562 |
| 171 | 334 | 683 | 1074 | 1195 | 1269 | 1707 | 2427 | 2219 | 1543 | 2731 | 2708 | 3243 | 2911 | 3755 | 3706 |
| 172 | 265 | 684 | 906 | 1196 | 1112 | 1708 | 2226 | 2220 | 1374 | 2732 | 2506 | 3244 | 2749 | 3756 | 3603 |
| 173 | 362 | 685 | 1111 | 1197 | 1331 | 1709 | 2467 | 2221 | 1606 | 2733 | 2748 | 3245 | 2969 | 3757 | 3725 |
| 174 | 378 | 686 | 1133 | 1198 | 1363 | 1710 | 2492 | 2222 | 1640 | 2734 | 2772 | 3246 | 2998 | 3758 | 3736 |
| 175 | 525 | 687 | 1390 | 1199 | 1650 | 1711 | 2768 | 2223 | 1926 | 2735 | 3023 | 3247 | 3236 | 3759 | 3849 |
| 176 | 173 | 688 | 673 | 1200 | 876 | 1712 | 1898 | 2224 | 1103 | 2736 | 2175 | 3248 | 2468 | 3760 | 3408 |
| 177 | 257 | 689 | 869 | 1201 | 1091 | 1713 | 2178 | 2225 | 1351 | 2737 | 2459 | 3249 | 2726 | 3761 | 3577 |
| 178 | 275 | 690 | 923 | 1202 | 1136 | 1714 | 2247 | 2226 | 1399 | 2738 | 2528 | 3250 | 2775 | 3762 | 3615 |
| 179 | 369 | 691 | 1125 | 1203 | 1346 | 1715 | 2484 | 2227 | 1620 | 2739 | 2763 | 3251 | 2983 | 3763 | 3733 |
| 180 | 289 | 692 | 946 | 1204 | 1167 | 1716 | 2275 | 2228 | 1435 | 2740 | 2556 | 3252 | 2808 | 3764 | 3630 |
| 181 | 399 | 693 | 1180 | 1205 | 1409 | 1717 | 2544 | 2229 | 1685 | 2741 | 2821 | 3253 | 3040 | 3765 | 3759 |
| 182 | 408 | 694 | 1200 | 1206 | 1426 | 1718 | 2565 | 2230 | 1703 | 2742 | 2842 | 3254 | 3055 | 3766 | 3768 |
| 183 | 548 | 695 | 1448 | 1207 | 1688 | 1719 | 2828 | 2231 | 1964 | 2743 | 3074 | 3255 | 3264 | 3767 | 3871 |
| 184 | 315 | 696 | 983 | 1208 | 1222 | 1720 | 2321 | 2232 | 1497 | 2744 | 2602 | 3256 | 2864 | 3768 | 3654 |
| 185 | 421 | 697 | 1224 | 1209 | 1452 | 1721 | 2591 | 2233 | 1729 | 2745 | 2866 | 3257 | 3077 | 3769 | 3779 |
| 186 | 453 | 698 | 1262 | 1210 | 1514 | 1722 | 2636 | 2234 | 1792 | 2746 | 2903 | 3258 | 3129 | 3770 | 3798 |
| 187 | 582 | 699 | 1519 | 1211 | 1748 | 1723 | 2894 | 2235 | 2022 | 2747 | 3133 | 3259 | 3307 | 3771 | 3893 |
| 188 | 477 | 700 | 1338 | 1212 | 1560 | 1724 | 2716 | 2236 | 1837 | 2748 | 2976 | 3260 | 3167 | 3772 | 3830 |
| 189 | 613 | 701 | 1575 | 1213 | 1801 | 1725 | 2947 | 2237 | 2076 | 2749 | 3179 | 3261 | 3344 | 3773 | 3910 |
| 190 | 681 | 702 | 1643 | 1214 | 1910 | 1726 | 3009 | 2238 | 2187 | 2750 | 3231 | 3262 | 3415 | 3774 | 3930 |
| 191 | 817 | 703 | 1925 | 1215 | 2109 | 1727 | 3239 | 2239 | 2388 | 2751 | 3425 | 3263 | 3537 | 3775 | 3991 |
| 192 | 73 | 704 | 375 | 1216 | 541 | 1728 | 1358 | 2240 | 701 | 2752 | 1632 | 3264 | 1952 | 3776 | 2994 |
| 193 | 132 | 705 | 592 | 1217 | 754 | 1729 | 1764 | 2241 | 957 | 2753 | 2038 | 3265 | 2298 | 3777 | 3319 |
| 194 | 151 | 706 | 620 | 1218 | 810 | 1730 | 1812 | 2242 | 1027 | 2754 | 2088 | 3266 | 2379 | 3778 | 3351 |
| 195 | 226 | 707 | 836 | 1219 | 1018 | 1731 | 2135 | 2243 | 1267 | 2755 | 2414 | 3267 | 2643 | 3779 | 3552 |
| 196 | 168 | 708 | 654 | 1220 | 862 | 1732 | 1868 | 2244 | 1086 | 2756 | 2144 | 3268 | 2449 | 3780 | 3388 |
| 197 | 244 | 709 | 860 | 1221 | 1060 | 1733 | 2167 | 2245 | 1316 | 2757 | 2447 | 3269 | 2692 | 3781 | 3571 |
| 198 | 264 | 710 | 907 | 1222 | 1109 | 1734 | 2228 | 2246 | 1371 | 2758 | 2508 | 3270 | 2746 | 3782 | 3604 |
| 199 | 367 | 711 | 1119 | 1223 | 1340 | 1735 | 2477 | 2247 | 1615 | 2759 | 2757 | 3271 | 2977 | 3783 | 3729 |
| 200 | 178 | 712 | 731 | 1224 | 892 | 1736 | 1989 | 2248 | 1121 | 2760 | 2265 | 3272 | 2488 | 3784 | 3464 |
| 201 | 267 | 713 | 926 | 1225 | 1118 | 1737 | 2249 | 2249 | 1379 | 2761 | 2531 | 3273 | 2755 | 3785 | 3616 |
| 202 | 281 | 714 | 962 | 1226 | 1147 | 1738 | 2295 | 2250 | 1413 | 2762 | 2576 | 3274 | 2787 | 3786 | 3640 |
| 203 | 390 | 715 | 1189 | 1227 | 1389 | 1739 | 2554 | 2251 | 1666 | 2763 | 2830 | 3275 | 3022 | 3787 | 3764 |
| 204 | 297 | 716 | 968 | 1228 | 1184 | 1740 | 2304 | 2252 | 1454 | 2764 | 2584 | 3276 | 2826 | 3788 | 3645 |
| 205 | 407 | 717 | 1206 | 1229 | 1423 | 1741 | 2572 | 2253 | 1701 | 2765 | 2848 | 3277 | 3052 | 3789 | 3772 |
| 206 | 432 | 718 | 1244 | 1230 | 1476 | 1742 | 2614 | 2254 | 1751 | 2766 | 2886 | 3278 | 3097 | 3790 | 3789 |
| 207 | 571 | 719 | 1488 | 1231 | 1730 | 1743 | 2865 | 2255 | 2004 | 2767 | 3108 | 3279 | 3295 | 3791 | 3884 |
| 208 | 202 | 720 | 747 | 1232 | 954 | 1744 | 2013 | 2256 | 1195 | 2768 | 2289 | 3280 | 2566 | 3792 | 3478 |
| 209 | 293 | 721 | 964 | 1233 | 1173 | 1745 | 2297 | 2257 | 1443 | 2769 | 2579 | 3281 | 2814 | 3793 | 3641 |
| 210 | 308 | 722 | 980 | 1234 | 1208 | 1746 | 2317 | 2258 | 1481 | 2770 | 2599 | 3282 | 2850 | 3794 | 3651 |
| 211 | 418 | 723 | 1235 | 1235 | 1447 | 1747 | 2606 | 2259 | 1724 | 2771 | 2877 | 3283 | 3073 | 3795 | 3786 |
| 212 | 332 | 724 | 1041 | 1236 | 1266 | 1748 | 2389 | 2260 | 1538 | 2772 | 2670 | 3284 | 2908 | 3796 | 3688 |
| 213 | 447 | 725 | 1259 | 1237 | 1503 | 1749 | 2630 | 2261 | 1780 | 2773 | 2901 | 3285 | 3120 | 3797 | 3796 |
| 214 | 473 | 726 | 1318 | 1238 | 1554 | 1750 | 2696 | 2262 | 1831 | 2774 | 2958 | 3286 | 3161 | 3798 | 3822 |
| 215 | 624 | 727 | 1564 | 1239 | 1817 | 1751 | 2937 | 2263 | 2094 | 2775 | 3169 | 3287 | 3355 | 3799 | 3907 |
| 216 | 344 | 728 | 1095 | 1240 | 1293 | 1752 | 2451 | 2264 | 1566 | 2776 | 2731 | 3288 | 2934 | 3800 | 3717 |
| 217 | 480 | 729 | 1335 | 1241 | 1565 | 1753 | 2713 | 2265 | 1844 | 2777 | 2973 | 3289 | 3171 | 3801 | 3829 |
| 218 | 507 | 730 | 1364 | 1242 | 1616 | 1754 | 2741 | 2266 | 1892 | 2778 | 3000 | 3290 | 3210 | 3802 | 3839 |
| 219 | 650 | 731 | 1595 | 1243 | 1862 | 1755 | 2964 | 2267 | 2138 | 2779 | 3194 | 3291 | 3385 | 3803 | 3916 |
| 220 | 535 | 732 | 1414 | 1244 | 1667 | 1756 | 2791 | 2268 | 1942 | 2780 | 3044 | 3292 | 3249 | 3804 | 3858 |
| 221 | 693 | 733 | 1676 | 1245 | 1929 | 1757 | 3034 | 2269 | 2206 | 2781 | 3255 | 3293 | 3428 | 3805 | 3937 |
| 222 | 719 | 734 | 1721 | 1246 | 1969 | 1758 | 3075 | 2270 | 2246 | 2782 | 3288 | 3294 | 3452 | 3806 | 3949 |
| 223 | 942 | 735 | 1977 | 1247 | 2271 | 1759 | 3280 | 2271 | 2551 | 2783 | 3457 | 3295 | 3627 | 3807 | 4000 |
| 224 | 222 | 736 | 778 | 1248 | 1006 | 1760 | 2055 | 2272 | 1255 | 2784 | 2333 | 3296 | 2629 | 3808 | 3505 |
| 225 | 321 | 737 | 1056 | 1249 | 1240 | 1761 | 2408 | 2273 | 1512 | 2785 | 2687 | 3297 | 2882 | 3809 | 3697 |
| 226 | 338 | 738 | 1080 | 1250 | 1278 | 1762 | 2434 | 2274 | 1551 | 2786 | 2714 | 3298 | 2919 | 3810 | 3709 |
| 227 | 457 | 739 | 1294 | 1251 | 1522 | 1763 | 2668 | 2275 | 1800 | 2787 | 2935 | 3299 | 3136 | 3811 | 3811 |
| 228 | 371 | 740 | 1134 | 1252 | 1349 | 1764 | 2497 | 2276 | 1625 | 2788 | 2774 | 3300 | 2986 | 3812 | 3738 |
| 229 | 488 | 741 | 1344 | 1253 | 1582 | 1765 | 2721 | 2277 | 1859 | 2789 | 2982 | 3301 | 3184 | 3813 | 3832 |
| 230 | 511 | 742 | 1373 | 1254 | 1624 | 1766 | 2753 | 2278 | 1901 | 2790 | 3008 | 3302 | 3216 | 3814 | 3844 |
| 231 | 672 | 743 | 1626 | 1255 | 1896 | 1767 | 2992 | 2279 | 2174 | 2791 | 3218 | 3303 | 3407 | 3815 | 3924 |
| 232 | 404 | 744 | 1169 | 1256 | 1418 | 1768 | 2532 | 2280 | 1694 | 2792 | 2810 | 3304 | 3048 | 3816 | 3754 |
| 233 | 521 | 745 | 1407 | 1257 | 1641 | 1769 | 2785 | 2281 | 1917 | 2793 | 3039 | 3305 | 3229 | 3817 | 3856 |
| 234 | 549 | 746 | 1453 | 1258 | 1691 | 1770 | 2831 | 2282 | 1966 | 2794 | 3078 | 3306 | 3267 | 3818 | 3872 |
| 235 | 708 | 747 | 1704 | 1259 | 1953 | 1771 | 3060 | 2283 | 2229 | 2795 | 3276 | 3307 | 3442 | 3819 | 3944 |
| 236 | 583 | 748 | 1505 | 1260 | 1750 | 1772 | 2881 | 2284 | 2024 | 2796 | 3121 | 3308 | 3309 | 3820 | 3889 |
| 237 | 724 | 749 | 1752 | 1261 | 1979 | 1773 | 3102 | 2285 | 2254 | 2797 | 3310 | 3309 | 3458 | 3821 | 3956 |
| 238 | 785 | 750 | 1819 | 1262 | 2067 | 1774 | 3158 | 2286 | 2343 | 2798 | 3356 | 3310 | 3512 | 3822 | 3971 |
| 239 | 1011 | 751 | 2087 | 1263 | 2355 | 1775 | 3363 | 2287 | 2635 | 2799 | 3524 | 3311 | 3671 | 3823 | 4018 |
| 240 | 431 | 752 | 1268 | 1264 | 1472 | 1776 | 2641 | 2288 | 1749 | 2800 | 2909 | 3312 | 3095 | 3824 | 3800 |
| 241 | 561 | 753 | 1460 | 1265 | 1711 | 1777 | 2837 | 2289 | 1986 | 2801 | 3084 | 3313 | 3281 | 3825 | 3874 |
| 242 | 595 | 754 | 1524 | 1266 | 1770 | 1778 | 2897 | 2290 | 2044 | 2802 | 3137 | 3314 | 3322 | 3826 | 3894 |
| 243 | 756 | 755 | 1768 | 1267 | 2027 | 1779 | 3114 | 2291 | 2302 | 2803 | 3321 | 3315 | 3487 | 3827 | 3959 |
| 244 | 609 | 756 | 1584 | 1268 | 1795 | 1780 | 2954 | 2292 | 2070 | 2804 | 3185 | 3316 | 3340 | 3828 | 3913 |
| 245 | 805 | 757 | 1841 | 1269 | 2093 | 1781 | 3174 | 2293 | 2372 | 2805 | 3371 | 3317 | 3527 | 3829 | 3975 |
| 246 | 833 | 758 | 1872 | 1270 | 2131 | 1782 | 3200 | 2294 | 2411 | 2806 | 3391 | 3318 | 3550 | 3830 | 3981 |
| 247 | 1072 | 759 | 2182 | 1271 | 2424 | 1783 | 3427 | 2295 | 2705 | 2807 | 3579 | 3319 | 3705 | 3831 | 4030 |
| 248 | 677 | 760 | 1631 | 1272 | 1904 | 1784 | 2995 | 2296 | 2181 | 2808 | 3222 | 3320 | 3412 | 3832 | 3925 |
| 249 | 848 | 761 | 1900 | 1273 | 2151 | 1785 | 3221 | 2297 | 2430 | 2809 | 3409 | 3321 | 3561 | 3833 | 3986 |
| 250 | 880 | 762 | 1951 | 1274 | 2192 | 1786 | 3261 | 2298 | 2473 | 2810 | 3441 | 3322 | 3585 | 3834 | 3996 |
| 251 | 1059 | 763 | 2224 | 1275 | 2410 | 1787 | 3461 | 2299 | 2691 | 2811 | 3602 | 3323 | 3698 | 3835 | 4036 |
| 252 | 914 | 764 | 2025 | 1276 | 2236 | 1788 | 3313 | 2300 | 2516 | 2812 | 3486 | 3324 | 3609 | 3836 | 4007 |
| 253 | 1122 | 765 | 2299 | 1277 | 2480 | 1789 | 3510 | 2301 | 2760 | 2813 | 3642 | 3325 | 3731 | 3837 | 4044 |
| 254 | 1203 | 766 | 2394 | 1278 | 2570 | 1790 | 3569 | 2302 | 2845 | 2814 | 3690 | 3326 | 3771 | 3838 | 4054 |
| 255 | 1479 | 767 | 2688 | 1279 | 2856 | 1791 | 3740 | 2303 | 3100 | 2815 | 3819 | 3327 | 3880 | 3839 | 4075 |
| 256 | 22 | 768 | 137 | 1280 | 270 | 1792 | 769 | 2304 | 355 | 2816 | 977 | 3328 | 1385 | 3840 | 2320 |
| 257 | 39 | 769 | 263 | 1281 | 382 | 1793 | 1106 | 2305 | 497 | 2817 | 1368 | 3329 | 1649 | 3841 | 2743 |
| 258 | 44 | 770 | 287 | 1282 | 406 | 1794 | 1161 | 2306 | 532 | 2818 | 1430 | 3330 | 1699 | 3842 | 2802 |
| 259 | 97 | 771 | 466 | 1283 | 636 | 1795 | 1540 | 2307 | 815 | 2819 | 1818 | 3331 | 2114 | 3843 | 3151 |
| 260 | 53 | 772 | 324 | 1284 | 449 | 1796 | 1248 | 2308 | 585 | 2820 | 1520 | 3332 | 1785 | 3844 | 2890 |
| 261 | 101 | 773 | 496 | 1285 | 652 | 1797 | 1597 | 2309 | 834 | 2821 | 1874 | 3333 | 2140 | 3845 | 3196 |
| 262 | 113 | 774 | 524 | 1286 | 691 | 1798 | 1646 | 2310 | 883 | 2822 | 1924 | 3334 | 2202 | 3846 | 3233 |
| 263 | 186 | 775 | 715 | 1287 | 911 | 1799 | 1965 | 2311 | 1145 | 2823 | 2240 | 3335 | 2513 | 3847 | 3449 |
| 264 | 54 | 776 | 336 | 1288 | 454 | 1800 | 1272 | 2312 | 591 | 2824 | 1546 | 3336 | 1794 | 3848 | 2913 |
| 265 | 114 | 777 | 534 | 1289 | 694 | 1801 | 1663 | 2313 | 887 | 2825 | 1940 | 3337 | 2208 | 3849 | 3246 |
| 266 | 125 | 778 | 562 | 1290 | 733 | 1802 | 1714 | 2314 | 933 | 2826 | 1988 | 3338 | 2267 | 3850 | 3283 |
| 267 | 196 | 779 | 739 | 1291 | 940 | 1803 | 2001 | 2315 | 1178 | 2827 | 2276 | 3339 | 2550 | 3851 | 3471 |
| 268 | 138 | 780 | 590 | 1292 | 773 | 1804 | 1761 | 2316 | 981 | 2828 | 2036 | 3340 | 2325 | 3852 | 3316 |
| 269 | 218 | 781 | 770 | 1293 | 996 | 1805 | 2045 | 2317 | 1242 | 2829 | 2322 | 3341 | 2618 | 3853 | 3498 |
| 270 | 228 | 782 | 819 | 1294 | 1022 | 1806 | 2113 | 2318 | 1273 | 2830 | 2391 | 3342 | 2648 | 3854 | 3539 |
| 271 | 348 | 783 | 1087 | 1295 | 1299 | 1807 | 2441 | 2319 | 1573 | 2831 | 2722 | 3343 | 2939 | 3855 | 3713 |
| 272 | 68 | 784 | 368 | 1296 | 517 | 1808 | 1343 | 2320 | 674 | 2832 | 1618 | 3344 | 1911 | 3856 | 2980 |
| 273 | 126 | 785 | 577 | 1297 | 736 | 1809 | 1739 | 2321 | 937 | 2833 | 2014 | 3345 | 2272 | 3857 | 3301 |
| 274 | 139 | 786 | 625 | 1298 | 775 | 1810 | 1821 | 2322 | 985 | 2834 | 2096 | 3346 | 2329 | 3858 | 3357 |
| 275 | 232 | 787 | 793 | 1299 | 1030 | 1811 | 2077 | 2323 | 1283 | 2835 | 2354 | 3347 | 2658 | 3859 | 3518 |
| 276 | 153 | 788 | 646 | 1300 | 818 | 1812 | 1855 | 2324 | 1035 | 2836 | 2130 | 3348 | 2390 | 3860 | 3380 |
| 277 | 240 | 789 | 858 | 1301 | 1052 | 1813 | 2163 | 2325 | 1307 | 2837 | 2444 | 3349 | 2683 | 3861 | 3568 |
| 278 | 254 | 790 | 844 | 1302 | 1085 | 1814 | 2145 | 2326 | 1345 | 2838 | 2425 | 3350 | 2720 | 3862 | 3558 |
| 279 | 349 | 791 | 1101 | 1303 | 1302 | 1815 | 2458 | 2327 | 1576 | 2839 | 2737 | 3351 | 2942 | 3863 | 3720 |
| 280 | 162 | 792 | 663 | 1304 | 845 | 1816 | 1881 | 2328 | 1068 | 2840 | 2158 | 3352 | 2426 | 3864 | 3397 |
| 281 | 252 | 793 | 877 | 1305 | 1083 | 1817 | 2188 | 2329 | 1339 | 2841 | 2469 | 3353 | 2717 | 3865 | 3582 |
| 282 | 272 | 794 | 913 | 1306 | 1126 | 1818 | 2234 | 2330 | 1391 | 2842 | 2515 | 3354 | 2764 | 3866 | 3608 |
| 283 | 383 | 795 | 1160 | 1307 | 1375 | 1819 | 2522 | 2331 | 1652 | 2843 | 2801 | 3355 | 3010 | 3867 | 3749 |
| 284 | 294 | 796 | 958 | 1308 | 1176 | 1820 | 2290 | 2332 | 1446 | 2844 | 2571 | 3356 | 2817 | 3868 | 3638 |
| 285 | 403 | 797 | 1183 | 1309 | 1415 | 1821 | 2547 | 2333 | 1692 | 2845 | 2824 | 3357 | 3046 | 3869 | 3761 |
| 286 | 413 | 798 | 1215 | 1310 | 1436 | 1822 | 2580 | 2334 | 1713 | 2846 | 2857 | 3358 | 3063 | 3870 | 3775 |
| 287 | 547 | 799 | 1474 | 1311 | 1686 | 1823 | 2853 | 2335 | 1962 | 2847 | 3096 | 3359 | 3263 | 3871 | 3879 |
| 288 | 71 | 800 | 439 | 1312 | 531 | 1824 | 1487 | 2336 | 690 | 2848 | 1765 | 3360 | 1936 | 3872 | 3107 |
| 289 | 150 | 801 | 637 | 1313 | 808 | 1825 | 1840 | 2337 | 1024 | 2849 | 2116 | 3361 | 2375 | 3873 | 3370 |
| 290 | 164 | 802 | 665 | 1314 | 851 | 1826 | 1885 | 2338 | 1075 | 2850 | 2162 | 3362 | 2435 | 3874 | 3399 |
| 291 | 234 | 803 | 857 | 1315 | 1037 | 1827 | 2161 | 2339 | 1289 | 2851 | 2442 | 3363 | 2666 | 3875 | 3567 |
| 292 | 182 | 804 | 730 | 1316 | 902 | 1828 | 1987 | 2340 | 1135 | 2852 | 2263 | 3364 | 2501 | 3876 | 3463 |
| 293 | 258 | 805 | 901 | 1317 | 1094 | 1829 | 2219 | 2341 | 1354 | 2853 | 2500 | 3365 | 2729 | 3877 | 3600 |
| 294 | 276 | 806 | 932 | 1318 | 1139 | 1830 | 2258 | 2342 | 1402 | 2854 | 2540 | 3366 | 2778 | 3878 | 3621 |
| 295 | 402 | 807 | 1192 | 1319 | 1412 | 1831 | 2557 | 2343 | 1689 | 2855 | 2833 | 3367 | 3043 | 3879 | 3765 |
| 296 | 192 | 808 | 738 | 1320 | 927 | 1832 | 1999 | 2344 | 1165 | 2856 | 2274 | 3368 | 2533 | 3880 | 3470 |
| 297 | 286 | 809 | 959 | 1321 | 1159 | 1833 | 2292 | 2345 | 1427 | 2857 | 2573 | 3369 | 2799 | 3881 | 3639 |
| 298 | 298 | 810 | 974 | 1322 | 1187 | 1834 | 2310 | 2346 | 1457 | 2858 | 2590 | 3370 | 2829 | 3882 | 3648 |
| 299 | 415 | 811 | 1218 | 1323 | 1440 | 1835 | 2585 | 2347 | 1717 | 2859 | 2860 | 3371 | 3067 | 3883 | 3777 |
| 300 | 311 | 812 | 998 | 1324 | 1216 | 1836 | 2337 | 2348 | 1489 | 2860 | 2619 | 3372 | 2858 | 3884 | 3662 |
| 301 | 445 | 813 | 1247 | 1325 | 1498 | 1837 | 2620 | 2349 | 1776 | 2861 | 2889 | 3373 | 3116 | 3885 | 3791 |
| 302 | 463 | 814 | 1277 | 1326 | 1534 | 1838 | 2649 | 2350 | 1811 | 2862 | 2918 | 3374 | 3145 | 3886 | 3804 |
| 303 | 607 | 815 | 1547 | 1327 | 1790 | 1839 | 2920 | 2351 | 2066 | 2863 | 3156 | 3375 | 3336 | 3887 | 3902 |
| 304 | 191 | 816 | 749 | 1328 | 924 | 1840 | 2015 | 2352 | 1162 | 2864 | 2291 | 3376 | 2530 | 3888 | 3480 |
| 305 | 309 | 817 | 990 | 1329 | 1210 | 1841 | 2328 | 2353 | 1483 | 2865 | 2610 | 3377 | 2852 | 3889 | 3657 |
| 306 | 323 | 818 | 1029 | 1330 | 1245 | 1842 | 2376 | 2354 | 1517 | 2866 | 2656 | 3378 | 2887 | 3890 | 3681 |
| 307 | 442 | 819 | 1274 | 1331 | 1495 | 1843 | 2646 | 2355 | 1772 | 2867 | 2915 | 3379 | 3113 | 3891 | 3802 |
| 308 | 343 | 820 | 1092 | 1332 | 1290 | 1844 | 2448 | 2356 | 1563 | 2868 | 2728 | 3380 | 2931 | 3892 | 3716 |
| 309 | 476 | 821 | 1315 | 1333 | 1557 | 1845 | 2693 | 2357 | 1835 | 2869 | 2955 | 3381 | 3164 | 3893 | 3821 |
| 310 | 493 | 822 | 1356 | 1334 | 1590 | 1846 | 2736 | 2358 | 1867 | 2870 | 2993 | 3382 | 3190 | 3894 | 3837 |
| 311 | 653 | 823 | 1600 | 1335 | 1864 | 1847 | 2971 | 2359 | 2142 | 2871 | 3198 | 3383 | 3386 | 3895 | 3918 |
| 312 | 373 | 824 | 1127 | 1336 | 1355 | 1848 | 2487 | 2360 | 1630 | 2872 | 2766 | 3384 | 2991 | 3896 | 3734 |
| 313 | 515 | 825 | 1397 | 1337 | 1629 | 1849 | 2776 | 2361 | 1907 | 2873 | 3029 | 3385 | 3220 | 3897 | 3852 |
| 314 | 537 | 826 | 1411 | 1338 | 1669 | 1850 | 2788 | 2362 | 1946 | 2874 | 3041 | 3386 | 3250 | 3898 | 3857 |
| 315 | 692 | 827 | 1679 | 1339 | 1927 | 1851 | 3038 | 2363 | 2204 | 2875 | 3258 | 3387 | 3426 | 3899 | 3938 |
| 316 | 558 | 828 | 1456 | 1340 | 1709 | 1852 | 2834 | 2364 | 1982 | 2876 | 3081 | 3388 | 3279 | 3900 | 3873 |
| 317 | 716 | 829 | 1727 | 1341 | 1967 | 1853 | 3079 | 2365 | 2242 | 2877 | 3292 | 3389 | 3451 | 3901 | 3950 |
| 318 | 762 | 830 | 1782 | 1342 | 2035 | 1854 | 3126 | 2366 | 2311 | 2878 | 3331 | 3390 | 3492 | 3902 | 3962 |
| 319 | 992 | 831 | 2051 | 1343 | 2332 | 1855 | 3337 | 2367 | 2613 | 2879 | 3502 | 3391 | 3659 | 3903 | 4012 |
| 320 | 83 | 832 | 450 | 1344 | 581 | 1856 | 1509 | 2368 | 748 | 2880 | 1787 | 3392 | 2020 | 3904 | 3125 |
| 321 | 176 | 833 | 728 | 1345 | 885 | 1857 | 1983 | 2369 | 1114 | 2881 | 2259 | 3393 | 2479 | 3905 | 3460 |
| 322 | 184 | 834 | 734 | 1346 | 905 | 1858 | 1993 | 2370 | 1138 | 2882 | 2268 | 3394 | 2505 | 3906 | 3466 |
| 323 | 283 | 835 | 948 | 1347 | 1153 | 1859 | 2277 | 2371 | 1419 | 2883 | 2559 | 3395 | 2793 | 3907 | 3631 |
| 324 | 200 | 836 | 751 | 1348 | 950 | 1860 | 2017 | 2372 | 1188 | 2884 | 2294 | 3396 | 2561 | 3908 | 3481 |
| 325 | 304 | 837 | 967 | 1349 | 1199 | 1861 | 2301 | 2373 | 1470 | 2885 | 2582 | 3397 | 2841 | 3909 | 3643 |
| 326 | 322 | 838 | 1004 | 1350 | 1243 | 1862 | 2346 | 2374 | 1515 | 2886 | 2627 | 3398 | 2885 | 3910 | 3666 |
| 327 | 436 | 839 | 1256 | 1351 | 1480 | 1863 | 2628 | 2375 | 1758 | 2887 | 2898 | 3399 | 3101 | 3911 | 3795 |
| 328 | 210 | 840 | 781 | 1352 | 975 | 1864 | 2061 | 2376 | 1220 | 2888 | 2338 | 3400 | 2592 | 3912 | 3508 |
| 329 | 329 | 841 | 1044 | 1353 | 1257 | 1865 | 2392 | 2377 | 1530 | 2889 | 2673 | 3401 | 2899 | 3913 | 3689 |
| 330 | 337 | 842 | 1077 | 1354 | 1275 | 1866 | 2429 | 2378 | 1548 | 2890 | 2711 | 3402 | 2916 | 3914 | 3707 |
| 331 | 472 | 843 | 1303 | 1355 | 1552 | 1867 | 2679 | 2379 | 1829 | 2891 | 2943 | 3403 | 3160 | 3915 | 3816 |
| 332 | 357 | 844 | 1113 | 1356 | 1320 | 1868 | 2472 | 2380 | 1593 | 2892 | 2751 | 3404 | 2959 | 3916 | 3727 |
| 333 | 501 | 845 | 1347 | 1357 | 1605 | 1869 | 2724 | 2381 | 1882 | 2893 | 2984 | 3405 | 3202 | 3917 | 3833 |
| 334 | 520 | 846 | 1404 | 1358 | 1638 | 1870 | 2782 | 2382 | 1915 | 2894 | 3036 | 3406 | 3227 | 3918 | 3855 |
| 335 | 688 | 847 | 1662 | 1359 | 1921 | 1871 | 3024 | 2383 | 2199 | 2895 | 3245 | 3407 | 3423 | 3919 | 3934 |
| 336 | 269 | 848 | 920 | 1360 | 1120 | 1872 | 2245 | 2384 | 1382 | 2896 | 2525 | 3408 | 2758 | 3920 | 3614 |
| 337 | 351 | 849 | 1090 | 1361 | 1308 | 1873 | 2446 | 2385 | 1581 | 2897 | 2725 | 3409 | 2948 | 3921 | 3715 |
| 338 | 372 | 850 | 1137 | 1362 | 1352 | 1874 | 2499 | 2386 | 1628 | 2898 | 2777 | 3410 | 2989 | 3922 | 3739 |
| 339 | 506 | 851 | 1361 | 1363 | 1614 | 1875 | 2738 | 2387 | 1890 | 2899 | 2997 | 3411 | 3209 | 3923 | 3838 |
| 340 | 392 | 852 | 1171 | 1364 | 1395 | 1876 | 2534 | 2388 | 1671 | 2900 | 2813 | 3412 | 3028 | 3924 | 3755 |
| 341 | 533 | 853 | 1431 | 1365 | 1660 | 1877 | 2809 | 2389 | 1938 | 2901 | 3059 | 3413 | 3244 | 3925 | 3864 |
| 342 | 557 | 854 | 1463 | 1366 | 1705 | 1878 | 2840 | 2390 | 1980 | 2902 | 3086 | 3414 | 3277 | 3926 | 3875 |
| 343 | 712 | 855 | 1712 | 1367 | 1959 | 1879 | 3068 | 2391 | 2235 | 2903 | 3282 | 3415 | 3446 | 3927 | 3946 |
| 344 | 424 | 856 | 1253 | 1368 | 1458 | 1880 | 2625 | 2392 | 1735 | 2904 | 2895 | 3416 | 3082 | 3928 | 3794 |
| 345 | 565 | 857 | 1468 | 1369 | 1720 | 1881 | 2843 | 2393 | 1994 | 2905 | 3091 | 3417 | 3287 | 3929 | 3876 |
| 346 | 600 | 858 | 1527 | 1370 | 1779 | 1882 | 2900 | 2394 | 2054 | 2906 | 3140 | 3418 | 3329 | 3930 | 3895 |
| 347 | 752 | 859 | 1771 | 1371 | 2021 | 1883 | 3118 | 2395 | 2296 | 2907 | 3324 | 3419 | 3483 | 3931 | 3960 |
| 348 | 629 | 860 | 1587 | 1372 | 1827 | 1884 | 2957 | 2396 | 2102 | 2908 | 3188 | 3420 | 3361 | 3932 | 3914 |
| 349 | 803 | 861 | 1836 | 1373 | 2091 | 1885 | 3170 | 2397 | 2368 | 2909 | 3367 | 3421 | 3526 | 3933 | 3974 |
| 350 | 837 | 862 | 1866 | 1374 | 2137 | 1886 | 3195 | 2398 | 2416 | 2910 | 3387 | 3422 | 3553 | 3934 | 3980 |
| 351 | 1048 | 863 | 2173 | 1375 | 2399 | 1887 | 3421 | 2399 | 2678 | 2911 | 3574 | 3423 | 3692 | 3935 | 4029 |
| 352 | 302 | 864 | 971 | 1376 | 1196 | 1888 | 2306 | 2400 | 1467 | 2912 | 2587 | 3424 | 2838 | 3936 | 3646 |
| 353 | 387 | 865 | 1177 | 1377 | 1383 | 1889 | 2542 | 2401 | 1659 | 2913 | 2818 | 3425 | 3017 | 3937 | 3758 |
| 354 | 417 | 866 | 1232 | 1378 | 1444 | 1890 | 2604 | 2402 | 1722 | 2914 | 2874 | 3426 | 3070 | 3938 | 3785 |
| 355 | 544 | 867 | 1434 | 1379 | 1683 | 1891 | 2812 | 2403 | 1958 | 2915 | 3062 | 3427 | 3260 | 3939 | 3865 |
| 356 | 441 | 868 | 1271 | 1380 | 1492 | 1892 | 2644 | 2404 | 1769 | 2916 | 2912 | 3428 | 3111 | 3940 | 3801 |
| 357 | 580 | 869 | 1511 | 1381 | 1744 | 1893 | 2888 | 2405 | 2018 | 2917 | 3127 | 3429 | 3305 | 3941 | 3891 |
| 358 | 603 | 870 | 1555 | 1382 | 1784 | 1894 | 2927 | 2406 | 2060 | 2918 | 3163 | 3430 | 3333 | 3942 | 3904 |
| 359 | 788 | 871 | 1793 | 1383 | 2069 | 1895 | 3138 | 2407 | 2347 | 2919 | 3339 | 3431 | 3513 | 3943 | 3965 |
| 360 | 468 | 872 | 1326 | 1384 | 1544 | 1896 | 2701 | 2408 | 1820 | 2920 | 2965 | 3432 | 3153 | 3944 | 3824 |
| 361 | 618 | 873 | 1570 | 1385 | 1808 | 1897 | 2944 | 2409 | 2084 | 2921 | 3175 | 3433 | 3349 | 3945 | 3909 |
| 362 | 638 | 874 | 1609 | 1386 | 1843 | 1898 | 2978 | 2410 | 2118 | 2922 | 3205 | 3434 | 3372 | 3946 | 3920 |
| 363 | 813 | 875 | 1860 | 1387 | 2105 | 1899 | 3191 | 2411 | 2383 | 2923 | 3383 | 3435 | 3534 | 3947 | 3979 |
| 364 | 682 | 876 | 1657 | 1388 | 1912 | 1900 | 3020 | 2412 | 2189 | 2924 | 3241 | 3436 | 3417 | 3948 | 3933 |
| 365 | 863 | 877 | 1906 | 1389 | 2169 | 1901 | 3225 | 2413 | 2450 | 2925 | 3413 | 3437 | 3572 | 3949 | 3987 |
| 366 | 893 | 878 | 1971 | 1390 | 2209 | 1902 | 3275 | 2414 | 2490 | 2926 | 3453 | 3438 | 3594 | 3950 | 3999 |
| 367 | 1102 | 879 | 2251 | 1391 | 2460 | 1903 | 3479 | 2415 | 2739 | 2927 | 3617 | 3439 | 3722 | 3951 | 4039 |
| 368 | 509 | 880 | 1370 | 1392 | 1619 | 1904 | 2747 | 2416 | 1897 | 2928 | 3005 | 3440 | 3213 | 3952 | 3842 |
| 369 | 680 | 881 | 1634 | 1393 | 1908 | 1905 | 2999 | 2417 | 2185 | 2929 | 3224 | 3441 | 3414 | 3953 | 3926 |
| 370 | 696 | 882 | 1690 | 1394 | 1933 | 1906 | 3049 | 2418 | 2210 | 2930 | 3265 | 3442 | 3430 | 3954 | 3941 |
| 371 | 881 | 883 | 1945 | 1395 | 2194 | 1907 | 3257 | 2419 | 2474 | 2931 | 3437 | 3443 | 3586 | 3955 | 3995 |
| 372 | 713 | 884 | 1743 | 1396 | 1961 | 1908 | 3094 | 2420 | 2237 | 2932 | 3304 | 3444 | 3447 | 3956 | 3954 |
| 373 | 916 | 885 | 1991 | 1397 | 2238 | 1909 | 3289 | 2421 | 2520 | 2933 | 3465 | 3445 | 3610 | 3957 | 4002 |
| 374 | 871 | 886 | 2047 | 1398 | 2180 | 1910 | 3332 | 2422 | 2461 | 2934 | 3499 | 3446 | 3578 | 3958 | 4011 |
| 375 | 1140 | 887 | 2319 | 1399 | 2502 | 1911 | 3523 | 2423 | 2780 | 2935 | 3653 | 3447 | 3741 | 3959 | 4046 |
| 376 | 771 | 888 | 1804 | 1400 | 2048 | 1912 | 3146 | 2424 | 2324 | 2936 | 3346 | 3448 | 3500 | 3960 | 3967 |
| 377 | 986 | 889 | 2073 | 1401 | 2323 | 1913 | 3352 | 2425 | 2605 | 2937 | 3515 | 3449 | 3655 | 3961 | 4015 |
| 378 | 1014 | 890 | 2117 | 1402 | 2357 | 1914 | 3384 | 2426 | 2639 | 2938 | 3541 | 3450 | 3672 | 3962 | 4022 |
| 379 | 1221 | 891 | 2373 | 1403 | 2588 | 1915 | 3556 | 2427 | 2863 | 2939 | 3680 | 3451 | 3778 | 3963 | 4052 |
| 380 | 1026 | 892 | 2157 | 1404 | 2371 | 1916 | 3410 | 2428 | 2653 | 2940 | 3565 | 3452 | 3679 | 3964 | 4027 |
| 381 | 1306 | 893 | 2470 | 1405 | 2682 | 1917 | 3620 | 2429 | 2946 | 2941 | 3726 | 3453 | 3817 | 3965 | 4061 |
| 382 | 1353 | 894 | 2494 | 1406 | 2733 | 1918 | 3636 | 2430 | 2990 | 2942 | 3737 | 3454 | 3836 | 3966 | 4063 |
| 383 | 1539 | 895 | 2875 | 1407 | 2914 | 1919 | 3827 | 2431 | 3149 | 2943 | 3887 | 3455 | 3900 | 3967 | 4083 |
| 384 | 89 | 896 | 458 | 1408 | 602 | 1920 | 1526 | 2432 | 777 | 2944 | 1803 | 3456 | 2058 | 3968 | 3139 |
| 385 | 197 | 897 | 755 | 1409 | 944 | 1921 | 2023 | 2433 | 1181 | 2945 | 2300 | 3457 | 2555 | 3969 | 3484 |
| 386 | 203 | 898 | 767 | 1410 | 956 | 1922 | 2043 | 2434 | 1198 | 2946 | 2318 | 3458 | 2569 | 3970 | 3496 |
| 387 | 342 | 899 | 1081 | 1411 | 1287 | 1923 | 2436 | 2435 | 1561 | 2947 | 2715 | 3459 | 2928 | 3971 | 3710 |
| 388 | 259 | 900 | 899 | 1412 | 1097 | 1924 | 2217 | 2436 | 1357 | 2948 | 2498 | 3460 | 2732 | 3972 | 3599 |
| 389 | 361 | 901 | 1105 | 1413 | 1328 | 1925 | 2463 | 2437 | 1603 | 2949 | 2742 | 3461 | 2966 | 3973 | 3723 |
| 390 | 376 | 902 | 1130 | 1414 | 1360 | 1926 | 2489 | 2438 | 1635 | 2950 | 2769 | 3462 | 2996 | 3974 | 3735 |
| 391 | 514 | 903 | 1393 | 1415 | 1627 | 1927 | 2771 | 2439 | 1905 | 2951 | 3026 | 3463 | 3219 | 3975 | 3850 |
| 392 | 285 | 904 | 936 | 1416 | 1156 | 1928 | 2264 | 2440 | 1424 | 2952 | 2545 | 3464 | 2796 | 3976 | 3624 |
| 393 | 381 | 905 | 1157 | 1417 | 1372 | 1929 | 2519 | 2441 | 1647 | 2953 | 2798 | 3465 | 3007 | 3977 | 3748 |
| 394 | 395 | 906 | 1186 | 1418 | 1398 | 1930 | 2549 | 2442 | 1675 | 2954 | 2827 | 3466 | 3030 | 3978 | 3762 |
| 395 | 540 | 907 | 1442 | 1419 | 1674 | 1931 | 2819 | 2443 | 1950 | 2955 | 3069 | 3467 | 3254 | 3979 | 3868 |
| 396 | 423 | 908 | 1241 | 1420 | 1455 | 1932 | 2612 | 2444 | 1733 | 2956 | 2883 | 3468 | 3080 | 3980 | 3788 |
| 397 | 569 | 909 | 1485 | 1421 | 1725 | 1933 | 2862 | 2445 | 2000 | 2957 | 3105 | 3469 | 3291 | 3981 | 3883 |
| 398 | 599 | 910 | 1542 | 1422 | 1775 | 1934 | 2917 | 2446 | 2052 | 2958 | 3152 | 3470 | 3326 | 3982 | 3901 |
| 399 | 791 | 911 | 1788 | 1423 | 2075 | 1935 | 3130 | 2447 | 2352 | 2959 | 3335 | 3471 | 3517 | 3983 | 3963 |
| 400 | 300 | 912 | 978 | 1424 | 1190 | 1936 | 2315 | 2448 | 1462 | 2960 | 2595 | 3472 | 2832 | 3984 | 3650 |
| 401 | 420 | 913 | 1212 | 1425 | 1450 | 1937 | 2578 | 2449 | 1726 | 2961 | 2854 | 3473 | 3076 | 3985 | 3774 |
| 402 | 440 | 914 | 1265 | 1426 | 1490 | 1938 | 2638 | 2450 | 1767 | 2962 | 2906 | 3474 | 3109 | 3986 | 3799 |
| 403 | 570 | 915 | 1496 | 1427 | 1728 | 1939 | 2872 | 2451 | 2002 | 2963 | 3115 | 3475 | 3293 | 3987 | 3886 |
| 404 | 456 | 916 | 1297 | 1428 | 1521 | 1940 | 2674 | 2452 | 1798 | 2964 | 2938 | 3476 | 3135 | 3988 | 3813 |
| 405 | 605 | 917 | 1559 | 1429 | 1786 | 1941 | 2930 | 2453 | 2062 | 2965 | 3165 | 3477 | 3334 | 3989 | 3905 |
| 406 | 632 | 918 | 1612 | 1430 | 1832 | 1942 | 2981 | 2454 | 2108 | 2966 | 3207 | 3478 | 3365 | 3990 | 3921 |
| 407 | 822 | 919 | 1853 | 1431 | 2115 | 1943 | 3183 | 2455 | 2395 | 2967 | 3379 | 3479 | 3540 | 3991 | 3977 |
| 408 | 481 | 920 | 1350 | 1432 | 1569 | 1944 | 2727 | 2456 | 1846 | 2968 | 2987 | 3480 | 3173 | 3992 | 3834 |
| 409 | 642 | 921 | 1648 | 1433 | 1849 | 1945 | 3013 | 2457 | 2124 | 2969 | 3235 | 3481 | 3376 | 3993 | 3931 |
| 410 | 670 | 922 | 1604 | 1434 | 1893 | 1946 | 2974 | 2458 | 2170 | 2970 | 3201 | 3482 | 3404 | 3994 | 3919 |
| 411 | 854 | 923 | 1889 | 1435 | 2159 | 1947 | 3212 | 2459 | 2438 | 2971 | 3402 | 3483 | 3566 | 3995 | 3984 |
| 412 | 710 | 924 | 1718 | 1436 | 1955 | 1948 | 3072 | 2460 | 2233 | 2972 | 3286 | 3484 | 3443 | 3996 | 3948 |
| 413 | 888 | 925 | 1963 | 1437 | 2203 | 1949 | 3270 | 2461 | 2483 | 2973 | 3448 | 3485 | 3590 | 3997 | 3998 |
| 414 | 939 | 926 | 2019 | 1438 | 2266 | 1950 | 3308 | 2462 | 2548 | 2974 | 3482 | 3486 | 3625 | 3998 | 4006 |
| 415 | 1151 | 927 | 2279 | 1439 | 2514 | 1951 | 3497 | 2463 | 2792 | 2975 | 3632 | 3487 | 3746 | 3999 | 4042 |
| 416 | 347 | 928 | 1098 | 1440 | 1296 | 1952 | 2453 | 2464 | 1571 | 2976 | 2734 | 3488 | 2936 | 4000 | 3718 |
| 417 | 446 | 929 | 1282 | 1441 | 1501 | 1953 | 2657 | 2465 | 1778 | 2977 | 2924 | 3489 | 3119 | 4001 | 3807 |
| 418 | 462 | 930 | 1312 | 1442 | 1532 | 1954 | 2690 | 2466 | 1809 | 2978 | 2952 | 3490 | 3144 | 4002 | 3820 |
| 419 | 630 | 931 | 1579 | 1443 | 1828 | 1955 | 2950 | 2467 | 2104 | 2979 | 3181 | 3491 | 3362 | 4003 | 3911 |
| 420 | 492 | 932 | 1387 | 1444 | 1589 | 1956 | 2765 | 2468 | 1865 | 2980 | 3021 | 3492 | 3189 | 4004 | 3848 |
| 421 | 661 | 933 | 1621 | 1445 | 1879 | 1957 | 2988 | 2469 | 2156 | 2981 | 3214 | 3493 | 3396 | 4005 | 3923 |
| 422 | 699 | 934 | 1684 | 1446 | 1939 | 1958 | 3045 | 2470 | 2216 | 2982 | 3262 | 3494 | 3434 | 4006 | 3940 |
| 423 | 873 | 935 | 1931 | 1447 | 2184 | 1959 | 3243 | 2471 | 2464 | 2983 | 3429 | 3495 | 3580 | 4007 | 3992 |
| 424 | 538 | 936 | 1425 | 1448 | 1672 | 1960 | 2803 | 2472 | 1948 | 2984 | 3054 | 3496 | 3253 | 4008 | 3862 |
| 425 | 700 | 937 | 1693 | 1449 | 1941 | 1961 | 3053 | 2473 | 2218 | 2985 | 3268 | 3497 | 3435 | 4009 | 3942 |
| 426 | 720 | 938 | 1737 | 1450 | 1973 | 1962 | 3090 | 2474 | 2248 | 2986 | 3300 | 3498 | 3454 | 4010 | 3953 |
| 427 | 935 | 939 | 1997 | 1451 | 2262 | 1963 | 3294 | 2475 | 2543 | 2987 | 3469 | 3499 | 3623 | 4011 | 4003 |
| 428 | 774 | 940 | 1777 | 1452 | 2049 | 1964 | 3122 | 2476 | 2327 | 2988 | 3327 | 3500 | 3501 | 4012 | 3961 |
| 429 | 910 | 941 | 2033 | 1453 | 2230 | 1965 | 3318 | 2477 | 2511 | 2989 | 3490 | 3501 | 3606 | 4013 | 4008 |
| 430 | 1002 | 942 | 2095 | 1454 | 2344 | 1966 | 3368 | 2478 | 2624 | 2990 | 3528 | 3502 | 3665 | 4014 | 4019 |
| 431 | 1226 | 943 | 2362 | 1455 | 2593 | 1967 | 3549 | 2479 | 2869 | 2991 | 3674 | 3503 | 3780 | 4015 | 4051 |
| 432 | 578 | 944 | 1508 | 1456 | 1741 | 1968 | 2884 | 2480 | 2016 | 2992 | 3124 | 3504 | 3302 | 4016 | 3890 |
| 433 | 745 | 945 | 1757 | 1457 | 2009 | 1969 | 3106 | 2481 | 2285 | 2993 | 3314 | 3505 | 3476 | 4017 | 3957 |
| 434 | 799 | 946 | 1815 | 1458 | 2085 | 1970 | 3154 | 2482 | 2363 | 2994 | 3354 | 3506 | 3522 | 4018 | 3970 |
| 435 | 987 | 947 | 2059 | 1459 | 2326 | 1971 | 3342 | 2483 | 2607 | 2995 | 3507 | 3507 | 3656 | 4019 | 4013 |
| 436 | 823 | 948 | 1877 | 1460 | 2119 | 1972 | 3204 | 2484 | 2397 | 2996 | 3395 | 3508 | 3543 | 4020 | 3982 |
| 437 | 1023 | 949 | 2133 | 1461 | 2369 | 1973 | 3394 | 2485 | 2650 | 2997 | 3551 | 3509 | 3678 | 4021 | 4024 |
| 438 | 1054 | 950 | 2165 | 1462 | 2403 | 1974 | 3416 | 2486 | 2684 | 2998 | 3570 | 3510 | 3695 | 4022 | 4028 |
| 439 | 1279 | 951 | 2443 | 1463 | 2654 | 1975 | 3605 | 2487 | 2921 | 2999 | 3714 | 3511 | 3806 | 4023 | 4059 |
| 440 | 864 | 952 | 1914 | 1464 | 2171 | 1976 | 3230 | 2488 | 2452 | 3000 | 3418 | 3512 | 3573 | 4024 | 3988 |
| 441 | 1066 | 953 | 2215 | 1465 | 2417 | 1977 | 3456 | 2489 | 2698 | 3001 | 3597 | 3513 | 3701 | 4025 | 4035 |
| 442 | 1063 | 954 | 2243 | 1466 | 2415 | 1978 | 3473 | 2490 | 2695 | 3002 | 3612 | 3514 | 3700 | 4026 | 4038 |
| 443 | 1341 | 955 | 2524 | 1467 | 2718 | 1979 | 3652 | 2491 | 2979 | 3003 | 3751 | 3515 | 3831 | 4027 | 4065 |
| 444 | 1143 | 956 | 2308 | 1468 | 2504 | 1980 | 3516 | 2492 | 2783 | 3004 | 3647 | 3516 | 3742 | 4028 | 4045 |
| 445 | 1376 | 957 | 2567 | 1469 | 2756 | 1981 | 3676 | 2493 | 3011 | 3005 | 3769 | 3517 | 3845 | 4029 | 4068 |
| 446 | 1417 | 958 | 2601 | 1470 | 2794 | 1982 | 3694 | 2494 | 3047 | 3006 | 3784 | 3518 | 3859 | 4030 | 4070 |
| 447 | 1670 | 959 | 2797 | 1471 | 3031 | 1983 | 3792 | 2495 | 3251 | 3007 | 3860 | 3519 | 3936 | 4031 | 4080 |
| 448 | 386 | 960 | 1174 | 1472 | 1381 | 1984 | 2537 | 2496 | 1656 | 3008 | 2815 | 3520 | 3015 | 4032 | 3756 |
| 449 | 478 | 961 | 1323 | 1473 | 1562 | 1985 | 2699 | 2497 | 1839 | 3009 | 2962 | 3521 | 3168 | 4033 | 3823 |
| 450 | 516 | 962 | 1422 | 1474 | 1633 | 1986 | 2800 | 2498 | 1909 | 3010 | 3051 | 3522 | 3223 | 4034 | 3861 |
| 451 | 703 | 963 | 1698 | 1475 | 1943 | 1987 | 3057 | 2499 | 2222 | 3011 | 3272 | 3523 | 3436 | 4035 | 3943 |
| 452 | 567 | 964 | 1482 | 1476 | 1723 | 1988 | 2859 | 2500 | 1996 | 3012 | 3103 | 3524 | 3290 | 4036 | 3882 |
| 453 | 723 | 965 | 1732 | 1477 | 1975 | 1989 | 3087 | 2501 | 2252 | 3013 | 3296 | 3525 | 3455 | 4037 | 3952 |
| 454 | 760 | 966 | 1762 | 1478 | 2031 | 1990 | 3110 | 2502 | 2307 | 3014 | 3317 | 3526 | 3489 | 4038 | 3958 |
| 455 | 955 | 967 | 2039 | 1479 | 2286 | 1991 | 3323 | 2503 | 2568 | 3015 | 3494 | 3527 | 3635 | 4039 | 4009 |
| 456 | 601 | 968 | 1535 | 1480 | 1781 | 1992 | 2910 | 2504 | 2056 | 3016 | 3147 | 3528 | 3330 | 4040 | 3899 |
| 457 | 789 | 969 | 1825 | 1481 | 2071 | 1993 | 3162 | 2505 | 2349 | 3017 | 3360 | 3529 | 3514 | 4041 | 3972 |
| 458 | 807 | 970 | 1847 | 1482 | 2097 | 1994 | 3178 | 2506 | 2374 | 3018 | 3375 | 3530 | 3530 | 4042 | 3976 |
| 459 | 1017 | 971 | 2111 | 1483 | 2360 | 1995 | 3378 | 2507 | 2642 | 3019 | 3538 | 3531 | 3673 | 4043 | 4021 |
| 460 | 846 | 972 | 1894 | 1484 | 2147 | 1996 | 3217 | 2508 | 2428 | 3020 | 3406 | 3532 | 3559 | 4044 | 3985 |
| 461 | 1032 | 973 | 2141 | 1485 | 2378 | 1997 | 3400 | 2509 | 2659 | 3021 | 3555 | 3533 | 3682 | 4045 | 4025 |
| 462 | 1062 | 974 | 2232 | 1486 | 2413 | 1998 | 3467 | 2510 | 2694 | 3022 | 3607 | 3534 | 3699 | 4046 | 4037 |
| 463 | 1300 | 975 | 2482 | 1487 | 2676 | 1999 | 3628 | 2511 | 2941 | 3023 | 3732 | 3535 | 3814 | 4047 | 4062 |
| 464 | 633 | 976 | 1550 | 1488 | 1834 | 2000 | 2923 | 2512 | 2110 | 3024 | 3159 | 3536 | 3366 | 4048 | 3903 |
| 465 | 830 | 977 | 1883 | 1489 | 2127 | 2001 | 3208 | 2513 | 2405 | 3025 | 3398 | 3537 | 3547 | 4049 | 3983 |
| 466 | 875 | 978 | 1937 | 1490 | 2186 | 2002 | 3248 | 2514 | 2466 | 3026 | 3432 | 3538 | 3581 | 4050 | 3993 |
| 467 | 1051 | 979 | 2207 | 1491 | 2401 | 2003 | 3450 | 2515 | 2681 | 3027 | 3593 | 3539 | 3693 | 4051 | 4034 |
| 468 | 894 | 980 | 2011 | 1492 | 2211 | 2004 | 3303 | 2516 | 2491 | 3028 | 3477 | 3540 | 3595 | 4052 | 4005 |
| 469 | 1069 | 981 | 2260 | 1493 | 2422 | 2005 | 3485 | 2517 | 2702 | 3029 | 3622 | 3541 | 3704 | 4053 | 4040 |
| 470 | 1146 | 982 | 2269 | 1494 | 2507 | 2006 | 3491 | 2518 | 2786 | 3030 | 3626 | 3542 | 3743 | 4054 | 4041 |
| 471 | 1380 | 983 | 2583 | 1495 | 2759 | 2007 | 3685 | 2519 | 3014 | 3031 | 3776 | 3543 | 3846 | 4055 | 4069 |
| 472 | 952 | 984 | 2081 | 1496 | 2284 | 2008 | 3358 | 2520 | 2564 | 3032 | 3520 | 3544 | 3634 | 4056 | 4017 |
| 473 | 1163 | 985 | 2330 | 1497 | 2527 | 2009 | 3529 | 2521 | 2804 | 3033 | 3658 | 3545 | 3752 | 4057 | 4047 |
| 474 | 1194 | 986 | 2350 | 1498 | 2560 | 2010 | 3542 | 2522 | 2836 | 3034 | 3669 | 3546 | 3766 | 4058 | 4050 |
| 475 | 1428 | 987 | 2617 | 1499 | 2806 | 2011 | 3702 | 2523 | 3056 | 3035 | 3790 | 3547 | 3863 | 4059 | 4071 |
| 476 | 1250 | 988 | 2420 | 1500 | 2622 | 2012 | 3591 | 2524 | 2892 | 3036 | 3703 | 3548 | 3793 | 4060 | 4057 |
| 477 | 1493 | 989 | 2710 | 1501 | 2868 | 2013 | 3750 | 2525 | 3112 | 3037 | 3828 | 3549 | 3885 | 4061 | 4076 |
| 478 | 1531 | 990 | 2750 | 1502 | 2907 | 2014 | 3770 | 2526 | 3143 | 3038 | 3843 | 3550 | 3898 | 4062 | 4078 |
| 479 | 1810 | 991 | 3042 | 1503 | 3150 | 2015 | 3896 | 2527 | 3350 | 3039 | 3939 | 3551 | 3969 | 4063 | 4088 |
| 480 | 689 | 992 | 1665 | 1504 | 1923 | 2016 | 3027 | 2528 | 2201 | 3040 | 3247 | 3552 | 3424 | 4064 | 3935 |
| 481 | 884 | 993 | 1985 | 1505 | 2196 | 2017 | 3284 | 2529 | 2478 | 3041 | 3462 | 3553 | 3587 | 4065 | 4001 |
| 482 | 930 | 994 | 2005 | 1506 | 2256 | 2018 | 3298 | 2530 | 2536 | 3042 | 3474 | 3554 | 3619 | 4066 | 4004 |
| 483 | 1149 | 995 | 2288 | 1507 | 2512 | 2019 | 3504 | 2531 | 2789 | 3043 | 3637 | 3555 | 3745 | 4067 | 4043 |
| 484 | 999 | 996 | 2103 | 1508 | 2341 | 2020 | 3373 | 2532 | 2621 | 3044 | 3533 | 3556 | 3664 | 4068 | 4020 |
| 485 | 1154 | 997 | 2339 | 1509 | 2517 | 2021 | 3536 | 2533 | 2795 | 3045 | 3663 | 3557 | 3747 | 4069 | 4048 |
| 486 | 1238 | 998 | 2385 | 1510 | 2609 | 2022 | 3563 | 2534 | 2880 | 3046 | 3686 | 3558 | 3787 | 4070 | 4053 |
| 487 | 1445 | 999 | 2652 | 1511 | 2825 | 2023 | 3721 | 2535 | 3071 | 3047 | 3805 | 3559 | 3870 | 4071 | 4073 |
| 488 | 1009 | 1000 | 2149 | 1512 | 2353 | 2024 | 3405 | 2536 | 2632 | 3048 | 3560 | 3560 | 3670 | 4072 | 4026 |
| 489 | 1229 | 1001 | 2432 | 1513 | 2598 | 2025 | 3598 | 2537 | 2871 | 3049 | 3708 | 3561 | 3783 | 4073 | 4058 |
| 490 | 1285 | 1002 | 2455 | 1514 | 2660 | 2026 | 3613 | 2538 | 2926 | 3050 | 3719 | 3562 | 3808 | 4074 | 4060 |
| 491 | 1516 | 1003 | 2730 | 1515 | 2891 | 2027 | 3760 | 2539 | 3131 | 3051 | 3835 | 3563 | 3892 | 4075 | 4077 |
| 492 | 1329 | 1004 | 2539 | 1516 | 2704 | 2028 | 3660 | 2540 | 2968 | 3052 | 3757 | 3564 | 3825 | 4076 | 4066 |
| 493 | 1567 | 1005 | 2773 | 1517 | 2940 | 2029 | 3781 | 2541 | 3172 | 3053 | 3851 | 3565 | 3908 | 4077 | 4079 |
| 494 | 1639 | 1006 | 2904 | 1518 | 3006 | 2030 | 3840 | 2542 | 3228 | 3054 | 3897 | 3566 | 3928 | 4078 | 4084 |
| 495 | 1919 | 1007 | 3134 | 1519 | 3234 | 2031 | 3929 | 2543 | 3422 | 3055 | 3964 | 3567 | 3989 | 4079 | 4090 |
| 496 | 1033 | 1008 | 2190 | 1520 | 2380 | 2032 | 3438 | 2544 | 2661 | 3056 | 3583 | 3568 | 3683 | 4080 | 4032 |
| 497 | 1309 | 1009 | 2509 | 1521 | 2685 | 2033 | 3644 | 2545 | 2949 | 3057 | 3744 | 3569 | 3818 | 4081 | 4064 |
| 498 | 1367 | 1010 | 2552 | 1522 | 2744 | 2034 | 3668 | 2546 | 3003 | 3058 | 3763 | 3570 | 3841 | 4082 | 4067 |
| 499 | 1592 | 1011 | 2822 | 1523 | 2960 | 2035 | 3803 | 2547 | 3192 | 3059 | 3869 | 3571 | 3915 | 4083 | 4081 |
| 500 | 1400 | 1012 | 2633 | 1524 | 2779 | 2036 | 3712 | 2548 | 3032 | 3060 | 3797 | 3572 | 3854 | 4084 | 4072 |
| 501 | 1651 | 1013 | 2846 | 1525 | 3016 | 2037 | 3815 | 2549 | 3237 | 3061 | 3877 | 3573 | 3932 | 4085 | 4082 |
| 502 | 1617 | 1014 | 2933 | 1526 | 2985 | 2038 | 3853 | 2550 | 3211 | 3062 | 3906 | 3574 | 3922 | 4086 | 4085 |
| 503 | 1957 | 1015 | 3187 | 1527 | 3266 | 2039 | 3947 | 2551 | 3445 | 3063 | 3978 | 3575 | 3997 | 4087 | 4091 |
| 504 | 1471 | 1016 | 2671 | 1528 | 2849 | 2040 | 3730 | 2552 | 3093 | 3064 | 3812 | 3576 | 3878 | 4088 | 4074 |
| 505 | 1707 | 1017 | 2967 | 1529 | 3064 | 2041 | 3866 | 2553 | 3278 | 3065 | 3917 | 3577 | 3945 | 4089 | 4086 |
| 506 | 1746 | 1018 | 3002 | 1530 | 3098 | 2042 | 3881 | 2554 | 3306 | 3066 | 3927 | 3578 | 3955 | 4090 | 4087 |
| 507 | 2065 | 1019 | 3252 | 1531 | 3347 | 2043 | 3968 | 2555 | 3511 | 3067 | 3994 | 3579 | 4014 | 4091 | 4092 |
| 508 | 1830 | 1020 | 3083 | 1532 | 3166 | 2044 | 3912 | 2556 | 3364 | 3068 | 3951 | 3580 | 3973 | 4092 | 4089 |
| 509 | 2125 | 1021 | 3328 | 1533 | 3389 | 2045 | 3990 | 2557 | 3546 | 3069 | 4010 | 3581 | 4023 | 4093 | 4093 |
| 510 | 2198 | 1022 | 3433 | 1534 | 3444 | 2046 | 4016 | 2558 | 3588 | 3070 | 4031 | 3582 | 4033 | 4094 | 4094 |
| 511 | 2406 | 1023 | 3584 | 1535 | 3576 | 2047 | 4049 | 2559 | 3696 | 3071 | 4056 | 3583 | 4055 | 4095 | 4095 |

Sequence Z3, with a sequence length of 2048:
[0,1,2,7,3,8,12,25,4,11,14,29,17,34,36,79,5,13,15,33,20,40,49,84,23,48,44, 91,59,100,106,170,6,18,22,42,24,47,53,93,30,57,61,101,74,113,119,187,35,63,77,117, 82,126,136,199,90,138,149,224,155,236,257,366,9,19,27,56,31,60,73,108,37,78,65,1 20,87,130,143,207,46,76,89,137,95,146,154,231,104,157,173,247,186,264,280,404,5 5,92,102,153,115,164,180,260,124,181,198,273,210,296,311,436,141,205,228,300,23 4,312,334,463,253,341,360,485,378,505,540,721, 16,26,32,75,41,81,85,142,50,88,96, 152,105,163,167,259,58,97,107,165,118,179, 195,275, 129, 196,206,290,230,307,329,4 53,67,111,125,185,131,197,213,301,150,226,235,315,252,340,354,483,166,244,261,3 46,274,373,381,502,297,392,420,531,441,557,613,722,71,127,145,216,161,232,251,3 44,171,254,266,365,281,380,402,522,193,277,291,390,313,415,438,566,324,444,467, 588,491,623,644,818,212,303,318,424,348,451,471,606,377,479,503,635,532,648,69 7,870,401,513,542,674,554,713,735,914,610,746,771,905,797,950,1007,1188,21,38,4 3,94,51,98,109,178,52,110,121,188,133,208,218,327,66,122,134,221,147,229,242,32 8,156,240,258,359,278,376,385,501,69,144,158,223,175,245,262,375,184,271,282,38 7,294,413,429,552,183,292,305,411,323,440,455,590,350,474,493,622,511,642,679,8 56,80,169,176,268,191,287,304,405,201,310,317,437,335,462,478,619,255,330,349,4 66,367,489,510,638,395,517,546,671,570,711,738,897,286,362,389,499,410,529,549, 699,433,561,578,719,614,758,781,936,469,612,625,772,639,799,764,963,686,851,87 2,1019,881,1077,1108,1225,86,189,194,322,246,339,352,473,270,357,369,495,394,5 20,545,702,284,391,409,521,423,550,573,726,445,581,604,751,637,777,816,971,326, 414,428,571,454,597,628,766,494,629,645,813,688,794,863,1023,528,665,708,852,7 27,879,901,1059,759,910,908,1100,965,1123,1149,1303,361,442,475,631,518,647,67 7,828,547,700,714,874,745,885,907,1073,574,732,767,899,782,912,967,1125,826,97 9,1001,1156,1039,1197,1220, 1381,620,774,809,969,861,973, 1031, 1167,868, 1025, 10 63,1211,1092,1242,1285,1439,886,1079,1117,1257,1138,1292,1272,1458,1183,1324, 1346,1513,1392,1543,1579,1673,28,45,54,103,62,123,135,214,68,139,148,220,160,2 38,243,370,70,159,168,237,177,288,298,400,202,299,321,434,338,457,477,634,72,17 4,190,293,204,319,332,449,215,343,355,481,372,506,525,650,227,364,383,516,406,5 43,559,693,416,553,583,730,587,750,776,1011,112,203,211,336,222,356,371,498,24 9,386,396,536,419,564,580,705,267,399,427,556,447,585,593,740,465,594,603,779,6 64,801,844,1024,285,446,459,601,487,626,632,789,509,662,682,825,718,858,876, 10 65,535,696,729,877,761,895,940,1094,808,946,981,1128,1003,1163,1201,1375,116,2 19,239,382,265,397,422,568,279,431,450,596,470,609,616,784,309,461,486,617,507, 657,676,819,533,690,716,867,742,888,923,1067,333,497,524,680,560,710,707,890,5 75,734,748,916,791,942,958,1132,607,763,804,952,821,991,1005,1169,849,1021,104 7,1213,1098,1247,1287,1442,351,539,563,737,591,756,792,948,654,806,833,997,838, 1009,1035,1194,667,835,847,1029,892,1045,1085,1240,931,1096,1115,1259,1147,13 06,1332,1468,691,903,920,1069,959,1102,1121,1277,983,1143,1172,1322,1204,1349, 1386,1524,1051,1176,1216,1358,1252,1398,1414,1571,1280,1429,1455,1591,1492,1 626,1668,1784,132,250,272,432,306,458,482,641,316,490,514,660,538,685,724,925, 345,527,567,703,584,754,743,935,598,769,796,977,830,993,1015,1185,408,577,600, 753,653,787,811,999,659,831,842,1017,860,1037,1057,1230,668,854,883,1055,929,1 083,1110,1262,954,1136,1145,1308,1174,1335,1366,1506,418,651,656,823,670,837,8 65,1043,694,894,918,1075,944,1104,1141,1298,802,927,961,1113,985,1158,1178,132 7,1041,1181,1218,1360,1254,1395,1411,1567,840,989,1027,1160,1053,1208,1235,13 72,1090,1244,1267,1408,1295,1432,1465,1604,1119,1282,1314,1452,1344,1475,150 3,1635,1378,1517,1539,1659,1559,1700,1710,1847,425,673,683,921,786,938,956,11 34,814,975,995,1165,1033,1192,1227,1369,845,1013,1049,1199,1071,1237,1269,140 4,1106,1290,1264,1423,1330,1461,1489,1617,933,1061,1081,1249,1130,1274,1311,1 445,1154,1316,1341,1478,1363,1496,1528,1654,1206,1352,1384,1510,1417,1547,15 63,1689,1436,1587,1600,1722,1630,1739,1752,1822,987,1088,1152,1319,1190,1338, 1355,1499,1223,1389,1401,1536,1426,1551,1595,1705,1232,1420,1448,1583,1485,1 608,1612,1745,1521,1640,1649,1758,1679, 1792, 1806,1896, 1300,1472, 1482,1621, 15 32,1644,1664,1771,1555,1684,1694,1799,1728,1814,1856,1920,1575,1716,1733,183 0,1764,1838,1865,1933,1778,1875,1885,1948,1907,1964,1984,2008,10,39,64,140,83, 151,182,283,99,172,200,308,225,337,347,526,114,192,209,331,248,363,407,541,269, 403,384,565,452,592,611,778,128,233,263,374,276,398,426,572,314,443,460,595,50 8,633,649,815,342,468,519,643,537,669,695,841,562,701,728,891,741,913,951,1133, 162,241,295,439,320,456,504,618,353,523,472,652,551,678,712,857,393,515,558,69 8,579,720,739,904,605,747,783,934,812,964,992,1187,435,569,599,736,636,762,800, 957,663,803,839,980,862,1018,1046,1231,706,853,898,1028,909,1048,1084,1266,94 5,1095,1124,1293,1151,1317,1357,1534,217,289,325,512,368,534,544,709,412,555,5 82,733,608,760,770,955,448,586,615,765,646,798,832,984,675,834,855,1008,902,10 40,1076,1253,480,627,666,810,681,836,869,1030,731,893,911,1052,943,1093,1114,1 291,768,928,960,1103,982,1144,1155,1313,1020,1171,1210,1347,1238,1376,1434,15 35,496,672,717,875,757,906,941,1099,780,947,968,1131,994,1153,1186,1337,827,98 6,1010,1168,1050,1203,1234,1385,1068,1241,1271,1409,1301,1444,1464,1613,866,1 032,1058,1215,1105,1251,1276,1427,1150,1286,1315, 1456, 1348, 1469, 1514, 1651, 11 84,1326,1359,1493,1373,1527,1546,1681,1431,1556,1576,1675,1597,1704,1740,184 1,256,358,379,576,417,589,621,795,421,624,655,817,687,859,878,1072,476,658,689, 884,723,900,924,1074,744,922,953,1122,988,1148,1161,1312,488,715,749,889,788,9 30,962,1146,807,976,996,1164,1016,1200,1222,1370,805,1012,1036,1198,1066,1236, 1256,1410,1109,1279,1302,1443,1325,1463,1497,1641,530,775,790,972,824,1004,1 034,1189,843,1044,1056,1233,1086,1265,1284,1440,949,1078,1107,1270,1135,1297, 1323,1459,1175,1331,1364,1490,1390,1526,1549,1670,1002,1127,1166,1310,1196,13 45,1367,1515,1228,1380,1399,1533,1435,1565,1584,1696,1273,1433,1446,1577,146 0,1598,1570,1713,1504,1637,1652,1747,1658,1782,1800,1859,548,820,829,1064,932, 1091,1112,1278,974,1120,1137,1305,1173,1334,1362,1518,998,1170,1195,1336,121 4,1368,1393,1538,1243,1402,1425,1560,1457,1581,1611,1718,1070,1202,1221,1391, 1255,1418,1449,1572,1304,1450,1466,1609,1505,1594,1646,1749,1343,1484,1523,1 638,1540,1657,1672,1772,1566,1678,1677,1795,1714,1808,1821,1893,1126,1239,12 81,1451,1333,1467,1495,1620,1365,1516,1529,1653,1554,1661,1676,1780,1394,154 4,1573,1671,1585,1680,1715,1809,1619,1723,1736,1825,1760,1845,1857,1924,1441, 1578,1606,1717,1645,1719,1755,1831,1650,1751,1774,1852,1790,1867,1886,1944,1 662,1783,1804,1873,1816,1889,1880,1951,1839,1902,1911,1968,1928,1976,1986,20 07,302,388,430,602,464,661,692,871,484,704,725,882,755,917,926,1139,492,752,77 3,915,793,1006,1022,1182,846,1026,1062,1229,1089,1258,1283,1454,500,785,822,1 014,850,1060,1080,1248,873,1097,1116,1288,1142,1318,1340,1470,896,1129,1159,1 329,1191,1361,1377,1509,1205,1371,1403,1542,1407,1558,1580,1742,630,848,864,1 087,887,1118,1140,1309,937,1162,1177,1353,1209,1383,1400,1520,970,1180,1219,1 374,1246,1406,1413,1550,1268,1415,1424,1582,1483,1599,1632,1750,1000,1245,12 61,1422,1296,1447,1453,1590,1321,1481,1500,1618,1531,1642,1655,1775,1351,151 2,1541,1656,1568,1669,1698,1791,1605,1702,1724,1810,1737,1828,1848,1922,640,8 80,919,1157,966,1179,1212,1388,990,1224,1250,1416,1275,1430,1437,1586,1042,12 63,1294,1438,1320,1477,1494,1614,1350,1507,1530,1648,1552,1663,1687,1776,108 2,1307,1339,1498,1379,1525,1522,1665,1396,1545,1557,1682,1592,1699,1709,1812, 1428,1569,1602,1706,1615,1730,1738,1832,1636,1748,1765,1853,1794,1869,1887,1 945,1111,1356,1382,1548,1412,1564,1593,1703,1474,1603,1624,1734,1628,1741,17 57,1844,1486,1625,1634,1754,1666,1763,1787,1866,1692,1793,1803,1874,1820,189 4,1905,1954,1508,1674,1685,1777,1711,1796,1807,1882,1725,1818,1833,1901,1849, 1912,1926,1971,1767,1835,1854,1915,1871,1930,1936,1983,1883,1941,1950,1989,1 961,1997,2006,2027,684,939,978,1226,1038,1260,1289,1462,1054,1299,1328,1480,1 354,1502,1537,1688,1101,1342,1387,1519,1405,1562,1553,1695,1419,1574,1596,17 21,1622,1731,1744,1840,1193,1397,1421,1561,1473,1589,1607,1735,1479,1623,163 1,1746,1643,1759,1770,1861,1487,1639,1660,1769,1691,1786,1801,1876,1707,1815, 1819,1895,1834,1906,1918,1966,1207,1471,1476,1616,1488,1627,1647,1762,1511,1 667,1683,1781,1701,1797,1817,1891,1601,1690,1712,1802,1726,1826,1836,1903,17 61,1837,1855,1916,1872,1929,1935,1982,1629,1729,1753,1827,1768,1851,1863,192 1,1789,1868,1878,1934,1890,1942,1953,1992,1805,1884,1898,1949,1910,1956,1965, 1999,1923,1969,1975,2004,1980,2013,2015,2035,1217,1491,1501,1686,1588,1697,1 708,1813,1610,1720,1732,1829,1756,1843,1860,1919,1633,1743,1766,1846,1779,18 64,1879,1932,1798,1888,1877,1939,1904,1952,1960,1995,1693,1773,1785,1870,181 1,1881,1897,1946,1824,1899,1909,1957,1917,1962,1972,2003,1850,1913,1925,1967, 1937,1977,1981,2011,1943,1988,1991,2017,1998,2020,2022,2032,1727,1788,1823,1 900,1842,1908,1914,1963,1858,1927,1931,1974,1940,1978,1990,2014,1862,1938,19 47,1987,1959,1993,1994,2021,1970,2000,2002,2023,2009,2028,2030,2040,1892,195 5,1958,1996,1973,2001,2005,2025,1979,2010,2012,2029,2018,2031,2036,2042,1985, 2016,2019,2033,2024,2034,2037,2043,2026,2038,2039,2044,2041,2045,2046,2047];

**Table Z3, with a sequence length of 2048:**

| Polarized channel sequence number | Reliability or reliability sequence number | Polarized channel sequence number | Reliability or reliability sequence number | Polarized channel sequence number | Reliability or reliability sequence number | Polarized channel sequence number | Reliability or reliability sequence number | Polarized channel sequence number | Reliability or reliability sequence number | Polarized channel sequence number | Reliability or reliability sequence number | Polarized channel sequence number | Reliability or reliability sequence number | Polarized channel sequence number | Reliability or reliability sequence number |
|---|---|---|---|---|---|---|---|---|---|---|---|---|---|---|---|
| 0 | 0 | 256 | 21 | 512 | 28 | 768 | 132 | 1024 | 10 | 1280 | 256 | 1536 | 302 | 1792 | 684 |
| 1 | 1 | 257 | 38 | 513 | 45 | 769 | 250 | 1025 | 39 | 1281 | 358 | 1537 | 388 | 1793 | 939 |
| 2 | 2 | 258 | 43 | 514 | 54 | 770 | 272 | 1026 | 64 | 1282 | 379 | 1538 | 430 | 1794 | 978 |
| 3 | 7 | 259 | 94 | 515 | 103 | 771 | 432 | 1027 | 140 | 1283 | 576 | 1539 | 602 | 1795 | 1226 |
| 4 | 3 | 260 | 51 | 516 | 62 | 772 | 306 | 1028 | 83 | 1284 | 417 | 1540 | 464 | 1796 | 1038 |
| 5 | 8 | 261 | 98 | 517 | 123 | 773 | 458 | 1029 | 151 | 1285 | 589 | 1541 | 661 | 1797 | 1260 |
| 6 | 12 | 262 | 109 | 518 | 135 | 774 | 482 | 1030 | 182 | 1286 | 621 | 1542 | 692 | 1798 | 1289 |
| 7 | 25 | 263 | 178 | 519 | 214 | 775 | 641 | 1031 | 283 | 1287 | 795 | 1543 | 871 | 1799 | 1462 |
| 8 | 4 | 264 | 52 | 520 | 68 | 776 | 316 | 1032 | 99 | 1288 | 421 | 1544 | 484 | 1800 | 1054 |
| 9 | 11 | 265 | 110 | 521 | 139 | 777 | 490 | 1033 | 172 | 1289 | 624 | 1545 | 704 | 1801 | 1299 |
| 10 | 14 | 266 | 121 | 522 | 148 | 778 | 514 | 1034 | 200 | 1290 | 655 | 1546 | 725 | 1802 | 1328 |
| 11 | 29 | 267 | 188 | 523 | 220 | 779 | 660 | 1035 | 308 | 1291 | 817 | 1547 | 882 | 1803 | 1480 |
| 12 | 17 | 268 | 133 | 524 | 160 | 780 | 538 | 1036 | 225 | 1292 | 687 | 1548 | 755 | 1804 | 1354 |
| 13 | 34 | 269 | 208 | 525 | 238 | 781 | 685 | 1037 | 337 | 1293 | 859 | 1549 | 917 | 1805 | 1502 |
| 14 | 36 | 270 | 218 | 526 | 243 | 782 | 724 | 1038 | 347 | 1294 | 878 | 1550 | 926 | 1806 | 1537 |
| 15 | 79 | 271 | 327 | 527 | 370 | 783 | 925 | 1039 | 526 | 1295 | 1072 | 1551 | 1139 | 1807 | 1688 |
| 16 | 5 | 272 | 66 | 528 | 70 | 784 | 345 | 1040 | 114 | 1296 | 476 | 1552 | 492 | 1808 | 1101 |
| 17 | 13 | 273 | 122 | 529 | 159 | 785 | 527 | 1041 | 192 | 1297 | 658 | 1553 | 752 | 1809 | 1342 |
| 18 | 15 | 274 | 134 | 530 | 168 | 786 | 567 | 1042 | 209 | 1298 | 689 | 1554 | 773 | 1810 | 1387 |
| 19 | 33 | 275 | 221 | 531 | 237 | 787 | 703 | 1043 | 331 | 1299 | 884 | 1555 | 915 | 1811 | 1519 |
| 20 | 20 | 276 | 147 | 532 | 177 | 788 | 584 | 1044 | 248 | 1300 | 723 | 1556 | 793 | 1812 | 1405 |
| 21 | 40 | 277 | 229 | 533 | 288 | 789 | 754 | 1045 | 363 | 1301 | 900 | 1557 | 1006 | 1813 | 1562 |
| 22 | 49 | 278 | 242 | 534 | 298 | 790 | 743 | 1046 | 407 | 1302 | 924 | 1558 | 1022 | 1814 | 1553 |
| 23 | 84 | 279 | 328 | 535 | 400 | 791 | 935 | 1047 | 541 | 1303 | 1074 | 1559 | 1182 | 1815 | 1695 |
| 24 | 23 | 280 | 156 | 536 | 202 | 792 | 598 | 1048 | 269 | 1304 | 744 | 1560 | 846 | 1816 | 1419 |
| 25 | 48 | 281 | 240 | 537 | 299 | 793 | 769 | 1049 | 403 | 1305 | 922 | 1561 | 1026 | 1817 | 1574 |
| 26 | 44 | 282 | 258 | 538 | 321 | 794 | 796 | 1050 | 384 | 1306 | 953 | 1562 | 1062 | 1818 | 1596 |
| 27 | 91 | 283 | 359 | 539 | 434 | 795 | 977 | 1051 | 565 | 1307 | 1122 | 1563 | 1229 | 1819 | 1721 |
| 28 | 59 | 284 | 278 | 540 | 338 | 796 | 830 | 1052 | 452 | 1308 | 988 | 1564 | 1089 | 1820 | 1622 |
| 29 | 100 | 285 | 376 | 541 | 457 | 797 | 993 | 1053 | 592 | 1309 | 1148 | 1565 | 1258 | 1821 | 1731 |
| 30 | 106 | 286 | 385 | 542 | 477 | 798 | 1015 | 1054 | 611 | 1310 | 1161 | 1566 | 1283 | 1822 | 1744 |
| 31 | 170 | 287 | 501 | 543 | 634 | 799 | 1185 | 1055 | 778 | 1311 | 1312 | 1567 | 1454 | 1823 | 1840 |
| 32 | 6 | 288 | 69 | 544 | 72 | 800 | 408 | 1056 | 128 | 1312 | 488 | 1568 | 500 | 1824 | 1193 |
| 33 | 18 | 289 | 144 | 545 | 174 | 801 | 577 | 1057 | 233 | 1313 | 715 | 1569 | 785 | 1825 | 1397 |
| 34 | 22 | 290 | 158 | 546 | 190 | 802 | 600 | 1058 | 263 | 1314 | 749 | 1570 | 822 | 1826 | 1421 |
| 35 | 42 | 291 | 223 | 547 | 293 | 803 | 753 | 1059 | 374 | 1315 | 889 | 1571 | 1014 | 1827 | 1561 |
| 36 | 24 | 292 | 175 | 548 | 204 | 804 | 653 | 1060 | 276 | 1316 | 788 | 1572 | 850 | 1828 | 1473 |
| 37 | 47 | 293 | 245 | 549 | 319 | 805 | 787 | 1061 | 398 | 1317 | 930 | 1573 | 1060 | 1829 | 1589 |
| 38 | 53 | 294 | 262 | 550 | 332 | 806 | 811 | 1062 | 426 | 1318 | 962 | 1574 | 1080 | 1830 | 1607 |
| 39 | 93 | 295 | 375 | 551 | 449 | 807 | 999 | 1063 | 572 | 1319 | 1146 | 1575 | 1248 | 1831 | 1735 |
| 40 | 30 | 296 | 184 | 552 | 215 | 808 | 659 | 1064 | 314 | 1320 | 807 | 1576 | 873 | 1832 | 1479 |
| 41 | 57 | 297 | 271 | 553 | 343 | 809 | 831 | 1065 | 443 | 1321 | 976 | 1577 | 1097 | 1833 | 1623 |
| 42 | 61 | 298 | 282 | 554 | 355 | 810 | 842 | 1066 | 460 | 1322 | 996 | 1578 | 1116 | 1834 | 1631 |
| 43 | 101 | 299 | 387 | 555 | 481 | 811 | 1017 | 1067 | 595 | 1323 | 1164 | 1579 | 1288 | 1835 | 1746 |
| 44 | 74 | 300 | 294 | 556 | 372 | 812 | 860 | 1068 | 508 | 1324 | 1016 | 1580 | 1142 | 1836 | 1643 |
| 45 | 113 | 301 | 413 | 557 | 506 | 813 | 1037 | 1069 | 633 | 1325 | 1200 | 1581 | 1318 | 1837 | 1759 |
| 46 | 119 | 302 | 429 | 558 | 525 | 814 | 1057 | 1070 | 649 | 1326 | 1222 | 1582 | 1340 | 1838 | 1770 |
| 47 | 187 | 303 | 552 | 559 | 650 | 815 | 1230 | 1071 | 815 | 1327 | 1370 | 1583 | 1470 | 1839 | 1861 |
| 48 | 35 | 304 | 183 | 560 | 227 | 816 | 668 | 1072 | 342 | 1328 | 805 | 1584 | 896 | 1840 | 1487 |
| 49 | 63 | 305 | 292 | 561 | 364 | 817 | 854 | 1073 | 468 | 1329 | 1012 | 1585 | 1129 | 1841 | 1639 |
| 50 | 77 | 306 | 305 | 562 | 383 | 818 | 883 | 1074 | 519 | 1330 | 1036 | 1586 | 1159 | 1842 | 1660 |
| 51 | 117 | 307 | 411 | 563 | 516 | 819 | 1055 | 1075 | 643 | 1331 | 1198 | 1587 | 1329 | 1843 | 1769 |
| 52 | 82 | 308 | 323 | 564 | 406 | 820 | 929 | 1076 | 537 | 1332 | 1066 | 1588 | 1191 | 1844 | 1691 |
| 53 | 126 | 309 | 440 | 565 | 543 | 821 | 1083 | 1077 | 669 | 1333 | 1236 | 1589 | 1361 | 1845 | 1786 |
| 54 | 136 | 310 | 455 | 566 | 559 | 822 | 1110 | 1078 | 695 | 1334 | 1256 | 1590 | 1377 | 1846 | 1801 |
| 55 | 199 | 311 | 590 | 567 | 693 | 823 | 1262 | 1079 | 841 | 1335 | 1410 | 1591 | 1509 | 1847 | 1876 |
| 56 | 90 | 312 | 350 | 568 | 416 | 824 | 954 | 1080 | 562 | 1336 | 1109 | 1592 | 1205 | 1848 | 1707 |
| 57 | 138 | 313 | 474 | 569 | 553 | 825 | 1136 | 1081 | 701 | 1337 | 1279 | 1593 | 1371 | 1849 | 1815 |
| 58 | 149 | 314 | 493 | 570 | 583 | 826 | 1145 | 1082 | 728 | 1338 | 1302 | 1594 | 1403 | 1850 | 1819 |
| 59 | 224 | 315 | 622 | 571 | 730 | 827 | 1308 | 1083 | 891 | 1339 | 1443 | 1595 | 1542 | 1851 | 1895 |
| 60 | 155 | 316 | 511 | 572 | 587 | 828 | 1174 | 1084 | 741 | 1340 | 1325 | 1596 | 1407 | 1852 | 1834 |
| 61 | 236 | 317 | 642 | 573 | 750 | 829 | 1335 | 1085 | 913 | 1341 | 1463 | 1597 | 1558 | 1853 | 1906 |
| 62 | 257 | 318 | 679 | 574 | 776 | 830 | 1366 | 1086 | 951 | 1342 | 1497 | 1598 | 1580 | 1854 | 1918 |
| 63 | 366 | 319 | 856 | 575 | 1011 | 831 | 1506 | 1087 | 1133 | 1343 | 1641 | 1599 | 1742 | 1855 | 1966 |
| 64 | 9 | 320 | 80 | 576 | 112 | 832 | 418 | 1088 | 162 | 1344 | 530 | 1600 | 630 | 1856 | 1207 |
| 65 | 19 | 321 | 169 | 577 | 203 | 833 | 651 | 1089 | 241 | 1345 | 775 | 1601 | 848 | 1857 | 1471 |
| 66 | 27 | 322 | 176 | 578 | 211 | 834 | 656 | 1090 | 295 | 1346 | 790 | 1602 | 864 | 1858 | 1476 |
| 67 | 56 | 323 | 268 | 579 | 336 | 835 | 823 | 1091 | 439 | 1347 | 972 | 1603 | 1087 | 1859 | 1616 |
| 68 | 31 | 324 | 191 | 580 | 222 | 836 | 670 | 1092 | 320 | 1348 | 824 | 1604 | 887 | 1860 | 1488 |
| 69 | 60 | 325 | 287 | 581 | 356 | 837 | 837 | 1093 | 456 | 1349 | 1004 | 1605 | 1118 | 1861 | 1627 |
| 70 | 73 | 326 | 304 | 582 | 371 | 838 | 865 | 1094 | 504 | 1350 | 1034 | 1606 | 1140 | 1862 | 1647 |
| 71 | 108 | 327 | 405 | 583 | 498 | 839 | 1043 | 1095 | 618 | 1351 | 1189 | 1607 | 1309 | 1863 | 1762 |
| 72 | 37 | 328 | 201 | 584 | 249 | 840 | 694 | 1096 | 353 | 1352 | 843 | 1608 | 937 | 1864 | 1511 |
| 73 | 78 | 329 | 310 | 585 | 386 | 841 | 894 | 1097 | 523 | 1353 | 1044 | 1609 | 1162 | 1865 | 1667 |
| 74 | 65 | 330 | 317 | 586 | 396 | 842 | 918 | 1098 | 472 | 1354 | 1056 | 1610 | 1177 | 1866 | 1683 |
| 75 | 120 | 331 | 437 | 587 | 536 | 843 | 1075 | 1099 | 652 | 1355 | 1233 | 1611 | 1353 | 1867 | 1781 |
| 76 | 87 | 332 | 335 | 588 | 419 | 844 | 944 | 1100 | 551 | 1356 | 1086 | 1612 | 1209 | 1868 | 1701 |
| 77 | 130 | 333 | 462 | 589 | 564 | 845 | 1104 | 1101 | 678 | 1357 | 1265 | 1613 | 1383 | 1869 | 1797 |
| 78 | 143 | 334 | 478 | 590 | 580 | 846 | 1141 | 1102 | 712 | 1358 | 1284 | 1614 | 1400 | 1870 | 1817 |
| 79 | 207 | 335 | 619 | 591 | 705 | 847 | 1298 | 1103 | 857 | 1359 | 1440 | 1615 | 1520 | 1871 | 1891 |
| 80 | 46 | 336 | 255 | 592 | 267 | 848 | 802 | 1104 | 393 | 1360 | 949 | 1616 | 970 | 1872 | 1601 |
| 81 | 76 | 337 | 330 | 593 | 399 | 849 | 927 | 1105 | 515 | 1361 | 1078 | 1617 | 1180 | 1873 | 1690 |
| 82 | 89 | 338 | 349 | 594 | 427 | 850 | 961 | 1106 | 558 | 1362 | 1107 | 1618 | 1219 | 1874 | 1712 |
| 83 | 137 | 339 | 466 | 595 | 556 | 851 | 1113 | 1107 | 698 | 1363 | 1270 | 1619 | 1374 | 1875 | 1802 |
| 84 | 95 | 340 | 367 | 596 | 447 | 852 | 985 | 1108 | 579 | 1364 | 1135 | 1620 | 1246 | 1876 | 1726 |
| 85 | 146 | 341 | 489 | 597 | 585 | 853 | 1158 | 1109 | 720 | 1365 | 1297 | 1621 | 1406 | 1877 | 1826 |
| 86 | 154 | 342 | 510 | 598 | 593 | 854 | 1178 | 1110 | 739 | 1366 | 1323 | 1622 | 1413 | 1878 | 1836 |
| 87 | 231 | 343 | 638 | 599 | 740 | 855 | 1327 | 1111 | 904 | 1367 | 1459 | 1623 | 1550 | 1879 | 1903 |
| 88 | 104 | 344 | 395 | 600 | 465 | 856 | 1041 | 1112 | 605 | 1368 | 1175 | 1624 | 1268 | 1880 | 1761 |
| 89 | 157 | 345 | 517 | 601 | 594 | 857 | 1181 | 1113 | 747 | 1369 | 1331 | 1625 | 1415 | 1881 | 1837 |
| 90 | 173 | 346 | 546 | 602 | 603 | 858 | 1218 | 1114 | 783 | 1370 | 1364 | 1626 | 1424 | 1882 | 1855 |
| 91 | 247 | 347 | 671 | 603 | 779 | 859 | 1360 | 1115 | 934 | 1371 | 1490 | 1627 | 1582 | 1883 | 1916 |
| 92 | 186 | 348 | 570 | 604 | 664 | 860 | 1254 | 1116 | 812 | 1372 | 1390 | 1628 | 1483 | 1884 | 1872 |
| 93 | 264 | 349 | 711 | 605 | 801 | 861 | 1395 | 1117 | 964 | 1373 | 1526 | 1629 | 1599 | 1885 | 1929 |
| 94 | 280 | 350 | 738 | 606 | 844 | 862 | 1411 | 1118 | 992 | 1374 | 1549 | 1630 | 1632 | 1886 | 1935 |
| 95 | 404 | 351 | 897 | 607 | 1024 | 863 | 1567 | 1119 | 1187 | 1375 | 1670 | 1631 | 1750 | 1887 | 1982 |
| 96 | 55 | 352 | 286 | 608 | 285 | 864 | 840 | 1120 | 435 | 1376 | 1002 | 1632 | 1000 | 1888 | 1629 |
| 97 | 92 | 353 | 362 | 609 | 446 | 865 | 989 | 1121 | 569 | 1377 | 1127 | 1633 | 1245 | 1889 | 1729 |
| 98 | 102 | 354 | 389 | 610 | 459 | 866 | 1027 | 1122 | 599 | 1378 | 1166 | 1634 | 1261 | 1890 | 1753 |
| 99 | 153 | 355 | 499 | 611 | 601 | 867 | 1160 | 1123 | 736 | 1379 | 1310 | 1635 | 1422 | 1891 | 1827 |
| 100 | 115 | 356 | 410 | 612 | 487 | 868 | 1053 | 1124 | 636 | 1380 | 1196 | 1636 | 1296 | 1892 | 1768 |
| 101 | 164 | 357 | 529 | 613 | 626 | 869 | 1208 | 1125 | 762 | 1381 | 1345 | 1637 | 1447 | 1893 | 1851 |
| 102 | 180 | 358 | 549 | 614 | 632 | 870 | 1235 | 1126 | 800 | 1382 | 1367 | 1638 | 1453 | 1894 | 1863 |
| 103 | 260 | 359 | 699 | 615 | 789 | 871 | 1372 | 1127 | 957 | 1383 | 1515 | 1639 | 1590 | 1895 | 1921 |
| 104 | 124 | 360 | 433 | 616 | 509 | 872 | 1090 | 1128 | 663 | 1384 | 1228 | 1640 | 1321 | 1896 | 1789 |
| 105 | 181 | 361 | 561 | 617 | 662 | 873 | 1244 | 1129 | 803 | 1385 | 1380 | 1641 | 1481 | 1897 | 1868 |
| 106 | 198 | 362 | 578 | 618 | 682 | 874 | 1267 | 1130 | 839 | 1386 | 1399 | 1642 | 1500 | 1898 | 1878 |
| 107 | 273 | 363 | 719 | 619 | 825 | 875 | 1408 | 1131 | 980 | 1387 | 1533 | 1643 | 1618 | 1899 | 1934 |
| 108 | 210 | 364 | 614 | 620 | 718 | 876 | 1295 | 1132 | 862 | 1388 | 1435 | 1644 | 1531 | 1900 | 1890 |
| 109 | 296 | 365 | 758 | 621 | 858 | 877 | 1432 | 1133 | 1018 | 1389 | 1565 | 1645 | 1642 | 1901 | 1942 |
| 110 | 311 | 366 | 781 | 622 | 876 | 878 | 1465 | 1134 | 1046 | 1390 | 1584 | 1646 | 1655 | 1902 | 1953 |
| 111 | 436 | 367 | 936 | 623 | 1065 | 879 | 1604 | 1135 | 1231 | 1391 | 1696 | 1647 | 1775 | 1903 | 1992 |
| 112 | 141 | 368 | 469 | 624 | 535 | 880 | 1119 | 1136 | 706 | 1392 | 1273 | 1648 | 1351 | 1904 | 1805 |
| 113 | 205 | 369 | 612 | 625 | 696 | 881 | 1282 | 1137 | 853 | 1393 | 1433 | 1649 | 1512 | 1905 | 1884 |
| 114 | 228 | 370 | 625 | 626 | 729 | 882 | 1314 | 1138 | 898 | 1394 | 1446 | 1650 | 1541 | 1906 | 1898 |
| 115 | 300 | 371 | 772 | 627 | 877 | 883 | 1452 | 1139 | 1028 | 1395 | 1577 | 1651 | 1656 | 1907 | 1949 |
| 116 | 234 | 372 | 639 | 628 | 761 | 884 | 1344 | 1140 | 909 | 1396 | 1460 | 1652 | 1568 | 1908 | 1910 |
| 117 | 312 | 373 | 799 | 629 | 895 | 885 | 1475 | 1141 | 1048 | 1397 | 1598 | 1653 | 1669 | 1909 | 1956 |
| 118 | 334 | 374 | 764 | 630 | 940 | 886 | 1503 | 1142 | 1084 | 1398 | 1570 | 1654 | 1698 | 1910 | 1965 |
| 119 | 463 | 375 | 963 | 631 | 1094 | 887 | 1635 | 1143 | 1266 | 1399 | 1713 | 1655 | 1791 | 1911 | 1999 |
| 120 | 253 | 376 | 686 | 632 | 808 | 888 | 1378 | 1144 | 945 | 1400 | 1504 | 1656 | 1605 | 1912 | 1923 |
| 121 | 341 | 377 | 851 | 633 | 946 | 889 | 1517 | 1145 | 1095 | 1401 | 1637 | 1657 | 1702 | 1913 | 1969 |
| 122 | 360 | 378 | 872 | 634 | 981 | 890 | 1539 | 1146 | 1124 | 1402 | 1652 | 1658 | 1724 | 1914 | 1975 |
| 123 | 485 | 379 | 1019 | 635 | 1128 | 891 | 1659 | 1147 | 1293 | 1403 | 1747 | 1659 | 1810 | 1915 | 2004 |
| 124 | 378 | 380 | 881 | 636 | 1003 | 892 | 1559 | 1148 | 1151 | 1404 | 1658 | 1660 | 1737 | 1916 | 1980 |
| 125 | 505 | 381 | 1077 | 637 | 1163 | 893 | 1700 | 1149 | 1317 | 1405 | 1782 | 1661 | 1828 | 1917 | 2013 |
| 126 | 540 | 382 | 1108 | 638 | 1201 | 894 | 1710 | 1150 | 1357 | 1406 | 1800 | 1662 | 1848 | 1918 | 2015 |
| 127 | 721 | 383 | 1225 | 639 | 1375 | 895 | 1847 | 1151 | 1534 | 1407 | 1859 | 1663 | 1922 | 1919 | 2035 |
| 128 | 16 | 384 | 86 | 640 | 116 | 896 | 425 | 1152 | 217 | 1408 | 548 | 1664 | 640 | 1920 | 1217 |
| 129 | 26 | 385 | 189 | 641 | 219 | 897 | 673 | 1153 | 289 | 1409 | 820 | 1665 | 880 | 1921 | 1491 |
| 130 | 32 | 386 | 194 | 642 | 239 | 898 | 683 | 1154 | 325 | 1410 | 829 | 1666 | 919 | 1922 | 1501 |
| 131 | 75 | 387 | 322 | 643 | 382 | 899 | 921 | 1155 | 512 | 1411 | 1064 | 1667 | 1157 | 1923 | 1686 |
| 132 | 41 | 388 | 246 | 644 | 265 | 900 | 786 | 1156 | 368 | 1412 | 932 | 1668 | 966 | 1924 | 1588 |
| 133 | 81 | 389 | 339 | 645 | 397 | 901 | 938 | 1157 | 534 | 1413 | 1091 | 1669 | 1179 | 1925 | 1697 |
| 134 | 85 | 390 | 352 | 646 | 422 | 902 | 956 | 1158 | 544 | 1414 | 1112 | 1670 | 1212 | 1926 | 1708 |
| 135 | 142 | 391 | 473 | 647 | 568 | 903 | 1134 | 1159 | 709 | 1415 | 1278 | 1671 | 1388 | 1927 | 1813 |
| 136 | 50 | 392 | 270 | 648 | 279 | 904 | 814 | 1160 | 412 | 1416 | 974 | 1672 | 990 | 1928 | 1610 |
| 137 | 88 | 393 | 357 | 649 | 431 | 905 | 975 | 1161 | 555 | 1417 | 1120 | 1673 | 1224 | 1929 | 1720 |
| 138 | 96 | 394 | 369 | 650 | 450 | 906 | 995 | 1162 | 582 | 1418 | 1137 | 1674 | 1250 | 1930 | 1732 |
| 139 | 152 | 395 | 495 | 651 | 596 | 907 | 1165 | 1163 | 733 | 1419 | 1305 | 1675 | 1416 | 1931 | 1829 |
| 140 | 105 | 396 | 394 | 652 | 470 | 908 | 1033 | 1164 | 608 | 1420 | 1173 | 1676 | 1275 | 1932 | 1756 |
| 141 | 163 | 397 | 520 | 653 | 609 | 909 | 1192 | 1165 | 760 | 1421 | 1334 | 1677 | 1430 | 1933 | 1843 |
| 142 | 167 | 398 | 545 | 654 | 616 | 910 | 1227 | 1166 | 770 | 1422 | 1362 | 1678 | 1437 | 1934 | 1860 |
| 143 | 259 | 399 | 702 | 655 | 784 | 911 | 1369 | 1167 | 955 | 1423 | 1518 | 1679 | 1586 | 1935 | 1919 |
| 144 | 58 | 400 | 284 | 656 | 309 | 912 | 845 | 1168 | 448 | 1424 | 998 | 1680 | 1042 | 1936 | 1633 |
| 145 | 97 | 401 | 391 | 657 | 461 | 913 | 1013 | 1169 | 586 | 1425 | 1170 | 1681 | 1263 | 1937 | 1743 |
| 146 | 107 | 402 | 409 | 658 | 486 | 914 | 1049 | 1170 | 615 | 1426 | 1195 | 1682 | 1294 | 1938 | 1766 |
| 147 | 165 | 403 | 521 | 659 | 617 | 915 | 1199 | 1171 | 765 | 1427 | 1336 | 1683 | 1438 | 1939 | 1846 |
| 148 | 118 | 404 | 423 | 660 | 507 | 916 | 1071 | 1172 | 646 | 1428 | 1214 | 1684 | 1320 | 1940 | 1779 |
| 149 | 179 | 405 | 550 | 661 | 657 | 917 | 1237 | 1173 | 798 | 1429 | 1368 | 1685 | 1477 | 1941 | 1864 |
| 150 | 195 | 406 | 573 | 662 | 676 | 918 | 1269 | 1174 | 832 | 1430 | 1393 | 1686 | 1494 | 1942 | 1879 |
| 151 | 275 | 407 | 726 | 663 | 819 | 919 | 1404 | 1175 | 984 | 1431 | 1538 | 1687 | 1614 | 1943 | 1932 |
| 152 | 129 | 408 | 445 | 664 | 533 | 920 | 1106 | 1176 | 675 | 1432 | 1243 | 1688 | 1350 | 1944 | 1798 |
| 153 | 196 | 409 | 581 | 665 | 690 | 921 | 1290 | 1177 | 834 | 1433 | 1402 | 1689 | 1507 | 1945 | 1888 |
| 154 | 206 | 410 | 604 | 666 | 716 | 922 | 1264 | 1178 | 855 | 1434 | 1425 | 1690 | 1530 | 1946 | 1877 |
| 155 | 290 | 411 | 751 | 667 | 867 | 923 | 1423 | 1179 | 1008 | 1435 | 1560 | 1691 | 1648 | 1947 | 1939 |
| 156 | 230 | 412 | 637 | 668 | 742 | 924 | 1330 | 1180 | 902 | 1436 | 1457 | 1692 | 1552 | 1948 | 1904 |
| 157 | 307 | 413 | 777 | 669 | 888 | 925 | 1461 | 1181 | 1040 | 1437 | 1581 | 1693 | 1663 | 1949 | 1952 |
| 158 | 329 | 414 | 816 | 670 | 923 | 926 | 1489 | 1182 | 1076 | 1438 | 1611 | 1694 | 1687 | 1950 | 1960 |
| 159 | 453 | 415 | 971 | 671 | 1067 | 927 | 1617 | 1183 | 1253 | 1439 | 1718 | 1695 | 1776 | 1951 | 1995 |
| 160 | 67 | 416 | 326 | 672 | 333 | 928 | 933 | 1184 | 480 | 1440 | 1070 | 1696 | 1082 | 1952 | 1693 |
| 161 | 111 | 417 | 414 | 673 | 497 | 929 | 1061 | 1185 | 627 | 1441 | 1202 | 1697 | 1307 | 1953 | 1773 |
| 162 | 125 | 418 | 428 | 674 | 524 | 930 | 1081 | 1186 | 666 | 1442 | 1221 | 1698 | 1339 | 1954 | 1785 |
| 163 | 185 | 419 | 571 | 675 | 680 | 931 | 1249 | 1187 | 810 | 1443 | 1391 | 1699 | 1498 | 1955 | 1870 |
| 164 | 131 | 420 | 454 | 676 | 560 | 932 | 1130 | 1188 | 681 | 1444 | 1255 | 1700 | 1379 | 1956 | 1811 |
| 165 | 197 | 421 | 597 | 677 | 710 | 933 | 1274 | 1189 | 836 | 1445 | 1418 | 1701 | 1525 | 1957 | 1881 |
| 166 | 213 | 422 | 628 | 678 | 707 | 934 | 1311 | 1190 | 869 | 1446 | 1449 | 1702 | 1522 | 1958 | 1897 |
| 167 | 301 | 423 | 766 | 679 | 890 | 935 | 1445 | 1191 | 1030 | 1447 | 1572 | 1703 | 1665 | 1959 | 1946 |
| 168 | 150 | 424 | 494 | 680 | 575 | 936 | 1154 | 1192 | 731 | 1448 | 1304 | 1704 | 1396 | 1960 | 1824 |
| 169 | 226 | 425 | 629 | 681 | 734 | 937 | 1316 | 1193 | 893 | 1449 | 1450 | 1705 | 1545 | 1961 | 1899 |
| 170 | 235 | 426 | 645 | 682 | 748 | 938 | 1341 | 1194 | 911 | 1450 | 1466 | 1706 | 1557 | 1962 | 1909 |
| 171 | 315 | 427 | 813 | 683 | 916 | 939 | 1478 | 1195 | 1052 | 1451 | 1609 | 1707 | 1682 | 1963 | 1957 |
| 172 | 252 | 428 | 688 | 684 | 791 | 940 | 1363 | 1196 | 943 | 1452 | 1505 | 1708 | 1592 | 1964 | 1917 |
| 173 | 340 | 429 | 794 | 685 | 942 | 941 | 1496 | 1197 | 1093 | 1453 | 1594 | 1709 | 1699 | 1965 | 1962 |
| 174 | 354 | 430 | 863 | 686 | 958 | 942 | 1528 | 1198 | 1114 | 1454 | 1646 | 1710 | 1709 | 1966 | 1972 |
| 175 | 483 | 431 | 1023 | 687 | 1132 | 943 | 1654 | 1199 | 1291 | 1455 | 1749 | 1711 | 1812 | 1967 | 2003 |
| 176 | 166 | 432 | 528 | 688 | 607 | 944 | 1206 | 1200 | 768 | 1456 | 1343 | 1712 | 1428 | 1968 | 1850 |
| 177 | 244 | 433 | 665 | 689 | 763 | 945 | 1352 | 1201 | 928 | 1457 | 1484 | 1713 | 1569 | 1969 | 1913 |
| 178 | 261 | 434 | 708 | 690 | 804 | 946 | 1384 | 1202 | 960 | 1458 | 1523 | 1714 | 1602 | 1970 | 1925 |
| 179 | 346 | 435 | 852 | 691 | 952 | 947 | 1510 | 1203 | 1103 | 1459 | 1638 | 1715 | 1706 | 1971 | 1967 |
| 180 | 274 | 436 | 727 | 692 | 821 | 948 | 1417 | 1204 | 982 | 1460 | 1540 | 1716 | 1615 | 1972 | 1937 |
| 181 | 373 | 437 | 879 | 693 | 991 | 949 | 1547 | 1205 | 1144 | 1461 | 1657 | 1717 | 1730 | 1973 | 1977 |
| 182 | 381 | 438 | 901 | 694 | 1005 | 950 | 1563 | 1206 | 1155 | 1462 | 1672 | 1718 | 1738 | 1974 | 1981 |
| 183 | 502 | 439 | 1059 | 695 | 1169 | 951 | 1689 | 1207 | 1313 | 1463 | 1772 | 1719 | 1832 | 1975 | 2011 |
| 184 | 297 | 440 | 759 | 696 | 849 | 952 | 1436 | 1208 | 1020 | 1464 | 1566 | 1720 | 1636 | 1976 | 1943 |
| 185 | 392 | 441 | 910 | 697 | 1021 | 953 | 1587 | 1209 | 1171 | 1465 | 1678 | 1721 | 1748 | 1977 | 1988 |
| 186 | 420 | 442 | 908 | 698 | 1047 | 954 | 1600 | 1210 | 1210 | 1466 | 1677 | 1722 | 1765 | 1978 | 1991 |
| 187 | 531 | 443 | 1100 | 699 | 1213 | 955 | 1722 | 1211 | 1347 | 1467 | 1795 | 1723 | 1853 | 1979 | 2017 |
| 188 | 441 | 444 | 965 | 700 | 1098 | 956 | 1630 | 1212 | 1238 | 1468 | 1714 | 1724 | 1794 | 1980 | 1998 |
| 189 | 557 | 445 | 1123 | 701 | 1247 | 957 | 1739 | 1213 | 1376 | 1469 | 1808 | 1725 | 1869 | 1981 | 2020 |
| 190 | 613 | 446 | 1149 | 702 | 1287 | 958 | 1752 | 1214 | 1434 | 1470 | 1821 | 1726 | 1887 | 1982 | 2022 |
| 191 | 722 | 447 | 1303 | 703 | 1442 | 959 | 1822 | 1215 | 1535 | 1471 | 1893 | 1727 | 1945 | 1983 | 2032 |
| 192 | 71 | 448 | 361 | 704 | 351 | 960 | 987 | 1216 | 496 | 1472 | 1126 | 1728 | 1111 | 1984 | 1727 |
| 193 | 127 | 449 | 442 | 705 | 539 | 961 | 1088 | 1217 | 672 | 1473 | 1239 | 1729 | 1356 | 1985 | 1788 |
| 194 | 145 | 450 | 475 | 706 | 563 | 962 | 1152 | 1218 | 717 | 1474 | 1281 | 1730 | 1382 | 1986 | 1823 |
| 195 | 216 | 451 | 631 | 707 | 737 | 963 | 1319 | 1219 | 875 | 1475 | 1451 | 1731 | 1548 | 1987 | 1900 |
| 196 | 161 | 452 | 518 | 708 | 591 | 964 | 1190 | 1220 | 757 | 1476 | 1333 | 1732 | 1412 | 1988 | 1842 |
| 197 | 232 | 453 | 647 | 709 | 756 | 965 | 1338 | 1221 | 906 | 1477 | 1467 | 1733 | 1564 | 1989 | 1908 |
| 198 | 251 | 454 | 677 | 710 | 792 | 966 | 1355 | 1222 | 941 | 1478 | 1495 | 1734 | 1593 | 1990 | 1914 |
| 199 | 344 | 455 | 828 | 711 | 948 | 967 | 1499 | 1223 | 1099 | 1479 | 1620 | 1735 | 1703 | 1991 | 1963 |
| 200 | 171 | 456 | 547 | 712 | 654 | 968 | 1223 | 1224 | 780 | 1480 | 1365 | 1736 | 1474 | 1992 | 1858 |
| 201 | 254 | 457 | 700 | 713 | 806 | 969 | 1389 | 1225 | 947 | 1481 | 1516 | 1737 | 1603 | 1993 | 1927 |
| 202 | 266 | 458 | 714 | 714 | 833 | 970 | 1401 | 1226 | 968 | 1482 | 1529 | 1738 | 1624 | 1994 | 1931 |
| 203 | 365 | 459 | 874 | 715 | 997 | 971 | 1536 | 1227 | 1131 | 1483 | 1653 | 1739 | 1734 | 1995 | 1974 |
| 204 | 281 | 460 | 745 | 716 | 838 | 972 | 1426 | 1228 | 994 | 1484 | 1554 | 1740 | 1628 | 1996 | 1940 |
| 205 | 380 | 461 | 885 | 717 | 1009 | 973 | 1551 | 1229 | 1153 | 1485 | 1661 | 1741 | 1741 | 1997 | 1978 |
| 206 | 402 | 462 | 907 | 718 | 1035 | 974 | 1595 | 1230 | 1186 | 1486 | 1676 | 1742 | 1757 | 1998 | 1990 |
| 207 | 522 | 463 | 1073 | 719 | 1194 | 975 | 1705 | 1231 | 1337 | 1487 | 1780 | 1743 | 1844 | 1999 | 2014 |
| 208 | 193 | 464 | 574 | 720 | 667 | 976 | 1232 | 1232 | 827 | 1488 | 1394 | 1744 | 1486 | 2000 | 1862 |
| 209 | 277 | 465 | 732 | 721 | 835 | 977 | 1420 | 1233 | 986 | 1489 | 1544 | 1745 | 1625 | 2001 | 1938 |
| 210 | 291 | 466 | 767 | 722 | 847 | 978 | 1448 | 1234 | 1010 | 1490 | 1573 | 1746 | 1634 | 2002 | 1947 |
| 211 | 390 | 467 | 899 | 723 | 1029 | 979 | 1583 | 1235 | 1168 | 1491 | 1671 | 1747 | 1754 | 2003 | 1987 |
| 212 | 313 | 468 | 782 | 724 | 892 | 980 | 1485 | 1236 | 1050 | 1492 | 1585 | 1748 | 1666 | 2004 | 1959 |
| 213 | 415 | 469 | 912 | 725 | 1045 | 981 | 1608 | 1237 | 1203 | 1493 | 1680 | 1749 | 1763 | 2005 | 1993 |
| 214 | 438 | 470 | 967 | 726 | 1085 | 982 | 1612 | 1238 | 1234 | 1494 | 1715 | 1750 | 1787 | 2006 | 1994 |
| 215 | 566 | 471 | 1125 | 727 | 1240 | 983 | 1745 | 1239 | 1385 | 1495 | 1809 | 1751 | 1866 | 2007 | 2021 |
| 216 | 324 | 472 | 826 | 728 | 931 | 984 | 1521 | 1240 | 1068 | 1496 | 1619 | 1752 | 1692 | 2008 | 1970 |
| 217 | 444 | 473 | 979 | 729 | 1096 | 985 | 1640 | 1241 | 1241 | 1497 | 1723 | 1753 | 1793 | 2009 | 2000 |
| 218 | 467 | 474 | 1001 | 730 | 1115 | 986 | 1649 | 1242 | 1271 | 1498 | 1736 | 1754 | 1803 | 2010 | 2002 |
| 219 | 588 | 475 | 1156 | 731 | 1259 | 987 | 1758 | 1243 | 1409 | 1499 | 1825 | 1755 | 1874 | 2011 | 2023 |
| 220 | 491 | 476 | 1039 | 732 | 1147 | 988 | 1679 | 1244 | 1301 | 1500 | 1760 | 1756 | 1820 | 2012 | 2009 |
| 221 | 623 | 477 | 1197 | 733 | 1306 | 989 | 1792 | 1245 | 1444 | 1501 | 1845 | 1757 | 1894 | 2013 | 2028 |
| 222 | 644 | 478 | 1220 | 734 | 1332 | 990 | 1806 | 1246 | 1464 | 1502 | 1857 | 1758 | 1905 | 2014 | 2030 |
| 223 | 818 | 479 | 1381 | 735 | 1468 | 991 | 1896 | 1247 | 1613 | 1503 | 1924 | 1759 | 1954 | 2015 | 2040 |
| 224 | 212 | 480 | 620 | 736 | 691 | 992 | 1300 | 1248 | 866 | 1504 | 1441 | 1760 | 1508 | 2016 | 1892 |
| 225 | 303 | 481 | 774 | 737 | 903 | 993 | 1472 | 1249 | 1032 | 1505 | 1578 | 1761 | 1674 | 2017 | 1955 |
| 226 | 318 | 482 | 809 | 738 | 920 | 994 | 1482 | 1250 | 1058 | 1506 | 1606 | 1762 | 1685 | 2018 | 1958 |
| 227 | 424 | 483 | 969 | 739 | 1069 | 995 | 1621 | 1251 | 1215 | 1507 | 1717 | 1763 | 1777 | 2019 | 1996 |
| 228 | 348 | 484 | 861 | 740 | 959 | 996 | 1532 | 1252 | 1105 | 1508 | 1645 | 1764 | 1711 | 2020 | 1973 |
| 229 | 451 | 485 | 973 | 741 | 1102 | 997 | 1644 | 1253 | 1251 | 1509 | 1719 | 1765 | 1796 | 2021 | 2001 |
| 230 | 471 | 486 | 1031 | 742 | 1121 | 998 | 1664 | 1254 | 1276 | 1510 | 1755 | 1766 | 1807 | 2022 | 2005 |
| 231 | 606 | 487 | 1167 | 743 | 1277 | 999 | 1771 | 1255 | 1427 | 1511 | 1831 | 1767 | 1882 | 2023 | 2025 |
| 232 | 377 | 488 | 868 | 744 | 983 | 1000 | 1555 | 1256 | 1150 | 1512 | 1650 | 1768 | 1725 | 2024 | 1979 |
| 233 | 479 | 489 | 1025 | 745 | 1143 | 1001 | 1684 | 1257 | 1286 | 1513 | 1751 | 1769 | 1818 | 2025 | 2010 |
| 234 | 503 | 490 | 1063 | 746 | 1172 | 1002 | 1694 | 1258 | 1315 | 1514 | 1774 | 1770 | 1833 | 2026 | 2012 |
| 235 | 635 | 491 | 1211 | 747 | 1322 | 1003 | 1799 | 1259 | 1456 | 1515 | 1852 | 1771 | 1901 | 2027 | 2029 |
| 236 | 532 | 492 | 1092 | 748 | 1204 | 1004 | 1728 | 1260 | 1348 | 1516 | 1790 | 1772 | 1849 | 2028 | 2018 |
| 237 | 648 | 493 | 1242 | 749 | 1349 | 1005 | 1814 | 1261 | 1469 | 1517 | 1867 | 1773 | 1912 | 2029 | 2031 |
| 238 | 697 | 494 | 1285 | 750 | 1386 | 1006 | 1856 | 1262 | 1514 | 1518 | 1886 | 1774 | 1926 | 2030 | 2036 |
| 239 | 870 | 495 | 1439 | 751 | 1524 | 1007 | 1920 | 1263 | 1651 | 1519 | 1944 | 1775 | 1971 | 2031 | 2042 |
| 240 | 401 | 496 | 886 | 752 | 1051 | 1008 | 1575 | 1264 | 1184 | 1520 | 1662 | 1776 | 1767 | 2032 | 1985 |
| 241 | 513 | 497 | 1079 | 753 | 1176 | 1009 | 1716 | 1265 | 1326 | 1521 | 1783 | 1777 | 1835 | 2033 | 2016 |
| 242 | 542 | 498 | 1117 | 754 | 1216 | 1010 | 1733 | 1266 | 1359 | 1522 | 1804 | 1778 | 1854 | 2034 | 2019 |
| 243 | 674 | 499 | 1257 | 755 | 1358 | 1011 | 1830 | 1267 | 1493 | 1523 | 1873 | 1779 | 1915 | 2035 | 2033 |
| 244 | 554 | 500 | 1138 | 756 | 1252 | 1012 | 1764 | 1268 | 1373 | 1524 | 1816 | 1780 | 1871 | 2036 | 2024 |
| 245 | 713 | 501 | 1292 | 757 | 1398 | 1013 | 1838 | 1269 | 1527 | 1525 | 1889 | 1781 | 1930 | 2037 | 2034 |
| 246 | 735 | 502 | 1272 | 758 | 1414 | 1014 | 1865 | 1270 | 1546 | 1526 | 1880 | 1782 | 1936 | 2038 | 2037 |
| 247 | 914 | 503 | 1458 | 759 | 1571 | 1015 | 1933 | 1271 | 1681 | 1527 | 1951 | 1783 | 1983 | 2039 | 2043 |
| 248 | 610 | 504 | 1183 | 760 | 1280 | 1016 | 1778 | 1272 | 1431 | 1528 | 1839 | 1784 | 1883 | 2040 | 2026 |
| 249 | 746 | 505 | 1324 | 761 | 1429 | 1017 | 1875 | 1273 | 1556 | 1529 | 1902 | 1785 | 1941 | 2041 | 2038 |
| 250 | 771 | 506 | 1346 | 762 | 1455 | 1018 | 1885 | 1274 | 1576 | 1530 | 1911 | 1786 | 1950 | 2042 | 2039 |
| 251 | 905 | 507 | 1513 | 763 | 1591 | 1019 | 1948 | 1275 | 1675 | 1531 | 1968 | 1787 | 1989 | 2043 | 2044 |
| 252 | 797 | 508 | 1392 | 764 | 1492 | 1020 | 1907 | 1276 | 1597 | 1532 | 1928 | 1788 | 1961 | 2044 | 2041 |
| 253 | 950 | 509 | 1543 | 765 | 1626 | 1021 | 1964 | 1277 | 1704 | 1533 | 1976 | 1789 | 1997 | 2045 | 2045 |
| 254 | 1007 | 510 | 1579 | 766 | 1668 | 1022 | 1984 | 1278 | 1740 | 1534 | 1986 | 1790 | 2006 | 2046 | 2046 |
| 255 | 1188 | 511 | 1673 | 767 | 1784 | 1023 | 2008 | 1279 | 1841 | 1535 | 2007 | 1791 | 2027 | 2047 | 2047 |

It should be noted that the foregoing sequences are merely some examples, and application of the sequences to a polar coding process can improve polar code encoding/decoding performance. In any one of the example sequences, without affecting an overall effect, adjustments or equivalent replacements including but not limited to the following aspects may be made:
1. Locations of a few elements in the sequence are interchanged. For example, a location of a sequence number may be adjusted within a specified range. For example, if the specified range is 5, a location of an element whose sequence number is 10 may be adjusted within a range between a fifth location to the left of the element and a fifth location to the right of the element.
2. Some elements in the sequence are adjusted, but channel sets that are selected based on the sequence and that are used to transmit T-bit information are consistent or similar.
3. The sequence includes N elements from 0 to N-1, and the N elements from 0 to N-1 represent sequence numbers of N polarized channels. Actually, the sequence numbers of the N polarized channels may be alternatively from 1 to N, and are obtained by adding 1 to each sequence number in the sequence. This is also a form of a sequence number in the foregoing calculation methods. Certainly, another manner may be alternatively used to indicate the sequence numbers or identifiers of the polarized channels. The specific expression manner does not affect specific locations of the polarized channels indicated in the sequence.
4. The sequence numbers of the N polarized channels in the sequence are arranged in ascending order of reliability of the N polarized channels. In this case, selecting K polarized channels in descending order of reliability means selecting polarized channels corresponding to the last K sequence numbers in any one of the foregoing sequences. Actually, the sequence numbers of the N polarized channels may be alternatively arranged in descending order of reliability of the N polarized channels, in other words, elements in the sequence are arranged in reverse order. In this case, selecting K polarized channels in descending order of reliability means selecting polarized channels corresponding to the first K sequence numbers.
5. The sequence may be alternatively represented by using a sequence of normalized reliability or equivalent reliability of all channels. For example, if a sorting location of a channel x in the sequence is n (the leftmost is denoted as 1), reliability of the channel may be indicated as n or normalized n/N, where N is a length of the sequence.

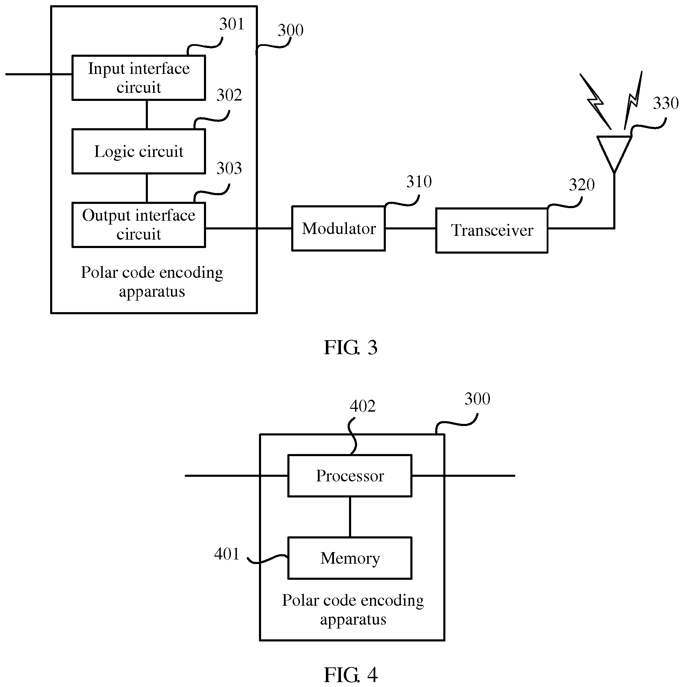

Based on a same inventive concept of the polar code encoding method shown in FIG. 2, as shown in FIG. 3, an embodiment of this application further provides a polar code encoding apparatus 300. The polar code encoding apparatus 300 is configured to perform the polar code encoding method shown in FIG. 2. A part or all of the polar code encoding method shown in FIG. 3 may be implemented by using hardware or software. When the method is implemented by using hardware, the polar code encoding apparatus 300 includes: an input interface circuit 301, configured to obtain a to-be-encoded bit; a logic circuit 302, configured to perform the polar code encoding method shown in FIG. 2, where for details, reference may be made to descriptions in the foregoing method embodiment, and details are not described herein again; and an output interface circuit 303, configured to output an encoded bit sequence.

Further, a modulator 310 modulates the encoded bit sequence output by the encoding apparatus 300, and then outputs a modulated bit sequence to a transceiver 320. The transceiver 320 performs corresponding processing (including but not limited to digital-to-analog conversion and/or frequency conversion) on the modulated sequence, and then sends, by using an antenna 330, a sequence obtained after processing.

Optionally, in specific implementation, the polar code encoding apparatus 300 may be a chip or an integrated circuit.

Optionally, when a part or all of the polar code encoding method in the foregoing embodiment is implemented by using software, as shown in FIG. 4, a polar code encoding apparatus 300 includes: a memory 401, configured to store a program; and a processor 402, configured to execute the program stored in the memory 401. When the program is executed, the polar code encoding apparatus 300 may implement the polar code encoding method provided in the embodiment in FIG. 2.

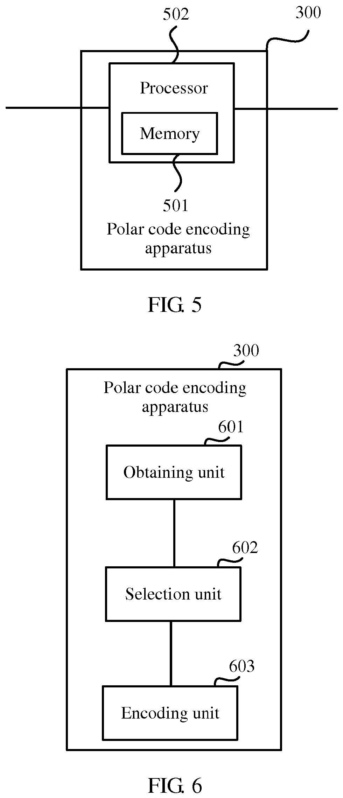

Optionally, the memory 401 may be a physically independent unit. Alternatively, as shown in FIG. 5, a memory 501 may be integrated with a processor 502.

Optionally, when a part or all of the encoding method in the embodiment in FIG. 2 is implemented by using software, the polar code transmission apparatus 300 may include only a processor 402. A memory 401 configured to store a program is located outside the polar code transmission apparatus 300. The processor 402 is connected to the memory 401 by using a circuit/wire, and is configured to read and execute the program stored in the memory 401.

The processor 402 may be a central processing unit (central processing unit, CPU), a network processor (network processor, NP), or a combination of a CPU and an NP.

The processor 402 may further include a hardware chip. The hardware chip may be an application-specific integrated circuit (application-specific integrated circuit, ASIC), a programmable logic device (programmable logic device, PLD), or a combination thereof. The PLD may be a complex programmable logic device (complex programmable logic device, CPLD), a field programmable gate array (field-programmable gate array, FPGA), generic array logic (generic array logic, GAL), or any combination thereof.

The memory in the foregoing embodiments may include a volatile memory (volatile memory), for example, a random access memory (random-access memory, RAM). The memory may also include a non-volatile memory (non-volatile memory), for example, a flash memory (flash memory), a hard disk drive (hard disk drive, HDD), or a solid-state drive (solid-state drive, SSD). The memory may further include a combination of the foregoing types of memories.

Based on the polar code encoding method shown in FIG. 2, as shown in FIG. 6, an embodiment of this application further provides a polar code encoding apparatus 300. The polar code encoding apparatus 300 is configured to perform the polar code encoding method shown in FIG. 2. The polar code encoding apparatus 300 includes:
an obtaining unit 601, configured to obtain a first sequence used to encode K to-be-encoded bits, where the first sequence includes sequence numbers of N polarized channels, the sequence numbers of the N polarized channels are arranged in the first sequence based on reliability of the N polarized channels, K is a positive integer, N is a mother code length of a polar code, N is a positive integer power of 2, and K ≤ N;
a selection unit 602, configured to select sequence numbers of K polarized channels from the first sequence in ascending order of reliability; and
an encoding unit 603, configured to: place the to-be-encoded bits based on the selected sequence numbers of the K polarized channels, and perform polar code encoding on the to-be-encoded bits.

The first sequence may be any one of the foregoing example sequences, or may be a sequence of sequence numbers that are less than N (the sequence numbers start from 0) and that are selected from a second sequence of a length Nₘₐₓ. The second sequence may be any one of the foregoing example sequences. Reliability of an i^{th} polarized channel in the N polarized channels may also be determined by using a formula in any one of the foregoing examples.

An embodiment of this application further provides a computer storage medium. The computer storage medium stores a computer program, and the computer program includes an instruction used to perform the polar code encoding method shown in FIG. 2.

An embodiment of this application further provides a computer program product including an instruction. When the computer program product runs on a computer, the computer performs the polar code encoding method shown in FIG. 2.

Persons skilled in the art should understand that the embodiments of this application may be provided as a method, a system, or a computer program product. Therefore, this application may use a form of hardware only embodiments, software only embodiments, or embodiments with a combination of software and hardware. Moreover, this application may use a form of a computer program product that is implemented on one or more computer-usable storage media (including but not limited to a disk memory, a CD-ROM, an optical memory, and the like) that include computer usable program code.

This application is described with reference to the flowcharts and/or block diagrams of the method, the device (system), and the computer program product according to the embodiments of this application. It should be understood that computer program instructions may be used to implement each process and/or each block in the flowcharts and/or the block diagrams and a combination of a process and/or a block in the flowcharts and/or the block diagrams. These computer program instructions may be provided for a general-purpose computer, a dedicated computer, an embedded processor, or a processor of another programmable data processing device to generate a machine, so that the instructions executed by the computer or the processor of another programmable data processing device generate an apparatus for implementing a specific function in one or more processes in the flowcharts and/or in one or more blocks in the block diagrams.

These computer program instructions may be stored in a computer readable memory that can instruct the computer or the another programmable data processing device to work in a specific manner, so that the instructions stored in the computer readable memory generate an artifact that includes an instruction apparatus. The instruction apparatus implements a specific function in one or more processes in the flowcharts and/or in one or more blocks in the block diagrams.

These computer program instructions may be loaded onto a computer or another programmable data processing device, so that a series of operations and steps are performed on the computer or the another programmable device, thereby generating computer-implemented processing. Therefore, the instructions executed on the computer or the another programmable device provide steps for implementing a specific function in one or more processes in the flowcharts and/or in one or more blocks in the block diagrams.

## Claims

1. A polar polar code encoding method, comprising:
obtaining (201), by an encoding apparatus (300), a first sequence used to encode K to-be-encoded bits, wherein the first sequence comprises sequence numbers of N polarized channels, the sequence numbers of the N polarized channels are arranged in the first sequence based on reliability of the N polarized channels, K is a positive integer, N is a mother code length of a polar code, N = 2ⁿ, n is a positive integer, and K ≤ N;
selecting (202) sequence numbers of K polarized channels from the first sequence in descending order of reliability; and
placing (203) the to-be-encoded bits based on the selected sequence numbers of the K polarized channels, and performing polar code encoding on the to-be-encoded bits;
wherein the first sequence is all of a second sequence, the second sequence comprises sequence numbers of Nₘₐₓ polarized channels, the sequence numbers of the Nₘₐₓ polarized channels are arranged in the second sequence based on reliability of the Nₘₐₓ polarized channels, Nₘₐₓ is a positive integer, Nₘₐₓ ≥ N, and a sorting of the sequence numbers of the polarized channels in the first sequence is consistent with a sorting of sequence numbers of polarized channels that are less than N in the second sequence;
**characterized in that**
the second sequence is a part or all of a sequence Q1, a sequence Q2 or a sequence Q3;
where the sequence Q1 is given by
[0,1,2,4,8,16,32,3,5,64,1024,2048,4096,9,6,17,10,18,128,12,33,65,20,256,34,24,36,7,129,6 6,512,11,40,68,130,19,13,48,14,72,257,1025,21,132,35,258,26,2049,513,80,37,25,22,4097, 136,260,264,38,514,96,67,41,144,28,69,42,516,49,1026,74,272,160,520,288,528,192,544, 70,44,131,81,2050,50,73,15,320,133,52,1028,23,134,384,76,4098,137,82,56,27,97,39,259, 84,138,145,261,1032,29,43,2052,98,515,88,140,30,146,71,262,265,161,576,45,1040,100,6 40,51,148,46,75,4100,266,273,517,2056,104,162,53,193,1056,152,77,164,768,268,274,51 8,54,83,57,521,1027,112,135,2064,78,289,194,85,276,4104,522,58,168,1029,139,99,86,60, 280,89,290,529,2080,524,196,1088,141,101,147,176,142,530,321,31,200,1033,4112,90,5 45,292,2051,322,532,263,149,102,105,1030,304,296,163,92,47,267,385,546,2053,324,104 1,208,386,4128,150,153,165,106,55,1034,328,536,577,548,2112,113,154,79,269,1042,108, 578,224,166,519,552,195,4099,1152,270,3072,641,523,275,580,291,59,1036,169,560,114, 277,156,2057,87,197,1057,116,170,4101,61,531,525,642,281,1089,278,526,2054,177,293, 388,91,1044,584,769,198,172,120,4160,201,2065,336,1280,62,282,143,103,178,294,1058, 93,644,2058,202,592,323,1048,392,5120,297,770,107,180,151,1060,2066,209,284,648,94, 204,298,1031,400,608,352,2176,6144,325,533,1153,155,210,305,547,300,1090,109,2060, 184,534,537,115,167,1536,4105,225,326,306,772,2081,157,1035,656,329,110,117,212,10 64,171,2113,776,4102,330,226,549,1092,538,387,308,216,2068,1154,416,271,279,158,33 7,1043,4113,550,672,2304,118,332,579,1037,540,389,173,121,1072,2082,553,199,784,41 06,179,1038,228,338,312,2072,704,390,1096,174,554,581,393,1281,4114,283,2084,122,4 48,353,1045,561,203,63,340,2055,1156,394,527,582,4224,556,181,1059,2177,295,285,23 2,124,1282,205, 182,643,2114,4108,562, 1050,286,585,299, 1537,354,211,2560,401, 185, 11 04,396,344,4129,586,645,2059,1061,593,535,240,206,1049,95,2088,327,564,4161,1046,8 00,402,356,307,2116,1160,301,417,213,568,1284,832,4116,2178,588,186,1288,646,404,2 27,896,2067,1062,594,418,4352,302,1538,649,771,2061,360,539,1120,111,331,214,1091, 2096,4130,309,188,449,1065,217,408,2062,609,596,1168,551,650,4120,229,1052,2120,15 9,420,310,1093,541,773,2305,610,4132,1066,657,333,119,1540,3073,600,339,218,1073,3 68,652,4103,230,2069,1098,391,313,450,1296,542,2180,334,233,4225,1184,555,774,175, 2083,1544,123,658,612,1312,2306,4162,341,777,220,1552,314,424,2074,395,1216,673,58 3,4608,355,1568,2561,287,183,234,1094,125,557,2128,4107,660,1068,616,342,316,2085, 1155,241,778, 1105,563,4136,345,2073,452, 1074,397,403,207,2070, 1097,674,4164,558, 10 39,785,432,2184,357,1344,187,236,664,4226,2308,1157,624,587,1076,780,2312,705,126, 1047,4115,242,565,1158,2086,398,346,456,1408,358,2562,4109,405,1100,303,569,244,21 44,1161,595,189,4144,1106,566,2115,676,361,1080,706,589,2089,1051,4110,215,786,647, 1121,2192,348,419,1063,406,4168,464,2076,680,1283,801,362,1108,2117,590,4353,409,1 162,570,2090,788,597,1169,572,219,5121,2564,1285,311,708,1053,598,2097,601,1067,41 17,651,421,3074,792,1122,802,611,1539,2122,4228,602,410,1112,231,688,2320,1164,653, 248,4131,1054,2208,369,190,364,1170,654,2568,4354,659,1095,335,480,2336,1286,315,2 21,1289,4122,2576,370,613, 1185,422,425,2240, 1600,6145,451,614, 1069,2592,543,235, 11 24,412,4609,2118,343,372,1664,775,317,2092,1075,222,4176,426,1172,2179,453,237,107 0,559,2129,4133,833,1099,804,712,2098,1290,834,661,4121,1297,2121,808,779,1541,617, 1128,2063,4118,604,433,1186,720,2368,816,1077,4232,836,347,2181,1217,897,243,1176, 2100,4356,662,454,1101,318,3076,675,1188,618,4360,898,2071,1792,781,376,2182,1292, 4134,428,1298,665,2432,736,1542,567,840,4610,2124,1078,625,238,1107,2185,359,4192, 457,1081,399,2130,787,1545,591,1136,4163,2104,678,434,1159,2075,677,349,4137,1102, 245,2145,458,1313,666,1218,4240,2087,620,363,1109,2307,127,191,4124,1300,782,2132, 1546,407,436,1082,4165,2186,626,571,1192,2193,465,1163,681,4138,246,2309,1123,707, 350,3080,4612,1110,599,1084,668,2077,790,1304,4145,460,2091,249,1113,682,1314,2146, 5122,573,411,1553,2563,803,789,1548,4170,709,2136,1220,365,440,2188,1165,4368,628 ,1125,689,2078,374,1171,4256,423,2194,466,1200,793,2119,1166,4616,250,371,1554,231 0,481,1345,574,4384,2313,413,1055,603,2209,1224,4624,366,468,1114,2624,655,1569,90 0,4288,2093,805,1316,615,3088,1346,4640,684,710,2148,1556,429,1287,4166,2688,794,2 52,1173,373,2099,1126,4140,605,848,2196,1129,690,1328,4227,2094,713,1320,632,2123, 482,4177,1187,806,2314,1116,427,904,6146,2321,1071,414,1291,2565,223,663,4146,140 9,2152,692,1570,835,2210,4169,1348,619,472,2101,1232,455,4111,1410,2241,796,809,11 74,3104,4416,714,1177,721,2200,1189,837,4229,716,2125,1130,864,1079,2212,4148,810, 1352,606,2816,912,5124,1560,722,2316,1601,696,1572,4119,2322,377,435,1137,2566,81 7,4230,1178,319,2102,1103,621,1293,4480,2131,812,484,1132,2105,430,4172,1602,838,2 569,1248,667,4233,3075,488,1190,239,2160,1543,4178,378,1576,2183,459,1219,622,415 2,2126,627,1294,437,2337,4123,1665,380,2242,1547,818,1299,4193,2133,461,496,1604,2 324,4135,669,1315,2570,679,1083,724,4355,2106,1193,841,629,2216,4180,1584,351,113 8,3077,467,1301,4234,2187,438,1180,737,2147,4241,1111,251,1221,2134,462,4357,442,2 108,1140,441,1194,2328,5128,469,1085,2137,247,1555,4125,683,2338,1549,842,1666,41 39,2577,738,899,2572,1305,6148,670,1302,2244,783,1550,3136,4194,849,1201,820,2189, 1317,4611,728,2149,1412,928,1115,4184,2195,791,367,2224,1608,4236,901,1793,2190,6 30,1222,4126,2578,685,1196,844,2369,4242,1144,633,2079,1225,711,4167,1360,2248,25 3,1086,3081,4358,691,1306,824,2138, 1167,4361,902,2593, 1127,686,740,4257,2340, 1202, 850,2370,1318,4672,375,2580,1117,444,1668,4141,2311,470,1226,2197,483,5136,1616,4 15,2150,1347,485,4196,2153,1416,905,3078,1321,4736,795,1794,2352,473,4147,1131,23 44,634,1204,2211,4244,744,1175,852,2140,1233,4142,960,2095,1308,865,2315,4171,167 2,693,2433,1118,4362,797,1228,2594,906,1322,4369,2372,715,1424,3089,807,4613,1632, 474,2256,1376,6152,636,2434,1349,694,2198,4200,1557,254,2201,1179,717,4258,2213,1 234,575,1329,4149,2154,913,1571,2103,798,4289,1324,3082,811,1133,5152,2376,379,12 08,2584,697,4248,1558,431,2625,607,4173,489,2596,1561,866,2161,4260,1139,723,2202, 1191,4864,486,2127,1249,908,2317,4364,1350,718,1330,3090,4370,813,1796,2156,476,4 614,1181,2626,856,1680,2272,4150,839,1353,2214,725,4179,1134,2567,698,1141,2600,4 153,914,1236,2243,752,4617,1195,3200,868,1800,5123,2318,819,1354,2689,4208,814,12 50,439,2571,1573,4231,929,2323,1562,490,6160,2628,1411,623,2339,4174,1332,671,210 7,1240,4385,739,3084, 1440,916,2217,4290, 1295,463,2608, 1303,4181,843,2162, 1182,381, 4372,2325,1361,497,2204,4618,1574,930,2135,1696,4154,821,2245,1142,726,4264,3105, 1356,1603,2164,5125,961,2218,1564,872,2109,4235,1413,492,2579,1197,4195,631,2573, 1145,729,4182,2690,1577,700,2329,4156,1223,443,3137,1808,4376,741,2326,1203,845,4 185,2574,1252,920,2225,4386,1362,382,2341,1336,4625,822,2436,1728,2139,6176,1414, 851,3092,1198,4620,730,2632,1578,498,4292,2817,1605,880,5184,2246,1417,742,2220,4 237,1307,445,2168,1146,4197,2249,471,1472,2384,4243,1377,635,3328,1585,4272,932,2 110,1227,687,4238,2330,1087,903,2191,4626,1364,2151,825,4417,1418,2226,500,1551,4 127,2342,1606,846,3106,4296,1580,745,2141,1205,5129,2692,826,1319,2250,4186,732,1 309,2640,4641,446,1256,2371,1148,4388,3096,962,1229,2440,6147,936,1206,2345,4418, 475,1667,2818,853,4628,2155,1586,867,2228,4359,1310,1609,2199,637,4245,1323,3108, 907,4198,2257,1378,487,2332,4201, 1235,695,2696,5126, 1425,2142, 1209,746,4400,2252, 1420,828,2346,4392,1368,3079,753,4259,1610,2448,854,1669,4188,2656,1617,2400,857, 4143,1559,2373,504,4363,1264,2581,799,3201,4481,1230,1119,2203,4642,255,1351,2258, 964,6149,2353,1588,909,4420,2595,1824,719,2348,5137,1426,3138,1380,4304,477,2157, 1331,915,4482,2232,1325,2582,4246,638,1441,2585,1237,4249,2163,748,1592,4261,2215, 944,1856,3584,4202,869,2273,1612,4151,1210,2374,491,5130,2354,1670,699,2820,4424, 1428,1251,2205,4632,754,3083,1920,858,4673,2704,1618,2377,4644,478,1442,2158,6208, 1326,968,2165,1673,4209,2260,383,1795,4250,3112,910,2219,4175,1384,1563,2824,815, 4365,2378,1135,976,5138,2274,1355,2597,4204,1238,870,3140,1333,4674,2586,917,1212, 4320,2435,1473,2356,4262,727,1241,2264,493,4615,3202,1432,873,4648,2464,1633,231 9,4291,1620,701,2327,5248,1575,2206,931,4366,1674,2385,1253,3091,7168,756,1183,25 98,4737,860,2720,1444,4619,1334,2166,499,4371,2380,1565,731,2627,4676,1797,3085,1 634,4387,823,2588,1681,4155,2437,922,1357,5132,2221,1143,2169,4265,874,1624,3120, 4656,918,2601,1363,4210,2247,1242,502,2832,4373,1392,2227,933,4252,1676,3086,1254, 6153,2276,743,1415,4183,2386,1337,2360,4293,760,2752,1474,5153,881,2438,1566,421 2,3144,1358,494,4266,2222,1257,2602,4157,702,2629,1579,4627,1798,2441,921,4621,33 29,1199,501,4738,2331,1147,2170,4377,1682,2496,876,5185,1636,2401,1365,4374,3093, 847,1801,2609,4622,992,2251,6150,1244,2111,1338,4273,447,2388,1448,4389,3204,1419, 2442,4484,733,1697,2575,4187,827,2630,1607,5140,2604,1379,934,4680,2229,1311,310 7,4865,1207,2343,882,4294,1258,2333,937,4268,2280,1149,2172,4216,1581,963,3330,42 97,1684,2253,1640,6161,2230,747,1366,4432,2691,505,2610,5376,1340,3098,1265,4158, 855,2334,4378,1802,2633,1587,4239,2347,924,3585,4199,1369,734,2402,4274,1476,2259, 1421,4390,2449,829,1427,5154,2233,1231,3152,4189,965,2444,4740,1698,2392,1582,61 54,938,2634,1809,4298,2693,1456,3109,4688,884,1381,2641,4419,506,2583,5144,1211,2 288,1260,4488,2254,749,1688,4393,3097,1648,2143,4866,945,2375,1611,4203,2612,1804, 4276,966,3094,1729,4247,2848,1150,2450,5156,755,2404,1266,6162,859,2355,4305,158 9,3208,1422,4380,2349,940,2465,4744,1370,2261,4190,1480,830,2616,4300,1382,3332,1 429,4394,2880,911,2636,5127,1327,1593,4496,2234,871,3336,4704,1268,2694,1619,4448, 2452,639,6272,2275,1213,1590,4421,2944,888,3110,4629,1700,2642,5249,1385,2466,47 9,4251,2350,1730,3586,4306,1613,946,4401,2697,1239,2819,4643,750,2408,4396,1810,2 587,1671,5186,3168,969,2159,4205,1372,1443,6156,2379,508,2262,4280,1430,3139,4630, 1488,2357,861,4633,2236,1704,2497,4211,1825,757,4263,3113,1386,2265,5632,1614,24 56,4321,970,2657,1433,4422,2644,1594,3216,4402,919,2599,4868,1812,1621,2698,6177, 1596,2277,4253,875,3100,1243,5131,2207,1335,4752,2468,862,2358,4425,1732,3141,420 6,1622,2589,758,4213,1625,2821,4308,1675,2658,948,5160,3114,1445,4267,2705,1816,2 381,6209,977,2167,4872,1826,3588,1635,4426,2648,923,4322,2387,1626,2266,4645,1434, 972,5188,3121,1255,2416,4634,1712,2700,4483,761,2278,1677,4404,3146,1272,4312,24 39,877,6164,2361,1393,2498,5250,1214,3344,4512,1388,2590,952,4367,2382,1678,4375, 2281,1683,495,4254,3232,1359,4433,2603,1504,5139,2822,703,2223,4646,1339,3592,476 8,1245,2171,935,6400,2706,1394,4214,2660,1637,4428,3360,978,2389,4675,1446,2825,5 133,1449,2268,1475,4636,3600,883,4485,2362,1638,4269,2472,1567,2443,4217,762,3264, 5168,1259,2721,6178,1436,2631,503,4649,2403,1367,4295,3616,1396,4880,2335,925,22 31,4275,1799,2282,5134,1341,3142,4324,1246,2173,878,4434,2605,1450,4408,2708,1477, 6168,3116,735,2664,4800,1261,2390,4486,1583,2364,5192,1857,3203,4270,993,2289,18 28,4650,2826,1736,4677,3153,885,4489,2611,1858,2393,5377,1685,2500,4379,939,3122, 6180,1832,2445,4218,1803,2451,1641,4544,2255,994,4449,3145,1628,5141,2722,1457,46 57,2606,980,3087,4299,1744,2833,4159,1840,2480,4436,1860,2405,6151,926,3392,5252, 1371,2235,1921,4490,2284,764,4623,2712, 1267,4678,3205, 1686,4652,2672, 1478,2635,42 77,941,3124,5155,1342,2828,6273,1699,2753,4391,967,2174,4381,1642,3095,4328,1922, 2290,1805,4220,2613,886,5378,1400,1452,4301,3206,831,4278,2446,1689,4739,2394,176 0,6210,2504,1591,3456,4658,947,2406,5146,1864,2453,4382,1649,3148,4681,507,2351,4 395,1262,2617,5633,1383,2292,4450,1481,3209,889,4307,2643,1423,6656,2237,1811,449 7,3154,1615,4281,2614,984,5200,2724,1702,4492,2409,1458,4440,3128,751,4682,2754,1 701,4741,2637,1373,3099,6155,1269,2263,5157,942,2834,4689,1482,2695,4631,1690,316 9,4336,1644,2396,4302,996,2467,5145,1387,3111,4191,1151,2454,6184,1215,2512,4423, 971,2728,4660,1806,3331,5142,1431,2849,4896,890,2410,1460,4498,3156,1650,4452,263 8,1595,4403,2457,509,6212,3210,1489,5256,2618,1705,4397,2836,1270,4513,2645,949,4 309,3217,1731,4664,2620,1374,5380,2267,1623,4928,3333,973,6274,2359,1692,4684,275 6,1814,4282,3101,1484,5384,2646,1000,4742,2649,1273,4500,3115,1706,4323,2699,1597, 4992,2469,892,6163,2840,1435,5158,3170,1827,4690,2850,1813,4514,2659,950,4398,35 87,1733,5634,2650,1389,4745,2458,1464,4867,3160,863,6157,2279,2736,4456,1652,4635, 3212,1713,5216,2701,1398,4207,2296,759,4427,3102,1447,4310,2417,1490,5187,2238,1 817,6192,2412,1008,4405,3218,1274,4284,2702,1395,4545,2707,1505,5161,3143,510,431 3,2383,1598,4504,2528,3334,6158,1437,2363,4705,1627,4692,2269,979,5264,3337,1390, 4647,2418, 1492,4746,2661, 1679,4325,3233,953,5148,2470, 1924,6216,2473, 1829,4255,36 48,1639,4516,2499,4406,2662,763,5189,3117,1708,4637,2591,1734,4869,2283,1453,6401, 3172,974,4706,2460,1818,5162,2391,1276,4753,2420,4429,1397,3712,4215,2823,1629,5 636,2365,954,7169,3123,1872,4696,2270,1714,4435,2474,4314,1737,3220,5169,879,2501, 4464,1656,2285,4748,3118,1506,4326,2607,1830,6165,2881,5194,981,3147,4487,1451,2 852,4409,1928,2760,4546,1438,3338,5392,2882,982,4638,2709,6276,1247,3345,4430,168 7,2856,4329,1716,2827,5280,1859,3589,4651,927,4870,2665,3176,4271,1643,2652,6179, 1496,2481,5640,1479,3234,4219,995,4754,2768,1820,4708,2864,1833,5408,3125,2884,64 02,1738,4437,2395,1745,4873,3265,765,4316,2945,1861,5648,2291,4410,3224,1740,4520, 2710,1888,6170,2502,956,4491,3149,5312,1834,2366,4769,1630,2723,4679,3236,1936,4 451,2666,5664,1746,2946,6657,887,3840,4383,1720,2829,4279,1401,4330,2424,3340,519 0,1459,2476,4221,1841,3346,4653,985,6224,2713,1343,4756,2784,3590,5164,1645,4712, 2615,1836,4438,2888,997,4412,3126,1508,6181,2673,5251,2286,1454,4337,3155,1862,48 74,2407,5201,1691,2505,4659,986,3129,4441,2447,6169,1512,2835,4548,1263,3593,5170, 1402,4493,2639,3184,4499,1483,2726,4303,943,6166,2482,1646,5193,3207,1651,4770,2 725,2397,4654,1461,5135,3150,1404,4881,2293,4528,891,2506,6280,3361,1842,4453,271 4,5440,1485,3266,4283,1520,2668,4332,1693,4760,2411,3157,6404,998,2175,5253,1703, 4720,2239,1748,4683,3348,2830,5172,1865,4876,3594,766,6408,2455,1653,4801,2484,42 22,3130,1375,5143,2674,4338,1491,2619,4661,1462,3240,5254,2513,6182,511,3211,4494, 1761,4442,2729,1275,4552,2294,3171,5504,1486,4454,2755,1466,6658,2398,4501,1465, 3158,5196,2647,988,4399,3132,4665,1493,2716,4340,1271,6240,2838,3352,5257,1707,25 08,4691,1866,4285,2297,3161,5202,1001,4662,2730,1762,6211,3362,1923,4772,2621,445 7,2459,1694,5176,3601,4802,1807,2851,4685,951,6185,2837,3596,5147,1873,2757,4311, 1844,4882,3268,2413,4743,1752,5217,2488,1952,6288,3213,4444,1002,2676,4515,3173,5 159,1815,2737,4502,1391,4560,2422,3219,6172,1925,2471,4776,1654,5379,2514,1709,48 97,3248,4458,2841,893,5204,3214,6213,1868,2298,4686,2419,4505,1657,3602,5258,1735, 4666,2529,3393,6186,1277,4884,2622,975,4693,2461,5265,1715,3103,4668,2651,4315,1 848,3272,6660,1926,5381,2414,2516,4407,1710,4804,3162,894,5149,2703,4694,3617,176 4,6193,2948,4697,1874,2853,5163,3364,4747,1399,2663,4517,1468,7170,3394,2732,4888, 1494,5218,2758,1009,4898,3604,4707,2477,1507,5635,3335,6218,1439,2842,4698,2300, 4506,1509,3221,5208,1929,4327,2421,3174,4784,1819,6416,2653,955,5260,2896,4749,31 77,4344,1497,2738,5150,1658,6304,3376,2761,4465,1768,4286,3368,1876,4460,2680,526 6,2530,1984,4750,3235,6664,1004,4755,2854,3164,5191,1889,4431,2475,1717,4576,2952, 6432,3119,1821,5382,2462,4411,1930,3339,4317,2271,5385,1010,6672,2711,1739,4466, 3457,4709,2740,1831,5281,3618,4518,2883,4521,1498,3396,6336,1660,5696,2667,2520,4 547,1718,4710,3280,957,5165,2503,6688,3458,4639,1278,2844,4331,1741,5220,2857,322 2,4508,1599,6214,2762,4439,3225,1937,4468,2769,5760,1822,3237,4871,2885,4413,983, 6188,2764,1835,5171,3178,4318,2912,4522,1403,3127,5268,2858,6275,1721,3400,4549,1 455,4333,2654,5166,2960,1631,4655,3608,6225,1513,2770,4929,3649,5195,958,4900,274 4,3620,4808,1890,6194,2425,5386,1747,2483,4930,3185,4757,1510,5393,2865,3226,6217, 1932,4904,2367,4875,1742,3151,5637,2669,4713,987,3341,5224,2860,6159,1837,4700,2 532,1500,4529,3180,5282,2478,4816,1880,3650,6464,2886,4912,1863,5173,3296,1749,49 32,2715,4443,2536,6277,1012,3238,5313,2287,4993,1722,4339,3591,1938,5272,2426,619 6,3624,4758,1776,2507,4550,3267,5197,1892,4414,2670,7172,1843,2675,4771,3342,5284, 1838,4714,2485,3713,4994,999,6167,2428,5888,1463,3595,4877,2866,4472,1953,6278,3 347,2509,5388,1514,4524,2544,5394,3652,4761,1647,2717,6528,1695,4832,3363,5638,27 27,1763,4663,3131,4936,2772,6220,1016,3241,5174,2889,4721,1940,4334,2677,5203,148 7,3632,6281,2399,4455,1867,4553,3186,5177,2515,1405,4495,3349,6226,2486,4883,1521, 3228,5641,2785,4687,767,5232,3159,6200,1954,2299,4774,3269,4530,1845,5255,2510,6 171,2490,1750,4773,3188,4445,2489,5198,1985,4341,3242,1896,6241,2517,4554,3133,54 09,1516,4762,2295,3603,5314,1655,6183,2731,4716,3597,4459,989,2890,5205,3714,6403, 1753,4223,2786,4287,2947,1724,5396,3353,4878,1467,6228,2718,5642,3350,1765,4503, 2831,4532,3598,5178,1869,6282,2897,4722,3249,1944,4667,2868,5288,3365,6289,1003,4 561,2776,3460,5259,1406,4777,2976,4342,3163,6405,1846,5219,2839,1875,4803,2415,44 46,3656,7176,1754,5206,2949,3841,4695,1522,5180,2678,4764,3270,6173,1904,4886,273 3,3244,5400,990,4556,2892,6187,3192,4345,1766,5209,2681,3273,4778,1469,5410,2759, 6242,3408,4669,1495,4507,2301,5649,3134,1659,6659,2739,4899,3354,4885,1956,5644,2 872,4805,3215,1711,6232,2950,5316,3175,4461,1927,4536,2734,6284,1005,5261,2788,32 50,4724,1849,5221,2898,4785,3366,6174,1524,4470,2423,5267,3165,1870,4519,2492,629 0,3716,4562,1769,5296,2518,4889,3274,6215,1850,2531,5262,3664,4346,1756,4467,2463, 5650,3395,6406,1470,4577,2533,3464,5441,959,4670,2953,6409,3369,4509,1986,5151,2 843,4699,3842,6305,1960,2521,5320,3179,4462,1499,4564,2682,5210,3252,6720,1877,47 51,2792,5665,3223,1891,4996,2900,6189,3281,4901,3008,5412,1661,4711,3356,7184,291 3,5442,1931,4780,3720,2741,4806,1011,6244,3166,5652,2845,4525,1511,5383,3276,6784, 2954,4890,1719,4348,3370,5269,2763,1770,4469,3472,6195,2855,5222,1852,4701,3680, 4944,2522,6292,1777,5225,3424,4786,2684,5424,1878,3397,6190,2742,4809,1881,5416,3 605,4728,2302,6219,1013,4578,3227,5283,2765,4902,1528,6410,3282,5212,2623,3377,45 23,1823,5000,2961,6417,3619,5167,1279,4510,2846,5387,3372,6661,1988,4319,2859,475 9,3181,5505,1933,6248,2427,4788,3256,1743,5666,2745,4931,3606,6306,1501,5444,2479, 4715,2655,4568,2537,6197,1939,5328,3609,4551,2914,5506,895,6337,3187,4892,2771,4 905,1662,3239,5270,2534,7200,1772,4810,3297,5273,2956,4817,1968,6296,3398,5285,27 66,4933,3378,4812,1893,6221,2861,5226,3844,4960,1515,5175,2524,6308,3229,4906,172 3,5448,2904,4702,3728,6912,1778,5008,2887,3401,5656,1882,4818,2773,6412,3182,5697, 2746,4792,1006,5668,3189,6418,2962,4473,1502,4531,3284,5233,2800,6662,1992,4913, 3243,5274,2916,4415,3848,6198,1407,5199,2867,4717,3402,5389,1934,6227,2862,4908,3 298,4580,1839,5228,2487,6201,3621,4526,2000,5698,2977,4934,3610,6665,2538,5344,18 94,4763,3459,7171,2671,4584,1941,5286,3380,4335,2719,6256,1014,5639,3288,4474,278 7,5672,3488,6279,1751,4555,2964,5315,3343,4718,1517,6222,2511,4723,3351,5390,2891, 1897,4533,6433,3230,5761,2429,4476,1725,6338,3409,5643,2545,4914,1955,5395,3622, 6229,2978,4557,3744,4592,1780,5700,2869,6420,3190,4765,1884,5411,2774,6666,3404,4 775,1523,5179,3651,4820,3009,6202,3612,5289,1755,4937,2920,4725,3461,6312,1017,56 80,2540,4447,3245,5234,2679,7173,1847,4563,3193,5397,2777,6283,1946,4534,3625,527 6,2748,4833,3271,6243,1898,5207,2491,4347,3856,5317,1942,6230,2789,4558,3251,4538, 2893,6204,1526,5236,3300,4537,2968,5290,1957,6424,4565,3410,5181,2430,6233,3384, 4343,1767,5651,2870,4779,3776,6434,1784,5645,3462,4938,2899,5762,3246,6673,1905,4 834,2778,4995,3626,6668,1018,5401,2546,4766,3653,5398,2928,6340,1518,4879,3465,27 90,1726,5646,3355,7232,2493,4945,3194,5297,1945,4916,2519,6285,3520,5413,1525,482 4,3425,6245,2683,5508,3633,5024,1900,5211,2980,6291,3275,4887,2735,4463,1871,6320, 3135,5704,2951,4997,2016,3412,5889,2873,6286,3466,4726,1471,5318,2548,6674,3599, 4781,1757,5292,3654,4940,2894,6465,3628,5240,1851,4729,2793,6175,3253,5321,2874,4 807,991,5456,3367,6344,2780,4349,1958,5182,3357,7177,2494,4787,3304,5402,1906,492 0,3196,6234,3010,5263,3277,4998,1961,6689,2984,5223,3254,4782,2523,4836,1987,6436, 3715,5298,2901,4946,1771,6466,3634,5414,2915,4471,3358,6676,1529,5213,3657,4540, 2685,5764,3371,6407,1879,4566,2955,5322,3426,6293,2535,4579,1948,5712,3283,4511,2 743,6246,1758,5443,3473,4581,3257,6249,2794,5512,1853,5001,3468,7174,2876,5417,34 16,4891,1020,5890,2801,6448,3658,4569,2902,5227,1989,6440,3717,4730,3665,5300,196 2,6307,2905,4840,3607,5271,2552,4948,1908,6236,3312,5329,2847,5056,3278,6191,1530, 5404,3167,4961,2303,6411,3399,5768,1773,4789,3012,6529,3636,5214,2957,4893,1969, 5324,3872,6690,2767,5002,3474,5418,1990,6468,3428,4811,2525,5520,3379,7185,1779,4 903,2963,5728,3373,4570,2686,6352,5472,1883,4732,3489,6530,3285,5445,2796,4790,19 64,6294,3640,5653,2992,4350,3904,6297,1854,5275,2917,4813,3660,6309,3258,5330,193 5,4671,2539,5425,3718,6250,2747,5009,1007,5667,3476,6199,4894,3299,5420,2802,7178, 1895,4907,3968,5229,2906,6472,3666,4475,1663,5304,2526,6680,3490,4793,3374,5654, 1912,4527,3016,6721,3721,4703,2431,4585,6692,1503,5657,3843,4962,2958,6257,3432,5 235,1970,4819,3611,6298,2863,5287,3183,4582,1774,6223,3024,5345,3403,5004,3286,64 13,5446,1993,4814,2918,5426,3381,7186,2965,4909,1532,5892,3260,6252,3521,4572,277 5,5277,1885,6722,3289,4952,5776,2541,6368,3480,4935,1781,5449,2921,6310,3681,4821, 3668,5230,1994,6663,2749,4794,3623,5237,6696,2979,5010,3722,5332,1943,6339,3301, 4848,2804,5291,3231,7296,1015,4964,2908,5896,3492,6414,4915,3382,5450,1899,6785,2 547,4910,3613,5346,2779,4535,1886,6667,3845,5669,5025,3682,6419,2871,5658,3729,45 86,1782,6724,2970,5507,3405,4719,3191,6435,1972,5428,4767,2922,6203,3672,5336,296 6,4835,2001,7180,3411,5536,3290,5012,2550,6313,5391,1947,4559,3440,6704,2981,5399, 3724,4939,3302,6258,1996,5278,4477,2791,6421,3463,5457,3385,4593,1785,6300,2808, 5670,3522,5026,6231,2929,5792,1901,4917,3614,6341,3406,5238,2542,4822,3305,7201,5 452,1976,5699,2750,6260,3627,5057,3846,6314,1519,5660,2969,4968,6205,3247,5509,25 49,4588,3195,6675,1727,5293,3730,4727,6669,2924,5241,3684,4825,1959,6786,3413,567 3,2895,4796,3849,6425,5319,3040,4539,2002,7233,3292,5904,3386,4837,2495,6422,5299, 1019,4941,3496,6670,3467,5348,2781,5016,6321,3745,5458,1907,4478,2875,6437,3655, 5432,3427,4918,6532,1786,5824,2982,6235,3359,5510,3255,4947,2930,7188,5294,1527,4 826,3306,6728,2985,5674,3197,4594,6913,1949,5701,3629,4976,3011,6342,3732,5513,36 88,4838,6316,1902,5403,2795,4541,3414,6264,2553,5242,6345,3388,4567,1759,5568,331 3,6480,2903,5473,4731,3850,7424,2017,5681,3635,5028,2972,6206,5323,3417,4783,2782, 6426,1909,5183,3524,4999,6287,3469,5460,2877,6247,3475,4921,1963,5514,6322,3279, 4596,3013,5647,3746,6438,2018,5702,4942,3630,7202,2986,5676,3857,4841,3504,6237,5 301,2004,6788,2932,4922,3429,5415,6346,2554,4828,3259,5405,1950,6736,3308,4542,53 52,2797,6467,3736,5244,3696,7192,5058,1788,5325,2993,6536,3659,5032,3852,5302,644 1,3014,4571,1965,5763,3777,6914,4949,3198,6251,2803,5682,3314,4963,1991,6324,5406, 2907,5705,3637,6295,3470,4733,5419,2988,7204,1021,5003,3418,6353,5474,3528,4583, 2878,6428,1910,5331,4791,3430,6792,3477,5521,2959,6238,3375,5305,4842,1855,6348,3 641,5516,2919,4924,6442,3316,5464,3667,7175,1971,4849,5706,2687,6544,3261,4950,36 38,5765,6752,2936,5713,1531,6496,3748,4953,5655,3433,6469,2527,4600,3778,5360,667 7,1913,4895,3661,7297,2994,5326,5215,3287,6299,2798,4351,5447,3858,6354,2008,5060, 3719,6449,5684,3017,5005,3420,6691,3491,5920,4815,1775,6444,2556,5522,3478,7234, 5476,3536,4573,2909,6253,5427,1966,5011,3752,6328,3873,5421,6678,2805,4734,3434,5 537,2020,6681,5333,3662,6259,3018,4844,5688,3481,6311,3642,5040,1995,5952,7680,29 67,4965,3860,6369,3669,5708,5306,3644,6470,2923,4587,6450,1914,5766,3291,4795,338 3,6916,5524,2910,5347,3780,6301,4850,1533,7179,3670,6016,2806,4954,6800,3673,5714, 3723,6473,4574,1973,5538,2996,6254,5422,3493,5064,3864,6261,3025,5769,6356,3874, 4479,1997,5891,7208,3683,5006,2971,6315,3674,5480,5659,3482,6920,2024,4911,6474,3 020,5231,3303,5072,6370,3760,5451,2809,6693,5334,1916,4966,3725,7236,3320,5429,66 82,2925,5013,3441,5308,6531,3262,5569,1974,6452,4823,3436,5337,3000,6360,4589,372 6,7298,3731,5528,4969,1887,6560,2543,5729,3407,6415,5716,3552,4797,2751,6423,5671, 3387,6302,1783,5027,5770,3293,6481,2983,5349,7187,3442,4852,3685,5279,6694,3026, 4956,1022,6816,5540,3494,5430,3497,6262,4595,3523,6476,2931,5661,4827,2032,6723,3 686,5893,7181,3615,5730,2810,4919,6684,3307,5777,3484,6533,5018,1534,5453,2551,63 17,5239,3415,6265,3444,4970,5720,2973,7216,3847,5014,6697,2003,5459,3389,6343,533 8,3294,4598,2926,6928,5488,3498,6323,3525,5029,5772,1977,7182,2783,5350,6372,3309, 4839,3631,5511,6482,3905,5433,1787,6456,4856,3041,6848,5570,3876,4977,3784,6534, 5662,2933,7240,3906,5454,4590,1998,6318,3733,5353,6698,2987,4798,3880,6725,5675,3 851,5894,6537,3689,5017,1978,7425,5295,3042,4597,3676,6427,5243,3505,6266,3028,57 78,6592,3792,4972,1903,5732,6497,3888,5461,7189,3908,4943,2974,5897,6705,3419,508 8,3969,6347,5340,2005,6207,5434,2812,4543,3315,6484,5544,3734,7300,3526,5515,6538, 2989,4829,5793,2006,6671,3390,4923,6726,3747,5703,3015,6700,5475,3690,5030,6325, 3970,5407,1951,7203,5303,3853,6439,2934,4978,5354,3448,6429,5033,3500,6376,2879,5 245,6268,3737,5677,2019,5059,7426,3808,5780,6349,3639,5736,2995,6326,4843,3912,54 62,6787,3697,4601,1789,6706,5436,2555,7194,5361,3310,4951,3431,6430,5898,3529,672 9,5683,2937,6443,1980,5020,7681,3471,5465,4830,3859,6498,3663,5572,6355,3032,5517, 6545,3750,4925,3506,5523,6329,1911,5327,7248,2799,5061,3749,6540,5794,3421,6488, 5678,3317,5034,2990,6730,5905,2009,6789,5552,3530,7205,3738,4980,5477,3692,6737,4 602,3044,6679,3435,5307,6384,3199,5356,6350,2021,4845,3263,5784,7193,3019,5744,62 39,3854,5041,6471,3479,5707,2938,6708,5900,2010,5062,7190,3508,5825,3698,6944,524 6,3643,6546,4851,2557,6500,5362,3537,4955,3753,6451,5685,1967,7304,5518,3318,6445, 5036,2997,6561,3779,5466,6357,3422,5576,4926,3671,6712,5478,3021,7428,1915,5525, 6976,3740,5007,6732,3862,5423,5689,3532,6330,3048,4967,7432,3321,5364,6790,3754,5 715,6548,2022,4735,3645,6371,5309,2940,5686,7040,3483,4984,7206,3875,5796,6738,38 61,5481,1790,6562,4575,2998,6446,5826,3781,7682,5709,3437,5042,3512,6793,5335,291 1,6915,4846,3700,6504,5906,1535,6683,5767,3761,7264,3446,5065,6255,2807,5468,5539, 3495,6475,4604,3538,6358,5526,3865,7235,5584,3056,6453,1023,4957,6332,3322,5800, 6593,3443,5921,4853,3553,7209,5482,2558,6361,5710,3646,6552,3485,5066,6753,2012,5 529,6740,3675,5690,7312,3027,50 15,6695,343 8,5908,5717,3 540,6794,3 727,5692,63 73,30 01,4971,7196,2025,5339,6303,3972,5431,6564,3877,4958,6454,3687,5828,7237,2811,571 8,6685,3756,4854,3782,5721,6917,1975,5771,6754,3501,5044,7210,3022,5541,6801,3866, 5912,6477,3324,5073,6263,3445,5922,7684,3677,5731,6744,3002,5019,6483,2026,5722, 3920,6362,5530,3762,5068,7217,3785,5351,6512,2927,5808,6796,3704,4857,6374,3554,5 773,7242,1917,5368,6535,3878,4973,6457,3029,5489,6594,3499,5310,7440,3976,5484,66 86,3486,5048,6478,3030,5774,6377,3295,5779,1999,4591,7328,3735,5455,6699,3764,560 0,6918,3907,4799,6319,2975,5435,7688,3691,5341,6267,3544,5031,6802,3527,5490,6756, 1918,5733,7456,3043,5074,6485,3868,5542,6921,3881,5545,6364,3786,5571,7696,3793, 4979,6458,2813,5734,6568,3909,5663,6539,2033,4858,7360,3788,5355,6817,3936,5532,6 727,3004,4599,6499,3882,5463,7712,3678,5492,6431,3984,5021,6327,3794,5895,6378,19 79,5437,7238,2935,5342,6269,3768,4974,6701,3449,5546,6804,5573,3507,7212,4831,388 9,6760,5357,3033,6486,5679,3391,6460,5953,2028,7299,5089,3693,6385,5924,3884,6922, 5832,3045,7249,4981,3556,6707,5954,3502,6489,5781,3910,6596,5035,3739,7218,5928, 2034,6541,5899,3034,6547,5737,6351,3560,5090,7241,3311,5724,6818,3450,5553,6702,3 531,5076,7183,2991,5840,6929,3694,5936,6576,1981,5956,6501,3699,5022,7488,3509,54 67,6331,6017,3452,6380,4860,2939,6808,5363,3890,7301,5782,3533,6768,5574,3568,673 1,5037,3741,7220,5438,2007,6924,5795,6849,3046,5063,6270,3751,5738,7191,3796,6018, 6386,3913,5901,6709,2814,4982,5496,3701,5548,7302,4927,3423,6542,5785,3539,6490, 5856,1982,6600,5687,3510,7552,5043,2559,6502,5960,6549,3809,5745,7244,3323,4603,6 447,3534,5358,6713,3514,5479,6388,3513,5577,7305,4985,2011,6739,5519,3036,6333,59 07,3541,7250,5711,3319,6710,5080,3755,6820,5798,6505,3914,5554,7224,3049,4847,685 0,3810,5797,6733,3971,5469,7195,5365,3742,6359,5038,2036,6930,5578,3855,6791,5786, 2999,7265,5740,6492,3921,5092,6563,3892,5483,7207,3800,5247,6550,5311,4000,6608, 5067,3050,6824,5902,3863,7427,5527,2023,6945,4986,6506,3439,5556,7252,3973,5746,6 734,3702,5691,6553,4605,3757,7306,5585,2941,6714,5801,3916,6932,5366,6741,3705,50 45,7313,3783,5827,6716,2040,5470,6363,5719,3325,7429,5069,3023,6455,5788,3763,685 2,5910,7197,3896,5580,6742,3974,5096,6745,5369,3758,7211,5802,2942,6795,5693,3812, 6565,4988,6936,3922,5531,7266,1791,5923,6946,3447,5909,6755,5046,3516,7683,5829, 3542,6746,5485,6554,3057,5560,7256,3555,4959,6375,3487,6832,5748,7308,3557,5809,6 797,3977,5494,6392,4855,3867,7198,5543,2013,6513,5586,6334,3003,5913,6508,3545,51 04,7314,3706,5370,6798,5491,3816,6803,5601,3924,7239,4606,6479,4032,5694,6624,305 2,7430,5533,6459,3937,5723,6365,3765,5075,7433,5486,2027,6514,5588,3869,6757,5775, 7329,3978,5049,6566,3058,6020,6569,5925,3787,7744,5735,3879,6595,6758,4859,3546, 7213,5804,3708,6687,5830,6379,3766,5549,7268,3005,5070,6556,5914,2014,6487,5372,3 326,6516,5493,7808,3789,6919,5725,6461,3647,5050,7219,3985,5968,6366,5810,3870,65 70,5833,3031,7316,4975,6597,3883,5752,6381,3451,7214,5602,6703,3769,5926,6977,507 7,3503,7243,5547,2029,6948,6024,6856,3679,5534,7434,3561,6978,5078,6805,3006,5343, 7441,5783,3938,6952,5812,3795,6923,5955,7685,3558,5023,6761,3980,7272,5739,6748, 3790,5592,6577,5575,3035,7330,5091,3 885,6864,5916,6960, 1983,5929,7221,6980,3548,5 834,6491,3928,5841,7361,4861,3911,7041,5957,6387,3797,7320,5836,3060,6806,5984,65 98,3770,5052,7245,5930,3986,6462,5726,6819,3824,7332,6032,3940,6762,5842,7042,389 1,4983,7936,5816,2035,6925,5497,3886,6520,7436,5555,3047,6572,5937,7442,3511,5081, 6809,5439,4001,6880,7686,5741,3562,6711,5932,3695,6984,5093,7222,3743,5604,6769, 6382,3811,5550,7251,5958,3064,6503,5787,3988,6601,5082,7225,3535,6543,5608,6931,2 037,5359,7689,5498,3915,6735,7280,5579,3453,6822,5039,3569,6578,5742,7303,2815,57 47,6821,6493,4002,5557,7246,5500,3893,6389,4987,6602,3798,7457,5938,6810,4033,558 1,7362,5616,3944,6764,5789,3564,6507,7253,5094,3703,6271,5799,6335,1919,5844,7444, 6926,3037,5961,7690,4862,3801,6551,5749,6580,3772,7226,5471,6770,3515,5587,6715, 5558,3813,7336,6609,4607,3917,7307,5857,6825,3992,5371,6390,7267,3051,5582,6851,5 562,3454,6494,5561,7254,3894,6743,5084,7228,3923,5589,6812,5367,3802,6934,7448,58 03,2030,6604,5962,6393,3570,7257,5097,6826,3952,5858,7458,6019,3038,6717,6555,579 0,3814,7697,5903,6947,3517,5047,6933,7692,3543,5969,6853,5940,3707,7364,6509,5848, 4004,6584,6048,7309,3759,5098,6772,7269,3975,5911,6833,5487,3053,6518,7315,6021, 3897,6567,5750,6610,2038,5805,7344,6937,3572,4989,7310,5964,3918,6394,6515,5753,3 817,7698,5831,6625,7489,3898,5373,6718,5071,3804,6557,5811,7199,3518,6747,5944,73 68,3007,6022,6510,6612,4034,5806,7258,4990,4008,6799,7713,5860,3547,7044,5970,694 9,7460,3925,5495,6759,5564,3939,7490,6828,5590,2041,6854,5105,7700,3709,6573,5603, 7431,5535,3979,6938,6396,5605,3059,7317,6025,6517,3559,7270,5915,6749,3767,5051, 6992,7273,5593,3818,6834,5754,7472,3900,6857,5864,7464,3825,5972,6776,6626,3926,6 080,7331,5100,6950,3929,7260,5985,6571,3061,5813,7048,7215,3576,5917,6558,6026,74 35,3871,6367,5106,6807,3327,5835,7553,6836,2042,5927,7714,6979,5594,4036,7492,575 6,6763,3981,6616,5814,7376,3791,5053,6599,7554,5374,3549,6940,5837,6953,3987,7318, 5695,6858,7321,2943,6033,6865,5918,3710,7333,6981,5079,3820,6860,5931,7274,7008, 4016,5499,7223,6954,3941,5817,7496,5551,6750,3563,7056,5727,7704,3771,5609,6866,7 745,5054,3826,6840,7716,5986,3930,6521,5843,6579,7281,2015,5606,6961,7322,3054,60 28,6463, 5 83 8,7247,3 5 50,6765, 5083,7437,4040,6956, 5933,6628, 5 596,345 5,7276,6574, 597 6,7746,3982,6982,5959,7392,3887,5845,6811,6632,5108,4048,7334,6383,5818,3942,7687, 6034,6522,7720,3989,5872,6603,7363,5988,3062,6766,5939,6771,3799,7438,5934,6581, 7809,3565,5095,6524,5559,3945,7691,6962,6049,7443,3773,6605,5610,6640,7748,4003,5 743,6813,5791,7459,2044,6823,5859,7227,3828,6868,5112,7337,6985,3932,6036,6773,55 83,7728,3571,6495,5963,7282,3803,6611,5501,7445,6582,3065,5617,7324,6881,4863,389 5,7255,6050,6395,7365,3994,5941,6606,6586,5846,3946,7284,6585,6081,3990,7338,5992, 6613,7229,3574,5612,6391,7699,5751,4005,6827,7693,5085,6986,3815,7810,5849,6882, 7043,3832,5820,7449,5563,6814,3953,7446,5861,6927,7694,3066,5965,6993,7345,6040,3 566,6964,7461,5099,2031,6872,7556,5502,7072,3774,7259,5942,6935,5971,3993,6511,77 52,5850,7045,3573,7937,5618,6774,7366,3948,6000,6829,7340,5086,3919,6988,7288,586 2,6777,4064,7369,5565,6855,7504,3519,5591,6397,7230,5755,3805,6835,7450,6052,6968, 3899,7311,5807,7046,7271,6023,3039,6830,5101,6884,7346,4006,5945,6994,7462,5620, 3954,6519,7261,5966,6588,4009,7812,5865,6614,7370,4035,5946,6627,7760,5852,3819,6 559,7491,5566,6629,3577,7560,5055,7049,7465,6082,3927,6939,7938,6056,6617,2039,72 75,5595,6778,7348,3996,5973,6888,7319,5987,3806,6996,7377,7104,5757,7452,3901,700 9,6027,7816,6837,3068,5107,7262,6941,5607,4037,7372,7050,5815,7466,6859,4010,5866, 7568,6951,5948,3956,7776,6618,5873,7520,3578,6780,5974,7493,6838,5977,3821,7701, 6398,5109,7323,4017,6861,5624,7378,6719,4038,7473,5919,7057,7715,5375,3827,6942,7 468,6084,6955,3931,7277,6029,6523,7352,5839,4012,6841,7702,5597,6575,3902,6751,66 33,6035,7705,7010,3983,4991,7283,6867,5758,3055,7335,6630,5868,7393,7052,3943,606 4,7494,6862,7474,3711,5989,6957,7940,5611,6620,3960,7325,5819,7000,7824,5874,2043, 6983,7497,5978,6869,3551,7278,6842,5102,7285,7058,4018,5598,7380,6896,6088,7339, 3822,7012,7944,5503,6963,4041,7498,6030,6958,7394,5935,3580,6583,7717,6096,7073,7 706,3933,6634,5990,7555,6767,6037,3829,7476,6815,5110,7384,6883,4042,7584,5847,70 60,7439,3991,5613,6607,7447,6987,5993,3063,7326,6525,5821,7505,6641,3947,6051,771 8,7074,7840,5876,3934,6965,7286,5980,6870,7500,3830,5619,7747,7105,7708,5851,4020, 7016,7557,5113,6636,7341,4049,6775,5943,7289,6873,6042,3995,7721,6844,7367,5994, 6587,4044,7952,6038,6885,7347,6989,3833,5622,7396,7064,6053,7506,3949,6526,7480,5 863,6966,7872,4024,5880,7558,6995,7342,6001,3567,6874,7722,5114,6642,7749,2045,70 24,5614,7561,6886,5822,7451,3775,6589,7290,6041,6615,7616,4007,5621,7521,6779,772 9,5996,4050,7076,7371,6831,5967,7231,3067,7047,6112,7508,6969,7562,5567,3955,6644, 7695,5853,7750,6990,3834,7724,5947,6889,7349,6970,5087,3575,7463,6876,6054,7453, 6590,3997,7400,6002,7292,7106,7373,3950,6057,7080,7350,6619,6083,7811,3807,6997,5 867,7730,7011,7454,4065,5625,7753,6781,7467,5975,7051,3957,7522,6631,6044,7379,68 39,4011,5854,7569,7353,6890,5949,7564,4066,6972,7512,5116,6897,7754,6998,4052,608 5,7813,7761,6058,7001,3998,7703,6648,6004,7408,6943,7374,3836,5626,7263,6399,7495, 5869,7108,4013,7732,7053,6065,7968,6863,7570,4039,6086,7524,6621,7475,5875,7059, 3069,7469,6782,5979,7585,7381,3958,6892,6060,7736,7088,8000,5950,3903,7013,7756,7 354,6031,6635,7814,4019,6843,5103,7572,7395,6898,5991,3579,8064,7002,7762,5759,66 22,7586,3961,7470,6008,7112,7817,6527,5599,7939,2046,7054,7528,6066,7707,6959,727 9,4056,5870,7120,7499,7382,6089,7014,3823,7477,7061,5628,7356,7617,6871,4014,5981, 7385,6637,7576,5877,7017,4068,7777,7764,6090,6845,7719,7075,7818,4043,6039,7397, 6900,7327,5111,7004,3962,7588,7478,5995,6643,7709,6875,3581,5982,7941,7778,6967,7 825,5878,7066,4021,7501,7287,6068,7018,7768,7062,4045,6097,7507,7386,6646,6043,75 36,7077,4072,7820,7398,6092,6887,7559,7481,5881,3964,6904,7618,7025,5997,7710,750 2,4022,6638,7401,6072,6846,7723,7942,5615,3935,7065,7343,6645,7291,5823,7826,7020, 3831,7780,6055,7509,6991,7945,7136,6098,3070,7388,7482,6591,5115,7592,7563,6877, 4080,7841,6003,6971,7751,7523,5882,7078,3582,7455,7351,7026,5623,7402,7081,7293,4 051,6045,7725,7107,7828,7784,5998,6891,4025,7510,6649,7484,5855,7409,6999,7946,38 35,6113,7731,7068,7513,6878,6005,7620,4046,7565,6973,7571,6059,7375,7109,7842,402 6,6114,7726,7082,7953,7600,6100,7028,7525,3951,6650,7355,6046,7404,6893,7832,7792, 4053,5884,7089,7755,7948,7110,6061,7873,7294,4054,6899,7410,6087,7003,7733,7566, 7084,3999,5117,7514,7624,6974,6006,7526,7573,7055,4067,7471,5951,7737,7015,7412,7 763,6067,6783,3837,7357,7734,7032,5627,7844,7529,6623,4028,7874,6009,7757,7090,73 83,6894,7954,6104,3959,7815,7113,7516,7587,5871,6652,7574,7632,4057,7005,6062,784 8,7969,6901,7530,6116,7758,7114,4069,7577,7738,6091,7063,7956,7765,7740,7019,2047, 6010,7387,7479,7006,7876,5629,7766,6902,4058,7769,7819,6069,7092,7589,7960,7121, 7970,4015,6093,7779,7067,7770,7578,6120,7116,7399,7856,3963,6905,6012,7821,7416,7 021,7537,7358,6070,4070,7532,7096,7822,7827,5983,6639,7503,7648,6847,3838,7483,58 79,7389,7079,7538,7781,7122,5118,7590,3583,7593, 7619, 7027,6128, 7782, 7711,6906, 740 3,7580,3071,5630,6647,7511,7540,7069,7943,6099,7485,7390,4060,7022,7594,7621,6073, 6879,7405,7727,8001,5883,4073,7137,7972,7880,7029,8002,6094,7829,7083,7976,4023, 7947,7785,6074,7138,7772,7601,7124,7888,5999,7984,4074,8004,7070,7515,8065,6101,6 908,7411,7830,7622,7085,3965,6102,7486,7843,7111,7786,8066,6047,7949,7030,4047,75 44,7596,6975,7833,6115,7904,7735,7091,8008,7793,3966,5885,6651,7406,7527,7625,703 3,6076,7567,7955,7759,4081,7128,7846,7602,6007,6895,7845,7517,7413,7086,6105,4027, 7626,7834,7788,7140,7531,7295,6117,7359,7115,7950,7575,4076,7034,6106,7604,7794, 7739,6653,7633,7849,6063,7414,4082,7093,7875,7518,7767,7117,6011,7836,7958,7628,7 144,7417,4029,7850,6118,7741,7036,7579,7971,7957,5886,7094,7877,7533,4055,7608,70 07,7796,5631,7857,7542,6903,7591,7634,7961,7152,4030,5119,7418,7539,7649,6654,774 2,7581,6108,7771,7123,7534,7636,4059,7823,7097,6121,8068,7973,7783,6907,7852,7878, 6071,7597,7118,4084,7962,7420,7541,7773,7098,6122,8016,7858,7881,7023,7800,4071, 7650,6013,7974,7125,7595,8072,7582,7126,7391,6095,7831,7860,8003,4088,7071,7787,7 640,7623,6014,7139,7964,7977,7882,7889,6909,8005,3839,6129,7884,8032,7100,7978,77 74,8080,7890,6075,7031,7864,7545,7603,4061,7985,7129,7487,6124,7789,7980,7141,765 2,7598,8006,7835,6130,7130,4075,7656,7407,7546,7627,7087,7790,6077,7795,7605,7548, 7035,7986,7629,7664,4062,7837,6103,7142,7847,7892,8009,6910,7797,7519,7635,6078, 7606,6655,4077,7905,7419,7630,7610,7609,6107,7132,7637,7415,7851,8010,7145,7906,8 067,7838,4031,6132,7951,7095,8017,7988,7896,8096,7146,7959,6119,7535,8069,7798,78 53,7037,4083,8012,7801,7879,6136,7421,7119,7859,7992,8070,7854,7038,7908,8018,588 7,7543,4085,7612,7638,7153,7651,7583,7653,8073,7963,6109,7099,7641,7802,7912,8020, 8128,7148,3967,8033,7861,6123,7965,8074,7154,7883,7975,7642,7804,7862,7101,6110, 7422,7885,7743,4078,8081,7966,7127,7979,7547,7865,7599,6125,7775,7657,7102,8034,7 891,7654,8076,7886,7131,4086,7981,6079,7644,8024,8007,7893,7156,7866,8082,7920,80 36,7987,6131,7982,7143,7607,8097,7658,4089,7791,7839,7907,7160,8084,7631,6133,801 1,7549,7665,6911,8098,7989,7894,8129,8040,7660,7799,6015,4090,7133,7897,7868,7611, 7909,8013,8088,7147,7550,7990,8019,7898,6126,7666,8048,7134,7910,7613,7639,7803, 4063,8100,7855,8071,7149,7993,6134,7668,8014,7913,7994,7900,7614,7103,8130,8104,7 643,8021,8035,6137,7805,4092,8075,7155,7655,7863,7914,7996,7921,8022,8025,7157,76 72,7967,7423,6138,8132,8077,7887,7645,8083,7039,7806,7916,8112,4079,8037,7659,786 7,7922,8026,6111,7150,7646,8136,7551,8078,7983,8144,8038,8085,7158,7895,7661,8041, 7869,8099,6140,7924,8028,4087,7667,7899,7161,7991,8090,8042,8086,7670,8101,7911, 7928,8049,7162,7662,6127,7870,8089,7669,8044,8015,8160,7615,7901,7995,7135,8102,4 091,8050,8105,8131,7915,7673,8023,6135,8092,7902,7997,7164,8133,8106,8052,7674,79 17,8113,8134,7923,8027,8108,7998,8079,7151,8039,7807,8056,6139,7647,8114,4093,791 8,8137,7676,8029,7925,8138,8087,7159,8043,8030,7926,8116,8145,8091,8140,7929,8045, 8120,7663,6141,7871,8103,8146,7163,8051,7930,7671,8093,8046,7903,8161,8053,8107, 4094,8162,8148,8094,7932,8109,8135,7165,8054,7999,8115,7675,8057,6142,8152,7919,8 110, 8164, 813 9, 805 8,7677, 8117, 8141, 8168, 8060, 8118, 8031,7927,7166, 8176,7678, 8147, 81 21,7931,8142,8122,8047,8149,8150,8095,4095,8163,7933,8124,8055,8153,8165,6143,815 4,8111,8059,8166,7934,7679,7167,8156,8169,8119,8170,8061,8143,8062,8177,8123,8172, 8178,8125,8151,8126,8155,8180,8167,8184,7935,8157,8171,8158,8173,8127,8179,8181, 8063,8174,8182,8185,8186,8159,8188,8175,8183,8187,8189,8190,8191];
where the sequence Q2 is given by
[0,1,2,4,8,16,32,3,5,64,1024,2048,9,6,17,10,18,128,12,33,65,20,256,34,24,36,7,129,6 6,512,11,40,68,130,19,13,48,14,72,257,1025,21,132,35,258,26,2049,513,80,37,25,22,136, 260,264,38,514,96,67,41,144,28,69,42,516,49,1026,74,272,160,520,288,528,192,544,70,4 4,131,81,2050,50,73,15,320,133,52,1028,23,134,384,76,137,82,56,27,97,39,259,84,138,14 5,261,1032,29,43,2052,98,515,88,140,30,146,71,262,265,161,576,45,1040,100,640,51,148, 46,75,266,273,517,2056,104,162,53,193,1056,152,77,164,768,268,274,518,54,83,57,521, 1027,112,135,2064,78,289,194,85,276,522,58,168,1029,139,99,86,60,280,89,290,529,208 0,524,196,1088,141,101,147,176,142,530,321,31,200,1033,90,545,292,2051,322,532,263, 149,102,105,1030,304,296,163,92,47,267,385,546,2053,324,1041,208,386,150,153,165,10 6,55,1034,328,536,577,548,2112,113,154,79,269,1042,108,578,224,166,519,552,195,1152, 270,3072,641,523,275,580,291,59,1036,169,560,114,277,156,2057,87,197,1057,116,170, 61,531,525,642,281,1089,278,526,2054,177,293,388,91,1044,584,769,198,172,120,201,20 65,336,1280,62,282,143,103,178,294,1058,93,644,2058,202,592,323,1048,392,297,770,10 7,180,151,1060,2066,209,284,648,94,204,298,1031,400,608,352,2176,325,533,1153,155,2 10,305,547,300,1090,109,2060,184,534,537,115,167,1536,225,326,306,772,2081,157,103 5,656,329,110,117,212,1064,171,2113,776,330,226,549,1092,538,387,308,216,2068,1154, 416,271,279,158,337,1043,550,672,2304,118,332,579,1037,540,389,173,121,1072,2082,5 53,199,784,179,1038,228,338,312,2072,704,390,1096,174,554,581,393,1281,283,2084,12 2,448,353,1045,561,203,63,340,2055,1156,394,527,582,556,181,1059,2177,295,285,232,1 24,1282,205,182,643,2114,562,1050,286,585,299,1537,354,211,2560,401,185,1104,396,3 44,586,645,2059,1061,593,535,240,206,1049,95,2088,327,564,1046,800,402,356,307,211 6,1160,301,417,213,568,1284,832,2178,588,186,1288,646,404,227,896,2067,1062,594,41 8,302,1538,649,771,2061,360,539,1120,111,331,214,1091,2096,309,188,449,1065,217,40 8,2062,609,596,1168,551,650,229,1052,2120,159,420,310,1093,541,773,2305,610,1066,6 57,333,119,1540,3073,600,339,218,1073,368,652,230,2069,1098,391,313,450,1296,542,2 180,334,233,1184,555,774,175,2083,1544,123,658,612,1312,2306,341,777,220,1552,314, 424,2074,395,1216,673,583,355,1568,2561,287,183,234,1094,125,557,2128,660,1068,616, 342,316,2085,1155,241,778,1105,563,345,2073,452,1074,397,403,207,2070,1097,674,55 8,1039,785,432,2184,357,1344,187,236,664,2308,1157,624,587,1076,780,2312,705,126,1 047,242,565,1158,2086,398,346,456,1408,358,2562,405,1100,303,569,244,2144,1161,595 ,189,1106,566,2115,676,361,1080,706,589,2089,1051,215,786,647,1121,2192,348,419,10 63,406,464,2076,680,1283,801,362,1108,2117,590,409,1162,570,2090,788,597,1169,572,2 19,2564,1285,311,708,1053,598,2097,601,1067,651,421,3074,792,1122,802,611,1539,212 2,602,410,1112,231,688,2320, 1164,653,248, 1054,2208,369, 190,364, 1170,654,2568,659, 10 95,335,480,2336,1286,315,221,1289,2576,370,613,1185,422,425,2240,1600,451,614,1069 ,2592,543,235,1124,412,2118,343,372,1664,775,317,2092,1075,222,426,1172,2179,453,2 37,1070,559,2129,833,1099,804,712,2098,1290,834,661,1297,2121,808,779,1541,617,112 8,2063,604,433,1186,720,2368,816,1077,836,347,2181,1217,897,243,1176,2100,662,454, 1101,318,3076,675,1188,618,898,2071,1792,781,376,2182,1292,428,1298,665,2432,736,1 542,567,840,2124,1078,625,238,1107,2185,359,457,1081,399,2130,787,1545,591,1136,21 04,678,434,1159,2075,677,349,1102,245,2145,458,1313,666,1218,2087,620,363,1109,230 7,127,191,1300,782,2132,1546,407,436,1082,2186,626,571,1192,2193,465,1163,681,246, 2309,1123,707,350,3080,1110,599,1084,668,2077,790,1304,460,2091,249,1113,682,1314, 2146,573,411,1553,2563,803,789,1548,709,2136,1220,365,440,2188,1165,628,1125,689,2 078,374,1171,423,2194,466,1200,793,2119,1166,250,371,1554,2310,481,1345,574,2313,4 13,1055,603,2209,1224,366,468,1114,2624,655,1569,900,2093,805,1316,615,3088,1346,6 84,710,2148,1556,429,1287,2688,794,252,1173,373,2099,1126,605,848,2196,1129,690,13 28,2094,713,1320,632,2123,482,1187,806,2314,1116,427,904,2321,1071,414,1291,2565,2 23,663,1409,2152,692,1570,835,2210,1348,619,472,2101,1232,455,1410,2241,796,809,11 74,3104,714,1177,721,2200,1189,837,716,2125,1130,864,1079,2212,810,1352,606,2816,9 12,1560,722,2316,1601,696,1572,2322,377,435,1137,2566,817,1178,319,2102,1103,621,1 293,2131,812,484,1132,2105,430,1602,838,2569,1248,667,3075,488,1190,239,2160,1543, 378,1576,2183,459,1219,622,2126,627,1294,437,2337,1665,380,2242,1547,818,1299,213 3,461,496,1604,2324,669,1315,2570,679,1083,724,2106,1193,841,629,2216,1584,351,113 8,3077,467,1301,2187,438,1180,737,2147,1111,251,1221,2134,462,442,2108,1140,441,11 94,2328,469,1085,2137,247,1555,683,2338,1549,842,1666,2577,738,899,2572,1305,670,1 302,2244,783,1550,3136,849,1201,820,2189,1317,728,2149,1412,928,1115,2195,791,367, 2224,1608,901,1793,2190,630,1222,2578,685,1196,844,2369,1144,633,2079,1225,711,13 60,2248,253,1086,3081,691,1306,824,2138,1167,902,2593,1127,686,740,2340,1202,850,2 370,1318,375,2580,1117,444,1668,2311,470,1226,2197,483,1616,415,2150,1347,485,215 3,1416,905,3078,1321,795,1794,2352,473,1131,2344,634,1204,2211,744,1175,852,2140,1 233,960,2095,1308,865,2315,1672,693,2433,1118,797,1228,2594,906,1322,2372,715,142 4,3089,807,1632,474,2256,1376,636,2434,1349,694,2198,1557,254,2201,1179,717,2213,1 234,575,1329,2154,913,1571,2103,798,1324,3082,811,1133,2376,379,1208,2584,697,155 8,431,2625,607,489,2596,1561,866,2161,1139,723,2202,1191,486,2127,1249,908,2317,13 50,718,1330,3090,813,1796,2156,476,1181,2626,856,1680,2272,839,1353,2214,725,1134, 2567,698,1141,2600,914,1236,2243,752,1195,3200,868,1800,2318,819,1354,2689,814,12 50,439,2571,1573,929,2323,1562,490,2628,1411,623,2339,1332,671,2107,1240,739,3084, 1440,916,2217,1295,463,2608,1303,843,2162,1182,381,2325,1361,497,2204,1574,930,21 35,1696,821,2245,1142,726,3105,1356,1603,2164,961,2218,1564,872,2109,1413,492,257 9,1197,631,2573,1145,729,2690,1577,700,2329,1223,443,3137,1808,741,2326,1203,845,2 574,1252,920,2225,1362,382,2341,1336,822,2436,1728,2139,1414,851,3092,1198,730,26 32,1578,498,2817,1605,880,2246,1417,742,2220,1307,445,2168,1146,2249,471,1472,238 4,1377,635,3328,1585,932,2110,1227,687,2330,1087,903,2191,1364,2151,825,1418,2226, 500,1551,2342,1606,846,3106,1580,745,2141,1205,2692,826,1319,2250,732,1309,2640,4 46,1256,2371,1148,3096,962,1229,2440,936,1206,2345,475,1667,2818,853,2155,1586,86 7,2228,1310,1609,2199,637,1323,3108,907,2257,1378,487,2332,1235,695,2696,1425,214 2,1209,746,2252,1420,828,2346,1368,3079,753,1610,2448,854,1669,2656,1617,2400,857, 1559,2373,504,1264,2581,799,3201,1230,1119,2203,255,1351,2258,964,2353,1588,909,2 595,1824,719,2348,1426,3138,1380,477,2157,1331,915,2232,1325,2582,638,1441,2585,1 237,2163,748,1592,2215,944,1856,3584,869,2273,1612,1210,2374,491,2354,1670,699,28 20,1428,1251,2205,754,3083,1920,858,2704,1618,2377,478,1442,2158,1326,968,2165,16 73,2260,383,1795,3112,910,2219,1384,1563,2824,815,2378,1135,976,2274,1355,2597,12 38,870,3140,1333,2586,917,1212,2435,1473,2356,727,1241,2264,493,3202,1432,873,246 4,1633,2319,1620,701,2327,1575,2206,931,1674,2385,1253,3091,756,1183,2598,860,272 0,1444,1334,2166,499,2380,1565,731,2627,1797,3085,1634,823,2588,1681,2437,922,135 7,2221,1143,2169,874,1624,3120,918,2601,1363,2247,1242,502,2832,1392,2227,933,167 6,3086,1254,2276,743,1415,2386,1337,2360,760,2752,1474,881,2438,1566,3144,1358,49 4,2222,1257,2602,702,2629,1579,1798,2441,921,3329,1199,501,2331,1147,2170,1682,24 96,876,1636,2401,1365,3093,847,1801,2609,992,2251,1244,2111,1338,447,2388,1448,32 04,1419,2442,733,1697,2575,827,2630,1607,2604,1379,934,2229,1311,3107,1207,2343,8 82,1258,2333,937,2280,1149,2172,1581,963,3330,1684,2253,1640,2230,747,1366,2691,5 05,2610,1340,3098,1265,855,2334,1802,2633,1587,2347,924,3585,1369,734,2402,1476,2 259,1421,2449,829,1427,2233,1231,3152,965,2444,1698,2392,1582,938,2634,1809,2693, 1456,3109,884,1381,2641,506,2583,1211,2288,1260,2254,749,1688,3097,1648,2143,945, 2375,1611,2612,1804,966,3094,1729,2848,1150,2450,755,2404,1266,859,2355,1589,3208 ,1422,2349,940,2465,1370,2261,1480,830,2616,1382,3332,1429,2880,911,2636,1327,159 3,2234,871,3336,1268,2694,1619,2452,639,2275,1213,1590,2944,888,3110,1700,2642,13 85,2466,479,2350,1730,3586,1613,946,2697,1239,2819,750,2408,1810,2587,1671,3168,9 69,2159,1372,1443,2379,508,2262,1430,3139,1488,2357,861,2236,1704,2497,1825,757,3 113,1386,2265,1614,2456,970,2657,1433,2644,1594,3216,919,2599,1812,1621,2698,1596 ,2277,875,3100,1243,2207,1335,2468,862,2358,1732,3141,1622,2589,758,1625,2821,167 5,2658,948,3114,1445,2705,1816,2381,977,2167,1826,3588,1635,2648,923,2387,1626,22 66,1434,972,3121,1255,2416,1712,2700,761,2278,1677,3146,1272,2439,877,2361,1393,2 498,1214,3344,1388,2590,952,2382,1678,2281,1683,495,3232,1359,2603,1504,2822,703, 2223,1339,3592,1245,2171,935,2706,1394,2660,1637,3360,978,2389,1446,2825,1449,226 8,1475,3600,883,2362,1638,2472,1567,2443,762,3264,1259,2721,1436,2631,503,2403,13 67,3616,1396,2335,925,2231,1799,2282,1341,3142,1246,2173,878,2605,1450,2708,1477, 3116,735,2664,1261,2390,1583,2364,1857,3203,993,2289,1828,2826,1736,3153,885,2611 ,1858,2393,1685,2500,939,3122,1832,2445,1803,2451,1641,2255,994,3145,1628,2722,14 57,2606,980,3087,1744,2833,1840,2480,1860,2405,926,3392,1371,2235,1921,2284,764,2 712,1267,3205,1686,2672,1478,2635,941,3124,1342,2828,1699,2753,967,2174,1642,3095 ,1922,2290,1805,2613,886,1400,1452,3206,831,2446,1689,2394,1760,2504,1591,3456,94 7,2406,1864,2453,1649,3148,507,2351,1262,2617,1383,2292,1481,3209,889,2643,1423,2 237,1811,3154,1615,2614,984,2724,1702,2409,1458,3128,751,2754,1701,2637,1373,3099 ,1269,2263,942,2834,1482,2695,1690,3169,1644,2396,996,2467,1387,3111,1151,2454,12 15,2512,971,2728,1806,3331,1431,2849,890,2410,1460,3156,1650,2638,1595,2457,509,3 210,1489,2618,1705,2836,1270,2645,949,3217,1731,2620,1374,2267,1623,3333,973,2359 ,1692,2756,1814,3101,1484,2646,1000,2649,1273,3115,1706,2699,1597,2469,892,2840,1 435,3170,1827,2850,1813,2659,950,3587,1733,2650,1389,2458,1464,3160,863,2279,2736 ,1652,3212,1713,2701,1398,2296,759,3102,1447,2417,1490,2238,1817,2412,1008,3218,1 274,2702,1395,2707,1505,3143,510,2383,1598,2528,3334,1437,2363,1627,2269,979,3337 ,1390,2418,1492,2661,1679,3233,953,2470,1924,2473,1829,3648,1639,2499,2662,763,31 17,1708,2591,1734,2283,1453,3172,974,2460,1818,2391,1276,2420,1397,3712,2823,1629 ,2365,954,3123,1872,2270,1714,2474,1737,3220,879,2501,1656,2285,3118,1506,2607,18 30,2881,981,3147,1451,2852,1928,2760,1438,3338,2882,982,2709,1247,3345,1687,2856, 1716,2827,1859,3589,927,2665,3176,1643,2652,1496,2481,1479,3234,995,2768,1820,286 4,1833,3125,2884,1738,2395,1745,3265,765,2945,1861,2291,3224,1740,2710,1888,2502, 956,3149,1834,2366,1630,2723,3236,1936,2666,1746,2946,887,3840,1720,2829,1401,242 4,3340,1459,2476,1841,3346,985,2713,1343,2784,3590,1645,2615,1836,2888,997,3126,1 508,2673,2286,1454,3155,1862,2407,1691,2505,986,3129,2447,1512,2835,1263,3593,140 2,2639,3184,1483,2726,943,2482,1646,3207,1651,2725,2397,1461,3150,1404,2293,891,2 506,3361,1842,2714,1485,3266,1520,2668,1693,2411,3157,998,2175,1703,2239,1748,334 8,2830,1865,3594,766,2455,1653,2484,3130,1375,2674,1491,2619,1462,3240,2513,511,3 211,1761,2729,1275,2294,3171,1486,2755,1466,2398,1465,3158,2647,988,3132,1493,271 6,1271,2838,3352,1707,2508,1866,2297,3161,1001,2730,1762,3362,1923,2621,2459,1694 ,3601,1807,2851,951,2837,3596,1873,2757,1844,3268,2413,1752,2488,1952,3213,1002,2 676,3173,1815,2737,1391,2422,3219,1925,2471,1654,2514,1709,3248,2841,893,3214,186 8,2298,2419,1657,3602,1735,2529,3393,1277,2622,975,2461,1715,3103,2651,1848,3272, 1926,2414,2516,1710,3162,894,2703,3617,1764,2948,1874,2853,3364,1399,2663,1468,33 94,2732,1494,2758,1009,3604,2477,1507,3335,1439,2842,2300,1509,3221,1929,2421,317 4,1819,2653,955,2896,3177,1497,2738,1658,3376,2761,1768,3368,1876,2680,2530,1984, 3235,1004,2854,3164,1889,2475,1717,2952,3119,1821,2462,1930,3339,2271,1010,2711,1 739,3457,2740,1831,3618,2883,1498,3396,1660,2667,2520,1718,3280,957,2503,3458,127 8,2844,1741,2857,3222,1599,2762,3225,1937,2769,1822,3237,2885,983,2764,1835,3178, 2912,1403,3127,2858,1721,3400,1455,2654,2960,1631,3608,1513,2770,3649,958,2744,36 20,1890,2425,1747,2483,3185,1510,2865,3226,1932,2367,1742,3151,2669,987,3341,2860 ,1837,2532,1500,3180,2478,1880,3650,2886,1863,3296,1749,2715,2536,1012,3238,2287, 1722,3591,1938,2426,3624,1776,2507,3267,1892,2670,1843,2675,3342,1838,2485,3713,9 99,2428,1463,3595,2866,1953,3347,2509,1514,2544,3652,1647,2717,1695,3363,2727,176 3,3131,2772,1016,3241,2889,1940,2677,1487,3632,2399,1867,3186,2515,1405,3349,2486 ,1521,3228,2785,767,3159,1954,2299,3269,1845,2510,2490,1750,3188,2489,1985,3242,1 896,2517,3133,1516,2295,3603,1655,2731,3597,989,2890,3714,1753,2786,2947,1724,335 3,1467,2718,3350,1765,2831,3598,1869,2897,3249,1944,2868,3365,1003,2776,3460,1406 ,2976,3163,1846,2839,1875,2415,3656,1754,2949,3841,1522,2678,3270,1904,2733,3244, 990,2892,3192,1766,2681,3273,1469,2759,3408,1495,2301,3134,1659,2739,3354,1956,28 72,3215,1711,2950,3175,1927,2734,1005,2788,3250,1849,2898,3366,1524,2423,3165,187 0,2492,3716,1769,2518,3274,1850,2531,3664,1756,2463,3395,1470,2533,3464,959,2953, 3369,1986,2843,3842,1960,2521,3179,1499,2682,3252,1877,2792,3223,1891,2900,3281,3 008,1661,3356,2913,1931,3720,2741,1011,3166,2845,1511,3276,2954,1719,3370,2763,17 70,3472,2855,1852,3680,2522,1777,3424,2684,1878,3397,2742,1881,3605,2302,1013,322 7,2765,1528,3282,2623,3377,1823,2961,3619,1279,2846,3372,1988,2859,3181,1933,2427 ,3256,1743,2745,3606,1501,2479,2655,2537,1939,3609,2914,895,3187,2771,1662,3239,2 534,1772,3297,2956,1968,3398,2766,3378,1893,2861,3844,1515,2524,3229,1723,2904,37 28,1778,2887,3401,1882,2773,3182,2746,1006,3189,2962,1502,3284,2800,1992,3243,291 6,3848,1407,2867,3402,1934,2862,3298,1839,2487,3621,2000,2977,3610,2538,1894,3459 ,2671,1941,3380,2719,1014,3288,2787,3488,1751,2964,3343,1517,2511,3351,2891,1897, 3230,2429,1725,3409,2545,1955,3622,2978,3744,1780,2869,3190,1884,2774,3404,1523,3 651,3009,3612,1755,2920,3461,1017,2540,3245,2679,1847,3193,2777,1946,3625,2748,32 71,1898,2491,3856,1942,2789,3251,2893,1526,3300,2968,1957,3410,2430,3384,1767,287 0,3776,1784,3462,2899,3246,1905,2778,3626,1018,2546,3653,2928,1518,3465,2790,1726 ,3355,2493,3194,1945,2519,3520,1525,3425,2683,3633,1900,2980,3275,2735,1871,3135, 2951,2016,3412,2873,3466,1471,2548,3599,1757,3654,2894,3628,1851,2793,3253,2874,9 91,3367,2780,1958,3357,2494,3304,1906,3196,3010,3277,1961,2984,3254,2523,1987,371 5,2901,1771,3634,2915,3358,1529,3657,2685,3371,1879,2955,3426,2535,1948,3283,2743 ,1758,3473,3257,2794,1853,3468,2876,3416,1020,2801,3658,2902,1989,3717,3665,1962, 2905,3607,2552,1908,3312,2847,3278,1530,3167,2303,3399,1773,3012,3636,2957,1969,3 872,2767,3474,1990,3428,2525,3379,1779,2963,3373,2686,1883,3489,3285,2796,1964,36 40,2992,3904,1854,2917,3660,3258,1935,2539,3718,2747,1007,3476,3299,2802,1895,396 8,2906,3666,1663,2526,3490,3374,1912,3016,3721,2431,1503,3843,2958,3432,1970,3611 ,2863,3183,1774,3024,3403,3286,1993,2918,3381,2965,1532,3260,3521,2775,1885,3289, 2541,3480,1781,2921,3681,3668,1994,2749,3623,2979,3722,1943,3301,2804,3231,1015,2 908,3492,3382,1899,2547,3613,2779,1886,3845,3682,2871,3729,1782,2970,3405,3191,19 72,2922,3672,2966,2001,3411,3290,2550,1947,3440,2981,3724,3302,1996,2791,3463,338 5,1785,2808,3522,2929,1901,3614,3406,2542,3305,1976,2750,3627,3846,1519,2969,3247 ,2549,3195,1727,3730,2924,3684,1959,3413,2895,3849,3040,2002,3292,3386,2495,1019, 3496,3467,2781,3745,1907,2875,3655,3427,1786,2982,3359,3255,2930,1527,3306,2985,3 197,1949,3629,3011,3732,3688,1902,2795,3414,2553,3388,1759,3313,2903,3850,2017,36 35,2972,3417,2782,1909,3524,3469,2877,3475,1963,3279,3013,3746,2018,3630,2986,385 7,3504,2004,2932,3429,2554,3259,1950,3308,2797,3736,3696,1788,2993,3659,3852,3014 ,1965,3777,3198,2803,3314,1991,2907,3637,3470,2988,1021,3418,3528,2878,1910,3430, 3477,2959,3375,1855,3641,2919,3316,3667,1971,2687,3261,3638,2936,1531,3748,3433,2 527,3778,1913,3661,2994,3287,2798,3858,2008,3719,3017,3420,3491,1775,2556,3478,35 36,2909,1966,3752,3873,2805,3434,2020,3662,3018,3481,3642,1995,2967,3860,3669,364 4,2923,1914,3291,3383,2910,3780,1533,3670,2806,3673,3723,1973,2996,3493,3864,3025 ,3874,1997,3683,2971,3674,3482,2024,3020,3303,3760,2809,1916,3725,3320,2925,3441, 3262,1974,3436,3000,3726,3731,1887,2543,3407,3552,2751,3387,1783,3293,2983,3442,3 685,3026,1022,3494,3497,3523,2931,2032,3686,3615,2810,3307,3484,1534,2551,3415,34 44,2973,3847,2003,3389,3294,2926,3498,3525,1977,2783,3309,3631,3905,1787,3041,387 6,3784,2933,3906,1998,3733,2987,3880,3851,3689,1978,3042,3676,3505,3028,3792,1903 ,3888,3908,2974,3419,3969,2005,2812,3315,3 734,3 526,2989,2006,3390,3 747,3015,3690, 3970,1951,3853,2934,3448,3500,2879,3737,2019,3808,3639,2995,3912,3697,1789,2555,3 310,3431,3529,2937,1980,3471,3859,3663,3032,3750,3506,1911,2799,3749,3421,3317,29 90,2009,3530,3738,3692,3044,3435,3199,2021,3263,3019,3854,3479,2938,2010,3508,369 8,3643,2557,3537,3753,1967,3318,2997,3779,3422,3671,3021,1915,3740,3862,3532,3048 ,3321,3754,2022,3645,2940,3483,3875,3861,1790,2998,3781,3437,3512,2911,3700,1535, 3761,3446,2807,3495,3538,3865,3056,1023,3322,3443,3553,2558,3646,3485,2012,3675,3 027,3438,3540,3727,3001,2025,3972,3877,3687,2811,3756,3782,1975,3501,3022,3866,33 24,3445,3677,3002,2026,3920,3762,3785,2927,3704,3554,1917,3878,3029,3499,3976,348 6,3030,3295,1999,3735,3764,3907,2975,3691,3544,3527,1918,3043,3868,3881,3786,3793 ,2813,3909,2033,3788,3936,3004,3882,3678,3984,3794,1979,2935,3768,3449,3507,3889, 3033,3391,2028,3693,3884,3045,3556,3502,3910,3739,2034,3034,3560,3311,3450,3531,2 991,3694,1981,3699,3509,3452,2939,3890,3533,3568,3741,2007,3046,3751,3796,3913,28 14,3701,3423,3539,1982,3510,2559,3809,3323,3534,3514,3513,2011,3036,3541,3319,375 5,3914,3049,3810,3971,3742,2036,3855,2999,3921,3892,3800,4000,3050,3863,2023,3439 ,3973,3702,3757,2941,3916,3705,3783,2040,3325,3023,3763,3896,3974,3758,2942,3812, 3922,1791,3447,3516,3542,3057,3555,3487,3557,3977,3867,2013,3003,3545,3706,3816,3 924,4032,3052,3937,3765,2027,3869,3978,3058,3787,3879,3546,3708,3766,3005,2014,33 26,3789,3647,3985,3870,3031,3883,3451,3769,3503,2029,3679,3561,3006,3938,3795,355 8,3980,3790,3035,3885,1983,3548,3928,3911,3797,3060,3770,3986,3824,3940,3891,2035 ,3886,3047,3511,4001,3562,3695,3743,3811,3064,3988,3535,2037,3915,3453,3569,2815, 4002,3893,3798,4033,3944,3564,3703,1919,3037,3801,3772,3515,3813,3917,3992,3051,3 454,3894,3923,3802,2030,3570,3952,3038,3814,3517,3543,3707,4004,3759,3975,3053,38 97,2038,3572,3918,3817,3898,3804,3518,3007,4034,4008,3547,3925,3939,2041,3709,397 9,3059,3559,3767,3818,3900,3825,3926,3929,3061,3576,3871,3327,2042,4036,3981,3791 ,3549,3987,2943,3710,3820,4016,3941,3563,3771,3826,3930,2015,3054,3550,4040,3455, 3982,3887,4048,3942,3989,3062,3799,3565,3945,3773,4003,2044,3828,3932,3571,3803,3 065,3895,3994,3946,3990,3574,4005,3815,3832,3953,3066,3566,2031,3774,3993,3573,39 48,3919,4064,3519,3805,3899,3039,4006,3954,4009,4035,3819,3577,3927,2039,3996,380 6,3901,3068,4037,4010,3956,3578,3821,4017,4038,3827,3931,4012,3902,3983,3055,3943 ,3711,3960,2043,3551,4018,3822,4041,3580,3933,3829,4042,3991,3063,3947,3934,3830, 4020,4049,3995,4044,3833,3949,4024,3567,2045,3775,4007,4050,3067,3955,3834,3575,3 997,3950,3807,4065,3957,4011,4066,4052,3998,3836,4013,4039,3069,3958,3903,4019,35 79,3961,2046,4056,3823,4014,4068,4043,3962,3581,4021,4045,4072,3964,4022,3935,383 1,3070,4080,3582,4051,4025,3835,4046,4026,3951,4053,4054,3999,4067,3837,4028,3959 ,4057,4069,2047,4058,4015,3963,4070,3838,3583,3071,4060,4073,4023,4074,3965,4047, 3966,4081,4027,4076,4082,4029,4055,4030,4059,4084,4071,4088,3839,4061,4075,4062,4 077,4031,4083,4085,3967,4078,4086,4089,4090,4063,4092,4079,4087,4091,4093,4094,40 95];
where the sequence Q3 is given by
[0,1,2,4,8,16,32,3,5,64,1024,9,6,17,10,18,128,12,33,65,20,256,34,24,36,7,129,66,512, 11,40,68,130,19,13,48,14,72,257,1025,21,132,35,258,26,513,80,37,25,22,136,260,264,38, 514,96,67,41,144,28,69,42,516,49,1026,74,272,160,520,288,528,192,544,70,44,131,81,50, 73,15,320,133,52,1028,23,134,384,76,137,82,56,27,97,39,259,84,138,145,261,1032,29,43, 98,515,88,140,30,146,71,262,265,161,576,45,1040,100,640,51,148,46,75,266,273,517,104 ,162,53,193,1056,152,77,164,768,268,274,518,54,83,57,521,1027,112,135,78,289,194,85, 276,522,58,168,1029,139,99,86,60,280,89,290,529,524,196,1088,141,101,147,176,142,53 0,321,31,200,1033,90,545,292,322,532,263,149,102,105,1030,304,296,163,92,47,267,385, 546,324,1041,208,386,150,153,165, 106,55, 1034,328,536,577,548, 113, 154,79,269, 1042, 10 8,578,224,166,519,552,195,1152,270,641,523,275,580,291,59,1036,169,560,114,277,156, 87,197,1057,116,170,61,531,525,642,281,1089,278,526,177,293,388,91,1044,584,769,198 ,172,120,201,336,1280,62,282,143,103,178,294,1058,93,644,202,592,323,1048,392,297,7 70,107,180,151,1060,209,284,648,94,204,298,1031,400,608,352,325,533,1153,155,210,30 5,547,300,1090,109,184,534,537,115,167,1536,225,326,306,772,157,1035,656,329,110,11 7,212,1064,171,776,330,226,549,1092,538,387,308,216,1154,416,271,279,158,337,1043,5 50,672,118,332,579,1037,540,389,173,121,1072,553,199,784,179,1038,228,338,312,704,3 90,1096,174,554,581,393,1281,283,122,448,353,1045,561,203,63,340,1156,394,527,582,5 56,181,1059,295,285,232,124,1282,205,182,643,562,1050,286,585,299,1537,354,211,401, 185,1104,396,344,586,645,1061,593,535,240,206,1049,95,327,564,1046,800,402,356,307, 1160,301,417,213,568,1284,832,588,186,1288,646,404,227,896,1062,594,418,302,1538,6 49,771,360,539,1120,111,331,214,1091,309,188,449,1065,217,408,609,596,1168,551,650, 229,1052,159,420,310,1093,541,773,610,1066,657,333,119,1540,600,339,218,1073,368,6 52,230,1098,391,313,450,1296,542,334,233,1184,555,774,175,1544,123,658,612,1312,34 1,777,220,1552,314,424,395,1216,673,583,355,1568,287,183,234,1094,125,557,660,1068, 616,342,316,1155,241,778,1105,563,345,452,1074,397,403,207,1097,674,558,1039,785,4 32,357,1344,187,236,664,1157,624,587,1076,780,705,126,1047,242,565,1158,398,346,45 6,1408,358,405,1100,303,569,244,1161,595,189,1106,566,676,361,1080,706,589,1051,21 5,786,647,1121,348,419,1063,406,464,680,1283,801,362,1108,590,409,1162,570,788,597, 1169,572,219,1285,311,708,1053,598,601,1067,651,421,792,1122,802,611,1539,602,410,1 112,231,688,1164,653,248,1054,369,190,364,1170,654,659,1095,335,480,1286,315,221,1 289,370,613,1185,422,425,1600,451,614,1069,543,235,1124,412,343,372,1664,775,317,1 075,222,426,1172,453,237,1070,559,833,1099,804,712,1290,834,661,1297,808,779,1541, 617,1128,604,433,1186,720,816,1077,836,347,1217,897,243,1176,662,454,1101,318,675,1 188,618,898,1792,781,376,1292,428,1298,665,736,1542,567,840,1078,625,238,1107,359, 457,1081,399,787,1545,591,1136,678,434,1159,677,349,1102,245,458,1313,666,1218,620 ,363,1109,127,191,1300,782,1546,407,436,1082,626,571,1192,465,1163,681,246,1123,707 ,350,1110,599,1084,668,790,1304,460,249,1113,682,1314,573,411,1553,803,789,1548,709 ,1220,365,440,1165,628,1125,689,374,1171,423,466,1200,793,1166,250,371,1554,481,134 5,574,413,1055,603,1224,366,468,1114,655,1569,900,805,1316,615,1346,684,710,1556,4 29,1287,794,252,1173,373,1126,605,848,1129,690,1328,713,1320,632,482,1187,806,1116, 427,904,1071,414,1291,223,663,1409,692,1570,835,1348,619,472,1232,455,1410,796,809 ,1174,714,1177,721,1189,837,716,1130,864,1079,810,1352,606,912,1560,722,1601,696,15 72,377,435,1137,817,1178,319,1103,621,1293,812,484,1132,430,1602,838,1248,667,488,1 190,239,1543,378,1576,459,1219,622,627,1294,437,1665,380,1547,818,1299,461,496,160 4,669,1315,679,1083,724,1193,841,629,1584,351,1138,467,1301,438,1180,737,1111,251,1 221,462,442,1140,441,1194,469,1085,247,1555,683,1549,842,1666,738,899,1305,670,130 2,783,1550,849,1201,820,1317,728,1412,928,1115,791,367,1608,901,1793,630,1222,685, 1196,844,1144,633,1225,711,1360,253,1086,691,1306,824,1167,902,1127,686,740,1202,8 50,1318,375,1117,444,1668,470,1226,483,1616,415,1347,485,1416,905,1321,795,1794,47 3,1131,634,1204,744,1175,852,1233,960,1308,865,1672,693,1118,797,1228,906,1322,715, 1424,807,1632,474,1376,636,1349,694,1557,254, 1179,717, 1234,575, 1329,913, 1571,798, 1 324,811,1133,379,1208,697,1558,431,607,489,1561,866,1139,723,1191,486,1249,908,135 0,718,1330,813,1796,476,1181,856,1680,839,1353,725,1134,698,1141,914,1236,752,1195, 868,1800,819,1354,814,1250,439,1573,929,1562,490,1411,623,1332,671,1240,739,1440,9 16,1295,463,1303,843,1182,381,1361,497,1574,930,1696,821,1142,726,1356,1603,961,15 64,872,1413,492,1197,631,1145,729,1577,700,1223,443,1808,741,1203,845,1252,920,136 2,382,1336,822,1728,1414,851,1198,730,1578,498,1605,880,1417,742,1307,445,1146,471 ,1472,1377,635,1585,932,1227,687,1087,903,1364,825,1418,500,1551,1606,846,1580,745 ,1205,826,1319,732,1309,446,1256,1148,962,1229,936,1206,475,1667,853,1586,867,1310 ,1609,637,1323,907,1378,487,1235,695,1425,1209,746,1420,828,1368,753,1610,854,1669 ,1617,857,1559,504,1264,799,1230,1119,255,1351,964,1588,909,1824,719,1426,1380,477 ,1331,915,1325,638,1441,1237,748,1592,944,1856,869,1612,1210,491,1670,699,1428,125 1,754,1920,858,1618,478,1442,1326,968,1673,383,1795,910,1384,1563,815,1135,976,135 5,1238,870,1333,917,1212,1473,727,1241,493,1432,873,1633,1620,701,1575,931,1674,12 53,756,1183,860,1444,1334,499,1565,731,1797,1634,823,1681,922,1357,1143,874,1624,9 18,1363,1242,502,1392,933,1676,1254,743,1415,1337,760,1474,881,1566,1358,494,1257, 702,1579,1798,921,1199,501,1147,1682,876,1636,1365,847,1801,992,1244,1338,447,144 8,1419,733,1697,827,1607,1379,934,1311,1207,882,1258,937,1149,1581,963,1684,1640,7 47,1366,505,1340,1265,855,1802,1587,924,1369,734,1476,1421,829,1427,1231,965,1698, 1582,938,1809,1456,884,1381,506,1211,1260,749,1688,1648,945,1611,1804,966,1729,11 50,755,1266,859,1589,1422,940,1370,1480,830,1382,1429,911,1327,1593,871,1268,1619, 639,1213,1590,888,1700,1385,479,1730,1613,946,1239,750,1810,1671,969,1372,1443,50 8,1430,1488,861,1704,1825,757,1386,1614,970,1433,1594,919,1812,1621,1596,875,1243, 1335,862,1732,1622,758,1625,1675,948,1445,1816,977,1826,1635,923,1626,1434,972,12 55,1712,761,1677,1272,877,1393,1214,1388,952,1678,1683,495,1359,1504,703,1339,124 5,935,1394,1637,978,1446,1449,1475,883,1638,1567,762,1259,1436,503,1367,1396,925,1 799,1341,1246,878,1450,1477,735,1261,1583,1857,993,1828,1736,885,1858,1685,939,18 32,1803,1641,994,1628,1457,980,1744,1840,1860,926,1371,1921,764,1267,1686,1478,94 1,1342,1699,967,1642,1922,1805,886,1400,1452,831,1689,1760,1591,947,1864,1649,507, 1262,1383,1481,889,1423,1811,1615,984,1702,1458,751,1701,1373,1269,942,1482,1690, 1644,996,1387,1151,1215,971,1806,1431,890,1460,1650,1595,509,1489,1705,1270,949,1 731,1374,1623,973,1692,1814,1484,1000,1273,1706,1597,892,1435,1827,1813,950,1733, 1389,1464,863,1652,1713,1398,759,1447,1490,1817, 1008, 1274, 1395, 1505,510, 1598, 1437 ,1627,979,1390,1492,1679,953,1924,1829,1639,763,1708,1734,1453,974,1818,1276,1397, 1629,954,1872,1714,1737,879,1656,1506,1830,981,1451,1928,1438,982,1247,1687,1716, 1859,927,1643,1496,1479,995,1820,1833,1738,1745,765,1861,1740,1888,956,1834,1630, 1936,1746,887,1720,1401,1459,1841,985,1343,1645,1836,997,1508,1454,1862,1691,986, 1512,1263,1402,1483,943,1646,1651,1461,1404,891,1842,1485,1520,1693,998,1703,1748 ,1865,766,1653,1375,1491,1462,511,1761,1275,1486,1466,1465,988,1493,1271,1707,186 6,1001,1762,1923,1694,1807,951,1873,1844,1752,1952,1002,1815,1391,1925,1654,1709, 893,1868,1657,1735,1277,975,1715,1848,1926,1710,894,1764,1874,1399,1468,1494,1009 ,1507,1439,1509,1929,1819,955,1497,1658,1768,1876,1984,1004,1889,1717,1821,1930,1 010,1739,1831,1498,1660,1718,957,1278,1741,1599,1937,1822,983,1835,1403,1721,1455 ,1631,1513,958,1890,1747,1510,1932,1742,987,1837,1500,1880,1863,1749,1012,1722,19 38,1776,1892,1843,1838,999,1463,1953,1514,1647,1695,1763,1016,1940,1487,1867,1405 ,1521,767,1954,1845,1750,1985,1896,1516, 1655,989, 1753, 1724, 1467, 1765, 1869, 1944, 10 03,1406,1846,1875,1754,1522,1904,990,1766,1469,1495,1659,1956,1711,1927,1005,1849 ,1524,1870,1769,1850,1756,1470,959,1986,1960,1499,1877,1891,1661,1931,1011,1511,1 719,1770,1852,1777,1878,1881,1013,1528,1823,1279,1988,1933,1743,1501,1939,895,166 2,1772,1968,1893,1515,1723,1778,1882,1006,1502,1992,1407,1934,1839,2000,1894,1941 ,1014,1751,1517,1897,1725,1955,1780,1884,1523,1755,1017,1847,1946,1898,1942,1526, 1957,1767,1784,1905,1018,1518,1726,1945,1525,1900,1871,2016,1471,1757,1851,991,19 58,1906,1961,1987,1771,1529,1879,1948,1758,1853,1020,1989,1962,1908,1530,1773,196 9,1990,1779,1883,1964,1854,1935,1007,1895,1663, 1912, 1503, 1970, 1774, 1993, 1532, 1885 ,1781,1994,1943,1015,1899,1886,1782,1972,2001,1947,1996,1785,1901,1976,1519,1727, 1959,2002,1019,1907,1786,1527,1949,1902,1759,2017,1909,1963,2018,2004,1950,1788,1 965,1991,1021,1910,1855,1971,1531,1913,2008,1775,1966,2020,1995,1914,1533,1973,19 97,2024,1916,1974,1887,1783,1022,2032,1534,2003,1977,1787,1998,1978,1903,2005,200 6,1951,2019,1789,1980,1911,2009,2021,2010, 1967, 1915,2022, 1790, 1535, 1023,2012,2025 ,1975,2026,1917,1999,1918,2033,1979,2028,2034,1981,2007,1982,2011,2036,2023,2040, 1791,2013,2027,2014,2029,1983,2035,2037,1919,2030,2038,2041,2042,2015,2044,2031,2 039,2043,2045,2046,2047];
wherein sequence numbers of N polarized channels in the second sequence are arranged in ascending order of reliability of the N polarized channels, and a minimum value of the sequence numbers of the polarized channels is 0; or
the second sequence is a part or all of a sequence Z1, a sequence Z2 or a sequence Z3;
where the sequence Z1 is given by
[0,1,2,7,3,8,14,27,4,13,16,31,19,36,38,84,5,15,17,35,22,42,52,89,25,51,46,97,63,106, 113,182,6,20,24,44,26,50,57,99,32,61,65,107,78,120,126,201,37,67,82,124,87,135,145,21 5,96,147,160,243,166,257,281,408,9,21,29,60,33,64,77,115,39,83,69,127,92,139,153,224, 49,80,95,146,101,156,165,251,111,168,186,269,200,288,307,454,59,98,109,164,122,176,1 94,284,133,195,214,299,227,325,343,494,150,222,247,330,254,344,371,528,275,378,402, 556,423,581,627,877,18,28,34,79,43,86,90,151,54,94,102,163,112,175,179,283,62,103,11 4,177,125,193,211,301,138,212,223,319,249,339,364,516,71,118,134,199,140,213,230,33 1,161,245,255,347,274,377,394,553,178,266,285,385,300,417,426,578,327,440,475,615,5 01,649,725,878,75,136,155,233,173,252,273,382,183,277,291,407,308,425,452,603,208,3 04,320,437,345,468,496,662,358,504,533,690,564,738,767,1022,229,334,352,479,387,513 ,538,715,422,548,579,755,616,773,842,1103,451,592,630,809,645,865,897,1175,720,914, 951,1160,990,1235,1333,1678,23,40,45,100,55,104,116,192,56,117,129,202,142,225,236, 362,70,130,143,240,157,248,263,363,167,261,282,400,305,421,432,577,73,154,169,242,1 88,267,286,420,198,297,309,434,323,466,486,643, 197,321,336,463,3 57,500,518,694,3 89, 542,566,737,589,764,816,1081,85,181,190,293,206,316,335,456,217,342,351,495,372,527 ,547,733,279,365,388,532,409,562,588,760,443,597,635,805,667,862,901,1147,313,404,4 36,574,462,613,638,845,491,655,677,874,726,931,966,1211,535,724,742,952,761,992,940 ,1257,826,1074,1107,1355,1121,1459,1518,1755,91,203,209,356,268,376,392,541,295,39 7,412,569,442,601,634,849,311,439,461,602,478,641,670,884,505,682,713,921,757,960,1 019,1270,361,467,484,668,517,703,745,943,567,746,769,1014,830,985,1092,1361,611,79 7,858,1075,885,1117,1154,1426,932,1168,1165,1503,1260,1547,1599,1928,403,502,543,7 50,599,772,814,1037,636,847,867,1110,912,1128,1163,1452,672,893,945,1150,967,1172,1 264,1552,1034,1284,1322,1613,1390,1696,1745,2117,734,955,1008,1267,1089,1273,1376 ,1634,1101,1365,1433,1725,1488,1791,1886,2269,1129,1463,1535,1824,1577,1902,1857, 2323,1667,1977,2030,2480,2145,2568,2678,3005,30,48,58,110,66,131,144,231,72,148,15 9,239,172,259,264,413,74,170,180,258,191,317,328,450,218,329,355,492,375,520,545,75 4,76,187,204,322,220,353,368,510,232,381,395,551,416,582,608,775,246,406,430,595,45 7,631,652,836,469,644,684,890,689,920,957,1340,119,219,228,373,241,396,414,572,271, 433,445,622,474,658,680,853,292,449,483,648,508,687,697,905,531,699,712,962,796,996 ,1062,1363,312,507,523,708,558,743,751,977,587,792,820,1033,873,1084,1112,1437,621, 841,889,1115,936,1143,1218,1492,1006,1228,1288,1557,1326,1626,1705,2102,123,238,2 60,427,289,446,477,664,306,488,511,702,536,719,728,970,341,526,557,731,585,785,813, 1023,617,832,869,1098,907,1133,1190,1441,369,571,606,818,654,861,857,1136,674,895, 916,1178,981,1222,1248,1564,716,938,1000,1239,1027,1305,1329,1638,1070,1358,1405, 1729,1499,1802,1892,2278,391,626,657,900,695,928,982,1231,781,1004,1046,1316,1053, 1336,1383,1689,799,1048,1067,1372,1138,1401,1474,1788,1203,1495,1532,1828,1595,19 36,1996,2352,834,1156,1185,1445,1249,1507,1543,1869,1292,1586,1644,1973,1711,2038 ,2130,2512,1412,1653,1736,2060,1814,2160,2203,2654,1876,2243,2315,2718,2421,2834, 2985,3484,141,272,298,489,337,521,552,763,349,563,593,790,624,825,881,1193,383,610, 663,851,686,925,909,1210,705,947,989,1281,1041,1309,1347,1671,460,676,707,924,780, 975,1011,1319,789,1042,1060,1351,1088,1387,1424,1765,801,1078,1124,1420,1199,1471 ,1522,1835,1241,1573,1591,1940,1648,2004,2079,2459,471,778,784,1029,804,1051,1095, 1398,837,1142,1181,1456,1224,1510,1582,1917,997,1197,1253,1528,1294,1616,1657,198 4,1394,1663,1739,2064,1818,2153,2195,2640,1056,1301,1368,1620,1416,1719,1776,2094 ,1484,1795,1847,2187,1910,2251,2343,2760,1539,1880,1954,2306,2026,2372,2453,2866, 2109,2491,2557,2952,2616,3109,3149,3832,480,808,822,1186,972,1215,1245,1568,1015, 1277,1312,1630,1379,1685,1759,2087,1064,1344,1409, 1699, 1448, 1781, 1851,2177, 1514, 1 898,1840,2227,1992,2332,2413,2803,1206,1430,1467,1807,1561,1862,1946,2286,1609,19 58,2018,2381,2072,2433,2524,2934,1715,2045,2124,2471,2210,2580,2628,3065,2262,270 4,2747,3199,2848,3272,3331,3683,1298,1481,1605,1965,1681,2011,2052,2442,1750,2138 ,2169,2548,2234,2592,2730,3129,1769,2219,2295,2692,2401,2774,2787,3300,2503,2883, 2915,3359,3027,3524,3596,4162,1921,2364,2392,2817,2536,2897,2971,3420,2604,3047,3 085,3560,3225,3639,3888,4347,2666,3174,3247,3730,3387,3776,3946,4458,3454,4014,40 85,4599,4244,4770,5021,5420,10,41,68,149,88,162,196,310,105,184,216,340,244,374,386 ,609,121,207,226,366,270,405,459,628,294,453,431,660,514,696,722,961,137,253,287,41 8,302,448,482,669,346,503,525,700,586,752,774,1018,379,534,600,766,623,802,840,1057 ,656,848,886,1137,906,1173,1236,1567,174,262,324,497,354,519,580,732,393,605,540,77 9,642,815,864,1083,441,594,651,843,678,875,904,1159,714,915,968,1207,1013,1259,130 7,1675,493,665,706,899,756,937,994,1247,793,999,1055,1286,1090,1352,1403,1768,854, 1076,1148,1371,1167,1406,1473,1844,1227,1494,1549,1905,1602,1961,2057,2542,235,31 8,360,591,411,620,632,859,465,647,683,894,718,934,949,1243,509,688,727,941,770,991, 1043,1293,810,1047,1080,1335,1155,1392,1458,1815,550,744,798,1010,819,1050,1102,1 374,891,1141,1169,1414,1223,1490,1530,1901,946,1198,1252,1509,1289,1588,1610,1952 ,1356,1643,1723,2033,1782,2105,2257,2545,570,807,870,1111,930,1161,1219,1502,964,1 230,1265,1563,1310,1606,1674,2008,1036,1296,1339,1637,1410,1708,1775,2127,1443,17 89,1856,2189,1924,2284,2341,2791,1097,1378,1425,1733,1513,1811,1866,2237,1600,188 9,1956,2318,2035,2355,2483,2923,1669,1982,2062,2424,2097,2521,2577,3034,2248,2607 ,2669,3011,2736,3126,3278,3795,280,398,424,675,470,693,736,986,476,739,783,1020,82 8,1085,1116,1451,544,787,831,1125,880,1151,1191,1454,910,1188,1240,1546,1300,1596, 1623,1949,559,868,917,1134,976,1201,1255,1592,1005,1279,1313,1628,1349,1702,1749, 2090,1001,1341,1384,1698,1440,1778,1822,2192,1520,1873,1926,2281,1980,2338,2436,2 886,614,956,979,1272,1032,1328,1382,1679,1061,1399,1421,1772,1477,1841,1885,2272, 1233,1462,1517,1853,1571,1914,1974,2326,1651,1995,2075,2416,2141,2518,2586,2993,1 324,1556,1633,1945,1694,2027,2082,2486,1762,2115,2163,2539,2260,2634,2695,3093,18 60,2254,2289,2672,2329,2740,2651,3163,2455,2872,2926,3309,2948,3473,3565,3908,637 ,1025,1039,1436,1205,1487,1527,1870,1276,1542,1575,1933,1647,2001,2069,2494,1317, 1641,1692,2005, 1732,2084,2148,2554, 1794,2171,2233,2619,2321,2686,2783,3183, 1447, 1 706,1746,2142,1820,2213,2298,2657,1930,2301,2346,2777,2456,2727,2905,3317,2023,23 98,2509,2877,2559,2945,3000,3424,2637,3023,3019,3538,3166,3607,3678,4140,1553,178 5,1878,2303,1999,2349,2430,2814,2078,2489,2527,2931,2601,2960,3016,3463,2151,2571 ,2660,2997,2698,3031,3171,3613,2811,3205,3261,3700,3367,3818,3894,4381,2275,2675, 2767,3179,2900,3188,3345,3736,2920,3326,3434,3863,3513,3960,4093,4559,2963,3479,3 585,4000,3650,4111,4050,4630,3782,4206,4274,4814,4414,4914,5049,5398,332,435,487, 709,529,791,835,1105,555,852,883,1123,926,1180,1194,1578,565,922,953,1176,984,1332, 1360,1665,1066,1367,1432,1763,1483,1827,1882,2312,575,971,1028,1345,1071,1428,146 6,1805,1108,1498,1534,1894,1585,1964,2016,2358,1146,1559,1619,1989,1684,2067,2106 ,2468,1712,2091,2174,2565,2184,2613,2681,3286,748,1069,1094,1478,1130,1538,1581,1 942,1213,1624,1655,2047,1721,2123,2166,2500,1269,1661,1742,2099,1801,2181,2201,25 89,1848,2205,2230,2689,2395,2744,2855,3322,1321,1798,1833,2224,1912,2292,2309,271 3,1970,2389,2445,2808,2533,2891,2937,3440,2042,2477,2562,2940,2645,2988,3101,3518 ,2763,3118,3208,3618,3264,3719,3838,4364,762,1120,1182,1614,1261,1658,1728,2135,1 304,1752,1809,2208,1864,2245,2265,2701,1395,1837,1908,2268,1968,2378,2427,2794,20 39,2462,2530,2912,2595,2966,3058,3443,1469,1937,2014,2439,2112,2515,2506,2974,215 6,2574,2610,3039,2721,3104,3146,3629,2240,2648,2753,3133,2797,3233,3269,3742,2869 ,3314,3392,3869,3534,3974,4097,4570,1524,2054,2120,2583,2198,2631,2724,3121,2369, 2757,2828,3250,2842,3281,3354,3812,2404,2831,2863,3340,2977,3381,3498,3954,3078,3 529,3580,4008,3672,4146,4228,4661,2465,3008,3050,3448,3154,3543,3602,4065,3213,36 61,3747,4198,3843,4282,4397,4852,3401,3759,3875,4306,3988,4431,4486,5006,4071,453 1,4619,5091,4736,5218,5378,5901,824,1216,1282, 1756, 1388, 1831, 1896,2335, 1417, 1918, 1987,2387,2050,2450,2551,3062,1505,2020,2133,2497,2180,2625,2598,3090,2216,2663,2 733,3196,2820,3238,3295,3789,1688,2159,2222,2622,2366,2710,2770,3255,2384,2823,28 52,3303,2894,3364,3415,3920,2407,2880,2956,3410,3073,3493,3571,4022,3138,3644,366 7,4154,3753,4236,4331,4791,1716,2361,2375,2800,2410,2837,2908,3378,2474,2982,3042 ,3468,3113,3549,3655,4127,2750,3070,3158,3574,3216,3706,3765,4214,3373,3770,3880, 4315,3994,4422,4475,4992,2845,3230,3336,3711,3406,3857,3934,4356,3507,3967,4036,4 467,4119,4540,4650,5137,3591,4079,4176,4610,4266,4681,4779,5253,4372,4826,4902,53 42,4965,5524,5571,6216,1738,2418,2448,3053,2707,3098,3141,3635,2780,3191,3242,372 5,3350,3807,3914,4339,2859,3291,3395,3826,3459,3940,4042,4450,3554,4105,4028,4512 ,4222,4639,4724,5184,3081,3429,3488,3980,3624,4056,4168,4579,3695,4184,4258,4692, 4323,4747,4864,5323,3849,4290,4389,4802,4494,4926,4979,5480,4551,5079,5122,5619,5 234,5693,5750,6084,3221,3504,3689,4192,3801,4252,4298,4758,3900,4406,4439,4887,45 22,4940,5107,5547,3926,4503,4590,5064,4713,5153,5169,5721,4840,5269,5304,5776,544 0,5935,6005,6505,4133,4670,4701,5202,4875,5288,5362,5837,4952,5460,5504,5970,5644 ,6044,6268,6660,5034,5595,5668,6125,5808,6170,6320,6752,5867,6374,6438,6866,6579, 6995,7168,7433,11,47,81,189,108,205,265,410,132,250,290,447,326,490,506,794,152,278 ,303,481,359,539,604,823,390,598,568,860,673,908,939,1229,171,338,380,554,401,590,6 33,872,455,659,685,913,765,974,1003,1299,498,698,782,993,811,1035,1082,1346,856,10 91,1140,1442,1166,1485,1562,1925,221,348,428,653,464,679,759,948,515,788,710,1007, 839,1054,1114,1377,583,776,850,1087,882,1127,1162,1468,929,1174,1242,1525,1295,158 7,1642,2043,646,866,918,1157,983,1204,1271,1572, 1026, 1275, 1343, 1618, 1389, 1697, 174 7,2139,1104,1369,1457,1710,1479,1751,1823,2220,1548,1845,1906,2285,1962,2342,2443 ,2972,314,419,473,771,546,806,827, 1109,612,844,888, 1153,933,1200,1217,1569,666,892, 944,1209,998,1266,1330,1625,1049,1334,1373,1676,1464,1734,1806,2191,723,963,1030, 1290,1058,1338,1400,1714,1144,1449,1482,1760, 1544, 1843, 1888,2279, 1212, 1515, 1576, 1 861,1621,1948,1972,2333,1701,2007,2093,2417,2155,2496,2662,2976,747,1040,1122,141 1,1192,1472,1541,1855,1234,1551,1593,1922,1646,1969,2037,2391,1323,1632,1680,2000 ,1754,2076,2146,2522,1790,2164,2231,2588,2302,2691,2752,3245,1396,1720,1771,2104, 1868,2185,2244,2642,1960,2267,2336,2726,2420,2764,2904,3390,2034,2365,2449,2839,2 487,2950,3013,3515,2653,3044,3114,3489,3186,3615,3774,4278,370,522,560,876,619,89 8,954,1263,625,959,1012,1302,1068,1380,1419,1799,717,1017,1073,1431,1131,1461,150 8,1803,1170,1500,1566,1904,1635,1957,1985,2331,735,1118,1179,1438,1251,1519,1580,1 953,1287,1611,1649,1991,1690,2071,2119,2481,1283,1683,1727,2065,1786,2152,2196,25 94,1874,2253,2308,2687,2359,2746,2853,3352,800,1225,1254,1601,1315,1666,1724,2046 ,1354,1743,1767,2144,1826,2217,2264,2680,1554,1810,1872,2229,1929,2296,2356,2735, 2015,2376,2464,2830,2534,2943,3021,3466,1662,1913,1997,2325,2061,2411,2472,2910,2 131,2508,2558,2968,2665,3076,3143,3576,2238,2659,2697,3116,2738,3193,3095,3652,28 74,3338,3397,3809,3422,3972,4061,4378,833,1306,1327,1784,1523,1839,1881,2250,1607 ,1897, 1934,2313,2012,2385,2461,2918, 1656,2003,2058,2388,2101,2475,2543,2987,2167, 2567,2636,3057,2732,3131,3240,3674,1797,2073,2116,2537,2194,2615,2706,3099,2311,2 709,2755,3232,2878,3178,3371,3820,2408,2812,2936,3341,2990,3417,3477,3922,3080,35 02,3497,4038,3657,4101,4172,4596,1909,2157,2255,2715,2379,2761,2847,3274,2467,291 3,2953,3402,3040,3432,3495,3962,2546,3003,3103,3472,3144,3509,3663,4107,3267,3696 ,3757,4190,3865,4302,4366,4821,2683,3123,3220,3668,3366,3680,3841,4220,3385,3824, 3932,4341,4016,4427,4546,4994,3436,3978,4087,4469,4142,4566,4509,5051,4264,4656,4 720,5221,4854,5315,5432,5756,438,576,639,923,692,1021,1077,1404,729,1096,1135,142 7,1187,1493,1512,1938,741,1184,1221,1489,1258,1670,1703,2031,1357,1707,1780,2134, 1836,2202,2261,2723,753,1246,1311,1687,1366,1773,1816,2178,1407,1852,1890,2274,19 44,2345,2400,2769,1453,1919,1978,23 74,2049,2452,2502,2893,2080,2484,2573,2998,258 5,3055,3128,3786,969,1362,1393,1829,1435,1893,1941,2322,1533,1988,2019,2431,2088, 2517,2564,2928,1597,2028,2113,2493,2173,2579,2603,3026,2226,2606,2633,3136,2809,3 198,3319,3822,1660,2170,2209,2627,2291,2700,2717,3164,2353,2805,2861,3266,2964,33 57,3408,3938,2429,2902,2995,3411,3086,3461,3587,4020,3218,3604,3702,4115,3763,421 0,4312,4805,988,1422,1497,1976,1590,2022,2098,2528,1639,2126,2182,2612,2241,2650, 2671,3151,1741,2215,2288,2674,2348,2789,2844,3249,2423,2885,2958,3383,3032,3441,3 540,3944,1819,2319,2397,2856,2505,2942,2932,3447,2549,3010,3049,3520,3169,3593,36 37,4125,2643,3091,3206,3620,3254,3728,3768,4226,3333,3814,3886,4345,4032,4441,455 3,5001,1877,2440,2514,3018,2597,3071,3173,3609,2781,3211,3288,3746,3302,3780,3853 ,4294,2819,3293,3327,3836,3452,3882,3996,4420,3562,4026,4081,4473,4166,4605,4679, 5081,2888,3482,3531,3950,3641,4044,4096,4525,3708,4156,4234,4652,4321,4729,4835,5 256,3898,4246,4354,4754,4454,4871,4918,5406,4533,4962,5041,5472,5156,5589,5737,61 85,1063,1537,1615,2128,1730,2206,2277,2743,1764,2299,2368,2798,2437,2870,2980,354 5,1858,2405,2525,2921,2576,3067,3036,3573,2618,3108,3184,3691,3279,3734,3797,4270 ,2056,2555,2624,3063,2778,3159,3227,3751,2795,3283,3312,3803,3362,3859,3916,4393, 2822,3347,3427,3910,3556,3990,4067,4482,3626,4136,4160,4612,4240,4688,4777,5197,2 086,2772,2786,3259,2826,3298,3376,3877,2896,3457,3525,3966,3598,4048,4150,4583,32 01,3551,3646,4075,3713,4196,4250,4665,3871,4260,4360,4761,4460,4861,4909,5392,330 7,3723,3830,4202,3904,4333,4408,4795,4010,4433,4497,4899,4575,4972,5071,5515,4091 ,4538,4627,5031,4715,5102,5189,5622,4812,5232,5301,5706,5367,5854,5891,6465,2108, 2836,2864,3533,3156,3582,3631,4131,3235,3685,3740,4216,3847,4288,4385,4786,3321,3 791,3892,4308,3956,4412,4501,4890,4054,4561,4488,4945,4674,5059,5145,5559,3567,39 28,3984,4446,4121,4516,4621,5011,4186,4634,4706,5112,4768,5166,5266,5687,4327,473 8,4830,5210,4928,5329,5381,5814,4984,5457,5501,5939,5604,6001,6055,6349,3717,4004 ,4180,4643,4284,4697,4745,5176,4374,4845,4880,5293,4955,5340,5486,5874,4399,4935, 5019,5446,5132,5530,5542,6026,5245,5638,5671,6077,5779,6220,6280,6711,4588,5094,5 125,5574,5280,5653,5725,6132,5353,5795,5831,6248,5959,6312,6509,6843,5418,5915,59 80,6387,6102,6421,6551,6923,6159,6602,6651,7020,6773,7126,7280,7500,237,530,704,1 100,817,1149,1278,1652,902,1237,1350,1737,1446,1832,1865,2402,978,1318,1385,1812, 1529,1916,2053,2446,1604,2041,1981,2519,2188,2600,2656,3134,1044,1476,1583,1950,1 629,2024,2110,2540,1758,2162,2212,2609,2351,2720,2766,3237,1849,2236,2382,2749,24 34,2825,2899,3310,2511,2916,2992,3450,3029,3511,3617,4129,1195,1504,1693,2149,177 7,2199,2339,2677,1884,2394,2247,2775,2478,2850,2947,3355,2009,2371,2499,2907,2561 ,2969,3024,3486,2639,3045,3148,3569,3228,3654,3732,4276,2137,2531,2621,3014,2729, 3088,3194,3633,2806,3203,3305,3698,3369,3805,3884,4395,2929,3343,3470,3834,3500,3 890,3992,4492,3600,4024,4103,4568,4178,4636,4752,5285,1415,1672,1793,2362,1932,24 26,2458,2939,2068,2490,2570,3006,2647,3083,3111,3628,2175,2582,2668,3096,2758,318 9,3284,3710,2841,3290,3348,3778,3480,3867,3970,4456,2271,2703,2815,3223,2858,3296 ,3388,3839,3001,3455,3506,3902,3594,4018,4077,4564,3106,3553,3642,4046,3704,4158, 4188,4625,3811,4232,4337,4722,4416,4807,4977,5290,2316,2833,2961,3404,3075,3491,3 589,4034,3139,3605,3665,4123,373 8,4182,4272,4695,3271,3715,3784,4224,3896,4319,44 03,4833,3948,4424,4507,4904,4592,5009,5069,5545,3380,3845,3918,4352,4052,4452,452 0,4957,4174,4548,4632,5044,4726,5084,5224,5678,4268,4663,4756,5158,4798,5264,5326 ,5785,4969,5356,5423,5763,5492,5871,6008,6434,1558,1900,1966,2552,2083,2591,2684, 3181,2095,2694,2784,3243,2875,3360,3413,3958,2258,2792,2881,3431,2979,3475,3542,3 964,3037,3536,3622,4099,3721,4170,4204,4623,2294,2955,3052,3445,3161,3558,3648,41 64,3215,3687,3744,4212,3799,4310,4370,4788,3210,3787,3855,4304,3942,4410,4465,490 6,4063,4529,4594,5004,4659,5066,5171,5641,2414,3124,3168,3676,3262,3766,3851,4280 ,3315,3878,3912,4401,3998,4490,4544,4996,3611,3976,4059,4505,4134,4581,4654,5054, 4242,4677,4772,5148,4847,5261,5334,5744,3761,4113,4218,4616,4300,4717,4782,5226,4 387,4819,4873,5282,4982,5387,5449,5841,4514,4974,5014,5426,5056,5495,5403,5904,51 92,5628,5681,6033,5703,6178,6252,6523,2469,3252,3276,3936,3563,4012,4073,4527,368 1,4095,4138,4603,4238,4686,4765,5237,3749,4230,4296,4690,4349,4784,4856,5299,4429 ,4883,4950,5370,5046,5437,5539,5921,3952,4317,4368,4849,4462,4931,5024,5409,4601, 5026,5074,5533,5195,5483,5659,6041,4710,5130,5250,5632,5307,5699,5753,6136,5389,5 772,5769,6232,5908,6288,6345,6695,4109,4418,4535,5029,4683,5076,5163,5568,4775,52 29,5272,5684,5351,5712,5766,6166,4859,5318,5412,5747,5452,5782,5911,6292,5565,594 2,5991,6361,6088,6456,6514,6871,4999,5429,5521,5918,5656,5925,6066,6391,5675,6051 ,6144,6487,6208,6560,6656,6989,5715,6181,6272,6593,6324,6675,6626,7040,6425,6741, 6794,7153,6894,7218,7296,7490,1717,1993,2121,2630,2223,2801,2889,3394,2282,2924,2 984,3425,3068,3522,3547,4144,2305,3060,3119,3516,3176,3772,3816,4262,3324,3828,39 30,4391,4006,4471,4542,5039,2328,3153,3257,3793,3334,3924,3982,4443,3399,4030,408 3,4555,4152,4641,4704,5086,3464,4117,4200,4672,4286,4763,4809,5208,4325,4793,4885 ,5312,4897,5364,5435,6016,2712,3329,3374,4002,3438,4089,4148,4614,3578,4208,4248, 4740,4335,4828,4878,5242,3670,4256,4362,4800,4437,4894,4916,5337,4499,4921,4947,5 443,5127,5498,5610,6048,3755,4435,4480,4943,4577,5016,5036,5469,4647,5120,5179,55 62,5277,5647,5690,6147,4733,5216,5309,5696,5395,5740,5847,6212,5518,5861,5945,629 6,5994,6378,6469,6854,2741,3418,3527,4194,3659,4254,4343,4842,3727,4376,4448,4923 ,4518,4967,4987,5454,3873,4484,4572,4989,4645,5109,5161,5550,4731,5200,5274,5665, 5345,5718,5805,6151,3986,4608,4699,5174,4816,5258,5248,5728,4866,5320,5359,5788,5 475,5851,5888,6304,4960,5401,5509,5877,5553,5966,5998,6395,5625,6037,6106,6491,62 28,6569,6665,7002,4069,4749,4823,5331,4911,5384,5477,5864,5099,5512,5583,5984,559 8,6012,6073,6451,5135,5586,5616,6062,5731,6099,6197,6555,5824,6224,6264,6597,6341 ,6700,6762,7059,5205,5760,5798,6155,5894,6236,6284,6636,5949,6332,6400,6736,6473, 6800,6883,7182,6114,6408,6496,6816,6583,6906,6941,7272,6641,6971,7033,7320,7105,7 388,7480,7719,2867,3583,3693,4383,3861,4477,4557,5061,3906,4585,4668,5117,4742,51 87,5296,5811,4040,4708,4838,5240,4892,5376,5348,5834,4933,5415,5489,5932,5577,597 3,6023,6430,4292,4868,4938,5373,5097,5466,5527,5987,5114,5580,5607,6030,5650,6080 ,6128,6532,5140,5635,5709,6121,5821,6193,6256,6607,5881,6316,6337,6705,6404,6768, 6832,7139,4329,5089,5104,5556,5143,5592,5662,6095,5213,5734,5792,6174,5857,6240,6 328,6685,5506,5818,5898,6260,5952,6366,6412,6747,6091,6417,6500,6821,6588,6900,69 35,7264,5601,5963,6059,6370,6117,6482,6541,6849,6205,6564,6617,6929,6680,6977,705 2,7345,6276,6646,6721,7027,6789,7072,7132,7405,6860,7160,7211,7461,7249,7552,7573 ,7841,4358,5150,5182,5801,5463,5844,5884,6308,5536,5928,5977,6383,6069,6447,6528, 6838,5613,6019,6110,6460,6162,6546,6621,6917,6244,6670,6612,6959,6757,7046,7098,7 370,5828,6140,6189,6574,6300,6631,6716,7008,6357,6726,6784,7078,6827,7112,7189,74 51,6478,6805,6877,7146,6947,7226,7256,7530,6983,7312,7336,7595,7396,7630,7654,779 2,5956,6201,6353,6731,6443,6778,6810,7119,6518,6888,6912,7204,6965,7233,7328,7562 ,6537,6953,7014,7304,7092,7353,7362,7642,7175,7414,7442,7667,7510,7733,7762,7936, 6690,7065,7085,7379,7196,7424,7470,7692,7241,7520,7541,7747,7607,7776,7858,7981,7 288,7584,7618,7808,7680,7824,7876,8006,7706,7895,7915,8033,7957,8064,8098,8138,12 ,53,93,234,128,256,350,537,158,333,384,584,429,640,661,1038,185,367,399,629,472,701, 795,1072,512,786,740,1119,879,1177,1220,1579,210,444,499,721,524,777,829,1132,596,8 63,896,1183,995,1262,1297,1664,650,911,1024,1285,1059,1342,1397,1722,1113,1408,147 0,1838,1501,1891,1983,2406,276,458,561,855,607,887,987,1232,671,1031,927,1303,1093 ,1364,1439,1761,768,1009,1106,1402,1145,1455,1496,1871,1208,1511,1594,1939,1659,2 010,2077,2541,846,1126,1196,1491,1274,1550,1631,1994,1331,1636,1718,2048,1774,214 0,2200,2652,1423,1753,1854,2158,1883,2204,2290,2742,1963,2314,2386,2816,2451,2879 ,2991,3530,415,549,618,1002,711,1052,1079,1429,803,1099,1152,1486,1214,1545,1565,1 990,871,1158,1226,1555,1291,1627,1704,2055,1359,1709,1757,2118,1863,2186,2270,271 1,942,1250,1337,1654,1370,1713,1787,2161,1475,1846,1887,2214,1959,2310,2363,2807, 1560,1927,1998,2334,2051,2432,2460,2871,2147,2501,2599,2962,2670,3043,3214,3532,9 73,1348,1450,1800,1536,1875,1955,2327,1584,1967,2021,2403,2081,2457,2535,2933,169 5,2066,2122,2492,2207,2581,2658,3072,2249,2679,2756,3137,2835,3244,3306,3802,1783 ,2168,2228,2611,2340,2702,2768,3192,2447,2796,2873,3280,2965,3318,3460,3943,2532, 2906,2996,3393,3033,3505,3568,4064,3204,3601,3671,4039,3743,4167,4328,4836,485,68 1,730,1139,812,1164,1238,1622,821,1244,1308,1668,1381,1766,1808,2263,935,1314,138 6,1825,1460,1859,1915,2266,1506,1907,1986,2380,2070,2444,2476,2868,958,1444,1516, 1834,1603,1931,2002,2441,1650,2040,2085,2482,2132,2575,2629,3028,1645,2125,2176,2 566,2246,2667,2716,3145,2347,2779,2840,3241,2898,3299,3407,3905,1045,1574,1612,20 29,1686,2107,2172,2547,1731,2197,2225,2655,2293,2739,2793,3231,1975,2273,2344,275 4,2409,2829,2895,3289,2510,2917,3009,3384,3084,3501,3577,4017,2100,2393,2488,2860 ,2563,2957,3017,3467,2644,3056,3107,3523,3217,3634,3699,4126,2762,3212,3251,3673, 3292,3748,3651,4203,3428,3893,3949,4363,3973,4524,4611,4939,1086,1673,1700,2242,1 935,2307,2357,2776,2036,2373,2419,2849,2507,2927,3 007,3474,2092,2498,2560,2930,26 08,3022,3092,3544,2682,3117,3187,3614,3285,3688,3796,4225,2259,2578,2626,3087,271 4,3165,3258,3656,2843,3260,3308,3788,3435,3735,3925,4373,2951,3368,3492,3895,3546 ,3968,4029,4474,3636,4053,4047,4589,4209,4653,4727,5157,2390,2673,2782,3268,2922, 3316,3403,3829,3012,3469,3510,3955,3597,3985,4045,4513,3094,3561,3660,4023,3701,4 058,4215,4660,3823,4249,4311,4746,4419,4860,4925,5380,3234,3679,3777,4221,3919,42 31,4396,4776,3939,4379,4485,4900,4567,4986,5106,5548,3987,4530,4637,5028,4696,512 6,5070,5605,4822,5217,5279,5764,5411,5850,5954,6239,573,758,838,1202,903,1320,139 1,1792,950,1413,1465,1821,1531,1899,1920,2422,965,1521,1570,1895,1617,2111,2150,2 529,1735,2154,2239,2646,2304,2722,2788,3277,980,1598,1677,2129,1744,2232,2280,269 6,1796,2324,2367,2802,2428,2882,2944,3323,1850,2399,2470,2914,2550,2999,3048,3449 ,2584,3030,3122,3555,3135,3612,3684,4340,1256,1740,1779,2297,1830,2370,2425,2857, 1947,2479,2513,2978,2596,3064,3115,3483,2025,2526,2623,3041,2690,3130,3152,3584,2 751,3157,3185,3692,3365,3754,3872,4377,2096,2688,2731,3177,2821,3253,3270,3720,28 92,3358,3416,3821,3521,3911,3959,4491,2975,3458,3552,3963,3643,4011,4139,4573,377 3,4155,4255,4667,4316,4766,4872,5363,1280,1817,1903,2463,2013,2516,2605,3077,2074 ,2635,2699,3162,2765,3202,3222,3707,2193,2737,2818,3226,2887,3344,3400,3804,2967, 3439,3514,3935,3588,3993,4088,4496,2283,2854,2941,3412,3054,3499,3490,3999,3100,3 566,3606,4068,3726,4145,4189,4678,3195,3647,3762,4173,3810,4283,4322,4781,3887,43 69,4442,4905,4584,5000,5113,5557,2354,2989,3061,3575,3147,3627,3729,4161,3335,376 9,3844,4301,3856,4334,4407,4851,3372,3848,3881,4390,4003,4436,4547,4981,4112,4578 ,4631,5033,4721,5167,5239,5634,3444,4033,4080,4502,4191,4595,4648,5085,4261,4709, 4790,5212,4881,5289,5394,5796,4453,4803,4913,5314,5015,5428,5476,5931,5093,5519,5 596,5990,5705,6094,6223,6606,1375,1951,2044,2638,2179,2725,2804,3297,2221,2832,29 09,3353,2983,3426,3537,4094,2330,2949,3074,3478,3127,3623,3592,4124,3170,3664,374 1,4243,3835,4289,4351,4827,2556,3105,3175,3621,3332,3716,3781,4307,3351,3837,3868 ,4357,3917,4413,4470,4953,3377,3901,3979,4464,4106,4541,4617,5042,4177,4691,4716, 5172,4796,5249,5336,5743,2590,3328,3342,3815,3382,3854,3929,4430,3451,4009,4074,4 519,4149,4600,4703, 5144,3756,4102,4197,4626,4265,4751,4808, 5225,4425,4817,4919, 53 19,5020,5421,5467,5919,3862,4277,4384,4757,4459,4891,4966,5354,4562,4991,5057,545 8,5136,5528,5626,6028,4642,5098,5190,5587,5275,5655,5738,6122,5371,5775,5839,6195 ,5896,6325,6356,6839,2614,3391,3419,4082,3712,4132,4183,4684,3790,4237,4295,4771, 4402,4846,4944,5346,3876,4346,4447,4865,4508,4973,5062,5447,4606,5121,5048,5502,5 235,5614,5697,6067,4118,4479,4536,5007,4673,5077,5180,5566,4741,5194,5265,5664,53 28,5717,5807,6180,4886,5297,5388,5755,5484,5862,5907,6289,5540,5978,6017,6396,610 7,6452,6495,6743,4271,4556,4735,5203,4841,5257,5305,5726,4932,5404,5438,5830,5510 ,5873,6002,6340,4958,5493,5575,5967,5685,6040,6053,6472,5787,6137,6164,6516,6258, 6634,6684,7039,5149,5646,5676,6079,5819,6149,6211,6561,5885,6274,6305,6659,6415,6 713,6874,7148,5943,6376,6432,6774,6536,6803,6909,7209,6585,6950,6992,7284,7088,73 71,7488,7655,296,691,919,1418,1065,1480,1640,2089,1171,1589,1726,2190,1842,2300,2 337,2946,1268,1691,1770,2276,1943,2396,2553,2994,2032,2538,2473,3069,2705,3150,32 07,3690,1353,1879,2006,2435,2059,2523,2620,3089,2211,2676,2734,3160,2890,3273,332 0,3794,2317,2759,2925,3304,2981,3379,3456,3864,3059,3471,3548,4001,3586,4060,4169 ,4682,1540,1911,2136,2661,2235,2719,2876,3229,2360,2938,2773,3330,3025,3405,3503, 3909,2504,2911,3046,3462,3110,3526,3581,4037,3190,3603,3703,4120,3785,4207,4287,4 832,2649,3079,3172,3572,3282,3645,3752,4187,3361,3760,3860,4251,3921,4359,4438,49 56,3485,3897,4019,4388,4051,4444,4545,5053,4153,4576,4657,5129,4732,5198,5311,582 5,1804,2114,2256,2903,2415,2973,3002,3494,2572,3038,3120,3564,3200,3640,3669,4181 ,2693,3132,3219,3653,3311,3745,3840,4263,3396,3846,3903,4332,4031,4421,4523,5017, 2799,3256,3370,3779,3414,3852,3941,4394,3557,4007,4055,4455,4147,4571,4629,5124,3 662,4104,4195,4598,4257,4712,4743,5186,4365,4789,4896,5283,4975,5366,5534,5827,28 51,3389,3517,3957,3632,4041,4141,4587,3697,4159,4217,4676,4291,4737,4831,5254,382 7,4269,4338,4780,4449,4877,4964,5391,4500,4983,5068,5461,5152,5563,5623,6056,3933 ,4400,4472,4910,4604,5012,5082,5513,4728,5110,5191,5599,5286,5637,5767,6171,4824, 5223,5317,5708,5357,5804,5859,6263,5525,5887,5946,6245,6007,6338,6455,6815,1979,2 377,2454,3102,2587,3142,3239,3737,2602,3246,3339,3798,3433,3913,3965,4511,2785,33 46,3437,3981,3535,4025,4090,4517,3595,4086,4175,4651,4275,4723,4760,5183,2824,351 2,3608,3995,3718,4110,4201,4718,3771,4241,4297,4767,4353,4869,4930,5349,3764,4342 ,4409,4863,4495,4970,5025,5464,4615,5090,5155,5560,5220,5620,5720,6139,2959,3682, 3724,4229,3819,4320,4405,4837,3870,4432,4466,4961,4550,5050,5105,5551,4163,4528,4 609,5065,4687,5141,5214,5608,4799,5238,5332,5700,5407,5802,5868,6230,4314,4666,47 74,5178,4858,5276,5339,5770,4948,5377,5431,5822,5537,5913,5969,6311,5073,5531,556 9,5948,5611,6010,5929,6367,5739,6127,6173,6479,6192,6599,6663,6886,3015,3806,3831 ,4489,4116,4565,4624,5087,4235,4646,4693,5164,4794,5246,5325,5778,4303,4785,4855, 5251,4908,5343,5414,5836,4990,5441,5508,5899,5602,5961,6049,6382,4506,4874,4927,5 408,5023,5487,5578,5934,5160,5581,5629,6043,5741,5999,6156,6485,5271,5682,5793,61 31,5842,6190,6235,6563,5916,6254,6251,6644,6369,6692,6739,7026,4662,4978,5096,558 4,5243,5631,5714,6076,5335,5773,5810,6177,5882,6202,6249,6591,5417,5853,5937,6233 ,5972,6261,6373,6696,6074,6399,6442,6754,6522,6830,6878,7166,5554,5951,6035,6380, 6152,6386,6506,6777,6168,6492,6571,6858,6627,6918,6997,7263,6204,6603,6677,6942,6 720,7009,6972,7300,6807,7066,7106,7392,7185,7439,7501,7646,2165,2485,2632,3180,27 45,3356,3446,3947,2813,3481,3541,3977,3625,4072,4098,4698,2838,3616,3675,4066,373 3,4326,4371,4818,3879,4382,4483,4949,4560,5032,5101,5593,2862,3709,3813,4348,3889 ,4478,4534,5003,3951,4582,4635,5116,4707,5201,5263,5640,4015,4671,4755,5231,4844, 5322,5368,5752,4882,5350,5444,5848,5455,5893,5957,6462,3265,3885,3927,4552,3989,4 640,4702,5175,4130,4762,4804,5300,4895,5386,5434,5784,4223,4813,4922,5360,4998,54 51,5473,5870,5058,5478,5505,5964,5679,6014,6112,6489,4309,4995,5040,5499,5138,557 2,5590,5986,5209,5673,5729,6071,5816,6143,6183,6575,5294,5761,5845,6186,5923,6226 ,6318,6630,6031,6331,6402,6699,6445,6766,6842,7157,3294,3971,4076,4748,4211,4810, 4903,5400,4281,4936,5008,5481,5078,5522,5543,5975,4426,5045,5133,5546,5206,5661,5 711,6058,5291,5746,5813,6161,5876,6207,6283,6577,4539,5168,5260,5723,5374,5799,57 90,6214,5424,5856,5890,6267,5993,6321,6354,6707,5516,5926,6022,6343,6061,6422,644 9,6781,6124,6483,6540,6862,6642,6926,7000,7269,4620,5308,5383,5865,5470,5910,5996 ,6334,5652,6025,6089,6435,6101,6458,6512,6826,5688,6092,6119,6502,6217,6533,6616, 6914,6299,6638,6673,6946,6735,7030,7079,7316,5749,6242,6277,6581,6360,6648,6688,6 980,6406,6728,6785,7061,6846,7110,7176,7410,6547,6792,6865,7124,6934,7194,7224,74 82,6984,7248,7294,7519,7354,7574,7638,7822,3423,4135,4245,4941,4415,5037,5118,561 7,4461,5146,5228,5670,5303,5735,5833,6286,4593,5268,5397,5781,5450,5905,5879,6309 ,5490,5940,6004,6393,6082,6426,6468,6812,4850,5427,5496,5902,5649,5983,6038,6439, 5667,6085,6109,6475,6146,6520,6557,6893,5691,6134,6199,6553,6295,6613,6667,6955,6 347,6717,6732,7035,6788,7083,7138,7381,4888,5643,5658,6064,5694,6097,6158,6530,57 58,6221,6270,6595,6327,6652,6724,7018,6020,6293,6363,6669,6409,6758,6796,7070,652 6,6799,6869,7129,6938,7190,7219,7475,6104,6419,6499,6761,6550,6855,6902,7152,6623 ,6922,6963,7214,7013,7253,7310,7539,6681,6988,7048,7290,7101,7326,7375,7588,7162, 7398,7434,7624,7463,7694,7711,7914,4917,5702,5732,6279,5981,6315,6350,6710,6046,6 389,6428,6770,6510,6823,6890,7143,6116,6466,6543,6835,6589,6905,6967,7205,6655,70 05,6958,7238,7075,7305,7348,7559,6302,6567,6609,6930,6703,6975,7043,7274,6750,705 3,7096,7332,7134,7359,7416,7616,6850,7115,7171,7386,7229,7445,7469,7677,7259,7514 ,7533,7728,7580,7754,7773,7878,6413,6620,6746,7057,6819,7093,7120,7365,6881,7180, 7199,7427,7244,7452,7526,7702,6897,7234,7279,7507,7342,7546,7553,7764,7404,7594,7 609,7782,7662,7833,7854,7987,7022,7321,7337,7567,7421,7602,7632,7802,7457,7670,76 86,7844,7737,7866,7928,8021,7494,7720,7745,7889,7793,7902,7942,8040,7812,7955,797 1,8061,8003,8084,8111,8145,315,749,1016,1608,1189,1682,1923,2412,1325,1867,2017,2 520,2143,2641,2685,3363,1434,1971,2063,2617,2252,2771,2935,3421,2350,2919,2846,34 96,3097,3590,3649,4157,1526,2183,2320,2810,2383,2901,3004,3519,2544,3066,3125,359 9,3301,3714,3767,4273,2664,3155,3337,3750,3398,3825,3907,4350,3487,3923,4005,4498 ,4049,4563,4675,5154,1748,2218,2466,3051,2569,3112,3287,3666,2708,3349,3182,3775, 3453,3858,3961,4398,2884,3325,3476,3915,3539,3983,4043,4537,3630,4062,4179,4622,4 267,4711,4787,5295,3035,3508,3610,4035,3731,4114,4227,4689,3808,4233,4344,4753,44 17,4862,4929,5405,3945,4386,4521,4879,4554,4934,5027,5494,4655,5055,5131,5564,519 9,5624,5727,6213,2103,243 8,2593,3313,2790,33 86,3430,3953,2954,3465,3 550,4027,363 8 ,4108,4137,4685,3082,3559,3658,4122,3758,4219,4324,4764,3850,4330,4392,4834,4532, 4912,5005,5462,3209,3694,3817,4259,3866,4336,4434,4884,4013,4510,4558,4946,4649,5 052,5108,5558,4128,4607,4694,5075,4759,5181,5211,5615,4867,5252,5352,5701,5422,57 80,5938,6215,3263,3833,3975,4451,4092,4543,4644,5067,4165,4658,4719,5151,4792,520 7,5287,5674,4313,4773,4839,5244,4937,5333,5413,5806,4985,5433,5507,5869,5582,5965 ,6021,6431,4428,4893,4959,5365,5083,5456,5520,5920,5196,5544,5618,5997,5704,6032, 6154,6539,5284,5648,5733,6098,5771,6194,6246,6628,5930,6271,6329,6610,6385,6697,6 802,7108,2287,2728,2827,3528,2970,3570,3677,4213,2986,3686,3783,4279,3883,4404,44 63,4997,3197,3792,3891,4481,3991,4526,4597,5002,4057,4586,4680,5128,4778,5193,522 7,5612,3236,3969,4070,4493,4193,4613,4700,5188,4253,4744,4797,5233,4853,5327,5382 ,5765,4247,4843,4901,5321,4980,5419,5468,5875,5092,5529,5588,5962,5642,6015,6111, 6511,3375,4151,4199,4730,4299,4820,4898,5298,4361,4924,4954,5410,5030,5491,5541,5 955,4664,5010,5088,5503,5159,5576,5639,6006,5262,5660,5748,6090,5817,6188,6253,65 94,4815,5139,5241,5606,5316,5695,5757,6160,5396,5791,5840,6209,5941,6298,6351,667 1,5514,5936,5971,6330,6009,6390,6313,6722,6129,6501,6544,6824,6562,6925,6978,7165 ,3442,4285,4318,4976,4618,5047,5100,5526,4739,5119,5165,5594,5259,5669,5745,6167, 4806,5247,5313,5672,5361,5759,5826,6225,5436,5849,5914,6282,6003,6342,6427,6737,4 993,5330,5379,5820,5465,5895,5979,6317,5591,5982,6024,6420,6133,6379,6525,6831,56 92,6075,6182,6503,6227,6558,6601,6895,6301,6619,6615,6964,6725,7003,7045,7283,513 4,5425,5532,5988,5663,6029,6105,6453,5751,6163,6196,6548,6269,6570,6614,6919,5829 ,6238,6319,6598,6352,6624,6729,7006,6448,6751,6791,7056,6859,7122,7158,7395,5958, 6335,6411,6733,6521,6740,6845,7074,6535,6834,6901,7144,6951,7192,7257,7476,6572,6 928,6993,7215,7028,7267,7237,7502,7100,7314,7346,7575,7411,7613,7659,7775,2495,28 65,3020,3619,3140,3800,3899,4440,3224,3931,3997,4476,4084,4574,4602,5170,3248,407 8,4143,4569,4205,4825,4870,5281,4367,4876,4971,5399,5043,5474,5538,5995,3275,4185 ,4293,4848,4380,4963,5018,5448,4445,5063,5111,5552,5177,5627,5683,6036,4515,5147, 5219,5657,5302,5736,5786,6145,5338,5768,5855,6234,5866,6281,6339,6809,3705,4375,4 423,5035,4487,5115,5173,5603,4633,5230,5267,5716,5347,5800,5846,6175,4725,5278,53 75,5777,5442,5860,5883,6257,5500,5886,5912,6346,6072,6394,6486,6833,4811,5439,548 2,5906,5570,5974,5989,6368,5636,6068,6118,6446,6206,6515,6552,6904,5713,6153,6231 ,6554,6306,6590,6678,6954,6410,6689,6755,7011,6795,7068,7128,7387,3739,4468,4580, 5215,4714,5270,5358,5812,4783,5390,5453,5892,5517,5927,5947,6358,4920,5488,5567,5 950,5630,6054,6103,6433,5707,6138,6200,6534,6262,6576,6645,6908,5022,5600,5680,61 13,5789,6187,6179,6580,5832,6243,6275,6632,6372,6682,6712,7017,5922,6310,6401,670 1,6437,6772,6798,7077,6497,6828,6873,7147,6961,7200,7260,7479,5095,5724,5797,6250 ,5878,6294,6375,6693,6047,6405,6463,6783,6474,6806,6852,7117,6081,6467,6493,6841, 6584,6870,6939,7188,6661,6957,6990,7217,7042,7287,7325,7515,6141,6605,6639,6911,6 714,6968,6999,7245,6759,7036,7082,7311,7133,7350,7402,7589,6880,7089,7151,7363,72 07,7419,7441,7649,7250,7462,7497,7674,7547,7717,7769,7906,3874,4638,4750,5393,490 7,5479,5555,6013,4951,5579,5651,6063,5722,6126,6219,6649,5072,5689,5809,6169,5858 ,6290,6265,6668,5897,6323,6384,6748,6457,6776,6817,7103,5310,5838,5903,6287,6045, 6364,6416,6787,6060,6459,6481,6820,6519,6856,6891,7173,6083,6507,6566,6887,6657,6 936,6981,7222,6704,7024,7038,7291,7086,7330,7374,7565,5344,6039,6052,6441,6087,64 71,6529,6867,6148,6587,6635,6921,6686,6970,7032,7276,6397,6653,6718,6986,6763,706 0,7091,7318,6863,7097,7155,7366,7210,7415,7437,7644,6477,6769,6837,7063,6884,7140 ,7181,7383,6948,7195,7230,7432,7271,7466,7511,7690,6996,7252,7299,7493,7343,7524, 7561,7729,7391,7579,7608,7758,7634,7807,7819,7977,5369,6096,6120,6640,6362,6674,6 708,7021,6423,6744,6780,7071,6848,7114,7169,7378,6488,6813,6876,7125,6915,7184,72 32,7428,6974,7265,7225,7454,7323,7505,7543,7707,6664,6898,6932,7202,7015,7240,729 5,7484,7054,7302,7339,7528,7369,7551,7593,7752,7136,7355,7400,7570,7446,7619,7639 ,7795,7472,7669,7685,7834,7723,7853,7869,7949,6765,6944,7050,7307,7111,7334,7358, 7556,7163,7407,7423,7604,7458,7623,7679,7814,7177,7449,7487,7664,7537,7696,7700,7 861,7585,7735,7746,7875,7783,7916,7931,8031,7278,7521,7534,7712,7599,7740,7765,78 91,7628,7788,7800,7923,7840,7940,7988,8057,7653, 7827, 7847, 7959, 7883, 7967, 7997,807 2,7899,8009,8019,8088,8044,8105,8126,8152,1813,2748,3167,3937,3409,4021,4239,4801 ,3579,4171,4355,4915,4504,5038,5080,5686,3722,4305,4411,5013,4628,5142,5306,5730, 4734,5292,5222,5803,5459,5880,5933,6344,3842,4549,4705,5185,4769,5273,5372,5823,4 942,5430,5485,5889,5633,5992,6034,6424,5060,5511,5666,6018,5719,6086,6150,6480,57 94,6165,6229,6582,6259,6625,6698,7019,4100,4591,4857,5416,4968,5471,5621,5953,510 3,5677,5523,6042,5762,6108,6191,6513,5255,5654,5783,6157,5843,6210,6255,6608,5917 ,6273,6355,6666,6418,6723,6775,7107,5402,5815,5900,6247,6000,6307,6392,6709,6070, 6398,6476,6753,6524,6822,6872,7174,6176,6504,6596,6840,6618,6875,6937,7228,6687,6 956,7004,7268,7049,7303,7361,7601,4457,4829,4988,5645,5162,5710,5742,6184,5324,57 74,5852,6241,5924,6303,6326,6706,5445,5863,5944,6314,6027,6388,6461,6760,6100,646 4,6508,6804,6604,6861,6924,7208,5549,5976,6078,6414,6115,6470,6538,6844,6237,6586 ,6622,6882,6683,6952,6987,7266,6322,6654,6715,6969,6756,7037,7055,7298,6825,7081, 7142,7347,7186,7389,7468,7603,5597,6093,6203,6549,6297,6611,6679,6962,6348,6691,6 730,7016,6779,7051,7104,7333,6450,6764,6808,7076,6879,7131,7179,7401,6910,7191,72 36,7435,7281,7483,7509,7701,6531,6847,6892,7150,6973,7206,7243,7459,7047,7258,730 1,7498,7349,7516,7576,7749,7102,7317,7364,7548,7384,7592,7617,7785,7465,7629,7656 ,7778,7682,7813,7855,7970,4669,5123,5204,5835,5341,5872,5960,6381,5355,5968,6050, 6429,6130,6517,6556,6916,5535,6057,6135,6568,6218,6600,6647,6920,6266,6643,6702,7 001,6767,7044,7064,7297,5573,6198,6278,6578,6365,6658,6719,7041,6407,6745,6782,70 69,6818,7127,7161,7380,6403,6811,6853,7123,6907,7183,7213,7436,6979,7247,7282,748 1,7315,7508,7554,7736,5698,6336,6371,6738,6444,6797,6851,7109,6484,6868,6889,7178 ,6940,7227,7255,7477,6694,6927,6976,7235,7023,7275,7313,7503,7087,7324,7372,7544, 7408,7591,7621,7771,6793,7010,7073,7293,7121,7344,7376,7577,7170,7394,7420,7600,7 471,7641,7665,7803,7239,7467,7485,7657,7504,7683,7648,7823,7563,7731,7750,7863,77 57,7904,7924,7991,5754,6436,6454,6903,6662,6949,6985,7246,6742,6998,7025,7286,708 4,7329,7368,7581,6786,7080,7118,7331,7149,7377,7412,7606,7193,7425,7456,7635,7499 ,7661,7699,7829,6913,7130,7159,7409,7212,7447,7489,7650,7285,7491,7512,7697,7564, 7678,7742,7865,7341,7536,7587,7732,7610,7756,7774,7892,7643,7781,7780,7919,7825,7 933,7948,8028,7007,7187,7251,7492,7327,7513,7550,7710,7373,7578,7596,7751,7627,77 60,7779,7901,7413,7614,7651,7772,7666,7784,7826, 7934, 7709, 7835, 7850, 7952, 7879, 797 5,7989,8062,7478,7658,7693,7828,7741,7830,7872,7960,7748,7868,7894,7983,7912,7999 ,8020,8083,7761,7905,7929,8007,7943,8024,8014,8091,7968,8038,8048,8109,8067,8118, 8128,8151,4889,5236,5385,5909,5497,6065,6142,6542,5561,6172,6222,6565,6291,6633,6 650,7029,5585,6285,6333,6629,6377,6801,6829,7099,6490,6836,6899,7172,6945,7216,72 54,7496,5609,6359,6440,6814,6498,6896,6931,7201,6545,6960,6991,7261,7034,7306,733 8,7517,6592,7012,7062,7322,7113,7367,7390,7569,713 5,7382,7426,7612,7431,7633,7660 ,7857,5985,6494,6527,6943,6573,6994,7031,7292,6672,7067,7090,7356,7141,7399,7422, 7583,6734,7095,7156,7385,7198,7430,7440,7622, 7231, 7443, 7455, 7663, 7535, 7684, 7725, 7 867,6790,7197,7221,7453,7273,7486,7495,7673,7309,7532,7557,7708,7598,7738,7753,78 96,7352,7572,7611,7755,7645,7770,7805,7913,7691,7810,7836,7935,7851,7956,7978,805 9,6011,6559,6637,7058,6727,7094,7145,7406,6771,7164,7203,7444,7242,7464,7473,7668 ,6864,7223,7270,7474,7308,7527,7549,7703,7351,7566,7597,7744,7625,7763,7791,7897, 6933,7289,7335,7555,7393,7590,7586,7766,7417,7615,7631,7786,7675,7806,7818,7938,7 460,7647,7688,7815,7704,7843,7852,7961,7730,7864,7884,7984,7918,8001,8022,8085,69 82,7360,7397,7620,7438,7640,7676,7811,7523,7689,7715,7848,7721,7856,7874,7974,753 8,7716,7727,7871,7767,7882,7909,7998,7798,7917,7927,8008,7947,8029,8042,8094,7568 ,7777,7789,7898,7820,7920,7932,8016,7837,7945,7962,8037,7979,8049,8065,8113,7886, 7964,7985,8052,8004,8069,8075,8125,8017,8080,8090,8131,8102,8140,8150,8171,6123,6 676,6749,7167,6857,7220,7262,7506,6885,7277, 7319, 7531, 7357, 7560, 7605, 7794,6966, 73 40,7403,7582,7429,7637,7626,7801,7448,7652,7681,7832,7713,7845,7860,7969,7116,741 8,7450,7636,7522,7672,7695,7849,7529,7714,7724,7862,7739,7877,7890,7993,7540,7734 ,7759,7888,7797,7908,7925,8010,7816,7941,7946,8030,7963,8043,8055,8107,7137,7518, 7525,7705,7542,7718,7743,7881,7571,7768,7787,7903,7809,7921,7944,8026,7687,7796,7 821,7926,7838,7953,7965,8039,7880,7966,7986,8053,8005,8068,8074,8124,7722,7842,78 70,7954,7887,7982,7995,8058,7911,8000,8012,8073,8025,8081,8093,8134,7930,8018,803 4,8089,8047,8096,8106,8142,8060,8110,8117,8148,8122,8157,8159,8179,7154,7545,7558 ,7790,7671,7804,7817,7939,7698,7831,7846,7958,7873,7973,7992,8056,7726,7859,7885, 7976,7900,7996,8013,8071,7922,8023,8011,8078,8041,8092,8101,8137,7799,7893,7907,8 002,7937,8015,8032,8086,7951,8035,8046,8097,8054,8103,8114,8147,7980,8050,8063,81 08,8076,8119,8123,8155,8082,8130,8133,8161,8141,8164,8166,8176,7839,7910,7950,803 6,7972,8045,8051,8104,7990,8066,8070,8116,8079,8120,8132,8158,7994,8077,8087,8129 ,8100,8135,8136,8165,8112,8143,8146,8167,8153,8172,8174,8184,8027,8095,8099,8139, 8115,8144,8149,8169,8121,8154,8156,8173,8162,8175,8180,8186,8127,8160,8163,8177,8 168,8178,8181,8187,8170,8182,8183,8188,8185,8189,8190,8191];
where the sequence Z2 is given by
[0,1,2,7,3,8,13,26,4,12,15,30,18,35,37,82,5,14,16,34,21,41,51,87,24,50,45,94,61,103, 110,177,6,19,23,43,25,49,55,96,31,59,63,104,76,117,123,195,36,65,80,121,85,131,141,20 8,93,143,155,235,161,248,271,391,9,20,28,58,32,62,75,112,38,81,67,124,90,135,149,217, 48,78,92,142,98,152,160,243,108,163,180,260,194,278,296,434,57,95,106,159,119,171,18 8,274,129,189,207,288,220,313,330,471,146,215,239,318,246,331,356,502,266,363,385,5 28,405,551,593,816,17,27,33,77,42,84,88,147,52,91,99,158,109,170,174,273,60,100,111,1 72,122,187,204,290,134,205,216,307,241,326,350,491,69,115,130,193,136,206,223,319,1 56,237,247,334,265,362,378,525,173,257,275,369,289,399,408,548,315,421,453,582,477, 613,681,817,73,132,151,226,168,244,264,367,178,267,281,390,297,407,432,571,202,293, 308,418,332,447,473,624,344,480,507,650,535,693,719,942,222,321,338,457,371,488,511 ,672,404,521,549,708,583,724,785,1011,431,561,595,756,609,805,833,1072,677,848,880, 1059,914,1122,1203,1479,22,39,44,97,53,101,113,186,54,114,125,196,138,218,228,348,6 8,126,139,232,153,240,254,349,162,252,272,383,294,403,413,547,71,150,164,234,182,25 8,276,402,192,286,298,415,311,445,463,607,191,309,323,442,343,476,493,653,373,515,5 37,692,558,716,762,992,83,176,184,283,200,304,322,436,210,329,337,472,357,501,520,6 88,269,351,372,506,392,533,557,712,424,565,600,752,629,803,837,1048,302,387,417,544 ,441,580,603,788,468,618,638,813,682,863,893,1102,509,680,696,881,713,916,871,1140, 771,986,1014,1221,1026,1306,1353,1539,89,197,203,342,259,361,376,514,285,381,395,5 40,423,569,599,791,300,420,440,570,456,605,632,822,481,642,670,854,710,888,939,1151 ,347,446,462,630,492,661,699,873,538,700,720,935,774,910,1002,1226,578,745,799,987, 823,1023,1054,1279,864,1066,1063,1341,1143,1376,1417,1670,386,478,516,703,567,723, 760,955,601,789,807,1017,846,1032,1062,1300,633,830,875,1051,894,1069,1146,1380,95 2,1163,1194,1428,1250,1493,1531,1810,689,884,930,1149,999,1154,1238,1445,1009,1229 ,1285,1516,1329,1567,1639,1919,1033,1309,1367,1592,1400,1651,1617,1957,1471,1707, 1746,2065,1830,2125,2198,2406,29,47,56,107,64,127,140,224,70,144,154,231,167,250,25 5,396,72,165,175,249,185,305,316,430,211,317,341,469,360,495,518,707,74,181,198,310, 213,339,353,486,225,366,379,523,398,552,575,726,238,389,411,564,437,596,615,780,448 ,608,644,827,649,853,886,1209,116,212,221,358,233,380,397,543,262,414,425,588,452,6 21,641,795,282,429,461,612,484,647,656,840,505,658,669,890,744,919,976,1228,301,483 ,498,666,530,697,704,903,556,741,766,951,812,995,1019,1288,587,784,826,1021,867,104 5,1108,1332,928,1116,1166,1384,1197,1439,1500,1799,120,230,251,409,279,426,455,626, 295,465,487,660,510,676,684,897,328,500,529,686,554,735,759,943,584,776,809,1007,84 2,1036,1084,1291,354,542,574,764,617,802,798,1039,635,832,850,1074,906,1111,1133,13 90,673,869,923,1125,946,1180,1200,1448,983,1224,1262,1519,1338,1575,1643,1925,375, 592,620,836,654,860,907,1119,731,926,962,1189,968,1206,1244,1488,747,964,980,1235, 1041,1259,1318,1564,1095,1335,1364,1595,1414,1676,1721,1977,778,1056,1080,1294,11 34,1344,1373,1626,1169,1407,1453,1704,1505,1752,1819,2087,1268,1460,1524,1768,158 4,1841,1872,2182,1631,1900,1951,2224,2025,2299,2394,2688,137,263,287,466,324,496,5 24,715,336,534,562,739,590,770,819,1087,368,577,625,793,646,858,844,1101,663,877,91 3,1160,958,1183,1215,1474,439,637,665,857,730,901,932,1192,738,959,974,1218,998,12 47,1277,1547,749,990,1029,1274,1092,1315,1356,1600, 1127, 1397, 1411, 1679, 1456, 1727, 1782,2051,450,728,734,948,751,967,1004,1256,781,1044,1077,1303,1113,1347,1404,166 2,920,1090,1137,1361,1171,1431,1463,1712,1253,1468,1527,1771,1587,1836,1866,2173, 971,1177,1232,1434,1271,1511,1555,1793,1326,1570,1609,1860,1657,1906,1971,2251,13 70,1634,1690,1945,1743,1991,2047,2319,1804,2073,2117,2373,2157,2470,2494,2875,458 ,755,767,1081,899,1105,1130,1393,936,1157,1186,1442,1241,1485,1542,1788,978,1212,1 265,1496,1297,1559,1612,1853,1350,1648,1604,1889,1718,1963,2019,2279,1098,1282,13 12,1579,1387,1621,1684,1931,1425,1693,1737,1997,1777,2033,2095,2362,1508,1757,181 5,2059,1877,2133,2165,2443,1914,2215,2243,2524,2308,2567,2601,2797,1174,1323,1422 ,1698,1482,1732,1762,2039,1535,1825,1847,2111,1894,2141,2232,2482,1550,1883,1937, 2207,2011,2260,2269,2583,2081,2330,2350,2617,2420,2710,2750,3042,1665,1985,2005,2 288,2103,2339,2385,2652,2149,2432,2455,2730,2539,2773,2904,3134,2190,2509,2552,28 22,2633,2846,2933,3187,2671,2967,3002,3252,3083,3328,3433,3584,10,40,66,145,86,157 ,190,299,102,179,209,327,236,359,370,576,118,201,219,352,261,388,438,594,284,433,41 2,623,489,655,678,889,133,245,277,400,291,428,460,631,333,479,499,659,555,705,725,9 38,364,508,568,718,589,750,783,972,619,790,824,1040,841,1070,1123,1392,169,253,312, 474,340,494,550,687,377,573,513,729,606,761,804,994,422,563,614,786,639,814,839,105 8,671,849,895,1099,934,1142,1182,1477,470,627,664,835,709,868,918,1132,742,922,970, 1164,1000,1219,1260,1549,796,988,1049,1234,1065,1263,1317,1607,1115,1334,1378,165 3,1420,1695,1766,2107,227,306,346,560,394,586,597,800,444,611,643,831,675,866,879,1 129,485,648,683,872,721,915,960,1170,757,963,991,1205,1055,1251,1305,1585,522,698, 746,931,765,966,1010,1237,828,1043,1067,1269,1112,1331,1363,1650,876,1091,1136,13 46,1167,1409,1426,1688,1222,1452,1514,1748,1560,1801,1910,2109,541,754,810,1018,8 62,1060,1109,1340,892,1118,1147,1389,1184,1423, 1476, 1730,954, 1173, 1208, 1447, 1266, 1 503,1554,1817,1293,1565,1616,1862,1667,1929,1969,2271,1006,1240,1278,1522,1349,15 82,1624,1896,1418,1641,1691,1953,1750,1979,2067,2355,1472,1711,1770,2027,1795,209 3,2131,2424,1904,2151,2192,2410,2236,2480,2570,2856,270,382,406,636,449,652,691,91 1,454,694,733,940,773,996,1022,1299,517,736,775,1030,818,1052,1085,1302,845,1083,1 126,1375,1176,1415,1436,1686,531,808,851,1037,902,1094,1139,1412,927,1159,1187,144 0,1216,1498,1534,1790,924,1210,1245,1495,1290,1557,1590,1864,1355,1629,1669,1927, 1709,1967,2035,2332,581,885,905,1153,950,1199,1243,1480,975,1257,1275,1552,1320,1 605,1638,1921,1120,1308,1352,1614,1395,1660,1705,1959,1458,1720,1779,2021,1827,20 91,2137,2399,1196,1383,1444,1683,1492,1744,1784,2069,1544,1808,1843,2105,1912,216 9,2209,2460,1619,1908,1933,2194,1961,2238,2180,2502,2048,2323,2357,2588,2371,2682 ,2733,2914,602,944,956,1287,1097,1328,1360,1627,1156,1372,1398,1674,1455,1725,177 5,2075,1190,1450,1490,1728,1521,1786,1832,2115,1569,1849,1893,2159,1955,2203,2266 ,2514,1296,1501,1532,1828,1589,1879,1939,2184,1672,1941,1973,2262,2049,2230,2344, 2593,1741,2009,2085,2326,2119,2369,2403,2654,2171,2417,2415,2718,2504,2756,2794,3 031,1381,1562,1633,1943,1723,1975,2031,2286,1781,2071,2097,2360,2147,2378,2413,26 76,1834,2127,2186,2401,2211,2422,2507,2759,2284,2527,2560,2806,2622,2868,2907,315 0,1923,2196,2256,2512,2341,2517,2609,2825,2353,2598,2660,2891,2704,2940,3006,3234 ,2380,2685,2744,2960,2779,3016,2985,3266,2849,3064,3098,3347,3166,3389,3444,3576, 320,416,464,667,503,740,779,1013,527,794,821,1028,859,1076,1088,1401,536,855,882,1 073,909,1202,1225,1469,979,1231,1284,1545,1325,1594,1636,1949,545,898,947,1213,98 4,1281,1311,1577,1015,1337,1366,1645,1406,1697,1736,1981,1047,1386,1433,1716,1484 ,1773,1802,2057,1506,1791,1851,2123,1858,2155,2200,2575,702,982,1003,1321,1034,13 69,1403,1681,1104,1437,1461,1759,1513,1814,1845,2079,1150,1466,1529,1797,1574,185 6,1870,2139,1610,1873,1891,2205,2007,2241,2312,2596,1193,1572,1599,1887,1658,1935 ,1947,2221,1702,2003,2041,2282,2101,2335,2364,2663,1755,2063,2121,2366,2176,2396, 2465,2707,2253,2475,2529,2762,2562,2816,2878,3142,714,1025,1078,1429,1144,1464,15 18,1823,1179,1537,1580,1875,1622,1902,1916,2213,1254,1602,1655,1918,1700,1995,202 9,2273,1753,2053,2099,2348,2143,2382,2439,2665,1314,1677,1734,2037,1806,2089,2083 ,2387,1838,2129,2153,2427,2226,2467,2492,2768,1898,2178,2247,2484,2275,2544,2565, 2828,2321,2591,2636,2894,2716,2947,3009,3239,1358,1764,1812,2135,1868,2167,2228,2 477,1989,2249,2295,2554,2304,2572,2614,2865,2013,2297,2317,2606,2389,2630,2696,29 37,2451,2713,2741,2964,2791,3034,3075,3280,2055,2408,2434,2668,2497,2721,2753,299 2,2532,2785,2831,3060,2881,3102,3158,3363,2641,2837,2897,3114,2954,3174,3200,3427 ,2995,3221,3261,3461,3313,3510,3569,3740,769,1106,1161,1540,1248,1597,1646,1965,1 272,1663,1714,2001,1761,2045,2113,2441,1343,1739,1821,2077,1855,2163,2145,2458,18 81,2188,2234,2522,2290,2547,2580,2853,1487,1840,1885,2161,1987,2219,2258,2557,199 9,2292,2310,2585,2337,2620,2649,2920,2015,2328,2376,2646,2448,2693,2736,2971,2487 ,2776,2788,3038,2834,3079,3126,3337,1509,1983,1993,2277,2017,2301,2346,2628,2061, 2392,2429,2679,2472,2724,2782,3024,2245,2446,2499,2738,2534,2809,2840,3068,2625,2 843,2900,3118,2957,3170,3195,3421,2306,2542,2604,2812,2644,2888,2927,3138,2701,29 44,2978,3191,3020,3225,3275,3479,2747,2999,3049,3257,3094,3289,3332,3523,3146,335 2,3384,3556,3410,3620,3636,3827,1526,2023,2043,2436,2217,2463,2489,2771,2264,2519 ,2549,2819,2612,2862,2917,3130,2315,2578,2638,2872,2674,2930,2981,3183,2727,3013, 2974,3212,3072,3270,3308,3497,2453,2657,2690,2950,2765,2988,3045,3243,2803,3053,3 090,3294,3122,3318,3368,3549,2884,3106,3154,3342,3204,3394,3416,3605,3230,3456,34 73,3652,3516,3676,3694,3792,2537,2699,2800,3057,2859,3087,3110,3323,2910,3162,317 8,3378,3217,3400,3467,3628,2923,3208,3248,3450,3303,3485,3491,3685,3358,3529,3542 ,3702,3591,3750,3770,3896,3027,3284,3298,3504,3373,3536,3563,3721,3405,3598,3613, 3760,3660,3781,3840,3929,3438,3644,3668,3803,3712,3815,3853,3947,3730,3866,3881,3 968,3912,3990,4016,4049,11,46,79,183,105,199,256,393,128,242,280,427,314,467,482,74 3,148,268,292,459,345,512,572,768,374,566,539,801,634,843,870,1117,166,325,365,526, 384,559,598,811,435,622,645,847,717,900,925,1175,475,657,732,917,758,953,993,1214,7 97,1001,1042,1292,1064,1327,1388,1668,214,335,410,616,443,640,711,878,490,737,668, 929,782,969,1020,1239,553,727,792,997,820,1031,1061,1313,861,1071,1128,1359,1172,1 408,1451,1756,610,806,852,1057,908,1096,1152,1396,945,1155,1211,1432,1249,1494,15 33,1826,1012,1233,1304,1504,1322,1536,1591,1884,1377,1608,1654,1930,1696,1970,204 0,2386,303,401,451,722,519,753,772,1016,579,787,825,1053,865,1093,1107,1394,628,82 9,874,1100,921,1148,1201,1438,965,1204,1236,1478,1310,1523,1578,1863,679,891,949,1 168,973,1207,1258,1507,1046,1298,1324,1543,1374,1606,1640,1926,1103,1351,1399,162 0,1435,1685,1703,1964,1497,1729,1792,2022,1837,2076,2187,2388,701,957,1027,1267,1 086,1316,1371,1615,1121,1379,1413,1666,1454,1701,1751,2004,1195,1443,1481,1724,15 38,1780,1831,2094,1566,1844,1892,2138,1942,2206,2246,2551,1255,1512,1551,1800,162 5,1859,1901,2174,1694,1917,1966,2229,2024,2254,2343,2635,1749,1986,2044,2302,2070 ,2372,2411,2705,2181,2430,2473,2691,2516,2760,2845,3100,355,497,532,815,585,834,88 3,1145,591,887,933,1178,981,1242,1273,1573,674,937,985,1283,1035,1307,1345,1576,10 68,1339,1391,1652,1446,1692,1713,1962,690,1024,1075,1289,1135,1354,1402,1689,1165 ,1427,1457,1717,1489,1776,1811,2066,1162,1483,1517,1772,1563,1835,1867,2142,1630, 1907,1946,2204,1982,2242,2311,2613,748,1114,1138,1419,1188,1470,1515,1758,1220,15 30,1548,1829,1593,1882,1915,2199,1382,1581,1628, 1890, 1671, 1938, 1980,2235, 1735, 199 4,2054,2296,2102,2368,2416,2678,1467,1659,1722,1958,1769,2018,2060,2347,1820,2084 ,2118,2383,2189,2450,2490,2739,1897,2185,2210,2474,2237,2520,2461,2780,2324,2605, 2639,2863,2653,2946,2990,3149,777,1181,1198,1561,1357,1603,1635,1905,1424,1647,16 75,1950,1733,2000,2052,2352,1462,1726,1767,2002,1798,2062,2108,2395,1846,2124,217 0,2438,2233,2483,2548,2792,1571,1778,1809,2104,1865,2156,2216,2464,1948,2218,2248 ,2543,2327,2511,2624,2869,2016,2285,2363,2607,2397,2650,2684,2921,2452,2698,2695, 2979,2783,3011,3047,3251,1656,1839,1909,2222,1996,2252,2307,2568,2056,2349,2374,2 642,2428,2659,2694,2941,2110,2405,2466,2681,2491,2702,2786,3014,2564,2804,2836,30 56,2892,3112,3143,3350,2201,2478,2536,2789,2621,2795,2880,3071,2632,2871,2926,313 1,2968,3172,3228,3422,2661,2949,3003,3192,3032,3237,3211,3445,3093,3278,3306,3511 ,3364,3546,3588,3696,419,546,604,856,651,941,989,1261,685,1005,1038,1280,1082,1333 ,1348,1678,695,1079,1110,1330,1141,1473,1499,1747,1223,1502,1558,1822,1601,1871,1 913,2227,706,1131,1185,1486,1230,1553,1586,1854,1264,1613,1642,1922,1682,1972,201 0,2257,1301,1664,1708,1992,1760,2046,2080,2336,1783,2068,2128,2402,2136,2437,2481 ,2851,896,1227,1252,1596,1286,1644,1680,1956,1365,1715,1738,2032,1789,2090,2122,2 358,1416,1745,1807,2074,1850,2132,2148,2419,1888,2150,2168,2486,2283,2523,2594,28 70,1465,1848,1876,2164,1934,2212,2223,2503,1978,2280,2316,2563,2381,2616,2645,292 9,2030,2342,2400,2647,2456,2675,2745,2970,2535,2754,2807,3018,2839,3066,3117,3343 ,912,1276,1336,1706,1410,1740,1796,2098,1449,1816,1857,2154,1899,2179,2193,2495,1 528,1880,1932,2195,1974,2270,2305,2553,2026,2331,2377,2631,2423,2664,2719,2932,15 88,1954,2008,2313,2082,2367,2361,2667,2112,2409,2433,2708,2506,2748,2772,3023,217 5,2459,2528,2763,2556,2821,2842,3074,2602,2866,2903,3133,2976,3179,3231,3425,1632 ,2038,2088,2414,2144,2447,2508,2757,2265,2531,2576,2830,2584,2848,2886,3108,2289, 2579,2599,2877,2670,2901,2958,3169,2731,2973,3000,3194,3044,3255,3288,3457,2333,2 687,2714,2935,2774,2982,3008,3218,2810,3039,3078,3276,3121,3310,3356,3524,2909,30 84,3137,3321,3185,3371,3391,3579,3222,3409,3441,3602,3486,3642,3690,3819,977,1368 ,1430,1818,1520,1874,1924,2240,1546,1940,1988,2276,2036,2322,2391,2722,1618,2014, 2096,2354,2130,2444,2425,2737,2158,2469,2515,2801,2571,2824,2857,3096,1765,2116,2 162,2442,2263,2500,2540,2833,2274,2573,2590,2860,2619,2889,2918,3156,2291,2610,26 56,2915,2728,2955,2993,3198,2766,3029,3041,3258,3081,3292,3331,3502,1787,2259,226 8,2559,2294,2582,2627,2898,2338,2673,2711,2943,2751,2984,3036,3245,2525,2725,2777 ,2997,2813,3059,3086,3282,2895,3091,3140,3324,3188,3367,3387,3574,2587,2818,2874, 3062,2912,3127,3163,3339,2965,3175,3205,3383,3241,3413,3453,3617,3005,3224,3265,3 437,3304,3465,3499,3653,3346,3515,3541,3680,3565,3726,3737,3887,1803,2300,2318,27 15,2498,2742,2769,3026,2545,2798,2827,3069,2883,3105,3152,3335,2595,2854,2906,311 5,2938,3165,3207,3379,2987,3235,3201,3402,3286,3448,3482,3632,2734,2924,2952,3181 ,3021,3214,3262,3429,3054,3268,3300,3469,3327,3490,3528,3674,3124,3314,3354,3507, 3395,3551,3570,3714,3418,3597,3612,3751,3647,3769,3784,3860,2815,2962,3051,3272,3 103,3296,3317,3494,3147,3360,3375,3538,3406,3555,3607,3732,3159,3398,3432,3593,34 77,3622,3626,3776,3520,3658,3669,3790,3703,3828,3843,3939,3247,3462,3474,3637,353 3,3663,3686,3805,3560,3708,3719,3835,3757,3851,3897,3964,3583,3744,3763,3869,3797 ,3877,3906,3978,3812,3917,3927,3994,3951,4010,4031,4056,229,504,662,1008,763,1050, 1158,1459,838,1124,1217,1525,1295,1598,1623,2012,904,1191,1246,1583,1362,1661,176 3,2042,1421,1754,1710,2092,1861,2146,2183,2485,961,1319,1405,1687,1441,1742,1805, 2106,1541,1842,1878,2152,1976,2225,2255,2546,1611,1895,1998,2244,2034,2293,2340,2 589,2086,2351,2398,2669,2421,2703,2761,3025,1089,1342,1491,1833,1556,1869,1968,21 97,1637,2006,1903,2261,2064,2309,2370,2615,1731,1990,2078,2345,2120,2384,2418,268 9,2172,2431,2493,2735,2541,2781,2823,3099,1824,2100,2160,2412,2231,2457,2521,2770 ,2281,2526,2586,2805,2623,2861,2902,3157,2359,2608,2680,2876,2697,2905,2956,3203, 2752,2972,3012,3238,3050,3269,3320,3535,1270,1475,1568,1984,1673,2028,2050,2365,1 774,2072,2126,2407,2177,2454,2471,2767,1852,2134,2191,2462,2250,2518,2574,2811,23 03,2577,2611,2847,2686,2893,2945,3186,1920,2214,2287,2538,2314,2581,2634,2879,240 4,2672,2700,2911,2749,2969,2998,3236,2468,2726,2775,2983,2808,3040,3055,3264,2864 ,3077,3129,3307,3167,3344,3415,3537,1952,2298,2379,2643,2449,2692,2746,2977,2488, 2755,2787,3022,2826,3052,3097,3295,2566,2814,2850,3073,2908,3120,3161,3355,2934,3 171,3210,3385,3249,3428,3452,3627,2629,2882,2919,3136,2986,3184,3216,3407,3048,32 29,3267,3442,3309,3458,3512,3671,3095,3281,3322,3487,3340,3527,3550,3705,3412,356 1,3585,3698,3609,3731,3771,3880,1385,1649,1699,2114,1785,2140,2202,2513,1794,2208 ,2267,2550,2325,2618,2648,2939,1911,2272,2329,2658,2390,2683,2720,2942,2426,2717, 2764,3010,2817,3046,3063,3263,1936,2375,2435,2666,2501,2729,2778,3043,2533,2799,2 829,3067,2858,3116,3145,3336,2530,2852,2887,3113,2931,3164,3190,3386,2991,3220,32 50,3426,3279,3451,3492,3659,2020,2479,2505,2793,2561,2841,2885,3101,2592,2899,291 6,3160,2959,3202,3227,3423,2758,2948,2989,3209,3 028,3 244,3277,3446,3082,3287,3329 ,3483,3361,3526,3553,3692,2838,3017,3070,3260,3111,3305,3333,3513,3153,3349,3372, 3534,3417,3572,3594,3722,3213,3414,3430,3586,3447,3610,3578,3741,3500,3655,3672,3 778,3679,3817,3836,3900,2058,2555,2569,2928,2732,2966,2996,3219,2796,3007,3030,32 54,3080,3291,3326,3517,2832,3076,3109,3293,3135,3334,3365,3540,3173,3376,3404,356 6,3443,3590,3625,3746,2936,3119,3144,3362,3189,3396,3434,3580,3253,3435,3454,3623 ,3501,3606,3665,3780,3302,3476,3522,3656,3543,3678,3695,3806,3573,3701,3700,3831, 3742,3845,3859,3936,3015,3168,3223,3436,3290,3455,3489,3635,3330,3514,3530,3673,3 559,3682,3699,3814,3366,3547,3581,3693,3595,3704,3743,3846,3634,3752,3766,3863,37 93,3885,3898,3969,3424,3587,3619,3745,3664,3747,3787,3870,3670,3783,3808,3892,382 5,3908,3928,3989,3683,3818,3841,3915,3854,3932,3922,3997,3878,3945,3955,4014,3973 ,4023,4033,4055,1510,1719,1813,2166,1886,2278,2334,2637,1928,2356,2393,2655,2445, 2709,2723,3033,1944,2440,2476,2706,2510,2844,2867,3092,2597,2873,2925,3155,2963,3 193,3226,3440,1960,2496,2558,2855,2603,2922,2951,3180,2640,2975,3001,3232,3037,32 71,3299,3459,2677,3019,3061,3285,3104,3325,3345,3506,3123,3338,3377,3545,3382,356 4,3589,3773,2220,2600,2626,2961,2662,3004,3035,3259,2740,3065,3085,3315,3128,3353 ,3374,3519,2790,3089,3141,3341,3177,3381,3390,3554,3206,3392,3403,3592,3475,3611, 3649,3782,2835,3176,3197,3401,3242,3431,3439,3601,3274,3472,3495,3633,3532,3661,3 675,3809,3312,3509,3544,3677,3575,3691,3724,3826,3618,3728,3753,3847,3767,3867,38 88,3966,2239,2651,2712,3058,2784,3088,3132,3359,2820,3148,3182,3393,3215,3411,341 9,3596,2896,3199,3240,3420,3273,3468,3488,3629,3311,3503,3531,3667,3557,3684,3711 ,3810,2953,3256,3297,3493,3348,3525,3521,3687,3369,3548,3562,3706,3603,3725,3736, 3849,3408,3577,3615,3733,3630,3759,3768,3871,3654,3779,3798,3893,3830,3910,3930,3 991,2994,3319,3351,3552,3388,3571,3604,3729,3464,3616,3640,3764,3645,3772,3789,38 84,3478,3641,3651,3786,3688,3796,3822,3907,3717,3829,3839,3916,3858,3937,3949,400 0,3505,3697,3709,3811,3738,3832,3844,3924,3754,3856,3872,3944,3889,3956,3971,4018 ,3800,3874,3894,3959,3913,3975,3981,4030,3925,3986,3996,4036,4007,4044,4054,4075, 2320,2743,2802,3151,2890,3196,3233,3449,2913,3246,3283,3471,3316,3498,3539,3713,2 980,3301,3357,3518,3380,3568,3558,3720,3397,3582,3608,3749,3638,3761,3775,3879,31 07,3370,3399,3567,3463,3600,3621,3765,3470,3639,3648,3777,3662,3791,3804,3902,348 0,3657,3681,3802,3716,3821,3837,3918,3734,3852,3857,3938,3873,3950,3962,4012,3125 ,3460,3466,3631,3481,3643,3666,3795,3508,3689,3707,3816,3727,3833,3855,3934,3614, 3715,3739,3838,3755,3864,3875,3946,3794,3876,3895,3960,3914,3974,3980,4029,3646,3 758,3785,3865,3801,3891,3904,3965,3824,3909,3920,3979,3933,3987,3999,4039,3842,39 26,3941,3995,3954,4002,4011,4046,3967,4015,4022,4052,4027,4061,4063,4083,3139,348 4,3496,3710,3599,3723,3735,3850,3624,3748,3762,3868,3788,3883,3901,3963,3650,3774 ,3799,3886,3813,3905,3921,3977,3834,3931,3919,3984,3948,3998,4006,4042,3718,3807, 3820,3911,3848,3923,3940,3992,3862,3942,3953,4003,3961,4008,4019,4051,3890,3957,3 970,4013,3982,4024,4028,4059,3988,4035,4038,4065,4045,4068,4070,4080,3756,3823,38 61,3943,3882,3952,3958,4009,3899,3972,3976,4021,3985,4025,4037,4062,3903,3983,399 3,4034,4005,4040,4041,4069,4017,4047,4050,4071,4057,4076,4078,4088,3935,4001,4004 ,4043,4020,4048,4053,4073,4026,4058,4060,4077,4066,4079,4084,4090,4032,4064,4067, 4081,4072,4082,4085,4091,4074,4086,4087,4092,4089,4093,4094,4095];
where the sequence Z3 is given by
[0,1,2,7,3,8,12,25,4,11,14,29,17,34,36,79,5,13,15,33,20,40,49,84,23,48,44,91,59,100, 106,170,6,18,22,42,24,47,53,93,30,57,61,101,74,113,119,187,35,63,77,117,82,126,136,19 9,90,138,149,224,155,236,257,366,9,19,27,56,31,60,73,108,37,78,65,120,87,130,143,207, 46,76,89,137,95,146,154,231,104,157,173,247,186,264,280,404,55,92,102,153,115,164,18 0,260,124,181,198,273,210,296,311,436,141,205,228,300,234,312,334,463,253,341,360,4 85,378,505,540,721,16,26,32,75,41,81,85,142,50,88,96,152,105,163,167,259,58,97,107,16 5,118,179,195,275,129,196,206,290,230,307,329,453,67,111,125,185,131,197,213,301,15 0,226,235,315,252,340,354,483,166,244,261,346,274,373,381,502,297,392,420,531,441,5 57,613,722,71,127,145,216,161,232,251,344,171,254,266,365,281,380,402,522,193,277,2 91,390,313,415,438,566,324,444,467,588,491,623,644,818,212,303,318,424,348,451,471, 606,377,479,503,635,532,648,697,870,401,513,542,674,554,713,735,914,610,746,771,905 ,797,950,1007,1188,21,38,43,94,51,98,109,178,52,110,121,188,133,208,218,327,66,122,1 34,221,147,229,242,328,156,240,258,359,278,376,385,501,69,144,158,223,175,245,262,3 75,184,271,282,387,294,413,429,552,183,292,305,411,323,440,455,590,350,474,493,622, 511,642,679,856,80,169,176,268,191,287,304,405,201,310,317,437,335,462,478,619,255, 330,349,466,367,489,510,638,395,517,546,671,570,711,738,897,286,362,389,499,410,529 ,549,699,433,561,578,719,614,758,781,936,469,612,625,772,639,799,764,963,686,851,87 2,1019,881,1077,1108,1225,86,189,194,322,246,339,352,473,270,357,369,495,394,520,54 5,702,284,391,409,521,423,550,573,726,445,581,604,751,637,777,816,971,326,414,428,5 71,454,597,628,766,494,629,645,813,688,794,863,1023,528,665,708,852,727,879,901,105 9,759,910,908,1100,965,1123,1149,1303,361,442,475,631,518,647,677,828,547,700,714,8 74,745,885,907,1073,574,732,767,899,782,912,967,1125,826,979,1001,1156,1039,1197,1 220,1381,620,774,809,969,861,973,1031,1167,868,1025,1063,1211,1092,1242,1285,1439, 886,1079,1117,1257,1138,1292,1272,1458,1183,1324,1346,1513,1392,1543,1579,1673,28, 45,54,103,62,123,135,214,68,139,148,220,160,238,243,370,70,159,168,237,177,288,298,4 00,202,299,321,434,338,457,477,634,72,174,190,293,204,319,332,449,215,343,355,481,3 72,506,525,650,227,364,383,516,406,543,559,693,416,553,583,730,587,750,776,1011,112 ,203,211,336,222,356,371,498,249,386,396,536,419,564,580,705,267,399,427,556,447,58 5,593,740,465,594,603,779,664,801,844,1024,285,446,459,601,487,626,632,789,509,662, 682,825,718,858,876,1065,535,696,729,877,761,895,940,1094,808,946,981,1128,1003,11 63,1201,1375,116,219,239,382,265,397,422,568,279,431,450,596,470,609,616,784,309,46 1,486,617,507,657,676,819,533,690,716,867,742,888,923,1067,333,497,524,680,560,710, 707,890,575,734,748,916,791,942,958,1132,607,763,804,952,821,991,1005,1169,849,102 1,1047,1213,1098,1247,1287,1442,351,539,563,737,591,756,792,948,654,806,833,997,83 8,1009,1035,1194,667,835,847,1029,892,1045,1085,1240,931,1096,1115,1259,1147,1306, 1332,1468,691,903,920,1069,959,1102,1121,1277,983,1143,1172,1322,1204,1349,1386,15 24,1051,1176,1216,1358,1252,1398,1414,1571,1280,1429,1455,1591,1492,1626,1668,178 4,132,250,272,432,306,458,482,641,316,490,514,660,538,685,724,925,345,527,567,703,5 84,754,743,935,598,769,796,977,830,993,1015,1185,408,577,600,753,653,787,811,999,65 9,831,842,1017,860,1037,1057,1230,668,854,883,1055,929,1083,1110,1262,954,1136,114 5,1308,1174,1335,1366,1506,418,651,656,823,670,837,865,1043,694,894,918,1075,944,1 104,1141,1298,802,927,961,1113,985,1158,1178,1327,1041,1181,1218,1360,1254,1395,14 11,1567,840,989,1027,1160,1053,1208,1235,1372, 1090, 1244, 1267, 1408, 1295, 1432, 1465, 1604,1119,1282,1314,1452,1344,1475,1503,1635,1378,1517,1539,1659,1559,1700,1710,1 847,425,673,683,921,786,938,956,1134,814,975,995,1165,1033,1192,1227,1369,845,1013 ,1049,1199,1071,1237,1269,1404,1106,1290,1264,1423,1330,1461,1489,1617,933,1061,1 081,1249,1130,1274,1311,1445,1154,1316,1341,1478,1363,1496,1528,1654,1206,1352,13 84,1510,1417,1547,1563,1689,1436,1587,1600,1722,1630,1739,1752,1822,987,1088,1152 ,1319,1190,1338,1355,1499,1223,1389,1401,1536,1426,1551,1595,1705,1232,1420,1448, 1583,1485,1608,1612,1745,1521,1640,1649,1758, 1679, 1792, 1806, 1896, 1300, 1472, 1482, 1 621,1532,1644,1664,1771,1555,1684,1694,1799,1728,1814,1856,1920,1575,1716,1733,18 30,1764,1838,1865,1933,1778,1875,1885,1948,1907,1964,1984,2008,10,39,64,140,83,151 ,182,283,99,172,200,308,225,337,347,526,114,192,209,331,248,363,407,541,269,403,384, 565,452,592,611,778,128,233,263,374,276,398,426,572,314,443,460,595,508,633,649,815 ,342,468,519,643,537,669,695,841,562,701,728,891,741,913,951,1133,162,241,295,439,3 20,456,504,618,353,523,472,652,551,678,712,857,393,515,558,698,579,720,739,904,605, 747,783,934,812,964,992,1187,435,569,599,736,636,762,800,957,663,803,839,980,862,10 18,1046,1231,706,853,898,1028,909,1048,1084,1266,945,1095,1124,1293,1151,1317,135 7,1534,217,289,325,512,368,534,544,709,412,555,582,733,608,760,770,955,448,586,615, 765,646,798,832,984,675,834,855,1008,902,1040,1076,1253,480,627,666,810,681,836,86 9,1030,731,893,911,1052,943,1093,1114,1291,768,928,960,1103,982,1144,1155,1313,102 0,1171,1210,1347,1238,1376,1434,1535,496,672,717,875,757,906,941,1099,780,947,968, 1131,994,1153,1186,1337,827,986,1010,1168,1050, 1203, 1234, 1385, 1068, 1241, 1271, 1409, 1301,1444,1464,1613,866,1032,1058,1215,1105,1251,1276,1427,1150,1286,1315,1456,13 48,1469,1514,1651,1184,1326,1359,1493,1373,1527,1546,1681,1431,1556,1576,1675,159 7,1704,1740,1841,256,358,379,576,417,589,621,795,421,624,655,817,687,859,878,1072,4 76,658,689,884,723,900,924,1074,744,922,953,1122,988,1148,1161,1312,488,715,749,88 9,788,930,962,1146,807,976,996,1164,1016,1200,1222,1370,805,1012,1036,1198,1066,12 36,1256,1410,1109,1279,1302,1443,1325,1463,1497,1641,530,775,790,972,824,1004,103 4,1189,843,1044,1056,1233,1086,1265,1284,1440,949,1078,1107,1270,1135,1297,1323,1 459,1175,1331,1364,1490,1390,1526,1549,1670,1002,1127,1166,1310,1196,1345,1367,15 15,1228,1380,1399,1533,1435,1565,1584,1696,1273,1433,1446,1577,1460,1598,1570,171 3,1504,1637,1652,1747,1658,1782,1800,1859,548,820,829,1064,932,1091,1112,1278,974, 1120,1137,1305,1173,1334,1362,1518,998,1170,1195,1336,1214,1368,1393,1538,1243,14 02,1425,1560,1457,1581,1611,1718,1070,1202,1221,1391,1255,1418,1449,1572,1304,145 0,1466,1609,1505,1594,1646,1749,1343,1484,1523, 1638, 1540, 1657, 1672, 1772, 1566, 1678 ,1677,1795,1714,1808,1821,1893,1126,1239,1281,1451,1333,1467,1495,1620,1365,1516, 1529,1653,1554,1661,1676,1780,1394,1544,1573,1671,1585,1680,1715,1809,1619,1723,1 736,1825,1760,1845,1857,1924,1441,1578,1606,1717,1645,1719,1755,1831,1650,1751,17 74,1852,1790,1867,1886,1944,1662,1783,1804,1873,1816,1889,1880,1951,1839,1902,191 1,1968,1928,1976,1986,2007,302,388,430,602,464,661,692,871,484,704,725,882,755,917, 926,1139,492,752,773,915,793,1006,1022,1182,846,1026,1062,1229,1089,1258,1283,145 4,500,785,822,1014,850,1060,1080,1248,873,1097, 1116, 1288, 1142, 1318, 1340, 1470,896, 1 129,1159,1329,1191,1361,1377,1509,1205,1371,1403,1542,1407,1558,1580,1742,630,848 ,864,1087,887,1118,1140,1309,937,1162,1177,1353,1209,1383,1400,1520,970,1180,1219, 1374,1246,1406,1413,1550,1268,1415,1424,1582,1483,1599,1632,1750,1000,1245,1261,1 422,1296,1447,1453,1590,1321,1481,1500,1618,1531,1642,1655,1775,1351,1512,1541,16 56,1568,1669,1698,1791,1605,1702,1724,1810,1737,1828,1848,1922,640,880,919,1157,9 66,1179,1212,1388,990,1224,1250,1416,1275,1430,1437,1586,1042,1263,1294,1438,1320 ,1477,1494,1614,1350,1507,1530,1648,1552,1663,1687,1776,1082,1307,1339,1498,1379, 1525,1522,1665,1396,1545,1557,1682,1592,1699, 1709, 1812, 1428, 1569, 1602, 1706, 1615, 1 730,1738,1832,1636,1748,1765,1853,1794,1869, 1887, 1945, 1111, 1356, 1382, 1548, 1412, 15 64,1593,1703,1474,1603,1624,1734,1628,1741,1757,1844,1486,1625,1634,1754,1666,176 3,1787,1866,1692,1793,1803,1874,1820,1894,1905,1954,1508,1674,1685,1777,1711,1796 ,1807,1882,1725,1818,1833,1901,1849,1912,1926,1971,1767,1835,1854,1915,1871,1930, 1936,1983,1883,1941,1950,1989,1961,1997,2006,2027,684,939,978,1226,1038,1260,1289 ,1462,1054,1299,1328,1480,1354,1502,1537,1688,1101,1342,1387,1519,1405,1562,1553, 1695,1419,1574,1596,1721,1622,1731,1744,1840,1193,1397,1421,1561,1473,1589,1607,1 735,1479,1623,1631,1746,1643,1759,1770,1861,1487,1639,1660,1769,1691,1786,1801,18 76,1707,1815,1819,1895,1834,1906,1918,1966,1207,1471,1476,1616,1488,1627,1647,176 2,1511,1667,1683,1781,1701,1797,1817,1891,1601,1690,1712,1802,1726,1826,1836,1903 ,1761,1837,1855,1916,1872,1929,1935,1982,1629,1729,1753,1827,1768,1851,1863,1921, 1789,1868,1878,1934,1890,1942,1953,1992,1805,1884,1898,1949,1910,1956,1965,1999,1 923,1969,1975,2004,1980,2013,2015,2035,1217,1491,1501,1686,1588,1697,1708,1813,16 10,1720,1732,1829,1756,1843,1860,1919,1633,1743,1766,1846,1779,1864,1879,1932,179 8,1888,1877,1939,1904,1952,1960,1995,1693,1773,1785,1870,1811,1881,1897,1946,1824 ,1899,1909,1957,1917,1962,1972,2003,1850,1913,1925,1967,1937,1977,1981,2011,1943, 1988,1991,2017,1998,2020,2022,2032,1727,1788, 1823, 1900, 1842, 1908, 1914, 1963, 1858, 1 927,1931,1974,1940,1978,1990,2014,1862,1938, 1947, 1987, 1959, 1993, 1994,2021, 1970,20 00,2002,2023,2009,2028,2030,2040,1892,1955,1958,1996,1973,2001,2005,2025,1979,201 0,2012,2029,2018,2031,2036,2042,1985,2016,2019,2033,2024,2034,2037,2043,2026,2038 ,2039,2044,2041,2045,2046,2047];
wherein each of sequence numbers of N polarized channels in the second sequence corresponds to a reliability ranking of the sequence number in the entire sequence, and a minimum value of the sequence numbers of the polarized channels is 0.

2. A polar polar code encoding apparatus (300), comprising:
an obtaining unit (601), configured to obtain a first sequence used to encode K to-be-encoded bits, wherein the first sequence comprises sequence numbers of N polarized channels, the sequence numbers of the N polarized channels are arranged in the first sequence based on reliability of the N polarized channels, K is a positive integer, N is a mother code length of a polar code, N = 2ⁿ, n is a positive integer, and K ≤ N;
a selection unit (602), configured to select sequence numbers of K polarized channels from the first sequence in descending order of reliability; and
an encoding unit (603), configured to: place the to-be-encoded bits based on the selected sequence numbers of the K polarized channels, and perform polar code encoding on the to-be-encoded bits;
wherein the first sequence is all of a second sequence, the second sequence comprises sequence numbers of Nₘₐₓ polarized channels, the sequence numbers of the Nₘₐₓ polarized channels are arranged in the second sequence based on reliability of the Nₘₐₓ polarized channels, Nₘₐₓ is a positive integer, Nₘₐₓ ≥ N, and a sorting of the sequence numbers of the polarized channels in the first sequence is consistent with a sorting of sequence numbers of polarized channels that are less than N in the second sequence;
**characterized in that**
the second sequence is a part or all of a sequence Q1, a sequence Q2 or a sequence Q3;
where the sequence Q1 is given by
[0,1,2,4,8,16,32,3,5,64,1024,2048,4096,9,6,17,10,18,128,12,33,65,20,256,34,24,36,7,129,6 6,512,11,40,68,130,19,13,48,14,72,257,1025,21,132,35,258,26,2049,513,80,37,25,22,4097 ,136,260,264,38,514,96,67,41,144,28,69,42,516,49,1026,74,272,160,520,288,528,192,544, 70,44,131,81,2050,50,73,15,320,133,52,1028,23,134,384,76,4098,137,82,56,27,97,39,259, 84,138,145,261,1032,29,43,2052,98,515,88,140,30,146,71,262,265,161,576,45,1040,100,6 40,51,148,46,75,4100,266,273,517,2056,104,162,53,193,1056,152,77,164,768,268,274,51 8,54,83,57,521,1027,112,135,2064,78,289,194,85,276,4104,522,58,168,1029,139,99,86,60 ,280,89,290,529,2080,524,196,1088,141,101,147,176,142,530,321,31,200,1033,4112,90,5 45,292,2051,322,532,263,149,102,105,1030,304,296,163,92,47,267,385,546,2053,324,104 1,208,386,4128,150,153,165,106,55,1034,328,536,577,548,2112,113,154,79,269,1042,108 ,578,224,166,519,552,195,4099,1152,270,3072,641,523,275,580,291,59,1036,169,560,114 ,277,156,2057,87,197,1057,116,170,4101,61,531,525,642,281,1089,278,526,2054,177,293 ,388,91,1044,584,769,198,172,120,4160,201,2065,336,1280,62,282,143,103,178,294,1058 ,93,644,2058,202,592,323,1048,392,5120,297,770,107,180,151,1060,2066,209,284,648,94 ,204,298,1031,400,608,352,2176,6144,325,533,1153,155,210,305,547,300,1090,109,2060, 184,534,537,115,167,1536,4105,225,326,306,772,2081,157,1035,656,329,110,117,212,10 64,171,2113,776,4102,330,226,549,1092,538,387,308,216,2068,1154,416,271,279,158,33 7,1043,4113,550,672,2304,118,332,579,1037,540,389,173,121,1072,2082,553,199,784,41 06,179,1038,228,338,312,2072,704,390,1096,174,554,581,393,1281,4114,283,2084,122,4 48,353,1045,561,203,63,340,2055,1156,394,527,582,4224,556,181,1059,2177,295,285,23 2,124,1282,205,182,643,2114,4108,562,1050,286,585,299,1537,354,211,2560,401,185,11 04,396,344,4129,586,645,2059,1061,593,535,240,206,1049,95,2088,327,564,4161,1046,8 00,402,356,307,2116,1160,301,417,213,568,1284,832,4116,2178,588,186,1288,646,404,2 27,896,2067,1062,594,418,4352,302,1538,649,771,2061,360,539,1120,111,331,214,1091, 2096,4130,309,188,449,1065,217,408,2062,609,596,1168,551,650,4120,229,1052,2120,15 9,420,310,1093,541,773,2305,610,4132,1066,657,333,119,1540,3073,600,339,218,1073,3 68,652,4103,230,2069,1098,391,313,450,1296,542,2180,334,233,4225,1184,555,774,175, 2083,1544,123,658,612,1312,2306,4162,341,777,220,1552,314,424,2074,395,1216,673,58 3,4608,355,1568,2561,287,183,234,1094,125,557,2128,4107,660,1068,616,342,316,2085, 1155,241,778,1105,563,4136,345,2073,452,1074,397,403,207,2070,1097,674,4164,558,10 39,785,432,2184,357,1344,187,236,664,4226,2308,1157,624,587,1076,780,2312,705,126, 1047,4115,242,565,1158,2086,398,346,456,1408,358,2562,4109,405,1100,303,569,244,21 44,1161,595,189,4144,1106,566,2115,676,361,1080,706,589,2089,1051,4110,215,786,647, 1121,2192,348,419,1063,406,4168,464,2076,680,1283,801,362,1108,2117,590,4353,409,1 162,570,2090,788,597,1169,572,219,5121,2564,1285,311,708,1053,598,2097,601,1067,41 17,651,421,3074,792,1122,802,611,1539,2122,4228,602,410,1112,231,688,2320,1164,653, 248,4131,1054,2208,369,190,364,1170,654,2568,4354,659,1095,335,480,2336,1286,315,2 21,1289,4122,2576,370,613, 1185,422,425,2240, 1600,6145,451,614, 1069,2592,543,235, 11 24,412,4609,2118,343,372,1664,775,317,2092,1075,222,4176,426,1172,2179,453,237,107 0,559,2129,4133,833,1099,804,712,2098,1290,834,661,4121,1297,2121,808,779,1541,617 ,1128,2063,4118,604,433,1186,720,2368,816,1077,4232,836,347,2181,1217,897,243,1176, 2100,4356,662,454,1101,318,3076,675,1188,618,4360,898,2071,1792,781,376,2182,1292, 4134,428,1298,665,2432,736,1542,567,840,4610,2124,1078,625,238,1107,2185,359,4192, 457,1081,399,2130,787,1545,591,1136,4163,2104,678,434,1159,2075,677,349,4137,1102, 245,2145,458,1313,666,1218,4240,2087,620,363,1109,2307,127,191,4124,1300,782,2132, 1546,407,436,1082,4165,2186,626,571,1192,2193,465,1163,681,4138,246,2309,1123,707, 350,3080,4612,1110,599,1084,668,2077,790,1304,4145,460,2091,249,1113,682,1314,2146 ,5122,573,411,1553,2563,803,789,1548,4170,709,2136,1220,365,440,2188,1165,4368,628 ,1125,689,2078,374,1171,4256,423,2194,466,1200,793,2119,1166,4616,250,371,1554,231 0,481,1345,574,4384,2313,413,1055,603,2209,1224,4624,366,468,1114,2624,655,1569,90 0,4288,2093,805,1316,615,3088,1346,4640,684,710,2148,1556,429,1287,4166,2688,794,2 52,1173,373,2099,1126,4140,605,848,2196,1129,690,1328,4227,2094,713,1320,632,2123, 482,4177,1187,806,2314,1116,427,904,6146,2321,1071,414,1291,2565,223,663,4146,140 9,2152,692,1570,835,2210,4169,1348,619,472,2101,1232,455,4111,1410,2241,796,809,11 74,3104,4416,714,1177,721,2200,1189,837,4229,716,2125,1130,864,1079,2212,4148,810, 1352,606,2816,912,5124,1560,722,2316,1601,696,1572,4119,2322,377,435,1137,2566,81 7,4230,1178,319,2102,1103,621,1293,4480,2131,812,484,1132,2105,430,4172,1602,838,2 569,1248,667,4233,3075,488,1190,239,2160,1543,4178,378,1576,2183,459,1219,622,415 2,2126,627,1294,437,2337,4123,1665,380,2242,1547,818,1299,4193,2133,461,496,1604,2 324,4135,669,1315,2570,679,1083,724,4355,2106,1193,841,629,2216,4180,1584,351,113 8,3077,467,1301,4234,2187,438,1180,737,2147,4241,1111,251,1221,2134,462,4357,442,2 108,1140,441,1194,2328,5128,469,1085,2137,247,1555,4125,683,2338,1549,842,1666,41 39,2577,738,899,2572,1305,6148,670,1302,2244,783,1550,3136,4194,849,1201,820,2189, 1317,4611,728,2149,1412,928,1115,4184,2195,791,367,2224,1608,4236,901,1793,2190,6 30,1222,4126,2578,685,1196,844,2369,4242,1144,633,2079,1225,711,4167,1360,2248,25 3,1086,3081,4358,691,1306,824,2138,1167,4361,902,2593,1127,686,740,4257,2340,1202, 850,2370,1318,4672,375,2580,1117,444,1668,4141,2311,470,1226,2197,483,5136,1616,4 15,2150,1347,485,4196,2153,1416,905,3078,1321,4736,795,1794,2352,473,4147,1131,23 44,634,1204,2211,4244,744,1175,852,2140,1233,4142,960,2095,1308,865,2315,4171,167 2,693,2433,1118,4362,797,1228,2594,906,1322,4369,2372,715,1424,3089,807,4613,1632, 474,2256,1376,6152,636,2434,1349,694,2198,4200,1557,254,2201,1179,717,4258,2213,1 234,575,1329,4149,2154,913,1571,2103,798,4289,1324,3082,811,1133,5152,2376,379,12 08,2584,697,4248,1558,431,2625,607,4173,489,2596,1561,866,2161,4260,1139,723,2202, 1191,4864,486,2127,1249,908,2317,4364,1350,718,1330,3090,4370,813,1796,2156,476,4 614,1181,2626,856,1680,2272,4150,839,1353,2214,725,4179,1134,2567,698,1141,2600,4 153,914,1236,2243,752,4617,1195,3200,868,1800,5123,2318,819,1354,2689,4208,814,12 50,439,2571,1573,4231,929,2323,1562,490,6160,2628,1411,623,2339,4174,1332,671,210 7,1240,4385,739,3084,1440,916,2217,4290,1295,463,2608,1303,4181,843,2162,1182,381, 4372,2325,1361,497,2204,4618,1574,930,2135,1696,4154,821,2245,1142,726,4264,3105, 1356,1603,2164,5125,961,2218,1564,872,2109,4235,1413,492,2579,1197,4195,631,2573, 1145,729,4182,2690,1577,700,2329,4156,1223,443,3137,1808,4376,741,2326,1203,845,4 185,2574,1252,920,2225,4386,1362,382,2341,1336,4625,822,2436,1728,2139,6176,1414, 851,3092,1198,4620,730,2632,1578,498,4292,2817,1605,880,5184,2246,1417,742,2220,4 237,1307,445,2168,1146,4197,2249,471,1472,2384,4243,1377,635,3328,1585,4272,932,2 110,1227,687,4238,2330,1087,903,2191,4626,1364,2151,825,4417,1418,2226,500,1551,4 127,2342,1606,846,3106,4296,1580,745,2141,1205,5129,2692,826,1319,2250,4186,732,1 309,2640,4641,446,1256,2371,1148,4388,3096,962,1229,2440,6147,936,1206,2345,4418, 475,1667,2818,853,4628,2155,1586,867,2228,4359,1310,1609,2199,637,4245,1323,3108, 907,4198,2257,1378,487,2332,4201,1235,695,2696,5126,1425,2142,1209,746,4400,2252, 1420,828,2346,4392,1368,3079,753,4259,1610,2448,854,1669,4188,2656,1617,2400,857, 4143,1559,2373,504,4363,1264,2581,799,3201,4481,1230,1119,2203,4642,255,1351,2258 ,964,6149,2353,1588,909,4420,2595,1824,719,2348,5137,1426,3138,1380,4304,477,2157, 1331,915,4482,2232,1325,2582,4246,638,1441,2585,1237,4249,2163,748,1592,4261,2215 ,944,1856,3584,4202,869,2273,1612,4151,1210,2374,491,5130,2354,1670,699,2820,4424, 1428,1251,2205,4632,754,3083,1920,858,4673,2704,1618,2377,4644,478,1442,2158,6208 ,1326,968,2165,1673,4209,2260,383,1795,4250,3112,910,2219,4175,1384,1563,2824,815, 4365,2378,1135,976,5138,2274,1355,2597,4204,1238,870,3140,1333,4674,2586,917,1212 ,4320,2435,1473,2356,4262,727,1241,2264,493,4615,3202,1432,873,4648,2464,1633,231 9,4291,1620,701,2327,5248,1575,2206,931,4366,1674,2385,1253,3091,7168,756,1183,25 98,4737,860,2720,1444,4619,1334,2166,499,4371,2380,1565,731,2627,4676,1797,3085,1 634,4387,823,2588,1681,4155,2437,922,1357,5132,2221,1143,2169,4265,874,1624,3120, 4656,918,2601,1363,4210,2247,1242,502,2832,4373,1392,2227,933,4252,1676,3086,1254 ,6153,2276,743,1415,4183,2386,1337,2360,4293,760,2752,1474,5153,881,2438,1566,421 2,3144,1358,494,4266,2222,1257,2602,4157,702,2629,1579,4627,1798,2441,921,4621,33 29,1199,501,4738,2331,1147,2170,4377,1682,2496,876,5185,1636,2401,1365,4374,3093, 847,1801,2609,4622,992,2251,6150,1244,2111,1338,4273,447,2388,1448,4389,3204,1419 ,2442,4484,733,1697,2575,4187,827,2630,1607,5140,2604,1379,934,4680,2229,1311,310 7,4865,1207,2343,882,4294,1258,2333,937,4268,2280,1149,2172,4216,1581,963,3330,42 97,1684,2253,1640,6161,2230,747,1366,4432,2691,505,2610,5376,1340,3098,1265,4158, 855,2334,4378,1802,2633,1587,4239,2347,924,3585,4199,1369,734,2402,4274,1476,2259 ,1421,4390,2449,829,1427,5154,2233,1231,3152,4189,965,2444,4740,1698,2392,1582,61 54,938,2634,1809,4298,2693,1456,3109,4688,884,1381,2641,4419,506,2583,5144,1211,2 288,1260,4488,2254,749,1688,4393,3097,1648,2143,4866,945,2375,1611,4203,2612,1804 ,4276,966,3094,1729,4247,2848,1150,2450,5156,755,2404,1266,6162,859,2355,4305,158 9,3208,1422,4380,2349,940,2465,4744,1370,2261,4190,1480,830,2616,4300,1382,3332,1 429,4394,2880,911,2636,5127,1327,1593,4496,2234,871,3336,4704,1268,2694,1619,4448 ,2452,639,6272,2275,1213,1590,4421,2944,888,3110,4629,1700,2642,5249,1385,2466,47 9,4251,2350,1730,3586,4306,1613,946,4401,2697,1239,2819,4643,750,2408,4396,1810,2 587,1671,5186,3168,969,2159,4205,1372,1443,6156,2379,508,2262,4280,1430,3139,4630 ,1488,2357,861,4633,2236,1704,2497,4211,1825,757,4263,3113,1386,2265,5632,1614,24 56,4321,970,2657,1433,4422,2644,1594,3216,4402,919,2599,4868,1812,1621,2698,6177, 1596,2277,4253,875,3100,1243,5131,2207,1335,4752,2468,862,2358,4425,1732,3141,420 6,1622,2589,758,4213,1625,2821,4308,1675,2658,948,5160,3114,1445,4267,2705,1816,2 381,6209,977,2167,4872,1826,3588,1635,4426,2648,923,4322,2387,1626,2266,4645,1434 ,972,5188,3121,1255,2416,4634,1712,2700,4483,761,2278,1677,4404,3146,1272,4312,24 39,877,6164,2361,1393,2498,5250,1214,3344,4512,1388,2590,952,4367,2382,1678,4375, 2281,1683,495,4254,3232,1359,4433,2603,1504,5139,2822,703,2223,4646,1339,3592,476 8,1245,2171,935,6400,2706,1394,4214,2660,1637,4428,3360,978,2389,4675,1446,2825,5 133,1449,2268,1475,4636,3600,883,4485,2362,1638,4269,2472,1567,2443,4217,762,3264 ,5168,1259,2721,6178,1436,2631,503,4649,2403,1367,4295,3616,1396,4880,2335,925,22 31,4275,1799,2282,5134,1341,3142,4324,1246,2173,878,4434,2605,1450,4408,2708,1477 ,6168,3116,735,2664,4800,1261,2390,4486,1583,2364,5192,1857,3203,4270,993,2289,18 28,4650,2826,1736,4677,3153,885,4489,2611,1858,2393,5377,1685,2500,4379,939,3122, 6180,1832,2445,4218,1803,2451,1641,4544,2255,994,4449,3145,1628,5141,2722,1457,46 57,2606,980,3087,4299,1744,2833,4159,1840,2480,4436,1860,2405,6151,926,3392,5252, 1371,2235,1921,4490,2284,764,4623,2712,1267,4678,3205,1686,4652,2672,1478,2635,42 77,941,3124,5155,1342,2828,6273,1699,2753,4391,967,2174,4381,1642,3095,4328,1922, 2290,1805,4220,2613,886,5378,1400,1452,4301,3206,831,4278,2446,1689,4739,2394,176 0,6210,2504,1591,3456,4658,947,2406,5146,1864,2453,4382,1649,3148,4681,507,2351,4 395,1262,2617,5633,1383,2292,4450,1481,3209,889,4307,2643,1423,6656,2237,1811,449 7,3154,1615,4281,2614,984,5200,2724,1702,4492,2409,1458,4440,3128,751,4682,2754,1 701,4741,2637,1373,3099,6155,1269,2263,5157,942,2834,4689,1482,2695,4631,1690,316 9,4336,1644,2396,4302,996,2467,5145,1387,3111,4191,1151,2454,6184,1215,2512,4423, 971,2728,4660,1806,3331,5142,1431,2849,4896,890,2410,1460,4498,3156,1650,4452,263 8,1595,4403,2457,509,6212,3210,1489,5256,2618,1705,4397,2836,1270,4513,2645,949,4 309,3217,1731,4664,2620,1374,5380,2267,1623,4928,3333,973,6274,2359,1692,4684,275 6,1814,4282,3101,1484,5384,2646,1000,4742,2649,1273,4500,3115,1706,4323,2699,1597 ,4992,2469,892,6163,2840,1435,5158,3170,1827,4690,2850,1813,4514,2659,950,4398,35 87,1733,5634,2650,1389,4745,2458,1464,4867,3160,863,6157,2279,2736,4456,1652,4635 ,3212,1713,5216,2701,1398,4207,2296,759,4427,3102,1447,4310,2417,1490,5187,2238,1 817,6192,2412,1008,4405,3218,1274,4284,2702,1395,4545,2707,1505,5161,3143,510,431 3,2383,1598,4504,2528,3334,6158,1437,2363,4705,1627,4692,2269,979,5264,3337,1390, 4647,2418,1492,4746,2661,1679,4325,3233,953,5148,2470,1924,6216,2473,1829,4255,36 48,1639,4516,2499,4406,2662,763,5189,3117,1708,4637,2591,1734,4869,2283,1453,6401 ,3172,974,4706,2460,1818,5162,2391,1276,4753,2420,4429,1397,3712,4215,2823,1629,5 636,2365,954,7169,3123,1872,4696,2270,1714,4435,2474,4314,1737,3220,5169,879,2501 ,4464,1656,2285,4748,3118,1506,4326,2607,1830,6165,2881,5194,981,3147,4487,1451,2 852,4409,1928,2760,4546,1438,3338,5392,2882,982,4638,2709,6276,1247,3345,4430,168 7,2856,4329,1716,2827,5280,1859,3589,4651,927,4870,2665,3176,4271,1643,2652,6179, 1496,2481,5640,1479,3234,4219,995,4754,2768,1820,4708,2864,1833,5408,3125,2884,64 02,1738,4437,2395,1745,4873,3265,765,4316,2945,1861,5648,2291,4410,3224,1740,4520 ,2710,1888,6170,2502,956,4491,3149,5312,1834,2366,4769,1630,2723,4679,3236,1936,4 451,2666,5664,1746,2946,6657,887,3840,4383,1720,2829,4279,1401,4330,2424,3340,519 0,1459,2476,4221,1841,3346,4653,985,6224,2713,1343,4756,2784,3590,5164,1645,4712, 2615,1836,4438,2888,997,4412,3126,1508,6181,2673,5251,2286,1454,4337,3155,1862,48 74,2407,5201,1691,2505,4659,986,3129,4441,2447,6169,1512,2835,4548,1263,3593,5170 ,1402,4493,2639,3184,4499,1483,2726,4303,943,6166,2482,1646,5193,3207,1651,4770,2 725,2397,4654,1461,5135,3150,1404,4881,2293,4528,891,2506,6280,3361,1842,4453,271 4,5440,1485,3266,4283,1520,2668,4332,1693,4760,2411,3157,6404,998,2175,5253,1703, 4720,2239,1748,4683,3348,2830,5172,1865,4876,3594,766,6408,2455,1653,4801,2484,42 22,3130,1375,5143,2674,4338,1491,2619,4661,1462,3240,5254,2513,6182,511,3211,4494 ,1761,4442,2729,1275,4552,2294,3171,5504,1486,4454,2755,1466,6658,2398,4501,1465, 3158,5196,2647,988,4399,3132,4665,1493,2716,4340,1271,6240,2838,3352,5257,1707,25 08,4691,1866,4285,2297,3161,5202,1001,4662,2730,1762,6211,3362,1923,4772,2621,445 7,2459,1694,5176,3601,4802,1807,2851,4685,951,6185,2837,3596,5147,1873,2757,4311, 1844,4882,3268,2413,4743,1752,5217,2488,1952,6288,3213,4444,1002,2676,4515,3173,5 159,1815,2737,4502,1391,4560,2422,3219,6172,1925,2471,4776,1654,5379,2514,1709,48 97,3248,4458,2841,893,5204,3214,6213,1868,2298,4686,2419,4505,1657,3602,5258,1735 ,4666,2529,3393,6186,1277,4884,2622,975,4693,2461,5265,1715,3103,4668,2651,4315,1 848,3272,6660,1926,5381,2414,2516,4407,1710,4804,3162,894,5149,2703,4694,3617,176 4,6193,2948,4697,1874,2853,5163,3364,4747,1399,2663,4517,1468,7170,3394,2732,4888 ,1494,5218,2758,1009,4898,3604,4707,2477,1507,5635,3335,6218,1439,2842,4698,2300, 4506,1509,3221,5208,1929,4327,2421,3174,4784,1819,6416,2653,955,5260,2896,4749,31 77,4344,1497,2738,5150,1658,6304,3376,2761,4465,1768,4286,3368,1876,4460,2680,526 6,2530,1984,4750,3235,6664,1004,4755,2854,3164,5191,1889,4431,2475,1717,4576,2952 ,6432,3119,1821,5382,2462,4411,1930,3339,4317,2271,5385,1010,6672,2711,1739,4466, 3457,4709,2740,1831,5281,3618,4518,2883,4521,1498,3396,6336,1660,5696,2667,2520,4 547,1718,4710,3280,957,5165,2503,6688,3458,4639,1278,2844,4331,1741,5220,2857,322 2,4508,1599,6214,2762,4439,3225,1937,4468,2769,5760,1822,3237,4871,2885,4413,983, 6188,2764,1835,5171,3178,4318,2912,4522,1403,3127,5268,2858,6275,1721,3400,4549,1 455,4333,2654,5166,2960,1631,4655,3608,6225,1513,2770,4929,3649,5195,958,4900,274 4,3620,4808,1890,6194,2425,5386,1747,2483,4930,3185,4757,1510,5393,2865,3226,6217 ,1932,4904,2367,4875,1742,3151,5637,2669,4713,987,3341,5224,2860,6159,1837,4700,2 532,1500,4529,3180,5282,2478,4816,1880,3650,6464,2886,4912,1863,5173,3296,1749,49 32,2715,4443,2536,6277,1012,3238,5313,2287,4993,1722,4339,3591,1938,5272,2426,619 6,3624,4758,1776,2507,4550,3267,5197,1892,4414,2670,7172,1843,2675,4771,3342,5284 ,1838,4714,2485,3713,4994,999,6167,2428,5888,1463,3595,4877,2866,4472,1953,6278,3 347,2509,5388,1514,4524,2544,5394,3652,4761,1647,2717,6528,1695,4832,3363,5638,27 27,1763,4663,3131,4936,2772,6220,1016,3241,5174,2889,4721,1940,4334,2677,5203,148 7,3632,6281,2399,4455,1867,4553,3186,5177,2515,1405,4495,3349,6226,2486,4883,1521 ,3228,5641,2785,4687,767,5232,3159,6200,1954,2299,4774,3269,4530,1845,5255,2510,6 171,2490,1750,4773,3188,4445,2489,5198,1985,4341,3242,1896,6241,2517,4554,3133,54 09,1516,4762,2295,3603,5314,1655,6183,2731,4716,3597,4459,989,2890,5205,3714,6403 ,1753,4223,2786,4287,2947,1724,5396,3353,4878,1467,6228,2718,5642,3350,1765,4503, 2831,4532,3598,5178,1869,6282,2897,4722,3249,1944,4667,2868,5288,3365,6289,1003,4 561,2776,3460,5259,1406,4777,2976,4342,3163,6405,1846,5219,2839,1875,4803,2415,44 46,3656,7176,1754,5206,2949,3841,4695,1522,5180,2678,4764,3270,6173,1904,4886,273 3,3244,5400,990,4556,2892,6187,3192,4345,1766,5209,2681,3273,4778,1469,5410,2759, 6242,3408,4669,1495,4507,2301,5649,3134,1659,6659,2739,4899,3354,4885,1956,5644,2 872,4805,3215,1711,6232,2950,5316,3175,4461,1927,4536,2734,6284,1005,5261,2788,32 50,4724,1849,5221,2898,4785,3366,6174,1524,4470,2423,5267,3165,1870,4519,2492,629 0,3716,4562,1769,5296,2518,4889,3274,6215,1850,2531,5262,3664,4346,1756,4467,2463 ,5650,3395,6406,1470,4577,2533,3464,5441,959,4670,2953,6409,3369,4509,1986,5151,2 843,4699,3842,6305,1960,2521,5320,3179,4462,1499,4564,2682,5210,3252,6720,1877,47 51,2792,5665,3223,1891,4996,2900,6189,3281,4901,3008,5412,1661,4711,3356,7184,291 3,5442,1931,4780,3720,2741,4806,1011,6244,3166,5652,2845,4525,1511,5383,3276,6784 ,2954,4890,1719,4348,3370,5269,2763,1770,4469,3472,6195,2855,5222,1852,4701,3680, 4944,2522,6292,1777,5225,3424,4786,2684,5424,1878,3397,6190,2742,4809,1881,5416,3 605,4728,2302,6219,1013,4578,3227,5283,2765,4902,1528,6410,3282,5212,2623,3377,45 23,1823,5000,2961,6417,3619,5167,1279,4510,2846,5387,3372,6661,1988,4319,2859,475 9,3181,5505,1933,6248,2427,4788,3256,1743,5666,2745,4931,3606,6306,1501,5444,2479 ,4715,2655,4568,2537,6197,1939,5328,3609,4551,2914,5506,895,6337,3187,4892,2771,4 905,1662,3239,5270,2534,7200,1772,4810,3297,5273,2956,4817,1968,6296,3398,5285,27 66,4933,3378,4812,1893,6221,2861,5226,3844,4960,1515,5175,2524,6308,3229,4906,172 3,5448,2904,4702,3728,6912,1778,5008,2887,3401,5656,1882,4818,2773,6412,3182,5697 ,2746,4792,1006,5668,3189,6418,2962,4473,1502,4531,3284,5233,2800,6662,1992,4913, 3243,5274,2916,4415,3848,6198,1407,5199,2867,4717,3402,5389,1934,6227,2862,4908,3 298,4580,1839,5228,2487,6201,3621,4526,2000,5698,2977,4934,3610,6665,2538,5344,18 94,4763,3459,7171,2671,4584,1941,5286,3380,4335,2719,6256,1014,5639,3288,4474,278 7,5672,3488,6279,1751,4555,2964,5315,3343,4718,1517,6222,2511,4723,3351,5390,2891 ,1897,4533,6433,3230,5761,2429,4476,1725,6338,3409,5643,2545,4914,1955,5395,3622, 6229,2978,4557,3744,4592,1780,5700,2869,6420,3190,4765,1884,5411,2774,6666,3404,4 775,1523,5179,3651,4820,3009,6202,3612,5289,1755,4937,2920,4725,3461,6312,1017,56 80,2540,4447,3245,5234,2679,7173,1847,4563,3193,5397,2777,6283,1946,4534,3625,527 6,2748,4833,3271,6243,1898,5207,2491,4347,3856,5317,1942,6230,2789,4558,3251,4538 ,2893,6204,1526,5236,3300,4537,2968,5290,1957,6424,4565,3410,5181,2430,6233,3384, 4343,1767,5651,2870,4779,3776,6434,1784,5645,3462,4938,2899,5762,3246,6673,1905,4 834,2778,4995,3626,6668,1018,5401,2546,4766,3653,5398,2928,6340,1518,4879,3465,27 90,1726,5646,3355,7232,2493,4945,3194,5297,1945,4916,2519,6285,3520,5413,1525,482 4,3425,6245,2683,5508,3633,5024,1900,5211,2980,6291,3275,4887,2735,4463,1871,6320 ,3135,5704,2951,4997,2016,3412,5889,2873,6286,3466,4726,1471,5318,2548,6674,3599, 4781,1757,5292,3654,4940,2894,6465,3628,5240,1851,4729,2793,6175,3253,5321,2874,4 807,991,5456,3367,6344,2780,4349,1958,5182,3357,7177,2494,4787,3304,5402,1906,492 0,3196,6234,3010,5263,3277,4998,1961,6689,2984,5223,3254,4782,2523,4836,1987,6436 ,3715,5298,2901,4946,1771,6466,3634,5414,2915,4471,3358,6676,1529,5213,3657,4540, 2685,5764,3371,6407,1879,4566,2955,5322,3426,6293,2535,4579,1948,5712,3283,4511,2 743,6246,1758,5443,3473,4581,3257,6249,2794,5512,1853,5001,3468,7174,2876,5417,34 16,4891,1020,5890,2801,6448,3658,4569,2902,5227,1989,6440,3717,4730,3665,5300,196 2,6307,2905,4840,3607,5271,2552,4948,1908,6236,3312,5329,2847,5056,3278,6191,1530 ,5404,3167,4961,2303,6411,3399,5768,1773,4789,3012,6529,3636,5214,2957,4893,1969, 5324,3872,6690,2767,5002,3474,5418,1990,6468,3428,4811,2525,5520,3379,7185,1779,4 903,2963,5728,3373,4570,2686,6352,5472,1883,4732,3489,6530,3285,5445,2796,4790,19 64,6294,3640,5653,2992,4350,3904,6297,1854,5275,2917,4813,3660,6309,3258,5330,193 5,4671,2539,5425,3718,6250,2747,5009,1007,5667,3476,6199,4894,3299,5420,2802,7178 ,1895,4907,3968,5229,2906,6472,3666,4475,1663,5304,2526,6680,3490,4793,3374,5654, 1912,4527,3016,6721,3721,4703,2431,4585,6692,1503,5657,3843,4962,2958,6257,3432,5 235,1970,4819,3611,6298,2863,5287,3183,4582,1774,6223,3024,5345,3403,5004,3286,64 13,5446,1993,4814,2918,5426,3381,7186,2965,4909,1532,5892,3260,6252,3521,4572,277 5,5277,1885,6722,3289,4952,5776,2541,6368,3480,4935,1781,5449,2921,6310,3681,4821 ,3668,5230,1994,6663,2749,4794,3623,5237,6696,2979,5010,3722,5332,1943,6339,3301, 4848,2804,5291,3231,7296,1015,4964,2908,5896,3492,6414,4915,3382,5450,1899,6785,2 547,4910,3613,5346,2779,4535,1886,6667,3845,5669,5025,3682,6419,2871,5658,3729,45 86,1782,6724,2970,5507,3405,4719,3191,6435,1972,5428,4767,2922,6203,3672,5336,296 6,4835,2001,7180,3411,5536,3290,5012,2550,6313,5391,1947,4559,3440,6704,2981,5399 ,3724,4939,3302,6258,1996,5278,4477,2791,6421,3463,5457,3385,4593,1785,6300,2808, 5670,3522,5026,6231,2929,5792,1901,4917,3614,6341,3406,5238,2542,4822,3305,7201,5 452,1976,5699,2750,6260,3627,5057,3846,6314,1519,5660,2969,4968,6205,3247,5509,25 49,4588,3195,6675,1727,5293,3730,4727,6669,2924,5241,3684,4825,1959,6786,3413,567 3,2895,4796,3849,6425,5319,3040,4539,2002,7233,3292,5904,3386,4837,2495,6422,5299 ,1019,4941,3496,6670,3467,5348,2781,5016,6321,3745,5458,1907,4478,2875,6437,3655, 5432,3427,4918,6532,1786,5824,2982,6235,3359,5510,3255,4947,2930,7188,5294,1527,4 826,3306,6728,2985,5674,3197,4594,6913,1949,5701,3629,4976,3011,6342,3732,5513,36 88,4838,6316,1902,5403,2795,4541,3414,6264,2553,5242,6345,3388,4567,1759,5568,331 3,6480,2903,5473,4731,3850,7424,2017,5681,3635,5028,2972,6206,5323,3417,4783,2782 ,6426,1909,5183,3524,4999,6287,3469,5460,2877,6247,3475,4921,1963,5514,6322,3279, 4596,3013,5647,3746,6438,2018,5702,4942,3630,7202,2986,5676,3857,4841,3504,6237,5 301,2004,6788,2932,4922,3429,5415,6346,2554,4828,3259,5405,1950,6736,3308,4542,53 52,2797,6467,3736,5244,3696,7192,5058,1788,5325,2993,6536,3659,5032,3852,5302,644 1,3014,4571,1965,5763,3777,6914,4949,3198,6251,2803,5682,3314,4963,1991,6324,5406 ,2907,5705,3637,6295,3470,4733,5419,2988,7204,1021,5003,3418,6353,5474,3528,4583, 2878,6428,1910,5331,4791,3430,6792,3477,5521,2959,6238,3375,5305,4842,1855,6348,3 641,5516,2919,4924,6442,3316,5464,3667,7175,1971,4849,5706,2687,6544,3261,4950,36 38,5765,6752,2936,5713,1531,6496,3748,4953,5655,3433,6469,2527,4600,3778,5360,667 7,1913,4895,3661,7297,2994,5326,5215,3287,6299,2798,4351,5447,3858,6354,2008,5060 ,3719,6449,5684,3017,5005,3420,6691,3491,5920,4815,1775,6444,2556,5522,3478,7234, 5476,3536,4573,2909,6253,5427,1966,5011,3752,6328,3873,5421,6678,2805,4734,3434,5 537,2020,6681,5333,3662,6259,3018,4844,5688,3481,6311,3642,5040,1995,5952,7680,29 67,4965,3860,6369,3669,5708,5306,3644,6470,2923,4587,6450,1914,5766,3291,4795,338 3,6916,5524,2910,5347,3780,6301,4850,1533,7179,3670,6016,2806,4954,6800,3673,5714 ,3723,6473,4574,1973,5538,2996,6254,5422,3493,5064,3864,6261,3025,5769,6356,3874, 4479,1997,5891,7208,3683,5006,2971,6315,3674,5480,5659,3482,6920,2024,4911,6474,3 020,5231,3303,5072,6370,3760,5451,2809,6693,5334,1916,4966,3725,7236,3320,5429,66 82,2925,5013,3441,5308,6531,3262,5569,1974,6452,4823,3436,5337,3000,6360,4589,372 6,7298,3731,5528,4969,1887,6560,2543,5729,3407,6415,5716,3552,4797,2751,6423,5671 ,3387,6302,1783,5027,5770,3293,6481,2983,5349,7187,3442,4852,3685,5279,6694,3026, 4956,1022,6816,5540,3494,5430,3497,6262,4595,3523,6476,2931,5661,4827,2032,6723,3 686,5893,7181,3615,5730,2810,4919,6684,3307,5777,3484,6533,5018,1534,5453,2551,63 17,5239,3415,6265,3444,4970,5720,2973,7216,3847,5014,6697,2003,5459,3389,6343,533 8,3294,4598,2926,6928,5488,3498,6323,3525,5029,5772,1977,7182,2783,5350,6372,3309 ,4839,3631,5511,6482,3905,5433,1787,6456,4856,3041,6848,5570,3876,4977,3784,6534, 5662,2933,7240,3906,5454,4590,1998,6318,3733,5353,6698,2987,4798,3880,6725,5675,3 851,5894,6537,3689,5017,1978,7425,5295,3042,4597,3676,6427,5243,3505,6266,3028,57 78,6592,3792,4972,1903,5732,6497,3888,5461,7189,3908,4943,2974,5897,6705,3419,508 8,3969,634 7,5340,2005,6207,5434,2812,4543,3315,6484,5544,3 734,7300,3526,5515,6538 ,2989,4829,5793,2006,6671,3390,4923,6726,3747,5703,3015,6700,5475,3690,5030,6325, 3970,5407,1951,7203,5303,3853,6439,2934,4978,5354,3448,6429,5033,3500,6376,2879,5 245,6268,3737,5677,2019,5059,7426,3808,5780,6349,3639,5736,2995,6326,4843,3912,54 62,6787,3697,4601,1789,6706,5436,2555,7194,5361,3310,4951,3431,6430,5898,3529,672 9,5683,2937,6443,1980,5020,7681,3471,5465,4830,3859,6498,3663,5572,6355,3032,5517 ,6545,3750,4925,3506,5523,6329,1911,5327,7248,2799,5061,3749,6540,5794,3421,6488, 5678,3317,5034,2990,6730,5905,2009,6789,5552,3530,7205,3738,4980,5477,3692,6737,4 602,3044,6679,3435,5307,6384,3199,5356,6350,2021,4845,3263,5784,7193,3019,5744,62 39,3854,5041,6471,3479,5707,2938,6708,5900,2010,5062,7190,3508,5825,3698,6944,524 6,3643,6546,4851,2557,6500,5362,3537,4955,3753,6451,5685,1967,7304,5518,3318,6445 ,5036,2997,6561,3779,5466,6357,3422,5576,4926,3671,6712,5478,3021,7428,1915,5525, 6976,3740,5007,6732,3862,5423,5689,3532,6330,3048,4967,7432,3321,5364,6790,3754,5 715,6548,2022,4735,3645,6371,5309,2940,5686,7040,3483,4984,7206,3875,5796,6738,38 61,5481,1790,6562,4575,2998,6446,5826,3781,7682,5709,3437,5042,3512,6793,5335,291 1,6915,4846,3700,6504,5906,1535,6683,5767,3761,7264,3446,5065,6255,2807,5468,5539 ,3495,6475,4604,3538,6358,5526,3865,7235,5584,3056,6453,1023,4957,6332,3322,5800, 6593,3443,5921,4853,3553,7209,5482,2558,6361,5710,3646,6552,3485,5066,6753,2012,5 529,6740,3675,5690,7312,3027,50 15,6695,343 8,5908,5717,3 540,6794,3 727,5692,63 73,30 01,4971,7196,2025,5339,6303,3972,5431,6564,3877,4958,6454,3687,5828,7237,2811,571 8,6685,3756,4854,3782,5721,6917,1975,5771,6754,3501,5044,7210,3022,5541,6801,3866 ,5912,6477,3324,5073,6263,3445,5922,7684,3677,5731,6744,3002,5019,6483,2026,5722, 3920,6362,5530,3762,5068,7217,3785,5351,6512,2927,5808,6796,3704,4857,6374,3554,5 773,7242,1917,5368,6535,3878,4973,6457,3029,5489,6594,3499,5310,7440,3976,5484,66 86,3486,5048,6478,3030,5774,6377,3295,5779,1999,4591,7328,3735,5455,6699,3764,560 0,6918,3907,4799,6319,2975,5435,7688,3691,5341,6267,3544,5031,6802,3527,5490,6756 ,1918,5733,7456,3043,5074,6485,3868,5542,6921,3881,5545,6364,3786,5571,7696,3793, 4979,6458,2813,5734,6568,3909,5663,6539,2033,4858,7360,3788,5355,6817,3936,5532,6 727,3004,4599,6499,3882,5463,7712,3678,5492,6431,3984,5021,6327,3794,5895,6378,19 79,5437,7238,2935,5342,6269,3768,4974,6701,3449,5546,6804,5573,3507,7212,4831,388 9,6760,5357,3033,6486,5679,3391,6460,5953,2028,7299,5089,3693,6385,5924,3884,6922 ,5832,3045,7249,4981,3556,6707,5954,3502,6489,5781,3910,6596,5035,3739,7218,5928, 2034,6541,5899,3034,6547,5737,6351,3560,5090,7241,3311,5724,6818,3450,5553,6702,3 531,5076,7183,2991,5840,6929,3694,5936,6576,1981,5956,6501,3699,5022,7488,3509,54 67,6331,6017,3452,6380,4860,2939,6808,5363,3890,7301,5782,3533,6768,5574,3568,673 1,5037,3741,7220,5438,2007,6924,5795,6849,3046,5063,6270,3751,5738,7191,3796,6018 ,6386,3913,5901,6709,2814,4982,5496,3701,5548,7302,4927,3423,6542,5785,3539,6490, 5856,1982,6600,5687,3510,7552,5043,2559,6502,5960,6549,3809,5745,7244,3323,4603,6 447,3534,5358,6713,3514,5479,6388,3513,5577,7305,4985,2011,6739,5519,3036,6333,59 07,3541,7250,5711,3319,6710,5080,3755,6820,5798,6505,3914,5554,7224,3049,4847,685 0,3810,5797,6733,3971,5469,7195,5365,3742,6359,5038,2036,6930,5578,3855,6791,5786 ,2999,7265,5740,6492,3921,5092,6563,3892,5483,7207,3800,5247,6550,5311,4000,6608, 5067,3050,6824,5902,3863,7427,5527,2023,6945,4986,6506,3439,5556,7252,3973,5746,6 734,3702,5691,6553,4605,3757,7306,5585,2941,6714,5801,3916,6932,5366,6741,3705,50 45,7313,3783,5827,6716,2040,5470,6363,5719,3325,7429,5069,3023,6455,5788,3763,685 2,5910,7197,3896,5580,6742,3974,5096,6745,5369,3758,7211,5802,2942,6795,5693,3812 ,6565,4988,6936,3922,5531,7266,1791,5923,6946,3447,5909,6755,5046,3516,7683,5829, 3542,6746,5485,6554,3057,5560,7256,3555,4959,6375,3487,6832,5748,7308,3557,5809,6 797,3977,5494,6392,4855,3867,7198,5543,2013,6513,5586,6334,3003,5913,6508,3545,51 04,7314,3706,5370,6798,5491,3816,6803,5601,3924,7239,4606,6479,4032,5694,6624,305 2,7430,5533,6459,3937,5723,6365,3765,5075,7433,5486,2027,6514,5588,3869,6757,5775 ,7329,3978,5049,6566,3058,6020,6569,5925,3787,7744,5735,3879,6595,6758,4859,3546, 7213,5804,3708,6687,5830,6379,3766,5549,7268,3005,5070,6556,5914,2014,6487,5372,3 326,6516,5493,7808,3789,6919,5725,6461,3647,5050,7219,3985,5968,6366,5810,3870,65 70,5833,3031,7316,4975,6597,3883,5752,6381,3451,7214,5602,6703,3769,5926,6977,507 7,3503,7243,5547,2029,6948,6024,6856,3679,5534,7434,3561,6978,5078,6805,3006,5343 ,7441,5783,3938,6952,5812,3795,6923,5955,7685,3558,5023,6761,3980,7272,5739,6748, 3790,5592,6577,5575,3035,7330,5091,3885,6864,5916,6960,1983,5929,7221,6980,3548,5 834,6491,3928,5841,7361,4861,3911,7041,5957,6387,3797,7320,5836,3060,6806,5984,65 98,3770,5052,7245,5930,3986,6462,5726,6819,3824,7332,6032,3940,6762,5842,7042,389 1,4983,7936,5816,2035,6925,5497,3886,6520,7436,5555,3047,6572,5937,7442,3511,5081 ,6809,5439,4001,6880,7686,5741,3562,6711,5932,3695,6984,5093,7222,3743,5604,6769, 6382,3811,5550,7251,5958,3064,6503,5787,3988,6601,5082,7225,3535,6543,5608,6931,2 037,5359,7689,5498,3915,6735,7280,5579,3453,6822,5039,3569,6578,5742,7303,2815,57 47,6821,6493,4002,5557,7246,5500,3893,6389,4987,6602,3798,7457,5938,6810,4033,558 1,7362,5616,3944,6764,5789,3564,6507,7253,5094,3703,6271,5799,6335,1919,5844,7444 ,6926,3037,5961,7690,4862,3801,6551,5749,6580,3772,7226,5471,6770,3515,5587,6715, 5558,3813,7336,6609,4607,3917,7307,5857,6825,3992,5371,6390,7267,3051,5582,6851,5 562,3454,6494,5561,7254,3894,6743,5084,7228,3923,5589,6812,5367,3802,6934,7448,58 03,2030,6604,5962,6393,3570,7257,5097,6826,3952,5858,7458,6019,3038,6717,6555,579 0,3814,7697,5903,6947,3517,5047,6933,7692,3543,5969,6853,5940,3707,7364,6509,5848 ,4004,6584,6048,7309,3759,5098,6772,7269,3975,5911,6833,5487,3053,6518,7315,6021, 3897,6567,5750,6610,2038,5805,7344,6937,3572,4989,7310,5964,3918,6394,6515,5753,3 817,7698,5831,6625,7489,3898,5373,6718,5071,3804,6557,5811,7199,3518,6747,5944,73 68,3007,6022,6510,6612,4034,5806,7258,4990,4008,6799,7713,5860,3547,7044,5970,694 9,7460,3925,5495,6759,5564,3939,7490,6828,5590,2041,6854,5105,7700,3709,6573,5603 ,7431,5535,3979,6938,6396,5605,3059,7317,6025,6517,3559,7270,5915,6749,3767,5051, 6992,7273,5593,3818,6834,5754,7472,3900,6857,5864,7464,3825,5972,6776,6626,3926,6 080,7331,5100,6950,3929,7260,5985,6571,3061,5813,7048,7215,3576,5917,6558,6026,74 35,3871,6367,5106,6807,3327,5835,7553,6836,2042,5927,7714,6979,5594,4036,7492,575 6,6763,3981,6616,5814,7376,3791,5053,6599,7554,5374,3549,6940,5837,6953,3987,7318 ,5695,6858,7321,2943,6033,6865,5918,3710,7333,6981,5079,3820,6860,5931,7274,7008, 4016,5499,7223,6954,3941,5817,7496,5551,6750,3563,7056,5727,7704,3771,5609,6866,7 745,5054,3826,6840,7716,5986,3930,6521,5843,6579,7281,2015,5606,6961,7322,3054,60 28,6463, 5 83 8,7247,3 5 50,6765, 5083,7437,4040,6956, 5933,6628, 5 596,345 5,7276,6574, 597 6,7746,3982,6982,5959,7392,3887,5845,6811,6632,5108,4048,7334,6383,5818,3942,7687 ,6034,6522,7720,3989,5872,6603,7363,5988,3062,6766,5939,6771,3799,7438,5934,6581, 7809,3565,5095,6524,5559,3945,7691,6962,6049,7443,3773,6605,5610,6640,7748,4003,5 743,6813,5791,7459,2044,6823,5859,7227,3828,6868,5112,7337,6985,3932,6036,6773,55 83,7728,3571,6495,5963,7282,3803,6611,5501,7445,6582,3065,5617,7324,6881,4863,389 5,7255,6050,6395,7365,3994,5941,6606,6586,5846,3946,7284,6585,6081,3990,7338,5992 ,6613,7229,3574,5612,6391,7699,5751,4005,6827,7693,5085,6986,3815,7810,5849,6882, 7043,3832,5820,7449,5563,6814,3953,7446,5861,6927,7694,3066,5965,6993,7345,6040,3 566,6964,7461,5099,2031,6872,7556,5502,7072,3774,7259,5942,6935,5971,3993,6511,77 52,5850,7045,3573,7937,5618,6774,7366,3948,6000,6829,7340,5086,3919,6988,7288,586 2,6777,4064,7369,5565,6855,7504,3519,5591,6397,7230,5755,3805,6835,7450,6052,6968 ,3899,7311,5807,7046,7271,6023,3039,6830,5101,6884,7346,4006,5945,6994,7462,5620, 3954,6519,7261,5966,6588,4009,7812,5865,6614,7370,4035,5946,6627,7760,5852,3819,6 559,7491,5566,6629,3577,7560,5055,7049,7465,6082,3927,6939,7938,6056,6617,2039,72 75,5595,6778,7348,3996,5973,6888,7319,5987,3806,6996,7377,7104,5757,7452,3901,700 9,6027,7816,6837,3068,5107,7262,6941,5607,4037,7372,7050,5815,7466,6859,4010,5866 ,7568,6951,5948,3956,7776,6618,5873,7520,3578,6780,5974,7493,6838,5977,3821,7701, 6398,5109,7323,4017,6861,5624,7378,6719,4038,7473,5919,7057,7715,5375,3827,6942,7 468,6084,6955,3931,7277,6029,6523,7352,5839,4012,6841,7702,5597,6575,3902,6751,66 33,6035,7705,7010,3983,4991,7283,6867,5758,3055,7335,6630,5868,7393,7052,3943,606 4,7494,6862,7474,3711,5989,6957,7940,5611,6620,3960,7325,5819,7000,7824,5874,2043 ,6983,7497,5978,6869,3551,7278,6842,5102,7285,7058,4018,5598,7380,6896,6088,7339, 3822,7012,7944,5503,6963,4041,7498,6030,6958,7394,5935,3580,6583,7717,6096,7073,7 706,3933,6634,5990,7555,6767,6037,3829,7476,6815,5110,7384,6883,4042,7584,5847,70 60,7439,3991,5613,6607,7447,6987,5993,3063,7326,6525,5821,7505,6641,3947,6051,771 8,7074,7840,5876,3934,6965,7286,5980,6870,7500,3830,5619,7747,7105,7708,5851,4020 ,7016,7557,5113,6636,7341,4049,6775,5943,7289,6873,6042,3995,7721,6844,7367,5994, 6587,4044,7952,6038,6885,7347,6989,3833,5622,7396,7064,6053,7506,3949,6526,7480,5 863,6966,7872,4024,5880,7558,6995,7342,6001,3567,6874,7722,5114,6642,7749,2045,70 24,5614,7561,6886,5822,7451,3775,6589,7290,6041,6615,7616,4007,5621,7521,6779,772 9,5996,4050,7076,7371,6831,5967,7231,3067,7047,6112,7508,6969,7562,5567,3955,6644 ,7695,5853,7750,6990,3834,7724,5947,6889,7349,6970,5087,3575,7463,6876,6054,7453, 6590,3997,7400,6002,7292,7106,7373,3950,6057,7080,7350,6619,6083,7811,3807,6997,5 867,7730,7011,7454,4065,5625,7753,6781,7467,5975,7051,3957,7522,6631,6044,7379,68 39,4011,5854,7569,7353,6890,5949,7564,4066,6972,7512,5116,6897,7754,6998,4052,608 5,7813,7761,6058,7001,3998,7703,6648,6004,7408,6943,7374,3836,5626,7263,6399,7495 ,5869,7108,4013,7732,7053,6065,7968,6863,7570,4039,6086,7524,6621,7475,5875,7059, 3069,7469,6782,5979,7585,7381,3958,6892,6060,7736,7088,8000,5950,3903,7013,7756,7 354,6031,6635,7814,4019,6843,5103,7572,7395,6898,5991,3579,8064,7002,7762,5759,66 22,7586,3961,7470,6008,7112,7817,6527,5599,7939,2046,7054,7528,6066,7707,6959,727 9,4056,5870,7120,7499,7382,6089,7014,3823,7477,7061,5628,7356,7617,6871,4014,5981 ,7385,6637,7576,5877,7017,4068,7777,7764,6090,6845,7719,7075,7818,4043,6039,7397, 6900,7327,5111,7004,3962,7588,7478,5995,6643,7709,6875,3581,5982,7941,7778,6967,7 825,5878,7066,4021,7501,7287,6068,7018,7768,7062,4045,6097,7507,7386,6646,6043,75 36,7077,4072,7820,7398,6092,6887,7559,7481,5881,3964,6904,7618,7025,5997,7710,750 2,4022,6638,7401,6072,6846,7723,7942,5615,3935,7065,7343,6645,7291,5823,7826,7020 ,3831,7780,6055,7509,6991,7945,7136,6098,3070,7388,7482,6591,5115,7592,7563,6877, 4080,7841,6003,6971,7751,7523,5882,7078,3582,7455,7351,7026,5623,7402,7081,7293,4 051,6045,7725,7107,7828,7784,5998,6891,4025,7510,6649,7484,5855,7409,6999,7946,38 35,6113,7731,7068,7513,6878,6005,7620,4046,7565,6973,7571,6059,7375,7109,7842,402 6,6114,7726,7082,7953,7600,6100,7028, 7525,3951,6650, 7355,6046, 7404,6893, 7832, 7792 ,4053,5884,7089,7755,7948,7110,6061,7873,7294,4054,6899,7410,6087,7003,7733,7566, 7084,3999,5117,7514,7624,6974,6006,7526,7573,7055,4067,7471,5951,7737,7015,7412,7 763,6067,6783,3837,7357,7734,7032,5627,7844,7529,6623,4028,7874,6009,7757,7090,73 83,6894,7954,6104,3959,7815,7113,7516,7587,5871,6652,7574,7632,4057,7005,6062,784 8,7969,6901,7530,6116,7758,7114,4069,7577, 7738,6091, 7063, 7956, 7765, 7740, 7019,2047 ,6010,7387,7479,7006,7876,5629,7766,6902,4058,7769,7819,6069,7092,7589,7960,7121, 7970,4015,6093,7779,7067,7770,7578,6120,7116,7399,7856,3963,6905,6012,7821,7416,7 021,7537,7358,6070,4070,7532,7096,7822,7827,5983,6639,7503,7648,6847,3838,7483,58 79,7389,7079,7538,7781,7122,5118,7590,3583,7593,7619,7027,6128,7782,7711,6906,740 3,7580,3071,5630,6647,7511,7540,7069,7943,6099,7485,7390,4060,7022,7594,7621,6073 ,6879,7405,7727,8001,5883,4073,7137,7972,7880,7029,8002,6094,7829,7083,7976,4023, 7947,7785,6074,7138,7772,7601,7124,7888,5999,7984,4074,8004,7070,7515,8065,6101,6 908,7411,7830,7622,7085,3965,6102,7486,7843,7111,7786,8066,6047,7949,7030,4047,75 44,7596,6975,7833,6115,7904,7735,7091,8008,7793,3966,5885,6651,7406,7527,7625,703 3,6076,7567,7955,7759,4081,7128,7846,7602,6007,6895,7845,7517,7413,7086,6105,4027 ,7626,7834,7788,7140,7531,7295,6117,7359,7115,7950,7575,4076,7034,6106,7604,7794, 7739,6653,7633,7849,6063,7414,4082,7093,7875,7518,7767,7117,6011,7836,7958,7628,7 144,7417,4029,7850,6118,7741,7036,7579,7971,7957,5886,7094,7877,7533,4055,7608,70 07,7796,5631,7857,7542,6903,7591,7634,7961,7152,4030,5119,7418,7539,7649,6654,774 2,7581,6108,7771,7123,7534,7636,4059,7823,7097,6121,8068,7973,7783,6907,7852,7878 ,6071,7597,7118,4084,7962,7420,7541,7773,7098,6122,8016,7858,7881,7023,7800,4071, 7650,6013,7974,7125,7595,8072,7582,7126,7391,6095,7831,7860,8003,4088,7071,7787,7 640,7623,6014,7139,7964,7977,7882,7889,6909,8005,3839,6129,7884,8032,7100,7978,77 74,8080,7890,6075,7031,7864,7545,7603,4061,7985,7129,7487,6124,7789,7980,7141,765 2,7598,8006,7835,6130,7130,4075,7656,7407,7546,7627,7087,7790,6077,7795,7605,7548 ,7035,7986,7629,7664,4062,7837,6103,7142,7847,7892,8009,6910,7797,7519,7635,6078, 7606,6655,4077,7905,7419,7630,7610,7609,6107,7132,7637,7415,7851,8010,7145,7906,8 067,7838,4031,6132,7951,7095,8017,7988,7896,8096,7146,7959,6119,7535,8069,7798,78 53,7037,4083,8012,7801,7879,6136,7421,7119,7859,7992,8070,7854,7038,7908,8018,588 7,7543,4085,7612,7638,7153,7651,7583,7653,8073,7963,6109,7099,7641,7802,7912,8020 ,8128,7148,3967,8033,7861,6123,7965,8074,7154,7883,7975,7642,7804,7862,7101,6110, 7422,7885,7743,4078,8081,7966,7127,7979,7547,7865,7599,6125,7775,7657,7102,8034,7 891,7654,8076,7886,7131,4086,7981,6079,7644,8024,8007,7893,7156,7866,8082,7920,80 36,7987,6131,7982,7143,7607,8097,7658,4089,7791,7839,7907,7160,8084,7631,6133,801 1,7549,7665,6911,8098,7989,7894,8129,8040,7660,7799,6015,4090,7133,7897,7868,7611 ,7909,8013,8088,7147,7550,7990,8019,7898,6126,7666,8048,7134,7910,7613,7639,7803, 4063,8100,7855,8071,7149,7993,6134,7668,8014,7913,7994,7900,7614,7103,8130,8104,7 643,8021,8035,6137,7805,4092,8075,7155,7655,7863,7914,7996,7921,8022,8025,7157,76 72,7967,7423,6138,8132,8077,7887,7645,8083,7039,7806,7916,8112,4079,8037,7659,786 7,7922,8026,6111,7150,7646,8136,7551,8078,7983,8144,8038,8085,7158,7895,7661,8041 ,7869,8099,6140,7924,8028,4087,7667,7899,7161,7991,8090,8042,8086,7670,8101,7911, 7928,8049,7162,7662,6127,7870,8089,7669,8044,8015,8160,7615,7901,7995,7135,8102,4 091,8050,8105,8131,7915,7673,8023,6135,8092,7902,7997,7164,8133,8106,8052,7674,79 17,8113,8134,7923,8027,8108,7998,8079,7151,8039,7807,8056,6139,7647,8114,4093,791 8,8137,7676,8029,7925,8138,8087,7159,8043,8030,7926,8116,8145,8091,8140,7929,8045 ,8120,7663,6141,7871,8103,8146,7163,8051,7930,7671,8093,8046,7903,8161,8053,8107, 4094,8162,8148,8094,7932,8109,8135,7165,8054,7999,8115,7675,8057,6142,8152,7919,8 110, 8164, 813 9, 805 8,7677, 8117, 8141, 8168, 8060, 8118, 8031,7927,7166, 8176,7678, 8147, 81 21,7931,8142,8122,8047,8149,8150,8095,4095,8163,7933,8124,8055,8153,8165,6143,815 4,8111,8059,8166,7934,7679,7167,8156,8169,8119,8170,8061,8143,8062,8177,8123,8172 ,8178,8125,8151,8126,8155,8180,8167,8184,7935,8157,8171,8158,8173,8127,8179,8181, 8063,8174,8182,8185,8186,8159,8188,8175,8183,8187,8189,8190,8191];
where the sequence Q2 is given by
[0,1,2,4,8,16,32,3,5,64,1024,2048,9,6,17,10,18,128,12,33,65,20,256,34,24,36,7,129,6 6,512,11,40,68,130,19,13,48,14,72,257,1025,21,132,35,258,26,2049,513,80,37,25,22,136, 260,264,38,514,96,67,41,144,28,69,42,516,49,1026,74,272,160,520,288,528,192,544,70,4 4,131,81,2050,50,73,15,320,133,52,1028,23,134,384,76,137,82,56,27,97,39,259,84,138,14 5,261,1032,29,43,2052,98,515,88,140,30,146,71,262,265,161,576,45,1040,100,640,51,148 ,46,75,266,273,517,2056,104,162,53,193,1056,152,77,164,768,268,274,518,54,83,57,521, 1027,112,135,2064,78,289,194,85,276,522,58,168,1029,139,99,86,60,280,89,290,529,208 0,524,196,1088,141,101,147,176,142,530,321,31,200,1033,90,545,292,2051,322,532,263, 149,102,105,1030,304,296,163,92,47,267,385,546,2053,324,1041,208,386,150,153,165,10 6,55,1034,328,536,577,548,2112,113,154,79,269,1042,108,578,224,166,519,552,195,1152 ,270,3072,641,523,275,580,291,59,1036,169,560,114,277,156,2057,87,197,1057,116,170, 61,531,525,642,281,1089,278,526,2054,177,293,388,91,1044,584,769,198,172,120,201,20 65,336,1280,62,282,143,103,178,294,1058,93,644,2058,202,592,323,1048,392,297,770,10 7,180,151,1060,2066,209,284,648,94,204,298,1031,400,608,352,2176,325,533,1153,155,2 10,305,547,300,1090,109,2060,184,534,537,115,167,1536,225,326,306,772,2081,157,103 5,656,329,110,117,212,1064,171,2113,776,330,226,549,1092,538,387,308,216,2068,1154, 416,271,279,158,337,1043,550,672,2304,118,332,579,1037,540,389,173,121,1072,2082,5 53,199,784,179,1038,228,338,312,2072,704,390,1096,174,554,581,393,1281,283,2084,12 2,448,353,1045,561,203,63,340,2055,1156,394,527,582,556,181,1059,2177,295,285,232,1 24,1282,205,182,643,2114,562,1050,286,585,299,1537,354,211,2560,401,185,1104,396,3 44,586,645,2059,1061,593,535,240,206,1049,95,2088,327,564,1046,800,402,356,307,211 6,1160,301,417,213,568,1284,832,2178,588,186,1288,646,404,227,896,2067,1062,594,41 8,302,1538,649,771,2061,360,539,1120,111,331,214,1091,2096,309,188,449,1065,217,40 8,2062,609,596,1168,551,650,229,1052,2120,159,420,310,1093,541,773,2305,610,1066,6 57,333,119,1540,3073,600,339,218,1073,368,652,230,2069,1098,391,313,450,1296,542,2 180,334,233,1184,555,774,175,2083,1544,123,658,612,1312,2306,341,777,220,1552,314, 424,2074,395,1216,673,583,355,1568,2561,287,183,234,1094,125,557,2128,660,1068,616 ,342,316,2085,1155,241,778,1105,563,345,2073,452,1074,397,403,207,2070,1097,674,55 8,1039,785,432,2184,357,1344,187,236,664,2308,1157,624,587,1076,780,2312,705,126,1 047,242,565,1158,2086,398,346,456,1408,358,2562,405,1100,303,569,244,2144,1161,595 ,189,1106,566,2115,676,361,1080,706,589,2089,1051,215,786,647,1121,2192,348,419,10 63,406,464,2076,680,1283,801,362,1108,2117,590,409,1162,570,2090,788,597,1169,572,2 19,2564,1285,311,708,1053,598,2097,601,1067,651,421,3074,792,1122,802,611,1539,212 2,602,410,1112,231,688,2320, 1164,653,248, 1054,2208,369, 190,364, 1170,654,2568,659, 10 95,335,480,2336,1286,315,221,1289,2576,370,613,1185,422,425,2240,1600,451,614,1069 ,2592,543,235,1124,412,2118,343,372,1664,775,317,2092,1075,222,426,1172,2179,453,2 37,1070,559,2129,833,1099,804,712,2098,1290,834,661,1297,2121,808,779,1541,617,112 8,2063,604,433,1186,720,2368,816,1077,836,347,2181,1217,897,243,1176,2100,662,454, 1101,318,3076,675,1188,618,898,2071,1792,781,376,2182,1292,428,1298,665,2432,736,1 542,567,840,2124,1078,625,238,1107,2185,359,457,1081,399,2130,787,1545,591,1136,21 04,678,434,1159,2075,677,349,1102,245,2145,458,1313,666,1218,2087,620,363,1109,230 7,127,191,1300,782,2132,1546,407,436,1082,2186,626,571,1192,2193,465,1163,681,246, 2309,1123,707,350,3080,1110,599,1084,668,2077,790,1304,460,2091,249,1113,682,1314, 2146,573,411,1553,2563,803,789,1548,709,2136,1220,365,440,2188,1165,628,1125,689,2 078,374,1171,423,2194,466,1200,793,2119,1166,250,371,1554,2310,481,1345,574,2313,4 13,1055,603,2209,1224,366,468,1114,2624,655,1569,900,2093,805,1316,615,3088,1346,6 84,710,2148,1556,429,1287,2688,794,252, 1173,373,2099, 1126,605,848,2196, 1129,690, 13 28,2094,713,1320,632,2123,482,1187,806,2314,1116,427,904,2321,1071,414,1291,2565,2 23,663,1409,2152,692,1570,835,2210,1348,619,472,2101,1232,455,1410,2241,796,809,11 74,3104,714,1177,721,2200,1189,837,716,2125,1130,864,1079,2212,810,1352,606,2816,9 12,1560,722,2316,1601,696,1572,2322,377,435,1137,2566,817,1178,319,2102,1103,621,1 293,2131,812,484,1132,2105,430,1602,838,2569,1248,667,3075,488,1190,239,2160,1543, 378,1576,2183,459,1219,622,2126,627,1294,437,2337,1665,380,2242,1547,818,1299,213 3,461,496,1604,2324,669,1315,2570,679,1083,724,2106,1193,841,629,2216,1584,351,113 8,3077,467,1301,2187,438,1180,737,2147,1111,251,1221,2134,462,442,2108,1140,441,11 94,2328,469,1085,2137,247,1555,683,2338,1549,842,1666,2577,738,899,2572,1305,670,1 302,2244,783,1550,3136,849,1201,820,2189,1317,728,2149,1412,928,1115,2195,791,367, 2224,1608,901,1793,2190,630,1222,2578,685,1196,844,2369,1144,633,2079,1225,711,13 60,2248,253,1086,3081,691,1306,824,2138,1167,902,2593,1127,686,740,2340,1202,850,2 370,1318,375,2580,1117,444,1668,2311,470,1226,2197,483,1616,415,2150,1347,485,215 3,1416,905,3078,1321,795,1794,2352,473,1131,2344,634,1204,2211,744,1175,852,2140,1 233,960,2095,1308,865,2315,1672,693,2433,1118,797,1228,2594,906,1322,2372,715,142 4,3089,807,1632,474,2256,1376,636,2434,1349,694,2198,1557,254,2201,1179,717,2213,1 234,575,1329,2154,913,1571,2103,798,1324,3082,811,1133,2376,379,1208,2584,697,155 8,431,2625,607,489,2596,1561,866,2161,1139,723,2202,1191,486,2127,1249,908,2317,13 50,718,1330,3090,813,1796,2156,476,1181,2626,856,1680,2272,839,1353,2214,725,1134, 2567,698,1141,2600,914,1236,2243,752,1195,3200,868,1800,2318,819,1354,2689,814,12 50,439,2571,1573,929,2323,1562,490,2628,1411,623,2339,1332,671,2107,1240,739,3084, 1440,916,2217,1295,463,2608, 1303,843,2162, 1182,381,2325, 1361,497,2204, 1574,930,21 35,1696,821,2245,1142,726,3105,1356,1603,2164,961,2218,1564,872,2109,1413,492,257 9,1197,631,2573,1145,729,2690,1577,700,2329,1223,443,3137,1808,741,2326,1203,845,2 574,1252,920,2225,1362,382,2341,1336,822,2436,1728,2139,1414,851,3092,1198,730,26 32,1578,498,2817,1605,880,2246,1417,742,2220,1307,445,2168,1146,2249,471,1472,238 4,1377,635,3328,1585,932,2110,1227,687,2330,1087,903,2191,1364,2151,825,1418,2226, 500,1551,2342,1606,846,3106,1580,745,2141,1205,2692,826,1319,2250,732,1309,2640,4 46,1256,2371,1148,3096,962,1229,2440,936,1206,2345,475,1667,2818,853,2155,1586,86 7,2228,1310,1609,2199,637,1323,3108,907,2257,1378,487,2332,1235,695,2696,1425,214 2,1209,746,2252,1420,828,2346,1368,3079,753,1610,2448,854,1669,2656,1617,2400,857, 1559,2373,504,1264,2581,799,3201,1230,1119,2203,255,1351,2258,964,2353,1588,909,2 595,1824,719,2348,1426,3138,1380,477,2157,1331,915,2232,1325,2582,638,1441,2585,1 237,2163,748,1592,2215,944,1856,3584,869,2273,1612,1210,2374,491,2354,1670,699,28 20,1428,1251,2205,754,3083,1920,858,2704,1618,2377,478,1442,2158,1326,968,2165,16 73,2260,383,1795,3112,910,2219,1384,1563,2824,815,2378,1135,976,2274,1355,2597,12 38,870,3140,1333,2586,917,1212,2435,1473,2356,727,1241,2264,493,3202,1432,873,246 4,1633,2319,1620,701,2327,1575,2206,931,1674,2385,1253,3091,756,1183,2598,860,272 0,1444,1334,2166,499,2380,1565,731,2627,1797,3085,1634,823,2588,1681,2437,922,135 7,2221,1143,2169,874,1624,3120,918,2601,1363,2247,1242,502,2832,1392,2227,933,167 6,3086,1254,2276,743,1415,2386,1337,2360,760,2752,1474,881,2438,1566,3144,1358,49 4,2222,1257,2602,702,2629,1579,1798,2441,921,3329,1199,501,2331,1147,2170,1682,24 96,876,1636,2401,1365,3093,847,1801,2609,992,2251,1244,2111,1338,447,2388,1448,32 04,1419,2442,733,1697,2575,827,2630,1607,2604,1379,934,2229,1311,3107,1207,2343,8 82,1258,2333,937,2280,1149,2172,1581,963,3330,1684,2253,1640,2230,747,1366,2691,5 05,2610,1340,3098,1265,855,2334,1802,2633,1587,2347,924,3585,1369,734,2402,1476,2 259,1421,2449,829,1427,2233,1231,3152,965,2444,1698,2392,1582,938,2634,1809,2693, 1456,3109,884,1381,2641,506,2583,1211,2288,1260,2254,749,1688,3097,1648,2143,945, 2375,1611,2612,1804,966,3094,1729,2848,1150,2450,755,2404,1266,859,2355,1589,3208 ,1422,2349,940,2465,1370,2261,1480,830,2616,1382,3332,1429,2880,911,2636,1327,159 3,2234,871,3336,1268,2694,1619,2452,639,2275,1213,1590,2944,888,3110,1700,2642,13 85,2466,479,2350,1730,3586,1613,946,2697,1239,2819,750,2408,1810,2587,1671,3168,9 69,2159,1372,1443,2379,508,2262,1430,3139,1488,2357,861,2236,1704,2497,1825,757,3 113,1386,2265,1614,2456,970,2657,1433,2644,1594,3216,919,2599,1812,1621,2698,1596 ,2277,875,3100,1243,2207,1335,2468,862,2358,1732,3141,1622,2589,758,1625,2821,167 5,2658,948,3114,1445,2705,1816,2381,977,2167,1826,3588,1635,2648,923,2387,1626,22 66,1434,972,3121,1255,2416,1712,2700,761,2278,1677,3146,1272,2439,877,2361,1393,2 498,1214,3344,1388,2590,952,2382,1678,2281,1683,495,3232,1359,2603,1504,2822,703, 2223,1339,3592,1245,2171,935,2706,1394,2660,1637,3360,978,2389,1446,2825,1449,226 8,1475,3600,883,2362,1638,2472,1567,2443,762,3264,1259,2721,1436,2631,503,2403,13 67,3616,1396,2335,925,2231,1799,2282,1341,3142,1246,2173,878,2605,1450,2708,1477, 3116,735,2664,1261,2390,1583,2364,1857,3203,993,2289,1828,2826,1736,3153,885,2611 ,1858,2393,1685,2500,939,3122,1832,2445,1803,2451,1641,2255,994,3145,1628,2722,14 57,2606,980,3087,1744,2833,1840,2480,1860,2405,926,3392,1371,2235,1921,2284,764,2 712,1267,3205,1686,2672,1478,2635,941,3124,1342,2828,1699,2753,967,2174,1642,3095 ,1922,2290,1805,2613,886,1400,1452,3206,831,2446,1689,2394,1760,2504,1591,3456,94 7,2406,1864,2453,1649,3148,507,2351,1262,2617,1383,2292,1481,3209,889,2643,1423,2 237,1811,3154,1615,2614,984,2724,1702,2409,1458,3128,751,2754,1701,2637,1373,3099 ,1269,2263,942,2834,1482,2695,1690,3169,1644,2396,996,2467,1387,3111,1151,2454,12 15,2512,971,2728,1806,3331,1431,2849,890,2410,1460,3156,1650,2638,1595,2457,509,3 210,1489,2618,1705,2836,1270,2645,949,3217,1731,2620,1374,2267,1623,3333,973,2359 ,1692,2756,1814,3101,1484,2646,1000,2649,1273,3115,1706,2699,1597,2469,892,2840,1 435,3170,1827,2850,1813,2659,950,3587,1733,2650,1389,2458,1464,3160,863,2279,2736 ,1652,3212,1713,2701,1398,2296,759,3102,1447,2417,1490,2238,1817,2412,1008,3218,1 274,2702,1395,2707,1505,3143,510,2383,1598,2528,3334,1437,2363,1627,2269,979,3337 ,1390,2418,1492,2661,1679,3233,953,2470,1924,2473,1829,3648,1639,2499,2662,763,31 17,1708,2591,1734,2283,1453,3172,974,2460,1818,2391,1276,2420,1397,3712,2823,1629 ,2365,954,3123,1872,2270,1714,2474,1737,3220,879,2501,1656,2285,3118,1506,2607,18 30,2881,981,3147,1451,2852,1928,2760,1438,3338,2882,982,2709,1247,3345,1687,2856, 1716,2827,1859,3589,927,2665,3176,1643,2652,1496,2481,1479,3234,995,2768,1820,286 4,1833,3125,2884,1738,2395,1745,3265,765,2945,1861,2291,3224,1740,2710,1888,2502, 956,3149,1834,2366,1630,2723,3236,1936,2666,1746,2946,887,3840,1720,2829,1401,242 4,3340,1459,2476,1841,3346,985,2713,1343,2784,3590,1645,2615,1836,2888,997,3126,1 508,2673,2286,1454,3155,1862,2407,1691,2505,986,3129,2447,1512,2835,1263,3593,140 2,2639,3184,1483,2726,943,2482,1646,3207,1651,2725,2397,1461,3150,1404,2293,891,2 506,3361,1842,2714,1485,3266,1520,2668,1693,2411,3157,998,2175,1703,2239,1748,334 8,2830,1865,3594,766,2455,1653,2484,3130,1375,2674,1491,2619,1462,3240,2513,511,3 211,1761,2729,1275,2294,3171,1486,2755,1466,2398,1465,3158,2647,988,3132,1493,271 6,1271,2838,3352,1707,2508,1866,2297,3161,1001,2730,1762,3362,1923,2621,2459,1694 ,3601,1807,2851,951,2837,3596,1873,2757,1844,3268,2413,1752,2488,1952,3213,1002,2 676,3173,1815,2737,1391,2422,3219,1925,2471,1654,2514,1709,3248,2841,893,3214,186 8,2298,2419,1657,3602,1735,2529,3393,1277,2622,975,2461,1715,3103,2651,1848,3272, 1926,2414,2516,1710,3162,894,2703,3617,1764,2948,1874,2853,3364,1399,2663,1468,33 94,2732,1494,2758,1009,3604,2477,1507,3335,1439,2842,2300,1509,3221,1929,2421,317 4,1819,2653,955,2896,3177,1497,2738,1658,3376,2761,1768,3368,1876,2680,2530,1984, 3235,1004,2854,3164,1889,2475,1717,2952,3119,1821,2462,1930,3339,2271,1010,2711,1 739,3457,2740,1831,3618,2883,1498,3396,1660,2667,2520,1718,3280,957,2503,3458,127 8,2844,1741,2857,3222,1599,2762,3225,1937,2769,1822,3237,2885,983,2764,1835,3178, 2912,1403,3127,2858,1721,3400,1455,2654,2960,1631,3608,1513,2770,3649,958,2744,36 20,1890,2425,1747,2483,3185,1510,2865,3226,1932,2367,1742,3151,2669,987,3341,2860 ,1837,2532,1500,3180,2478,1880,3650,2886,1863,3296,1749,2715,2536,1012,3238,2287, 1722,3591,1938,2426,3624,1776,2507,3267,1892,2670,1843,2675,3342,1838,2485,3713,9 99,2428,1463,3595,2866,1953,3347,2509,1514,2544,3652,1647,2717,1695,3363,2727,176 3,3131,2772,1016,3241,2889,1940,2677,1487,3632,2399,1867,3186,2515,1405,3349,2486 ,1521,3228,2785,767,3159,1954,2299,3269,1845,2510,2490,1750,3188,2489,1985,3242,1 896,2517,3133,1516,2295,3603,1655,2731,3597,989,2890,3714,1753,2786,2947,1724,335 3,1467,2718,3350,1765,2831,3598,1869,2897,3249,1944,2868,3365,1003,2776,3460,1406 ,2976,3163,1846,2839,1875,2415,3656,1754,2949,3841,1522,2678,3270,1904,2733,3244, 990,2892,3192,1766,2681,3273,1469,2759,3408,1495,2301,3134,1659,2739,3354,1956,28 72,3215,1711,2950,3175,1927,2734,1005,2788,3250,1849,2898,3366,1524,2423,3165,187 0,2492,3716,1769,2518,3274,1850,2531,3664,1756,2463,3395,1470,2533,3464,959,2953, 3369,1986,2843,3842,1960,2521,3179,1499,2682,3252,1877,2792,3223,1891,2900,3281,3 008,1661,3356,2913,1931,3720,2741,1011,3166,2845,1511,3276,2954,1719,3370,2763,17 70,3472,2855,1852,3680,2522,1777,3424,2684,1878,3397,2742,1881,3605,2302,1013,322 7,2765,1528,3282,2623,3377,1823,2961,3619,1279,2846,3372,1988,2859,3181,1933,2427 ,3256,1743,2745,3606,1501,2479,2655,2537,1939,3609,2914,895,3187,2771,1662,3239,2 534,1772,3297,2956,1968,3398,2766,3378,1893,2861,3844,1515,2524,3229,1723,2904,37 28,1778,2887,3401,1882,2773,3182,2746,1006,3189,2962,1502,3284,2800,1992,3243,291 6,3848,1407,2867,3402,1934,2862,3298,1839,2487,3621,2000,2977,3610,2538,1894,3459 ,2671,1941,3380,2719,1014,3288,2787,3488,1751,2964,3343,1517,2511,3351,2891,1897, 3230,2429,1725,3409,2545,1955,3622,2978,3744,1780,2869,3190,1884,2774,3404,1523,3 651,3009,3612,1755,2920,3461,1017,2540,3245,2679,1847,3193,2777,1946,3625,2748,32 71,1898,2491,3856,1942,2789,3251,2893,1526,3300,2968,1957,3410,2430,3384,1767,287 0,3776,1784,3462,2899,3246,1905,2778,3626,1018,2546,3653,2928,1518,3465,2790,1726 ,3355,2493,3194,1945,2519,3520,1525,3425,2683,3633,1900,2980,3275,2735,1871,3135, 2951,2016,3412,2873,3466,1471,2548,3599,1757,3654,2894,3628,1851,2793,3253,2874,9 91,3367,2780,1958,3357,2494,3304,1906,3196,3010,3277,1961,2984,3254,2523,1987,371 5,2901,1771,3634,2915,3358,1529,3657,2685,3371,1879,2955,3426,2535,1948,3283,2743 ,1758,3473,3257,2794,1853,3468,2876,3416,1020,2801,3658,2902,1989,3717,3665,1962, 2905,3607,2552,1908,3312,2847,3278,1530,3167,2303,3399,1773,3012,3636,2957,1969,3 872,2767,3474,1990,3428,2525,3379,1779,2963,3373,2686,1883,3489,3285,2796,1964,36 40,2992,3904,1854,2917,3660,3258,1935,2539,3718,2747,1007,3476,3299,2802,1895,396 8,2906,3666,1663,2526,3490,3374,1912,3016,3721,2431,1503,3843,2958,3432,1970,3611 ,2863,3183,1774,3024,3403,3286,1993,2918,3381,2965,1532,3260,3521,2775,1885,3289, 2541,3480,1781,2921,3681,3668,1994,2749,3623,2979,3722,1943,3301,2804,3231,1015,2 908,3492,3382,1899,2547,3613,2779,1886,3845,3682,2871,3729,1782,2970,3405,3191,19 72,2922,3672,2966,2001,3411,3290,2550,1947,3440,2981,3724,3302,1996,2791,3463,338 5,1785,2808,3522,2929,1901,3614,3406,2542,3305,1976,2750,3627,3846,1519,2969,3247 ,2549,3195,1727,3730,2924,3684,1959,3413,2895,3849,3040,2002,3292,3386,2495,1019, 3496,3467,2781,3745,1907,2875,3655,3427,1786,2982,3359,3255,2930,1527,3306,2985,3 197,1949,3629,3011,3732,3688,1902,2795,3414,2553,3388,1759,3313,2903,3850,2017,36 35,2972,3417,2782,1909,3524,3469,2877,3475,1963,3279,3013,3746,2018,3630,2986,385 7,3504,2004,2932,3429,2554,3259,1950,3308,2797,3736,3696,1788,2993,3659,3852,3014 ,1965,3777,3198,2803,3314,1991,2907,3637,3470,2988,1021,3418,3528,2878,1910,3430, 3477,2959,3375,1855,3641,2919,3316,3667,1971,2687,3261,3638,2936,1531,3748,3433,2 527,3778,1913,3661,2994,3287,2798,3858,2008,3719,3017,3420,3491,1775,2556,3478,35 36,2909,1966,3752,3873,2805,3434,2020,3662,3018,3481,3642,1995,2967,3860,3669,364 4,2923,1914,3291,3383,2910,3780,1533,3670,2806,3673,3723,1973,2996,3493,3864,3025 ,3874,1997,3683,2971,3674,3482,2024,3020,3303,3760,2809,1916,3725,3320,2925,3441, 3262,1974,3436,3000,3726,3731,1887,2543,3407,3552,2751,3387,1783,3293,2983,3442,3 685,3026,1022,3494,3497,3523,2931,2032,3686,3615,2810,3307,3484,1534,2551,3415,34 44,2973,3847,2003,3389,3294,2926,3498,3525,1977,2783,3309,3631,3905,1787,3041,387 6,3784,2933,3906,1998,3733,2987,3880,3851,3689,1978,3042,3676,3505,3028,3792,1903 ,3888,3908,2974,3419,3969,2005,2812,3315,3 734,3 526,2989,2006,3390,3 747,3015,3690, 3970,1951,3853,2934,3448,3500,2879,3737,2019,3808,3639,2995,3912,3697,1789,2555,3 310,3431,3529,2937,1980,3471,3859,3663,3032,3750,3506,1911,2799,3749,3421,3317,29 90,2009,3530,3738,3692,3044,3435,3199,2021,3263,3019,3854,3479,2938,2010,3508,369 8,3643,2557,3537,3753,1967,3318,2997,3779,3422,3671,3021,1915,3740,3862,3532,3048 ,3321,3754,2022,3645,2940,3483,3875,3861,1790,2998,3781,3437,3512,2911,3700,1535, 3761,3446,2807,3495,3538,3865,3056,1023,3322,3443,3553,2558,3646,3485,2012,3675,3 027,3438,3540,3727,3001,2025,3972,3877,3687,2811,3756,3782,1975,3501,3022,3866,33 24,3445,3677,3002,2026,3920,3762,3785,2927,3704,3554,1917,3878,3029,3499,3976,348 6,3030,3295,1999,3735,3764,3907,2975,3691,3544,3527,1918,3043,3868,3881,3786,3793 ,2813,3909,2033,3788,3936,3004,3882,3678,3984,3794,1979,2935,3768,3449,3507,3889, 3033,3391,2028,3693,3884,3045,3556,3502,3910,3739,2034,3034,3560,3311,3450,3531,2 991,3694,1981,3699,3509,3452,2939,3890,3533,3568,3741,2007,3046,3751,3796,3913,28 14,3701,3423,3539,1982,3510,2559,3809,3323,3534,3514,3513,2011,3036,3541,3319,375 5,3914,3049,3810,3971,3742,2036,3855,2999,3921,3892,3800,4000,3050,3863,2023,3439 ,3973,3702,3757,2941,3916,3705,3783,2040,3325,3023,3763,3896,3974,3758,2942,3812, 3922,1791,3447,3516,3542,3057,3555,3487,3557,3977,3867,2013,3003,3545,3706,3816,3 924,4032,3052,3937,3765,2027,3869,3978,3058,3787,3879,3546,3708,3766,3005,2014,33 26,3789,3647,3985,3870,3031,3883,3451,3769,3503,2029,3679,3561,3006,3938,3795,355 8,3980,3790,3035,3885,1983,3548,3928,3911,3797,3060,3770,3986,3824,3940,3891,2035 ,3886,3047,3511,4001,3562,3695,3743,3811,3064,3988,3535,2037,3915,3453,3569,2815, 4002,3893,3798,4033,3944,3564,3703,1919,3037,3801,3772,3515,3813,3917,3992,3051,3 454,3894,3923,3802,2030,3570,3952,3038,3814,3517,3543,3707,4004,3759,3975,3053,38 97,2038,3572,3918,3817,3898,3804,3518,3007,4034,4008,3547,3925,3939,2041,3709,397 9,3059,3559,3767,3818,3900,3825,3926,3929,3061,3576,3871,3327,2042,4036,3981,3791 ,3549,3987,2943,3710,3820,4016,3941,3563,3771,3826,3930,2015,3054,3550,4040,3455, 3982,3887,4048,3942,3989,3062,3799,3565,3945,3773,4003,2044,3828,3932,3571,3803,3 065,3895,3994,3946,3990,3574,4005,3815,3832,3953,3066,3566,2031,3774,3993,3573,39 48,3919,4064,3519,3805,3899,3039,4006,3954,4009,4035,3819,3577,3927,2039,3996,380 6,3901,3068,4037,4010,3956,3578,3821,4017,4038,3827,3931,4012,3902,3983,3055,3943 ,3711,3960,2043,3551,4018,3822,4041,3580,3933,3829,4042,3991,3063,3947,3934,3830, 4020,4049,3995,4044,3833,3949,4024,3567,2045,3775,4007,4050,3067,3955,3834,3575,3 997,3950,3807,4065,3957,4011,4066,4052,3998,3836,4013,4039,3069,3958,3903,4019,35 79,3961,2046,4056,3823,4014,4068,4043,3962,3581,4021,4045,4072,3964,4022,3935,383 1,3070,4080,3582,4051,4025,3835,4046,4026,3951,4053,4054,3999,4067,3837,4028,3959 ,4057,4069,2047,4058,4015,3963,4070,3838,3583,3071,4060,4073,4023,4074,3965,4047, 3966,4081,4027,4076,4082,4029,4055,4030,4059,4084,4071,4088,3839,4061,4075,4062,4 077,4031,4083,4085,3967,4078,4086,4089,4090,4063,4092,4079,4087,4091,4093,4094,40 95];
where the sequence Q3 is given by
[0,1,2,4,8,16,32,3,5,64,1024,9,6,17,10,18,128,12,33,65,20,256,34,24,36,7,129,66,512, 11,40,68,130,19,13,48,14,72,257,1025,21,132,35,258,26,513,80,37,25,22,136,260,264,38, 514,96,67,41,144,28,69,42,516,49,1026,74,272,160,520,288,528,192,544,70,44,131,81,50, 73,15,320,133,52,1028,23,134,384,76,137,82,56,27,97,39,259,84,138,145,261,1032,29,43, 98,515,88,140,30,146,71,262,265,161,576,45,1040,100,640,51,148,46,75,266,273,517,104 ,162,53,193,1056,152,77,164,768,268,274,518,54,83,57,521,1027,112,135,78,289,194,85, 276,522,58,168,1029,139,99,86,60,280,89,290,529,524,196,1088,141,101,147,176,142,53 0,321,31,200,1033,90,545,292,322,532,263,149,102,105,1030,304,296,163,92,47,267,385, 546,324,1041,208,386,150,153,165, 106,55, 1034,328,536,577,548, 113, 154,79,269, 1042, 10 8,578,224,166,519,552,195,1152,270,641,523,275,580,291,59,1036,169,560,114,277,156, 87,197,1057,116,170,61,531,525,642,281,1089,278,526,177,293,388,91,1044,584,769,198 ,172,120,201,336,1280,62,282,143,103,178,294,1058,93,644,202,592,323,1048,392,297,7 70,107,180,151,1060,209,284,648,94,204,298,1031,400,608,352,325,533,1153,155,210,30 5,547,300,1090,109,184,534,537,115,167,1536,225,326,306,772,157,1035,656,329,110,11 7,212,1064,171,776,330,226,549,1092,538,387,308,216,1154,416,271,279,158,337,1043,5 50,672,118,332,579,1037,540,389,173,121,1072,553,199,784,179,1038,228,338,312,704,3 90,1096,174,554,581,393,1281,283,122,448,353,1045,561,203,63,340,1156,394,527,582,5 56,181,1059,295,285,232,124,1282,205,182,643,562,1050,286,585,299,1537,354,211,401, 185,1104,396,344,586,645,1061,593,535,240,206,1049,95,327,564,1046,800,402,356,307, 1160,301,417,213,568,1284,832,588,186,1288,646,404,227,896,1062,594,418,302,1538,6 49,771,360,539,1120,111,331,214,1091,309,188,449,1065,217,408,609,596,1168,551,650, 229,1052,159,420,310,1093,541,773,610,1066,657,333,119,1540,600,339,218,1073,368,6 52,230,1098,391,313,450,1296,542,334,233,1184,555,774,175,1544,123,658,612,1312,34 1,777,220,1552,314,424,395,1216,673,583,355,1568,287,183,234,1094,125,557,660,1068, 616,342,316,1155,241,778,1105,563,345,452,1074,397,403,207,1097,674,558,1039,785,4 32,357,1344,187,236,664,1157,624,587,1076,780,705,126,1047,242,565,1158,398,346,45 6,1408,358,405,1100,303,569,244,1161,595,189,1106,566,676,361,1080,706,589,1051,21 5,786,647,1121,348,419,1063,406,464,680,1283,801,362,1108,590,409,1162,570,788,597, 1169,572,219,1285,311,708,1053,598,601,1067,651,421,792,1122,802,611,1539,602,410,1 112,231,688,1164,653,248,1054,369,190,364,1170,654,659,1095,335,480,1286,315,221,1 289,370,613,1185,422,425,1600,451,614,1069,543,235,1124,412,343,372,1664,775,317,1 075,222,426,1172,453,237,1070,559,833,1099,804,712,1290,834,661,1297,808,779,1541, 617,1128,604,433,1186,720,816,1077,836,347,1217,897,243,1176,662,454,1101,318,675,1 188,618,898,1792,781,376,1292,428,1298,665, 736,1542,567,840,1078,625,238,1107,359, 457,1081,399,787,1545,591,1136,678,434,1159,677,349,1102,245,458,1313,666,1218,620 ,363,1109,127,191,1300,782,1546,407,436,1082,626,571,1192,465,1163,681,246,1123,707 ,350,1110,599,1084,668,790,1304,460,249,1113,682,1314,573,411,1553,803,789,1548,709 ,1220,365,440,1165,628,1125,689,374,1171,423,466,1200,793,1166,250,371,1554,481,134 5,574,413,1055,603,1224,366,468,1114,655,1569,900,805,1316,615,1346,684,710,1556,4 29,1287,794,252,1173,373,1126,605,848,1129,690,1328,713,1320,632,482,1187,806,1116, 427,904,1071,414,1291,223,663,1409,692,1570,835,1348,619,472,1232,455,1410,796,809 ,1174,714,1177,721,1189,837,716,1130,864,1079,810,1352,606,912,1560,722,1601,696,15 72,377,435,1137,817,1178,319,1103,621,1293,812,484,1132,430,1602,838,1248,667,488,1 190,239,1543,378,1576,459,1219,622,627,1294,437,1665,380,1547,818,1299,461,496,160 4,669,1315,679,1083,724,1193,841,629,1584,351,1138,467,1301,438,1180,737,1111,251,1 221,462,442,1140,441,1194,469,1085,247,1555,683,1549,842,1666,738,899,1305,670,130 2,783,1550,849,1201,820,1317,728,1412,928,1115,791,367,1608,901,1793,630,1222,685, 1196,844,1144,633,1225,711,1360,253,1086,691,1306,824,1167,902,1127,686,740,1202,8 50,1318,375,1117,444,1668,470,1226,483,1616,415,1347,485,1416,905,1321,795,1794,47 3,1131,634,1204,744,1175,852,1233,960,1308,865,1672,693,1118,797,1228,906,1322,715, 1424,807,1632,474,1376,636,1349,694,1557,254, 1179,717, 1234,575, 1329,913, 1571,798, 1 324,811,1133,379,1208,697,1558,431,607,489,1561,866,1139,723,1191,486,1249,908,135 0,718,1330,813,1796,476,1181,856,1680,839,1353,725,1134,698,1141,914,1236,752,1195, 868,1800,819,1354,814,1250,439,1573,929,1562,490,1411,623,1332,671,1240,739,1440,9 16,1295,463,1303,843,1182,381,1361,497,1574,930,1696,821,1142,726,1356,1603,961,15 64,872,1413,492,1197,631,1145,729,1577,700,1223,443,1808,741,1203,845,1252,920,136 2,382,1336,822,1728,1414,851,1198,730,1578,498,1605,880,1417,742,1307,445,1146,471 ,1472,1377,635,1585,932,1227,687,1087,903,1364,825,1418,500,1551,1606,846,1580,745 ,1205,826,1319,732,1309,446,1256,1148,962,1229,936,1206,475,1667,853,1586,867,1310 ,1609,637,1323,907,1378,487,1235,695,1425,1209,746,1420,828,1368,753,1610,854,1669 ,1617,857,1559,504,1264,799,1230,1119,255,1351,964,1588,909,1824,719,1426,1380,477 ,1331,915,1325,638,1441,1237,748,1592,944,1856,869,1612,1210,491,1670,699,1428,125 1,754,1920,858,1618,478,1442,1326,968,1673,383,1795,910,1384,1563,815,1135,976,135 5,1238,870,1333,917,1212,1473,727,1241,493,1432,873,1633,1620,701,1575,931,1674,12 53,756,1183,860,1444,1334,499,1565,731,1797,1634,823,1681,922,1357,1143,874,1624,9 18,1363,1242,502,1392,933,1676,1254,743,1415,1337,760,1474,881,1566,1358,494,1257, 702,1579,1798,921,1199,501,1147,1682,876,1636,1365,847,1801,992,1244,1338,447,144 8,1419,733,1697,827,1607,1379,934,1311,1207,882,1258,937,1149,1581,963,1684,1640,7 47,1366,505,1340,1265,855,1802,1587,924,1369,734,1476,1421,829,1427,1231,965,1698, 1582,938,1809,1456,884,1381,506,1211,1260,749,1688,1648,945,1611,1804,966,1729,11 50,755,1266,859,1589,1422,940,1370,1480,830,1382,1429,911,1327,1593,871,1268,1619, 639,1213,1590,888,1700,1385,479,1730,1613,946,1239,750,1810,1671,969,1372,1443,50 8,1430,1488,861,1704,1825,757,1386,1614,970,1433,1594,919,1812,1621,1596,875,1243, 1335,862,1732,1622,758,1625,1675,948,1445,1816,977,1826,1635,923,1626,1434,972,12 55,1712,761,1677,1272,877,1393,1214,1388,952,1678,1683,495,1359,1504,703,1339,124 5,935,1394,1637,978,1446,1449,1475,883,1638,1567,762,1259,1436,503,1367,1396,925,1 799,1341,1246,878,1450,1477,735,1261,1583,1857,993,1828,1736,885,1858,1685,939,18 32,1803,1641,994,1628,1457,980,1744,1840,1860,926,1371,1921,764,1267,1686,1478,94 1,1342,1699,967,1642,1922,1805,886,1400,1452,831,1689,1760,1591,947,1864,1649,507, 1262,1383,1481,889,1423,1811,1615,984,1702,1458,751,1701,1373,1269,942,1482,1690, 1644,996,1387,1151,1215,971,1806,1431,890,1460,1650,1595,509,1489,1705,1270,949,1 731,1374,1623,973,1692,1814,1484,1000,1273, 1706, 1597,892, 1435, 1827, 1813,950, 1733, 1389,1464,863,1652,1713,1398,759,1447,1490,1817, 1008, 1274, 1395, 1505,510, 1598, 1437 ,1627,979,1390,1492,1679,953,1924,1829,1639,763,1708,1734,1453,974,1818,1276,1397, 1629,954,1872,1714,1737,879,1656,1506,1830,981,1451,1928,1438,982,1247,1687,1716, 1859,927,1643,1496,1479,995,1820,1833,1738,1745,765,1861,1740,1888,956,1834,1630, 1936,1746,887,1720,1401,1459,1841,985,1343,1645,1836,997,1508,1454,1862,1691,986, 1512,1263,1402,1483,943,1646,1651,1461,1404,891,1842,1485,1520,1693,998,1703,1748 ,1865,766,1653,1375,1491,1462,511,1761,1275,1486,1466,1465,988,1493,1271,1707,186 6,1001,1762,1923,1694,1807,951,1873,1844,1752,1952,1002,1815,1391,1925,1654,1709, 893,1868,1657,1735,1277,975,1715,1848,1926, 1710,894, 1764, 1874, 1399, 1468, 1494, 1009 ,1507,1439,1509,1929,1819,955,1497,1658,1768,1876,1984,1004,1889,1717,1821,1930,1 010,1739,1831,1498,1660,1718,957,1278,1741,1599,1937,1822,983,1835,1403,1721,1455 ,1631,1513,958,1890,1747,1510,1932,1742,987,1837,1500,1880,1863,1749,1012,1722,19 38,1776,1892,1843,1838,999,1463,1953,1514,1647,1695,1763,1016,1940,1487,1867,1405 ,1521,767,1954,1845,1750,1985,1896,1516, 1655,989, 1753, 1724, 1467, 1765, 1869, 1944, 10 03,1406,1846,1875,1754,1522,1904,990,1766,1469,1495,1659,1956,1711,1927,1005,1849 ,1524,1870,1769,1850,1756,1470,959,1986,1960,1499,1877,1891,1661,1931,1011,1511,1 719,1770,1852,1777,1878,1881,1013,1528,1823,1279,1988,1933,1743,1501,1939,895,166 2,1772,1968,1893,1515,1723,1778,1882,1006,1502,1992,1407,1934,1839,2000,1894,1941 ,1014,1751,1517,1897,1725,1955,1780,1884,1523,1755,1017,1847,1946,1898,1942,1526, 1957,1767,1784,1905,1018,1518,1726,1945,1525,1900,1871,2016,1471,1757,1851,991,19 58,1906,1961,1987,1771,1529,1879,1948,1758,1853, 1020, 1989, 1962, 1908, 1530, 1773, 196 9,1990,1779,1883,1964,1854,1935,1007,1895,1663, 1912, 1503, 1970, 1774, 1993, 1532, 1885 ,1781,1994,1943,1015,1899,1886,1782,1972,2001,1947,1996,1785,1901,1976,1519,1727, 1959,2002,1019,1907,1786,1527,1949,1902,1759,2017,1909,1963,2018,2004,1950,1788,1 965,1991,1021,1910,1855,1971,1531,1913,2008, 1775, 1966,2020, 1995, 1914, 1533, 1973, 19 97,2024,1916,1974,1887,1783,1022,2032,1534,2003,1977,1787,1998,1978,1903,2005,200 6,1951,2019,1789,1980,1911,2009,2021,2010, 1967, 1915,2022, 1790, 1535, 1023,2012,2025 ,1975,2026,1917,1999,1918,2033,1979,2028,2034,1981,2007,1982,2011,2036,2023,2040, 1791,2013,2027,2014,2029,1983,2035,2037,1919,2030,2038,2041,2042,2015,2044,2031,2 039,2043,2045,2046,2047];
wherein sequence numbers of N polarized channels in the second sequence are arranged in ascending order of reliability of the N polarized channels, and a minimum value of the sequence numbers of the polarized channels is 0; or
the second sequence is a part or all of a sequence Z1, a sequence Z2 or a sequence Z3;
where the sequence Z1 is given by
[0,1,2,7,3,8,14,27,4,13,16,31,19,36,38,84,5,15,17,35,22,42,52,89,25,51,46,97,63,106, 113,182,6,20,24,44,26,50,57,99,32,61,65,107,78,120,126,201,37,67,82,124,87,135,145,21 5,96,147,160,243,166,257,281,408,9,21,29,60,33,64,77,115,39,83,69,127,92,139,153,224, 49,80,95,146,101,156,165,251,111,168,186,269,200,288,307,454,59,98,109,164,122,176,1 94,284,133,195,214,299,227,325,343,494,150,222,247,330,254,344,371,528,275,378,402, 556,423,581,627,877,18,28,34,79,43,86,90,151,54,94,102,163,112,175,179,283,62,103,11 4,177,125,193,211,301,138,212,223,319,249,339,364,516,71,118,134,199,140,213,230,33 1,161,245,255,347,274,377,394,553,178,266,285,385,300,417,426,578,327,440,475,615,5 01,649,725,878,75,136,155,233,173,252,273,382,183,277,291,407,308,425,452,603,208,3 04,320,437,345,468,496,662,358,504,533,690,564,738,767,1022,229,334,352,479,387,513 ,538,715,422,548,579,755,616,773,842,1103,451,592,630,809,645,865,897,1175,720,914, 951,1160,990,1235,1333,1678,23,40,45,100,55,104,116,192,56,117,129,202,142,225,236, 362,70,130,143,240,157,248,263,363,167,261,282,400,305,421,432,577,73,154,169,242,1 88,267,286,420,198,297,309,434,323,466,486,643,197,321,336,463,357,500,518,694,389, 542,566,737,589,764,816,1081,85,181,190,293,206,316,335,456,217,342,351,495,372,527 ,547,733,279,365,388,532,409,562,588,760,443,597,635,805,667,862,901,1147,313,404,4 36,574,462,613,638,845,491,655,677,874,726,931,966,1211,535,724,742,952,761,992,940 ,1257,826,1074,1107,1355,1121,1459,1518,1755,91,203,209,356,268,376,392,541,295,39 7,412,569,442,601,634,849,311,439,461,602,478,641,670,884,505,682,713,921,757,960,1 019,1270,361,467,484,668,517,703,745,943,567,746,769,1014,830,985,1092,1361,611,79 7,858,1075,885,1117,1154,1426,932,1168,1165,1503,1260,1547,1599,1928,403,502,543,7 50,599,772,814,1037,636,847,867,1110,912,1128, 1163, 1452,672,893,945, 1150,967, 1172, 1 264,1552,1034,1284,1322,1613,1390,1696,1745,2117,734,955,1008,1267,1089,1273,1376 ,1634,1101,1365,1433,1725,1488,1791,1886,2269,1129,1463,1535,1824,1577,1902,1857, 2323,1667,1977,2030,2480,2145,2568,2678,3005,30,48,58,110,66,131,144,231,72,148,15 9,239,172,259,264,413,74,170,180,258,191,317,328,450,218,329,355,492,375,520,545,75 4,76,187,204,322,220,353,368,510,232,381,395,551,416,582,608,775,246,406,430,595,45 7,631,652,836,469,644,684,890,689,920,957,1340,119,219,228,373,241,396,414,572,271, 433,445,622,474,658,680,853,292,449,483,648,508,687,697,905,531,699,712,962,796,996 ,1062,1363,312,507,523,708,558,743,751,977,587,792,820,1033,873,1084,1112,1437,621, 841,889,1115,936,1143,1218,1492,1006,1228,1288, 1557, 1326, 1626, 1705,2102, 123,238,2 60,427,289,446,477,664,306,488,511,702,536,719,728,970,341,526,557,731,585,785,813, 1023,617,832,869,1098,907,1133,1190,1441,369,571,606,818,654,861,857,1136,674,895, 916,1178,981,1222,1248,1564,716,938,1000,1239,1027,1305,1329,1638,1070,1358,1405, 1729,1499,1802,1892,2278,391,626,657,900,695,928,982,1231,781,1004,1046,1316,1053, 1336,1383,1689,799,1048,1067,1372,1138,1401,1474,1788,1203,1495,1532,1828,1595,19 36,1996,2352,834,1156,1185,1445,1249,1507,1543,1869,1292,1586,1644,1973,1711,2038 ,2130,2512,1412,1653,1736,2060,1814,2160,2203,2654,1876,2243,2315,2718,2421,2834, 2985,3484,141,272,298,489,337,521,552,763,349,563,593,790,624,825,881,1193,383,610, 663,851,686,925,909,1210,705,947,989,1281,1041,1309,1347,1671,460,676,707,924,780, 975,1011,1319,789,1042,1060,1351,1088,1387,1424,1765,801,1078,1124,1420,1199,1471 ,1522,1835,1241,1573,1591,1940,1648,2004,2079,2459,471,778,784,1029,804,1051,1095, 1398,837,1142,1181,1456,1224,1510,1582,1917,997,1197,1253,1528,1294,1616,1657,198 4,1394,1663,1739,2064,1818,2153,2195,2640,1056,1301,1368,1620,1416,1719,1776,2094 ,1484,1795,1847,2187,1910,2251,2343,2760,1539,1880,1954,2306,2026,2372,2453,2866, 2109,2491,2557,2952,2616,3109,3149,3832,480,808,822,1186,972,1215,1245,1568,1015, 1277,1312,1630,1379,1685,1759,2087,1064,1344,1409, 1699, 1448, 1781, 1851,2177, 1514, 1 898,1840,2227,1992,2332,2413,2803,1206,1430,1467,1807,1561,1862,1946,2286,1609,19 58,2018,2381,2072,2433,2524,2934,1715,2045,2124,2471,2210,2580,2628,3065,2262,270 4,2747,3199,2848,3272,3331,3683,1298,1481,1605,1965,1681,2011,2052,2442,1750,2138 ,2169,2548,2234,2592,2730,3129,1769,2219,2295,2692,2401,2774,2787,3300,2503,2883, 2915,3359,3027,3524,3596,4162,1921,2364,2392,2817,2536,2897,2971,3420,2604,3047,3 085,3560,3225,3639,3888,4347,2666,3174,3247,3730,3387,3776,3946,4458,3454,4014,40 85,4599,4244,4770,5021,5420,10,41,68,149,88,162,196,310,105,184,216,340,244,374,386 ,609,121,207,226,366,270,405,459,628,294,453,431,660,514,696,722,961,137,253,287,41 8,302,448,482,669,346,503,525,700,586,752,774,1018,379,534,600,766,623,802,840,1057 ,656,848,886,1137,906,1173,1236,1567,174,262,324,497,354,519,580,732,393,605,540,77 9,642,815,864,1083,441,594,651,843,678,875,904,1159,714,915,968,1207,1013,1259,130 7,1675,493,665,706,899,756,937,994,1247,793,999,1055,1286,1090,1352,1403,1768,854, 1076,1148,1371,1167,1406,1473,1844,1227,1494,1549,1905,1602,1961,2057,2542,235,31 8,360,591,411,620,632,859,465,647,683,894,718,934,949,1243,509,688,727,941,770,991, 1043,1293,810,1047,1080,1335,1155,1392,1458,1815,550,744,798,1010,819,1050,1102,1 374,891,1141,1169,1414,1223,1490,1530,1901,946,1198,1252,1509,1289,1588,1610,1952 ,1356,1643,1723,2033,1782,2105,2257,2545,570,807,870,1111,930,1161,1219,1502,964,1 230,1265,1563,1310,1606,1674,2008,1036,1296,1339,1637,1410,1708,1775,2127,1443,17 89,1856,2189,1924,2284,2341,2791,1097,1378,1425,1733,1513,1811,1866,2237,1600,188 9,1956,2318,2035,2355,2483,2923,1669,1982,2062,2424,2097,2521,2577,3034,2248,2607 ,2669,3011,2736,3126,3278,3795,280,398,424,675,470,693,736,986,476,739,783,1020,82 8,1085,1116,1451,544,787,831,1125,880,1151,1191,1454,910,1188,1240,1546,1300,1596, 1623,1949,559,868,917,1134,976,1201,1255,1592,1005,1279,1313,1628,1349,1702,1749, 2090,1001,1341,1384,1698,1440,1778,1822,2192,1520,1873,1926,2281,1980,2338,2436,2 886,614,956,979,1272,1032,1328,1382,1679,1061,1399, 1421, 1772, 1477, 1841, 1885,2272, 1233,1462,1517,1853,1571,1914,1974,2326,1651,1995,2075,2416,2141,2518,2586,2993,1 324,1556,1633,1945,1694,2027,2082,2486,1762,2115,2163,2539,2260,2634,2695,3093,18 60,2254,2289,2672,2329,2740,2651,3163,2455,2872,2926,3309,2948,3473,3565,3908,637 ,1025,1039,1436,1205,1487,1527,1870,1276,1542,1575,1933,1647,2001,2069,2494,1317, 1641,1692,2005, 1732,2084,2148,2554, 1794,2171,2233,2619,2321,2686,2783,3183, 1447, 1 706,1746,2142,1820,2213,2298,2657,1930,2301,2346,2777,2456,2727,2905,3317,2023,23 98,2509,2877,2559,2945,3000,3424,2637,3023,3019,3538,3166,3607,3678,4140,1553,178 5,1878,2303,1999,2349,2430,2814,2078,2489,2527,2931,2601,2960,3016,3463,2151,2571 ,2660,2997,2698,3031,3171,3613,2811,3205,3261,3700,3367,3818,3894,4381,2275,2675, 2767,3179,2900,3188,3345,3736,2920,3326,3434,3863,3513,3960,4093,4559,2963,3479,3 585,4000,3650,4111,4050,4630,3782,4206,4274,4814,4414,4914,5049,5398,332,435,487, 709,529,791,835,1105,555,852,883,1123,926,1180, 1194, 1578,565,922,953, 1176,984, 1332, 1360,1665,1066,1367,1432,1763,1483,1827,1882,2312,575,971,1028,1345,1071,1428,146 6,1805,1108,1498,1534,1894,1585,1964,2016,2358,1146,1559,1619,1989,1684,2067,2106 ,2468,1712,2091,2174,2565,2184,2613,2681,3286,748,1069,1094,1478,1130,1538,1581,1 942,1213,1624,1655,2047,1721,2123,2166,2500,1269,1661,1742,2099,1801,2181,2201,25 89,1848,2205,2230,2689,2395,2744,2855,3322,1321,1798,1833,2224,1912,2292,2309,271 3,1970,2389,2445,2808,2533,2891,2937,3440,2042,2477,2562,2940,2645,2988,3101,3518 ,2763,3118,3208,3618,3264,3719,3838,4364,762,1120,1182,1614,1261,1658,1728,2135,1 304,1752,1809,2208,1864,2245,2265,2701,1395,1837,1908,2268,1968,2378,2427,2794,20 39,2462,2530,2912,2595,2966,3058,3443,1469,1937,2014,2439,2112,2515,2506,2974,215 6,2574,2610,3039,2721,3104,3146,3629,2240,2648,2753,3133,2797,3233,3269,3742,2869 ,3314,3392,3869,3534,3974,4097,4570,1524,2054,2120,2583,2198,2631,2724,3121,2369, 2757,2828,3250,2842,3281,3354,3812,2404,2831,2863,3340,2977,3381,3498,3954,3078,3 529,3580,4008,3672,4146,4228,4661,2465,3008,3050,3448,3154,3543,3602,4065,3213,36 61,3747,4198,3843,4282,4397,4852,3401,3759,3875,4306,3988,4431,4486,5006,4071,453 1,4619,5091,4736,5218,5378,5901,824,1216,1282, 1756, 1388, 1831, 1896,2335, 1417, 1918, 1987,2387,2050,2450,2551,3062,1505,2020,2133,2497,2180,2625,2598,3090,2216,2663,2 733,3196,2820,3238,3295,3789,1688,2159,2222,2622,2366,2710,2770,3255,2384,2823,28 52,3303,2894,3364,3415,3920,2407,2880,2956,3410,3073,3493,3571,4022,3138,3644,366 7,4154,3753,4236,4331,4791,1716,2361,2375,2800,2410,2837,2908,3378,2474,2982,3042 ,3468,3113,3549,3655,4127,2750,3070,3158,3574,3216,3706,3765,4214,3373,3770,3880, 4315,3994,4422,4475,4992,2845,3230,3336,3711,3406,3857,3934,4356,3507,3967,4036,4 467,4119,4540,4650,5137,3591,4079,4176,4610,4266,4681,4779,5253,4372,4826,4902,53 42,4965,5524,5571,6216,1738,2418,2448,3053,2707,3098,3141,3635,2780,3191,3242,372 5,3350,3807,3914,4339,2859,3291,3395,3826,3459,3940,4042,4450,3554,4105,4028,4512 ,4222,4639,4724,5184,3081,3429,3488,3980,3624,4056,4168,4579,3695,4184,4258,4692, 4323,4747,4864,5323,3849,4290,4389,4802,4494,4926,4979,5480,4551,5079,5122,5619,5 234,5693,5750,6084,3221,3504,3689,4192,3801,4252,4298,4758,3900,4406,4439,4887,45 22,4940,5107,5547,3926,4503,4590,5064,4713,5153,5169,5721,4840,5269,5304,5776,544 0,5935,6005,6505,4133,4670,4701,5202,4875,5288,5362,5837,4952,5460,5504,5970,5644 ,6044,6268,6660,5034,5595,5668,6125,5808,6170,6320,6752,5867,6374,6438,6866,6579, 6995,7168,7433,11,47,81,189,108,205,265,410,132,250,290,447,326,490,506,794,152,278 ,303,481,359,539,604,823,390,598,568,860,673,908,939,1229,171,338,380,554,401,590,6 33,872,455,659,685,913,765,974,1003,1299,498,698,782,993,811,1035,1082,1346,856,10 91,1140,1442,1166,1485,1562,1925,221,348,428,653,464,679,759,948,515,788,710,1007, 839,1054,1114,1377,583,776,850,1087,882,1127,1162,1468,929,1174,1242,1525,1295,158 7,1642,2043,646,866,918,1157,983,1204,1271,1572, 1026, 1275, 1343, 1618, 1389, 1697, 174 7,2139,1104,1369,1457,1710,1479,1751,1823,2220,1548,1845,1906,2285,1962,2342,2443 ,2972,314,419,473,771,546,806,827, 1109,612,844,888, 1153,933,1200,1217,1569,666,892, 944,1209,998,1266,1330,1625,1049,1334,1373,1676,1464,1734,1806,2191,723,963,1030, 1290,1058,1338,1400,1714,1144,1449,1482,1760, 1544, 1843, 1888,2279, 1212, 1515, 1576, 1 861,1621,1948, 1972,2333, 1701,2007,2093,2417,2155,2496,2662,2976,747, 1040, 1122, 141 1,1192,1472,1541,1855,1234,1551,1593,1922,1646,1969,2037,2391,1323,1632,1680,2000 ,1754,2076,2146,2522,1790,2164,2231,2588,2302,2691,2752,3245,1396,1720,1771,2104, 1868,2185,2244,2642,1960,2267,2336,2726,2420,2764,2904,3390,2034,2365,2449,2839,2 487,2950,3013,3515,2653,3044,3114,3489,3186,3615,3774,4278,370,522,560,876,619,89 8,954,1263,625,959,1012,1302,1068,1380,1419,1799,717,1017,1073,1431,1131,1461,150 8,1803,1170,1500,1566,1904,1635,1957,1985,2331,735,1118,1179,1438,1251,1519,1580,1 953,1287,1611,1649,1991,1690,2071,2119,2481,1283,1683,1727,2065,1786,2152,2196,25 94,1874,2253,2308,2687,2359,2746,2853,3352,800,1225,1254,1601,1315,1666,1724,2046 ,1354,1743,1767,2144,1826,2217,2264,2680,1554,1810,1872,2229,1929,2296,2356,2735, 2015,2376,2464,2830,2534,2943,3021,3466,1662,1913,1997,2325,2061,2411,2472,2910,2 131,2508,2558,2968,2665,3076,3143,3576,2238,2659,2697,3116,2738,3193,3095,3652,28 74,3338,3397,3809,3422,3972,4061,4378,833,1306,1327,1784,1523,1839,1881,2250,1607 ,1897, 1934,2313,2012,2385,2461,2918, 1656,2003,2058,2388,2101,2475,2543,2987,2167, 2567,2636,3057,2732,3131,3240,3674,1797,2073,2116,2537,2194,2615,2706,3099,2311,2 709,2755,3232,2878,3178,3371,3820,2408,2812,2936,3341,2990,3417,3477,3922,3080,35 02,3497,4038,3657,4101,4172,4596,1909,2157,2255,2715,2379,2761,2847,3274,2467,291 3,2953,3402,3040,3432,3495,3962,2546,3003,3103,3472,3144,3509,3663,4107,3267,3696 ,3757,4190,3865,4302,4366,4821,2683,3123,3220,3668,3366,3680,3841,4220,3385,3824, 3932,4341,4016,4427,4546,4994,3436,3978,4087,4469,4142,4566,4509,5051,4264,4656,4 720,5221,4854,5315,5432,5756,438,576,639,923,692,1021,1077,1404,729,1096,1135,142 7,1187,1493,1512,1938,741,1184,1221,1489,1258,1670,1703,2031,1357,1707,1780,2134, 1836,2202,2261,2723,753,1246,1311,1687,1366,1773,1816,2178,1407,1852,1890,2274,19 44,2345,2400,2769,1453,1919,1978,23 74,2049,2452,2502,2893,2080,2484,2573,2998,258 5,3055,3128,3786,969,1362,1393,1829,1435,1893,1941,2322,1533,1988,2019,2431,2088, 2517,2564,2928,1597,2028,2113,2493,2173,2579,2603,3026,2226,2606,2633,3136,2809,3 198,3319,3822,1660,2170,2209,2627,2291,2700,2717,3164,2353,2805,2861,3266,2964,33 57,3408,3938,2429,2902,2995,3411,3086,3461,3587,4020,3218,3604,3702,4115,3763,421 0,4312,4805,988,1422,1497,1976,1590,2022,2098,2528,1639,2126,2182,2612,2241,2650, 2671,3151,1741,2215,2288,2674,2348,2789,2844,3249,2423,2885,2958,3383,3032,3441,3 540,3944,1819,2319,2397,2856,2505,2942,2932,3447,2549,3010,3049,3520,3169,3593,36 37,4125,2643,3091,3206,3620,3254,3728,3768,4226,3333,3814,3886,4345,4032,4441,455 3,5001,1877,2440,2514,3018,2597,3071,3173,3609,2781,3211,3288,3746,3302,3780,3853 ,4294,2819,3293,3327,3836,3452,3882,3996,4420,3562,4026,4081,4473,4166,4605,4679, 5081,2888,3482,3531,3950,3641,4044,4096,4525,3708,4156,4234,4652,4321,4729,4835,5 256,3898,4246,4354,4754,4454,4871,4918,5406,4533,4962,5041,5472,5156,5589,5737,61 85,1063,1537,1615,2128,1730,2206,2277,2743,1764,2299,2368,2798,2437,2870,2980,354 5,1858,2405,2525,2921,2576,3067,3036,3573,2618,3108,3184,3691,3279,3734,3797,4270 ,2056,2555,2624,3063,2778,3159,3227,3751,2795,3283,3312,3803,3362,3859,3916,4393, 2822,3347,3427,3910,3556,3990,4067,4482,3626,4136,4160,4612,4240,4688,4777,5197,2 086,2772,2786,3259,2826,3298,3376,3877,2896,3457,3525,3966,3598,4048,4150,4583,32 01,3551,3646,4075,3713,4196,4250,4665,3871,4260,4360,4761,4460,4861,4909,5392,330 7,3723,3830,4202,3904,4333,4408,4795,4010,4433,4497,4899,4575,4972,5071,5515,4091 ,4538,4627,5031,4715,5102,5189,5622,4812,5232,5301,5706,5367,5854,5891,6465,2108, 2836,2864,3533,3156,3582,3631,4131,3235,3685,3740,4216,3847,4288,4385,4786,3321,3 791,3892,4308,3956,4412,4501,4890,4054,4561,4488,4945,4674,5059,5145,5559,3567,39 28,3984,4446,4121,4516,4621,5011,4186,4634,4706,5112,4768,5166,5266,5687,4327,473 8,4830,5210,4928,5329,5381,5814,4984,5457,5501,5939,5604,6001,6055,6349,3717,4004 ,4180,4643,4284,4697,4745,5176,4374,4845,4880,5293,4955,5340,5486,5874,4399,4935, 5019,5446,5132,5530,5542,6026,5245,5638,5671,6077,5779,6220,6280,6711,4588,5094,5 125,5574,5280,5653,5725,6132,5353,5795,5831,6248,5959,6312,6509,6843,5418,5915,59 80,6387,6102,6421,6551,6923,6159,6602,6651,7020,6773,7126,7280,7500,237,530,704,1 100,817,1149,1278,1652,902,1237,1350,1737,1446,1832,1865,2402,978,1318,1385,1812, 1529,1916,2053,2446,1604,2041,1981,2519,2188,2600,2656,3134,1044,1476,1583,1950,1 629,2024,2110,2540,1758,2162,2212,2609,2351,2720,2766,3237,1849,2236,2382,2749,24 34,2825,2899,3310,2511,2916,2992,3450,3029,3511,3617,4129,1195,1504,1693,2149,177 7,2199,2339,2677,1884,2394,2247,2775,2478,2850,2947,3355,2009,2371,2499,2907,2561 ,2969,3024,3486,2639,3045,3148,3 569,3228,3654,3 732,4276,213 7,2531 ,2621 ,30 14,2729, 3088,3194,3633,2806,3203,3305,3698,3369,3805,3884,4395,2929,3343,3470,3834,3500,3 890,3992,4492,3600,4024,4103,4568,4178,4636,4752,5285,1415,1672,1793,2362,1932,24 26,2458,2939,2068,2490,2570,3006,2647,3083,3111,3628,2175,2582,2668,3096,2758,318 9,3284,3710,2841,3290,3348,3778,3480,3867,3970,4456,2271,2703,2815,3223,2858,3296 ,3388,3839,3001,3455,3506,3902,3594,4018,4077,4564,3106,3553,3642,4046,3704,4158, 4188,4625,3811,4232,4337,4722,4416,4807,4977,5290,2316,2833,2961,3404,3075,3491,3 589,4034,3139,3605,3665,4123,373 8,4182,4272,4695,3271,3715,3784,4224,3896,4319,44 03,4833,3948,4424,4507,4904,4592,5009,5069,5545,3380,3845,3918,4352,4052,4452,452 0,4957,4174,4548,4632,5044,4726,5084,5224,5678,4268,4663,4756,5158,4798,5264,5326 ,5785,4969,5356,5423,5763,5492,5871,6008,6434,1558,1900,1966,2552,2083,2591,2684, 3181,2095,2694,2784,3243,2875,3360,3413,3958,2258,2792,2881,3431,2979,3475,3542,3 964,3037,3536,3622,4099,3721,4170,4204,4623,2294,2955,3052,3445,3161,3558,3648,41 64,3215,3687,3744,4212,3799,4310,4370,4788,3210,3787,3855,4304,3942,4410,4465,490 6,4063,4529,4594,5004,4659,5066,5171,5641,2414,3124,3168,3676,3262,3766,3851,4280 ,3315,3878,3912,4401,3998,4490,4544,4996,3611,3976,4059,4505,4134,4581,4654,5054, 4242,4677,4772,5148,4847,5261,5334,5744,3761,4113,4218,4616,4300,4717,4782,5226,4 387,4819,4873,5282,4982,5387,5449,5841,4514,4974,5014,5426,5056,5495,5403,5904,51 92,5628,5681,6033,5703,6178,6252,6523,2469,3252,3276,3936,3563,4012,4073,4527,368 1,4095,4138,4603,4238,4686,4765,5237,3749,4230,4296,4690,4349,4784,4856,5299,4429 ,4883,4950,5370,5046,5437,5539,5921,3952,4317,4368,4849,4462,4931,5024,5409,4601, 5026,5074,5533,5195,5483,5659,6041,4710,5130,5250,5632,5307,5699,5753,6136,5389,5 772,5769,6232,5908,6288,6345,6695,4109,4418,4535,5029,4683,5076,5163,5568,4775,52 29,5272,5684,5351,5712,5766,6166,4859,5318,5412,5747,5452,5782,5911,6292,5565,594 2,5991,6361,6088,6456,6514,6871,4999,5429,5521,5918,5656,5925,6066,6391,5675,6051 ,6144,6487,6208,6560,6656,6989,5715,6181,6272,6593,6324,6675,6626,7040,6425,6741, 6794,7153,6894,7218,7296,7490,1717,1993,2121,2630,2223,2801,2889,3394,2282,2924,2 984,3425,3068,3522,3547,4144,2305,3060,3119,3516,3176,3772,3816,4262,3324,3828,39 30,4391,4006,4471,4542,5039,2328,3153,3257,3793,3334,3924,3982,4443,3399,4030,408 3,4555,4152,4641,4704,5086,3464,4117,4200,4672,4286,4763,4809,5208,4325,4793,4885 ,5312,4897,5364,5435,6016,2712,3329,3374,4002,3438,4089,4148,4614,3578,4208,4248, 4740,4335,4828,4878,5242,3670,4256,4362,4800,4437,4894,4916,5337,4499,4921,4947,5 443,5127,5498,5610,6048,3755,4435,4480,4943,4577,5016,5036,5469,4647,5120,5179,55 62,5277,5647,5690,6147,4733,5216,5309,5696,5395,5740,5847,6212,5518,5861,5945,629 6,5994,6378,6469,6854,2741,3418,3527,4194,3659,4254,4343,4842,3727,4376,4448,4923 ,4518,4967,4987,5454,3873,4484,4572,4989,4645,5109,5161,5550,4731,5200,5274,5665, 5345,5718,5805,6151,3986,4608,4699,5174,4816,5258,5248,5728,4866,5320,5359,5788,5 475,5851,5888,6304,4960,5401,5509,5877,5553,5966,5998,6395,5625,6037,6106,6491,62 28,6569,6665,7002,4069,4749,4823,5331,4911,5384,5477,5864,5099,5512,5583,5984,559 8,6012,6073,6451,5135,5586,5616,6062,5731,6099,6197,6555,5824,6224,6264,6597,6341 ,6700,6762,7059,5205,5760,5798,6155,5894,6236,6284,6636,5949,6332,6400,6736,6473, 6800,6883,7182,6114,6408,6496,6816,6583,6906,6941,7272,6641,6971,7033,7320,7105,7 388,7480,7719,2867,3583,3693,4383,3861,4477,4557,5061,3906,4585,4668,5117,4742,51 87,5296,5811,4040,4708,4838,5240,4892,5376,5348,5834,4933,5415,5489,5932,5577,597 3,6023,6430,4292,4868,4938,5373,5097,5466,5527,5987,5114,5580,5607,6030,5650,6080 ,6128,6532,5140,5635,5709,6121,5821,6193,6256,6607,5881,6316,6337,6705,6404,6768, 6832,7139,4329,5089,5104,5556,5143,5592,5662,6095,5213,5734,5792,6174,5857,6240,6 328,6685,5506,5818,5898,6260,5952,6366,6412,6747,6091,6417,6500,6821,6588,6900,69 35,7264,5601,5963,6059,6370,6117,6482,6541,6849,6205,6564,6617,6929,6680,6977,705 2,7345,6276,6646,6721,7027,6789,7072,7132,7405,6860,7160,7211,7461,7249,7552,7573 ,7841,4358,5150,5182,5801,5463,5844,5884,6308,5536,5928,5977,6383,6069,6447,6528, 6838,5613,6019,611 0,6460,6162,6546,6621,6917,6244,6670,6612,6959,6757, 7046, 7098, 7 370,5828,6140,6189,6574,6300,6631,6716,7008,6357,6726,6784,7078,6827,7112,7189,74 51,6478,6805,6877,7146,6947,7226,7256,7530,6983,7312,7336,7595,7396,7630,7654,779 2,5956,6201,6353,6731,6443,6778,6810,7119,6518,6888,6912,7204,6965,7233,7328,7562 ,6537,6953,7014,7304,7092,7353,7362,7642,7175,7414,7442,7667,7510,7733,7762,7936, 6690,7065,7085,7379,7196,7424,7470,7692,7241, 7520, 7541, 7747, 7607, 7776, 7858, 7981, 7 288,7584,7618,7808,7680,7824,7876,8006,7706, 7895, 7915,8033, 7957,8064,8098,8138,12 ,53,93,234,128,256,350,537,158,333,384,584,429,640,661,1038,185,367,399,629,472,701, 795,1072,512,786,740,1119,879,1177,1220,1579,210,444,499,721,524,777,829,1132,596,8 63,896,1183,995,1262,1297,1664,650,911,1024,1285,1059,1342,1397,1722,1113,1408,147 0,1838,1501,1891,1983,2406,276,458,561,855,607,887,987,1232,671,1031,927,1303,1093 ,1364,1439,1761,768,1009,1106,1402,1145,1455,1496,1871,1208,1511,1594,1939,1659,2 010,2077,2541,846,1126,1196,1491,1274,1550,1631,1994,1331,1636,1718,2048,1774,214 0,2200,2652,1423,1753,1854,2158,1883,2204,2290,2742,1963,2314,2386,2816,2451,2879 ,2991,3530,415,549,618,1002,711,1052,1079,1429,803,1099,1152,1486,1214,1545,1565,1 990,871,1158,1226,1555,1291,1627,1704,2055,1359,1709,1757,2118,1863,2186,2270,271 1,942,1250,1337,1654,1370,1713,1787,2161,1475,1846,1887,2214,1959,2310,2363,2807, 1560,1927,1998,2334,2051,2432,2460,2871,2147,2501,2599,2962,2670,3043,3214,3532,9 73,1348,1450,1800,1536,1875,1955,2327,1584,1967,2021,2403,2081,2457,2535,2933,169 5,2066,2122,2492,2207,2581,2658,3072,2249,2679,2756,3137,2835,3244,3306,3802,1783 ,2168,2228,2611,2340,2702,2768,3192,2447,2796,2873,3280,2965,3318,3460,3943,2532, 2906,2996,3393,3033,3505,3568,4064,3204,3601,3671,4039,3743,4167,4328,4836,485,68 1,730,1139,812,1164,1238,1622,821,1244,1308,1668,1381,1766,1808,2263,935,1314,138 6,1825,1460,1859,1915,2266,1506, 1907, 1986,2380,2070,2444,2476,2868,958, 1444, 1516, 1834,1603,1931,2002,2441,1650,2040,2085,2482,2132,2575,2629,3028,1645,2125,2176,2 566,2246,2667,2716,3145,2347,2779,2840,3241,2898,3299,3407,3905,1045,1574,1612,20 29,1686,2107,2172,2547,1731,2197,2225,2655,2293,2739,2793,3231,1975,2273,2344,275 4,2409,2829,2895,3289,2510,2917,3009,3384,3084,3501,3577,4017,2100,2393,2488,2860 ,2563,2957,3017,3467,2644,3056,3107,3523,3217,3634,3699,4126,2762,3212,3251,3673, 3292,3748,3651,4203,3428,3893,3949,4363,3973,4524,4611,4939,1086,1673,1700,2242,1 935,2307,2357,2776,2036,2373,2419,2849,2507,2927,3 007,3474,2092,2498,2560,2930,26 08,3022,3092,3544,2682,3117,3187,3614,3285,3688,3796,4225,2259,2578,2626,3087,271 4,3165,3258,3656,2843,3260,3308,3788,3435,3735,3925,4373,2951,3368,3492,3895,3546 ,3968,4029,4474,3636,4053,4047,4589,4209,4653,4727,5157,2390,2673,2782,3268,2922, 3316,3403,3829,3012,3469,3510,3955,3597,3985,4045,4513,3094,3561,3660,4023,3701,4 058,4215,4660,3823,4249,4311,4746,4419,4860,4925,5380,3234,3679,3777,4221,3919,42 31,4396,4776,3939,4379,4485,4900,4567,4986,5106,5548,3987,4530,4637,5028,4696,512 6,5070,5605,4822,5217,5279,5764,5411,5850,5954,6239,573,758,838,1202,903,1320,139 1,1792,950,1413,1465,1821,1531,1899,1920,2422,965,1521,1570,1895,1617,2111,2150,2 529,1735,2154,2239,2646,2304,2722,2788,3277,980,1598,1677,2129,1744,2232,2280,269 6,1796,2324,2367,2802,2428,2882,2944,3323,1850,2399,2470,2914,2550,2999,3048,3449 ,2584,3030,3122,3555,3135,3612,3684,4340,1256,1740,1779,2297,1830,2370,2425,2857, 1947,2479,2513,2978,2596,3064,3115,3483,2025,2526,2623,3041,2690,3130,3152,3584,2 751,3157,3185,3692,3365,3754,3872,4377,2096,2688,2731,3177,2821,3253,3270,3720,28 92,3358,3416,3821,3521,3911,3959,4491,2975,3458,3552,3963,3643,4011,4139,4573,377 3,4155,4255,4667,4316,4766,4872,5363,1280,1817,1903,2463,2013,2516,2605,3077,2074 ,2635,2699,3162,2765,3202,3222,3707,2193,2737,2818,3226,2887,3344,3400,3804,2967, 3439,3514,3935,3588,3993,4088,4496,2283,2854,2941,3412,3054,3499,3490,3999,3100,3 566,3606,4068,3726,4145,4189,4678,3195,3647,3762,4173,3810,4283,4322,4781,3887,43 69,4442,4905,4584,5000,5113,5557,2354,2989,3061,3575,3147,3627,3729,4161,3335,376 9,3844,4301,3856,4334,4407,4851,3372,3848,3881,4390,4003,4436,4547,4981,4112,4578 ,4631,5033,4721,5167,5239,5634,3444,4033,4080,4502,4191,4595,4648,5085,4261,4709, 4790,5212,4881,5289,5394,5796,4453,4803,4913,5314,5015,5428,5476,5931,5093,5519,5 596,5990,5705,6094,6223,6606,1375,1951,2044,2638,2179,2725,2804,3297,2221,2832,29 09,3353,2983,3426,3537,4094,2330,2949,3074,3478,3127,3623,3592,4124,3170,3664,374 1,4243,3835,4289,4351,4827,2556,3105,3175,3621,3332,3716,3781,4307,3351,3837,3868 ,4357,3917,4413,4470,4953,3377,3901,3979,4464,4106,4541,4617,5042,4177,4691,4716, 5172,4796,5249,5336,5743,2590,3328,3342,3815,3382,3854,3929,4430,3451,4009,4074,4 519,4149,4600,4703, 5144,3756,4102,4197,4626,4265,4751,4808, 5225,4425,4817,4919, 53 19,5020,5421,5467,5919,3862,4277,4384,4757,4459,4891,4966,5354,4562,4991,5057,545 8,5136,5528,5626,6028,4642,5098,5190,5587,5275,5655,5738,6122,5371,5775,5839,6195 ,5896,6325,6356,6839,2614,3391,3419,4082,3712,4132,4183,4684,3790,4237,4295,4771, 4402,4846,4944,5346,3876,4346,4447,4865,4508,4973,5062,5447,4606,5121,5048,5502,5 235,5614,5697,6067,4118,4479,4536,5007,4673,5077,5180,5566,4741,5194,5265,5664,53 28,5717,5807,6180,4886,5297,5388,5755,5484,5862,5907,6289,5540,5978,6017,6396,610 7,6452,6495,6743,4271,4556,4735,5203,4841,5257,5305,5726,4932,5404,5438,5830,5510 ,5873,6002,6340,4958,5493,5575,5967,5685,6040,6053,6472,5787,6137,6164,6516,6258, 6634,6684,7039,5149,5646,5676,6079,5819,6149,6211,6561,5885,6274,6305,6659,6415,6 713,6874,7148,5943,6376,6432,6774,6536,6803,6909,7209,6585,6950,6992,7284,7088,73 71,7488,7655,296,691,919,1418,1065,1480,1640,2089,1171,1589,1726,2190,1842,2300,2 337,2946,1268,1691,1770,2276,1943,2396,2553,2994,2032,2538,2473,3069,2705,3150,32 07,3690,1353,1879,2006,2435,2059,2523,2620,3089,2211,2676,2734,3160,2890,3273,332 0,3794,2317,2759,2925,3304,2981,3379,3456,3864,3059,3471,3548,4001,3586,4060,4169 ,4682,1540,1911,2136,2661,2235,2719,2876,3229,2360,2938,2773,3330,3025,3405,3503, 3909,2504,2911,3046,3462,3110,3526,3581,4037,3190,3603,3703,4120,3785,4207,4287,4 832,2649,3079,3172,3572,3282,3645,3752,4187,3361,3760,3860,4251,3921,4359,4438,49 56,3485,3897,4019,4388,4051,4444,4545,5053,4153,4576,4657,5129,4732,5198,5311,582 5,1804,2114,2256,2903,2415,2973,3002,3494,2572,3038,3120,3564,3200,3640,3669,4181 ,2693,3132,3219,3653,3311,3745,3840,4263,3396,3846,3903,4332,4031,4421,4523,5017, 2799,3256,3370,3779,3414,3852,3941,4394,3557,4007,4055,4455,4147,4571,4629,5124,3 662,4104,4195,4598,4257,4712,4743,5186,4365,4789,4896,5283,4975,5366,5534,5827,28 51,3389,3517,3957,3632,4041,4141,4587,3697,4159,4217,4676,4291,4737,4831,5254,382 7,4269,4338,4780,4449,4877,4964,5391,4500,4983,5068,5461,5152,5563,5623,6056,3933 ,4400,4472,4910,4604,5012,5082,5513,4728,5110,5191,5599,5286,5637,5767,6171,4824, 5223,5317,5708,5357,5804,5859,6263,5525,5887,5946,6245,6007,6338,6455,6815,1979,2 377,2454,3102,2587,3142,3239,3737,2602,3246,3339,3798,3433,3913,3965,4511,2785,33 46,3437,3981,3535,4025,4090,4517,3595,4086,4175,4651,4275,4723,4760,5183,2824,351 2,3608,3995,3718,4110,4201,4718,3771,4241,4297,4767,4353,4869,4930,5349,3764,4342 ,4409,4863,4495,4970,5025,5464,4615,5090,5155,5560,5220,5620,5720,6139,2959,3682, 3724,4229,3819,4320,4405,4837,3870,4432,4466,4961,4550,5050,5105,5551,4163,4528,4 609,5065,4687,5141,5214,5608,4799,5238,5332,5700,5407,5802,5868,6230,4314,4666,47 74,5178,4858,5276,5339,5770,4948,5377,5431,5822,5537,5913,5969,6311,5073,5531,556 9,5948,5611,6010,5929,6367,5739,6127,6173,6479,6192,6599,6663,6886,3015,3806,3831 ,4489,4116,4565,4624,5087,4235,4646,4693,5164,4794,5246,5325,5778,4303,4785,4855, 5251,4908,5343,5414,5836,4990,5441,5508,5899,5602,5961,6049,6382,4506,4874,4927,5 408,5023,5487,5578,5934,5160,5581,5629,6043,5741,5999,6156,6485,5271,5682,5793,61 31,5842,6190,6235,6563,5916,6254,6251,6644,6369,6692,6739,7026,4662,4978,5096,558 4,5243,5631,5714,6076,5335,5773,5810,6177,5882,6202,6249,6591,5417,5853,5937,6233 ,5972,6261,6373,6696,6074,6399,6442,6754,6522,6830,6878,7166,5554,5951,6035,6380, 6152,6386,6506,6777,6168,6492,6571,6858,6627,6918,6997,7263,6204,6603,6677,6942,6 720,7009,6972,7300,6807,7066,7106,7392,7185,7439,7501,7646,2165,2485,2632,3180,27 45,3356,3446,3947,2813,3481,3541,3977,3625,4072,4098,4698,2838,3616,3675,4066,373 3,4326,4371,4818,3879,4382,4483,4949,4560,5032,5101,5593,2862,3709,3813,4348,3889 ,4478,4534,5003,3951,4582,4635,5116,4707,5201,5263,5640,4015,4671,4755,5231,4844, 5322,5368,5752,4882,5350,5444,5848,5455,5893,5957,6462,3265,3885,3927,4552,3989,4 640,4702,5175,4130,4762,4804,5300,4895,5386,5434,5784,4223,4813,4922,5360,4998,54 51,5473,5870,5058,5478,5505,5964,5679,6014,6112,6489,4309,4995,5040,5499,5138,557 2,5590,5986,5209,5673,5729,6071,5816,6143,6183,6575,5294,5761,5845,6186,5923,6226 ,6318,6630,6031,6331,6402,6699,6445,6766,6842,7157,3294,3971,4076,4748,4211,4810, 4903,5400,4281,4936,5008,5481,5078,5522,5543,5975,4426,5045,5133,5546,5206,5661,5 711,6058,5291,5746,5813,6161,5876,6207,6283,6577,4539,5168,5260,5723,5374,5799,57 90,6214,5424,5856,5890,6267,5993,6321,6354,6707,5516,5926,6022,6343,6061,6422,644 9,6781,6124,6483,6540,6862,6642,6926,7000,7269,4620,5308,5383,5865,5470,5910,5996 ,6334,5652,6025,6089,6435,6101,6458,6512,6826,5688,6092,6119,6502,6217,6533,6616, 6914,6299,6638,6673,6946,6735,7030,7079,7316,5749,6242,6277,6581,6360,6648,6688,6 980,6406,6728,6785,7061,6846,7110,7176,7410,6547,6792,6865,7124,6934,7194,7224,74 82,6984,7248,7294,7519,7354,7574,7638,7822,3423,4135,4245,4941,4415,5037,5118,561 7,4461,5146,5228,5670,5303,5735,5833,6286,4593,5268,5397,5781,5450,5905,5879,6309 ,5490,5940,6004,6393,6082,6426,6468,6812,4850,5427,5496,5902,5649,5983,6038,6439, 5667,6085,6109,6475,6146,6520,6557,6893,5691,6134,6199,6553,6295,6613,6667,6955,6 347,6717,6732,7035,6788,7083,7138,7381,4888,5643,5658,6064,5694,6097,6158,6530,57 58,6221,6270,6595,6327,6652,6724,7018,6020,6293,6363,6669,6409,6758,6796,7070,652 6,6799,6869,7129,6938,7190,7219,7475,6104,6419,6499,6761,6550,6855,6902,7152,6623 ,6922,6963,7214,7013,7253,7310,7539,6681,6988,7048,7290,7101,7326,7375,7588,7162, 7398,7434,7624,7463,7694,7711,7914,4917,5702,5732,6279,5981,6315,6350,6710,6046,6 389,6428,6770,6510,6823,6890,7143,6116,6466,6543,6835,6589,6905,6967,7205,6655,70 05,6958,7238,7075,7305,7348,7559,6302,6567,6609,6930,6703,6975,7043,7274,6750,705 3,7096,7332,7134,7359,7416,7616,6850,7115,7171,7386,7229,7445,7469,7677,7259,7514 ,7533,7728,7580,7754,7773,7878,6413,6620,6746,7057,6819,7093,7120,7365,6881,7180, 7199,7427,7244,7452,7526,7702,6897,7234,7279,7507,7342,7546,7553,7764,7404,7594,7 609,7782,7662,7833,7854,7987,7022,7321,7337,7567,7421,7602,7632,7802,7457,7670,76 86,7844,7737,7866,7928,8021,7494,7720,7745,7889,7793,7902,7942,8040,7812,7955,797 1,8061,8003,8084,8111,8145,315,749,1016,1608,1189,1682,1923,2412,1325,1867,2017,2 520,2143,2641,2685,3363,1434,1971,2063,2617,2252,2771,2935,3421,2350,2919,2846,34 96,3097,3590,3649,4157,1526,2183,2320,2810,2383,2901,3004,3519,2544,3066,3125,359 9,3301,3714,3767,4273,2664,3155,3337,3750,3398,3825,3907,4350,3487,3923,4005,4498 ,4049,4563,4675,5154,1748,2218,2466,3051,2569,3112,3287,3666,2708,3349,3182,3775, 3453,3858,3961,4398,2884,3325,3476,3915,3539,3983,4043,4537,3630,4062,4179,4622,4 267,4711,4787,5295,3035,3508,3610,4035,3731,4114,4227,4689,3808,4233,4344,4753,44 17,4862,4929,5405,3945,4386,4521,4879,4554,4934,5027,5494,4655,5055,5131,5564,519 9,5624,5727,6213,2103,243 8,2593,3313,2790,33 86,3430,3953,2954,3465,3 550,4027,363 8 ,4108,4137,4685,3082,3559,3658,4122,3758,4219,4324,4764,3850,4330,4392,4834,4532, 4912,5005,5462,3209,3694,3817,4259,3866,4336,4434,4884,4013,4510,4558,4946,4649,5 052,5108,5558,4128,4607,4694,5075,4759,5181,5211,5615,4867,5252,5352,5701,5422,57 80,5938,6215,3263,3833,3975,4451,4092,4543,4644,5067,4165,4658,4719,5151,4792,520 7,5287,5674,4313,4773,4839,5244,4937,5333,5413,5806,4985,5433,5507,5869,5582,5965 ,6021,6431,4428,4893,4959,5365,5083,5456,5520,5920,5196,5544,5618,5997,5704,6032, 6154,6539,5284,5648,5733,6098,5771,6194,6246,6628,5930,6271,6329,6610,6385,6697,6 802,7108,2287,2728,2827,3528,2970,3570,3677,4213,2986,3686,3783,4279,3883,4404,44 63,4997,3197,3792,3891,4481,3991,4526,4597,5002,4057,4586,4680,5128,4778,5193,522 7,5612,3236,3969,4070,4493,4193,4613,4700,5188,4253,4744,4797,5233,4853,5327,5382 ,5765,4247,4843,4901,5321,4980,5419,5468,5875,5092,5529,5588,5962,5642,6015,6111, 6511,3375,4151,4199,4730,4299,4820,4898,5298,4361,4924,4954,5410,5030,5491,5541,5 955,4664,5010,5088,5503,5159,5576,5639,6006,5262,5660,5748,6090,5817,6188,6253,65 94,4815,5139,5241,5606,5316,5695,5757,6160,5396,5791,5840,6209,5941,6298,6351,667 1,5514,5936,5971,6330,6009,6390,6313,6722,6129,6501,6544,6824,6562,6925,6978,7165 ,3442,4285,4318,4976,4618,5047,5100,5526,4739,5119,5165,5594,5259,5669,5745,6167, 4806,5247,5313,5672,5361,5759,5826,6225,5436,5849,5914,6282,6003,6342,6427,6737,4 993,5330,5379,5820,5465,5895,5979,6317,5591,5982,6024,6420,6133,6379,6525,6831,56 92,6075,6182,6503,6227,6558,6601,6895,6301,6619,6615,6964,6725,7003,7045,7283,513 4,5425,5532,5988,5663,6029,6105,6453,5751,6163,6196,6548,6269,6570,6614,6919,5829 ,6238,6319,6598,6352,6624,6729,7006,6448,6751,6791,7056,6859,7122,7158,7395,5958, 6335,6411,6733,6521,6740,6845,7074,6535,6834,6901,7144,6951,7192,7257,7476,6572,6 928,6993,7215,7028,7267,7237,7502,7100,7314,7346,7575,7411,7613,7659,7775,2495,28 65,3020,3619,3140,3800,3899,4440,3224,3931,3997,4476,4084,4574,4602,5170,3248,407 8,4143,4569,4205,4825,4870,5281,4367,4876,4971,5399,5043,5474,5538,5995,3275,4185 ,4293,4848,4380,4963,5018,5448,4445,5063,5111,5552,5177,5627,5683,6036,4515,5147, 5219,5657,5302,5736,5786,6145,5338,5768,5855,6234,5866,6281,6339,6809,3705,4375,4 423,5035,4487,5115,5173,5603,4633,5230,5267,5716,5347,5800,5846,6175,4725,5278,53 75,5777,5442,5860,5883,6257,5500,5886,5912,6346,6072,6394,6486,6833,4811,5439,548 2,5906,5570,5974,5989,6368,5636,6068,6118,6446,6206,6515,6552,6904,5713,6153,6231 ,6554,6306,6590,6678,6954,6410,6689,6755,7011,6795,7068,7128,7387,3739,4468,4580, 5215,4714,5270,5358,5812,4783,5390,5453,5892,5517,5927,5947,6358,4920,5488,5567,5 950,5630,6054,6103,6433,5707,6138,6200,6534,6262,6576,6645,6908,5022,5600,5680,61 13,5789,6187,6179,6580,5832,6243,6275,6632,6372,6682,6712,7017,5922,6310,6401,670 1,6437,6772,6798,7077,6497,6828,6873,7147,6961,7200,7260,7479,5095,5724,5797,6250 ,5878,6294,6375,6693,6047,6405,6463,6783,6474,6806,6852,7117,6081,6467,6493,6841, 6584,6870,6939,7188,6661,6957,6990,7217,7042,7287,7325,7515,6141,6605,6639,6911,6 714,6968,6999,7245,6759,7036,7082,7311,7133,7350,7402,7589,6880,7089,7151,7363,72 07,7419,7441,7649,7250,7462,7497,7674,7547,7717,7769,7906,3874,4638,4750,5393,490 7,5479,5555,6013,4951,5579,5651,6063,5722,6126,6219,6649,5072,5689,5809,6169,5858 ,6290,6265,6668,5897,6323,6384,6748,6457,6776,6817,7103,5310,5838,5903,6287,6045, 6364,6416,6787,6060,6459,6481,6820,6519,6856,6891,7173,6083,6507,6566,6887,6657,6 936,6981,7222,6704,7024,7038,7291,7086,7330,7374,7565,5344,6039,6052,6441,6087,64 71,6529,6867,6148,6587,6635,6921,6686,6970,7032,7276,6397,6653,6718,6986,6763,706 0,7091,7318,6863,7097,7155,7366,7210,7415,7437,7644,6477,6769,6837,7063,6884,7140 ,7181,7383,6948,7195,7230,7432,7271,7466,7511,7690,6996,7252,7299,7493,7343,7524, 7561,7729,7391,7579,7608,7758,7634,7807,7819,7977,5369,6096,6120,6640,6362,6674,6 708,7021,6423,6744,6780,7071,6848,7114,7169,7378,6488,6813,6876,7125,6915,7184,72 32,7428,6974,7265,7225,7454,7323,7505,7543,7707,6664,6898,6932,7202,7015,7240,729 5,7484,7054,7302,7339,7528,7369,7551,7593,7752,7136,7355,7400,7570,7446,7619,7639 ,7795,7472,7669,7685,7834,7723,7853,7869,7949,6765,6944,7050,7307,7111,7334,7358, 7556,7163,7407,7423,7604,7458,7623,7679,7814, 7177, 7449, 7487, 7664, 7537, 7696, 7700, 7 861,7585,7735,7746,7875,7783,7916,7931,8031,7278,7521,7534,7712,7599,7740,7765,78 91,7628,7788,7800,7923,7840,7940,7988,8057,7653, 7827, 7847, 7959, 7883, 7967, 7997,807 2,7899,8009,8019,8088,8044,8105,8126,8152,1813,2748,3167,3937,3409,4021,4239,4801 ,3579,4171,4355,4915,4504,5038,5080,5686,3722,4305,4411,5013,4628,5142,5306,5730, 4734,5292,5222,5803,5459,5880,5933,6344,3842,4549,4705,5185,4769,5273,5372,5823,4 942,5430,5485,5889,5633,5992,6034,6424,5060,5511,5666,6018,5719,6086,6150,6480,57 94,6165,6229,6582,6259,6625,6698,7019,4100,4591,4857,5416,4968,5471,5621,5953,510 3,5677,5523,6042,5762,6108,6191,6513,5255,5654,5783,6157,5843,6210,6255,6608,5917 ,6273, 63 5 5,6666, 6418,6723, 6775,7107, 5402, 5 815, 5900,6247, 6000,63 07, 63 92,6709, 6070, 6398,6476,6753,6524,6822,6872,7174,6176,6504,6596,6840,6618,6875,6937,7228,6687,6 956,7004,7268,7049,7303,7361,7601,4457,4829,4988,5645,5162,5710,5742,6184,5324,57 74,5852,6241,5924,6303,6326,6706,5445,5863,5944,6314,6027,6388,6461,6760,6100,646 4,6508,6804,6604,6861,6924,7208,5549,5976,6078,6414,6115,6470,6538,6844,6237,6586 ,6622,6882,6683,6952,6987,7266,6322,6654,6715,6969,6756,7037,7055,7298,6825,7081, 7142,7347,7186,7389,7468,7603,5597,6093,6203,6549,6297,6611,6679,6962,6348,6691,6 730,7016,6779,7051,7104,7333,6450,6764,6808,7076,6879,7131,7179,7401,6910,7191,72 36,7435,7281,7483,7509,7701,6531,6847,6892,7150,6973,7206,7243,7459,7047,7258,730 1,7498,7349,7516,7576,7749,7102,7317,7364,7548,7384,7592,7617,7785,7465,7629,7656 ,7778,7682,7813,7855,7970,4669,5123,5204,5835,5341,5872,5960,6381,5355,5968,6050, 6429,6130,6517,6556,6916,5535,6057,6135,6568,6218,6600,6647,6920,6266,6643,6702,7 001,6767,7044, 7064, 7297,5573,6198,6278,6578,6365,6658,6719, 7041,6407,6745,6782, 70 69,6818,7127,7161,7380,6403,6811,6853,7123,6907,7183,7213,7436,6979,7247,7282,748 1,7315,7508,7554,7736,5698,6336,6371,6738,6444,6797,6851,7109,6484,6868,6889,7178 ,6940,7227,7255,7477,6694,6927,6976,7235,7023, 7275, 7313, 7503, 7087, 7324, 7372, 7544, 7408,7591,7621,7771,6793,7010,7073,7293,7121, 7344, 7376, 7577, 7170, 7394, 7420, 7600, 7 471,7641,7665,7803,7239,7467,7485,7657,7504, 7683, 7648, 7823, 7563, 7731, 7750, 7863, 77 57,7904,7924,7991,5754,6436,6454,6903,6662,6949,6985,7246,6742,6998,7025,7286,708 4,7329,7368,7581,6786,7080,7118,7331,7149,7377,7412,7606,7193,7425,7456,7635,7499 ,7661,7699,7829,6913,7130,7159,7409,7212,7447,7489,7650,7285,7491,7512,7697,7564, 7678,7742,7865,7341,7536,7587,7732,7610,7756,7774,7892,7643,7781,7780,7919,7825,7 933,7948,8028,7007,7187,7251,7492,7327,7513,7550,7710,7373,7578,7596,7751,7627,77 60,7779,7901,7413,7614,7651,7772,7666,7784,7826, 7934, 7709, 7835, 7850, 7952, 7879, 797 5,7989,8062,7478,7658,7693,7828,7741,7830,7872,7960,7748,7868,7894,7983,7912,7999 ,8020,8083,7761,7905,7929,8007,7943,8024,8014,8091,7968,8038,8048,8109,8067,8118, 8128,8151,4889,5236,5385,5909,5497,6065,6142,6542,5561,6172,6222,6565,6291,6633,6 650,7029,5585,6285,6333,6629,6377,6801,6829,7099,6490,6836,6899,7172,6945,7216,72 54, 7496,5609,6359,6440,6814,6498,6896,6931, 7201,6545,6960,6991, 7261, 7034, 7306, 733 8,7517,6592,7012,7062,7322,7113,7367,7390,7569,713 5,7382,7426,7612,7431,7633,7660 ,7857,5985,6494,6527,6943,6573,6994,7031,7292,6672,7067,7090,7356,7141,7399,7422, 7583,6734,7095,7156,7385,7198,7430,7440,7622, 7231, 7443, 7455, 7663, 7535, 7684, 7725, 7 867,6790,7197,7221,7453,7273,7486,7495,7673,7309,7532,7557,7708,7598,7738,7753,78 96,7352,7572,7611,7755,7645,7770,7805,7913,7691,7810,7836,7935,7851,7956,7978,805 9,6011,6559,6637,7058,6727,7094,7145,7406,6771, 7164, 7203, 7444, 7242, 7464, 7473, 7668 ,6864,7223,7270,7474,7308,7527,7549,7703,7351,7566,7597,7744,7625,7763,7791,7897, 6933,7289,7335,7555,7393,7590,7586,7766,7417,7615,7631,7786,7675,7806,7818,7938,7 460,7647,7688,7815,7704,7843,7852,7961,7730,7864,7884,7984,7918,8001,8022,8085,69 82,7360,7397,7620,7438,7640,7676,7811,7523,7689, 7715, 7848, 7721, 7856, 7874, 7974, 753 8,7716,7727,7871,7767,7882,7909,7998,7798,7917,7927,8008,7947,8029,8042,8094,7568 ,7777,7789,7898,7820,7920,7932,8016,7837,7945, 7962,803 7,7979,8049,8065,8113,7886, 7964,7985,8052,8004,8069,8075,8125,8017,8080,8090,8131,8102,8140,8150,8171,6123,6 676,6749,7167,6857,7220,7262,7506,6885,7277, 7319, 7531, 7357, 7560, 7605, 7794,6966, 73 40,7403,7582,7429,7637,7626,7801,7448,7652,7681,7832,7713,7845,7860,7969,7116,741 8,7450,7636,7522,7672,7695,7849,7529,7714,7724, 7862, 7739, 7877, 7890, 7993, 7540, 7734 ,7759,7888,7797,7908,7925,8010,7816,7941,7946,8030,7963,8043,8055,8107,7137,7518, 7525,7705,7542,7718,7743,7881,7571,7768,7787,7903,7809,7921,7944,8026,7687,7796,7 821,7926,7838,7953,7965,8039,7880,7966,7986,8053,8005,8068,8074,8124,7722,7842,78 70,7954,7887,7982,7995,8058,7911,8000,8012,8073,8025,8081,8093,8134,7930,8018,803 4,8089,8047,8096,8106,8142,8060,8110,8117,8148,8122,8157,8159,8179,7154,7545,7558 ,7790,7671,7804,7817,7939,7698,7831,7846,7958,7873,7973,7992,8056,7726,7859,7885, 7976,7900,7996,8013,8071,7922,8023,8011,8078,8041,8092,8101,8137,7799,7893,7907,8 002,7937,8015,8032,8086,7951,8035,8046,8097,8054,8103,8114,8147,7980,8050,8063,81 08,8076,8119,8123,8155,8082,8130,8133,8161,8141,8164,8166,8176,7839,7910,7950,803 6,7972,8045,8051,8104,7990,8066,8070,8116,8079,8120,8132,8158,7994,8077,8087,8129 ,8100,8135,8136,8165,8112,8143,8146,8167,8153,8172,8174,8184,8027,8095,8099,8139, 8115,8144,8149,8169,8121,8154,8156,8173,8162,8175,8180,8186,8127,8160,8163,8177,8 168,8178,8181,8187,8170,8182,8183,8188,8185,8189,8190,8191];
where the sequence Z2 is given by
[0,1,2,7,3,8,13,26,4,12,15,30,18,35,37,82,5,14,16,34,21,41,51,87,24,50,45,94,61,103, 110,177,6,19,23,43,25,49,55,96,31,59,63,104,76,117,123,195,36,65,80,121,85,131,141,20 8,93,143,155,235,161,248,271,391,9,20,28,58,32,62,75,112,38,81,67,124,90,135,149,217, 48,78,92,142,98,152,160,243,108,163,180,260,194,278,296,434,57,95,106,159,119,171,18 8,274,129,189,207,288,220,313,330,471,146,215,239,318,246,331,356,502,266,363,385,5 28,405,551,593,816,17,27,33,77,42,84,88, 147,52,91,99, 158, 109, 170, 174,273,60, 100, 111, 1 72,122,187,204,290,134,205,216,307,241,326,350,491,69,115,130,193,136,206,223,319,1 56,237,247,334,265,362,378,525,173,257,275,369,289,399,408,548,315,421,453,582,477, 613,681,817,73,132,151,226,168,244,264,367,178,267,281,390,297,407,432,571,202,293, 308,418,332,447,473,624,344,480,507,650,535,693,719,942,222,321,338,457,371,488,511 ,672,404,521,549,708,583,724,785,1011,431,561,595,756,609,805,833,1072,677,848,880, 1059,914,1122,1203,1479,22,39,44,97,53,101,113,186,54,114,125,196,138,218,228,348,6 8,126,139,232,153,240,254,349,162,252,272,383,294,403,413,547,71,150,164,234,182,25 8,276,402,192,286,298,415,311,445,463,607,191,309,323,442,343,476,493,653,373,515,5 37,692,558,716,762,992,83,176,184,283,200,304,322,436,210,329,337,472,357,501,520,6 88,269,351,372,506,392,533,557,712,424,565,600,752,629,803,837,1048,302,387,417,544 ,441,580,603,788,468,618,638,813,682,863,893,1102,509,680,696,881,713,916,871,1140, 771,986,1014,1221,1026,1306,1353,1539,89,197,203,342,259,361,376,514,285,381,395,5 40,423,569,599,791,300,420,440,570,456,605,632,822,481,642,670,854,710,888,939,1151 ,347,446,462,630,492,661,699,873,538,700,720,935,774,910,1002,1226,578,745,799,987, 823,1023,1054,1279,864,1066,1063,1341,1143,1376,1417,1670,386,478,516,703,567,723, 760,955,601,789,807,1017,846,1032,1062,1300,633,830,875,1051,894,1069,1146,1380,95 2,1163,1194,1428,1250,1493,1531,1810,689,884,930,1149,999,1154,1238,1445,1009,1229 ,1285,1516,1329,1567,1639,1919,1033,1309,1367,1592,1400,1651,1617,1957,1471,1707, 1746,2065,1830,2125,2198,2406,29,47,56,107,64,127,140,224,70,144,154,231,167,250,25 5,396,72,165,175,249,185,305,316,430,211,317,341,469,360,495,518,707,74,181,198,310, 213,339,353,486,225,366,379,523,398,552,575,726,238,389,411,564,437,596,615,780,448 ,608,644,827,649,853,886,1209,116,212,221,358,233,380,397,543,262,414,425,588,452,6 21,641,795,282,429,461,612,484,647,656,840,505,658,669,890,744,919,976,1228,301,483 ,498,666,530,697,704,903,556,741,766,951,812,995,1019,1288,587,784,826,1021,867,104 5,1108,1332,928,1116,1166,1384,1197,1439,1500,1799,120,230,251,409,279,426,455,626, 295,465,487,660,510,676,684,897,328,500,529,686,554,735,759,943,584,776,809,1007,84 2,1036,1084,1291,354,542,574,764,617,802,798,1039,635,832,850,1074,906,1111,1133,13 90,673,869,923,1125,946,1180,1200,1448,983,1224, 1262, 1519, 1338, 1575, 1643, 1925,375, 592,620,836,654,860,907,1119,731,926,962,1189,968,1206,1244,1488,747,964,980,1235, 1041,1259,1318,1564,1095,1335,1364,1595,1414,1676,1721,1977,778,1056,1080,1294,11 34,1344,1373,1626,1169,1407,1453,1704,1505,1752,1819,2087,1268,1460,1524,1768,158 4,1841,1872,2182,1631,1900,1951,2224,2025,2299,2394,2688,137,263,287,466,324,496,5 24,715,336,534,562,739,590,770,819,1087,368,577,625,793,646,858,844,1101,663,877,91 3,1160,958,1183,1215,1474,439,637,665,857,730,901,932,1192,738,959,974,1218,998,12 47,1277,1547,749,990,1029,1274,1092,1315,1356,1600, 1127, 1397, 1411, 1679, 1456, 1727, 1782,2051,450,728,734,948,751,967,1004,1256,781,1044,1077,1303,1113,1347,1404,166 2,920,1090,1137,1361,1171,1431,1463,1712,1253,1468,1527,1771,1587,1836,1866,2173, 971,1177,1232,1434,1271,1511,1555,1793,1326,1570,1609,1860,1657,1906,1971,2251,13 70,1634,1690,1945,1743,1991,2047,2319,1804,2073,2117,2373,2157,2470,2494,2875,458 ,755,767,1081,899,1105,1130,1393,936,1157,1186,1442,1241,1485,1542,1788,978,1212,1 265,1496,1297,1559,1612,1853,1350,1648,1604,1889,1718,1963,2019,2279,1098,1282,13 12,1579,1387,1621,1684,1931,1425,1693,1737,1997,1777,2033,2095,2362,1508,1757,181 5,2059,1877,2133,2165,2443,1914,2215,2243,2524,2308,2567,2601,2797,1174,1323,1422 ,1698,1482,1732,1762,2039,1535,1825,1847,2111,1894,2141,2232,2482,1550,1883,1937, 2207,2011,2260,2269,2583,2081,2330,2350,2617,2420,2710,2750,3042,1665,1985,2005,2 288,2103,2339,2385,2652,2149,2432,2455,2730,2539,2773,2904,3134,2190,2509,2552,28 22,2633,2846,2933,3187,2671,2967,3002,3252,3083,3328,3433,3584,10,40,66,145,86,157 ,190,299,102,179,209,327,236,359,370,576,118,201,219,352,261,388,438,594,284,433,41 2,623,489,655,678,889,133,245,277,400,291,428,460,631,333,479,499,659,555,705,725,9 38,364,508,568,718,589,750,783,972,619,790,824,1040,841,1070,1123,1392,169,253,312, 474,340,494,550,687,377,573,513,729,606,761,804,994,422,563,614,786,639,814,839,105 8,671,849,895,1099,934,1142,1182,1477,470,627,664,835,709,868,918,1132,742,922,970, 1164,1000,1219,1260,1549,796,988,1049,1234,1065,1263,1317,1607,1115,1334,1378,165 3,1420,1695,1766,2107,227,306,346,560,394,586,597,800,444,611,643,831,675,866,879,1 129,485,648,683,872,721,915,960,1170,757,963,991,1205,1055,1251,1305,1585,522,698, 746,931,765,966,1010,1237,828,1043,1067,1269,1112,1331,1363,1650,876,1091,1136,13 46,1167,1409,1426,1688,1222,1452,1514,1748,1560,1801,1910,2109,541,754,810,1018,8 62,1060,1109,1340,892,1118,1147,1389,1184,1423, 1476, 1730,954, 1173, 1208, 1447, 1266, 1 503,1554,1817,1293,1565,1616,1862,1667,1929,1969,2271,1006,1240,1278,1522,1349,15 82,1624,1896,1418,1641,1691,1953,1750, 1979,2067,2355, 1472, 1711, 1770,2027, 1795,209 3,2131,2424,1904,2151,2192,2410,2236,2480,2570,2856,270,382,406,636,449,652,691,91 1,454,694,733,940,773,996,1022,1299,517,736,775,1030,818,1052,1085,1302,845,1083,1 126,1375,1176,1415,1436,1686,531,808,851,1037,902,1094,1139,1412,927,1159,1187,144 0,1216,1498,1534,1790,924,1210,1245,1495,1290,1557,1590,1864,1355,1629,1669,1927, 1709,1967,2035,2332,581,885,905,1153,950,1199,1243,1480,975,1257,1275,1552,1320,1 605,1638,1921,1120,1308,1352,1614,1395,1660,1705,1959,1458,1720,1779,2021,1827,20 91,2137,2399,1196,1383,1444,1683,1492,1744,1784,2069,1544,1808,1843,2105,1912,216 9,2209,2460,1619,1908,1933,2194,1961,2238,2180,2502,2048,2323,2357,2588,2371,2682 ,2733,2914,602,944,956,1287,1097,1328,1360,1627,1156,1372,1398,1674,1455,1725,177 5,2075,1190,1450,1490,1728,1521,1786,1832,2115,1569,1849,1893,2159,1955,2203,2266 ,2514,1296,1501,1532,1828,1589,1879,1939,2184,1672,1941,1973,2262,2049,2230,2344, 2593,1741,2009,2085,2326,2119,2369,2403,2654,2171,2417,2415,2718,2504,2756,2794,3 031,1381,1562,1633,1943,1723,1975,2031,2286,1781,2071,2097,2360,2147,2378,2413,26 76,1834,2127,2186,2401,2211,2422,2507,2759,2284,2527,2560,2806,2622,2868,2907,315 0,1923,2196,2256,2512,2341,2517,2609,2825,2353,2598,2660,2891,2704,2940,3006,3234 ,2380,2685,2744,2960,2779,3016,2985,3266,2849,3064,3098,3347,3166,3389,3444,3576, 320,416,464,667,503,740,779,1013,527,794,821,1028,859,1076,1088,1401,536,855,882,1 073,909,1202,1225,1469,979,1231,1284,1545,1325,1594,1636,1949,545,898,947,1213,98 4,1281,1311,1577,1015,1337,1366,1645,1406,1697,1736,1981,1047,1386,1433,1716,1484 ,1773,1802,2057,1506,1791,1851,2123,1858,2155,2200,2575,702,982,1003,1321,1034,13 69,1403,1681,1104,1437,1461,1759,1513,1814,1845,2079,1150,1466,1529,1797,1574,185 6,1870,2139,1610,1873, 1891,2205,2007,2241,2312,2596, 1193, 1572, 1599, 1887, 1658, 1935 ,1947,2221,1702,2003,2041,2282,2101,2335,2364,2663,1755,2063,2121,2366,2176,2396, 2465,2707,2253,2475,2529,2762,2562,2816,2878,3142,714,1025,1078,1429,1144,1464,15 18,1823,1179,1537,1580,1875,1622,1902,1916,2213,1254,1602,1655,1918,1700,1995,202 9,2273,1753,2053,2099,2348,2143,2382,2439,2665,1314,1677,1734,2037,1806,2089,2083 ,2387,1838,2129,2153,2427,2226,2467,2492,2768,1898,2178,2247,2484,2275,2544,2565, 2828,2321,2591,2636,2894,2716,2947,3009,3239,1358,1764,1812,2135,1868,2167,2228,2 477,1989,2249,2295,2554,2304,2572,2614,2865,2013,2297,2317,2606,2389,2630,2696,29 37,2451,2713,2741,2964,2791,3034,3075,3280,2055,2408,2434,2668,2497,2721,2753,299 2,2532,2785,2831,3060,2881,3102,3158,3363,2641,2837,2897,3114,2954,3174,3200,3427 ,2995,3221,3261,3461,3313,3510,3569,3740,769,1106,1161,1540,1248,1597,1646,1965,1 272,1663,1714,2001,1761,2045,2113,2441,1343,1739,1821,2077,1855,2163,2145,2458,18 81,2188,2234,2522,2290,2547,2580,2853,1487,1840,1885,2161,1987,2219,2258,2557,199 9,2292,2310,2585,2337,2620,2649,2920,2015,2328,2376,2646,2448,2693,2736,2971,2487 ,2776,2788,3038,2834,3079,3126,3337,1509,1983,1993,2277,2017,2301,2346,2628,2061, 2392,2429,2679,2472,2724,2782,3024,2245,2446,2499,2738,2534,2809,2840,3068,2625,2 843,2900,3118,2957,3170,3195,3421,2306,2542,2604,2812,2644,2888,2927,3138,2701,29 44,2978,3191,3020,3225,3275,3479,2747,2999,3049,3257,3094,3289,3332,3523,3146,335 2,3384,3556,3410,3620,3636,3827,1526,2023,2043,2436,2217,2463,2489,2771,2264,2519 ,2549,2819,2612,2862,2917,3130,2315,2578,2638,2872,2674,2930,2981,3183,2727,3013, 2974,3212,3072,3270,3308,3497,2453,2657,2690,2950,2765,2988,3045,3243,2803,3053,3 090,3294,3122,3318,3368,3549,2884,3106,3154,3342,3204,3394,3416,3605,3230,3456,34 73,3652,3516,3676,3694,3792,2537,2699,2800,3057,2859,3087,3110,3323,2910,3162,317 8,3378,3217,3400,3467,3628,2923,3208,3248,3450,3303,3485,3491,3685,3358,3529,3542 ,3702,3591,3750,3770,3896,3027,3284,3298,3504,3373,3536,3563,3721,3405,3598,3613, 3760,3660,3781,3840,3929,3438,3644,3668,3803,3712,3815,3853,3947,3730,3866,3881,3 968,3912,3990,4016,4049,11,46,79,183,105,199,256,393,128,242,280,427,314,467,482,74 3,148,268,292,459,345,512,572,768,374,566,539,801,634,843,870,1117,166,325,365,526, 384,559,598,811,435,622,645,847,717,900,925,1175,475,657,732,917,758,953,993,1214,7 97,1001,1042,1292,1064,1327,1388,1668,214,335,410,616,443,640,711,878,490,737,668, 929,782,969,1020,1239,553,727,792,997,820,1031, 1061, 1313,861, 1071, 1128, 1359, 1172, 1 408,1451,1756,610,806,852,1057,908,1096,1152,1396,945,1155,1211,1432,1249,1494,15 33,1826,1012,1233,1304,1504,1322,1536,1591,1884,1377,1608,1654,1930,1696,1970,204 0,2386,303,401,451,722,519,753,772,1016,579,787,825,1053,865,1093,1107,1394,628,82 9,874,1100,921,1148,1201,1438,965,1204,1236,1478,1310,1523,1578,1863,679,891,949,1 168,973,1207,1258,1507,1046,1298,1324,1543,1374, 1606, 1640, 1926, 1103, 1351, 1399, 162 0,1435,1685,1703,1964,1497,1729, 1792,2022, 1837,2076,2187,2388,701,957, 1027, 1267, 1 086,1316,1371,1615,1121,1379,1413,1666,1454,1701,1751,2004,1195,1443,1481,1724,15 38,1780,1831,2094,1566,1844,1892,2138,1942,2206,2246,2551,1255,1512,1551,1800,162 5,1859,1901,2174,1694,1917,1966,2229,2024,2254,2343,2635,1749,1986,2044,2302,2070 ,2372,2411,2705,2181,2430,2473,2691,2516,2760,2845,3100,355,497,532,815,585,834,88 3,1145,591,887,933,1178,981,1242,1273,1573,674,937,985,1283,1035,1307,1345,1576,10 68,1339,1391,1652,1446,1692,1713,1962,690,1024,1075,1289,1135,1354,1402,1689,1165 ,1427,1457,1717,1489,1776,1811,2066,1162,1483,1517,1772,1563,1835,1867,2142,1630, 1907,1946,2204,1982,2242,2311,2613,748,1114,1138,1419,1188,1470,1515,1758,1220,15 30,1548,1829,1593,1882,1915,2199,1382,1581,1628, 1890, 1671, 1938, 1980,2235, 1735, 199 4,2054,2296,2102,2368,2416,2678,1467,1659,1722,1958,1769,2018,2060,2347,1820,2084 ,2118,2383,2189,2450,2490,2739,1897,2185,2210,2474,2237,2520,2461,2780,2324,2605, 2639,2863,2653,2946,2990,3149,777,1181,1198,1561,1357,1603,1635,1905,1424,1647,16 75,1950,1733,2000,2052,2352,1462,1726,1767,2002,1798,2062,2108,2395,1846,2124,217 0,2438,2233,2483,2548,2792,1571,1778,1809,2104,1865,2156,2216,2464,1948,2218,2248 ,2543,2327,2511,2624,2869,2016,2285,2363,2607,2397,2650,2684,2921,2452,2698,2695, 2979,2783,3011,3047,3251,1656,1839,1909,2222,1996,2252,2307,2568,2056,2349,2374,2 642,2428,2659,2694,2941,2110,2405,2466,2681,2491,2702,2786,3014,2564,2804,2836,30 56,2892,3112,3143,3350,2201,2478,2536,2789,2621,2795,2880,3071,2632,2871,2926,313 1,2968,3172,3228,3422,2661,2949,3003,3192,3032,3237,3211,3445,3093,3278,3306,3511 ,3364,3546,3588,3696,419,546,604,856,651,941,989,1261,685,1005,1038,1280,1082,1333 ,1348,1678,695,1079,1110,1330,1141,1473,1499,1747,1223,1502,1558,1822,1601,1871,1 913,2227,706,1131,1185,1486,1230,1553,1586,1854,1264,1613,1642,1922,1682,1972,201 0,2257,1301,1664,1708,1992,1760,2046,2080,2336,1783,2068,2128,2402,2136,2437,2481 ,2851,896,1227,1252,1596,1286,1644,1680,1956,1365,1715,1738,2032,1789,2090,2122,2 358,1416,1745,1807,2074,1850,2132,2148,2419,1888,2150,2168,2486,2283,2523,2594,28 70,1465,1848,1876,2164,1934,2212,2223,2503,1978,2280,2316,2563,2381,2616,2645,292 9,2030,2342,2400,2647,2456,2675,2745,2970,2535,2754,2807,3018,2839,3066,3117,3343 ,912,1276,1336,1706,1410,1740,1796,2098,1449,1816,1857,2154,1899,2179,2193,2495,1 528,1880,1932,2195,1974,2270,2305,2553,2026,2331,2377,2631,2423,2664,2719,2932,15 88,1954,2008,2313,2082,2367,2361,2667,2112,2409,2433,2708,2506,2748,2772,3023,217 5,2459,2528,2763,2556,2821,2842,3074,2602,2866,2903,3133,2976,3179,3231,3425,1632 ,2038,2088,2414,2144,2447,2508,2757,2265,2531,2576,2830,2584,2848,2886,3108,2289, 2579,2599,2877,2670,2901,2958,3169,2731,2973,3000,3194,3044,3255,3288,3457,2333,2 687,2714,2935,2774,2982,3008,3218,2810,3039,3078,3276,3121,3310,3356,3524,2909,30 84,3137,3321,3185,3371,3391,3579,3222,3409,3441,3602,3486,3642,3690,3819,977,1368 ,1430,1818,1520,1874,1924,2240,1546,1940,1988,2276,2036,2322,2391,2722,1618,2014, 2096,2354,2130,2444,2425,2737,2158,2469,2515,2801,2571,2824,2857,3096,1765,2116,2 162,2442,2263,2500,2540,2833,2274,2573,2590,2860,2619,2889,2918,3156,2291,2610,26 56,2915,2728,2955,2993,3198,2766,3029,3041,3258,3081,3292,3331,3502,1787,2259,226 8,2559,2294,2582,2627,2898,2338,2673,2711,2943,2751,2984,3036,3245,2525,2725,2777 ,2997,2813,3059,3086,3282,2895,3091,3140,3324,3188,3367,3387,3574,2587,2818,2874, 3062,2912,3127,3163,3339,2965,3175,3205,3383,3241,3413,3453,3617,3005,3224,3265,3 437,3304,3465,3499,3653,3346,3515,3541,3680,3565,3726,3737,3887,1803,2300,2318,27 15,2498,2742,2769,3026,2545,2798,2827,3069,2883,3105,3152,3335,2595,2854,2906,311 5,2938,3165,3207,3379,2987,3235,3201,3402,3286,3448,3482,3632,2734,2924,2952,3181 ,3021,3214,3262,3429,3054,3268,3300,3469,3327,3490,3528,3674,3124,3314,3354,3507, 3395,3551,3570,3714,3418,3597,3612,3751,3647,3769,3784,3860,2815,2962,3051,3272,3 103,3296,3317,3494,3147,3360,3375,3538,3406,3555,3607,3732,3159,3398,3432,3593,34 77,3622,3626,3776,3520,3658,3669,3790,3703,3828,3843,3939,3247,3462,3474,3637,353 3,3663,3686,3805,3560,3708,3719,3835,3757,3851,3897,3964,3583,3744,3763,3869,3797 ,3877,3906,3978,3812,3917,3927,3994,3951,4010,4031,4056,229,504,662,1008,763,1050, 1158,1459,838,1124,1217,1525,1295,1598,1623,2012,904,1191,1246,1583,1362,1661,176 3,2042,1421,1754,1710,2092, 1861,2146,2183,2485,961, 1319, 1405, 1687, 1441, 1742, 1805, 2106,1541,1842,1878,2152,1976,2225,2255,2546,1611,1895,1998,2244,2034,2293,2340,2 589,2086,2351,2398,2669,2421,2703,2761,3025,1089,1342,1491,1833,1556,1869,1968,21 97,1637,2006,1903,2261,2064,2309,2370,2615,1731,1990,2078,2345,2120,2384,2418,268 9,2172,2431,2493,2735,2541,2781,2823,3099,1824,2100,2160,2412,2231,2457,2521,2770 ,2281,2526,2586,2805,2623,2861,2902,3157,23 59,2608,2680,2876,2697,2905,2956,3203, 2752,2972,3012,3238,3050,3269,3320,3535,1270,1475,1568,1984,1673,2028,2050,2365,1 774,2072,2126,2407,2177,2454,2471,2767,1852,2134,2191,2462,2250,2518,2574,2811,23 03,2577,2611,2847,2686,2893,2945,3186,1920,2214,2287,2538,2314,2581,2634,2879,240 4,2672,2700,2911,2749,2969,2998,3236,2468,2726,2775,2983,2808,3040,3055,3264,2864 ,3077,3129,3307,3167,3344,3415,3537,1952,2298,2379,2643,2449,2692,2746,2977,2488, 2755,2787,3022,2826,3052,3097,3295,2566,2814,2850,3073,2908,3120,3161,3355,2934,3 171,3210,3385,3249,3428,3452,3627,2629,2882,2919,3136,2986,3184,3216,3407,3048,32 29,3267,3442,3309,3458,3512,3671,3095,3281,3322,3487,3340,3527,3550,3705,3412,356 1,3585,3698,3609,3731,3771,3880,1385,1649,1699,2114,1785,2140,2202,2513,1794,2208 ,2267,2550,2325,2618,2648,2939,1911,2272,2329,2658,2390,2683,2720,2942,2426,2717, 2764,3010,2817,3046,3063,3263,1936,2375,2435,2666,2501,2729,2778,3043,2533,2799,2 829,3067,2858,3116,3145,3336,2530,2852,2887,3113,2931,3164,3190,3386,2991,3220,32 50,3426,3279,3451,3492,3659,2020,2479,2505,2793,2561,2841,2885,3101,2592,2899,291 6,3160,2959,3202,3227,3423,2758,2948,2989,3209,3 028,3 244,3277,3446,3082,3287,3329 ,3483,3361,3526,3553,3692,2838,3017,3070,3260,3111,3305,3333,3513,3153,3349,3372, 3534,3417,3572,3594,3722,3213,3414,3430,3586,3447,3610,3578,3741,3500,3655,3672,3 778,3679,3817,3836,3900,2058,2555,2569,2928,2732,2966,2996,3219,2796,3007,3030,32 54,3080,3291,3326,3517,2832,3076,3109,3293,3135,3334,3365,3540,3173,3376,3404,356 6,3443,3590,3625,3746,2936,3119,3144,3362,3189,3396,3434,3580,3253,3435,3454,3623 ,3501,3606,3665,3780,3302,3476,3522,3656,3543,3678,3695,3806,3573,3701,3700,3831, 3742,3845,3859,3936,3015,3168,3223,3436,3290,3455,3489,3635,3330,3514,3530,3673,3 559,3682,3699,3814,3366,3547,3581,3693,3595,3704,3743,3846,3634,3752,3766,3863,37 93,3885,3898,3969,3424,3587,3619,3745,3664,3747,3787,3870,3670,3783,3808,3892,382 5,3908,3928,3989,3683,3818,3841,3915,3854,3932,3922,3997,3878,3945,3955,4014,3973 ,4023,4033,4055,1510,1719,1813,2166,1886,2278,2334,2637,1928,2356,2393,2655,2445, 2709,2723,3033,1944,2440,2476,2706,2510,2844,2867,3092,2597,2873,2925,3155,2963,3 193,3226,3440,1960,2496,2558,2855,2603,2922,2951,3180,2640,2975,3001,3232,3037,32 71,3299,3459,2677,3019,3061,3285,3104,3325,3345,3506,3123,3338,3377,3545,3382,356 4,3589,3773,2220,2600,2626,2961,2662,3004,3035,3259,2740,3065,3085,3315,3128,3353 ,3374,3519,2790,3089,3141,3341,3177,3381,3390,3554,3206,3392,3403,3592,3475,3611, 3649,3782,2835,3176,3197,3401,3242,3431,3439,3601,3274,3472,3495,3633,3532,3661,3 675,3809,3312,3509,3544,3677,3575,3691,3724,3826,3618,3728,3753,3847,3767,3867,38 88,3966,2239,2651,2712,3058,2784,3088,3132,3359,2820,3148,3182,3393,3215,3411,341 9,3596,2896,3199,3240,3420,3273,3468,3488,3629,3311,3503,3531,3667,3557,3684,3711 ,3810,2953,3256,3297,3493,3348,3525,3521,3687,3369,3548,3562,3706,3603,3725,3736, 3849,3408,3577,3615,3733,3630,3759,3768,3871,3654,3779,3798,3893,3830,3910,3930,3 991,2994,3319,3351,3552,3388,3571,3604,3729,3464,3616,3640,3764,3645,3772,3789,38 84,3478,3641,3651,3786,3688,3796,3822,3907,3717,3829,3839,3916,3858,3937,3949,400 0,3505,3697,3709,3811,3738,3832,3844,3924,3754,3856,3872,3944,3889,3956,3971,4018 ,3800,3874,3894,3959,3913,3975,3981,4030,3925,3986,3996,4036,4007,4044,4054,4075, 2320,2743,2802,3151,2890,3196,3233,3449,2913,3246,3283,3471,3316,3498,3539,3713,2 980,3301,3357,3518,3380,3568,3558,3720,3397,3582,3608,3749,3638,3761,3775,3879,31 07,3370,3399,3567,3463,3600,3621,3765,3470,3639,3648,3777,3662,3791,3804,3902,348 0,3657,3681,3802,3716,3821,3837,3918,3734,3852,3857,3938,3873,3950,3962,4012,3125 ,3460,3466,3631,3481,3643,3666,3795,3508,3689,3707,3816,3727,3833,3855,3934,3614, 3715,3739,3838,3755,3864,3875,3946,3794,3876,3895,3960,3914,3974,3980,4029,3646,3 758,3785,3865,3801,3891,3904,3965,3824,3909,3920,3979,3933,3987,3999,4039,3842,39 26,3941,3995,3954,4002,4011,4046,3967,4015,4022,4052,4027,4061,4063,4083,3139,348 4,3496,3710,3599,3723,3735,3850,3624,3748,3762,3868,3788,3883,3901,3963,3650,3774 ,3799,3886,3813,3905,3921,3977,3834,3931,3919,3984,3948,3998,4006,4042,3718,3807, 3820,3911,3848,3923,3940,3992,3862,3942,3953,4003,3961,4008,4019,4051,3890,3957,3 970,4013,3982,4024,4028,4059,3988,4035,4038,4065, 4045,4068,4070,4080,3756,3823,38 61,3943,3882,3952,3958,4009,3899,3972,3976,4021,3985,4025,4037,4062,3903,3983,399 3,4034,4005,4040,4041,4069,4017,4047,4050,4071,4057,4076,4078,4088,3935,4001,4004 ,4043,4020,4048,4053,4073,4026,4058,4060,4077,4066,4079,4084,4090,4032,4064,4067, 4081,4072,4082,4085,4091,4074,4086,4087,4092,4089,4093,4094,4095];
where the sequence Z3 is given by
[0,1,2,7,3,8,12,25,4,11,14,29,17,34,36,79,5,13,15,33,20,40,49,84,23,48,44,91,59,100, 106,170,6,18,22,42,24,47,53,93,30,57,61,101,74,113,119,187,35,63,77,117,82,126,136,19 9,90,138,149,224,155,236,257,366,9,19,27,56,31,60,73,108,37,78,65,120,87,130,143,207, 46,76,89,137,95,146,154,231,104,157,173,247,186,264,280,404,55,92,102,153,115,164,18 0,260,124,181,198,273,210,296,311,436,141,205,228,300,234,312,334,463,253,341,360,4 85,378,505,540,721,16,26,32,75,41,81,85,142,50,88,96,152,105,163,167,259,58,97,107,16 5,118,179,195,275,129,196,206,290,230,307,329,453,67,111,125,185,131,197,213,301,15 0,226,235,315,252,340,354,483,166,244,261,346,274,373,381,502,297,392,420,531,441,5 57,613,722,71,127,145,216,161,232,251,344,171,254,266,365,281,380,402,522,193,277,2 91,390,313,415,438,566,324,444,467,588,491,623,644,818,212,303,318,424,348,451,471, 606,377,479,503,635,532,648,697,870,401,513,542,674,554,713,735,914,610,746,771,905 ,797,950,1007,1188,21,38,43,94,51,98,109,178,52,110,121,188,133,208,218,327,66,122,1 34,221,147,229,242,328,156,240,258,359,278,376,385,501,69,144,158,223,175,245,262,3 75,184,271,282,387,294,413,429,552,183,292,305,411,323,440,455,590,350,474,493,622, 511,642,679,856,80,169,176,268,191,287,304,405,201,310,317,437,335,462,478,619,255, 330,349,466,367,489,510,638,395,517,546,671,570,711,738,897,286,362,389,499,410,529 ,549,699,433,561,578,719,614,758,781,936,469,612,625,772,639,799,764,963,686,851,87 2,1019,881,1077,1108,1225,86,189,194,322,246,339,352,473,270,357,369,495,394,520,54 5,702,284,391,409,521,423,550,573,726,445,581,604,751,637,777,816,971,326,414,428,5 71,454,597,628,766,494,629,645,813,688,794,863,1023,528,665,708,852,727,879,901,105 9,759,910,908,1100,965,1123,1149,1303,361,442,475,631,518,647,677,828,547,700,714,8 74,745,885,907,1073,574,732,767,899,782,912,967,1125,826,979,1001,1156,1039,1197,1 220,1381,620,774,809,969,861,973,1031,1167,868,1025,1063,1211,1092,1242,1285,1439, 886,1079,1117,1257,1138,1292,1272,1458,1183,1324,1346,1513,1392,1543,1579,1673,28, 45,54,103,62,123,135,214,68,139,148,220,160,238,243,370,70,159,168,237,177,288,298,4 00,202,299,321,434,338,457,477,634,72,174,190,293,204,319,332,449,215,343,355,481,3 72,506,525,650,227,364,383,516,406,543,559,693,416,553,583,730,587,750,776,1011,112 ,203,211,336,222,356,371,498,249,386,396,536,419,564,580,705,267,399,427,556,447,58 5,593,740,465,594,603,779,664,801,844,1024,285,446,459,601,487,626,632,789,509,662, 682,825,718,858,876,1065,535,696,729,877,761,895,940,1094,808,946,981,1128,1003,11 63,1201,1375,116,219,239,382,265,397,422,568,279,431,450,596,470,609,616,784,309,46 1,486,617,507,657,676,819,533,690,716,867,742,888,923,1067,333,497,524,680,560,710, 707,890,575,734,748,916,791,942,958,1132,607,763,804,952,821,991,1005,1169,849,102 1,1047,1213,1098,1247,1287,1442,351,539,563,737,591,756,792,948,654,806,833,997,83 8,1009,1035,1194,667,835,847,1029,892,1045,1085,1240,931,1096,1115,1259,1147,1306, 1332,1468,691,903,920,1069,959,1102,1121, 1277,983, 1143, 1172, 1322, 1204, 1349, 1386, 15 24,1051,1176,1216,1358,1252,1398,1414,1571,1280,1429,1455,1591,1492,1626,1668,178 4,132,250,272,432,306,458,482,641,316,490,514,660,538,685,724,925,345,527,567,703,5 84,754,743,935,598,769,796,977,830,993,1015,1185,408,577,600,753,653,787,811,999,65 9,831,842,1017,860,1037,1057,1230,668,854,883,1055,929,1083,1110,1262,954,1136,114 5,1308,1174,1335,1366,1506,418,651,656,823,670,837,865,1043,694,894,918,1075,944,1 104,1141,1298,802,927,961,1113,985,1158,1178,1327,1041,1181,1218,1360,1254,1395,14 11,1567,840,989,1027,1160,1053,1208,1235,1372, 1090, 1244, 1267, 1408, 1295, 1432, 1465, 1604,1119,1282,1314,1452,1344,1475,1503,1635,1378,1517,1539,1659,1559,1700,1710,1 847,425,673,683,921,786,938,956,1134,814,975,995,1165,1033,1192,1227,1369,845,1013 ,1049,1199,1071,1237,1269,1404,1106,1290,1264,1423,1330,1461,1489,1617,933,1061,1 081,1249,1130,1274,1311,1445,1154,1316,1341,1478,1363,1496,1528,1654,1206,1352,13 84,1510,1417,1547,1563,1689,1436,1587,1600,1722,1630,1739,1752,1822,987,1088,1152 ,1319,1190,1338,1355,1499,1223,1389,1401,1536,1426,1551,1595,1705,1232,1420,1448, 1583,1485,1608,1612,1745,1521,1640,1649,1758, 1679, 1792, 1806, 1896, 1300, 1472, 1482, 1 621,1532,1644,1664,1771,1555,1684,1694,1799,1728,1814,1856,1920,1575,1716,1733,18 30,1764,1838,1865,1933,1778,1875,1885,1948,1907,1964,1984,2008,10,39,64,140,83,151 ,182,283,99,172,200,308,225,337,347,526,114,192,209,331,248,363,407,541,269,403,384, 565,452,592,611,778,128,233,263,374,276,398,426,572,314,443,460,595,508,633,649,815 ,342,468,519,643,537,669,695,841,562,701,728,891,741,913,951,1133,162,241,295,439,3 20,456,504,618,353,523,472,652,551,678,712,857,393,515,558,698,579,720,739,904,605, 747,783,934,812,964,992,1187,435,569,599,736,636,762,800,957,663,803,839,980,862,10 18,1046,1231,706,853,898,1028,909,1048,1084,1266,945,1095,1124,1293,1151,1317,135 7,1534,217,289,325,512,368,534,544,709,412,555,582,733,608,760,770,955,448,586,615, 765,646,798,832,984,675,834,855,1008,902,1040,1076,1253,480,627,666,810,681,836,86 9,1030,731,893,911,1052,943,1093,1114,1291,768,928,960,1103,982,1144,1155,1313,102 0,1171,1210,1347,1238,1376,1434,1535,496,672,717,875,757,906,941,1099,780,947,968, 1131,994,1153,1186,1337,827,986,1010,1168,1050, 1203, 1234, 1385, 1068, 1241, 1271, 1409, 1301,1444,1464,1613,866,1032,1058,1215,1105,1251,1276,1427,1150,1286,1315,1456,13 48,1469,1514,1651,1184,1326,1359,1493,1373,1527,1546,1681,1431,1556,1576,1675,159 7,1704,1740,1841,256,358,379,576,417,589,621,795,421,624,655,817,687,859,878,1072,4 76,658,689,884,723,900,924,1074,744,922,953,1122,988,1148,1161,1312,488,715,749,88 9,788,930,962,1146,807,976,996,1164,1016,1200,1222,1370,805,1012,1036,1198,1066,12 36,1256,1410,1109,1279,1302,1443,1325,1463,1497,1641,530,775,790,972,824,1004,103 4,1189,843,1044,1056,1233,1086,1265,1284,1440,949,1078,1107,1270,1135,1297,1323,1 459,1175,1331,1364,1490,1390,1526,1549,1670,1002,1127,1166,1310,1196,1345,1367,15 15,1228,1380,1399,1533,1435,1565,1584,1696,1273,1433,1446,1577,1460,1598,1570,171 3,1504,1637,1652,1747,1658,1782,1800,1859,548,820,829,1064,932,1091,1112,1278,974, 1120,1137,1305,1173,1334,1362,1518,998,1170,1195,1336,1214,1368,1393,1538,1243,14 02,1425,1560,1457,1581,1611,1718,1070,1202,1221, 1391, 1255, 1418, 1449, 1572, 1304, 145 0,1466,1609,1505,1594,1646,1749,1343,1484,1523, 1638, 1540, 1657, 1672, 1772, 1566, 1678 ,1677,1795,1714,1808,1821,1893,1126,1239,1281,1451,1333,1467,1495,1620,1365,1516, 1529,1653,1554,1661,1676,1780,1394,1544,1573,1671,1585,1680,1715,1809,1619,1723,1 736,1825,1760,1845,1857,1924,1441,1578,1606,1717,1645,1719,1755,1831,1650,1751,17 74,1852,1790,1867,1886,1944,1662,1783,1804,1873,1816,1889,1880,1951,1839,1902,191 1,1968,1928,1976,1986,2007,302,388,430,602,464,661,692,871,484,704,725,882,755,917, 926,1139,492,752,773,915,793,1006,1022,1182,846, 1026, 1062, 1229, 1089, 1258, 1283, 145 4,500,785,822,1014,850,1060,1080,1248,873,1097, 1116, 1288, 1142, 1318, 1340, 1470,896, 1 129,1159,1329,1191,1361,1377,1509,1205,1371,1403,1542,1407,1558,1580,1742,630,848 ,864,1087,887,1118,1140,1309,937,1162,1177,1353, 1209, 1383, 1400, 1520,970, 1180, 1219, 1374,1246,1406,1413,1550,1268,1415,1424,1582,1483,1599,1632,1750,1000,1245,1261,1 422,1296,1447,1453,1590,1321,1481,1500,1618,1531,1642,1655,1775,1351,1512,1541,16 56,1568,1669,1698,1791,1605,1702,1724,1810,1737,1828,1848,1922,640,880,919,1157,9 66,1179,1212,1388,990,1224,1250,1416,1275,1430,1437,1586,1042,1263,1294,1438,1320 ,1477,1494,1614,1350,1507,1530,1648,1552,1663,1687,1776,1082,1307,1339,1498,1379, 1525,1522,1665,1396,1545,1557,1682,1592,1699, 1709, 1812, 1428, 1569, 1602, 1706, 1615, 1 730,1738,1832,1636,1748,1765,1853,1794,1869, 1887, 1945, 1111, 1356, 1382, 1548, 1412, 15 64,1593,1703,1474,1603,1624,1734,1628,1741,1757,1844,1486,1625,1634,1754,1666,176 3,1787,1866,1692,1793,1803,1874,1820,1894,1905,1954,1508,1674,1685,1777,1711,1796 ,1807,1882,1725,1818,1833,1901,1849,1912,1926,1971,1767,1835,1854,1915,1871,1930, 1936,1983,1883,1941,1950,1989, 1961, 1997,2006,2027,684,939,978, 1226, 1038, 1260, 1289 ,1462,1054,1299,1328,1480,1354,1502,1537,1688,1101,1342,1387,1519,1405,1562,1553, 1695,1419,1574,1596,1721,1622,1731,1744,1840, 1193, 1397, 1421, 1561, 1473, 1589, 1607, 1 735,1479,1623,1631,1746,1643,1759,1770,1861, 1487, 1639, 1660, 1769, 1691, 1786, 1801, 18 76,1707,1815,1819,1895,1834,1906,1918,1966,1207,1471,1476,1616,1488,1627,1647,176 2,1511,1667,1683,1781,1701,1797,1817,1891,1601,1690,1712,1802,1726,1826,1836,1903 ,1761,1837,1855,1916,1872,1929,1935,1982,1629,1729,1753,1827,1768,1851,1863,1921, 1789,1868,1878,1934,1890,1942,1953,1992,1805,1884,1898,1949,1910,1956,1965,1999,1 923,1969,1975,2004,1980,2013,2015,2035,1217,1491, 1501, 1686, 1588, 1697, 1708, 1813, 16 10,1720,1732,1829,1756,1843,1860,1919,1633,1743,1766,1846,1779,1864,1879,1932,179 8,1888,1877,1939,1904,1952,1960,1995,1693,1773,1785,1870,1811,1881,1897,1946,1824 ,1899,1909,1957,1917,1962,1972,2003,1850,1913,1925,1967,1937,1977,1981,2011,1943, 1988,1991,2017,1998,2020,2022,2032,1727,1788, 1823, 1900, 1842, 1908, 1914, 1963, 1858, 1 927,1931,1974,1940,1978,1990,2014,1862,1938, 1947, 1987, 1959, 1993, 1994,2021, 1970,20 00,2002,2023,2009,2028,2030,2040,1892,1955,1958,1996,1973,2001,2005,2025,1979,201 0,2012,2029,2018,2031,2036,2042,1985,2016,2019,2033,2024,2034,2037,2043,2026,2038 ,2039,2044,2041,2045,2046,2047];
wherein each of sequence numbers of N polarized channels in the second sequence corresponds to a reliability ranking of the sequence number in the entire sequence, and a minimum value of the sequence numbers of the polarized channels is 0.

3. A polar polar code encoding apparatus (300), comprising:
a processor (402, 502) configured to perform the method according to claim 1.

4. The apparatus (300) according to claim 2 or 3, wherein the polar code encoding apparatus (300) is a chip or an integrated circuit.

5. A wireless device, comprising the encoding apparatus (300) according to one of claims 2 to 4, a modulator, and a transceiver, wherein
the modulator is configured to modulate an encoded bit sequence to obtain a modulated sequence; and
the transceiver is configured to process the modulated sequence.

6. The device according to claim 5, wherein the wireless device is a terminal (112) or a network device (110).

7. A communications system, wherein the communications system comprises a network device (110) and a terminal (112), and the network device (110) or the terminal (112) is configured to perform the method according to claim 1.

8. A computer storage medium comprising instructions which, when executed by a computer, cause the computer to carry out the method according to claim 1.

9. A computer program product comprising instructions which, when the program is executed by a computer, cause the computer to carry out the method according to claim 1.

## Patentansprüche

1. Polar-Polar-Code-Codierungsverfahren, umfassend:
Erhalten (201), durch eine Codierungs-Einrichtung (300), einer ersten Sequenz, die zum Codieren von K zu codierenden Bits verwendet wird, wobei die erste Sequenz Sequenznummern von N polarisierten Kanälen umfasst, wobei die Sequenznummern der N polarisierten Kanäle in der ersten Sequenz basierend auf einer Zuverlässigkeit der N polarisierten Kanäle angeordnet sind, wobei K eine positive ganze Zahl ist, N eine Muttercodelänge eines Polar-Codes ist, N = 2ⁿ, n eine positive ganze Zahl ist und K ≤ N;
Auswählen (202) von Sequenznummern von K polarisierten Kanälen aus der ersten Sequenz in absteigender Reihenfolge der Zuverlässigkeit; und
Platzieren (203) der zu codierenden Bits basierend auf den ausgewählten Sequenznummern der K polarisierten Kanäle und Durchführen einer Polar-Code-Codierung an den zu codierenden Bits;
wobei die erste Sequenz eine gesamte zweite Sequenz ist, die zweite Sequenz Sequenznummern von Nₘₐₓ polarisierten Kanälen umfasst, wobei die Sequenznummern der Nₘₐₓ polarisierten Kanäle in der zweiten Sequenz basierend auf der Zuverlässigkeit der Nₘₐₓ polarisierten Kanäle angeordnet sind, Nₘₐₓ eine positive ganze Zahl ist, Nₘₐₓ ≥ N, und ein Sortieren der Sequenznummern der polarisierten Kanäle in der ersten Sequenz mit einer Sortierung von Sequenznummern von polarisierten Kanälen, die kleiner als N in der zweiten Sequenz sind, übereinstimmend ist;
**dadurch gekennzeichnet, dass**
die zweite Sequenz ein Teil oder die gesamte Sequenz Q1, eine Sequenz Q2 oder eine Sequenz Q3 ist;
wobei die Sequenz Q1 gegeben ist durch:
[0,1,2,4,8,16,32,3,5,64,1024,2048,4096,9,6,17,10,18,128,12,33,65,20,256,34,24,36,7,129 ,66,512,11,40,68,130,19,13,48,14,72,257,1025,21,132,35,258,26,2049,513,80,37,25,22,4 097,136,260,264,38,514,96,67,41,144,28,69,42,516,49,1026,74,272,160,520,288,528,19 2,544,70,44,131,81,2050,50,73,15,320,133,52,1028,23,134,384,76,4098,137,82,56,27,97 ,39,259,84,138,145,261,1032,29,43,2052,98,515,88,140,30,146,71,262,265,161,576,45,1 040,100,640,51,148,46,75,4100,266,273,517,2056,104,162,53,193,1056,152,77,164,768, 268,274,518,54,83,57,521,1027,112,135,2064,78,289,194,85,276,4104,522,58,168,1029, 139,99,86,60,280,89,290,529,2080,524,196,1088,141,101,147,176,142,530,321,31,200,1 033,4112,90,545,292,2051,322,532,263,149,102,105,1030,304,296,163,92,47,267,385,5 46,2053,324,1041,208,386,4128,150,153,165,106,55,1034,328,536,577,548,2112,113,15 4,79,269,1042,108,578,224,166,519,552,195,4099,1152,270,3072,641,523,275,580,291, 59,1036,169,560,114,277,156,2057,87,197,1057,116,170,4101,61,531,525,642,281,1089 ,278,526,2054,177,293,388,91,1044,584,769,198,172,120,4160,201,2065,336,1280,62,2 82,143,103,178,294,1058,93,644,2058,202,592,323,1048,392,5120,297,770,107,180,151 ,1060,2066,209,284,648,94,204,298,1031,400,608,352,2176,6144,325,533,1153,155,210 ,305,547,300,1090,109,2060,184,534,537,115,167,1536,4105,225,326,306,772,2081,157 ,1035,656,329,110,117,212,1064,171,2113,776,4102,330,226,549,1092,538,387,308,216 ,2068,1154,416,271,279,158,337,1043,4113,550,672,2304,118,332,579,1037,540,389,17 3,121,1072,2082,553,199,784,4106,179,1038,228,338,312,2072,704,390,1096,174,554,5 81,393,1281,4114,283,2084,122,448,353,1045,561,203,63,340,2055,1156,394,527,582,4 224,556,181,1059,2177,295,285,232,124,1282,205,182,643,2114,4108,562,1050,286,58 5,299,1537,354,211,2560,401,185,1104,396,344,4129,586,645,2059,1061,593,535,240,2 06,1049,95,2088,327,564,4161,1046,800,402,356,307,2116,1160,301,417,213,568,1284, 832,4116,2178,588,186,1288,646,404,227,896,2067,1062,594,418,4352,302,1538,649,7 71,2061,360,539,1120,111,331,214,1091,2096,4130,309,188,449,1065,217,408,2062,60 9,596,1168,551,650,4120,229,1052,2120,159,420,310,1093,541,773,2305,610,4132,106 6,657,333,119,1540,3073,600,339,218,1073,368,652,4103,230,2069,1098,391,313,450,1 296,542,2180,334,233,4225,1184,555,774,175,2083,1544,123,658,612,1312,2306,4162, 341,777,220,1552,314,424,2074,395,1216,673,583,4608,355,1568,2561,287,183,234,10 94,125,557,2128,4107,660,1068,616,342,316,2085,1155,241,778,1105,563,4136,345,20 73,452,1074,397,403,207,2070,1097,674,4164,558,1039,785,432,2184,357,1344,187,23 6,664,4226,2308,1157,624,587,1076,780,2312,705,126,1047,4115,242,565,1158,2086,3 98,346,456,1408,358,2562,4109,405,1100,303,569,244,2144,1161,595,189,4144,1106,5 66,2115,676,361,1080,706,589,2089,1051,4110,215,786,647,1121,2192,348,419,1063,4 06,4168,464,2076,680,1283,801,362,1108,2117,590,4353,409,1162,570,2090,788,597,1 169,572,219,5121,2564,1285,311,708,1053,598,2097,601,1067,4117,651,421,3074,792, 1122,802,611,1539,2122,4228,602,410,1112,231,688,2320,1164,653,248,4131,1054,220 8,369,190,364,1170,654,2568,4354,659,1095,335,480,2336,1286,315,221,1289,4122,25 76,370,613,1185,422,425,2240,1600,6145,451,614,1069,2592,543,235,1124,412,4609,2 118,343,372,1664,775,317,2092,1075,222,4176,426,1172,2179,453,237,1070,559,2129, 4133,833,1099,804,712,2098,1290,834,661,4121,1297,2121,808,779,1541,617,1128,206 3,4118,604,433,1186,720,2368,816,1077,4232,836,347,2181,1217,897,243,1176,2100,4 356,662,454,1101,318,3076,675,1188,618,4360,898,2071,1792,781,376,2182,1292,4134 ,428,1298,665,2432,736,1542,567,840,4610,2124,1078,625,238,1107,2185,359,4192,45 7,1081,399,2130,787,1545,591,1136,4163,2104,678,434,1159,2075,677,349,4137,1102, 245,2145,458,1313,666,1218,4240,2087,620,363,1109,2307,127,191,4124,1300,782,213 2,1546,407,436,1082,4165,2186,626,571,1192,2193,465,1163,681,4138,246,2309,1123, 707,350,3080,4612,1110,599,1084,668,2077,790,1304,4145,460,2091,249,1113,682,131 4,2146,5122,573,411,1553,2563,803,789,1548,4170,709,2136,1220,365,440,2188,1165, 4368,628,1125,689,2078,374,1171,4256,423,2194,466,1200,793,2119,1166,4616,250,37 1,1554,2310,481,1345,574,4384,2313,413,1055,603,2209,1224,4624,366,468,1114,2624 ,655,1569,900,4288,2093,805,1316,615,3088,1346,4640,684,710,2148,1556,429,1287,4 166,2688,794,252,1173,373,2099,1126,4140,605,848,2196,1129,690,1328,4227,2094,71 3,1320,632,2123,482,4177,1187,806,2314,1116,427,904,6146,2321,1071,414,1291,2565 ,223,663,4146,1409,2152,692,1570,835,2210,4169,1348,619,472,2101,1232,455,4111,1 410,2241,796,809,1174,3104,4416,714,1177,721,2200,1189,837,4229,716,2125,1130,86 4,1079,2212,4148,810,1352,606,2816,912,5124,1560,722,2316,1601,696,1572,4119,232 2,377,435,1137,2566,817,4230,1178,319,2102,1103,621,1293,4480,2131,812,484,1132, 2105,430,4172,1602,838,2569,1248,667,4233,3075,488,1190,239,2160,1543,4178,378,1 576,2183,459,1219,622,4152,2126.627,1294,437,2337,4123,1665,380,2242,1547,818,12 99,4193,2133,461,496,1604,2324,4135,669,1315,2570,679,1083,724,4355,2106,1193,84 1,629,2216,4180,1584,351,1138,3077,467,1301,4234,2187,438,1180,737,2147,4241,111 1,251,1221,2134,462,4357,442,2108,1140,441,1194,2328,5128,469,1085,2137,247,1555 ,4125,683,2338,1549,842,1666,4139,2577,738,899,2572,1305,6148,670,1302,2244,783, 1550,3136,4194,849,1201,820,2189,1317,4611,728,2149,1412,928,1115,4184,2195,791, 367,2224,1608,4236,901,1793,2190,630,1222,4126,2578,685,1196,844,2369,4242,1144, 633,2079,1225,711,4167,1360,2248,253,1086,3081,4358,691,1306,824,2138,1167,4361, 902,2593,1127,686,740,4257,2340,1202,850,2370,1318,4672,375,2580,1117,444,1668,4 141,2311,470,1226,2197,483,5136,1616,415,2150,1347,485,4196,2153,1416,905,3078,1 321,4736,795,1794,2352,473,4147,1131,2344,634,1204,2211,4244,744,1175,852,2140,1 233,4142,960,2095,1308,865,2315,4171,1672,693,2433,1118,4362,797,1228,2594,906,1 322,4369,2372,715,1424,3089,807,4613,1632,474,2256,1376,6152,636,2434,1349,694,2 198,4200,1557,254,2201,1179,717,4258,2213,1234,575,1329,4149,2154,913,1571,2103, 798,4289,1324,3082,811,1133,5152,2376,379,1208,2584,697,4248,1558,431,2625,607,4 173,489,2596,1561,866,2161,4260,1139,723,2202,1191,4864,486,2127,1249,908,2317,4 364,1350,718,1330,3090,4370,813,1796,2156,476,4614,1181,2626,856,1680,2272,4150, 839,1353,2214,725,4179,1134,2567,698,1141,2600,4153,914,1236,2243,752,4617,1195, 3200,868,1800,5123,2318,819,1354,2689,4208,814,1250,439,2571,1573,4231,929,2323, 1562,490,6160,2628,1411,623,2339,4174,1332,671,2107,1240,4385,739,3084,1440,916, 2217,4290,1295,463,2608,1303,4181,843,2162,1182,381,4372,2325,1361,497,2204,461 8,1574,930,2135,1696,4154,821,2245,1142,726,4264,3105,1356,1603,2164,5125,961,22 18,1564,872,2109,4235,1413,492,2579,1197,4195,631,2573,1145,729,4182,2690,1577,7 00,2329,4156,1223,443,3137,1808,4376,741,2326,1203,845,4185,2574,1252,920,2225,4 386,1362,382,2341,1336,4625,822,2436,1728,2139,6176,1414,851,3092,1198,4620,730, 2632,1578,498,4292,2817,1605,880,5184,2246,1417,742,2220,4237,1307,445,2168,114 6,4197,2249,471,1472,2384,4243,1377,635,3328,1585,4272,932,2110,1227,687,4238,23 30,1087,903,2191,4626,1364,2151,825,4417,1418,2226,500,1551,4127,2342,1606,846,3 106,4296,1580,745,2141,1205,5129,2692,826,1319,2250,4186,732,1309,2640,4641,446, 1256,2371,1148,4388,3096,962,1229,2440,6147,936,1206,2345,4418,475,1667,2818,85 3,4628,2155,1586,867,2228,4359,1310,1609,2199,637,4245,1323,3108,907,4198,2257,1 378,487,2332,4201,1235,695,2696,5126,1425,2142,1209,746,4400,2252,1420,828,2346, 4392,1368,3079,753,4259,1610,2448,854,1669,4188,2656,1617,2400,857,4143,1559,23 73,504,4363,1264,2581,799,3201,4481,1230,1119,2203,4642,255,1351,2258,964,6149,2 353,1588,909,4420,2595,1824,719,2348,5137,1426,3138,1380,4304,477,2157,1331,915, 4482,2232,1325,2582,4246,638,1441,2585,1237,4249,2163,748,1592,4261,2215,944,18 56,3584,4202,869,2273,1612,4151,1210,2374,491,5130,2354,1670,699,2820,4424,1428, 1251,2205,4632,754,3083,1920,858,4673,2704,1618,2377,4644,478,1442,2158,6208,13 26,968,2165,1673,4209,2260,383,1795,4250,3112,910,2219,4175,1384,1563,2824,815,4 365,2378,1135,976,5138,2274,1355,2597,4204,1238,870,3140,1333,4674,2586,917,121 2,4320,2435,1473,2356,4262,727,1241,2264,493,4615,3202,1432,873,4648,2464,1633,2 319,4291,1620,701,2327,5248,1575,2206,931,4366,1674,2385,1253,3091,7168,756,118 3,2598,4737,860,2720,1444,4619,1334,2166,499,4371,2380,1565,731,2627,4676,1797,3 085,1634,4387,823,2588,1681,4155,2437,922,1357,5132,2221,1143,2169,4265,874,162 4,3120,4656,918,2601,1363,4210,2247,1242,502,2832,4373,1392,2227,933,4252,1676,3 086,1254,6153,2276,743,1415,4183,2386,1337,2360,4293,760,2752,1474,5153,881,243 8,1566,4212,3144,1358,494,4266,2222,1257,2602,4157,702,2629,1579,4627,1798,2441, 921,4621,3329,1199,501,4738,2331,1147,2170,4377,1682,2496,876,5185,1636,2401,13 65,4374,3093,847,1801,2609,4622,992,2251,6150,1244,2111,1338,4273,447,2388,1448, 4389,3204,1419,2442,4484,733,1697,2575,4187,827,2630,1607,5140,2604,1379,934,46 80,2229,1311,3107,4865,1207,2343,882,4294,1258,2333,937,4268,2280,1149,2172,421 6,1581,963,3330,4297,1684,2253,1640,6161,2230,747,1366,4432,2691,505,2610,5376,1 340,3098,1265,4158,855,2334,4378,1802,2633,1587,4239,2347,924,3585,4199,1369,73 4,2402,4274,1476,2259,1421,4390,2449,829,1427,5154,2233,1231,3152,4189,965,2444, 4740,1698,2392,1582,6154,938,2634,1809,4298,2693,1456,3109,4688,884,1381,2641,4 419,506,2583,5144,1211,2288,1260,4488,2254,749,1688,4393,3097,1648,2143,4866,94 5,2375,1611,4203,2612,1804,4276,966,3094,1729,4247,2848,1150,2450,5156,755,2404, 1266,6162,859,2355,4305,1589,3208,1422,4380,2349,940,2465,4744,1370,2261,4190,1 480,830,2616,4300,1382,3332,1429,4394,2880,911,2636,5127,1327,1593,4496,2234,87 1,3336,4704,1268,2694,1619,4448,2452,639,6272,2275,1213,1590,4421,2944,888,3110, 4629,1700,2642,5249,1385,2466,479,4251,2350,1730,3586,4306,1613,946,4401,2697,1 239,2819,4643,750,2408,4396,1810,2587,1671,5186,3168,969,2159,4205,1372,1443,61 56,2379,508,2262,4280,1430,3139,4630,1488,2357,861,4633,2236,1704,2497,4211,182 5,757,4263,3113,1386,2265,5632,1614,2456,4321,970,2657,1433,4422,2644,1594,3216, 4402,919,2599,4868,1812,1621,2698,6177,1596,2277,4253,875,3100,1243,5131,2207,1 335,4752,2468,862,2358,4425,1732,3141,4206,1622,2589,758,4213,1625,2821,4308,16 75,2658,948,5160,3114,1445,4267,2705,1816,2381,6209,977,2167,4872,1826,3588,163 5,4426,2648,923,4322,2387,1626,2266,4645,1434,972,5188,3121,1255,2416,4634,1712, 2700,4483,761,2278,1677,4404,3146,1272,4312,2439,877,6164,2361,1393,2498,5250,1 214,3344,4512,1388,2590,952,4367,2382,1678,4375,2281,1683,495,4254,3232,1359,44 33,2603,1504,5139,2822,703,2223,4646,1339,3592,4768,1245,2171,935,6400,2706,139 4,4214,2660,1637,4428,3360,978,2389,4675,1446,2825,5133,1449,2268,1475,4636,360 0,883,4485,2362,1638,4269,2472,1567,2443,4217,762,3264,5168,1259,2721,6178,1436, 2631,503,4649,2403,1367,4295,3616,1396,4880,2335,925,2231,4275,1799,2282,5134,1 341,3142,4324,1246,2173,878,4434,2605,1450,4408,2708,1477,6168,3116,735,2664,48 00,1261,2390,4486,1583,2364,5192,1857,3203,4270,993,2289,1828,4650,2826,1736,46 77,3153,885,4489,2611,1858,2393,5377,1685,2500,4379,939,3122,6180,1832,2445,421 8,1803,2451,1641,4544,2255,994,4449,3145,1628,5141,2722,1457,4657,2606,980,3087, 4299,1744,2833,4159,1840,2480,4436,1860,2405,6151,926,3392,5252,1371,2235,1921, 4490,2284,764,4623,2712,1267,4678,3205,1686,4652,2672,1478,2635,4277,941,3124,5 155,1342,2828,6273,1699,2753,4391,967,2174,4381,1642,3095,4328,1922,2290,1805,4 220,2613,886,5378,1400,1452,4301,3206,831,4278,2446,1689,4739,2394,1760,6210,25 04,1591,3456,4658,947,2406,5146,1864,2453,4382,1649,3148,4681,507,2351,4395,126 2,2617,5633,1383,2292,4450,1481,3209,889,4307,2643,1423,6656,2237,1811,4497,315 4,1615,4281,2614,984,5200,2724,1702,4492,2409,1458,4440,3128,751,4682,2754,1701, 4741,2637,1373,3099,6155,1269,2263,5157,942,2834,4689,1482,2695,4631,1690,3169, 4336,1644,2396,4302,996,2467,5145,1387,3111,4191,1151,2454,6184,1215,2512,4423, 971,2728,4660,1806,3331,5142,1431,2849,4896,890,2410,1460,4498,3156,1650,4452,2 638,1595,4403,2457,509,6212,3210,1489,5256,2618,1705,4397,2836,1270,4513,2645,9 49,4309,3217,1731,4664,2620,1374,5380,2267,1623,4928,3333,973,6274,2359,1692,46 84,2756,1814,4282,3101,1484,5384,2646,1000,4742,2649,1273,4500,3115,1706,4323,2 699,1597,4992,2469,892,6163,2840,1435,5158,3170,1827,4690,2850,1813,4514,2659,9 50,4398,3587,1733,5634,2650,1389,4745,2458,1464,4867,3160,863,6157,2279,2736,44 56,1652,4635,3212,1713,5216,2701,1398,4207,2296,759,4427,3102,1447,4310,2417,14 90,5187,2238,1817,6192,2412,1008,4405,3218,1274,4284,2702,1395,4545,2707,1505,5 161,3143,510,4313,2383,1598,4504,2528,3334,6158,1437,2363,4705,1627,4692,2269,9 79,5264,3337,1390,4647,2418,1492,4746,2661,1679,4325,3233,953,5148,2470,1924,62 16,2473,1829,4255,3648,1639,4516,2499,4406,2662,763,5189,3117,1708,4637,2591,17 34,4869,2283,1453,6401,3172,974,4706,2460,1818,5162,2391,1276,4753,2420,4429,13 97,3712,4215,2823,1629,5636,2365,954,7169,3123,1872,4696,2270,1714,4435,2474,43 14,1737,3220,5169,879,2501,4464,1656,2285,4748,3118,1506,4326,2607,1830,6165,28 81,5194,981,3147,4487,1451,2852,4409,1928,2760,4546,1438,3338,5392,2882,982,463 8,2709,6276,1247,3345,4430,1687,2856,4329,1716,2827,5280,1859,3589,4651,927,487 0,2665,3176,4271,1643,2652,6179,1496,2481,5640,1479,3234,4219,995,4754,2768,182 0,4708,2864,1833,5408,3125,2884,6402,1738,4437,2395,1745,4873,3265,765,4316,294 5,1861,5648,2291,4410,3224,1740,4520,2710,1888,6170,2502,956,4491,3149,5312,183 4,2366,4769,1630,2723,4679,3236,1936,4451,2666,5664,1746,2946,6657,887,3840,438 3,1720,2829,4279,1401,4330,2424,3340,5190,1459,2476,4221,1841,3346,4653,985,622 4,2713,1343,4756,2784,3590,5164,1645,4712,2615,1836,4438,2888,997,4412,3126,150 8,6181,2673,5251,2286,1454,4337,3155,1862,4874,2407,5201,1691,2505,4659,986,312 9,4441,2447,6169,1512,2835,4548,1263,3593,5170,1402,4493,2639,3184,4499,1483,27 26,4303,943,6166,2482,1646,5193,3207,1651,4770,2725,2397,4654,1461,5135,3150,14 04,4881,2293,4528,891,2506,6280,3361,1842,4453,2714,5440,1485,3266,4283,1520,26 68,4332,1693,4760,2411,3157,6404,998,2175,5253,1703,4720,2239,1748,4683,3348,28 30,5172,1865,4876,3594,766,6408,2455,1653,4801,2484,4222,3130,1375,5143,2674,43 38,1491,2619,4661,1462,3240,5254,2513,6182,511,3211,4494,1761,4442,2729,1275,45 52,2294,3171,5504,1486,4454,2755,1466,6658,2398,4501,1465,3158,5196,2647,988,43 99,3132,4665,1493,2716,4340,1271,6240,2838,3352,5257,1707,2508,4691,1866,4285,2 297,3161,5202,1001,4662,2730,1762,6211,3362,1923,4772,2621,4457,2459,1694,5176, 3601,4802,1807,2851,4685,951,6185,2837,3596,5147,1873,2757,4311,1844,4882,3268, 2413,4743,1752,5217,2488,1952,6288,3213,4444,1002,2676,4515,3173,5159,1815,2737 ,4502,1391,4560,2422,3219,6172,1925,2471,4776,1654,5379,2514,1709,4897,3248,445 8,2841,893,5204,3214,6213,1868,2298,4686,2419,4505,1657,3602,5258,1735,4666,252 9,3393,6186,1277,4884,2622,975,4693,2461,5265,1715,3103,4668,2651,4315,1848,327 2,6660,1926,5381,2414,2516,4407,1710,4804,3162,894,5149,2703,4694,3617,1764,619 3,2948,4697,1874,2853,5163,3364,4747,1399,2663,4517,1468,7170,3394,2732,4888,14 94,5218,2758,1009,4898,3604,4707,2477,1507,5635,3335,6218,1439,2842,4698,2300,4 506,1509,3221,5208,1929,4327,2421,3174,4784,1819,6416,2653,955,5260,2896,4749,3 177,4344,1497,2738,5150,1658,6304,3376,2761,4465,1768,4286,3368,1876,4460,2680, 5266,2530,1984,4750,3235,6664,1004,4755,2854,3164,5191,1889,4431,2475,1717,4576 ,2952,6432,3119,1821,5382,2462,4411,1930,3339,4317,2271,5385,1010,6672,2711,173 9,4466,3457,4709,2740,1831,5281,3618,4518,2883,4521,1498,3396,6336,1660,5696,26 67,2520,4547,1718,4710,3280,957,5165,2503,6688,3458,4639,1278,2844,4331,1741,52 20,2857,3222,4508,1599,6214,2762,4439,3225,1937,4468,2769,5760,1822,3237,4871,2 885,4413,983,6188,2764,1835,5171,3178,4318,2912,4522,1403,3127,5268,2858,6275,1 721,3400,4549,1455,4333,2654,5166,2960,1631,4655,3608,6225,1513,2770,4929,3649, 5195,958,4900,2744,3620,4808,1890,6194,2425,5386,1747,2483,4930,3185,4757,1510, 5393,2865,3226,6217,1932,4904,2367,4875,1742,3151,5637,2669,4713,987,3341,5224, 2860,6159,1837,4700,2532,1500,4529,3180,5282,2478,4816,1880,3650,6464,2886,4912 ,1863,5173,3296,1749,4932,2715,4443,2536,6277,1012,3238,5313,2287,4993,1722,433 9,3591,1938,5272,2426,6196,3624,4758,1776,2507,4550,3267,5197,1892,4414,2670,71 72,1843,2675,4771,3342,5284,1838,4714,2485,3713,4994,999,6167,2428,5888,1463,35 95,4877,2866,4472,1953,6278,3347,2509,5388,1514,4524,2544,5394,3652,4761,1647,2 717,6528,1695,4832,3363,5638,2727,1763,4663,3131,4936,2772,6220,1016,3241,5174, 2889,4721,1940,4334,2677,5203,1487,3632,6281,2399,4455,1867,4553,3186,5177,2515 ,1405,4495,3349,6226,2486,4883,1521,3228,5641,2785,4687,767,5232,3159,6200,1954, 2299,4774,3269,4530,1845,5255,2510,6171,2490,1750,4773,3188,4445,2489,5198,1985 ,4341,3242,1896,6241,2517,4554,3133,5409,1516,4762,2295,3603,5314,1655,6183,273 1,4716,3597,4459,989,2890,5205,3714,6403,1753,4223,2786,4287,2947,1724,5396,335 3,4878,1467,6228,2718,5642,3350,1765,4503,2831,4532,3598,5178,1869,6282,2897,47 22,3249,1944,4667,2868,5288,3365,6289,1003,4561,2776,3460,5259,1406,4777,2976,4 342,3163,6405,1846,5219,2839,1875,4803,2415,4446,3656,7176,1754,5206,2949,3841, 4695,1522,5180,2678,4764,3270,6173,1904,4886,2733,3244,5400,990,4556,2892,6187, 3192,4345,1766,5209,2681,3273,4778,1469,5410,2759,6242,3408,4669,1495,4507,2301 ,5649,3134,1659, 6659,2739,4899,3354,4885,1956,5644,2872,4805,3215,1711,6232,295 0,5316,3175,4461,1927,4536,2734,6284,1005,5261,2788,3250,4724,1849,5221,2898,47 85,3366,6174,1524,4470,2423,5267,3165,1870,4519,2492,6290,3716,4562,1769,5296,2 518,4889,3274,6215,1850,2531,5262,3664,4346,1756,4467,2463,5650,3395,6406,1470, 4577,2533,3464,5441,959,4670,2953,6409,3369,4509,1986,5151,2843,4699,3842,6305, 1960,2521,5320,3179,4462,1499,4564,2682,5210,3252,6720,1877,4751,2792,5665,3223 ,1891,4996,2900,6189,3281,4901,3008,5412,1661,4711,3356,7184,2913,5442,1931,478 0,3720,2741,4806,1011,6244,3166,5652,2845,4525,1511,5383,3276,6784,2954,4890,17 19,4348,3370,5269,2763,1770,4469,3472,6195,2855,5222,1852,4701,3680,4944,2522,6 292,1777,5225,3424,4786,2684,5424,1878,3397,6190,2742,4809,1881,5416,3605,4728, 2302,6219,1013,4578,3227,5283,2765,4902,1528,6410,3282,5212,2623,3377,4523,1823 ,5000,2961,6417,3619,5167,1279,4510,2846,5387,3372,6661,1988,4319,2859,4759,318 1,5505,1933,6248,2427,4788,3256,1743,5666,2745,4931,3606,6306,1501,5444,2479,47 15,2655,4568,2537,6197,1939,5328,3609,4551,2914,5506,895,6337,3187,4892,2771,49 05,1662,3239,5270,2534,7200,1772,4810,3297,5273,2956,4817,1968,6296,3398,5285,2 766,4933,3378,4812,1893,6221,2861,5226,3844,4960,1515,5175,2524,6308,3229,4906, 1723,5448,2904,4702,3728,6912,1778,5008,2887,3401,5656,1882,4818,2773,6412,3182 ,5697,2746,4792,1006,5668,3189,6418,2962,4473,1502,4531,3284,5233,2800,6662,199 2,4913,3243,5274,2916,4415,3848,6198,1407,5199,2867,4717,3402,5389,1934,6227,28 62,4908,3298,4580,1839,5228,2487,6201,3621,4526,2000,5698,2977,4934,3610,6665,2 538,5344,1894,4763,3459,7171,2671,4584,1941,5286,3380,4335,2719,6256,1014,5639, 3288,4474,2787,5672,3488,6279,1751,4555,2964,5315,3343,4718,1517,6222,2511,4723 ,3351,5390,2891,1897,4533,6433,3230,5761,2429,4476,1725,6338,3409,5643,2545,491 4,1955,5395,3622,6229,2978,4557,3744,4592,1780,5700,2869,6420,3190,4765,1884,54 11,2774,6666,3404,4775,1523,5179,3651,4820,3009,6202,3612,5289,1755,4937,2920,4 725,3461,6312,1017,5680,2540,4447,3245,5234,2679,7173,1847,4563,3193,5397,2777, 6283,1946,4534,3625,5276,2748,4833,3271,6243,1898,5207,2491,4347,3856,5317,1942 ,6230,2789,4558,3251,4538,2893,6204,1526,5236,3300,4537,2968,5290,1957,6424,456 5,3410,5181,2430,6233,3384,4343,1767,5651,2870,4779,3776,6434,1784,5645,3462,49 38,2899,5762,3246,6673,1905,4834,2778,4995,3626,6668,1018,5401,2546,4766,3653,5 398,2928,6340,1518,4879,3465,2790,1726,5646,3355,7232,2493,4945,3194,5297,1945, 4916,2519,6285,3520,5413,1525,4824,3425,6245,2683,5508,3633,5024,1900,5211,2980 ,6291,3275,4887,2735,4463,1871,6320,3135,5704,2951,4997,2016,3412,5889,2873,628 6,3466,4726,1471,5318,2548,6674,3599,4781,1757,5292,3654,4940,2894,6465,3628,52 40,1851,4729,2793,6175,3253,5321,2874,4807,991,5456,3367,6344,2780,4349,1958,51 82,3357,7177,2494,4787,3304,5402,1906,4920,3196,6234,3010,5263,3277,4998,1961,6 689,2984,5223,3254,4782,2523,4836,1987,6436,3715,5298,2901,4946,1771,6466,3634, 5414,2915,4471,3358,6676,1529,5213,3657,4540,2685,5764,3371,6407,1879,4566,2955 ,5322,3426,6293,2535,4579,1948,5712,3283,4511,2743,6246,1758,5443,3473,4581,325 7,6249,2794,5512,1853,5001,3468,7174,2876,5417,3416,4891,1020,5890,2801,6448,36 58,4569,2902,5227,1989,6440,3717,4730,3665,5300,1962,6307,2905,4840,3607,5271,2 552,4948,1908,6236,3312,5329,2847,5056,3278,6191,1530,5404,3167,4961,2303,6411, 3399,5768,1773,4789,3012,6529,3636,5214,2957,4893,1969,5324,3872,6690,2767,5002 ,3474,5418,1990,6468,3428,4811,2525,5520,3379,7185,1779,4903,2963,5728,3373,457 0,2686,6352,5472,1883,4732,3489,6530,3285,5445,2796,4790,1964,6294,3640,5653,29 92,4350,3904,6297,1854,5275,2917,4813,3660,6309,3258,5330,1935,4671,2539,5425,3 718,6250,2747,5009,1007,5667,3476,6199,4894,3299,5420,2802,7178,1895,4907,3968, 5229,2906,6472,3666,4475,1663,5304,2526,6680,3490,4793,3374,5654,1912,4527,3016 ,6721,3721,4703,2431,4585,6692,1503,5657,3843,4962,2958,6257,3432,5235,1970,481 9,3611,6298,2863,5287,3183,4582,1774,6223,3024,5345,3403,5004,3286,6413,5446,19 93,4814,2918,5426,3381,7186,2965,4909,1532,5892,3260,6252,3521,4572,2775,5277,1 885,6722,3289,4952,5776,2541,6368,3480,4935,1781,5449,2921,6310,3681,4821,3668, 5230,1994,6663,2749,4794,3623,5237,6696,2979,5010,3722,5332,1943,6339,3301,4848 ,2804,5291,3231,7296,1015,4964,2908,5896,3492,6414,4915,3382,5450,1899,6785,254 7,4910,3613,5346,2779,4535,1886,6667,3845,5669,5025,3682,6419,2871,5658,3729,45 86,1782,6724,2970,5507,3405,4719,3191,6435,1972,5428,4767,2922,6203,3672,5336,2 966,4835,2001,7180,3411,5536,3290,5012,2550,6313,5391,1947,4559,3440,6704,2981, 5399,3724,4939,3302,6258,1996,5278,4477,2791,6421,3463,5457,3385,4593,1785,6300 ,2808,5670,3522,5026,6231,2929,5792,1901,4917,3614,6341,3406,5238,2542,4822,330 5,7201,5452,1976,5699,2750,6260,3627,5057,3846,6314,1519,5660,2969,4968,6205,32 47,5509,2549,4588,3195,6675,1727,5293,3730,4727,6669,2924,5241,3684,4825,1959,6 786,3413,5673,2895,4796,3849,6425,5319,3040,4539,2002,7233,3292,5904,3386,4837, 2495,6422,5299,1019,4941,3496,6670,3467,5348,2781,5016,6321,3745,5458,1907,4478 ,2875,6437,3655,5432,3427,4918,6532,1786,5824,2982,6235,3359,5510,3255,4947,293 0,7188,5294,1527,4826,3306,6728,2985,5674,3197,4594,6913,1949,5701,3629,4976,30 11,6342,3732,5513,3688,4838,6316,1902,5403,2795,4541,3414,6264,2553,5242,6345,3 388,4567,1759,5568,3313,6480,2903,5473,4731,3850,7424,2017,5681,3635,5028,2972, 6206,5323,3417,4783,2782,6426,1909,5183,3524,4999,6287,3469,5460,2877,6247,3475 ,4921,1963,5514,6322,3279,4596,3013,5647,3746,6438,2018,5702,4942,3630,7202,298 6,5676,3857,4841,3504,6237,5301,2004,6788,2932,4922,3429,5415,6346,2554,4828,32 59,5405,1950,6736,3308,4542,5352,2797,6467,3736,5244,3696,7192,5058,1788,5325,2 993,6536,3659,5032,3852,5302,6441,3014,4571,1965,5763,3777,6914,4949,3198,6251, 2803,5682,3314,4963,1991,6324,5406,2907,5705,3637,6295,3470,4733,5419,2988,7204 ,1021,5003,3418,6353,5474,3528,4583,2878,6428,1910,5331,4791,3430,6792,3477,552 1,2959,6238,3375,5305,4842,1855,6348,3641,5516,2919,4924,6442,3316,5464,3667,71 75,1971,4849,5706,2687,6544,3261,4950,3638,5765,6752,2936,5713,1531,6496,3748,4 953,5655,3433,6469,2527,4600,3778,5360,6677,1913,4895,3661,7297,2994,5326,5215, 3287,6299,2798,4351,5447,3858,6354,2008,5060,3719,6449,5684,3017,5005,3420,6691 ,3491,5920,4815,1775,6444,2556,5522,3478,7234,5476,3536,4573,2909,6253,5427,196 6,5011,3752,6328,3873,5421,6678,2805,4734,3434,5537,2020,6681,5333,3662,6259,30 18,4844,5688,3481,6311,3642,5040,1995,5952,7680,2967,4965,3860,6369,3669,5708,5 306,3644,6470,2923,4587,6450,1914,5766,3291,4795,3383,6916,5524,2910,5347,3780, 6301,4850,1533,7179,3670,6016,2806,4954,6800,3673,5714,3723,6473,4574,1973,5538 ,2996,6254,5422,3493,5064,3864,6261,3025,5769,6356,3874,4479,1997,5891,7208,368 3,5006,2971,6315,3674,5480,5659,3482,6920,2024,4911,6474,3020,5231,3303,5072,63 70,3760,5451,2809,6693,5334,1916,4966,3725,7236,3320,5429,6682,2925,5013,3441,5 308,6531,3262,5569,1974,6452,4823,3436,5337,3000,6360,4589,3726,7298,3731,5528, 4969,1887,6560,2543,5729,3407,6415,5716,3552,4797,2751,6423,5671,3387,6302,1783 ,5027,5770,3293,6481,2983,5349,7187,3442,4852,3685,5279,6694,3026,4956,1022,681 6,5540,3494,5430,3497,6262,4595,3523,6476,2931,5661,4827,2032,6723,3686,5893,71 81,3615,5730,2810,4919,6684,3307,5777,3484,6533,5018,1534,5453,2551,6317,5239,3 415,6265,3444,4970,5720,2973,7216,3847,5014,6697,2003,5459,3389,6343,5338,3294, 4598,2926,6928,5488,3498,6323,3525,5029,5772,1977,7182,2783,5350,6372,3309,4839 ,3631,5511,6482,3905,5433,1787,6456,4856,3041,6848,5570,3876,4977,3784,6534,566 2,2933,7240,3906,5454,4590,1998,6318,3733,5353,6698,2987,4798,3880,6725,5675,38 51,5894,6537,3689,5017,1978,7425,5295,3042,4597,3676,6427,5243,3505,6266,3028,5 778,6592,3792,4972,1903,5732,6497,3888,5461,7189,3908,4943,2974,5897,6705,3419, 5088,3969,6347,5340,2005,6207,5434,2812,4543,3315,6484,5544,3734,7300,3526,5515 ,6538,2989,4829,5793,2006,6671,3390,4923,6726,3747,5703,3015,6700,5475,3690,503 0,6325,3970,5407,1951,7203,5303,3853,6439,2934,4978,5354,3448,6429,5033,3500,63 76,2879,5245,6268,3737,5677,2019,5059,7426,3808,5780,6349,3639,5736,2995,6326,4 843,3912,5462,6787,3697,4601,1789,6706,5436,2555,7194,5361,3310,4951,3431,6430, 5898,3529,6729,5683,2937,6443,1980,5020,7681,3471,5465,4830,3859,6498,3663,5572 ,6355,3032,5517,6545,3750,4925,3506,5523,6329,1911,5327,7248,2799,5061,3749,654 0,5794,3421,6488,5678,3317,5034,2990,6730,5905,2009,6789,5552,3530,7205,3738,49 80,5477,3692,6737,4602,3044,6679,3435,5307,6384,3199,5356,6350,2021,4845,3263,5 784,7193,3019,5744,6239,3854,5041,6471,3479,5707,2938,6708,5900,2010,5062,7190, 3508,5825,3698,6944,5246,3643,6546,4851,2557,6500,5362,3537,4955,3753,6451,5685 ,1967,7304,5518,3318,6445,5036,2997,6561,3779,5466,6357,3422,5576,4926,3671,671 2,5478,3021,7428,1915,5525,6976,3740,5007,6732,3862,5423,5689,3532,6330,3048,49 67,7432,3321,5364,6790,3754,5715,6548,2022,4735,3645,6371,5309,2940,5686,7040,3 483,4984,7206,3875,5796,6738,3861,5481,1790,6562,4575,2998,6446,5826,3781,7682, 5709,3437,5042,3512,6793,5335,2911,6915,4846,3700,6504,5906,1535,6683,5767,3761 ,7264,3446,5065,6255,2807,5468,5539,3495,6475,4604,3538,6358,5526,3865,7235,558 4,3056,6453,1023,4957,6332,3322,5800,6593,3443,5921,4853,3553,7209,5482,2558,63 61,5710,3646,6552,3485,5066,6753,2012,5529,6740,3675,5690,7312,3027,5015,6695,3 438,5908,5717,3540,6794,3727,5692,6373,3001,4971,7196,2025,5339,6303,3972,5431, 6564,3877,4958,6454,3687,5828,7237,2811,5718,6685,3756,4854,3782,5721,6917,1975 ,5771,6754,3501,5044,7210,3022,5541,6801,3866,5912,6477,3324,5073,6263,3445,592 2,7684,3677,5731,6744,3002,5019,6483,2026,5722,3920,6362,5530,3762,5068,7217,37 85,5351,6512,2927,5808,6796,3704,4857,6374,3554,5773,7242,1917,5368,6535,3878,4 973,6457,3029,5489,6594,3499,5310,7440,3976,5484,6686,3486,5048,6478,3030,5774, 6377,3295,5779,1999,4591,7328,3735,5455,6699,3764,5600,6918,3907,4799,6319,2975 ,5435,7688,3691,5341,6267,3544,5031,6802,3527,5490,6756,1918,5733,7456,3043,507 4,6485,3868,5542,6921,3881,5545,6364,3786,5571,7696,3793,4979,6458,2813,5734,65 68,3909,5663,6539,2033,4858,7360,3788,5355,6817,3936,5532,6727,3004,4599,6499,3 882,5463,7712,3678,5492,6431,3984,5021,6327,3794,5895,6378,1979,5437,7238,2935, 5342,6269,3768,4974,6701,3449,5546,6804,5573,3507,7212,4831,3889,6760,5357,3033 ,6486,5679,3391,6460,5953,2028,7299,5089,3693,6385,5924,3884,6922,5832,3045,724 9,4981,3556,6707,5954,3502,6489,5781,3910,6596,5035,3739,7218,5928,2034,6541,58 99,3034,6547,5737,6351,3560,5090,7241,3311,5724,6818,3450,5553,6702,3531,5076,7 183,2991,5840,6929,3694,5936,6576,1981,5956,6501,3699,5022,7488,3509,5467,6331, 6017,3452,6380,4860,2939,6808,5363,3890,7301,5782,3533,6768,5574,3568,6731,5037 ,3741,7220,5438,2007,6924,5795,6849,3046,5063,6270,3751,5738,7191,3796,6018,638 6,3913,5901,6709,2814,4982,5496,3701,5548,7302,4927,3423,6542,5785,3539,6490,58 56,1982,6600,5687,3510,7552,5043,2559,6502,5960,6549,3809,5745,7244,3323,4603,6 447,3534,5358,6713,3514,5479,6388,3513,5577,7305,4985,2011,6739,5519,3036,6333, 5907,3541,7250,5711,3319,6710,5080,3755,6820,5798,6505,3914,5554,7224,3049,4847 ,6850,3810,5797,6733,3971,5469,7195,5365,3742,6359,5038,2036,6930,5578,3855,679 1,5786,2999,7265,5740,6492,3921,5092,6563,3892,5483,7207,3800,5247,6550,5311,40 00,6608,5067,3050,6824,5902,3863,7427,5527,2023,6945,4986,6506,3439,5556,7252,3 973,5746,6734,3702,5691,6553,4605,3757,7306,5585,2941,6714,5801,3916,6932,5366, 6741,3705,5045,7313,3783,5827,6716,2040,5470,6363,5719,3325,7429,5069,3023,6455 ,5788,3763,6852,5910,7197,3896,5580,6742,3974,5096,6745,5369,3758,7211,5802,294 2,6795,5693,3812,6565,4988,6936,3922,5531,7266,1791,5923,6946,3447,5909,6755,50 46,3516,7683,5829,3542,6746,5485,6554,3057,5560,7256,3555,4959,6375,3487,6832,5 748,7308,3557,5809,6797,3977,5494,6392,4855,3867,7198,5543,2013,6513,5586,6334, 3003,5913,6508,3545,5104,7314,3706,5370,6798,5491,3816,6803,5601,3924,7239,4606 ,6479,4032,5694,6624,3052,7430,5533,6459,3937,5723,6365,3765,5075,7433,5486,202 7,6514,5588,3869,6757,5775,7329,3978,5049,6566,3058,6020,6569,5925,3787,7744,57 35,3879,6595,6758,4859,3546,7213,5804,3708,6687,5830,6379,3766,5549,7268,3005,5 070,6556,5914,2014,6487,5372,3326,6516,5493,7808,3789,6919,5725,6461,3647,5050, 7219,3985,5968,6366,5810,3870,6570,5833,3031,7316,4975,6597,3883,5752,6381,3451 ,7214,5602,6703,3769,5926,6977,5077,3503,7243,5547,2029,6948,6024,6856,3679,553 4,7434,3561,6978,5078,6805,3006,5343,7441,5783,3938,6952,5812,3795,6923,5955,76 85,3558,5023,6761,3980,7272,5739,6748,3790,5592,6577,5575,3035,7330,5091,3885,6 864,5916,6960,1983,5929,7221,6980,3548,5834,6491,3928,5841,7361,4861,3911,7041, 5957,6387,3797,7320,5836,3060,6806,5984,6598,3770,5052,7245,5930,3986,6462,5726 ,6819,3824,7332,6032,3940,6762,5842,7042,3891,4983,7936,5816,2035,6925,5497,388 6,6520,7436,5555,3047,6572,5937,7442,3511,5081,6809,5439,4001,6880,7686,5741,35 62,6711,5932,3695,6984,5093,7222,3743,5604,6769,6382,3811,5550,7251,5958,3064,6 503,5787,3988,6601,5082,7225,3535,6543,5608,6931,2037,5359,7689,5498,3915,6735, 7280,5579,3453,6822,5039,3569,6578,5742,7303,2815,5747,6821,6493,4002,5557,7246 ,5500,3893,6389,4987,6602,3798,7457,5938,6810,4033,5581,7362,5616,3944,6764,578 9,3564,6507,7253,5094,3703,6271,5799,6335,1919,5844,7444,6926,3037,5961,7690,48 62,3801,6551,5749,6580,3772,7226,5471,6770,3515,5587,6715,5558,3813,7336,6609,4 607,3917,7307,5857,6825,3992,5371,6390,7267,3051,5582,6851,5562,3454,6494,5561, 7254,3894,6743,5084,7228,3923,5589,6812,5367,3802,6934,7448,5803,2030,6604,5962 ,6393,3570,7257,5097,6826,3952,5858,7458,6019,3038,6717,6555,5790,3814,7697,590 3,6947,3517,5047,6933,7692,3543,5969,6853,5940,3707,7364,6509,5848,4004,6584,60 48,7309,3759,5098,6772,7269,3975,5911,6833,5487,3053,6518,7315,6021,3897,6567,5 750,6610,2038,5805,7344,6937,3572,4989,7310,5964,3918,6394,6515,5753,3817,7698, 5831,6625,7489,3898,5373,6718,5071,3804,6557,5811,7199,3518,6747,5944,7368,3007 ,6022,6510,6612,4034,5806,7258,4990,4008,6799,7713,5860,3547,7044,5970,6949,746 0,3925,5495,6759,5564,3939,7490,6828,5590,2041,6854,5105,7700,3709,6573,5603,74 31,5535,3979,6938,6396,5605,3059,7317,6025,6517,3559,7270,5915,6749,3767,5051,6 992,7273,5593,3818,6834,5754,7472,3900,6857,5864,7464,3825,5972,6776,6626,3926, 6080,7331,5100,6950,3929,7260,5985,6571,3061,5813,7048,7215,3576,5917,6558,6026 ,7435,3871,6367,5106,6807,3327,5835,7553,6836,2042,5927,7714,6979,5594,4036,749 2,5756,6763,3981,6616,5814,7376,3791,5053,6599,7554,5374,3549,6940,5837,6953,39 87,7318,5695,6858,7321,2943,6033,6865,5918,3710,7333,6981,5079,3820,6860,5931,7 274,7008,4016,5499,7223,6954,3941,5817,7496,5551,6750,3563,7056,5727,7704,3771, 5609,6866,7745,5054,3826,6840,7716,5986,3930,6521,5843,6579,7281,2015,5606,6961 ,7322,3054,6028,6463,5838,7247,3550,6765,5083,7437,4040,6956,5933,6628,5596,345 5,7276,6574,5976,7746,3982,6982,5959,7392,3887,5845,6811,6632,5108,4048,7334,63 83,5818,3942,7687,6034,6522,7720,3989,5872,6603,7363,5988,3062,6766,5939,6771,3 799,7438,5934,6581,7809,3565,5095,6524,5559,3945,7691,6962,6049,7443,3773,6605, 5610,6640,7748,4003,5743,6813,5791,7459,2044,6823,5859,7227,3828,6868,5112,7337 ,6985,3932,6036,6773,5583,7728,3571,6495,5963,7282,3803,6611,5501,7445,6582,306 5,5617,7324,6881,4863,3895,7255,6050,6395,7365,3994,5941,6606,6586,5846,3946,72 84,6585,6081,3990,7338,5992,6613,7229,3574,5612,6391,7699,5751,4005,6827,7693,5 085,6986,3815,7810,5849,6882,7043,3832,5820,7449,5563,6814,3953,7446,5861,6927, 7694,3066,5965,6993,7345,6040,3566,6964,7461,5099,2031,6872,7556,5502,7072,3774 ,7259,5942,6935,5971,3993,6511,7752,5850,7045,3573,7937,5618,6774,7366,3948,600 0,6829,7340,5086,3919,6988,7288,5862,6777,4064,7369,5565,6855,7504,3519,5591,63 97,7230,5755,3805,6835,7450,6052,6968,3899,7311,5807,7046,7271,6023,3039,6830,5 101,6884,7346,4006,5945,6994,7462,5620,3954,6519,7261,5966,6588,4009,7812,5865, 6614,7370,4035,5946,6627,7760,5852,3819,6559,7491,5566,6629,3577,7560,5055,7049 ,7465,6082,3927,6939,7938,6056,6617,2039,7275,5595,6778,7348,3996,5973,6888,731 9,5987,3806,6996,7377,7104,5757,7452,3901,7009,6027,7816,6837,3068,5107,7262,69 41,5607,4037,7372,7050,5815,7466,6859,4010,5866,7568,6951,5948,3956,7776,6618,5 873,7520,3578,6780,5974,7493,6838,5977,3821,7701,6398,5109,7323,4017,6861,5624, 7378,6719,4038,7473,5919,7057,7715,5375,3827,6942,7468,6084,6955,3931,7277,6029 ,6523,7352,5839,4012,6841,7702,5597,6575,3902,6751,6633,6035,7705,7010,3983,499 1,7283,6867,5758,3055,7335,6630,5868,7393,7052,3943,6064,7494,6862,7474,3711,59 89,6957,7940,5611,6620,3960,7325,5819,7000,7824,5874,2043,6983,7497,5978,6869,3 551,7278,6842,5102,7285,7058,4018,5598,7380,6896,6088,7339,3822,7012,7944,5503, 6963,4041,7498,6030,6958,7394,5935,3580,6583,7717,6096,7073,7706,3933,6634,5990 ,7555,6767,6037,3829,7476,6815,5110,7384,6883,4042,7584,5847,7060,7439,3991,561 3,6607,7447,6987,5993,3063,7326,6525,5821,7505,6641,3947,6051,7718,7074,7840,58 76,3934,6965,7286,5980,6870,7500,3830,5619,7747,7105,7708,5851,4020,7016,7557,5 113,6636,7341,4049,6775,5943,7289,6873,6042,3995,7721,6844,7367,5994,6587,4044, 7952,6038,6885,7347,6989,3833,5622,7396,7064,6053,7506,3949,6526,7480,5863,6966 ,7872,4024,5880,7558,6995,7342,6001,3567,6874,7722,5114,6642,7749,2045,7024,561 4,7561,6886,5822,7451,3775,6589,7290,6041,6615,7616,4007,5621,7521,6779,7729,59 96,4050,7076,7371,6831,5967,7231,3067,7047,6112,7508,6969,7562,5567,3955,6644,7 695,5853,7750,6990,3834,7724,5947,6889,7349,6970,5087,3575,7463,6876,6054,7453, 6590,3997,7400,6002,7292,7106,7373,3950,6057,7080,7350,6619,6083,7811,3807,6997 ,5867,7730,7011,7454,4065,5625,7753,6781,7467,5975,7051,3957,7522,6631,6044,737 9,6839,4011,5854,7569,7353,6890,5949,7564,4066,6972,7512,5116,6897,7754,6998,40 52,6085,7813,7761,6058,7001,3998,7703,6648,6004,7408,6943,7374,3836,5626,7263,6 399,7495,5869,7108,4013,7732,7053,6065,7968,6863,7570,4039,6086,7524,6621,7475, 5875,7059,3069,7469,6782,5979,7585,7381,3958,6892,6060,7736,7088,8000,5950,3903 ,7013,7756,7354,6031,6635,7814,4019,6843,5103,7572,7395,6898,5991,3579,8064,700 2,7762,5759,6622,7586,3961,7470,6008,7112,7817,6527,5599,7939,2046,7054,7528,60 66,7707,6959,7279,4056,5870,7120,7499,7382,6089,7014,3823,7477,7061,5628,7356,7 617,6871,4014,5981,7385,6637,7576,5877,7017,4068,7777,7764,6090,6845,7719,7075, 7818,4043,6039,7397,6900,7327,5111,7004,3962,7588,7478,5995,6643,7709,6875,3581 ,5982,7941,7778,6967,7825,5878,7066,4021,7501,7287,6068,7018,7768,7062,4045,609 7,7507,7386,6646,6043,7536,7077,4072,7820,7398,6092,6887,7559,7481,5881,3964,69 04,7618,7025,5997,7710,7502,4022,6638,7401,6072,6846,7723,7942,5615,3935,7065,7 343,6645,7291,5823,7826,7020,3831,7780,6055,7509,6991,7945,7136,6098,3070,7388, 7482,6591,5115,7592,7563,6877,4080,7841,6003,6971,7751,7523,5882,7078,3582,7455 ,7351,7026,5623,7402,7081,7293,4051,6045,7725,7107,7828,7784,5998,6891,4025,751 0,6649,7484,5855,7409,6999,7946,3835,6113,7731,7068,7513,6878,6005,7620,4046,75 65,6973,7571,6059,7375,7109,7842,4026,6114,7726,7082,7953,7600,6100,7028,7525,3 951,6650,7355,6046,7404,6893,7832,7792,4053,5884,7089,7755,7948,7110,6061,7873, 7294,4054,6899,7410,6087,7003,7733,7566,7084,3999,5117,7514,7624,6974,6006,7526 ,7573,7055,4067,7471,5951,7737,7015,7412,7763,6067,6783,3837,7357,7734,7032,562 7,7844,7529,6623,4028,7874,6009,7757,7090,7383,6894,7954,6104,3959,7815,7113,75 16,7587,5871,6652,7574,7632,4057,7005,6062,7848,7969,6901,7530,6116,7758,7114,4 069,7577,7738,6091,7063,7956,7765,7740,7019,2047,6010,7387,7479,7006,7876,5629, 7766,6902,4058,7769,7819,6069,7092,7589,7960,7121,7970,4015,6093,7779,7067,7770 ,7578,6120,7116,7399,7856,3963,6905,6012,7821,7416,7021,7537,7358,6070,4070,753 2,7096,7822,7827,5983,6639,7503,7648,6847,3838,7483,5879,7389,7079,7538,7781,71 22,5118,7590,3583,7593,7619,7027,6128,7782,7711,6906,7403,7580,3071,5630,6647,7 511,7540,7069,7943,6099,7485,7390,4060,7022,7594,7621,6073,6879,7405,7727,8001, 5883,4073,7137,7972,7880,7029,8002,6094,7829,7083,7976,4023,7947,7785,6074,7138 ,7772,7601,7124,7888,5999,7984,4074,8004,7070,7515,8065,6101,6908,7411,7830,762 2,7085,3965,6102,7486,7843,7111,7786,8066,6047,7949,7030,4047,7544,7596,6975,78 33,6115,7904,7735,7091,8008,7793,3966,5885,6651,7406,7527,7625,7033,6076,7567,7 955,7759,4081,7128,7846,7602,6007,6895,7845,7517,7413,7086,6105,4027,7626,7834, 7788,7140,7531,7295,6117,7359,7115,7950,7575,4076,7034,6106,7604,7794,7739,6653 ,7633,7849,6063,7414,4082,7093,7875,7518,7767,7117,6011,7836,7958,7628,7144,741 7,4029,7850,6118,7741,7036,7579,7971,7957,5886,7094,7877,7533,4055,7608,7007,77 96,5631,7857,7542,6903,7591,7634,7961,7152,4030,5119,7418,7539,7649,6654,7742,7 581,6108,7771,7123,7534,7636,4059,7823,7097,6121,8068,7973,7783,6907,7852,7878, 6071,7597,7118,4084,7962,7420,7541,7773,7098,6122,8016,7858,7881,7023,7800,4071 ,7650,6013,7974,7125,7595,8072,7582,7126,7391,6095,7831,7860,8003,4088,7071,778 7,7640,7623,6014,7139,7964,7977,7882,7889,6909,8005,3839,6129,7884,8032,7100,79 78,7774,8080,7890,6075,7031,7864,7545,7603,4061,7985,7129,7487,6124,7789,7980,7 141,7652,7598,8006,7835,6130,7130,4075,7656,7407,7546,7627,7087,7790,6077,7795, 7605,7548,7035,7986,7629,7664,4062,7837,6103,7142,7847,7892,8009,6910,7797,7519 ,7635,6078,7606,6655,4077,7905,7419,7630,7610,7609,6107,7132,7637,7415,7851,801 0,7145,7906,8067,7838,4031,6132,7951,7095,8017,7988,7896,8096,7146,7959,6119,75 35,8069,7798,7853,7037,4083,8012,7801,7879,6136,7421,7119,7859,7992,8070,7854,7 038,7908,8018,5887,7543,4085,7612,7638,7153,7651,7583,7653,8073,7963,6109,7099, 7641,7802,7912,8020,8128,7148,3967,8033,7861,6123,7965,8074,7154,7883,7975,7642 ,7804,7862,7101,6110,7422,7885,7743,4078,8081,7966,7127,7979,7547,7865,7599,612 5,7775,7657,7102,8034,7891,7654,8076,7886,7131,4086,7981,6079,7644,8024,8007,78 93,7156,7866,8082,7920,8036,7987,6131,7982,7143,7607,8097,7658,4089,7791,7839,7 907,7160,8084,7631,6133,8011,7549,7665,6911,8098,7989,7894,8129,8040,7660,7799, 6015,4090,7133,7897,7868,7611,7909,8013,8088,7147,7550,7990,8019,7898,6126,7666 ,8048,7134,7910,7613,7639,7803,4063,8100,7855,8071,7149,7993,6134,7668,8014,791 3,7994,7900,7614,7103,8130,8104,7643,8021,8035,6137,7805,4092,8075,7155,7655,78 63,7914,7996,7921,8022,8025,7157,7672,7967,7423,6138,8132,8077,7887,7645,8083,7 039,7806,7916,8112,4079,8037,7659,7867,7922,8026,6111,7150,7646,8136,7551,8078, 7983,8144,8038,8085,7158,7895,7661,8041,7869,8099,6140,7924,8028,4087,7667,7899 ,7161,7991,8090,8042,8086,7670,8101,7911,7928,8049,7162,7662,6127,7870,8089,766 9,8044,8015,8160,7615,7901,7995,7135,8102,4091,8050,8105,8131,7915,7673,8023,61 35,8092,7902,7997,7164,8133,8106,8052,7674,7917,8113,8134,7923,8027,8108,7998,8 079,7151,8039,7807,8056,6139,7647,8114,4093,7918,8137,7676,8029,7925,8138,8087, 7159,8043,8030,7926,8116,8145,8091,8140,7929,8045,8120,7663,6141,7871,8103,8146 ,7163,8051,7930,7671,8093,8046,7903,8161,8053,8107,4094,8162,8148,8094,7932,810 9,8135,7165,8054,7999,8115,7675,8057,6142,8152,7919,8110,8164,8139,8058,7677,81 17,8141,8168,8060,8118,8031,7927,7166,8176,7678,8147,8121,7931,8142,8122,8047,8 149,8150,8095,4095,8163,7933,8124,8055,8153,8165,6143,8154,8111,8059,8166,7934, 7679,7167,8156,8169,8119,8170,8061,8143,8062,8177,8123,8172,8178,8125,8151,8126 ,8155,8180,8167,8184,7935,8157,8171,8158,8173,8127,8179,8181,8063,8174,8182,818 5,8186,8159,8188,8175,8183,8187,8189,8190,8191];
wobei die Sequenz Q2 gegeben ist durch:
[0,1,2,4,8,16,32,3,5,64,1024,2048,9,6,17,10,18,128,12,33,65,20,256,34,24,36,7,129,66,5 12,11,40,68,130,19,13,48,14,72,257,1025,21,132,35,258,26,2049,513,80,37,25,22,136,2 60,264,38,514,96,67,41,144,28,69,42,516,49,1026,74,272,160,520,288,528,192,544,70,4 4,131,81,2050,50,73,15,320,133,52,1028,23,134,384,76,137,82,56,27,97,39,259,84,138, 145,261,1032,29,43,2052,98,515,88,140,30,146,71,262,265,161,576,45,1040,100,640,51 ,148,46,75,266,273,517,2056,104,162,53,193,1056,152,77,164,768,268,274,518,54,83,5 7,521,1027,112,135,2064,78,289,194,85,276,522,58,168,1029,139,99,86,60,280,89,290, 529,2080,524,196,1088,141,101,147,176,142,530,321,31,200,1033,90,545,292,2051,322 ,532,263,149,102,105,1030,304,296,163,92,47,267,385,546,2053,324,1041,208,386,150, 153,165,106,55,1034,328,536,577,548,2112,113,154,79,269,1042,108,578,224,166,519, 552,195,1152,270,3072,641,523,275,580,291,59,1036,169,560,114,277,156,2057,87,197 ,1057,116,170,61,531,525,642,281,1089,278,526,2054,177,293,388,91,1044,584,769,19 8,172,120,201,2065,336,1280,62,282,143,103,178,294,1058,93,644,2058,202,592,323,1 048,392,297,770,107,180,151,1060,2066,209,284,648,94,204,298,1031,400,608,352,217 6,325,533,1153,155,210,305,547,300,1090,109,2060,184,534,537,115,167,1536,225,326 ,306,772,2081,157,1035,656,329,110,117,212,1064,171,2113,776,330,226,549,1092,538 ,387,308,216,2068,1154,416,271,279,158,337,1043,550,672,2304,118,332,579,1037,540 ,389,173,121,1072,2082,553,199,784,179,1038,228,338,312,2072,704,390,1096,174,554 ,581,393,1281,283,2084,122,448,353,1045,561,203,63,340,2055,1156,394,527,582,556, 181,1059,2177,295,285,232,124,1282,205,182,643,2114,562,1050,286,585,299,1537,35 4,211,2560,401,185,1104,396,344,586,645,2059,1061,593,535,240,206,1049,95,2088,32 7,564,1046,800,402,356,307,2116,1160,301,417,213,568,1284,832,2178,588,186,1288,6 46,404,227,896,2067,1062,594,418,302,1538,649,771,2061,360,539,1120,111,331,214,1 091,2096,309,188,449,1065,217,408,2062,609,596,1168,551,650,229,1052,2120,159,42 0,310,1093,541,773,2305,610,1066,657,333,119,1540,3073,600,339,218,1073,368,652,2 30,2069,1098,391,313,450,1296,542,2180,334,233,1184,555,774,175,2083,1544,123,65 8,612,1312,2306,341,777,220,1552,314,424,2074,395,1216,673,583,355,1568,2561,287, 183,234,1094,125,557,2128,660,1068,616,342,316,2085,1155,241,778,1105,563,345,20 73,452,1074,397,403,207,2070,1097,674,558,1039,785,432,2184,357,1344,187,236,664, 2308,1157,624,587,1076,780,2312,705,126,1047,242,565,1158,2086,398,346,456,1408, 358,2562,405,1100,303,569,244,2144,1161,595,189,1106,566,2115,676,361,1080,706,5 89,2089,1051,215,786,647,1121,2192,348,419,1063,406,464,2076,680,1283,801,362,11 08,2117,590,409,1162,570,2090,788,597,1169,572,219,2564,1285,311,708,1053,598,20 97,601,1067,651,421,3074,792,1122,802,611,1539,2122,602,410,1112,231,688,2320,11 64,653,248,1054,2208,369,190,364,1170,654,2568,659,1095,335,480,2336,1286,315,22 1,1289,2576,370,613,1185,422,425,2240,1600,451,614,1069,2592,543,235,1124,412,21 18,343,372,1664,775,317,2092,1075,222,426,1172,2179,453,237,1070,559,2129,833,10 99,804,712,2098,1290,834,661,1297,2121,808,779,1541,617,1128,2063,604,433,1186,7 20,2368,816,1077,836,347,2181,1217,897,243,1176,2100,662,454,1101,318,3076,675,1 188,618,898,2071,1792,781,376,2182,1292,428,1298,665,2432,736,1542,567,840,2124, 1078,625,238,1107,2185,359,457,1081,399,2130,787,1545,591,1136,2104,678,434,1159 ,2075,677,349,1102,245,2145,458,1313,666,1218,2087,620,363,1109,2307,127,191,130 0,782,2132,1546,407,436,1082,2186,626,571,1192,2193,465,1163,681,246,2309,1123,7 07,350,3080,1110,599,1084,668,2077,790,1304,460,2091,249,1113,682,1314,2146,573, 411,1553,2563,803,789,1548,709,2136,1220,365,440,2188,1165,628,1125,689,2078,374 ,1171,423,2194,466,1200,793,2119,1166,250,371,1554,2310,481,1345,574,2313,413,10 55,603,2209,1224,366,468,1114,2624,655,1569,900,2093,805,1316,615,3088,1346,684, 710,2148,1556,429,1287,2688,794,252,1173,373,2099,1126,605,848,2196,1129,690,132 8,2094,713,1320,632,2123,482,1187,806,2314,1116,427,904,2321,1071,414,1291,2565, 223,663,1409,2152,692,1570,835,2210,1348,619,472,2101,1232,455,1410,2241,796,809 ,1174,3104,714,1177,721,2200,1189,837,716,2125,1130,864,1079,2212,810,1352,606,2 816,912,1560,722,2316,1601,696,1572,2322,377,435,1137,2566,817,1178,319,2102,110 3,621,1293,2131,812,484,1132,2105,430,1602,838,2569,1248,667,3075,488,1190,239,2 160,1543,378,1576,2183,459,1219,622,2126,627,1294,437,2337,1665,380,2242,1547,81 8,1299,2133,461,496,1604,2324,669,1315,2570,679,1083,724,2106,1193,841,629,2216, 1584,351,1138,3077,467,1301,2187,438,1180,737,2147,1111,251,1221,2134,462,442,21 08,1140,441,1194,2328,469,1085,2137,247,1555,683,2338,1549,842,1666,2577,738,899 ,2572,1305,670,1302,2244,783,1550,3136,849,1201,820,2189,1317,728,2149,1412,928, 1115,2195,791,367,2224,1608,901,1793,2190,630,1222,2578,685,1196,844,2369,1144,6 33,2079,1225,711,1360,2248,253,1086,3081,691,1306,824,2138,1167,902,2593,1127,68 6,740,2340,1202,850,2370,1318,375,2580,1117,444,1668,2311,470,1226,2197,483,1616 ,415,2150,1347,485,2153,1416,905,3078,1321,795,1794,2352,473,1131,2344,634,1204, 2211,744,1175,852,2140,1233,960,2095,1308,865,2315,1672,693,2433,1118,797,1228,2 594,906,1322,2372,715,1424,3089,807,1632,474,2256,1376,636,2434,1349,694,2198,15 57,254,2201,1179,717,2213,1234,575,1329,2154,913,1571,2103,798,1324,3082,811,113 3,2376,379,1208,2584,697,1558,431,2625,607,489,2596,1561,866,2161,1139,723,2202, 1191,486,2127,1249,908,2317,1350,718,1330,3090,813,1796,2156,476,1181,2626,856,1 680,2272,839,1353,2214,725,1134,2567,698,1141,2600,914,1236,2243,752,1195,3200,8 68,1800,2318,819,1354,2689,814,1250,439,2571,1573,929,2323,1562,490,2628,1411,62 3,2339,1332,671,2107,1240,739,3084,1440,916,2217,1295,463,2608,1303,843,2162,118 2,381,2325,1361,497,2204,1574,930,2135,1696,821,2245,1142,726,3105,1356,1603,216 4,961,2218,1564,872,2109,1413,492,2579,1197,631,2573,1145,729,2690,1577,700,2329 ,1223,443,3137,1808,741,2326,1203,845,2574,1252,920,2225,1362,382,2341,1336,822, 2436,1728,2139,1414,851,3092,1198,730,2632,1578,498,2817,1605,880,2246,1417,742, 2220,1307,445,2168,1146,2249,471,1472,2384,1377,635,3328,1585,932,2110,1227,687, 2330,1087,903,2191,1364,2151,825,1418,2226,500,1551,2342,1606,846,3106,1580,745, 2141,1205,2692,826,1319,2250,732,1309,2640,446,1256,2371,1148,3096,962,1229,244 0,936,1206,2345,475,1667,2818,853,2155,1586,867,2228,1310,1609,2199,637,1323,310 8,907,2257,1378,487,2332,1235,695,2696,1425,2142,1209,746,2252,1420,828,2346,136 8,3079,753,1610,2448,854,1669,2656,1617,2400,857,1559,2373,504,1264,2581,799,320 1,1230,1119,2203,255,1351,2258,964,2353,1588,909,2595,1824,719,2348,1426,3138,13 80,477,2157,1331,915,2232,1325,2582,638,1441,2585,1237,2163,748,1592,2215,944,18 56,3584,869,2273,1612,1210,2374,491,2354,1670,699,2820,1428,1251,2205,754,3083,1 920,858,2704,1618,2377,478,1442,2158,1326,968,2165,1673,2260,383,1795,3112,910,2 219,1384,1563,2824,815,2378,1135,976,2274,1355,2597,1238,870,3140,1333,2586,917, 1212,2435,1473,2356,727,1241,2264,493,3202,1432,873,2464,1633,2319,1620,701,232 7,1575,2206,931,1674,2385,1253,3091,756,1183,2598,860,2720,1444,1334,2166,499,23 80,1565,731,2627,1797,3085,1634,823,2588,1681,2437,922,1357,2221,1143,2169,874,1 624,3120,918,2601,1363,2247,1242,502,2832,1392,2227,933,1676,3086,1254,2276,743, 1415,2386,1337,2360,760,2752,1474,881,2438,1566,3144,1358,494,2222,1257,2602,70 2,2629,1579,1798,2441,921,3329,1199,501,2331,1147,2170,1682,2496,876,1636,2401,1 365,3093,847,1801,2609,992,2251,1244,2111,1338,447,2388,1448,3204,1419,2442,733, 1697,2575,827,2630,1607,2604,1379,934,2229,1311,3107,1207,2343,882,1258,2333,93 7,2280,1149,2172,1581,963,3330,1684,2253,1640,2230,747,1366,2691,505,2610,1340,3 098,1265,855,2334,1802,2633,1587,2347,924,3585,1369,734,2402,1476,2259,1421,244 9,829,1427,2233,1231,3152,965,2444,1698,2392,1582,938,2634,1809,2693,1456,3109,8 84,1381,2641,506,2583,1211,2288,1260,2254,749,1688,3097,1648,2143,945,2375,1611, 2612,1804,966,3094,1729,2848,1150,2450,755,2404,1266,859,2355,1589,3208,1422,23 49,940,2465,1370,2261,1480,830,2616,1382,3332,1429,2880,911,2636,1327,1593,2234, 871,3336,1268,2694,1619,2452,639,2275,1213,1590,2944,888,3110,1700,2642,1385,24 66,479,2350,1730,3586,1613,946,2697,1239,2819,750,2408,1810,2587,1671,3168,969,2 159,1372,1443,2379,508,2262,1430,3139,1488,2357,861,2236,1704,2497,1825,757,311 3,1386,2265,1614,2456,970,2657,1433,2644,1594,3216,919,2599,1812,1621,2698,1596, 2277,875,3100,1243,2207,1335,2468,862,2358,1732,3141,1622,2589,758,1625,2821,16 75,2658,948,3114,1445,2705,1816,2381,977,2167,1826,3588,1635,2648,923,2387,1626, 2266,1434,972,3121,1255,2416,1712,2700,761,2278,1677,3146,1272,2439,877,2361,13 93,2498,1214,3344,1388,2590,952,2382,1678,2281,1683,495,3232,1359,2603,1504,282 2,703,2223,1339,3592,1245,2171,935,2706,1394,2660,1637,3360,978,2389,1446,2825,1 449,2268,1475,3600,883,2362,1638,2472,1567,2443,762,3264,1259,2721,1436,2631,50 3,2403,1367,3616,1396,2335,925,2231,1799,2282,1341,3142,1246,2173,878,2605,1450, 2708,1477,3116,735,2664,1261,2390,1583,2364,1857,3203,993,2289,1828,2826,1736,3 153,885,2611,1858,2393,1685,2500,939,3122,1832,2445,1803,2451,1641,2255,994,314 5,1628,2722,1457,2606,980,3087,1744,2833,1840,2480,1860,2405,926,3392,1371,2235, 1921,2284,764,2712,1267,3205,1686,2672,1478,2635,941,3124,1342,2828,1699,2753,9 67,2174,1642,3095,1922,2290,1805,2613,886,1400,1452,3206,831,2446,1689,2394,176 0,2504,1591,3456,947,2406,1864,2453,1649,3148,507,2351,1262,2617,1383,2292,1481, 3209,889,2643,1423,2237,1811,3154,1615,2614,984,2724,1702,2409,1458,3128,751,27 54,1701,2637,1373,3099,1269,2263,942,2834,1482,2695,1690,3169,1644,2396,996,246 7,1387,3111,1151,2454,1215,2512,971,2728,1806,3331,1431,2849,890,2410,1460,3156, 1650,2638,1595,2457,509,3210,1489,2618,1705,2836,1270,2645,949,3217,1731,2620,1 374,2267,1623,3333,973,2359,1692,2756,1814,3101,1484,2646,1000,2649,1273,3115,1 706,2699,1597,2469,892,2840,1435,3170,1827,2850,1813,2659,950,3587,1733,2650,13 89,2458,1464,3160,863,2279,2736,1652,3212,1713,2701,1398,2296,759,3102,1447,241 7,1490,2238,1817,2412,1008,3218,1274,2702,1395,2707,1505,3143,510,2383,1598,252 8,3334,1437,2363,1627,2269,979,3337,1390,2418,1492,2661,1679,3233,953,2470,1924, 2473,1829,3648,1639,2499,2662,763,3117,1708,2591,1734,2283,1453,3172,974,2460,1 818,2391,1276,2420,1397,3712,2823,1629,2365,954,3123,1872,2270,1714,2474,1737,3 220,879,2501,1656,2285,3118,1506,2607,1830,2881,981,3147,1451,2852,1928,2760,14 38,3338,2882,982,2709,1247,3345,1687,2856,1716,2827,1859,3589,927,2665,3176,164 3,2652,1496,2481,1479,3234,995,2768,1820,2864,1833,3125,2884,1738,2395,1745,326 5,765,2945,1861,2291,3224,1740,2710,1888,2502,956,3149,1834,2366,1630,2723,3236, 1936,2666,1746,2946,887,3840,1720,2829,1401,2424,3340,1459,2476,1841,3346,985,2 713,1343,2784,3590,1645,2615,1836,2888,997,3126,1508,2673,2286,1454,3155,1862,2 407,1691,2505,986,3129,2447,1512,2835,1263,3593,1402,2639,3184,1483,2726,943,24 82,1646,3207,1651,2725,2397,1461,3150,1404,2293,891,2506,3361,1842,2714,1485,32 66,1520,2668,1693,2411,3157,998,2175,1703,2239,1748,3348,2830,1865,3594,766,245 5,1653,2484,3130,1375,2674,1491,2619,1462,3240,2513,511,3211,1761,2729,1275,229 4,3171,1486,2755,1466,2398,1465,3158,2647,988,3132,1493,2716,1271,2838,3352,170 7,2508,1866,2297,3161,1001,2730,1762,3362,1923,2621,2459,1694,3601,1807,2851,95 1,2837,3596,1873,2757,1844,3268,2413, 1752,2488, 1952,3213, 1002,2676,3173,1815,27 37,1391,2422,3219,1925,2471,1654,2514,1709,3248,2841,893,3214,1868,2298,2419,16 57,3602,1735,2529,3393,1277,2622,975,2461,1715,3103,2651,1848,3272,1926,2414,25 16,1710,3162,894,2703,3617,1764,2948,1874,2853,3364,1399,2663,1468,3394,2732,14 94,2758,1009,3604,2477,1507,3335,1439,2842,2300,1509,3221,1929,2421,3174,1819,2 653,955,2896,3177,1497,2738,1658,3376,2761,1768,3368,1876,2680,2530,1984,3235,1 004,2854,3164,1889,2475,1717,2952,3119,1821,2462,1930,3339,2271,1010,2711,1739, 3457,2740,1831,3618,2883,1498,3396,1660,2667,2520,1718,3280,957,2503,3458,1278, 2844,1741,2857,3222,1599,2762,3225,1937,2769,1822,3237,2885,983,2764,1835,3178, 2912,1403,3127,2858,1721,3400,1455,2654,2960,1631,3608,1513,2770,3649,958,2744, 3620,1890,2425,1747,2483,3185,1510,2865,3226,1932,2367,1742,3151,2669,987,3341, 2860,1837,2532,1500,3180,2478,1880,3650,2886,1863,3296,1749,2715,2536,1012,3238 ,2287,1722,3591,1938,2426,3624,1776,2507,3267,1892,2670,1843,2675,3342,1838,248 5,3713,999,2428,1463,3595,2866,1953,3347,2509,1514,2544,3652,1647,2717,1695,336 3,2727,1763,3131,2772,1016,3241,2889,1940,2677,1487,3632,2399,1867,3186,2515,14 05,3349,2486,1521,3228,2785,767,3159,1954,2299,3269,1845,2510,2490,1750,3188,24 89,1985,3242,1896,2517,3133,1516,2295,3603,1655,2731,3597,989,2890,3714,1753,27 86,2947,1724,3353,1467,2718,3350,1765,2831,3598,1869,2897,3249,1944,2868,3365,1 003,2776,3460,1406,2976,3163,1846,2839,1875,2415,3656,1754,2949,3841,1522,2678, 3270,1904,2733,3244,990,2892,3192,1766,2681,3273,1469,2759,3408,1495,2301,3134, 1659,2739,3354,1956,2872,3215,1711,2950,3175,1927,2734,1005,2788,3250,1849,2898 ,3366,1524,2423,3165,1870,2492,3716,1769,2518,3274,1850,2531,3664,1756,2463,339 5,1470,2533,3464,959,2953,3369,1986,2843,3842,1960,2521,3179,1499,2682,3252,187 7,2792,3223,1891,2900,3281,3008,1661,3356,2913,1931,3720,2741,1011,3166,2845,15 11,3276,2954,1719,3370,2763,1770,3472,2855,1852,3680,2522,1777,3424,2684,1878,3 397,2742,1881,3605,2302,1013,3227,2765,1528,3282,2623,3377,1823,2961,3619,1279, 2846,3372,1988,2859,3181,1933,2427,3256,1743,2745,3606,1501,2479,2655,2537,1939 ,3609,2914,895,3187,2771,1662,3239,2534,1772,3297,2956,1968,3398,2766,3378,1893, 2861,3844,1515,2524,3229,1723,2904,3728,1778,2887,3401,1882,2773,3182,2746,1006 ,3189,2962,1502,3284,2800,1992,3243,2916,3848,1407,2867,3402,1934,2862,3298,183 9,2487,3621,2000,2977,3610,2538,1894,3459,2671,1941,3380,2719,1014,3288,2787,34 88,1751,2964,3343,1517,2511,3351,2891,1897,3230,2429,1725,3409,2545,1955,3622,2 978,3744,1780,2869,3190,1884,2774,3404,1523,3651,3009,3612,1755,2920,3461,1017, 2540,3245,2679,1847,3193,2777,1946,3625,2748,3271,1898,2491,3856,1942,2789,3251 ,2893,1526,3300,2968,1957,3410,2430,3384,1767,2870,3776,1784,3462,2899,3246,190 5,2778,3626,1018,2546,3653,2928,1518,3465,2790,1726,3355,2493,3194,1945,2519,35 20,1525,3425,2683,3633,1900,2980,3275,2735,1871,3135,2951,2016,3412,2873,3466,1 471,2548,3599,1757,3654,2894,3628,1851,2793,3253,2874,991,3367,2780,1958,3357,2 494,3304,1906,3196,3010,3277,1961,2984,3254,2523,1987,3715,2901,1771,3634,2915, 3358,1529,3657,2685,3371,1879,2955,3426,2535,1948,3283,2743,1758,3473,3257,2794 ,1853,3468,2876,3416,1020,2801,3658,2902,1989,3717,3665,1962,2905,3607,2552,190 8,3312,2847,3278,1530,3167,2303,3399,1773,3012,3636,2957,1969,3872,2767,3474,19 90,3428,2525,3379,1779,2963,3373,2686,1883,3489,3285,2796,1964,3640,2992,3904,1 854,2917,3660,3258,1935,2539,3718,2747,1007,3476,3299,2802,1895,3968,2906,3666, 1663,2526,3490,3374,1912,3016,3721,2431,1503,3843,2958,3432,1970,3611,2863,3183 ,1774,3024,3403,3286,1993,2918,3381,2965,1532,3260,3521,2775,1885,3289,2541,348 0,1781,2921,3681,3668,1994,2749,3623,2979,3722,1943,3301,2804,3231,1015,2908,34 92,3382,1899,2547,3613,2779,1886,3845,3682,2871,3729,1782,2970,3405,3191,1972,2 922,3672,2966,2001,3411,3290,2550,1947,3440,2981,3724,3302,1996,2791,3463,3385, 1785,2808,3522,2929,1901,3614,3406,2542,3305,1976,2750,3627,3846,1519,2969,3247 ,2549,3195,1727,3730,2924,3684,1959,3413,2895,3849,3040,2002,3292,3386,2495,101 9,3496,3467,2781,3745,1907,2875,3655,3427,1786,2982,3359,3255,2930,1527,3306,29 85,3197,1949,3629,3011,3732,3688,1902,2795,3414,2553,3388,1759,3313,2903,3850,2 017,3635,2972,3417,2782,1909,3524,3469,2877,3475,1963,3279,3013,3746,2018,3630, 2986,3857,3504,2004,2932,3429,2554,3259,1950,3308,2797,3736,3696,1788,2993,3659 ,3852,3014,1965,3777,3198,2803,3314,1991,2907,3637,3470,2988,1021,3418,3528,287 8,1910,3430,3477,2959,3375,1855,3641,2919,3316,3667,1971,2687,3261,3638,2936,15 31,3748,3433,2527,3778,1913,3661,2994,3287,2798,3858,2008,3719,3017,3420,3491,1 775,2556,3478,3536,2909,1966,3752,3873,2805,3434,2020,3662,3018,3481,3642,1995, 2967,3860,3669,3644,2923,1914,3291,3383,2910,3780,1533,3670,2806,3673,3723,1973 ,2996,3493,3864,3025,3874,1997,3683,2971,3674,3482,2024,3020,3303,3760,2809,191 6,3725,3320,2925,3441,3262,1974,3436,3000,3726,3731,1887,2543,3407,3552,2751,33 87,1783,3293,2983,3442,3685,3026,1022,3494,3497,3523,2931,2032,3686,3615,2810,3 307,3484,1534,2551,3415,3444,2973,3847,2003,3389,3294,2926,3498,3525,1977,2783, 3309,3631,3905,1787,3041,3876,3784,2933,3906,1998,3733,2987,3880,3851,3689,1978 ,3042,3676,3505,3028,3792,1903,3888,3908,2974,3419,3969,2005,2812,3315,3734,352 6,2989,2006,3390,3747,3015,3690,3970,1951,3853,2934,3448,3500,2879,3737,2019,38 08,3639,2995,3912,3697,1789,2555,3310,3431,3529,2937,1980,3471,3859,3663,3032,3 750,3506,1911,2799,3749,3421,3317,2990,2009,3530,3738,3692,3044,3435,3199,2021, 3263,3019,3854,3479,2938,2010,3508,3698,3643,2557,3537,3753,1967,3318,2997,3779 ,3422,3671,3021,1915,3740,3862,3532,3048,3321,3754,2022,3645,2940,3483,3875,386 1,1790,2998,3781,3437,3512,2911,3700,1535,3761,3446,2807,3495,3538,3865,3056,10 23,3322,3443,3553,2558,3646,3485,2012,3675,3027,3438,3540,3727,3001,2025,3972,3 877,3687,2811,3756,3782,1975,3501,3022,3866,3324,3445,3677,3002,2026,3920,3762, 3785,2927,3704,3554,1917,3878,3029,3499,3976,3486,3030,3295,1999,3735,3764,3907 ,2975,3691,3544,3527,1918,3043,3868,3881,3786,3793,2813,3909,2033,3788,3936,300 4,3882,3678,3984,3794,1979,2935,3768,3449,3507,3889,3033,3391,2028,3693,3884,30 45,3556,3502,3910,3739,2034,3034,3560,3311,3450,3531,2991,3694,1981,3699,3509,3 452,2939,3890,3533,3568,3741,2007,3046,3751,3796,3913,2814,3701,3423,3539,1982, 3510,2559,3809,3323,3534,3514,3513,2011,3036,3541,3319,3755,3914,3049,3810,3971 ,3742,2036,3855,2999,3921,3892,3800,4000,3050,3863,2023,3439,3973,3702,3757,294 1,3916,3705,3783,2040,3325,3023,3763,3896,3974,3758,2942,3812,3922,1791,3447,35 16,3542,3057,3555,3487,3557,3977,3867,2013,3003,3545,3706,3816,3924,4032,3052,3 937,3765,2027,3869,3978,3058,3787,3879,3546,3708,3766,3005,2014,3326,3789,3647, 3985,3870,3031,3883,3451,3769,3503,2029,3679,3561,3006,3938,3795,3558,3980,3790 ,3035,3885,1983,3548,3928,3911,3797,3060,3770,3986,3824,3940,3891,2035,3886,304 7,3511,4001,3562,3695,3743,3811,3064,3988,3535,2037,3915,3453,3569,2815,4002,38 93,3798,4033,3944,3564,3703,1919,3037,3801,3772,3515,3813,3917,3992,3051,3454,3 894,3923,3802,2030,3570,3952,3038,3814,3517,3543,3707,4004,3759,3975,3053,3897, 2038,3572,3918,3817,3898,3804,3518,3007,4034,4008,3547,3925,3939,2041,3709,3979 ,3059,3559,3767,3818,3900,3825,3926,3929,3061,3576,3871,3327,2042,4036,3981,379 1,3549,3987,2943,3710,3820,4016,3941,3563,3771,3826,3930,2015,3054,3550,4040,34 55,3982,3887,4048,3942,3989,3062,3799,3565,3945,3773,4003,2044,3828,3932,3571,3 803,3065,3895,3994,3946,3990,3574,4005,3815,3832,3953,3066,3566,2031,3774,3993, 3573,3948,3919,4064,3519,3805,3899,3039,4006,3954,4009,4035,3819,3577,3927,2039 ,3996,3806,3901,3068,4037,4010,3956,3578,3821,4017,4038,3827,3931,4012,3902,398 3,3055,3943,3711,3960,2043,3551,4018,3822,4041,3580,3933,3829,4042,3991,3063,39 47,3934,3830,4020,4049,3995,4044,3833,3949,4024,3567,2045,3775,4007,4050,3067,3 955,3834,3575,3997,3950,3807,4065,3957,4011,4066,4052,3998,3836,4013,4039,3069, 3958,3903,4019,3579,3961,2046,4056,3823,4014,4068,4043,3962,3581,4021,4045,4072 ,3964,4022,3935,3831,3070,4080,3582,4051,4025,3835,4046,4026,3951,4053,4054,399 9,4067,3837,4028,3959,4057,4069,2047,4058,4015,3963,4070,3838,3583,3071,4060,40 73,4023,4074,3965,4047,3966,4081,4027,4076,4082,4029,4055,4030,4059,4084,4071,4 088,3839,4061,4075,4062,4077,4031,4083,4085,3967,4078,4086,4089,4090,4063,4092, 4079,4087,4091,4093,4094,4095];
wobei die Sequenz Q3 gegeben ist durch:
[0,1,2,4,8,16,32,3,5,64,1024,9,6,17,10,18,128,12,33,65,20,256,34,24,36,7,129,66,512,11, 40,68,130,19,13,48,14,72,257,1025,21,132,35,258,26,513,80,37,25,22,136,260,264,38,5 14,96,67,41,144,28,69,42,516,49,1026,74,272,160,520,288,528,192,544,70,44,131,81,50 ,73,15,320,133,52,1028,23,134,384,76,137,82,56,27,97,39,259,84,138,145,261,1032,29, 43,98,515,88,140,30,146,71,262,265,161,576,45,1040,100,640,51,148,46,75,266,273,51 7,104,162,53,193,1056,152,77,164,768,268,274,518,54,83,57,521,1027,112,135,78,289, 194,85,276,522,58,168,1029,139,99,86,60,280,89,290,529,524,196,1088,141,101,147,17 6,142,530,321,31,200,1033,90,545,292,322,532,263,149,102,105,1030,304,296,163,92,4 7,267,385,546,324,1041,208,386,150,153,165,106,55,1034,328,536,577,548,113,154,79, 269,1042,108,578,224,166,519,552,195,1152,270,641,523,275,580,291,59,1036,169,560 _{,}114,277,156,87,197,1057,116,170,61,531,525,642,281,1089,278,526,177,293,388,91,10 44,584,769,198,172,120,201,336,1280,62,282,143,103,178,294,1058,93,644,202,592,32 3,1048,392,297,770,107,180,151,1060,209,284,648,94,204,298,1031,400,608,352,325,5 33,1153,155,210,305,547,300,1090,109,184,534,537,115,167,1536,225,326,306,772,157 ,1035,656,329,110,117,212,1064,171,776,330,226,549,1092,538,387,308,216,1154,416, 271,279,158,337,1043,550,672,118,332,579,1037,540,389,173,121,1072,553,199,784,17 9,1038,228,338,312,704,390,1096,174,554,581,393,1281,283,122,448,353,1045,561,203 ,63,340,1156,394,527,582,556,181,1059,295,285,232,124,1282,205,182,643,562,1050,2 86,585,299,1537,354,211,401,185,1104,396,344,586,645,1061,593,535,240,206,1049,95 ,327,564,1046,800,402,356,307,1160,301,417,213,568,1284,832,588,186,1288,646,404, 227,896,1062,594,418,302,1538,649,771,360,539,1120,111,331,214,1091,309,188,449,1 065,217,408,609,596,1168,551,650,229,1052,159,420,310,1093,541,773,610,1066,657,3 33,119,1540,600,339,218,1073,368,652,230,1098,391,313,450,1296,542,334,233,1184,5 55,774,175,1544,123,658,612,1312,341,777,220,1552,314,424,395,1216,673,583,355,15 68,287,183,234,1094,125,557,660,1068,616,342,316,1155,241,778,1105,563,345,452,10 74,397,403,207,1097,674,558,1039,785,432,357,1344,187,236,664,1157,624,587,1076,7 80,705,126,1047,242,565,1158,398,346,456,1408,358,405,1100,303,569,244,1161,595,1 89,1106,566,676,361,1080,706,589,1051,215,786,647,1121,348,419,1063,406,464,680,1 283,801,362,1108,590,409,1162,570,788,597,1169,572,219,1285,311,708,1053,598,601, 1067,651,421,792,1122,802,611,1539,602,410,1112,231,688,1164,653,248,1054,369,19 0,364,1170,654,659,1095,335,480,1286,315,221,1289,370,613,1185,422,425,1600,451,6 14,1069,543,235,1124,412,343,372,1664,775,317,1075,222,426,1172,453,237,1070,559, 833,1099,804,712,1290,834,661,1297,808,779,1541,617,1128,604,433,1186,720,816,10 77,836,347,1217,897,243,1176,662,454,1101,318,675,1188,618,898,1792,781,376,1292, 428,1298,665,736,1542,567,840,1078,625,238,1107,359,457,1081,399,787,1545,591,11 36,678,434,1159,677,349,1102,245,458,1313,666,1218,620,363,1109,127,191,1300,782, 1546,407,436,1082,626,571,1192,465,1163,681,246,1123,707,350,1110,599,1084,668,7 90,1304,460,249,1113,682,1314,573,411,1553,803,789,1548,709,1220,365,440,1165,62 8,1125,689,374,1171,423,466,1200,793,1166,250,371,1554,481,1345,574,413,1055,603, 1224,366,468,1114,655,1569,900,805,1316,615,1346,684,710,1556,429,1287,794,252,1 173,373,1126,605,848,1129,690,1328,713,1320,632,482,1187,806,1116,427,904,1071,4 14,1291,223,663,1409,692,1570,835,1348,619,472,1232,455,1410,796,809,1174,714,11 77,721,1189,837,716,1130,864,1079,810,1352,606,912,1560,722,1601,696,1572,377,43 5,1137,817,1178,319,1103,621,1293,812,484,1132,430,1602,838,1248,667,488,1190,23 9,1543,378,1576,459,1219,622,627,1294,437,1665,380,1547,818,1299,461,496,1604,66 9,1315,679,1083,724,1193,841,629,1584,351,1138,467,1301,438,1180,737,1111,251,12 21,462,442,1140,441,1194,469,1085,247,1555,683,1549,842,1666,738,899,1305,670,13 02,783,1550,849,1201,820,1317,728,1412,928,1115,791,367,1608,901,1793,630,1222,6 85,1196,844,1144,633,1225,711,1360,253,1086,691,1306,824,1167,902,1127,686,740,1 202,850,1318,375,1117,444,1668,470,1226,483,1616,415,1347,485,1416,905,1321,795, 1794,473,1131,634,1204,744,1175,852,1233,960,1308,865,1672,693,1118,797,1228,906 ,1322,715,1424,807,1632,474,1376,636,1349,694,1557,254,1179,717,1234,575,1329,91 3,1571,798,1324,811,1133,379,1208,697,1558,431,607,489,1561,866,1139,723,1191,48 6,1249,908,1350,718,1330,813,1796,476,1181,856,1680,839,1353,725,1134,698,1141,9 14,1236,752,1195,868,1800,819,1354,814,1250,439,1573,929,1562,490,1411,623,1332, 671,1240,739,1440,916,1295,463,1303,843,1182,381,1361,497,1574,930,1696,821,1142 ,726,1356,1603,961,1564,872,1413,492,1197,631,1145,729,1577,700,1223,443,1808,74 1,1203,845,1252,920,1362,382,1336,822,1728,1414,851,1198,730,1578,498,1605,880,1 417,742,1307,445,1146,471,1472,1377,635,1585,932,1227,687,1087,903,1364,825,1418 ,500,1551,1606,846,1580,745,1205,826,1319,732,1309,446,1256,1148,962,1229,936,12 06,475,1667,853,1586,867,1310,1609,637,1323,907,1378,487,1235,695,1425,1209,746, 1420,828,1368,753,1610,854,1669,1617,857,1559,504,1264,799,1230,1119,255,1351,96 4,1588,909,1824,719,1426,1380,477,1331,915,1325,638,1441,1237,748,1592,944,1856, 869,1612,1210,491,1670,699,1428,1251,754,1920,858,1618,478,1442,1326,968,1673,38 3,1795,910,1384,1563,815,1135,976,1355,1238,870,1333,917,1212,1473,727,1241,493, 1432,873,1633,1620,701,1575,931,1674,1253,756,1183,860,1444,1334,499,1565,731,17 97,1634,823,1681,922,1357,1143,874,1624,918,1363,1242,502,1392,933,1676,1254,743 ,1415,1337,760,1474,881,1566,1358,494,1257,702,1579,1798,921,1199,501,1147,1682, 876,1636,1365,847,1801,992,1244,1338,447,1448,1419,733,1697,827,1607,1379,934,13 11,1207,882,1258,937,1149,1581,963,1684,1640,747,1366,505,1340,1265,855,1802,158 7,924,1369,734,1476,1421,829,1427,1231,965,1698,1582,938,1809,1456,884,1381,506, 1211,1260,749,1688,1648,945,1611,1804,966,1729,1150,755,1266,859,1589,1422,940,1 370,1480,830,1382,1429,911,1327,1593,871,1268,1619,639,1213,1590,888,1700,1385,4 79,1730,1613,946,1239,750,1810,1671,969,1372,1443,508,1430,1488,861,1704,1825,75 7,1386,1614,970,1433,1594,919,1812,1621,1596,875,1243,1335,862,1732,1622,758,162 5,1675,948,1445,1816,977,1826,1635,923,1626,1434,972,1255,1712,761,1677,1272,877 ,1393,1214,1388,952,1678,1683,495,1359,1504,703,1339,1245,935,1394,1637,978,1446 ,1449,1475,883,1638,1567,762,1259,1436,503,1367,1396,925,1799,1341,1246,878,1450 ,1477,735,1261,1583,1857,993,1828,1736,885,1858,1685,939,1832,1803,1641,994,1628 ,1457,980,1744,1840,1860,926,1371,1921,764,1267,1686,1478,941,1342,1699,967,1642 ,1922,1805,886,1400,1452,831,1689,1760,1591,947,1864,1649,507,1262,1383,1481,889 ,1423,1811,1615,984,1702,1458,751,1701,1373,1269,942,1482,1690,1644,996,1387,115 1,1215,971,1806,1431,890,1460,1650,1595,509,1489,1705,1270,949,1731,1374,1623,97 3,1692,1814,1484,1000,1273,1706,1597,892,1435,1827,1813,950,1733,1389,1464,863,1 652,1713,1398,759,1447,1490,1817,1008,1274,1395,1505,510,1598,1437,1627,979,139 0,1492,1679,953,1924,1829,1639,763,1708,1734,1453,974,1818,1276,1397,1629,954,18 72,1714,1737,879,1656,1506,1830,981,1451,1928,1438,982,1247,1687,1716,1859,927,1 643,1496,1479,995,1820,1833,1738,1745,765,1861, 1740, 1888,956, 1834, 1630, 1936, 174 6,887,1720,1401,1459,1841,985,1343,1645,1836,997,1508,1454,1862,1691,986,1512,12 63,1402,1483,943,1646,1651,1461,1404,891,1842,1485,1520,1693,998,1703,1748,1865, 766,1653,1375,1491,1462,511,1761,1275,1486,1466,1465,988,1493,1271,1707,1866,10 01,1762,1923,1694,1807,951,1873,1844,1752,1952,1002,1815,1391,1925,1654,1709,89 3,1868,1657,1735,1277,975,1715,1848,1926,1710,894,1764,1874,1399,1468,1494,1009, 1507,1439,1509,1929,1819,955,1497,1658,1768,1876,1984,1004,1889,1717,1821,1930, 1010,1739,1831,1498,1660,1718,957,1278,1741,1599,1937,1822,983,1835,1403,1721,1 455,1631,1513,958,1890,1747,1510,1932,1742,987,1837,1500,1880,1863,1749,1012,17 22,1938,1776,1892,1843,1838,999,1463,1953,1514,1647,1695,1763,1016,1940,1487,18 67,1405,1521,767,1954,1845,1750,1985,1896,1516,1655,989,1753,1724,1467,1765,186 9,1944,1003,1406,1846,1875,1754,1522,1904,990, 1766, 1469, 1495, 1659, 1956, 1711,192 7,1005,1849,1524,1870,1769,1850,1756,1470,959,1986,1960,1499,1877,1891,1661,193 1,1011,1511,1719,1770,1852,1777,1878,1881,1013,1528,1823,1279,1988,1933,1743,15 01,1939,895,1662,1772,1968,1893,1515,1723,1778,1882,1006,1502,1992,1407,1934,18 39,2000,1894,1941,1014,1751,1517,1897,1725,1955,1780,1884,1523,1755,1017,1847,1 946,1898,1942,1526,1957,1767,1784,1905,1018,1518,1726,1945,1525,1900,1871,2016, 1471,1757,1851,991,1958,1906,1961,1987,1771,1529,1879,1948,1758,1853,1020,1989, 1962,1908,1530,1773,1969,1990,1779,1883,1964,1854,1935,1007,1895,1663,1912,1503 ,1970,1774,1993,1532,1885,1781,1994,1943,1015,1899,1886,1782,1972,2001,1947,199 6,1785,1901,1976,1519,1727,1959,2002,1019,1907,1786,1527,1949,1902,1759,2017,19 09,1963,2018,2004,1950,1788,1965,1991,1021,1910,1855,1971,1531,1913,2008,1775,1 966,2020,1995,1914,1533,1973,1997,2024,1916,1974,1887,1783,1022,2032,1534,2003, 1977,1787,1998,1978,1903,2005,2006,1951,2019,1789,1980,1911,2009,2021,2010,1967 ,1915,2022,1790,1535,1023,2012,2025,1975,2026,1917,1999,1918,2033,1979,2028,203 4,1981,2007,1982,2011,2036,2023,2040,1791,2013,2027,2014,2029,1983,2035,2037,19 19,2030,2038,2041,2042,2015,2044,2031,2039,2043,2045,2046,2047];
wobei die Sequenznummern von N polarisierten Kanälen in der zweiten Sequenz in aufsteigender Reihenfolge der Zuverlässigkeit der N polarisierten Kanäle angeordnet sind, und ein Minimumwert der Sequenznummern der polarisierten Kanäle 0 ist;
oder die zweite Sequenz ein Teil oder die gesamte Sequenz Z1, eine Sequenz Z2 oder eine Sequenz Z3 ist;
wobei die Sequenz Z1 gegeben ist durch:
[0,1,2,7,3,8,14,27,4,13,16,31,19,36,38,84,5,15,17,35,22,42,52,89,25,51,46,97,63,106,113 ,182,6,20,24,44,26,50,57,99,32,61,65,107,78,120,126,201,37,67,82,124,87,135,145,215, 96,147,160,243,166,257,281,408,9,21,29,60,33,64,77,115,39,83,69,127,92,139,153,224, 49,80,95,146,101,156,165,251,111,168,186,269,200,288,307,454,59,98,109,164,122,176 ,194,284,133,195,214,299,227,325,343,494,150,222,247,330,254,344,371,528,275,378,4 02,556,423,581,627,877,18,28,34,79,43,86,90,151,54,94,102,163,112,175,179,283,62,10 3,114,177,125,193,211,301,138,212,223,319,249,339,364,516,71,118,134,199,140,213,2 30,331,161,245,255,347,274,377,394,553,178,266,285,385,300,417,426,578,327,440,47 5,615,501,649,725,878,75,136,155,233,173,252,273,382,183,277,291,407,308,425,452,6 03,208,304,320,437,345,468,496,662,358,504,533,690,564,738,767,1022,229,334,352,4 79,387,513,538,715,422,548,579,755,616,773,842,1103,451,592,630,809,645,865,897,1 175,720,914,951,1160,990,1235,1333,1678,23,40,45,100,55,104,116,192,56,117,129,20 2,142,225,236,362,70,130,143,240,157,248,263,363,167,261,282,400,305,421,432,577,7 3,154,169,242,188,267,286,420,198,297,309,434,323,466,486,643,197,321,336,463,357, 500,518,694,389,542,566,737,589,764,816,1081,85,181,190,293,206,316,335,456,217,3 42,351,495,372,527,547,733,279,365,388,532,409,562,588,760,443,597,635,805,667,86 2,901,1147,313,404,436,574,462,613,638,845,491,655,677,874,726,931,966,1211,535,7 24,742,952,761,992,940,1257,826,1074,1107,1355,1121,1459,1518,1755,91,203,209,35 6,268,376,392,541,295,397,412,569,442,601,634,849,311,439,461,602,478,641,670,884, 505,682,713,921,757,960,1019,1270,361,467,484,668,517,703,745,943,567,746,769,101 4,830,985,1092,1361,611,797,858,1075,885,1117,1154,1426,932,1168,1165,1503,1260, 1547,1599,1928,403,502,543,750,599,772,814,1037,636,847,867,1110,912,1128,1163,1 452,672,893,945,1150,967,1172,1264,1552,1034,1284,1322,1613,1390,1696,1745,2117, 734,955,1008,1267,1089,1273,1376,1634,1101,1365,1433,1725,1488,1791,1886,2269,1 129,1463,1535,1824,1577,1902,1857,2323,1667,1977,2030,2480,2145,2568,2678,3005, 30,48,58,110,66,131,144,231,72,148,159,239,172,259,264,413,74,170,180,258,191,317, 328,450,218,329,355,492,375,520,545,754,76,187,204,322,220,353,368,510,232,381,39 5,551,416,582,608,775,246,406,430,595,457,631,652,836,469,644,684,890,689,920,957, 1340,119,219,228,373,241,396,414,572,271,433,445,622,474,658,680,853,292,449,483, 648,508,687,697,905,531,699,712,962,796,996,1062,1363,312,507,523,708,558,743,751 ,977,587,792,820,1033,873,1084,1112,1437,621,841,889,1115,936,1143,1218,1492,100 6,1228,1288,1557,1326,1626,1705,2102,123,238,260,427,289,446,477,664,306,488,511, 702,536,719,728,970,341,526,557,731,585,785,813,1023,617,832,869,1098,907,1133,11 90,1441,369,571,606,818,654,861,857,1136,674,895,916,1178,981,1222,1248,1564,716, 938,1000,1239,1027,1305,1329,1638,1070,1358,1405,1729,1499,1802,1892,2278,391,6 26,657,900,695,928,982,1231,781,1004,1046,1316,1053,1336,1383,1689,799,1048,1067 ,1372,1138,1401,1474,1788,1203,1495,1532,1828,1595,1936,1996,2352,834,1156,1185, 1445,1249,1507,1543,1869,1292,1586,1644,1973,1711,2038,2130,2512,1412,1653,1736 ,2060,1814,2160,2203,2654,1876,2243,2315,2718,2421,2834,2985,3484,141,272,298,48 9,337,521,552,763,349,563,593,790,624,825,881,1193,383,610,663,851,686,925,909,12 10,705,947,989,1281,1041,1309,1347,1671,460,676,707,924,780,975,1011,1319,789,10 42,1060,1351,1088,1387,1424,1765,801,1078,1124,1420,1199,1471,1522,1835,1241,15 73,1591,1940,1648,2004,2079,2459,471,778,784,1029,804,1051,1095,1398,837,1142,11 81,1456,1224,1510,1582,1917,997,1197,1253,1528,1294,1616,1657,1984,1394,1663,17 39,2064,1818,2153,2195,2640,1056,1301,1368,1620,1416,1719,1776,2094,1484,1795,1 847,2187,1910,2251,2343,2760,1539,1880,1954,2306,2026,2372,2453,2866,2109,2491, 2557,2952,2616,3109,3149,3832,480,808,822,1186,972,1215,1245,1568,1015,1277,131 2,1630,1379,1685,1759,2087,1064,1344,1409,1699,1448,1781,1851,2177,1514,1898,18 40,2227,1992,2332,2413,2803,1206,1430,1467,1807,1561,1862,1946,2286,1609,1958,2 018,2381,2072,2433,2524,2934,1715,2045,2124,2471,2210,2580,2628,3065,2262,2704, 2747,3199,2848,3272,3331,3683,1298,1481,1605,1965,1681,2011,2052,2442,1750,2138 ,2169,2548,2234,2592,2730,3129,1769,2219,2295,2692,2401,2774,2787,3300,2503,288 3,2915,3359,3027,3524,3596,4162,1921,2364,2392,2817,2536,2897,2971,3420,2604,30 47,3085,3560,3225,3639,3888,4347,2666,3174,3247,3730,3387,3776,3946,4458,3454,4 014,4085,4599,4244,4770,5021,5420,10,41,68,149,88,162,196,310,105,184,216,340,244 ,374,386,609,121,207,226,366,270,405,459,628,294,453,431,660,514,696,722,961,137,2 53,287,418,302,448,482,669,346,503,525,700,586,752,774,1018,379,534,600,766,623,8 02,840,1057,656,848,886,1137,906,1173,1236,1567,174,262,324,497,354,519,580,732,3 93,605,540,779,642,815,864,1083,441,594,651,843,678,875,904,1159,714,915,968,1207 ,1013,1259,1307,1675,493,665,706,899,756,937,994,1247,793,999,1055,1286,1090,135 2,1403,1768,854,1076,1148,1371,1167,1406,1473,1844,1227,1494,1549,1905,1602,196 1,2057,2542,235,318,360,591,411,620,632,859,465,647,683,894,718,934,949,1243,509, 688,727,941,770,991,1043,1293,810,1047,1080,1335,1155,1392,1458,1815,550,744,798 ,1010,819,1050,1102,1374,891,1141,1169,1414,1223,1490,1530,1901,946,1198,1252,15 09,1289,1588,1610,1952,1356,1643,1723,2033,1782,2105,2257,2545,570,807,870,1111, 930,1161,1219,1502,964,1230,1265,1563,1310,1606,1674,2008,1036,1296,1339,1637,1 410,1708,1775,2127,1443,1789,1856,2189,1924,2284,2341,2791,1097,1378,1425,1733, 1513,1811,1866,2237,1600,1889,1956,2318,2035,2355,2483,2923,1669,1982,2062,2424 ,2097,2521,2577,3034,2248,2607,2669,3011,2736,3126,3278,3795,280,398,424,675,470 ,693,736,986,476,739,783,1020,828,1085,1116,1451,544,787,831,1125,880,1151,1191,1 454,910,1188,1240,1546,1300,1596,1623,1949,559,868,917,1134,976,1201,1255,1592,1 005,1279,1313,1628,1349,1702,1749,2090,1001,1341,1384,1698,1440,1778,1822,2192, 1520,1873,1926,2281,1980,2338,2436,2886,614,956,979,1272,1032,1328,1382,1679,10 61,1399,1421,1772,1477,1841,1885,2272,1233,1462,1517,1853,1571,1914,1974,2326,1 651,1995,2075,2416,2141,2518,2586,2993,1324,1556,1633,1945,1694,2027,2082,2486, 1762,2115,2163,2539,2260,2634,2695,3093,1860,2254,2289,2672,2329,2740,2651,3163 ,2455,2872,2926,3309,2948,3473,3565,3908,637,1025,1039,1436,1205,1487,1527,1870, 1276,1542,1575,1933,1647,2001,2069,2494,1317,1641,1692,2005,1732,2084,2148,2554 ,1794,2171,2233,2619,2321,2686,2783,3183,1447,1706,1746,2142,1820,2213,2298,265 7,1930,2301,2346,2777,2456,2727,2905,3317,2023,2398,2509,2877,2559,2945,3000,34 24,2637,3023,3019,3538,3166,3607,3678,4140,1553,1785,1878,2303,1999,2349,2430,2 814,2078,2489,2527,2931,2601,2960,3016,3463,2151,2571,2660,2997,2698,3031,3171, 3613,2811,3205,3261,3700,3367,3818,3894,4381,2275,2675,2767,3179,2900,3188,3345 ,3736,2920,3326,3434,3863,3513,3960,4093,4559,2963,3479,3585,4000,3650,4111,405 0,4630,3782,4206,4274,4814,4414,4914,5049,5398,332,435,487,709,529,791,835,1105, 555,852,883,1123,926,1180,1194,1578,565,922,953,1176,984,1332,1360,1665,1066,136 7,1432,1763,1483,1827,1882,2312,575,971,1028,1345,1071,1428,1466,1805,1108,1498, 1534,1894,1585,1964,2016,2358,1146,1559,1619,1989,1684,2067,2106,2468,1712,2091 ,2174,2565,2184,2613,2681,3286,748,1069,1094,1478,1130,1538,1581,1942,1213,1624, 1655,2047,1721,2123,2166,2500,1269,1661,1742,2099,1801,2181,2201,2589,1848,2205 ,2230,2689,2395,2744,2855,3322,1321,1798,1833,2224,1912,2292,2309,2713,1970,238 9,2445,2808,2533,2891,2937,3440,2042,2477,2562,2940,2645,2988,3101,3518,2763,31 18,3208,3618,3264,3719,3838,4364,762,1120,1182,1614,1261,1658,1728,2135,1304,17 52,1809,2208,1864,2245,2265,2701,1395,1837,1908,2268,1968,2378,2427,2794,2039,2 462,2530,2912,2595,2966,3058,3443,1469,1937,2014,2439,2112,2515,2506,2974,2156, 2574,2610,3039,2721,3104,3146,3629,2240,2648,2753,3133,2797,3233,3269,3742,2869 ,3314,3392,3869,3534,3974,4097,4570,1524,2054,2120,2583,2198,2631,2724,3121,236 9,2757,2828,3250,2842,3281,3354,3812,2404,2831,2863,3340,2977,3381,3498,3954,30 78,3529,3580,4008,3672,4146,4228,4661,2465,3008,3050,3448,3154,3543,3602,4065,3 213,3661,3747,4198,3843,4282,4397,4852,3401,3759,3875,4306,3988,4431,4486,5006, 4071,4531,4619,5091,4736,5218,5378,5901,824,1216,1282,1756,1388,1831,1896,2335, 1417,1918,1987,2387,2050,2450,2551,3062,1505,2020,2133,2497,2180,2625,2598,3090 ,2216,2663,2733,3196,2820,3238,3295,3789,1688,2159,2222,2622,2366,2710,2770,325 5,2384,2823,2852,3303,2894,3364,3415,3920,2407,2880,2956,3410,3073,3493,3571,40 22,3138,3644,3667,4154,3753,4236,4331,4791,1716,2361,2375,2800,2410,2837,2908,3 378,2474,2982,3042,3468,3113,3549,3655,4127,2750,3070,3158,3574,3216,3706,3765, 4214,3373,3770,3880,4315,3994,4422,4475,4992,2845,3230,3336,3711,3406,3857,3934 ,4356,3507,3967,4036,4467,4119,4540,4650,5137,3591,4079,4176,4610,4266,4681,477 9,5253,4372,4826,4902,5342,4965,5524,5571,6216,1738,2418,2448,3053,2707,3098,31 41,3635,2780,3191,3242,3725,3350,3807,3914,4339,2859,3291,3395,3826,3459,3940,4 042,4450,3554,4105,4028,4512,4222,4639,4724,5184,3081,3429,3488,3980,3624,4056, 4168,4579,3695,4184,4258,4692,4323,4747,4864,5323,3849,4290,4389,4802,4494,4926 ,4979,5480,4551,5079,5122,5619,5234,5693,5750,6084,3221,3504,3689,4192,3801,425 2,4298,4758,3900,4406,4439,4887,4522,4940,5107,5547,3926,4503,4590,5064,4713,51 53,5169,5721,4840,5269,5304,5776,5440,5935,6005,6505,4133,4670,4701,5202,4875,5 288,5362,5837,4952,5460,5504,5970,5644,6044,6268,6660,5034,5595,5668,6125,5808, 6170,6320,6752,5867,6374,6438,6866,6579,6995,7168,7433,11,47,81,189,108,205,265, 410,132,250,290,447,326,490,506,794,152,278,303,481,359,539,604,823,390,598,568,8 60,673,908,939,1229,171,338,380,554,401,590,633,872,455,659,685,913,765,974,1003, 1299,498,698,782,993,811,1035,1082,1346,856,1091,1140,1442,1166,1485,1562,1925,2 21,348,428,653,464,679,759,948,515,788,710,1007,839,1054,1114,1377,583,776,850,10 87,882,1127,1162,1468,929,1174,1242,1525,1295,1587,1642,2043,646,866,918,1157,98 3,1204,1271,1572,1026,1275,1343,1618,1389,1697,1747,2139,1104,1369,1457,1710,14 79,1751,1823,2220,1548,1845,1906,2285,1962,2342,2443,2972,314,419,473,771,546,80 6,827,1109,612,844,888,1153,933,1200,1217,1569,666,892,944,1209,998,1266,1330,16 25,1049,1334,1373,1676,1464,1734,1806,2191,723,963,1030,1290,1058,1338,1400,171 4,1144,1449,1482,1760,1544,1843,1888,2279,1212,1515,1576,1861,1621,1948,1972,23 33,1701,2007,2093,2417,2155,2496,2662,2976,747,1040,1122,1411,1192,1472,1541,18 55,1234,1551,1593,1922,1646,1969,2037,2391,1323,1632,1680,2000,1754,2076,2146,2 522,1790,2164,2231,2588,2302,2691,2752,3245,1396,1720,1771,2104,1868,2185,2244, 2642,1960,2267,2336,2726,2420,2764,2904,3390,2034,2365,2449,2839,2487,2950,3013 ,3515,2653,3044,3114,3489,3186,3615,3774,4278,370,522,560,876,619,898,954,1263,6 25,959,1012,1302,1068,1380,1419,1799,717,1017,1073,1431,1131,1461,1508,1803,117 0,1500,1566,1904,1635,1957,1985,2331,735,1118,1179,1438,1251,1519,1580,1953,128 7,1611,1649,1991,1690,2071,2119,2481,1283,1683,1727,2065,1786,2152,2196,2594,18 74,2253,2308,2687,2359,2746,2853,3352,800,1225,1254,1601,1315,1666,1724,2046,13 54,1743,1767,2144,1826,2217,2264,2680,1554,1810,1872,2229,1929,2296,2356,2735,2 015,2376,2464,2830,2534,2943,3021,3466,1662,1913,1997,2325,2061,2411,2472,2910, 2131,2508,2558,2968,2665,3076,3143,3576,2238,2659,2697,3116,2738,3193,3095,3652 ,2874,3338,3397,3809,3422,3972,4061,4378,833,1306,1327,1784,1523,1839,1881,2250, 1607,1897,1934,2313,2012,2385,2461,2918,1656,2003,2058,2388,2101,2475,2543,2987 ,2167,2567,2636,3057,2732,3131,3240,3674,1797,2073,2116,2537,2194,2615,2706,309 9,2311,2709,2755,3232,2878,3178,3371,3820,2408,2812,2936,3341,2990,3417,3477,39 22,3080,3502,3497,4038,3657,4101,4172,4596,1909,2157,2255,2715,2379,2761,2847,3 274,2467,2913,2953,3402,3040,3432,3495,3962,2546,3003,3103,3472,3144,3509,3663, 4107,3267,3696,3757,4190,3865,4302,4366,4821,2683,3123,3220,3668,3366,3680,3841 ,4220,3385,3824,3932,4341,4016,4427,4546,4994,3436,3978,4087,4469,4142,4566,450 9,5051,4264,4656,4720,5221,4854,5315,5432,5756,438,576,639,923,692,1021,1077,140 4,729,1096,1135,1427,1187,1493,1512,1938,741,1184,1221,1489,1258,1670,1703,2031, 1357,1707,1780,2134,1836,2202,2261,2723,753,1246,1311,1687,1366,1773,1816,2178, 1407,1852,1890,2274,1944,2345,2400,2769,1453,1919,1978,2374,2049,2452,2502,2893 ,2080,2484,2573,2998,2585,3055,3128,3786,969,1362,1393,1829,1435,1893,1941,2322, 1533,1988,2019,2431,2088,2517,2564,2928,1597,2028,2113,2493,2173,2579,2603,3026 ,2226,2606,2633,3136,2809,3198,3319,3822,1660,2170,2209,2627,2291,2700,2717,316 4,2353,2805,2861,3266,2964,3357,3408,3938,2429,2902,2995,3411,3086,3461,3587,40 20,3218,3604,3702,4115,3763,4210,4312,4805,988,1422,1497,1976,1590,2022,2098,25 28,1639,2126,2182,2612,2241,2650,2671,3151,1741,2215,2288,2674,2348,2789,2844,3 249,2423,2885,2958,3383,3032,3441,3540,3944,1819,2319,2397,2856,2505,2942,2932, 3447,2549,3010,3049,3520,3169,3593,3637,4125,2643,3091,3206,3620,3254,3728,3768 ,4226,3333,3814,3886,4345,4032,4441,4553,5001,1877,2440,2514,3018,2597,3071,317 3,3609,2781,3211,3288,3746,3302,3780,3853,4294,2819,3293,3327,3836,3452,3882,39 96,4420,3562,4026,4081,4473,4166,4605,4679,5081,2888,3482,3531,3950,3641,4044,4 096,4525,3708,4156,4234,4652,4321,4729,4835,5256,3898,4246,4354,4754,4454,4871, 4918,5406,4533,4962,5041,5472,5156,5589,5737,6185,1063,1537,1615,2128,1730,2206 ,2277,2743,1764,2299,2368,2798,2437,2870,2980,3545,1858,2405,2525,2921,2576,306 7,3036,3573,2618,3108,3184,3691,3279,3734,3797,4270,2056,2555,2624,3063,2778,31 59,3227,3751,2795,3283,3312,3803,3362,3859,3916,4393,2822,3347,3427,3910,3556,3 990,4067,4482,3626,4136,4160,4612,4240,4688,4777,5197,2086,2772,2786,3259,2826, 3298,3376,3877,2896,3457,3525,3966,3598,4048,4150,4583,3201,3551,3646,4075,3713 ,4196,4250,4665,3871,4260,4360,4761,4460,4861,4909,5392,3307,3723,3830,4202,390 4,4333,4408,4795,4010,4433,4497,4899,4575,4972,5071,5515,4091,4538,4627,5031,47 15,5102,5189,5622,4812,5232,5301,5706,5367,5854,5891,6465,2108,2836,2864,3533,3 156,3582,3631,4131,3235,3685,3740,4216,3847,4288,4385,4786,3321,3791,3892,4308, 3956,4412,4501,4890,4054,4561,4488,4945,4674,5059,5145,5559,3567,3928,3984,4446 ,4121,4516,4621,5011,4186,4634,4706,5112,4768,5166,5266,5687,4327,4738,4830,521 0,4928,5329,5381,5814,4984,5457,5501,5939,5604,6001,6055,6349,3717,4004,4180,46 43,4284,4697,4745,5176,4374,4845,4880,5293,4955,5340,5486,5874,4399,4935,5019,5 446,5132,5530,5542,6026,5245,5638,5671,6077,5779,6220,6280,6711,4588,5094,5125, 5574,5280,5653,5725,6132,5353,5795,5831,6248,5959,6312,6509,6843,5418,5915,5980 ,6387,6102,6421,6551,6923,6159,6602,6651,7020,6773,7126,7280,7500,237,530,704,11 00,817,1149,1278,1652,902,1237,1350,1737,1446,1832,1865,2402,978,1318,1385,1812, 1529,1916,2053,2446,1604,2041,1981,2519,2188,2600,2656,3134,1044,1476,1583,1950 ,1629,2024,2110,2540,1758,2162,2212,2609,2351,2720,2766,3237,1849,2236,2382,274 9,2434,2825,2899,3310,2511,2916,2992,3450,3029,3511,3617,4129,1195,1504,1693,21 49,1777,2199,2339,2677,1884,2394,2247,2775,2478,2850,2947,3355,2009,2371,2499,2 907,2561,2969,3024,3486,2639,3045,3148,3569,3228,3654,3732,4276,2137,2531,2621, 3014,2729,3088,3194,3633,2806,3203,3305,3698,3369,3805,3884,4395,2929,3343,3470 ,3834,3500,3890,3992,4492,3600,4024,4103,4568,4178,4636,4752,5285,1415,1672,179 3,2362,1932,2426,2458,2939,2068,2490,2570,3006,2647,3083,3111,3628,2175,2582,26 68,3096,2758,3189,3284,3710,2841,3290,3348,3778,3480,3867,3970,4456,2271,2703,2 815,3223,2858,3296,3388,3839,3001,3455,3506,3902,3594,4018,4077,4564,3106,3553, 3642,4046,3704,4158,4188,4625,3811,4232,4337,4722,4416,4807,4977,5290,2316,2833 ,2961,3404,3075,3491,3589,4034,3139,3605,3665,4123,3738,4182,4272,4695,3271,371 5,3784,4224,3896,4319,4403,4833,3948,4424,4507,4904,4592,5009,5069,5545,3380,38 45,3918,4352,4052,4452,4520,4957,4174,4548,4632,5044,4726,5084,5224,5678,4268,4 663,4756,5158,4798,5264,5326,5785,4969,5356,5423,5763,5492,5871,6008,6434,1558, 1900,1966,2552,2083,2591,2684,3181,2095,2694,2784,3243,2875,3360,3413,3958,2258 ,2792,2881,3431,2979,3475,3542,3964,3037,3536,3622,4099,3721,4170,4204,4623,229 4,2955,3052,3445,3161,3558,3648,4164,3215,3687,3744,4212,3799,4310,4370,4788,32 10,3787,3855,4304,3942,4410,4465,4906,4063,4529,4594,5004,4659,5066,5171,5641,2 414,3124,3168,3676,3262,3766,3851,4280,3315,3878,3912,4401,3998,4490,4544,4996, 3611,3976,4059,4505,4134,4581,4654,5054,4242,4677,4772,5148,4847,5261,5334,5744 ,3761,4113,4218,4616,4300,4717,4782,5226,4387,4819,4873,5282,4982,5387,5449,584 1,4514,4974,5014,5426,5056,5495,5403,5904,5192,5628,5681,6033,5703,6178,6252,65 23,2469,3252,3276,3936,3563,4012,4073,4527,3681,4095,4138,4603,4238,4686,4765,5 237,3749,4230,4296,4690,4349,4784,4856,5299,4429,4883,4950,5370,5046,5437,5539, 5921,3952,4317,4368,4849,4462,4931,5024,5409,4601,5026,5074,5533,5195,5483,5659 ,6041,4710,5130,5250,5632,5307,5699,5753,6136,5389,5772,5769,6232,5908,6288,634 5,6695,4109,4418,4535,5029,4683,5076,5163,5568,4775,5229,5272,5684,5351,5712,57 66,6166,4859,5318,5412,5747,5452,5782,5911,6292,5565,5942,5991,6361,6088,6456,6 514,6871,4999,5429,5521,5918,5656,5925,6066,6391,5675,6051,6144,6487,6208,6560, 6656,6989,5715,6181,6272,6593,6324,6675,6626,7040,6425,6741,6794,7153,6894,7218 ,7296,7490,1717,1993,2121,2630,2223,2801,2889,3394,2282,2924,2984,3425,3068,352 2,3547,4144,2305,3060,3119,3516,3176,3772,3816,4262,3324,3828,3930,4391,4006,44 71,4542,5039,2328,3153,3257,3793,3334,3924,3982,4443,3399,4030,4083,4555,4152,4 641,4704,5086,3464,4117,4200,4672,4286,4763,4809,5208,4325,4793,4885,5312,4897, 5364,5435,6016,2712,3329,3374,4002,3438,4089,4148,4614,3578,4208,4248,4740,4335 ,4828,4878,5242,3670,4256,4362,4800,4437,4894,4916,5337,4499,4921,4947,5443,512 7,5498,5610,6048,3755,4435,4480,4943,4577,5016,5036,5469,4647,5120,5179,5562,52 77,5647,5690,6147,4733,5216,5309,5696,5395,5740,5847,6212,5518,5861,5945,6296,5 994,6378,6469,6854,2741,3418,3527,4194,3659,4254,4343,4842,3727,4376,4448,4923, 4518,4967,4987,5454,3873,4484,4572,4989,4645,5109,5161,5550,4731,5200,5274,5665 ,5345,5718,5805,6151,3986,4608,4699,5174,4816,5258,5248,5728,4866,5320,5359,578 8,5475,5851,5888,6304,4960,5401,5509,5877,5553,5966,5998,6395,5625,6037,6106,64 91,6228,6569,6665,7002,4069,4749,4823,5331,4911,5384,5477,5864,5099,5512,5583,5 984,5598,6012,6073,6451,5135,5586,5616,6062,5731,6099,6197,6555,5824,6224,6264, 6597,6341,6700,6762,7059,5205,5760,5798,6155,5894,6236,6284,6636,5949,6332,6400 ,6736,6473,6800,6883,7182,6114,6408,6496,6816,6583,6906,6941,7272,6641,6971,703 3,7320,7105,7388,7480,7719,2867,3583,3693,4383,3861,4477,4557,5061,3906,4585,46 68,5117,4742,5187,5296,5811,4040,4708,4838,5240,4892,5376,5348,5834,4933,5415,5 489,5932,5577,5973,6023,6430,4292,4868,4938,5373,5097,5466,5527,5987,5114,5580, 5607,6030,5650,6080,6128,6532,5140,5635,5709,6121,5821,6193,6256,6607,5881,6316 ,6337,6705,6404,6768,6832,7139,4329,5089,5104,5556,5143,5592,5662,6095,5213,573 4,5792,6174,5857,6240,6328,6685,5506,5818,5898,6260,5952,6366,6412,6747,6091,64 17,6500,6821,6588,6900,6935,7264,5601,5963,6059,6370,6117,6482,6541,6849,6205,6 564,6617,6929,6680,6977,7052,7345,6276,6646,6721,7027,6789,7072,7132,7405,6860, 7160,7211,7461,7249,7552,7573,7841,4358,5150,5182,5801,5463,5844,5884,6308,5536 ,5928,5977,6383,6069,6447,6528,6838,5613,6019,6110,6460,6162,6546,6621,6917,624 4,6670,6612,6959,6757,7046,7098,7370,5828,6140,6189,6574,6300,6631,6716,7008,63 57,6726,6784,7078,6827,7112,7189,7451,6478,6805,6877,7146,6947,7226,7256,7530,6 983,7312,7336,7595,7396,7630,7654,7792,5956,6201,6353,6731,6443,6778,6810,7119, 6518,6888,6912,7204,6965,7233,7328,7562,6537,6953,7014,7304,7092,7353,7362,7642 ,7175,7414,7442,7667,7510,7733,7762,7936,6690,7065,7085,7379,7196,7424,7470,769 2,7241,7520,7541,7747,7607,7776,7858,7981,7288,7584,7618,7808,7680,7824,7876,80 06,7706,7895,7915,8033,7957,8064,8098,8138,12,53,93,234,128,256,350,537,158,333,3 84,584,429,640,661,1038,185,367,399,629,472,701,795,1072,512,786,740,1119,879,117 7,1220,1579,210,444,499,721,524,777,829,1132,596,863,896,1183,995,1262,1297,1664, 650,911,1024,1285,1059,1342,1397,1722,1113,1408,1470,1838,1501,1891,1983,2406,2 76,458,561,855,607,887,987,1232,671,1031,927,1303,1093,1364,1439,1761,768,1009,1 106,1402,1145,1455,1496,1871,1208,1511,1594,1939,1659,2010,2077,2541,846,1126,1 196,1491,1274,1550,1631,1994,1331,1636,1718,2048,1774,2140,2200,2652,1423,1753, 1854,2158,1883,2204,2290,2742,1963,2314,2386,2816,2451,2879,2991,3530,415,549,6 18,1002,711,1052,1079,1429,803,1099,1152,1486,1214,1545,1565,1990,871,1158,1226, 1555,1291,1627,1704,2055,1359,1709,1757,2118,1863,2186,2270,2711,942,1250,1337, 1654,1370,1713,1787,2161,1475,1846,1887,2214,1959,2310,2363,2807,1560,1927,1998 ,2334,2051,2432,2460,2871,2147,2501,2599,2962,2670,3043,3214,3532,973,1348,1450, 1800,1536,1875,1955,2327,1584,1967,2021,2403,2081,2457,2535,2933,1695,2066,2122 ,2492,2207,2581,2658,3072,2249,2679,2756,3137,2835,3244,3306,3802,1783,2168,222 8,2611,2340,2702,2768,3192,2447,2796,2873,3280,2965,3318,3460,3943,2532,2906,29 96,3393,3033,3505,3568,4064,3204,3601,3671,4039,3743,4167,4328,4836,485,681,730, 1139,812,1164,1238,1622,821,1244,1308,1668,1381,1766,1808,2263,935,1314,1386,18 25,1460,1859,1915,2266,1506,1907,1986,2380,2070,2444,2476,2868,958,1444,1516,18 34,1603,1931,2002,2441,1650,2040,2085,2482,2132,2575,2629,3028,1645,2125,2176,2 566,2246,2667,2716,3145,2347,2779,2840,3241,2898,3299,3407,3905,1045,1574,1612, 2029,1686,2107,2172,2547,1731,2197,2225,2655,2293,2739,2793,3231,1975,2273,2344 ,2754,2409,2829,2895,3289,2510,2917,3009,3384,3084,3501,3577,4017,2100,2393,248 8,2860,2563,2957,3017,3467,2644,3056,3107,3523,3217,3634,3699,4126,2762,3212,32 51,3673,3292,3748,3651,4203,3428,3893,3949,4363,3973,4524,4611,4939,1086,1673,1 700,2242,1935,2307,2357,2776,2036,2373,2419,2849,2507,2927,3007,3474,2092,2498, 2560,2930,2608,3022,3092,3544,2682,3117,3187,3614,3285,3688,3796,4225,2259,2578 ,2626,3087,2714,3165,3258,3656,2843,3260,3308,3788,3435,3735,3925,4373,2951,336 8,3492,3895,3546,3968,4029,4474,3636,4053,4047,4589,4209,4653,4727,5157,2390,26 73,2782,3268,2922,3316,3403,3829,3012,3469,3510,3955,3597,3985,4045,4513,3094,3 561,3660,4023,3701,4058,4215,4660,3823,4249,4311,4746,4419,4860,4925,5380,3234, 3679,3777,4221,3919,4231,4396,4776,3939,4379,4485,4900,4567,4986,5106,5548,3987 ,4530,4637,5028,4696,5126,5070,5605,4822,5217,5279,5764,5411,5850,5954,6239,573, 758,838,1202,903,1320,1391,1792,950,1413,1465,1821,1531,1899,1920,2422,965,1521, 1570,1895,1617,2111,2150,2529,1735,2154,2239,2646,2304,2722,2788,3277,980,1598, 1677,2129,1744,2232,2280,2696,1796,2324,2367,2802,2428,2882,2944,3323,1850,2399 ,2470,2914,2550,2999,3048,3449,2584,3030,3122,3555,3135,3612,3684,4340,1256,174 0,1779,2297,1830,2370,2425,2857,1947,2479,2513,2978,2596,3064,3115,3483,2025,25 26,2623,3041,2690,3130,3152,3584,2751,3157,3185,3692,3365,3754,3872,4377,2096,2 688,2731,3177,2821,3253,3270,3720,2892,3358,3416,3821,3521,3911,3959,4491,2975, 3458,3552,3963,3643,4011,4139,4573,3773,4155,4255,4667,4316,4766,4872,5363,1280 ,1817,1903,2463,2013,2516,2605,3077,2074,2635,2699,3162,2765,3202,3222,3707,219 3,2737,2818,3226,2887,3344,3400,3804,2967,3439,3514,3935,3588,3993,4088,4496,22 83,2854,2941,3412,3054,3499,3490,3999,3100,3566,3606,4068,3726,4145,4189,4678,3 195,3647,3762,4173,3810,4283,4322,4781,3887,4369,4442,4905,4584,5000,5113,5557, 2354,2989,3061,3575,3147,3627,3729,4161,3335,3769,3844,4301,3856,4334,4407,4851 ,3372,3848,3881,4390,4003,4436,4547,4981,4112,4578,4631,5033,4721,5167,5239,563 4,3444,4033,4080,4502,4191,4595,4648,5085,4261,4709,4790,5212,4881,5289,5394,57 96,4453,4803,4913,5314,5015,5428,5476,5931,5093,5519,5596,5990,5705,6094,6223,6 606,1375,1951,2044,2638,2179,2725,2804,3297,2221,2832,2909,3353,2983,3426,3537, 4094,2330,2949,3074,3478,3127,3623,3592,4124,3170,3664,3741,4243,3835,4289,4351 ,4827,2556,3105,3175,3621,3332,3716,3781,4307,3351,3837,3868,4357,3917,4413,447 0,4953,3377,3901,3979,4464,4106,4541,4617,5042,4177,4691,4716,5172,4796,5249,53 36,5743,2590,3328,3342,3815,3382,3854,3929,4430,3451,4009,4074,4519,4149,4600,4 703,5144,3756,4102,4197,4626,4265,4751,4808,5225,4425,4817,4919,5319,5020,5421, 5467,5919,3862,4277,4384,4757,4459,4891,4966,5354,4562,4991,5057,5458,5136,5528 ,5626,6028,4642,5098,5190,5587,5275,5655,5738,6122,5371,5775,5839,6195,5896,632 5,6356,6839,2614,3391,3419,4082,3712,4132,4183,4684,3790,4237,4295,4771,4402,48 46,4944,5346,3876,4346,4447,4865,4508,4973,5062,5447,4606,5121,5048,5502,5235,5 614,5697,6067,4118,4479,4536,5007,4673,5077,5180,5566,4741,5194,5265,5664,5328, 5717,5807,6180,4886,5297,5388,5755,5484,5862,5907,6289,5540,5978,6017,6396,6107 ,6452,6495,6743,4271,4556,4735,5203,4841,5257,5305,5726,4932,5404,5438,5830,551 0,5873,6002,6340,4958,5493,5575,5967,5685,6040,6053,6472,5787,6137,6164,6516,62 58,6634,6684,7039,5149,5646,5676,6079,5819,6149,6211,6561,5885,6274,6305,6659,6 415,6713,6874,7148,5943,6376,6432,6774,6536,6803,6909,7209,6585,6950,6992,7284, 7088,7371,7488,7655,296,691,919,1418,1065,1480,1640,2089,1171,1589,1726,2190,18 42,2300,2337,2946,1268,1691,1770,2276,1943,2396,2553,2994,2032,2538,2473,3069,2 705,3150,3207,3690,1353,1879,2006,2435,2059,2523,2620,3089,2211,2676,2734,3160, 2890,3273,3320,3794,2317,2759,2925,3304,2981,3379,3456,3864,3059,3471,3548,4001 ,3586,4060,4169,4682,1540,1911,2136,2661,2235,2719,2876,3229,2360,2938,2773,333 0,3025,3405,3503,3909,2504,2911,3046,3462,3110,3526,3581,4037,3190,3603,3703,41 20,3785,4207,4287,4832,2649,3079,3172,3572,3282,3645,3752,4187,3361,3760,3860,4 251,3921,4359,4438,4956,3485,3897,4019,4388,4051,4444,4545,5053,4153,4576,4657, 5129,4732,5198,5311,5825,1804,2114,2256,2903,2415,2973,3002,3494,2572,3038,3120 ,3564,3200,3640,3669,4181,2693,3132,3219,3653,3311,3745,3840,4263,3396,3846,390 3,4332,4031,4421,4523,5017,2799,3256,3370,3779,3414,3852,3941,4394,3557,4007,40 55,4455,4147,4571,4629,5124,3662,4104,4195,4598,4257,4712,4743,5186,4365,4789,4 896,5283,4975,5366,5534,5827,2851,3389,3517,3957,3632,4041,4141,4587,3697,4159, 4217,4676,4291,4737,4831,5254,3827,4269,4338,4780,4449,4877,4964,5391,4500,4983 ,5068,5461,5152,5563,5623,6056,3933,4400,4472,4910,4604,5012,5082,5513,4728,511 0,5191,5599,5286,5637,5767,6171,4824,5223,5317,5708,5357,5804,5859,6263,5525,58 87,5946,6245,6007,6338,6455,6815,1979,2377,2454,3102,2587,3142,3239,3737,2602,3 246,3339,3798,3433,3913,3965,4511,2785,3346,3437,3981,3535,4025,4090,4517,3595, 4086,4175,4651,4275,4723,4760,5183,2824,3512,3608,3995,3718,4110,4201,4718,3771 ,4241,4297,4767,4353,4869,4930,5349,3764,4342,4409,4863,4495,4970,5025,5464,461 5,5090,5155,5560,5220,5620,5720,6139,2959,3682,3724,4229,3819,4320,4405,4837,38 70,4432,4466,4961,4550,5050,5105,5551,4163,4528,4609,5065,4687,5141,5214,5608,4 799,5238,5332,5700,5407,5802,5868,6230,4314,4666,4774,5178,4858,5276,5339,5770, 4948,5377,5431,5822,5537,5913,5969,6311,5073,5531,5569,5948,5611,6010,5929,6367 ,5739,6127,6173,6479,6192,6599,6663,6886,3015,3806,3831,4489,4116,4565,4624,508 7,4235,4646,4693,5164,4794,5246,5325,5778,4303,4785,4855,5251,4908,5343,5414,58 36,4990,5441,5508,5899,5602,5961,6049,6382,4506,4874,4927,5408,5023,5487,5578,5 934,5160,5581,5629,6043,5741,5999,6156,6485,5271,5682,5793,6131,5842,6190,6235, 6563,5916,6254,6251,6644,6369,6692,6739,7026,4662,4978,5096,5584,5243,5631,5714 ,6076,5335,5773,5810,6177,5882,6202,6249,6591,5417,5853,5937,6233,5972,6261,637 3,6696,6074,6399,6442,6754,6522,6830,6878,7166,5554,5951,6035,6380,6152,6386,65 06,6777,6168,6492,6571,6858,6627,6918,6997,7263,6204,6603,6677,6942,6720,7009,6 972,7300,6807,7066,7106,7392,7185,7439,7501,7646,2165,2485,2632,3180,2745,3356, 3446,3947,2813,3481,3541,3977,3625,4072,4098,4698,2838,3616,3675,4066,3733,4326 ,4371,4818,3879,4382,4483,4949,4560,5032,5101,5593,2862,3709,3813,4348,3889,447 8,4534,5003,3951,4582,4635,5116,4707,5201,5263,5640,4015,4671,4755,5231,4844,53 22,5368,5752,4882,5350,5444,5848,5455,5893,5957,6462,3265,3885,3927,4552,3989,4 640,4702,5175,4130,4762,4804,5300,4895,5386,5434,5784,4223,4813,4922,5360,4998, 5451,5473,5870,5058,5478,5505,5964,5679,6014,6112,6489,4309,4995,5040,5499,5138 ,5572,5590,5986,5209,5673,5729,6071,5816,6143,6183,6575,5294,5761,5845,6186,592 3,6226,6318,6630,6031,6331,6402,6699,6445,6766,6842,7157,3294,3971,4076,4748,42 11,4810,4903,5400,4281,4936,5008,5481,5078,5522,5543,5975,4426,5045,5133,5546,5 206,5661,5711,6058,5291,5746,5813,6161,5876,6207,6283,6577,4539,5168,5260,5723, 5374,5799,5790,6214,5424,5856,5890,6267,5993,6321,6354,6707,5516,5926,6022,6343 ,6061,6422,6449,6781,6124,6483,6540,6862,6642,6926,7000,7269,4620,5308,5383,586 5,5470,5910,5996,6334,5652,6025,6089,6435,6101,6458,6512,6826,5688,6092,6119,65 02,6217,6533,6616,6914,6299,6638,6673,6946,6735,7030,7079,7316,5749,6242,6277,6 581,6360,6648,6688,6980,6406,6728,6785,7061,6846,7110,7176,7410,6547,6792,6865, 7124,6934,7194,7224,7482,6984,7248,7294,7519,7354,7574,7638,7822,3423,4135,4245 ,4941,4415,5037,5118,5617,4461,5146,5228,5670,5303,5735,5833,6286,4593,5268,539 7,5781,5450,5905,5879,6309,5490,5940,6004,6393,6082,6426,6468,6812,4850,5427,54 96,5902,5649,5983,6038,6439,5667,6085,6109,6475,6146,6520,6557,6893,5691,6134,6 199,6553,6295,6613,6667,6955,6347,6717,6732,7035,6788,7083,7138,7381,4888,5643, 5658,6064,5694,6097,6158,6530,5758,6221,6270,6595,6327,6652,6724,7018,6020,6293 ,6363,6669,6409,6758,6796,7070,6526,6799,6869,7129,6938,7190,7219,7475,6104,641 9,6499,6761,6550,6855,6902,7152,6623,6922,6963,7214,7013,7253,7310,7539,6681,69 88,7048,7290,7101,7326,7375,7588,7162,7398,7434,7624,7463,7694,7711,7914,4917,5 702,5732,6279,5981,6315,6350,6710,6046,6389,6428,6770,6510,6823,6890,7143,6116, 6466,6543,6835,6589,6905,6967,7205,6655,7005,6958,7238,7075,7305,7348,7559,6302 ,6567,6609,6930,6703,6975,7043,7274,6750,7053,7096,7332,7134,7359,7416,7616,685 0,7115,7171,7386,7229,7445,7469,7677,7259,7514,7533,7728,7580,7754,7773,7878,64 13,6620,6746,7057,6819,7093,7120,7365,6881,7180,7199,7427,7244,7452,7526,7702,6 897,7234,7279,7507,7342,7546,7553,7764,7404,7594,7609,7782,7662,7833,7854,7987, 7022,7321,7337,7567,7421,7602,7632,7802,7457,7670,7686,7844,7737,7866,7928,8021 ,7494,7720,7745,7889,7793,7902,7942,8040,7812,7955,7971,8061,8003,8084,8111,814 5,315,749,1016,1608,1189,1682,1923,2412,1325,1867,2017,2520,2143,2641,2685,3363, 1434,1971,2063,2617,2252,2771,2935,3421,2350,2919,2846,3496,3097,3590,3649,4157 ,1526,2183,2320,2810,2383,2901,3004,3519,2544,3066,3125,3599,3301,3714,3767,427 3,2664,3155,3337,3750,3398,3825,3907,4350,3487,3923,4005,4498,4049,4563,4675,51 54,1748,2218,2466,3051,2569,3112,3287,3666,2708,3349,3182,3775,3453,3858,3961,4 398,2884,3325,3476,3915,3539,3983,4043,4537,3630,4062,4179,4622,4267,4711,4787, 5295,3035,3508,3610,4035,3731,4114,4227,4689,3808,4233,4344,4753,4417,4862,4929 ,5405,3945,4386,4521,4879,4554,4934,5027,5494,4655,5055,5131,5564,5199,5624,572 7,6213,2103,2438,2593,3313,2790,3386,3430,3953,2954,3465,3550,4027,3638,4108,41 37,4685,3082,3559,3658,4122,3758,4219,4324,4764,3850,4330,4392,4834,4532,4912,5 005,5462,3209,3694,3817,4259,3866,4336,4434,4884,4013,4510,4558,4946,4649,5052, 5108,5558,4128,4607,4694,5075,4759,5181,5211,5615,4867,5252,5352,5701,5422,5780 ,5938,6215,3263,3833,3975,4451,4092,4543,4644,5067,4165,4658,4719,5151,4792,520 7,5287,5674,4313,4773,4839,5244,4937,5333,5413,5806,4985,5433,5507,5869,5582,59 65,6021,6431,4428,4893,4959,5365,5083,5456,5520,5920,5196,5544,5618,5997,5704,6 032,6154,6539,5284,5648,5733,6098,5771,6194,6246,6628,5930,6271,6329,6610,6385, 6697,6802,7108,2287,2728,2827,3528,2970,3570,3677,4213,2986,3686,3783,4279,3883 ,4404,4463,4997,3197,3792,3891,4481,3991,4526,4597,5002,4057,4586,4680,5128,477 8,5193,5227,5612,3236,3969,4070,4493,4193,4613,4700,5188,4253,4744,4797,5233,48 53,5327,5382,5765,4247,4843,4901,5321,4980,5419,5468,5875,5092,5529,5588,5962,5 642,6015,6111,6511,3375,4151,4199,4730,4299,4820,4898,5298,4361,4924,4954,5410, 5030,5491,5541,5955,4664,5010,5088,5503,5159,5576,5639,6006,5262,5660,5748,6090 ,5817,6188,6253,6594,4815,5139,5241,5606,5316,5695,5757,6160,5396,5791,5840,620 9,5941,6298,6351,6671,5514,5936,5971,6330,6009,6390,6313,6722,6129,6501,6544,68 24,6562,6925,6978,7165,3442,4285,4318,4976,4618,5047,5100,5526,4739,5119,5165,5 594,5259,5669,5745,6167,4806,5247,5313,5672,5361,5759,5826,6225,5436,5849,5914, 6282,6003,6342,6427,6737,4993,5330,5379,5820,5465,5895,5979,6317,5591,5982,6024 ,6420,6133,6379,6525,6831,5692,6075,6182,6503,6227,6558,6601,6895,6301,6619,661 5,6964,6725,7003,7045,7283,5134,5425,5532,5988,5663,6029,6105,6453,5751,6163,61 96,6548,6269,6570,6614,6919,5829,6238,6319,6598,6352,6624,6729,7006,6448,6751,6 791,7056,6859,7122,7158,7395,5958,6335,6411,6733,6521,6740,6845,7074,6535,6834, 6901,7144,6951,7192,7257,7476,6572,6928,6993,7215,7028,7267,7237,7502,7100,7314 ,7346,7575,7411,7613,7659,7775,2495,2865,3020,3619,3140,3800,3899,4440,3224,393 1,3997,4476,4084,4574,4602,5170,3248,4078,4143,4569,4205,4825,4870,5281,4367,48 76,4971,5399,5043,5474,5538,5995,3275,4185,4293,4848,4380,4963,5018,5448,4445,5 063,5111,5552,5177,5627,5683,6036,4515,5147,5219,5657,5302,5736,5786,6145,5338, 5768,5855,6234,5866,6281,6339,6809,3705,4375,4423,5035,4487,5115,5173,5603,4633 ,5230,5267,5716,5347,5800,5846,6175,4725,5278,5375,5777,5442,5860,5883,6257,550 0,5886,5912,6346,6072,6394,6486,6833,4811,5439,5482,5906,5570,5974,5989,6368,56 36,6068,6118,6446,6206,6515,6552,6904,5713,6153,6231,6554,6306,6590,6678,6954,6 410,6689,6755,7011,6795,7068,7128,7387,3739,4468,4580,5215,4714,5270,5358,5812, 4783,5390,5453,5892,5517,5927,5947,6358,4920,5488,5567,5950,5630,6054,6103,6433 ,5707,6138,6200,6534,6262,6576,6645,6908,5022,5600,5680,6113,5789,6187,6179,658 0,5832,6243,6275,6632,6372,6682,6712,7017,5922,6310,6401,6701,6437,6772,6798,70 77,6497,6828,6873,7147,6961,7200,7260,7479,5095,5724,5797,6250,5878,6294,6375,6 693,6047,6405,6463,6783,6474,6806,6852,7117,6081,6467,6493,6841,6584,6870,6939, 7188,6661,6957,6990,7217,7042,7287,7325,7515,6141,6605,6639,6911,6714,6968,6999 ,7245,6759,7036,7082,7311,7133,7350,7402,7589,6880,7089,7151,7363,7207,7419,744 1,7649,7250,7462,7497,7674,7547,7717,7769,7906,3874,4638,4750,5393,4907,5479,55 55,6013,4951,5579,5651,6063,5722,6126,6219,6649,5072,5689,5809,6169,5858,6290,6 265,6668,5897,6323,6384,6748,6457,6776,6817,7103,5310,5838,5903,6287,6045,6364, 6416,6787,6060,6459,6481,6820,6519,6856,6891,7173,6083,6507,6566,6887,6657,6936 ,6981,7222,6704,7024,7038,7291,7086,7330,7374,7565,5344,6039,6052,6441,6087,647 1,6529,6867,6148,6587,6635,6921,6686,6970,7032,7276,6397,6653,6718,6986,6763,70 60,7091,7318,6863,7097,7155,7366,7210,7415,7437,7644,6477,6769,6837,7063,6884,7 140,7181,7383,6948,7195,7230,7432,7271,7466,7511,7690,6996,7252,7299,7493,7343, 7524,7561,7729,7391,7579,7608,7758,7634,7807,7819,7977,5369,6096,6120,6640,6362 ,6674,6708,7021,6423,6744,6780,7071,6848,7114,7169,7378,6488,6813,6876,7125,691 5,7184,7232,7428,6974,7265,7225,7454,7323,7505,7543,7707,6664,6898,6932,7202,70 15,7240,7295,7484,7054,7302,7339,7528,7369,7551,7593,7752,7136,7355,7400,7570,7 446,7619,7639,7795,7472,7669,7685,7834,7723,7853,7869,7949,6765,6944,7050,7307, 7111,7334,7358,7556,7163,7407,7423,7604,7458,7623,7679,7814,7177,7449,7487,7664 ,7537,7696,7700,7861,7585,7735,7746,7875,7783,7916,7931,8031,7278,7521,7534,771 2,7599,7740,7765,7891,7628,7788,7800,7923,7840,7940,7988,8057,7653,7827,7847,79 59,7883,7967,7997,8072,7899,8009,8019,8088,8044,8105,8126,8152,1813,2748,3167,3 937,3409,4021,4239,4801,3579,4171,4355,4915,4504,5038,5080,5686,3722,4305,4411, 5013,4628,5142,5306,5730,4734,5292,5222,5803,5459,5880,5933,6344,3842,4549,4705 ,5185,4769,5273,5372,5823,4942,5430,5485,5889,5633,5992,6034,6424,5060,5511,566 6,6018,5719,6086,6150,6480,5794,6165,6229,6582,6259,6625,6698,7019,4100,4591,48 57,5416,4968,5471,5621,5953,5103,5677,5523,6042,5762,6108,6191,6513,5255,5654,5 783,6157,5843,6210,6255,6608,5917,6273,6355,6666,6418,6723,6775,7107,5402,5815, 5900,6247,6000,6307,6392,6709,6070,6398,6476,6753,6524,6822,6872,7174,6176,6504 ,6596,6840,6618,6875,6937,7228,6687,6956,7004,7268,7049,7303,7361,7601,4457,482 9,4988,5645,5162,5710,5742,6184,5324,5774,5852,6241,5924,6303,6326,6706,5445,58 63,5944,6314,6027,6388,6461,6760,6100,6464,6508,6804,6604,6861,6924,7208,5549,5 976,6078,6414,6115,6470,6538,6844,6237,6586,6622,6882,6683,6952,6987,7266,6322, 6654,6715,6969,6756,7037,7055,7298,6825,7081,7142,7347,7186,7389,7468,7603,5597 ,6093,6203,6549,6297,6611,6679,6962,6348,6691,6730,7016,6779,7051,7104,7333,645 0,6764,6808,7076,6879,7131,7179,7401,6910,7191,7236,7435,7281,7483,7509,7701,65 31,6847,6892,7150,6973,7206,7243,7459,7047,7258,7301,7498,7349,7516,7576,7749,7 102,7317,7364,7548,7384,7592,7617,7785,7465,7629,7656,7778,7682,7813,7855,7970, 4669,5123,5204,5835,5341,5872,5960,6381,5355,5968,6050,6429,6130,6517,6556,6916 ,5535,6057,6135,6568,6218,6600,6647,6920,6266,6643,6702,7001,6767,7044,7064,729 7,5573,6198,6278,6578,6365,6658,6719,7041,6407,6745,6782,7069,6818,7127,7161,73 80,6403,6811,6853,7123,6907,7183,7213,7436,6979,7247,7282,7481,7315,7508,7554,7 736,5698,6336,6371,6738,6444,6797,6851,7109,6484,6868,6889,7178,6940,7227,7255, 7477,6694,6927,6976,7235,7023,7275,7313,7503,7087,7324,7372,7544,7408,7591,7621 ,7771,6793,7010,7073,7293,7121,7344,7376,7577,7170,7394,7420,7600,7471,7641,766 5,7803,7239,7467,7485,7657,7504,7683,7648,7823,7563,7731,7750,7863,7757,7904,79 24,7991,5754,6436,6454,6903,6662,6949,6985,7246,6742,6998,7025,7286,7084,7329,7 368,7581,6786,7080,7118,7331,7149,7377,7412,7606,7193,7425,7456,7635,7499,7661, 7699,7829,6913,7130,7159,7409,7212,7447,7489,7650,7285,7491,7512,7697,7564,7678 ,7742,7865,7341,7536,7587,7732,7610,7756,7774,7892,7643,7781,7780,7919,7825,793 3,7948,8028,7007,7187,7251,7492,7327,7513,7550,7710,7373,7578,7596,7751,7627,77 60,7779,7901,7413,7614,7651,7772,7666,7784,7826,7934,7709,7835,7850,7952,7879,7 975,7989,8062,7478,7658,7693,7828,7741,7830,7872,7960,7748,7868,7894,7983,7912, 7999,8020,8083,7761,7905,7929,8007,7943,8024,8014,8091,7968,8038,8048,8109,8067 ,8118,8128,8151,4889,5236,5385,5909,5497,6065,6142,6542,5561,6172,6222,6565,629 1,6633,6650,7029,5585,6285,6333,6629,6377,6801,6829,7099,6490,6836,6899,7172,69 45,7216,7254,7496,5609,6359,6440,6814,6498,6896,6931,7201,6545,6960,6991,7261,7 034,7306,7338,7517,6592,7012,7062,7322,7113,7367,7390,7569,7135,7382,7426,7612, 7431,7633,7660,7857,5985,6494,6527,6943,6573,6994,7031,7292,6672,7067,7090,7356 ,7141,7399,7422,7583,6734,7095,7156,7385,7198,7430,7440,7622,7231,7443,7455,766 3,7535,7684,7725,7867,6790,7197,7221,7453,7273,7486,7495,7673,7309,7532,7557,77 08,7598,7738,7753,7896,7352,7572,7611,7755,7645,7770,7805,7913,7691,7810,7836,7 935,7851,7956,7978,8059,6011,6559,6637,7058,6727,7094,7145,7406,6771,7164,7203, 7444,7242,7464,7473,7668,6864,7223,7270,7474,7308,7527,7549,7703,7351,7566,7597 ,7744,7625,7763,7791,7897,6933,7289,7335,7555,7393,7590,7586,7766,7417,7615,763 1,7786,7675,7806,7818,7938,7460,7647,7688,7815,7704,7843,7852,7961,7730,7864,78 84,7984,7918,8001,8022,8085,6982,7360,7397,7620,7438,7640,7676,7811,7523,7689,7 715,7848,7721,7856,7874,7974,7538,7716,7727,7871,7767,7882,7909,7998,7798,7917, 7927,8008,7947,8029,8042,8094,7568,7777,7789,7898,7820,7920,7932,8016,7837,7945 ,7962,8037,7979,8049,8065,8113,7886,7964,7985,8052,8004,8069,8075,8125,8017,808 0,8090,8131,8102,8140,8150,8171,6123,6676,6749,7167,6857,7220,7262,7506,6885,72 77,7319,7531,7357,7560,7605,7794,6966,7340,7403,7582,7429,7637,7626,7801,7448,7 652,7681,7832,7713,7845,7860,7969,7116,7418,7450,7636,7522,7672,7695,7849,7529, 7714,7724,7862,7739,7877,7890,7993,7540,7734,7759,7888,7797,7908,7925,8010,7816 ,7941,7946,8030,7963,8043,8055,8107,7137,7518,7525,7705,7542,7718,7743,7881,757 1,7768,7787,7903,7809,7921,7944,8026,7687,7796,7821,7926,7838,7953,7965,8039,78 80,7966,7986,8053,8005,8068,8074,8124,7722,7842,7870,7954,7887,7982,7995,8058,7 911,8000,8012,8073,8025,8081,8093,8134,7930,8018,8034,8089,8047,8096,8106,8142, 8060,8110,8117,8148,8122,8157,8159,8179,7154,7545,7558,7790,7671,7804,7817,7939 ,7698,7831,7846,7958,7873,7973,7992,8056,7726,7859,7885,7976,7900,7996,8013,807 1,7922,8023,8011,8078,8041,8092,8101,8137,7799,7893,7907,8002,7937,8015,8032,80 86,7951,8035,8046,8097,8054,8103,8114,8147,7980,8050,8063,8108,8076,8119,8123,8 155,8082,8130,8133,8161,8141,8164,8166,8176,7839,7910,7950,8036,7972,8045,8051, 8104,7990,8066,8070,8116,8079,8120,8132,8158,7994,8077,8087,8129,8100,8135,8136 ,8165,8112,8143,8146,8167,8153,8172,8174,8184,8027,8095,8099,8139,8115,8144,814 9,8169,8121,8154,8156,8173,8162,8175,8180,8186,8127,8160,8163,8177,8168,8178,81 81,8187,8170,8182,8183,8188,8185,8189,8190,8191];
wobei die Sequenz Z2 gegeben ist durch:
[0,1,2,7,3,8,13,26,4,12,15,30,18,35,37,82,5,14,16,34,21,41,51,87,24,50,45,94,61,103,110 ,177,6,19,23,43,25,49,55,96,31,59,63,104,76,117,123,195,36,65,80,121,85,131,141,208, 93,143,155,235,161,248,271,391,9,20,28,58,32,62,75,112,38,81,67,124,90,135,149,217, 48,78,92,142,98,152,160,243,108,163,180,260,194,278,296,434,57,95,106,159,119,171, 188,274,129,189,207,288,220,313,330,471,146,215,239,318,246,331,356,502,266,363,3 85,528,405,551,593,816,17,27,33,77,42,84,88,147,52,91,99,158,109,170,174,273,60,100 ,111,172,122,187,204,290,134,205,216,307,241,326,350,491,69,115,130,193,136,206,22 3,319,156,237,247,334,265,362,378,525,173,257,275,369,289,399,408,548,315,421,453, 582,477,613,681,817,73,132,151,226,168,244,264,367,178,267,281,390,297,407,432,57 1,202,293,308,418,332,447,473,624,344,480,507,650,535,693,719,942,222,321,338,457, 371,488,511,672,404,521,549,708,583,724,785,1011,431,561,595,756,609,805,833,1072 ,677,848,880,1059,914,1122,1203,1479,22,39,44,97,53,101,113,186,54,114,125,196,138 ,218,228,348,68,126,139,232,153,240,254,349,162,252,272,383,294,403,413,547,71,150 ,164,234,182,258,276,402,192,286,298,415,311,445,463,607,191,309,323,442,343,476,4 93,653,373,515,537,692,558,716,762,992,83,176,184,283,200,304,322,436,210,329,337, 472,357,501,520,688,269,351,372,506,392,533,557,712,424,565,600,752,629,803,837,1 048,302,387,417,544,441,580,603,788,468,618,638,813,682,863,893,1102,509,680,696, 881,713,916,871,1140,771,986,1014,1221,1026,1306,1353,1539,89,197,203,342,259,36 1,376,514,285,381,395,540,423,569,599,791,300,420,440,570,456,605,632,822,481,642, 670,854,710,888,939,1151,347,446,462,630,492,661,699,873,538,700,720,935,774,910, 1002,1226,578,745,799,987,823,1023,1054,1279,864,1066,1063,1341,1143,1376,1417,1 670,386,478,516,703,567,723,760,955,601,789,807,1017,846,1032,1062,1300,633,830,8 75,1051,894,1069,1146,1380,952,1163,1194,1428,1250,1493,1531,1810,689,884,930,11 49,999,1154,1238,1445,1009,1229,1285,1516,1329,1567,1639,1919,1033,1309,1367,15 92,1400,1651,1617,1957,1471,1707,1746,2065,1830,2125,2198,2406,29,47,56,107,64,1 27,140,224,70,144,154,231,167,250,255,396,72,165,175,249,185,305,316,430,211,317,3 41,469,360,495,518,707,74,181,198,310,213,339,353,486,225,366,379,523,398,552,575, 726,238,389,411,564,437,596,615,780,448,608,644,827,649,853,886,1209,116,212,221, 358,233,380,397,543,262,414,425,588,452,621,641,795,282,429,461,612,484,647,656,8 40,505,658,669,890,744,919,976,1228,301,483,498,666,530,697,704,903,556,741,766,9 51,812,995,1019,1288,587,784,826,1021,867,1045,1108,1332,928,1116,1166,1384,1197 ,1439,1500,1799,120,230,251,409,279,426,455,626,295,465,487,660,510,676,684,897,3 28,500,529,686,554,735,759,943,584,776,809,1007,842,1036,1084,1291,354,542,574,76 4,617,802,798,1039,635,832,850,1074,906,1111,1133,1390,673,869,923,1125,946,1180, 1200,1448,983,1224,1262,1519,1338,1575,1643,1925,375,592,620,836,654,860,907,111 9,731,926,962,1189,968,1206,1244,1488,747,964,980,1235,1041,1259,1318,1564,1095, 1335,1364,1595,1414,1676,1721,1977,778,1056,1080,1294,1134,1344,1373,1626,1169, 1407,1453,1704,1505,1752,1819,2087,1268,1460,1524,1768,1584,1841,1872,2182,1631 ,1900,1951,2224,2025,2299,2394,2688,137,263,287,466,324,496,524,715,336,534,562,7 39,590,770,819,1087,368,577,625,793,646,858,844,1101,663,877,913,1160,958,1183,12 15,1474,439,637,665,857,730,901,932,1192,738,959,974,1218,998,1247,1277,1547,749, 990,1029,1274,1092,1315,1356,1600,1127,1397,1411,1679,1456,1727,1782,2051,450,7 28,734,948,751,967,1004,1256,781,1044,1077,1303,1113,1347,1404,1662,920,1090,113 7,1361,1171,1431,1463,1712,1253,1468,1527,1771,1587,1836,1866,2173,971,1177,123 2,1434,1271,1511,1555,1793,1326,1570,1609,1860,1657,1906,1971,2251,1370,1634,16 90,1945,1743,1991,2047,2319,1804,2073,2117,2373,2157,2470,2494,2875,458,755,767, 1081,899,1105,1130,1393,936,1157,1186,1442,1241,1485,1542,1788,978,1212,1265,14 96,1297,1559,1612,1853,1350,1648,1604,1889,1718,1963,2019,2279,1098,1282,1312,1 579,1387,1621,1684,1931,1425,1693,1737,1997,1777,2033,2095,2362,1508,1757,1815, 2059,1877,2133,2165,2443,1914,2215,2243,2524,2308,2567,2601,2797,1174,1323,1422 ,1698,1482,1732,1762,2039,1535,1825,1847,2111,1894,2141,2232,2482,1550,1883,193 7,2207,2011,2260,2269,2583,2081,2330,2350,2617,2420,2710,2750,3042,1665,1985,20 05,2288,2103,2339,2385,2652,2149,2432,2455,2730,2539,2773,2904,3134,2190,2509,2 552,2822,2633,2846,2933,3187,2671,2967,3002,3252,3083,3328,3433,3584,10,40,66,14 5,86,157,190,299,102,179,209,327,236,359,370,576,118,201,219,352,261,388,438,594,2 84,433,412,623,489,655,678,889,133,245,277,400,291,428,460,631,333,479,499,659,55 5,705,725,938,364,508,568,718,589,750,783,972,619,790,824,1040,841,1070,1123,1392 ,169,253,312,474,340,494,550,687,377,573,513,729,606,761,804,994,422,563,614,786,6 39,814,839,1058,671,849,895,1099,934,1142,1182,1477,470,627,664,835,709,868,918,1 132,742,922,970,1164,1000,1219,1260,1549,796,988,1049,1234,1065,1263,1317,1607,1 115,1334,1378,1653,1420,1695,1766,2107,227,306,346,560,394,586,597,800,444,611,6 43,831,675,866,879,1129,485,648,683,872,721,915,960,1170,757,963,991,1205,1055,12 51,1305,1585,522,698,746,931,765,966,1010,1237,828,1043,1067,1269,1112,1331,1363 ,1650,876,1091,1136,1346,1167,1409,1426,1688,1222,1452,1514,1748,1560,1801,1910, 2109,541,754,810,1018,862,1060,1109,1340,892,1118,1147,1389,1184,1423,1476,1730, 954,1173,1208,1447,1266,1503,1554,1817,1293,1565,1616,1862,1667,1929,1969,2271, 1006,1240,1278,1522,1349,1582,1624,1896,1418,1641,1691,1953,1750,1979,2067,2355 ,1472,1711,1770,2027,1795,2093,2131,2424,1904,2151,2192,2410,2236,2480,2570,285 6,270,382,406,636,449,652,691,911,454,694,733,940,773,996,1022,1299,517,736,775,1 030,818,1052,1085,1302,845,1083,1126,1375,1176,1415,1436,1686,531,808,851,1037,9 02,1094,1139,1412,927,1159,1187,1440,1216,1498,1534,1790,924,1210,1245,1495,129 0,1557,1590,1864,1355,1629,1669,1927,1709,1967,2035,2332,581,885,905,1153,950,11 99,1243,1480,975,1257,1275,1552,1320,1605,1638,1921,1120,1308,1352,1614,1395,16 60,1705,1959,1458,1720,1779,2021,1827,2091,2137,2399,1196,1383,1444,1683,1492,1 744,1784,2069,1544,1808,1843,2105,1912,2169,2209,2460,1619,1908,1933,2194,1961, 2238,2180,2502,2048,2323,2357,2588,2371,2682,2733,2914,602,944,956,1287,1097,13 28,1360,1627,1156,1372,1398,1674,1455,1725,1775,2075,1190,1450,1490,1728,1521,1 786,1832,2115,1569,1849,1893,2159,1955,2203,2266,2514,1296,1501,1532,1828,1589, 1879,1939,2184,1672,1941,1973,2262,2049,2230,2344,2593,1741,2009,2085,2326,2119 ,2369,2403,2654,2171,2417,2415,2718,2504,2756,2794,3031,1381,1562,1633,1943,172 3,1975,2031,2286,1781,2071,2097,2360,2147,2378,2413,2676,1834,2127,2186,2401,22 11,2422,2507,2759,2284,2527,2560,2806,2622,2868,2907,3150,1923,2196,2256,2512,2 341,2517,2609,2825,2353,2598,2660,2891,2704,2940,3006,3234,2380,2685,2744,2960, 2779,3016,2985,3266,2849,3064,3098,3347,3166,3389,3444,3576,320,416,464,667,503, 740,779,1013,527,794,821,1028,859,1076,1088,1401,536,855,882,1073,909,1202,1225, 1469,979,1231,1284,1545,1325,1594,1636,1949,545,898,947,1213,984,1281,1311,1577, 1015,1337,1366,1645,1406,1697,1736,1981,1047,1386,1433,1716,1484,1773,1802,2057 ,1506,1791,1851,2123,1858,2155,2200,2575,702,982,1003,1321,1034,1369,1403,1681,1 104,1437,1461,1759,1513,1814,1845,2079,1150,1466,1529,1797,1574,1856,1870,2139, 1610,1873,1891,2205,2007,2241,2312,2596,1193,1572,1599,1887,1658,1935,1947,2221 ,1702,2003,2041,2282,2101,2335,2364,2663,1755,2063,2121,2366,2176,2396,2465,270 7,2253,2475,2529,2762,2562,2816,2878,3142,714,1025,1078,1429,1144,1464,1518,182 3,1179,1537,1580,1875,1622,1902,1916,2213,1254,1602,1655,1918,1700,1995,2029,22 73,1753,2053,2099,2348,2143,2382,2439,2665,1314,1677,1734,2037,1806,2089,2083,2 387,1838,2129,2153,2427,2226,2467,2492,2768,1898,2178,2247,2484,2275,2544,2565, 2828,2321,2591,2636,2894,2716,2947,3009,3239,1358,1764,1812,2135,1868,2167,2228 ,2477,1989,2249,2295,2554,2304,2572,2614,2865,2013,2297,2317,2606,2389,2630,269 6,2937,2451,2713,2741,2964,2791,3034,3075,3280,2055,2408,2434,2668,2497,2721,27 53,2992,2532,2785,2831,3060,2881,3102,3158,3363,2641,2837,2897,3114,2954,3174,3 200,3427,2995,3221,3261,3461,3313,3510,3569,3740,769,1106,1161,1540,1248,1597,1 646,1965,1272,1663,1714,2001,1761,2045,2113,2441,1343,1739,1821,2077,1855,2163, 2145,2458,1881,2188,2234,2522,2290,2547,2580,2853,1487,1840,1885,2161,1987,2219 ,2258,2557,1999,2292,2310,2585,2337,2620,2649,2920,2015,2328,2376,2646,2448,269 3,2736,2971,2487,2776,2788,3038,2834,3079,3126,3337,1509,1983,1993,2277,2017,23 01,2346,2628,2061,2392,2429,2679,2472,2724,2782,3024,2245,2446,2499,2738,2534,2 809,2840,3068,2625,2843,2900,3118,2957,3170,3195,3421,2306,2542,2604,2812,2644, 2888,2927,3138,2701,2944,2978,3191,3020,3225,3275,3479,2747,2999,3049,3257,3094 ,3289,3332,3523,3146,3352,3384,3556,3410,3620,3636,3827,1526,2023,2043,2436,221 7,2463,2489,2771,2264,2519,2549,2819,2612,2862,2917,3130,2315,2578,2638,2872,26 74,2930,2981,3183,2727,3013,2974,3212,3072,3270,3308,3497,2453,2657,2690,2950,2 765,2988,3045,3243,2803,3053,3090,3294,3122,3318,3368,3549,2884,3106,3154,3342, 3204,3394,3416,3605,3230,3456,3473,3652,3516,3676,3694,3792,2537,2699,2800,3057 ,2859,3087,3110,3323,2910,3162,3178,3378,3217,3400,3467,3628,2923,3208,3248,345 0,3303,3485,3491,3685,3358,3529,3542,3702,3591,3750,3770,3896,3027,3284,3298,35 04,3373,3536,3563,3721,3405,3598,3613,3760,3660,3781,3840,3929,3438,3644,3668,3 803,3712,3815,3853,3947,3730,3866,3881,3968,3912,3990,4016,4049,11,46,79,183,105 ,199,256,393,128,242,280,427,314,467,482,743,148,268,292,459,345,512,572,768,374,5 66,539,801,634,843,870,1117,166,325,365,526,384,559,598,811,435,622,645,847,717,9 00,925,1175,475,657,732,917,758,953,993,1214,797,1001,1042,1292,1064,1327,1388,1 668,214,335,410,616,443,640,711,878,490,737,668,929,782,969,1020,1239,553,727,792 ,997,820,1031,1061,1313,861,1071,1128,1359,1172,1408,1451,1756,610,806,852,1057, 908,1096,1152,1396,945,1155,1211,1432,1249,1494,1533,1826,1012,1233,1304,1504,1 322,1536,1591,1884,1377,1608,1654,1930,1696,1970,2040,2386,303,401,451,722,519,7 53,772,1016,579,787,825,1053,865,1093,1107,1394,628,829,874,1100,921,1148,1201,1 438,965,1204,1236,1478,1310,1523,1578,1863,679,891,949,1168,973,1207,1258,1507,1 046,1298,1324,1543,1374,1606,1640,1926,1103,1351,1399,1620,1435,1685,1703,1964, 1497,1729,1792,2022,1837,2076,2187,2388,701,957,1027,1267,1086,1316,1371,1615,1 121,1379,1413,1666,1454,1701,1751,2004,1195,1443,1481,1724,1538,1780,1831,2094, 1566,1844,1892,2138,1942,2206,2246,2551,1255,1512,1551,1800,1625,1859,1901,2174 ,1694,1917,1966,2229,2024,2254,2343,2635,1749,1986,2044,2302,2070,2372,2411,270 5,2181,2430,2473,2691,2516,2760,2845,3100,355,497,532,815,585,834,883,1145,591,8 87,933,1178,981,1242,1273,1573,674,937,985,1283,1035,1307,1345,1576,1068,1339,13 91,1652,1446,1692,1713,1962,690,1024,1075,1289,1135,1354,1402,1689,1165,1427,14 57,1717,1489,1776,1811,2066,1162,1483,1517,1772,1563,1835,1867,2142,1630,1907,1 946,2204,1982,2242,2311,2613,748,1114,1138,1419,1188,1470,1515,1758,1220,1530,1 548,1829,1593,1882,1915,2199,1382,1581,1628,1890,1671,1938,1980,2235,1735,1994, 2054,2296,2102,2368,2416,2678,1467,1659,1722,1958,1769,2018,2060,2347,1820,2084 ,2118,2383,2189,2450,2490,2739,1897,2185,2210,2474,2237,2520,2461,2780,2324,260 5,2639,2863,2653,2946,2990,3149,777,1181,1198,1561,1357,1603,1635,1905,1424,164 7,1675,1950,1733,2000,2052,2352,1462,1726,1767,2002,1798,2062,2108,2395,1846,21 24,2170,2438,2233,2483,2548,2792,1571,1778,1809,2104,1865,2156,2216,2464,1948,2 218,2248,2543,2327,2511,2624,2869,2016,2285,2363,2607,2397,2650,2684,2921,2452, 2698,2695,2979,2783,3011,3047,3251,1656,1839,1909,2222,1996,2252,2307,2568,2056 ,2349,2374,2642,2428,2659,2694,2941,2110,2405,2466,2681,2491,2702,2786,3014,256 4,2804,2836,3056,2892,3112,3143,3350,2201,2478,2536,2789,2621,2795,2880,3071,26 32,2871,2926,3131,2968,3172,3228,3422,2661,2949,3003,3192,3032,3237,3211,3445,3 093,3278,3306,3511,3364,3546,3588,3696,419,546,604,856,651,941,989,1261,685,1005 ,1038,1280,1082,1333,1348,1678,695,1079,1110,1330,1141,1473,1499,1747,1223,1502, 1558,1822,1601,1871,1913,2227,706,1131,1185,1486,1230,1553,1586,1854,1264,1613, 1642,1922,1682,1972,2010,2257,1301,1664,1708,1992,1760,2046,2080,2336,1783,2068 ,2128,2402,2136,2437,2481,2851,896,1227,1252,1596,1286,1644,1680,1956,1365,1715, 1738,2032,1789,2090,2122,2358,1416,1745,1807,2074,1850,2132,2148,2419,1888,2150 ,2168,2486,2283,2523,2594,2870,1465,1848,1876,2164,1934,2212,2223,2503,1978,228 0,2316,2563,2381,2616,2645,2929,2030,2342,2400,2647,2456,2675,2745,2970,2535,27 54,2807,3018,2839,3066,3117,3343,912,1276,1336,1706,1410,1740,1796,2098,1449,18 16,1857,2154,1899,2179,2193,2495,1528,1880,1932,2195,1974,2270,2305,2553,2026,2 331,2377,2631,2423,2664,2719,2932,1588,1954,2008,2313,2082,2367,2361,2667,2112, 2409,2433,2708,2506,2748,2772,3023,2175,2459,2528,2763,2556,2821,2842,3074,2602 ,2866,2903,3133,2976,3179,3231,3425,1632,2038,2088,2414,2144,2447,2508,2757,226 5,2531,2576,2830,2584,2848,2886,3108,2289,2579,2599,2877,2670,2901,2958,3169,27 31,2973,3000,3194,3044,3255,3288,3457,2333,2687,2714,2935,2774,2982,3008,3218,2 810,3039,3078,3276,3121,3310,3356,3524,2909,3084,3137,3321,3185,3371,3391,3579, 3222,3409,3441,3602,3486,3642,3690,3819,977,1368,1430,1818,1520,1874,1924,2240, 1546,1940,1988,2276,2036,2322,2391,2722,1618,2014,2096,2354,2130,2444,2425,2737 ,2158,2469,2515,2801,2571,2824,2857,3096,1765,2116,2162,2442,2263,2500,2540,283 3,2274,2573,2590,2860,2619,2889,2918,3156,2291,2610,2656,2915,2728,2955,2993,31 98,2766,3029,3041,3258,3081,3292,3331,3502,1787,2259,2268,2559,2294,2582,2627,2 898,2338,2673,2711,2943,2751,2984,3036,3245,2525,2725,2777,2997,2813,3059,3086, 3282,2895,3091,3140,3324,3188,3367,3387,3574,2587,2818,2874,3062,2912,3127,3163 ,3339,2965,3175,3205,3383,3241,3413,3453,3617,3005,3224,3265,3437,3304,3465,349 9,3653,3346,3515,3541,3680,3565,3726,3737,3887,1803,2300,2318,2715,2498,2742,27 69,3026,2545,2798,2827,3069,2883,3105,3152,3335,2595,2854,2906,3115,2938,3165,3 207,3379,2987,3235,3201,3402,3286,3448,3482,3632,2734,2924,2952,3181,3021,3214, 3262,3429,3054,3268,3300,3469,3327,3490,3528,3674,3124,3314,3354,3507,3395,3551 ,3570,3714,3418,3597,3612,3751,3647,3769,3784,3860,2815,2962,3051,3272,3103,329 6,3317,3494,3147,3360,3375,3538,3406,3555,3607,3732,3159,3398,3432,3593,3477,36 22,3626,3776,3520,3658,3669,3790,3703,3828,3843,3939,3247,3462,3474,3637,3533,3 663,3686,3805,3560,3708,3719,3835,3757,3851,3897,3964,3583,3744,3763,3869,3797, 3877,3906,3978,3812,3917,3927,3994,3951,4010,4031,4056,229,504,662,1008,763,105 0,1158,1459,838,1124,1217,1525,1295,1598,1623,2012,904,1191,1246,1583,1362,1661, 1763,2042,1421,1754,1710,2092,1861,2146,2183,2485,961,1319,1405,1687,1441,1742, 1805,2106,1541,1842,1878,2152,1976,2225,2255,2546,1611,1895,1998,2244,2034,2293 ,2340,2589,2086,2351,2398,2669,2421,2703,2761,3025,1089,1342,1491,1833,1556,186 9,1968,2197,1637,2006,1903,2261,2064,2309,2370,2615,1731,1990,2078,2345,2120,23 84,2418,2689,2172,2431,2493,2735,2541,2781,2823,3099,1824,2100,2160,2412,2231,2 457,2521,2770,2281,2526,2586,2805,2623,2861,2902,3157,2359,2608,2680,2876,2697, 2905,2956,3203,2752,2972,3012,3238,3050,3269,3320,3535,1270,1475,1568,1984,1673 ,2028,2050,2365,1774,2072,2126,2407,2177,2454,2471,2767,1852,2134,2191,2462,225 0,2518,2574,2811,2303,2577,2611,2847,2686,2893,2945,3186,1920,2214,2287,2538,23 14,2581,2634,2879,2404,2672,2700,2911,2749,2969,2998,3236,2468,2726,2775,2983,2 808,3040,3055,3264,2864,3077,3129,3307,3167,3344,3415,3537,1952,2298,2379,2643, 2449,2692,2746,2977,2488,2755,2787,3022,2826,3052,3097,3295,2566,2814,2850,3073 ,2908,3120,3161,3355,2934,3171,3210,3385,3249,3428,3452,3627,2629,2882,2919,313 6,2986,3184,3216,3407,3048,3229,3267,3442,3309,3458,3512,3671,3095,3281,3322,34 87,3340,3527,3550,3705,3412,3561,3585,3698,3609,3731,3771,3880,1385,1649,1699,2 114,1785,2140,2202,2513,1794,2208,2267,2550,2325,2618,2648,2939,1911,2272,2329, 2658,2390,2683,2720,2942,2426,2717,2764,3010,2817,3046,3063,3263,1936,2375,2435 ,2666,2501,2729,2778,3043,2533,2799,2829,3067,2858,3116,3145,3336,2530,2852,288 7,3113,2931,3164,3190,3386,2991,3220,3250,3426,3279,3451,3492,3659,2020,2479,25 05,2793,2561,2841,2885,3101,2592,2899,2916,3160,2959,3202,3227,3423,2758,2948,2 989,3209,3028,3244,3277,3446,3082,3287,3329,3483,3361,3526,3553,3692,2838,3017, 3070,3260,3111,3305,3333,3513,3153,3349,3372,3534,3417,3572,3594,3722,3213,3414 ,3430,3586,3447,3610,3578,3741,3500,3655,3672,3778,3679,3817,3836,3900,2058,255 5,2569,2928,2732,2966,2996,3219,2796,3007,3030,3254,3080,3291,3326,3517,2832,30 76,3109,3293,3135,3334,3365,3540,3173,3376,3404,3566,3443,3590,3625,3746,2936,3 119,3144,3362,3189,3396,3434,3580,3253,3435,3454,3623,3501,3606,3665,3780,3302, 3476,3522,3656,3543,3678,3695,3806,3573,3701,3700,3831,3742,3845,3859,3936,3015 ,3168,3223,3436,3290,3455,3489,3635,3330,3514,3530,3673,3559,3682,3699,3814,336 6,3547,3581,3693,3595,3704,3743,3846,3634,3752,3766,3863,3793,3885,3898,3969,34 24,3587,3619,3745,3664,3747,3787,3870,3670,3783,3808,3892,3825,3908,3928,3989,3 683,3818,3841,3915,3854,3932,3922,3997,3878,3945,3955,4014,3973,4023,4033,4055, 1510,1719,1813,2166,1886,2278,2334,2637,1928,2356,2393,2655,2445,2709,2723,3033 ,1944,2440,2476,2706,2510,2844,2867,3092,2597,2873,2925,3155,2963,3193,3226,344 0,1960,2496,2558,2855,2603,2922,2951,3180,2640,2975,3001,3232,3037,3271,3299,34 59,2677,3019,3061,3285,3104,3325,3345,3506,3123,3338,3377,3545,3382,3564,3589,3 773,2220,2600,2626,2961,2662,3004,3035,3259,2740,3065,3085,3315,3128,3353,3374, 3519,2790,3089,3141,3341,3177,3381,3390,3554,3206,3392,3403,3592,3475,3611,3649 ,3782,2835,3176,3197,3401,3242,3431,3439,3601,3274,3472,3495,3633,3532,3661,367 5,3809,3312,3509,3544,3677,3575,3691,3724,3826,3618,3728,3753,3847,3767,3867,38 88,3966,2239,2651,2712,3058,2784,3088,3132,3359,2820,3148,3182,3393,3215,3411,3 419,3596,2896,3199,3240,3420,3273,3468,3488,3629,3311,3503,3531,3667,3557,3684, 3711,3810,2953,3256,3297,3493,3348,3525,3521,3687,3369,3548,3562,3706,3603,3725 ,3736,3849,3408,3577,3615,3733,3630,3759,3768,3871,3654,3779,3798,3893,3830,391 0,3930,3991,2994,3319,3351,3552,3388,3571,3604,3729,3464,3616,3640,3764,3645,37 72,3789,3884,3478,3641,3651,3786,3688,3796,3822,3907,3717,3829,3839,3916,3858,3 937,3949,4000,3505,3697,3709,3811,3738,3832,3844,3924,3754,3856,3872,3944,3889, 3956,3971,4018,3800,3874,3894,3959,3913,3975,3981,4030,3925,3986,3996,4036,4007 ,4044,4054,4075,2320,2743,2802,3151,2890,3196,3233,3449,2913,3246,3283,3471,331 6,3498,3539,3713,2980,3301,3357,3518,3380,3568,3558,3720,3397,3582,3608,3749,36 38,3761,3775,3879,3107,3370,3399,3567,3463,3600,3621,3765,3470,3639,3648,3777,3 662,3791,3804,3902,3480,3657,3681,3802,3716,3821,3837,3918,3734,3852,3857,3938, 3873,3950,3962,4012,3125,3460,3466,3631,3481,3643,3666,3795,3508,3689,3707,3816 ,3727,3833,3855,3934,3614,3715,3739,3838,3755,3864,3875,3946,3794,3876,3895,396 0,3914,3974,3980,4029,3646,3758,3785,3865,3801,3891,3904,3965,3824,3909,3920,39 79,3933,3987,3999,4039,3842,3926,3941,3995,3954,4002,4011,4046,3967,4015,4022,4 052,4027,4061,4063,4083,3139,3484,3496,3710,3599,3723,3735,3850,3624,3748,3762, 3868,3788,3883,3901,3963,3650,3774,3799,3886,3813,3905,3921,3977,3834,3931,3919 ,3984,3948,3998,4006,4042,3718,3807,3820,3911,3848,3923,3940,3992,3862,3942,395 3,4003,3961,4008,4019,4051,3890,3957,3970,4013,3982,4024,4028,4059,3988,4035,40 38,4065,4045,4068,4070,4080,3756,3823,3861,3943,3882,3952,3958,4009,3899,3972,3 976,4021,3985,4025,4037,4062,3903,3983,3993,4034,4005,4040,4041,4069,4017,4047, 4050,4071,4057,4076,4078,4088,3935,4001,4004,4043,4020,4048,4053,4073,4026,4058 ,4060,4077,4066,4079,4084,4090,4032,4064,4067,4081,4072,4082,4085,4091,4074,408 6,4087,4092,4089,4093,4094,4095];
wobei die Sequenz Z3 gegeben ist durch:
[0,1,2,7,3,8,12,25,4,11,14,29,17,34,36,79,5,13,15,33,20,40,49,84,23,48,44,91,59,100,106 ,170,6,18,22,42,24,47,53,93,30,57,61,101,74,113,119,187,35,63,77,117,82,126,136,199, 90,138,149,224,155,236,257,366,9,19,27,56,31,60,73,108,37,78,65,120,87,130,143,207, 46,76,89,137,95,146,154,231,104,157,173,247,186,264,280,404,55,92,102,153,115,164, 180,260,124,181,198,273,210,296,311,436,141,205,228,300,234,312,334,463,253,341,3 60,485,378,505,540,721,16,26,32,75,41,81,85,142,50,88,96,152,105,163,167,259,58,97, 107,165,118,179,195,275,129,196,206,290,230,307,329,453,67,111,125,185,131,197,21 3,301,150,226,235,315,252,340,354,483,166,244,261,346,274,373,381,502,297,392,420, 531,441,557,613,722,71,127,145,216,161,232,251,344,171,254,266,365,281,380,402,52 2,193,277,291,390,313,415,438,566,324,444,467,588,491,623,644,818,212,303,318,424, 348,451,471,606,377,479,503,635,532,648,697,870,401,513,542,674,554,713,735,914,6 10,746,771,905,797,950,1007,1188,21,38,43,94,51,98,109,178,52,110,121,188,133,208, 218,327,66,122,134,221,147,229,242,328,156,240,258,359,278,376,385,501,69,144,158, 223,175,245,262,375,184,271,282,387,294,413,429,552,183,292,305,411,323,440,455,5 90,350,474,493,622,511,642,679,856,80,169,176,268,191,287,304,405,201,310,317,437, 335,462,478,619,255,330,349,466,367,489,510,638,395,517,546,671,570,711,738,897,2 86,362,389,499,410,529,549,699,433,561,578,719,614,758,781,936,469,612,625,772,63 9,799,764,963,686,851,872,1019,881,1077,1108,1225,86,189,194,322,246,339,352,473, 270,357,369,495,394,520,545,702,284,391,409,521,423,550,573,726,445,581,604,751,6 37,777,816,971,326,414,428,571,454,597,628,766,494,629,645,813,688,794,863,1023,5 28,665,708,852,727,879,901,1059,759,910,908,1100,965,1123,1149,1303,361,442,475,6 31,518,647,677,828,547,700,714,874,745,885,907,1073,574,732,767,899,782,912,967,1 125,826,979,1001,1156,1039,1197,1220,1381,620,774,809,969,861,973,1031,1167,868, 1025,1063,1211,1092,1242,1285,1439,886,1079,1117,1257,1138,1292,1272,1458,1183, 1324,1346,1513,1392,1543,1579,1673,28,45,54,103,62,123,135,214,68,139,148,220,160 ,238,243,370,70,159,168,237,177,288,298,400,202,299,321,434,338,457,477,634,72,174 ,190,293,204,319,332,449,215,343,355,481,372,506,525,650,227,364,383,516,406,543,5 59,693,416,553,583,730,587,750,776,1011,112,203,211,336,222,356,371,498,249,386,3 96,536,419,564,580,705,267,399,427,556,447,585,593,740,465,594,603,779,664,801,84 4,1024,285,446,459,601,487,626,632,789,509,662,682,825,718,858,876,1065,535,696,7 29,877,761,895,940,1094,808,946,981,1128,1003,1163,1201,1375,116,219,239,382,265, 397,422,568,279,431,450,596,470,609,616,784,309,461,486,617,507,657,676,819,533,6 90,716,867,742,888,923,1067,333,497,524,680,560,710,707,890,575,734,748,916,791,9 42,958,1132,607,763,804,952,821,991,1005,1169,849,1021,1047,1213,1098,1247,1287, 1442,351,539,563,737,591,756,792,948,654,806,833,997,838,1009,1035,1194,667,835,8 47,1029,892,1045,1085,1240,931,1096,1115,1259,1147,1306,1332,1468,691,903,920,10 69,959,1102,1121,1277,983,1143,1172,1322,1204, 1349, 1386, 1524, 1051,1176,1216,135 8,1252,1398,1414,1571,1280,1429,1455,1591,1492,1626,1668,1784,132,250,272,432,30 6,458,482,641,316,490,514,660,538,685,724,925,345,527,567,703,584,754,743,935,598, 769,796,977,830,993,1015,1185,408,577,600,753,653,787,811,999,659,831,842,1017,86 0,1037,1057,1230,668,854,883,1055,929,1083,1110,1262,954,1136,1145,1308,1174,133 5,1366,1506,418,651,656,823,670,837,865,1043,694,894,918,1075,944,1104,1141,1298, 802,927,961,1113,985,1158,1178,1327,1041,1181,1218,1360,1254,1395,1411,1567,840, 989,1027,1160,1053,1208,1235,1372,1090,1244,1267,1408,1295,1432,1465,1604,1119, 1282,1314,1452,1344,1475,1503,1635,1378,1517,1539,1659,1559,1700,1710,1847,425, 673,683,921,786,938,956,1134,814,975,995,1165,1033,1192,1227,1369,845,1013,1049, 1199,1071,1237,1269,1404,1106,1290,1264,1423,1330,1461,1489,1617,933,1061,1081, 1249,1130,1274,1311,1445,1154,1316,1341,1478,1363,1496,1528,1654,1206,1352,1384 ,1510,1417,1547,1563,1689,1436,1587,1600,1722,1630,1739,1752,1822,987,1088,1152, 1319,1190,1338,1355,1499,1223,1389,1401,1536,1426,1551,1595,1705,1232,1420,1448 ,1583,1485,1608,1612,1745,1521,1640,1649,1758,1679,1792,1806,1896,1300,1472,148 2,1621,1532,1644,1664,1771,1555,1684,1694,1799,1728,1814,1856,1920,1575,1716,17 33,1830,1764,1838,1865,1933,1778,1875,1885,1948,1907,1964,1984,2008,10,39,64,140 ,83,151,182,283,99,172,200,308,225,337,347,526,114,192,209,331,248,363,407,541,269 ,403,384,565,452,592,611,778,128,233,263,374,276,398,426,572,314,443,460,595,508,6 33,649,815,342,468,519,643,537,669,695,841,562,701,728,891,741,913,951,1133,162,2 41,295,439,320,456,504,618,353,523,472,652,551,678,712,857,393,515,558,698,579,72 0,739,904,605,747,783,934,812,964,992,1187,435,569,599,736,636,762,800,957,663,80 3,839,980,862,1018,1046,1231,706,853,898,1028,909,1048,1084,1266,945,1095,1124,1 293,1151,1317,1357,1534,217,289,325,512,368,534,544,709,412,555,582,733,608,760,7 70,955,448,586,615,765,646,798,832,984,675,834,855,1008,902,1040,1076,1253,480,62 7,666,810,681,836,869,1030,731,893,911,1052,943,1093,1114,1291,768,928,960,1103,9 82,1144,1155,1313,1020,1171,1210,1347,1238,1376,1434,1535,496,672,717,875,757,90 6,941,1099,780,947,968,1131,994,1153,1186,1337,827,986,1010,1168,1050,1203,1234, 1385,1068,1241,1271,1409,1301,1444,1464,1613,866,1032,1058,1215,1105,1251,1276, 1427,1150,1286,1315,1456,1348,1469,1514,1651,1184,1326,1359,1493,1373,1527,1546 ,1681,1431,1556,1576,1675,1597,1704,1740,1841,256,358,379,576,417,589,621,795,42 1,624,655,817,687,859,878,1072,476,658,689,884,723,900,924,1074,744,922,953,1122, 988,1148,1161,1312,488,715,749,889,788,930,962,1146,807,976,996,1164,1016,1200,1 222,1370,805,1012,1036,1198,1066,1236,1256,1410,1109,1279,1302,1443,1325,1463,1 497,1641,530,775,790,972,824,1004,1034,1189,843,1044,1056,1233,1086,1265,1284,14 40,949,1078,1107,1270,1135,1297,1323,1459,1175,1331,1364,1490,1390,1526,1549,16 70,1002,1127,1166,1310,1196,1345,1367,1515,1228,1380,1399,1533,1435,1565,1584,1 696,1273,1433,1446,1577,1460,1598,1570,1713,1504,1637,1652,1747,1658,1782,1800, 1859,548,820,829,1064,932,1091,1112,1278,974,1120,1137,1305,1173,1334,1362,1518, 998,1170,1195,1336,1214,1368,1393,1538,1243,1402,1425,1560,1457,1581,1611,1718, 1070,1202,1221,1391,1255,1418,1449,1572,1304,1450,1466,1609,1505,1594,1646,1749 ,1343,1484,1523,1638,1540,1657,1672,1772,1566, 1678, 1677, 1795, 1714, 1808, 1821,189 3,1126,1239,1281,1451,1333,1467,1495,1620,1365,1516,1529,1653,1554,1661,1676,17 80,1394,1544,1573,1671,1585,1680,1715,1809,1619,1723,1736,1825,1760,1845,1857,1 924,1441,1578,1606,1717,1645,1719,1755,1831,1650,1751,1774,1852,1790,1867,1886, 1944,1662,1783,1804,1873,1816,1889,1880,1951,1839,1902,1911,1968,1928,1976,1986 ,2007,302,388,430,602,464,661,692,871,484,704,725,882,755,917,926,1139,492,752,77 3,915,793,1006,1022,1182,846,1026,1062,1229,1089,1258,1283,1454,500,785,822,1014 ,850,1060,1080,1248,873,1097,1116,1288,1142,1318,1340,1470,896,1129,1159,1329,11 91,1361,1377,1509,1205,1371,1403,1542,1407,1558,1580,1742,630,848,864,1087,887,1 118,1140,1309,937,1162,1177,1353,1209,1383,1400,1520,970,1180,1219,1374,1246,14 06,1413,1550,1268,1415,1424,1582,1483,1599,1632,1750,1000,1245,1261,1422,1296,1 447,1453,1590,1321,1481,1500,1618,1531,1642,1655,1775,1351,1512,1541,1656,1568, 1669,1698,1791,1605,1702,1724,1810,1737,1828,1848,1922,640,880,919,1157,966,117 9,1212,1388,990,1224,1250,1416,1275,1430,1437,1586,1042,1263,1294,1438,1320,147 7,1494,1614,1350,1507,1530,1648,1552,1663,1687,1776,1082,1307,1339,1498,1379,15 25,1522,1665,1396,1545,1557,1682,1592,1699,1709,1812,1428,1569,1602,1706,1615,1 730,1738,1832,1636,1748,1765,1853,1794,1869,1887,1945,1111,1356,1382,1548,1412, 1564,1593,1703,1474,1603,1624,1734,1628,1741,1757,1844,1486,1625,1634,1754,1666 ,1763,1787,1866,1692,1793,1803,1874,1820,1894, 1905, 1954, 1508, 1674,1685,1777,171 1,1796,1807,1882,1725,1818,1833,1901,1849,1912,1926,1971,1767,1835,1854,1915,18 71,1930,1936,1983,1883,1941,1950,1989,1961,1997,2006,2027,684,939,978,1226,1038, 1260,1289,1462,1054,1299,1328,1480,1354,1502,1537,1688,1101,1342,1387,1519,1405 ,1562,1553,1695,1419,1574,1596,1721,1622,1731,1744,1840,1193,1397,1421,1561,147 3,1589,1607,1735,1479,1623,1631,1746,1643,1759,1770,1861,1487,1639,1660,1769,16 91,1786,1801,1876,1707,1815,1819,1895,1834,1906,1918,1966,1207,1471,1476,1616,1 488,1627,1647,1762,1511,1667,1683,1781,1701,1797,1817,1891,1601,1690,1712,1802, 1726,1826,1836,1903,1761,1837,1855,1916,1872,1929,1935,1982,1629,1729,1753,1827 ,1768,1851,1863,1921,1789,1868,1878,1934,1890, 1942, 1953, 1992, 1805, 1884, 1898, 194 9,1910,1956,1965,1999,1923,1969,1975,2004,1980,2013,2015,2035,1217,1491,1501,16 86,1588,1697,1708,1813,1610,1720,1732,1829,1756,1843,1860,1919,1633,1743,1766,1 846,1779,1864,1879,1932,1798,1888,1877,1939,1904,1952,1960,1995,1693,1773,1785, 1870,1811,1881,1897,1946,1824,1899,1909,1957,1917,1962,1972,2003,1850,1913,1925 ,1967,1937,1977,1981,2011,1943,1988,1991,2017,1998,2020,2022,2032,1727,1788,182 3,1900,1842,1908,1914,1963,1858,1927,1931,1974,1940,1978,1990,2014,1862,1938,19 47,1987,1959,1993,1994,2021,1970,2000,2002,2023,2009,2028,2030,2040,1892,1955,1 958,1996,1973,2001,2005,2025,1979,2010,2012,2029,2018,2031,2036,2042,1985,2016, 2019,2033,2024,2034,2037,2043,2026,2038,2039,2044,2041,2045,2046,2047];
wobei jede der Sequenznummern von N polarisierten Kanälen in der zweiten Sequenz einer Zuverlässigkeitsrangfolge der Sequenznummer in der ganzen Sequenz entspricht, und ein Minimumwert der Sequenznummern der polarisierten Kanäle 0 ist.

2. Polar-Polar-Code-Codierungseinrichtung (300), umfassend:
eine Erhalteneinheit (601), die konfiguriert ist, um eine erste Sequenz zu erhalten, die verwendet wird, um K zu codierende Bits zu codieren, wobei die erste Sequenz Sequenznummern von N polarisierten Kanälen umfasst, wobei die Sequenznummern der N polarisierten Kanäle in der ersten Sequenz basierend auf der Zuverlässigkeit der N polarisierten Kanäle angeordnet sind, wobei K eine positive ganze Zahl ist, N eine Muttercodelänge eines Polar-Codes ist, N = 2ⁿ, n eine positive ganze Zahl ist und K ≤ N;
eine Auswahleinheit (602), die konfiguriert ist, um Sequenznummern von K polarisierten Kanälen aus der ersten Sequenz in absteigender Reihenfolge der Zuverlässigkeit auszuwählen; und
eine Codierungseinheit (603), die konfiguriert ist, zum: Platzieren der zu codierenden Bits basierend auf den ausgewählten Sequenznummern der K polarisierten Kanäle, und eine Polar-Code-Codierung an den zu codierenden Bits durchzuführen;
wobei die erste Sequenz eine gesamte zweite Sequenz ist, die zweite Sequenz Sequenznummern von Nₘₐₓ polarisierten Kanälen umfasst, wobei die Sequenznummern der Nₘₐₓ polarisierten Kanäle in der zweiten Sequenz basierend auf der Zuverlässigkeit der Nₘₐₓ polarisierten Kanäle angeordnet sind, Nₘₐₓ eine positive ganze Zahl ist, Nₘₐₓ ≥ N, und ein Sortieren der Sequenznummern der polarisierten Kanäle in der ersten Sequenz mit einer Sortierung von Sequenznummern von polarisierten Kanälen, die kleiner als N in der zweiten Sequenz sind, übereinstimmend ist;
**dadurch gekennzeichnet, dass**
die zweite Sequenz ein Teil oder die gesamte Sequenz Q1, eine Sequenz Q2 oder eine Sequenz Q3 ist;
wobei die Sequenz Q1 gegeben ist durch:
[0,1,2,4,8,16,32,3,5,64,1024,2048,4096,9,6,17,10,18,128,12,33,65,20,256,34,24,36,7,129 ,66,512,11,40,68,130,19,13,48,14,72,257,1025,21,132,35,258,26,2049,513,80,37,25,22,4 097,136,260,264,38,514,96,67,41,144,28,69,42,516,49,1026,74,272,160,520,288,528,19 2,544,70,44,131,81,2050,50,73,15,320,133,52,1028,23,134,384,76,4098,137,82,56,27,97 ,39,259,84,138,145,261,1032,29,43,2052,98,515,88,140,30,146,71,262,265,161,576,45,1 040,100,640,51,148,46,75,4100,266,273,517,2056,104,162,53,193,1056,152,77,164,768, 268,274,518,54,83,57,521,1027,112,135,2064,78,289,194,85,276,4104,522,58,168,1029, 139,99,86,60,280,89,290,529,2080,524,196,1088,141,101,147,176,142,530,321,31,200,1 033,4112,90,545,292,2051,322,532,263,149,102,105,1030,304,296,163,92,47,267,385,5 46,2053,324,1041,208,386,4128,150,153,165,106,55,1034,328,536,577,548,2112,113,15 4,79,269,1042,108,578,224,166,519,552,195,4099,1152,270,3072,641,523,275,580,291, 59,1036,169,560,114,277,156,2057,87,197,1057,116,170,4101,61,531,525,642,281,1089 ,278,526,2054,177,293,388,91,1044,584,769,198,172,120,4160,201,2065,336,1280,62,2 82,143,103,178,294,1058,93,644,2058,202,592,323,1048,392,5120,297,770,107,180,151 ,1060,2066,209,284,648,94,204,298,1031,400,608,352,2176,6144,325,533,1153,155,210 ,305,547,300,1090,109,2060,184,534,537,115,167,1536,4105,225,326,306,772,2081,157 ,1035,656,329,110,117,212,1064,171,2113,776,4102,330,226,549,1092,538,387,308,216 ,2068,1154,416,271,279,158,337,1043,4113,550,672,2304,118,332,579,1037,540,389,17 3,121,1072,2082,553,199,784,4106,179,1038,228,338,312,2072,704,390,1096,174,554,5 81,393,1281,4114,283,2084,122,448,353,1045,561,203,63,340,2055,1156,394,527,582,4 224,556,181,1059,2177,295,285,232,124,1282,205,182,643,2114,4108,562,1050,286,58 5,299,1537,354,211,2560,401,185,1104,396,344,4129,586,645,2059,1061,593,535,240,2 06,1049,95,2088,327,564,4161,1046,800,402,356,307,2116,1160,301,417,213,568,1284, 832,4116,2178,588,186,1288,646,404,227,896,2067,1062,594,418,4352,302,1538,649,7 71,2061,360,539,1120,111,331,214,1091,2096,4130,309,188,449,1065,217,408,2062,60 9,596,1168,551,650,4120,229,1052,2120,159,420,310,1093,541,773,2305,610,4132,106 6,657,333,119,1540,3073,600,339,218,1073,368,652,4103,230,2069,1098,391,313,450,1 296,542,2180,334,233,4225,1184,555,774,175,2083,1544,123,658,612,1312,2306,4162, 341,777,220,1552,314,424,2074,395,1216,673,583,4608,355,1568,2561,287,183,234,10 94,125,557,2128,4107,660,1068,616,342,316,2085,1155,241,778,1105,563,4136,345,20 73,452,1074,397,403,207,2070,1097,674,4164,558,1039,785,432,2184,357,1344,187,23 6,664,4226,2308,1157,624,587,1076,780,2312,705,126,1047,4115,242,565,1158,2086,3 98,346,456,1408,358,2562,4109,405,1100,303,569,244,2144,1161,595,189,4144,1106,5 66,2115,676,361,1080,706,589,2089,1051,4110,215,786,647,1121,2192,348,419,1063,4 06,4168,464,2076,680,1283,801,362,1108,2117,590,4353,409,1162,570,2090,788,597,1 169,572,219,5121,2564,1285,311,708,1053,598,2097,601,1067,4117,651,421,3074,792, 1122,802,611,1539,2122,4228,602,410,1112,231,688,2320,1164,653,248,4131,1054,220 8,369,190,364,1170,654,2568,4354,659,1095,335,480,2336,1286,315,221,1289,4122,25 76,370,613,1185,422,425,2240,1600,6145,451,614,1069,2592,543,235,1124,412,4609,2 118,343,372,1664,775,317,2092,1075,222,4176,426,1172,2179,453,237,1070,559,2129, 4133,833,1099,804,712,2098,1290,834,661,4121,1297,2121,808,779,1541,617,1128,206 3,4118,604,433,1186,720,2368,816,1077,4232,836,347,2181,1217,897,243,1176,2100,4 356,662,454,1101,318,3076,675,1188,618,4360,898,2071,1792,781,376,2182,1292,4134 ,428,1298,665,2432,736,1542,567,840,4610,2124,1078,625,238,1107,2185,359,4192,45 7,1081,399,2130,787,1545,591,1136,4163,2104,678,434,1159,2075,677,349,4137,1102, 245,2145,458,1313,666,1218,4240,2087,620,363,1109,2307,127,191,4124,1300,782,213 2,1546,407,436,1082,4165,2186,626,571,1192,2193,465,1163,681,4138,246,2309,1123, 707,350,3080,4612,1110,599,1084,668,2077,790,1304,4145,460,2091,249,1113,682,131 4,2146,5122,573,411,1553,2563,803,789,1548,4170,709,2136,1220,365,440,2188,1165, 4368,628,1125,689,2078,374,1171,4256,423,2194,466,1200,793,2119,1166,4616,250,37 1,1554,2310,481,1345,574,4384,2313,413,1055,603,2209,1224,4624,366,468,1114,2624 ,655,1569,900,4288,2093,805,1316,615,3088,1346,4640,684,710,2148,1556,429,1287,4 166,2688,794,252,1173,373,2099,1126,4140,605,848,2196,1129,690,1328,4227,2094,71 3,1320,632,2123,482,4177,1187,806,2314,1116,427,904,6146,2321,1071,414,1291,2565 ,223,663,4146,1409,2152,692,1570,835,2210,4169,1348,619,472,2101,1232,455,4111,1 410,2241,796,809,1174,3104,4416,714,1177,721,2200,1189,837,4229,716,2125,1130,86 4,1079,2212,4148,810,1352,606,2816,912,5124,1560,722,2316,1601,696,1572,4119,232 2,377,435,1137,2566,817,4230,1178,319,2102,1103,621,1293,4480,2131,812,484,1132, 2105,430,4172,1602,838,2569,1248,667,4233,3075,488,1190,239,2160,1543,4178,378,1 576,2183,459,1219,622,4152,2126,627,1294,437,2337,4123,1665,380,2242,1547,818,12 99,4193,2133,461,496,1604,2324,4135,669,1315,2570,679,1083,724,4355,2106,1193,84 1,629,2216,4180,1584,351,1138,3077,467,1301,4234,2187,438,1180,737,2147,4241,111 1,251,1221,2134,462,4357,442,2108,1140,441,1194,2328,5128,469,1085,2137,247,1555 ,4125,683,2338,1549,842,1666,4139,2577,738,899,2572,1305,6148,670,1302,2244,783, 1550,3136,4194,849,1201,820,2189,1317,4611,728,2149,1412,928,1115,4184,2195,791, 367,2224,1608,4236,901,1793,2190,630,1222,4126,2578,685,1196,844,2369,4242,1144, 633,2079,1225,711,4167,1360,2248,253,1086,3081,4358,691,1306,824,2138,1167,4361, 902,2593,1127,686,740,4257,2340,1202,850,2370,1318,4672,375,2580,1117,444,1668,4 141,2311,470,1226,2197,483,5136,1616,415,2150,1347,485,4196,2153,1416,905,3078,1 321,4736,795,1794,2352,473,4147,1131,2344,634,1204,2211,4244,744,1175,852,2140,1 233,4142,960,2095,1308,865,2315,4171,1672,693,2433,1118,4362,797,1228,2594,906,1 322,4369,2372,715,1424,3089,807,4613,1632,474,2256,1376,6152,636,2434,1349,694,2 198,4200,1557,254,2201,1179,717,4258,2213,1234,575,1329,4149,2154,913,1571,2103, 798,4289,1324,3082,811,1133,5152,2376,379,1208,2584,697,4248,1558,431,2625,607,4 173,489,2596,1561,866,2161,4260,1139,723,2202,1191,4864,486,2127,1249,908,2317,4 364,1350,718,1330,3090,4370,813,1796,2156,476,4614,1181,2626,856,1680,2272,4150, 839,1353,2214,725,4179,1134,2567,698,1141,2600,4153,914,1236,2243,752,4617,1195, 3200,868,1800,5123,2318,819,1354,2689,4208,814,1250,439,2571,1573,4231,929,2323, 1562,490,6160,2628,1411,623,2339,4174,1332,671,2107,1240,4385,739,3084,1440,916, 2217,4290,1295,463,2608,1303,4181,843,2162,1182,381,4372,2325,1361,497,2204,461 8,1574,930,2135,1696,4154,821,2245,1142,726,4264,3105,1356,1603,2164,5125,961,22 18,1564,872,2109,4235,1413,492,2579,1197,4195,631,2573,1145,729,4182,2690,1577,7 00,2329,4156,1223,443,3137,1808,4376,741,2326,1203,845,4185,2574,1252,920,2225,4 386,1362,382,2341,1336,4625,822,2436,1728,2139,6176,1414,851,3092,1198,4620,730, 2632,1578,498,4292,2817,1605,880,5184,2246,1417,742,2220,4237,1307,445,2168,114 6,4197,2249,471,1472,2384,4243,1377,635,3328,1585,4272,932,2110,1227,687,4238,23 30,1087,903,2191,4626,1364,2151,825,4417,1418,2226,500,1551,4127,2342,1606,846,3 106,4296,1580,745,2141,1205,5129,2692,826,1319,2250,4186,732,1309,2640,4641,446, 1256,2371,1148,4388,3096,962,1229,2440,6147,936,1206,2345,4418,475,1667,2818,85 3,4628,2155,1586,867,2228,4359,1310,1609,2199,637,4245,1323,3108,907,4198,2257,1 378,487,2332,4201,1235,695,2696,5126,1425,2142,1209,746,4400,2252,1420,828,2346, 4392,1368,3079,753,4259,1610,2448,854,1669,4188,2656,1617,2400,857,4143,1559,23 73,504,4363,1264,2581,799,3201,4481,1230,1119,2203,4642,255,1351,2258,964,6149,2 353,1588,909,4420,2595,1824,719,2348,5137,1426,3138,1380,4304,477,2157,1331,915, 4482,2232,1325,2582,4246,638,1441,2585,1237,4249,2163,748,1592,4261,2215,944,18 56,3584,4202,869,2273,1612,4151,1210,2374,491,5130,2354,1670,699,2820,4424,1428, 1251,2205,4632,754,3083,1920,858,4673,2704,1618,2377,4644,478,1442,2158,6208,13 26,968,2165,1673,4209,2260,383,1795,4250,3112,910,2219,4175,1384,1563,2824,815,4 365,2378,1135,976,5138,2274,1355,2597,4204,1238,870,3140,1333,4674,2586,917,121 2,4320,2435,1473,2356,4262,727,1241,2264,493,4615,3202,1432,873,4648,2464,1633,2 319,4291,1620,701,2327,5248,1575,2206,931,4366,1674,2385,1253,3091,7168,756,118 3,2598,4737,860,2720,1444,4619,1334,2166,499,4371,2380,1565,731,2627,4676,1797,3 085,1634,4387,823,2588,1681,4155,2437,922,1357,5132,2221,1143,2169,4265,874,162 4,3120,4656,918,2601,1363,4210,2247,1242,502,2832,4373,1392,2227,933,4252,1676,3 086,1254,6153,2276,743,1415,4183,2386,1337,2360,4293,760,2752,1474,5153,881,243 8,1566,4212,3144,1358,494,4266,2222,1257,2602,4157,702,2629,1579,4627,1798,2441, 921,4621,3329,1199,501,4738,2331,1147,2170,4377,1682,2496,876,5185,1636,2401,13 65,4374,3093,847,1801,2609,4622,992,2251,6150,1244,2111,1338,4273,447,2388,1448, 4389,3204,1419,2442,4484,733,1697,2575,4187,827,2630,1607,5140,2604,1379,934,46 80,2229,1311,3107,4865,1207,2343,882,4294,1258,2333,937,4268,2280,1149,2172,421 6,1581,963,3330,4297,1684,2253,1640,6161,2230,747,1366,4432,2691,505,2610,5376,1 340,3098,1265,4158,855,2334,4378,1802,2633,1587,4239,2347,924,3585,4199,1369,73 4,2402,4274,1476,2259,1421,4390,2449,829,1427,5154,2233,1231,3152,4189,965,2444, 4740,1698,2392,1582,6154,938,2634,1809,4298,2693,1456,3109,4688,884,1381,2641,4 419,506,2583,5144,1211,2288,1260,4488,2254,749,1688,4393,3097,1648,2143,4866,94 5,2375,1611,4203,2612,1804,4276,966,3094,1729,4247,2848,1150,2450,5156,755,2404, 1266,6162,859,2355,4305,1589,3208,1422,4380,2349,940,2465,4744,1370,2261,4190,1 480,830,2616,4300,1382,3332,1429,4394,2880,911,2636,5127,1327,1593,4496,2234,87 1,3336,4704,1268,2694,1619,4448,2452,639,6272,2275,1213,1590,4421,2944,888,3110, 4629,1700,2642,5249,1385,2466,479,4251,2350,1730,3586,4306,1613,946,4401,2697,1 239,2819,4643,750,2408,4396,1810,2587,1671,5186,3168,969,2159,4205,1372,1443,61 56,2379,508,2262,4280,1430,3139,4630,1488,2357,861,4633,2236,1704,2497,4211,182 5,757,4263,3113,1386,2265,5632,1614,2456,4321,970,2657,1433,4422,2644,1594,3216, 4402,919,2599,4868,1812,1621,2698,6177,1596,2277,4253,875,3100,1243,5131,2207,1 335,4752,2468,862,2358,4425,1732,3141,4206,1622,2589,758,4213,1625,2821,4308,16 75,2658,948,5160,3114,1445,4267,2705,1816,2381,6209,977,2167,4872,1826,3588,163 5,4426,2648,923,4322,2387,1626,2266,4645,1434,972,5188,3121,1255,2416,4634,1712, 2700,4483,761,2278,1677,4404,3146,1272,4312,2439,877,6164,2361,1393,2498,5250,1 214,3344,4512,1388,2590,952,4367,2382,1678,4375,2281,1683,495,4254,3232,1359,44 33,2603,1504,5139,2822,703,2223,4646,1339,3592,4768,1245,2171,935,6400,2706,139 4,4214,2660,1637,4428,3360,978,2389,4675,1446,2825,5133,1449,2268,1475,4636,360 0,883,4485,2362,1638,4269,2472,1567,2443,4217,762,3264,5168,1259,2721,6178,1436, 2631,503,4649,2403,1367,4295,3616,1396,4880,2335,925,2231,4275,1799,2282,5134,1 341,3142,4324,1246,2173,878,4434,2605,1450,4408,2708,1477,6168,3116,735,2664,48 00,1261,2390,4486,1583,2364,5192,1857,3203,4270,993,2289,1828,4650,2826,1736,46 77,3153,885,4489,2611,1858,2393,5377,1685,2500,4379,939,3122,6180,1832,2445,421 8,1803,2451,1641,4544,2255,994,4449,3145,1628,5141,2722,1457,4657,2606,980,3087, 4299,1744,2833,4159,1840,2480,4436,1860,2405,6151,926,3392,5252,1371,2235,1921, 4490,2284,764,4623,2712,1267,4678,3205,1686,4652,2672,1478,2635,4277,941,3124,5 155,1342,2828,6273,1699,2753,4391,967,2174,4381,1642,3095,4328,1922,2290,1805,4 220,2613,886,5378,1400,1452,4301,3206,831,4278,2446,1689,4739,2394,1760,6210,25 04,1591,3456,4658,947,2406,5146,1864,2453,4382,1649,3148,4681,507,2351,4395,126 2,2617,5633,1383,2292,4450,1481,3209,889,4307,2643,1423,6656,2237,1811,4497,315 4,1615,4281,2614,984,5200,2724,1702,4492,2409,1458,4440,3128,751,4682,2754,1701, 4741,2637,1373,3099,6155,1269,2263,5157,942,2834,4689,1482,2695,4631,1690,3169, 4336,1644,2396,4302,996,2467,5145,1387,3111,4191,1151,2454,6184,1215,2512,4423, 971,2728,4660,1806,3331,5142,1431,2849,4896,890,2410,1460,4498,3156,1650,4452,2 638,1595,4403,2457,509,6212,3210,1489,5256,2618,1705,4397,2836,1270,4513,2645,9 49,4309,3217,1731,4664,2620,1374,5380,2267,1623,4928,3333,973,6274,2359,1692,46 84,2756,1814,4282,3101,1484,5384,2646,1000,4742,2649,1273,4500,3115,1706,4323,2 699,1597,4992,2469,892,6163,2840,1435,5158,3170,1827,4690,2850,1813,4514,2659,9 50,4398,3587,1733,5634,2650,1389,4745,2458,1464,4867,3160,863,6157,2279,2736,44 56,1652,4635,3212,1713,5216,2701,1398,4207,2296,759,4427,3102,1447,4310,2417,14 90,5187,2238,1817,6192,2412,1008,4405,3218,1274,4284,2702,1395,4545,2707,1505,5 161,3143,510,4313,2383,1598,4504,2528,3334,6158,1437,2363,4705,1627,4692,2269,9 79,5264,3337,1390,4647,2418,1492,4746,2661,1679,4325,3233,953,5148,2470,1924,62 16,2473,1829,4255,3648,1639,4516,2499,4406,2662,763,5189,3117,1708,4637,2591,17 34,4869,2283,1453,6401,3172,974,4706,2460,1818,5162,2391,1276,4753,2420,4429,13 97,3712,4215,2823,1629,5636,2365,954,7169,3123,1872,4696,2270,1714,4435,2474,43 14,1737,3220,5169,879,2501,4464,1656,2285,4748,3118,1506,4326,2607,1830,6165,28 81,5194,981,3147,4487,1451,2852,4409,1928,2760,4546,1438,3338,5392,2882,982,463 8,2709,6276,1247,3345,4430,1687,2856,4329,1716,2827,5280,1859,3589,4651,927,487 0,2665,3176,4271,1643,2652,6179,1496,2481,5640,1479,3234,4219,995,4754,2768,182 0,4708,2864,1833,5408,3125,2884,6402,1738,4437,2395,1745,4873,3265,765,4316,294 5,1861,5648,2291,4410,3224,1740,4520,2710,1888,6170,2502,956,4491,3149,5312,183 4,2366,4769,1630,2723,4679,3236,1936,4451,2666,5664,1746,2946,6657,887,3840,438 3,1720,2829,4279,1401,4330,2424,3340,5190,1459,2476,4221,1841,3346,4653,985,622 4,2713,1343,4756,2784,3590,5164,1645,4712,2615,1836,4438,2888,997,4412,3126,150 8,6181,2673,5251,2286,1454,4337,3155,1862,4874,2407,5201,1691,2505,4659,986,312 9,4441,2447,6169,1512,2835,4548,1263,3593,5170,1402,4493,2639,3184,4499,1483,27 26,4303,943,6166,2482,1646,5193,3207,1651,4770,2725,2397,4654,1461,5135,3150,14 04,4881,2293,4528,891,2506,6280,3361,1842,4453,2714,5440,1485,3266,4283,1520,26 68,4332,1693,4760,2411,3157,6404,998,2175,5253,1703,4720,2239,1748,4683,3348,28 30,5172,1865,4876,3594,766,6408,2455,1653,4801,2484,4222,3130,1375,5143,2674,43 38,1491,2619,4661,1462,3240,5254,2513,6182,511,3211,4494,1761,4442,2729,1275,45 52,2294,3171,5504,1486,4454,2755,1466,6658,2398,4501,1465,3158,5196,2647,988,43 99,3132,4665,1493,2716,4340,1271,6240,2838,3352,5257,1707,2508,4691,1866,4285,2 297,3161,5202,1001,4662,2730,1762,6211,3362,1923,4772,2621,4457,2459,1694,5176, 3601,4802,1807,2851,4685,951,6185,2837,3596,5147,1873,2757,4311,1844,4882,3268, 2413,4743,1752,5217,2488,1952,6288,3213,4444,1002,2676,4515,3173,5159,1815,2737 ,4502,1391,4560,2422,3219,6172,1925,2471,4776,1654,5379,2514,1709,4897,3248,445 8,2841,893,5204,3214,6213,1868,2298,4686,2419,4505,1657,3602,5258,1735,4666,252 9,3393,6186,1277,4884,2622,975,4693,2461,5265,1715,3103,4668,2651,4315,1848,327 2,6660,1926,5381,2414,2516,4407,1710,4804,3162,894,5149,2703,4694,3617,1764,619 3,2948,4697,1874,2853,5163,3364,4747,1399,2663,4517,1468,7170,3394,2732,4888,14 94,5218,2758,1009,4898,3604,4707,2477,1507,5635,3335,6218,1439,2842,4698,2300,4 506,1509,3221,5208,1929,4327,2421,3174,4784,1819,6416,2653,955,5260,2896,4749,3 177,4344,1497,2738,5150,1658,6304,3376,2761,4465,1768,4286,3368,1876,4460,2680, 5266,2530,1984,4750,3235,6664,1004,4755,2854,3164,5191,1889,4431,2475,1717,4576 ,2952,6432,3119,1821,5382,2462,4411,1930,3339,4317,2271,5385,1010,6672,2711,173 9,4466,3457,4709,2740,1831,5281,3618,4518,2883,4521,1498,3396,6336,1660,5696,26 67,2520,4547,1718,4710,3280,957,5165,2503,6688,3458,4639,1278,2844,4331,1741,52 20,2857,3222,4508,1599,6214,2762,4439,3225,1937,4468,2769,5760,1822,3237,4871,2 885,4413,983,6188,2764,1835,5171,3178,4318,2912,4522,1403,3127,5268,2858,6275,1 721,3400,4549,1455,4333,2654,5166,2960,1631,4655,3608,6225,1513,2770,4929,3649, 5195,958,4900,2744,3620,4808,1890,6194,2425,5386,1747,2483,4930,3185,4757,1510, 5393,2865,3226,6217,1932,4904,2367,4875,1742,3151,5637,2669,4713,987,3341,5224, 2860,6159,1837,4700,2532,1500,4529,3180,5282,2478,4816,1880,3650,6464,2886,4912 ,1863,5173,3296,1749,4932,2715,4443,2536,6277,1012,3238,5313,2287,4993,1722,433 9,3591,1938,5272,2426,6196,3624,4758,1776,2507,4550,3267,5197,1892,4414,2670,71 72,1843,2675,4771,3342,5284,1838,4714,2485,3713,4994,999,6167,2428,5888,1463,35 95,4877,2866,4472,1953,6278,3347,2509,5388,1514,4524,2544,5394,3652,4761,1647,2 717,6528,1695,4832,3363,5638,2727,1763,4663,3131,4936,2772,6220,1016,3241,5174, 2889,4721,1940,4334,2677,5203,1487,3632,6281,2399,4455,1867,4553,3186,5177,2515 ,1405,4495,3349,6226,2486,4883,1521,3228,5641,2785,4687,767,5232,3159,6200,1954, 2299,4774,3269,4530,1845,5255,2510,6171,2490,1750,4773,3188,4445,2489,5198,1985 ,4341,3242,1896,6241,2517,4554,3133,5409,1516,4762,2295,3603,5314,1655,6183,273 1,4716,3597,4459,989,2890,5205,3714,6403,1753,4223,2786,4287,2947,1724,5396,335 3,4878,1467,6228,2718,5642,3350,1765,4503,2831,4532,3598,5178,1869,6282,2897,47 22,3249,1944,4667,2868,5288,3365,6289,1003,4561,2776,3460,5259,1406,4777,2976,4 342,3163,6405,1846,5219,2839,1875,4803,2415,4446,3656,7176,1754,5206,2949,3841, 4695,1522,5180,2678,4764,3270,6173,1904,4886,2733,3244,5400,990,4556,2892,6187, 3192,4345,1766,5209,2681,3273,4778,1469,5410,2759,6242,3408,4669,1495,4507,2301 ,5649,3134,1659,6659,2739,4899,3354,4885,1956,5644,2872,4805,3215,1711,6232,295 0,5316,3175,4461,1927,4536,2734,6284,1005,5261,2788,3250,4724,1849,5221,2898,47 85,3366,6174,1524,4470,2423,5267,3165,1870,4519,2492,6290,3716,4562,1769,5296,2 518,4889,3274,6215,1850,2531,5262,3664,4346,1756,4467,2463,5650,3395,6406,1470, 4577,2533,3464,5441,959,4670,2953,6409,3369,4509,1986,5151,2843,4699,3842,6305, 1960,2521,5320,3179,4462,1499,4564,2682,5210,3252,6720,1877,4751,2792,5665,3223 ,1891,4996,2900,6189,3281,4901,3008,5412,1661,4711,3356,7184,2913,5442,1931,478 0,3720,2741,4806,1011,6244,3166,5652,2845,4525,1511,5383,3276,6784,2954,4890,17 19,4348,3370,5269,2763,1770,4469,3472,6195,2855,5222,1852,4701,3680,4944,2522,6 292,1777,5225,3424,4786,2684,5424,1878,3397,6190,2742,4809,1881,5416,3605,4728, 2302,6219,1013,4578,3227,5283,2765,4902,1528,6410,3282,5212,2623,3377,4523,1823 ,5000,2961,6417,3619,5167,1279,4510,2846,5387,3372,6661,1988,4319,2859,4759,318 1,5505,1933,6248,2427,4788,3256,1743,5666,2745,4931,3606,6306,1501,5444,2479,47 15,2655,4568,2537,6197,1939,5328,3609,4551,2914,5506,895,6337,3187,4892,2771,49 05,1662,3239,5270,2534,7200,1772,4810,3297,5273,2956,4817,1968,6296,3398,5285,2 766,4933,3378,4812,1893,6221,2861,5226,3844,4960,1515,5175,2524,6308,3229,4906, 1723,5448,2904,4702,3728,6912,1778,5008,2887,3401,5656,1882,4818,2773,6412,3182 ,5697,2746,4792,1006,5668,3189,6418,2962,4473,1502,4531,3284,5233,2800,6662,199 2,4913,3243,5274,2916,4415,3848,6198,1407,5199,2867,4717,3402,5389,1934,6227,28 62,4908,3298,4580,1839,5228,2487,6201,3621,4526,2000,5698,2977,4934,3610,6665,2 538,5344,1894,4763,3459,7171,2671,4584,1941,5286,3380,4335,2719,6256,1014,5639, 3288,4474,2787,5672,3488,6279,1751,4555,2964,5315,3343,4718,1517,6222,2511,4723 ,3351,5390,2891,1897,4533,6433,3230,5761,2429,4476,1725,6338,3409,5643,2545,491 4,1955,5395,3622,6229,2978,4557,3744,4592,1780,5700,2869,6420,3190,4765,1884,54 11,2774,6666,3404,4775,1523,5179,3651,4820,3009,6202,3612,5289,1755,4937,2920,4 725,3461,6312,1017,5680,2540,4447,3245,5234,2679,7173,1847,4563,3193,5397,2777, 6283,1946,4534,3625,5276,2748,4833,3271,6243,1898,5207,2491,4347,3856,5317,1942 ,6230,2789,4558,3251,4538,2893,6204,1526,5236,3300,4537,2968,5290,1957,6424,456 5,3410,5181,2430,6233,3384,4343,1767,5651,2870,4779,3776,6434,1784,5645,3462,49 38,2899,5762,3246,6673,1905,4834,2778,4995,3626,6668,1018,5401,2546,4766,3653,5 398,2928,6340,1518,4879,3465,2790,1726,5646,3355,7232,2493,4945,3194,5297,1945, 4916,2519,6285,3520,5413,1525,4824,3425,6245,2683,5508,3633,5024,1900,5211,2980 ,6291,3275,4887,2735,4463,1871,6320,3135,5704,2951,4997,2016,3412,5889,2873,628 6,3466,4726,1471,5318,2548,6674,3599,4781,1757,5292,3654,4940,2894,6465,3628,52 40,1851,4729,2793,6175,3253,5321,2874,4807,991,5456,3367,6344,2780,4349,1958,51 82,3357,7177,2494,4787,3304,5402,1906,4920,3196,6234,3010,5263,3277,4998,1961,6 689,2984,5223,3254,4782,2523,4836,1987,6436,3715,5298,2901,4946,1771,6466,3634, 5414,2915,4471,3358,6676,1529,5213,3657,4540,2685,5764,3371,6407,1879,4566,2955 ,5322,3426,6293,2535,4579,1948,5712,3283,4511,2743,6246,1758,5443,3473,4581,325 7,6249,2794,5512,1853,5001,3468,7174,2876,5417,3416,4891,1020,5890,2801,6448,36 58,4569,2902,5227,1989,6440,3717,4730,3665,5300,1962,6307,2905,4840,3607,5271,2 552,4948,1908,6236,3312,5329,2847,5056,3278,6191,1530,5404,3167,4961,2303,6411, 3399,5768,1773,4789,3012,6529,3636,5214,2957,4893,1969,5324,3872,6690,2767,5002 ,3474,5418,1990,6468,3428,4811,2525,5520,3379,7185,1779,4903,2963,5728,3373,457 0,2686,6352,5472,1883,4732,3489,6530,3285,5445,2796,4790,1964,6294,3640,5653,29 92,4350,3904,6297,1854,5275,2917,4813,3660,6309,3258,5330,1935,4671,2539,5425,3 718,6250,2747,5009,1007,5667,3476,6199,4894,3299,5420,2802,7178,1895,4907,3968, 5229,2906,6472,3666,4475,1663,5304,2526,6680,3490,4793,3374,5654,1912,4527,3016 ,6721,3721,4703,2431,4585,6692,1503,5657,3843,4962,2958,6257,3432,5235,1970,481 9,3611,6298,2863,5287,3183,4582,1774,6223,3024,5345,3403,5004,3286,6413,5446,19 93,4814,2918,5426,3381,7186,2965,4909,1532,5892,3260,6252,3521,4572,2775,5277,1 885,6722,3289,4952,5776,2541,6368,3480,4935,1781,5449,2921,6310,3681,4821,3668, 5230,1994,6663,2749,4794,3623,5237,6696,2979,5010,3722,5332,1943,6339,3301,4848 ,2804,5291,3231,7296,1015,4964,2908,5896,3492,6414,4915,3382,5450,1899,6785,254 7,4910,3613,5346,2779,4535,1886,6667,3845,5669,5025,3682,6419,2871,5658,3729,45 86,1782,6724,2970,5507,3405,4719,3191,6435,1972,5428,4767,2922,6203,3672,5336,2 966,4835,2001,7180,3411,5536,3290,5012,2550,6313,5391,1947,4559,3440,6704,2981, 5399,3724,4939,3302,6258,1996,5278,4477,2791,6421,3463,5457,3385,4593,1785,6300 ,2808,5670,3522,5026,6231,2929,5792,1901,4917,3614,6341,3406,5238,2542,4822,330 5,7201,5452,1976,5699,2750,6260,3627,5057,3846,6314,1519,5660,2969,4968,6205,32 47,5509,2549,4588,3195,6675,1727,5293,3730,4727,6669,2924,5241,3684,4825,1959,6 786,3413,5673,2895,4796,3849,6425,5319,3040,4539,2002,7233,3292,5904,3386,4837, 2495,6422,5299,1019,4941,3496,6670,3467,5348,2781,5016,6321,3745,5458,1907,4478 ,2875,6437,3655,5432,3427,4918,6532,1786,5824,2982,6235,3359,5510,3255,4947,293 0,7188,5294,1527,4826,3306,6728,2985,5674,3197,4594,6913,1949,5701,3629,4976,30 11,6342,3732,5513,3688,4838,6316,1902,5403,2795,4541,3414,6264,2553,5242,6345,3 388,4567,1759,5568,3313,6480,2903,5473,4731,3850,7424,2017,5681,3635,5028,2972, 6206,5323,3417,4783,2782,6426,1909,5183,3524,4999,6287,3469,5460,2877,6247,3475 ,4921,1963,5514,6322,3279,4596,3013,5647,3746,6438,2018,5702,4942,3630,7202,298 6,5676,3857,4841,3504,6237,5301,2004,6788,2932,4922,3429,5415,6346,2554,4828,32 59,5405,1950,6736,3308,4542,5352,2797,6467,3736,5244,3696,7192,5058,1788,5325,2 993,6536,3659,5032,3852,5302,6441,3014,4571,1965,5763,3777,6914,4949,3198,6251, 2803,5682,3314,4963,1991,6324,5406,2907,5705,3637,6295,3470,4733,5419,2988,7204 ,1021,5003,3418,6353,5474,3528,4583,2878,6428,1910,5331,4791,3430,6792,3477,552 1,2959,6238,3375,5305,4842,1855,6348,3641,5516,2919,4924,6442,3316,5464,3667,71 75,1971,4849,5706,2687,6544,3261,4950,3638,5765,6752,2936,5713,1531,6496,3748,4 953,5655,3433,6469,2527,4600,3778,5360,6677,1913,4895,3661,7297,2994,5326,5215, 3287,6299,2798,4351,5447,3858,6354,2008,5060,3719,6449,5684,3017,5005,3420,6691 ,3491,5920,4815,1775,6444,2556,5522,3478,7234,5476,3536,4573,2909,6253,5427,196 6,5011,3752,6328,3873,5421,6678,2805,4734,3434,5537,2020,6681,5333,3662,6259,30 18,4844,5688,3481,6311,3642,5040,1995,5952,7680,2967,4965,3860,6369,3669,5708,5 306,3644,6470,2923,4587,6450,1914,5766,3291,4795,3383,6916,5524,2910,5347,3780, 6301,4850,1533,7179,3670,6016,2806,4954,6800,3673,5714,3723,6473,4574,1973,5538 ,2996,6254,5422,3493,5064,3864,6261,3025,5769,6356,3874,4479,1997,5891,7208,368 3,5006,2971,6315,3674,5480,5659,3482,6920,2024,4911,6474,3020,5231,3303,5072,63 70,3760,5451,2809,6693,5334,1916,4966,3725,7236,3320,5429,6682,2925,5013,3441,5 308,6531,3262,5569,1974,6452,4823,3436,5337,3000,6360,4589,3726,7298,3731,5528, 4969,1887,6560,2543,5729,3407,6415,5716,3552,4797,2751,6423,5671,3387,6302,1783 ,5027,5770,3293,6481,2983,5349,7187,3442,4852,3685,5279,6694,3026,4956,1022,681 6,5540,3494,5430,3497,6262,4595,3523,6476,2931,5661,4827,2032,6723,3686,5893,71 81,3615,5730,2810,4919,6684,3307,5777,3484,6533,5018,1534,5453,2551,6317,5239,3 415,6265,3444,4970,5720,2973,7216,3847,5014,6697,2003,5459,3389,6343,5338,3294, 4598,2926,6928,5488,3498,6323,3525,5029,5772,1977,7182,2783,5350,6372,3309,4839 ,3631,5511,6482,3905,5433,1787,6456,4856,3041,6848,5570,3876,4977,3784,6534,566 2,2933,7240,3906,5454,4590,1998,6318,3733,5353,6698,2987,4798,3880,6725,5675,38 51,5894,6537,3689,5017,1978,7425,5295,3042,4597,3676,6427,5243,3505,6266,3028,5 778,6592,3792,4972,1903,5732,6497,3888,5461,7189,3908,4943,2974,5897,6705,3419, 5088,3969,6347,5340,2005,6207,5434,2812,4543,3315,6484,5544,3734,7300,3526,5515 ,6538,2989,4829,5793,2006,6671,3390,4923,6726,3747,5703,3015,6700,5475,3690,503 0,6325,3970,5407,1951,7203,5303,3853,6439,2934,4978,5354,3448,6429,5033,3500,63 76,2879,5245,6268,3737,5677,2019,5059,7426,3808,5780,6349,3639,5736,2995,6326,4 843,3912,5462,6787,3697,4601,1789,6706,5436,2555,7194,5361,3310,4951,3431,6430, 5898,3529,6729,5683,2937,6443,1980,5020,7681,3471,5465,4830,3859,6498,3663,5572 ,6355,3032,5517,6545,3750,4925,3506,5523,6329,1911,5327,7248,2799,5061,3749,654 0,5794,3421,6488,5678,3317,5034,2990,6730,5905,2009,6789,5552,3530,7205,3738,49 80,5477,3692,6737,4602,3044,6679,3435,5307,6384,3199,5356,6350,2021,4845,3263,5 784,7193,3019,5744,6239,3854,5041,6471,3479,5707,2938,6708,5900,2010,5062,7190, 3508,5825,3698,6944,5246,3643,6546,4851,2557,6500,5362,3537,4955,3753,6451,5685 ,1967,7304,5518,3318,6445,5036,2997,6561,3779,5466,6357,3422,5576,4926,3671,671 2,5478,3021,7428,1915,5525,6976,3740,5007,6732,3862,5423,5689,3532,6330,3048,49 67,7432,3321,5364,6790,3754,5715,6548,2022,4735,3645,6371,5309,2940,5686,7040,3 483,4984,7206,3875,5796,6738,3861,5481,1790,6562,4575,2998,6446,5826,3781,7682, 5709,3437,5042,3512,6793,5335,2911,6915,4846,3700,6504,5906,1535,6683,5767,3761 ,7264,3446,5065,6255,2807,5468,5539,3495,6475,4604,3538,6358,5526,3865,7235,558 4,3056,6453,1023,4957,6332,3322,5800,6593,3443,5921,4853,3553,7209,5482,2558,63 61,5710,3646,6552,3485,5066,6753,2012,5529,6740,3675,5690,7312,3027,5015,6695,3 438,5908,5717,3540,6794,3727,5692,6373,3001,4971,7196,2025,5339,6303,3972,5431, 6564,3877,4958,6454,3687,5828,7237,2811,5718,6685,3756,4854,3782,5721,6917,1975 ,5771,6754,3501,5044,7210,3022,5541,6801,3866,5912,6477,3324,5073,6263,3445,592 2,7684,3677,5731,6744,3002,5019,6483,2026,5722,3920,6362,5530,3762,5068,7217,37 85,5351,6512,2927,5808,6796,3704,4857,6374,3554,5773,7242,1917,5368,6535,3878,4 973,6457,3029,5489,6594,3499,5310,7440,3976,5484,6686,3486,5048,6478,3030,5774, 6377,3295,5779,1999,4591,7328,3735,5455,6699,3764,5600,6918,3907,4799,6319,2975 ,5435,7688,3691,5341,6267,3544,5031,6802,3527,5490,6756,1918,5733,7456,3043,507 4,6485,3868,5542,6921,3881,5545,6364,3786,5571,7696,3793,4979,6458,2813,5734,65 68,3909,5663,6539,2033,4858,7360,3788,5355,6817,3936,5532,6727,3004,4599,6499,3 882,5463,7712,3678,5492,6431,3984,5021,6327,3794,5895,6378,1979,5437,7238,2935, 5342,6269,3768,4974,6701,3449,5546,6804,5573,3507,7212,4831,3889,6760,5357,3033 ,6486,5679,3391,6460,5953,2028,7299,5089,3693,6385,5924,3884,6922,5832,3045,724 9,4981,3556,6707,5954,3502,6489,5781,3910,6596,5035,3739,7218,5928,2034,6541,58 99,3034,6547,5737,6351,3560,5090,7241,3311,5724,6818,3450,5553,6702,3531,5076,7 183,2991,5840,6929,3694,5936,6576,1981,5956,6501,3699,5022,7488,3509,5467,6331, 6017,3452,6380,4860,2939,6808,5363,3890,7301,5782,3533,6768,5574,3568,6731,5037 ,3741,7220,5438,2007,6924,5795,6849,3046,5063,6270,3751,5738,7191,3796,6018,638 6,3913,5901,6709,2814,4982,5496,3701,5548,7302,4927,3423,6542,5785,3539,6490,58 56,1982,6600,5687,3510,7552,5043,2559,6502,5960,6549,3809,5745,7244,3323,4603,6 447,3534,5358,6713,3514,5479,6388,3513,5577,7305,4985,2011,6739,5519,3036,6333, 5907,3541,7250,5711,3319,6710,5080,3755,6820,5798,6505,3914,5554,7224,3049,4847 ,6850,3810,5797,6733,3971,5469,7195,5365,3742,6359,5038,2036,6930,5578,3855,679 1,5786,2999,7265,5740,6492,3921,5092,6563,3892,5483,7207,3800,5247,6550,5311,40 00,6608,5067,3050,6824,5902,3863,7427,5527,2023,6945,4986,6506,3439,5556,7252,3 973,5746,6734,3702,5691,6553,4605,3757,7306,5585,2941,6714,5801,3916,6932,5366, 6741,3705,5045,7313,3783,5827,6716,2040,5470,6363,5719,3325,7429,5069,3023,6455 ,5788,3763,6852,5910,7197,3896,5580,6742,3974,5096,6745,5369,3758,7211,5802,294 2,6795,5693,3812,6565,4988,6936,3922,5531,7266,1791,5923,6946,3447,5909,6755,50 46,3516,7683,5829,3542,6746,5485,6554,3057,5560,7256,3555,4959,6375,3487,6832,5 748,7308,3557,5809,6797,3977,5494,6392,4855,3867,7198,5543,2013,6513,5586,6334, 3003,5913,6508,3545,5104,7314,3706,5370,6798,5491,3816,6803,5601,3924,7239,4606 ,6479,4032,5694,6624,3052,7430,5533,6459,3937,5723,6365,3765,5075,7433,5486,202 7,6514,5588,3869,6757,5775,7329,3978,5049,6566,3058,6020,6569,5925,3787,7744,57 35,3879,6595,6758,4859,3546,7213,5804,3708,6687,5830,6379,3766,5549,7268,3005,5 070,6556,5914,2014,6487,5372,3326,6516,5493,7808,3789,6919,5725,6461,3647,5050, 7219,3985,5968,6366,5810,3870,6570,5833,3031,7316,4975,6597,3883,5752,6381,3451 ,7214,5602,6703,3769,5926,6977,5077,3503,7243,5547,2029,6948,6024,6856,3679,553 4,7434,3561,6978,5078,6805,3006,5343,7441,5783,3938,6952,5812,3795,6923,5955,76 85,3558,5023,6761,3980,7272,5739,6748,3790,5592,6577,5575,3035,7330,5091,3885,6 864,5916,6960,1983,5929,7221,6980,3548,5834,6491,3928,5841,7361,4861,3911,7041, 5957,6387,3797,7320,5836,3060,6806,5984,6598,3770,5052,7245,5930,3986,6462,5726 ,6819,3824,7332,6032,3940,6762,5842,7042,3891,4983,7936,5816,2035,6925,5497,388 6,6520,7436,5555,3047,6572,5937,7442,3511,5081,6809,5439,4001,6880,7686,5741,35 62,6711,5932,3695,6984,5093,7222,3743,5604,6769,6382,3811,5550,7251,5958,3064,6 503,5787,3988,6601,5082,7225,3535,6543,5608,6931,2037,5359,7689,5498,3915,6735, 7280,5579,3453,6822,5039,3569,6578,5742,7303,2815,5747,6821,6493,4002,5557,7246 ,5500,3893,6389,4987,6602,3798,7457,5938,6810,4033,5581,7362,5616,3944,6764,578 9,3564,6507,7253,5094,3703,6271,5799,6335,1919,5844,7444,6926,3037,5961,7690,48 62,3801,6551,5749,6580,3772,7226,5471,6770,3515,5587,6715,5558,3813,7336,6609,4 607,3917,7307,5857,6825,3992,5371,6390,7267,3051,5582,6851,5562,3454,6494,5561, 7254,3894,6743,5084,7228,3923,5589,6812,5367,3802,6934,7448,5803,2030,6604,5962 ,6393,3570,7257,5097,6826,3952,5858,7458,6019,3038,6717,6555,5790,3814,7697,590 3,6947,3517,5047,6933,7692,3543,5969,6853,5940,3707,7364,6509,5848,4004,6584,60 48,7309,3759,5098,6772,7269,3975,5911,6833,5487,3053,6518,7315,6021,3897,6567,5 750,6610,2038,5805,7344,6937,3572,4989,7310,5964,3918,6394,6515,5753,3817,7698, 5831,6625,7489,3898,5373,6718,5071,3804,6557,5811,7199,3518,6747,5944,7368,3007 ,6022,6510,6612,4034,5806,7258,4990,4008,6799,7713,5860,3547,7044,5970,6949,746 0,3925,5495,6759,5564,3939,7490,6828,5590,2041,6854,5105,7700,3709,6573,5603,74 31,5535,3979,6938,6396,5605,3059,7317,6025,6517,3559,7270,5915,6749,3767,5051,6 992,7273,5593,3818,6834,5754,7472,3900,6857,5864,7464,3825,5972,6776,6626,3926, 6080,7331,5100,6950,3929,7260,5985,6571,3061,5813,7048,7215,3576,5917,6558,6026 ,7435,3871,6367,5106,6807,3327,5835,7553,6836,2042,5927,7714,6979,5594,4036,749 2,5756,6763,3981,6616,5814,7376,3791,5053,6599,7554,5374,3549,6940,5837,6953,39 87,7318,5695,6858,7321,2943,6033,6865,5918,3710,7333,6981,5079,3820,6860,5931,7 274,7008,4016,5499,7223,6954,3941,5817,7496,5551,6750,3563,7056,5727,7704,3771, 5609,6866,7745,5054,3826,6840,7716,5986,3930,6521,5843,6579,7281,2015,5606,6961 ,7322,3054,6028,6463,5838,7247,3550,6765,5083,7437,4040,6956,5933,6628,5596,345 5,7276,6574,5976,7746,3982,6982,5959,7392,3887,5845,6811,6632,5108,4048,7334,63 83,5818,3942,7687,6034,6522,7720,3989,5872,6603,7363,5988,3062,6766,5939,6771,3 799,7438,5934,6581,7809,3565,5095,6524,5559,3945,7691,6962,6049,7443,3773,6605, 5610,6640,7748,4003,5743,6813,5791,7459,2044,6823,5859,7227,3828,6868,5112,7337 ,6985,3932,6036,6773,5583,7728,3571,6495,5963,7282,3803,6611,5501,7445,6582,306 5,5617,7324,6881,4863,3895,7255,6050,6395,7365,3994,5941,6606,6586,5846,3946,72 84,6585,6081,3990,7338,5992,6613,7229,3574,5612,6391,7699,5751,4005,6827,7693,5 085,6986,3815,7810,5849,6882,7043,3832,5820,7449,5563,6814,3953,7446,5861,6927, 7694,3066,5965,6993,7345,6040,3566,6964,7461,5099,2031,6872,7556,5502,7072,3774 ,7259,5942,6935,5971,3993,6511,7752,5850,7045,3573,7937,5618,6774,7366,3948,600 0,6829,7340,5086,3919,6988,7288,5862,6777,4064,7369,5565,6855,7504,3519,5591,63 97,7230,5755,3805,6835,7450,6052,6968,3899,7311,5807,7046,7271,6023,3039,6830,5 101,6884,7346,4006,5945,6994,7462,5620,3954,6519,7261,5966,6588,4009,7812,5865, 6614,7370,4035,5946,6627,7760,5852,3819,6559,7491,5566,6629,3577,7560,5055,7049 ,7465,6082,3927,6939,7938,6056,6617,2039,7275,5595,6778,7348,3996,5973,6888,731 9,5987,3806,6996,7377,7104,5757,7452,3901,7009,6027,7816,6837,3068,5107,7262,69 41,5607,4037,7372,7050,5815,7466,6859,4010,5866,7568,6951,5948,3956,7776,6618,5 873,7520,3578,6780,5974,7493,6838,5977,3821,7701,6398,5109,7323,4017,6861,5624, 7378,6719,4038,7473,5919,7057,7715,5375,3827,6942,7468,6084,6955,3931,7277,6029 ,6523,7352,5839,4012,6841,7702,5597,6575,3902,6751,6633,6035,7705,7010,3983,499 1,7283,6867,5758,3055,7335,6630,5868,7393,7052,3943,6064,7494,6862,7474,3711,59 89,6957,7940,5611,6620,3960,7325,5819,7000,7824,5874,2043,6983,7497,5978,6869,3 551,7278,6842,5102,7285,7058,4018,5598,7380,6896,6088,7339,3822,7012,7944,5503, 6963,4041,7498,6030,6958,7394,5935,3580,6583,7717,6096,7073,7706,3933,6634,5990 ,7555,6767,6037,3829,7476,6815,5110,7384,6883,4042,7584,5847,7060,7439,3991,561 3,6607,7447,6987,5993,3063,7326,6525,5821,7505,6641,3947,6051,7718,7074,7840,58 76,3934,6965,7286,5980,6870,7500,3830,5619,7747,7105,7708,5851,4020,7016,7557,5 113,6636,7341,4049,6775,5943,7289,6873,6042,3995,7721,6844,7367,5994,6587,4044, 7952,6038,6885,7347,6989,3833,5622,7396,7064,6053,7506,3949,6526,7480,5863,6966 ,7872,4024,5880,7558,6995,7342,6001,3567,6874,7722,5114,6642,7749,2045,7024,561 4,7561,6886,5822,7451,3775,6589,7290,6041,6615,7616,4007,5621,7521,6779,7729,59 96,4050,7076,7371,6831,5967,7231,3067,7047,6112,7508,6969,7562,5567,3955,6644,7 695,5853,7750,6990,3834,7724,5947,6889,7349,6970,5087,3575,7463,6876,6054,7453, 6590,3997,7400,6002,7292,7106,7373,3950,6057,7080,7350,6619,6083,7811,3807,6997 ,5867,7730,7011,7454,4065,5625,7753,6781,7467,5975,7051,3957,7522,6631,6044,737 9,6839,4011,5854,7569,7353,6890,5949,7564,4066,6972,7512,5116,6897,7754,6998,40 52,6085,7813,7761,6058,7001,3998,7703,6648,6004,7408,6943,7374,3836,5626,7263,6 399,7495,5869,7108,4013,7732,7053,6065,7968,6863,7570,4039,6086,7524,6621,7475, 5875,7059,3069,7469,6782,5979,7585,7381,3958,6892,6060,7736,7088,8000,5950,3903 ,7013,7756,7354,6031,6635,7814,4019,6843,5103,7572,7395,6898,5991,3579,8064,700 2,7762,5759,6622,7586,3961,7470,6008,7112,7817,6527,5599,7939,2046,7054,7528,60 66,7707,6959,7279,4056,5870,7120,7499,7382,6089,7014,3823,7477,7061,5628,7356,7 617,6871,4014,5981,7385,6637,7576,5877,7017,4068,7777,7764,6090,6845,7719,7075, 7818,4043,6039,7397,6900,7327,5111,7004,3962,7588,7478,5995,6643,7709,6875,3581 ,5982,7941,7778,6967,7825,5878,7066,4021,7501,7287,6068,7018,7768,7062,4045,609 7,7507,7386,6646,6043,7536,7077,4072,7820,7398,6092,6887,7559,7481,5881,3964,69 04,7618,7025,5997,7710,7502,4022,6638,7401,6072,6846,7723,7942,5615,3935,7065,7 343,6645,7291,5823,7826,7020,3831,7780,6055,7509,6991,7945,7136,6098,3070,7388, 7482,6591,5115,7592,7563,6877,4080,7841,6003,6971,7751,7523,5882,7078,3582,7455 ,7351,7026,5623,7402,7081,7293,4051,6045,7725,7107,7828,7784,5998,6891,4025,751 0,6649,7484,5855,7409,6999,7946,3835,6113,7731,7068,7513,6878,6005,7620,4046,75 65,6973,7571,6059,7375,7109,7842,4026,6114,7726,7082,7953,7600,6100,7028,7525,3 951,6650,7355,6046,7404,6893,7832,7792,4053,5884,7089,7755,7948,7110,6061,7873, 7294,4054,6899,7410,6087,7003,7733,7566,7084,3999,5117,7514,7624,6974,6006,7526 ,7573,7055,4067,7471,5951,7737,7015,7412,7763,6067,6783,3837,7357,7734,7032,562 7,7844,7529,6623,4028,7874,6009,7757,7090,7383,6894,7954,6104,3959,7815,7113,75 16,7587,5871,6652,7574,7632,4057,7005,6062,7848,7969,6901,7530,6116,7758,7114,4 069,7577,7738,6091,7063,7956,7765,7740,7019,2047,6010,7387,7479,7006,7876,5629, 7766,6902,4058,7769,7819,6069,7092,7589,7960,7121,7970,4015,6093,7779,7067,7770 ,7578,6120,7116,7399,7856,3963,6905,6012,7821,7416,7021,7537,7358,6070,4070,753 2,7096,7822,7827,5983,6639,7503,7648,6847,3838,7483,5879,7389,7079,7538,7781,71 22,5118,7590,3583,7593,7619,7027,6128,7782,7711,6906,7403,7580,3071,5630,6647,7 511,7540,7069,7943,6099,7485,7390,4060,7022,7594,7621,6073,6879,7405,7727,8001, 5883,4073,7137,7972,7880,7029,8002,6094,7829,7083,7976,4023,7947,7785,6074,7138 ,7772,7601,7124,7888,5999,7984,4074,8004,7070,7515,8065,6101,6908,7411,7830,762 2,7085,3965,6102,7486,7843,7111,7786,8066,6047,7949,7030,4047,7544,7596,6975,78 33,6115,7904,7735,7091,8008,7793,3966,5885,6651,7406,7527,7625,7033,6076,7567,7 955,7759,4081,7128,7846,7602,6007,6895,7845,7517,7413,7086,6105,4027,7626,7834, 7788,7140,7531,7295,6117,7359,7115,7950,7575,4076,7034,6106,7604,7794,7739,6653 ,7633,7849,6063,7414,4082,7093,7875,7518,7767,7117,6011,7836,7958,7628,7144,741 7,4029,7850,6118,7741,7036,7579,7971,7957,5886,7094,7877,7533,4055,7608,7007,77 96,5631,7857,7542,6903,7591,7634,7961,7152,4030,5119,7418,7539,7649,6654,7742,7 581,6108,7771,7123,7534,7636,4059,7823,7097,6121,8068,7973,7783,6907,7852,7878, 6071,7597,7118,4084,7962,7420,7541,7773,7098,6122,8016,7858,7881,7023,7800,4071 ,7650,6013,7974,7125,7595,8072,7582,7126,7391,6095,7831,7860,8003,4088,7071,778 7,7640,7623,6014,7139,7964,7977,7882,7889,6909,8005,3839,6129,7884,8032,7100,79 78,7774,8080,7890,6075,7031,7864,7545,7603,4061,7985,7129,7487,6124,7789,7980,7 141,7652,7598,8006,7835,6130,7130,4075,7656,7407,7546,7627,7087,7790,6077,7795, 7605,7548,7035,7986,7629,7664,4062,7837,6103,7142,7847,7892,8009,6910,7797,7519 ,7635,6078,7606,6655,4077,7905,7419,7630,7610,7609,6107,7132,7637,7415,7851,801 0,7145,7906,8067,7838,4031,6132,7951,7095,8017,7988,7896,8096,7146,7959,6119,75 35,8069,7798,7853,7037,4083,8012,7801,7879,6136,7421,7119,7859,7992,8070,7854,7 038,7908,8018,5887,7543,4085,7612,7638,7153,7651,7583,7653,8073,7963,6109,7099, 7641,7802,7912,8020,8128,7148,3967,8033,7861,6123,7965,8074,7154,7883,7975,7642 ,7804,7862,7101,6110,7422,7885,7743,4078,8081,7966,7127,7979,7547,7865,7599,612 5,7775,7657,7102,8034,7891,7654,8076,7886,7131,4086,7981,6079,7644,8024,8007,78 93,7156,7866,8082,7920,8036,7987,6131,7982,7143,7607,8097,7658,4089,7791,7839,7 907,7160,8084,7631,6133,8011,7549,7665,6911,8098,7989,7894,8129,8040,7660,7799, 6015,4090,7133,7897,7868,7611,7909,8013,8088,7147,7550,7990,8019,7898,6126,7666 ,8048,7134,7910,7613,7639,7803,4063,8100,7855,8071,7149,7993,6134,7668,8014,791 3,7994,7900,7614,7103,8130,8104,7643,8021,8035,6137,7805,4092,8075,7155,7655,78 63,7914,7996,7921,8022,8025,7157,7672,7967,7423,6138,8132,8077,7887,7645,8083,7 039,7806,7916,8112,4079,8037,7659,7867,7922,8026,6111,7150,7646,8136,7551,8078, 7983,8144,8038,8085,7158,7895,7661,8041,7869,8099,6140,7924,8028,4087,7667,7899 ,7161,7991,8090,8042,8086,7670,8101,7911,7928,8049,7162,7662,6127,7870,8089,766 9,8044,8015,8160,7615,7901,7995,7135,8102,4091,8050,8105,8131,7915,7673,8023,61 35,8092,7902,7997,7164,8133,8106,8052,7674,7917,8113,8134,7923,8027,8108,7998,8 079,7151,8039,7807,8056,6139,7647,8114,4093,7918,8137,7676,8029,7925,8138,8087, 7159,8043,8030,7926,8116,8145,8091,8140,7929,8045,8120,7663,6141,7871,8103,8146 ,7163,8051,7930,7671,8093,8046,7903,8161,8053,8107,4094,8162,8148,8094,7932,810 9,8135,7165,8054,7999,8115,7675,8057,6142,8152,7919,8110,8164,8139,8058,7677,81 17,8141,8168,8060,8118,8031,7927,7166,8176,7678,8147,8121,7931,8142,8122,8047,8 149,8150,8095,4095,8163,7933,8124,8055,8153,8165,6143,8154,8111,8059,8166,7934, 7679,7167,8156,8169,8119,8170,8061,8143,8062,8177,8123,8172,8178,8125,8151,8126 ,8155,8180,8167,8184,7935,8157,8171,8158,8173,8127,8179,8181,8063,8174,8182,818 5,8186,8159,8188,8175,8183,8187,8189,8190,8191];
wobei die Sequenz Q2 gegeben ist durch:
[0,1,2,4,8,16,32,3,5,64,1024,2048,9,6,17,10,18,128,12,33,65,20,256,34,24,36,7,129,66,5 12,11,40,68,130,19,13,48,14,72,257,1025,21,132,35,258,26,2049,513,80,37,25,22,136,2 60,264,38,514,96,67,41,144,28,69,42,516,49,1026,74,272,160,520,288,528,192,544,70,4 4,131,81,2050,50,73,15,320,133,52,1028,23,134,384,76,137,82,56,27,97,39,259,84,138, 145,261,1032,29,43,2052,98,515,88,140,30,146,71,262,265,161,576,45,1040,100,640,51 ,148,46,75,266,273,517,2056,104,162,53,193,1056,152,77,164,768,268,274,518,54,83,5 7,521,1027,112,135,2064,78,289,194,85,276,522,58,168,1029,139,99,86,60,280,89,290, 529,2080,524,196,1088,141,101,147,176,142,530,321,31,200,1033,90,545,292,2051,322 ,532,263,149,102,105,1030,304,296,163,92,47,267,385,546,2053,324,1041,208,386,150, 153,165,106,55,1034,328,536,577,548,2112,113,154,79,269,1042,108,578,224,166,519, 552,195,1152,270,3072,641,523,275,580,291,59,1036,169,560,114,277,156,2057,87,197 ,1057,116,170,61,531,525,642,281,1089,278,526,2054,177,293,388,91,1044,584,769,19 8,172,120,201,2065,336,1280,62,282,143,103,178,294,1058,93,644,2058,202,592,323,1 048,392,297,770,107,180,151,1060,2066,209,284,648,94,204,298,1031,400,608,352,217 6,325,533,1153,155,210,305,547,300,1090,109,2060,184,534,537,115,167,1536,225,326 ,306,772,2081,157,1035,656,329,110,117,212,1064,171,2113,776,330,226,549,1092,538 ,387,308,216,2068,1154,416,271,279,158,337,1043,550,672,2304,118,332,579,1037,540 ,389,173,121,1072,2082,553,199,784,179,1038,228,338,312,2072,704,390,1096,174,554 ,581,393,1281,283,2084,122,448,353,1045,561,203,63,340,2055,1156,394,527,582,556, 181,1059,2177,295,285,232,124,1282,205,182,643,2114,562,1050,286,585,299,1537,35 4,211,2560,401,185,1104,396,344,586,645,2059,1061,593,535,240,206,1049,95,2088,32 7,564,1046,800,402,356,307,2116,1160,301,417,213,568,1284,832,2178,588,186,1288,6 46,404,227,896,2067,1062,594,418,302,1538,649,771,2061,360,539,1120,111,331,214,1 091,2096,309,188,449,1065,217,408,2062,609,596,1168,551,650,229,1052,2120,159,42 0,310,1093,541,773,2305,610,1066,657,333,119,1540,3073,600,339,218,1073,368,652,2 30,2069,1098,391,313,450,1296,542,2180,334,233,1184,555,774,175,2083,1544,123,65 8,612,1312,2306,341,777,220,1552,314,424,2074,395,1216,673,583,355,1568,2561,287, 183,234,1094,125,557,2128,660,1068,616,342,316,2085,1155,241,778,1105,563,345,20 73,452,1074,397,403,207,2070,1097,674,558,1039,785,432,2184,357,1344,187,236,664, 2308,1157,624,587,1076,780,2312,705,126,1047,242,565,1158,2086,398,346,456,1408, 358,2562,405,1100,303,569,244,2144,1161,595,189,1106,566,2115,676,361,1080,706,5 89,2089,1051,215,786,647,1121,2192,348,419,1063,406,464,2076,680,1283,801,362,11 08,2117,590,409,1162,570,2090,788,597,1169,572,219,2564,1285,311,708,1053,598,20 97,601,1067,651,421,3074,792,1122,802,611,1539,2122,602,410,1112,231,688,2320,11 64,653,248,1054,2208,369,190,364,1170,654,2568,659,1095,335,480,2336,1286,315,22 1,1289,2576,370,613,1185,422,425,2240,1600,451,614,1069,2592,543,235,1124,412,21 18,343,372,1664,775,317,2092,1075,222,426,1172,2179,453,237,1070,559,2129,833,10 99,804,712,2098,1290,834,661,1297,2121,808,779,1541,617,1128,2063,604,433,1186,7 20,2368,816,1077,836,347,2181,1217,897,243,1176,2100,662,454,1101,318,3076,675,1 188,618,898,2071,1792,781,376,2182,1292,428,1298,665,2432,736,1542,567,840,2124, 1078,625,238,1107,2185,359,457,1081,399,2130,787,1545,591,1136,2104,678,434,1159 ,2075,677,349,1102,245,2145,458,1313,666,1218,2087,620,363,1109,2307,127,191,130 0,782,2132,1546,407,436,1082,2186,626,571,1192,2193,465,1163,681,246,2309,1123,7 07,350,3080,1110,599,1084,668,2077,790,1304,460,2091,249,1113,682,1314,2146,573, 411,1553,2563,803,789,1548,709,2136,1220,365,440,2188,1165,628,1125,689,2078,374 ,1171,423,2194,466,1200,793,2119,1166,250,371,1554,2310,481,1345,574,2313,413,10 55,603,2209,1224,366,468,1114,2624,655,1569,900,2093,805,1316,615,3088,1346,684, 710,2148,1556,429,1287,2688,794,252,1173,373,2099,1126,605,848,2196,1129,690,132 8,2094,713,1320,632,2123,482,1187,806,2314,1116,427,904,2321,1071,414,1291,2565, 223,663,1409,2152,692,1570,835,2210,1348,619,472,2101,1232,455,1410,2241,796,809 ,1174,3104,714,1177,721,2200,1189,837,716,2125,1130,864,1079,2212,810,1352,606,2 816,912,1560,722,2316,1601,696,1572,2322,377,435,1137,2566,817,1178,319,2102,110 3,621,1293,2131,812,484,1132,2105,430,1602,838,2569,1248,667,3075,488,1190,239,2 160,1543,378,1576,2183,459,1219,622,2126,627,1294,437,2337,1665,380,2242,1547,81 8,1299,2133,461,496,1604,2324,669,1315,2570,679,1083,724,2106,1193,841,629,2216, 1584,351,1138,3077,467,1301,2187,438,1180,737,2147,1111,251,1221,2134,462,442,21 08,1140,441,1194,2328,469,1085,2137,247,1555,683,2338,1549,842,1666,2577,738,899, 2572,1305,670,1302,2244,783,1550,3136,849,1201,820,2189,1317,728,2149,1412,928, 1115,2195,791,367,2224,1608,901,1793,2190,630,1222,2578,685,1196,844,2369,1144,6 33,2079,1225,711,1360,2248,253,1086,3081,691,1306,824,2138,1167,902,2593,1127,68 6,740,2340,1202,850,2370,1318,375,2580,1117,444,1668,2311,470,1226,2197,483,1616, 415,2150,1347,485,2153,1416,905,3078,1321,795,1794,2352,473,1131,2344,634,1204, 2211,744,1175,852,2140,1233,960,2095,1308,865,2315,1672,693,2433,1118,797,1228,2 594,906,1322,2372,715,1424,3089,807,1632,474,2256,1376,636,2434,1349,694,2198,15 57,254,2201,1179,717,2213,1234,575,1329,2154,913,1571,2103,798,1324,3082,811,113 3,2376,379,1208,2584,697,1558,431,2625,607,489,2596,1561,866,2161,1139,723,2202, 1191,486,2127,1249,908,2317,1350,718,1330,3090,813,1796,2156,476,1181,2626,856,1 680,2272,839,1353,2214,725,1134,2567,698,1141,2600,914,1236,2243,752,1195,3200,8 68,1800,2318,819,1354,2689,814,1250,439,2571,1573,929,2323,1562,490,2628,1411,62 3,2339,1332,671,2107,1240,739,3084,1440,916,2217,1295,463,2608,1303,843,2162,118 2,381,2325,1361,497,2204,1574,930,2135,1696,821,2245,1142,726,3105,1356,1603,216 4,961,2218,1564,872,2109,1413,492,2579,1197,631,2573,1145,729,2690,1577,700,2329, 1223,443,3137,1808,741,2326,1203,845,2574,1252,920,2225,1362,382,2341,1336,822, 2436,1728,2139,1414,851,3092,1198,730,2632,1578,498,2817,1605,880,2246,1417,742, 2220,1307,445,2168,1146,2249,471,1472,2384,1377,635,3328,1585,932,2110,1227,687, 2330,1087,903,2191,1364,2151,825,1418,2226,500,1551,2342,1606,846,3106,1580,745, 2141,1205,2692,826,1319,2250,732,1309,2640,446,1256,2371,1148,3096,962,1229,244 0,936,1206,2345,475,1667,2818,853,2155,1586,867,2228,1310,1609,2199,637,1323,310 8,907,2257,1378,487,2332,1235,695,2696,1425,2142,1209,746,2252,1420,828,2346,136 8,3079,753,1610,2448,854,1669,2656,1617,2400,857,1559,2373,504,1264,2581,799,320 1,1230,1119,2203,255,1351,2258,964,2353,1588,909,2595,1824,719,2348,1426,3138,13 80,477,2157,1331,915,2232,1325,2582,638,1441,2585,1237,2163,748,1592,2215,944,18 56,3584,869,2273,1612,1210,2374,491,2354,1670,699,2820,1428,1251,2205,754,3083,1 920,858,2704,1618,2377,478,1442,2158,1326,968,2165,1673,2260,383,1795,3112,910,2 219,1384,1563,2824,815,2378,1135,976,2274,1355,2597,1238,870,3140,1333,2586,917, 1212,2435,1473,2356,727,1241,2264,493,3202,1432,873,2464,1633,2319,1620,701,232 7,1575,2206,931,1674,2385,1253,3091,756,1183,2598,860,2720,1444,1334,2166,499,23 80,1565,731,2627,1797,3085,1634,823,2588,1681,2437,922,1357,2221,1143,2169,874,1 624,3120,918,2601,1363,2247,1242,502,2832,1392,2227,933,1676,3086,1254,2276,743, 1415,2386,1337,2360,760,2752,1474,881,2438,1566,3144,1358,494,2222,1257,2602,70 2,2629,1579,1798,2441,921,3329,1199,501,2331,1147,2170,1682,2496,876,1636,2401,1 365,3093,847,1801,2609,992,2251,1244,2111,1338,447,2388,1448,3204,1419,2442,733, 1697,2575,827,2630,1607,2604,1379,934,2229,1311,3107,1207,2343,882,1258,2333,93 7,2280,1149,2172,1581,963,3330,1684,2253,1640,2230,747,1366,2691,505,2610,1340,3 098,1265,855,2334,1802,2633,1587,2347,924,3585,1369,734,2402,1476,2259,1421,244 9,829,1427,2233,1231,3152,965,2444,1698,2392,1582,938,2634,1809,2693,1456,3109,8 84,1381,2641,506,2583,1211,2288,1260,2254,749,1688,3097,1648,2143,945,2375,1611, 2612,1804,966,3094,1729,2848,1150,2450,755,2404,1266,859,2355,1589,3208,1422,23 49,940,2465,1370,2261,1480,830,2616,1382,3332,1429,2880,911,2636,1327,1593,2234, 871,3336,1268,2694,1619,2452,639,2275,1213,1590,2944,888,3110,1700,2642,1385,24 66,479,2350,1730,3586,1613,946,2697,1239,2819,750,2408,1810,2587,1671,3168,969,2 159,1372,1443,2379,508,2262,1430,3139,1488,2357,861,2236,1704,2497,1825,757,311 3,1386,2265,1614,2456,970,2657,1433,2644,1594,3216,919,2599,1812,1621,2698,1596, 2277,875,3100,1243,2207,1335,2468,862,2358,1732,3141,1622,2589,758,1625,2821,16 75,2658,948,3114,1445,2705,1816,2381,977,2167,1826,3588,1635,2648,923,2387,1626, 2266,1434,972,3121,1255,2416,1712,2700,761,2278,1677,3146,1272,2439,877,2361,13 93,2498,1214,3344,1388,2590,952,2382,1678,2281,1683,495,3232,1359,2603,1504,282 2,703,2223,1339,3592,1245,2171,935,2706,1394,2660,1637,3360,978,2389,1446,2825,1 449,2268,1475,3600,883,2362,1638,2472,1567,2443,762,3264,1259,2721,1436,2631,50 3,2403,1367,3616,1396,2335,925,2231,1799,2282,1341,3142,1246,2173,878,2605,1450, 2708,1477,3116,735,2664,1261,2390,1583,2364,1857,3203,993,2289,1828,2826,1736,3 153,885,2611,1858,2393,1685,2500,939,3122,1832,2445,1803,2451,1641,2255,994,314 5,1628,2722,1457,2606,980,3087,1744,2833,1840,2480,1860,2405,926,3392,1371,2235, 1921,2284,764,2712,1267,3205,1686,2672,1478,2635,941,3124,1342,2828,1699,2753,9 67,2174,1642,3095,1922,2290,1805,2613,886,1400,1452,3206,831,2446,1689,2394,176 0,2504,1591,3456,947,2406,1864,2453,1649,3148,507,2351,1262,2617,1383,2292,1481, 3209,889,2643,1423,2237,1811,3154,1615,2614,984,2724,1702,2409,1458,3128,751,27 54,1701,2637,1373,3099,1269,2263,942,2834,1482,2695,1690,3169,1644,2396,996,246 7,1387,3111,1151,2454,1215,2512,971,2728,1806,3331,1431,2849,890,2410,1460,3156, 1650,2638,1595,2457,509,3210,1489,2618,1705,2836,1270,2645,949,3217,1731,2620,1 374,2267,1623,3333,973,2359,1692,2756,1814,3101,1484,2646,1000,2649,1273,3115,1 706,2699,1597,2469,892,2840,1435,3170,1827,2850,1813,2659,950,3587,1733,2650,13 89,2458,1464,3160,863,2279,2736,1652,3212,1713,2701,1398,2296,759,3102,1447,241 7,1490,2238,1817,2412,1008,3218,1274,2702,1395,2707,1505,3143,510,2383,1598,252 8,3334,1437,2363,1627,2269,979,3337,1390,2418,1492,2661,1679,3233,953,2470,1924, 2473,1829,3648,1639,2499,2662,763,3117,1708,2591,1734,2283,1453,3172,974,2460,1 818,2391,1276,2420,1397,3712,2823,1629,2365,954,3123,1872,2270,1714,2474,1737,3 220,879,2501,1656,2285,3118,1506,2607,1830,2881,981,3147,1451,2852,1928,2760,14 38,3338,2882,982,2709,1247,3345,1687,2856,1716,2827,1859,3589,927,2665,3176,164 3,2652,1496,2481,1479,3234,995,2768,1820,2864,1833,3125,2884,1738,2395,1745,326 5,765,2945,1861,2291,3224,1740,2710,1888,2502,956,3149,1834,2366,1630,2723,3236, 1936,2666,1746,2946,887,3840,1720,2829,1401,2424,3340,1459,2476,1841,3346,985,2 713,1343,2784,3590,1645,2615,1836,2888,997,3126,1508,2673,2286,1454,3155,1862,2 407,1691,2505,986,3129,2447,1512,2835,1263,3593,1402,2639,3184,1483,2726,943,24 82,1646,3207,1651,2725,2397,1461,3150,1404,2293,891,2506,3361,1842,2714,1485,32 66,1520,2668,1693,2411,3157,998,2175,1703,2239,1748,3348,2830,1865,3594,766,245 5,1653,2484,3130,1375,2674,1491,2619,1462,3240,2513,511,3211,1761,2729,1275,229 4,3171,1486,2755,1466,2398,1465,3158,2647,988,3132,1493,2716,1271,2838,3352,170 7,2508,1866,2297,3161,1001,2730,1762,3362,1923,2621,2459,1694,3601,1807,2851,95 1,2837,3596,1873,2757,1844,3268,2413,1752,2488,1952,3213,1002,2676,3173,1815,27 37,1391,2422,3219,1925,2471,1654,2514,1709,3248,2841,893,3214,1868,2298,2419,16 57,3602,1735,2529,3393,1277,2622,975,2461,1715,3103,2651,1848,3272,1926,2414,25 16,1710,3162,894,2703,3617,1764,2948,1874,2853,3364,1399,2663,1468,3394,2732,14 94,2758,1009,3604,2477,1507,3335,1439,2842,2300,1509,3221,1929,2421,3174,1819,2 653,955,2896,3177,1497,2738,1658,3376,2761,1768,3368,1876,2680,2530,1984,3235,1 004,2854,3164,1889,2475,1717,2952,3119,1821,2462,1930,3339,2271,1010,2711,1739, 3457,2740,1831,3618,2883,1498,3396,1660,2667,2520,1718,3280,957,2503,3458,1278, 2844,1741,2857,3222,1599,2762,3225,1937,2769,1822,3237,2885,983,2764,1835,3178, 2912,1403,3127,2858,1721,3400,1455,2654,2960,1631,3608,1513,2770,3649,958,2744, 3620,1890,2425,1747,2483,3185,1510,2865,3226,1932,2367,1742,3151,2669,987,3341, 2860,1837,2532,1500,3180,2478,1880,3650,2886,1863,3296,1749,2715,2536,1012,3238, 2287,1722,3591,1938,2426,3624,1776,2507,3267,1892,2670,1843,2675,3342,1838,248 5,3713,999,2428,1463,3595,2866,1953,3347,2509,1514,2544,3652,1647,2717,1695,336 3,2727,1763,3131,2772,1016,3241,2889,1940,2677,1487,3632,2399,1867,3186,2515,14 05,3349,2486,1521,3228,2785,767,3159,1954,2299,3269,1845,2510,2490,1750,3188,24 89,1985,3242,1896,2517,3133,1516,2295,3603,1655,2731,3597,989,2890,3714,1753,27 86,2947,1724,3353,1467,2718,3350,1765,2831,3598,1869,2897,3249,1944,2868,3365,1 003,2776,3460,1406,2976,3163,1846,2839,1875,2415,3656,1754,2949,3841,1522,2678, 3270,1904,2733,3244,990,2892,3192,1766,2681,3273,1469,2759,3408,1495,2301,3134, 1659,2739,3354,1956,2872,3215,1711,2950,3175,1927,2734,1005,2788,3250,1849,2898, 3366,1524,2423,3165,1870,2492,3716,1769,2518,3274,1850,2531,3664,1756,2463,339 5,1470,2533,3464,959,2953,3369,1986,2843,3842,1960,2521,3179,1499,2682,3252,187 7,2792,3223,1891,2900,3281,3008,1661,3356,2913,1931,3720,2741,1011,3166,2845,15 11,3276,2954,1719,3370,2763,1770,3472,2855,1852,3680,2522,1777,3424,2684,1878,3 397,2742,1881,3605,2302,1013,3227,2765,1528,3282,2623,3377,1823,2961,3619,1279, 2846,3372,1988,2859,3181,1933,2427,3256,1743,2745,3606,1501,2479,2655,2537,1939, 3609,2914,895,3187,2771,1662,3239,2534,1772,3297,2956,1968,3398,2766,3378,1893, 2861,3844,1515,2524,3229,1723,2904,3728,1778,2887,3401,1882,2773,3182,2746,1006, 3189,2962,1502,3284,2800,1992,3243,2916,3848,1407,2867,3402,1934,2862,3298,183 9,2487,3621,2000,2977,3610,2538,1894,3459,2671,1941,3380,2719,1014,3288,2787,34 88,1751,2964,3343,1517,2511,3351,2891,1897,3230,2429,1725,3409,2545,1955,3622,2 978,3744,1780,2869,3190,1884,2774,3404,1523,3651,3009,3612,1755,2920,3461,1017, 2540,3245,2679,1847,3193,2777,1946,3625,2748,3271,1898,2491,3856,1942,2789,3251, 2893,1526,3300,2968,1957,3410,2430,3384,1767,2870,3776,1784,3462,2899,3246,190 5,2778,3626,1018,2546,3653,2928,1518,3465,2790,1726,3355,2493,3194,1945,2519,35 20,1525,3425,2683,3633,1900,2980,3275,2735,1871,3135,2951,2016,3412,2873,3466,1 471,2548,3599,1757,3654,2894,3628,1851,2793,3253,2874,991,3367,2780,1958,3357,2 494,3304,1906,3196,3010,3277,1961,2984,3254,2523,1987,3715,2901,1771,3634,2915, 3358,1529,3657,2685,3371,1879,2955,3426,2535,1948,3283,2743,1758,3473,3257,2794, 1853,3468,2876,3416,1020,2801,3658,2902,1989,3717,3665,1962,2905,3607,2552,190 8,3312,2847,3278,1530,3167,2303,3399,1773,3012,3636,2957,1969,3872,2767,3474,19 90,3428,2525,3379,1779,2963,3373,2686,1883,3489,3285,2796,1964,3640,2992,3904,1 854,2917,3660,3258,1935,2539,3718,2747,1007,3476,3299,2802,1895,3968,2906,3666, 1663,2526,3490,3374,1912,3016,3721,2431,1503,3843,2958,3432,1970,3611,2863,3183, 1774,3024,3403,3286,1993,2918,3381,2965,1532,3260,3521,2775,1885,3289,2541,348 0,1781,2921,3681,3668,1994,2749,3623,2979,3722,1943,3301,2804,3231,1015,2908,34 92,3382,1899,2547,3613,2779,1886,3845,3682,2871,3729,1782,2970,3405,3191,1972,2 922,3672,2966,2001,3411,3290,2550,1947,3440,2981,3724,3302,1996,2791,3463,3385, 1785,2808,3522,2929,1901,3614,3406,2542,3305,1976,2750,3627,3846,1519,2969,3247, 2549,3195,1727,3730,2924,3684,1959,3413,2895,3849,3040,2002,3292,3386,2495,101 9,3496,3467,2781,3745,1907,2875,3655,3427,1786,2982,3359,3255,2930,1527,3306,29 85,3197,1949,3629,3011,3732,3688,1902,2795,3414,2553,3388,1759,3313,2903,3850,2 017,3635,2972,3417,2782,1909,3524,3469,2877,3475,1963,3279,3013,3746,2018,3630, 2986,3857,3504,2004,2932,3429,2554,3259,1950,3308,2797,3736,3696,1788,2993,3659, 3852,3014,1965,3777,3198,2803,3314,1991,2907,3637,3470,2988,1021,3418,3528,287 8,1910,3430,3477,2959,3375,1855,3641,2919,3316,3667,1971,2687,3261,3638,2936,15 31,3748,3433,2527,3778,1913,3661,2994,3287,2798,3858,2008,3719,3017,3420,3491,1 775,2556,3478,3536,2909,1966,3752,3873,2805,3434,2020,3662,3018,3481,3642,1995, 2967,3860,3669,3644,2923,1914,3291,3383,2910,3780,1533,3670,2806,3673,3723,1973, 2996,3493,3864,3025,3874,1997,3683,2971,3674,3482,2024,3020,3303,3760,2809,191 6,3725,3320,2925,3441,3262,1974,3436,3000,3726,3731,1887,2543,3407,3552,2751,33 87,1783,3293,2983,3442,3685,3026,1022,3494,3497,3523,2931,2032,3686,3615,2810,3 307,3484,1534,2551,3415,3444,2973,3847,2003,3389,3294,2926,3498,3525,1977,2783, 3309,3631,3905,1787,3041,3876,3784,2933,3906,1998,3733,2987,3880,3851,3689,1978, 3042,3676,3505,3028,3792,1903,3888,3908,2974,3419,3969,2005,2812,3315,3734,352 6,2989,2006,3390,3747,3015,3690,3970,1951,3853,2934,3448,3500,2879,3737,2019,38 08,3639,2995,3912,3697,1789,2555,3310,3431,3529,2937,1980,3471,3859,3663,3032,3 750,3506,1911,2799,3749,3421,3317,2990,2009,3530,3738,3692,3044,3435,3199,2021, 3263,3019,3854,3479,2938,2010,3508,3698,3643,2557,3537,3753,1967,3318,2997,3779, 3422,3671,3021,1915,3740,3862,3532,3048,3321,3754,2022,3645,2940,3483,3875,386 1,1790,2998,3781,3437,3512,2911,3700,1535,3761,3446,2807,3495,3538,3865,3056,10 23,3322,3443,3553,2558,3646,3485,2012,3675,3027,3438,3540,3727,3001,2025,3972,3 877,3687,2811,3756,3782,1975,3501,3022,3866,3324,3445,3677,3002,2026,3920,3762, 3785,2927,3704,3554,1917,3878,3029,3499,3976,3486,3030,3295,1999,3735,3764,3907, 2975,3691,3544,3527,1918,3043,3868,3881,3786,3793,2813,3909,2033,3788,3936,300 4,3882,3678,3984,3794,1979,2935,3768,3449,3507,3889,3033,3391,2028,3693,3884,30 45,3556,3502,3910,3739,2034,3034,3560,3311,3450,3531,2991,3694,1981,3699,3509,3 452,2939,3890,3533,3568,3741,2007,3046,3751,3796,3913,2814,3701,3423,3539,1982, 3510,2559,3809,3323,3534,3514,3513,2011,3036,3541,3319,3755,3914,3049,3810,3971, 3742,2036,3855,2999,3921,3892,3800,4000,3050,3863,2023,3439,3973,3702,3757,294 1,3916,3705,3783,2040,3325,3023,3763,3896,3974,3758,2942,3812,3922,1791,3447,35 16,3542,3057,3555,3487,3557,3977,3867,2013,3003,3545,3706,3816,3924,4032,3052,3 937,3765,2027,3869,3978,3058,3787,3879,3546,3708,3766,3005,2014,3326,3789,3647, 3985,3870,3031,3883,3451,3769,3503,2029,3679,3561,3006,3938,3795,3558,3980,3790, 3035,3885,1983,3548,3928,3911,3797,3060,3770,3986,3824,3940,3891,2035,3886,304 7,3511,4001,3562,3695,3743,3811,3064,3988,3535,2037,3915,3453,3569,2815,4002,38 93,3798,4033,3944,3564,3703,1919,3037,3801,3772,3515,3813,3917,3992,3051,3454,3 894,3923,3802,2030,3570,3952,3038,3814,3517,3543,3707,4004,3759,3975,3053,3897, 2038,3572,3918,3817,3898,3804,3518,3007,4034,4008,3547,3925,3939,2041,3709,3979, 3059,3559,3767,3818,3900,3825,3926,3929,3061,3576,3871,3327,2042,4036,3981,379 1,3549,3987,2943,3710,3820,4016,3941,3563,3771,3826,3930,2015,3054,3550,4040,34 55,3982,3887,4048,3942,3989,3062,3799,3565,3945,3773,4003,2044,3828,3932,3571,3 803,3065,3895,3994,3946,3990,3574,4005,3815,3832,3953,3066,3566,2031,3774,3993, 3573,3948,3919,4064,3519,3805,3899,3039,4006,3954,4009,4035,3819,3577,3927,2039, 3996,3806,3901,3068,4037,4010,3956,3578,3821,4017,4038,3827,3931,4012,3902,398 3,3055,3943,3711,3960,2043,3551,4018,3822,4041,3580,3933,3829,4042,3991,3063,39 47,3934,3830,4020,4049,3995,4044,3833,3949,4024,3567,2045,3775,4007,4050,3067,3 955,3834,3575,3997,3950,3807,4065,3957,4011,4066,4052,3998,3836,4013,4039,3069, 3958,3903,4019,3579,3961,2046,4056,3823,4014,4068,4043,3962,3581,4021,4045,4072, 3964,4022,3935,3831,3070,4080,3582,4051,4025,3835,4046,4026,3951,4053,4054,399 9,4067,3837,4028,3959,4057,4069,2047,4058,4015,3963,4070,3838,3583,3071,4060,40 73,4023,4074,3965,4047,3966,4081,4027,4076,4082,4029,4055,4030,4059,4084,4071,4 088,3839,4061,4075,4062,4077,4031,4083,4085,3967,4078,4086,4089,4090,4063,4092, 4079,4087,4091,4093,4094,4095];
wobei die Sequenz Q3 gegeben ist durch:
[0,1,2,4,8,16,32,3,5,64,1024,9,6,17,10,18,128,12,33,65,20,256,34,24,36,7,129,66,512,11, 40,68,130,19,13,48,14,72,257,1025,21,132,35,258,26,513,80,37,25,22,136,260,264,38,5 14,96,67,41,144,28,69,42,516,49,1026,74,272,160,520,288,528,192,544,70,44,131,81,50, 73,15,320,133,52,1028,23,134,384,76,137,82,56,27,97,39,259,84,138,145,261,1032,29, 43,98,515,88,140,30,146,71,262,265,161,576,45,1040,100,640,51,148,46,75,266,273,51 7,104,162,53,193,1056,152,77,164,768,268,274,518,54,83,57,521,1027,112,135,78,289, 194,85,276,522,58,168,1029,139,99,86,60,280,89,290,529,524,196,1088,141,101,147,17 6,142,530,321,31,200,1033,90,545,292,322,532,263,149,102,105,1030,304,296,163,92,4 7,267,385,546,324,1041,208,386,150,153,165,106,55,1034,328,536,577,548,113,154,79, 269,1042,108,578,224,166,519,552,195,1152,270,641,523,275,580,291,59,1036,169,560, 114,277,156,87,197,1057,116,170,61,531,525,642,281,1089,278,526,177,293,388,91,10 44,584,769,198,172,120,201,336,1280,62,282,143,103,178,294,1058,93,644,202,592,32 3,1048,392,297,770,107,180,151,1060,209,284,648,94,204,298,1031,400,608,352,325,5 33,1153,155,210,305,547,300,1090,109,184,534,537,115,167,1536,225,326,306,772,157, 1035,656,329,110,117,212,1064,171,776,330,226,549,1092,538,387,308,216,1154,416, 271,279,158,337,1043,550,672,118,332,579,1037,540,389,173,121,1072,553,199,784,17 9,1038,228,338,312,704,390,1096,174,554,581,393,1281,283,122,448,353,1045,561,203, 63,340,1156,394,527,582,556,181,1059,295,285,232,124,1282,205,182,643,562,1050,2 86,585,299,1537,354,211,401,185,1104,396,344,586,645,1061,593,535,240,206,1049,95, 327,564,1046,800,402,356,307,1160,301,417,213,568,1284,832,588,186,1288,646,404, 227,896,1062,594,418,302,1538,649,771,360,539,1120,111,331,214,1091,309,188,449,1 065,217,408,609,596,1168,551,650,229,1052,159,420,310,1093,541,773,610,1066,657,3 33,119,1540,600,339,218,1073,368,652,230,1098,391,313,450,1296,542,334,233,1184,5 55,774,175,1544,123,658,612,1312,341,777,220,1552,314,424,395,1216,673,583,355,15 68,287,183,234,1094,125,557,660,1068,616,342,316,1155,241,778,1105,563,345,452,10 74,397,403,207,1097,674,558,1039,785,432,357,1344,187,236,664,1157,624,587,1076,7 80,705,126,1047,242,565,1158,398,346,456,1408,358,405,1100,303,569,244,1161,595,1 89,1106,566,676,361,1080,706,589,1051,215,786,647,1121,348,419,1063,406,464,680,1 283,801,362,1108,590,409,1162,570,788,597,1169,572,219,1285,311,708,1053,598,601, 1067,651,421,792,1122,802,611,1539,602,410,1112,231,688,1164,653,248,1054,369,19 0,364,1170,654,659,1095,335,480,1286,315,221,1289,370,613,1185,422,425,1600,451,6 14,1069,543,235,1124,412,343,372,1664,775,317,1075,222,426,1172,453,237,1070,559, 833,1099,804,712,1290,834,661,1297,808,779,1541,617,1128,604,433,1186,720,816,10 77,836,347,1217,897,243,1176,662,454,1101,318,675,1188,618,898,1792,781,376,1292, 428,1298,665,736,1542,567,840,1078,625,238,1107,359,457,1081,399,787,1545,591,11 36,678,434,1159,677,349,1102,245,458,1313,666,1218,620,363,1109,127,191,1300,782, 1546,407,436,1082,626,571,1192,465,1163,681,246,1123,707,350,1110,599,1084,668,7 90,1304,460,249,1113,682,1314,573,411,1553,803,789,1548,709,1220,365,440,1165,62 8,1125,689,374,1171,423,466,1200,793,1166,250,371,1554,481,1345,574,413,1055,603, 1224,366,468,1114,655,1569,900,805,1316,615,1346,684,710,1556,429,1287,794,252,1 173,373,1126,605,848,1129,690,1328,713,1320,632,482,1187,806,1116,427,904,1071,4 14,1291,223,663,1409,692,1570,835,1348,619,472,1232,455,1410,796,809,1174,714,11 77,721,1189,837,716,1130,864,1079,810,1352,606,912,1560,722,1601,696,1572,377,43 5,1137,817,1178,319,1103,621,1293,812,484,1132,430,1602,838,1248,667,488,1190,23 9,1543,378,1576,459,1219,622,627,1294,437,1665,380,1547,818,1299,461,496,1604,66 9,1315,679,1083,724,1193,841,629,1584,351,1138,467,1301,438,1180,737,1111,251,12 21,462,442,1140,441,1194,469,1085,247,1555,683,1549,842,1666,738,899,1305,670,13 02,783,1550,849,1201,820,1317,728,1412,928,1115,791,367,1608,901,1793,630,1222,6 85,1196,844,1144,633,1225,711,1360,253,1086,691,1306,824,1167,902,1127,686,740,1 202,850,1318,375,1117,444,1668,470,1226,483,1616,415,1347,485,1416,905,1321,795, 1794,473,1131,634,1204,744,1175,852,1233,960,1308,865,1672,693,1118,797,1228,906, 1322,715,1424,807,1632,474,1376,636,1349,694,1557,254,1179,717,1234,575,1329,91 3,1571,798,1324,811,1133,379,1208,697,1558,431,607,489,1561,866,1139,723,1191,48 6,1249,908,1350,718,1330,813,1796,476,1181,856,1680,839,1353,725,1134,698,1141,9 14,1236,752,1195,868,1800,819,1354,814,1250,439,1573,929,1562,490,1411,623,1332, 671,1240,739,1440,916,1295,463,1303,843,1182,381,1361,497,1574,930,1696,821,1142, 726,1356,1603,961,1564,872,1413,492,1197,631,1145,729,1577,700,1223,443,1808,74 1,1203,845,1252,920,1362,382,1336,822,1728,1414,851,1198,730,1578,498,1605,880,1 417,742,1307,445,1146,471,1472,1377,635,1585,932,1227,687,1087,903,1364,825,1418, 500,1551,1606,846,1580,745,1205,826,1319,732,1309,446,1256,1148,962,1229,936,12 06,475,1667,853,1586,867,1310,1609,637,1323,907,1378,487,1235,695,1425,1209,746, 1420,828,1368,753,1610,854,1669,1617,857,1559,504,1264,799,1230,1119,255,1351,96 4,1588,909,1824,719,1426,1380,477,1331,915,1325,638,1441,1237,748,1592,944,1856, 869,1612,1210,491,1670,699,1428,1251,754,1920,858,1618,478,1442,1326,968,1673,38 3,1795,910,1384,1563,815,1135,976,1355,1238,870,1333,917,1212,1473,727,1241,493, 1432,873,1633,1620,701,1575,931,1674,1253,756,1183,860,1444,1334,499,1565,731,17 97,1634,823,1681,922,1357,1143,874,1624,918,1363,1242,502,1392,933,1676,1254,743, 1415,1337,760,1474,881,1566,1358,494,1257,702,1579,1798,921,1199,501,1147,1682, 876,1636,1365,847,1801,992,1244,1338,447,1448,1419,733,1697,827,1607,1379,934,13 11,1207,882,1258,937,1149,1581,963,1684,1640,747,1366,505,1340,1265,855,1802,158 7,924,1369,734,1476,1421,829,1427,1231,965,1698,1582,938,1809,1456,884,1381,506, 1211,1260,749,1688,1648,945,1611,1804,966,1729,1150,755,1266,859,1589,1422,940,1 370,1480,830,1382,1429,911,1327,1593,871,1268,1619,639,1213,1590,888,1700,1385,4 79,1730,1613,946,1239,750,1810,1671,969,1372,1443,508,1430,1488,861,1704,1825,75 7,1386,1614,970,1433,1594,919,1812,1621,1596,875,1243,1335,862,1732,1622,758,162 5,1675,948,1445,1816,977,1826,1635,923,1626,1434,972,1255,1712,761,1677,1272,877, 1393,1214,1388,952,1678,1683,495,1359,1504,703,1339,1245,935,1394,1637,978,1446, 1449,1475,883,1638,1567,762,1259,1436,503,1367,1396,925,1799,1341,1246,878,1450, 1477,735,1261,1583,1857,993,1828,1736,885,1858,1685,939,1832,1803,1641,994,1628, 1457,980,1744,1840,1860,926,1371,1921,764,1267,1686,1478,941,1342,1699,967,1642, 1922,1805,886,1400,1452,831,1689,1760,1591,947,1864,1649,507,1262,1383,1481,889, 1423,1811,1615,984,1702,1458,751,1701,1373,1269,942,1482,1690,1644,996,1387,115 1,1215,971,1806,1431,890,1460,1650,1595,509,1489,1705,1270,949,1731,1374,1623,97 3,1692,1814,1484,1000,1273,1706,1597,892,1435,1827,1813,950,1733,1389,1464,863,1 652,1713,1398,759,1447,1490,1817,1008,1274,1395,1505,510,1598,1437,1627,979,139 0,1492,1679,953,1924,1829,1639,763,1708,1734,1453,974,1818,1276,1397,1629,954,18 72,1714,1737,879,1656,1506,1830,981,1451,1928,1438,982,1247,1687,1716,1859,927,1 643,1496,1479,995,1820,1833,1738,1745,765,1861,1740,1888,956,1834,1630,1936,174 6,887,1720,1401,1459,1841,985,1343,1645,1836,997,1508,1454,1862,1691,986,1512,12 63,1402,1483,943,1646,1651,1461,1404,891,1842,1485,1520,1693,998,1703,1748,1865, 766,1653,1375,1491,1462,511,1761,1275,1486,1466,1465,988,1493,1271,1707,1866,10 01,1762,1923,1694,1807,951,1873,1844,1752,1952,1002,1815,1391,1925,1654,1709,89 3,1868,1657,1735,1277,975,1715,1848,1926,1710,894,1764,1874,1399,1468,1494,1009, 1507,1439,1509,1929,1819,955,1497,1658,1768,1876,1984,1004,1889,1717,1821,1930, 1010,1739,1831,1498,1660,1718,957,1278,1741,1599,1937,1822,983,1835,1403,1721,1 455,1631,1513,958,1890,1747,1510,1932,1742,987,1837,1500,1880,1863,1749,1012,17 22,1938,1776,1892,1843,1838,999,1463,1953,1514,1647,1695,1763,1016,1940,1487,18 67,1405,1521,767,1954,1845,1750,1985,1896,1516,1655,989,1753,1724,1467,1765,186 9,1944,1003,1406,1846,1875,1754,1522,1904,990,1766,1469,1495,1659,1956,1711,192 7,1005,1849,1524,1870,1769,1850,1756,1470,959,1986,1960,1499,1877,1891,1661,193 1,1011,1511,1719,1770,1852,1777,1878,1881,1013,1528,1823,1279,1988,1933,1743,15 01,1939,895,1662,1772,1968,1893,1515,1723,1778,1882,1006,1502,1992,1407,1934,18 39,2000,1894,1941,1014,1751,1517,1897,1725,1955,1780,1884,1523,1755,1017,1847,1 946,1898,1942,1526,1957,1767,1784,1905,1018,1518,1726,1945,1525,1900,1871,2016, 1471,1757,1851,991,1958,1906,1961,1987,1771,1529,1879,1948,1758,1853,1020,1989, 1962,1908,1530,1773,1969,1990,1779,1883,1964,1854,1935,1007,1895,1663,1912,1503, 1970,1774,1993,1532,1885,1781,1994,1943,1015,1899,1886,1782,1972,2001,1947,199 6,1785,1901,1976,1519,1727,1959,2002,1019,1907,1786,1527,1949,1902,1759,2017,19 09,1963,2018,2004,1950,1788,1965,1991,1021,1910,1855,1971,1531,1913,2008,1775,1 966,2020,1995,1914,1533,1973,1997,2024,1916,1974,1887,1783,1022,2032,1534,2003, 1977,1787,1998,1978,1903,2005,2006,1951,2019,1789,1980,1911,2009,2021,2010,1967, 1915,2022,1790,1535,1023,2012,2025,1975,2026,1917,1999,1918,2033,1979,2028,203 4,1981,2007,1982,2011,2036,2023,2040,1791,2013,2027,2014,2029,1983,2035,2037,19 19,2030,2038,2041,2042,2015,2044,2031,2039,2043,2045,2046,2047];
wobei die Sequenznummern von N polarisierten Kanälen in der zweiten Sequenz in aufsteigender Reihenfolge der Zuverlässigkeit der N polarisierten Kanäle angeordnet sind, und ein Minimumwert der Sequenznummern der polarisierten Kanäle 0 ist; oder
die zweite Sequenz ein Teil oder die gesamte Sequenz Z1, eine Sequenz Z2 oder eine Sequenz Z3 ist;
wobei die Sequenz Z1 gegeben ist durch:
[0,1,2,7,3,8,14,27,4,13,16,31,19,36,38,84,5,15,17,35,22,42,52,89,25,51,46,97,63,106,113, 182,6,20,24,44,26,50,57,99,32,61,65,107,78,120,126,201,37,67,82,124,87,135,145,215, 96,147,160,243,166,257,281,408,9,21,29,60,33,64,77,115,39,83,69,127,92,139,153,224, 49,80,95,146,101,156,165,251,111,168,186,269,200,288,307,454,59,98,109,164,122,176, 194,284,133,195,214,299,227,325,343,494,150,222,247,330,254,344,371,528,275,378,4 02,556,423,581,627,877,18,28,34,79,43,86,90,151,54,94,102,163,112,175,179,283,62,10 3,114,177,125,193,211,301,138,212,223,319,249,339,364,516,71,118,134,199,140,213,2 30,331,161,245,255,347,274,377,394,553,178,266,285,385,300,417,426,578,327,440,47 5,615,501,649,725,878,75,136,155,233,173,252,273,382,183,277,291,407,308,425,452,6 03,208,304,320,437,345,468,496,662,358,504,533,690,564,738,767,1022,229,334,352,4 79,387,513,538,715,422,548,579,755,616,773,842,1103,451,592,630,809,645,865,897,1 175,720,914,951,1160,990,1235,1333,1678,23,40,45,100,55,104,116,192,56,117,129,20 2,142,225,236,362,70,130,143,240,157,248,263,363,167,261,282,400,305,421,432,577,7 3,154,169,242,188,267,286,420,198,297,309,434,323,466,486,643,197,321,336,463,357, 500,518,694,389,542,566,737,589,764,816,1081,85,181,190,293,206,316,335,456,217,3 42,351,495,372,527,547,733,279,365,388,532,409,562,588,760,443,597,635,805,667,86 2,901,1147,313,404,436,574,462,613,638,845,491,655,677,874,726,931,966,1211,535,7 24,742,952,761,992,940,1257,826,1074,1107,1355,1121,1459,1518,1755,91,203,209,35 6,268,376,392,541,295,397,412,569,442,601,634,849,311,439,461,602,478,641,670,884, 505,682,713,921,757,960,1019,1270,361,467,484,668,517,703,745,943,567,746,769,101 4,830,985,1092,1361,611,797,858,1075,885,1117,1154,1426,932,1168,1165,1503,1260, 1547,1599,1928,403,502,543,750,599,772,814,1037,636,847,867,1110,912,1128,1163,1 452,672,893,945,1150,967,1172,1264,1552,1034,1284,1322,1613,1390,1696,1745,2117, 734,955,1008,1267,1089,1273,1376,1634,1101,1365,1433,1725,1488,1791,1886,2269,1 129,1463,1535,1824,1577,1902,1857,2323,1667,1977,2030,2480,2145,2568,2678,3005, 30,48,58,110,66,131,144,231,72,148,159,239,172,259,264,413,74,170,180,258,191,317, 328,450,218,329,355,492,375,520,545,754,76,187,204,322,220,353,368,510,232,381,39 5,551,416,582,608,775,246,406,430,595,457,631,652,836,469,644,684,890,689,920,957, 1340,119,219,228,373,241,396,414,572,271,433,445,622,474,658,680,853,292,449,483, 648,508,687,697,905,531,699,712,962,796,996,1062,1363,312,507,523,708,558,743,751, 977,587,792,820,1033,873,1084,1112,1437,621,841,889,1115,936,1143,1218,1492,100 6,1228,1288,1557,1326,1626,1705,2102,123,238,260,427,289,446,477,664,306,488,511, 702,536,719,728,970,341,526,557,731,585,785,813,1023,617,832,869,1098,907,1133,11 90,1441,369,571,606,818,654,861,857,1136,674,895,916,1178,981,1222,1248,1564,716, 938,1000,1239,1027,1305,1329,1638,1070,1358,1405,1729,1499,1802,1892,2278,391,6 26,657,900,695,928,982,1231,781,1004,1046,1316,1053,1336,1383,1689,799,1048,1067, 1372,1138,1401,1474,1788,1203,1495,1532,1828,1595,1936,1996,2352,834,1156,1185, 1445,1249,1507,1543,1869,1292,1586,1644,1973,1711,2038,2130,2512,1412,1653,1736, 2060,1814,2160,2203,2654,1876,2243,2315,2718,2421,2834,2985,3484,141,272,298,48 9,337,521,552,763,349,563,593,790,624,825,881,1193,383,610,663,851,686,925,909,12 10,705,947,989,1281,1041,1309,1347,1671,460,676,707,924,780,975,1011,1319,789,10 42,1060,1351,1088,1387,1424,1765,801,1078,1124,1420,1199,1471,1522,1835,1241,15 73,1591,1940,1648,2004,2079,2459,471,778,784,1029,804,1051,1095,1398,837,1142,11 81,1456,1224,1510,1582,1917,997,1197,1253,1528,1294,1616,1657,1984,1394,1663,17 39,2064,1818,2153,2195,2640,1056,1301,1368,1620,1416,1719,1776,2094,1484,1795,1 847,2187,1910,2251,2343,2760,1539,1880,1954,2306,2026,2372,2453,2866,2109,2491, 2557,2952,2616,3109,3149,3832,480,808,822,1186,972,1215,1245,1568,1015,1277,131 2,1630,1379,1685,1759,2087,1064,1344,1409,1699,1448,1781,1851,2177,1514,1898,18 40,2227,1992,2332,2413,2803,1206,1430,1467,1807,1561,1862,1946,2286,1609,1958,2 018,2381,2072,2433,2524,2934,1715,2045,2124,2471,2210,2580,2628,3065,2262,2704, 2747,3199,2848,3272,3331,3683,1298,1481,1605,1965,1681,2011,2052,2442,1750,2138, 2169,2548,2234,2592,2730,3129,1769,2219,2295,2692,2401,2774,2787,3300,2503,288 3,2915,3359,3027,3524,3596,4162,1921,2364,2392,2817,2536,2897,2971,3420,2604,30 47,3085,3560,3225,3639,3888,4347,2666,3174,3247,3730,3387,3776,3946,4458,3454,4 014,4085,4599,4244,4770,5021,5420,10,41,68,149,88,162,196,310,105,184,216,340,244, 374,386,609,121,207,226,366,270,405,459,628,294,453,431,660,514,696,722,961,137,2 53,287,418,302,448,482,669,346,503,525,700,586,752,774,1018,379,534,600,766,623,8 02,840,1057,656,848,886,1137,906,1173,1236,1567,174,262,324,497,354,519,580,732,3 93,605,540,779,642,815,864,1083,441,594,651,843,678,875,904,1159,714,915,968,1207, 1013,1259,1307,1675,493,665,706,899,756,937,994,1247,793,999,1055,1286,1090,135 2,1403,1768,854,1076,1148,1371,1167,1406,1473,1844,1227,1494,1549,1905,1602,196 1,2057,2542,235,318,360,591,411,620,632,859,465,647,683,894,718,934,949,1243,509, 688,727,941,770,991,1043,1293,810,1047,1080,1335,1155,1392,1458,1815,550,744,798, 1010,819,1050,1102,1374,891,1141,1169,1414,1223,1490,1530,1901,946,1198,1252,15 09,1289,1588,1610,1952,1356,1643,1723,2033,1782,2105,2257,2545,570,807,870,1111, 930,1161,1219,1502,964,1230,1265,1563,1310,1606,1674,2008,1036,1296,1339,1637,1 410,1708,1775,2127,1443,1789,1856,2189,1924,2284,2341,2791,1097,1378,1425,1733, 1513,1811,1866,2237,1600,1889,1956,2318,2035,2355,2483,2923,1669,1982,2062,2424, 2097,2521,2577,3034,2248,2607,2669,3011,2736,3126,3278,3795,280,398,424,675,470, 693,736,986,476,739,783,1020,828,1085,1116,1451,544,787,831,1125,880,1151,1191,1 454,910,1188,1240,1546,1300,1596,1623,1949,559,868,917,1134,976,1201,1255,1592,1 005,1279,1313,1628,1349,1702,1749,2090,1001,1341,1384,1698,1440,1778,1822,2192, 1520,1873,1926,2281,1980,2338,2436,2886,614,956,979,1272,1032,1328,1382,1679,10 61,1399,1421,1772,1477,1841,1885,2272,1233,1462,1517,1853,1571,1914,1974,2326,1 651,1995,2075,2416,2141,2518,2586,2993,1324,1556,1633,1945,1694,2027,2082,2486, 1762,2115,2163,2539,2260,2634,2695,3093,1860,2254,2289,2672,2329,2740,2651,3163, 2455,2872,2926,3309,2948,3473,3565,3908,637,1025,1039,1436,1205,1487,1527,1870, 1276,1542,1575,1933,1647,2001,2069,2494,1317,1641,1692,2005,1732,2084,2148,2554, 1794,2171,2233,2619,2321,2686,2783,3183,1447,1706,1746,2142,1820,2213,2298,265 7,1930,2301,2346,2777,2456,2727,2905,3317,2023,2398,2509,2877,2559,2945,3000,34 24,2637,3023,3019,3538,3166,3607,3678,4140,1553,1785,1878,2303,1999,2349,2430,2 814,2078,2489,2527,2931,2601,2960,3016,3463,2151,2571,2660,2997,2698,3031,3171, 3613,2811,3205,3261,3700,3367,3818,3894,4381,2275,2675,2767,3179,2900,3188,3345, 3736,2920,3326,3434,3863,3513,3960,4093,4559,2963,3479,3585,4000,3650,4111,405 0,4630,3782,4206,4274,4814,4414,4914,5049,5398,332,435,487,709,529,791,835,1105, 555,852,883,1123,926,1180,1194,1578,565,922,953,1176,984,1332,1360,1665,1066,136 7,1432,1763,1483,1827,1882,2312,575,971,1028,1345,1071,1428,1466,1805,1108,1498, 1534,1894,1585,1964,2016,2358,1146,1559,1619,1989,1684,2067,2106,2468,1712,2091, 2174,2565,2184,2613,2681,3286,748,1069,1094,1478,1130,1538,1581,1942,1213,1624, 1655,2047,1721,2123,2166,2500,1269,1661,1742,2099,1801,2181,2201,2589,1848,2205, 2230,2689,2395,2744,2855,3322,1321,1798,1833,2224,1912,2292,2309,2713,1970,238 9,2445,2808,2533,2891,2937,3440,2042,2477,2562,2940,2645,2988,3101,3518,2763,31 18,3208,3618,3264,3719,3838,4364,762,1120,1182,1614,1261,1658,1728,2135,1304,17 52,1809,2208,1864,2245,2265,2701,1395,1837,1908,2268,1968,2378,2427,2794,2039,2 462,2530,2912,2595,2966,3058,3443,1469,1937,2014,2439,2112,2515,2506,2974,2156, 2574,2610,3039,2721,3104,3146,3629,2240,2648,2753,3133,2797,3233,3269,3742,2869 3314,3392,3869,3534,3974,4097,4570,1524,2054,2120,2583,2198,2631,2724,3121,236 9,2757,2828,3250,2842,3281,3354,3812,2404,2831,2863,3340,2977,3381,3498,3954,30 78,3529,3580,4008,3672,4146,4228,4661,2465,3008,3050,3448,3154,3543,3602,4065,3 213,3661,3747,4198,3843,4282,4397,4852,3401,3759,3875,4306,3988,4431,4486,5006, 4071,4531,4619,5091,4736,5218,5378,5901,824,1216,1282,1756,1388,1831,1896,2335, 1417,1918,1987,2387,2050,2450,2551,3062,1505,2020,2133,2497,2180,2625,2598,3090, 2216,2663,2733,3196,2820,3238,3295,3789,1688,2159,2222,2622,2366,2710,2770,325 5,2384,2823,2852,3303,2894,3364,3415,3920,2407,2880,2956,3410,3073,3493,3571,40 22,3138,3644,3667,4154,3753,4236,4331,4791,1716,2361,2375,2800,2410,2837,2908,3 378,2474,2982,3042,3468,3113,3549,3655,4127,2750,3070,3158,3574,3216,3706,3765, 4214,3373,3770,3880,4315,3994,4422,4475,4992,2845,3230,3336,3711,3406,3857,3934, 4356,3507,3967,4036,4467,4119,4540,4650,5137,3591,4079,4176,4610,4266,4681,477 9,5253,4372,4826,4902,5342,4965,5524,5571,6216,1738,2418,2448,3053,2707,3098,31 41,3635,2780,3191,3242,3725,3350,3807,3914,4339,2859,3291,3395,3826,3459,3940,4 042,4450,3554,4105,4028,4512,4222,4639,4724,5184,3081,3429,3488,3980,3624,4056, 4168,4579,3695,4184,4258,4692,4323,4747,4864,5323,3849,4290,4389,4802,4494,4926, 4979,5480,4551,5079,5122,5619,5234,5693,5750,6084,3221,3504,3689,4192,3801,425 2,4298,4758,3900,4406,4439,4887,4522,4940,5107,5547,3926,4503,4590,5064,4713,51 53,5169,5721,4840,5269,5304,5776,5440,5935,6005,6505,4133,4670,4701,5202,4875,5 288,5362,5837,4952,5460,5504,5970,5644,6044,6268,6660,5034,5595,5668,6125,5808, 6170,6320,6752,5867,6374,6438,6866,6579,6995,7168,7433,11,47,81,189,108,205,265, 410,132,250,290,447,326,490,506,794,152,278,303,481,359,539,604,823,390,598,568,8 60,673,908,939,1229,171,338,380,554,401,590,633,872,455,659,685,913,765,974,1003, 1299,498,698,782,993,811,1035,1082,1346,856,1091,1140,1442,1166,1485,1562,1925,2 21,348,428,653,464,679,759,948,515,788,710,1007,839,1054,1114,1377,583,776,850,10 87,882,1127,1162,1468,929,1174,1242,1525,1295,1587,1642,2043,646,866,918,1157,98 3,1204,1271,1572,1026,1275,1343,1618,1389,1697,1747,2139,1104,1369,1457,1710,14 79,1751,1823,2220,1548,1845,1906,2285,1962,2342,2443,2972,314,419,473,771,546,80 6,827,1109,612,844,888,1153,933,1200,1217,1569,666,892,944,1209,998,1266,1330,16 25,1049,1334,1373,1676,1464,1734,1806,2191,723,963,1030,1290,1058,1338,1400,171 4,1144,1449,1482,1760,1544,1843,1888,2279,1212,1515,1576,1861,1621,1948,1972,23 33,1701,2007,2093,2417,2155,2496,2662,2976,747,1040,1122,1411,1192,1472,1541,18 55,1234,1551,1593,1922,1646,1969,2037,2391,1323,1632,1680,2000,1754,2076,2146,2 522,1790,2164,2231,2588,2302,2691,2752,3245,1396,1720,1771,2104,1868,2185,2244, 2642,1960,2267,2336,2726,2420,2764,2904,3390,2034,2365,2449,2839,2487,2950,3013, 3515,2653,3044,3114,3489,3186,3615,3774,4278,370,522,560,876,619,898,954,1263,6 25,959,1012,1302,1068,1380,1419,1799,717,1017,1073,1431,1131,1461,1508,1803,117 0,1500,1566,1904,1635,1957,1985,2331,735,1118,1179,1438,1251,1519,1580,1953,128 7,1611,1649,1991,1690,2071,2119,2481,1283,1683,1727,2065,1786,2152,2196,2594,18 74,2253,2308,2687,2359,2746,2853,3352,800,1225,1254,1601,1315,1666,1724,2046,13 54,1743,1767,2144,1826,2217,2264,2680,1554,1810,1872,2229,1929,2296,2356,2735,2 015,2376,2464,2830,2534,2943,3021,3466,1662,1913,1997,2325,2061,2411,2472,2910, 2131,2508,2558,2968,2665,3076,3143,3576,2238,2659,2697,3116,2738,3193,3095,3652, 2874,3338,3397,3809,3422,3972,4061,4378,833,1306,1327,1784,1523,1839,1881,2250, 1607,1897,1934,2313,2012,2385,2461,2918,1656,2003,2058,2388,2101,2475,2543,2987, 2167,2567,2636,3057,2732,3131,3240,3674,1797,2073,2116,2537,2194,2615,2706,309, 9,2311,2709,2755,3232,2878,3178,3371,3820,2408,2812,2936,3341,2990,3417,3477,39 22,3080,3502,3497,4038,3657,4101,4172,4596,1909,2157,2255,2715,2379,2761,2847,3 274,2467,2913,2953,3402,3040,3432,3495,3962,2546,3003,3103,3472,3144,3509,3663, 4107,3267,3696,3757,4190,3865,4302,4366,4821,2683,3123,3220,3668,3366,3680,3841, 4220,3385,3824,3932,4341,4016,4427,4546,4994,3436,3978,4087,4469,4142,4566,450 9,5051,4264,4656,4720,5221,4854,5315,5432,5756,438,576,639,923,692,1021,1077,140 4,729,1096,1135,1427,1187,1493,1512,1938,741,1184,1221,1489,1258,1670,1703,2031, 1357,1707,1780,2134,1836,2202,2261,2723,753,1246,1311,1687,1366,1773,1816,2178, 1407,1852,1890,2274,1944,2345,2400,2769,1453,1919,1978,2374,2049,2452,2502,2893, 2080,2484,2573,2998,2585,3055,3128,3786,969,1362,1393,1829,1435,1893,1941,2322, 1533,1988,2019,2431,2088,2517,2564,2928,1597,2028,2113,2493,2173,2579,2603,3026, 2226,2606,2633,3136,2809,3198,3319,3822,1660,2170,2209,2627,2291,2700,2717,316 4,2353,2805,2861,3266,2964,3357,3408,3938,2429,2902,2995,3411,3086,3461,3587,40 20,3218,3604,3702,4115,3763,4210,4312,4805,988,1422,1497,1976,1590,2022,2098,25 28,1639,2126,2182,2612,2241,2650,2671,3151,1741,2215,2288,2674,2348,2789,2844,3 249,2423,2885,2958,3383,3032,3441,3540,3944,1819,2319,2397,2856,2505,2942,2932, 3447,2549,3010,3049,3520,3169,3593,3637,4125,2643,3091,3206,3620,3254,3728,3768, 4226,3333,3814,3886,4345,4032,4441,4553,5001,1877,2440,2514,3018,2597,3071,317 3,3609,2781,3211,3288,3746,3302,3780,3853,4294,2819,3293,3327,3836,3452,3882,39 96,4420,3562,4026,4081,4473,4166,4605,4679,5081,2888,3482,3531,3950,3641,4044,4 096,4525,3708,4156,4234,4652,4321,4729,4835,5256,3898,4246,4354,4754,4454,4871, 4918,5406,4533,4962,5041,5472,5156,5589,5737,6185,1063,1537,1615,2128,1730,2206, 2277,2743,1764,2299,2368,2798,2437,2870,2980,3545,1858,2405,2525,2921,2576,306 7,3036,3573,2618,3108,3184,3691,3279,3734,3797,4270,2056,2555,2624,3063,2778,31 59,3227,3751,2795,3283,3312,3803,3362,3859,3916,4393,2822,3347,3427,3910,3556,3 990,4067,4482,3626,4136,4160,4612,4240,4688,4777,5197,2086,2772,2786,3259,2826, 3298,3376,3877,2896,3457,3525,3966,3598,4048,4150,4583,3201,3551,3646,4075,3713, 4196,4250,4665,3871,4260,4360,4761,4460,4861,4909,5392,3307,3723,3830,4202,390 4,4333,4408,4795,4010,4433,4497,4899,4575,4972,5071,5515,4091,4538,4627,5031,47 15,5102,5189,5622,4812,5232,5301,5706,5367,5854,5891,6465,2108,2836,2864,3533,3 156,3582,3631,4131,3235,3685,3740,4216,3847,4288,4385,4786,3321,3791,3892,4308, 3956,4412,4501,4890,4054,4561,4488,4945,4674,5059,5145,5559,3567,3928,3984,4446, 4121,4516,4621,5011,4186,4634,4706,5112,4768,5166,5266,5687,4327,4738,4830,521 0,4928,5329,5381,5814,4984,5457,5501,5939,5604,6001,6055,6349,3717,4004,4180,46 43,4284,4697,4745,5176,4374,4845,4880,5293,4955,5340,5486,5874,4399,4935,5019,5 446,5132,5530,5542,6026,5245,5638,5671,6077,5779,6220,6280,6711,4588,5094,5125, 5574,5280,5653,5725,6132,5353,5795,5831,6248,5959,6312,6509,6843,5418,5915,5980, 6387,6102,6421,6551,6923,6159,6602,6651,7020,6773,7126,7280,7500,237,530,704,11 00,817,1149,1278,1652,902,1237,1350,1737,1446,1832,1865,2402,978,1318,1385,1812, 1529,1916,2053,2446,1604,2041,1981,2519,2188,2600,2656,3134,1044,1476,1583,1950, 1629,2024,2110,2540,1758,2162,2212,2609,2351,2720,2766,3237,1849,2236,2382,274 9,2434,2825,2899,3310,2511,2916,2992,3450,3029,3511,3617,4129,1195,1504,1693,21 49,1777,2199,2339,2677,1884,2394,2247,2775,2478,2850,2947,3355,2009,2371,2499,2 907,2561,2969,3024,3486,2639,3045,3148,3569,3228,3654,3732,4276,2137,2531,2621, 3014,2729,3088,3194,3633,2806,3203,3305,3698,3369,3805,3884,4395,2929,3343,3470, 3834,3500,3890,3992,4492,3600,4024,4103,4568,4178,4636,4752,5285,1415,1672,179 3,2362,1932,2426,2458,2939,2068,2490,2570,3006,2647,3083,3111,3628,2175,2582,26 68,3096,2758,3189,3284,3710,2841,3290,3348,3778,3480,3867,3970,4456,2271,2703,2 815,3223,2858,3296,3388,3839,3001,3455,3506,3902,3594,4018,4077,4564,3106,3553, 3642,4046,3704,4158,4188,4625,3811,4232,4337,4722,4416,4807,4977,5290,2316,2833, 2961,3404,3075,3491,3589,4034,3139,3605,3665,4123,3738,4182,4272,4695,3271,371 5,3784,4224,3896,4319,4403,4833,3948,4424,4507,4904,4592,5009,5069,5545,3380,38 45,3918,4352,4052,4452,4520,4957,4174,4548,4632,5044,4726,5084,5224,5678,4268,4 663,4756,5158,4798,5264,5326,5785,4969,5356,5423,5763,5492,5871,6008,6434,1558, 1900,1966,2552,2083,2591,2684,3181,2095,2694,2784,3243,2875,3360,3413,3958,2258, 2792,2881,3431,2979,3475,3542,3964,3037,3536,3622,4099,3721,4170,4204,4623,229 4,2955,3052,3445,3161,3558,3648,4164,3215,3687,3744,4212,3799,4310,4370,4788,32 10,3787,3855,4304,3942,4410,4465,4906,4063,4529,4594,5004,4659,5066,5171,5641,2 414,3124,3168,3676,3262,3766,3851,4280,3315,3878,3912,4401,3998,4490,4544,4996, 3611,3976,4059,4505,4134,4581,4654,5054,4242,4677,4772,5148,4847,5261,5334,5744, 3761,4113,4218,4616,4300,4717,4782,5226,4387,4819,4873,5282,4982,5387,5449,584 1,4514,4974,5014,5426,5056,5495,5403,5904,5192,5628,5681,6033,5703,6178,6252,65 23,2469,3252,3276,3936,3563,4012,4073,4527,3681,4095,4138,4603,4238,4686,4765,5 237,3749,4230,4296,4690,4349,4784,4856,5299,4429,4883,4950,5370,5046,5437,5539, 5921,3952,4317,4368,4849,4462,4931,5024,5409,4601,5026,5074,5533,5195,5483,5659, 6041,4710,5130,5250,5632,5307,5699,5753,6136,5389,5772,5769,6232,5908,6288,634 5,6695,4109,4418,4535,5029,4683,5076,5163,5568,4775,5229,5272,5684,5351,5712,57 66,6166,4859,5318,5412,5747,5452,5782,5911,6292,5565,5942,5991,6361,6088,6456,6 514,6871,4999,5429,5521,5918,5656,5925,6066,6391,5675,6051,6144,6487,6208,6560, 6656,6989,5715,6181,6272,6593,6324,6675,6626,7040,6425,6741,6794,7153,6894,7218, 7296,7490,1717,1993,2121,2630,2223,2801,2889,3394,2282,2924,2984,3425,3068,352 2,3547,4144,2305,3060,3119,3516,3176,3772,3816,4262,3324,3828,3930,4391,4006,44 71,4542,5039,2328,3153,3257,3793,3334,3924,3982,4443,3399,4030,4083,4555,4152,4 641,4704,5086,3464,4117,4200,4672,4286,4763,4809,5208,4325,4793,4885,5312,4897, 5364,5435,6016,2712,3329,3374,4002,3438,4089,4148,4614,3578,4208,4248,4740,4335, 4828,4878,5242,3670,4256,4362,4800,4437,4894,4916,5337,4499,4921,4947,5443,512 7,5498,5610,6048,3755,4435,4480,4943,4577,5016,5036,5469,4647,5120,5179,5562,52 77,5647,5690,6147,4733,5216,5309,5696,5395,5740,5847,6212,5518,5861,5945,6296,5 994,6378,6469,6854,2741,3418,3527,4194,3659,4254,4343,4842,3727,4376,4448,4923, 4518,4967,4987,5454,3873,4484,4572,4989,4645,5109,5161,5550,4731,5200,5274,5665, 5345,5718,5805,6151,3986,4608,4699,5174,4816,5258,5248,5728,4866,5320,5359,578 8,5475,5851,5888,6304,4960,5401,5509,5877,5553,5966,5998,6395,5625,6037,6106,64 91,6228,6569,6665,7002,4069,4749,4823,5331,4911,5384,5477,5864,5099,5512,5583,5 984,5598,6012,6073,6451,5135,5586,5616,6062,5731,6099,6197,6555,5824,6224,6264, 6597,6341,6700,6762,7059,5205,5760,5798,6155,5894,6236,6284,6636,5949,6332,6400, 6736,6473,6800,6883,7182,6114,6408,6496,6816,6583,6906,6941,7272,6641,6971,703 3,7320,7105,7388,7480,7719,2867,3583,3693,4383,3861,4477,4557,5061,3906,4585,46 68,5117,4742,5187,5296,5811,4040,4708,4838,5240,4892,5376,5348,5834,4933,5415,5 489,5932,5577,5973,6023,6430,4292,4868,4938,5373,5097,5466,5527,5987,5114,5580, 5607,6030,5650,6080,6128,6532,5140,5635,5709,6121,5821,6193,6256,6607,5881,6316, 6337,6705,6404,6768,6832,7139,4329,5089,5104,5556,5143,5592,5662,6095,5213,573 4,5792,6174,5857,6240,6328,6685,5506,5818,5898,6260,5952,6366,6412,6747,6091,64 17,6500,6821,6588,6900,6935,7264,5601,5963,6059,6370,6117,6482,6541,6849,6205,6 564,6617,6929,6680,6977,7052,7345,6276,6646,6721,7027,6789,7072,7132,7405,6860, 7160,7211,7461,7249,7552,7573,7841,4358,5150,5182,5801,5463,5844,5884,6308,5536, 5928,5977,6383,6069,6447,6528,6838,5613,6019,6110,6460,6162,6546,6621,6917,624 4,6670,6612,6959,6757,7046,7098,7370,5828,6140,6189,6574,6300,6631,6716,7008,63 57,6726,6784,7078,6827,7112,7189,7451,6478,6805,6877,7146,6947,7226,7256,7530,6 983,7312,7336,7595,7396,7630,7654,7792,5956,6201,6353,6731,6443,6778,6810,7119, 6518,6888,6912,7204,6965,7233,7328,7562,6537,6953,7014,7304,7092,7353,7362,7642, 7175,7414,7442,7667,7510,7733,7762,7936,6690,7065,7085,7379,7196,7424,7470,769 2,7241,7520,7541,7747,7607,7776,7858,7981,7288,7584,7618,7808,7680,7824,7876,80 06,7706,7895,7915,8033,7957,8064,8098,8138,12,53,93,234,128,256,350,537,158,333,3 84,584,429,640,661,1038,185,367,399,629,472,701,795,1072,512,786,740,1119,879,117 7,1220,1579,210,444,499,721,524,777,829,1132,596,863,896,1183,995,1262,1297,1664, 650,911,1024,1285,1059,1342,1397,1722,1113,1408,1470,1838,1501,1891,1983,2406,2 76,458,561,855,607,887,987,1232,671,1031,927,1303,1093,1364,1439,1761,768,1009,1 106,1402,1145,1455,1496,1871,1208,1511,1594,1939,1659,2010,2077,2541,846,1126,1 196,1491,1274,1550,1631,1994,1331,1636,1718,2048,1774,2140,2200,2652,1423,1753, 1854,2158,1883,2204,2290,2742,1963,2314,2386,2816,2451,2879,2991,3530,415,549,6 18,1002,711,1052,1079,1429,803,1099,1152,1486,1214,1545,1565,1990,871,1158,1226, 1555,1291,1627,1704,2055,1359,1709,1757,2118,1863,2186,2270,2711,942,1250,1337, 1654,1370,1713,1787,2161,1475,1846,1887,2214,1959,2310,2363,2807,1560,1927,1998, 2334,2051,2432,2460,2871,2147,2501,2599,2962,2670,3043,3214,3532,973,1348,1450, 1800,1536,1875,1955,2327,1584,1967,2021,2403,2081,2457,2535,2933,1695,2066,2122, 2492,2207,2581,2658,3072,2249,2679,2756,3137,2835,3244,3306,3802,1783,2168,222 8,2611,2340,2702,2768,3192,2447,2796,2873,3280,2965,3318,3460,3943,2532,2906,29 96,3393,3033,3505,3568,4064,3204,3601,3671,4039,3743,4167,4328,4836,485,681,730, 1139,812,1164,1238,1622,821,1244,1308,1668,1381,1766,1808,2263,935,1314,1386,18 25,1460,1859,1915,2266,1506,1907,1986,2380,2070,2444,2476,2868,958,1444,1516,18 34,1603,1931,2002,2441,1650,2040,2085,2482,2132,2575,2629,3028,1645,2125,2176,2 566,2246,2667,2716,3145,2347,2779,2840,3241,2898,3299,3407,3905,1045,1574,1612, 2029,1686,2107,2172,2547,1731,2197,2225,2655,2293,2739,2793,3231,1975,2273,2344, 2754,2409,2829,2895,3289,2510,2917,3009,3384,3084,3501,3577,4017,2100,2393,248 8,2860,2563,2957,3017,3467,2644,3056,3107,3523,3217,3634,3699,4126,2762,3212,32 51,3673,3292,3748,3651,4203,3428,3893,3949,4363,3973,4524,4611,4939,1086,1673,1 700,2242,1935,2307,2357,2776,2036,2373,2419,2849,2507,2927,3007,3474,2092,2498, 2560,2930,2608,3022,3092,3544,2682,3117,3187,3614,3285,3688,3796,4225,2259,2578, 2626,3087,2714,3165,3258,3656,2843,3260,3308,3788,3435,3735,3925,4373,2951,336 8,3492,3895,3546,3968,4029,4474,3636,4053,4047,4589,4209,4653,4727,5157,2390,26 73,2782,3268,2922,3316,3403,3829,3012,3469,3510,3955,3597,3985,4045,4513,3094,3 561,3660,4023,3701,4058,4215,4660,3823,4249,4311,4746,4419,4860,4925,5380,3234, 3679,3777,4221,3919,4231,4396,4776,3939,4379,4485,4900,4567,4986,5106,5548,3987, 4530,4637,5028,4696,5126,5070,5605,4822,5217,5279,5764,5411,5850,5954,6239,573, 758,838,1202,903,1320,1391,1792,950,1413,1465,1821,1531,1899,1920,2422,965,1521, 1570,1895,1617,2111,2150,2529,1735,2154,2239,2646,2304,2722,2788,3277,980,1598, 1677,2129,1744,2232,2280,2696,1796,2324,2367,2802,2428,2882,2944,3323,1850,2399, 2470,2914,2550,2999,3048,3449,2584,3030,3122,3555,3135,3612,3684,4340,1256,174 0,1779,2297,1830,2370,2425,2857,1947,2479,2513,2978,2596,3064,3115,3483,2025,25 26,2623,3041,2690,3130,3152,3584,2751,3157,3185,3692,3365,3754,3872,4377,2096,2 688,2731,3177,2821,3253,3270,3720,2892,3358,3416,3821,3521,3911,3959,4491,2975, 3458,3552,3963,3643,4011,4139,4573,3773,4155,4255,4667,4316,4766,4872,5363,1280, 1817,1903,2463,2013,2516,2605,3077,2074,2635,2699,3162,2765,3202,3222,3707,219 3,2737,2818,3226,2887,3344,3400,3804,2967,3439,3514,3935,3588,3993,4088,4496,22 83,2854,2941,3412,3054,3499,3490,3999,3100,3566,3606,4068,3726,4145,4189,4678,3 195,3647,3762,4173,3810,4283,4322,4781,3887,4369,4442,4905,4584,5000,5113,5557, 2354,2989,3061,3575,3147,3627,3729,4161,3335,3769,3844,4301,3856,4334,4407,4851, 3372,3848,3881,4390,4003,4436,4547,4981,4112,4578,4631,5033,4721,5167,5239,563 4,3444,4033,4080,4502,4191,4595,4648,5085,4261,4709,4790,5212,4881,5289,5394,57 96,4453,4803,4913,5314,5015,5428,5476,5931,5093,5519,5596,5990,5705,6094,6223,6 606,1375,1951,2044,2638,2179,2725,2804,3297,2221,2832,2909,3353,2983,3426,3537, 4094,2330,2949,3074,3478,3127,3623,3592,4124,3170,3664,3741,4243,3835,4289,4351, 4827,2556,3105,3175,3621,3332,3716,3781,4307,3351,3837,3868,4357,3917,4413,447 0,4953,3377,3901,3979,4464,4106,4541,4617,5042,4177,4691,4716,5172,4796,5249,53 36,5743,2590,3328,3342,3815,3382,3854,3929,4430,3451,4009,4074,4519,4149,4600,4 703,5144,3756,4102,4197,4626,4265,4751,4808,5225,4425,4817,4919,5319,5020,5421, 5467,5919,3862,4277,4384,4757,4459,4891,4966,5354,4562,4991,5057,5458,5136,5528, 5626,6028,4642,5098,5190,5587,5275,5655,5738,6122,5371,5775,5839,6195,5896,632 5,6356,6839,2614,3391,3419,4082,3712,4132,4183,4684,3790,4237,4295,4771,4402,48 46,4944,5346,3876,4346,4447,4865,4508,4973,5062,5447,4606,5121,5048,5502,5235,5 614,5697,6067,4118,4479,4536,5007,4673,5077,5180,5566,4741,5194,5265,5664,5328, 5717,5807,6180,4886,5297,5388,5755,5484,5862,5907,6289,5540,5978,6017,6396,6107, 6452,6495,6743,4271,4556,4735,5203,4841,5257,5305,5726,4932,5404,5438,5830,551 0,5873,6002,6340,4958,5493,5575,5967,5685,6040,6053,6472,5787,6137,6164,6516,62 58,6634,6684,7039,5149,5646,5676,6079,5819,6149,6211,6561,5885,6274,6305,6659,6 415,6713,6874,7148,5943,6376,6432,6774,6536,6803,6909,7209,6585,6950,6992,7284, 7088,7371,7488,7655,296,691,919,1418,1065,1480,1640,2089,1171,1589,1726,2190,18 42,2300,2337,2946,1268,1691,1770,2276,1943,2396,2553,2994,2032,2538,2473,3069,2 705,3150,3207,3690,1353,1879,2006,2435,2059,2523,2620,3089,2211,2676,2734,3160, 2890,3273,3320,3794,2317,2759,2925,3304,2981,3379,3456,3864,3059,3471,3548,4001, 3586,4060,4169,4682,1540,1911,2136,2661,2235,2719,2876,3229,2360,2938,2773,333 0,3025,3405,3503,3909,2504,2911,3046,3462,3110,3526,3581,4037,3190,3603,3703,41 20,3785,4207,4287,4832,2649,3079,3172,3572,3282,3645,3752,4187,3361,3760,3860,4 251,3921,4359,4438,4956,3485,3897,4019,4388,4051,4444,4545,5053,4153,4576,4657, 5129,4732,5198,5311,5825,1804,2114,2256,2903,2415,2973,3002,3494,2572,3038,3120, 3564,3200,3640,3669,4181,2693,3132,3219,3653,3311,3745,3840,4263,3396,3846,390 3,4332,4031,4421,4523,5017,2799,3256,3370,3779,3414,3852,3941,4394,3557,4007,40 55,4455,4147,4571,4629,5124,3662,4104,4195,4598,4257,4712,4743,5186,4365,4789,4 896,5283,4975,5366,5534,5827,2851,3389,3517,3957,3632,4041,4141,4587,3697,4159, 4217,4676,4291,4737,4831,5254,3827,4269,4338,4780,4449,4877,4964,5391,4500,4983, 5068,5461,5152,5563,5623,6056,3933,4400,4472,4910,4604,5012,5082,5513,4728,511 0,5191,5599,5286,5637,5767,6171,4824,5223,5317,5708,5357,5804,5859,6263,5525,58 87,5946,6245,6007,6338,6455,6815,1979,2377,2454,3102,2587,3142,3239,3737,2602,3 246,3339,3798,3433,3913,3965,4511,2785,3346,3437,3981,3535,4025,4090,4517,3595, 4086,4175,4651,4275,4723,4760,5183,2824,3512,3608,3995,3718,4110,4201,4718,3771, 4241,4297,4767,4353,4869,4930,5349,3764,4342,4409,4863,4495,4970,5025,5464,461 5,5090,5155,5560,5220,5620,5720,6139,2959,3682,3724,4229,3819,4320,4405,4837,38 70,4432,4466,4961,4550,5050,5105,5551,4163,4528,4609,5065,4687,5141,5214,5608,4 799,5238,5332,5700,5407,5802,5868,6230,4314,4666,4774,5178,4858,5276,5339,5770, 4948,5377,5431,5822,5537,5913,5969,6311,5073,5531,5569,5948,5611,6010,5929,6367, 5739,6127,6173,6479,6192,6599,6663,6886,3015,3806,3831,4489,4116,4565,4624,508 7,4235,4646,4693,5164,4794,5246,5325,5778,4303,4785,4855,5251,4908,5343,5414,58 36,4990,5441,5508,5899,5602,5961,6049,6382,4506,4874,4927,5408,5023,5487,5578,5 934,5160,5581,5629,6043,5741,5999,6156,6485,5271,5682,5793,6131,5842,6190,6235, 6563,5916,6254,6251,6644,6369,6692,6739,7026,4662,4978,5096,5584,5243,5631,5714, 6076,5335,5773,5810,6177,5882,6202,6249,6591,5417,5853,5937,6233,5972,6261,637 3,6696,6074,6399,6442,6754,6522,6830,6878,7166,5554,5951,6035,6380,6152,6386,65 06,6777,6168,6492,6571,6858,6627,6918,6997,7263,6204,6603,6677,6942,6720,7009,6 972,7300,6807,7066,7106,7392,7185,7439,7501,7646,2165,2485,2632,3180,2745,3356, 3446,3947,2813,3481,3541,3977,3625,4072,4098,4698,2838,3616,3675,4066,3733,4326, 4371,4818,3879,4382,4483,4949,4560,5032,5101,5593,2862,3709,3813,4348,3889,447 8,4534,5003,3951,4582,4635,5116,4707,5201,5263,5640,4015,4671,4755,5231,4844,53 22,5368,5752,4882,5350,5444,5848,5455,5893,5957,6462,3265,3885,3927,4552,3989,4 640,4702,5175,4130,4762,4804,5300,4895,5386,5434,5784,4223,4813,4922,5360,4998, 5451,5473,5870,5058,5478,5505,5964,5679,6014,6112,6489,4309,4995,5040,5499,5138, 5572,5590,5986,5209,5673,5729,6071,5816,6143,6183,6575,5294,5761,5845,6186,592 3,6226,6318,6630,6031,6331,6402,6699,6445,6766,6842,7157,3294,3971,4076,4748,42 11,4810,4903,5400,4281,4936,5008,5481,5078,5522,5543,5975,4426,5045,5133,5546,5 206,5661,5711,6058,5291,5746,5813,6161,5876,6207,6283,6577,4539,5168,5260,5723, 5374,5799,5790,6214,5424,5856,5890,6267,5993,6321,6354,6707,5516,5926,6022,6343, 6061,6422,6449,6781,6124,6483,6540,6862,6642,6926,7000,7269,4620,5308,5383,586 5,5470,5910,5996,6334,5652,6025,6089,6435,6101,6458,6512,6826,5688,6092,6119,65 02,6217,6533,6616,6914,6299,6638,6673,6946,6735,7030,7079,7316,5749,6242,6277,6 581,6360,6648,6688,6980,6406,6728,6785,7061,6846,7110,7176,7410,6547,6792,6865, 7124,6934,7194,7224,7482,6984,7248,7294,7519,7354,7574,7638,7822,3423,4135,4245, 4941,4415,5037,5118,5617,4461,5146,5228,5670,5303,5735,5833,6286,4593,5268,539 7,5781,5450,5905,5879,6309,5490,5940,6004,6393,6082,6426,6468,6812,4850,5427,54 96,5902,5649,5983,6038,6439,5667,6085,6109,6475,6146,6520,6557,6893,5691,6134,6 199,6553,6295,6613,6667,6955,6347,6717,6732,7035,6788,7083,7138,7381,4888,5643, 5658,6064,5694,6097,6158,6530,5758,6221,6270,6595,6327,6652,6724,7018,6020,6293, 6363,6669,6409,6758,6796,7070,6526,6799,6869,7129,6938,7190,7219,7475,6104,641 9,6499,6761,6550,6855,6902,7152,6623,6922,6963,7214,7013,7253,7310,7539,6681,69 88,7048,7290,7101,7326,7375,7588,7162,7398,7434,7624,7463,7694,7711,7914,4917,5 702,5732,6279,5981,6315,6350,6710,6046,6389,6428,6770,6510,6823,6890,7143,6116, 6466,6543,6835,6589,6905,6967,7205,6655,7005,6958,7238,7075,7305,7348,7559,6302, 6567,6609,6930,6703,6975,7043,7274,6750,7053,7096,7332,7134,7359,7416,7616,685 0,7115,7171,7386,7229,7445,7469,7677,7259,7514,7533,7728,7580,7754,7773,7878,64 13,6620,6746,7057,6819,7093,7120,7365,6881,7180,7199,7427,7244,7452,7526,7702,6 897,7234,7279,7507,7342,7546,7553,7764,7404,7594,7609,7782,7662,7833,7854,7987, 7022,7321,7337,7567,7421,7602,7632,7802,7457,7670,7686,7844,7737,7866,7928,8021, 7494,7720,7745,7889,7793,7902,7942,8040,7812,7955,7971,8061,8003,8084,8111,814 5,315,749,1016,1608,1189,1682,1923,2412,1325,1867,2017,2520,2143,2641,2685,3363, 1434,1971,2063,2617,2252,2771,2935,3421,2350,2919,2846,3496,3097,3590,3649,4157, 1526,2183,2320,2810,2383,2901,3004,3519,2544,3066,3125,3599,3301,3714,3767,427 3,2664,3155,3337,3750,3398,3825,3907,4350,3487,3923,4005,4498,4049,4563,4675,51 54,1748,2218,2466,3051,2569,3112,3287,3666,2708,3349,3182,3775,3453,3858,3961,4 398,2884,3325,3476,3915,3539,3983,4043,4537,3630,4062,4179,4622,4267,4711,4787, 5295,3035,3508,3610,4035,3731,4114,4227,4689,3808,4233,4344,4753,4417,4862,4929, 5405,3945,4386,4521,4879,4554,4934,5027,5494,4655,5055,5131,5564,5199,5624,572 7,6213,2103,2438,2593,3313,2790,3386,3430,3953,2954,3465,3550,4027,3638,4108,41 37,4685,3082,3559,3658,4122,3758,4219,4324,4764,3850,4330,4392,4834,4532,4912,5 005,5462,3209,3694,3817,4259,3866,4336,4434,4884,4013,4510,4558,4946,4649,5052, 5108,5558,4128,4607,4694,5075,4759,5181,5211,5615,4867,5252,5352,5701,5422,5780, 5938,6215,3263,3833,3975,4451,4092,4543,4644,5067,4165,4658,4719,5151,4792,520 7,5287,5674,4313,4773,4839,5244,4937,5333,5413,5806,4985,5433,5507,5869,5582,59 65,6021,6431,4428,4893,4959,5365,5083,5456,5520,5920,5196,5544,5618,5997,5704,6 032,6154,6539,5284,5648,5733,6098,5771,6194,6246,6628,5930,6271,6329,6610,6385, 6697,6802,7108,2287,2728,2827,3528,2970,3570,3677,4213,2986,3686,3783,4279,3883, 4404,4463,4997,3197,3792,3891,4481,3991,4526,4597,5002,4057,4586,4680,5128,477 8,5193,5227,5612,3236,3969,4070,4493,4193,4613,4700,5188,4253,4744,4797,5233,48 53,5327,5382,5765,4247,4843,4901,5321,4980,5419,5468,5875,5092,5529,5588,5962,5 642,6015,6111,6511,3375,4151,4199,4730,4299,4820,4898,5298,4361,4924,4954,5410, 5030,5491,5541,5955,4664,5010,5088,5503,5159,5576,5639,6006,5262,5660,5748,6090, 5817,6188,6253,6594,4815,5139,5241,5606,5316,5695,5757,6160,5396,5791,5840,620 9,5941,6298,6351,6671,5514,5936,5971,6330,6009,6390,6313,6722,6129,6501,6544,68 24,6562,6925,6978,7165,3442,4285,4318,4976,4618,5047,5100,5526,4739,5119,5165,5 594,5259,5669,5745,6167,4806,5247,5313,5672,5361,5759,5826,6225,5436,5849,5914, 6282,6003,6342,6427,6737,4993,5330,5379,5820,5465,5895,5979,6317,5591,5982,6024, 6420,6133,6379,6525,6831,5692,6075,6182,6503,6227,6558,6601,6895,6301,6619,661 5,6964,6725,7003,7045,7283,5134,5425,5532,5988,5663,6029,6105,6453,5751,6163,61 96,6548,6269,6570,6614,6919,5829,6238,6319,6598,6352,6624,6729,7006,6448,6751,6 791,7056,6859,7122,7158,7395,5958,6335,6411,6733,6521,6740,6845,7074,6535,6834, 6901,7144,6951,7192,7257,7476,6572,6928,6993,7215,7028,7267,7237,7502,7100,7314, 7346,7575,7411,7613,7659,7775,2495,2865,3020,3619,3140,3800,3899,4440,3224,393 1,3997,4476,4084,4574,4602,5170,3248,4078,4143,4569,4205,4825,4870,5281,4367,48 76,4971,5399,5043,5474,5538,5995,3275,4185,4293,4848,4380,4963,5018,5448,4445,5 063,5111,5552,5177,5627,5683,6036,4515,5147,5219,5657,5302,5736,5786,6145,5338, 5768,5855,6234,5866,6281,6339,6809,3705,4375,4423,5035,4487,5115,5173,5603,4633, 5230,5267,5716,5347,5800,5846,6175,4725,5278,5375,5777,5442,5860,5883,6257,550 0,5886,5912,6346,6072,6394,6486,6833,4811,5439,5482,5906,5570,5974,5989,6368,56 36,6068,6118,6446,6206,6515,6552,6904,5713,6153,6231,6554,6306,6590,6678,6954,6 410,6689,6755,7011,6795,7068,7128,7387,3739,4468,4580,5215,4714,5270,5358,5812, 4783,5390,5453,5892,5517,5927,5947,6358,4920,5488,5567,5950,5630,6054,6103,6433, 5707,6138,6200,6534,6262,6576,6645,6908,5022,5600,5680,6113,5789,6187,6179,658 0,5832,6243,6275,6632,6372,6682,6712,7017,5922,6310,6401,6701,6437,6772,6798,70 77,6497,6828,6873,7147,6961,7200,7260,7479,5095,5724,5797,6250,5878,6294,6375,6 693,6047,6405,6463,6783,6474,6806,6852,7117,6081,6467,6493,6841,6584,6870,6939, 7188,6661,6957,6990,7217,7042,7287,7325,7515,6141,6605,6639,6911,6714,6968,6999, 7245,6759,7036,7082,7311,7133,7350,7402,7589,6880,7089,7151,7363,7207,7419,744 1,7649,7250,7462,7497,7674,7547,7717,7769,7906,3874,4638,4750,5393,4907,5479,55 55,6013,4951,5579,5651,6063,5722,6126,6219,6649,5072,5689,5809,6169,5858,6290,6 265,6668,5897,6323,6384,6748,6457,6776,6817,7103,5310,5838,5903,6287,6045,6364, 6416,6787,6060,6459,6481,6820,6519,6856,6891,7173,6083,6507,6566,6887,6657,6936, 6981,7222,6704,7024,7038,7291,7086,7330,7374,7565,5344,6039,6052,6441,6087,647 1,6529,6867,6148,6587,6635,6921,6686,6970,7032,7276,6397,6653,6718,6986,6763,70 60,7091,7318,6863,7097,7155,7366,7210,7415,7437,7644,6477,6769,6837,7063,6884,7 140,7181,7383,6948,7195,7230,7432,7271,7466,7511,7690,6996,7252,7299,7493,7343, 7524,7561,7729,7391,7579,7608,7758,7634,7807,7819,7977,5369,6096,6120,6640,6362, 6674,6708,7021,6423,6744,6780,7071,6848,7114,7169,7378,6488,6813,6876,7125,691 5,7184,7232,7428,6974,7265,7225,7454,7323,7505,7543,7707,6664,6898,6932,7202,70 15,7240,7295,7484,7054,7302,7339,7528,7369,7551,7593,7752,7136,7355,7400,7570,7 446,7619,7639,7795,7472,7669,7685,7834,7723,7853,7869,7949,6765,6944,7050,7307, 7111,7334,7358,7556,7163,7407,7423,7604,7458,7623,7679,7814,7177,7449,7487,7664, 7537,7696,7700,7861,7585,7735,7746,7875,7783,7916,7931,8031,7278,7521,7534,771 2,7599,7740,7765,7891,7628,7788,7800,7923,7840,7940,7988,8057,7653,7827,7847,79 59,7883,7967,7997,8072,7899,8009,8019,8088,8044,8105,8126,8152,1813,2748,3167,3 937,3409,4021,4239,4801,3579,4171,4355,4915,4504,5038,5080,5686,3722,4305,4411, 5013,4628,5142,5306,5730,4734,5292,5222,5803,5459,5880,5933,6344,3842,4549,4705, 5185,4769,5273,5372,5823,4942,5430,5485,5889,5633,5992,6034,6424,5060,5511,566 6,6018,5719,6086,6150,6480,5794,6165,6229,6582,6259,6625,6698,7019,4100,4591,48 57,5416,4968,5471,5621,5953,5103,5677,5523,6042,5762,6108,6191,6513,5255,5654,5 783,6157,5843,6210,6255,6608,5917,6273,6355,6666,6418,6723,6775,7107,5402,5815, 5900,6247,6000,6307,6392,6709,6070,6398,6476,6753,6524,6822,6872,7174,6176,650, 6596,6840,6618,6875,6937,7228,6687,6956,7004,7268,7049,7303,7361,7601,4457,482 9,4988,5645,5162,5710,5742,6184,5324,5774,5852,6241,5924,6303,6326,6706,5445,58 63,5944,6314,6027,6388,6461,6760,6100,6464,6508,6804,6604,6861,6924,7208,5549,5 976,6078,6414,6115,6470,6538,6844,6237,6586,6622,6882,6683,6952,6987,7266,6322, 6654,6715,6969,6756,7037,7055,7298,6825,7081,7142,7347,7186,7389,7468,7603,5597, 6093,6203,6549,6297,6611,6679,6962,6348,6691,6730,7016,6779,7051,7104,7333,645 0,6764,6808,7076,6879,7131,7179,7401,6910,7191,7236,7435,7281,7483,7509,7701,65 31,6847,6892,7150,6973,7206,7243,7459,7047,7258,7301,7498,7349,7516,7576,7749,7 102,7317,7364,7548,7384,7592,7617,7785,7465,7629,7656,7778,7682,7813,7855,7970, 4669,5123,5204,5835,5341,5872,5960,6381,5355,5968,6050,6429,6130,6517,6556,6916, 5535,6057,6135,6568,6218,6600,6647,6920,6266,6643,6702,7001,6767,7044,7064,729 7,5573,6198,6278,6578,6365,6658,6719,7041,6407,6745,6782,7069,6818,7127,7161,73 80,6403,6811,6853,7123,6907,7183,7213,7436,6979,7247,7282,7481,7315,7508,7554,7 736,5698,6336,6371,6738,6444,6797,6851,7109,6484,6868,6889,7178,6940,7227,7255, 7477,6694,6927,6976,7235,7023,7275,7313,7503,7087,7324,7372,7544,7408,7591,7621, 7771,6793,7010,7073,7293,7121,7344,7376,7577,7170,7394,7420,7600,7471,7641,766 5,7803,7239,7467,7485,7657,7504,7683,7648,7823,7563,7731,7750,7863,7757,7904,79 24,7991,5754,6436,6454,6903,6662,6949,6985,7246,6742,6998,7025,7286,7084,7329,7 368,7581,6786,7080,7118,7331,7149,7377,7412,7606,7193,7425,7456,7635,7499,7661, 7699,7829,6913,7130,7159,7409,7212,7447,7489,7650,7285,7491,7512,7697,7564,7678, 7742,7865,7341,7536,7587,7732,7610,7756,7774,7892,7643,7781,7780,7919,7825,793 3,7948,8028,7007,7187,7251,7492,7327,7513,7550,7710,7373,7578,7596,7751,7627,77 60,7779,7901,7413,7614,7651,7772,7666,7784,7826,7934,7709,7835,7850,7952,7879,7 975,7989,8062,7478,7658,7693,7828,7741,7830,7872,7960,7748,7868,7894,7983,7912, 7999,8020,8083,7761,7905,7929,8007,7943,8024,8014,8091,7968,8038,8048,8109,8067, 8118,8128,8151,4889,5236,5385,5909,5497,6065,6142,6542,5561,6172,6222,6565,629 1,6633,6650,7029,5585,6285,6333,6629,6377,6801,6829,7099,6490,6836,6899,7172,69 45,7216,7254,7496,5609,6359,6440,6814,6498,6896,6931,7201,6545,6960,6991,7261,7 034,7306,7338,7517,6592,7012,7062,7322,7113,7367,7390,7569,7135,7382,7426,7612, 7431,7633,7660,7857,5985,6494,6527,6943,6573,6994,7031,7292,6672,7067,7090,7356, 7141,7399,7422,7583,6734,7095,7156,7385,7198,7430,7440,7622,7231,7443,7455,766 3,7535,7684,7725,7867,6790,7197,7221,7453,7273,7486,7495,7673,7309,7532,7557,77 08,7598,7738,7753,7896,7352,7572,7611,7755,7645,7770,7805,7913,7691,7810,7836,7 935,7851,7956,7978,8059,6011,6559,6637,7058,6727,7094,7145,7406,6771,7164,7203, 7444,7242,7464,7473,7668,6864,7223,7270,7474,7308,7527,7549,7703,7351,7566,7597, 7744,7625,7763,7791,7897,6933,7289,7335,7555,7393,7590,7586,7766,7417,7615,763 1,7786,7675,7806,7818,7938,7460,7647,7688,7815,7704,7843,7852,7961,7730,7864,78 84,7984,7918,8001,8022,8085,6982,7360,7397,7620,7438,7640,7676,7811,7523,7689,7 715,7848,7721,7856,7874,7974,7538,7716,7727,7871,7767,7882,7909,7998,7798,7917, 7927,8008,7947,8029,8042,8094,7568,7777,7789,7898,7820,7920,7932,8016,7837,7945, 7962,8037,7979,8049,8065,8113,7886,7964,7985,8052,8004,8069,8075,8125,8017,808 0,8090,8131,8102,8140,8150,8171,6123,6676,6749,7167,6857,7220,7262,7506,6885,72 77,7319,7531,7357,7560,7605,7794,6966,7340,7403,7582,7429,7637,7626,7801,7448,7 652,7681,7832,7713,7845,7860,7969,7116,7418,7450,7636,7522,7672,7695,7849,7529, 7714,7724,7862,7739,7877,7890,7993,7540,7734,7759,7888,7797,7908,7925,8010,7816, 7941,7946,8030,7963,8043,8055,8107,7137,7518,7525,7705,7542,7718,7743,7881,757 1,7768,7787,7903,7809,7921,7944,8026,7687,7796,7821,7926,7838,7953,7965,8039,78 80,7966,7986,8053,8005,8068,8074,8124,7722,7842,7870,7954,7887,7982,7995,8058,7 911,8000,8012,8073,8025,8081,8093,8134,7930,8018,8034,8089,8047,8096,8106,8142, 8060,8110,8117,8148,8122,8157,8159,8179,7154,7545,7558,7790,7671,7804,7817,7939, 7698,7831,7846,7958,7873,7973,7992,8056,7726,7859,7885,7976,7900,7996,8013,807 1,7922,8023,8011,8078,8041,8092,8101,8137,7799,7893,7907,8002,7937,8015,8032,80 86,7951,8035,8046,8097,8054,8103,8114,8147,7980,8050,8063,8108,8076,8119,8123,8 155,8082,8130,8133,8161,8141,8164,8166,8176,7839,7910,7950,8036,7972,8045,8051, 8104,7990,8066,8070,8116,8079,8120,8132,8158,7994,8077,8087,8129,8100,8135,8136, 8165,8112,8143,8146,8167,8153,8172,8174,8184,8027,8095,8099,8139,8115,8144,814 9,8169,8121,8154,8156,8173,8162,8175,8180,8186,8127,8160,8163,8177,8168,8178,81 81,8187,8170,8182,8183,8188,8185,8189,8190,8191];
wobei die Sequenz Z2 gegeben ist durch:
[0,1,2,7,3,8,13,26,4,12,15,30,18,35,37,82,5,14,16,34,21,41,51,87,24,50,45,94,61,103,110, 177,6,19,23,43,25,49,55,96,31,59,63,104,76,117,123,195,36,65,80,121,85,131,141,208, 93,143,155,235,161,248,271,391,9,20,28,58,32,62,75,112,38,81,67,124,90,135,149,217, 48,78,92,142,98,152,160,243,108,163,180,260,194,278,296,434,57,95,106,159,119,171, 188,274,129,189,207,288,220,313,330,471,146,215,239,318,246,331,356,502,266,363,3 85,528,405,551,593,816,17,27,33,77,42,84,88,147,52,91,99,158,109,170,174,273,60,100, 111,172,122,187,204,290,134,205,216,307,241,326,350,491,69,115,130,193,136,206,22 3,319,156,237,247,334,265,362,378,525,173,257,275,369,289,399,408,548,315,421,453, 582,477,613,681,817,73,132,151,226,168,244,264,367,178,267,281,390,297,407,432,57 1,202,293,308,418,332,447,473,624,344,480,507,650,535,693,719,942,222,321,338,457, 371,488,511,672,404,521,549,708,583,724,785,1011,431,561,595,756,609,805,833,1072, 677,848,880,1059,914,1122,1203,1479,22,39,44,97,53,101,113,186,54,114,125,196,138, 218,228,348,68,126,139,232,153,240,254,349,162,252,272,383,294,403,413,547,71,150, 164,234,182,258,276,402,192,286,298,415,311,445,463,607,191,309,323,442,343,476,4 93,653,373,515,537,692,558,716,762,992,83,176,184,283,200,304,322,436,210,329,337, 472,357,501,520,688,269,351,372,506,392,533,557,712,424,565,600,752,629,803,837,1 048,302,387,417,544,441,580,603,788,468,618,638,813,682,863,893,1102,509,680,696, 881,713,916,871,1140,771,986,1014,1221,1026,1306,1353,1539,89,197,203,342,259,36 1,376,514,285,381,395,540,423,569,599,791,300,420,440,570,456,605,632,822,481,642, 670,854,710,888,939,1151,347,446,462,630,492,661,699,873,538,700,720,935,774,910, 1002,1226,578,745,799,987,823,1023,1054,1279,864,1066,1063,1341,1143,1376,1417,1 670,386,478,516,703,567,723,760,955,601,789,807,1017,846,1032,1062,1300,633,830,8 75,1051,894,1069,1146,1380,952,1163,1194,1428,1250,1493,1531,1810,689,884,930,11 49,999,1154,1238,1445,1009,1229,1285,1516,1329,1567,1639,1919,1033,1309,1367,15 92,1400,1651,1617,1957,1471,1707,1746,2065,1830,2125,2198,2406,29,47,56,107,64,1 27,140,224,70,144,154,231,167,250,255,396,72,165,175,249,185,305,316,430,211,317,3 41,469,360,495,518,707,74,181,198,310,213,339,353,486,225,366,379,523,398,552,575, 726,238,389,411,564,437,596,615,780,448,608,644,827,649,853,886,1209,116,212,221, 358,233,380,397,543,262,414,425,588,452,621,641,795,282,429,461,612,484,647,656,8 40,505,658,669,890,744,919,976,1228,301,483,498,666,530,697,704,903,556,741,766,9 51,812,995,1019,1288,587,784,826,1021,867,1045,1108,1332,928,1116,1166,1384,1197, 1439,1500,1799,120,230,251,409,279,426,455,626,295,465,487,660,510,676,684,897,3 28,500,529,686,554,735,759,943,584,776,809,1007,842,1036,1084,1291,354,542,574,76 4,617,802,798,1039,635,832,850,1074,906,1111,1133,1390,673,869,923,1125,946,1180, 1200,1448,983,1224,1262,1519,1338,1575,1643,1925,375,592,620,836,654,860,907,111 9,731,926,962,1189,968,1206,1244,1488,747,964,980,1235,1041,1259,1318,1564,1095, 1335,1364,1595,1414,1676,1721,1977,778,1056,1080,1294,1134,1344,1373,1626,1169, 1407,1453,1704,1505,1752,1819,2087,1268,1460,1524,1768,1584,1841,1872,2182,1631, 1900,1951,2224,2025,2299,2394,2688,137,263,287,466,324,496,524,715,336,534,562,7 39,590,770,819,1087,368,577,625,793,646,858,844,1101,663,877,913,1160,958,1183,12 15,1474,439,637,665,857,730,901,932,1192,738,959,974,1218,998,1247,1277,1547,749, 990,1029,1274,1092,1315,1356,1600,1127,1397,1411,1679,1456,1727,1782,2051,450,7 28,734,948,751,967,1004,1256,781,1044,1077,1303,1113,1347,1404,1662,920,1090,113 7,1361,1171,1431,1463,1712,1253,1468,1527,1771,1587,1836,1866,2173,971,1177,123 2,1434,1271,1511,1555,1793,1326,1570,1609,1860,1657,1906,1971,2251,1370,1634,16 90,1945,1743,1991,2047,2319,1804,2073,2117,2373,2157,2470,2494,2875,458,755,767, 1081,899,1105,1130,1393,936,1157,1186,1442,1241,1485,1542,1788,978,1212,1265,14 96,1297,1559,1612,1853,1350,1648,1604,1889,1718,1963,2019,2279,1098,1282,1312,1 579,1387,1621,1684,1931,1425,1693,1737,1997,1777,2033,2095,2362,1508,1757,1815, 2059,1877,2133,2165,2443,1914,2215,2243,2524,2308,2567,2601,2797,1174,1323,1422, 1698,1482,1732,1762,2039,1535,1825,1847,2111,1894,2141,2232,2482,1550,1883,193 7,2207,2011,2260,2269,2583,2081,2330,2350,2617,2420,2710,2750,3042,1665,1985,20 05,2288,2103,2339,2385,2652,2149,2432,2455,2730,2539,2773,2904,3134,2190,2509,2 552,2822,2633,2846,2933,3187,2671,2967,3002,3252,3083,3328,3433,3584,10,40,66,14 5,86,157,190,299,102,179,209,327,236,359,370,576,118,201,219,352,261,388,438,594,2 84,433,412,623,489,655,678,889,133,245,277,400,291,428,460,631,333,479,499,659,55 5,705,725,938,364,508,568,718,589,750,783,972,619,790,824,1040,841,1070,1123,1392, 169,253,312,474,340,494,550,687,377,573,513,729,606,761,804,994,422,563,614,786,6 39,814,839,1058,671,849,895,1099,934,1142,1182,1477,470,627,664,835,709,868,918,1 132,742,922,970,1164,1000,1219,1260,1549,796,988,1049,1234,1065,1263,1317,1607,1 115,1334,1378,1653,1420,1695,1766,2107,227,306,346,560,394,586,597,800,444,611,6 43,831,675,866,879,1129,485,648,683,872,721,915,960,1170,757,963,991,1205,1055,12 51,1305,1585,522,698,746,931,765,966,1010,1237,828,1043,1067,1269,1112,1331,1363, 1650,876,1091,1136,1346,1167,1409,1426,1688,1222,1452,1514,1748,1560,1801,1910, 2109,541,754,810,1018,862,1060,1109,1340,892,1118,1147,1389,1184,1423,1476,1730, 954,1173,1208,1447,1266,1503,1554,1817,1293,1565,1616,1862,1667,1929,1969,2271, 1006,1240,1278,1522,1349,1582,1624,1896,1418,1641,1691,1953,1750,1979,2067,2355, 1472,1711,1770,2027,1795,2093,2131,2424,1904,2151,2192,2410,2236,2480,2570,285 6,270,382,406,636,449,652,691,911,454,694,733,940,773,996,1022,1299,517,736,775,1 030,818,1052,1085,1302,845,1083,1126,1375,1176,1415,1436,1686,531,808,851,1037,9 02,1094,1139,1412,927,1159,1187,1440,1216,1498,1534,1790,924,1210,1245,1495,129 0,1557,1590,1864,1355,1629,1669,1927,1709,1967,2035,2332,581,885,905,1153,950,11 99,1243,1480,975,1257,1275,1552,1320,1605,1638,1921,1120,1308,1352,1614,1395,16 60,1705,1959,1458,1720,1779,2021,1827,2091,2137,2399,1196,1383,1444,1683,1492,1 744,1784,2069,1544,1808,1843,2105,1912,2169,2209,2460,1619,1908,1933,2194,1961, 2238,2180,2502,2048,2323,2357,2588,2371,2682,2733,2914,602,944,956,1287,1097,13 28,1360,1627,1156,1372,1398,1674,1455,1725,1775,2075,1190,1450,1490,1728,1521,1 786,1832,2115,1569,1849,1893,2159,1955,2203,2266,2514,1296,1501,1532,1828,1589, 1879,1939,2184,1672,1941,1973,2262,2049,2230,2344,2593,1741,2009,2085,2326,2119, 2369,2403,2654,2171,2417,2415,2718,2504,2756,2794,3031,1381,1562,1633,1943,172 3,1975,2031,2286,1781,2071,2097,2360,2147,2378,2413,2676,1834,2127,2186,2401,22 11,2422,2507,2759,2284,2527,2560,2806,2622,2868,2907,3150,1923,2196,2256,2512,2 341,2517,2609,2825,2353,2598,2660,2891,2704,2940,3006,3234,2380,2685,2744,2960, 2779,3016,2985,3266,2849,3064,3098,3347,3166,3389,3444,3576,320,416,464,667,503, 740,779,1013,527,794,821,1028,859,1076,1088,1401,536,855,882,1073,909,1202,1225, 1469,979,1231,1284,1545,1325,1594,1636,1949,545,898,947,1213,984,1281,1311,1577, 1015,1337,1366,1645,1406,1697,1736,1981,1047,1386,1433,1716,1484,1773,1802,2057, 1506,1791,1851,2123,1858,2155,2200,2575,702,982,1003,1321,1034,1369,1403,1681,1 104,1437,1461,1759,1513,1814,1845,2079,1150,1466,1529,1797,1574,1856,1870,2139, 1610,1873,1891,2205,2007,2241,2312,2596,1193,1572,1599,1887,1658,1935,1947,2221, 1702,2003,2041,2282,2101,2335,2364,2663,1755,2063,2121,2366,2176,2396,2465,270 7,2253,2475,2529,2762,2562,2816,2878,3142,714,1025,1078,1429,1144,1464,1518,182 3,1179,1537,1580,1875,1622,1902,1916,2213,1254,1602,1655,1918,1700,1995,2029,22 73,1753,2053,2099,2348,2143,2382,2439,2665,1314,1677,1734,2037,1806,2089,2083,2 387,1838,2129,2153,2427,2226,2467,2492,2768,1898,2178,2247,2484,2275,2544,2565, 2828,2321,2591,2636,2894,2716,2947,3009,3239,1358,1764,1812,2135,1868,2167,2228 ,2477,1989,2249,2295,2554,2304,2572,2614,2865,2013,2297,2317,2606,2389,2630,269 6,2937,2451,2713,2741,2964,2791,3034,3075,3280,2055,2408,2434,2668,2497,2721,27 53,2992,2532,2785,2831,3060,2881,3102,3158,3363,2641,2837,2897,3114,2954,3174,3 200,3427,2995,3221,3261,3461,3313,3510,3569,3740,769,1106,1161,1540,1248,1597,1 646,1965,1272,1663,1714,2001,1761,2045,2113,2441,1343,1739,1821,2077,1855,2163, 2145,2458,1881,2188,2234,2522,2290,2547,2580,2853,1487,1840,1885,2161,1987,2219 ,2258,2557,1999,2292,2310,2585,2337,2620,2649,2920,2015,2328,2376,2646,2448,269 3,2736,2971,2487,2776,2788,3038,2834,3079,3126,3337,1509,1983,1993,2277,2017,23 01,2346,2628,2061,2392,2429,2679,2472,2724,2782,3024,2245,2446,2499,2738,2534,2 809,2840,3068,2625,2843,2900,3118,2957,3170,3195,3421,2306,2542,2604,2812,2644, 2888,2927,3138,2701,2944,2978,3191,3020,3225,3275,3479,2747,2999,3049,3257,3094 ,3289,3332,3523,3146,3352,3384,3556,3410,3620,3636,3827,1526,2023,2043,2436,221 7,2463,2489,2771,2264,2519,2549,2819,2612,2862,2917,3130,2315,2578,2638,2872,26 74,2930,2981,3183,2727,3013,2974,3212,3072,3270,3308,3497,2453,2657,2690,2950,2 765,2988,3045,3243,2803,3053,3090,3294,3122,3318,3368,3549,2884,3106,3154,3342, 3204,3394,3416,3605,3230,3456,3473,3652,3516,3676,3694,3792,2537,2699,2800,3057 ,2859,3087,3110,3323,2910,3162,3178,3378,3217,3400,3467,3628,2923,3208,3248,345 0,3303,3485,3491,3685,3358,3529,3542,3702,3591,3750,3770,3896,3027,3284,3298,35 04,3373,3536,3563,3721,3405,3598,3613,3760,3660,3781,3840,3929,3438,3644,3668,3 803,3712,3815,3853,3947,3730,3866,3881,3968,3912,3990,4016,4049,11,46,79,183,105 ,199,256,393,128,242,280,427,314,467,482,743,148,268,292,459,345,512,572,768,374,5 66,539,801,634,843,870,1117,166,325,365,526,384,559,598,811,435,622,645,847,717,9 00,925,1175,475,657,732,917,758,953,993,1214,797,1001,1042,1292,1064,1327,1388,1 668,214,335,410,616,443,640,711,878,490,737,668,929,782,969,1020,1239,553,727,792 ,997,820,1031,1061,1313,861,1071,1128,1359,1172,1408,1451,1756,610,806,852,1057, 908,1096,1152,1396,945,1155,1211,1432,1249,1494,1533,1826,1012,1233,1304,1504,1 322,1536,1591,1884,1377,1608,1654,1930,1696,1970,2040,2386,303,401,451,722,519,7 53,772,1016,579,787,825,1053,865,1093,1107,1394,628,829,874,1100,921,1148,1201,1 438,965,1204,1236,1478,1310,1523,1578,1863,679,891,949,1168,973,1207,1258,1507,1 046,1298,1324,1543,1374,1606,1640,1926,1103,1351,1399,1620,1435,1685,1703,1964, 1497,1729,1792,2022,1837,2076,2187,2388,701,957,1027,1267,1086,1316,1371,1615,1 121,1379,1413,1666,1454,1701,1751,2004,1195,1443,1481,1724,1538,1780,1831,2094, 1566,1844,1892,2138,1942,2206,2246,2551,1255,1512,1551,1800,1625,1859,1901,2174 ,1694,1917,1966,2229,2024,2254,2343,2635,1749,1986,2044,2302,2070,2372,2411,270 5,2181,2430,2473,2691,2516,2760,2845,3100,355,497,532,815,585,834,883,1145,591,8 87,933,1178,981,1242,1273,1573,674,937,985,1283,1035,1307,1345,1576,1068,1339,13 91,1652,1446,1692,1713,1962,690,1024,1075,1289,1135,1354,1402,1689,1165,1427,14 57,1717,1489,1776,1811,2066,1162,1483,1517,1772,1563,1835,1867,2142,1630,1907,1 946,2204,1982,2242,2311,2613,748,1114,1138,1419,1188,1470,1515,1758,1220,1530,1 548,1829,1593,1882,1915,2199,1382,1581,1628,1890,1671,1938,1980,2235,1735,1994, 2054,2296,2102,2368,2416,2678,1467,1659,1722,1958,1769,2018,2060,2347,1820,2084 ,2118,2383,2189,2450,2490,2739,1897,2185,2210,2474,2237,2520,2461,2780,2324,260 5,2639,2863,2653,2946,2990,3149,777,1181,1198,1561,1357,1603,1635,1905,1424,164 7,1675,1950,1733,2000,2052,2352,1462,1726,1767,2002,1798,2062,2108,2395,1846,21 24,2170,2438,2233,2483,2548,2792,1571,1778,1809,2104,1865,2156,2216,2464,1948,2 218,2248,2543,2327,2511,2624,2869,2016,2285,2363,2607,2397,2650,2684,2921,2452, 2698,2695,2979,2783,3011,3047,3251,1656,1839,1909,2222,1996,2252,2307,2568,2056 ,2349,2374,2642,2428,2659,2694,2941,2110,2405,2466,2681,2491,2702,2786,3014,256 4,2804,2836,3056,2892,3112,3143,3350,2201,2478,2536,2789,2621,2795,2880,3071,26 32,2871,2926,3131,2968,3172,3228,3422,2661,2949,3003,3192,3032,3237,3211,3445,3 093,3278,3306,3511,3364,3546,3588,3696,419,546,604,856,651,941,989,1261,685,1005 ,1038,1280,1082,1333,1348,1678,695,1079,1110,1330,1141,1473,1499,1747,1223,1502, 1558,1822,1601,1871,1913,2227,706,1131,1185,1486,1230,1553,1586,1854,1264,1613, 1642,1922,1682,1972,2010,2257,1301,1664,1708,1992,1760,2046,2080,2336,1783,2068 ,2128,2402,2136,2437,2481,2851,896,1227,1252,1596,1286,1644,1680,1956,1365,1715, 1738,2032,1789,2090,2122,2358,1416,1745,1807,2074,1850,2132,2148,2419,1888,2150 ,2168,2486,2283,2523,2594,2870,1465,1848,1876,2164,1934,2212,2223,2503,1978,228 0,2316,2563,2381,2616,2645,2929,2030,2342,2400,2647,2456,2675,2745,2970,2535,27 54,2807,3018,2839,3066,3117,3343,912,1276,1336,1706,1410,1740,1796,2098,1449,18 16,1857,2154,1899,2179,2193,2495,1528,1880,1932,2195,1974,2270,2305,2553,2026,2 331,2377,2631,2423,2664,2719,2932,1588,1954,2008,2313,2082,2367,2361,2667,2112, 2409,2433,2708,2506,2748,2772,3023,2175,2459,2528,2763,2556,2821,2842,3074,2602 ,2866,2903,3133,2976,3179,3231,3425,1632,2038,2088,2414,2144,2447,2508,2757,226 5,2531,2576,2830,2584,2848,2886,3108,2289,2579,2599,2877,2670,2901,2958,3169,27 31,2973,3000,3194,3044,3255,3288,3457,2333,2687,2714,2935,2774,2982,3008,3218,2 810,3039,3078,3276,3121,3310,3356,3524,2909,3084,3137,3321,3185,3371,3391,3579, 3222,3409,3441,3602,3486,3642,3690,3819,977,1368,1430,1818,1520,1874,1924,2240, 1546,1940,1988,2276,2036,2322,2391,2722,1618,2014,2096,2354,2130,2444,2425,2737 ,2158,2469,2515,2801,2571,2824,2857,3096,1765,2116,2162,2442,2263,2500,2540,283 3,2274,2573,2590,2860,2619,2889,2918,3156,2291,2610,2656,2915,2728,2955,2993,31 98,2766,3029,3041,3258,3081,3292,3331,3502,1787,2259,2268,2559,2294,2582,2627,2 898,2338,2673,2711,2943,2751,2984,3036,3245,2525,2725,2777,2997,2813,3059,3086, 3282,2895,3091,3140,3324,3188,3367,3387,3574,2587,2818,2874,3062,2912,3127,3163 ,3339,2965,3175,3205,3383,3241,3413,3453,3617,3005,3224,3265,3437,3304,3465,349 9,3653,3346,3515,3541,3680,3565,3726,3737,3887,1803,2300,2318,2715,2498,2742,27 69,3026,2545,2798,2827,3069,2883,3105,3152,3335,2595,2854,2906,3115,2938,3165,3 207,3379,2987,3235,3201,3402,3286,3448,3482,3632,2734,2924,2952,3181,3021,3214, 3262,3429,3054,3268,3300,3469,3327,3490,3528,3674,3124,3314,3354,3507,3395,3551 ,3570,3714,3418,3597,3612,3751,3647,3769,3784,3860,2815,2962,3051,3272,3103,329 6,3317,3494,3147,3360,3375,3538,3406,3555,3607,3732,3159,3398,3432,3593,3477,36 22,3626,3776,3520,3658,3669,3790,3703,3828,3843,3939,3247,3462,3474,3637,3533,3 663,3686,3805,3560,3708,3719,3835,3757,3851,3897,3964,3583,3744,3763,3869,3797, 3877,3906,3978,3812,3917,3927,3994,3951,4010,4031,4056,229,504,662,1008,763,105 0,1158,1459,838,1124,1217,1525,1295,1598,1623,2012,904,1191,1246,1583,1362,1661, 1763,2042,1421,1754,1710,2092,1861,2146,2183,2485,961,1319,1405,1687,1441,1742, 1805,2106,1541,1842,1878,2152,1976,2225,2255,2546,1611,1895,1998,2244,2034,2293 ,2340,2589,2086,2351,2398,2669,2421,2703,2761,3025,1089,1342,1491,1833,1556,186 9,1968,2197,1637,2006,1903,2261,2064,2309,2370,2615,1731,1990,2078,2345,2120,23 84,2418,2689,2172,2431,2493,2735,2541,2781,2823,3099,1824,2100,2160,2412,2231,2 457,2521,2770,2281,2526,2586,2805,2623,2861,2902,3157,2359,2608,2680,2876,2697, 2905,2956,3203,2752,2972,3012,3238,3050,3269,3320,3535,1270,1475,1568,1984,1673 ,2028,2050,2365,1774,2072,2126,2407,2177,2454,2471,2767,1852,2134,2191,2462,225 0,2518,2574,2811,2303,2577,2611,2847,2686,2893,2945,3186,1920,2214,2287,2538,23 14,2581,2634,2879,2404,2672,2700,2911,2749,2969,2998,3236,2468,2726,2775,2983,2 808,3040,3055,3264,2864,3077,3129,3307,3167,3344,3415,3537,1952,2298,2379,2643, 2449,2692,2746,2977,2488,2755,2787,3022,2826,3052,3097,3295,2566,2814,2850,3073 ,2908,3120,3161,3355,2934,3171,3210,3385,3249,3428,3452,3627,2629,2882,2919,313 6,2986,3184,3216,3407,3048,3229,3267,3442,3309,3458,3512,3671,3095,3281,3322,34 87,3340,3527,3550,3705,3412,3561,3585,3698,3609,3731,3771,3880,1385,1649,1699,2 114,1785,2140,2202,2513,1794,2208,2267,2550,2325,2618,2648,2939,1911,2272,2329, 2658,2390,2683,2720,2942,2426,2717,2764,3010,2817,3046,3063,3263,1936,2375,2435 ,2666,2501,2729,2778,3043,2533,2799,2829,3067,2858,3116,3145,3336,2530,2852,288 7,3113,2931,3164,3190,3386,2991,3220,3250,3426,3279,3451,3492,3659,2020,2479,25 05,2793,2561,2841,2885,3101,2592,2899,2916,3160,2959,3202,3227,3423,2758,2948,2 989,3209,3028,3244,3277,3446,3082,3287,3329,3483,3361,3526,3553,3692,2838,3017, 3070,3260,3111,3305,3333,3513,3153,3349,3372,3534,3417,3572,3594,3722,3213,3414 ,3430,3586,3447,3610,3578,3741,3500,3655,3672,3778,3679,3817,3836,3900,2058,255 5,2569,2928,2732,2966,2996,3219,2796,3007,3030,3254,3080,3291,3326,3517,2832,30 76,3109,3293,3135,3334,3365,3540,3173,3376,3404,3566,3443,3590,3625,3746,2936,3 119,3144,3362,3189,3396,3434,3580,3253,3435,3454,3623,3501,3606,3665,3780,3302, 3476,3522,3656,3543,3678,3695,3806,3573,3701,3700,3831,3742,3845,3859,3936,3015 ,3168,3223,3436,3290,3455,3489,3635,3330,3514,3530,3673,3559,3682,3699,3814,336 6,3547,3581,3693,3595,3704,3743,3846,3634,3752,3766,3863,3793,3885,3898,3969,34 24,3587,3619,3745,3664,3747,3787,3870,3670,3783,3808,3892,3825,3908,3928,3989,3 683,3818,3841,3915,3854,3932,3922,3997,3878,3945,3955,4014,3973,4023,4033,4055, 1510,1719,1813,2166,1886,2278,2334,2637,1928,2356,2393,2655,2445,2709,2723,3033 ,1944,2440,2476,2706,2510,2844,2867,3092,2597,2873,2925,3155,2963,3193,3226,344 0,1960,2496,2558,2855,2603,2922,2951 ,3180,2640,2975,3001 ,3232,3037,3271 ,3299,34 59,2677,3019,3061,3285,3104,3325,3345,3506,3123,3338,3377,3545,3382,3564,3589,3 773,2220,2600,2626,2961,2662,3004,3035,3259,2740,3065,3085,3315,3128,3353,3374, 3519,2790,3089,3141,3341,3177,3381,3390,3554,3206,3392,3403,3592,3475,3611,3649 ,3782,2835,3176,3197,3401,3242,3431,3439,3601,3274,3472,3495,3633,3532,3661,367 5,3809,3312,3509,3544,3677,3575,3691,3724,3826,3618,3728,3753,3847,3767,3867,38 88,3966,2239,2651,2712,3058,2784,3088,3132,3359,2820,3148,3182,3393,3215,3411,3 419,3596,2896,3199,3240,3420,3273,3468,3488,3629,3311,3503,3531,3667,3557,3684, 3711,3810,2953,3256,3297,3493,3348,3525,3521,3687,3369,3548,3562,3706,3603,3725 ,3736,3849,3408,3577,3615,3733,3630,3759,3768,3871,3654,3779,3798,3893,3830,391 0,3930,3991,2994,3319,3351,3552,3388,3571,3604,3729,3464,3616,3640,3764,3645,37 72,3789,3884,3478,3641,3651,3786,3688,3796,3822,3907,3717,3829,3839,3916,3858,3 937,3949,4000,3505,3697,3709,3811,3738,3832,3844,3924,3754,3856,3872,3944,3889, 3956,3971,4018,3800,3874,3894,3959,3913,3975,3981,4030,3925,3986,3996,4036,4007 ,4044,4054,4075,2320,2743,2802,3151,2890,3196,3233,3449,2913,3246,3283,3471,331 6,3498,3539,3713,2980,3301,3357,3518,3380,3568,3558,3720,3397,3582,3608,3749,36 38,3761,3775,3879,3107,3370,3399,3567,3463,3600,3621,3765,3470,3639,3648,3777,3 662,3791,3804,3902,3480,3657,3681,3802,3716,3821,3837,3918,3734,3852,3857,3938, 3873,3950,3962,4012,3125,3460,3466,3631,3481,3643,3666,3795,3508,3689,3707,3816 ,3727,3833,3855,3934,3614,3715,3739,3838,3755,3864,3875,3946,3794,3876,3895,396 0,3914,3974,3980,4029,3646,3758,3785,3865,3801,3891,3904,3965,3824,3909,3920,39 79,3933,3987,3999,4039,3842,3926,3941,3995,3954,4002,4011,4046,3967,4015,4022,4 052,4027,4061,4063,4083,3139,3484,3496,3710,3599,3723,3735,3850,3624,3748,3762, 3868,3788,3883,3901,3963,3650,3774,3799,3886,3813,3905,3921,3977,3834,3931,3919 ,3984,3948,3998,4006,4042,3718,3807,3820,3911,3848,3923,3940,3992,3862,3942,395 3,4003,3961,4008,4019,4051,3890,3957,3970,4013,3982,4024,4028,4059,3988,4035,40 38,4065,4045,4068,4070,4080,3756,3823,3861,3943,3882,3952,3958,4009,3899,3972,3 976,4021,3985,4025,4037,4062,3903,3983,3993,4034,4005,4040,4041,4069,4017,4047, 4050,4071,4057,4076,4078,4088,3935,4001,4004,4043,4020,4048,4053,4073,4026,4058 ,4060,4077,4066,4079,4084,4090,4032,4064,4067,4081,4072,4082,4085,4091,4074,408 6,4087,4092,4089,4093,4094,4095];
wobei die Sequenz Z3 gegeben ist durch:
[0,1,2,7,3,8,12,25,4,11,14,29,17,34,36,79,5,13,15,33,20,40,49,84,23,48,44,91,59,100,106 ,170,6,18,22,42,24,47,53,93,30,57,61,101,74,113,119,187,35,63,77,117,82,126,136,199, 90,138,149,224,155,236,257,366,9,19,27,56,31,60,73,108,37,78,65,120,87,130,143,207, 46,76,89,137,95,146,154,231,104,157,173,247,186,264,280,404,55,92,102,153,115,164, 180,260,124,181,198,273,210,296,311,436,141,205,228,300,234,312,334,463,253,341,3 60,485,378,505,540,721,16,26,32,75,41,81,85,142,50,88,96,152,105,163,167,259,58,97, 107,165,118,179,195,275,129,196,206,290,230,307,329,453,67,111,125,185,131,197,21 3,301,150,226,235,315,252,340,354,483,166,244,261,346,274,373,381,502,297,392,420, 531,441,557,613,722,71,127,145,216,161,232,251,344,171,254,266,365,281,380,402,52 2,193,277,291,390,313,415,438,566,324,444,467,588,491,623,644,818,212,303,318,424, 348,451,471,606,377,479,503,635,532,648,697,870,401,513,542,674,554,713,735,914,6 10,746,771,905,797,950,1007,1188,21,38,43,94,51,98,109,178,52,110,121,188,133,208, 218,327,66,122,134,221,147,229,242,328,156,240,258,359,278,376,385,501,69,144,158, 223,175,245,262,375,184,271,282,387,294,413,429,552,183,292,305,411,323,440,455,5 90,350,474,493,622,511,642,679,856,80,169,176,268,191,287,304,405,201,310,317,437, 335,462,478,619,255,330,349,466,367,489,510,638,395,517,546,671,570,711,738,897,2 86,362,389,499,410,529,549,699,433,561,578,719,614,758,781,936,469,612,625,772,63 9,799,764,963,686,851,872,1019,881,1077,1108,1225,86,189,194,322,246,339,352,473, 270,357,369,495,394,520,545,702,284,391,409,521,423,550,573,726,445,581,604,751,6 37,777,816,971,326,414,428,571,454,597,628,766,494,629,645,813,688,794,863,1023,5 28,665,708,852,727,879,901,1059,759,910,908,1100,965,1123,1149,1303,361,442,475,6 31,518,647,677,828,547,700,714,874,745,885,907,1073,574,732,767,899,782,912,967,1 125,826,979,1001,1156,1039,1197,1220,1381,620,774,809,969,861,973,1031,1167,868, 1025,1063,1211,1092,1242,1285,1439,886,1079,1117,1257,1138,1292,1272,1458,1183, 1324,1346,1513,1392,1543,1579,1673,28,45,54,103,62,123,135,214,68,139,148,220,160 ,238,243,370,70,159,168,237,177,288,298,400,202,299,321,434,338,457,477,634,72,174 ,190,293,204,319,332,449,215,343,355,481,372,506,525,650,227,364,383,516,406,543,5 59,693,416,553,583,730,587,750,776,1011,112,203,211,336,222,356,371,498,249,386,3 96,536,419,564,580,705,267,399,427,556,447,585,593,740,465,594,603,779,664,801,84 4,1024,285,446,459,601,487,626,632,789,509,662,682,825,718,858,876,1065,535,696,7 29,877,761,895,940,1094,808,946,981,1128,1003,1163,1201,1375,116,219,239,382,265, 397,422,568,279,431,450,596,470,609,616,784,309,461,486,617,507,657,676,819,533,6 90,716,867,742,888,923,1067,333,497,524,680,560,710,707,890,575,734,748,916,791,9 42,958,1132,607,763,804,952,821,991,1005,1169,849,1021,1047,1213,1098,1247,1287, 1442,351,539,563,737,591,756,792,948,654,806,833,997,838,1009,1035,1194,667,835,8 47,1029,892,1045,1085,1240,931,1096,1115,1259,1147,1306,1332,1468,691,903,920,10 69,959,1102,1121,1277,983,1143,1172,1322,1204,1349,1386,1524,1051,1176,1216,135 8,1252,1398,1414,1571,1280,1429,1455,1591,1492,1626,1668,1784,132,250,272,432,30 6,458,482,641,316,490,514,660,538,685,724,925,345,527,567,703,584,754,743,935,598, 769,796,977,830,993,1015,1185,408,577,600,753,653,787,811,999,659,831,842,1017,86 0,1037,1057,1230,668,854,883,1055,929,1083,1110,1262,954,1136,1145,1308,1174,133 5,1366,1506,418,651,656,823,670,837,865,1043,694,894,918,1075,944,1104,1141,1298, 802,927,961,1113,985,1158,1178,1327,1041,1181,1218,1360,1254,1395,1411,1567,840, 989,1027,1160,1053,1208,1235,1372,1090,1244,1267,1408,1295,1432,1465,1604,1119, 1282,1314,1452,1344,1475,1503,1635,1378,1517,1539,1659,1559,1700,1710,1847,425, 673,683,921,786,938,956,1134,814,975,995,1165,1033,1192,1227,1369,845,1013,1049, 1199,1071,1237,1269,1404,1106,1290,1264,1423,1330,1461,1489,1617,933,1061,1081, 1249,1130,1274,1311,1445,1154,1316,1341,1478,1363,1496,1528,1654,1206,1352,1384 ,1510,1417,1547,1563,1689,1436,1587,1600,1722,1630,1739,1752,1822,987,1088,1152, 1319,1190,1338,1355,1499,1223,1389,1401,1536,1426,1551,1595,1705,1232,1420,1448 ,1583,1485,1608,1612,1745,1521,1640,1649,1758,1679,1792,1806,1896,1300,1472,148 2,1621,1532,1644,1664,1771,1555,1684,1694,1799,1728,1814,1856,1920,1575,1716,17 33,1830,1764,1838,1865,1933,1778,1875,1885,1948,1907,1964,1984,2008,10,39,64,140 ,83,151,182,283,99,172,200,308,225,337,347,526,114,192,209,331,248,363,407,541,269 ,403,384,565,452,592,611,778,128,233,263,374,276,398,426,572,314,443,460,595,508,6 33,649,815,342,468,519,643,537,669,695,841,562,701,728,891,741,913,951,1133,162,2 41,295,439,320,456,504,618,353,523,472,652,551,678,712,857,393,515,558,698,579,72 0,739,904,605,747,783,934,812,964,992,1187,435,569,599,736,636,762,800,957,663,80 3,839,980,862,1018,1046,1231,706,853,898,1028,909,1048,1084,1266,945,1095,1124,1 293,1151,1317,1357,1534,217,289,325,512,368,534,544,709,412,555,582,733,608,760,7 70,955,448,586,615,765,646,798,832,984,675,834,855,1008,902,1040,1076,1253,480,62 7,666,810,681,836,869,1030,731,893,911,1052,943,1093,1114,1291,768,928,960,1103,9 82,1144,1155,1313,1020,1171,1210,1347,1238,1376,1434,1535,496,672,717,875,757,90 6,941,1099,780,947,968,1131,994,1153,1186,1337,827,986,1010,1168,1050,1203,1234, 1385,1068,1241,1271,1409,1301,1444,1464,1613,866,1032,1058,1215,1105,1251,1276, 1427,1150,1286,1315,1456,1348,1469,1514,1651,1184,1326,1359,1493,1373,1527,1546 ,1681,1431,1556,1576,1675,1597,1704,1740,1841,256,358,379,576,417,589,621,795,42 1,624,655,817,687,859,878,1072,476,658,689,884,723,900,924,1074,744,922,953,1122, 988,1148,1161,1312,488,715,749,889,788,930,962,1146,807,976,996,1164,1016,1200,1 222,1370,805,1012,1036,1198,1066,1236,1256,1410,1109,1279,1302,1443,1325,1463,1 497,1641,530,775,790,972,824,1004,1034,1189,843,1044,1056,1233,1086,1265,1284,14 40,949,1078,1107,1270,1135,1297,1323,1459,1175,1331,1364,1490,1390,1526,1549,16 70,1002,1127,1166,1310,1196,1345,1367,1515,1228,1380,1399,1533,1435,1565,1584,1 696,1273,1433,1446,1577,1460,1598,1570,1713,1504,1637,1652,1747,1658,1782,1800, 1859,548,820,829,1064,932,1091,1112,1278,974,1120,1137,1305,1173,1334,1362,1518, 998,1170,1195,1336,1214,1368,1393,1538,1243,1402,1425,1560,1457,1581,1611,1718, 1070,1202,1221,1391,1255,1418,1449,1572,1304,1450,1466,1609,1505,1594,1646,1749 ,1343,1484,1523,1638,1540,1657,1672,1772,1566, 1678, 1677, 1795, 1714, 1808, 1821,189 3,1126,1239,1281,1451,1333,1467,1495,1620,1365,1516,1529,1653,1554,1661,1676,17 80,1394,1544,1573,1671,1585,1680,1715,1809,1619,1723,1736,1825,1760,1845,1857,1 924,1441,1578,1606,1717,1645,1719,1755,1831,1650,1751,1774,1852,1790,1867,1886, 1944,1662,1783,1804,1873,1816,1889,1880,1951,1839,1902,1911,1968,1928,1976,1986 ,2007,302,388,430,602,464,661,692,871,484,704,725,882,755,917,926,1139,492,752,77 3,915,793,1006,1022,1182,846,1026,1062,1229,1089,1258,1283,1454,500,785,822,1014 ,850,1060,1080,1248,873,1097,1116,1288,1142,1318,1340,1470,896,1129,1159,1329,11 91,1361,1377,1509,1205,1371,1403,1542,1407,1558,1580,1742,630,848,864,1087,887,1 118,1140,1309,937,1162,1177,1353,1209,1383,1400,1520,970,1180,1219,1374,1246,14 06,1413,1550,1268,1415,1424,1582,1483,1599,1632,1750,1000,1245,1261,1422,1296,1 447,1453,1590,1321,1481,1500,1618,1531,1642,1655,1775,1351,1512,1541,1656,1568, 1669,1698,1791,1605,1702,1724,1810,1737,1828,1848,1922,640,880,919,1157,966,117 9,1212,1388,990,1224,1250,1416,1275,1430,1437,1586,1042,1263,1294,1438,1320,147 7,1494,1614,1350,1507,1530,1648,1552,1663,1687,1776,1082,1307,1339,1498,1379,15 25,1522,1665,1396,1545,1557,1682,1592,1699,1709,1812,1428,1569,1602,1706,1615,1 730,1738,1832,1636,1748,1765,1853,1794,1869,1887,1945,1111,1356,1382,1548,1412, 1564,1593,1703,1474,1603,1624,1734,1628,1741,1757,1844,1486,1625,1634,1754,1666 ,1763,1787,1866,1692,1793,1803,1874,1820,1894,1905,1954,1508,1674,1685,1777,171 1,1796,1807,1882,1725,1818,1833,1901,1849,1912,1926,1971,1767,1835,1854,1915,18 71,1930,1936,1983,1883,1941,1950,1989,1961,1997,2006,2027,684,939,978,1226,1038, 1260,1289,1462,1054,1299,1328,1480,1354,1502,1537,1688,1101,1342,1387,1519,1405 ,1562,1553,1695,1419,1574,1596,1721,1622,1731,1744,1840,1193,1397,1421,1561,147 3,1589,1607,1735,1479,1623,1631,1746,1643,1759,1770,1861,1487,1639,1660,1769,16 91,1786,1801,1876,1707,1815,1819,1895,1834,1906,1918,1966,1207,1471,1476,1616,1 488,1627,1647,1762,1511,1667,1683,1781,1701,1797,1817,1891,1601,1690,1712,1802, 1726,1826,1836,1903,1761,1837,1855,1916,1872,1929,1935,1982,1629,1729,1753,1827 ,1768,1851,1863,1921,1789,1868,1878,1934,1890,1942,1953,1992,1805,1884,1898,194 9,1910,1956,1965,1999,1923,1969,1975,2004,1980,2013,2015,2035,1217,1491,1501,16 86,1588,1697,1708,1813,1610,1720,1732,1829,1756,1843,1860,1919,1633,1743,1766,1 846,1779,1864,1879,1932,1798,1888,1877,1939,1904,1952,1960,1995,1693,1773,1785, 1870,1811,1881,1897,1946,1824,1899,1909,1957,1917,1962,1972,2003,1850,1913,1925 ,1967,1937,1977,1981,2011,1943,1988,1991,2017,1998,2020,2022,2032,1727,1788,182 3,1900,1842,1908,1914,1963,1858,1927,1931,1974,1940,1978,1990,2014,1862,1938,19 47,1987,1959,1993,1994,2021,1970,2000,2002,2023,2009,2028,2030,2040,1892,1955,1 958,1996,1973,2001,2005,2025,1979,2010,2012,2029,2018,2031,2036,2042,1985,2016, 2019,2033,2024,2034,2037,2043,2026,2038,2039,2044,2041,2045,2046,2047];
wobei jede der Sequenznummern von N polarisierten Kanälen in der zweiten Sequenz einer Zuverlässigkeitsrangfolge der Sequenznummer in der ganzen Sequenz entspricht, und ein Minimumwert der Sequenznummern der polarisierten Kanäle 0 ist.

3. Polar-Polar-Code-Codierungseinrichtung (300), umfassend:
einen Prozessor (402, 502), der konfiguriert ist, um das Verfahren nach Anspruch 1 durchzuführen.

4. Einrichtung (300) nach Anspruch 2 oder 3, wobei die Polar-Code-Codierungseinrichtung (300) ein Chip oder eine integrierte Schaltung ist,

5. Drahtlose Vorrichtung, umfassend die Codierungseinrichtung (300) nach einem der Ansprüche 2 bis 4, einen Modulator und einen Sendeempfänger, wobei
der Modulator konfiguriert ist, um eine codierte Bit-Sequenz zu modulieren, um eine modulierte Sequenz zu erhalten; und
der Sendeempfänger konfiguriert ist, um die modulierte Sequenz zu verarbeiten,

6. Vorrichtung nach Anspruch 5, wobei der drahtlose Vorrichtung ein Endgerät (112) oder eine Netzwerkvorrichtung (110) ist.

7. Kommunikationssystem, wobei das Kommunikationssystem eine Netzwerkvorrichtung (110) und ein Endgerät (112) umfasst, und die Netzwerkvorrichtung (110) oder das Endgerät (112) konfiguriert sind, um das Verfahren nach Anspruch 1 durchzuführen.

8. Computerspeichermedium umfassend Anweisungen, die, wenn sie durch einen Computer ausgeführt werden, den Computer veranlassen, das Verfahren nach Anspruch 1 vorzunehmen.

9. Computerprogrammprodukt, umfassend Anweisungen, die, wenn das Programm durch einen Computer ausgeführt wird, den Computer veranlassen, das Verfahren nach Anspruch 1 vorzunehmen.

## Revendications

1. Procédé de codage de code polaire, comprenant :
l'obtention (201), par un appareil de codage (300), d'une première séquence utilisée pour coder K bits à coder, dans lequel la première séquence comprend des numéros de séquence de N canaux polarisés, les numéros de séquence des N canaux polarisés sont disposés en la première séquence basée sur la fiabilité des N canaux polarisés, K est un entier positif, N est une longueur de code mère d'un code polaire, N = 2ⁿ, n est un entier positif et K ≤ N ;
la sélection (202) des numéros de séquence de K canaux polarisés à partir de la première séquence par ordre décroissant de fiabilité ; et
le placement (203) des bits à coder sur la base des numéros de séquence sélectionnés des K canaux polarisés, et la réalisation d'un codage de code polaire sur les bits à coder ;
dans lequel la première séquence est toute une seconde séquence, la seconde séquence comprend des numéros de séquence de Nₘₐₓ canaux polarisés, les numéros de séquence des Nₘₐₓ canaux polarisés sont disposés dans la seconde séquence en fonction de la fiabilité des Nₘₐₓ canaux polarisés, Nₘₐₓ est un entier positif, Nₘₐₓ≥ N, et un tri des numéros de séquence des canaux polarisés dans la première séquence est cohérent avec un tri des numéros de séquence des canaux polarisés qui sont inférieurs à N dans la seconde séquence ;
**caractérisé en ce que**
la seconde séquence est une partie ou l'ensemble d'une séquence Q1, une séquence Q2 ou une séquence Q3 ;
où la séquence Q1 est donnée par
[0,1,2,4,8,16,32,3,5,64,1024,2048,4096,9,6,17,10,18,128,12,33,65,20,256,34,24,36,7,129 ,66,512,11,40,68,130,19,13,48,14,72,257,1025,21,132,35,258,26,2049,513,80,37,25,22,4 097,136,260,264,38,514,96,67,41,144,28,69,42,516,49,1026,74,272,160,520,288,528,19 2,544,70,44,131,81,2050,50,73,15,320,133,52,1028,23,134,384,76,4098,137,82,56,27,97 ,39,259,84,138,145,261,1032,29,43,2052,98,515,88,140,30,146,71,262,265,161,576,45,1 040,100,640,51,148,46,75,4100,266,273,517,2056,104,162,53,193,1056,152,77,164,768, 268,274,518,54,83,57,521,1027,112,135,2064,78,289,194,85,276,4104,522,58,168,1029, 139,99,86,60,280,89,290,529,2080,524,196,1088,141,101,147,176,142,530,321,31,200,1 033,4112,90,545,292,2051,322,532,263,149,102,105,1030,304,296,163,92,47,267,385,5 46,2053,324,1041,208,386,4128,150,153,165,106,55,1034,328,536,577,548,2112,113,15 4,79,269,1042,108,578,224,166,519,552,195,4099,1152,270,3072,641,523,275,580,291, 59,1036,169,560,114,277,156,2057,87,197,1057,116,170,4101,61,531,525,642,281,1089 ,278,526,2054,177,293,388,91,1044,584,769,198,172,120,4160,201,2065,336,1280,62,2 82,143,103,178,294,1058,93,644,2058,202,592,323,1048,392,5120,297,770,107,180,151 ,1060,2066,209,284,648,94,204,298,1031,400,608,352,2176,6144,325,533,1153,155,210 ,305,547,300,1090,109,2060,184,534,537,115,167,1536,4105,225,326,306,772,2081,157 ,1035,656,329,110,117,212,1064,171,2113,776,4102,330,226,549,1092,538,387,308,216 ,2068,1154,416,271,279,158,337,1043,4113,550,672,2304,118,332,579,1037,540,389,17 3,121,1072,2082,553,199,784,4106,179,1038,228,338,312,2072,704,390,1096,174,554,5 81,393,1281,4114,283,2084,122,448,353,1045,561,203,63,340,2055,1156,394,527,582,4 224,556,181,1059,2177,295,285,232,124,1282,205,182,643,2114,4108,562,1050,286,58 5,299,1537,354,211,2560,401,185,1104,396,344,4129,586,645,2059,1061,593,535,240,2 06,1049,95,2088,327,564,4161,1046,800,402,356,307,2116,1160,301,417,213,568,1284, 832,4116,2178,588,186,1288,646,404,227,896,2067,1062,594,418,4352,302,1538,649,7 71,2061,360,539,1120,111,331,214,1091,2096,4130,309,188,449,1065,217,408,2062,60 9,596,1168,551,650,4120,229,1052,2120,159,420,310,1093,541,773,2305,610,4132,106 6,657,333,119,1540,3073,600,339,218,1073,368,652,4103,230,2069,1098,391,313,450,1 296,542,2180,334,233,4225,1184,555,774,175,2083,1544,123,658,612,1312,2306,4162, 341,777,220,1552,314,424,2074,395,1216,673,583,4608,355,1568,2561,287,183,234,10 94,125,557,2128,4107,660,1068,616,342,316,2085,1155,241,778,1105,563,4136,345,20 73,452,1074,397,403,207,2070,1097,674,4164,558,1039,785,432,2184,357,1344,187,23 6,664,4226,2308,1157,624,587,1076,780,2312,705,126,1047,4115,242,565,1158,2086,3 98,346,456,1408,358,2562,4109,405,1100,303,569,244,2144,1161,595,189,4144,1106,5 66,2115,676,361,1080,706,589,2089,1051,4110,215,786,647,1121,2192,348,419,1063,4 06,4168,464,2076,680,1283,801,362,1108,2117,590,4353,409,1162,570,2090,788,597,1 169,572,219,5121,2564,1285,311,708,1053,598,2097,601,1067,4117,651,421,3074,792, 1122,802,611,1539,2122,4228,602,410,1112,231,688,2320,1164,653,248,4131,1054,220 8,369,190,364,1170,654,2568,4354,659,1095,335,480,2336,1286,315,221,1289,4122,25 76,370,613,1185,422,425,2240,1600,6145,451,614,1069,2592,543,235,1124,412,4609,2 118,343,372,1664,775,317,2092,1075,222,4176,426,1172,2179,453,237,1070,559,2129, 4133,833,1099,804,712,2098,1290,834,661,4121,1297,2121,808,779,1541,617,1128,206 3,4118,604,433,1186,720,2368,816,1077,4232,836,347,2181,1217,897,243,1176,2100,4 356,662,454,1101,318,3076,675,1188,618,4360,898,2071,1792,781,376,2182,1292,4134 ,428,1298,665,2432,736,1542,567,840,4610,2124,1078,625,238,1107,2185,359,4192,45 7,1081,399,2130,787,1545,591,1136,4163,2104,678,434,1159,2075,677,349,4137,1102, 245,2145,458,1313,666,1218,4240,2087,620,363,1109,2307,127,191,4124,1300,782,213 2,1546,407,436,1082,4165,2186,626,571,1192,2193,465,1163,681,4138,246,2309,1123, 707,350,3080,4612,1110,599,1084,668,2077,790,1304,4145,460,2091,249,1113,682,131 4,2146,5122,573,411,1553,2563,803,789,1548,4170,709,2136,1220,365,440,2188,1165, 4368,628,1125,689,2078,374,1171,4256,423,2194,466,1200,793,2119,1166,4616,250,37 1,1554,2310,481,1345,574,4384,2313,413,1055,603,2209,1224,4624,366,468,1114,2624 ,655,1569,900,4288,2093,805,1316,615,3088,1346,4640,684,710,2148,1556,429,1287,4 166,2688,794,252,1173,373,2099,1126,4140,605,848,2196,1129,690,1328,4227,2094,71 3,1320,632,2123,482,4177,1187,806,2314,1116,427,904,6146,2321,1071,414,1291,2565 ,223,663,4146,1409,2152,692,1570,835,2210,4169,1348,619,472,2101,1232,455,4111,1 410,2241,796,809,1174,3104,4416,714,1177,721,2200,1189,837,4229,716,2125,1130,86 4,1079,2212,4148,810,1352,606,2816,912,5124,1560,722,2316,1601,696,1572,4119,232 2,377,435,1137,2566,817,4230,1178,319,2102,1103,621,1293,4480,2131,812,484,1132, 2105,430,4172,1602,838,2569,1248,667,4233,3075,488,1190,239,2160,1543,4178,378,1 576,2183,459,1219,622,4152,2126.627,1294,437,2337,4123,1665,380,2242,1547,818,12 99,4193,2133,461,496,1604,2324,4135,669,1315,2570,679,1083,724,4355,2106,1193,84 1,629,2216,4180,1584,351,1138,3077,467,1301,4234,2187,438,1180,737,2147,4241,111 1,251,1221,2134,462,4357,442,2108,1140,441,1194,2328,5128,469,1085,2137,247,1555 ,4125,683,2338,1549,842,1666,4139,2577,738,899,2572,1305,6148,670,1302,2244,783, 1550,3136,4194,849,1201,820,2189,1317,4611,728,2149,1412,928,1115,4184,2195,791, 367,2224,1608,4236,901,1793,2190,630,1222,4126,2578,685,1196,844,2369,4242,1144, 633,2079,1225,711,4167,1360,2248,253,1086,3081,4358,691,1306,824,2138,1167,4361, 902,2593,1127,686,740,4257,2340,1202,850,2370,1318,4672,375,2580,1117,444,1668,4 141,2311,470,1226,2197,483,5136,1616,415,2150,1347,485,4196,2153,1416,905,3078,1 321,4736,795,1794,2352,473,4147,1131,2344,634,1204,2211,4244,744,1175,852,2140,1 233,4142,960,2095,1308,865,2315,4171,1672,693,2433,1118,4362,797,1228,2594,906,1 322,4369,2372,715,1424,3089,807,4613,1632,474,2256,1376,6152,636,2434,1349,694,2 198,4200,1557,254,2201,1179,717,4258,2213,1234,575,1329,4149,2154,913,1571,2103, 798,4289,1324,3082,811,1133,5152,2376,379,1208,2584,697,4248,1558,431,2625,607,4 173,489,2596,1561,866,2161,4260,1139,723,2202,1191,4864,486,2127,1249,908,2317,4 364,1350,718,1330,3090,4370,813,1796,2156,476,4614,1181,2626,856,1680,2272,4150, 839,1353,2214,725,4179,1134,2567,698,1141,2600,4153,914,1236,2243,752,4617,1195, 3200,868,1800,5123,2318,819,1354,2689,4208,814,1250,439,2571,1573,4231,929,2323, 1562,490,6160,2628,1411,623,2339,4174,1332,671,2107,1240,4385,739,3084,1440,916, 2217,4290,1295,463,2608,1303,4181,843,2162,1182,381,4372,2325,1361,497,2204,461 8,1574,930,2135,1696,4154,821,2245,1142,726,4264,3105,1356,1603,2164,5125,961,22 18,1564,872,2109,4235,1413,492,2579,1197,4195,631,2573,1145,729,4182,2690,1577,7 00,2329,4156,1223,443,3137,1808,4376,741,2326,1203,845,4185,2574,1252,920,2225,4 386,1362,382,2341,1336,4625,822,2436,1728,2139,6176,1414,851,3092,1198,4620,730, 2632,1578,498,4292,2817,1605,880,5184,2246,1417,742,2220,4237,1307,445,2168,114 6,4197,2249,471,1472,2384,4243,1377,635,3328,1585,4272,932,2110,1227,687,4238,23 30,1087,903,2191,4626,1364,2151,825,4417,1418,2226,500,1551,4127,2342,1606,846,3 106,4296,1580,745,2141,1205,5129,2692,826,1319,2250,4186,732,1309,2640,4641,446, 1256,2371,1148,4388,3096,962,1229,2440,6147,936,1206,2345,4418,475,1667,2818,85 3,4628,2155,1586,867,2228,4359,1310,1609,2199,637,4245,1323,3108,907,4198,2257,1 378,487,2332,4201,1235,695,2696,5126,1425,2142,1209,746,4400,2252,1420,828,2346, 4392,1368,3079,753,4259,1610,2448,854,1669,4188,2656,1617,2400,857,4143,1559,23 73,504,4363,1264,2581,799,3201,4481,1230,1119,2203,4642,255,1351,2258,964,6149,2 353,1588,909,4420,2595,1824,719,2348,5137,1426,3138,1380,4304,477,2157,1331,915, 4482,2232,1325,2582,4246,638,1441,2585,1237,4249,2163,748,1592,4261,2215,944,18 56,3584,4202,869,2273,1612,4151,1210,2374,491,5130,2354,1670,699,2820,4424,1428, 1251,2205,4632,754,3083,1920,858,4673,2704,1618,2377,4644,478,1442,2158,6208,13 26,968,2165,1673,4209,2260,383,1795,4250,3112,910,2219,4175,1384,1563,2824,815,4 365,2378,1135,976,5138,2274,1355,2597,4204,1238,870,3140,1333,4674,2586,917,121 2,4320,2435,1473,2356,4262,727,1241,2264,493,4615,3202,1432,873,4648,2464,1633,2 319,4291,1620,701,2327,5248,1575,2206,931,4366,1674,2385,1253,3091,7168,756,118 3,2598,4737,860,2720,1444,4619,1334,2166,499,4371,2380,1565,731,2627,4676,1797,3 085,1634,4387,823,2588,1681,4155,2437,922,1357,5132,2221,1143,2169,4265,874,162 4,3120,4656,918,2601,1363,4210,2247,1242,502,2832,4373,1392,2227,933,4252,1676,3 086,1254,6153,2276,743,1415,4183,2386,1337,2360,4293,760,2752,1474,5153,881,243 8,1566,4212,3144,1358,494,4266,2222,1257,2602,4157,702,2629,1579,4627,1798,2441, 921,4621,3329,1199,501,4738,2331,1147,2170,4377,1682,2496,876,5185,1636,2401,13 65,4374,3093,847,1801,2609,4622,992,2251,6150,1244,2111,1338,4273,447,2388,1448, 4389,3204,1419,2442,4484,733,1697,2575,4187,827,2630,1607,5140,2604,1379,934,46 80,2229,1311,3107,4865,1207,2343,882,4294,1258,2333,937,4268,2280,1149,2172,421 6,1581,963,3330,4297,1684,2253,1640,6161,2230,747,1366,4432,2691,505,2610,5376,1 340,3098,1265,4158,855,2334,4378,1802,2633,1587,4239,2347,924,3585,4199,1369,73 4,2402,4274,1476,2259,1421,4390,2449,829,1427,5154,2233,1231,3152,4189,965,2444, 4740,1698,2392,1582,6154,938,2634,1809,4298,2693,1456,3109,4688,884,1381,2641,4 419,506,2583,5144,1211,2288,1260,4488,2254,749,1688,4393,3097,1648,2143,4866,94 5,2375,1611,4203,2612,1804,4276,966,3094,1729,4247,2848,1150,2450,5156,755,2404, 1266,6162,859,2355,4305,1589,3208,1422,4380,2349,940,2465,4744,1370,2261,4190,1 480,830,2616,4300,1382,3332,1429,4394,2880,911,2636,5127,1327,1593,4496,2234,87 1,3336,4704,1268,2694,1619,4448,2452,639,6272,2275,1213,1590,4421,2944,888,3110, 4629,1700,2642,5249,1385,2466,479,4251,2350,1730,3586,4306,1613,946,4401,2697,1 239,2819,4643,750,2408,4396,1810,2587,1671,5186,3168,969,2159,4205,1372,1443,61 56,2379,508,2262,4280,1430,3139,4630,1488,2357,861,4633,2236,1704,2497,4211,182 5,757,4263,3113,1386,2265,5632,1614,2456,4321,970,2657,1433,4422,2644,1594,3216, 4402,919,2599,4868,1812,1621,2698,6177,1596,2277,4253,875,3100,1243,5131,2207,1 335,4752,2468,862,2358,4425,1732,3141,4206,1622,2589,758,4213,1625,2821,4308,16 75,2658,948,5160,3114,1445,4267,2705,1816,2381,6209,977,2167,4872,1826,3588,163 5,4426,2648,923,4322,2387,1626,2266,4645,1434,972,5188,3121,1255,2416,4634,1712, 2700,4483,761,2278,1677,4404,3146,1272,4312,2439,877,6164,2361,1393,2498,5250,1 214,3344,4512,1388,2590,952,4367,2382,1678,4375,2281,1683,495,4254,3232,1359,44 33,2603,1504,5139,2822,703,2223,4646,1339,3592,4768,1245,2171,935,6400,2706,139 4,4214,2660,1637,4428,3360,978,2389,4675,1446,2825,5133,1449,2268,1475,4636,360 0,883,4485,2362,1638,4269,2472,1567,2443,4217,762,3264,5168,1259,2721,6178,1436, 2631,503,4649,2403,1367,4295,3616,1396,4880,2335,925,2231,4275,1799,2282,5134,1 341,3142,4324,1246,2173,878,4434,2605,1450,4408,2708,1477,6168,3116,735,2664,48 00,1261,2390,4486,1583,2364,5192,1857,3203,4270,993,2289,1828,4650,2826,1736,46 77,3153,885,4489,2611,1858,2393,5377,1685,2500,4379,939,3122,6180,1832,2445,421 8,1803,2451,1641,4544,2255,994,4449,3145,1628,5141,2722,1457,4657,2606,980,3087, 4299,1744,2833,4159,1840,2480,4436,1860,2405,6151,926,3392,5252,1371,2235,1921, 4490,2284,764,4623,2712,1267,4678,3205,1686,4652,2672,1478,2635,4277,941,3124,5 155,1342,2828,6273,1699,2753,4391,967,2174,4381,1642,3095,4328,1922,2290,1805,4 220,2613,886,5378,1400,1452,4301,3206,831,4278,2446,1689,4739,2394,1760,6210,25 04,1591,3456,4658,947,2406,5146,1864,2453,4382,1649,3148,4681,507,2351,4395,126 2,2617,5633,1383,2292,4450,1481,3209,889,4307,2643,1423,6656,2237,1811,4497,315 4,1615,4281,2614,984,5200,2724,1702,4492,2409,1458,4440,3128,751,4682,2754,1701, 4741,2637,1373,3099,6155,1269,2263,5157,942,2834,4689,1482,2695,4631,1690,3169, 4336,1644,2396,4302,996,2467,5145,1387,3111,4191,1151,2454,6184,1215,2512,4423, 971,2728,4660,1806,3331,5142,1431,2849,4896,890,2410,1460,4498,3156,1650,4452,2 638,1595,4403,2457,509,6212,3210,1489,5256,2618,1705,4397,2836,1270,4513,2645,9 49,4309,3217,1731,4664,2620,1374,5380,2267,1623,4928,3333,973,6274,2359,1692,46 84,2756,1814,4282,3101,1484,5384,2646,1000,4742,2649,1273,4500,3115,1706,4323,2 699,1597,4992,2469,892,6163,2840,1435,5158,3170,1827,4690,2850,1813,4514,2659,9 50,4398,3587,1733,5634,2650,1389,4745,2458,1464,4867,3160,863,6157,2279,2736,44 56,1652,4635,3212,1713,5216,2701,1398,4207,2296,759,4427,3102,1447,4310,2417,14 90,5187,2238,1817,6192,2412,1008,4405,3218,1274,4284,2702,1395,4545,2707,1505,5 161,3143,510,4313,2383,1598,4504,2528,3334,6158,1437,2363,4705,1627,4692,2269,9 79,5264,3337,1390,4647,2418,1492,4746,2661,1679,4325,3233,953,5148,2470,1924,62 16,2473,1829,4255,3648,1639,4516,2499,4406,2662,763,5189,3117,1708,4637,2591,17 34,4869,2283,1453,6401,3172,974,4706,2460,1818,5162,2391,1276,4753,2420,4429,13 97,3712,4215,2823,1629,5636,2365,954,7169,3123,1872,4696,2270,1714,4435,2474,43 14,1737,3220,5169,879,2501,4464,1656,2285,4748,3118,1506,4326,2607,1830,6165,28 81,5194,981,3147,4487,1451,2852,4409,1928,2760,4546,1438,3338,5392,2882,982,463 8,2709,6276,1247,3345,4430,1687,2856,4329,1716,2827,5280,1859,3589,4651,927,487 0,2665,3176,4271,1643,2652,6179,1496,2481,5640,1479,3234,4219,995,4754,2768,182 0,4708,2864,1833,5408,3125,2884,6402,1738,4437,2395,1745,4873,3265,765,4316,294 5,1861,5648,2291,4410,3224,1740,4520,2710,1888,6170,2502,956,4491,3149,5312,183 4,2366,4769,1630,2723,4679,3236,1936,4451,2666,5664,1746,2946,6657,887,3840,438 3,1720,2829,4279,1401,4330,2424,3340,5190,1459,2476,4221,1841,3346,4653,985,622 4,2713,1343,4756,2784,3590,5164,1645,4712,2615,1836,4438,2888,997,4412,3126,150 8,6181,2673,5251,2286,1454,4337,3155,1862,4874,2407,5201,1691,2505,4659,986,312 9,4441,2447,6169,1512,2835,4548,1263,3593,5170,1402,4493,2639,3184,4499,1483,27 26,4303,943,6166,2482,1646,5193,3207,1651,4770,2725,2397,4654,1461,5135,3150,14 04,4881,2293,4528,891,2506,6280,3361,1842,4453,2714,5440,1485,3266,4283,1520,26 68,4332,1693,4760,2411,3157,6404,998,2175,5253,1703,4720,2239,1748,4683,3348,28 30,5172,1865,4876,3594,766,6408,2455,1653,4801,2484,4222,3130,1375,5143,2674,43 38,1491,2619,4661,1462,3240,5254,2513,6182,511,3211,4494,1761,4442,2729,1275,45 52,2294,3171,5504,1486,4454,2755,1466,6658,2398,4501,1465,3158,5196,2647,988,43 99,3132,4665,1493,2716,4340,1271,6240,2838,3352,5257,1707,2508,4691,1866,4285,2 297,3161,5202,1001,4662,2730,1762,6211,3362,1923,4772,2621,4457,2459,1694,5176, 3601,4802,1807,2851,4685,951,6185,2837,3596,5147,1873,2757,4311,1844,4882,3268, 2413,4743,1752,5217,2488,1952,6288,3213,4444,1002,2676,4515,3173,5159,1815,2737 ,4502,1391,4560,2422,3219,6172,1925,2471,4776,1654,5379,2514,1709,4897,3248,445 8,2841,893,5204,3214,6213,1868,2298,4686,2419,4505,1657,3602,5258,1735,4666,252 9,3393,6186,1277,4884,2622,975,4693,2461,5265,1715,3103,4668,2651,4315,1848,327 2,6660,1926,5381,2414,2516,4407,1710,4804,3162,894,5149,2703,4694,3617,1764,619 3,2948,4697,1874,2853,5163,3364,4747,1399,2663,4517,1468,7170,3394,2732,4888,14 94,5218,2758,1009,4898,3604,4707,2477,1507,5635,3335,6218,1439,2842,4698,2300,4 506,1509,3221,5208,1929,4327,2421,3174,4784,1819,6416,2653,955,5260,2896,4749,3 177,4344,1497,2738,5150,1658,6304,3376,2761,4465,1768,4286,3368,1876,4460,2680, 5266,2530,1984,4750,3235,6664,1004,4755,2854,3164,5191,1889,4431,2475,1717,4576 ,2952,6432,3119,1821,5382,2462,4411,1930,3339,4317,2271,5385,1010,6672,2711,173 9,4466,3457,4709,2740,1831,5281,3618,4518,2883,4521,1498,3396,6336,1660,5696,26 67,2520,4547,1718,4710,3280,957,5165,2503,6688,3458,4639,1278,2844,4331,1741,52 20,2857,3222,4508,1599,6214,2762,4439,3225,1937,4468,2769,5760,1822,3237,4871,2 885,4413,983,6188,2764,1835,5171,3178,4318,2912,4522,1403,3127,5268,2858,6275,1 721,3400,4549,1455,4333,2654,5166,2960,1631,4655,3608,6225,1513,2770,4929,3649, 5195,958,4900,2744,3620,4808,1890,6194,2425,5386,1747,2483,4930,3185,4757,1510, 5393,2865,3226,6217,1932,4904,2367,4875,1742,3151,5637,2669,4713,987,3341,5224, 2860,6159,1837,4700,2532,1500,4529,3180,5282,2478,4816,1880,3650,6464,2886,4912 ,1863,5173,3296,1749,4932,2715,4443,2536,6277,1012,3238,5313,2287,4993,1722,433 9,3591,1938,5272,2426,6196,3624,4758,1776,2507,4550,3267,5197,1892,4414,2670,71 72,1843,2675,4771,3342,5284,1838,4714,2485,3713,4994,999,6167,2428,5888,1463,35 95,4877,2866,4472,1953,6278,3347,2509,5388,1514,4524,2544,5394,3652,4761,1647,2 717,6528,1695,4832,3363,5638,2727,1763,4663,3131,4936,2772,6220,1016,3241,5174, 2889,4721,1940,4334,2677,5203,1487,3632,6281,2399,4455,1867,4553,3186,5177,2515 ,1405,4495,3349,6226,2486,4883,1521,3228,5641,2785,4687,767,5232,3159,6200,1954, 2299,4774,3269,4530,1845,5255,2510,6171,2490,1750,4773,3188,4445,2489,5198,1985 ,4341,3242,1896,6241,2517,4554,3133,5409,1516,4762,2295,3603,5314,1655,6183,273 1,4716,3597,4459,989,2890,5205,3714,6403,1753,4223,2786,4287,2947,1724,5396,335 3,4878,1467,6228,2718,5642,3350,1765,4503,2831,4532,3598,5178,1869,6282,2897,47 22,3249,1944,4667,2868,5288,3365,6289,1003,4561,2776,3460,5259,1406,4777,2976,4 342,3163,6405,1846,5219,2839,1875,4803,2415,4446,3656,7176,1754,5206,2949,3841, 4695,1522,5180,2678,4764,3270,6173,1904,4886,2733,3244,5400,990,4556,2892,6187, 3192,4345,1766,5209,2681,3273,4778,1469,5410,2759,6242,3408,4669,1495,4507,2301 ,5649,3134,1659,6659,2739,4899,3354,4885,1956,5644,2872,4805,3215,1711,6232,295 0,5316,3175,4461,1927,4536,2734,6284,1005,5261,2788,3250,4724,1849,5221,2898,47 85,3366,6174,1524,4470,2423,5267,3165,1870,4519,2492,6290,3716,4562,1769,5296,2 518,4889,3274,6215,1850,2531,5262,3664,4346,1756,4467,2463,5650,3395,6406,1470, 4577,2533,3464,5441,959,4670,2953,6409,3369,4509,1986,5151,2843,4699,3842,6305, 1960,2521,5320,3179,4462,1499,4564,2682,5210,3252,6720,1877,4751,2792,5665,3223 ,1891,4996,2900,6189,3281,4901,3008,5412,1661,4711,3356,7184,2913,5442,1931,478 0,3720,2741,4806,1011,6244,3166,5652,2845,4525,1511,5383,3276,6784,2954,4890,17 19,4348,3370,5269,2763,1770,4469,3472,6195,2855,5222,1852,4701,3680,4944,2522,6 292,1777,5225,3424,4786,2684,5424,1878,3397,6190,2742,4809,1881,5416,3605,4728, 2302,6219,1013,4578,3227,5283,2765,4902,1528,6410,3282,5212,2623,3377,4523,1823 ,5000,2961,6417,3619,5167,1279,4510,2846,5387,3372,6661,1988,4319,2859,4759,318 1, 5505,1933,6248,2427,4788,3256,1743,5666,2745,4931,3606,6306,1501,5444,2479,47 15,2655,4568,2537,6197,1939,5328,3609,4551,2914,5506,895,6337,3187,4892,2771,49 05,1662,3239,5270,2534,7200,1772,4810,3297,5273,2956,4817,1968,6296,3398,5285,2 766,4933,3378,4812,1893,6221,2861,5226,3844,4960,1515,5175,2524,6308,3229,4906, 1723,5448,2904,4702,3728,6912,1778,5008,2887,3401,5656,1882,4818,2773,6412,3182 ,5697,2746,4792,1006,5668,3189,6418,2962,4473,1502,4531,3284,5233,2800,6662,199 2,4913,3243,5274,2916,4415,3848,6198,1407,5199,2867,4717,3402,5389,1934,6227,28 62,4908,3298,4580,1839,5228,2487,6201,3621,4526,2000,5698,2977,4934,3610,6665,2 538,5344,1894,4763,3459,7171,2671,4584,1941,5286,3380,4335,2719,6256,1014,5639, 3288,4474,2787,5672,3488,6279,1751,4555,2964,5315,3343,4718,1517,6222,2511,4723 ,3351,5390,2891,1897,4533,6433,3230,5761,2429,4476,1725,6338,3409,5643,2545,491 4,1955,5395,3622,6229,2978,4557,3744,4592,1780,5700,2869,6420,3190,4765,1884,54 11,2774,6666,3404,4775,1523,5179,3651,4820,3009,6202,3612,5289,1755,4937,2920,4 725,3461,6312,1017,5680,2540,4447,3245,5234,2679,7173,1847,4563,3193,5397,2777, 6283,1946,4534,3625,5276,2748,4833,3271,6243,1898,5207,2491,4347,3856,5317,1942 ,6230,2789,4558,3251,4538,2893,6204,1526,5236,3300,4537,2968,5290,1957,6424,456 5,3410,5181,2430,6233,3384,4343,1767,5651,2870,4779,3776,6434,1784,5645,3462,49 38,2899,5762,3246,6673,1905,4834,2778,4995,3626,6668,1018,5401,2546,4766,3653,5 398,2928,6340,1518,4879,3465,2790,1726,5646,3355,7232,2493,4945,3194,5297,1945, 4916,2519,6285,3520,5413,1525,4824,3425,6245,2683,5508,3633,5024,1900,5211,2980 ,6291,3275,4887,2735,4463,1871,6320,3135,5704,2951,4997,2016,3412,5889,2873,628 6,3466,4726,1471,5318,2548,6674,3599,4781,1757,5292,3654,4940,2894,6465,3628,52 40,1851,4729,2793,6175,3253,5321,2874,4807,991,5456,3367,6344,2780,4349,1958,51 82,3357,7177,2494,4787,3304,5402,1906,4920,3196,6234,3010,5263,3277,4998,1961,6 689,2984,5223,3254,4782,2523,4836,1987,6436,3715,5298,2901,4946,1771,6466,3634, 5414,2915,4471,3358,6676,1529,5213,3657,4540,2685,5764,3371,6407,1879,4566,2955 ,5322,3426,6293,2535,4579,1948,5712,3283,4511,2743,6246,1758,5443,3473,4581,325 7,6249,2794,5512,1853,5001,3468,7174,2876,5417,3416,4891,1020,5890,2801,6448,36 58,4569,2902,5227,1989,6440,3717,4730,3665,5300,1962,6307,2905,4840,3607,5271,2 552,4948,1908,6236,3312,5329,2847,5056,3278,6191,1530,5404,3167,4961,2303,6411, 3399,5768,1773,4789,3012,6529,3636,5214,2957,4893,1969,5324,3872,6690,2767,5002 ,3474,5418,1990,6468,3428,4811,2525,5520,3379,7185,1779,4903,2963,5728,3373,457 0,2686,6352,5472,1883,4732,3489,6530,3285,5445,2796,4790,1964,6294,3640,5653,29 92,4350,3904,6297,1854,5275,2917,4813,3660,6309,3258,5330,1935,4671,2539,5425,3 718,6250,2747,5009,1007,5667,3476,6199,4894,3299,5420,2802,7178,1895,4907,3968, 5229,2906,6472,3666,4475,1663,5304,2526,6680,3490,4793,3374,5654,1912,4527,3016 ,6721,3721,4703,2431,4585,6692,1503,5657,3843,4962,2958,6257,3432,5235,1970,481 9,3611,6298,2863,5287,3183,4582,1774,6223,3024,5345,3403,5004,3286,6413,5446,19 93,4814,2918,5426,3381,7186,2965,4909,1532,5892,3260,6252,3521,4572,2775,5277,1 885,6722,3289,4952,5776,2541,6368,3480,4935,1781,5449,2921,6310,3681,4821,3668, 5230,1994,6663,2749,4794,3623,5237,6696,2979,5010,3722,5332,1943,6339,3301,4848 ,2804,5291,3231,7296,1015,4964,2908,5896,3492,6414,4915,3382,5450,1899,6785,254 7,4910,3613,5346,2779,4535,1886,6667,3845,5669,5025,3682,6419,2871,5658,3729,45 86,1782,6724,2970,5507,3405,4719,3191,6435,1972,5428,4767,2922,6203,3672,5336,2 966,4835,2001,7180,3411,5536,3290,5012,2550,6313,5391,1947,4559,3440,6704,2981, 5399,3724,4939,3302,6258,1996,5278,4477,2791,6421,3463,5457,3385,4593,1785,6300 ,2808,5670,3522,5026,6231,2929,5792,1901,4917,3614,6341,3406,5238,2542,4822,330 5,7201,5452,1976,5699,2750,6260,3627,5057,3846,6314,1519,5660,2969,4968,6205,32 47,5509,2549,4588,3195,6675,1727,5293,3730,4727,6669,2924,5241,3684,4825,1959,6 786,3413,5673,2895,4796,3849,6425,5319,3040,4539,2002,7233,3292,5904,3386,4837, 2495,6422,5299,1019,4941,3496,6670,3467,5348,2781,5016,6321,3745,5458,1907,4478 ,2875,6437,3655,5432,3427,4918,6532,1786,5824,2982,6235,3359,5510,3255,4947,293 0,7188,5294,1527,4826,3306,6728,2985,5674,3197,4594,6913,1949,5701,3629,4976,30 11,6342,3732,5513,3688,4838,6316,1902,5403,2795,4541,3414,6264,2553,5242,6345,3 388,4567,1759,5568,3313,6480,2903,5473,4731,3850,7424,2017,5681,3635,5028,2972, 6206,5323,3417,4783,2782,6426,1909,5183,3524,4999,6287,3469,5460,2877,6247,3475 ,4921,1963,5514,6322,3279,4596,3013,5647,3746,6438,2018,5702,4942,3630,7202,298 6,5676,3857,4841,3504,6237,5301,2004,6788,2932,4922,3429,5415,6346,2554,4828,32 59,5405,1950,6736,3308,4542,5352,2797,6467,3736,5244,3696,7192,5058,1788,5325,2 993,6536,3659,5032,3852,5302,6441,3014,4571,1965,5763,3777,6914,4949,3198,6251, 2803,5682,3314,4963,1991,6324,5406,2907,5705,3637,6295,3470,4733,5419,2988,7204 ,1021,5003,3418,6353,5474,3528,4583,2878,6428,1910,5331,4791,3430,6792,3477,552 1,2959,6238,3375,5305,4842,1855,6348,3641,5516,2919,4924,6442,3316,5464,3667,71 75,1971,4849,5706,2687,6544,3261,4950,3638,5765,6752,2936,5713,1531,6496,3748,4 953,5655,3433,6469,2527,4600,3778,5360,6677,1913,4895,3661,7297,2994,5326,5215, 3287,6299,2798,4351,5447,3858,6354,2008,5060,3719,6449,5684,3017,5005,3420,6691 ,3491,5920,4815,1775,6444,2556,5522,3478,7234,5476,3536,4573,2909,6253,5427,196 6,5011,3752,6328,3873,5421,6678,2805,4734,3434,5537,2020,6681,5333,3662,6259,30 18,4844,5688,3481,6311,3642,5040,1995,5952,7680,2967,4965,3860,6369,3669,5708,5 306,3644,6470,2923,4587,6450,1914,5766,3291,4795,3383,6916,5524,2910,5347,3780, 6301,4850,1533,7179,3670,6016,2806,4954,6800,3673,5714,3723,6473,4574,1973,5538 ,2996,6254,5422,3493,5064,3864,6261,3025,5769,6356,3874,4479,1997,5891,7208,368 3,5006,2971,6315,3674,5480,5659,3482,6920,2024,4911,6474,3020,5231,3303,5072,63 70,3760,5451,2809,6693,5334,1916,4966,3725,7236,3320,5429,6682,2925,5013,3441,5 308,6531,3262,5569,1974,6452,4823,3436,5337,3000,6360,4589,3726,7298,3731,5528, 4969,1887,6560,2543,5729,3407,6415,5716,3552,4797,2751,6423,5671,3387,6302,1783 ,5027,5770,3293,6481,2983,5349,7187,3442,4852,3685,5279,6694,3026,4956,1022,681 6,5540,3494,5430,3497,6262,4595,3523,6476,2931,5661,4827,2032,6723,3686,5893,71 81,3615,5730,2810,4919,6684,3307,5777,3484,6533,5018,1534,5453,2551,6317,5239,3 415,6265,3444,4970,5720,2973,7216,3847,5014,6697,2003,5459,3389,6343,5338,3294, 4598,2926,6928,5488,3498,6323,3525,5029,5772,1977,7182,2783,5350,6372,3309,4839 ,3631,5511,6482,3905,5433,1787,6456,4856,3041,6848,5570,3876,4977,3784,6534,566 2,2933,7240,3906,5454,4590,1998,6318,3733,5353,6698,2987,4798,3880,6725,5675,38 51,5894,6537,3689,5017,1978,7425,5295,3042,4597,3676,6427,5243,3505,6266,3028,5 778,6592,3792,4972,1903,5732,6497,3888,5461,7189,3908,4943,2974,5897,6705,3419, 5088,3969,6347,5340,2005,6207,5434,2812,4543,3315,6484,5544,3734,7300,3526,5515 ,6538,2989,4829,5793,2006,6671,3390,4923,6726,3747,5703,3015,6700,5475,3690,503 0,6325,3970,5407,1951,7203,5303,3853,6439,2934,4978,5354,3448,6429,5033,3500,63 76,2879,5245,6268,3737,5677,2019,5059,7426,3808,5780,6349,3639,5736,2995,6326,4 843,3912,5462,6787,3697,4601,1789,6706,5436,2555,7194,5361,3310,4951,3431,6430, 5898,3529,6729,5683,2937,6443,1980,5020,7681,3471,5465,4830,3859,6498,3663,5572 ,6355,3032,5517,6545,3750,4925,3506,5523,6329,1911,5327,7248,2799,5061,3749,654 0,5794,3421,6488,5678,3317,5034,2990,6730,5905,2009,6789,5552,3530,7205,3738,49 80,5477,3692,6737,4602,3044,6679,3435,5307,6384,3199,5356,6350,2021,4845,3263,5 784,7193,3019,5744,6239,3854,5041,6471,3479,5707,2938,6708,5900,2010,5062,7190, 3508,5825,3698,6944,5246,3643,6546,4851,2557,6500,5362,3537,4955,3753,6451,5685 ,1967,7304,5518,3318,6445,5036,2997,6561,3779,5466,6357,3422,5576,4926,3671,671 2,5478,3021,7428,1915,5525,6976,3740,5007,6732,3862,5423,5689,3532,6330,3048,49 67,7432,3321,5364,6790,3754,5715,6548,2022,4735,3645,6371,5309,2940,5686,7040,3 483,4984,7206,3875,5796,6738,3861,5481,1790,6562,4575,2998,6446,5826,3781,7682, 5709,3437,5042,3512,6793,5335,2911,6915,4846,3700,6504,5906,1535,6683,5767,3761 ,7264,3446,5065,6255,2807,5468,5539,3495,6475,4604,3538,6358,5526,3865,7235,558 4,3056,6453,1023,4957,6332,3322,5800,6593,3443,5921,4853,3553,7209,5482,2558,63 61,5710,3646,6552,3485,5066,6753,2012,5529,6740,3675,5690,7312,3027,5015,6695,3 438,5908,5717,3540,6794,3727,5692,6373,3001,4971,7196,2025,5339,6303,3972,5431, 6564,3877,4958,6454,3687,5828,7237,2811,5718,6685,3756,4854,3782,5721,6917,1975 ,5771,6754,3501,5044,7210,3022,5541,6801,3866,5912,6477,3324,5073,6263,3445,592 2,7684,3677,5731,6744,3002,5019,6483,2026,5722,3920,6362,5530,3762,5068,7217,37 85,5351,6512,2927,5808,6796,3704,4857,6374,3554,5773,7242,1917,5368,6535,3878,4 973,6457,3029,5489,6594,3499,5310,7440,3976,5484,6686,3486,5048,6478,3030,5774, 6377,3295,5779,1999,4591,7328,3735,5455,6699,3764,5600,6918,3907,4799,6319,2975 ,5435,7688,3691,5341,6267,3544,5031,6802,3527,5490,6756,1918,5733,7456,3043,507 4,6485,3868,5542,6921,3881,5545,6364,3786,5571,7696,3793,4979,6458,2813,5734,65 68,3909,5663,6539,2033,4858,7360,3788,5355,6817,3936,5532,6727,3004,4599,6499,3 882,5463,7712,3678,5492,6431,3984,5021,6327,3794,5895,6378,1979,5437,7238,2935, 5342,6269,3768,4974,6701,3449,5546,6804,5573,3507,7212,4831,3889,6760,5357,3033 ,6486,5679,3391,6460,5953,2028,7299,5089,3693,6385,5924,3884,6922,5832,3045,724 9,4981,3556,6707,5954,3502,6489,5781,3910,6596,5035,3739,7218,5928,2034,6541,58 99,3034,6547,5737,6351,3560,5090,7241,3311,5724,6818,3450,5553,6702,3531,5076,7 183,2991,5840,6929,3694,5936,6576,1981,5956,6501,3699,5022,7488,3509,5467,6331, 6017,3452,6380,4860,2939,6808,5363,3890,7301,5782,3533,6768,5574,3568,6731,5037 ,3741,7220,5438,2007,6924,5795,6849,3046,5063,6270,3751,5738,7191,3796,6018,638 6,3913,5901,6709,2814,4982,5496,3701,5548,7302,4927,3423,6542,5785,3539,6490,58 56,1982,6600,5687,3510,7552,5043,2559,6502,5960,6549,3809,5745,7244,3323,4603,6 447,3534,5358,6713,3514,5479,6388,3513,5577,7305,4985,2011,6739,5519,3036,6333, 5907,3541,7250,5711,3319,6710,5080,3755,6820,5798,6505,3914,5554,7224,3049,4847 ,6850,3810,5797,6733,3971,5469,7195,5365,3742,6359,5038,2036,6930,5578,3855,679 1,5786,2999,7265,5740,6492,3921,5092,6563,3892,5483,7207,3800,5247,6550,5311,40 00,6608,5067,3050,6824,5902,3863,7427,5527,2023,6945,4986,6506,3439,5556,7252,3 973,5746,6734,3702,5691,6553,4605,3757,7306,5585,2941,6714,5801,3916,6932,5366, 6741,3705,5045,7313,3783,5827,6716,2040,5470,6363,5719,3325,7429,5069,3023,6455 ,5788,3763,6852,5910,7197,3896,5580,6742,3974,5096,6745,5369,3758,7211,5802,294 2,6795,5693,3812,6565,4988,6936,3922,5531,7266,1791,5923,6946,3447,5909,6755,50 46,3516,7683,5829,3542,6746,5485,6554,3057,5560,7256,3555,4959,6375,3487,6832,5 748,7308,3557,5809,6797,3977,5494,6392,4855,3867,7198,5543,2013,6513,5586,6334, 3003,5913,6508,3545,5104,7314,3706,5370,6798,5491,3816,6803,5601,3924,7239,4606 ,6479,4032,5694,6624,3052,7430,5533,6459,3937,5723,6365,3765,5075,7433,5486,202 7,6514,5588,3869,6757,5775,7329,3978,5049,6566,3058,6020,6569,5925,3787,7744,57 35,3879,6595,6758,4859,3546,7213,5804,3708,6687,5830,6379,3766,5549,7268,3005,5 070,6556,5914,2014,6487,5372,3326,6516,5493,7808,3789,6919,5725,6461,3647,5050, 7219,3985,5968,6366,5810,3870,6570,5833,3031,7316,4975,6597,3883,5752,6381,3451 ,7214,5602,6703,3769,5926,6977,5077,3503,7243,5547,2029,6948,6024,6856,3679,553 4,7434,3561,6978,5078,6805,3006,5343,7441,5783,3938,6952,5812,3795,6923,5955,76 85,3558,5023,6761,3980,7272,5739,6748,3790,5592,6577,5575,3035,7330,5091,3885,6 864,5916,6960,1983,5929,7221,6980,3548,5834,6491,3928,5841,7361,4861,3911,7041, 5957,6387,3797,7320,5836,3060,6806,5984,6598,3770,5052,7245,5930,3986,6462,5726 ,6819,3824,7332,6032,3940,6762,5842,7042,3891,4983,7936,5816,2035,6925,5497,388 6,6520,7436,5555,3047,6572,5937,7442,3511,5081,6809,5439,4001,6880,7686,5741,35 62,6711,5932,3695,6984,5093,7222,3743,5604,6769,6382,3811,5550,7251,5958,3064,6 503,5787,3988,6601,5082,7225,3535,6543,5608,6931,2037,5359,7689,5498,3915,6735, 7280,5579,3453,6822,5039,3569,6578,5742,7303,2815,5747,6821,6493,4002,5557,7246 ,5500,3893,6389,4987,6602,3798,7457,5938,6810,4033,5581,7362,5616,3944,6764,578 9,3564,6507,7253,5094,3703,6271,5799,6335,1919,5844,7444,6926,3037,5961,7690,48 62,3801,6551,5749,6580,3772,7226,5471,6770,3515,5587,6715,5558,3813,7336,6609,4 607,3917,7307,5857,6825,3992,5371,6390,7267,3051,5582,6851,5562,3454,6494,5561, 7254,3894,6743,5084,7228,3923,5589,6812,5367,3802,6934,7448,5803,2030,6604,5962 ,6393,3570,7257,5097,6826,3952,5858,7458,6019,3038,6717,6555,5790,3814,7697,590 3,6947,3517,5047,6933,7692,3543,5969,6853,5940,3707,7364,6509,5848,4004,6584,60 48,7309,3759,5098,6772,7269,3975,5911,6833,5487,3053,6518,7315,6021,3897,6567,5 750,6610,2038,5805,7344,6937,3572,4989,7310,5964,3918,6394,6515,5753,3817,7698, 5831,6625,7489,3898,5373,6718,5071,3804,6557,5811,7199,3518,6747,5944,7368,3007 ,6022,6510,6612,4034,5806,7258,4990,4008,6799,7713,5860,3547,7044,5970,6949,746 0,3925,5495,6759,5564,3939,7490,6828,5590,2041,6854,5105,7700,3709,6573,5603,74 31,5535,3979,6938,6396,5605,3059,7317,6025,6517,3559,7270,5915,6749,3767,5051,6 992,7273,5593,3818,6834,5754,7472,3900,6857,5864,7464,3825,5972,6776,6626,3926, 6080,7331,5100,6950,3929,7260,5985,6571,3061,5813,7048,7215,3576,5917,6558,6026 ,7435,3871,6367,5106,6807,3327,5835,7553,6836,2042,5927,7714,6979,5594,4036,749 2,5756,6763,3981,6616,5814,7376,3791,5053,6599,7554,5374,3549,6940,5837,6953,39 87,7318,5695,6858,7321,2943,6033,6865,5918,3710,7333,6981,5079,3820,6860,5931,7 274,7008,4016,5499,7223,6954,3941,5817,7496,5551,6750,3563,7056,5727,7704,3771, 5609,6866,7745,5054,3826,6840,7716,5986,3930,6521,5843,6579,7281,2015,5606,6961 ,7322,3054,6028,6463,5838,7247,3550,6765,5083,7437,4040,6956,5933,6628,5596,345 5,7276,6574,5976,7746,3982,6982,5959,7392,3887,5845,6811,6632,5108,4048,7334,63 83,5818,3942,7687,6034,6522,7720,3989,5872,6603,7363,5988,3062,6766,5939,6771,3 799,7438,5934,6581,7809,3565,5095,6524,5559,3945,7691,6962,6049,7443,3773,6605, 5610,6640,7748,4003,5743,6813,5791,7459,2044,6823,5859,7227,3828,6868,5112,7337 ,6985,3932,6036,6773,5583,7728,3571,6495,5963,7282,3803,6611,5501,7445,6582,306 5,5617,7324,6881,4863,3895,7255,6050,6395,7365,3994,5941,6606,6586,5846,3946,72 84,6585,6081,3990,7338,5992,6613,7229,3574,5612,6391,7699,5751,4005,6827,7693,5 085,6986,3815,7810,5849,6882,7043,3832,5820,7449,5563,6814,3953,7446,5861,6927, 7694,3066,5965,6993,7345,6040,3566,6964,7461,5099,2031,6872,7556,5502,7072,3774 ,7259,5942,6935,5971,3993,6511,7752,5850,7045,3573,7937,5618,6774,7366,3948,600 0,6829,7340,5086,3919,6988,7288,5862,6777,4064,7369,5565,6855,7504,3519,5591,63 97,7230,5755,3805,6835,7450,6052,6968,3899,7311,5807,7046,7271,6023,3039,6830,5 101,6884,7346,4006,5945,6994,7462,5620,3954,6519,7261,5966,6588,4009,7812,5865, 6614,7370,4035,5946,6627,7760,5852,3819,6559,7491,5566,6629,3577,7560,5055,7049 ,7465,6082,3927,6939,7938,6056,6617,2039,7275,5595,6778,7348,3996,5973,6888,731 9,5987,3806,6996,7377,7104,5757,7452,3901,7009,6027,7816,6837,3068,5107,7262,69 41,5607,4037,7372,7050,5815,7466,6859,4010,5866,7568,6951,5948,3956,7776,6618,5 873,7520,3578,6780,5974,7493,6838,5977,3821,7701,6398,5109,7323,4017,6861,5624, 7378,6719,4038,7473,5919,7057,7715,5375,3827,6942,7468,6084,6955,3931,7277,6029 ,6523,7352,5839,4012,6841,7702,5597,6575,3902,6751,6633,6035,7705,7010,3983,499 1,7283,6867,5758,3055,7335,6630,5868,7393,7052,3943,6064,7494,6862,7474,3711,59 89,6957,7940,5611,6620,3960,7325,5819,7000,7824,5874,2043,6983,7497,5978,6869,3 551,7278,6842,5102,7285,7058,4018,5598,7380,6896,6088,7339,3822,7012,7944,5503, 6963,4041,7498,6030,6958,7394,5935,3580,6583,7717,6096,7073,7706,3933,6634,5990 ,7555,6767,6037,3829,7476,6815,5110,7384,6883,4042,7584,5847,7060,7439,3991,561 3,6607,7447,6987,5993,3063,7326,6525,5821,7505,6641,3947,6051,7718,7074,7840,58 76,3934,6965,7286,5980,6870,7500,3830,5619,7747,7105,7708,5851,4020,7016,7557,5 113,6636,7341,4049,6775,5943,7289,6873,6042,3995,7721,6844,7367,5994,6587,4044, 7952,6038,6885,7347,6989,3833,5622,7396,7064,6053,7506,3949,6526,7480,5863,6966 ,7872,4024,5880,7558,6995,7342,6001,3567,6874,7722,5114,6642,7749,2045,7024,561 4,7561,6886,5822,7451,3775,6589,7290,6041,6615,7616,4007,5621,7521,6779,7729,59 96,4050,7076,7371,6831,5967,7231,3067,7047,6112,7508,6969,7562,5567,3955,6644,7 695,5853,7750,6990,3834,7724,5947,6889,7349,6970,5087,3575,7463,6876,6054,7453, 6590,3997,7400,6002,7292,7106,7373,3950,6057,7080,7350,6619,6083,7811,3807,6997 ,5867,7730,7011,7454,4065,5625,7753,6781,7467,5975,7051,3957,7522,6631,6044,737 9,6839,4011,5854,7569,7353,6890,5949,7564,4066,6972,7512,5116,6897,7754,6998,40 52,6085,7813,7761,6058,7001,3998,7703,6648,6004,7408,6943,7374,3836,5626,7263,6 399,7495,5869,7108,4013,7732,7053,6065,7968,6863,7570,4039,6086,7524,6621,7475, 5875,7059,3069,7469,6782,5979,7585,7381,3958,6892,6060,7736,7088,8000,5950,3903 ,7013,7756,7354,6031,6635,7814,4019,6843,5103,7572,7395,6898,5991,3579,8064,700 2,7762,5759,6622,7586,3961,7470,6008,7112,7817,6527,5599,7939,2046,7054,7528,60 66,7707,6959,7279,4056,5870,7120,7499,7382,6089,7014,3823,7477,7061,5628,7356,7 617,6871,4014,5981,7385,6637,7576,5877,7017,4068,7777,7764,6090,6845,7719,7075, 7818,4043,6039,7397,6900,7327,5111,7004,3962,7588,7478,5995,6643,7709,6875,3581 ,5982,7941,7778,6967,7825,5878,7066,4021,7501,7287,6068,7018,7768,7062,4045,609 7,7507,7386,6646,6043,7536,7077,4072,7820,7398,6092,6887,7559,7481,5881,3964,69 04,7618,7025,5997,7710,7502,4022,6638,7401,6072,6846,7723,7942,5615,3935,7065,7 343,6645,7291,5823,7826,7020,3831,7780,6055,7509,6991,7945,7136,6098,3070,7388, 7482,6591,5115,7592,7563,6877,4080,7841,6003,6971,7751,7523,5882,7078,3582,7455 ,7351,7026,5623,7402,7081,7293,4051,6045,7725,7107,7828,7784,5998,6891,4025,751 0,6649,7484,5855,7409,6999,7946,3835,6113,7731,7068,7513,6878,6005,7620,4046,75 65,6973,7571,6059,7375,7109,7842,4026,6114,7726,7082,7953,7600,6100,7028,7525,3 951,6650,7355,6046,7404,6893,7832,7792,4053,5884,7089,7755,7948,7110,6061,7873, 7294,4054,6899,7410,6087,7003,7733,7566,7084,3999,5117,7514,7624,6974,6006,7526 ,7573,7055,4067,7471,5951,7737,7015,7412,7763,6067,6783,3837,7357,7734,7032,562 7,7844,7529,6623,4028,7874,6009,7757,7090,7383,6894,7954,6104,3959,7815,7113,75 16,7587,5871,6652,7574,7632,4057,7005,6062,7848,7969,6901,7530,6116,7758,7114,4 069,7577,7738,6091,7063,7956,7765,7740,7019,2047,6010,7387,7479,7006,7876,5629, 7766,6902,4058,7769,7819,6069,7092,7589,7960,7121,7970,4015,6093,7779,7067,7770 ,7578,6120,7116,7399,7856,3963,6905,6012,7821,7416,7021,7537,7358,6070,4070,753 2,7096,7822,7827,5983,6639,7503,7648,6847,3838,7483,5879,7389,7079,7538,7781,71 22,5118,7590,3583,7593,7619,7027,6128,7782,7711,6906,7403,7580,3071,5630,6647,7 511,7540,7069,7943,6099,7485,7390,4060,7022,7594,7621,6073,6879,7405,7727,8001, 5883,4073,7137,7972,7880,7029,8002,6094,7829,7083,7976,4023,7947,7785,6074,7138 ,7772,7601,7124,7888,5999,7984,4074,8004,7070,7515,8065,6101,6908,7411,7830,762 2,7085,3965,6102,7486,7843,7111,7786,8066,6047,7949,7030,4047,7544,7596,6975,78 33,6115,7904,7735,7091,8008,7793,3966,5885,6651,7406,7527,7625,7033,6076,7567,7 955,7759,4081,7128,7846,7602,6007,6895,7845,7517,7413,7086,6105,4027,7626,7834, 7788,7140,7531,7295,6117,7359,7115,7950,7575,4076,7034,6106,7604,7794,7739,6653 ,7633,7849,6063,7414,4082,7093,7875,7518,7767,7117,6011,7836,7958,7628,7144,741 7,4029,7850,6118,7741,7036,7579,7971,7957,5886,7094,7877,7533,4055,7608,7007,77 96,5631,7857,7542,6903,7591,7634,7961,7152,4030,5119,7418,7539,7649,6654,7742,7 581,6108,7771,7123,7534,7636,4059,7823,7097,6121,8068,7973,7783,6907,7852,7878, 6071,7597,7118,4084,7962,7420,7541,7773,7098,6122,8016,7858,7881,7023,7800,4071 ,7650,6013,7974,7125,7595,8072,7582,7126,7391,6095,7831,7860,8003,4088,7071,778 7,7640,7623,6014,7139,7964,7977,7882,7889,6909,8005,3839,6129,7884,8032,7100,79 78,7774,8080,7890,6075,7031,7864,7545,7603,4061,7985,7129,7487,6124,7789,7980,7 141,7652,7598,8006,7835,6130,7130,4075,7656,7407,7546,7627,7087,7790,6077,7795, 7605,7548,7035,7986,7629,7664,4062,7837,6103,7142,7847,7892,8009,6910,7797,7519 ,7635,6078,7606,6655,4077,7905,7419,7630,7610,7609,6107,7132,7637,7415,7851,801 0,7145,7906,8067,7838,4031,6132,7951,7095,8017,7988,7896,8096,7146,7959,6119,75 35,8069,7798,7853,7037,4083,8012,7801,7879,6136,7421,7119,7859,7992,8070,7854,7 038,7908,8018,5887,7543,4085,7612,7638,7153,7651,7583,7653,8073,7963,6109,7099, 7641,7802,7912,8020,8128,7148,3967,8033,7861,6123,7965,8074,7154,7883,7975,7642 ,7804,7862,7101,6110,7422,7885,7743,4078,8081,7966,7127,7979,7547,7865,7599,612 5,7775,7657,7102,8034,7891,7654,8076,7886,7131,4086,7981,6079,7644,8024,8007,78 93,7156,7866,8082,7920,8036,7987,6131,7982,7143,7607,8097,7658,4089,7791,7839,7 907,7160,8084,7631,6133,8011,7549,7665,6911,8098,7989,7894,8129,8040,7660,7799, 6015,4090,7133,7897,7868,7611,7909,8013,8088,7147,7550,7990,8019,7898,6126,7666 ,8048,7134,7910,7613,7639,7803,4063,8100,7855,8071,7149,7993,6134,7668,8014,791 3,7994,7900,7614,7103,8130,8104,7643,8021,8035,6137,7805,4092,8075,7155,7655,78 63,7914,7996,7921,8022,8025,7157,7672,7967,7423,6138,8132,8077,7887,7645,8083,7 039,7806,7916,8112,4079,8037,7659,7867,7922,8026,6111,7150,7646,8136,7551,8078, 7983,8144,8038,8085,7158,7895,7661,8041,7869,8099,6140,7924,8028,4087,7667,7899 ,7161,7991,8090,8042,8086,7670,8101,7911,7928,8049,7162,7662,6127,7870,8089,766 9,8044,8015,8160,7615,7901,7995,7135,8102,4091,8050,8105,8131,7915,7673,8023,61 35,8092,7902,7997,7164,8133,8106,8052,7674,7917,8113,8134,7923,8027,8108,7998,8 079,7151,8039,7807,8056,6139,7647,8114,4093,7918,8137,7676,8029,7925,8138,8087, 7159,8043,8030,7926,8116,8145,8091,8140,7929,8045,8120,7663,6141,7871,8103,8146 ,7163,8051,7930,7671,8093,8046,7903,8161,8053,8107,4094,8162,8148,8094,7932,810 9,8135,7165,8054,7999,8115,7675,8057,6142,8152,7919,8110,8164,8139,8058,7677,81 17,8141,8168,8060,8118,8031,7927,7166,8176,7678,8147,8121,7931,8142,8122,8047,8 149,8150,8095,4095,8163,7933,8124,8055,8153,8165,6143,8154,8111,8059,8166,7934, 7679,7167,8156,8169,8119,8170,8061,8143,8062,8177,8123,8172,8178,8125,8151,8126 ,8155,8180,8167,8184,7935,8157,8171,8158,8173,8127,8179,8181,8063,8174,8182,818 5,8186,8159,8188,8175,8183,8187,8189,8190,8191] ;
où la séquence Q2 est donnée par
[0,1,2,4,8,16,32,3,5,64,1024,2048,9,6,17,10,18,128,12,33,65,20,256,34,24,36,7,129,66,5 12,11,40,68,130,19,13,48,14,72,257,1025,21,132,35,258,26,2049,513,80,37,25,22,136,2 60,264,38,514,96,67,41,144,28,69,42,516,49,1026,74,272,160,520,288,528,192,544,70,4 4,131,81,2050,50,73,15,320,133,52,1028,23,134,384,76,137,82,56,27,97,39,259,84,138, 145,261,1032,29,43,2052,98,515,88,140,30,146,71,262,265,161,576,45,1040,100,640,51 ,148,46,75,266,273,517,2056,104,162,53,193,1056,152,77,164,768,268,274,518,54,83,5 7,521,1027,112,135,2064,78,289,194,85,276,522,58,168,1029,139,99,86,60,280,89,290, 529,2080,524,196,1088,141,101,147,176,142,530,321,31,200,1033,90,545,292,2051,322 ,532,263,149,102,105,1030,304,296,163,92,47,267,385,546,2053,324,1041,208,386,150, 153,165,106,55,1034,328,536,577,548,2112,113,154,79,269,1042,108,578,224,166,519, 552,195,1152,270,3072,641,523,275,580,291,59,1036,169,560,114,277,156,2057,87,197 ,1057,116,170,61,531,525,642,281,1089,278,526,2054,177,293,388,91,1044,584,769,19 8,172,120,201,2065,336,1280,62,282,143,103,178,294,1058,93,644,2058,202,592,323,1 048,392,297,770,107,180,151,1060,2066,209,284,648,94,204,298,1031,400,608,352,217 6,325,533,1153,155,210,305,547,300,1090,109,2060,184,534,537,115,167,1536,225,326 ,306,772,2081,157,1035,656,329,110,117,212,1064,171,2113,776,330,226,549,1092,538 ,387,308,216,2068,1154,416,271,279,158,337,1043,550,672,2304,118,332,579,1037,540 ,389,173,121,1072,2082,553,199,784,179,1038,228,338,312,2072,704,390,1096,174,554 ,581,393,1281,283,2084,122,448,353,1045,561,203,63,340,2055,1156,394,527,582,556, 181,1059,2177,295,285,232,124,1282,205,182,643,2114,562,1050,286,585,299,1537,35 4,211,2560,401,185,1104,396,344,586,645,2059,1061,593,535,240,206,1049,95,2088,32 7,564,1046,800,402,356,307,2116,1160,301,417,213,568,1284,832,2178,588,186,1288,6 46,404,227,896,2067,1062,594,418,302,1538,649,771,2061,360,539,1120,111,331,214,1 091,2096,309,188,449,1065,217,408,2062,609,596,1168,551,650,229,1052,2120,159,42 0,310,1093,541,773,2305,610,1066,657,333,119,1540,3073,600,339,218,1073,368,652,2 30,2069,1098,391,313,450,1296,542,2180,334,233,1184,555,774,175,2083,1544,123,65 8,612,1312,2306,341,777,220,1552,314,424,2074,395,1216,673,583,355,1568,2561,287, 183,234,1094,125,557,2128,660,1068,616,342,316,2085,1155,241,778,1105,563,345,20 73,452,1074,397,403,207,2070,1097,674,558,1039,785,432,2184,357,1344,187,236,664, 2308,1157,624,587,1076,780,2312,705,126,1047,242,565,1158,2086,398,346,456,1408, 358,2562,405,1100,303,569,244,2144,1161,595,189,1106,566,2115,676,361,1080,706,5 89,2089,1051,215,786,647,1121,2192,348,419,1063,406,464,2076,680,1283,801,362,11 08,2117,590,409,1162,570,2090,788,597,1169,572,219,2564,1285,311,708,1053,598,20 97,601,1067,651,421,3074,792,1122,802,611,1539,2122,602,410,1112,231,688,2320,11 64,653,248,1054,2208,369,190,364,1170,654,2568,659,1095,335,480,2336,1286,315,22 1,1289,2576,370,613,1185,422,425,2240,1600,451,614,1069,2592,543,235,1124,412,21 18,343,372,1664,775,317,2092,1075,222,426,1172,2179,453,237,1070,559,2129,833,10 99,804,712,2098,1290,834,661,1297,2121,808,779,1541,617,1128,2063,604,433,1186,7 20,2368,816,1077,836,347,2181,1217,897,243,1176,2100,662,454,1101,318,3076,675,1 188,618,898,2071,1792,781,376,2182,1292,428,1298,665,2432,736,1542,567,840,2124, 1078,625,238,1107,2185,359,457,1081,399,2130,787,1545,591,1136,2104,678,434,1159 ,2075,677,349,1102,245,2145,458,1313,666,1218,2087,620,363,1109,2307,127,191,130 0,782,2132,1546,407,436,1082,2186,626,571,1192,2193,465,1163,681,246,2309,1123,7 07,350,3080,1110,599,1084,668,2077,790,1304,460,2091,249,1113,682,1314,2146,573, 411,1553,2563,803,789,1548,709,2136,1220,365,440,2188,1165,628,1125,689,2078,374 ,1171,423,2194,466,1200,793,2119,1166,250,371,1554,2310,481,1345,574,2313,413,10 55,603,2209,1224,366,468,1114,2624,655,1569,900,2093,805,1316,615,3088,1346,684, 710,2148,1556,429,1287,2688,794,252,1173,373,2099,1126,605,848,2196,1129,690,132 8,2094,713,1320,632,2123,482,1187,806,2314,1116,427,904,2321,1071,414,1291,2565, 223,663,1409,2152,692,1570,835,2210,1348,619,472,2101,1232,455,1410,2241,796,809 ,1174,3104,714,1177,721,2200,1189,837,716,2125,1130,864,1079,2212,810,1352,606,2 816,912,1560,722,2316,1601,696,1572,2322,377,435,1137,2566,817,1178,319,2102,110 3,621,1293,2131,812,484,1132,2105,430,1602,838,2569,1248,667,3075,488,1190,239,2 160,1543,378,1576,2183,459,1219,622,2126,627,1294,437,2337,1665,380,2242,1547,81 8,1299,2133,461,496,1604,2324,669,1315,2570,679,1083,724,2106,1193,841,629,2216, 1584,351,1138,3077,467,1301,2187,438,1180,737,2147,1111,251,1221,2134,462,442,21 08,1140,441,1194,2328,469,1085,2137,247,1555,683,2338,1549,842,1666,2577,738,899 ,2572,1305,670,1302,2244,783,1550,3136,849,1201,820,2189,1317,728,2149,1412,928, 1115,2195,791,367,2224,1608,901,1793,2190,630,1222,2578,685,1196,844,2369,1144,6 33,2079,1225,711,1360,2248,253,1086,3081,691,1306,824,2138,1167,902,2593,1127,68 6,740,2340,1202,850,2370,1318,375,2580,1117,444,1668,2311,470,1226,2197,483,1616 ,415,2150,1347,485,2153,1416,905,3078,1321,795,1794,2352,473,1131,2344,634,1204, 2211,744,1175,852,2140,1233,960,2095,1308,865,2315,1672,693,2433,1118,797,1228,2 594,906,1322,2372,715,1424,3089,807,1632,474,2256,1376,636,2434,1349,694,2198,15 57,254,2201,1179,717,2213,1234,575,1329,2154,913,1571,2103,798,1324,3082,811,113 3,2376,379,1208,2584,697,1558,431,2625,607,489,2596,1561,866,2161,1139,723,2202, 1191,486,2127,1249,908,2317,1350,718,1330,3090,813,1796,2156,476,1181,2626,856,1 680,2272,839,1353,2214,725,1134,2567,698,1141,2600,914,1236,2243,752,1195,3200,8 68,1800,2318,819,1354,2689,814,1250,439,2571,1573,929,2323,1562,490,2628,1411,62 3,2339,1332,671,2107,1240,739,3084,1440,916,2217,1295,463,2608,1303,843,2162,118 2,381,2325,1361,497,2204,1574,930,2135,1696,821,2245,1142,726,3105,1356,1603,216 4,961,2218,1564,872,2109,1413,492,2579,1197,631,2573,1145,729,2690,1577,700,2329 ,1223,443,3137,1808,741,2326,1203,845,2574,1252,920,2225,1362,382,2341,1336,822, 2436,1728,2139,1414,851,3092,1198,730,2632,1578,498,2817,1605,880,2246,1417,742, 2220,1307,445,2168,1146,2249,471,1472,2384,1377,635,3328,1585,932,2110,1227,687, 2330,1087,903,2191,1364,2151,825,1418,2226,500,1551,2342,1606,846,3106,1580,745, 2141,1205,2692,826,1319,2250,732,1309,2640,446,1256,2371,1148,3096,962,1229,244 0,936,1206,2345,475,1667,2818,853,2155,1586,867,2228,1310,1609,2199,637,1323,310 8,907,2257,1378,487,2332,1235,695,2696,1425,2142,1209,746,2252,1420,828,2346,136 8,3079,753,1610,2448,854,1669,2656,1617,2400,857,1559,2373,504,1264,2581,799,320 1,1230,1119,2203,255,1351,2258,964,2353,1588,909,2595,1824,719,2348,1426,3138,13 80,477,2157,1331,915,2232,1325,2582,638,1441,2585,1237,2163,748,1592,2215,944,18 56,3584,869,2273,1612,1210,2374,491,2354,1670,699,2820,1428,1251,2205,754,3083,1 920,858,2704,1618,2377,478,1442,2158,1326,968,2165,1673,2260,383,1795,3112,910,2 219,1384,1563,2824,815,2378,1135,976,2274,1355,2597,1238,870,3140,1333,2586,917, 1212,2435,1473,2356,727,1241,2264,493,3202,1432,873,2464,1633,2319,1620,701,232 7,1575,2206,931,1674,2385,1253,3091,756,1183,2598,860,2720,1444,1334,2166,499,23 80,1565,731,2627,1797,3085,1634,823,2588,1681,2437,922,1357,2221,1143,2169,874,1 624,3120,918,2601,1363,2247,1242,502,2832,1392,2227,933,1676,3086,1254,2276,743, 1415,2386,1337,2360,760,2752,1474,881,2438,1566,3144,1358,494,2222,1257,2602,70 2,2629,1579,1798,2441,921,3329,1199,501,2331,1147,2170,1682,2496,876,1636,2401,1 365,3093,847,1801,2609,992,2251,1244,2111,1338,447,2388,1448,3204,1419,2442,733, 1697,2575,827,2630,1607,2604,1379,934,2229,1311,3107,1207,2343,882,1258,2333,93 7,2280,1149,2172,1581,963,3330,1684,2253,1640,2230,747,1366,2691,505,2610,1340,3 098,1265,855,2334,1802,2633,1587,2347,924,3585,1369,734,2402,1476,2259,1421,244 9,829,1427,2233,1231,3152,965,2444,1698,2392,1582,938,2634,1809,2693,1456,3109,8 84,1381,2641,506,2583,1211,2288,1260,2254,749,1688,3097,1648,2143,945,2375,1611, 2612,1804,966,3094,1729,2848,1150,2450,755,2404,1266,859,2355,1589,3208,1422,23 49,940,2465,1370,2261,1480,830,2616,1382,3332,1429,2880,911,2636,1327,1593,2234, 871,3336,1268,2694,1619,2452,639,2275,1213,1590,2944,888,3110,1700,2642,1385,24 66,479,2350,1730,3586,1613,946,2697,1239,2819,750,2408,1810,2587,1671,3168,969,2 159,1372,1443,2379,508,2262,1430,3139,1488,2357,861,2236,1704,2497,1825,757,311 3,1386,2265,1614,2456,970,2657,1433,2644,1594,3216,919,2599,1812,1621,2698,1596, 2277,875,3100,1243,2207,1335,2468,862,2358,1732,3141,1622,2589,758,1625,2821,16 75,2658,948,3114,1445,2705,1816,2381,977,2167,1826,3588,1635,2648,923,2387,1626, 2266,1434,972,3121,1255,2416,1712,2700,761,2278,1677,3146,1272,2439,877,2361,13 93,2498,1214,3344,1388,2590,952,2382,1678,2281,1683,495,3232,1359,2603,1504,282 2,703,2223,1339,3592,1245,2171,935,2706,1394,2660,1637,3360,978,2389,1446,2825,1 449,2268,1475,3600,883,2362,1638,2472,1567,2443,762,3264,1259,2721,1436,2631,50 3,2403,1367,3616,1396,2335,925,2231,1799,2282,1341,3142,1246,2173,878,2605,1450, 2708,1477,3116,735,2664,1261,2390,1583,2364,1857,3203,993,2289,1828,2826,1736,3 153,885,2611,1858,2393,1685,2500,939,3122,1832,2445,1803,2451,1641,2255,994,314 5,1628,2722,1457,2606,980,3087,1744,2833,1840,2480,1860,2405,926,3392,1371,2235, 1921,2284,764,2712,1267,3205,1686,2672,1478,2635,941,3124,1342,2828,1699,2753,9 67,2174,1642,3095,1922,2290,1805,2613,886,1400,1452,3206,831,2446,1689,2394,176 0,2504,1591,3456,947,2406,1864,2453,1649,3148,507,2351,1262,2617,1383,2292,1481, 3209,889,2643,1423,2237,1811,3154,1615,2614,984,2724,1702,2409,1458,3128,751,27 54,1701,2637,1373,3099,1269,2263,942,2834,1482,2695,1690,3169,1644,2396,996,246 7,1387,3111,1151,2454,1215,2512,971,2728,1806,3331,1431,2849,890,2410,1460,3156, 1650,2638,1595,2457,509,3210,1489,2618,1705,2836,1270,2645,949,3217,1731,2620,1 374,2267,1623,3333,973,2359,1692,2756,1814,3101,1484,2646,1000,2649,1273,3115,1 706,2699,1597,2469,892,2840,1435,3170,1827,2850,1813,2659,950,3587,1733,2650,13 89,2458,1464,3160,863,2279,2736,1652,3212,1713,2701,1398,2296,759,3102,1447,241 7,1490,2238,1817,2412,1008,3218,1274,2702,1395,2707,1505,3143,510,2383,1598,252 8,3334,1437,2363,1627,2269,979,3337,1390,2418,1492,2661,1679,3233,953,2470,1924, 2473,1829,3648,1639,2499,2662,763,3117,1708,2591,1734,2283,1453,3172,974,2460,1 818,2391,1276,2420,1397,3712,2823,1629,2365,954,3123,1872,2270,1714,2474,1737,3 220,879,2501,1656,2285,3118,1506,2607,1830,2881,981,3147,1451,2852,1928,2760,14 38,3338,2882,982,2709,1247,3345,1687,2856,1716,2827,1859,3589,927,2665,3176,164 3,2652,1496,2481,1479,3234,995,2768,1820,2864,1833,3125,2884,1738,2395,1745,326 5,765,2945,1861,2291,3224,1740,2710,1888,2502,956,3149,1834,2366,1630,2723,3236, 1936,2666,1746,2946,887,3840,1720,2829,1401,2424,3340,1459,2476,1841,3346,985,2 713,1343,2784,3590,1645,2615,1836,2888,997,3126,1508,2673,2286,1454,3155,1862,2 407,1691,2505,986,3129,2447,1512,2835,1263,3593,1402,2639,3184,1483,2726,943,24 82,1646,3207,1651,2725,2397,1461,3150,1404,2293,891,2506,3361,1842,2714,1485,32 66,1520,2668,1693,2411,3157,998,2175,1703,2239,1748,3348,2830,1865,3594,766,245 5,1653,2484,3130,1375,2674,1491,2619,1462,3240,2513,511,3211,1761,2729,1275,229 4,3171,1486,2755,1466,2398,1465,3158,2647,988,3132,1493,2716,1271,2838,3352,170 7,2508,1866,2297,3161,1001,2730,1762,3362,1923,2621,2459,1694,3601,1807,2851,95 1,2837,3596,1873,2757,1844,3268,2413, 1752,2488, 1952,3213, 1002,2676,3173,1815,27 37,1391,2422,3219,1925,2471,1654,2514,1709,3248,2841,893,3214,1868,2298,2419,16 57,3602,1735,2529,3393,1277,2622,975,2461,1715,3103,2651,1848,3272,1926,2414,25 16,1710,3162,894,2703,3617,1764,2948,1874,2853,3364,1399,2663,1468,3394,2732,14 94,2758,1009,3604,2477,1507,3335,1439,2842,2300,1509,3221,1929,2421,3174,1819,2 653,955,2896,3177,1497,2738,1658,3376,2761,1768,3368,1876,2680,2530,1984,3235,1 004,2854,3164,1889,2475,1717,2952,3119,1821,2462,1930,3339,2271,1010,2711,1739, 3457,2740,1831,3618,2883,1498,3396,1660,2667,2520,1718,3280,957,2503,3458,1278, 2844,1741,2857,3222,1599,2762,3225,1937,2769,1822,3237,2885,983,2764,1835,3178, 2912,1403,3127,2858,1721,3400,1455,2654,2960,1631,3608,1513,2770,3649,958,2744, 3620,1890,2425,1747,2483,3185,1510,2865,3226,1932,2367,1742,3151,2669,987,3341, 2860,1837,2532,1500,3180,2478,1880,3650,2886,1863,3296,1749,2715,2536,1012,3238 ,2287,1722,3591,1938,2426,3624,1776,2507,3267,1892,2670,1843,2675,3342,1838,248 5,3713,999,2428,1463,3595,2866,1953,3347,2509,1514,2544,3652,1647,2717,1695,336 3,2727,1763,3131,2772,1016,3241,2889,1940,2677,1487,3632,2399,1867,3186,2515,14 05,3349,2486,1521,3228,2785,767,3159,1954,2299,3269,1845,2510,2490,1750,3188,24 89,1985,3242,1896,2517,3133,1516,2295,3603,1655,2731,3597,989,2890,3714,1753,27 86,2947,1724,3353,1467,2718,3350,1765,2831,3598,1869,2897,3249,1944,2868,3365,1 003,2776,3460,1406,2976,3163,1846,2839,1875,2415,3656,1754,2949,3841,1522,2678, 3270,1904,2733,3244,990,2892,3192,1766,2681,3273,1469,2759,3408,1495,2301,3134, 1659,2739,3354,1956,2872,3215,1711,2950,3175,1927,2734,1005,2788,3250,1849,2898 ,3366,1524,2423,3165,1870,2492,3716,1769,2518,3274,1850,2531,3664,1756,2463,339 5,1470,2533,3464,959,2953,3369,1986,2843,3842,1960,2521,3179,1499,2682,3252,187 7,2792,3223,1891,2900,3281,3008,1661,3356,2913,1931,3720,2741,1011,3166,2845,15 11,3276,2954,1719,3370,2763,1770,3472,2855,1852,3680,2522,1777,3424,2684,1878,3 397,2742,1881,3605,2302,1013,3227,2765,1528,3282,2623,3377,1823,2961,3619,1279, 2846,3372,1988,2859,3181,1933,2427,3256,1743,2745,3606,1501,2479,2655,2537,1939 ,3609,2914,895,3187,2771,1662,3239,2534,1772,3297,2956,1968,3398,2766,3378,1893, 2861,3844,1515,2524,3229,1723,2904,3728,1778,2887,3401,1882,2773,3182,2746,1006 ,3189,2962,1502,3284,2800,1992,3243,2916,3848,1407,2867,3402,1934,2862,3298,183 9,2487,3621,2000,2977,3610,2538,1894,3459,2671,1941,3380,2719,1014,3288,2787,34 88,1751,2964,3343,1517,2511,3351,2891,1897,3230,2429,1725,3409,2545,1955,3622,2 978,3744,1780,2869,3190,1884,2774,3404,1523,3651,3009,3612,1755,2920,3461,1017, 2540,3245,2679,1847,3193,2777,1946,3625,2748,3271,1898,2491,3856,1942,2789,3251 ,2893,1526,3300,2968,1957,3410,2430,3384,1767,2870,3776,1784,3462,2899,3246,190 5,2778,3626,1018,2546,3653,2928,1518,3465,2790,1726,3355,2493,3194,1945,2519,35 20,1525,3425,2683,3633,1900,2980,3275,2735,1871,3135,2951,2016,3412,2873,3466,1 471,2548,3599,1757,3654,2894,3628,1851,2793,3253,2874,991,3367,2780,1958,3357,2 494,3304,1906,3196,3010,3277,1961,2984,3254,2523,1987,3715,2901,1771,3634,2915, 3358,1529,3657,2685,3371,1879,2955,3426,2535,1948,3283,2743,1758,3473,3257,2794 ,1853,3468,2876,3416,1020,2801,3658,2902,1989,3717,3665,1962,2905,3607,2552,190 8,3312,2847,3278,1530,3167,2303,3399,1773,3012,3636,2957,1969,3872,2767,3474,19 90,3428,2525,3379,1779,2963,3373,2686,1883,3489,3285,2796,1964,3640,2992,3904,1 854,2917,3660,3258,1935,2539,3718,2747,1007,3476,3299,2802,1895,3968,2906,3666, 1663,2526,3490,3374,1912,3016,3721,2431,1503,3843,2958,3432,1970,3611,2863,3183 ,1774,3024,3403,3286,1993,2918,3381,2965,1532,3260,3521,2775,1885,3289,2541,348 0,1781,2921,3681,3668,1994,2749,3623,2979,3722,1943,3301,2804,3231,1015,2908,34 92,3382,1899,2547,3613,2779,1886,3845,3682,2871,3729,1782,2970,3405,3191,1972,2 922,3672,2966,2001,3411,3290,2550,1947,3440,2981,3724,3302,1996,2791,3463,3385, 1785,2808,3522,2929,1901,3614,3406,2542,3305,1976,2750,3627,3846,1519,2969,3247 ,2549,3195,1727,3730,2924,3684,1959,3413,2895,3849,3040,2002,3292,3386,2495,101 9,3496,3467,2781,3745,1907,2875,3655,3427,1786,2982,3359,3255,2930,1527,3306,29 85,3197,1949,3629,3011,3732,3688,1902,2795,3414,2553,3388,1759,3313,2903,3850,2 017,3635,2972,3417,2782,1909,3524,3469,2877,3475,1963,3279,3013,3746,2018,3630, 2986,3857,3504,2004,2932,3429,2554,3259,1950,3308,2797,3736,3696,1788,2993,3659 ,3852,3014,1965,3777,3198,2803,3314,1991,2907,3637,3470,2988,1021,3418,3528,287 8,1910,3430,3477,2959,3375,1855,3641,2919,3316,3667,1971,2687,3261,3638,2936,15 31,3748,3433,2527,3778,1913,3661,2994,3287,2798,3858,2008,3719,3017,3420,3491,1 775,2556,3478,3536,2909,1966,3752,3873,2805,3434,2020,3662,3018,3481,3642,1995, 2967,3860,3669,3644,2923,1914,3291,3383,2910,3780,1533,3670,2806,3673,3723,1973 ,2996,3493,3864,3025,3874,1997,3683,2971,3674,3482,2024,3020,3303,3760,2809,191 6,3725,3320,2925,3441,3262,1974,3436,3000,3726,3731,1887,2543,3407,3552,2751,33 87,1783,3293,2983,3442,3685,3026,1022,3494,3497,3523,2931,2032,3686,3615,2810,3 307,3484,1534,2551,3415,3444,2973,3847,2003,3389,3294,2926,3498,3525,1977,2783, 3309,3631,3905,1787,3041,3876,3784,2933,3906,1998,3733,2987,3880,3851,3689,1978 ,3042,3676,3505,3028,3792,1903,3888,3908,2974,3419,3969,2005,2812,3315,3734,352 6,2989,2006,3390,3747,3015,3690,3970,1951,3853,2934,3448,3500,2879,3737,2019,38 08,3639,2995,3912,3697,1789,2555,3310,3431,3529,2937,1980,3471,3859,3663,3032,3 750,3506,1911,2799,3749,3421,3317,2990,2009,3530,3738,3692,3044,3435,3199,2021, 3263,3019,3854,3479,2938,2010,3508,3698,3643,2557,3537,3753,1967,3318,2997,3779 ,3422,3671,3021,1915,3740,3862,3532,3048,3321,3754,2022,3645,2940,3483,3875,386 1,1790,2998,3781,3437,3512,2911,3700,1535,3761,3446,2807,3495,3538,3865,3056,10 23,3322,3443,3553,2558,3646,3485,2012,3675,3027,3438,3540,3727,3001,2025,3972,3 877,3687,2811,3756,3782,1975,3501,3022,3866,3324,3445,3677,3002,2026,3920,3762, 3785,2927,3704,3554,1917,3878,3029,3499,3976,3486,3030,3295,1999,3735,3764,3907 ,2975,3691,3544,3527,1918,3043,3868,3881,3786,3793,2813,3909,2033,3788,3936,300 4,3882,3678,3984,3794,1979,2935,3768,3449,3507,3889,3033,3391,2028,3693,3884,30 45,3556,3502,3910,3739,2034,3034,3560,3311,3450,3531,2991,3694,1981,3699,3509,3 452,2939,3890,3533,3568,3741,2007,3046,3751,3796,3913,2814,3701,3423,3539,1982, 3510,2559,3809,3323,3534,3514,3513,2011,3036,3541,3319,3755,3914,3049,3810,3971 ,3742,2036,3855,2999,3921,3892,3800,4000,3050,3863,2023,3439,3973,3702,3757,294 1,3916,3705,3783,2040,3325,3023,3763,3896,3974,3758,2942,3812,3922,1791,3447,35 16,3542,3057,3555,3487,3557,3977,3867,2013,3003,3545,3706,3816,3924,4032,3052,3 937,3765,2027,3869,3978,3058,3787,3879,3546,3708,3766,3005,2014,3326,3789,3647, 3985,3870,3031,3883,3451,3769,3503,2029,3679,3561,3006,3938,3795,3558,3980,3790 ,3035,3885,1983,3548,3928,3911,3797,3060,3770,3986,3824,3940,3891,2035,3886,304 7,3511,4001,3562,3695,3743,3811,3064,3988,3535,2037,3915,3453,3569,2815,4002,38 93,3798,4033,3944,3564,3703,1919,3037,3801,3772,3515,3813,3917,3992,3051,3454,3 894,3923,3802,2030,3570,3952,3038,3814,3517,3543,3707,4004,3759,3975,3053,3897, 2038,3572,3918,3817,3898,3804,3518,3007,4034,4008,3547,3925,3939,2041,3709,3979 ,3059,3559,3767,3818,3900,3825,3926,3929,3061,3576,3871,3327,2042,4036,3981,379 1,3549,3987,2943,3710,3820,4016,3941,3563,3771,3826,3930,2015,3054,3550,4040,34 55,3982,3887,4048,3942,3989,3062,3799,3565,3945,3773,4003,2044,3828,3932,3571,3 803,3065,3895,3994,3946,3990,3574,4005,3815,3832,3953,3066,3566,2031,3774,3993, 3573,3948,3919,4064,3519,3805,3899,3039,4006,3954,4009,4035,3819,3577,3927,2039 ,3996,3806,3901,3068,4037,4010,3956,3578,3821,4017,4038,3827,3931,4012,3902,398 3,3055,3943,3711,3960,2043,3551,4018,3822,4041,3580,3933,3829,4042,3991,3063,39 47,3934,3830,4020,4049,3995,4044,3833,3949,4024,3567,2045,3775,4007,4050,3067,3 955,3834,3575,3997,3950,3807,4065,3957,4011,4066,4052,3998,3836,4013,4039,3069, 3958,3903,4019,3579,3961,2046,4056,3823,4014,4068,4043,3962,3581,4021,4045,4072 ,3964,4022,3935,3831,3070,4080,3582,4051,4025,3835,4046,4026,3951,4053,4054,399 9,4067,3837,4028,3959,4057,4069,2047,4058,4015,3963,4070,3838,3583,3071,4060,40 73,4023,4074,3965,4047,3966,4081,4027,4076,4082,4029,4055,4030,4059,4084,4071,4 088,3839,4061,4075,4062,4077,4031,4083,4085,3967,4078,4086,4089,4090,4063,4092, 4079,4087,4091,4093,4094,4095] ;
où la séquence Q3 est donnée par
[0,1,2,4,8,16,32,3,5,64,1024,9,6,17,10,18,128,12,33,65,20,256,34,24,36,7,129,66,512,11, 40,68,130,19,13,48,14,72,257,1025,21,132,35,258,26,513,80,37,25,22,136,260,264,38,5 14,96,67,41,144,28,69,42,516,49,1026,74,272,160,520,288,528,192,544,70,44,131,81,50 ,73,15,320,133,52,1028,23,134,384,76,137,82,56,27,97,39,259,84,138,145,261,1032,29, 43,98,515,88,140,30,146,71,262,265,161,576,45,1040,100,640,51,148,46,75,266,273,51 7,104,162,53,193,1056,152,77,164,768,268,274,518,54,83,57,521,1027,112,135,78,289, 194,85,276,522,58,168,1029,139,99,86,60,280,89,290,529,524,196,1088,141,101,147,17 6,142,530,321,31,200,1033,90,545,292,322,532,263,149,102,105,1030,304,296,163,92,4 7,267,385,546,324,1041,208,386,150,153,165,106,55,1034,328,536,577,548,113,154,79, 269,1042,108,578,224,166,519,552,195,1152,270,641,523,275,580,291,59,1036,169,560 ,114,277,156,87,197,1057,116,170,61,531,525,642,281,1089,278,526,177,293,388,91,10 44,584,769,198,172,120,201,336,1280,62,282,143,103,178,294,1058,93,644,202,592,32 3,1048,392,297,770,107,180,151,1060,209,284,648,94,204,298,1031,400,608,352,325,5 33,1153,155,210,305,547,300,1090,109,184,534,537,115,167,1536,225,326,306,772,157 ,1035,656,329,110,117,212,1064,171,776,330,226,549,1092,538,387,308,216,1154,416, 271,279,158,337,1043,550,672,118,332,579,1037,540,389,173,121,1072,553,199,784,17 9,1038,228,338,312,704,390,1096,174,554,581,393,1281,283,122,448,353,1045,561,203 ,63,340,1156,394,527,582,556,181,1059,295,285,232,124,1282,205,182,643,562,1050,2 86,585,299,1537,354,211,401,185,1104,396,344,586,645,1061,593,535,240,206,1049,95 ,327,564,1046,800,402,356,307,1160,301,417,213,568,1284,832,588,186,1288,646,404, 227,896,1062,594,418,302,1538,649,771,360,539,1120,111,331,214,1091,309,188,449,1 065,217,408,609,596,1168,551,650,229,1052,159,420,310,1093,541,773,610,1066,657,3 33,119,1540,600,339,218,1073,368,652,230,1098,391,313,450,1296,542,334,233,1184,5 55,774,175,1544,123,658,612,1312,341,777,220,1552,314,424,395,1216,673,583,355,15 68,287,183,234,1094,125,557,660,1068,616,342,316,1155,241,778,1105,563,345,452,10 74,397,403,207,1097,674,558,1039,785,432,357,1344,187,236,664,1157,624,587,1076,7 80,705,126,1047,242,565,1158,398,346,456,1408,358,405,1100,303,569,244,1161,595,1 89,1106,566,676,361,1080,706,589,1051,215,786,647,1121,348,419,1063,406,464,680,1 283,801,362,1108,590,409,1162,570,788,597,1169,572,219,1285,311,708,1053,598,601, 1067,651,421,792,1122,802,611,1539,602,410,1112,231,688,1164,653,248,1054,369,19 0,364,1170,654,659,1095,335,480,1286,315,221,1289,370,613,1185,422,425,1600,451,6 14,1069,543,235,1124,412,343,372,1664,775,317,1075,222,426,1172,453,237,1070,559, 833,1099,804,712,1290,834,661,1297,808,779,1541,617,1128,604,433,1186,720,816,10 77,836,347,1217,897,243,1176,662,454,1101,318,675,1188,618,898,1792,781,376,1292, 428,1298,665,736,1542,567,840,1078,625,238,1107,359,457,1081,399,787,1545,591,11 36,678,434,1159,677,349,1102,245,458,1313,666,1218,620,363,1109,127,191,1300,782, 1546,407,436,1082,626,571,1192,465,1163,681,246,1123,707,350,1110,599,1084,668,7 90,1304,460,249,1113,682,1314,573,411,1553,803,789,1548,709,1220,365,440,1165,62 8,1125,689,374,1171,423,466,1200,793,1166,250,371,1554,481,1345,574,413,1055,603, 1224,366,468,1114,655,1569,900,805,1316,615,1346,684,710,1556,429,1287,794,252,1 173,373,1126,605,848,1129,690,1328,713,1320,632,482,1187,806,1116,427,904,1071,4 14,1291,223,663,1409,692,1570,835,1348,619,472,1232,455,1410,796,809,1174,714,11 77,721,1189,837,716,1130,864,1079,810,1352,606,912,1560,722,1601,696,1572,377,43 5,1137,817,1178,319,1103,621,1293,812,484,1132,430,1602,838,1248,667,488,1190,23 9,1543,378,1576,459,1219,622,627,1294,437,1665,380,1547,818,1299,461,496,1604,66 9,1315,679,1083,724,1193,841,629,1584,351,1138,467,1301,438,1180,737,1111,251,12 21,462,442,1140,441,1194,469,1085,247,1555,683,1549,842,1666,738,899,1305,670,13 02,783,1550,849,1201,820,1317,728,1412,928,1115,791,367,1608,901,1793,630,1222,6 85,1196,844,1144,633,1225,711,1360,253,1086,691,1306,824,1167,902,1127,686,740,1 202,850,1318,375,1117,444,1668,470,1226,483,1616,415,1347,485,1416,905,1321,795, 1794,473,1131,634,1204,744,1175,852,1233,960,1308,865,1672,693,1118,797,1228,906 ,1322,715,1424,807,1632,474,1376,636,1349,694,1557,254,1179,717,1234,575,1329,91 3,1571,798,1324,811,1133,379,1208,697,1558,431,607,489,1561,866,1139,723,1191,48 6,1249,908,1350,718,1330,813,1796,476,1181,856,1680,839,1353,725,1134,698,1141,9 14,1236,752,1195,868,1800,819,1354,814,1250,439,1573,929,1562,490,1411,623,1332, 671,1240,739,1440,916,1295,463,1303,843,1182,381,1361,497,1574,930,1696,821,1142 ,726,1356,1603,961,1564,872,1413,492,1197,631,1145,729,1577,700,1223,443,1808,74 1,1203,845,1252,920,1362,382,1336,822,1728,1414,851,1198,730,1578,498,1605,880,1 417,742,1307,445,1146,471,1472,1377,635,1585,932,1227,687,1087,903,1364,825,1418 ,500,1551,1606,846,1580,745,1205,826,1319,732,1309,446,1256,1148,962,1229,936,12 06,475,1667,853,1586,867,1310,1609,637,1323,907,1378,487,1235,695,1425,1209,746, 1420,828,1368,753,1610,854,1669,1617,857,1559,504,1264,799,1230,1119,255,1351,96 4,1588,909,1824,719,1426,1380,477,1331,915,1325,638,1441,1237,748,1592,944,1856, 869,1612,1210,491,1670,699,1428,1251,754,1920,858,1618,478,1442,1326,968,1673,38 3,1795,910,1384,1563,815,1135,976,1355,1238,870,1333,917,1212,1473,727,1241,493, 1432,873,1633,1620,701,1575,931,1674,1253,756,1183,860,1444,1334,499,1565,731,17 97,1634,823,1681,922,1357,1143,874,1624,918,1363,1242,502,1392,933,1676,1254,743 ,1415,1337,760,1474,881,1566,1358,494,1257,702,1579,1798,921,1199,501,1147,1682, 876,1636,1365,847,1801,992,1244,1338,447,1448,1419,733,1697,827,1607,1379,934,13 11,1207,882,1258,937,1149,1581,963,1684,1640,747,1366,505,1340,1265,855,1802,158 7,924,1369,734,1476,1421,829,1427,1231,965,1698,1582,938,1809,1456,884,1381,506, 1211,1260,749,1688,1648,945,1611,1804,966,1729,1150,755,1266,859,1589,1422,940,1 370,1480,830,1382,1429,911,1327,1593,871,1268,1619,639,1213,1590,888,1700,1385,4 79,1730,1613,946,1239,750,1810,1671,969,1372,1443,508,1430,1488,861,1704,1825,75 7,1386,1614,970,1433,1594,919,1812,1621,1596,875,1243,1335,862,1732,1622,758,162 5,1675,948,1445,1816,977,1826,1635,923,1626,1434,972,1255,1712,761,1677,1272,877 ,1393,1214,1388,952,1678,1683,495,1359,1504,703,1339,1245,935,1394,1637,978,1446 ,1449,1475,883,1638,1567,762,1259,1436,503,1367,1396,925,1799,1341,1246,878,1450 ,1477,735,1261,1583,1857,993,1828,1736,885,1858,1685,939,1832,1803,1641,994,1628 ,1457,980,1744,1840,1860,926,1371,1921,764,1267,1686,1478,941,1342,1699,967,1642 ,1922,1805,886,1400,1452,831,1689,1760,1591,947,1864,1649,507,1262,1383,1481,889 ,1423,1811,1615,984,1702,1458,751,1701,1373,1269,942,1482,1690,1644,996,1387,115 1,1215,971,1806,1431,890,1460,1650,1595,509,1489,1705,1270,949,1731,1374,1623,97 3,1692,1814,1484,1000,1273,1706,1597,892,1435,1827,1813,950,1733,1389,1464,863,1 652,1713,1398,759,1447,1490,1817,1008,1274,1395,1505,510,1598,1437,1627,979,139 0,1492,1679,953,1924,1829,1639,763,1708,1734,1453,974,1818,1276,1397,1629,954,18 72,1714,1737,879,1656,1506,1830,981,1451,1928,1438,982,1247,1687,1716,1859,927,1 643,1496,1479,995,1820,1833,1738,1745,765,1861,1740,1888,956,1834,1630,1936,174 6,887,1720,1401,1459,1841,985,1343,1645,1836,997,1508,1454,1862,1691,986,1512,12 63,1402,1483,943,1646,1651,1461,1404,891,1842,1485,1520,1693,998,1703,1748,1865, 766,1653,1375,1491,1462,511,1761,1275,1486,1466,1465,988,1493,1271,1707,1866,10 01,1762,1923,1694,1807,951,1873,1844,1752,1952,1002,1815,1391,1925,1654,1709,89 3,1868,1657,1735,1277,975,1715,1848,1926,1710,894,1764,1874,1399,1468,1494,1009, 1507,1439,1509,1929,1819,955,1497,1658,1768,1876,1984,1004,1889,1717,1821,1930, 1010,1739,1831,1498,1660,1718,957,1278,1741,1599,1937,1822,983,1835,1403,1721,1 455,1631,1513,958,1890,1747,1510,1932,1742,987,1837,1500,1880,1863,1749,1012,17 22,1938,1776,1892,1843,1838,999,1463,1953,1514,1647,1695,1763,1016,1940,1487,18 67,1405,1521,767,1954,1845,1750,1985,1896,1516,1655,989,1753,1724,1467,1765,186 9,1944,1003,1406,1846,1875,1754,1522,1904,990,1766,1469,1495,1659,1956,1711,192 7,1005,1849,1524,1870,1769,1850,1756,1470,959,1986,1960,1499,1877,1891,1661,193 1,1011,1511,1719,1770,1852,1777,1878,1881,1013,1528,1823,1279,1988,1933,1743,15 01,1939,895,1662,1772,1968,1893,1515,1723,1778,1882,1006,1502,1992,1407,1934,18 39,2000,1894,1941,1014,1751,1517,1897,1725,1955,1780,1884,1523,1755,1017,1847,1 946,1898,1942,1526,1957,1767,1784,1905,1018,1518,1726,1945,1525,1900,1871,2016, 1471,1757,1851,991,1958,1906,1961,1987,1771,1529,1879,1948,1758,1853,1020,1989, 1962,1908,1530,1773,1969,1990,1779,1883,1964,1854,1935,1007,1895,1663,1912,1503 ,1970,1774,1993,1532,1885,1781,1994,1943,1015,1899,1886,1782,1972,2001,1947,199 6,1785,1901,1976,1519,1727,1959,2002,1019,1907,1786,1527,1949,1902,1759,2017,19 09,1963,2018,2004,1950,1788,1965,1991,1021,1910,1855,1971,1531,1913,2008,1775,1 966,2020,1995,1914,1533,1973,1997,2024,1916,1974,1887,1783,1022,2032,1534,2003, 1977,1787,1998,1978,1903,2005,2006,1951,2019,1789,1980,1911,2009,2021,2010,1967 ,1915,2022,1790,1535,1023,2012,2025,1975,2026,1917,1999,1918,2033,1979,2028,203 4,1981,2007,1982,2011,2036,2023,2040,1791,2013,2027,2014,2029,1983,2035,2037,19 19,2030,2038,2041,2042,2015,2044,2031,2039,2043,2045,2046,2047] ;
dans lequel les numéros de séquence de N canaux polarisés dans la seconde séquence sont disposés dans l'ordre croissant de fiabilité des N canaux polarisés, et une valeur minimale des numéros de séquence des canaux polarisés est 0 ;
ou la seconde séquence est une partie ou l'ensemble d'une séquence Z1, une séquence Z2 ou une séquence Z3 ;
où la séquence Z1 est donnée par
[0,1,2,7,3,8,14,27,4,13,16,31,19,36,38,84,5,15,17,35,22,42,52,89,25,51,46,97,63,106,113 ,182,6,20,24,44,26,50,57,99,32,61,65,107,78,120,126,201,37,67,82,124,87,135,145,215, 96,147,160,243,166,257,281,408,9,21,29,60,33,64,77,115,39,83,69,127,92,139,153,224, 49,80,95,146,101,156,165,251,111,168,186,269,200,288,307,454,59,98,109,164,122,176 ,194,284,133,195,214,299,227,325,343,494,150,222,247,330,254,344,371,528,275,378,4 02,556,423,581,627,877,18,28,34,79,43,86,90,151,54,94,102,163,112,175,179,283,62,10 3,114,177,125,193,211,301,138,212,223,319,249,339,364,516,71,118,134,199,140,213,2 30,331,161,245,255,347,274,377,394,553,178,266,285,385,300,417,426,578,327,440,47 5,615,501,649,725,878,75,136,155,233,173,252,273,382,183,277,291,407,308,425,452,6 03,208,304,320,437,345,468,496,662,358,504,533,690,564,738,767,1022,229,334,352,4 79,387,513,538,715,422,548,579,755,616,773,842,1103,451,592,630,809,645,865,897,1 175,720,914,951,1160,990,1235,1333,1678,23,40,45,100,55,104,116,192,56,117,129,20 2,142,225,236,362,70,130,143,240,157,248,263,363,167,261,282,400,305,421,432,577,7 3,154,169,242,188,267,286,420,198,297,309,434,323,466,486,643,197,321,336,463,357, 500,518,694,389,542,566,737,589,764,816,1081,85,181,190,293,206,316,335,456,217,3 42,351,495,372,527,547,733,279,365,388,532,409,562,588,760,443,597,635,805,667,86 2,901,1147,313,404,436,574,462,613,638,845,491,655,677,874,726,931,966,1211,535,7 24,742,952,761,992,940,1257,826,1074,1107,1355,1121,1459,1518,1755,91,203,209,35 6,268,376,392,541,295,397,412,569,442,601,634,849,311,439,461,602,478,641,670,884, 505,682,713,921,757,960,1019,1270,361,467,484,668,517,703,745,943,567,746,769,101 4,830,985,1092,1361,611,797,858,1075,885,1117,1154,1426,932,1168,1165,1503,1260, 1547,1599,1928,403,502,543,750,599,772,814,1037,636,847,867,1110,912,1128,1163,1 452,672,893,945,1150,967,1172,1264,1552,1034,1284,1322,1613,1390,1696,1745,2117, 734,955,1008,1267,1089,1273,1376,1634,1101,1365,1433,1725,1488,1791,1886,2269,1 129,1463,1535,1824,1577,1902,1857,2323,1667,1977,2030,2480,2145,2568,2678,3005, 30,48,58,110,66,131,144,231,72,148,159,239,172,259,264,413,74,170,180,258,191,317, 328,450,218,329,355,492,375,520,545,754,76,187,204,322,220,353,368,510,232,381,39 5,551,416,582,608,775,246,406,430,595,457,631,652,836,469,644,684,890,689,920,957, 1340,119,219,228,373,241,396,414,572,271,433,445,622,474,658,680,853,292,449,483, 648,508,687,697,905,531,699,712,962,796,996,1062,1363,312,507,523,708,558,743,751 ,977,587,792,820,1033,873,1084,1112,1437,621,841,889,1115,936,1143,1218,1492,100 6,1228,1288,1557,1326,1626,1705,2102,123,238,260,427,289,446,477,664,306,488,511, 702,536,719,728,970,341,526,557,731,585,785,813,1023,617,832,869,1098,907,1133,11 90,1441,369,571,606,818,654,861,857,1136,674,895,916,1178,981,1222,1248,1564,716, 938,1000,1239,1027,1305,1329,1638,1070,1358,1405,1729,1499,1802,1892,2278,391,6 26,657,900,695,928,982,1231,781,1004,1046,1316,1053,1336,1383,1689,799,1048,1067 ,1372,1138,1401,1474,1788,1203,1495,1532,1828,1595,1936,1996,2352,834,1156,1185, 1445,1249,1507,1543,1869,1292,1586,1644,1973,1711,2038,2130,2512,1412,1653,1736 ,2060,1814,2160,2203,2654,1876,2243,2315,2718,2421,2834,2985,3484,141,272,298,48 9,337,521,552,763,349,563,593,790,624,825,881,1193,383,610,663,851,686,925,909,12 10,705,947,989,1281,1041,1309,1347,1671,460,676,707,924,780,975,1011,1319,789,10 42,1060,1351,1088,1387,1424,1765,801,1078,1124,1420,1199,1471,1522,1835,1241,15 73,1591,1940,1648,2004,2079,2459,471,778,784,1029,804,1051,1095,1398,837,1142,11 81,1456,1224,1510,1582,1917,997,1197,1253,1528,1294,1616,1657,1984,1394,1663,17 39,2064,1818,2153,2195,2640,1056,1301,1368,1620,1416,1719,1776,2094,1484,1795,1 847,2187,1910,2251,2343,2760,1539,1880,1954,2306,2026,2372,2453,2866,2109,2491, 2557,2952,2616,3109,3149,3832,480,808,822,1186,972,1215,1245,1568,1015,1277,131 2,1630,1379,1685,1759,2087,1064,1344,1409,1699,1448,1781,1851,2177,1514,1898,18 40,2227,1992,2332,2413,2803,1206,1430,1467,1807,1561,1862,1946,2286,1609,1958,2 018,2381,2072,2433,2524,2934,1715,2045,2124,2471,2210,2580,2628,3065,2262,2704, 2747,3199,2848,3272,3331,3683,1298,1481,1605,1965,1681,2011,2052,2442,1750,2138 ,2169,2548,2234,2592,2730,3129,1769,2219,2295,2692,2401,2774,2787,3300,2503,288 3,2915,3359,3027,3524,3596,4162,1921,2364,2392,2817,2536,2897,2971,3420,2604,30 47,3085,3560,3225,3639,3888,4347,2666,3174,3247,3730,3387,3776,3946,4458,3454,4 014,4085,4599,4244,4770,5021,5420,10,41,68,149,88,162,196,310,105,184,216,340,244 ,374,386,609,121,207,226,366,270,405,459,628,294,453,431,660,514,696,722,961,137,2 53,287,418,302,448,482,669,346,503,525,700,586,752,774,1018,379,534,600,766,623,8 02,840,1057,656,848,886,1137,906,1173,1236,1567,174,262,324,497,354,519,580,732,3 93,605,540,779,642,815,864,1083,441,594,651,843,678,875,904,1159,714,915,968,1207 ,1013,1259,1307,1675,493,665,706,899,756,937,994,1247,793,999,1055,1286,1090,135 2,1403,1768,854,1076,1148,1371,1167,1406,1473,1844,1227,1494,1549,1905,1602,196 1,2057,2542,235,318,360,591,411,620,632,859,465,647,683,894,718,934,949,1243,509, 688,727,941,770,991,1043,1293,810,1047,1080,1335,1155,1392,1458,1815,550,744,798 ,1010,819,1050,1102,1374,891,1141,1169,1414,1223,1490,1530,1901,946,1198,1252,15 09,1289,1588,1610,1952,1356,1643,1723,2033,1782,2105,2257,2545,570,807,870,1111, 930,1161,1219,1502,964,1230,1265,1563,1310,1606,1674,2008,1036,1296,1339,1637,1 410,1708,1775,2127,1443,1789,1856,2189,1924,2284,2341,2791,1097,1378,1425,1733, 1513,1811,1866,2237,1600,1889,1956,2318,2035,2355,2483,2923,1669,1982,2062,2424 ,2097,2521,2577,3034,2248,2607,2669,3011,2736,3126,3278,3795,280,398,424,675,470 ,693,736,986,476,739,783,1020,828,1085,1116,1451,544,787,831,1125,880,1151,1191,1 454,910,1188,1240,1546,1300,1596,1623,1949,559,868,917,1134,976,1201,1255,1592,1 005,1279,1313,1628,1349,1702,1749,2090,1001,1341,1384,1698,1440,1778,1822,2192, 1520,1873,1926,2281,1980,2338,2436,2886,614,956,979,1272,1032,1328,1382,1679,10 61,1399,1421,1772,1477,1841,1885,2272,1233,1462,1517,1853,1571,1914,1974,2326,1 651,1995,2075,2416,2141,2518,2586,2993,1324,1556,1633,1945,1694,2027,2082,2486, 1762,2115,2163,2539,2260,2634,2695,3093,1860,2254,2289,2672,2329,2740,2651,3163 ,2455,2872,2926,3309,2948,3473,3565,3908,637,1025,1039,1436,1205,1487,1527,1870, 1276,1542,1575,1933,1647,2001,2069,2494,1317,1641,1692,2005,1732,2084,2148,2554 ,1794,2171,2233,2619,2321,2686,2783,3183,1447,1706,1746,2142,1820,2213,2298,265 7,1930,2301,2346,2777,2456,2727,2905,3317,2023,2398,2509,2877,2559,2945,3000,34 24,2637,3023,3019,3538,3166,3607,3678,4140,1553,1785,1878,2303,1999,2349,2430,2 814,2078,2489,2527,2931,2601,2960,3016,3463,2151,2571,2660,2997,2698,3031,3171, 3613,2811,3205,3261,3700,3367,3818,3894,4381,2275,2675,2767,3179,2900,3188,3345 ,3736,2920,3326,3434,3863,3513,3960,4093,4559,2963,3479,3585,4000,3650,4111,405 0,4630,3782,4206,4274,4814,4414,4914,5049,5398,332,435,487,709,529,791,835,1105, 555,852,883,1123,926,1180,1194,1578,565,922,953,1176,984,1332,1360,1665,1066,136 7,1432,1763,1483,1827,1882,2312,575,971,1028,1345,1071,1428,1466,1805,1108,1498, 1534,1894,1585,1964,2016,2358,1146,1559,1619,1989,1684,2067,2106,2468,1712,2091 ,2174,2565,2184,2613,2681,3286,748,1069,1094,1478,1130,1538,1581,1942,1213,1624, 1655,2047,1721,2123,2166,2500,1269,1661,1742,2099,1801,2181,2201,2589,1848,2205 ,2230,2689,2395,2744,2855,3322,1321,1798,1833,2224,1912,2292,2309,2713,1970,238 9,2445,2808,2533,2891,2937,3440,2042,2477,2562,2940,2645,2988,3101,3518,2763,31 18,3208,3618,3264,3719,3838,4364,762,1120,1182,1614,1261,1658,1728,2135,1304,17 52,1809,2208,1864,2245,2265,2701,1395,1837,1908,2268,1968,2378,2427,2794,2039,2 462,2530,2912,2595,2966,3058,3443,1469,1937,2014,2439,2112,2515,2506,2974,2156, 2574,2610,3039,2721,3104,3146,3629,2240,2648,2753,3133,2797,3233,3269,3742,2869 ,3314,3392,3869,3534,3974,4097,4570,1524,2054,2120,2583,2198,2631,2724,3121,236 9,2757,2828,3250,2842,3281,3354,3812,2404,2831,2863,3340,2977,3381,3498,3954,30 78,3529,3580,4008,3672,4146,4228,4661,2465,3008,3050,3448,3154,3543,3602,4065,3 213,3661,3747,4198,3843,4282,4397,4852,3401,3759,3875,4306,3988,4431,4486,5006, 4071,4531,4619,5091,4736,5218,5378,5901,824,1216,1282,1756,1388,1831,1896,2335, 1417,1918,1987,2387,2050,2450,2551,3062,1505,2020,2133,2497,2180,2625,2598,3090 ,2216,2663,2733,3196,2820,3238,3295,3789,1688,2159,2222,2622,2366,2710,2770,325 5,2384,2823,2852,3303,2894,3364,3415,3920,2407,2880,2956,3410,3073,3493,3571,40 22,3138,3644,3667,4154,3753,4236,4331,4791,1716,2361,2375,2800,2410,2837,2908,3 378,2474,2982,3042,3468,3113,3549,3655,4127,2750,3070,3158,3574,3216,3706,3765, 4214,3373,3770,3880,4315,3994,4422,4475,4992,2845,3230,3336,3711,3406,3857,3934 ,4356,3507,3967,4036,4467,4119,4540,4650,5137,3591,4079,4176,4610,4266,4681,477 9,5253,4372,4826,4902,5342,4965,5524,5571,6216,1738,2418,2448,3053,2707,3098,31 41,3635,2780,3191,3242,3725,3350,3807,3914,4339,2859,3291,3395,3826,3459,3940,4 042,4450,3554,4105,4028,4512,4222,4639,4724,5184,3081,3429,3488,3980,3624,4056, 4168,4579,3695,4184,4258,4692,4323,4747,4864,5323,3849,4290,4389,4802,4494,4926 ,4979,5480,4551,5079,5122,5619,5234,5693,5750,6084,3221,3504,3689,4192,3801,425 2,4298,4758,3900,4406,4439,4887,4522,4940,5107,5547,3926,4503,4590,5064,4713,51 53,5169,5721,4840,5269,5304,5776,5440,5935,6005,6505,4133,4670,4701,5202,4875,5 288,5362,5837,4952,5460,5504,5970,5644,6044,6268,6660,5034,5595,5668,6125,5808, 6170,6320,6752,5867,6374,6438,6866,6579,6995,7168,7433,11,47,81,189,108,205,265, 410,132,250,290,447,326,490,506,794,152,278,303,481,359,539,604,823,390,598,568,8 60,673,908,939,1229,171,338,380,554,401,590,633,872,455,659,685,913,765,974,1003, 1299,498,698,782,993,811,1035,1082,1346,856,1091,1140,1442,1166,1485,1562,1925,2 21,348,428,653,464,679,759,948,515,788,710,1007,839,1054,1114,1377,583,776,850,10 87,882,1127,1162,1468,929,1174,1242,1525,1295,1587,1642,2043,646,866,918,1157,98 3,1204,1271,1572,1026,1275,1343,1618,1389,1697,1747,2139,1104,1369,1457,1710,14 79,1751,1823,2220,1548,1845,1906,2285,1962,2342,2443,2972,314,419,473,771,546,80 6,827,1109,612,844,888,1153,933,1200,1217,1569,666,892,944,1209,998,1266,1330,16 25,1049,1334,1373,1676,1464,1734,1806,2191,723,963,1030,1290,1058,1338,1400,171 4,1144,1449,1482,1760,1544,1843,1888,2279,1212,1515,1576,1861,1621,1948,1972,23 33,1701,2007,2093,2417,2155,2496,2662,2976,747,1040,1122,1411,1192,1472,1541,18 55,1234,1551,1593,1922,1646,1969,2037,2391,1323,1632,1680,2000,1754,2076,2146,2 522,1790,2164,2231,2588,2302,2691,2752,3245,1396,1720,1771,2104,1868,2185,2244, 2642,1960,2267,2336,2726,2420,2764,2904,3390,2034,2365,2449,2839,2487,2950,3013 ,3515,2653,3044,3114,3489,3186,3615,3774,4278,370,522,560,876,619,898,954,1263,6 25,959,1012,1302,1068,1380,1419,1799,717,1017,1073,1431,1131,1461,1508,1803,117 0,1500,1566,1904,1635,1957,1985,2331,735,1118,1179,1438,1251,1519,1580,1953,128 7,1611,1649,1991,1690,2071,2119,2481,1283,1683,1727,2065,1786,2152,2196,2594,18 74,2253,2308,2687,2359,2746,2853,3352,800,1225,1254,1601,1315,1666,1724,2046,13 54,1743,1767,2144,1826,2217,2264,2680,1554,1810,1872,2229,1929,2296,2356,2735,2 015,2376,2464,2830,2534,2943,3021,3466,1662,1913,1997,2325,2061,2411,2472,2910, 2131,2508,2558,2968,2665,3076,3143,3576,2238,2659,2697,3116,2738,3193,3095,3652 ,2874,3338,3397,3809,3422,3972,4061,4378,833,1306,1327,1784,1523,1839,1881,2250, 1607,1897,1934,2313,2012,2385,2461,2918,1656,2003,2058,2388,2101,2475,2543,2987 ,2167,2567,2636,3057,2732,3131,3240,3674,1797,2073,2116,2537,2194,2615,2706,309 9,2311,2709,2755,3232,2878,3178,3371,3820,2408,2812,2936,3341,2990,3417,3477,39 22,3080,3502,3497,4038,3657,4101,4172,4596,1909,2157,2255,2715,2379,2761,2847,3 274,2467,2913,2953,3402,3040,3432,3495,3962,2546,3003,3103,3472,3144,3509,3663, 4107,3267,3696,3757,4190,3865,4302,4366,4821,2683,3123,3220,3668,3366,3680,3841 ,4220,3385,3824,3932,4341,4016,4427,4546,4994,3436,3978,4087,4469,4142,4566,450 9,5051,4264,4656,4720,5221,4854,5315,5432,5756,438,576,639,923,692,1021,1077,140 4,729,1096,1135,1427,1187,1493,1512,1938,741,1184,1221,1489,1258,1670,1703,2031, 1357,1707,1780,2134,1836,2202,2261,2723,753,1246,1311,1687,1366,1773,1816,2178, 1407,1852,1890,2274,1944,2345,2400,2769,1453,1919,1978,2374,2049,2452,2502,2893 ,2080,2484,2573,2998,2585,3055,3128,3786,969,1362,1393,1829,1435,1893,1941,2322, 1533,1988,2019,2431,2088,2517,2564,2928,1597,2028,2113,2493,2173,2579,2603,3026 ,2226,2606,2633,3136,2809,3198,3319,3822,1660,2170,2209,2627,2291,2700,2717,316 4,2353,2805,2861,3266,2964,3357,3408,3938,2429,2902,2995,3411,3086,3461,3587,40 20,3218,3604,3702,4115,3763,4210,4312,4805,988,1422,1497,1976,1590,2022,2098,25 28,1639,2126,2182,2612,2241,2650,2671,3151,1741,2215,2288,2674,2348,2789,2844,3 249,2423,2885,2958,3383,3032,3441,3540,3944,1819,2319,2397,2856,2505,2942,2932, 3447,2549,3010,3049,3520,3169,3593,3637,4125,2643,3091,3206,3620,3254,3728,3768 ,4226,3333,3814,3886,4345,4032,4441,4553,5001,1877,2440,2514,3018,2597,3071,317 3,3609,2781,3211,3288,3746,3302,3780,3853,4294,2819,3293,3327,3836,3452,3882,39 96,4420,3562,4026,4081,4473,4166,4605,4679,5081,2888,3482,3531,3950,3641,4044,4 096,4525,3708,4156,4234,4652,4321,4729,4835,5256,3898,4246,4354,4754,4454,4871, 4918,5406,4533,4962,5041,5472,5156,5589,5737,6185,1063,1537,1615,2128,1730,2206 ,2277,2743,1764,2299,2368,2798,2437,2870,2980,3545,1858,2405,2525,2921,2576,306 7,3036,3573,2618,3108,3184,3691,3279,3734,3797,4270,2056,2555,2624,3063,2778,31 59,3227,3751,2795,3283,3312,3803,3362,3859,3916,4393,2822,3347,3427,3910,3556,3 990,4067,4482,3626,4136,4160,4612,4240,4688,4777,5197,2086,2772,2786,3259,2826, 3298,3376,3877,2896,3457,3525,3966,3598,4048,4150,4583,3201,3551,3646,4075,3713 ,4196,4250,4665,3871,4260,4360,4761,4460,4861,4909,5392,3307,3723,3830,4202,390 4,4333,4408,4795,4010,4433,4497,4899,4575,4972,5071,5515,4091,4538,4627,5031,47 15,5102,5189,5622,4812,5232,5301,5706,5367,5854,5891,6465,2108,2836,2864,3533,3 156,3582,3631,4131,3235,3685,3740,4216,3847,4288,4385,4786,3321,3791,3892,4308, 3956,4412,4501,4890,4054,4561,4488,4945,4674,5059,5145,5559,3567,3928,3984,4446 ,4121,4516,4621,5011,4186,4634,4706,5112,4768,5166,5266,5687,4327,4738,4830,521 0,4928,5329,5381,5814,4984,5457,5501,5939,5604,6001,6055,6349,3717,4004,4180,46 43,4284,4697,4745,5176,4374,4845,4880,5293,4955,5340,5486,5874,4399,4935,5019,5 446,5132,5530,5542,6026,5245,5638,5671,6077,5779,6220,6280,6711,4588,5094,5125, 5574,5280,5653,5725,6132,5353,5795,5831,6248,5959,6312,6509,6843,5418,5915,5980 ,6387,6102,6421,6551,6923,6159,6602,6651,7020,6773,7126,7280,7500,237,530,704,11 00,817,1149,1278,1652,902,1237,1350,1737,1446,1832,1865,2402,978,1318,1385,1812, 1529,1916,2053,2446,1604,2041,1981,2519,2188,2600,2656,3134,1044,1476,1583,1950 ,1629,2024,2110,2540,1758,2162,2212,2609,2351,2720,2766,3237,1849,2236,2382,274 9,2434,2825,2899,3310,2511,2916,2992,3450,3029,3511,3617,4129,1195,1504,1693,21 49,1777,2199,2339,2677,1884,2394,2247,2775,2478,2850,2947,3355,2009,2371,2499,2 907,2561,2969,3024,3486,2639,3045,3148,3569,3228,3654,3732,4276,2137,2531,2621, 3014,2729,3088,3194,3633,2806,3203,3305,3698,3369,3805,3884,4395,2929,3343,3470 ,3834,3500,3890,3992,4492,3600,4024,4103,4568,4178,4636,4752,5285,1415,1672,179 3,2362,1932,2426,2458,2939,2068,2490,2570,3006,2647,3083,3111,3628,2175,2582,26 68,3096,2758,3189,3284,3710,2841,3290,3348,3778,3480,3867,3970,4456,2271,2703,2 815,3223,2858,3296,3388,3839,3001,3455,3506,3902,3594,4018,4077,4564,3106,3553, 3642,4046,3704,4158,4188,4625,3811,4232,4337,4722,4416,4807,4977,5290,2316,2833 ,2961,3404,3075,3491,3589,4034,3139,3605,3665,4123,3738,4182,4272,4695,3271,371 5,3784,4224,3896,4319,4403,4833,3948,4424,4507,4904,4592,5009,5069,5545,3380,38 45,3918,4352,4052,4452,4520,4957,4174,4548,4632,5044,4726,5084,5224,5678,4268,4 663,4756,5158,4798,5264,5326,5785,4969,5356,5423,5763,5492,5871,6008,6434,1558, 1900,1966,2552,2083,2591,2684,3181,2095,2694,2784,3243,2875,3360,3413,3958,2258 ,2792,2881,3431,2979,3475,3542,3964,3037,3536,3622,4099,3721,4170,4204,4623,229 4,2955,3052,3445,3161,3558,3648,4164,3215,3687,3744,4212,3799,4310,4370,4788,32 10,3787,3855,4304,3942,4410,4465,4906,4063,4529,4594,5004,4659,5066,5171,5641,2 414,3124,3168,3676,3262,3766,3851,4280,3315,3878,3912,4401,3998,4490,4544,4996, 3611,3976,4059,4505,4134,4581,4654,5054,4242,4677,4772,5148,4847,5261,5334,5744 ,3761,4113,4218,4616,4300,4717,4782,5226,4387,4819,4873,5282,4982,5387,5449,584 1,4514,4974,5014,5426,5056,5495,5403,5904,5192,5628,5681,6033,5703,6178,6252,65 23,2469,3252,3276,3936,3563,4012,4073,4527,3681,4095,4138,4603,4238,4686,4765,5 237,3749,4230,4296,4690,4349,4784,4856,5299,4429,4883,4950,5370,5046,5437,5539, 5921,3952,4317,4368,4849,4462,4931,5024,5409,4601,5026,5074,5533,5195,5483,5659 ,6041,4710,5130,5250,5632,5307,5699,5753,6136,5389,5772,5769,6232,5908,6288,634 5,6695,4109,4418,4535,5029,4683,5076,5163,5568,4775,5229,5272,5684,5351,5712,57 66,6166,4859,5318,5412,5747,5452,5782,5911,6292,5565,5942,5991,6361,6088,6456,6 514,6871,4999,5429,5521,5918,5656,5925,6066,6391,5675,6051,6144,6487,6208,6560, 6656,6989,5715,6181,6272,6593,6324,6675,6626,7040,6425,6741,6794,7153,6894,7218 ,7296,7490,1717,1993,2121,2630,2223,2801,2889,3394,2282,2924,2984,3425,3068,352 2,3547,4144,2305,3060,3119,3516,3176,3772,3816,4262,3324,3828,3930,4391,4006,44 71,4542,5039,2328,3153,3257,3793,3334,3924,3982,4443,3399,4030,4083,4555,4152,4 641,4704,5086,3464,4117,4200,4672,4286,4763,4809,5208,4325,4793,4885,5312,4897, 5364,5435,6016,2712,3329,3374,4002,3438,4089,4148,4614,3578,4208,4248,4740,4335 ,4828,4878,5242,3670,4256,4362,4800,4437,4894,4916,5337,4499,4921,4947,5443,512 7,5498,5610,6048,3755,4435,4480,4943,4577,5016,5036,5469,4647,5120,5179,5562,52 77,5647,5690,6147,4733,5216,5309,5696,5395,5740,5847,6212,5518,5861,5945,6296,5 994,6378,6469,6854,2741,3418,3527,4194,3659,4254,4343,4842,3727,4376,4448,4923, 4518,4967,4987,5454,3873,4484,4572,4989,4645,5109,5161,5550,4731,5200,5274,5665 ,5345,5718,5805,6151,3986,4608,4699,5174,4816,5258,5248,5728,4866,5320,5359,578 8,5475,5851,5888,6304,4960,5401,5509,5877,5553,5966,5998,6395,5625,6037,6106,64 91,6228,6569,6665,7002,4069,4749,4823,5331,4911,5384,5477,5864,5099,5512,5583,5 984,5598,6012,6073,6451,5135,5586,5616,6062,5731,6099,6197,6555,5824,6224,6264, 6597,6341,6700,6762,7059,5205,5760,5798,6155,5894,6236,6284,6636,5949,6332,6400 ,6736,6473,6800,6883,7182,6114,6408,6496,6816,6583,6906,6941,7272,6641,6971,703 3,7320,7105,7388,7480,7719,2867,3583,3693,4383,3861,4477,4557,5061,3906,4585,46 68,5117,4742,5187,5296,5811,4040,4708,4838,5240,4892,5376,5348,5834,4933,5415,5 489,5932,5577,5973,6023,6430,4292,4868,4938,5373,5097,5466,5527,5987,5114,5580, 5607,6030,5650,6080,6128,6532,5140,5635,5709,6121,5821,6193,6256,6607,5881,6316 ,6337,6705,6404,6768,6832,7139,4329,5089,5104,5556,5143,5592,5662,6095,5213,573 4,5792,6174,5857,6240,6328,6685,5506,5818,5898,6260,5952,6366,6412,6747,6091,64 17,6500,6821,6588,6900,6935,7264,5601,5963,6059,6370,6117,6482,6541,6849,6205,6 564,6617,6929,6680,6977,7052,7345,6276,6646,6721,7027,6789,7072,7132,7405,6860, 7160,7211,7461,7249,7552,7573,7841,4358,5150,5182,5801,5463,5844,5884,6308,5536 ,5928,5977,6383,6069,6447,6528,6838,5613,6019,6110,6460,6162,6546,6621,6917,624 4,6670,6612,6959,6757,7046,7098,7370,5828,6140,6189,6574,6300,6631,6716,7008,63 57,6726,6784,7078,6827,7112,7189,7451,6478,6805,6877,7146,6947,7226,7256,7530,6 983,7312,7336,7595,7396,7630,7654,7792,5956,6201,6353,6731,6443,6778,6810,7119, 6518,6888,6912,7204,6965,7233,7328,7562,6537,6953,7014,7304,7092,7353,7362,7642 ,7175,7414,7442,7667,7510,7733,7762,7936,6690,7065,7085,7379,7196,7424,7470,769 2,7241,7520,7541,7747,7607,7776,7858,7981,7288,7584,7618,7808,7680,7824,7876,80 06,7706,7895,7915,8033,7957,8064,8098,8138,12,53,93,234,128,256,350,537,158,333,3 84,584,429,640,661,1038,185,367,399,629,472,701,795,1072,512,786,740,1119,879,117 7,1220,1579,210,444,499,721,524,777,829,1132,596,863,896,1183,995,1262,1297,1664, 650,911,1024,1285,1059,1342,1397,1722,1113,1408,1470,1838,1501,1891,1983,2406,2 76,458,561,855,607,887,987,1232,671,1031,927,1303,1093,1364,1439,1761,768,1009,1 106,1402,1145,1455,1496,1871,1208,1511,1594,1939,1659,2010,2077,2541,846,1126,1 196,1491,1274,1550,1631,1994,1331,1636,1718,2048,1774,2140,2200,2652,1423,1753, 1854,2158,1883,2204,2290,2742,1963,2314,2386,2816,2451,2879,2991,3530,415,549,6 18,1002,711,1052,1079,1429,803,1099,1152,1486,1214,1545,1565,1990,871,1158,1226, 1555,1291,1627,1704,2055,1359,1709,1757,2118,1863,2186,2270,2711,942,1250,1337, 1654,1370,1713,1787,2161,1475,1846,1887,2214,1959,2310,2363,2807,1560,1927,1998 ,2334,2051,2432,2460,2871,2147,2501,2599,2962,2670,3043,3214,3532,973,1348,1450, 1800,1536,1875,1955,2327,1584,1967,2021,2403,2081,2457,2535,2933,1695,2066,2122 ,2492,2207,2581,2658,3072,2249,2679,2756,3137,2835,3244,3306,3802,1783,2168,222 8,2611,2340,2702,2768,3192,2447,2796,2873,3280,2965,3318,3460,3943,2532,2906,29 96,3393,3033,3505,3568,4064,3204,3601,3671,4039,3743,4167,4328,4836,485,681,730, 1139,812,1164,1238,1622,821,1244,1308,1668,1381,1766,1808,2263,935,1314,1386,18 25,1460,1859,1915,2266,1506,1907,1986,2380,2070,2444,2476,2868,958,1444,1516,18 34,1603,1931,2002,2441,1650,2040,2085,2482,2132,2575,2629,3028,1645,2125,2176,2 566,2246,2667,2716,3145,2347,2779,2840,3241,2898,3299,3407,3905,1045,1574,1612, 2029,1686,2107,2172,2547,1731,2197,2225,2655,2293,2739,2793,3231,1975,2273,2344 ,2754,2409,2829,2895,3289,2510,2917,3009,3384,3084,3501,3577,4017,2100,2393,248 8,2860,2563,2957,3017,3467,2644,3056,3107,3523,3217,3634,3699,4126,2762,3212,32 51,3673,3292,3748,3651,4203,3428,3893,3949,4363,3973,4524,4611,4939,1086,1673,1 700,2242,1935,2307,2357,2776,2036,2373,2419,2849,2507,2927,3007,3474,2092,2498, 2560,2930,2608,3022,3092,3544,2682,3117,3187,3614,3285,3688,3796,4225,2259,2578 ,2626,3087,2714,3165,3258,3656,2843,3260,3308,3788,3435,3735,3925,4373,2951,336 8,3492,3895,3546,3968,4029,4474,3636,4053,4047,4589,4209,4653,4727,5157,2390,26 73,2782,3268,2922,3316,3403,3829,3012,3469,3510,3955,3597,3985,4045,4513,3094,3 561,3660,4023,3701,4058,4215,4660,3823,4249,4311,4746,4419,4860,4925,5380,3234, 3679,3777,4221,3919,4231,4396,4776,3939,4379,4485,4900,4567,4986,5106,5548,3987 ,4530,4637,5028,4696,5126,5070,5605,4822,5217,5279,5764,5411,5850,5954,6239,573, 758,838,1202,903,1320,1391,1792,950,1413,1465,1821,1531,1899,1920,2422,965,1521, 1570,1895,1617,2111,2150,2529,1735,2154,2239,2646,2304,2722,2788,3277,980,1598, 1677,2129,1744,2232,2280,2696,1796,2324,2367,2802,2428,2882,2944,3323,1850,2399 ,2470,2914,2550,2999,3048,3449,2584,3030,3122,3555,3135,3612,3684,4340,1256,174 0,1779,2297,1830,2370,2425,2857,1947,2479,2513,2978,2596,3064,3115,3483,2025,25 26,2623,3041,2690,3130,3152,3584,2751,3157,3185,3692,3365,3754,3872,4377,2096,2 688,2731,3177,2821,3253,3270,3720,2892,3358,3416,3821,3521,3911,3959,4491,2975, 3458,3552,3963,3643,4011,4139,4573,3773,4155,4255,4667,4316,4766,4872,5363,1280 ,1817,1903,2463,2013,2516,2605,3077,2074,2635,2699,3162,2765,3202,3222,3707,219 3,2737,2818,3226,2887,3344,3400,3804,2967,3439,3514,3935,3588,3993,4088,4496,22 83,2854,2941,3412,3054,3499,3490,3999,3100,3566,3606,4068,3726,4145,4189,4678,3 195,3647,3762,4173,3810,4283,4322,4781,3887,4369,4442,4905,4584,5000,5113,5557, 2354,2989,3061,3575,3147,3627,3729,4161,3335,3769,3844,4301,3856,4334,4407,4851 ,3372,3848,3881,4390,4003,4436,4547,4981,4112,4578,4631,5033,4721,5167,5239,563 4,3444,4033,4080,4502,4191,4595,4648,5085,4261,4709,4790,5212,4881,5289,5394,57 96,4453,4803,4913,5314,5015,5428,5476,5931,5093,5519,5596,5990,5705,6094,6223,6 606,1375,1951,2044,2638,2179,2725,2804,3297,2221,2832,2909,3353,2983,3426,3537, 4094,2330,2949,3074,3478,3127,3623,3592,4124,3170,3664,3741,4243,3835,4289,4351 ,4827,2556,3105,3175,3621,3332,3716,3781,4307,3351,3837,3868,4357,3917,4413,447 0,4953,3377,3901,3979,4464,4106,4541,4617,5042,4177,4691,4716,5172,4796,5249,53 36,5743,2590,3328,3342,3815,3382,3854,3929,4430,3451,4009,4074,4519,4149,4600,4 703,5144,3756,4102,4197,4626,4265,4751,4808,5225,4425,4817,4919,5319,5020,5421, 5467,5919,3862,4277,4384,4757,4459,4891 ,4966,5354,4562,4991 ,5057,5458,5136,5528 ,5626,6028,4642,5098,5190,5587,5275,5655,5738,6122,5371,5775,5839,6195,5896,632 5,6356,6839,2614,3391,3419,4082,3712,4132,4183,4684,3790,4237,4295,4771,4402,48 46,4944,5346,3876,4346,4447,4865,4508,4973,5062,5447,4606,5121,5048,5502,5235,5 614,5697,6067,4118,4479,4536,5007,4673,5077,5180,5566,4741,5194,5265,5664,5328, 5717,5807,6180,4886,5297,5388,5755,5484,5862,5907,6289,5540,5978,6017,6396,6107 ,6452,6495,6743,4271,4556,4735,5203,4841,5257,5305,5726,4932,5404,5438,5830,551 0,5873,6002,6340,4958,5493,5575,5967,5685,6040,6053,6472,5787,6137,6164,6516,62 58,6634,6684,7039,5149,5646,5676,6079,5819,6149,6211,6561,5885,6274,6305,6659,6 415,6713,6874,7148,5943,6376,6432,6774,6536,6803,6909,7209,6585,6950,6992,7284, 7088,7371,7488,7655,296,691,919,1418,1065,1480,1640,2089,1171,1589,1726,2190,18 42,2300,2337,2946,1268,1691,1770,2276,1943,2396,2553,2994,2032,2538,2473,3069,2 705,3150,3207,3690,1353,1879,2006,2435,2059,2523,2620,3089,2211,2676,2734,3160, 2890,3273,3320,3794,2317,2759,2925,3304,2981,3379,3456,3864,3059,3471,3548,4001 ,3586,4060,4169,4682,1540,1911,2136,2661,2235,2719,2876,3229,2360,2938,2773,333 0,3025,3405,3503,3909,2504,2911,3046,3462,3110,3526,3581,4037,3190,3603,3703,41 20,3785,4207,4287,4832,2649,3079,3172,3572,3282,3645,3752,4187,3361,3760,3860,4 251,3921,4359,4438,4956,3485,3897,4019,4388,4051,4444,4545,5053,4153,4576,4657, 5129,4732,5198,5311,5825,1804,2114,2256,2903,2415,2973,3002,3494,2572,3038,3120 ,3564,3200,3640,3669,4181,2693,3132,3219,3653,3311,3745,3840,4263,3396,3846,390 3,4332,4031,4421,4523,5017,2799,3256,3370,3779,3414,3852,3941,4394,3557,4007,40 55,4455,4147,4571,4629,5124,3662,4104,4195,4598,4257,4712,4743,5186,4365,4789,4 896,5283,4975,5366,5534,5827,2851,3389,3517,3957,3632,4041,4141,4587,3697,4159, 4217,4676,4291,4737,4831,5254,3827,4269,4338,4780,4449,4877,4964,5391,4500,4983 ,5068,5461,5152,5563,5623,6056,3933,4400,4472,4910,4604,5012,5082,5513,4728,511 0,5191,5599,5286,5637,5767,6171,4824,5223,5317,5708,5357,5804,5859,6263,5525,58 87,5946,6245,6007,6338,6455,6815,1979,2377,2454,3102,2587,3142,3239,3737,2602,3 246,3339,3798,3433,3913,3965,4511,2785,3346,3437,3981,3535,4025,4090,4517,3595, 4086,4175,4651,4275,4723,4760,5183,2824,3512,3608,3995,3718,4110,4201,4718,3771 ,4241,4297,4767,4353,4869,4930,5349,3764,4342,4409,4863,4495,4970,5025,5464,461 5,5090,5155,5560,5220,5620,5720,6139,2959,3682,3724,4229,3819,4320,4405,4837,38 70,4432,4466,4961,4550,5050,5105,5551,4163,4528,4609,5065,4687,5141,5214,5608,4 799,5238,5332,5700,5407,5802,5868,6230,4314,4666,4774,5178,4858,5276,5339,5770, 4948,5377,5431,5822,5537,5913,5969,6311,5073,5531,5569,5948,5611,6010,5929,6367 ,5739,6127,6173,6479,6192,6599,6663,6886,3015,3806,3831,4489,4116,4565,4624,508 7,4235,4646,4693,5164,4794,5246,5325,5778,4303,4785,4855,5251,4908,5343,5414,58 36,4990,5441,5508,5899,5602,5961,6049,6382,4506,4874,4927,5408,5023,5487,5578,5 934,5160,5581,5629,6043,5741,5999,6156,6485,5271,5682,5793,6131,5842,6190,6235, 6563,5916,6254,6251,6644,6369,6692,6739,7026,4662,4978,5096,5584,5243,5631,5714 ,6076,5335,5773,5810,6177,5882,6202,6249,6591,5417,5853,5937,6233,5972,6261,637 3,6696,6074,6399,6442,6754,6522,6830,6878,7166,5554,5951,6035,6380,6152,6386,65 06,6777,6168,6492,6571,6858,6627,6918,6997,7263,6204,6603,6677,6942,6720,7009,6 972,7300,6807,7066,7106,7392,7185,7439,7501,7646,2165,2485,2632,3180,2745,3356, 3446,3947,2813,3481,3541,3977,3625,4072,4098,4698,2838,3616,3675,4066,3733,4326 ,4371,4818,3879,4382,4483,4949,4560,5032,5101,5593,2862,3709,3813,4348,3889,447 8,4534,5003,3951,4582,4635,5116,4707,5201,5263,5640,4015,4671,4755,5231,4844,53 22,5368,5752,4882,5350,5444,5848,5455,5893,5957,6462,3265,3885,3927,4552,3989,4 640,4702,5175,4130,4762,4804,5300,4895,5386,5434,5784,4223,4813,4922,5360,4998, 5451,5473,5870,5058,5478,5505,5964,5679,6014,6112,6489,4309,4995,5040,5499,5138 ,5572,5590,5986,5209,5673,5729,6071,5816,6143,6183,6575,5294,5761,5845,6186,592 3,6226,6318,6630,6031,6331,6402,6699,6445,6766,6842,7157,3294,3971,4076,4748,42 11,4810,4903,5400,4281,4936,5008,5481,5078,5522,5543,5975,4426,5045,5133,5546,5 206,5661,5711,6058,5291,5746,5813,6161,5876,6207,6283,6577,4539,5168,5260,5723, 5374,5799,5790,6214,5424,5856,5890,6267,5993,6321,6354,6707,5516,5926,6022,6343 ,6061,6422,6449,6781,6124,6483,6540,6862,6642,6926,7000,7269,4620,5308,5383,586 5,5470,5910,5996,6334,5652,6025,6089,6435,6101,6458,6512,6826,5688,6092,6119,65 02,6217,6533,6616,6914,6299,6638,6673,6946,6735,7030,7079,7316,5749,6242,6277,6 581,6360,6648,6688,6980,6406,6728,6785,7061,6846,7110,7176,7410,6547,6792,6865, 7124,6934,7194,7224,7482,6984,7248,7294,7519,7354,7574,7638,7822,3423,4135,4245 ,4941,4415,5037,5118,5617,4461,5146,5228,5670,5303,5735,5833,6286,4593,5268,539 7,5781,5450,5905,5879,6309,5490,5940,6004,6393,6082,6426,6468,6812,4850,5427,54 96,5902,5649,5983,6038,6439,5667,6085,6109,6475,6146,6520,6557,6893,5691,6134,6 199,6553,6295,6613,6667,6955,6347,6717,6732,7035,6788,7083,7138,7381,4888,5643, 5658,6064,5694,6097,6158,6530,5758,6221,6270,6595,6327,6652,6724,7018,6020,6293 ,6363,6669,6409,6758,6796,7070,6526,6799,6869,7129,6938,7190,7219,7475,6104,641 9,6499,6761,6550,6855,6902,7152,6623,6922,6963,7214,7013,7253,7310,7539,6681,69 88,7048,7290,7101,7326,7375,7588,7162,7398,7434,7624,7463,7694,7711,7914,4917,5 702,5732,6279,5981,6315,6350,6710,6046,6389,6428,6770,6510,6823,6890,7143,6116, 6466,6543,6835,6589,6905,6967,7205,6655,7005,6958,7238,7075,7305,7348,7559,6302 ,6567,6609,6930,6703,6975,7043,7274,6750,7053,7096,7332,7134,7359,7416,7616,685 0,7115,7171,7386,7229,7445,7469,7677,7259,7514,7533,7728,7580,7754,7773,7878,64 13,6620,6746,7057,6819,7093,7120,7365,6881,7180,7199,7427,7244,7452,7526,7702,6 897,7234,7279,7507,7342,7546,7553,7764,7404,7594,7609,7782,7662,7833,7854,7987, 7022,7321,7337,7567,7421,7602,7632,7802,7457,7670,7686,7844,7737,7866,7928,8021 ,7494,7720,7745,7889,7793,7902,7942,8040,7812,7955,7971,8061,8003,8084,8111,814 5,315,749,1016,1608,1189,1682,1923,2412,1325,1867,2017,2520,2143,2641,2685,3363, 1434,1971,2063,2617,2252,2771,2935,3421,2350,2919,2846,3496,3097,3590,3649,4157 ,1526,2183,2320,2810,2383,2901,3004,3519,2544,3066,3125,3599,3301,3714,3767,427 3,2664,3155,3337,3750,3398,3825,3907,4350,3487,3923,4005,4498,4049,4563,4675,51 54,1748,2218,2466,3051,2569,3112,3287,3666,2708,3349,3182,3775,3453,3858,3961,4 398,2884,3325,3476,3915,3539,3983,4043,4537,3630,4062,4179,4622,4267,4711,4787, 5295,3035,3508,3610,4035,3731,4114,4227,4689,3808,4233,4344,4753,4417,4862,4929 ,5405,3945,4386,4521,4879,4554,4934,5027,5494,4655,5055,5131,5564,5199,5624,572 7,6213,2103,2438,2593,3313,2790,3386,3430,3953,2954,3465,3550,4027,3638,4108,41 37,4685,3082,3559,3658,4122,3758,4219,4324,4764,3850,4330,4392,4834,4532,4912,5 005,5462,3209,3694,3817,4259,3866,4336,4434,4884,4013,4510,4558,4946,4649,5052, 5108,5558,4128,4607,4694,5075,4759,5181,5211,5615,4867,5252,5352,5701,5422,5780 ,5938,6215,3263,3833,3975,4451,4092,4543,4644,5067,4165,4658,4719,5151,4792,520 7,5287,5674,4313,4773,4839,5244,4937,5333,5413,5806,4985,5433,5507,5869,5582,59 65,6021,6431,4428,4893,4959,5365,5083,5456,5520,5920,5196,5544,5618,5997,5704,6 032,6154,6539,5284,5648,5733,6098,5771,6194,6246,6628,5930,6271,6329,6610,6385, 6697,6802,7108,2287,2728,2827,3528,2970,3570,3677,4213,2986,3686,3783,4279,3883 ,4404,4463,4997,3197,3792,3891,4481,3991,4526,4597,5002,4057,4586,4680,5128,477 8,5193,5227,5612,3236,3969,4070,4493,4193,4613,4700,5188,4253,4744,4797,5233,48 53,5327,5382,5765,4247,4843,4901,5321,4980,5419,5468,5875,5092,5529,5588,5962,5 642,6015,6111,6511,3375,4151,4199,4730,4299,4820,4898,5298,4361,4924,4954,5410, 5030,5491,5541,5955,4664,5010,5088,5503,5159,5576,5639,6006,5262,5660,5748,6090 ,5817,6188,6253,6594,4815,5139,5241,5606,5316,5695,5757,6160,5396,5791,5840,620 9,5941,6298,6351,6671,5514,5936,5971,6330,6009,6390,6313,6722,6129,6501,6544,68 24,6562,6925,6978,7165,3442,4285,4318,4976,4618,5047,5100,5526,4739,5119,5165,5 594,5259,5669,5745,6167,4806,5247,5313,5672,5361,5759,5826,6225,5436,5849,5914, 6282,6003,6342,6427,6737,4993,5330,5379,5820,5465,5895,5979,6317,5591,5982,6024 ,6420,6133,6379,6525,6831,5692,6075,6182,6503,6227,6558,6601,6895,6301,6619,661 5,6964,6725,7003,7045,7283,5134,5425,5532,5988,5663,6029,6105,6453,5751,6163,61 96,6548,6269,6570,6614,6919,5829,6238,6319,6598,6352,6624,6729,7006,6448,6751,6 791,7056,6859,7122,7158,7395,5958,6335,6411,6733,6521,6740,6845,7074,6535,6834, 6901,7144,6951,7192,7257,7476,6572,6928,6993,7215,7028,7267,7237,7502,7100,7314 ,7346,7575,7411,7613,7659,7775,2495,2865,3020,3619,3140,3800,3899,4440,3224,393 1,3997,4476,4084,4574,4602,5170,3248,4078,4143,4569,4205,4825,4870,5281,4367,48 76,4971,5399,5043,5474,5538,5995,3275,4185,4293,4848,4380,4963,5018,5448,4445,5 063,5111,5552,5177,5627,5683,6036,4515,5147,5219,5657,5302,5736,5786,6145,5338, 5768,5855,6234,5866,6281,6339,6809,3705,4375,4423,5035,4487,5115,5173,5603,4633 ,5230,5267,5716,5347,5800,5846,6175,4725,5278,5375,5777,5442,5860,5883,6257,550 0,5886,5912,6346,6072,6394,6486,6833,4811,5439,5482,5906,5570,5974,5989,6368,56 36,6068,6118,6446,6206,6515,6552,6904,5713,6153,6231,6554,6306,6590,6678,6954,6 410,6689,6755,7011,6795,7068,7128,7387,3739,4468,4580,5215,4714,5270,5358,5812, 4783,5390,5453,5892,5517,5927,5947,6358,4920,5488,5567,5950,5630,6054,6103,6433 ,5707,6138,6200,6534,6262,6576,6645,6908,5022,5600,5680,6113,5789,6187,6179,658 0,5832,6243,6275,6632,6372,6682,6712,7017,5922,6310,6401,6701,6437,6772,6798,70 77,6497,6828,6873,7147,6961,7200,7260,7479,5095,5724,5797,6250,5878,6294,6375,6 693,6047,6405,6463,6783,6474,6806,6852,7117,6081,6467,6493,6841,6584,6870,6939, 7188,6661,6957,6990,7217,7042,7287,7325,7515,6141,6605,6639,6911,6714,6968,6999 ,7245,6759,7036,7082,7311,7133,7350,7402,7589,6880,7089,7151,7363,7207,7419,744 1,7649,7250,7462,7497,7674,7547,7717,7769,7906,3874,4638,4750,5393,4907,5479,55 55,6013,4951,5579,5651,6063,5722,6126,6219,6649,5072,5689,5809,6169,5858,6290,6 265,6668,5897,6323,6384,6748,6457,6776,6817,7103,5310,5838,5903,6287,6045,6364, 6416,6787,6060,6459,6481,6820,6519,6856,6891,7173,6083,6507,6566,6887,6657,6936 ,6981,7222,6704,7024,7038,7291,7086,7330,7374,7565,5344,6039,6052,6441,6087,647 1,6529,6867,6148,6587,6635,6921,6686,6970,7032,7276,6397,6653,6718,6986,6763,70 60,7091,7318,6863,7097,7155,7366,7210,7415,7437,7644,6477,6769,6837,7063,6884,7 140,7181,7383,6948,7195,7230,7432,7271,7466,7511,7690,6996,7252,7299,7493,7343, 7524,7561,7729,7391,7579,7608,7758,7634,7807,7819,7977,5369,6096,6120,6640,6362 ,6674,6708,7021,6423,6744,6780,7071,6848,7114,7169,7378,6488,6813,6876,7125,691 5,7184,7232,7428,6974,7265,7225,7454,7323,7505,7543,7707,6664,6898,6932,7202,70 15,7240,7295,7484,7054,7302,7339,7528,7369,7551,7593,7752,7136,7355,7400,7570,7 446,7619,7639,7795,7472,7669,7685,7834,7723,7853,7869,7949,6765,6944,7050,7307, 7111,7334,7358,7556,7163,7407,7423,7604,7458,7623,7679,7814,7177,7449,7487,7664 ,7537,7696,7700,7861,7585,7735,7746,7875,7783,7916,7931,8031,7278,7521,7534,771 2,7599,7740,7765,7891,7628,7788,7800,7923,7840,7940,7988,8057,7653,7827,7847,79 59,7883,7967,7997,8072,7899,8009,8019,8088,8044,8105,8126,8152,1813,2748,3167,3 937,3409,4021,4239,4801,3579,4171,4355,4915,4504,5038,5080,5686,3722,4305,4411, 5013,4628,5142,5306,5730,4734,5292,5222,5803,5459,5880,5933,6344,3842,4549,4705 ,5185,4769,5273,5372,5823,4942,5430,5485,5889,5633,5992,6034,6424,5060,5511,566 6,6018,5719,6086,6150,6480,5794,6165,6229,6582,6259,6625,6698,7019,4100,4591,48 57,5416,4968,5471,5621,5953,5103,5677,5523,6042,5762,6108,6191,6513,5255,5654,5 783,6157,5843,6210,6255,6608,5917,6273,6355,6666,6418,6723,6775,7107,5402,5815, 5900,6247,6000,6307,6392,6709,6070,6398,6476,6753,6524,6822,6872,7174,6176,6504 ,6596,6840,6618,6875,6937,7228,6687,6956,7004,7268,7049,7303,7361,7601,4457,482 9,4988,5645,5162,5710,5742,6184,5324,5774,5852,6241,5924,6303,6326,6706,5445,58 63,5944,6314,6027,6388,6461,6760,6100,6464,6508,6804,6604,6861,6924,7208,5549,5 976,6078,6414,6115,6470,6538,6844,6237,6586,6622,6882,6683,6952,6987,7266,6322, 6654,6715,6969,6756,7037,7055,7298,6825,7081,7142,7347,7186,7389,7468,7603,5597 ,6093,6203,6549,6297,6611,6679,6962,6348,6691,6730,7016,6779,7051,7104,7333,645 0,6764,6808,7076,6879,7131,7179,7401,6910,7191,7236,7435,7281,7483,7509,7701,65 31,6847,6892,7150,6973,7206,7243,7459,7047,7258,7301,7498,7349,7516,7576,7749,7 102,7317,7364,7548,7384,7592,7617,7785,7465,7629,7656,7778,7682,7813,7855,7970, 4669,5123,5204,5835,5341,5872,5960,6381,5355,5968,6050,6429,6130,6517,6556,6916 ,5535,6057,6135,6568,6218,6600,6647,6920,6266,6643,6702,7001,6767,7044,7064,729 7,5573,6198,6278,6578,6365,6658,6719,7041,6407,6745,6782,7069,6818,7127,7161,73 80,6403,6811,6853,7123,6907,7183,7213,7436,6979,7247,7282,7481,7315,7508,7554,7 736,5698,6336,6371,6738,6444,6797,6851,7109,6484,6868,6889,7178,6940,7227,7255, 7477,6694,6927,6976,7235,7023,7275,7313,7503,7087,7324,7372,7544,7408,7591,7621 ,7771,6793,7010,7073,7293,7121,7344,7376,7577,7170,7394,7420,7600,7471,7641,766 5,7803,7239,7467,7485,7657,7504,7683,7648,7823,7563,7731,7750,7863,7757,7904,79 24,7991,5754,6436,6454,6903,6662,6949,6985,7246,6742,6998,7025,7286,7084,7329,7 368,7581,6786,7080,7118,7331,7149,7377,7412,7606,7193,7425,7456,7635,7499,7661, 7699,7829,6913,7130,7159,7409,7212,7447,7489,7650,7285,7491,7512,7697,7564,7678 ,7742,7865,7341,7536,7587,7732,7610,7756,7774,7892,7643,7781,7780,7919,7825,793 3,7948,8028,7007,7187,7251,7492,7327,7513,7550,7710,7373,7578,7596,7751,7627,77 60,7779,7901,7413,7614,7651,7772,7666,7784,7826,7934,7709,7835,7850,7952,7879,7 975,7989,8062,7478,7658,7693,7828,7741,7830,7872,7960,7748,7868,7894,7983,7912, 7999,8020,8083,7761,7905,7929,8007,7943,8024,8014,8091,7968,8038,8048,8109,8067 ,8118,8128,8151,4889,5236,5385,5909,5497,6065,6142,6542,5561,6172,6222,6565,629 1,6633,6650,7029,5585,6285,6333,6629,6377,6801,6829,7099,6490,6836,6899,7172,69 45,7216,7254,7496,5609,6359,6440,6814,6498,6896,6931,7201,6545,6960,6991,7261,7 034,7306,7338,7517,6592,7012,7062,7322,7113,7367,7390,7569,7135,7382,7426,7612, 7431,7633,7660,7857,5985,6494,6527,6943,6573,6994,7031,7292,6672,7067,7090,7356 ,7141 ,7399,7422,7583,6734,7095,7156,7385,7198,7430,7440,7622,7231,7443,7455,766 3,7535,7684,7725,7867,6790,7197,7221,7453,7273,7486,7495,7673,7309,7532,7557,77 08,7598,7738,7753,7896,7352,7572,7611,7755,7645,7770,7805,7913,7691,7810,7836,7 935,7851,7956,7978,8059,6011,6559,6637,7058,6727,7094,7145,7406,6771,7164,7203, 7444,7242,7464,7473,7668,6864,7223,7270,7474,7308,7527,7549,7703,7351,7566,7597 ,7744,7625,7763,7791 ,7897,6933,7289,7335,7555,7393,7590,7586,7766,7417,7615,763 1,7786,7675,7806,7818,7938,7460,7647,7688,7815,7704,7843,7852,7961,7730,7864,78 84,7984,7918,8001,8022,8085,6982,7360,7397,7620,7438,7640,7676,7811,7523,7689,7 715,7848,7721,7856,7874,7974,7538,7716,7727,7871,7767,7882,7909,7998,7798,7917, 7927,8008,7947,8029,8042,8094,7568,7777,7789,7898,7820,7920,7932,8016,7837,7945 ,7962,8037,7979,8049,8065,8113,7886,7964,7985,8052,8004,8069,8075,8125,8017,808 0,8090,8131,8102,8140,8150,8171 ,6123,6676,6749,7167,6857,7220,7262,7506,6885,72 77,7319,7531,7357,7560,7605,7794,6966,7340,7403,7582,7429,7637,7626,7801,7448,7 652,7681,7832,7713,7845,7860,7969,7116,7418,7450,7636,7522,7672,7695,7849,7529, 7714,7724,7862,7739,7877,7890,7993,7540,7734,7759,7888,7797,7908,7925,8010,7816 ,7941,7946,8030,7963,8043,8055,8107,7137,7518,7525,7705,7542,7718,7743,7881,757 1,7768,7787,7903,7809,7921,7944,8026,7687,7796,7821,7926,7838,7953,7965,8039,78 80,7966,7986,8053,8005,8068,8074,8124,7722,7842,7870,7954,7887,7982,7995,8058,7 911,8000,8012,8073,8025,8081,8093,8134,7930,8018,8034,8089,8047,8096,8106,8142, 8060,8110,8117,8148,8122,8157,8159,8179,7154,7545,7558,7790,7671,7804,7817,7939 ,7698,7831,7846,7958,7873,7973,7992,8056,7726,7859,7885,7976,7900,7996,8013,807 1,7922,8023,8011,8078,8041,8092,8101,8137,7799,7893,7907,8002,7937,8015,8032,80 86,7951,8035,8046,8097,8054,8103,8114,8147,7980,8050,8063,8108,8076,8119,8123,8 155,8082,8130,8133,8161,8141 ,8164,8166,8176,7839,791 0,7950,8036,7972,8045,8051, 8104,7990,8066,8070,8116,8079,8120,8132,8158,7994,8077,8087,8129,8100,8135,8136 ,8165,8112,8143,8146,8167,8153,8172,8174,8184,8027,8095,8099,8139,8115,8144,814 9,8169,8121,8154,8156,8173,8162,8175,8180,8186,8127,8160,8163,8177,8168,8178,81 81,8187,8170,8182,8183,8188,8185,8189,8190,8191] ;
où la séquence Z2 est donnée par
[0,1,2,7,3,8,13,26,4,12,15,30,18,35,37,82,5,14,16,34,21,41,51,87,24,50,45,94,61,103,110 ,177,6,19,23,43,25,49,55,96,31,59,63,104,76,117,123,195,36,65,80,121,85,131,141,208, 93,143,155,235,161,248,271,391,9,20,28,58,32,62,75,112,38,81,67,124,90,135,149,217, 48,78,92,142,98,152,160,243,108,163,180,260,194,278,296,434,57,95,106,159,119,171, 188,274,129,189,207,288,220,313,330,471,146,215,239,318,246,331,356,502,266,363,3 85,528,405,551,593,816,17,27,33,77,42,84,88,147,52,91,99,158,109,170,174,273,60,100 ,111,172,122,187,204,290,134,205,216,307,241,326,350,491,69,115,130,193,136,206,22 3,319,156,237,247,334,265,362,378,525,173,257,275,369,289,399,408,548,315,421,453, 582,477,613,681,817,73,132,151,226,168,244,264,367,178,267,281,390,297,407,432,57 1,202,293,308,418,332,447,473,624,344,480,507,650,535,693,719,942,222,321,338,457, 371,488,511,672,404,521,549,708,583,724,785,1011,431,561,595,756,609,805,833,1072 ,677,848,880,1059,914,1122,1203,1479,22,39,44,97,53,101,113,186,54,114,125,196,138 ,218,228,348,68,126,139,232,153,240,254,349,162,252,272,383,294,403,413,547,71,150 ,164,234,182,258,276,402,192,286,298,415,311,445,463,607,191,309,323,442,343,476,4 93,653,373,515,537,692,558,716,762,992,83,176,184,283,200,304,322,436,210,329,337, 472,357,501,520,688,269,351,372,506,392,533,557,712,424,565,600,752,629,803,837,1 048,302,387,417,544,441,580,603,788,468,618,638,813,682,863,893,1102,509,680,696, 881,713,916,871,1140,771,986,1014,1221,1026,1306,1353,1539,89,197,203,342,259,36 1,376,514,285,381,395,540,423,569,599,791,300,420,440,570,456,605,632,822,481,642, 670,854,710,888,939,1151,347,446,462,630,492,661,699,873,538,700,720,935,774,910, 1002,1226,578,745,799,987,823,1023,1054,1279,864,1066,1063,1341,1143,1376,1417,1 670,386,478,516,703,567,723,760,955,601,789,807,1017,846,1032,1062,1300,633,830,8 75,1051,894,1069,1146,1380,952,1163,1194,1428,1250,1493,1531,1810,689,884,930,11 49,999,1154,1238,1445,1009,1229,1285,1516,1329,1567,1639,1919,1033,1309,1367,15 92,1400,1651,1617,1957,1471,1707,1746,2065,1830,2125,2198,2406,29,47,56,107,64,1 27,140,224,70,144,154,231,167,250,255,396,72,165,175,249,185,305,316,430,211,317,3 41,469,360,495,518,707,74,181,198,310,213,339,353,486,225,366,379,523,398,552,575, 726,238,389,411,564,437,596,615,780,448,608,644,827,649,853,886,1209,116,212,221, 358,233,380,397,543,262,414,425,588,452,621,641,795,282,429,461,612,484,647,656,8 40,505,658,669,890,744,919,976,1228,301,483,498,666,530,697,704,903,556,741,766,9 51,812,995,1019,1288,587,784,826,1021,867,1045,1108,1332,928,1116,1166,1384,1197 ,1439,1500,1799,120,230,251,409,279,426,455,626,295,465,487,660,510,676,684,897,3 28,500,529,686,554,735,759,943,584,776,809,1007,842,1036,1084,1291,354,542,574,76 4,617,802,798,1039,635,832,850,1074,906,1111,1133,1390,673,869,923,1125,946,1180, 1200,1448,983,1224,1262,1519,1338,1575,1643,1925,375,592,620,836,654,860,907,111 9,731,926,962,1189,968,1206,1244,1488,747,964,980,1235,1041,1259,1318,1564,1095, 1335,1364,1595,1414,1676,1721,1977,778,1056,1080,1294,1134,1344,1373,1626,1169, 1407,1453,1704,1505,1752,1819,2087,1268,1460,1524,1768,1584,1841,1872,2182,1631 ,1900,1951,2224,2025,2299,2394,2688,137,263,287,466,324,496,524,715,336,534,562,7 39,590,770,819,1087,368,577,625,793,646,858,844,1101,663,877,913,1160,958,1183,12 15,1474,439,637,665,857,730,901,932,1192,738,959,974,1218,998,1247,1277,1547,749, 990,1029,1274,1092,1315,1356,1600,1127,1397,1411,1679,1456,1727,1782,2051,450,7 28,734,948,751,967,1004,1256,781,1044,1077,1303,1113,1347,1404,1662,920,1090,113 7,1361,1171,1431,1463,1712,1253,1468,1527,1771,1587,1836,1866,2173,971,1177,123 2,1434,1271,1511,1555,1793,1326,1570,1609,1860,1657,1906,1971,2251,1370,1634,16 90,1945,1743,1991,2047,2319,1804,2073,2117,2373,2157,2470,2494,2875,458,755,767, 1081,899,1105,1130,1393,936,1157,1186,1442,1241,1485,1542,1788,978,1212,1265,14 96,1297,1559,1612,1853,1350,1648,1604,1889,1718,1963,2019,2279,1098,1282,1312,1 579,1387,1621,1684,1931,1425,1693,1737,1997,1777,2033,2095,2362,1508,1757,1815, 2059,1877,2133,2165,2443,1914,2215,2243,2524,2308,2567,2601,2797,1174,1323,1422 ,1698,1482,1732,1762,2039,1535,1825,1847,2111,1894,2141,2232,2482,1550,1883,193 7,2207,2011,2260,2269,2583,2081,2330,2350,2617,2420,2710,2750,3042,1665,1985,20 05,2288,2103,2339,2385,2652,2149,2432,2455,2730,2539,2773,2904,3134,2190,2509,2 552,2822,2633,2846,2933,3187,2671,2967,3002,3252,3083,3328,3433,3584,10,40,66,14 5,86,157,190,299,102,179,209,327,236,359,370,576,118,201,219,352,261,388,438,594,2 84,433,412,623,489,655,678,889,133,245,277,400,291,428,460,631,333,479,499,659,55 5,705,725,938,364,508,568,718,589,750,783,972,619,790,824,1040,841,1070,1123,1392 ,169,253,312,474,340,494,550,687,377,573,513,729,606,761,804,994,422,563,614,786,6 39,814,839,1058,671,849,895,1099,934,1142,1182,1477,470,627,664,835,709,868,918,1 132,742,922,970,1164,1000,1219,1260,1549,796,988,1049,1234,1065,1263,1317,1607,1 115,1334,1378,1653,1420,1695,1766,2107,227,306,346,560,394,586,597,800,444,611,6 43,831,675,866,879,1129,485,648,683,872,721,915,960,1170,757,963,991,1205,1055,12 51,1305,1585,522,698,746,931,765,966,1010,1237,828,1043,1067,1269,1112,1331,1363 ,1650,876,1091,1136,1346,1167,1409,1426,1688,1222,1452,1514,1748,1560,1801,1910, 2109,541,754,810,1018,862,1060,1109,1340,892,1118,1147,1389,1184,1423,1476,1730, 954,1173,1208,1447,1266,1503,1554,1817,1293,1565,1616,1862,1667,1929,1969,2271, 1006,1240,1278,1522,1349,1582,1624,1896,1418,1641,1691,1953,1750,1979,2067,2355 ,1472,1711,1770,2027,1795,2093,2131,2424,1904,2151,2192,2410,2236,2480,2570,285 6,270,382,406,636,449,652,691,911,454,694,733,940,773,996,1022,1299,517,736,775,1 030,818,1052,1085,1302,845,1083,1126,1375,1176,1415,1436,1686,531,808,851,1037,9 02,1094,1139,1412,927,1159,1187,1440,1216,1498,1534,1790,924,1210,1245,1495,129 0,1557,1590,1864,1355,1629,1669,1927,1709,1967,2035,2332,581,885,905,1153,950,11 99,1243,1480,975,1257,1275,1552,1320,1605,1638,1921,1120,1308,1352,1614,1395,16 60,1705,1959,1458,1720,1779,2021,1827,2091,2137,2399,1196,1383,1444,1683,1492,1 744,1784,2069,1544,1808,1843,2105,1912,2169,2209,2460,1619,1908,1933,2194,1961, 2238,2180,2502,2048,2323,2357,2588,2371,2682,2733,2914,602,944,956,1287,1097,13 28,1360,1627,1156,1372,1398,1674,1455,1725,1775,2075,1190,1450,1490,1728,1521,1 786,1832,2115,1569,1849,1893,2159,1955,2203,2266,2514,1296,1501,1532,1828,1589, 1879,1939,2184,1672,1941,1973,2262,2049,2230,2344,2593,1741,2009,2085,2326,2119 ,2369,2403,2654,2171,2417,2415,2718,2504,2756,2794,3031,1381,1562,1633,1943,172 3,1975,2031,2286,1781,2071,2097,2360,2147,2378,2413,2676,1834,2127,2186,2401,22 11,2422,2507,2759,2284,2527,2560,2806,2622,2868,2907,3150,1923,2196,2256,2512,2 341,2517,2609,2825,2353,2598,2660,2891,2704,2940,3006,3234,2380,2685,2744,2960, 2779,3016,2985,3266,2849,3064,3098,3347,3166,3389,3444,3576,320,416,464,667,503, 740,779,1013,527,794,821,1028,859,1076,1088,1401,536,855,882,1073,909,1202,1225, 1469,979,1231,1284,1545,1325,1594,1636,1949,545,898,947,1213,984,1281,1311,1577, 1015,1337,1366,1645,1406,1697,1736,1981,1047,1386,1433,1716,1484,1773,1802,2057 ,1506,1791,1851,2123,1858,2155,2200,2575,702,982,1003,1321,1034,1369,1403,1681,1 104,1437,1461,1759,1513,1814,1845,2079,1150,1466,1529,1797,1574,1856,1870,2139, 1610,1873,1891,2205,2007,2241,2312,2596,1193,1572,1599,1887,1658,1935,1947,2221 ,1702,2003,2041,2282,2101,2335,2364,2663,1755,2063,2121,2366,2176,2396,2465,270 7,2253,2475,2529,2762,2562,2816,2878,3142,714,1025,1078,1429,1144,1464,1518,182 3,1179,1537,1580,1875,1622,1902,1916,2213,1254,1602,1655,1918,1700,1995,2029,22 73,1753,2053,2099,2348,2143,2382,2439,2665,1314,1677,1734,2037,1806,2089,2083,2 387,1838,2129,2153,2427,2226,2467,2492,2768,1898,2178,2247,2484,2275,2544,2565, 2828,2321,2591,2636,2894,2716,2947,3009,3239,1358,1764,1812,2135,1868,2167,2228 ,2477,1989,2249,2295,2554,2304,2572,2614,2865,2013,2297,2317,2606,2389,2630,269 6,2937,2451,2713,2741,2964,2791,3034,3075,3280,2055,2408,2434,2668,2497,2721,27 53,2992,2532,2785,2831,3060,2881,3102,3158,3363,2641,2837,2897,3114,2954,3174,3 200,3427,2995,3221,3261,3461,3313,3510,3569,3740,769,1106,1161,1540,1248,1597,1 646,1965,1272,1663,1714,2001,1761,2045,2113,2441,1343,1739,1821,2077,1855,2163, 2145,2458,1881,2188,2234,2522,2290,2547,2580,2853,1487,1840,1885,2161,1987,2219 ,2258,2557,1999,2292,2310,2585,2337,2620,2649,2920,2015,2328,2376,2646,2448,269 3,2736,2971,2487,2776,2788,3038,2834,3079,3126,3337,1509,1983,1993,2277,2017,23 01,2346,2628,2061,2392,2429,2679,2472,2724,2782,3024,2245,2446,2499,2738,2534,2 809,2840,3068,2625,2843,2900,3118,2957,3170,3195,3421,2306,2542,2604,2812,2644, 2888,2927,3138,2701,2944,2978,3191,3020,3225,3275,3479,2747,2999,3049,3257,3094 ,3289,3332,3523,3146,3352,3384,3556,3410,3620,3636,3827,1526,2023,2043,2436,221 7,2463,2489,2771,2264,2519,2549,2819,2612,2862,2917,3130,2315,2578,2638,2872,26 74,2930,2981,3183,2727,3013,2974,3212,3072,3270,3308,3497,2453,2657,2690,2950,2 765,2988,3045,3243,2803,3053,3090,3294,3122,3318,3368,3549,2884,3106,3154,3342, 3204,3394,3416,3605,3230,3456,3473,3652,3516,3676,3694,3792,2537,2699,2800,3057 ,2859,3087,3110,3323,2910,3162,3178,3378,3217,3400,3467,3628,2923,3208,3248,345 0,3303,3485,3491,3685,3358,3529,3542,3702,3591,3750,3770,3896,3027,3284,3298,35 04,3373,3536,3563,3721,3405,3598,3613,3760,3660,3781,3840,3929,3438,3644,3668,3 803,3712,3815,3853,3947,3730,3866,3881,3968,3912,3990,4016,4049,11,46,79,183,105 ,199,256,393,128,242,280,427,314,467,482,743,148,268,292,459,345,512,572,768,374,5 66,539,801,634,843,870,1117,166,325,365,526,384,559,598,811,435,622,645,847,717,9 00,925,1175,475,657,732,917,758,953,993,1214,797,1001,1042,1292,1064,1327,1388,1 668,214,335,410,616,443,640,711,878,490,737,668,929,782,969,1020,1239,553,727,792 ,997,820,1031,1061,1313,861,1071,1128,1359,1172,1408,1451,1756,610,806,852,1057, 908,1096,1152,1396,945,1155,1211,1432,1249,1494,1533,1826,1012,1233,1304,1504,1 322,1536,1591,1884,1377,1608,1654,1930,1696,1970,2040,2386,303,401,451,722,519,7 53,772,1016,579,787,825,1053,865,1093,1107,1394,628,829,874,1100,921,1148,1201,1 438,965,1204,1236,1478,1310,1523,1578,1863,679,891,949,1168,973,1207,1258,1507,1 046,1298,1324,1543,1374,1606,1640,1926,1103,1351,1399,1620,1435,1685,1703,1964, 1497,1729,1792,2022,1837,2076,2187,2388,701,957,1027,1267,1086,1316,1371,1615,1 121,1379,1413,1666,1454,1701,1751,2004,1195,1443,1481,1724,1538,1780,1831,2094, 1566,1844,1892,2138,1942,2206,2246,2551,1255,1512,1551,1800,1625,1859,1901,2174 ,1694,1917,1966,2229,2024,2254,2343,2635,1749,1986,2044,2302,2070,2372,2411,270 5,2181,2430,2473,2691,2516,2760,2845,3100,355,497,532,815,585,834,883,1145,591,8 87,933,1178,981,1242,1273,1573,674,937,985,1283,1035,1307,1345,1576,1068,1339,13 91,1652,1446,1692,1713,1962,690,1024,1075,1289,1135,1354,1402,1689,1165,1427,14 57,1717,1489,1776,1811,2066,1162,1483,1517,1772,1563,1835,1867,2142,1630,1907,1 946,2204,1982,2242,2311,2613,748,1114,1138,1419,1188,1470,1515,1758,1220,1530,1 548,1829,1593,1882,1915,2199,1382,1581,1628,1890,1671,1938,1980,2235,1735,1994, 2054,2296,2102,2368,2416,2678,1467,1659,1722,1958,1769,2018,2060,2347,1820,2084 ,2118,2383,2189,2450,2490,2739,1897,2185,2210,2474,2237,2520,2461,2780,2324,260 5,2639,2863,2653,2946,2990,3149,777,1181,1198,1561,1357,1603,1635,1905,1424,164 7,1675,1950,1733,2000,2052,2352,1462,1726,1767,2002,1798,2062,2108,2395,1846,21 24,2170,2438,2233,2483,2548,2792,1571,1778,1809,2104,1865,2156,2216,2464,1948,2 218,2248,2543,2327,2511,2624,2869,2016,2285,2363,2607,2397,2650,2684,2921,2452, 2698,2695,2979,2783,3011,3047,3251,1656,1839,1909,2222,1996,2252,2307,2568,2056 ,2349,2374,2642,2428,2659,2694,2941,2110,2405,2466,2681,2491,2702,2786,3014,256 4,2804,2836,3056,2892,3112,3143,3350,2201,2478,2536,2789,2621,2795,2880,3071,26 32,2871,2926,3131,2968,3172,3228,3422,2661,2949,3003,3192,3032,3237,3211,3445,3 093,3278,3306,3511,3364,3546,3588,3696,419,546,604,856,651,941,989,1261,685,1005 ,1038,1280,1082,1333,1348,1678,695,1079,1110,1330,1141,1473,1499,1747,1223,1502, 1558,1822,1601,1871,1913,2227,706,1131,1185,1486,1230,1553,1586,1854,1264,1613, 1642,1922,1682,1972,2010,2257,1301,1664,1708,1992,1760,2046,2080,2336,1783,2068 ,2128,2402,2136,2437,2481,2851,896,1227,1252,1596,1286,1644,1680,1956,1365,1715, 1738,2032,1789,2090,2122,2358,1416,1745,1807,2074,1850,2132,2148,2419,1888,2150 ,2168,2486,2283,2523,2594,2870,1465,1848,1876,2164,1934,2212,2223,2503,1978,228 0,2316,2563,2381,2616,2645,2929,2030,2342,2400,2647,2456,2675,2745,2970,2535,27 54,2807,3018,2839,3066,3117,3343,912,1276,1336,1706,1410,1740,1796,2098,1449,18 16,1857,2154,1899,2179,2193,2495,1528,1880,1932,2195,1974,2270,2305,2553,2026,2 331,2377,2631,2423,2664,2719,2932,1588,1954,2008,2313,2082,2367,2361,2667,2112, 2409,2433,2708,2506,2748,2772,3023,2175,2459,2528,2763,2556,2821,2842,3074,2602 ,2866,2903,3133,2976,3179,3231,3425,1632,2038,2088,2414,2144,2447,2508,2757,226 5,2531,2576,2830,2584,2848,2886,3108,2289,2579,2599,2877,2670,2901,2958,3169,27 31,2973,3000,3194,3044,3255,3288,3457,2333,2687,2714,2935,2774,2982,3008,3218,2 810,3039,3078,3276,3121,3310,3356,3524,2909,3084,3137,3321,3185,3371,3391,3579, 3222,3409,3441,3602,3486,3642,3690,3819,977,1368,1430,1818,1520,1874,1924,2240, 1546,1940,1988,2276,2036,2322,2391,2722,1618,2014,2096,2354,2130,2444,2425,2737 ,2158,2469,2515,2801,2571,2824,2857,3096,1765,2116,2162,2442,2263,2500,2540,283 3,2274,2573,2590,2860,2619,2889,2918,3156,2291,2610,2656,2915,2728,2955,2993,31 98,2766,3029,3041,3258,3081,3292,3331,3502,1787,2259,2268,2559,2294,2582,2627,2 898,2338,2673,2711,2943,2751,2984,3036,3245,2525,2725,2777,2997,2813,3059,3086, 3282,2895,3091,3140,3324,3188,3367,3387,3574,2587,2818,2874,3062,2912,3127,3163 ,3339,2965,3175,3205,3383,3241,3413,3453,3617,3005,3224,3265,3437,3304,3465,349 9,3653,3346,3515,3541,3680,3565,3726,3737,3887,1803,2300,2318,2715,2498,2742,27 69,3026,2545,2798,2827,3069,2883,3105,3152,3335,2595,2854,2906,3115,2938,3165,3 207,3379,2987,3235,3201,3402,3286,3448,3482,3632,2734,2924,2952,3181,3021,3214, 3262,3429,3054,3268,3300,3469,3327,3490,3528,3674,3124,3314,3354,3507,3395,3551 ,3570,3714,3418,3597,3612,3751,3647,3769,3784,3860,2815,2962,3051,3272,3103,329 6,3317,3494,3147,3360,3375,3538,3406,3555,3607,3732,3159,3398,3432,3593,3477,36 22,3626,3776,3520,3658,3669,3790,3703,3828,3843,3939,3247,3462,3474,3637,3533,3 663,3686,3805,3560,3708,3719,3835,3757,3851,3897,3964,3583,3744,3763,3869,3797, 3877,3906,3978,3812,3917,3927,3994,3951,4010,4031,4056,229,504,662,1008,763,105 0,1158,1459,838,1124,1217,1525,1295,1598,1623,2012,904,1191,1246,1583,1362,1661, 1763,2042,1421,1754,1710,2092,1861,2146,2183,2485,961,1319,1405,1687,1441,1742, 1805,2106,1541,1842,1878,2152,1976,2225,2255,2546,1611,1895,1998,2244,2034,2293 ,2340,2589,2086,2351,2398,2669,2421,2703,2761,3025,1089,1342,1491,1833,1556,186 9,1968,2197,1637,2006,1903,2261,2064,2309,2370,2615,1731,1990,2078,2345,2120,23 84,2418,2689,2172,2431,2493,2735,2541,2781,2823,3099,1824,2100,2160,2412,2231,2 457,2521,2770,2281,2526,2586,2805,2623,2861,2902,3157,2359,2608,2680,2876,2697, 2905,2956,3203,2752,2972,3012,3238,3050,3269,3320,3535,1270,1475,1568,1984,1673 ,2028,2050,2365,1774,2072,2126,2407,2177,2454,2471,2767,1852,2134,2191,2462,225 0,2518,2574,2811,2303,2577,2611,2847,2686,2893,2945,3186,1920,2214,2287,2538,23 14,2581,2634,2879,2404,2672,2700,2911,2749,2969,2998,3236,2468,2726,2775,2983,2 808,3040,3055,3264,2864,3077,3129,3307,3167,3344,3415,3537,1952,2298,2379,2643, 2449,2692,2746,2977,2488,2755,2787,3022,2826,3052,3097,3295,2566,2814,2850,3073 ,2908,3120,3161,3355,2934,3171,3210,3385,3249,3428,3452,3627,2629,2882,2919,313 6,2986,3184,3216,3407,3048,3229,3267,3442,3309,3458,3512,3671,3095,3281,3322,34 87,3340,3527,3550,3705,3412,3561,3585,3698,3609,3731,3771,3880,1385,1649,1699,2 114,1785,2140,2202,2513,1794,2208,2267,2550,2325,2618,2648,2939,1911,2272,2329, 2658,2390,2683,2720,2942,2426,2717,2764,3010,2817,3046,3063,3263,1936,2375,2435 ,2666,2501,2729,2778,3043,2533,2799,2829,3067,2858,3116,3145,3336,2530,2852,288 7,3113,2931,3164,3190,3386,2991,3220,3250,3426,3279,3451,3492,3659,2020,2479,25 05,2793,2561,2841,2885,3101,2592,2899,2916,3160,2959,3202,3227,3423,2758,2948,2 989,3209,3028,3244,3277,3446,3082,3287,3329,3483,3361,3526,3553,3692,2838,3017, 3070,3260,3111,3305,3333,3513,3153,3349,3372,3534,3417,3572,3594,3722,3213,3414 ,3430,3586,3447,3610,3578,3741,3500,3655,3672,3778,3679,3817,3836,3900,2058,255 5,2569,2928,2732,2966,2996,3219,2796,3007,3030,3254,3080,3291,3326,3517,2832,30 76,3109,3293,3135,3334,3365,3540,3173,3376,3404,3566,3443,3590,3625,3746,2936,3 119,3144,3362,3189,3396,3434,3580,3253,3435,3454,3623,3501,3606,3665,3780,3302, 3476,3522,3656,3543,3678,3695,3806,3573,3701,3700,3831,3742,3845,3859,3936,3015 ,3168,3223,3436,3290,3455,3489,3635,3330,3514,3530,3673,3559,3682,3699,3814,336 6,3547,3581,3693,3595,3704,3743,3846,3634,3752,3766,3863,3793,3885,3898,3969,34 24,3587,3619,3745,3664,3747,3787,3870,3670,3783,3808,3892,3825,3908,3928,3989,3 683,3818,3841,3915,3854,3932,3922,3997,3878,3945,3955,4014,3973,4023,4033,4055, 1510,1719,1813,2166,1886,2278,2334,2637,1928,2356,2393,2655,2445,2709,2723,3033 ,1944,2440,2476,2706,2510,2844,2867,3092,2597,2873,2925,3155,2963,3193,3226,344 0,1960,2496,2558,2855,2603,2922,2951,3180,2640,2975,3001,3232,3037,3271,3299,34 59,2677,3019,3061,3285,3104,3325,3345,3506,3123,3338,3377,3545,3382,3564,3589,3 773,2220,2600,2626,2961,2662,3004,3035,3259,2740,3065,3085,3315,3128,3353,3374, 3519,2790,3089,3141,3341,3177,3381,3390,3554,3206,3392,3403,3592,3475,3611,3649 ,3782,2835,3176,3197,3401,3242,3431,3439,3601,3274,3472,3495,3633,3532,3661,367 5,3809,3312,3509,3544,3677,3575,3691,3724,3826,3618,3728,3753,3847,3767,3867,38 88,3966,2239,2651,2712,3058,2784,3088,3132,3359,2820,3148,3182,3393,3215,3411,3 419,3596,2896,3199,3240,3420,3273,3468,3488,3629,3311,3503,3531,3667,3557,3684, 3711,3810,2953,3256,3297,3493,3348,3525,3521,3687,3369,3548,3562,3706,3603,3725 ,3736,3849,3408,3577,3615,3733,3630,3759,3768,3871,3654,3779,3798,3893,3830,391 0,3930,3991,2994,3319,3351,3552,3388,3571,3604,3729,3464,3616,3640,3764,3645,37 72,3789,3884,3478,3641,3651,3786,3688,3796,3822,3907,3717,3829,3839,3916,3858,3 937,3949,4000,3505,3697,3709,3811,3738,3832,3844,3924,3754,3856,3872,3944,3889, 3956,3971,4018,3800,3874,3894,3959,3913,3975,3981,4030,3925,3986,3996,4036,4007 ,4044,4054,4075,2320,2743,2802,3151,2890,3196,3233,3449,2913,3246,3283,3471,331 6,3498,3539,3713,2980,3301,3357,3518,3380,3568,3558,3720,3397,3582,3608,3749,36 38,3761,3775,3879,3107,3370,3399,3567,3463,3600,3621,3765,3470,3639,3648,3777,3 662,3791,3804,3902,3480,3657,3681,3802,3716,3821,3837,3918,3734,3852,3857,3938, 3873,3950,3962,4012,3125,3460,3466,3631,3481,3643,3666,3795,3508,3689,3707,3816 ,3727,3833,3855,3934,3614,3715,3739,3838,3755,3864,3875,3946,3794,3876,3895,396 0,3914,3974,3980,4029,3646,3758,3785,3865,3801,3891,3904,3965,3824,3909,3920,39 79,3933,3987,3999,4039,3842,3926,3941,3995,3954,4002,4011,4046,3967,4015,4022,4 052,4027,4061,4063,4083,3139,3484,3496,3710,3599,3723,3735,3850,3624,3748,3762, 3868,3788,3883,3901,3963,3650,3774,3799,3886,3813,3905,3921,3977,3834,3931,3919 ,3984,3948,3998,4006,4042,3718,3807,3820,3911,3848,3923,3940,3992,3862,3942,395 3,4003,3961,4008,4019,4051,3890,3957,3970,4013,3982,4024,4028,4059,3988,4035,40 38,4065,4045,4068,4070,4080,3756,3823,3861,3943,3882,3952,3958,4009,3899,3972,3 976,4021,3985,4025,4037,4062,3903,3983,3993,4034,4005,4040,4041,4069,4017,4047, 4050,4071,4057,4076,4078,4088,3935,4001,4004,4043,4020,4048,4053,4073,4026,4058 ,4060,4077,4066,4079,4084,4090,4032,4064,4067,4081,4072,4082,4085,4091,4074,408 6,4087,4092,4089,4093,4094,4095] ;
où la séquence Z3 est donnée par
[0,1,2,7,3,8,12,25,4,11,14,29,17,34,36,79,5,13,15,33,20,40,49,84,23,48,44,91,59,100,106 ,170,6,18,22,42,24,47,53,93,30,57,61,101,74,113,119,187,35,63,77,117,82,126,136,199, 90,138,149,224,155,236,257,366,9,19,27,56,31,60,73,108,37,78,65,120,87,130,143,207, 46,76,89,137,95,146,154,231,104,157,173,247,186,264,280,404,55,92,102,153,115,164, 180,260,124,181,198,273,210,296,311,436,141,205,228,300,234,312,334,463,253,341,3 60,485,378,505,540,721,16,26,32,75,41,81,85,142,50,88,96,152,105,163,167,259,58,97, 107,165,118,179,195,275,129,196,206,290,230,307,329,453,67,111,125,185,131,197,21 3,301,150,226,235,315,252,340,354,483,166,244,261,346,274,373,381,502,297,392,420, 531,441,557,613,722,71,127,145,216,161,232,251,344,171,254,266,365,281,380,402,52 2,193,277,291,390,313,415,438,566,324,444,467,588,491,623,644,818,212,303,318,424, 348,451,471,606,377,479,503,635,532,648,697,870,401,513,542,674,554,713,735,914,6 10,746,771,905,797,950,1007,1188,21,38,43,94,51,98,109,178,52,110,121,188,133,208, 218,327,66,122,134,221,147,229,242,328,156,240,258,359,278,376,385,501,69,144,158, 223,175,245,262,375,184,271,282,387,294,413,429,552,183,292,305,411,323,440,455,5 90,350,474,493,622,511,642,679,856,80,169,176,268,191,287,304,405,201,310,317,437, 335,462,478,619,255,330,349,466,367,489,510,638,395,517,546,671,570,711,738,897,2 86,362,389,499,410,529,549,699,433,561,578,719,614,758,781,936,469,612,625,772,63 9,799,764,963,686,851,872,1019,881,1077,1108,1225,86,189,194,322,246,339,352,473, 270,357,369,495,394,520,545,702,284,391,409,521,423,550,573,726,445,581,604,751,6 37,777,816,971,326,414,428,571,454,597,628,766,494,629,645,813,688,794,863,1023,5 28,665,708,852,727,879,901,1059,759,910,908,1100,965,1123,1149,1303,361,442,475,6 31,518,647,677,828,547,700,714,874,745,885,907,1073,574,732,767,899,782,912,967,1 125,826,979,1001,1156,1039,1197,1220,1381,620,774,809,969,861,973,1031,1167,868, 1025,1063,1211,1092,1242,1285,1439,886,1079,1117,1257,1138,1292,1272,1458,1183, 1324,1346,1513,1392,1543,1579,1673,28,45,54,103,62,123,135,214,68,139,148,220,160 ,238,243,370,70,159,168,237,177,288,298,400,202,299,321,434,338,457,477,634,72,174 ,190,293,204,319,332,449,215,343,355,481,372,506,525,650,227,364,383,516,406,543,5 59,693,416,553,583,730,587,750,776,1011,112,203,211,336,222,356,371,498,249,386,3 96,536,419,564,580,705,267,399,427,556,447,585,593,740,465,594,603,779,664,801,84 4,1024,285,446,459,601,487,626,632,789,509,662,682,825,718,858,876,1065,535,696,7 29,877,761,895,940,1094,808,946,981,1128,1003,1163,1201,1375,116,219,239,382,265, 397,422,568,279,431,450,596,470,609,616,784,309,461,486,617,507,657,676,819,533,6 90,716,867,742,888,923,1067,333,497,524,680,560,710,707,890,575,734,748,916,791,9 42,958,1132,607,763,804,952,821,991,1005,1169,849,1021,1047,1213,1098,1247,1287, 1442,351,539,563,737,591,756,792,948,654,806,833,997,838,1009,1035,1194,667,835,8 47,1029,892,1045,1085,1240,931,1096,1115,1259,1147,1306,1332,1468,691,903,920,10 69,959,1102,1121,1277,983,1143,1172,1322,1204,1349,1386,1524,1051,1176,1216,135 8,1252,1398,1414,1571,1280,1429,1455,1591,1492,1626,1668,1784,132,250,272,432,30 6,458,482,641,316,490,514,660,538,685,724,925,345,527,567,703,584,754,743,935,598, 769,796,977,830,993,1015,1185,408,577,600,753,653,787,811,999,659,831,842,1017,86 0,1037,1057,1230,668,854,883,1055,929,1083,1110,1262,954,1136,1145,1308,1174,133 5,1366,1506,418,651,656,823,670,837,865,1043,694,894,918,1075,944,1104,1141,1298, 802,927,961,1113,985,1158,1178,1327,1041,1181,1218,1360,1254,1395,1411,1567,840, 989,1027,1160,1053,1208,1235,1372,1090,1244,1267,1408,1295,1432,1465,1604,1119, 1282,1314,1452,1344,1475,1503,1635,1378,1517,1539,1659,1559,1700,1710,1847,425, 673,683,921,786,938,956,1134,814,975,995,1165,1033,1192,1227,1369,845,1013,1049, 1199,1071,1237,1269,1404,1106,1290,1264,1423,1330,1461,1489,1617,933,1061,1081, 1249,1130,1274,1311,1445,1154,1316,1341,1478,1363,1496,1528,1654,1206,1352,1384 ,1510,1417,1547,1563,1689,1436,1587,1600,1722,1630,1739,1752,1822,987,1088,1152, 1319,1190,1338,1355,1499,1223,1389,1401,1536,1426,1551,1595,1705,1232,1420,1448 ,1583,1485,1608,1612,1745,1521,1640,1649,1758,1679,1792,1806,1896,1300,1472,148 2,1621,1532,1644,1664,1771,1555,1684,1694,1799,1728,1814,1856,1920,1575,1716,17 33,1830,1764,1838,1865,1933,1778,1875,1885,1948,1907,1964,1984,2008,10,39,64,140 ,83,151,182,283,99,172,200,308,225,337,347,526,114,192,209,331,248,363,407,541,269 ,403,384,565,452,592,611,778,128,233,263,374,276,398,426,572,314,443,460,595,508,6 33,649,815,342,468,519,643,537,669,695,841,562,701,728,891,741,913,951,1133,162,2 41,295,439,320,456,504,618,353,523,472,652,551,678,712,857,393,515,558,698,579,72 0,739,904,605,747,783,934,812,964,992,1187,435,569,599,736,636,762,800,957,663,80 3,839,980,862,1018,1046,1231,706,853,898,1028,909,1048,1084,1266,945,1095,1124,1 293,1151,1317,1357,1534,217,289,325,512,368,534,544,709,412,555,582,733,608,760,7 70,955,448,586,615,765,646,798,832,984,675,834,855,1008,902,1040,1076,1253,480,62 7,666,810,681,836,869,1030,731,893,911,1052,943,1093,1114,1291,768,928,960,1103,9 82,1144,1155,1313,1020,1171,1210,1347,1238,1376,1434,1535,496,672,717,875,757,90 6,941,1099,780,947,968,1131,994,1153,1186,1337,827,986,1010,1168,1050,1203,1234, 1385,1068,1241,1271,1409,1301,1444,1464,1613,866,1032,1058,1215,1105,1251,1276, 1427,1150,1286,1315,1456,1348,1469,1514,1651,1184,1326,1359,1493,1373,1527,1546 ,1681,1431,1556,1576,1675,1597,1704,1740,1841,256,358,379,576,417,589,621,795,42 1,624,655,817,687,859,878,1072,476,658,689,884,723,900,924,1074,744,922,953,1122, 988,1148,1161,1312,488,715,749,889,788,930,962,1146,807,976,996,1164,1016,1200,1 222,1370,805,1012,1036,1198,1066,1236,1256,1410,1109,1279,1302,1443,1325,1463,1 497,1641,530,775,790,972,824,1004,1034,1189,843,1044,1056,1233,1086,1265,1284,14 40,949,1078,1107,1270,1135,1297,1323,1459,1175,1331,1364,1490,1390,1526,1549,16 70,1002,1127,1166,1310,1196,1345,1367,1515,1228,1380,1399,1533,1435,1565,1584,1 696,1273,1433,1446,1577,1460,1598,1570,1713,1504,1637,1652,1747,1658,1782,1800, 1859,548,820,829,1064,932,1091,1112,1278,974,1120,1137,1305,1173,1334,1362,1518, 998,1170,1195,1336,1214,1368,1393,1538,1243,1402,1425,1560,1457,1581,1611,1718, 1070,1202,1221,1391,1255,1418,1449,1572,1304,1450,1466,1609,1505,1594,1646,1749 ,1343,1484,1523,1638,1540,1657,1672,1772,1566,1678,1677,1795,1714,1808,1821,189 3,1126,1239,1281,1451,1333,1467,1495,1620,1365,1516,1529,1653,1554,1661,1676,17 80,1394,1544,1573,1671,1585,1680,1715,1809,1619,1723,1736,1825,1760,1845,1857,1 924,1441,1578,1606,1717,1645,1719,1755,1831,1650,1751,1774,1852,1790,1867,1886, 1944,1662,1783,1804,1873,1816,1889,1880,1951,1839,1902,1911,1968,1928,1976,1986 ,2007,302,388,430,602,464,661,692,871,484,704,725,882,755,917,926,1139,492,752,77 3,915,793,1006,1022,1182,846,1026,1062,1229,1089,1258,1283,1454,500,785,822,1014 ,850,1060,1080,1248,873,1097,1116,1288,1142,1318,1340,1470,896,1129,1159,1329,11 91,1361,1377,1509,1205,1371,1403,1542,1407,1558,1580,1742,630,848,864,1087,887,1 118,1140,1309,937,1162,1177,1353,1209,1383,1400,1520,970,1180,1219,1374,1246,14 06,1413,1550,1268,1415,1424,1582,1483,1599,1632,1750,1000,1245,1261,1422,1296,1 447,1453,1590,1321,1481,1500,1618,1531,1642,1655,1775,1351,1512,1541,1656,1568, 1669,1698,1791,1605,1702,1724,1810,1737,1828,1848,1922,640,880,919,1157,966,117 9,1212,1388,990,1224,1250,1416,1275,1430,1437,1586,1042,1263,1294,1438,1320,147 7,1494,1614,1350,1507,1530,1648,1552,1663,1687,1776,1082,1307,1339,1498,1379,15 25,1522,1665,1396,1545,1557,1682,1592,1699,1709,1812,1428,1569,1602,1706,1615,1 730,1738,1832,1636,1748,1765,1853,1794,1869,1887,1945,1111,1356,1382,1548,1412, 1564,1593,1703,1474,1603,1624,1734,1628,1741,1757,1844,1486,1625,1634,1754,1666 ,1763,1787,1866,1692,1793,1803,1874,1820,1894,1905,1954,1508,1674,1685,1777,171 1,1796,1807,1882,1725,1818,1833,1901,1849,1912,1926,1971,1767,1835,1854,1915,18 71,1930,1936,1983,1883,1941,1950,1989,1961,1997,2006,2027,684,939,978,1226,1038, 1260,1289,1462,1054,1299,1328,1480,1354,1502,1537,1688,1101,1342,1387,1519,1405 ,1562,1553,1695,1419,1574,1596,1721,1622,1731,1744,1840,1193,1397,1421,1561,147 3,1589,1607,1735,1479,1623,1631,1746,1643,1759,1770,1861,1487,1639,1660,1769,16 91,1786,1801,1876,1707,1815,1819,1895,1834,1906,1918,1966,1207,1471,1476,1616,1 488,1627,1647,1762,1511,1667,1683,1781,1701,1797,1817,1891,1601,1690,1712,1802, 1726,1826,1836,1903,1761,1837,1855,1916,1872,1929,1935,1982,1629,1729,1753,1827 ,1768,1851,1863,1921,1789,1868,1878,1934,1890,1942,1953,1992,1805,1884,1898,194 9,1910,1956,1965,1999,1923,1969,1975,2004,1980,2013,2015,2035,1217,1491,1501,16 86,1588,1697,1708,1813,1610,1720,1732,1829,1756,1843,1860,1919,1633,1743,1766,1 846,1779,1864,1879,1932,1798,1888,1877,1939,1904,1952,1960,1995,1693,1773,1785, 1870,1811,1881,1897,1946,1824,1899,1909,1957,1917,1962,1972,2003,1850,1913,1925 ,1967,1937,1977,1981,2011,1943,1988,1991,2017,1998,2020,2022,2032,1727,1788,182 3,1900,1842,1908,1914,1963,1858,1927,1931,1974,1940,1978,1990,2014,1862,1938,19 47,1987,1959,1993,1994,2021,1970,2000,2002,2023,2009,2028,2030,2040,1892,1955,1 958,1996,1973,2001,2005,2025,1979,2010,2012,2029,2018,2031,2036,2042,1985,2016, 2019,2033,2024,2034,2037,2043,2026,2038,2039,2044,2041,2045,2046,2047] ;
dans lequel chacun des numéros de séquence de N canaux polarisés dans la seconde séquence correspond à un rang de fiabilité du numéro de séquence dans la séquence entière, et une valeur minimale des numéros de séquence des canaux polarisés est 0.

2. Appareil de codage de code polaire (300), comprenant :
une unité d'obtention (601), configurée pour obtenir une première séquence utilisée pour coder K bits à coder, dans lequel la première séquence comprend des numéros de séquence de N canaux polarisés, les numéros de séquence des N canaux polarisés sont disposés dans la première séquence sur la base de la fiabilité des N canaux polarisés, K est un entier positif, N est une longueur de code mère d'un code polaire, N = 2ⁿ, n est un entier positif et K ≤ N ;
une unité de sélection (602), configurée pour sélectionner des numéros de séquence de K canaux polarisés à partir de la première séquence par ordre décroissant de fiabilité ; et
une unité de codage (603), configurée pour : placer les bits à coder sur la base des numéros de séquence sélectionnés des K canaux polarisés, et effectuer un codage de code polaire sur les bits à coder ;
dans lequel la première séquence est toute une seconde séquence, la seconde séquence comprend des numéros de séquence de Nₘₐₓ canaux polarisés, les numéros de séquence des Nₘₐₓ canaux polarisés sont disposés dans la seconde séquence en fonction de la fiabilité des Nₘₐₓ canaux polarisés, Nₘₐₓ est un entier positif, Nₘₐₓ ≥ N, et un tri des numéros de séquence des canaux polarisés dans la première séquence est cohérent avec un tri des numéros de séquence des canaux polarisés qui sont inférieurs à N dans la seconde séquence ;
**caractérisé en ce que**
la seconde séquence est une partie ou l'ensemble d'une séquence Q1, une séquence Q2 ou une séquence Q3 ;
où la séquence Q1 est donnée par
[0,1,2,4,8,16,32,3,5,64,1024,2048,4096,9,6,17,10,18,128,12,33,65,20,256,34,24,36,7,129 ,66,512,11,40,68,130,19,13,48,14,72,257,1025,21,132,35,258,26,2049,513,80,37,25,22,4 097,136,260,264,38,514,96,67,41,144,28,69,42,516,49,1026,74,272,160,520,288,528,19 2,544,70,44,131,81,2050,50,73,15,320,133,52,1028,23,134,384,76,4098,137,82,56,27,97 ,39,259,84,138,145,261,1032,29,43,2052,98,515,88,140,30,146,71,262,265,161,576,45,1 040,100,640,51,148,46,75,4100,266,273,517,2056,104,162,53,193,1056,152,77,164,768, 268,274,518,54,83,57,521,1027,112,135,2064,78,289,194,85,276,4104,522,58,168,1029, 139,99,86,60,280,89,290,529,2080,524,196,1088,141,101,147,176,142,530,321,31,200,1 033,4112,90,545,292,2051,322,532,263,149,102,105,1030,304,296,163,92,47,267,385,5 46,2053,324,1041,208,386,4128,150,153,165,106,55,1034,328,536,577,548,2112,113,15 4,79,269,1042,108,578,224,166,519,552,195,4099,1152,270,3072,641,523,275,580,291, 59,1036,169,560,114,277,156,2057,87,197,1057,116,170,4101,61,531,525,642,281,1089 ,278,526,2054,177,293,388,91,1044,584,769,198,172,120,4160,201,2065,336,1280,62,2 82,143,103,178,294,1058,93,644,2058,202,592,323,1048,392,5120,297,770,107,180,151 ,1060,2066,209,284,648,94,204,298,1031,400,608,352,2176,6144,325,533,1153,155,210 ,305,547,300,1090,109,2060,184,534,537,115,167,1536,4105,225,326,306,772,2081,157 ,1035,656,329,110,117,212,1064,171,2113,776,4102,330,226,549,1092,538,387,308,216 ,2068,1154,416,271,279,158,337,1043,4113,550,672,2304,118,332,579,1037,540,389,17 3,121,1072,2082,553,199,784,4106,179,1038,228,338,312,2072,704,390,1096,174,554,5 81,393,1281,4114,283,2084,122,448,353,1045,561,203,63,340,2055,1156,394,527,582,4 224,556,181,1059,2177,295,285,232,124,1282,205,182,643,2114,4108,562,1050,286,58 5,299,1537,354,211,2560,401,185,1104,396,344,4129,586,645,2059,1061,593,535,240,2 06,1049,95,2088,327,564,4161,1046,800,402,356,307,2116,1160,301,417,213,568,1284, 832,4116,2178,588,186,1288,646,404,227,896,2067,1062,594,418,4352,302,1538,649,7 71,2061,360,539,1120,111,331,214,1091,2096,4130,309,188,449,1065,217,408,2062,60 9,596,1168,551,650,4120,229,1052,2120,159,420,310,1093,541,773,2305,610,4132,106 6,657,333,119,1540,3073,600,339,218,1073,368,652,4103,230,2069,1098,391,313,450,1 296,542,2180,334,233,4225,1184,555,774,175,2083,1544,123,658,612,1312,2306,4162, 341,777,220,1552,314,424,2074,395,1216,673,583,4608,355,1568,2561,287,183,234,10 94,125,557,2128,4107,660,1068,616,342,316,2085,1155,241,778,1105,563,4136,345,20 73,452,1074,397,403,207,2070,1097,674,4164,558,1039,785,432,2184,357,1344,187,23 6,664,4226,2308,1157,624,587,1076,780,2312,705,126,1047,4115,242,565,1158,2086,3 98,346,456,1408,358,2562,4109,405,1100,303,569,244,2144,1161,595,189,4144,1106,5 66,2115,676,361,1080,706,589,2089,1051,4110,215,786,647,1121,2192,348,419,1063,4 06,4168,464,2076,680,1283,801,362,1108,2117,590,4353,409,1162,570,2090,788,597,1 169,572,219,5121,2564,1285,311,708,1053,598,2097,601,1067,4117,651,421,3074,792, 1122,802,611,1539,2122,4228,602,410,1112,231,688,2320,1164,653,248,4131,1054,220 8,369,190,364,1170,654,2568,4354,659,1095,335,480,2336,1286,315,221,1289,4122,25 76,370,613,1185,422,425,2240,1600,6145,451,614,1069,2592,543,235,1124,412,4609,2 118,343,372,1664,775,317,2092,1075,222,4176,426,1172,2179,453,237,1070,559,2129, 4133,833,1099,804,712,2098,1290,834,661,4121,1297,2121,808,779,1541,617,1128,206 3,4118,604,433,1186,720,2368,816,1077,4232,836,347,2181,1217,897,243,1176,2100,4 356,662,454,1101,318,3076,675,1188,618,4360,898,2071,1792,781,376,2182,1292,4134 ,428,1298,665,2432,736,1542,567,840,4610,2124,1078,625,238,1107,2185,359,4192,45 7,1081,399,2130,787,1545,591,1136,4163,2104,678,434,1159,2075,677,349,4137,1102, 245,2145,458,1313,666,1218,4240,2087,620,363,1109,2307,127,191,4124,1300,782,213 2,1546,407,436,1082,4165,2186,626,571,1192,2193,465,1163,681,4138,246,2309,1123, 707,350,3080,4612,1110,599,1084,668,2077,790,1304,4145,460,2091,249,1113,682,131 4,2146,5122,573,411,1553,2563,803,789,1548,4170,709,2136,1220,365,440,2188,1165, 4368,628,1125,689,2078,374,1171,4256,423,2194,466,1200,793,2119,1166,4616,250,37 1,1554,2310,481,1345,574,4384,2313,413,1055,603,2209,1224,4624,366,468,1114,2624 ,655,1569,900,4288,2093,805,1316,615,3088,1346,4640,684,710,2148,1556,429,1287,4 166,2688,794,252,1173,373,2099,1126,4140,605,848,2196,1129,690,1328,4227,2094,71 3,1320,632,2123,482,4177,1187,806,2314,1116,427,904,6146,2321,1071,414,1291,2565 ,223,663,4146,1409,2152,692,1570,835,2210,4169,1348,619,472,2101,1232,455,4111,1 410,2241,796,809,1174,3104,4416,714,1177,721,2200,1189,837,4229,716,2125,1130,86 4,1079,2212,4148,810,1352,606,2816,912,5124,1560,722,2316,1601,696,1572,4119,232 2,377,435,1137,2566,817,4230,1178,319,2102,1103,621,1293,4480,2131,812,484,1132, 2105,430,4172,1602,838,2569,1248,667,4233,3075,488,1190,239,2160,1543,4178,378,1 576,2183,459,1219,622,4152,2126,627,1294,437,2337,4123,1665,380,2242,1547,818,12 99,4193,2133,461,496,1604,2324,4135,669,1315,2570,679,1083,724,4355,2106,1193,84 1,629,2216,4180,1584,351,1138,3077,467,1301,4234,2187,438,1180,737,2147,4241,111 1,251,1221,2134,462,4357,442,2108,1140,441,1194,2328,5128,469,1085,2137,247,1555 ,4125,683,2338,1549,842,1666,4139,2577,738,899,2572,1305,6148,670,1302,2244,783, 1550,3136,4194,849,1201,820,2189,1317,4611,728,2149,1412,928,1115,4184,2195,791, 367,2224,1608,4236,901,1793,2190,630,1222,4126,2578,685,1196,844,2369,4242,1144, 633,2079,1225,711,4167,1360,2248,253,1086,3081,4358,691,1306,824,2138,1167,4361, 902,2593,1127,686,740,4257,2340,1202,850,2370,1318,4672,375,2580,1117,444,1668,4 141,2311,470,1226,2197,483,5136,1616,415,2150,1347,485,4196,2153,1416,905,3078,1 321,4736,795,1794,2352,473,4147,1131,2344,634,1204,2211,4244,744,1175,852,2140,1 233,4142,960,2095,1308,865,2315,4171,1672,693,2433,1118,4362,797,1228,2594,906,1 322,4369,2372,715,1424,3089,807,4613,1632,474,2256,1376,6152,636,2434,1349,694,2 198,4200,1557,254,2201,1179,717,4258,2213,1234,575,1329,4149,2154,913,1571,2103, 798,4289,1324,3082,811,1133,5152,2376,379,1208,2584,697,4248,1558,431,2625,607,4 173,489,2596,1561,866,2161,4260,1139,723,2202,1191,4864,486,2127,1249,908,2317,4 364,1350,718,1330,3090,4370,813,1796,2156,476,4614,1181,2626,856,1680,2272,4150, 839,1353,2214,725,4179,1134,2567,698,1141,2600,4153,914,1236,2243,752,4617,1195, 3200,868,1800,5123,2318,819,1354,2689,4208,814,1250,439,2571,1573,4231,929,2323, 1562,490,6160,2628,1411,623,2339,4174,1332,671,2107,1240,4385,739,3084,1440,916, 2217,4290,1295,463,2608,1303,4181,843,2162,1182,381,4372,2325,1361,497,2204,461 8,1574,930,2135,1696,4154,821,2245,1142,726,4264,3105,1356,1603,2164,5125,961,22 18,1564,872,2109,4235,1413,492,2579,1197,4195,631,2573,1145,729,4182,2690,1577,7 00,2329,4156,1223,443,3137,1808,4376,741,2326,1203,845,4185,2574,1252,920,2225,4 386,1362,382,2341,1336,4625,822,2436,1728,2139,6176,1414,851,3092,1198,4620,730, 2632,1578,498,4292,2817,1605,880,5184,2246,1417,742,2220,4237,1307,445,2168,114 6,4197,2249,471,1472,2384,4243,1377,635,3328,1585,4272,932,2110,1227,687,4238,23 30,1087,903,2191,4626,1364,2151,825,4417,1418,2226,500,1551,4127,2342,1606,846,3 106,4296,1580,745,2141,1205,5129,2692,826,1319,2250,4186,732,1309,2640,4641,446, 1256,2371,1148,4388,3096,962,1229,2440,6147,936,1206,2345,4418,475,1667,2818,85 3,4628,2155,1586,867,2228,4359,1310,1609,2199,637,4245,1323,3108,907,4198,2257,1 378,487,2332,4201,1235,695,2696,5126,1425,2142,1209,746,4400,2252,1420,828,2346, 4392,1368,3079,753,4259,1610,2448,854,1669,4188,2656,1617,2400,857,4143,1559,23 73,504,4363,1264,2581,799,3201,4481,1230,1119,2203,4642,255,1351,2258,964,6149,2 353,1588,909,4420,2595,1824,719,2348,5137,1426,3138,1380,4304,477,2157,1331,915, 4482,2232,1325,2582,4246,638,1441,2585,1237,4249,2163,748,1592,4261,2215,944,18 56,3584,4202,869,2273,1612,4151,1210,2374,491,5130,2354,1670,699,2820,4424,1428, 1251,2205,4632,754,3083,1920,858,4673,2704,1618,2377,4644,478,1442,2158,6208,13 26,968,2165,1673,4209,2260,383,1795,4250,3112,910,2219,4175,1384,1563,2824,815,4 365,2378,1135,976,5138,2274,1355,2597,4204,1238,870,3140,1333,4674,2586,917,121 2,4320,2435,1473,2356,4262,727,1241,2264,493,4615,3202,1432,873,4648,2464,1633,2 319,4291,1620,701,2327,5248,1575,2206,931,4366,1674,2385,1253,3091,7168,756,118 3,2598,4737,860,2720,1444,4619,1334,2166,499,4371,2380,1565,731,2627,4676,1797,3 085,1634,4387,823,2588,1681,4155,2437,922,1357,5132,2221,1143,2169,4265,874,162 4,3120,4656,918,2601,1363,4210,2247,1242,502,2832,4373,1392,2227,933,4252,1676,3 086,1254,6153,2276,743,1415,4183,2386,1337,2360,4293,760,2752,1474,5153,881,243 8,1566,4212,3144,1358,494,4266,2222,1257,2602,4157,702,2629,1579,4627,1798,2441, 921,4621,3329,1199,501,4738,2331,1147,2170,4377,1682,2496,876,5185,1636,2401,13 65,4374,3093,847,1801,2609,4622,992,2251,6150,1244,2111,1338,4273,447,2388,1448, 4389,3204,1419,2442,4484,733,1697,2575,4187,827,2630,1607,5140,2604,1379,934,46 80,2229,1311,3107,4865,1207,2343,882,4294,1258,2333,937,4268,2280,1149,2172,421 6,1581,963,3330,4297,1684,2253,1640,6161,2230,747,1366,4432,2691,505,2610,5376,1 340,3098,1265,4158,855,2334,4378,1802,2633,1587,4239,2347,924,3585,4199,1369,73 4,2402,4274,1476,2259,1421,4390,2449,829,1427,5154,2233,1231,3152,4189,965,2444, 4740,1698,2392,1582,6154,938,2634,1809,4298,2693,1456,3109,4688,884,1381,2641,4 419,506,2583,5144,1211,2288,1260,4488,2254,749,1688,4393,3097,1648,2143,4866,94 5,2375,1611,4203,2612,1804,4276,966,3094,1729,4247,2848,1150,2450,5156,755,2404, 1266,6162,859,2355,4305,1589,3208,1422,4380,2349,940,2465,4744,1370,2261,4190,1 480,830,2616,4300,1382,3332,1429,4394,2880,911,2636,5127,1327,1593,4496,2234,87 1,3336,4704,1268,2694,1619,4448,2452,639,6272,2275,1213,1590,4421,2944,888,3110, 4629,1700,2642,5249,1385,2466,479,4251,2350,1730,3586,4306,1613,946,4401,2697,1 239,2819,4643,750,2408,4396,1810,2587,1671,5186,3168,969,2159,4205,1372,1443,61 56,2379,508,2262,4280,1430,3139,4630,1488,2357,861,4633,2236,1704,2497,4211,182 5,757,4263,3113,1386,2265,5632,1614,2456,4321,970,2657,1433,4422,2644,1594,3216, 4402,919,2599,4868,1812,1621,2698,6177,1596,2277,4253,875,3100,1243,5131,2207,1 335,4752,2468,862,2358,4425,1732,3141,4206,1622,2589,758,4213,1625,2821,4308,16 75,2658,948,5160,3114,1445,4267,2705,1816,2381,6209,977,2167,4872,1826,3588,163 5,4426,2648,923,4322,2387,1626,2266,4645,1434,972,5188,3121,1255,2416,4634,1712, 2700,4483,761,2278,1677,4404,3146,1272,4312,2439,877,6164,2361,1393,2498,5250,1 214,3344,4512,1388,2590,952,4367,2382,1678,4375,2281,1683,495,4254,3232,1359,44 33,2603,1504,5139,2822,703,2223,4646,1339,3592,4768,1245,2171,935,6400,2706,139 4,4214,2660,1637,4428,3360,978,2389,4675,1446,2825,5133,1449,2268,1475,4636,360 0,883,4485,2362,1638,4269,2472,1567,2443,4217,762,3264,5168,1259,2721,6178,1436, 2631,503,4649,2403,1367,4295,3616,1396,4880,2335,925,2231,4275,1799,2282,5134,1 341,3142,4324,1246,2173,878,4434,2605,1450,4408,2708,1477,6168,3116,735,2664,48 00,1261,2390,4486,1583,2364,5192,1857,3203,4270,993,2289,1828,4650,2826,1736,46 77,3153,885,4489,2611,1858,2393,5377,1685,2500,4379,939,3122,6180,1832,2445,421 8,1803,2451,1641,4544,2255,994,4449,3145,1628,5141,2722,1457,4657,2606,980,3087, 4299,1744,2833,4159,1840,2480,4436,1860,2405,6151,926,3392,5252,1371,2235,1921, 4490,2284,764,4623,2712,1267,4678,3205,1686,4652,2672,1478,2635,4277,941,3124,5 155,1342,2828,6273,1699,2753,4391,967,2174,4381,1642,3095,4328,1922,2290,1805,4 220,2613,886,5378,1400,1452,4301,3206,831,4278,2446,1689,4739,2394,1760,6210,25 04,1591,3456,4658,947,2406,5146,1864,2453,4382,1649,3148,4681,507,2351,4395,126 2,2617,5633,1383,2292,4450,1481,3209,889,4307,2643,1423,6656,2237,1811,4497,315 4,1615,4281,2614,984,5200,2724,1702,4492,2409,1458,4440,3128,751,4682,2754,1701, 4741,2637,1373,3099,6155,1269,2263,5157,942,2834,4689,1482,2695,4631,1690,3169, 4336,1644,2396,4302,996,2467,5145,1387,3111,4191,1151,2454,6184,1215,2512,4423, 971,2728,4660,1806,3331,5142,1431,2849,4896,890,2410,1460,4498,3156,1650,4452,2 638,1595,4403,2457,509,6212,3210,1489,5256,2618,1705,4397,2836,1270,4513,2645,9 49,4309,3217,1731,4664,2620,1374,5380,2267,1623,4928,3333,973,6274,2359,1692,46 84,2756,1814,4282,3101,1484,5384,2646,1000,4742,2649,1273,4500,3115,1706,4323,2 699,1597,4992,2469,892,6163,2840,1435,5158,3170,1827,4690,2850,1813,4514,2659,9 50,4398,3587,1733,5634,2650,1389,4745,2458,1464,4867,3160,863,6157,2279,2736,44 56,1652,4635,3212,1713,5216,2701,1398,4207,2296,759,4427,3102,1447,4310,2417,14 90,5187,2238,1817,6192,2412,1008,4405,3218,1274,4284,2702,1395,4545,2707,1505,5 161,3143,510,4313,2383,1598,4504,2528,3334,6158,1437,2363,4705,1627,4692,2269,9 79,5264,3337,1390,4647,2418,1492,4746,2661,1679,4325,3233,953,5148,2470,1924,62 16,2473,1829,4255,3648,1639,4516,2499,4406,2662,763,5189,3117,1708,4637,2591,17 34,4869,2283,1453,6401,3172,974,4706,2460,1818,5162,2391,1276,4753,2420,4429,13 97,3712,4215,2823,1629,5636,2365,954,7169,3123,1872,4696,2270,1714,4435,2474,43 14,1737,3220,5169,879,2501,4464,1656,2285,4748,3118,1506,4326,2607,1830,6165,28 81,5194,981,3147,4487,1451,2852,4409,1928,2760,4546,1438,3338,5392,2882,982,463 8,2709,6276,1247,3345,4430,1687,2856,4329,1716,2827,5280,1859,3589,4651,927,487 0,2665,3176,4271,1643,2652,6179,1496,2481,5640,1479,3234,4219,995,4754,2768,182 0,4708,2864,1833,5408,3125,2884,6402,1738,4437,2395,1745,4873,3265,765,4316,294 5,1861,5648,2291,4410,3224,1740,4520,2710,1888,6170,2502,956,4491,3149,5312,183 4,2366,4769,1630,2723,4679,3236,1936,4451,2666,5664,1746,2946,6657,887,3840,438 3,1720,2829,4279,1401,4330,2424,3340,5190,1459,2476,4221,1841,3346,4653,985,622 4,2713,1343,4756,2784,3590,5164,1645,4712,2615,1836,4438,2888,997,4412,3126,150 8,6181,2673,5251,2286,1454,4337,3155,1862,4874,2407,5201,1691,2505,4659,986,312 9,4441,2447,6169,1512,2835,4548,1263,3593,5170,1402,4493,2639,3184,4499,1483,27 26,4303,943,6166,2482,1646,5193,3207,1651,4770,2725,2397,4654,1461,5135,3150,14 04,4881,2293,4528,891,2506,6280,3361,1842,4453,2714,5440,1485,3266,4283,1520,26 68,4332,1693,4760,2411,3157,6404,998,2175,5253,1703,4720,2239,1748,4683,3348,28 30,5172,1865,4876,3594,766,6408,2455,1653,4801,2484,4222,3130,1375,5143,2674,43 38,1491,2619,4661,1462,3240,5254,2513,6182,511,3211,4494,1761,4442,2729,1275,45 52,2294,3171,5504,1486,4454,2755,1466,6658,2398,4501,1465,3158,5196,2647,988,43 99,3132,4665,1493,2716,4340,1271,6240,2838,3352,5257,1707,2508,4691,1866,4285,2 297,3161,5202,1001,4662,2730,1762,6211,3362,1923,4772,2621,4457,2459,1694,5176, 3601,4802,1807,2851,4685,951,6185,2837,3596,5147,1873,2757,4311,1844,4882,3268, 2413,4743,1752,5217,2488,1952,6288,3213,4444,1002,2676,4515,3173,5159,1815,2737 ,4502,1391,4560,2422,3219,6172,1925,2471,4776,1654,5379,2514,1709,4897,3248,445 8,2841,893,5204,3214,6213,1868,2298,4686,2419,4505,1657,3602,5258,1735,4666,252 9,3393,6186,1277,4884,2622,975,4693,2461,5265,1715,3103,4668,2651,4315,1848,327 2,6660,1926,5381,2414,2516,4407,1710,4804,3162,894,5149,2703,4694,3617,1764,619 3,2948,4697,1874,2853,5163,3364,4747,1399,2663,4517,1468,7170,3394,2732,4888,14 94,5218,2758,1009,4898,3604,4707,2477,1507,5635,3335,6218,1439,2842,4698,2300,4 506,1509,3221,5208,1929,4327,2421,3174,4784,1819,6416,2653,955,5260,2896,4749,3 177,4344,1497,2738,5150,1658,6304,3376,2761,4465,1768,4286,3368,1876,4460,2680, 5266,2530,1984,4750,3235,6664,1004,4755,2854,3164,5191,1889,4431,2475,1717,4576 ,2952,6432,3119,1821,5382,2462,4411,1930,3339,4317,2271,5385,1010,6672,2711,173 9,4466,3457,4709,2740,1831,5281,3618,4518,2883,4521,1498,3396,6336,1660,5696,26 67,2520,4547,1718,4710,3280,957,5165,2503,6688,3458,4639,1278,2844,4331,1741,52 20,2857,3222,4508,1599,6214,2762,4439,3225,1937,4468,2769,5760,1822,3237,4871,2 885,4413,983,6188,2764,1835,5171,3178,4318,2912,4522,1403,3127,5268,2858,6275,1 721,3400,4549,1455,4333,2654,5166,2960,1631,4655,3608,6225,1513,2770,4929,3649, 5195,958,4900,2744,3620,4808,1890,6194,2425,5386,1747,2483,4930,3185,4757,1510, 5393,2865,3226,6217,1932,4904,2367,4875,1742,3151,5637,2669,4713,987,3341,5224, 2860,6159,1837,4700,2532,1500,4529,3180,5282,2478,4816,1880,3650,6464,2886,4912 ,1863,5173,3296,1749,4932,2715,4443,2536,6277,1012,3238,5313,2287,4993,1722,433 9,3591,1938,5272,2426,6196,3624,4758,1776,2507,4550,3267,5197,1892,4414,2670,71 72,1843,2675,4771,3342,5284,1838,4714,2485,3713,4994,999,6167,2428,5888,1463,35 95,4877,2866,4472,1953,6278,3347,2509,5388,1514,4524,2544,5394,3652,4761,1647,2 717,6528,1695,4832,3363,5638,2727,1763,4663,3131,4936,2772,6220,1016,3241,5174, 2889,4721,1940,4334,2677,5203,1487,3632,6281,2399,4455,1867,4553,3186,5177,2515 ,1405,4495,3349,6226,2486,4883,1521,3228,5641,2785,4687,767,5232,3159,6200,1954, 2299,4774,3269,4530,1845,5255,2510,6171,2490,1750,4773,3188,4445,2489,5198,1985 ,4341,3242,1896,6241,2517,4554,3133,5409,1516,4762,2295,3603,5314,1655,6183,273 1,4716,3597,4459,989,2890,5205,3714,6403,1753,4223,2786,4287,2947,1724,5396,335 3,4878,1467,6228,2718,5642,3350,1765,4503,2831,4532,3598,5178,1869,6282,2897,47 22,3249,1944,4667,2868,5288,3365,6289,1003,4561,2776,3460,5259,1406,4777,2976,4 342,3163,6405,1846,5219,2839,1875,4803,2415,4446,3656,7176,1754,5206,2949,3841, 4695,1522,5180,2678,4764,3270,6173,1904,4886,2733,3244,5400,990,4556,2892,6187, 3192,4345,1766,5209,2681,3273,4778,1469,5410,2759,6242,3408,4669,1495,4507,2301 ,5649,3134,1659,6659,2739,4899,3354,4885,1956,5644,2872,4805,3215,1711,6232,295 0,5316,3175,4461,1927,4536,2734,6284,1005,5261,2788,3250,4724,1849,5221,2898,47 85,3366,6174,1524,4470,2423,5267,3165,1870,4519,2492,6290,3716,4562,1769,5296,2 518,4889,3274,6215,1850,2531,5262,3664,4346,1756,4467,2463,5650,3395,6406,1470, 4577,2533,3464,5441,959,4670,2953,6409,3369,4509,1986,5151,2843,4699,3842,6305, 1960,2521,5320,3179,4462,1499,4564,2682,5210,3252,6720,1877,4751,2792,5665,3223 ,1891,4996,2900,6189,3281,4901,3008,5412,1661,4711,3356,7184,2913,5442,1931,478 0,3720,2741,4806,1011,6244,3166,5652,2845,4525,1511,5383,3276,6784,2954,4890,17 19,4348,3370,5269,2763,1770,4469,3472,6195,2855,5222,1852,4701,3680,4944,2522,6 292,1777,5225,3424,4786,2684,5424,1878,3397,6190,2742,4809,1881,5416,3605,4728, 2302,6219,1013,4578,3227,5283,2765,4902,1528,6410,3282,5212,2623,3377,4523,1823 ,5000,2961,6417,3619,5167,1279,4510,2846,5387,3372,6661,1988,4319,2859,4759,318 1,5505,1933,6248,2427,4788,3256,1743,5666,2745,4931,3606,6306,1501,5444,2479,47 15,2655,4568,2537,6197,1939,5328,3609,4551,2914,5506,895,6337,3187,4892,2771,49 05,1662,3239,5270,2534,7200,1772,4810,3297,5273,2956,4817,1968,6296,3398,5285,2 766,4933,3378,4812,1893,6221,2861,5226,3844,4960,1515,5175,2524,6308,3229,4906, 1723,5448,2904,4702,3728,6912,1778,5008,2887,3401,5656,1882,4818,2773,6412,3182 ,5697,2746,4792,1006,5668,3189,6418,2962,4473,1502,4531,3284,5233,2800,6662,199 2,4913,3243,5274,2916,4415,3848,6198,1407,5199,2867,4717,3402,5389,1934,6227,28 62,4908,3298,4580,1839,5228,2487,6201,3621,4526,2000,5698,2977,4934,3610,6665,2 538,5344,1894,4763,3459,7171,2671,4584,1941,5286,3380,4335,2719,6256,1014,5639, 3288,4474,2787,5672,3488,6279,1751,4555,2964,5315,3343,4718,1517,6222,2511,4723 ,3351,5390,2891,1897,4533,6433,3230,5761,2429,4476,1725,6338,3409,5643,2545,491 4,1955,5395,3622,6229,2978,4557,3744,4592,1780,5700,2869,6420,3190,4765,1884,54 11,2774,6666,3404,4775,1523,5179,3651,4820,3009,6202,3612,5289,1755,4937,2920,4 725,3461,6312,1017,5680,2540,4447,3245,5234,2679,7173,1847,4563,3193,5397,2777, 6283,1946,4534,3625,5276,2748,4833,3271,6243,1898,5207,2491,4347,3856,5317,1942 ,6230,2789,4558,3251,4538,2893,6204,1526,5236,3300,4537,2968,5290,1957,6424,456 5,3410,5181,2430,6233,3384,4343,1767,5651,2870,4779,3776,6434,1784,5645,3462,49 38,2899,5762,3246,6673,1905,4834,2778,4995,3626,6668,1018,5401,2546,4766,3653,5 398,2928,6340,1518,4879,3465,2790,1726,5646,3355,7232,2493,4945,3194,5297,1945, 4916,2519,6285,3520,5413,1525,4824,3425,6245,2683,5508,3633,5024,1900,5211,2980 ,6291,3275,4887,2735,4463,1871,6320,3135,5704,2951,4997,2016,3412,5889,2873,628 6,3466,4726,1471,5318,2548,6674,3599,4781,1757,5292,3654,4940,2894,6465,3628,52 40,1851,4729,2793,6175,3253,5321,2874,4807,991,5456,3367,6344,2780,4349,1958,51 82,3357,7177,2494,4787,3304,5402,1906,4920,3196,6234,3010,5263,3277,4998,1961,6 689,2984,5223,3254,4782,2523,4836,1987,6436,3715,5298,2901,4946,1771,6466,3634, 5414,2915,4471,3358,6676,1529,5213,3657,4540,2685,5764,3371,6407,1879,4566,2955 ,5322,3426,6293,2535,4579,1948,5712,3283,4511,2743,6246,1758,5443,3473,4581,325 7,6249,2794,5512,1853,5001,3468,7174,2876,5417,3416,4891,1020,5890,2801,6448,36 58,4569,2902,5227,1989,6440,3717,4730,3665,5300,1962,6307,2905,4840,3607,5271,2 552,4948,1908,6236,3312,5329,2847,5056,3278,6191,1530,5404,3167,4961,2303,6411, 3399,5768,1773,4789,3012,6529,3636,5214,2957,4893,1969,5324,3872,6690,2767,5002 ,3474,5418,1990,6468,3428,4811,2525,5520,3379,7185,1779,4903,2963,5728,3373,457 0,2686,6352,5472,1883,4732,3489,6530,3285,5445,2796,4790,1964,6294,3640,5653,29 92,4350,3904,6297,1854,5275,2917,4813,3660,6309,3258,5330,1935,4671,2539,5425,3 718,6250,2747,5009,1007,5667,3476,6199,4894,3299,5420,2802,7178,1895,4907,3968, 5229,2906,6472,3666,4475,1663,5304,2526,6680,3490,4793,3374,5654,1912,4527,3016 ,6721,3721,4703,2431,4585,6692,1503,5657,3843,4962,2958,6257,3432,5235,1970,481 9,3611,6298,2863,5287,3183,4582,1774,6223,3024,5345,3403,5004,3286,6413,5446,19 93,4814,2918,5426,3381,7186,2965,4909,1532,5892,3260,6252,3521,4572,2775,5277,1 885,6722,3289,4952,5776,2541,6368,3480,4935,1781,5449,2921,6310,3681,4821,3668, 5230,1994,6663,2749,4794,3623,5237,6696,2979,5010,3722,5332,1943,6339,3301,4848 ,2804,5291,3231,7296,1015,4964,2908,5896,3492,6414,4915,3382,5450,1899,6785,254 7,4910,3613,5346,2779,4535,1886,6667,3845,5669,5025,3682,6419,2871,5658,3729,45 86,1782,6724,2970,5507,3405,4719,3191,6435,1972,5428,4767,2922,6203,3672,5336,2 966,4835,2001,7180,3411,5536,3290,5012,2550,6313,5391,1947,4559,3440,6704,2981, 5399,3724,4939,3302,6258,1996,5278,4477,2791,6421,3463,5457,3385,4593,1785,6300 ,2808,5670,3522,5026,6231,2929,5792,1901,4917,3614,6341,3406,5238,2542,4822,330 5,7201,5452,1976,5699,2750,6260,3627,5057,3846,6314,1519,5660,2969,4968,6205,32 47,5509,2549,4588,3195,6675,1727,5293,3730,4727,6669,2924,5241,3684,4825,1959,6 786,3413,5673,2895,4796,3849,6425,5319,3040,4539,2002,7233,3292,5904,3386,4837, 2495,6422,5299,1019,4941,3496,6670,3467,5348,2781,5016,6321,3745,5458,1907,4478 ,2875,6437,3655,5432,3427,4918,6532,1786,5824,2982,6235,3359,5510,3255,4947,293 0,7188,5294,1527,4826,3306,6728,2985,5674,3197,4594,6913,1949,5701,3629,4976,30 11,6342,3732,5513,3688,4838,6316,1902,5403,2795,4541,3414,6264,2553,5242,6345,3 388,4567,1759,5568,3313,6480,2903,5473,4731,3850,7424,2017,5681,3635,5028,2972, 6206,5323,3417,4783,2782,6426,1909,5183,3524,4999,6287,3469,5460,2877,6247,3475 ,4921,1963,5514,6322,3279,4596,3013,5647,3746,6438,2018,5702,4942,3630,7202,298 6,5676,3857,4841,3504,6237,5301,2004,6788,2932,4922,3429,5415,6346,2554,4828,32 59,5405,1950,6736,3308,4542,5352,2797,6467,3736,5244,3696,7192,5058,1788,5325,2 993,6536,3659,5032,3852,5302,6441,3014,4571,1965,5763,3777,6914,4949,3198,6251, 2803,5682,3314,4963,1991,6324,5406,2907,5705,3637,6295,3470,4733,5419,2988,7204 ,1021,5003,3418,6353,5474,3528,4583,2878,6428,1910,5331,4791,3430,6792,3477,552 1,2959,6238,3375,5305,4842,1855,6348,3641,5516,2919,4924,6442,3316,5464,3667,71 75,1971,4849,5706,2687,6544,3261,4950,3638,5765,6752,2936,5713,1531,6496,3748,4 953,5655,3433,6469,2527,4600,3778,5360,6677,1913,4895,3661,7297,2994,5326,5215, 3287,6299,2798,4351,5447,3858,6354,2008,5060,3719,6449,5684,3017,5005,3420,6691 ,3491,5920,4815,1775,6444,2556,5522,3478,7234,5476,3536,4573,2909,6253,5427,196 6,5011,3752,6328,3873,5421,6678,2805,4734,3434,5537,2020,6681,5333,3662,6259,30 18,4844,5688,3481,6311,3642,5040,1995,5952,7680,2967,4965,3860,6369,3669,5708,5 306,3644,6470,2923,4587,6450,1914,5766,3291,4795,3383,6916,5524,2910,5347,3780, 6301,4850,1533,7179,3670,6016,2806,4954,6800,3673,5714,3723,6473,4574,1973,5538 ,2996,6254,5422,3493,5064,3864,6261,3025,5769,6356,3874,4479,1997,5891,7208,368 3,5006,2971,6315,3674,5480,5659,3482,6920,2024,4911,6474,3020,5231,3303,5072,63 70,3760,5451,2809,6693,5334,1916,4966,3725,7236,3320,5429,6682,2925,5013,3441,5 308,6531,3262,5569,1974,6452,4823,3436,5337,3000,6360,4589,3726,7298,3731,5528, 4969,1887,6560,2543,5729,3407,6415,5716,3552,4797,2751,6423,5671,3387,6302,1783 ,5027,5770,3293,6481,2983,5349,7187,3442,4852,3685,5279,6694,3026,4956,1022,681 6,5540,3494,5430,3497,6262,4595,3523,6476,2931,5661,4827,2032,6723,3686,5893,71 81,3615,5730,2810,4919,6684,3307,5777,3484,6533,5018,1534,5453,2551,6317,5239,3 415,6265,3444,4970,5720,2973,7216,3847,5014,6697,2003,5459,3389,6343,5338,3294, 4598,2926,6928,5488,3498,6323,3525,5029,5772,1977,7182,2783,5350,6372,3309,4839 ,3631,5511,6482,3905,5433,1787,6456,4856,3041,6848,5570,3876,4977,3784,6534,566 2,2933,7240,3906,5454,4590,1998,6318,3733,5353,6698,2987,4798,3880,6725,5675,38 51,5894,6537,3689,5017,1978,7425,5295,3042,4597,3676,6427,5243,3505,6266,3028,5 778,6592,3792,4972,1903,5732,6497,3888,5461,7189,3908,4943,2974,5897,6705,3419, 5088,3969,6347,5340,2005,6207,5434,2812,4543,3315,6484,5544,3734,7300,3526,5515 ,6538,2989,4829,5793,2006,6671,3390,4923,6726,3747,5703,3015,6700,5475,3690,503 0,6325,3970,5407,1951,7203,5303,3853,6439,2934,4978,5354,3448,6429,5033,3500,63 76,2879,5245,6268,3737,5677,2019,5059,7426,3808,5780,6349,3639,5736,2995,6326,4 843,3912,5462,6787,3697,4601,1789,6706,5436,2555,7194,5361,3310,4951,3431,6430, 5898,3529,6729,5683,2937,6443,1980,5020,7681,3471,5465,4830,3859,6498,3663,5572 ,6355,3032,5517,6545,3750,4925,3506,5523,6329,1911,5327,7248,2799,5061,3749,654 0,5794,3421,6488,5678,3317,5034,2990,6730,5905,2009,6789,5552,3530,7205,3738,49 80,5477,3692,6737,4602,3044,6679,3435,5307,6384,3199,5356,6350,2021,4845,3263,5 784,7193,3019,5744,6239,3854,5041,6471,3479,5707,2938,6708,5900,2010,5062,7190, 3508,5825,3698,6944,5246,3643,6546,4851,2557,6500,5362,3537,4955,3753,6451,5685 ,1967,7304,5518,3318,6445,5036,2997,6561,3779,5466,6357,3422,5576,4926,3671,671 2,5478,3021,7428,1915,5525,6976,3740,5007,6732,3862,5423,5689,3532,6330,3048,49 67,7432,3321,5364,6790,3754,5715,6548,2022,4735,3645,6371,5309,2940,5686,7040,3 483,4984,7206,3875,5796,6738,3861,5481,1790,6562,4575,2998,6446,5826,3781,7682, 5709,3437,5042,3512,6793,5335,2911,6915,4846,3700,6504,5906,1535,6683,5767,3761 ,7264,3446,5065,6255,2807,5468,5539,3495,6475,4604,3538,6358,5526,3865,7235,558 4,3056,6453,1023,4957,6332,3322,5800,6593,3443,5921,4853,3553,7209,5482,2558,63 61,5710,3646,6552,3485,5066,6753,2012,5529,6740,3675,5690,7312,3027,5015,6695,3 438,5908,5717,3540,6794,3727,5692,6373,3001,4971,7196,2025,5339,6303,3972,5431, 6564,3877,4958,6454,3687,5828,7237,2811,5718,6685,3756,4854,3782,5721,6917,1975 ,5771,6754,3501,5044,7210,3022,5541,6801,3866,5912,6477,3324,5073,6263,3445,592 2,7684,3677,5731,6744,3002,5019,6483,2026,5722,3920,6362,5530,3762,5068,7217,37 85,5351,6512,2927,5808,6796,3704,4857,6374,3554,5773,7242,1917,5368,6535,3878,4 973,6457,3029,5489,6594,3499,5310,7440,3976,5484,6686,3486,5048,6478,3030,5774, 6377,3295,5779,1999,4591,7328,3735,5455,6699,3764,5600,6918,3907,4799,6319,2975 ,5435,7688,3691,5341,6267,3544,5031,6802,3527,5490,6756,1918,5733,7456,3043,507 4,6485,3868,5542,6921,3881,5545,6364,3786,5571,7696,3793,4979,6458,2813,5734,65 68,3909,5663,6539,2033,4858,7360,3788,5355,6817,3936,5532,6727,3004,4599,6499,3 882,5463,7712,3678,5492,6431,3984,5021,6327,3794,5895,6378,1979,5437,7238,2935, 5342,6269,3768,4974,6701,3449,5546,6804,5573,3507,7212,4831,3889,6760,5357,3033 ,6486,5679,3391,6460,5953,2028,7299,5089,3693,6385,5924,3884,6922,5832,3045,724 9,4981,3556,6707,5954,3502,6489,5781,3910,6596,5035,3739,7218,5928,2034,6541,58 99,3034,6547,5737,6351,3560,5090,7241,3311,5724,6818,3450,5553,6702,3531,5076,7 183,2991,5840,6929,3694,5936,6576,1981,5956,6501,3699,5022,7488,3509,5467,6331, 6017,3452,6380,4860,2939,6808,5363,3890,7301,5782,3533,6768,5574,3568,6731,5037 ,3741,7220,5438,2007,6924,5795,6849,3046,5063,6270,3751,5738,7191,3796,6018,638 6,3913,5901,6709,2814,4982,5496,3701,5548,7302,4927,3423,6542,5785,3539,6490,58 56,1982,6600,5687,3510,7552,5043,2559,6502,5960,6549,3809,5745,7244,3323,4603,6 447,3534,5358,6713,3514,5479,6388,3513,5577,7305,4985,2011,6739,5519,3036,6333, 5907,3541,7250,5711,3319,6710,5080,3755,6820,5798,6505,3914,5554,7224,3049,4847 ,6850,3810,5797,6733,3971,5469,7195,5365,3742,6359,5038,2036,6930,5578,3855,679 1,5786,2999,7265,5740,6492,3921,5092,6563,3892,5483,7207,3800,5247,6550,5311,40 00,6608,5067,3050,6824,5902,3863,7427,5527,2023,6945,4986,6506,3439,5556,7252,3 973,5746,6734,3702,5691,6553,4605,3757,7306,5585,2941,6714,5801,3916,6932,5366, 6741,3705,5045,7313,3783,5827,6716,2040,5470,6363,5719,3325,7429,5069,3023,6455 ,5788,3763,6852,5910,7197,3896,5580,6742,3974,5096,6745,5369,3758,7211,5802,294 2,6795,5693,3812,6565,4988,6936,3922,5531,7266,1791,5923,6946,3447,5909,6755,50 46,3516,7683,5829,3542,6746,5485,6554,3057,5560,7256,3555,4959,6375,3487,6832,5 748,7308,3557,5809,6797,3977,5494,6392,4855,3867,7198,5543,2013,6513,5586,6334, 3003,5913,6508,3545,5104,7314,3706,5370,6798,5491,3816,6803,5601,3924,7239,4606 ,6479,4032,5694,6624,3052,7430,5533,6459,3937,5723,6365,3765,5075,7433,5486,202 7,6514,5588,3869,6757,5775,7329,3978,5049,6566,3058,6020,6569,5925,3787,7744,57 35,3879,6595,6758,4859,3546,7213,5804,3708,6687,5830,6379,3766,5549,7268,3005,5 070,6556,5914,2014,6487,5372,3326,6516,5493,7808,3789,6919,5725,6461,3647,5050, 7219,3985,5968,6366,5810,3870,6570,5833,3031,7316,4975,6597,3883,5752,6381,3451 ,7214,5602,6703,3769,5926,6977,5077,3503,7243,5547,2029,6948,6024,6856,3679,553 4,7434,3561,6978,5078,6805,3006,5343,7441,5783,3938,6952,5812,3795,6923,5955,76 85,3558,5023,6761,3980,7272,5739,6748,3790,5592,6577,5575,3035,7330,5091,3885,6 864,5916,6960,1983,5929,7221,6980,3548,5834,6491,3928,5841,7361,4861,3911,7041, 5957,6387,3797,7320,5836,3060,6806,5984,6598,3770,5052,7245,5930,3986,6462,5726 ,6819,3824,7332,6032,3940,6762,5842,7042,3891,4983,7936,5816,2035,6925,5497,388 6,6520,7436,5555,3047,6572,5937,7442,3511,5081,6809,5439,4001,6880,7686,5741,35 62,6711,5932,3695,6984,5093,7222,3743,5604,6769,6382,3811,5550,7251,5958,3064,6 503,5787,3988,6601,5082,7225,3535,6543,5608,6931,2037,5359,7689,5498,3915,6735, 7280,5579,3453,6822,5039,3569,6578,5742,7303,2815,5747,6821,6493,4002,5557,7246 ,5500,3893,6389,4987,6602,3798,7457,5938,6810,4033,5581,7362,5616,3944,6764,578 9,3564,6507,7253,5094,3703,6271,5799,6335,1919,5844,7444,6926,3037,5961,7690,48 62,3801,6551,5749,6580,3772,7226,5471,6770,3515,5587,6715,5558,3813,7336,6609,4 607,3917,7307,5857,6825,3992,5371,6390,7267,3051,5582,6851,5562,3454,6494,5561, 7254,3894,6743,5084,7228,3923,5589,6812,5367,3802,6934,7448,5803,2030,6604,5962 ,6393,3570,7257,5097,6826,3952,5858,7458,6019,3038,6717,6555,5790,3814,7697,590 3,6947,3517,5047,6933,7692,3543,5969,6853,5940,3707,7364,6509,5848,4004,6584,60 48,7309,3759,5098,6772,7269,3975,5911,6833,5487,3053,6518,7315,6021,3897,6567,5 750,6610,2038,5805,7344,6937,3572,4989,7310,5964,3918,6394,6515,5753,3817,7698, 5831,6625,7489,3898,5373,6718,5071,3804,6557,5811,7199,3518,6747,5944,7368,3007 ,6022,6510,6612,4034,5806,7258,4990,4008,6799,7713,5860,3547,7044,5970,6949,746 0,3925,5495,6759,5564,3939,7490,6828,5590,2041,6854,5105,7700,3709,6573,5603,74 31,5535,3979,6938,6396,5605,3059,7317,6025,6517,3559,7270,5915,6749,3767,5051,6 992,7273,5593,3818,6834,5754,7472,3900,6857,5864,7464,3825,5972,6776,6626,3926, 6080,7331,5100,6950,3929,7260,5985,6571,3061,5813,7048,7215,3576,5917,6558,6026 ,7435,3871,6367,5106,6807,3327,5835,7553,6836,2042,5927,7714,6979,5594,4036,749 2,5756,6763,3981,6616,5814,7376,3791,5053,6599,7554,5374,3549,6940,5837,6953,39 87,7318,5695,6858,7321,2943,6033,6865,5918,3710,7333,6981,5079,3820,6860,5931,7 274,7008,4016,5499,7223,6954,3941,5817,7496,5551,6750,3563,7056,5727,7704,3771, 5609,6866,7745,5054,3826,6840,7716,5986,3930,6521,5843,6579,7281,2015,5606,6961 ,7322,3054,6028,6463,5838,7247,3550,6765,5083,7437,4040,6956,5933,6628,5596,345 5,7276,6574,5976,7746,3982,6982,5959,7392,3887,5845,6811,6632,5108,4048,7334,63 83,5818,3942,7687,6034,6522,7720,3989,5872,6603,7363,5988,3062,6766,5939,6771,3 799,7438,5934,6581,7809,3565,5095,6524,5559,3945,7691,6962,6049,7443,3773,6605, 5610,6640,7748,4003,5743,6813,5791,7459,2044,6823,5859,7227,3828,6868,5112,7337 ,6985,3932,6036,6773,5583,7728,3571,6495,5963,7282,3803,6611,5501,7445,6582,306 5,5617,7324,6881,4863,3895,7255,6050,6395,7365,3994,5941,6606,6586,5846,3946,72 84,6585,6081,3990,7338,5992,6613,7229,3574,5612,6391,7699,5751,4005,6827,7693,5 085,6986,3815,7810,5849,6882,7043,3832,5820,7449,5563,6814,3953,7446,5861,6927, 7694,3066,5965,6993,7345,6040,3566,6964,7461,5099,2031,6872,7556,5502,7072,3774 ,7259,5942,6935,5971,3993,6511,7752,5850,7045,3573,7937,5618,6774,7366,3948,600 0,6829,7340,5086,3919,6988,7288,5862,6777,4064,7369,5565,6855,7504,3519,5591,63 97,7230,5755,3805,6835,7450,6052,6968,3899,7311,5807,7046,7271,6023,3039,6830,5 101,6884,7346,4006,5945,6994,7462,5620,3954,6519,7261,5966,6588,4009,7812,5865, 6614,7370,4035,5946,6627,7760,5852,3819,6559,7491,5566,6629,3577,7560,5055,7049 ,7465,6082,3927,6939,7938,6056,6617,2039,7275,5595,6778,7348,3996,5973,6888,731 9,5987,3806,6996,7377,7104,5757,7452,3901,7009,6027,7816,6837,3068,5107,7262,69 41,5607,4037,7372,7050,5815,7466,6859,4010,5866,7568,6951,5948,3956,7776,6618,5 873,7520,3578,6780,5974,7493,6838,5977,3821,7701,6398,5109,7323,4017,6861,5624, 7378,6719,4038,7473,5919,7057,7715,5375,3827,6942,7468,6084,6955,3931,7277,6029 ,6523,7352,5839,4012,6841,7702,5597,6575,3902,6751,6633,6035,7705,7010,3983,499 1,7283,6867,5758,3055,7335,6630,5868,7393,7052,3943,6064,7494,6862,7474,3711,59 89,6957,7940,5611,6620,3960,7325,5819,7000,7824,5874,2043,6983,7497,5978,6869,3 551,7278,6842,5102,7285,7058,4018,5598,7380,6896,6088,7339,3822,7012,7944,5503, 6963,4041,7498,6030,6958,7394,5935,3580,6583,7717,6096,7073,7706,3933,6634,5990 ,7555,6767,6037,3829,7476,6815,5110,7384,6883,4042,7584,5847,7060,7439,3991,561 3,6607,7447,6987,5993,3063,7326,6525,5821,7505,6641,3947,6051,7718,7074,7840,58 76,3934,6965,7286,5980,6870,7500,3830,5619,7747,7105,7708,5851,4020,7016,7557,5 113,6636,7341,4049,6775,5943,7289,6873,6042,3995,7721,6844,7367,5994,6587,4044, 7952,6038,6885,7347,6989,3833,5622,7396,7064,6053,7506,3949,6526,7480,5863,6966 ,7872,4024,5880,7558,6995,7342,6001,3567,6874,7722,5114,6642,7749,2045,7024,561 4,7561,6886,5822,7451,3775,6589,7290,6041,6615,7616,4007,5621,7521,6779,7729,59 96,4050,7076,7371,6831,5967,7231,3067,7047,6112,7508,6969,7562,5567,3955,6644,7 695,5853,7750,6990,3834,7724,5947,6889,7349,6970,5087,3575,7463,6876,6054,7453, 6590,3997,7400,6002,7292,7106,7373,3950,6057,7080,7350,6619,6083,7811,3807,6997 ,5867,7730,7011,7454,4065,5625,7753,6781,7467,5975,7051,3957,7522,6631,6044,737 9,6839,4011,5854,7569,7353,6890,5949,7564,4066,6972,7512,5116,6897,7754,6998,40 52,6085,7813,7761,6058,7001,3998,7703,6648,6004,7408,6943,7374,3836,5626,7263,6 399,7495,5869,7108,4013,7732,7053,6065,7968,6863,7570,4039,6086,7524,6621,7475, 5875,7059,3069,7469,6782,5979,7585,7381,3958,6892,6060,7736,7088,8000,5950,3903 ,7013,7756,7354,6031,6635,7814,4019,6843,5103,7572,7395,6898,5991,3579,8064,700 2,7762,5759,6622,7586,3961,7470,6008,7112,7817,6527,5599,7939,2046,7054,7528,60 66,7707,6959,7279,4056,5870,7120,7499,7382,6089,7014,3823,7477,7061,5628,7356,7 617,6871,4014,5981,7385,6637,7576,5877,7017,4068,7777,7764,6090,6845,7719,7075, 7818,4043,6039,7397,6900,7327,5111,7004,3962,7588,7478,5995,6643,7709,6875,3581 ,5982,7941,7778,6967,7825,5878,7066,4021,7501,7287,6068,7018,7768,7062,4045,609 7,7507,7386,6646,6043,7536,7077,4072,7820,7398,6092,6887,7559,7481,5881,3964,69 04,7618,7025,5997,7710,7502,4022,6638,7401,6072,6846,7723,7942,5615,3935,7065,7 343,6645,7291,5823,7826,7020,3831,7780,6055,7509,6991,7945,7136,6098,3070,7388, 7482,6591,5115,7592,7563,6877,4080,7841,6003,6971,7751,7523,5882,7078,3582,7455 ,7351,7026,5623,7402,7081,7293,4051,6045,7725,7107,7828,7784,5998,6891,4025,751 0,6649,7484,5855,7409,6999,7946,3835,6113,7731,7068,7513,6878,6005,7620,4046,75 65,6973,7571,6059,7375,7109,7842,4026,6114,7726,7082,7953,7600,6100,7028,7525,3 951,6650,7355,6046,7404,6893,7832,7792,4053,5884,7089,7755,7948,7110,6061,7873, 7294,4054,6899,7410,6087,7003,7733,7566,7084,3999,5117,7514,7624,6974,6006,7526 ,7573,7055,4067,7471,5951,7737,7015,7412,7763,6067,6783,3837,7357,7734,7032,562 7,7844,7529,6623,4028,7874,6009,7757,7090,7383,6894,7954,6104,3959,7815,7113,75 16,7587,5871,6652,7574,7632,4057,7005,6062,7848,7969,6901,7530,6116,7758,7114,4 069,7577,7738,6091,7063,7956,7765,7740,7019,2047,6010,7387,7479,7006,7876,5629, 7766,6902,4058,7769,7819,6069,7092,7589,7960,7121,7970,4015,6093,7779,7067,7770 ,7578,6120,7116,7399,7856,3963,6905,6012,7821,7416,7021,7537,7358,6070,4070,753 2,7096,7822,7827,5983,6639,7503,7648,6847,3838,7483,5879,7389,7079,7538,7781,71 22,5118,7590,3583,7593,7619,7027,6128,7782,7711,6906,7403,7580,3071,5630,6647,7 511,7540,7069,7943,6099,7485,7390,4060,7022,7594,7621,6073,6879,7405,7727,8001, 5883,4073,7137,7972,7880,7029,8002,6094,7829,7083,7976,4023,7947,7785,6074,7138 ,7772,7601,7124,7888,5999,7984,4074,8004,7070,7515,8065,6101,6908,7411,7830,762 2,7085,3965,6102,7486,7843,7111,7786,8066,6047,7949,7030,4047,7544,7596,6975,78 33,6115,7904,7735,7091,8008,7793,3966,5885,6651,7406,7527,7625,7033,6076,7567,7 955,7759,4081,7128,7846,7602,6007,6895,7845,7517,7413,7086,6105,4027,7626,7834, 7788,7140,7531,7295,6117,7359,7115,7950,7575,4076,7034,6106,7604,7794,7739,6653 ,7633,7849,6063,7414,4082,7093,7875,7518,7767,7117,6011,7836,7958,7628,7144,741 7,4029,7850,6118,7741,7036,7579,7971,7957,5886,7094,7877,7533,4055,7608,7007,77 96,5631,7857,7542,6903,7591,7634,7961,7152,4030,5119,7418,7539,7649,6654,7742,7 581,6108,7771,7123,7534,7636,4059,7823,7097,6121,8068,7973,7783,6907,7852,7878, 6071,7597,7118,4084,7962,7420,7541,7773,7098,6122,8016,7858,7881,7023,7800,4071 ,7650,6013,7974,7125,7595,8072,7582,7126,7391,6095,7831,7860,8003,4088,7071,778 7,7640,7623,6014,7139,7964,7977,7882,7889,6909,8005,3839,6129,7884,8032,7100,79 78,7774,8080,7890,6075,7031,7864,7545,7603,4061,7985,7129,7487,6124,7789,7980,7 141,7652,7598,8006,7835,6130,7130,4075,7656,7407,7546,7627,7087,7790,6077,7795, 7605,7548,7035,7986,7629,7664,4062,7837,6103,7142,7847,7892,8009,6910,7797,7519 ,7635,6078,7606,6655,4077,7905,7419,7630,7610,7609,6107,7132,7637,7415,7851,801 0,7145,7906,8067,7838,4031,6132,7951,7095,8017,7988,7896,8096,7146,7959,6119,75 35,8069,7798,7853,7037,4083,8012,7801,7879,6136,7421,7119,7859,7992,8070,7854,7 038,7908,8018,5887,7543,4085,7612,7638,7153,7651,7583,7653,8073,7963,6109,7099, 7641,7802,7912,8020,8128,7148,3967,8033,7861,6123,7965,8074,7154,7883,7975,7642 ,7804,7862,7101,6110,7422,7885,7743,4078,8081,7966,7127,7979,7547,7865,7599,612 5,7775,7657,7102,8034,7891,7654,8076,7886,7131,4086,7981,6079,7644,8024,8007,78 93,7156,7866,8082,7920,8036,7987,6131,7982,7143,7607,8097,7658,4089,7791,7839,7 907,7160,8084,7631,6133,8011,7549,7665,6911,8098,7989,7894,8129,8040,7660,7799, 6015,4090,7133,7897,7868,7611,7909,8013,8088,7147,7550,7990,8019,7898,6126,7666 ,8048,7134,7910,7613,7639,7803,4063,8100,7855,8071,7149,7993,6134,7668,8014,791 3,7994,7900,7614,7103,8130,8104,7643,8021,8035,6137,7805,4092,8075,7155,7655,78 63,7914,7996,7921,8022,8025,7157,7672,7967,7423,6138,8132,8077,7887,7645,8083,7 039,7806,7916,8112,4079,8037,7659,7867,7922,8026,6111,7150,7646,8136,7551,8078, 7983,8144,8038,8085,7158,7895,7661,8041,7869,8099,6140,7924,8028,4087,7667,7899 ,7161,7991,8090,8042,8086,7670,8101,7911,7928,8049,7162,7662,6127,7870,8089,766 9,8044,8015,8160,7615,7901,7995,7135,8102,4091,8050,8105,8131,7915,7673,8023,61 35,8092,7902,7997,7164,8133,8106,8052,7674,7917,8113,8134,7923,8027,8108,7998,8 079,7151,8039,7807,8056,6139,7647,8114,4093,7918,8137,7676,8029,7925,8138,8087, 7159,8043,8030,7926,8116,8145,8091,8140,7929,8045,8120,7663,6141,7871,8103,8146 ,7163,8051,7930,7671,8093,8046,7903,8161,8053,8107,4094,8162,8148,8094,7932,810 9,8135,7165,8054,7999,8115,7675,8057,6142,8152,7919,8110,8164,8139,8058,7677,81 17,8141,8168,8060,8118,8031,7927,7166,8176,7678,8147,8121,7931,8142,8122,8047,8 149,8150,8095,4095,8163,7933,8124,8055,8153,8165,6143,8154,8111,8059,8166,7934, 7679,7167,8156,8169,8119,8170,8061,8143,8062,8177,8123,8172,8178,8125,8151,8126 ,8155,8180,8167,8184,7935,8157,8171,8158,8173,8127,8179,8181,8063,8174,8182,818 5,8186,8159,8188,8175,8183,8187,8189,8190,8191] ;
où la séquence Q2 est donnée par
[0,1,2,4,8,16,32,3,5,64,1024,2048,9,6,17,10,18,128,12,33,65,20,256,34,24,36,7,129,66,5 12,11,40,68,130,19,13,48,14,72,257,1025,21,132,35,258,26,2049,513,80,37,25,22,136,2 60,264,38,514,96,67,41,144,28,69,42,516,49,1026,74,272,160,520,288,528,192,544,70,4 4,131,81,2050,50,73,15,320,133,52,1028,23,134,384,76,137,82,56,27,97,39,259,84,138, 145,261,1032,29,43,2052,98,515,88,140,30,146,71,262,265,161,576,45,1040,100,640,51 ,148,46,75,266,273,517,2056,104,162,53,193,1056,152,77,164,768,268,274,518,54,83,5 7,521,1027,112,135,2064,78,289,194,85,276,522,58,168,1029,139,99,86,60,280,89,290, 529,2080,524,196,1088,141,101,147,176,142,530,321,31,200,1033,90,545,292,2051,322 ,532,263,149,102,105,1030,304,296,163,92,47,267,385,546,2053,324,1041,208,386,150, 153,165,106,55,1034,328,536,577,548,2112,113,154,79,269,1042,108,578,224,166,519, 552,195,1152,270,3072,641,523,275,580,291,59,1036,169,560,114,277,156,2057,87,197 ,1057,116,170,61,531,525,642,281,1089,278,526,2054,177,293,388,91,1044,584,769,19 8,172,120,201,2065,336,1280,62,282,143,103,178,294,1058,93,644,2058,202,592,323,1 048,392,297,770,107,180,151,1060,2066,209,284,648,94,204,298,1031,400,608,352,217 6,325,533,1153,155,210,305,547,300,1090,109,2060,184,534,537,115,167,1536,225,326 ,306,772,2081,157,1035,656,329,110,117,212,1064,171,2113,776,330,226,549,1092,538 ,387,308,216,2068,1154,416,271,279,158,337,1043,550,672,2304,118,332,579,1037,540 ,389,173,121,1072,2082,553,199,784,179,1038,228,338,312,2072,704,390,1096,174,554 ,581,393,1281,283,2084,122,448,353,1045,561,203,63,340,2055,1156,394,527,582,556, 181,1059,2177,295,285,232,124,1282,205,182,643,2114,562,1050,286,585,299,1537,35 4,211,2560,401,185,1104,396,344,586,645,2059,1061,593,535,240,206,1049,95,2088,32 7,564,1046,800,402,356,307,2116,1160,301,417,213,568,1284,832,2178,588,186,1288,6 46,404,227,896,2067,1062,594,418,302,1538,649,771,2061,360,539,1120,111,331,214,1 091,2096,309,188,449,1065,217,408,2062,609,596,1168,551,650,229,1052,2120,159,42 0,310,1093,541,773,2305,610,1066,657,333,119,1540,3073,600,339,218,1073,368,652,2 30,2069,1098,391,313,450,1296,542,2180,334,233,1184,555,774,175,2083,1544,123,65 8,612,1312,2306,341,777,220,1552,314,424,2074,395,1216,673,583,355,1568,2561,287, 183,234,1094,125,557,2128,660,1068,616,342,316,2085,1155,241,778,1105,563,345,20 73,452,1074,397,403,207,2070,1097,674,558,1039,785,432,2184,357,1344,187,236,664, 2308,1157,624,587,1076,780,2312,705,126,1047,242,565,1158,2086,398,346,456,1408, 358,2562,405,1100,303,569,244,2144,1161,595,189,1106,566,2115,676,361,1080,706,5 89,2089,1051,215,786,647,1121,2192,348,419,1063,406,464,2076,680,1283,801,362,11 08,2117,590,409,1162,570,2090,788,597,1169,572,219,2564,1285,311,708,1053,598,20 97,601,1067,651,421,3074,792,1122,802,611,1539,2122,602,410,1112,231,688,2320,11 64,653,248,1054,2208,369,190,364,1170,654,2568,659,1095,335,480,2336,1286,315,22 1,1289,2576,370,613,1185,422,425,2240,1600,451,614,1069,2592,543,235,1124,412,21 18,343,372,1664,775,317,2092,1075,222,426,1172,2179,453,237,1070,559,2129,833,10 99,804,712,2098,1290,834,661,1297,2121,808,779,1541,617,1128,2063,604,433,1186,7 20,2368,816,1077,836,347,2181,1217,897,243,1176,2100,662,454,1101,318,3076,675,1 188,618,898,2071,1792,781,376,2182,1292,428,1298,665,2432,736,1542,567,840,2124, 1078,625,238,1107,2185,359,457,1081,399,2130,787,1545,591,1136,2104,678,434,1159 ,2075,677,349,1102,245,2145,458,1313,666,1218,2087,620,363,1109,2307,127,191,130 0,782,2132,1546,407,436,1082,2186,626,571,1192,2193,465,1163,681,246,2309,1123,7 07,350,3080,1110,599,1084,668,2077,790,1304,460,2091,249,1113,682,1314,2146,573, 411,1553,2563,803,789,1548,709,2136,1220,365,440,2188,1165,628,1125,689,2078,374 ,1171,423,2194,466,1200,793,2119,1166,250,371,1554,2310,481,1345,574,2313,413,10 55,603,2209,1224,366,468,1114,2624,655,1569,900,2093,805,1316,615,3088,1346,684, 710,2148,1556,429,1287,2688,794,252,1173,373,2099,1126,605,848,2196,1129,690,132 8,2094,713,1320,632,2123,482,1187,806,2314,1116,427,904,2321,1071,414,1291,2565, 223,663,1409,2152,692,1570,835,2210,1348,619,472,2101,1232,455,1410,2241,796,809 ,1174,3104,714,1177,721,2200,1189,837,716,2125,1130,864,1079,2212,810,1352,606,2 816,912,1560,722,2316,1601,696,1572,2322,377,435,1137,2566,817,1178,319,2102,110 3,621,1293,2131,812,484,1132,2105,430,1602,838,2569,1248,667,3075,488,1190,239,2 160,1543,378,1576,2183,459,1219,622,2126,627,1294,437,2337,1665,380,2242,1547,81 8,1299,2133,461,496,1604,2324,669,1315,2570,679,1083,724,2106,1193,841,629,2216, 1584,351,1138,3077,467,1301,2187,438,1180,737,2147,1111,251,1221,2134,462,442,21 08,1140,441,1194,2328,469,1085,2137,247,1555,683,2338,1549,842,1666,2577,738,899 ,2572,1305,670,1302,2244,783,1550,3136,849,1201,820,2189,1317,728,2149,1412,928, 1115,2195,791,367,2224,1608,901,1793,2190,630,1222,2578,685,1196,844,2369,1144,6 33,2079,1225,711,1360,2248,253,1086,3081,691,1306,824,2138,1167,902,2593,1127,68 6,740,2340,1202,850,2370,1318,375,2580,1117,444,1668,2311,470,1226,2197,483,1616 ,415,2150,1347,485,2153,1416,905,3078,1321,795,1794,2352,473,1131,2344,634,1204, 2211,744,1175,852,2140,1233,960,2095,1308,865,2315,1672,693,2433,1118,797,1228,2 594,906,1322,2372,715,1424,3089,807,1632,474,2256,1376,636,2434,1349,694,2198,15 57,254,2201,1179,717,2213,1234,575,1329,2154,913,1571,2103,798,1324,3082,811,113 3,2376,379,1208,2584,697,1558,431,2625,607,489,2596,1561,866,2161,1139,723,2202, 1191,486,2127,1249,908,2317,1350,718,1330,3090,813,1796,2156,476,1181,2626,856,1 680,2272,839,1353,2214,725,1134,2567,698,1141,2600,914,1236,2243,752,1195,3200,8 68,1800,2318,819,1354,2689,814,1250,439,2571,1573,929,2323,1562,490,2628,1411,62 3,2339,1332,671,2107,1240,739,3084,1440,916,2217,1295,463,2608,1303,843,2162,118 2,381,2325,1361,497,2204,1574,930,2135,1696,821,2245,1142,726,3105,1356,1603,216 4,961,2218,1564,872,2109,1413,492,2579,1197,631,2573,1145,729,2690,1577,700,2329 ,1223,443,3137,1808,741,2326,1203,845,2574,1252,920,2225,1362,382,2341,1336,822, 2436,1728,2139,1414,851,3092,1198,730,2632,1578,498,2817,1605,880,2246,1417,742, 2220,1307,445,2168,1146,2249,471,1472,2384,1377,635,3328,1585,932,2110,1227,687, 2330,1087,903,2191,1364,2151,825,1418,2226,500,1551,2342,1606,846,3106,1580,745, 2141,1205,2692,826,1319,2250,732,1309,2640,446,1256,2371,1148,3096,962,1229,244 0,936,1206,2345,475,1667,2818,853,2155,1586,867,2228,1310,1609,2199,637,1323,310 8,907,2257,1378,487,2332,1235,695,2696,1425,2142,1209,746,2252,1420,828,2346,136 8,3079,753,1610,2448,854,1669,2656,1617,2400,857,1559,2373,504,1264,2581,799,320 1,1230,1119,2203,255,1351,2258,964,2353,1588,909,2595,1824,719,2348,1426,3138,13 80,477,2157,1331,915,2232,1325,2582,638,1441,2585,1237,2163,748,1592,2215,944,18 56,3584,869,2273,1612,1210,2374,491,2354,1670,699,2820,1428,1251,2205,754,3083,1 920,858,2704,1618,2377,478,1442,2158,1326,968,2165,1673,2260,383,1795,3112,910,2 219,1384,1563,2824,815,2378,1135,976,2274,1355,2597,1238,870,3140,1333,2586,917, 1212,2435,1473,2356,727,1241,2264,493,3202,1432,873,2464,1633,2319,1620,701,232 7,1575,2206,931,1674,2385,1253,3091,756,1183,2598,860,2720,1444,1334,2166,499,23 80,1565,731,2627,1797,3085,1634,823,2588,1681,2437,922,1357,2221,1143,2169,874,1 624,3120,918,2601,1363,2247,1242,502,2832,1392,2227,933,1676,3086,1254,2276,743, 1415,2386,1337,2360,760,2752,1474,881,2438,1566,3144,1358,494,2222,1257,2602,70 2,2629,1579,1798,2441,921,3329,1199,501,2331,1147,2170,1682,2496,876,1636,2401,1 365,3093,847,1801,2609,992,2251,1244,2111,1338,447,2388,1448,3204,1419,2442,733, 1697,2575,827,2630,1607,2604,1379,934,2229,1311,3107,1207,2343,882,1258,2333,93 7,2280,1149,2172,1581,963,3330,1684,2253,1640,2230,747,1366,2691,505,2610,1340,3 098,1265,855,2334,1802,2633,1587,2347,924,3585,1369,734,2402,1476,2259,1421,244 9,829,1427,2233,1231,3152,965,2444,1698,2392,1582,938,2634,1809,2693,1456,3109,8 84,1381,2641,506,2583,1211,2288,1260,2254,749,1688,3097,1648,2143,945,2375,1611, 2612,1804,966,3094,1729,2848,1150,2450,755,2404,1266,859,2355,1589,3208,1422,23 49,940,2465,1370,2261,1480,830,2616,1382,3332,1429,2880,911,2636,1327,1593,2234, 871,3336,1268,2694,1619,2452,639,2275,1213,1590,2944,888,3110,1700,2642,1385,24 66,479,2350,1730,3586,1613,946,2697,1239,2819,750,2408,1810,2587,1671,3168,969,2 159,1372,1443,2379,508,2262,1430,3139,1488,2357,861,2236,1704,2497,1825,757,311 3,1386,2265,1614,2456,970,2657,1433,2644,1594,3216,919,2599,1812,1621,2698,1596, 2277,875,3100,1243,2207,1335,2468,862,2358,1732,3141,1622,2589,758,1625,2821,16 75,2658,948,3114,1445,2705,1816,2381,977,2167,1826,3588,1635,2648,923,2387,1626, 2266,1434,972,3121,1255,2416,1712,2700,761,2278,1677,3146,1272,2439,877,2361,13 93,2498,1214,3344,1388,2590,952,2382,1678,2281,1683,495,3232,1359,2603,1504,282 2,703,2223,1339,3592,1245,2171,935,2706,1394,2660,1637,3360,978,2389,1446,2825,1 449,2268,1475,3600,883,2362,1638,2472,1567,2443,762,3264,1259,2721,1436,2631,50 3,2403,1367,3616,1396,2335,925,2231,1799,2282,1341,3142,1246,2173,878,2605,1450, 2708,1477,3116,735,2664,1261,2390,1583,2364,1857,3203,993,2289,1828,2826,1736,3 153,885,2611,1858,2393,1685,2500,939,3122,1832,2445,1803,2451,1641,2255,994,314 5,1628,2722,1457,2606,980,3087,1744,2833,1840,2480,1860,2405,926,3392,1371,2235, 1921,2284,764,2712,1267,3205,1686,2672,1478,2635,941,3124,1342,2828,1699,2753,9 67,2174,1642,3095,1922,2290,1805,2613,886,1400,1452,3206,831,2446,1689,2394,176 0,2504,1591,3456,947,2406,1864,2453,1649,3148,507,2351,1262,2617,1383,2292,1481, 3209,889,2643,1423,2237,1811,3154,1615,2614,984,2724,1702,2409,1458,3128,751,27 54,1701,2637,1373,3099,1269,2263,942,2834,1482,2695,1690,3169,1644,2396,996,246 7,1387,3111,1151,2454,1215,2512,971,2728,1806,3331,1431,2849,890,2410,1460,3156, 1650,2638,1595,2457,509,3210,1489,2618,1705,2836,1270,2645,949,3217,1731,2620,1 374,2267,1623,3333,973,2359,1692,2756,1814,3101,1484,2646,1000,2649,1273,3115,1 706,2699,1597,2469,892,2840,1435,3170,1827,2850,1813,2659,950,3587,1733,2650,13 89,2458,1464,3160,863,2279,2736,1652,3212,1713,2701,1398,2296,759,3102,1447,241 7,1490,2238,1817,2412,1008,3218,1274,2702,1395,2707,1505,3143,510,2383,1598,252 8,3334,1437,2363,1627,2269,979,3337,1390,2418,1492,2661,1679,3233,953,2470,1924, 2473,1829,3648,1639,2499,2662,763,3117,1708,2591,1734,2283,1453,3172,974,2460,1 818,2391,1276,2420,1397,3712,2823,1629,2365,954,3123,1872,2270,1714,2474,1737,3 220,879,2501,1656,2285,3118,1506,2607,1830,2881,981,3147,1451,2852,1928,2760,14 38,3338,2882,982,2709,1247,3345,1687,2856,1716,2827,1859,3589,927,2665,3176,164 3,2652,1496,2481,1479,3234,995,2768,1820,2864,1833,3125,2884,1738,2395,1745,326 5,765,2945,1861,2291,3224,1740,2710,1888,2502,956,3149,1834,2366,1630,2723,3236, 1936,2666,1746,2946,887,3840,1720,2829,1401,2424,3340,1459,2476,1841,3346,985,2 713,1343,2784,3590,1645,2615,1836,2888,997,3126,1508,2673,2286,1454,3155,1862,2 407,1691,2505,986,3129,2447,1512,2835,1263,3593,1402,2639,3184,1483,2726,943,24 82,1646,3207,1651,2725,2397,1461,3150,1404,2293,891,2506,3361,1842,2714,1485,32 66,1520,2668,1693,2411,3157,998,2175,1703,2239,1748,3348,2830,1865,3594,766,245 5,1653,2484,3130,1375,2674,1491,2619,1462,3240,2513,511,3211,1761,2729,1275,229 4,3171,1486,2755,1466,2398,1465,3158,2647,988,3132,1493,2716,1271,2838,3352,170 7,2508,1866,2297,3161,1001,2730,1762,3362,1923,2621,2459,1694,3601,1807,2851,95 1,2837,3596,1873,2757,1844,3268,2413,1752,2488,1952,3213,1002,2676,3173,1815,27 37,1391,2422,3219,1925,2471,1654,2514,1709,3248,2841,893,3214,1868,2298,2419,16 57,3602,1735,2529,3393,1277,2622,975,2461,1715,3103,2651,1848,3272,1926,2414,25 16,1710,3162,894,2703,3617,1764,2948,1874,2853,3364,1399,2663,1468,3394,2732,14 94,2758,1009,3604,2477,1507,3335,1439,2842,2300,1509,3221,1929,2421,3174,1819,2 653,955,2896,3177,1497,2738,1658,3376,2761,1768,3368,1876,2680,2530,1984,3235,1 004,2854,3164,1889,2475,1717,2952,3119,1821,2462,1930,3339,2271,1010,2711,1739, 3457,2740,1831,3618,2883,1498,3396,1660,2667,2520,1718,3280,957,2503,3458,1278, 2844,1741,2857,3222,1599,2762,3225,1937,2769,1822,3237,2885,983,2764,1835,3178, 2912,1403,3127,2858,1721,3400,1455,2654,2960,1631,3608,1513,2770,3649,958,2744, 3620,1890,2425,1747,2483,3185,1510,2865,3226,1932,2367,1742,3151,2669,987,3341, 2860,1837,2532,1500,3180,2478,1880,3650,2886,1863,3296,1749,2715,2536,1012,3238 ,2287,1722,3591,1938,2426,3624,1776,2507,3267,1892,2670,1843,2675,3342,1838,248 5,3713,999,2428,1463,3595,2866,1953,3347,2509,1514,2544,3652,1647,2717,1695,336 3,2727,1763,3131,2772,1016,3241,2889,1940,2677,1487,3632,2399,1867,3186,2515,14 05,3349,2486,1521,3228,2785,767,3159,1954,2299,3269,1845,2510,2490,1750,3188,24 89,1985,3242,1896,2517,3133,1516,2295,3603,1655,2731,3597,989,2890,3714,1753,27 86,2947,1724,3353,1467,2718,3350,1765,2831,3598,1869,2897,3249,1944,2868,3365,1 003,2776,3460,1406,2976,3163,1846,2839,1875,2415,3656,1754,2949,3841,1522,2678, 3270,1904,2733,3244,990,2892,3192,1766,2681,3273,1469,2759,3408,1495,2301,3134, 1659,2739,3354,1956,2872,3215,1711,2950,3175,1927,2734,1005,2788,3250,1849,2898 ,3366,1524,2423,3165,1870,2492,3716,1769,2518,3274,1850,2531,3664,1756,2463,339 5,1470,2533,3464,959,2953,3369,1986,2843,3842,1960,2521,3179,1499,2682,3252,187 7,2792,3223,1891,2900,3281,3008,1661,3356,2913,1931,3720,2741,1011,3166,2845,15 11,3276,2954,1719,3370,2763,1770,3472,2855,1852,3680,2522,1777,3424,2684,1878,3 397,2742,1881,3605,2302,1013,3227,2765,1528,3282,2623,3377,1823,2961,3619,1279, 2846,3372,1988,2859,3181,1933,2427,3256,1743,2745,3606,1501,2479,2655,2537,1939 ,3609,2914,895,3187,2771,1662,3239,2534,1772,3297,2956,1968,3398,2766,3378,1893, 2861,3844,1515,2524,3229,1723,2904,3728,1778,2887,3401,1882,2773,3182,2746,1006 ,3189,2962,1502,3284,2800,1992,3243,2916,3848,1407,2867,3402,1934,2862,3298,183 9,2487,3621,2000,2977,3610,2538,1894,3459,2671,1941,3380,2719,1014,3288,2787,34 88,1751,2964,3343,1517,2511,3351,2891,1897,3230,2429,1725,3409,2545,1955,3622,2 978,3744,1780,2869,3190,1884,2774,3404,1523,3651,3009,3612,1755,2920,3461,1017, 2540,3245,2679,1847,3193,2777,1946,3625,2748,3271,1898,2491,3856,1942,2789,3251 ,2893,1526,3300,2968,1957,3410,2430,3384,1767,2870,3776,1784,3462,2899,3246,190 5,2778,3626,1018,2546,3653,2928,1518,3465,2790,1726,3355,2493,3194,1945,2519,35 20,1525,3425,2683,3633,1900,2980,3275,2735,1871,3135,2951,2016,3412,2873,3466,1 471,2548,3599,1757,3654,2894,3628,1851,2793,3253,2874,991,3367,2780,1958,3357,2 494,3304,1906,3196,3010,3277,1961,2984,3254,2523,1987,3715,2901,1771,3634,2915, 3358,1529,3657,2685,3371,1879,2955,3426,2535,1948,3283,2743,1758,3473,3257,2794 ,1853,3468,2876,3416,1020,2801,3658,2902,1989,3717,3665,1962,2905,3607,2552,190 8,3312,2847,3278,1530,3167,2303,3399,1773,3012,3636,2957,1969,3872,2767,3474,19 90,3428,2525,3379,1779,2963,3373,2686,1883,3489,3285,2796,1964,3640,2992,3904,1 854,2917,3660,3258,1935,2539,3718,2747,1007,3476,3299,2802,1895,3968,2906,3666, 1663,2526,3490,3374,1912,3016,3721,2431,1503,3843,2958,3432,1970,3611,2863,3183 ,1774,3024,3403,3286,1993,2918,3381,2965,1532,3260,3521,2775,1885,3289,2541,348 0,1781,2921,3681,3668,1994,2749,3623,2979,3722,1943,3301,2804,3231,1015,2908,34 92,3382,1899,2547,3613,2779,1886,3845,3682,2871,3729,1782,2970,3405,3191,1972,2 922,3672,2966,2001,3411,3290,2550,1947,3440,2981,3724,3302,1996,2791,3463,3385, 1785,2808,3522,2929,1901,3614,3406,2542,3305,1976,2750,3627,3846,1519,2969,3247 ,2549,3195,1727,3730,2924,3684,1959,3413,2895,3849,3040,2002,3292,3386,2495,101 9,3496,3467,2781,3745,1907,2875,3655,3427,1786,2982,3359,3255,2930,1527,3306,29 85,3197,1949,3629,3011,3732,3688,1902,2795,3414,2553,3388,1759,3313,2903,3850,2 017,3635,2972,3417,2782,1909,3524,3469,2877,3475,1963,3279,3013,3746,2018,3630, 2986,3857,3504,2004,2932,3429,2554,3259,1950,3308,2797,3736,3696,1788,2993,3659 ,3852,3014,1965,3777,3198,2803,3314,1991,2907,3637,3470,2988,1021,3418,3528,287 8,1910,3430,3477,2959,3375,1855,3641,2919,3316,3667,1971,2687,3261,3638,2936,15 31,3748,3433,2527,3778,1913,3661,2994,3287,2798,3858,2008,3719,3017,3420,3491,1 775,2556,3478,3536,2909,1966,3752,3873,2805,3434,2020,3662,3018,3481,3642,1995, 2967,3860,3669,3644,2923,1914,3291,3383,2910,3780,1533,3670,2806,3673,3723,1973 ,2996,3493,3864,3025,3874,1997,3683,2971,3674,3482,2024,3020,3303,3760,2809,191 6,3725,3320,2925,3441,3262,1974,3436,3000,3726,3731,1887,2543,3407,3552,2751,33 87,1783,3293,2983,3442,3685,3026,1022,3494,3497,3523,2931,2032,3686,3615,2810,3 307,3484,1534,2551,3415,3444,2973,3847,2003,3389,3294,2926,3498,3525,1977,2783, 3309,3631,3905,1787,3041,3876,3784,2933,3906,1998,3733,2987,3880,3851,3689,1978 ,3042,3676,3505,3028,3792,1903,3888,3908,2974,3419,3969,2005,2812,3315,3734,352 6,2989,2006,3390,3747,3015,3690,3970,1951,3853,2934,3448,3500,2879,3737,2019,38 08,3639,2995,3912,3697,1789,2555,3310,3431,3529,2937,1980,3471,3859,3663,3032,3 750,3506,1911,2799,3749,3421,3317,2990,2009,3530,3738,3692,3044,3435,3199,2021, 3263,3019,3854,3479,2938,2010,3508,3698,3643,2557,3537,3753,1967,3318,2997,3779 ,3422,3671,3021,1915,3740,3862,3532,3048,3321,3754,2022,3645,2940,3483,3875,386 1,1790,2998,3781,3437,3512,2911,3700,1535,3761,3446,2807,3495,3538,3865,3056,10 23,3322,3443,3553,2558,3646,3485,2012,3675,3027,3438,3540,3727,3001,2025,3972,3 877,3687,2811,3756,3782,1975,3501,3022,3866,3324,3445,3677,3002,2026,3920,3762, 3785,2927,3704,3554,1917,3878,3029,3499,3976,3486,3030,3295,1999,3735,3764,3907 ,2975,3691,3544,3527,1918,3043,3868,3881,3786,3793,2813,3909,2033,3788,3936,300 4,3882,3678,3984,3794,1979,2935,3768,3449,3507,3889,3033,3391,2028,3693,3884,30 45,3556,3502,3910,3739,2034,3034,3560,3311,3450,3531,2991,3694,1981,3699,3509,3 452,2939,3890,3533,3568,3741,2007,3046,3751,3796,3913,2814,3701,3423,3539,1982, 3510,2559,3809,3323,3534,3514,3513,2011,3036,3541,3319,3755,3914,3049,3810,3971 ,3742,2036,3855,2999,3921,3892,3800,4000,3050,3863,2023,3439,3973,3702,3757,294 1,3916,3705,3783,2040,3325,3023,3763,3896,3974,3758,2942,3812,3922,1791,3447,35 16,3542,3057,3555,3487,3557,3977,3867,2013,3003,3545,3706,3816,3924,4032,3052,3 937,3765,2027,3869,3978,3058,3787,3879,3546,3708,3766,3005,2014,3326,3789,3647, 3985,3870,3031,3883,3451,3769,3503,2029,3679,3561,3006,3938,3795,3558,3980,3790 ,3035,3885,1983,3548,3928,3911,3797,3060,3770,3986,3824,3940,3891,2035,3886,304 7,3511,4001,3562,3695,3743,3811,3064,3988,3535,2037,3915,3453,3569,2815,4002,38 93,3798,4033,3944,3564,3703,1919,3037,3801,3772,3515,3813,3917,3992,3051,3454,3 894,3923,3802,2030,3570,3952,3038,3814,3517,3543,3707,4004,3759,3975,3053,3897, 2038,3572,3918,3817,3898,3804,3518,3007,4034,4008,3547,3925,3939,2041,3709,3979 ,3059,3559,3767,3818,3900,3825,3926,3929,3061,3576,3871,3327,2042,4036,3981,379 1,3549,3987,2943,3710,3820,4016,3941,3563,3771,3826,3930,2015,3054,3550,4040,34 55,3982,3887,4048,3942,3989,3062,3799,3565,3945,3773,4003,2044,3828,3932,3571,3 803,3065,3895,3994,3946,3990,3574,4005,3815,3832,3953,3066,3566,2031,3774,3993, 3573,3948,3919,4064,3519,3805,3899,3039,4006,3954,4009,4035,3819,3577,3927,2039 ,3996,3806,3901,3068,4037,4010,3956,3578,3821,4017,4038,3827,3931,4012,3902,398 3,3055,3943,3711,3960,2043,3551,4018,3822,4041,3580,3933,3829,4042,3991,3063,39 47,3934,3830,4020,4049,3995,4044,3833,3949,4024,3567,2045,3775,4007,4050,3067,3 955,3834,3575,3997,3950,3807,4065,3957,4011,4066,4052,3998,3836,4013,4039,3069, 3958,3903,4019,3579,3961,2046,4056,3823,4014,4068,4043,3962,3581,4021,4045,4072 ,3964,4022,3935,3831,3070,4080,3582,4051,4025,3835,4046,4026,3951,4053,4054,399 9,4067,3837,4028,3959,4057,4069,2047,4058,4015,3963,4070,3838,3583,3071,4060,40 73,4023,4074,3965,4047,3966,4081,4027,4076,4082,4029,4055,4030,4059,4084,4071,4 088,3839,4061,4075,4062,4077,4031,4083,4085,3967,4078,4086,4089,4090,4063,4092, 4079,4087,4091,4093,4094,4095] ;
où la séquence Q3 est donnée par
[0,1,2,4,8,16,32,3,5,64,1024,9,6,17,10,18,128,12,33,65,20,256,34,24,36,7,129,66,512,11, 40,68,130,19,13,48,14,72,257,1025,21,132,35,258,26,513,80,37,25,22,136,260,264,38,5 14,96,67,41,144,28,69,42,516,49,1026,74,272,160,520,288,528,192,544,70,44,131,81,50 ,73,15,320,133,52,1028,23,134,384,76,137,82,56,27,97,39,259,84,138,145,261,1032,29, 43,98,515,88,140,30,146,71,262,265,161,576,45,1040,100,640,51,148,46,75,266,273,51 7,104,162,53,193,1056,152,77,164,768,268,274,518,54,83,57,521,1027,112,135,78,289, 194,85,276,522,58,168,1029,139,99,86,60,280,89,290,529,524,196,1088,141,101,147,17 6,142,530,321,31,200,1033,90,545,292,322,532,263,149,102,105,1030,304,296,163,92,4 7,267,385,546,324,1041,208,386,150,153,165,106,55,1034,328,536,577,548,113,154,79, 269,1042,108,578,224,166,519,552,195,1152,270,641,523,275,580,291,59,1036,169,560 ,114,277,156,87,197,1057,116,170,61,531,525,642,281,1089,278,526,177,293,388,91,10 44,584,769,198,172,120,201,336,1280,62,282,143,103,178,294,1058,93,644,202,592,32 3,1048,392,297,770,107,180,151,1060,209,284,648,94,204,298,1031,400,608,352,325,5 33,1153,155,210,305,547,300,1090,109,184,534,537,115,167,1536,225,326,306,772,157 ,1035,656,329,110,117,212,1064,171,776,330,226,549,1092,538,387,308,216,1154,416, 271,279,158,337,1043,550,672,118,332,579,1037,540,389,173,121,1072,553,199,784,17 9,1038,228,338,312,704,390,1096,174,554,581,393,1281,283,122,448,353,1045,561,203 ,63,340,1156,394,527,582,556,181,1059,295,285,232,124,1282,205,182,643,562,1050,2 86,585,299,1537,354,211,401,185,1104,396,344,586,645,1061,593,535,240,206,1049,95 ,327,564,1046,800,402,356,307,1160,301,417,213,568,1284,832,588,186,1288,646,404, 227,896,1062,594,418,302,1538,649,771,360,539,1120,111,331,214,1091,309,188,449,1 065,217,408,609,596,1168,551,650,229,1052,159,420,310,1093,541,773,610,1066,657,3 33,119,1540,600,339,218,1073,368,652,230,1098,391,313,450,1296,542,334,233,1184,5 55,774,175,1544,123,658,612,1312,341,777,220,1552,314,424,395,1216,673,583,355,15 68,287,183,234,1094,125,557,660,1068,616,342,316,1155,241,778,1105,563,345,452,10 74,397,403,207,1097,674,558,1039,785,432,357,1344,187,236,664,1157,624,587,1076,7 80,705,126,1047,242,565,1158,398,346,456,1408,358,405,1100,303,569,244,1161,595,1 89,1106,566,676,361,1080,706,589,1051,215,786,647,1121,348,419,1063,406,464,680,1 283,801,362,1108,590,409,1162,570,788,597,1169,572,219,1285,311,708,1053,598,601, 1067,651,421,792,1122,802,611,1539,602,410,1112,231,688,1164,653,248,1054,369,19 0,364,1170,654,659,1095,335,480,1286,315,221,1289,370,613,1185,422,425,1600,451,6 14,1069,543,235,1124,412,343,372,1664,775,317,1075,222,426,1172,453,237,1070,559, 833,1099,804,712,1290,834,661,1297,808,779,1541,617,1128,604,433,1186,720,816,10 77,836,347,1217,897,243,1176,662,454,1101,318,675,1188,618,898,1792,781,376,1292, 428,1298,665,736,1542,567,840,1078,625,238,1107,359,457,1081,399,787,1545,591,11 36,678,434,1159,677,349,1102,245,458,1313,666,1218,620,363,1109,127,191,1300,782, 1546,407,436,1082,626,571,1192,465,1163,681,246,1123,707,350,1110,599,1084,668,7 90,1304,460,249,1113,682,1314,573,411,1553,803,789,1548,709,1220,365,440,1165,62 8,1125,689,374,1171,423,466,1200,793,1166,250,371,1554,481,1345,574,413,1055,603, 1224,366,468,1114,655,1569,900,805,1316,615,1346,684,710,1556,429,1287,794,252,1 173,373,1126,605,848,1129,690,1328,713,1320,632,482,1187,806,1116,427,904,1071,4 14,1291,223,663,1409,692,1570,835,1348,619,472,1232,455,1410,796,809,1174,714,11 77,721,1189,837,716,1130,864,1079,810,1352,606,912,1560,722,1601,696,1572,377,43 5,1137,817,1178,319,1103,621,1293,812,484,1132,430,1602,838,1248,667,488,1190,23 9,1543,378,1576,459,1219,622,627,1294,437,1665,380,1547,818,1299,461,496,1604,66 9,1315,679,1083,724,1193,841,629,1584,351,1138,467,1301,438,1180,737,1111,251,12 21,462,442,1140,441,1194,469,1085,247,1555,683,1549,842,1666,738,899,1305,670,13 02,783,1550,849,1201,820,1317,728,1412,928,1115,791,367,1608,901,1793,630,1222,6 85,1196,844,1144,633,1225,711,1360,253,1086,691,1306,824,1167,902,1127,686,740,1 202,850,1318,375,1117,444,1668,470,1226,483,1616,415,1347,485,1416,905,1321,795, 1794,473,1131,634,1204,744,1175,852,1233,960,1308,865,1672,693,1118,797,1228,906 ,1322,715,1424,807,1632,474,1376,636,1349,694,1557,254,1179,717,1234,575,1329,91 3,1571,798,1324,811,1133,379,1208,697,1558,431,607,489,1561,866,1139,723,1191,48 6,1249,908,1350,718,1330,813,1796,476,1181,856,1680,839,1353,725,1134,698,1141,9 14,1236,752,1195,868,1800,819,1354,814,1250,439,1573,929,1562,490,1411,623,1332, 671,1240,739,1440,916,1295,463,1303,843,1182,381,1361,497,1574,930,1696,821,1142 ,726,1356,1603,961,1564,872,1413,492,1197,631,1145,729,1577,700,1223,443,1808,74 1,1203,845,1252,920,1362,382,1336,822,1728,1414,851,1198,730,1578,498,1605,880,1 417,742,1307,445,1146,471,1472,1377,635,1585,932,1227,687,1087,903,1364,825,1418 ,500,1551,1606,846,1580,745,1205,826,1319,732,1309,446,1256,1148,962,1229,936,12 06,475,1667,853,1586,867,1310,1609,637,1323,907,1378,487,1235,695,1425,1209,746, 1420,828,1368,753,1610,854,1669,1617,857,1559,504,1264,799,1230,1119,255,1351,96 4,1588,909,1824,719,1426,1380,477,1331,915,1325,638,1441,1237,748,1592,944,1856, 869,1612,1210,491,1670,699,1428,1251,754,1920,858,1618,478,1442,1326,968,1673,38 3,1795,910,1384,1563,815,1135,976,1355,1238,870,1333,917,1212,1473,727,1241,493, 1432,873,1633,1620,701,1575,931,1674,1253,756,1183,860,1444,1334,499,1565,731,17 97,1634,823,1681,922,1357,1143,874,1624,918,1363,1242,502,1392,933,1676,1254,743 ,1415,1337,760,1474,881,1566,1358,494,1257,702,1579,1798,921,1199,501,1147,1682, 876,1636,1365,847,1801,992,1244,1338,447,1448,1419,733,1697,827,1607,1379,934,13 11,1207,882,1258,937,1149,1581,963,1684,1640,747,1366,505,1340,1265,855,1802,158 7,924,1369,734,1476,1421,829,1427,1231,965,1698,1582,938,1809,1456,884,1381,506, 1211,1260,749,1688,1648,945,1611,1804,966,1729,1150,755,1266,859,1589,1422,940,1 370,1480,830,1382,1429,911,1327,1593,871,1268,1619,639,1213,1590,888,1700,1385,4 79,1730,1613,946,1239,750,1810,1671,969,1372,1443,508,1430,1488,861,1704,1825,75 7,1386,1614,970,1433,1594,919,1812,1621,1596,875,1243,1335,862,1732,1622,758,162 5,1675,948,1445,1816,977,1826,1635,923,1626,1434,972,1255,1712,761,1677,1272,877 ,1393,1214,1388,952,1678,1683,495,1359,1504,703,1339,1245,935,1394,1637,978,1446 ,1449,1475,883,1638,1567,762,1259,1436,503,1367,1396,925,1799,1341,1246,878,1450 ,1477,735,1261,1583,1857,993,1828,1736,885,1858,1685,939,1832,1803,1641,994,1628 ,1457,980,1744,1840,1860,926,1371,1921,764,1267,1686,1478,941,1342,1699,967,1642 ,1922,1805,886,1400,1452,831,1689,1760,1591,947,1864,1649,507,1262,1383,1481,889 ,1423,1811,1615,984,1702,1458,751,1701,1373,1269,942,1482,1690,1644,996,1387,115 1,1215,971,1806,1431,890,1460,1650,1595,509,1489,1705,1270,949,1731,1374,1623,97 3,1692,1814,1484,1000,1273,1706,1597,892,1435,1827,1813,950,1733,1389,1464,863,1 652,1713,1398,759,1447,1490,1817,1008,1274,1395,1505,510,1598,1437,1627,979,139 0,1492,1679,953,1924,1829,1639,763,1708,1734,1453,974,1818,1276,1397,1629,954,18 72,1714,1737,879,1656,1506,1830,981,1451,1928,1438,982,1247,1687,1716,1859,927,1 643,1496,1479,995,1820,1833,1738,1745,765,1861,1740,1888,956,1834,1630,1936,174 6,887,1720,1401,1459,1841,985,1343,1645,1836,997,1508,1454,1862,1691,986,1512,12 63,1402,1483,943,1646,1651,1461,1404,891,1842,1485,1520,1693,998,1703,1748,1865, 766,1653,1375,1491,1462,511,1761,1275,1486,1466,1465,988,1493,1271,1707,1866,10 01,1762,1923,1694,1807,951,1873,1844,1752,1952,1002,1815,1391,1925,1654,1709,89 3,1868,1657,1735,1277,975,1715,1848,1926,1710,894,1764,1874,1399,1468,1494,1009, 1507,1439,1509,1929,1819,955,1497,1658,1768,1876,1984,1004,1889,1717,1821,1930, 1010,1739,1831,1498,1660,1718,957,1278,1741,1599,1937,1822,983,1835,1403,1721,1 455,1631,1513,958,1890,1747,1510,1932,1742,987,1837,1500,1880,1863,1749,1012,17 22,1938,1776,1892,1843,1838,999,1463,1953,1514,1647,1695,1763,1016,1940,1487,18 67,1405,1521,767,1954,1845,1750,1985,1896,1516,1655,989,1753,1724,1467,1765,186 9,1944,1003,1406,1846,1875,1754,1522,1904,990,1766,1469,1495,1659,1956,1711,192 7,1005,1849,1524,1870,1769,1850,1756,1470,959,1986,1960,1499,1877,1891,1661,193 1,1011,1511,1719,1770,1852,1777,1878,1881,1013,1528,1823,1279,1988,1933,1743,15 01,1939,895,1662,1772,1968,1893,1515,1723,1778,1882,1006,1502,1992,1407,1934,18 39,2000,1894,1941,1014,1751,1517,1897,1725,1955,1780,1884,1523,1755,1017,1847,1 946,1898,1942,1526,1957,1767,1784,1905,1018,1518,1726,1945,1525,1900,1871,2016, 1471,1757,1851,991,1958,1906,1961,1987,1771,1529,1879,1948,1758,1853,1020,1989, 1962,1908,1530,1773,1969,1990,1779,1883,1964,1854,1935,1007,1895,1663,1912,1503 ,1970,1774,1993,1532,1885,1781,1994,1943,1015,1899,1886,1782,1972,2001,1947,199 6,1785,1901,1976,1519,1727,1959,2002,1019,1907,1786,1527,1949,1902,1759,2017,19 09,1963,2018,2004,1950,1788,1965,1991,1021,1910,1855,1971,1531,1913,2008,1775,1 966,2020,1995,1914,1533,1973,1997,2024,1916,1974,1887,1783,1022,2032,1534,2003, 1977,1787,1998,1978,1903,2005,2006,1951,2019,1789,1980,1911,2009,2021,2010,1967 ,1915,2022,1790,1535,1023,2012,2025,1975,2026,1917,1999,1918,2033,1979,2028,203 4,1981,2007,1982,2011,2036,2023,2040,1791,2013,2027,2014,2029,1983,2035,2037,19 19,2030,2038,2041,2042,2015,2044,2031,2039,2043,2045,2046,2047] ;
dans lequel les numéros de séquence de N canaux polarisés dans la seconde séquence sont disposés dans l'ordre croissant de fiabilité des N canaux polarisés, et une valeur minimale des numéros de séquence des canaux polarisés est 0 ; ou
la seconde séquence est une partie ou l'ensemble d'une séquence Z1, une séquence Z2 ou une séquence Z3 ;
où la séquence Z1 est donnée par
[0,1,2,7,3,8,14,27,4,13,16,31,19,36,38,84,5,15,17,35,22,42,52,89,25,51,46,97,63,106,113 ,182,6,20,24,44,26,50,57,99,32,61,65,107,78,120,126,201,37,67,82,124,87,135,145,215, 96,147,160,243,166,257,281,408,9,21,29,60,33,64,77,115,39,83,69,127,92,139,153,224, 9,80,95,146,101,156,165,251,111,168,186,269,200,288,307,454,59,98,109,164,122,176 ,194,284,133,195,214,299,227,325,343,494,150,222,247,330,254,344,371,528,275,378,4 02,556,423,581,627,877,18,28,34,79,43,86,90,151,54,94,102,163,112,175,179,283,62,10 3,114,177,125,193,211,301,138,212,223,319,249,339,364,516,71,118,134,199,140,213,2 30,331,161,245,255,347,274,377,394,553,178,266,285,385,300,417,426,578,327,440,47 5,615,501,649,725,878,75,136,155,233,173,252,273,382,183,277,291,407,308,425,452,6 03,208,304,320,437,345,468,496,662,358,504,533,690,564,738,767,1022,229,334,352,4 79,387,513,538,715,422,548,579,755,616,773,842,1103,451,592,630,809,645,865,897,1 175,720,914,951,1160,990,1235,1333,1678,23,40,45,100,55,104,116,192,56,117,129,20 2,142,225,236,362,70,130,143,240,157,248,263,363,167,261,282,400,305,421,432,577,7 3,154,169,242,188,267,286,420,198,297,309,434,323,466,486,643,197,321,336,463,357, 500,518,694,389,542,566,737,589,764,816,1081,85,181,190,293,206,316,335,456,217,3 42,351,495,372,527,547,733,279,365,388,532,409,562,588,760,443,597,635,805,667,86 2,901,1147,313,404,436,574,462,613,638,845,491,655,677,874,726,931,966,1211,535,7 24,742,952,761,992,940,1257,826,1074,1107,1355,1121,1459,1518,1755,91,203,209,35 6,268,376,392,541,295,397,412,569,442,601,634,849,311,439,461,602,478,641,670,884, 505,682,713,921,757,960,1019,1270,361,467,484,668,517,703,745,943,567,746,769,101 4,830,985,1092,1361,611,797,858,1075,885,1117,1154,1426,932,1168,1165,1503,1260, 1547,1599,1928,403,502,543,750,599,772,814,1037,636,847,867,1110,912,1128,1163,1 452,672,893,945,1150,967,1172,1264,1552,1034,1284,1322,1613,1390,1696,1745,2117, 734,955,1008,1267,1089,1273,1376,1634,1101,1365,1433,1725,1488,1791,1886,2269,1 129,1463,1535,1824,1577,1902,1857,2323,1667,1977,2030,2480,2145,2568,2678,3005, 30,48,58,110,66,131,144,231,72,148,159,239,172,259,264,413,74,170,180,258,191,317, 328,450,218,329,355,492,375,520,545,754,76,187,204,322,220,353,368,510,232,381,39 5,551,416,582,608,775,246,406,430,595,457,631,652,836,469,644,684,890,689,920,957, 1340,119,219,228,373,241,396,414,572,271,433,445,622,474,658,680,853,292,449,483, 648,508,687,697,905,531,699,712,962,796,996,1062,1363,312,507,523,708,558,743,751 ,977,587,792,820,1033,873,1084,1112,1437,621,841,889,1115,936,1143,1218,1492,100 6,1228,1288,1557,1326,1626,1705,2102,123,238,260,427,289,446,477,664,306,488,511, 702,536,719,728,970,341,526,557,731,585,785,813,1023,617,832,869,1098,907,1133,11 90,1441,369,571,606,818,654,861,857,1136,674,895,916,1178,981,1222,1248,1564,716, 938,1000,1239,1027,1305,1329,1638,1070,1358,1405,1729,1499,1802,1892,2278,391,6 26,657,900,695,928,982,1231,781,1004,1046,1316,1053,1336,1383,1689,799,1048,1067 ,1372,1138,1401,1474,1788,1203,1495,1532,1828,1595,1936,1996,2352,834,1156,1185, 1445,1249,1507,1543,1869,1292,1586,1644,1973,1711,2038,2130,2512,1412,1653,1736 ,2060,1814,2160,2203,2654,1876,2243,2315,2718,2421,2834,2985,3484,141,272,298,48 9,337,521,552,763,349,563,593,790,624,825,881,1193,383,610,663,851,686,925,909,12 10,705,947,989,1281,1041,1309,1347,1671,460,676,707,924,780,975,1011,1319,789,10 42,1060,1351,1088,1387,1424,1765,801,1078,1124,1420,1199,1471,1522,1835,1241,15 73,1591,1940,1648,2004,2079,2459,471,778,784,1029,804,1051,1095,1398,837,1142,11 81,1456,1224,1510,1582,1917,997,1197,1253,1528,1294,1616,1657,1984,1394,1663,17 39,2064,1818,2153,2195,2640,1056,1301,1368,1620,1416,1719,1776,2094,1484,1795,1 847,2187,1910,2251,2343,2760,1539,1880,1954,2306,2026,2372,2453,2866,2109,2491, 2557,2952,2616,3109,3149,3832,480,808,822,1186,972,1215,1245,1568,1015,1277,131 2,1630,1379,1685,1759,2087,1064,1344,1409,1699,1448,1781,1851,2177,1514,1898,18 40,2227,1992,2332,2413,2803,1206,1430,1467,1807,1561,1862,1946,2286,1609,1958,2 018,2381,2072,2433,2524,2934,1715,2045,2124,2471,2210,2580,2628,3065,2262,2704, 2747,3199,2848,3272,3331,3683,1298,1481,1605,1965,1681,2011,2052,2442,1750,2138 ,2169,2548,2234,2592,2730,3129,1769,2219,2295,2692,2401,2774,2787,3300,2503,288 3,2915,3359,3027,3524,3596,4162,1921,2364,2392,2817,2536,2897,2971,3420,2604,30 47,3085,3560,3225,3639,3888,4347,2666,3174,3247,3730,3387,3776,3946,4458,3454,4 014,4085,4599,4244,4770,5021,5420,10,41,68,149,88,162,196,310,105,184,216,340,244 ,374,386,609,121,207,226,366,270,405,459,628,294,453,431,660,514,696,722,961,137,2 53,287,418,302,448,482,669,346,503,525,700,586,752,774,1018,379,534,600,766,623,8 02,840,1057,656,848,886,1137,906,1173,1236,1567,174,262,324,497,354,519,580,732,3 93,605,540,779,642,815,864,1083,441,594,651,843,678,875,904,1159,714,915,968,1207 ,1013,1259,1307,1675,493,665,706,899,756,937,994,1247,793,999,1055,1286,1090,135 2,1403,1768,854,1076,1148,1371,1167,1406,1473,1844,1227,1494,1549,1905,1602,196 1,2057,2542,235,318,360,591,411,620,632,859,465,647,683,894,718,934,949,1243,509, 688,727,941,770,991,1043,1293,810,1047,1080,1335,1155,1392,1458,1815,550,744,798 ,1010,819,1050,1102,1374,891,1141,1169,1414,1223,1490,1530,1901,946,1198,1252,15 09,1289,1588,1610,1952,1356,1643,1723,2033,1782,2105,2257,2545,570,807,870,1111, 930,1161,1219,1502,964,1230,1265,1563,1310,1606,1674,2008,1036,1296,1339,1637,1 410,1708,1775,2127,1443,1789,1856,2189,1924,2284,2341,2791,1097,1378,1425,1733, 1513,1811,1866,2237,1600,1889,1956,2318,2035,2355,2483,2923,1669,1982,2062,2424 ,2097,2521,2577,3034,2248,2607,2669,3011,2736,3126,3278,3795,280,398,424,675,470 ,693,736,986,476,739,783,1020,828,1085,1116,1451,544,787,831,1125,880,1151,1191,1 454,910,1188,1240,1546,1300,1596,1623,1949,559,868,917,1134,976,1201,1255,1592,1 005,1279,1313,1628,1349,1702,1749,2090,1001,1341,1384,1698,1440,1778,1822,2192, 1520,1873,1926,2281,1980,2338,2436,2886,614,956,979,1272,1032,1328,1382,1679,10 61,1399,1421,1772,1477,1841,1885,2272,1233,1462,1517,1853,1571,1914,1974,2326,1 651,1995,2075,2416,2141,2518,2586,2993,1324,1556,1633,1945,1694,2027,2082,2486, 1762,2115,2163,2539,2260,2634,2695,3093,1860,2254,2289,2672,2329,2740,2651,3163 ,2455,2872,2926,3309,2948,3473,3565,3908,637,1025,1039,1436,1205,1487,1527,1870, 1276,1542,1575,1933,1647,2001,2069,2494,1317,1641,1692,2005,1732,2084,2148,2554 ,1794,2171,2233,2619,2321,2686,2783,3183,1447,1706,1746,2142,1820,2213,2298,265 7,1930,2301,2346,2777,2456,2727,2905,3317,2023,2398,2509,2877,2559,2945,3000,34 24,2637,3023,3019,3538,3166,3607,3678,4140,1553,1785,1878,2303,1999,2349,2430,2 814,2078,2489,2527,2931,2601,2960,3016,3463,2151,2571,2660,2997,2698,3031,3171, 3613,2811,3205,3261,3700,3367,3818,3894,4381,2275,2675,2767,3179,2900,3188,3345 ,3736,2920,3326,3434,3863,3513,3960,4093,4559,2963,3479,3585,4000,3650,4111,405 0,4630,3782,4206,4274,4814,4414,4914,5049,5398,332,435,487,709,529,791,835,1105, 555,852,883,1123,926,1180,1194,1578,565,922,953,1176,984,1332,1360,1665,1066,136 7,1432,1763,1483,1827,1882,2312,575,971,1028,1345,1071,1428,1466,1805,1108,1498, 1534,1894,1585,1964,2016,2358,1146,1559,1619,1989,1684,2067,2106,2468,1712,2091 ,2174,2565,2184,2613,2681,3286,748,1069,1094,1478,1130,1538,1581,1942,1213,1624, 1655,2047,1721,2123,2166,2500,1269,1661,1742,2099,1801,2181,2201,2589,1848,2205 ,2230,2689,2395,2744,2855,3322,1321,1798,1833,2224,1912,2292,2309,2713,1970,238 9,2445,2808,2533,2891,2937,3440,2042,2477,2562,2940,2645,2988,3101,3518,2763,31 18,3208,3618,3264,3719,3838,4364,762,1120,1182,1614,1261,1658,1728,2135,1304,17 52,1809,2208,1864,2245,2265,2701,1395,1837,1908,2268,1968,2378,2427,2794,2039,2 462,2530,2912,2595,2966,3058,3443,1469,1937,2014,2439,2112,2515,2506,2974,2156, 2574,2610,3039,2721,3104,3146,3629,2240,2648,2753,3133,2797,3233,3269,3742,2869 ,3314,3392,3869,3534,3974,4097,4570,1524,2054,2120,2583,2198,2631,2724,3121,236 9,2757,2828,3250,2842,3281,3354,3812,2404,2831,2863,3340,2977,3381,3498,3954,30 78,3529,3580,4008,3672,4146,4228,4661,2465,3008,3050,3448,3154,3543,3602,4065,3 213,3661,3747,4198,3843,4282,4397,4852,3401,3759,3875,4306,3988,4431,4486,5006, 4071,4531,4619,5091,4736,5218,5378,5901,824,1216,1282,1756,1388,1831,1896,2335, 1417,1918,1987,2387,2050,2450,2551,3062,1505,2020,2133,2497,2180,2625,2598,3090 ,2216,2663,2733,3196,2820,3238,3295,3789,1688,2159,2222,2622,2366,2710,2770,325 5,2384,2823,2852,3303,2894,3364,3415,3920,2407,2880,2956,3410,3073,3493,3571,40 22,3138,3644,3667,4154,3753,4236,4331,4791,1716,2361,2375,2800,2410,2837,2908,3 378,2474,2982,3042,3468,3113,3549,3655,4127,2750,3070,3158,3574,3216,3706,3765, 4214,3373,3770,3880,4315,3994,4422,4475,4992,2845,3230,3336,3711,3406,3857,3934 ,4356,3507,3967,4036,4467,4119,4540,4650,5137,3591,4079,4176,4610,4266,4681,477 9,5253,4372,4826,4902,5342,4965,5524,5571,6216,1738,2418,2448,3053,2707,3098,31 41,3635,2780,3191,3242,3725,3350,3807,3914,4339,2859,3291,3395,3826,3459,3940,4 042,4450,3554,4105,4028,4512,4222,4639,4724,5184,3081,3429,3488,3980,3624,4056, 4168,4579,3695,4184,4258,4692,4323,4747,4864,5323,3849,4290,4389,4802,4494,4926 ,4979,5480,4551,5079,5122,5619,5234,5693,5750,6084,3221,3504,3689,4192,3801,425 2,4298,4758,3900,4406,4439,4887,4522,4940,5107,5547,3926,4503,4590,5064,4713,51 53,5169,5721,4840,5269,5304,5776,5440,5935,6005,6505,4133,4670,4701,5202,4875,5 288,5362,5837,4952,5460,5504,5970,5644,6044,6268,6660,5034,5595,5668,6125,5808, 6170,6320,6752,5867,6374,6438,6866,6579,6995,7168,7433,11,47,81,189,108,205,265, 410,132,250,290,447,326,490,506,794,152,278,303,481,359,539,604,823,390,598,568,8 60,673,908,939,1229,171,338,380,554,401,590,633,872,455,659,685,913,765,974,1003, 1299,498,698,782,993,811,1035,1082,1346,856,1091,1140,1442,1166,1485,1562,1925,2 21,348,428,653,464,679,759,948,515,788,710,1007,839,1054,1114,1377,583,776,850,10 87,882,1127,1162,1468,929,1174,1242,1525,1295,1587,1642,2043,646,866,918,1157,98 3,1204,1271,1572,1026,1275,1343,1618,1389,1697,1747,2139,1104,1369,1457,1710,14 79,1751,1823,2220,1548,1845,1906,2285,1962,2342,2443,2972,314,419,473,771,546,80 6,827,1109,612,844,888,1153,933,1200,1217,1569,666,892,944,1209,998,1266,1330,16 25,1049,1334,1373,1676,1464,1734,1806,2191,723,963,1030,1290,1058,1338,1400,171 4,1144,1449,1482,1760,1544,1843,1888,2279,1212,1515,1576,1861,1621,1948,1972,23 33,1701,2007,2093,2417,2155,2496,2662,2976,747,1040,1122,1411,1192,1472,1541,18 55,1234,1551,1593,1922,1646,1969,2037,2391,1323,1632,1680,2000,1754,2076,2146,2 522,1790,2164,2231,2588,2302,2691,2752,3245,1396,1720,1771,2104,1868,2185,2244, 2642,1960,2267,2336,2726,2420,2764,2904,3390,2034,2365,2449,2839,2487,2950,3013 ,3515,2653,3044,3114,3489,3186,3615,3774,4278,370,522,560,876,619,898,954,1263,6 25,959,1012,1302,1068,1380,1419,1799,717,1017,1073,1431,1131,1461,1508,1803,117 0,1500,1566,1904,1635,1957,1985,2331,735,1118,1179,1438,1251,1519,1580,1953,128 7,1611,1649,1991,1690,2071,2119,2481,1283,1683,1727,2065,1786,2152,2196,2594,18 74,2253,2308,2687,2359,2746,2853,3352,800,1225,1254,1601,1315,1666,1724,2046,13 54,1743,1767,2144,1826,2217,2264,2680,1554,1810,1872,2229,1929,2296,2356,2735,2 015,2376,2464,2830,2534,2943,3021,3466,1662,1913,1997,2325,2061,2411,2472,2910, 2131,2508,2558,2968,2665,3076,3143,3576,2238,2659,2697,3116,2738,3193,3095,3652 ,2874,3338,3397,3809,3422,3972,4061,4378,833,1306,1327,1784,1523,1839,1881,2250, 1607,1897,1934,2313,2012,2385,2461,2918,1656,2003,2058,2388,2101,2475,2543,2987 ,2167,2567,2636,3057,2732,3131,3240,3674,1797,2073,2116,2537,2194,2615,2706,309 9,2311,2709,2755,3232,2878,3178,3371,3820,2408,2812,2936,3341,2990,3417,3477,39 22,3080,3502,3497,4038,3657,4101,4172,4596,1909,2157,2255,2715,2379,2761,2847,3 274,2467,2913,2953,3402,3040,3432,3495,3962,2546,3003,3103,3472,3144,3509,3663, 4107,3267,3696,3757,4190,3865,4302,4366,4821,2683,3123,3220,3668,3366,3680,3841 ,4220,3385,3824,3932,4341,4016,4427,4546,4994,3436,3978,4087,4469,4142,4566,450 9,5051,4264,4656,4720,5221,4854,5315,5432,5756,438,576,639,923,692,1021,1077,140 4,729,1096,1135,1427,1187,1493,1512,1938,741,1184,1221,1489,1258,1670,1703,2031, 1357,1707,1780,2134,1836,2202,2261,2723,753,1246,1311,1687,1366,1773,1816,2178, 1407,1852,1890,2274,1944,2345,2400,2769,1453,1919,1978,2374,2049,2452,2502,2893 ,2080,2484,2573,2998,2585,3055,3128,3786,969,1362,1393,1829,1435,1893,1941,2322, 1533,1988,2019,2431,2088,2517,2564,2928,1597,2028,2113,2493,2173,2579,2603,3026 ,2226,2606,2633,3136,2809,3198,3319,3822,1660,2170,2209,2627,2291,2700,2717,316 4,2353,2805,2861,3266,2964,3357,3408,3938,2429,2902,2995,3411,3086,3461,3587,40 20,3218,3604,3702,4115,3763,4210,4312,4805,988,1422,1497,1976,1590,2022,2098,25 28,1639,2126,2182,2612,2241,2650,2671,3151,1741,2215,2288,2674,2348,2789,2844,3 249,2423,2885,2958,3383,3032,3441,3540,3944,1819,2319,2397,2856,2505,2942,2932, 3447,2549,3010,3049,3520,3169,3593,3637,4125,2643,3091,3206,3620,3254,3728,3768 ,4226,3333,3814,3886,4345,4032,4441,4553,5001,1877,2440,2514,3018,2597,3071,317 3,3609,2781,3211,3288,3746,3302,3780,3853,4294,2819,3293,3327,3836,3452,3882,39 96,4420,3562,4026,4081,4473,4166,4605,4679,5081,2888,3482,3531,3950,3641,4044,4 096,4525,3708,4156,4234,4652,4321,4729,4835,5256,3898,4246,4354,4754,4454,4871, 4918,5406,4533,4962,5041,5472,5156,5589,5737,6185,1063,1537,1615,2128,1730,2206 ,2277,2743,1764,2299,2368,2798,2437,2870,2980,3545,1858,2405,2525,2921,2576,306 7,3036,3573,2618,3108,3184,3691,3279,3734,3797,4270,2056,2555,2624,3063,2778,31 59,3227,3751,2795,3283,3312,3803,3362,3859,3916,4393,2822,3347,3427,3910,3556,3 990,4067,4482,3626,4136,4160,4612,4240,4688,4777,5197,2086,2772,2786,3259,2826, 3298,3376,3877,2896,3457,3525,3966,3598,4048,4150,4583,3201,3551,3646,4075,3713 ,4196,4250,4665,3871,4260,4360,4761,4460,4861,4909,5392,3307,3723,3830,4202,390 4,4333,4408,4795,4010,4433,4497,4899,4575,4972,5071,5515,4091,4538,4627,5031,47 15,5102,5189,5622,4812,5232,5301,5706,5367,5854,5891,6465,2108,2836,2864,3533,3 156,3582,3631,4131,3235,3685,3740,4216,3847,4288,4385,4786,3321,3791,3892,4308, 3956,4412,4501,4890,4054,4561,4488,4945,4674,5059,5145,5559,3567,3928,3984,4446 ,4121,4516,4621,5011,4186,4634,4706,5112,4768,5166,5266,5687,4327,4738,4830,521 0,4928,5329,5381,5814,4984,5457,5501,5939,5604,6001,6055,6349,3717,4004,4180,46 43,4284,4697,4745,5176,4374,4845,4880,5293,4955,5340,5486,5874,4399,4935,5019,5 446,5132,5530,5542,6026,5245,5638,5671,6077,5779,6220,6280,6711,4588,5094,5125, 5574,5280,5653,5725,6132,5353,5795,5831,6248,5959,6312,6509,6843,5418,5915,5980 ,6387,6102,6421,6551,6923,6159,6602,6651,7020,6773,7126,7280,7500,237,530,704,11 00,817,1149,1278,1652,902,1237,1350,1737,1446,1832,1865,2402,978,1318,1385,1812, 1529,1916,2053,2446,1604,2041,1981,2519,2188,2600,2656,3134,1044,1476,1583,1950 ,1629,2024,2110,2540,1758,2162,2212,2609,2351,2720,2766,3237,1849,2236,2382,274 9,2434,2825,2899,3310,2511,2916,2992,3450,3029,3511,3617,4129,1195,1504,1693,21 49,1777,2199,2339,2677,1884,2394,2247,2775,2478,2850,2947,3355,2009,2371,2499,2 907,2561,2969,3024,3486,2639,3045,3148,3569,3228,3654,3732,4276,2137,2531,2621, 3014,2729,3088,3194,3633,2806,3203,3305,3698,3369,3805,3884,4395,2929,3343,3470 ,3834,3500,3890,3992,4492,3600,4024,4103,4568,4178,4636,4752,5285,1415,1672,179 3,2362,1932,2426,2458,2939,2068,2490,2570,3006,2647,3083,3111,3628,2175,2582,26 68,3096,2758,3189,3284,3710,2841,3290,3348,3778,3480,3867,3970,4456,2271,2703,2 815,3223,2858,3296,3388,3839,3001,3455,3506,3902,3594,4018,4077,4564,3106,3553, 3642,4046,3704,4158,4188,4625,3811,4232,4337,4722,4416,4807,4977,5290,2316,2833 ,2961,3404,3075,3491,3589,4034,3139,3605,3665,4123,3738,4182,4272,4695,3271,371 5,3784,4224,3896,4319,4403,4833,3948,4424,4507,4904,4592,5009,5069,5545,3380,38 45,3918,4352,4052,4452,4520,4957,4174,4548,4632,5044,4726,5084,5224,5678,4268,4 663,4756,5158,4798,5264,5326,5785,4969,5356,5423,5763,5492,5871,6008,6434,1558, 1900,1966,2552,2083,2591,2684,3181,2095,2694,2784,3243,2875,3360,3413,3958,2258 ,2792,2881,3431,2979,3475,3542,3964,3037,3536,3622,4099,3721,4170,4204,4623,229 4,2955,3052,3445,3161,3558,3648,4164,3215,3687,3744,4212,3799,4310,4370,4788,32 10,3787,3855,4304,3942,4410,4465,4906,4063,4529,4594,5004,4659,5066,5171,5641,2 414,3124,3168,3676,3262,3766,3851,4280,3315,3878,3912,4401,3998,4490,4544,4996, 3611,3976,4059,4505,4134,4581,4654,5054,4242,4677,4772,5148,4847,5261,5334,5744 ,3761,4113,4218,4616,4300,4717,4782,5226,4387,4819,4873,5282,4982,5387,5449,584 1,4514,4974,5014,5426,5056,5495,5403,5904,5192,5628,5681,6033,5703,6178,6252,65 23,2469,3252,3276,3936,3563,4012,4073,4527,3681,4095,4138,4603,4238,4686,4765,5 237,3749,4230,4296,4690,4349,4784,4856,5299,4429,4883,4950,5370,5046,5437,5539, 5921,3952,4317,4368,4849,4462,4931,5024,5409,4601,5026,5074,5533,5195,5483,5659 ,6041,4710,5130,5250,5632,5307,5699,5753,6136,5389,5772,5769,6232,5908,6288,634 5,6695,4109,4418,4535,5029,4683,5076,5163,5568,4775,5229,5272,5684,5351,5712,57 66,6166,4859,5318,5412,5747,5452,5782,5911,6292,5565,5942,5991,6361,6088,6456,6 514,6871,4999,5429,5521,5918,5656,5925,6066,6391,5675,6051,6144,6487,6208,6560, 6656,6989,5715,6181,6272,6593,6324,6675,6626,7040,6425,6741,6794,7153,6894,7218 ,7296,7490,1717,1993,2121,2630,2223,2801,2889,3394,2282,2924,2984,3425,3068,352 2,3547,4144,2305,3060,3119,3516,3176,3772,3816,4262,3324,3828,3930,4391,4006,44 71,4542,5039,2328,3153,3257,3793,3334,3924,3982,4443,3399,4030,4083,4555,4152,4 641,4704,5086,3464,4117,4200,4672,4286,4763,4809,5208,4325,4793,4885,5312,4897, 5364,5435,6016,2712,3329,3374,4002,3438,4089,4148,4614,3578,4208,4248,4740,4335 ,4828,4878,5242,3670,4256,4362,4800,4437,4894,4916,5337,4499,4921,4947,5443,512 7,5498,5610,6048,3755,4435,4480,4943,4577,5016,5036,5469,4647,5120,5179,5562,52 77,5647,5690,6147,4733,5216,5309,5696,5395,5740,5847,6212,5518,5861,5945,6296,5 994,6378,6469,6854,2741,3418,3527,4194,3659,4254,4343,4842,3727,4376,4448,4923, 4518,4967,4987,5454,3873,4484,4572,4989,4645,5109,5161,5550,4731,5200,5274,5665 ,5345,5718,5805,6151,3986,4608,4699,5174,4816,5258,5248,5728,4866,5320,5359,578 8,5475,5851,5888,6304,4960,5401,5509,5877,5553,5966,5998,6395,5625,6037,6106,64 91,6228,6569,6665,7002,4069,4749,4823,5331,4911,5384,5477,5864,5099,5512,5583,5 984,5598,6012,6073,6451,5135,5586,5616,6062,5731,6099,6197,6555,5824,6224,6264, 6597,6341,6700,6762,7059,5205,5760,5798,6155,5894,6236,6284,6636,5949,6332,6400 ,6736,6473,6800,6883,7182,6114,6408,6496,6816,6583,6906,6941,7272,6641,6971,703 3,7320,7105,7388,7480,7719,2867,3583,3693,4383,3861,4477,4557,5061,3906,4585,46 68,5117,4742,5187,5296,5811,4040,4708,4838,5240,4892,5376,5348,5834,4933,5415,5 489,5932,5577,5973,6023,6430,4292,4868,4938,5373,5097,5466,5527,5987,5114,5580, 5607,6030,5650,6080,6128,6532,5140,5635,5709,6121,5821,6193,6256,6607,5881,6316 ,6337,6705,6404,6768,6832,7139,4329,5089,5104,5556,5143,5592,5662,6095,5213,573 4,5792,6174,5857,6240,6328,6685,5506,5818,5898,6260,5952,6366,6412,6747,6091,64 17,6500,6821,6588,6900,6935,7264,5601,5963,6059,6370,6117,6482,6541,6849,6205,6 564,6617,6929,6680,6977,7052,7345,6276,6646,6721,7027,6789,7072,7132,7405,6860, 7160,7211,7461,7249,7552,7573,7841,4358,5150,5182,5801,5463,5844,5884,6308,5536 ,5928,5977,6383,6069,6447,6528,6838,5613,6019,6110,6460,6162,6546,6621,6917,624 4,6670,6612,6959,6757,7046,7098,7370,5828,6140,6189,6574,6300,6631,6716,7008,63 57,6726,6784,7078,6827,7112,7189,7451,6478,6805,6877,7146,6947,7226,7256,7530,6 983,7312,7336,7595,7396,7630,7654,7792,5956,6201,6353,6731,6443,6778,6810,7119, 6518,6888,6912,7204,6965,7233,7328,7562,6537,6953,7014,7304,7092,7353,7362,7642 ,7175,7414,7442,7667,7510,7733,7762,7936,6690,7065,7085,7379,7196,7424,7470,769 2,7241,7520,7541,7747,7607,7776,7858,7981,7288,7584,7618,7808,7680,7824,7876,80 06,7706,7895,7915,8033,7957,8064,8098,8138,12,53,93,234,128,256,350,537,158,333,3 84,584,429,640,661,1038,185,367,399,629,472,701,795,1072,512,786,740,1119,879,117 7,1220,1579,210,444,499,721,524,777,829,1132,596,863,896,1183,995,1262,1297,1664, 650,911,1024,1285,1059,1342,1397,1722,1113,1408,1470,1838,1501,1891,1983,2406,2 76,458,561,855,607,887,987,1232,671,1031,927,1303,1093,1364,1439,1761,768,1009,1 106,1402,1145,1455,1496,1871,1208,1511,1594,1939,1659,2010,2077,2541,846,1126,1 196,1491,1274,1550,1631,1994,1331,1636,1718,2048,1774,2140,2200,2652,1423,1753, 1854,2158,1883,2204,2290,2742,1963,2314,2386,2816,2451,2879,2991,3530,415,549,6 18,1002,711,1052,1079,1429,803,1099,1152,1486,1214,1545,1565,1990,871,1158,1226, 1555,1291,1627,1704,2055,1359,1709,1757,2118,1863,2186,2270,2711,942,1250,1337, 1654,1370,1713,1787,2161,1475,1846,1887,2214,1959,2310,2363,2807,1560,1927,1998 ,2334,2051,2432,2460,2871,2147,2501,2599,2962,2670,3043,3214,3532,973,1348,1450, 1800,1536,1875,1955,2327,1584,1967,2021,2403,2081,2457,2535,2933,1695,2066,2122 ,2492,2207,2581,2658,3072,2249,2679,2756,3137,2835,3244,3306,3802,1783,2168,222 8,2611,2340,2702,2768,3192,2447,2796,2873,3280,2965,3318,3460,3943,2532,2906,29 96,3393,3033,3505,3568,4064,3204,3601,3671,4039,3743,4167,4328,4836,485,681,730, 1139,812,1164,1238,1622,821,1244,1308,1668,1381,1766,1808,2263,935,1314,1386,18 25,1460,1859,1915,2266,1506,1907,1986,2380,2070,2444,2476,2868,958,1444,1516,18 34,1603,1931,2002,2441,1650,2040,2085,2482,2132,2575,2629,3028,1645,2125,2176,2 566,2246,2667,2716,3145,2347,2779,2840,3241,2898,3299,3407,3905,1045,1574,1612, 2029,1686,2107,2172,2547,1731,2197,2225,2655,2293,2739,2793,3231,1975,2273,2344 ,2754,2409,2829,2895,3289,2510,2917,3009,3384,3084,3501,3577,4017,2100,2393,248 8,2860,2563,2957,3017,3467,2644,3056,3107,3523,3217,3634,3699,4126,2762,3212,32 51,3673,3292,3748,3651,4203,3428,3893,3949,4363,3973,4524,4611,4939,1086,1673,1 700,2242,1935,2307,2357,2776,2036,2373,2419,2849,2507,2927,3007,3474,2092,2498, 2560,2930,2608,3022,3092,3544,2682,3117,3187,3614,3285,3688,3796,4225,2259,2578 ,2626,3087,2714,3165,3258,3656,2843,3260,3308,3788,3435,3735,3925,4373,2951,336 8,3492,3895,3546,3968,4029,4474,3636,4053,4047,4589,4209,4653,4727,5157,2390,26 73,2782,3268,2922,3316,3403,3829,3012,3469,3510,3955,3597,3985,4045,4513,3094,3 561,3660,4023,3701,4058,4215,4660,3823,4249,4311,4746,4419,4860,4925,5380,3234, 3679,3777,4221,3919,4231,4396,4776,3939,4379,4485,4900,4567,4986,5106,5548,3987 ,4530,4637,5028,4696,5126,5070,5605,4822,5217,5279,5764,5411,5850,5954,6239,573, 758,838,1202,903,1320,1391,1792,950,1413,1465,1821,1531,1899,1920,2422,965,1521, 1570,1895,1617,2111,2150,2529,1735,2154,2239,2646,2304,2722,2788,3277,980,1598, 1677,2129,1744,2232,2280,2696,1796,2324,2367,2802,2428,2882,2944,3323,1850,2399 ,2470,2914,2550,2999,3048,3449,2584,3030,3122,3555,3135,3612,3684,4340,1256,174 0,1779,2297,1830,2370,2425,2857,1947,2479,2513,2978,2596,3064,3115,3483,2025,25 26,2623,3041,2690,3130,3152,3584,2751,3157,3185,3692,3365,3754,3872,4377,2096,2 688,2731,3177,2821,3253,3270,3720,2892,3358,3416,3821,3521,3911,3959,4491,2975, 3458,3552,3963,3643,4011,4139,4573,3773,4155,4255,4667,4316,4766,4872,5363,1280 ,1817,1903,2463,2013,2516,2605,3077,2074,2635,2699,3162,2765,3202,3222,3707,219 3,2737,2818,3226,2887,3344,3400,3804,2967,3439,3514,3935,3588,3993,4088,4496,22 83,2854,2941,3412,3054,3499,3490,3999,3100,3566,3606,4068,3726,4145,4189,4678,3 195,3647,3762,4173,3810,4283,4322,4781,3887,4369,4442,4905,4584,5000,5113,5557, 2354,2989,3061,3575,3147,3627,3729,4161,3335,3769,3844,4301,3856,4334,4407,4851 ,3372,3848,3881,4390,4003,4436,4547,4981,4112,4578,4631,5033,4721,5167,5239,563 4,3444,4033,4080,4502,4191,4595,4648,5085,4261,4709,4790,5212,4881,5289,5394,57 96,4453,4803,4913,5314,5015,5428,5476,5931,5093,5519,5596,5990,5705,6094,6223,6 606,1375,1951,2044,2638,2179,2725,2804,3297,2221,2832,2909,3353,2983,3426,3537, 4094,2330,2949,3074,3478,3127,3623,3592,4124,3170,3664,3741,4243,3835,4289,4351 ,4827,2556,3105,3175,3621,3332,3716,3781,4307,3351,3837,3868,4357,3917,4413,447 0,4953,3377,3901,3979,4464,4106,4541,4617,5042,4177,4691,4716,5172,4796,5249,53 36,5743,2590,3328,3342,3815,3382,3854,3929,4430,3451,4009,4074,4519,4149,4600,4 703,5144,3756,4102,4197,4626,4265,4751,4808,5225,4425,4817,4919,5319,5020,5421, 5467,5919,3862,4277,4384,4757,4459,4891,4966,5354,4562,4991,5057,5458,5136,5528 ,5626,6028,4642,5098,5190,5587,5275,5655,5738,6122,5371,5775,5839,6195,5896,632 5,6356,6839,2614,3391,3419,4082,3712,4132,4183,4684,3790,4237,4295,4771,4402,48 46,4944,5346,3876,4346,4447,4865,4508,4973,5062,5447,4606,5121,5048,5502,5235,5 614,5697,6067,4118,4479,4536,5007,4673,5077,5180,5566,4741,5194,5265,5664,5328, 5717,5807,6180,4886,5297,5388,5755,5484,5862,5907,6289,5540,5978,6017,6396,6107 ,6452,6495,6743,4271,4556,4735,5203,4841,5257,5305,5726,4932,5404,5438,5830,551 0,5873,6002,6340,4958,5493,5575,5967,5685,6040,6053,6472,5787,6137,6164,6516,62 58,6634,6684,7039,5149,5646,5676,6079,5819,6149,6211,6561,5885,6274,6305,6659,6 415,6713,6874,7148,5943,6376,6432,6774,6536,6803,6909,7209,6585,6950,6992,7284, 7088,7371,7488,7655,296,691,919,1418,1065,1480,1640,2089,1171,1589,1726,2190,18 42,2300,2337,2946,1268,1691,1770,2276,1943,2396,2553,2994,2032,2538,2473,3069,2 705,3150,3207,3690,1353,1879,2006,2435,2059,2523,2620,3089,2211,2676,2734,3160, 2890,3273,3320,3794,2317,2759,2925,3304,2981,3379,3456,3864,3059,3471,3548,4001 ,3586,4060,4169,4682,1540,1911,2136,2661,2235,2719,2876,3229,2360,2938,2773,333 0,3025,3405,3503,3909,2504,2911,3046,3462,3110,3526,3581,4037,3190,3603,3703,41 20,3785,4207,4287,4832,2649,3079,3172,3572,3282,3645,3752,4187,3361,3760,3860,4 251,3921,4359,4438,4956,3485,3897,4019,4388,4051,4444,4545,5053,4153,4576,4657, 5129,4732,5198,5311,5825,1804,2114,2256,2903,2415,2973,3002,3494,2572,3038,3120 ,3564,3200,3640,3669,4181,2693,3132,3219,3653,3311,3745,3840,4263,3396,3846,390 3,4332,4031,4421,4523,5017,2799,3256,3370,3779,3414,3852,3941,4394,3557,4007,40 55,4455,4147,4571,4629,5124,3662,4104,4195,4598,4257,4712,4743,5186,4365,4789,4 896,5283,4975,5366,5534,5827,2851,3389,3517,3957,3632,4041,4141,4587,3697,4159, 4217,4676,4291,4737,4831,5254,3827,4269,4338,4780,4449,4877,4964,5391,4500,4983 ,5068,5461,5152,5563,5623,6056,3933,4400,4472,4910,4604,5012,5082,5513,4728,511 0,5191,5599,5286,5637,5767,6171,4824,5223,5317,5708,5357,5804,5859,6263,5525,58 87,5946,6245,6007,6338,6455,6815,1979,2377,2454,3102,2587,3142,3239,3737,2602,3 246,3339,3798,3433,3913,3965,4511,2785,3346,3437,3981,3535,4025,4090,4517,3595, 4086,4175,4651,4275,4723,4760,5183,2824,3512,3608,3995,3718,4110,4201,4718,3771 ,4241,4297,4767,4353,4869,4930,5349,3764,4342,4409,4863,4495,4970,5025,5464,461 5,5090,5155,5560,5220,5620,5720,6139,2959,3682,3724,4229,3819,4320,4405,4837,38 70,4432,4466,4961,4550,5050,5105,5551,4163,4528,4609,5065,4687,5141,5214,5608,4 799,5238,5332,5700,5407,5802,5868,6230,4314,4666,4774,5178,4858,5276,5339,5770, 4948,5377,5431,5822,5537,5913,5969,6311,5073,5531,5569,5948,5611,6010,5929,6367 ,5739,6127,6173,6479,6192,6599,6663,6886,3015,3806,3831,4489,4116,4565,4624,508 7,4235,4646,4693,5164,4794,5246,5325,5778,4303,4785,4855,5251,4908,5343,5414,58 36,4990,5441,5508,5899,5602,5961,6049,6382,4506,4874,4927,5408,5023,5487,5578,5 934,5160,5581,5629,6043,5741,5999,6156,6485,5271,5682,5793,6131,5842,6190,6235, 6563,5916,6254,6251,6644,6369,6692,6739,7026,4662,4978,5096,5584,5243,5631,5714 ,6076,5335,5773,5810,6177,5882,6202,6249,6591,5417,5853,5937,6233,5972,6261,637 3,6696,6074,6399,6442,6754,6522,6830,6878,7166,5554,5951,6035,6380,6152,6386,65 06,6777,6168,6492,6571,6858,6627,6918,6997,7263,6204,6603,6677,6942,6720,7009,6 972,7300,6807,7066,7106,7392,7185,7439,7501,7646,2165,2485,2632,3180,2745,3356, 3446,3947,2813,3481,3541,3977,3625,4072,4098,4698,2838,3616,3675,4066,3733,4326 ,4371,4818,3879,4382,4483,4949,4560,5032,5101,5593,2862,3709,3813,4348,3889,447 8,4534,5003,3951,4582,4635,5116,4707,5201,5263,5640,4015,4671,4755,5231,4844,53 22,5368,5752,4882,5350,5444,5848,5455,5893,5957,6462,3265,3885,3927,4552,3989,4 640,4702,5175,4130,4762,4804,5300,4895,5386,5434,5784,4223,4813,4922,5360,4998, 5451,5473,5870,5058,5478,5505,5964,5679,6014,6112,6489,4309,4995,5040,5499,5138 ,5572,5590,5986,5209,5673,5729,6071,5816,6143,6183,6575,5294,5761,5845,6186,592 3,6226,6318,6630,6031,6331,6402,6699,6445,6766,6842,7157,3294,3971,4076,4748,42 11,4810,4903,5400,4281,4936,5008,5481,5078,5522,5543,5975,4426,5045,5133,5546,5 206,5661,5711,6058,5291,5746,5813,6161,5876,6207,6283,6577,4539,5168,5260,5723, 5374,5799,5790,6214,5424,5856,5890,6267,5993,6321,6354,6707,5516,5926,6022,6343 ,6061,6422,6449,6781,6124,6483,6540,6862,6642,6926,7000,7269,4620,5308,5383,586 5,5470,5910,5996,6334,5652,6025,6089,6435,6101,6458,6512,6826,5688,6092,6119,65 02,6217,6533,6616,6914,6299,6638,6673,6946,6735,7030,7079,7316,5749,6242,6277,6 581,6360,6648,6688,6980,6406,6728,6785,7061,6846,7110,7176,7410,6547,6792,6865, 7124,6934,7194,7224,7482,6984,7248,7294,7519,7354,7574,7638,7822,3423,4135,4245 ,4941,4415,5037,5118,5617,4461,5146,5228,5670,5303,5735,5833,6286,4593,5268,539 7,5781,5450,5905,5879,6309,5490,5940,6004,6393,6082,6426,6468,6812,4850,5427,54 96,5902,5649,5983,6038,6439,5667,6085,6109,6475,6146,6520,6557,6893,5691,6134,6 199,6553,6295,6613,6667,6955,6347,6717,6732,7035,6788,7083,7138,7381,4888,5643, 5658,6064,5694,6097,6158,6530,5758,6221,6270,6595,6327,6652,6724,7018,6020,6293 ,6363,6669,6409,6758,6796,7070,6526,6799,6869,7129,6938,7190,7219,7475,6104,641 9,6499,6761,6550,6855,6902,7152,6623,6922,6963,7214,7013,7253,7310,7539,6681,69 88,7048,7290,7101,7326,7375,7588,7162,7398,7434,7624,7463,7694,7711,7914,4917,5 702,5732,6279,5981,6315,6350,6710,6046,6389,6428,6770,6510,6823,6890,7143,6116, 6466,6543,6835,6589,6905,6967,7205,6655,7005,6958,7238,7075,7305,7348,7559,6302 ,6567,6609,6930,6703,6975,7043,7274,6750,7053,7096,7332,7134,7359,7416,7616,685 0,7115,7171,7386,7229,7445,7469,7677,7259,7514,7533,7728,7580,7754,7773,7878,64 13,6620,6746,7057,6819,7093,7120,7365,6881,7180,7199,7427,7244,7452,7526,7702,6 897,7234,7279,7507,7342,7546,7553,7764,7404,7594,7609,7782,7662,7833,7854,7987, 7022,7321,7337,7567,7421,7602,7632,7802,7457,7670,7686,7844,7737,7866,7928,8021 ,7494,7720,7745,7889,7793,7902,7942,8040,7812,7955,7971,8061,8003,8084,8111,814 5,315,749,1016,1608,1189,1682,1923,2412,1325,1867,2017,2520,2143,2641,2685,3363, 1434,1971,2063,2617,2252,2771,2935,3421,2350,2919,2846,3496,3097,3590,3649,4157 ,1526,2183,2320,2810,2383,2901,3004,3519,2544,3066,3125,3599,3301,3714,3767,427 3,2664,3155,3337,3750,3398,3825,3907,4350,3487,3923,4005,4498,4049,4563,4675,51 54,1748,2218,2466,3051,2569,3112,3287,3666,2708,3349,3182,3775,3453,3858,3961,4 398,2884,3325,3476,3915,3539,3983,4043,4537,3630,4062,4179,4622,4267,4711,4787, 5295,3035,3508,3610,4035,3731,4114,4227,4689,3808,4233,4344,4753,4417,4862,4929 ,5405,3945,4386,4521,4879,4554,4934,5027,5494,4655,5055,5131,5564,5199,5624,572 7,6213,2103,2438,2593,3313,2790,3386,3430,3953,2954,3465,3550,4027,3638,4108,41 37,4685,3082,3559,3658,4122,3758,4219,4324,4764,3850,4330,4392,4834,4532,4912,5 005,5462,3209,3694,3817,4259,3866,4336,4434,4884,4013,4510,4558,4946,4649,5052, 5108,5558,4128,4607,4694,5075,4759,5181,5211,5615,4867,5252,5352,5701,5422,5780 ,5938,6215,3263,3833,3975,4451,4092,4543,4644,5067,4165,4658,4719,5151,4792,520 7,5287,5674,4313,4773,4839,5244,4937,5333,5413,5806,4985,5433,5507,5869,5582,59 65,6021,6431,4428,4893,4959,5365,5083,5456,5520,5920,5196,5544,5618,5997,5704,6 032,6154,6539,5284,5648,5733,6098,5771,6194,6246,6628,5930,6271,6329,6610,6385, 6697,6802,7108,2287,2728,2827,3528,2970,3570,3677,4213,2986,3686,3783,4279,3883 ,4404,4463,4997,3197,3792,3891,4481,3991,4526,4597,5002,4057,4586,4680,5128,477 8,5193,5227,5612,3236,3969,4070,4493,4193,4613,4700,5188,4253,4744,4797,5233,48 53,5327,5382,5765,4247,4843,4901,5321,4980,5419,5468,5875,5092,5529,5588,5962,5 642,6015,6111,6511,3375,4151,4199,4730,4299,4820,4898,5298,4361,4924,4954,5410, 5030,5491,5541,5955,4664,5010,5088,5503,5159,5576,5639,6006,5262,5660,5748,6090 ,5817,6188,6253,6594,4815,5139,5241,5606,5316,5695,5757,6160,5396,5791,5840,620 9,5941,6298,6351,6671,5514,5936,5971,6330,6009,6390,6313,6722,6129,6501,6544,68 24,6562,6925,6978,7165,3442,4285,4318,4976,4618,5047,5100,5526,4739,5119,5165,5 594,5259,5669,5745,6167,4806,5247,5313,5672,5361,5759,5826,6225,5436,5849,5914, 6282,6003,6342,6427,6737,4993,5330,5379,5820,5465,5895,5979,6317,5591,5982,6024 ,6420,6133,6379,6525,6831,5692,6075,6182,6503,6227,6558,6601,6895,6301,6619,661 5,6964,6725,7003,7045,7283,5134,5425,5532,5988,5663,6029,6105,6453,5751,6163,61 96,6548,6269,6570,6614,6919,5829,6238,6319,6598,6352,6624,6729,7006,6448,6751,6 791,7056,6859,7122,7158,7395,5958,6335,6411,6733,6521,6740,6845,7074,6535,6834, 6901,7144,6951,7192,7257,7476,6572,6928,6993,7215,7028,7267,7237,7502,7100,7314 ,7346,7575,7411,7613,7659,7775,2495,2865,3020,3619,3140,3800,3899,4440,3224,393 1,3997,4476,4084,4574,4602,5170,3248,4078,4143,4569,4205,4825,4870,5281,4367,48 76,4971,5399,5043,5474,5538,5995,3275,4185,4293,4848,4380,4963,5018,5448,4445,5 063,5111,5552,5177,5627,5683,6036,4515,5147,5219,5657,5302,5736,5786,6145,5338, 5768,5855,6234,5866,6281,6339,6809,3705,4375,4423,5035,4487,5115,5173,5603,4633 ,5230,5267,5716,5347,5800,5846,6175,4725,5278,5375,5777,5442,5860,5883,6257,550 0,5886,5912,6346,6072,6394,6486,6833,4811,5439,5482,5906,5570,5974,5989,6368,56 36,6068,6118,6446,6206,6515,6552,6904,5713,6153,6231,6554,6306,6590,6678,6954,6 410,6689,6755,7011,6795,7068,7128,7387,3739,4468,4580,5215,4714,5270,5358,5812, 4783,5390,5453,5892,5517,5927,5947,6358,4920,5488,5567,5950,5630,6054,6103,6433 ,5707,6138,6200,6534,6262,6576,6645,6908,5022,5600,5680,6113,5789,6187,6179,658 0,5832,6243,6275,6632,6372,6682,6712,7017,5922,6310,6401,6701,6437,6772,6798,70 77,6497,6828,6873,7147,6961,7200,7260,7479,5095,5724,5797,6250,5878,6294,6375,6 693,6047,6405,6463,6783,6474,6806,6852,7117,6081,6467,6493,6841,6584,6870,6939, 7188,6661,6957,6990,7217,7042,7287,7325,7515,6141,6605,6639,6911,6714,6968,6999 ,7245,6759,7036,7082,7311,7133,7350,7402,7589,6880,7089,7151,7363,7207,7419,744 1,7649,7250,7462,7497,7674,7547,7717,7769,7906,3874,4638,4750,5393,4907,5479,55 55,6013,4951,5579,5651,6063,5722,6126,6219,6649,5072,5689,5809,6169,5858,6290,6 265,6668,5897,6323,6384,6748,6457,6776,6817,7103,5310,5838,5903,6287,6045,6364, 6416,6787,6060,6459,6481,6820,6519,6856,6891,7173,6083,6507,6566,6887,6657,6936 ,6981,7222,6704,7024,7038,7291,7086,7330,7374,7565,5344,6039,6052,6441,6087,647 1,6529,6867,6148,6587,6635,6921,6686,6970,7032,7276,6397,6653,6718,6986,6763,70 60,7091,7318,6863,7097,7155,7366,7210,7415,7437,7644,6477,6769,6837,7063,6884,7 140,7181,7383,6948,7195,7230,7432,7271,7466,7511,7690,6996,7252,7299,7493,7343, 7524,7561,7729,7391,7579,7608,7758,7634,7807,7819,7977,5369,6096,6120,6640,6362 ,6674,6708,7021,6423,6744,6780,7071,6848,7114,7169,7378,6488,6813,6876,7125,691 5,7184,7232,7428,6974,7265,7225,7454,7323,7505,7543,7707,6664,6898,6932,7202,70 15,7240,7295,7484,7054,7302,7339,7528,7369,7551,7593,7752,7136,7355,7400,7570,7 446,7619,7639,7795,7472,7669,7685,7834,7723,7853,7869,7949,6765,6944,7050,7307, 7111,7334,7358,7556,7163,7407,7423,7604,7458,7623,7679,7814,7177,7449,7487,7664 ,7537,7696,7700,7861,7585,7735,7746,7875,7783,7916,7931,8031,7278,7521,7534,771 2,7599,7740,7765,7891,7628,7788,7800,7923,7840,7940,7988,8057,7653,7827,7847,79 59,7883,7967,7997,8072,7899,8009,8019,8088,8044,8105,8126,8152,1813,2748,3167,3 937,3409,4021,4239,4801,3579,4171,4355,4915,4504,5038,5080,5686,3722,4305,4411, 5013,4628,5142,5306,5730,4734,5292,5222,5803,5459,5880,5933,6344,3842,4549,4705 ,5185,4769,5273,5372,5823,4942,5430,5485,5889,5633,5992,6034,6424,5060,5511,566 6,6018,5719,6086,6150,6480,5794,6165,6229,6582,6259,6625,6698,7019,4100,4591,48 57,5416,4968,5471,5621,5953,5103,5677,5523,6042,5762,6108,6191,6513,5255,5654,5 783,6157,5843,6210,6255,6608,5917,6273,6355,6666,6418,6723,6775,7107,5402,5815, 5900,6247,6000,6307,6392,6709,6070,6398,6476,6753,6524,6822,6872,7174,6176,6504 ,6596,6840,6618,6875,6937,7228,6687,6956,7004,7268,7049,7303,7361,7601,4457,482 9,4988,5645,5162,5710,5742,6184,5324,5774,5852,6241,5924,6303,6326,6706,5445,58 63,5944,6314,6027,6388,6461,6760,6100,6464,6508,6804,6604,6861,6924,7208,5549,5 976,6078,6414,6115,6470,6538,6844,6237,6586,6622,6882,6683,6952,6987,7266,6322, 6654,6715,6969,6756,7037,7055,7298,6825,7081,7142,7347,7186,7389,7468,7603,5597 ,6093,6203,6549,6297,6611,6679,6962,6348,6691,6730,7016,6779,7051,7104,7333,645 0,6764,6808,7076,6879,7131,7179,7401,6910,7191,7236,7435,7281,7483,7509,7701,65 31,6847,6892,7150,6973,7206,7243,7459,7047,7258,7301,7498,7349,7516,7576,7749,7 102,7317,7364,7548,7384,7592,7617,7785,7465,7629,7656,7778,7682,7813,7855,7970, 4669,5123,5204,5835,5341,5872,5960,6381,5355,5968,6050,6429,6130,6517,6556,6916 ,5535,6057,6135,6568,6218,6600,6647,6920,6266,6643,6702,7001,6767,7044,7064,729 7,5573,6198,6278,6578,6365,6658,6719,7041,6407,6745,6782,7069,6818,7127,7161,73 80,6403,6811,6853,7123,6907,7183,7213,7436,6979,7247,7282,7481,7315,7508,7554,7 736,5698,6336,6371,6738,6444,6797,6851,7109,6484,6868,6889,7178,6940,7227,7255, 7477,6694,6927,6976,7235,7023,7275,7313,7503,7087,7324,7372,7544,7408,7591,7621 ,7771,6793,7010,7073,7293,7121,7344,7376,7577,7170,7394,7420,7600,7471,7641,766 5,7803,7239,7467,7485,7657,7504,7683,7648,7823,7563,7731,7750,7863,7757,7904,79 24,7991,5754,6436,6454,6903,6662,6949,6985,7246,6742,6998,7025,7286,7084,7329,7 368,7581,6786,7080,7118,7331,7149,7377,7412,7606,7193,7425,7456,7635,7499,7661, 7699,7829,6913,7130,7159,7409,7212,7447,7489,7650,7285,7491,7512,7697,7564,7678 ,7742,7865,7341,7536,7587,7732,7610,7756,7774,7892,7643,7781,7780,7919,7825,793 3,7948,8028,7007,7187,7251,7492,7327,7513,7550,7710,7373,7578,7596,7751,7627,77 60,7779,7901,7413,7614,7651,7772,7666,7784,7826,7934,7709,7835,7850,7952,7879,7 975,7989,8062,7478,7658,7693,7828,7741,7830,7872,7960,7748,7868,7894,7983,7912, 7999,8020,8083,7761,7905,7929,8007,7943,8024,8014,8091,7968,8038,8048,8109,8067 ,8118,8128,8151,4889,5236,5385,5909,5497,6065,6142,6542,5561,6172,6222,6565,629 1,6633,6650,7029,5585,6285,6333,6629,6377,6801,6829,7099,6490,6836,6899,7172,69 45,7216,7254,7496,5609,6359,6440,6814,6498,6896,6931,7201,6545,6960,6991,7261,7 034,7306,7338,7517,6592,7012,7062,7322,7113,7367,7390,7569,7135,7382,7426,7612, 7431,7633,7660,7857,5985,6494,6527,6943,6573,6994,7031,7292,6672,7067,7090,7356 ,7141,7399,7422,7583,6734,7095,7156,7385,7198,7430,7440,7622,7231,7443,7455,766 3,7535,7684,7725,7867,6790,7197,7221,7453,7273,7486,7495,7673,7309,7532,7557,77 08,7598,7738,7753,7896,7352,7572,7611,7755,7645,7770,7805,7913,7691,7810,7836,7 935,7851,7956,7978,8059,6011,6559,6637,7058,6727,7094,7145,7406,6771,7164,7203, 7444,7242,7464,7473,7668,6864,7223,7270,7474,7308,7527,7549,7703,7351,7566,7597 ,7744,7625,7763,7791,7897,6933,7289,7335,7555,7393,7590,7586,7766,7417,7615,763 1,7786,7675,7806,7818,7938,7460,7647,7688,7815,7704,7843,7852,7961,7730,7864,78 84,7984,7918,8001,8022,8085,6982,7360,7397,7620,7438,7640,7676,7811,7523,7689,7 715,7848,7721,7856,7874,7974,7538,7716,7727,7871,7767,7882,7909,7998,7798,7917, 7927,8008,7947,8029,8042,8094,7568,7777,7789,7898,7820,7920,7932,8016,7837,7945 ,7962,8037,7979,8049,8065,8113,7886,7964,7985,8052,8004,8069,8075,8125,8017,808 0,8090,8131,8102,8140,8150,8171,6123,6676,6749,7167,6857,7220,7262,7506,6885,72 77,7319,7531,7357,7560,7605,7794,6966,7340,7403,7582,7429,7637,7626,7801,7448,7 652,7681,7832,7713,7845,7860,7969,7116,7418,7450,7636,7522,7672,7695,7849,7529, 7714,7724,7862,7739,7877,7890,7993,7540,7734,7759,7888,7797,7908,7925,8010,7816 ,7941,7946,8030,7963,8043,8055,8107,7137,7518,7525,7705,7542,7718,7743,7881,757 1,7768,7787,7903,7809,7921,7944,8026,7687,7796,7821,7926,7838,7953,7965,8039,78 80,7966,7986,8053,8005,8068,8074,8124,7722,7842,7870,7954,7887,7982,7995,8058,7 911,8000,8012,8073,8025,8081,8093,8134,7930,8018,8034,8089,8047,8096,8106,8142, 8060,8110,8117,8148,8122,8157,8159,8179,7154,7545,7558,7790,7671,7804,7817,7939 ,7698,7831,7846,7958,7873,7973,7992,8056,7726,7859,7885,7976,7900,7996,8013,807 1,7922,8023,8011,8078,8041,8092,8101,8137,7799,7893,7907,8002,7937,8015,8032,80 86,7951,8035,8046,8097,8054,8103,8114,8147,7980,8050,8063,8108,8076,8119,8123,8 155,8082,8130,8133,8161,8141 ,8164,8166,8176,7839,791 0,7950,8036,7972,8045,8051, 8104,7990,8066,8070,8116,8079,8120,8132,8158,7994,8077,8087,8129,8100,8135,8136 ,8165,8112,8143,8146,8167,8153,8172,8174,8184,8027,8095,8099,8139,8115,8144,814 9,8169,8121,8154,8156,8173,8162,8175,8180,8186,8127,8160,8163,8177,8168,8178,81 81,8187,8170,8182,8183,8188,8185,8189,8190,8191] ;
où la séquence Z2 est donnée par
[0,1,2,7,3,8,13,26,4,12,15,30,18,35,37,82,5,14,16,34,21,41,51,87,24,50,45,94,61,103,110 ,177,6,19,23,43,25,49,55,96,31,59,63,104,76,117,123,195,36,65,80,121,85,131,141,208, 93,143,155,235,161,248,271,391,9,20,28,58,32,62,75,112,38,81,67,124,90,135,149,217, 48,78,92,142,98,152,160,243,108,163,180,260,194,278,296,434,57,95,106,159,119,171, 188,274,129,189,207,288,220,313,330,471,146,215,239,318,246,331,356,502,266,363,3 85,528,405,551,593,816,17,27,33,77,42,84,88,147,52,91,99,158,109,170,174,273,60,100 ,111,172,122,187,204,290,134,205,216,307,241,326,350,491,69,115,130,193,136,206,22 3,319,156,237,247,334,265,362,378,525,173,257,275,369,289,399,408,548,315,421,453, 582,477,613,681,817,73,132,151,226,168,244,264,367,178,267,281,390,297,407,432,57 1,202,293,308,418,332,447,473,624,344,480,507,650,535,693,719,942,222,321,338,457, 371,488,511,672,404,521,549,708,583,724,785,1011,431,561,595,756,609,805,833,1072 ,677,848,880,1059,914,1122,1203,1479,22,39,44,97,53,101,113,186,54,114,125,196,138 ,218,228,348,68,126,139,232,153,240,254,349,162,252,272,383,294,403,413,547,71,150 ,164,234,182,258,276,402,192,286,298,415,311,445,463,607,191,309,323,442,343,476,4 93,653,373,515,537,692,558,716,762,992,83,176,184,283,200,304,322,436,210,329,337, 472,357,501,520,688,269,351,372,506,392,533,557,712,424,565,600,752,629,803,837,1 048,302,387,417,544,441,580,603,788,468,618,638,813,682,863,893,1102,509,680,696, 881,713,916,871,1140,771,986,1014,1221,1026,1306,1353,1539,89,197,203,342,259,36 1,376,514,285,381,395,540,423,569,599,791,300,420,440,570,456,605,632,822,481,642, 670,854,710,888,939,1151,347,446,462,630,492,661,699,873,538,700,720,935,774,910, 1002,1226,578,745,799,987,823,1023,1054,1279,864,1066,1063,1341,1143,1376,1417,1 670,386,478,516,703,567,723,760,955,601,789,807,1017,846,1032,1062,1300,633,830,8 75,1051,894,1069,1146,1380,952,1163,1194,1428,1250,1493,1531,1810,689,884,930,11 49,999,1154,1238,1445,1009,1229,1285,1516,1329,1567,1639,1919,1033,1309,1367,15 92,1400,1651,1617,1957,1471,1707,1746,2065,1830,2125,2198,2406,29,47,56,107,64,1 27,140,224,70,144,154,231,167,250,255,396,72,165,175,249,185,305,316,430,211,317,3 41,469,360,495,518,707,74,181,198,310,213,339,353,486,225,366,379,523,398,552,575, 726,238,389,411,564,437,596,615,780,448,608,644,827,649,853,886,1209,116,212,221, 358,233,380,397,543,262,414,425,588,452,621,641,795,282,429,461,612,484,647,656,8 40,505,658,669,890,744,919,976,1228,301,483,498,666,530,697,704,903,556,741,766,9 51,812,995,1019,1288,587,784,826,1021,867,1045,1108,1332,928,1116,1166,1384,1197 ,1439,1500,1799,120,230,251,409,279,426,455,626,295,465,487,660,510,676,684,897,3 28,500,529,686,554,735,759,943,584,776,809,1007,842,1036,1084,1291,354,542,574,76 4,617,802,798,1039,635,832,850,1074,906,1111,1133,1390,673,869,923,1125,946,1180, 1200,1448,983,1224,1262,1519,1338,1575,1643,1925,375,592,620,836,654,860,907,111 9,731,926,962,1189,968,1206,1244,1488,747,964,980,1235,1041,1259,1318,1564,1095, 1335,1364,1595,1414,1676,1721,1977,778,1056,1080,1294,1134,1344,1373,1626,1169, 1407,1453,1704,1505,1752,1819,2087,1268,1460,1524,1768,1584,1841,1872,2182,1631 ,1900,1951,2224,2025,2299,2394,2688,137,263,287,466,324,496,524,715,336,534,562,7 39,590,770,819,1087,368,577,625,793,646,858,844,1101,663,877,913,1160,958,1183,12 15,1474,439,637,665,857,730,901,932,1192,738,959,974,1218,998,1247,1277,1547,749, 990,1029,1274,1092,1315,1356,1600,1127,1397,1411,1679,1456,1727,1782,2051,450,7 28,734,948,751,967,1004,1256,781,1044,1077,1303,1113,1347,1404,1662,920,1090,113 7,1361,1171,1431,1463,1712,1253,1468,1527,1771,1587,1836,1866,2173,971,1177,123 2,1434,1271,1511,1555,1793,1326,1570,1609,1860,1657,1906,1971,2251,1370,1634,16 90,1945,1743,1991,2047,2319,1804,2073,2117,2373,2157,2470,2494,2875,458,755,767, 1081,899,1105,1130,1393,936,1157,1186,1442,1241,1485,1542,1788,978,1212,1265,14 96,1297,1559,1612,1853,1350,1648,1604,1889,1718,1963,2019,2279,1098,1282,1312,1 579,1387,1621,1684,1931,1425,1693,1737,1997,1777,2033,2095,2362,1508,1757,1815, 2059,1877,2133,2165,2443,1914,2215,2243,2524,2308,2567,2601,2797,1174,1323,1422 ,1698,1482,1732,1762,2039,1535,1825,1847,2111,1894,2141,2232,2482,1550,1883,193 7,2207,2011,2260,2269,2583,2081,2330,2350,2617,2420,2710,2750,3042,1665,1985,20 05,2288,2103,2339,2385,2652,2149,2432,2455,2730,2539,2773,2904,3134,2190,2509,2 552,2822,2633,2846,2933,3187,2671,2967,3002,3252,3083,3328,3433,3584,10,40,66,14 5,86,157,190,299,102,179,209,327,236,359,370,576,118,201,219,352,261,388,438,594,2 84,433,412,623,489,655,678,889,133,245,277,400,291,428,460,631,333,479,499,659,55 5,705,725,938,364,508,568,718,589,750,783,972,619,790,824,1040,841,1070,1123,1392 ,169,253,312,474,340,494,550,687,377,573,513,729,606,761,804,994,422,563,614,786,6 39,814,839,1058,671,849,895,1099,934,1142,1182,1477,470,627,664,835,709,868,918,1 132,742,922,970,1164,1000,1219,1260,1549,796,988,1049,1234,1065,1263,1317,1607,1 115,1334,1378,1653,1420,1695,1766,2107,227,306,346,560,394,586,597,800,444,611,6 43,831,675,866,879,1129,485,648,683,872,721,915,960,1170,757,963,991,1205,1055,12 51,1305,1585,522,698,746,931,765,966,1010,1237,828,1043,1067,1269,1112,1331,1363 ,1650,876,1091,1136,1346,1167,1409,1426,1688,1222,1452,1514,1748,1560,1801,1910, 2109,541,754,810,1018,862,1060,1109,1340,892,1118,1147,1389,1184,1423,1476,1730, 954,1173,1208,1447,1266,1503,1554,1817,1293,1565,1616,1862,1667,1929,1969,2271, 1006,1240,1278,1522,1349,1582,1624,1896,1418,1641,1691,1953,1750,1979,2067,2355 ,1472,1711,1770,2027,1795,2093,2131,2424,1904,2151,2192,2410,2236,2480,2570,285 6,270,382,406,636,449,652,691,911,454,694,733,940,773,996,1022,1299,517,736,775,1 030,818,1052,1085,1302,845,1083,1126,1375,1176,1415,1436,1686,531,808,851,1037,9 02,1094,1139,1412,927,1159,1187,1440,1216,1498,1534,1790,924,1210,1245,1495,129 0,1557,1590,1864,1355,1629,1669,1927,1709,1967,2035,2332,581,885,905,1153,950,11 99,1243,1480,975,1257,1275,1552,1320,1605,1638,1921,1120,1308,1352,1614,1395,16 60,1705,1959,1458,1720,1779,2021,1827,2091,2137,2399,1196,1383,1444,1683,1492,1 744,1784,2069,1544,1808,1843,2105,1912,2169,2209,2460,1619,1908,1933,2194,1961, 2238,2180,2502,2048,2323,2357,2588,2371,2682,2733,2914,602,944,956,1287,1097,13 28,1360,1627,1156,1372,1398,1674,1455,1725,1775,2075,1190,1450,1490,1728,1521,1 786,1832,2115,1569,1849,1893,2159,1955,2203,2266,2514,1296,1501,1532,1828,1589, 1879,1939,2184,1672,1941,1973,2262,2049,2230,2344,2593,1741,2009,2085,2326,2119 ,2369,2403,2654,2171,2417,2415,2718,2504,2756,2794,3031,1381,1562,1633,1943,172 3,1975,2031,2286,1781,2071,2097,2360,2147,2378,2413,2676,1834,2127,2186,2401,22 11,2422,2507,2759,2284,2527,2560,2806,2622,2868,2907,3150,1923,2196,2256,2512,2 341,2517,2609,2825,2353,2598,2660,2891,2704,2940,3006,3234,2380,2685,2744,2960, 2779,3016,2985,3266,2849,3064,3098,3347,3166,3389,3444,3576,320,416,464,667,503, 740,779,1013,527,794,821,1028,859,1076,1088,1401,536,855,882,1073,909,1202,1225, 1469,979,1231,1284,1545,1325,1594,1636,1949,545,898,947,1213,984,1281,1311,1577, 1015,1337,1366,1645,1406,1697,1736,1981,1047,1386,1433,1716,1484,1773,1802,2057 ,1506,1791,1851,2123,1858,2155,2200,2575,702,982,1003,1321,1034,1369,1403,1681,1 104,1437,1461,1759,1513,1814,1845,2079,1150,1466,1529,1797,1574,1856,1870,2139, 1610,1873,1891,2205,2007,2241,2312,2596,1193,1572,1599,1887,1658,1935,1947,2221 ,1702,2003,2041,2282,2101,2335,2364,2663,1755,2063,2121,2366,2176,2396,2465,270 7,2253,2475,2529,2762,2562,2816,2878,3142,714,1025,1078,1429,1144,1464,1518,182 3,1179,1537,1580,1875,1622,1902,1916,2213,1254,1602,1655,1918,1700,1995,2029,22 73,1753,2053,2099,2348,2143,2382,2439,2665,1314,1677,1734,2037,1806,2089,2083,2 387,1838,2129,2153,2427,2226,2467,2492,2768,1898,2178,2247,2484,2275,2544,2565, 2828,2321,2591,2636,2894,2716,2947,3009,3239,1358,1764,1812,2135,1868,2167,2228 ,2477,1989,2249,2295,2554,2304,2572,2614,2865,2013,2297,2317,2606,2389,2630,269 6,2937,2451,2713,2741,2964,2791,3034,3075,3280,2055,2408,2434,2668,2497,2721,27 53,2992,2532,2785,2831,3060,2881,3102,3158,3363,2641,2837,2897,3114,2954,3174,3 200,3427,2995,3221,3261,3461,3313,3510,3569,3740,769,1106,1161,1540,1248,1597,1 646,1965,1272,1663,1714,2001,1761,2045,2113,2441,1343,1739,1821,2077,1855,2163, 2145,2458,1881,2188,2234,2522,2290,2547,2580,2853,1487,1840,1885,2161,1987,2219 ,2258,2557,1999,2292,2310,2585,2337,2620,2649,2920,2015,2328,2376,2646,2448,269 3,2736,2971,2487,2776,2788,3038,2834,3079,3126,3337,1509,1983,1993,2277,2017,23 01,2346,2628,2061,2392,2429,2679,2472,2724,2782,3024,2245,2446,2499,2738,2534,2 809,2840,3068,2625,2843,2900,3118,2957,3170,3195,3421,2306,2542,2604,2812,2644, 2888,2927,3138,2701,2944,2978,3191,3020,3225,3275,3479,2747,2999,3049,3257,3094 ,3289,3332,3523,3146,3352,3384,3556,3410,3620,3636,3827,1526,2023,2043,2436,221 7,2463,2489,2771,2264,2519,2549,2819,2612,2862,2917,3130,2315,2578,2638,2872,26 74,2930,2981,3183,2727,3013,2974,3212,3072,3270,3308,3497,2453,2657,2690,2950,2 765,2988,3045,3243,2803,3053,3090,3294,3122,3318,3368,3549,2884,3106,3154,3342, 3204,3394,3416,3605,3230,3456,3473,3652,3516,3676,3694,3792,2537,2699,2800,3057 ,2859,3087,3110,3323,2910,3162,3178,3378,3217,3400,3467,3628,2923,3208,3248,345 0,3303,3485,3491,3685,3358,3529,3542,3702,3591,3750,3770,3896,3027,3284,3298,35 04,3373,3536,3563,3721,3405,3598,3613,3760,3660,3781,3840,3929,3438,3644,3668,3 803,3712,3815,3853,3947,3730,3866,3881,3968,3912,3990,4016,4049,11,46,79,183,105 ,199,256,393,128,242,280,427,314,467,482,743,148,268,292,459,345,512,572,768,374,5 66,539,801,634,843,870,1117,166,325,365,526,384,559,598,811,435,622,645,847,717,9 00,925,1175,475,657,732,917,758,953,993,1214,797,1001,1042,1292,1064,1327,1388,1 668,214,335,410,616,443,640,711,878,490,737,668,929,782,969,1020,1239,553,727,792 ,997,820,1031,1061,1313,861,1071,1128,1359,1172,1408,1451,1756,610,806,852,1057, 908,1096,1152,1396,945,1155,1211,1432,1249,1494,1533,1826,1012,1233,1304,1504,1 322,1536,1591,1884,1377,1608,1654,1930,1696,1970,2040,2386,303,401,451,722,519,7 53,772,1016,579,787,825,1053,865,1093,1107,1394,628,829,874,1100,921,1148,1201,1 438,965,1204,1236,1478,1310,1523,1578,1863,679,891,949,1168,973,1207,1258,1507,1 046,1298,1324,1543,1374,1606,1640,1926,1103,1351,1399,1620,1435,1685,1703,1964, 1497,1729,1792,2022,1837,2076,2187,2388,701,957,1027,1267,1086,1316,1371,1615,1 121,1379,1413,1666,1454,1701,1751,2004,1195,1443,1481,1724,1538,1780,1831,2094, 1566,1844,1892,2138,1942,2206,2246,2551,1255,1512,1551,1800,1625,1859,1901,2174 ,1694,1917,1966,2229,2024,2254,2343,2635,1749,1986,2044,2302,2070,2372,2411,270 5,2181,2430,2473,2691,2516,2760,2845,3100,355,497,532,815,585,834,883,1145,591,8 87,933,1178,981,1242,1273,1573,674,937,985,1283,1035,1307,1345,1576,1068,1339,13 91,1652,1446,1692,1713,1962,690,1024,1075,1289,1135,1354,1402,1689,1165,1427,14 57,1717,1489,1776,1811,2066,1162,1483,1517,1772,1563,1835,1867,2142,1630,1907,1 946,2204,1982,2242,2311,2613,748,1114,1138,1419,1188,1470,1515,1758,1220,1530,1 548,1829,1593,1882,1915,2199,1382,1581,1628,1890,1671,1938,1980,2235,1735,1994, 2054,2296,2102,2368,2416,2678,1467,1659,1722,1958,1769,2018,2060,2347,1820,2084 ,2118,2383,2189,2450,2490,2739,1897,2185,2210,2474,2237,2520,2461,2780,2324,260 5,2639,2863,2653,2946,2990,3149,777,1181,1198,1561,1357,1603,1635,1905,1424,164 7,1675,1950,1733,2000,2052,2352,1462,1726,1767,2002,1798,2062,2108,2395,1846,21 24,2170,2438,2233,2483,2548,2792,1571,1778,1809,2104,1865,2156,2216,2464,1948,2 218,2248,2543,2327,2511,2624,2869,2016,2285,2363,2607,2397,2650,2684,2921,2452, 2698,2695,2979,2783,3011,3047,3251,1656,1839,1909,2222,1996,2252,2307,2568,2056 ,2349,2374,2642,2428,2659,2694,2941,2110,2405,2466,2681,2491,2702,2786,3014,256 4,2804,2836,3056,2892,3112,3143,3350,2201,2478,2536,2789,2621,2795,2880,3071,26 32,2871,2926,3131,2968,3172,3228,3422,2661,2949,3003,3192,3032,3237,3211,3445,3 093,3278,3306,3511,3364,3546,3588,3696,419,546,604,856,651,941,989,1261,685,1005 ,1038,1280,1082,1333,1348,1678,695,1079,1110,1330,1141,1473,1499,1747,1223,1502, 1558,1822,1601,1871,1913,2227,706,1131,1185,1486,1230,1553,1586,1854,1264,1613, 1642,1922,1682,1972,2010,2257,1301,1664,1708,1992,1760,2046,2080,2336,1783,2068 ,2128,2402,2136,2437,2481,2851,896,1227,1252,1596,1286,1644,1680,1956,1365,1715, 1738,2032,1789,2090,2122,2358,1416,1745,1807,2074,1850,2132,2148,2419,1888,2150 ,2168,2486,2283,2523,2594,2870,1465,1848,1876,2164,1934,2212,2223,2503,1978,228 0,2316,2563,2381,2616,2645,2929,2030,2342,2400,2647,2456,2675,2745,2970,2535,27 54,2807,3018,2839,3066,3117,3343,912,1276,1336,1706,1410,1740,1796,2098,1449,18 16,1857,2154,1899,2179,2193,2495,1528,1880,1932,2195,1974,2270,2305,2553,2026,2 331,2377,2631,2423,2664,2719,2932,1588,1954,2008,2313,2082,2367,2361,2667,2112, 2409,2433,2708,2506,2748,2772,3023,2175,2459,2528,2763,2556,2821,2842,3074,2602 ,2866,2903,3133,2976,3179,3231,3425,1632,2038,2088,2414,2144,2447,2508,2757,226 5,2531,2576,2830,2584,2848,2886,3108,2289,2579,2599,2877,2670,2901,2958,3169,27 31,2973,3000,3194,3044,3255,3288,3457,2333,2687,2714,2935,2774,2982,3008,3218,2 810,3039,3078,3276,3121,3310,3356,3524,2909,3084,3137,3321,3185,3371,3391,3579, 3222,3409,3441,3602,3486,3642,3690,3819,977,1368,1430,1818,1520,1874,1924,2240, 1546,1940,1988,2276,2036,2322,2391,2722,1618,2014,2096,2354,2130,2444,2425,2737 ,2158,2469,2515,2801,2571,2824,2857,3096,1765,2116,2162,2442,2263,2500,2540,283 3,2274,2573,2590,2860,2619,2889,2918,3156,2291,2610,2656,2915,2728,2955,2993,31 98,2766,3029,3041,3258,3081,3292,3331,3502,1787,2259,2268,2559,2294,2582,2627,2 898,2338,2673,2711,2943,2751,2984,3036,3245,2525,2725,2777,2997,2813,3059,3086, 3282,2895,3091,3140,3324,3188,3367,3387,3574,2587,2818,2874,3062,2912,3127,3163 ,3339,2965,3175,3205,3383,3241,3413,3453,3617,3005,3224,3265,3437,3304,3465,349 9,3653,3346,3515,3541,3680,3565,3726,3737,3887,1803,2300,2318,2715,2498,2742,27 69,3026,2545,2798,2827,3069,2883,3105,3152,3335,2595,2854,2906,3115,2938,3165,3 207,3379,2987,3235,3201,3402,3286,3448,3482,3632,2734,2924,2952,3181,3021,3214, 3262,3429,3054,3268,3300,3469,3327,3490,3528,3674,3124,3314,3354,3507,3395,3551 ,3570,3714,3418,3597,3612,3751,3647,3769,3784,3860,2815,2962,3051,3272,3103,329 6,3317,3494,3147,3360,3375,3538,3406,3555,3607,3732,3159,3398,3432,3593,3477,36 22,3626,3776,3520,3658,3669,3790,3703,3828,3843,3939,3247,3462,3474,3637,3533,3 663,3686,3805,3560,3708,3719,3835,3757,3851,3897,3964,3583,3744,3763,3869,3797, 3877,3906,3978,3812,3917,3927,3994,3951,4010,4031,4056,229,504,662,1008,763,105 0,1158,1459,838,1124,1217,1525,1295,1598,1623,2012,904,1191,1246,1583,1362,1661, 1763,2042,1421,1754,1710,2092,1861,2146,2183,2485,961,1319,1405,1687,1441,1742, 1805,2106,1541,1842,1878,2152,1976,2225,2255,2546,1611,1895,1998,2244,2034,2293 ,2340,2589,2086,2351,2398,2669,2421,2703,2761,3025,1089,1342,1491,1833,1556,186 9,1968,2197,1637,2006,1903,2261,2064,2309,2370,2615,1731,1990,2078,2345,2120,23 84,2418,2689,2172,2431,2493,2735,2541,2781,2823,3099,1824,2100,2160,2412,2231,2 457,2521,2770,2281,2526,2586,2805,2623,2861,2902,3157,2359,2608,2680,2876,2697, 2905,2956,3203,2752,2972,3012,3238,3050,3269,3320,3535,1270,1475,1568,1984,1673 ,2028,2050,2365,1774,2072,2126,2407,2177,2454,2471,2767,1852,2134,2191,2462,225 0,2518,2574,2811,2303,2577,2611,2847,2686,2893,2945,3186,1920,2214,2287,2538,23 14,2581,2634,2879,2404,2672,2700,2911,2749,2969,2998,3236,2468,2726,2775,2983,2 808,3040,3055,3264,2864,3077,3129,3307,3167,3344,3415,3537,1952,2298,2379,2643, 2449,2692,2746,2977,2488,2755,2787,3022,2826,3052,3097,3295,2566,2814,2850,3073 ,2908,3120,3161,3355,2934,3171,3210,3385,3249,3428,3452,3627,2629,2882,2919,313 6,2986,3184,3216,3407,3048,3229,3267,3442,3309,3458,3512,3671,3095,3281,3322,34 87,3340,3527,3550,3705,3412,3561,3585,3698,3609,3731,3771,3880,1385,1649,1699,2 114,1785,2140,2202,2513,1794,2208,2267,2550,2325,2618,2648,2939,1911,2272,2329, 2658,2390,2683,2720,2942,2426,2717,2764,3010,2817,3046,3063,3263,1936,2375,2435 ,2666,2501,2729,2778,3043,2533,2799,2829,3067,2858,3116,3145,3336,2530,2852,288 7,3113,2931,3164,3190,3386,2991,3220,3250,3426,3279,3451,3492,3659,2020,2479,25 05,2793,2561,2841,2885,3101,2592,2899,2916,3160,2959,3202,3227,3423,2758,2948,2 989,3209,3028,3244,3277,3446,3082,3287,3329,3483,3361,3526,3553,3692,2838,3017, 3070,3260,3111,3305,3333,3513,3153,3349,3372,3534,3417,3572,3594,3722,3213,3414 ,3430,3586,3447,3610,3578,3741,3500,3655,3672,3778,3679,3817,3836,3900,2058,255 5,2569,2928,2732,2966,2996,3219,2796,3007,3030,3254,3080,3291,3326,3517,2832,30 76,3109,3293,3135,3334,3365,3540,3173,3376,3404,3566,3443,3590,3625,3746,2936,3 119,3144,3362,3189,3396,3434,3580,3253,3435,3454,3623,3501,3606,3665,3780,3302, 3476,3522,3656,3543,3678,3695,3806,3573,3701,3700,3831,3742,3845,3859,3936,3015 ,3168,3223,3436,3290,3455,3489,3635,3330,3514,3530,3673,3559,3682,3699,3814,336 6,3547,3581,3693,3595,3704,3743,3846,3634,3752,3766,3863,3793,3885,3898,3969,34 24,3587,3619,3745,3664,3747,3787,3870,3670,3783,3808,3892,3825,3908,3928,3989,3 683,3818,3841,3915,3854,3932,3922,3997,3878,3945,3955,4014,3973,4023,4033,4055, 1510,1719,1813,2166,1886,2278,2334,2637,1928,2356,2393,2655,2445,2709,2723,3033 ,1944,2440,2476,2706,2510,2844,2867,3092,2597,2873,2925,3155,2963,3193,3226,344 0,1960,2496,2558,2855,2603,2922,2951,3180,2640,2975,3001,3232,3037,3271,3299,34 59,2677,3019,3061,3285,3104,3325,3345,3506,3123,3338,3377,3545,3382,3564,3589,3 773,2220,2600,2626,2961,2662,3004,3035,3259,2740,3065,3085,3315,3128,3353,3374, 3519,2790,3089,3141,3341,3177,3381,3390,3554,3206,3392,3403,3592,3475,3611,3649 ,3782,2835,3176,3197,3401,3242,3431,3439,3601,3274,3472,3495,3633,3532,3661,367 5,3809,3312,3509,3544,3677,3575,3691,3724,3826,3618,3728,3753,3847,3767,3867,38 88,3966,2239,2651,2712,3058,2784,3088,3132,3359,2820,3148,3182,3393,3215,3411,3 419,3596,2896,3199,3240,3420,3273,3468,3488,3629,3311,3503,3531,3667,3557,3684, 3711,3810,2953,3256,3297,3493,3348,3525,3521,3687,3369,3548,3562,3706,3603,3725 ,3736,3849,3408,3577,3615,3733,3630,3759,3768,3871,3654,3779,3798,3893,3830,391 0,3930,3991,2994,3319,3351,3552,3388,3571,3604,3729,3464,3616,3640,3764,3645,37 72,3789,3884,3478,3641,3651,3786,3688,3796,3822,3907,3717,3829,3839,3916,3858,3 937,3949,4000,3505,3697,3709,3811,3738,3832,3844,3924,3754,3856,3872,3944,3889, 3956,3971,4018,3800,3874,3894,3959,3913,3975,3981,4030,3925,3986,3996,4036,4007 ,4044,4054,4075,2320,2743,2802,3151,2890,3196,3233,3449,2913,3246,3283,3471,331 6,3498,3539,3713,2980,3301,3357,3518,3380,3568,3558,3720,3397,3582,3608,3749,36 38,3761,3775,3879,3107,3370,3399,3567,3463,3600,3621,3765,3470,3639,3648,3777,3 662,3791,3804,3902,3480,3657,3681,3802,3716,3821,3837,3918,3734,3852,3857,3938, 3873,3950,3962,4012,3125,3460,3466,3631,3481,3643,3666,3795,3508,3689,3707,3816 ,3727,3833,3855,3934,3614,3715,3739,3838,3755,3864,3875,3946,3794,3876,3895,396 0,3914,3974,3980,4029,3646,3758,3785,3865,3801,3891,3904,3965,3824,3909,3920,39 79,3933,3987,3999,4039,3842,3926,3941,3995,3954,4002,4011,4046,3967,4015,4022,4 052,4027,4061,4063,4083,3139,3484,3496,3710,3599,3723,3735,3850,3624,3748,3762, 3868,3788,3883,3901,3963,3650,3774,3799,3886,3813,3905,3921,3977,3834,3931,3919 ,3984,3948,3998,4006,4042,3718,3807,3820,3911,3848,3923,3940,3992,3862,3942,395 3,4003,3961,4008,4019,4051,3890,3957,3970,4013,3982,4024,4028,4059,3988,4035,40 38,4065,4045,4068,4070,4080,3756,3823,3861,3943,3882,3952,3958,4009,3899,3972,3 976,4021,3985,4025,4037,4062,3903,3983,3993,4034,4005,4040,4041,4069,4017,4047, 4050,4071,4057,4076,4078,4088,3935,4001,4004,4043,4020,4048,4053,4073,4026,4058 ,4060,4077,4066,4079,4084,4090,4032,4064,4067,4081,4072,4082,4085,4091,4074,408 6,4087,4092,4089,4093,4094,4095] ;
où la séquence Z3 est donnée par
[0,1,2,7,3,8,12,25,4,11,14,29,17,34,36,79,5,13,15,33,20,40,49,84,23,48,44,91,59,100,106 ,170,6,18,22,42,24,47,53,93,30,57,61,101,74,113,119,187,35,63,77,117,82,126,136,199, 90,138,149,224,155,236,257,366,9,19,27,56,31,60,73,108,37,78,65,120,87,130,143,207, 46,76,89,137,95,146,154,231,104,157,173,247,186,264,280,404,55,92,102,153,115,164, 180,260,124,181,198,273,210,296,311,436,141,205,228,300,234,312,334,463,253,341,3 60,485,378,505,540,721,16,26,32,75,41,81,85,142,50,88,96,152,105,163,167,259,58,97, 107,165,118,179,195,275,129,196,206,290,230,307,329,453,67,111,125,185,131,197,21 3,301,150,226,235,315,252,340,354,483,166,244,261,346,274,373,381,502,297,392,420, 531,441,557,613,722,71,127,145,216,161,232,251,344,171,254,266,365,281,380,402,52 2,193,277,291,390,313,415,438,566,324,444,467,588,491,623,644,818,212,303,318,424, 348,451,471,606,377,479,503,635,532,648,697,870,401,513,542,674,554,713,735,914,6 10,746,771,905,797,950,1007,1188,21,38,43,94,51,98,109,178,52,110,121,188,133,208, 218,327,66,122,134,221,147,229,242,328,156,240,258,359,278,376,385,501,69,144,158, 223,175,245,262,375,184,271,282,387,294,413,429,552,183,292,305,411,323,440,455,5 90,350,474,493,622,511,642,679,856,80,169,176,268,191,287,304,405,201,310,317,437, 335,462,478,619,255,330,349,466,367,489,510,638,395,517,546,671,570,711,738,897,2 86,362,389,499,410,529,549,699,433,561,578,719,614,758,781,936,469,612,625,772,63 9,799,764,963,686,851,872,1019,881,1077,1108,1225,86,189,194,322,246,339,352,473, 270,357,369,495,394,520,545,702,284,391,409,521,423,550,573,726,445,581,604,751,6 37,777,816,971,326,414,428,571,454,597,628,766,494,629,645,813,688,794,863,1023,5 28,665,708,852,727,879,901,1059,759,910,908,1100,965,1123,1149,1303,361,442,475,6 31,518,647,677,828,547,700,714,874,745,885,907,1073,574,732,767,899,782,912,967,1 125,826,979,1001,1156,1039,1197,1220,1381,620,774,809,969,861,973,1031,1167,868, 1025,1063,1211,1092,1242,1285,1439,886,1079,1117,1257,1138,1292,1272,1458,1183, 1324,1346,1513,1392,1543,1579,1673,28,45,54,103,62,123,135,214,68,139,148,220,160 ,238,243,370,70,159,168,237,177,288,298,400,202,299,321,434,338,457,477,634,72,174 ,190,293,204,319,332,449,215,343,355,481,372,506,525,650,227,364,383,516,406,543,5 59,693,416,553,583,730,587,750,776,1011,112,203,211,336,222,356,371,498,249,386,3 96,536,419,564,580,705,267,399,427,556,447,585,593,740,465,594,603,779,664,801,84 4,1024,285,446,459,601,487,626,632,789,509,662,682,825,718,858,876,1065,535,696,7 29,877,761,895,940,1094,808,946,981,1128,1003,1163,1201,1375,116,219,239,382,265, 397,422,568,279,431,450,596,470,609,616,784,309,461,486,617,507,657,676,819,533,6 90,716,867,742,888,923,1067,333,497,524,680,560,710,707,890,575,734,748,916,791,9 42,958,1132,607,763,804,952,821,991,1005,1169,849,1021,1047,1213,1098,1247,1287, 1442,351,539,563,737,591,756,792,948,654,806,833,997,838,1009,1035,1194,667,835,8 47,1029,892,1045,1085,1240,931,1096,1115,1259,1147,1306,1332,1468,691,903,920,10 69,959,1102,1121,1277,983,1143,1172,1322,1204,1349,1386,1524,1051,1176,1216,135 8,1252,1398,1414,1571,1280,1429,1455,1591,1492,1626,1668,1784,132,250,272,432,30 6,458,482,641,316,490,514,660,538,685,724,925,345,527,567,703,584,754,743,935,598, 769,796,977,830,993,1015,1185,408,577,600,753,653,787,811,999,659,831,842,1017,86 0,1037,1057,1230,668,854,883,1055,929,1083,1110,1262,954,1136,1145,1308,1174,133 5,1366,1506,418,651,656,823,670,837,865,1043,694,894,918,1075,944,1104,1141,1298, 802,927,961,1113,985,1158,1178,1327,1041,1181,1218,1360,1254,1395,1411,1567,840, 989,1027,1160,1053,1208,1235,1372,1090,1244,1267,1408,1295,1432,1465,1604,1119, 1282,1314,1452,1344,1475,1503,1635,1378,1517,1539,1659,1559,1700,1710,1847,425, 673,683,921,786,938,956,1134,814,975,995,1165,1033,1192,1227,1369,845,1013,1049, 1199,1071,1237,1269,1404,1106,1290,1264,1423,1330,1461,1489,1617,933,1061,1081, 1249,1130,1274,1311,1445,1154,1316,1341,1478,1363,1496,1528,1654,1206,1352,1384 ,1510,1417,1547,1563,1689,1436,1587,1600,1722,1630,1739,1752,1822,987,1088,1152, 1319,1190,1338,1355,1499,1223,1389,1401,1536,1426,1551,1595,1705,1232,1420,1448 ,1583,1485,1608,1612,1745,1521,1640,1649,1758,1679,1792,1806,1896,1300,1472,148 2,1621,1532,1644,1664,1771,1555,1684,1694,1799,1728,1814,1856,1920,1575,1716,17 33,1830,1764,1838,1865,1933,1778,1875,1885,1948,1907,1964,1984,2008,10,39,64,140 ,83,151,182,283,99,172,200,308,225,337,347,526,114,192,209,331,248,363,407,541,269 ,403,384,565,452,592,611,778,128,233,263,374,276,398,426,572,314,443,460,595,508,6 33,649,815,342,468,519,643,537,669,695,841,562,701,728,891,741,913,951,1133,162,2 41,295,439,320,456,504,618,353,523,472,652,551,678,712,857,393,515,558,698,579,72 0,739,904,605,747,783,934,812,964,992,1187,435,569,599,736,636,762,800,957,663,80 3,839,980,862,1018,1046,1231,706,853,898,1028,909,1048,1084,1266,945,1095,1124,1 293,1151,1317,1357,1534,217,289,325,512,368,534,544,709,412,555,582,733,608,760,7 70,955,448,586,615,765,646,798,832,984,675,834,855,1008,902,1040,1076,1253,480,62 7,666,810,681,836,869,1030,731,893,911,1052,943,1093,1114,1291,768,928,960,1103,9 82,1144,1155,1313,1020,1171,1210,1347,1238,1376,1434,1535,496,672,717,875,757,90 6,941,1099,780,947,968,1131,994,1153,1186,1337,827,986,1010,1168,1050,1203,1234, 1385,1068,1241,1271,1409,1301,1444,1464,1613,866,1032,1058,1215,1105,1251,1276, 1427,1150,1286,1315,1456,1348,1469,1514,1651,1184,1326,1359,1493,1373,1527,1546 ,1681,1431,1556,1576,1675,1597,1704,1740,1841,256,358,379,576,417,589,621,795,42 1,624,655,817,687,859,878,1072,476,658,689,884,723,900,924,1074,744,922,953,1122, 988,1148,1161,1312,488,715,749,889,788,930,962,1146,807,976,996,1164,1016,1200,1 222,1370,805,1012,1036,1198,1066,1236,1256,1410,1109,1279,1302,1443,1325,1463,1 497,1641,530,775,790,972,824,1004,1034,1189,843,1044,1056,1233,1086,1265,1284,14 40,949,1078,1107,1270,1135,1297,1323,1459,1175,1331,1364,1490,1390,1526,1549,16 70,1002,1127,1166,1310,1196,1345,1367,1515,1228,1380,1399,1533,1435,1565,1584,1 696,1273,1433,1446,1577,1460,1598,1570,1713,1504,1637,1652,1747,1658,1782,1800, 1859,548,820,829,1064,932,1091,1112,1278,974,1120,1137,1305,1173,1334,1362,1518, 998,1170,1195,1336,1214,1368,1393,1538,1243,1402,1425,1560,1457,1581,1611,1718, 1070,1202,1221,1391,1255,1418,1449,1572,1304,1450,1466,1609,1505,1594,1646,1749 ,1343,1484,1523,1638,1540,1657,1672,1772,1566,1678,1677,1795,1714,1808,1821,189 3,1126,1239,1281,1451,1333,1467,1495,1620,1365,1516,1529,1653,1554,1661,1676,17 80,1394,1544,1573,1671,1585,1680,1715,1809,1619,1723,1736,1825,1760,1845,1857,1 924,1441,1578,1606,1717,1645,1719,1755,1831,1650,1751,1774,1852,1790,1867,1886, 1944,1662,1783,1804,1873,1816,1889,1880,1951,1839,1902,1911,1968,1928,1976,1986 ,2007,302,388,430,602,464,661,692,871,484,704,725,882,755,917,926,1139,492,752,77 3,915,793,1006,1022,1182,846,1026,1062,1229,1089,1258,1283,1454,500,785,822,1014 ,850,1060,1080,1248,873,1097,1116,1288,1142,1318,1340,1470,896,1129,1159,1329,11 91,1361,1377,1509,1205,1371,1403,1542,1407,1558,1580,1742,630,848,864,1087,887,1 118,1140,1309,937,1162,1177,1353,1209,1383,1400,1520,970,1180,1219,1374,1246,14 06,1413,1550,1268,1415,1424,1582,1483,1599,1632,1750,1000,1245,1261,1422,1296,1 447,1453,1590,1321,1481,1500,1618,1531,1642,1655,1775,1351,1512,1541,1656,1568, 1669,1698,1791,1605,1702,1724,1810,1737,1828,1848,1922,640,880,919,1157,966,117 9,1212,1388,990,1224,1250,1416,1275,1430,1437,1586,1042,1263,1294,1438,1320,147 7,1494,1614,1350,1507,1530,1648,1552,1663,1687,1776,1082,1307,1339,1498,1379,15 25,1522,1665,1396,1545,1557,1682,1592,1699,1709,1812,1428,1569,1602,1706,1615,1 730,1738,1832,1636,1748,1765,1853,1794,1869,1887,1945,1111,1356,1382,1548,1412, 1564,1593,1703,1474,1603,1624,1734,1628,1741,1757,1844,1486,1625,1634,1754,1666 ,1763,1787,1866,1692,1793,1803,1874,1820,1894,1905,1954,1508,1674,1685,1777,171 1,1796,1807,1882,1725,1818,1833,1901,1849,1912,1926,1971,1767,1835,1854,1915,18 71,1930,1936,1983,1883,1941,1950,1989,1961,1997,2006,2027,684,939,978,1226,1038, 1260,1289,1462,1054,1299,1328,1480,1354,1502,1537,1688,1101,1342,1387,1519,1405 ,1562,1553,1695,1419,1574,1596,1721,1622,1731,1744,1840,1193,1397,1421,1561,147 3,1589,1607,1735,1479,1623,1631,1746,1643,1759,1770,1861,1487,1639,1660,1769,16 91,1786,1801,1876,1707,1815,1819,1895,1834,1906,1918,1966,1207,1471,1476,1616,1 488,1627,1647,1762,1511,1667,1683,1781,1701,1797,1817,1891,1601,1690,1712,1802, 1726,1826,1836,1903,1761,1837,1855,1916,1872,1929,1935,1982,1629,1729,1753,1827 ,1768,1851,1863,1921,1789,1868,1878,1934,1890,1942,1953,1992,1805,1884,1898,194 9,1910,1956,1965,1999,1923,1969,1975,2004,1980,2013,2015,2035,1217,1491,1501,16 86,1588,1697,1708,1813,1610,1720,1732,1829,1756,1843,1860,1919,1633,1743,1766,1 846,1779,1864,1879,1932,1798,1888,1877,1939,1904,1952,1960,1995,1693,1773,1785, 1870,1811,1881,1897,1946,1824,1899,1909,1957,1917,1962,1972,2003,1850,1913,1925 ,1967,1937,1977,1981,2011,1943,1988,1991,2017,1998,2020,2022,2032,1727,1788,182 3,1900,1842,1908,1914,1963,1858,1927,1931,1974,1940,1978,1990,2014,1862,1938,19 47,1987,1959,1993,1994,2021,1970,2000,2002,2023,2009,2028,2030,2040,1892,1955,1 958,1996,1973,2001,2005,2025,1979,2010,2012,2029,2018,2031,2036,2042,1985,2016, 2019,2033,2024,2034,2037,2043,2026,2038,2039,2044,2041,2045,2046,2047] ;
dans lequel chacun des numéros de séquence de N canaux polarisés dans la seconde séquence correspond à un rang de fiabilité du numéro de séquence dans la séquence entière, et une valeur minimale des numéros de séquence des canaux polarisés est 0.

3. Appareil de codage de code polaire (300), comprenant :
un processeur (402, 502) configuré pour effectuer le procédé selon la revendication 1.

4. Appareil (300) selon la revendication 2 ou 3, dans lequel l'appareil de codage de code polaire (300) est une puce ou un circuit intégré,

5. Dispositif sans fil, comprenant un appareil de codage (300) selon l'une quelconque des revendications 2 to 4, un modulateur et un émetteur-récepteur, dans lequel
le modulateur est configuré pour moduler une séquence de bits codée pour obtenir une séquence modulée ; et
l'émetteur-récepteur est configuré pour traiter la séquence modulée,

6. Dispositif selon la revendication 5, dans lequel le dispositif sans fil est un terminal (112) ou un dispositif réseau (110).

7. Système de communications, dans lequel le système de communications comprend un dispositif réseau (110) et un terminal (112), et le dispositif réseau (110) ou le terminal (112) est configuré pour effectuer le procédé selon la revendication 1.

8. Support de stockage lisible par ordinateur, comprenant des instructions qui, lorsqu'elles sont exécutées par un ordinateur, amènent l'ordinateur à effectuer le procédé selon la revendication 1.

9. Produit-programme informatique comprenant des instructions qui, lorsqu'elles sont exécutées par un ordinateur, amènent l'ordinateur à effectuer le procédé selon la revendication 1.
